# EUROPEAN PATENT SPECIFICATION

(11) **EP 4 307 402 B1**
(45) Date of publication and mention of the grant of the patent: **25.06.2025**
(21) Application number: 22792047.7
(22) Date of filing: 21.04.2022
(51) Int. Cl.: C09K 11/06, H10K 85/60, H10K 50/11, H10K 101/10, H10K 101/00

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 21.04.2021 KR 20210051874
(43) Date of publication of application: 17.01.2024
(73) Proprietor: LG Chem, Ltd., Seoul 07336 (KR)
(72) Inventor: HAN, Su Jin, Daejeon 34122 (KR); LEE, Dong Hoon, Daejeon 34122 (KR); SUH, Sang Duk, Daejeon 34122 (KR); JUNG, Min Woo, Daejeon 34122 (KR); LEE, Jungha, Daejeon 34122 (KR); PARK, Seulchan, Daejeon 34122 (KR); HWANG, Sunghyun, Daejeon 34122 (KR)
(74) Representative: Hoffmann Eitle
(86) International application number: PCT/KR2022/005724
(87) International publication number: WO 2022/225349

(56) References cited:
- WO-A1-2021/029616
- WO-A1-2022/015107
- KR-A- 20170 130 737
- KR-A- 20190 079 341
- KR-A- 20200 082 176
- KR-A- 20200 083 171
- KR-A- 20210 018 127
- KR-A- 20210 018 127

## Description

### [TECHNICAL FIELD]

### CROSS CITATION WITH RELATED APPLICATION(S)

This application claims the benefit of Korean Patent Application No. 10-2021-0051874 filed on April 21, 2021 in the Korean Intellectual Property Office.

The present disclosure relates to an organic light emitting device having improved driving voltage, efficiency, and lifespan.

### [BACKGROUND]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer, and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

There is a continuing need for the development of an organic light emitting device having improved driving voltage, efficiency, and lifespan.

### [PRIOR ART LITERATURE]

### [Patent Literature]

(Patent Literature 0001) Korean Unexamined Patent Publication No. 10-2000-0051826

WO 2021/029616 A1 and KR 2021 0018127 A disclose organic light emitting devices comprising a light emitting layer including two hosts.

### [DETAILED DESCRIPTION OF THE INVENTION]

### [Technical Problem]

The present disclosure relates to an organic light emitting device having improved driving voltage, efficiency, and lifespan.

### [Technical Solution]

In the present disclosure, there is provided an organic light emitting device including
an anode;
a cathode; and
a light emitting layer that is provided between the anode and the cathode,
wherein the light emitting layer includes a compound represented by the following Chemical Formula 1 and a compound represented by the following Chemical Formula 2: 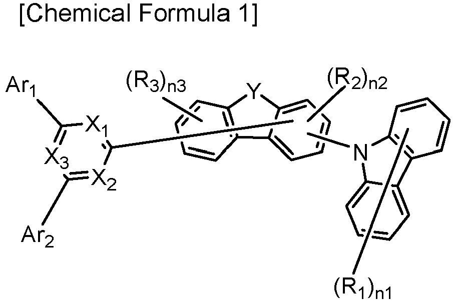
wherein in Chemical Formula 1:
   Y is O or S;
   X₁, X₂ and X₃ are each independently CH or N, provided that at least one of X₁, X₂ and X₃ is N; and
   Ar₁ and Ar₂ are each independently a substituted or unsubstituted C₆₋₆₀ aryl, or a substituted or unsubstituted C₂₋₆₀ heteroaryl containing at least one heteroatom selected from the group consisting of N, O and S;
   R₁, R₂, and R₃ are each independently hydrogen, deuterium, substituted or unsubstituted C₆₋₆₀ aryl, or substituted or unsubstituted C₂₋₆₀ heteroaryl containing at least one heteroatom selected from the group consisting of N, O and S;
   n1 is an integer of 0 to 8; and
   n2+n3 is an integer of 0 to 6; 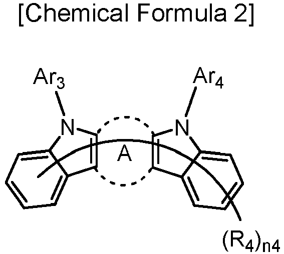
   wherein in Chemical Formula 2:
      A is a benzene ring fused with two adjacent rings;
      Ar₃ and Ar₄ are each independently a substituted or unsubstituted C₆₋₆₀ aryl, or a substituted or unsubstituted C₂₋₆₀ heteroaryl containing at least one heteroatom selected from the group consisting of O and S, provided that at least one of Ar₃ and Ar₄ is substituted with at least one deuterium;
      each R₄ is independently hydrogen, deuterium, substituted or unsubstituted C₆₋₆₀ aryl, or substituted or unsubstituted C₂₋₆₀ heteroaryl containing at least one heteroatom selected from the group consisting of N, O and S, provided that at least one of R₄ is deuterium; and
      n4 is an integer of 1 to 10.

### [ADVANTAGEOUS EFFECTS]

The above-described organic light emitting device includes the compound represented by Chemical Formula 1 and the compound represented by Chemical Formula 2 in the light emitting layer, and thus can have improved efficiency, low driving voltage, and/or lifespan.

### [BRIEF DESCRIPTION OF THE DRAWINGS]

FIG. 1 shows an example of an organic light emitting device including a substrate 1, an anode 2, a light emitting layer 3, and a cathode 4.
FIG. 2 shows an example of an organic light emitting device including a substrate 1, an anode 2, a hole injection layer 5, a hole transport layer 6, an electron blocking layer 7, a light emitting layer 3, a hole blocking layer 8, an electron injection and transport layer 9, and a cathode 4.

### [DETAILED DESCRIPTION OF THE EMBODIMENTS]

Hereinafter, embodiments of the present disclosure will be described in more detail to facilitate understanding of the invention.

As used herein, the notation 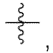 or 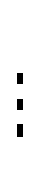 means a bond linked to another substituent group.

As used herein, the term "substituted or unsubstituted" means being unsubstituted or substituted with one or more substituents selected from the group consisting of deuterium, a halogen group, a nitrile group, a nitro group, a hydroxyl group, a carbonyl group, an ester group, an imide group, an amino group, a phosphine oxide group, an alkoxy group, an aryloxy group, an alkylthioxy group, an arylthioxy group, an alkylsulfoxy group, an arylsulfoxy group, a silyl group, a boron group, an alkyl group, a cycloalkyl group, an alkenyl group, an aryl group, an aralkyl group, an aralkenyl group, an alkylaryl group, an alkylamine group, an aralkylamine group, a heteroarylamine group, an arylamine group, an arylphosphine group, and a heterocyclic group containing at least one of N, O and S atoms, or being unsubstituted or substituted with a substituent in which two or more substituents of the above-exemplified substituents are connected. For example, "a substituent in which two or more substituents are connected" may be a biphenyl group. Namely, a biphenyl group may be an aryl group, or it may also be interpreted as a substituent in which two phenyl groups are connected.

In the present disclosure, the carbon number of a carbonyl group is not particularly limited, but is preferably 1 to 40. Specifically, the carbonyl group may be a substituent having the following structural formulae, but is not limited thereto.

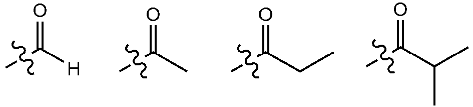

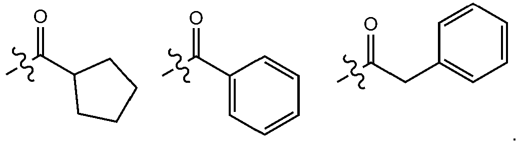

In the present disclosure, an ester group may have a structure in which oxygen of the ester group is substituted by a straight-chain, branched-chain, or cyclic alkyl group having 1 to 25 carbon atoms, or an aryl group having 6 to 25 carbon atoms. Specifically, the ester group may be a substituent having the following structural formulae, but is not limited thereto.

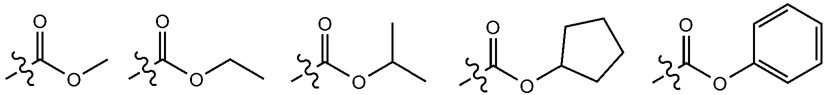

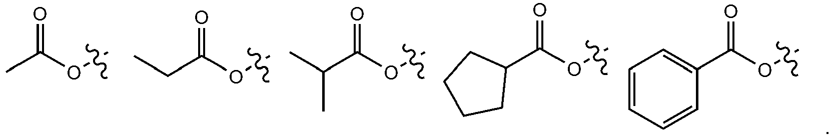

In the present disclosure, the carbon number of an imide group is not particularly limited, but is preferably 1 to 25. Specifically, the imide group may be a substituent having the following structural formulae, but is not limited thereto.

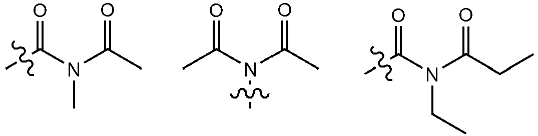

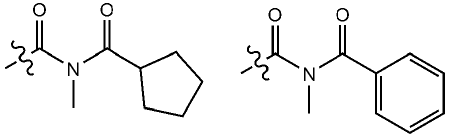

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, a phenylboron group and the like, but is not limited thereto.

In the present disclosure, examples of a halogen group include fluorine, chlorine, bromine, or iodine.

In the present disclosure, the alkyl group may be straight-chain, or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethylpropyl, isohexyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The monocyclic aryl group includes a phenyl group, a biphenyl group, a terphenyl group and the like, but is not limited thereto. The polycyclic aryl group includes a naphthyl group, an anthracenyl group, a phenanthryl group, a pyrenyl group, a perylenyl group, a chrysenyl group, a fluorenyl group or the like, but is not limited thereto.

In the present disclosure, a fluorenyl group may be substituted, and two substituents may be bonded to each other to form a spiro structure. In the case where the fluorenyl group is substituted, 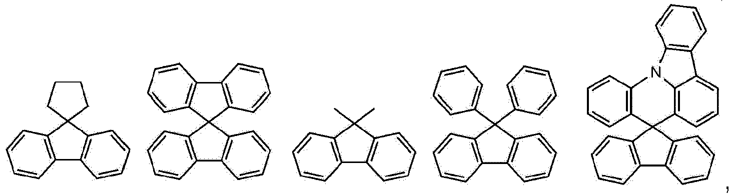 and the like can be formed. However, the structure is not limited thereto.

In the present disclosure, a heterocyclic group is a heterocyclic group containing at least one heteroatom of O, N, Si and S as a heterogeneous element, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group, and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can apply the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

The present disclosure will be described in detail for each configuration.

### Anode and Cathode

The anode and cathode used in the present disclosure refer to electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides such as ZnO:Al or SnO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Hole injection layer

The organic light emitting device according to the present disclosure may further include a hole injection layer on the anode, if necessary.

The hole injection layer is a layer for injecting holes from the electrode, and the hole injection material is preferably a compound which can transport the holes, thus has a hole-injecting effect in the anode and an excellent hole-injecting effect to the light emitting layer or the light emitting material, prevents excitons produced in the light emitting layer from moving to an electron injection layer or the electron injection material, and is excellent in the ability to form a thin film. It is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Hole transport layer

The organic light emitting device according to the present disclosure may include a hole transport layer on the anode (or on the hole injection layer if there is a hole injection layer), if necessary.

The hole transport layer is a layer that receives holes from an anode or a hole injection layer and transports the holes to the light emitting layer. The hole transport material is suitably a material having large mobility to the holes, which may receive holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Electron blocking layer

The organic light emitting device according to the present disclosure may include an electron blocking layer between a hole transport layer and a light emitting layer, if necessary.

The electron blocking layer is a layer which is formed on the hole transport layer, is preferably provided in contact with the light emitting layer, and thus serves to control hole mobility, to prevent excessive movement of electrons, and to increase the probability of hole-electron bonding, thereby improving the efficiency of the organic light emitting device.

The electron blocking layer includes an electron blocking material, and an arylamine-based organic material may be used as the electron blocking material, but is not limited thereto.

### Light emitting layer

The organic light emitting device according to the present disclosure includes a light emitting layer between an anode and a cathode, and the light emitting layer includes the first compound and the second compound as host materials. Specifically, the first compound functions as an N-type host material having an electron transport ability superior to a hole transport ability, and the second compound functions as a P-type host material having a hole transport ability superior to an electron transport ability, thereby maintaining the ratio of holes to electrons in the light emitting layer. Accordingly, the excitons emit lights evenly throughout the light emitting layer, so that the luminous efficiency and lifespan of the organic light emitting device can be simultaneously improved.

Hereinafter, the first compound and the second compound will be described.

### (First compound)

The first compound is represented by the following Chemical Formula 1. Specifically, it has a structure in which carbazole and triazine are bonded together around benzofuran, so that electrons can be efficiently transferred to a dopant material. Accordingly, the first compound has an indolocarbazole-based structure and deuterium is substituted in each of the indolocarbazole core and its substituents to increase the probability of recombination of holes and electrons in the light emitting layer together with the second compound having an excellent hole transport ability. 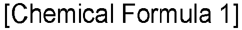 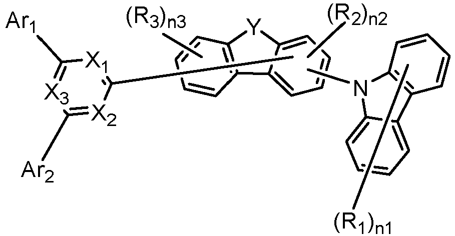 wherein in Chemical Formula 1:
Y is O or S;
X₁, X₂ and X₃ are each independently CH or N, provided that at least one of X₁, X₂ and X₃ is N; and
Ar₁ and Ar₂ are each independently a substituted or unsubstituted C₆₋₆₀ aryl, or a substituted or unsubstituted C₂₋₆₀ heteroaryl containing at least one heteroatom selected from the group consisting of N, O and S;
R₁, R₂, and R₃ are each independently hydrogen, deuterium, substituted or unsubstituted C₆₋₆₀ aryl, or substituted or unsubstituted C₂₋₆₀ heteroaryl containing at least one heteroatom selected from the group consisting of N, O and S;
n1 is an integer of 0 to 8; and
n2+n3 is an integer of 0 to 6.

Specifically, in Chemical Formula 1, n2 and n3 may each be an integer of 0 to 4, and n2+n3 is an integer selected within the range of 0 to 6.

Preferably, the compound represented by Chemical Formula 1 is represented by the following Chemical Formula 1-1 or Chemical Formula 1-2: 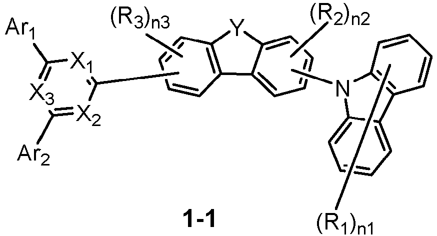 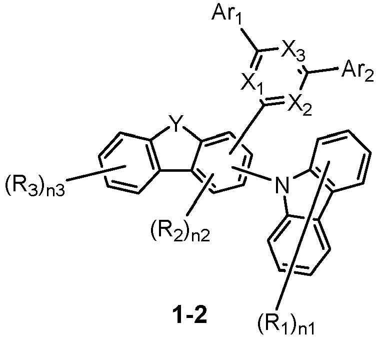 wherein in Chemical Formulae 1-1 and 1-2, Y, X₁, X₂, X₃, Ar₁, Ar₂, R₁, R₂, R₃, n1, n2, and n3 are as defined in Chemical Formula 1.

Herein, in Chemical Formula 1-1, n2 and n3 are each an integer of 0 to 3. In Chemical Formula 1-2, n2 is an integer of 0 to 2, and n3 is an integer of 0 to 4.

Specifically, the first compound may be represented by any one of the following Chemical Formulae 1A to 1E: 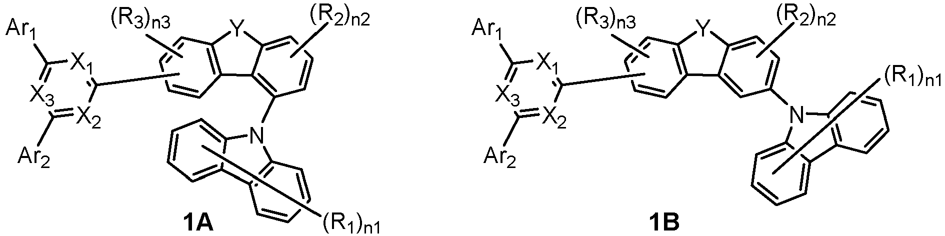 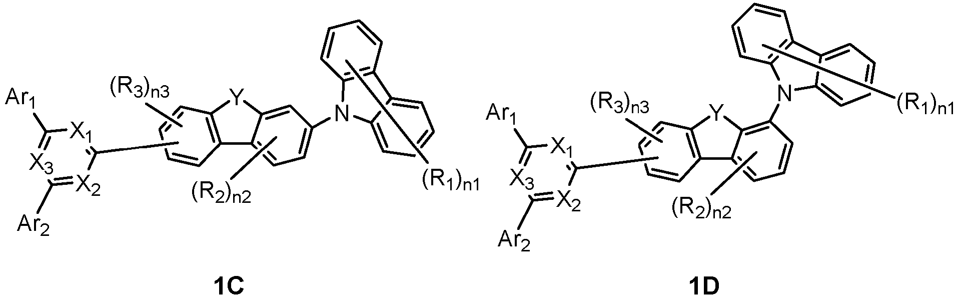 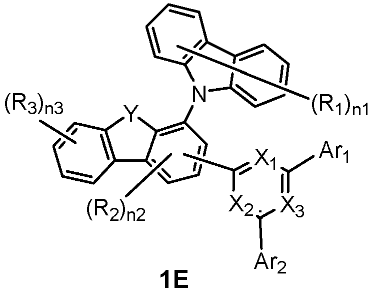
wherein in Chemical Formulae 1A to 1E,
Y, X₁, X₂, X₃, Ar₁, Ar₂, R₁, R₂, R₃, n1, n2, and n3 are as defined in Chemical Formula 1.

Herein, in Chemical Formulae 1A to 1D, n2 and n3 are each an integer of 0 to 3. In Chemical Formula 1E, n2 is an integer of 0 to 2, and n3 is an integer of 0 to 4.

More specifically, the compound represented by Chemical Formula 1C may be represented by the following Chemical Formula 1C-1 (position 6 of the core), Chemical Formula 1C-2 (position 7 of the core), Chemical Formula 1C-3 (position 8 of the core), or Chemical Formula 1C-4 (position 9 of the core) depending on the substitution position of the N-containing 6-membered heterocyclic group: 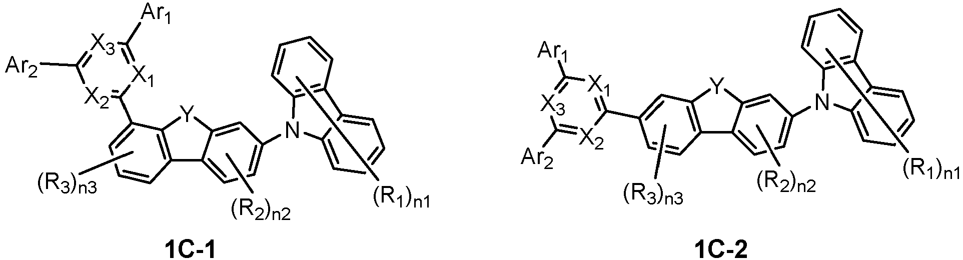 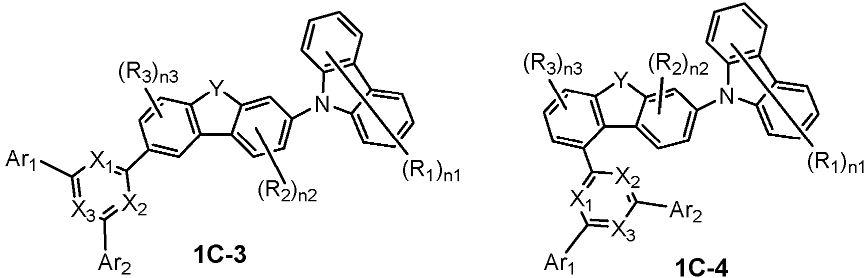
wherein in Chemical Formulae 1C-1 to 1C-4,
n1 and n2 are each an integer of 0 to 3, and
the definitions of other substituents are the same as described in Chemical Formula 1.

In Chemical Formulae 1, 1-1, 1-2, 1A to 1E, and 1C-1 to 1C-4, Y is O or S.

In addition, in Chemical Formulae 1, 1-1, 1-2, 1A to 1E, and 1C-1 to 1C-4, X₁, X₂ and X₃ are each independently CH or N, provided that at least one of X₁, X₂ and X₃ is N.

Preferably, X₁ to X₃ are all N;
X₁ and X₂ are N, and X₃ is CH;
X₁ and X₃ are N, and X₂ is CH;
X₁ is N, and X₂ and X₃ are CH; or
X₂ is N, and X₁ and X₃ are CH.

In addition, in Chemical Formulae 1, 1-1, 1-2, 1A to 1E, and 1C-1 to 1C-4, Ar₁ and Ar₂ are each independently substituted or unsubstituted C₆₋₆₀ aryl or substituted or unsubstituted C₂₋₆₀ heteroaryl containing at least one heteroatom selected from the group consisting of N, O and S.

For example, Ar₁ is substituted or unsubstituted C₆₋₆₀ aryl, and Ar₂ is substituted or unsubstituted C₆₋₆₀ aryl or substituted or unsubstituted C₂₋₆₀ heteroaryl containing at least one heteroatom selected from the group consisting of N, O and S.

Preferably, Ar₁ and Ar₂ are each independently substituted or unsubstituted C₆₋₂₀ aryl or substituted or unsubstituted C₂₋₂₀ heteroaryl containing at least one heteroatom selected from the group consisting of N, O and S, wherein Ar₁ and Ar₂ are unsubstituted or substituted with at least one substituent selected from the group consisting of deuterium, C₁₋₁₀ alkyl, and C₆₋₂₀ aryl.

For example, Ar₁ and Ar₂ are each independently substituted or unsubstituted C₆₋₂₀ aryl or substituted or unsubstituted C₂₋₂₀ heteroaryl containing at least one heteroatom selected from the group consisting of N, O and S, wherein Ar₁ and Ar₂ are unsubstituted or substituted with at least one substituent selected from the group consisting of deuterium, C₁₋₁₀ alkyl, and C₆₋₂₀ aryl.

More preferably, Ar₁ and Ar₂ are each independently phenyl, biphenylyl, terphenylyl, naphthyl, phenanthryl, carbazolyl, dibenzofuranyl, dibenzothiophenyl, benzoxazolyl, or benzothiazolyl, wherein Ar₁ and Ar₂ may be unsubstituted or substituted with at least one substituent selected from the group consisting of deuterium, C₁₋₁₀ alkyl, and C₆₋₂₀ aryl.

More preferably, Ar₁ and Ar₂ may each independently be any one selected from the group consisting of:

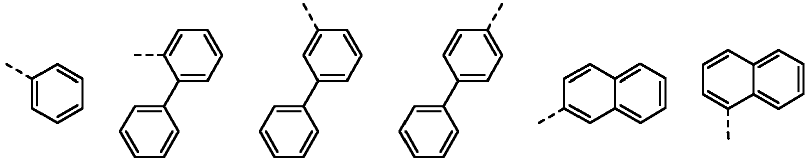

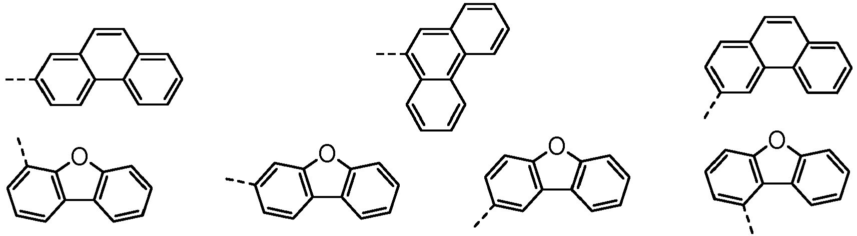

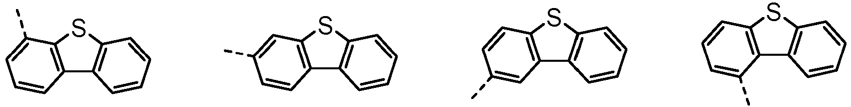

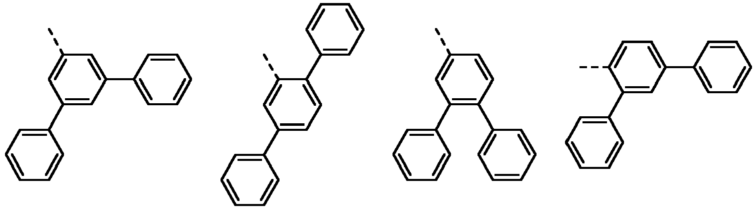

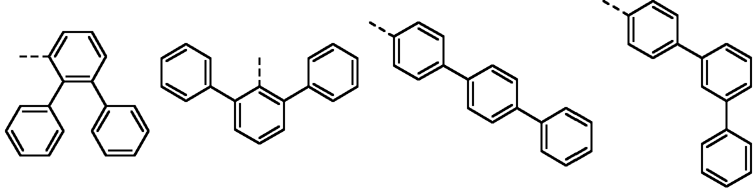

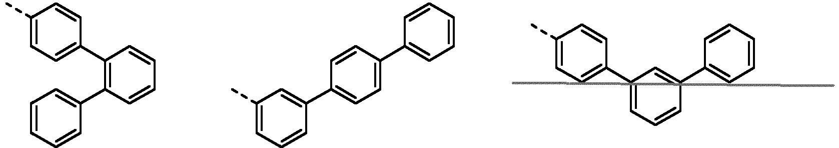

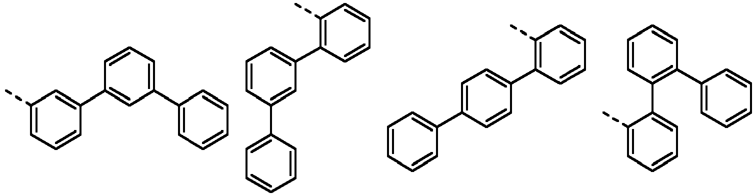

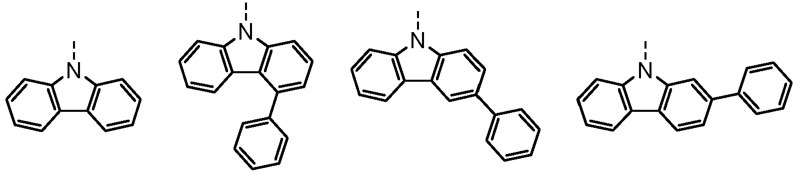

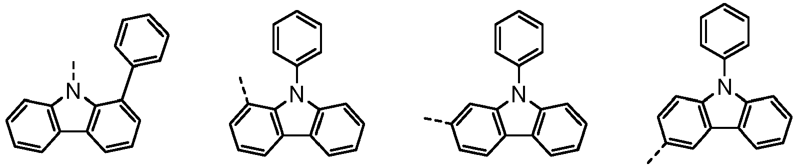

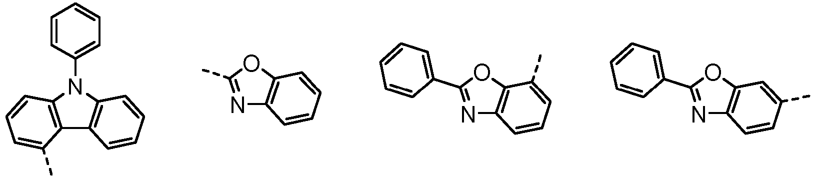

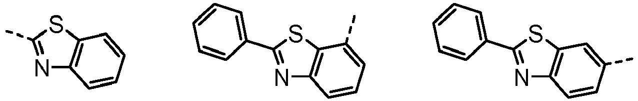

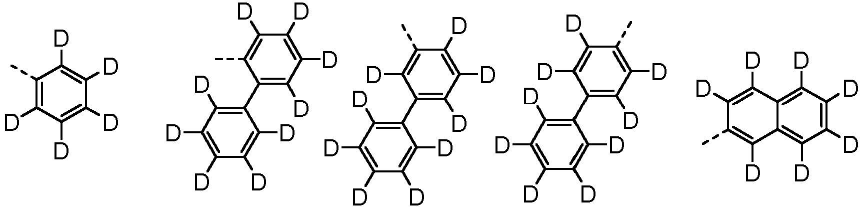

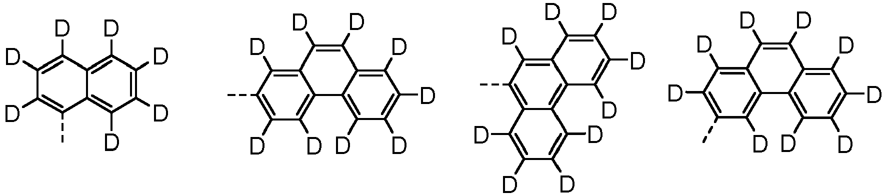

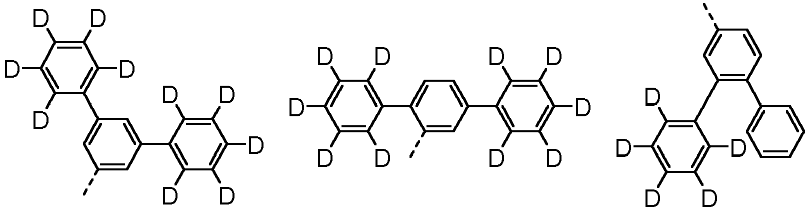

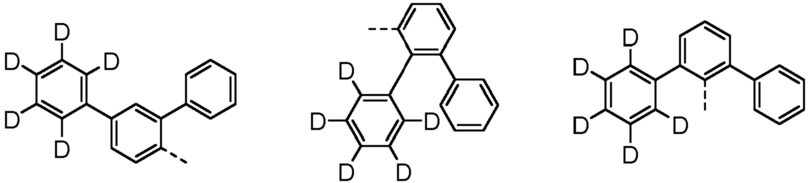

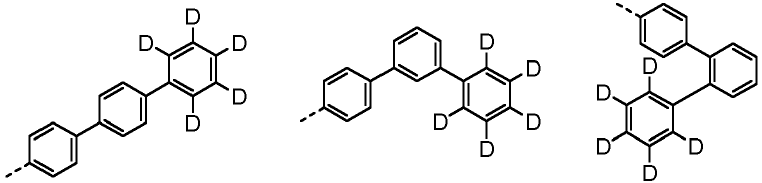

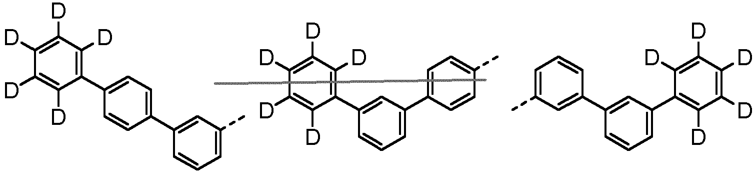

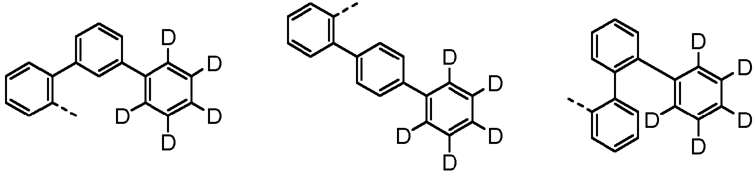

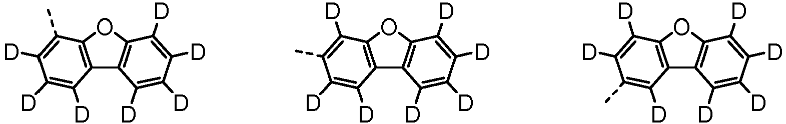

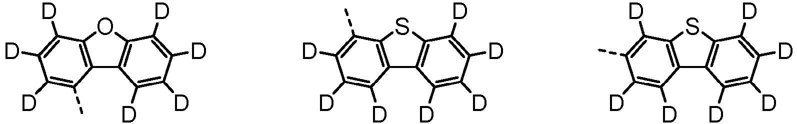

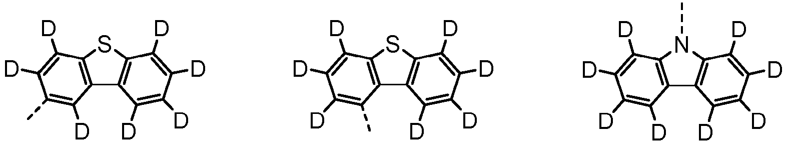

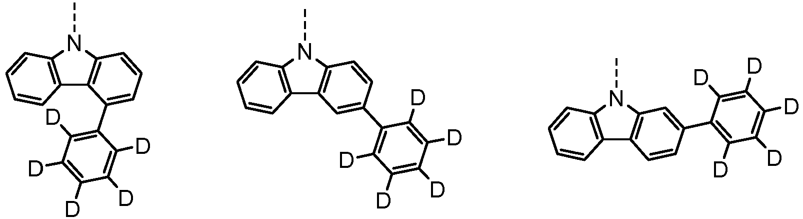

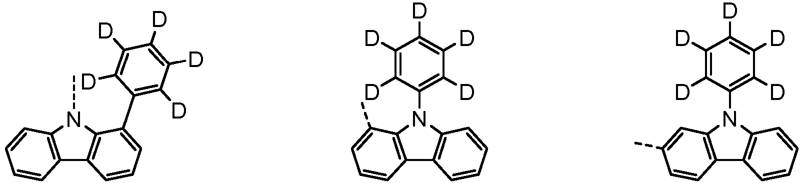

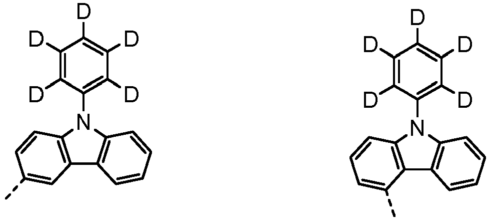

Specifically, Ar₁ and Ar₂ may each independently be phenyl, biphenylyl, terphenylyl, naphthyl, phenanthrenyl, dibenzofuranyl, dibenzothiophenyl, carbazolyl, carbazolyl substituted with phenyl, benzoxazolyl, benzoxazolyl substituted with phenyl, benzthiazolyl, benzthiazolyl substituted with phenyl, phenyl substituted with 5 deuterium, biphenylyl substituted with 9 deuterium, terphenylyl substituted with 5 deuterium, dibenzofuranyl substituted with 7 deuterium, dibenzothiophenyl substituted with 7 deuterium, carbazolyl substituted with 8 deuterium, or carbazolyl substituted with phenyl substituted with 5 deuterium.

For example, Ar₁ may be phenyl, biphenylyl, phenyl substituted with 5 deuterium, or biphenylyl substituted with 9 deuterium, and Ar₂ may be phenyl, biphenylyl, terphenylyl, naphthyl, phenanthrenyl, dibenzofuranyl, dibenzothiophenyl, carbazolyl, carbazolyl substituted with phenyl, benzoxazolyl, benzoxazolyl substituted with phenyl, benzthiazolyl, benzthiazolyl substituted with phenyl, phenyl substituted with 5 deuterium, biphenylyl substituted with 9 deuterium, terphenylyl substituted with 5 deuterium, dibenzofuranyl substituted with 7 deuterium, dibenzothiophenyl substituted with 7 deuterium, carbazolyl substituted with 8 deuterium, or carbazolyl substituted with phenyl substituted with 5 deuterium.

In addition, at least one of Ar₁ and Ar₂ may be phenyl or phenyl substituted with 5 deuterium.

Also, Ar₁ and Ar₂ may be the same. Alternatively, Ar₁ and Ar₂ may be different.

In addition, in Chemical Formulae 1, 1-1, 1-2, 1A to 1E, or 1C-1 to 1C-4, R₁, R₂, and R₃ are each independently hydrogen; deuterium; substituted or unsubstituted C₆₋₆₀ aryl; or substituted or unsubstituted C₂₋₆₀ heteroaryl containing at least one selected from the group consisting of N, O and S.

Preferably, each R₁ may independently be hydrogen, deuterium, substituted or unsubstituted C₆₋₂₀ aryl, or substituted or unsubstituted C₂₋₂₀ heteroaryl containing at least one selected from the group consisting of N, O and S. More preferably, each R₁ may independently be hydrogen, deuterium, phenyl, dibenzofuranyl, dibenzothiophenyl, carbazolyl, phenyl substituted with 5 deuterium, dibenzofuranyl substituted with 7 deuterium, dibenzothiophenyl substituted with 7 deuterium, or carbazolyl substituted with 8 deuterium. Most preferably, each R₁ may independently be hydrogen, deuterium, or any one selected from the group consisting of:

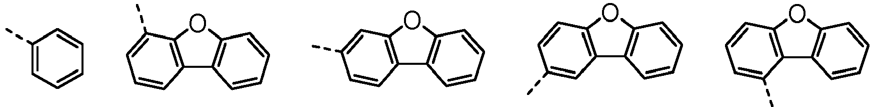

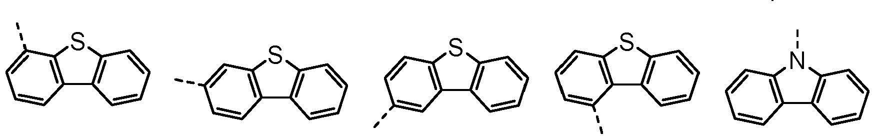

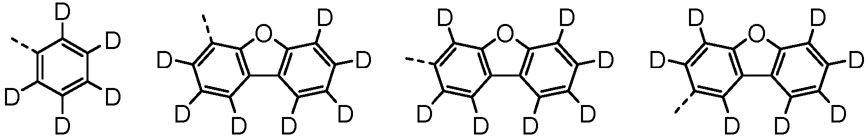

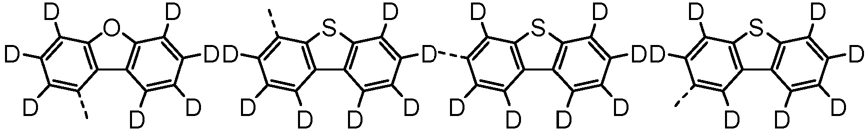

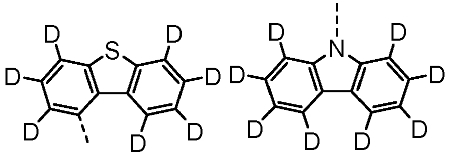

Preferably, R₂, and R₃ may each independently be hydrogen, deuterium, substituted or unsubstituted C₆₋₂₀ aryl, or substituted or unsubstituted C₂₋₂₀ heteroaryl containing at least one selected from the group consisting of N, O and S. More preferably, R₂, and R₃ may each independently be hydrogen, deuterium, phenyl, dibenzothiophenyl, carbazolyl, or phenyl substituted with 5 deuterium. Most preferably, R₂, and R₃ may each independently be hydrogen, deuterium, or any one selected from the group consisting of:

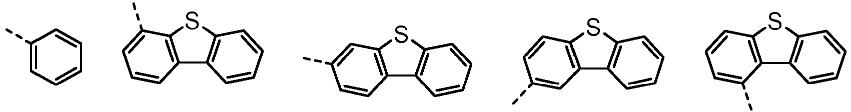

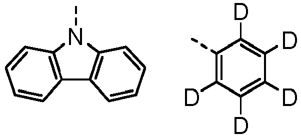

In addition, in Chemical Formula 1, 1-1, 1-2, 1A to 1E, or 1C-1 to 1C-4, the substituent 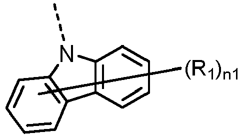 may be any one of the substituents represented by the following Chemical Formulae 3a to 3i:

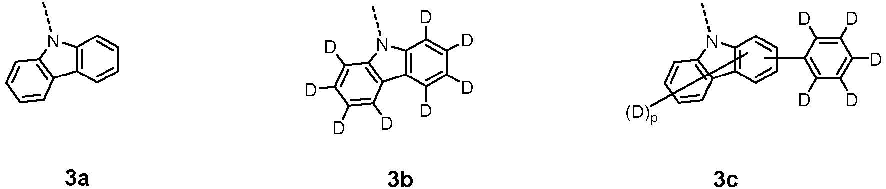

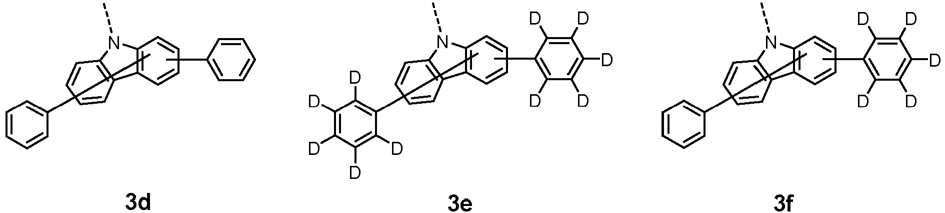

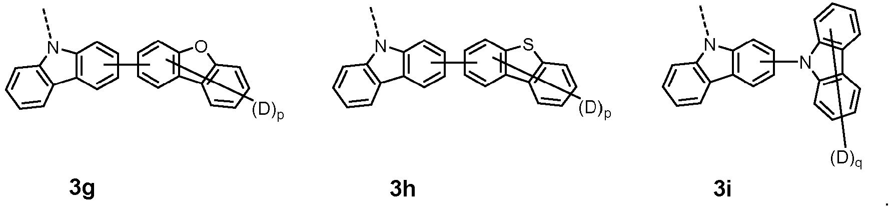

In Chemical Formulae 3a to 3i,
p is an integer of 0 to 7, and
q is an integer of 0 to 8.

In addition, in Chemical Formula 1, 1-1, 1-2, 1A to 1E, or 1C-1 to 1C-4, n1 representing the number of R₁ is 0, 1, 2, 3, 4, 5, 6, 7, or 8, and n2+n3 representing the sum of the number of R₂ and the number of R₃ is 0, 1, 2, 3, 4, 5, or 6.

Preferably, n1 may be 0, 1, 2, or 8, and n2+n3 may be 0, 1, 2, or 6. When n1 is 8, R₁ may be deuterium, and when n2+n3 is 6, both R₂ and R₃ may be deuterium.

Meanwhile, the compound represented by Chemical Formula 1 may not be substituted with deuterium or may be substituted with at least one deuterium, and may be substituted with deuterium up to the total number of hydrogens in each compound. For example, the compound represented by Chemical Formula 1 may be unsubstituted or substituted with 1 to 51, 1 to 31, or 1 to 13 deuterium. In this case, a deuterium substitution rate of Chemical Formula 1 may be 0 to 100%. The 'deuterium substitution rate' refers to the number of deuterium contained in Chemical Formula 1 compared to the total number of hydrogens that may be present in Chemical Formula 1. For example, the deuterium substitution rate of Chemical Formula 1 may be 1% or more, 2% or more, 5% or more, 10% or more, 12% or more, or 15% or more, and 99% or less, 95% or less, 90% or less, 80% or less, 60% or less, 55% or less, 50% or less, or 48% or less.

For example, in Chemical Formula 1, 1-1, 1-2, 1A to 1E, or 1C-1 to 1C-4, at least one of Ar₁ and Ar₂ is deuterium-substituted C₆₋₆₀ aryl; or deuterium-substituted C₂₋₆₀ heteroaryl containing at least one heteroatom selected from the group consisting of N, O and S; or at least one of R₁ to R₃ is deuterium; deuterium-substituted C₆₋₆₀ aryl; or deuterium-substituted C₂₋₆₀ heteroaryl containing at least one heteroatom selected from the group consisting of N, O and S, and n1+n2+n3 is 1 or more.

Representative examples of the compound represented by Chemical Formula 1 are as follows:

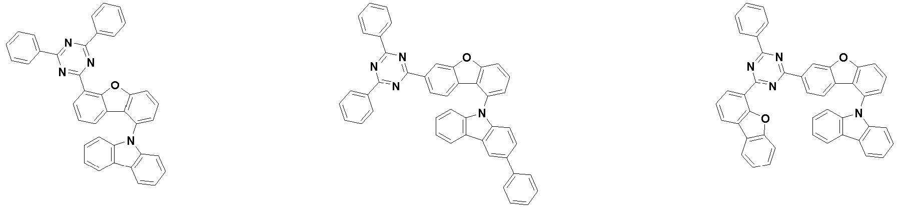

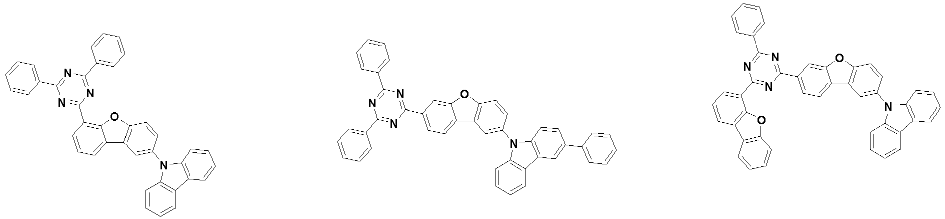

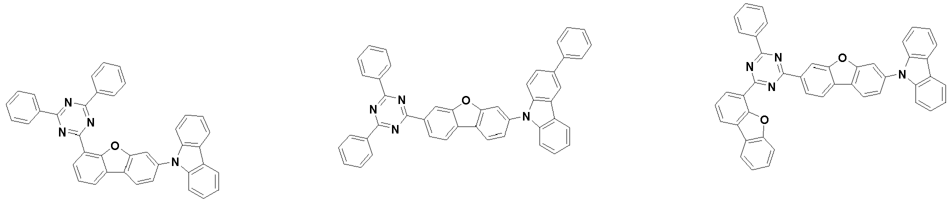

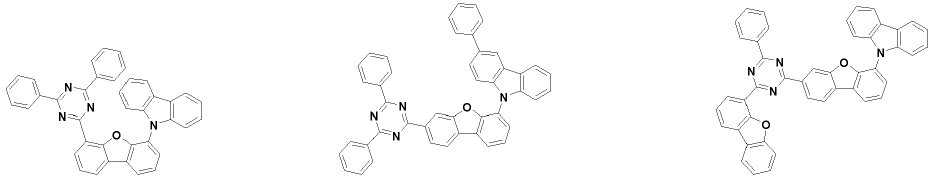

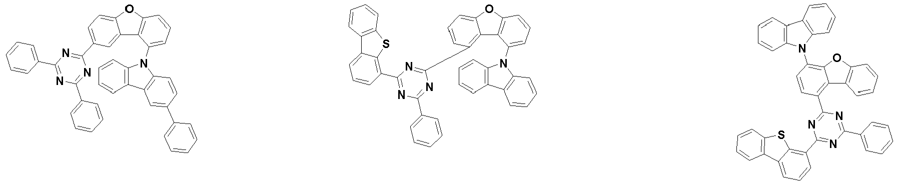

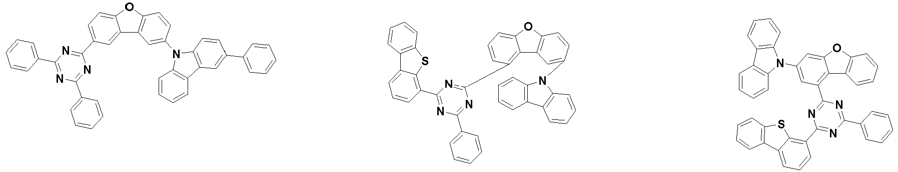

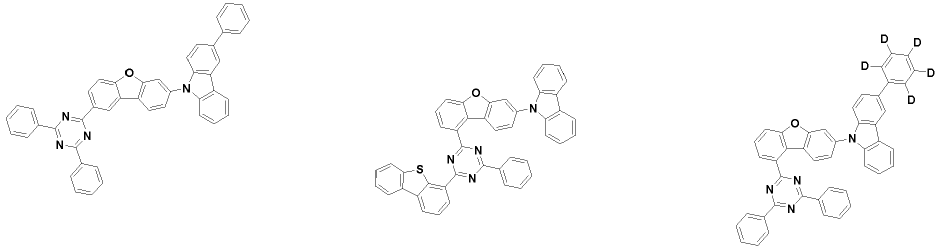

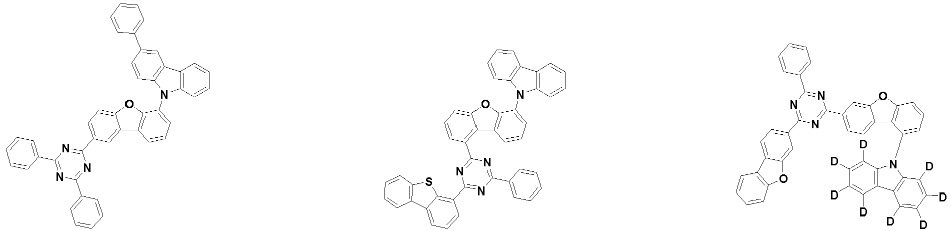

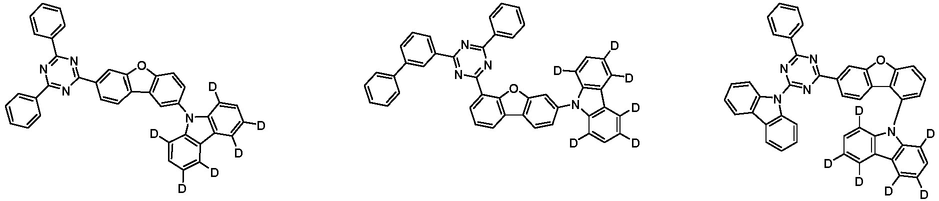

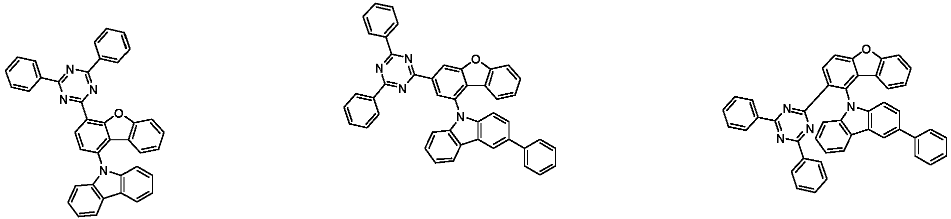

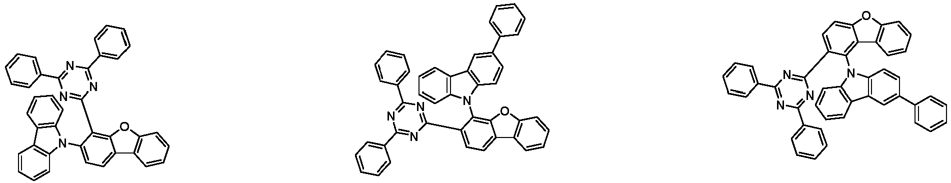

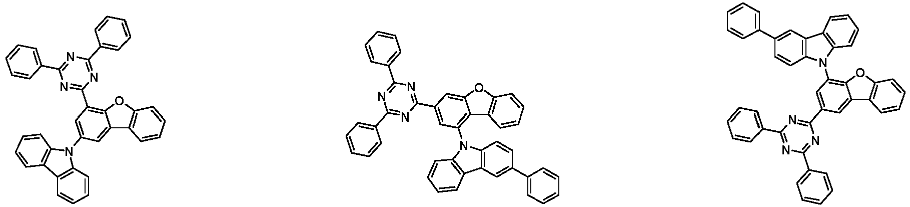

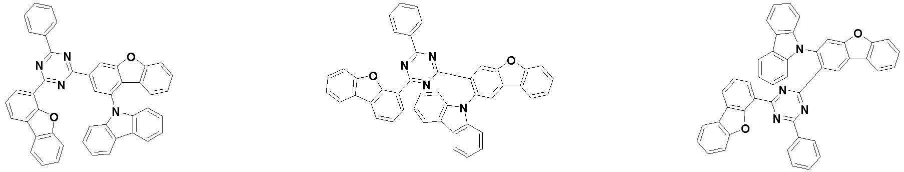

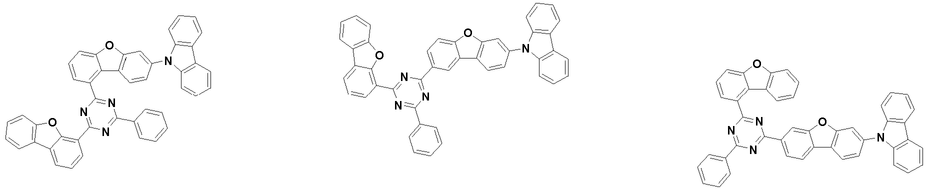

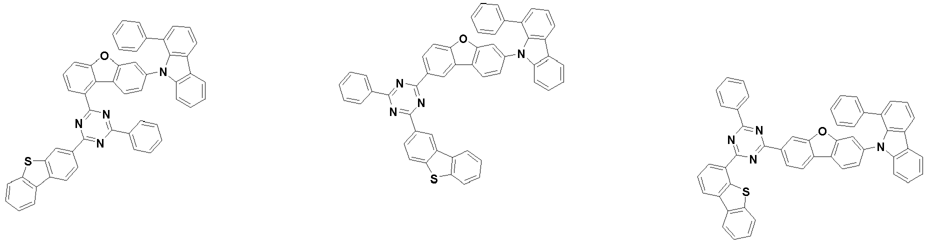

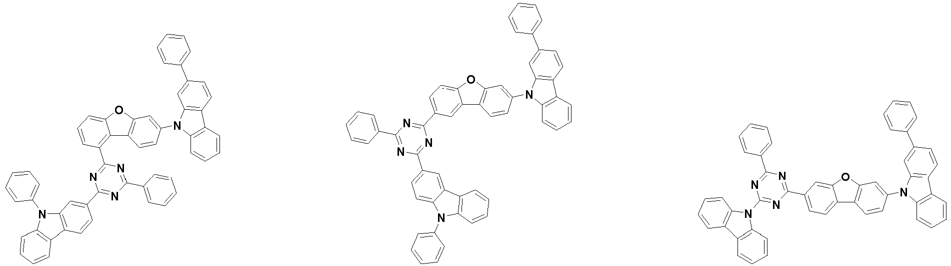

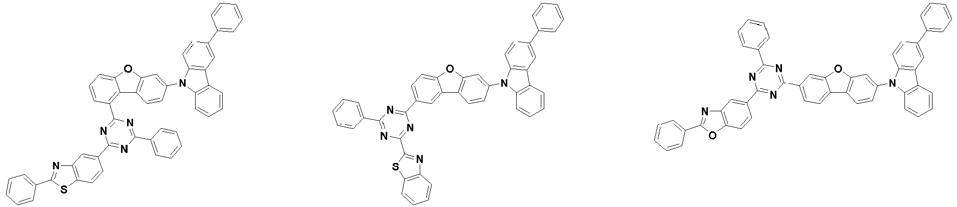

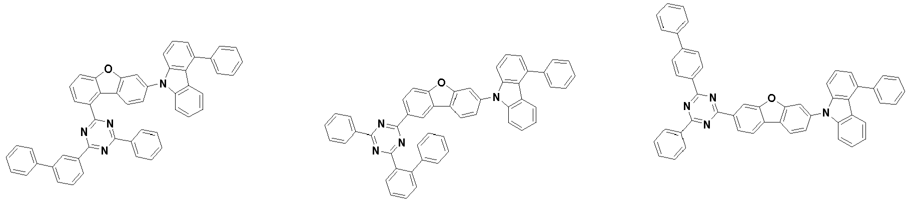

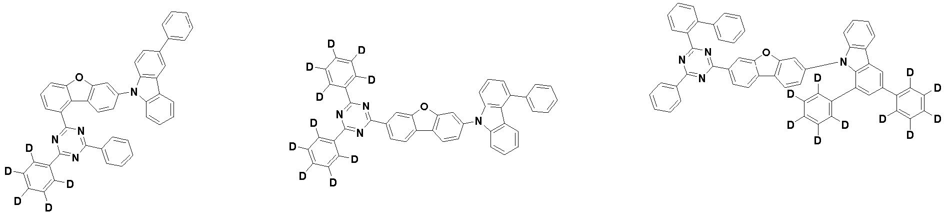

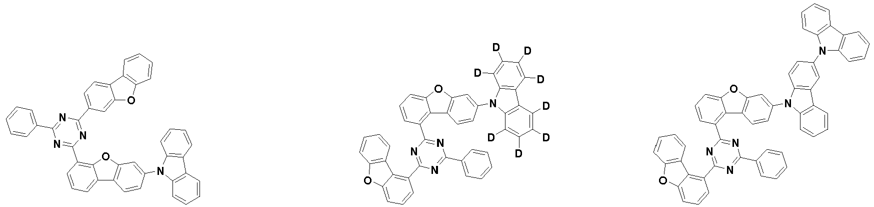

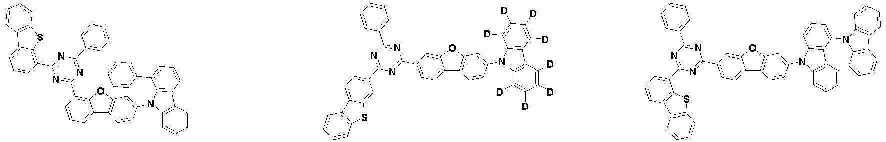

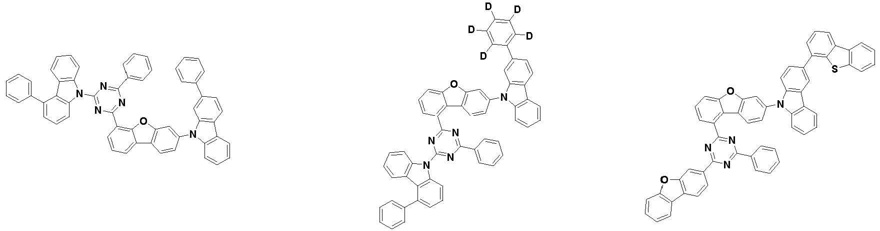

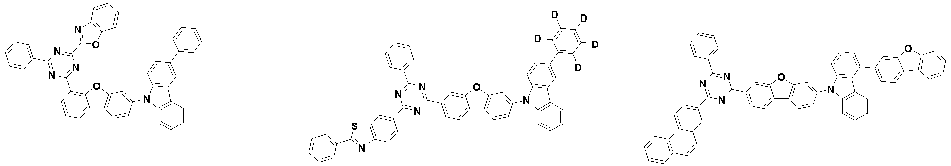

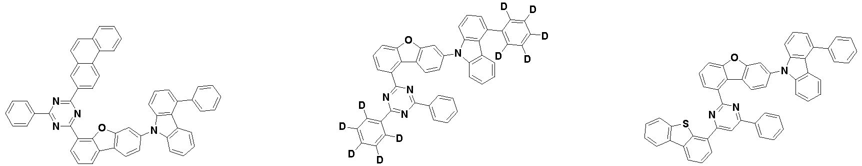

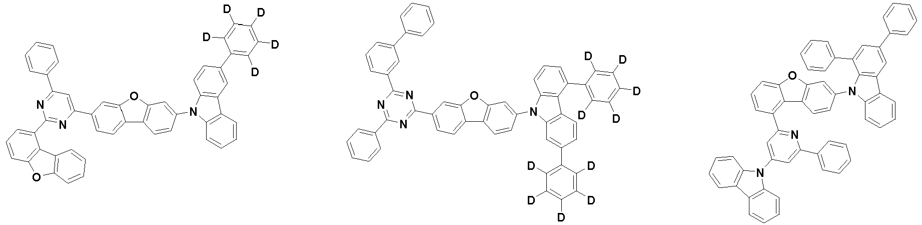

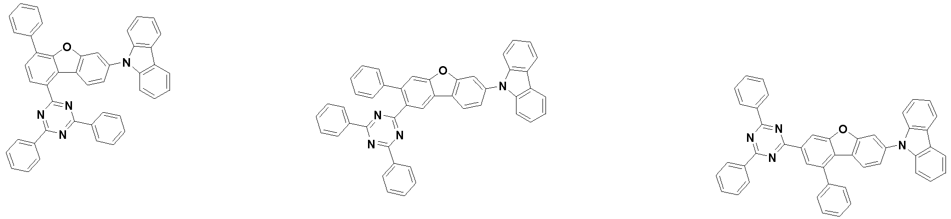

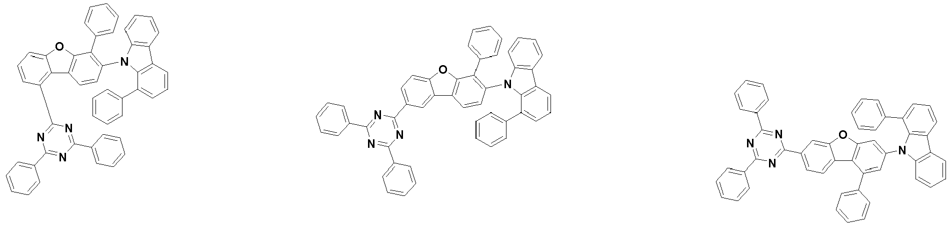

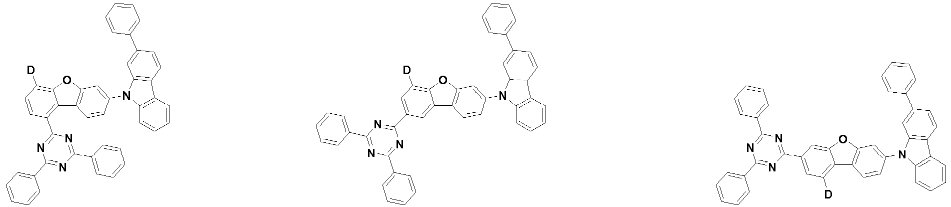

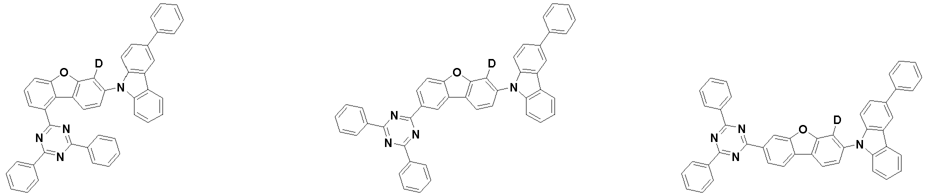

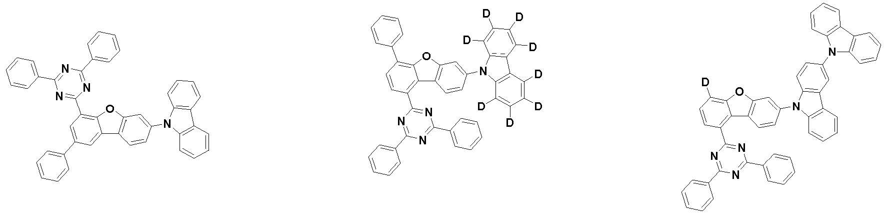

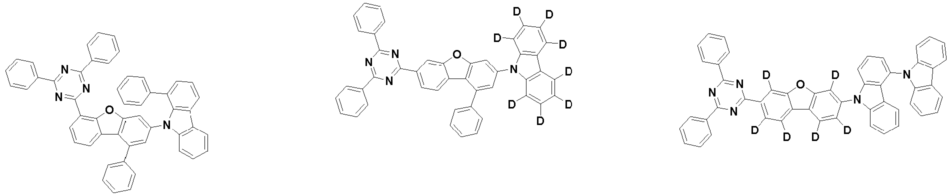

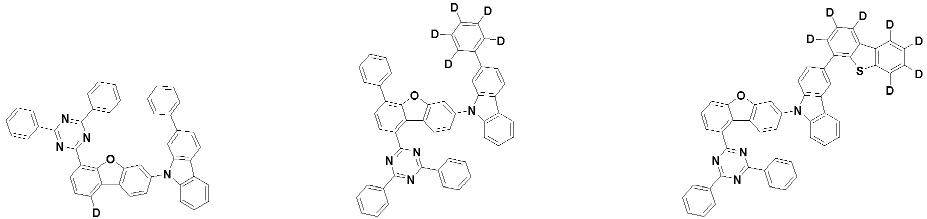

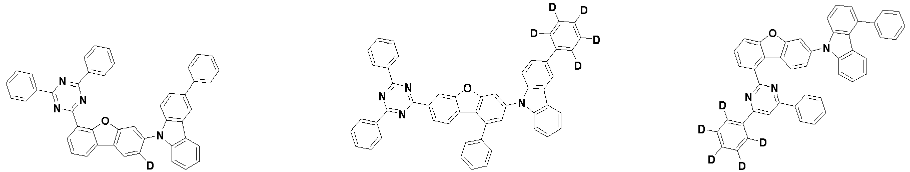

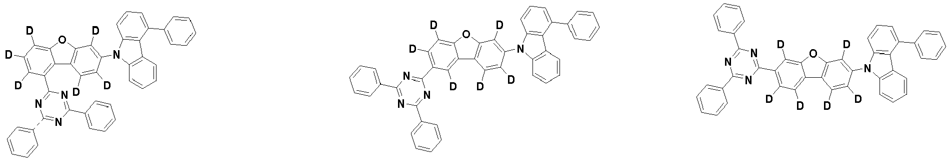

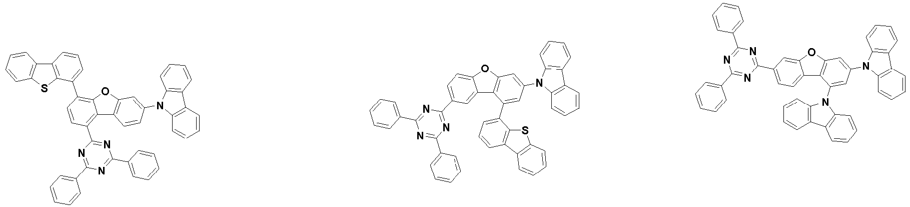

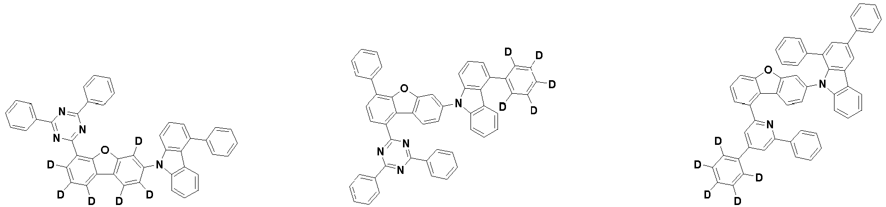

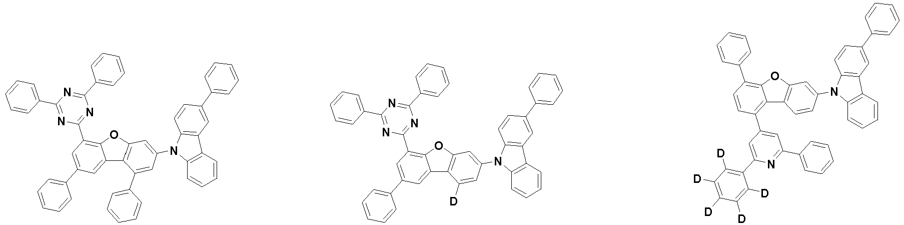

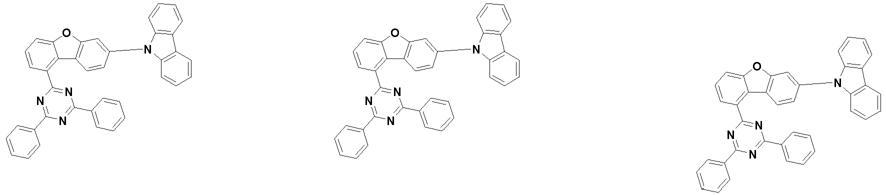

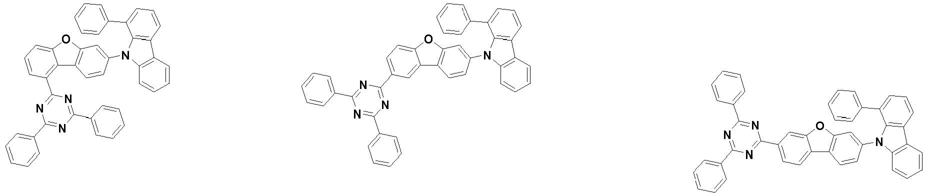

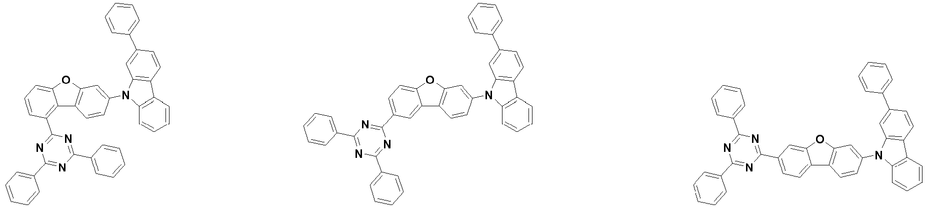

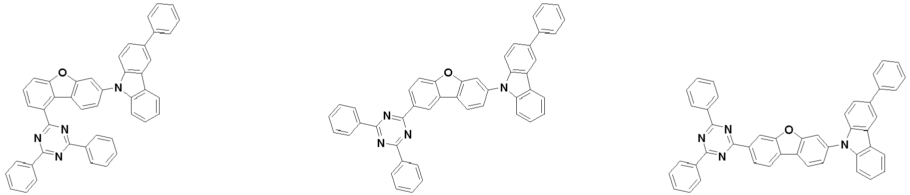

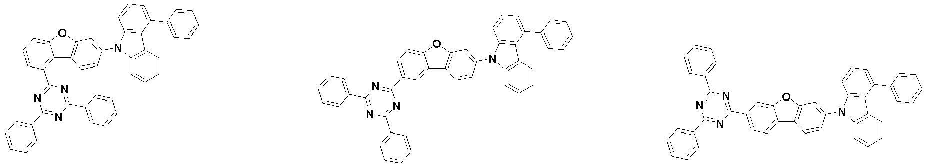

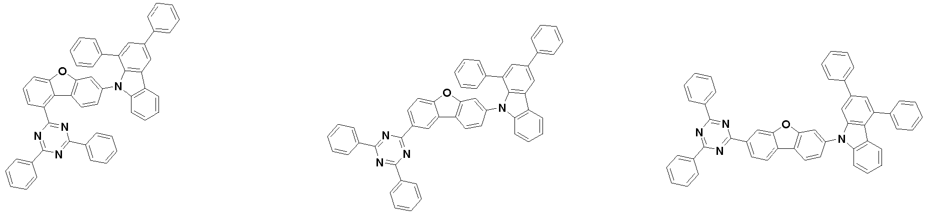

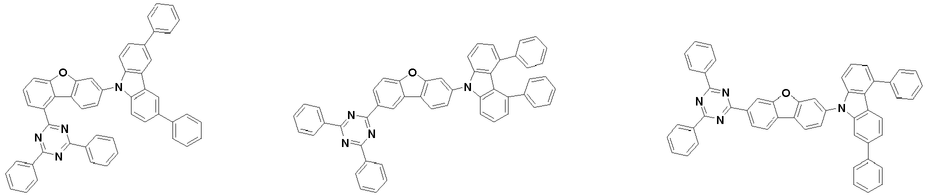

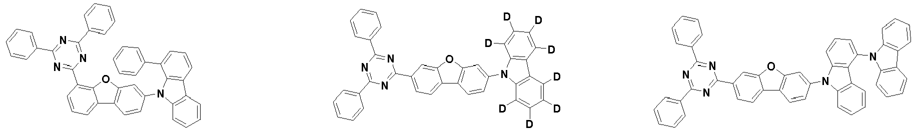

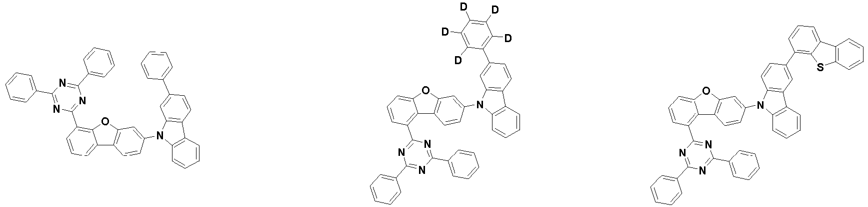

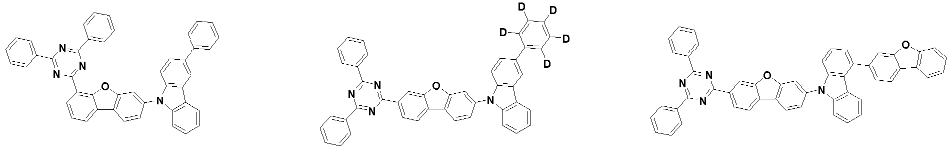

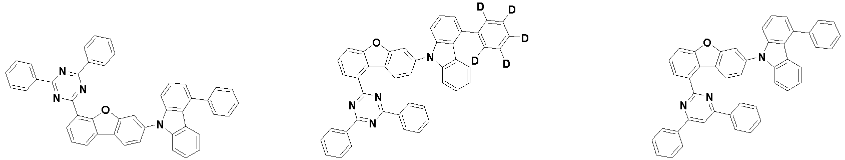

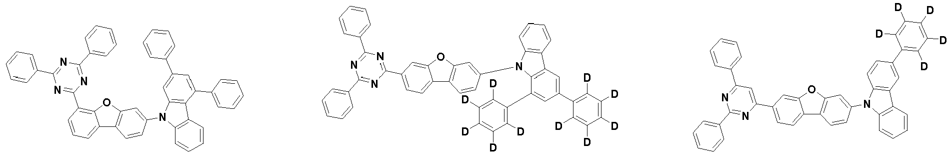

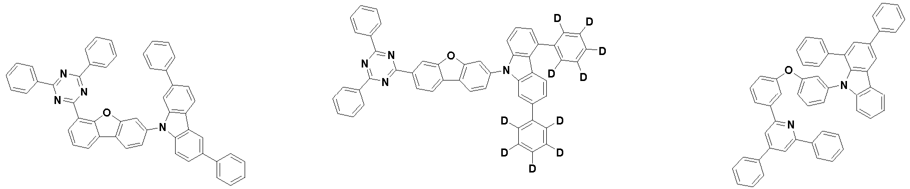

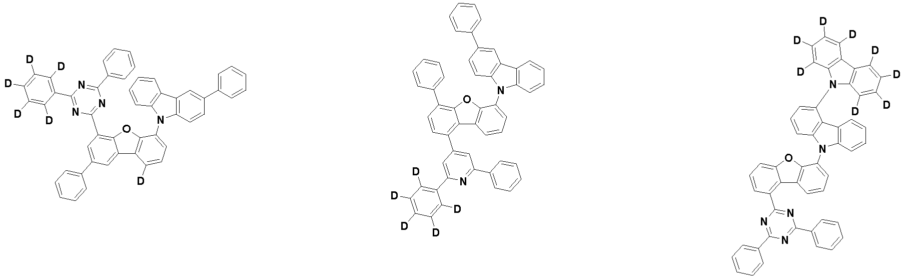

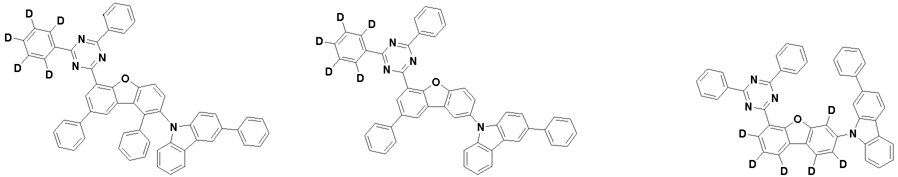

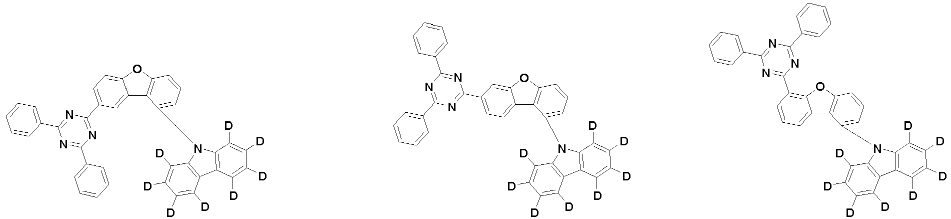

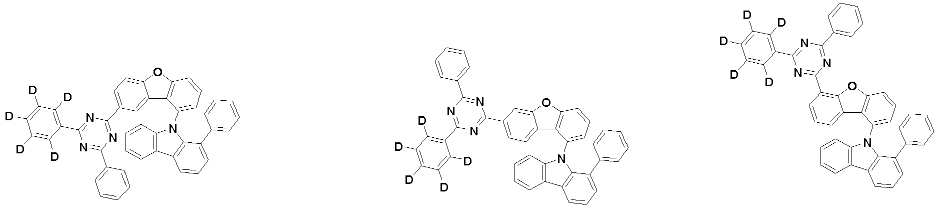

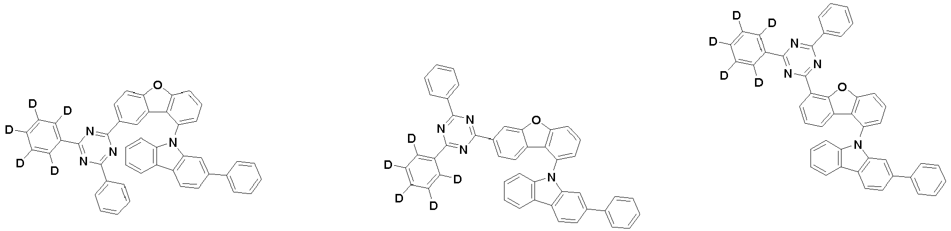

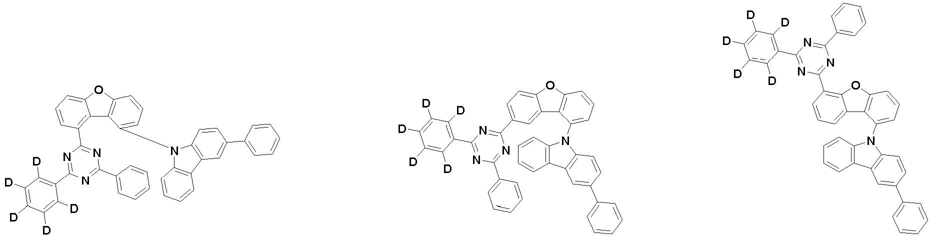

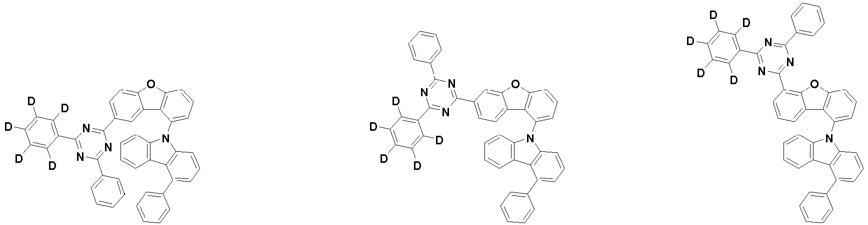

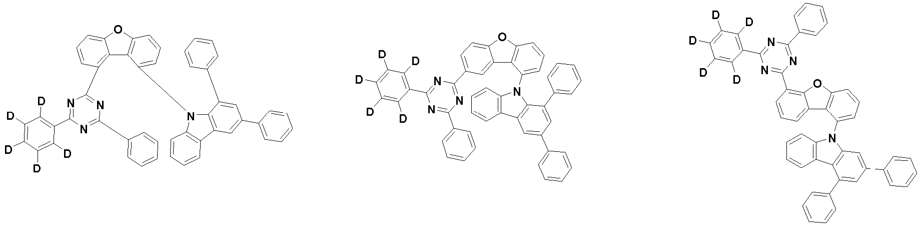

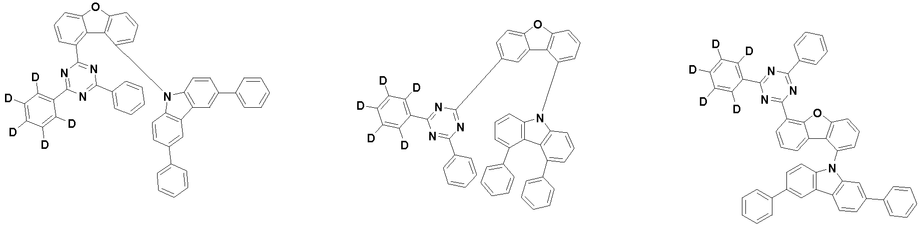

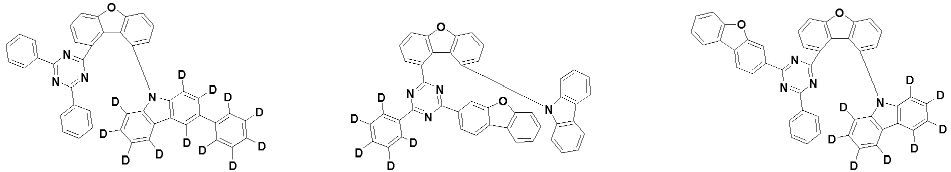

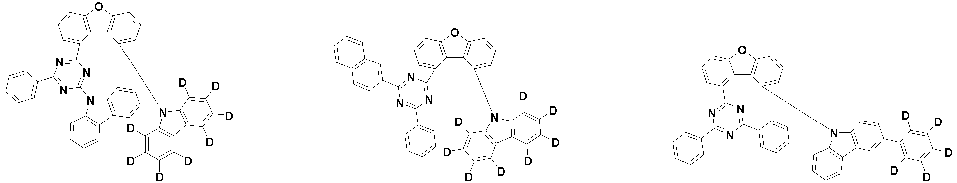

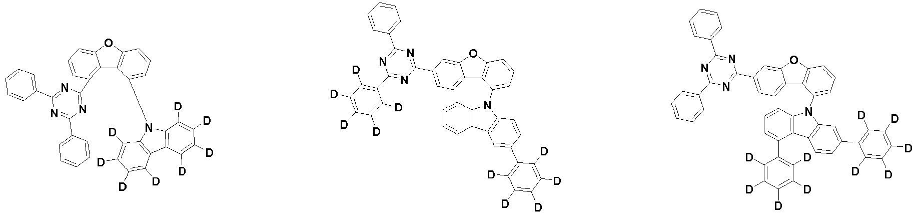

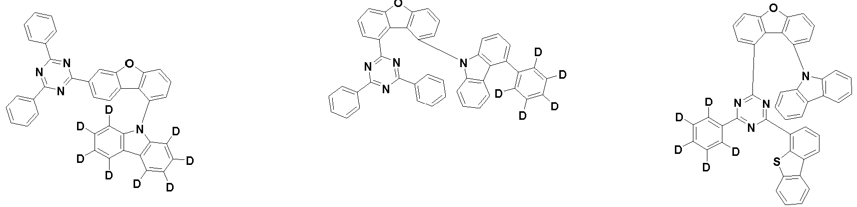

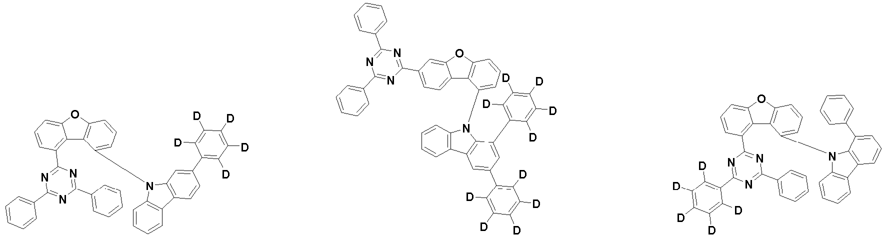

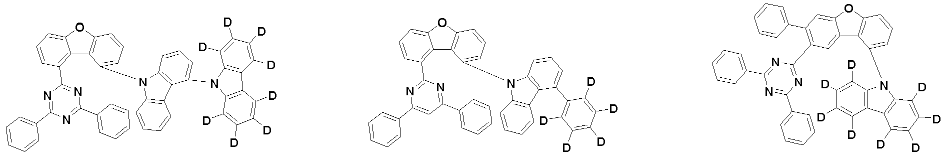

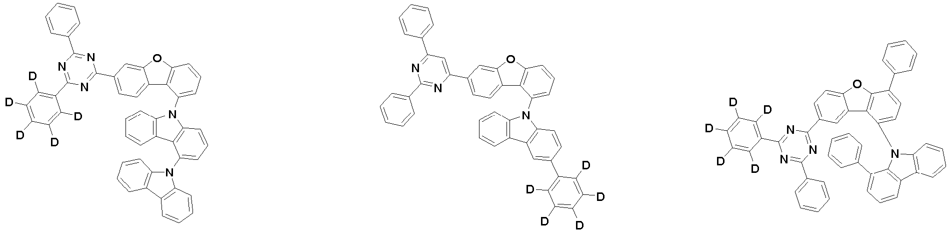

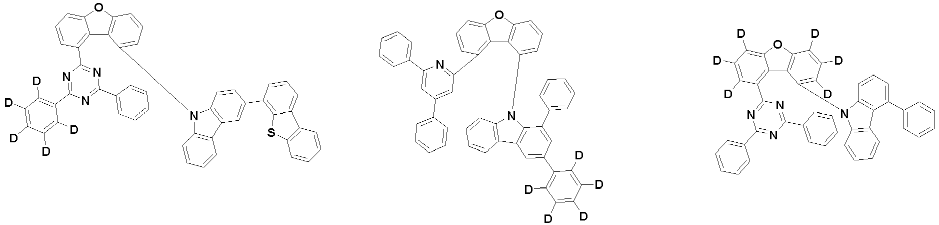

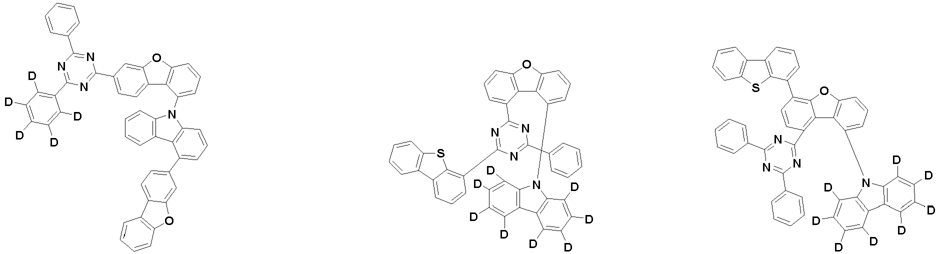

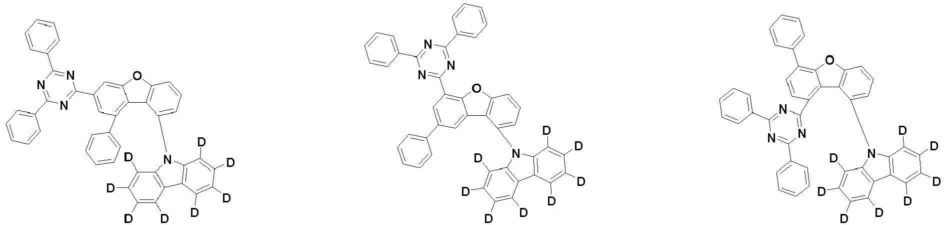

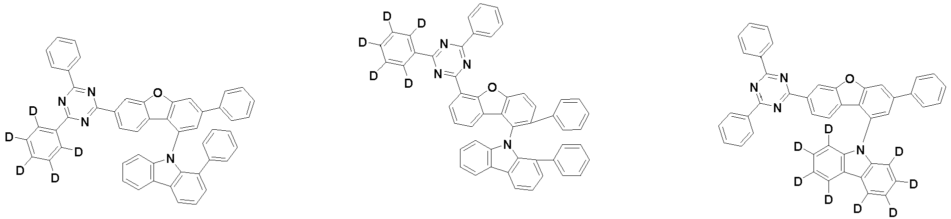

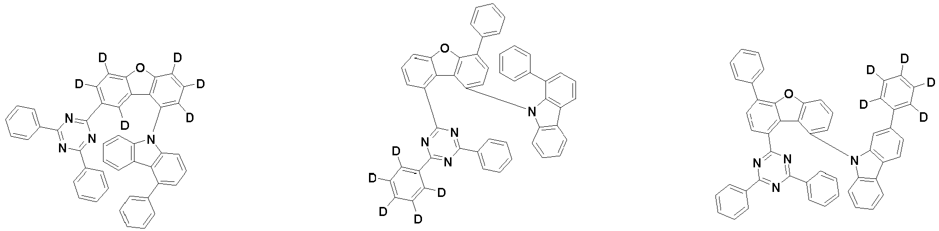

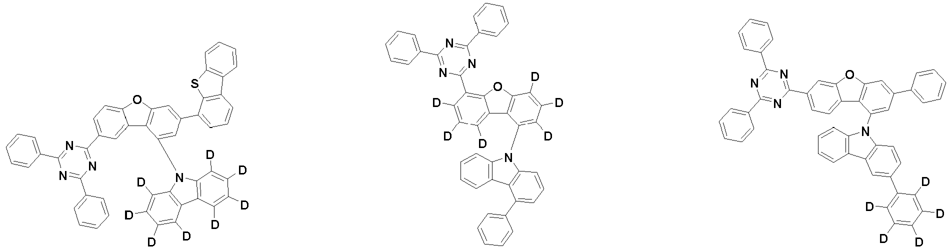

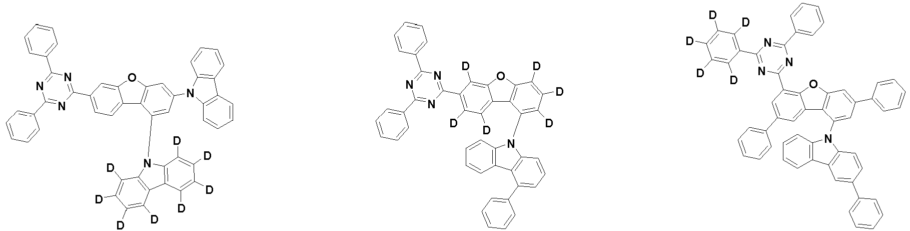

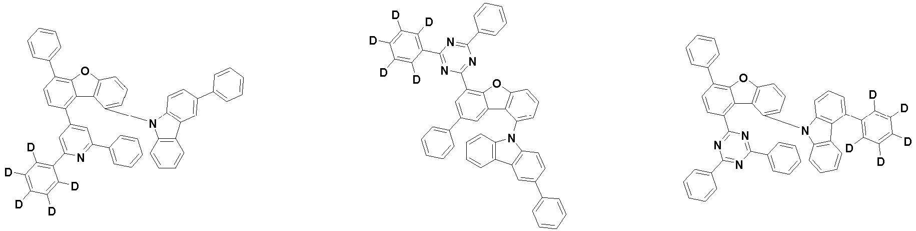

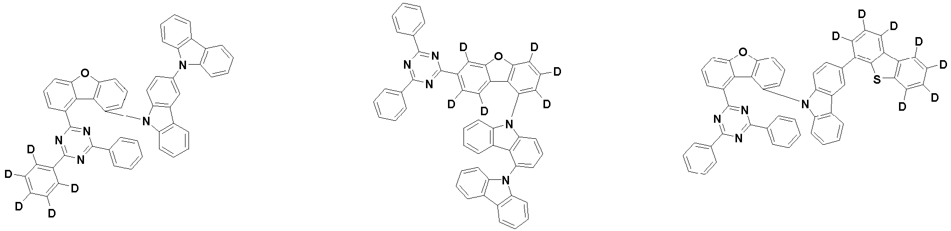

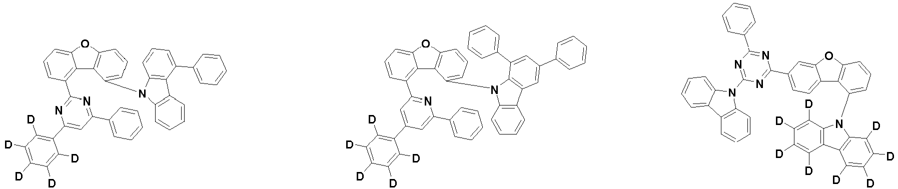

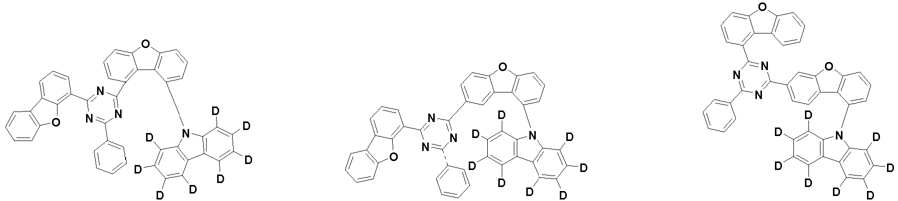

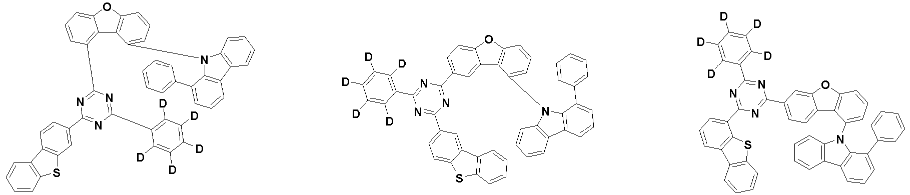

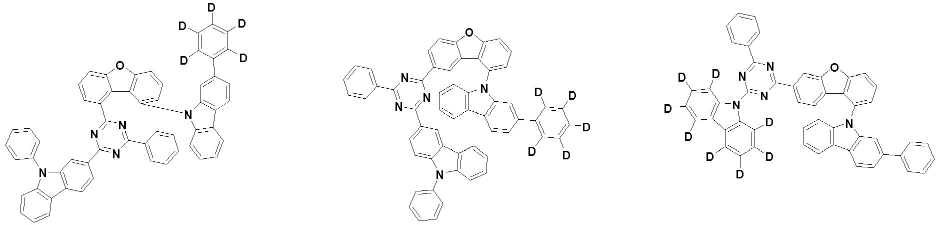

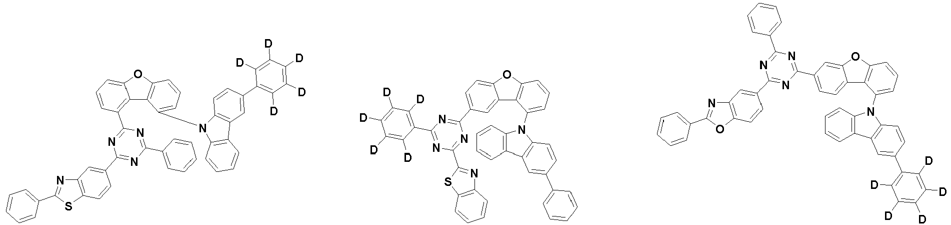

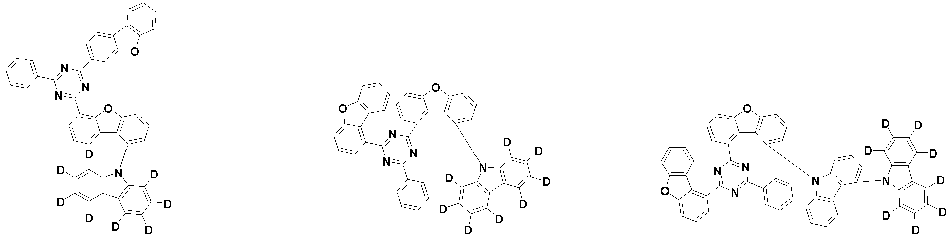

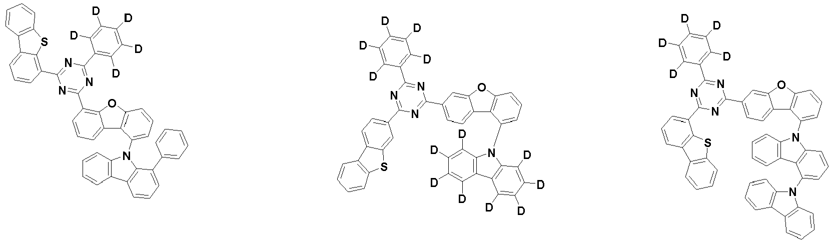

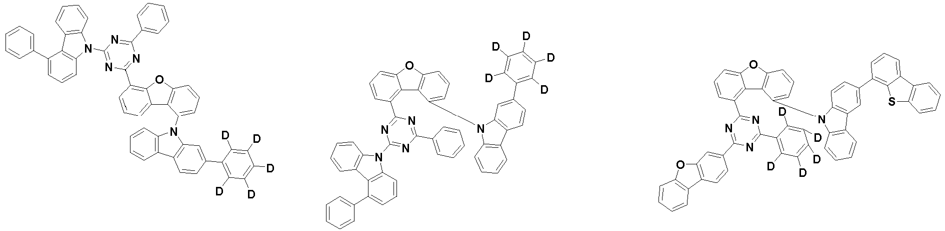

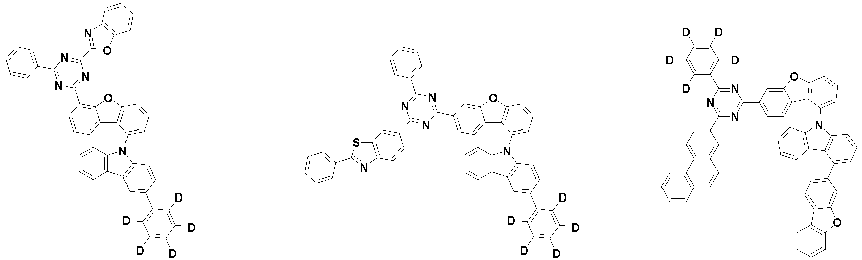

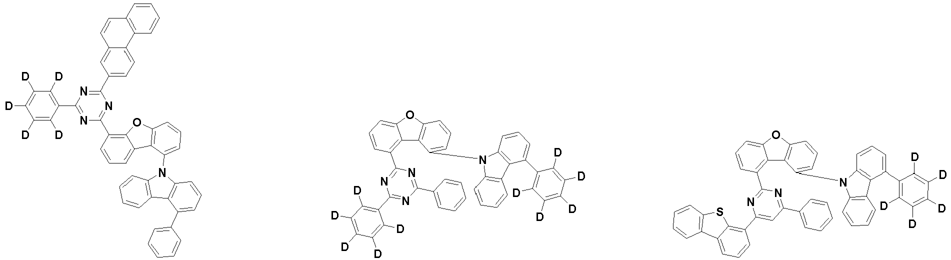

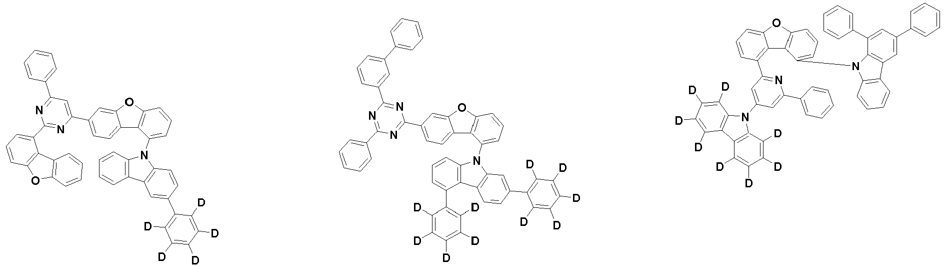

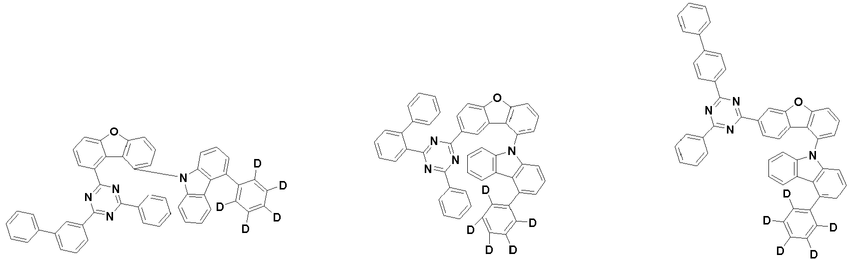

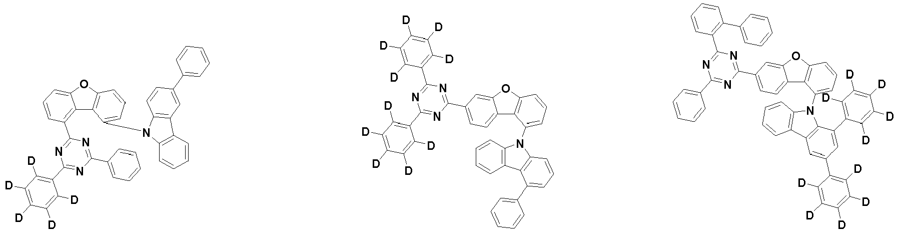

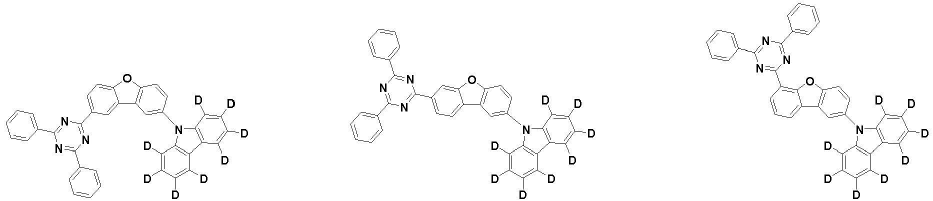

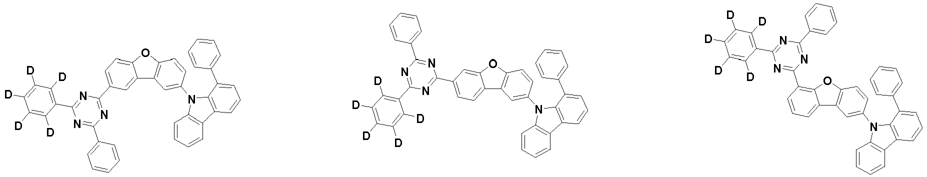

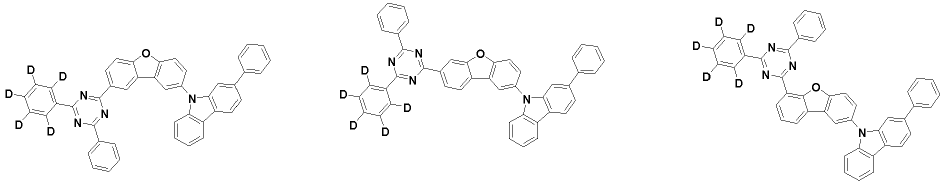

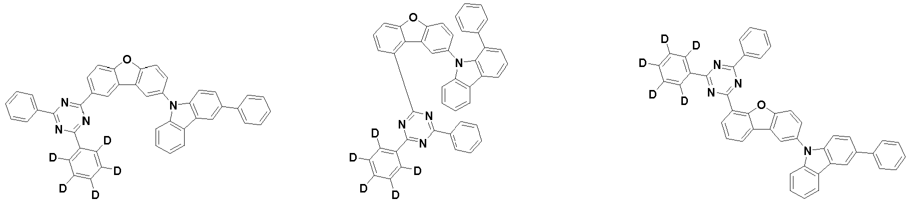

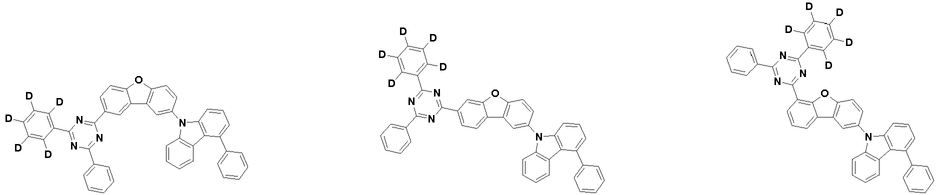

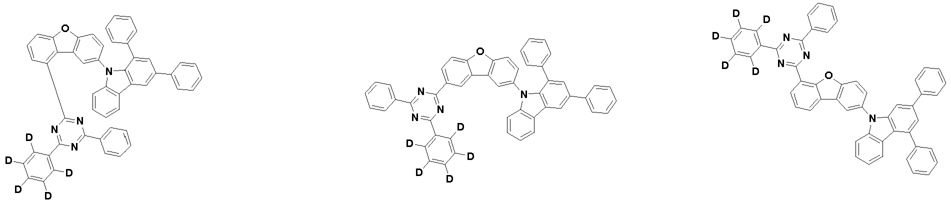

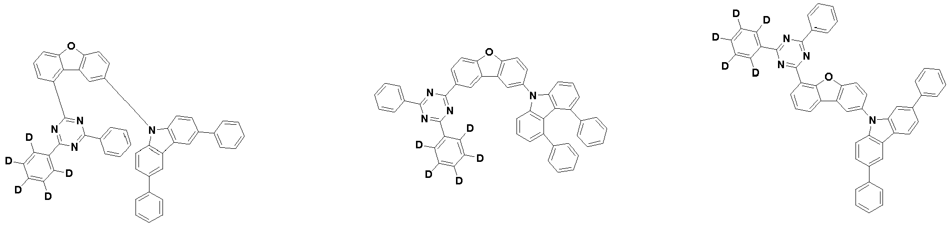

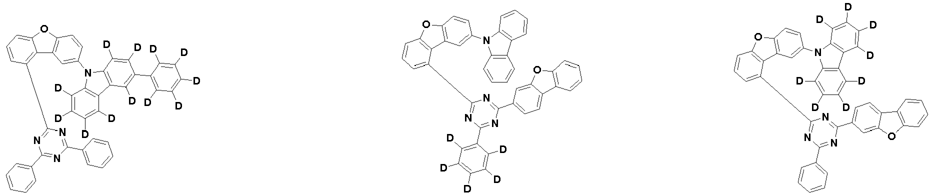

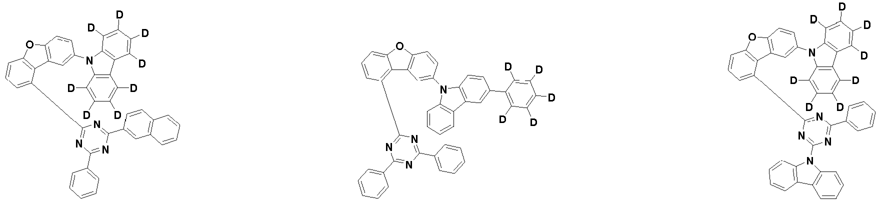

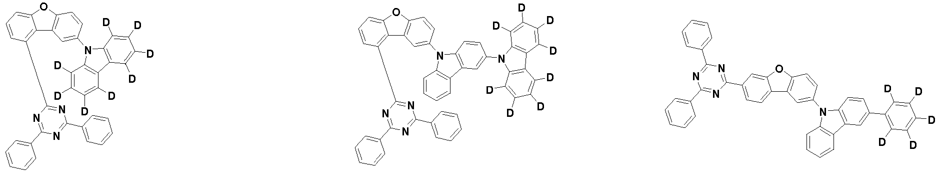

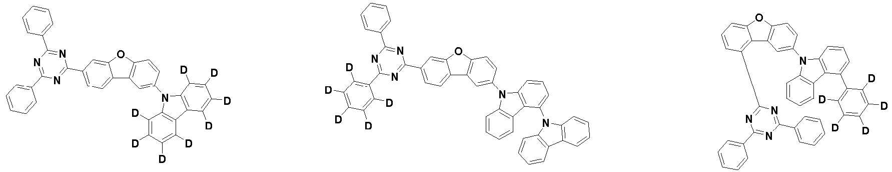

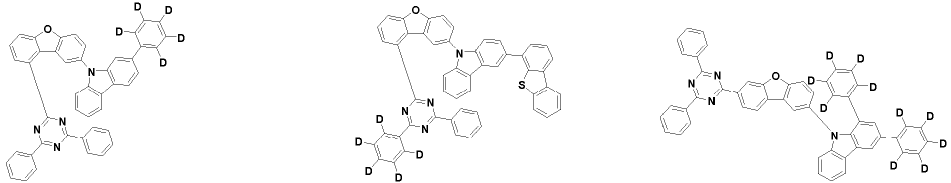

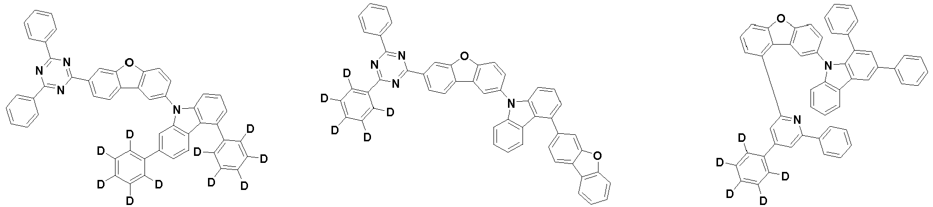

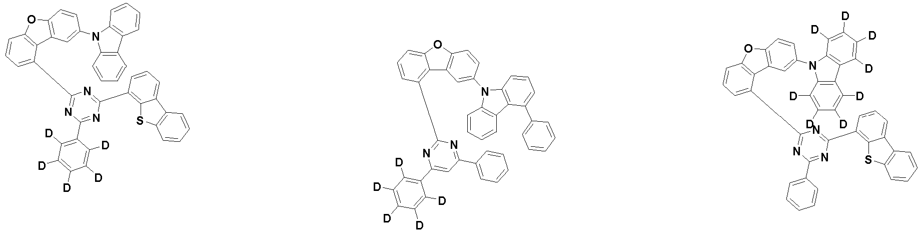

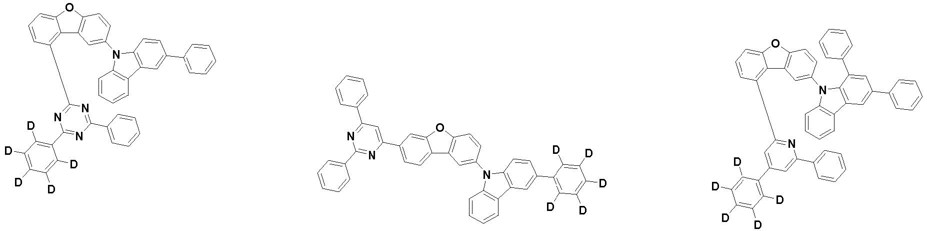

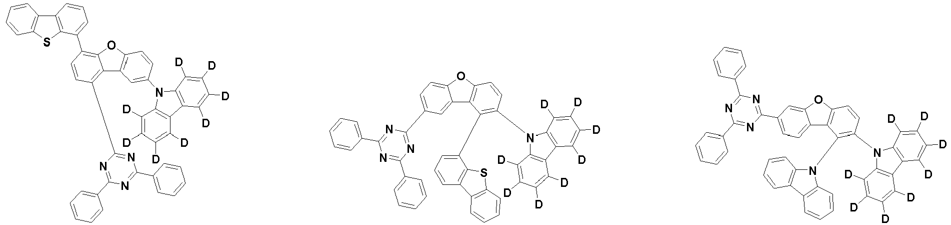

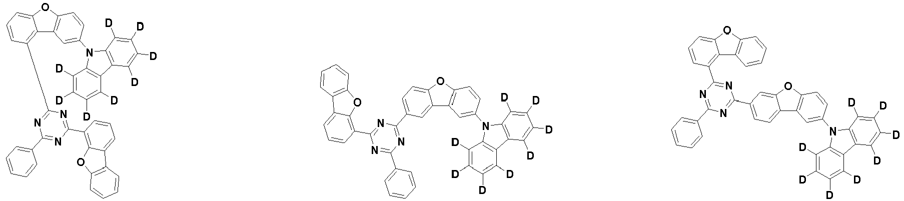

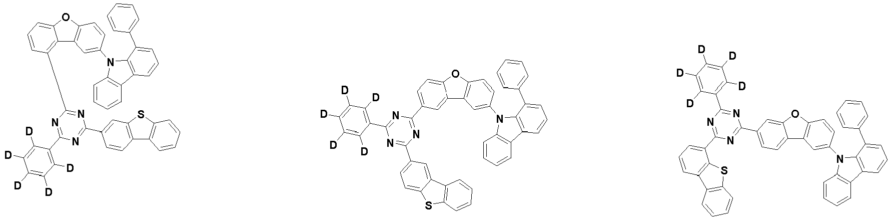

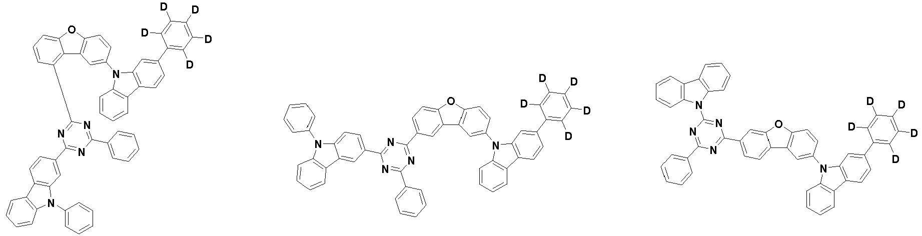

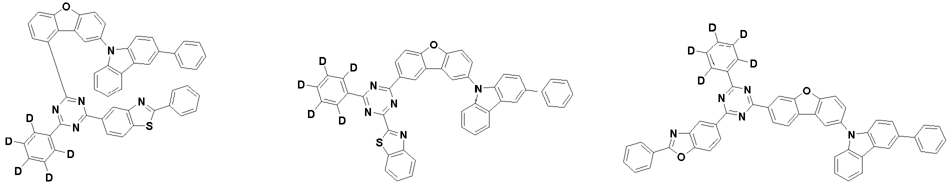

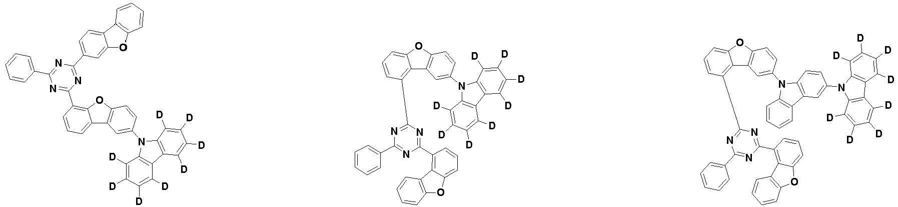

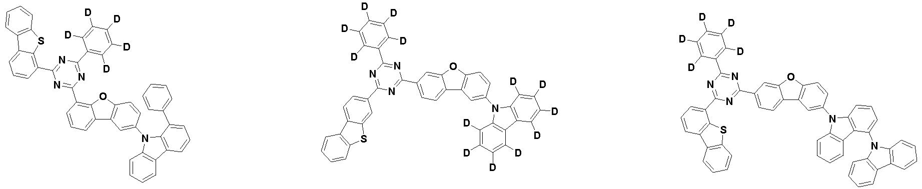

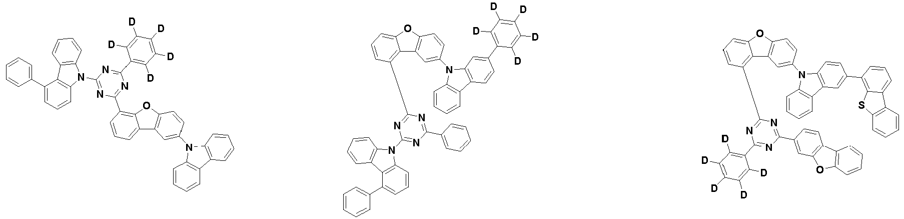

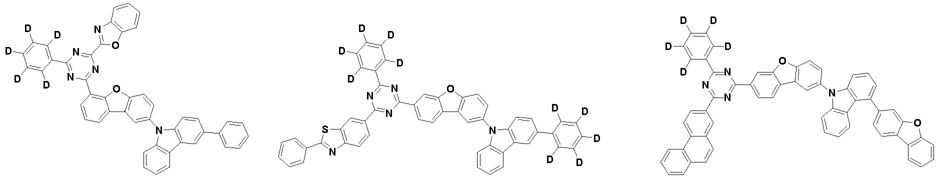

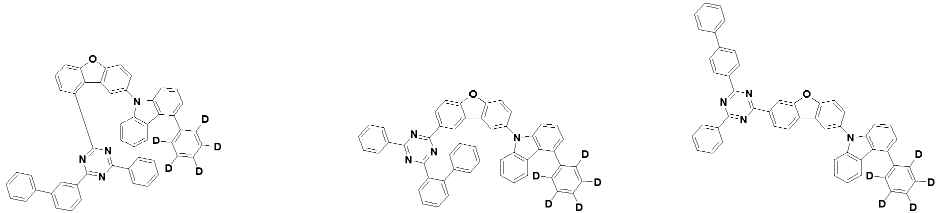

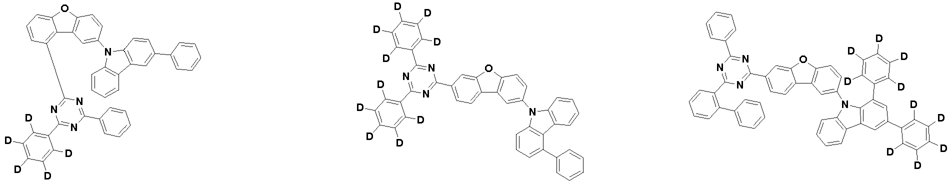

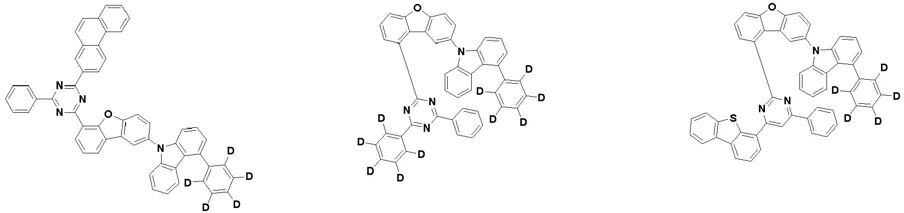

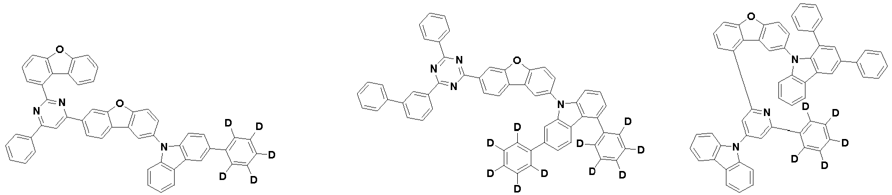

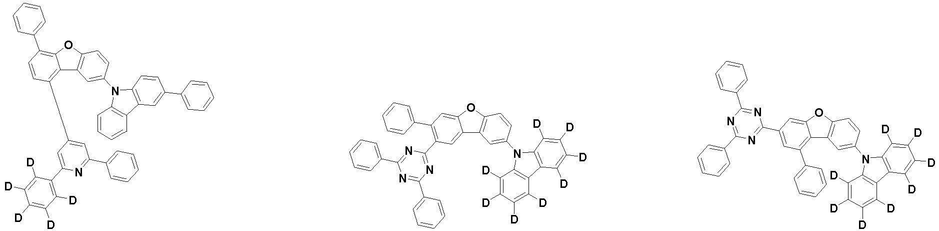

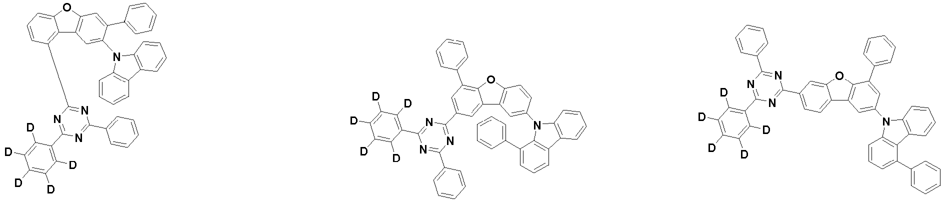

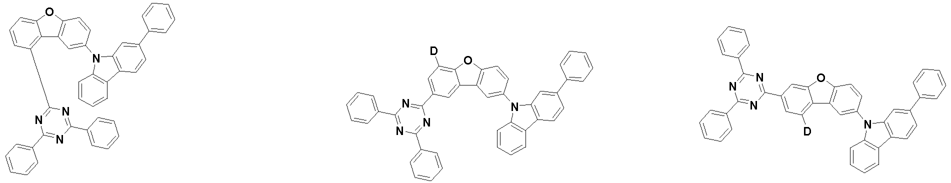

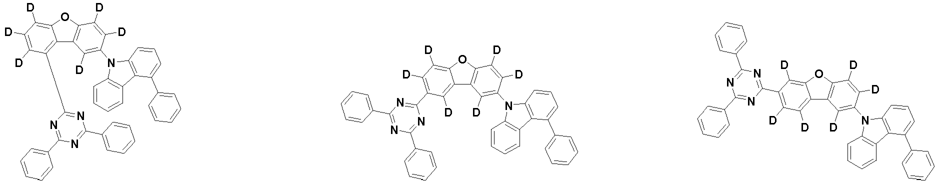

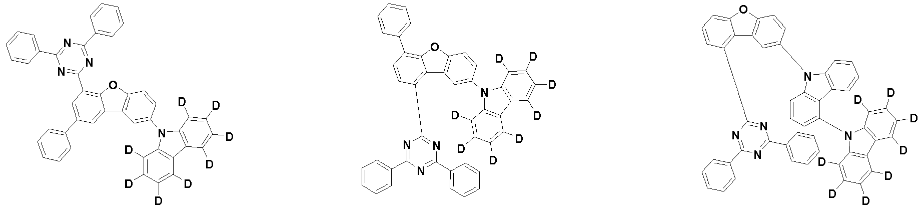

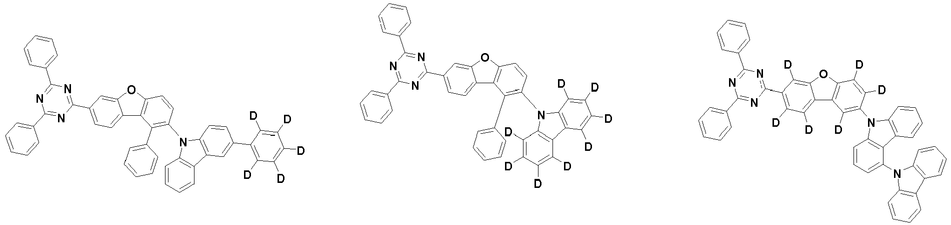

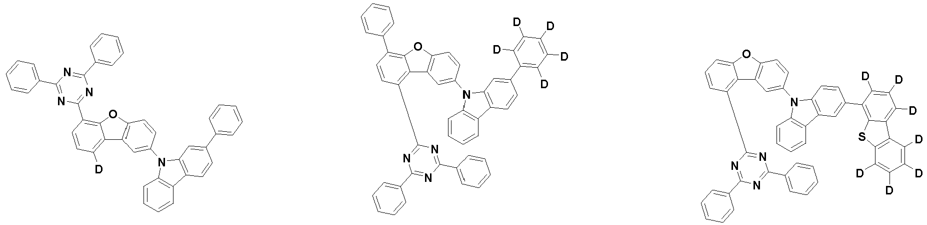

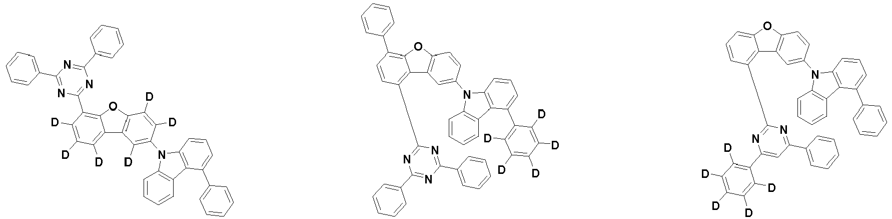

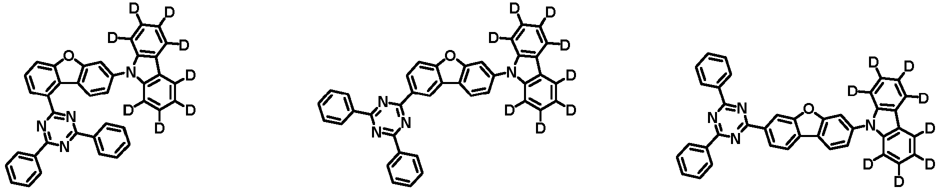

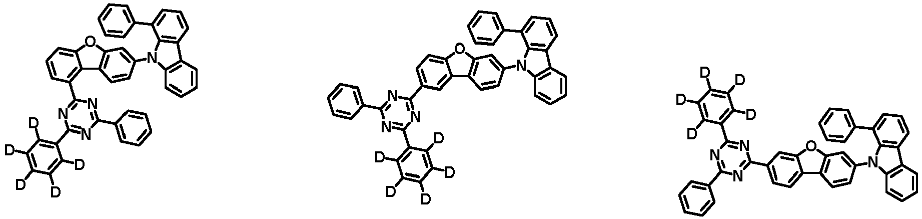

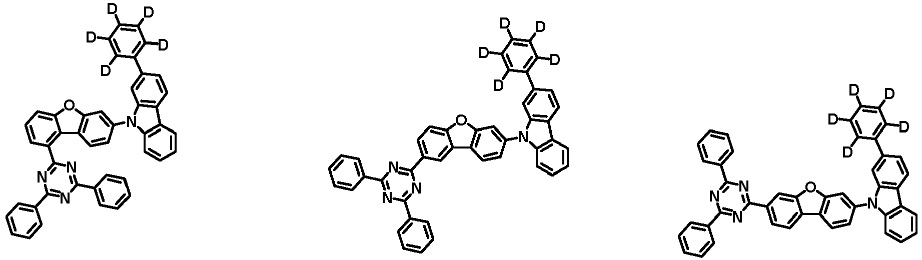

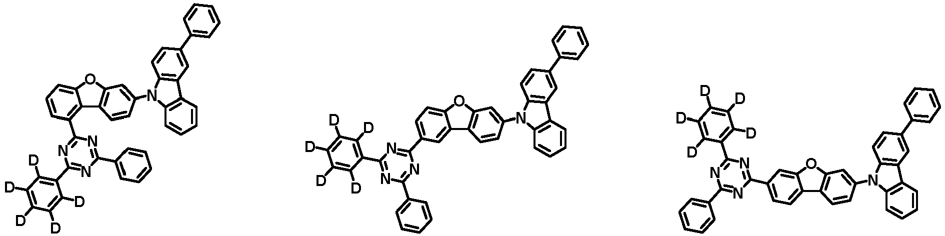

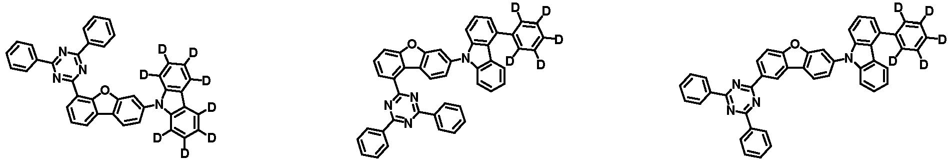

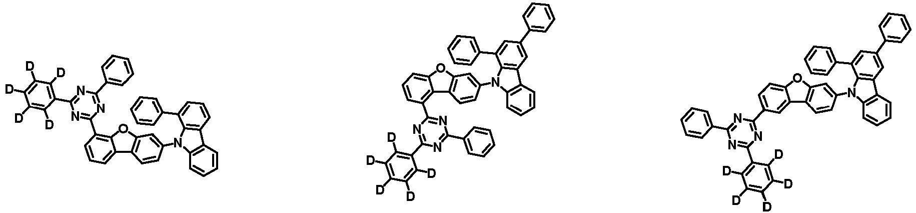

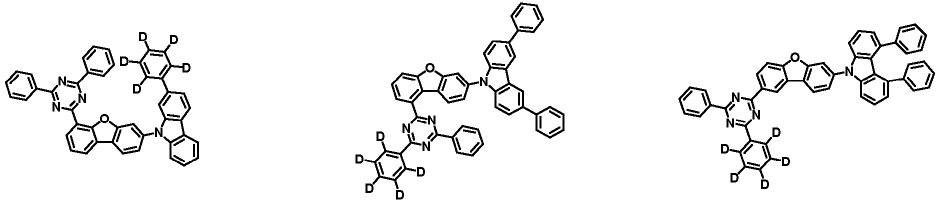

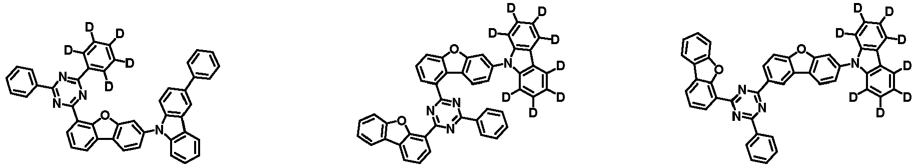

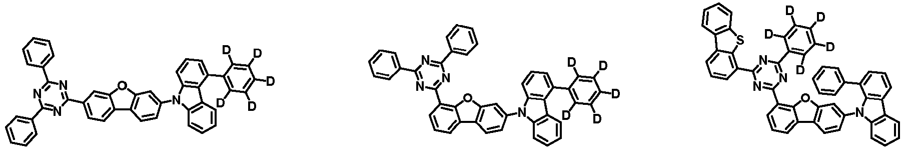

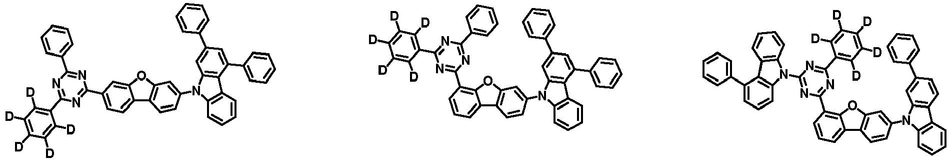

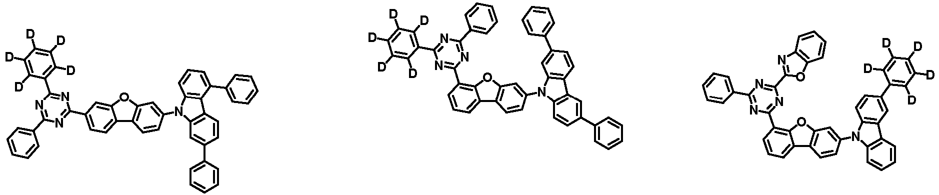

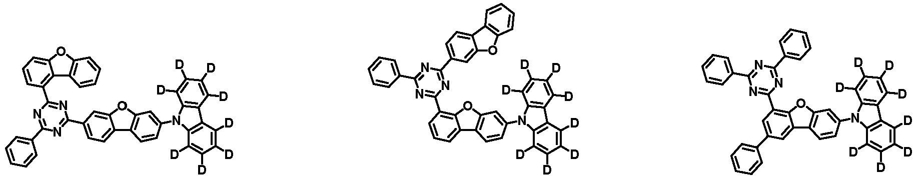

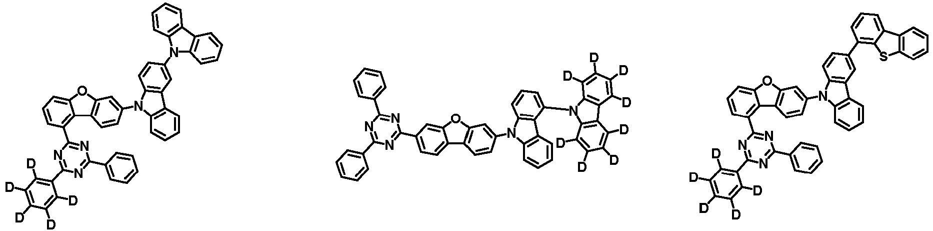

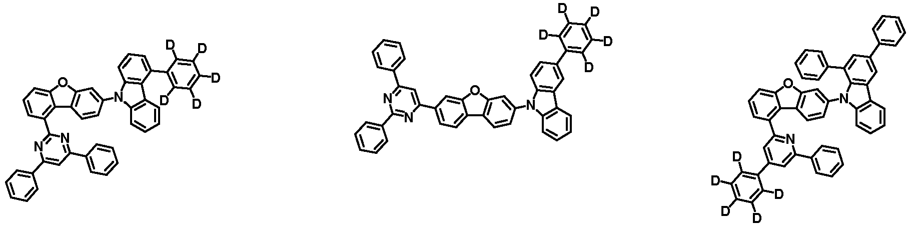

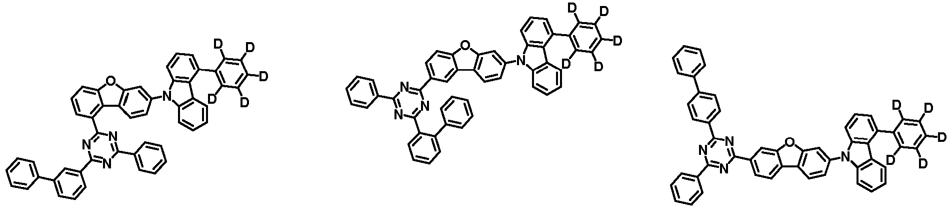

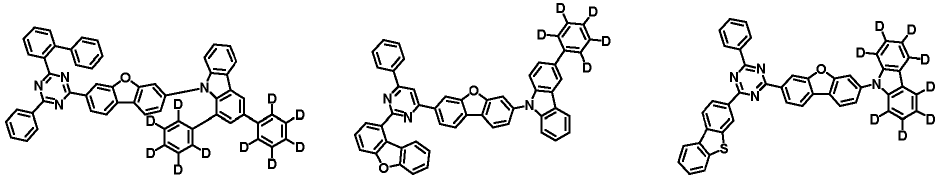

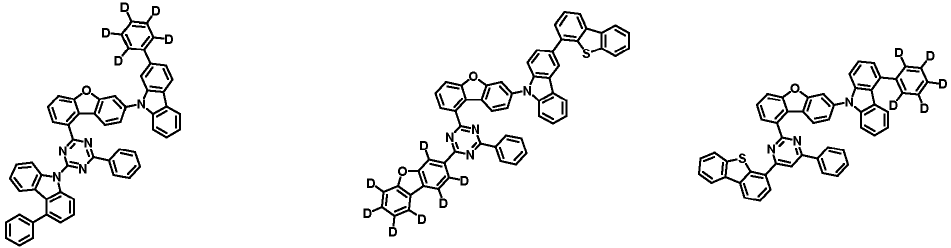

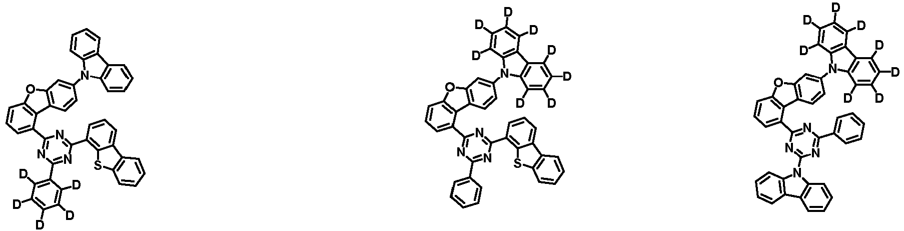

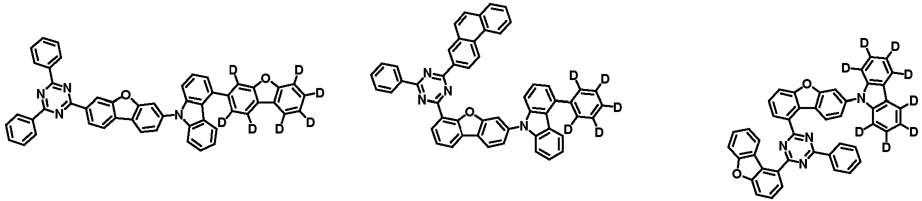

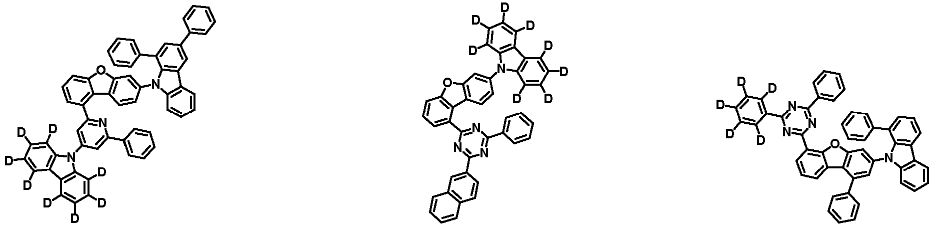

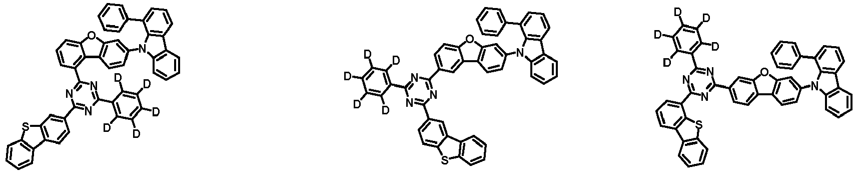

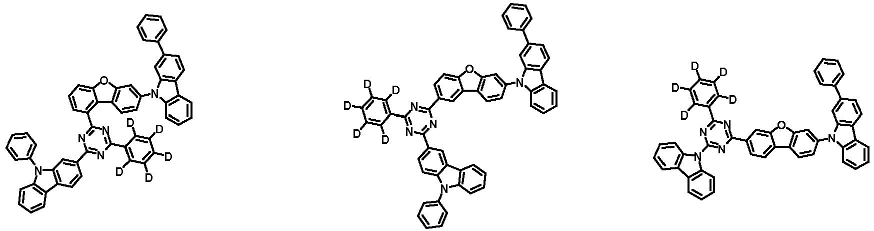

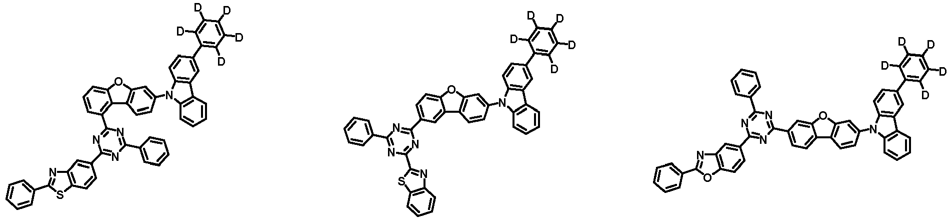

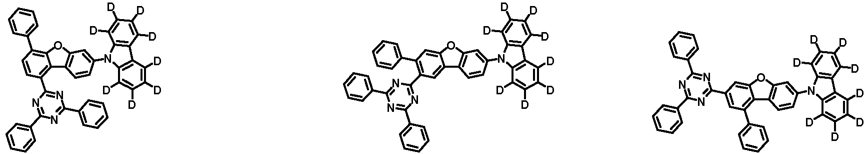

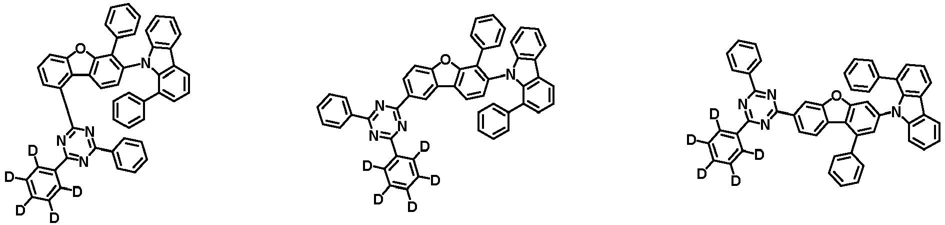

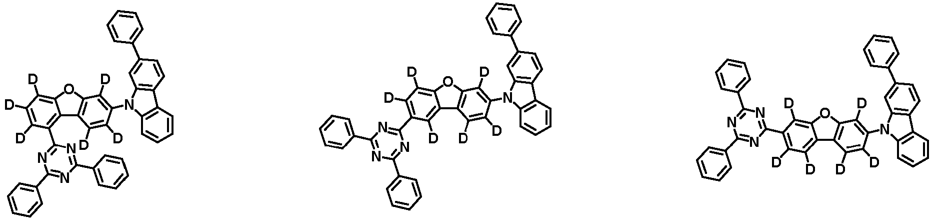

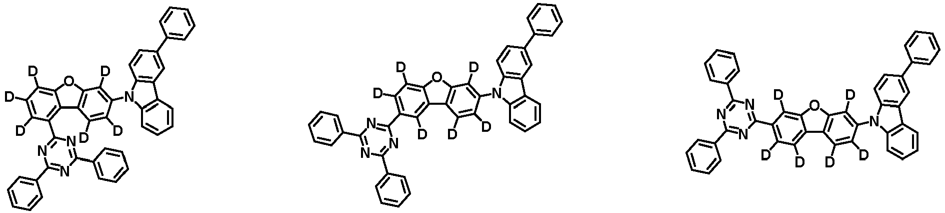

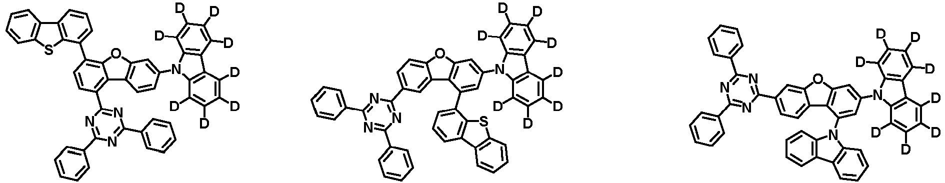

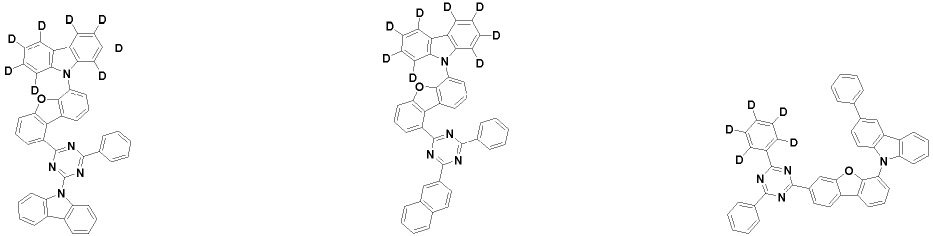

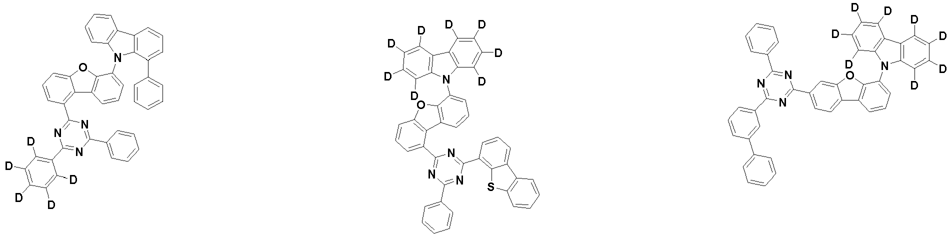

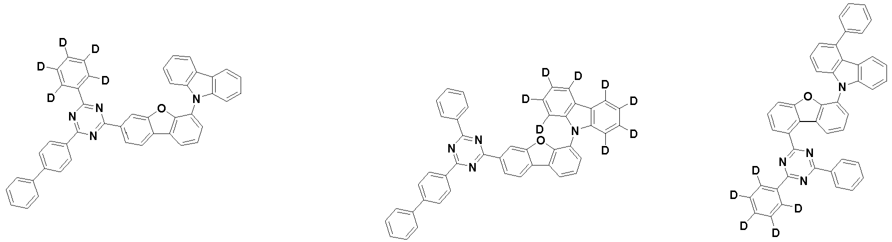

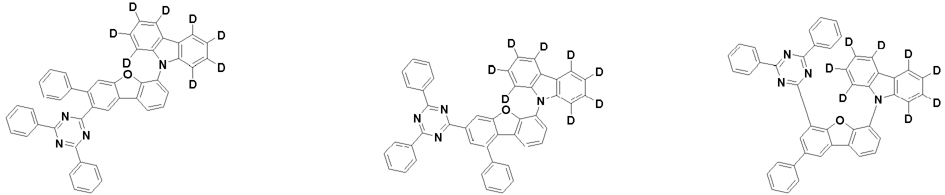

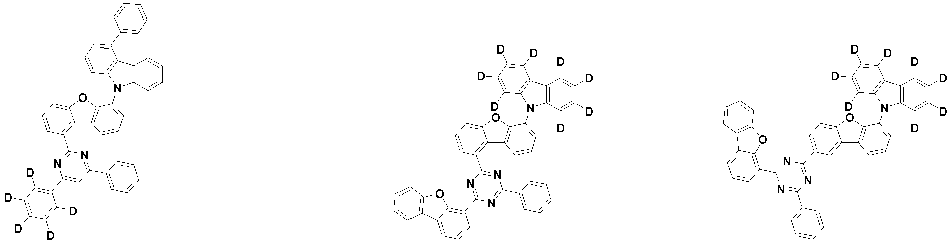

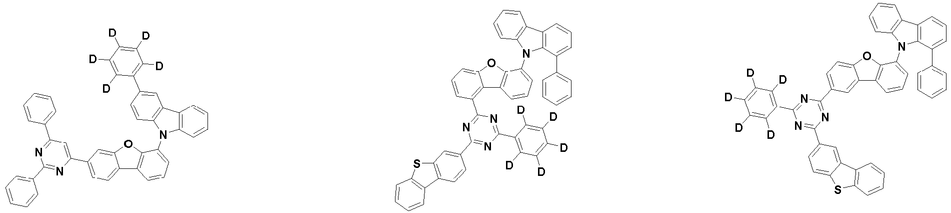

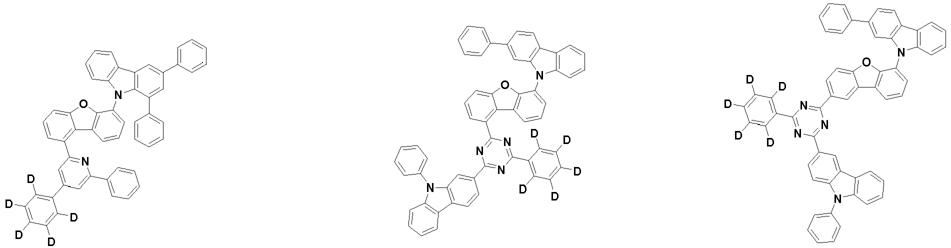

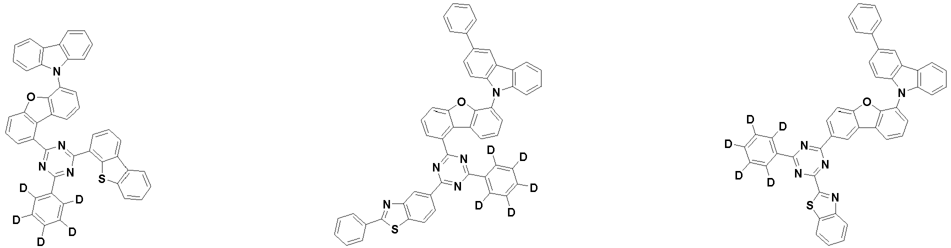

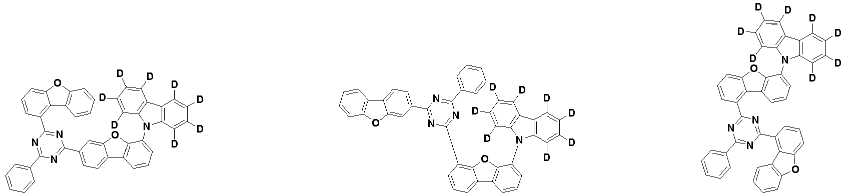

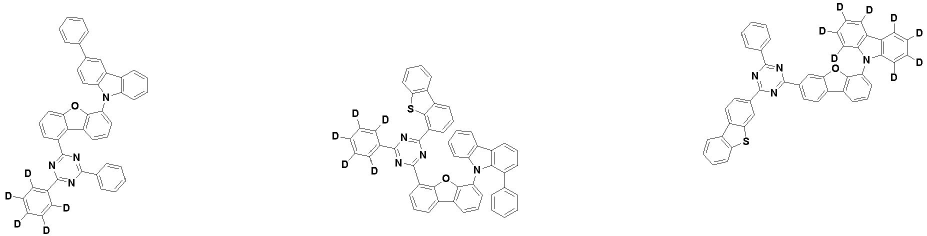

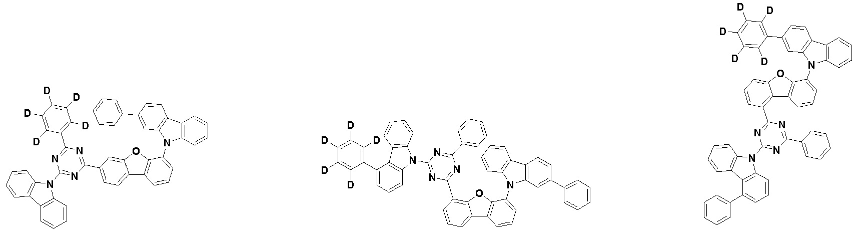

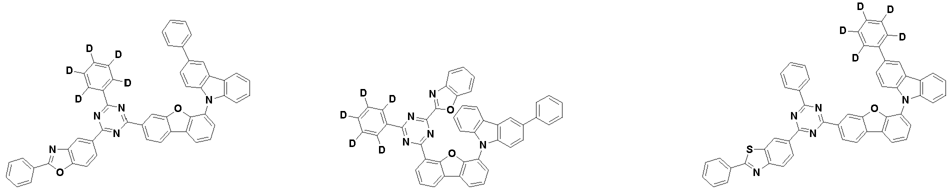

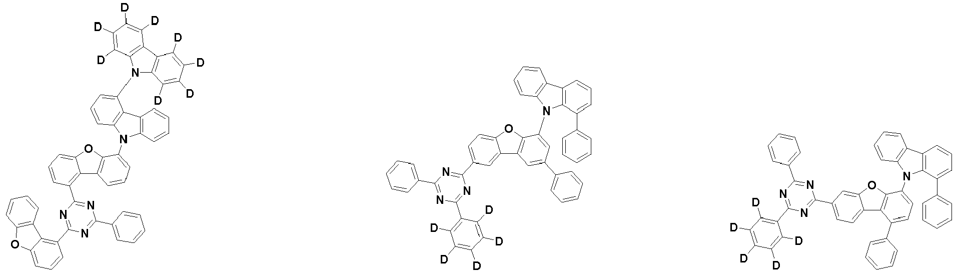

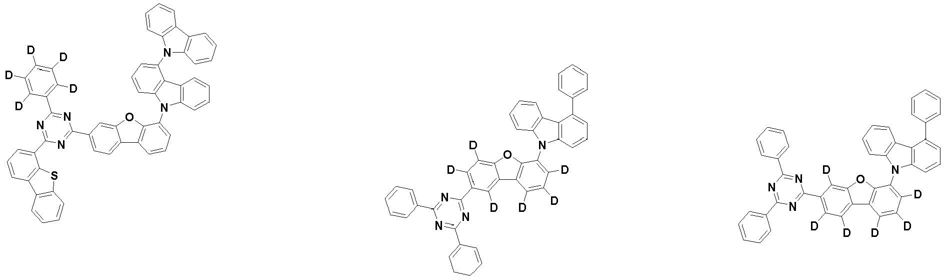

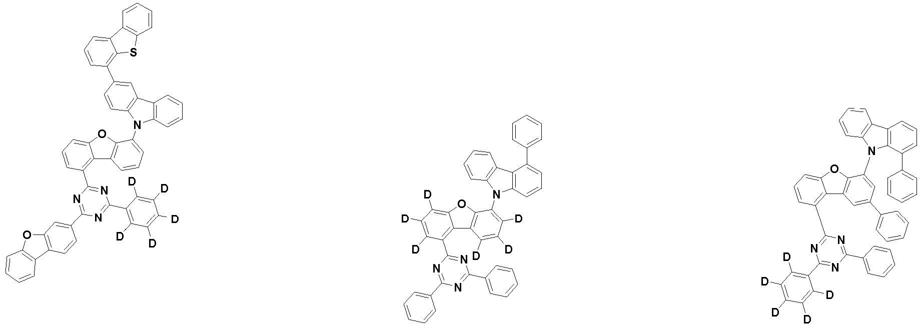

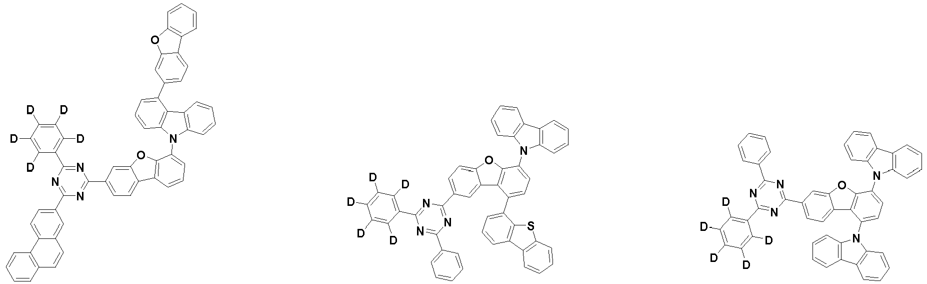

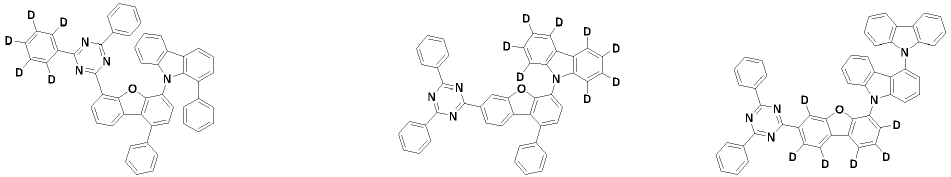

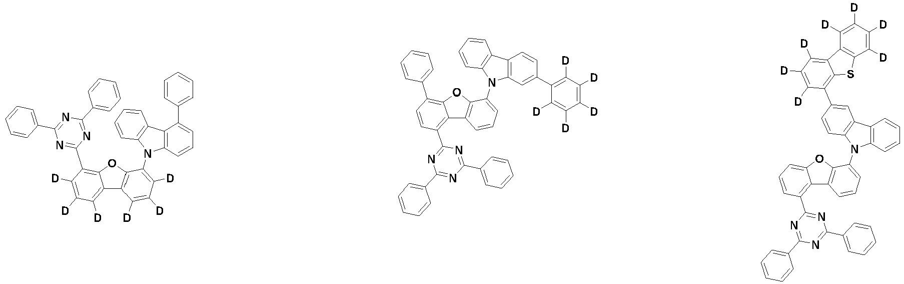

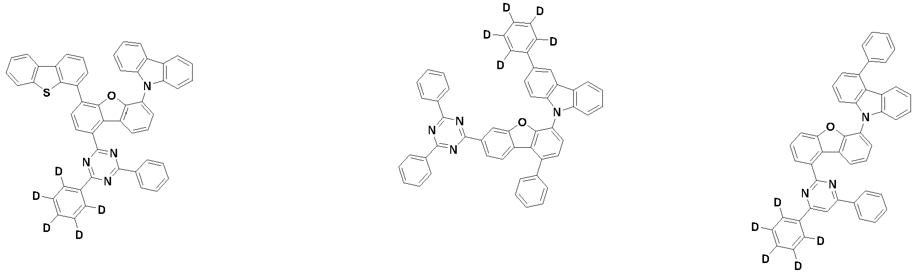

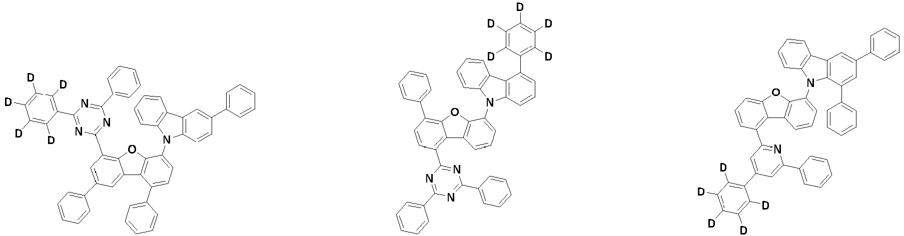

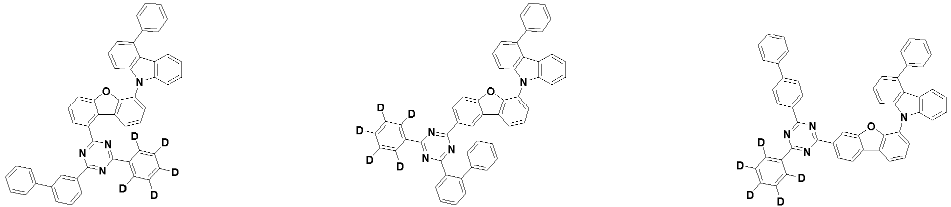

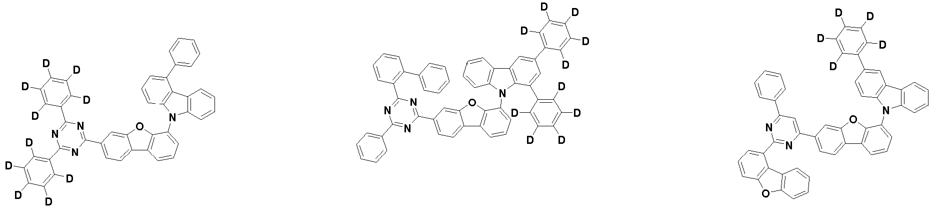

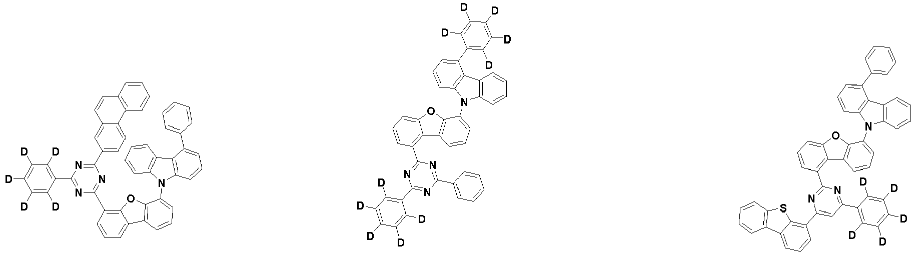

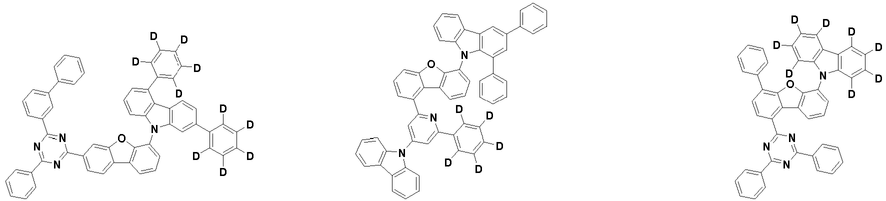

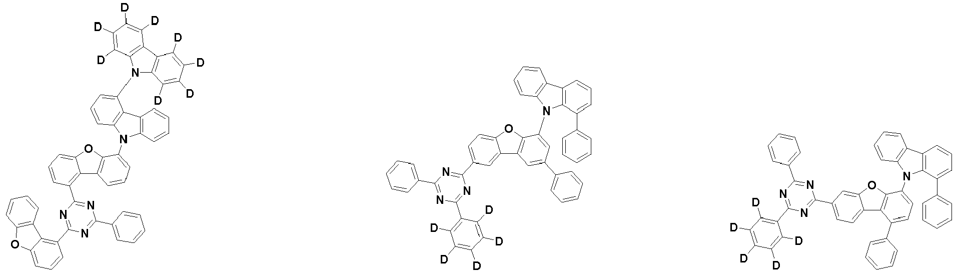

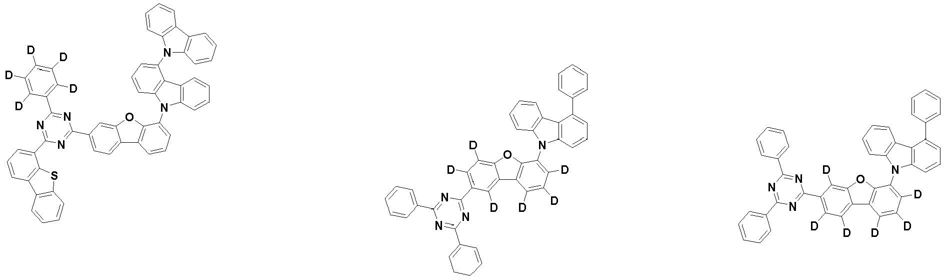

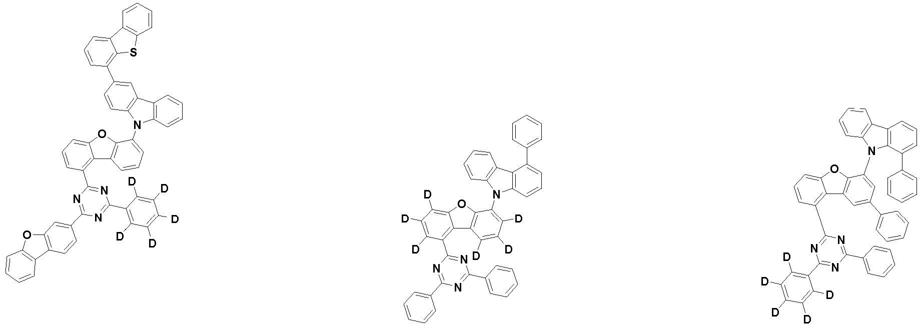

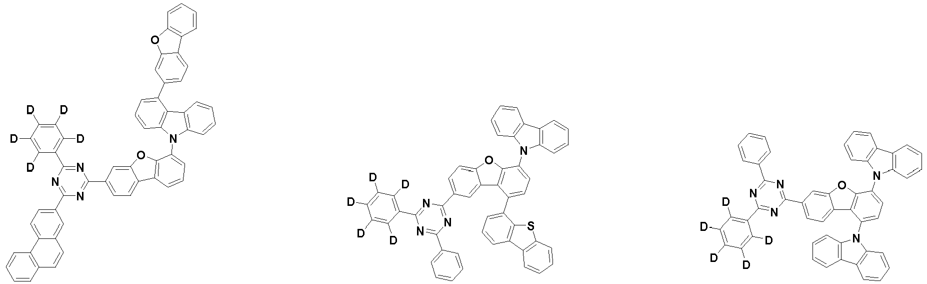

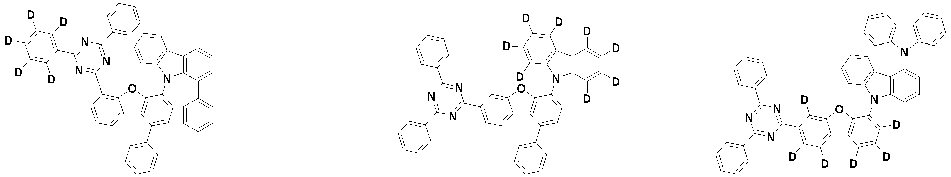

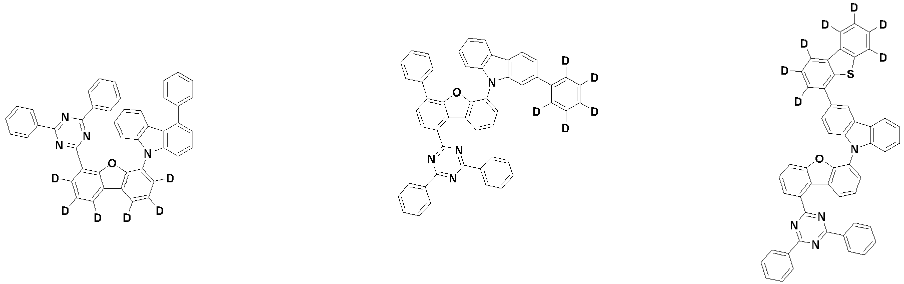

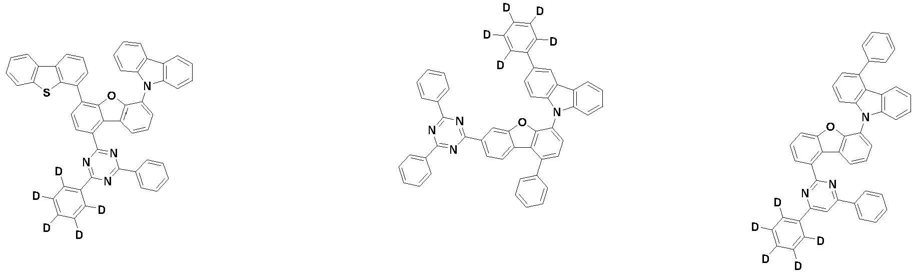

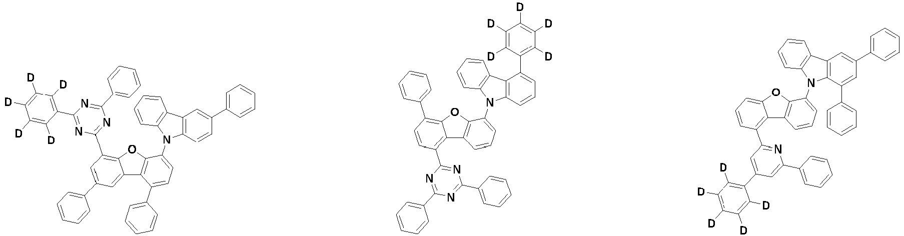

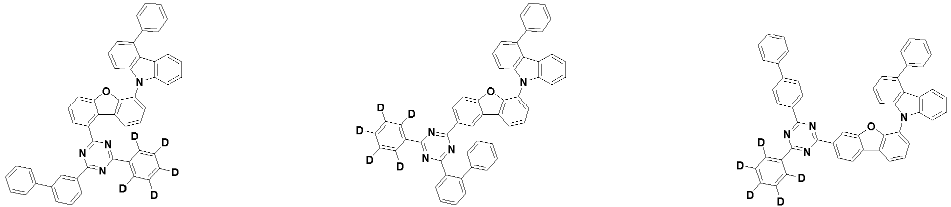

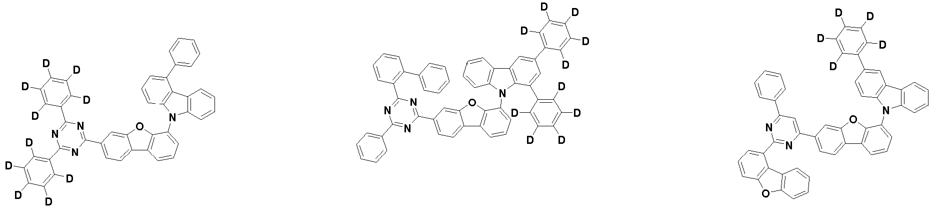

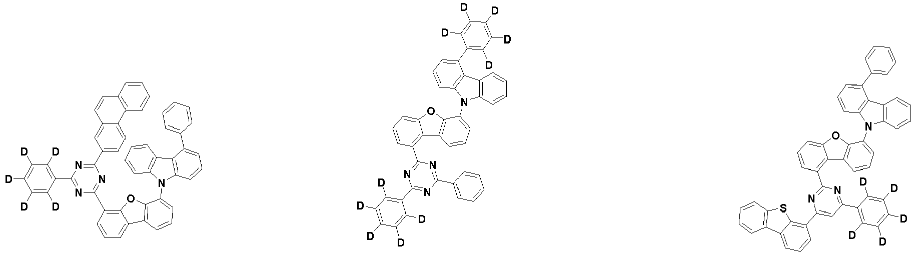

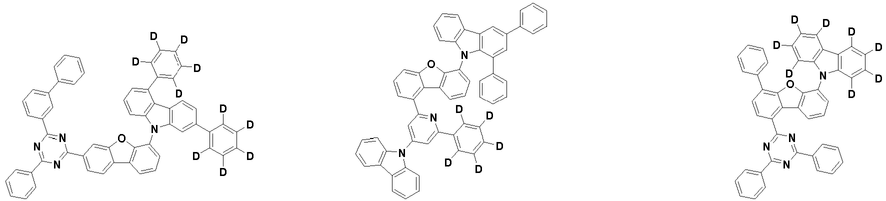

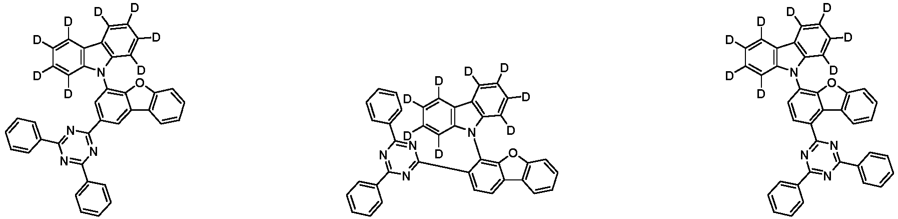

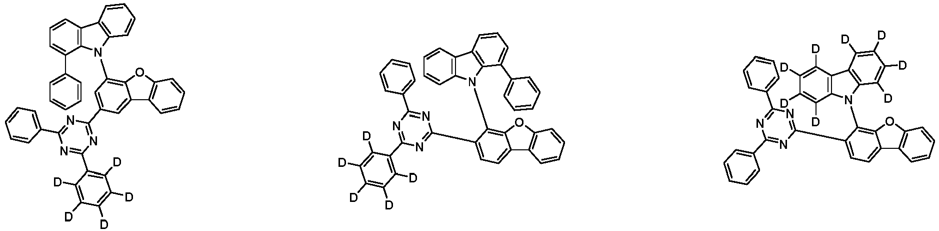

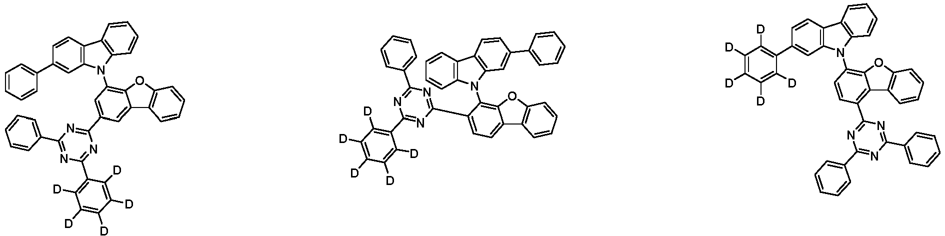

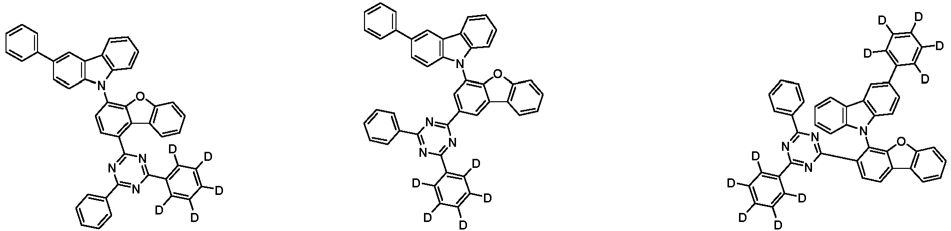

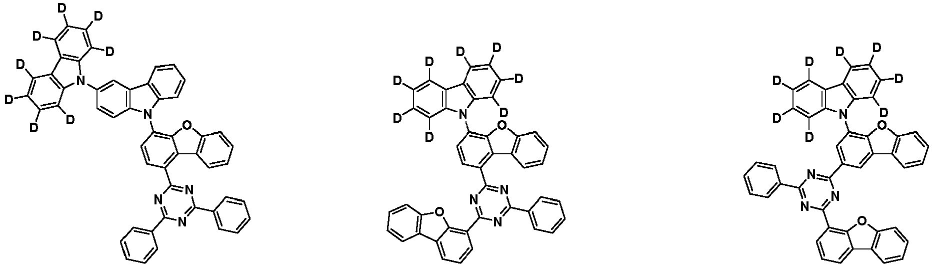

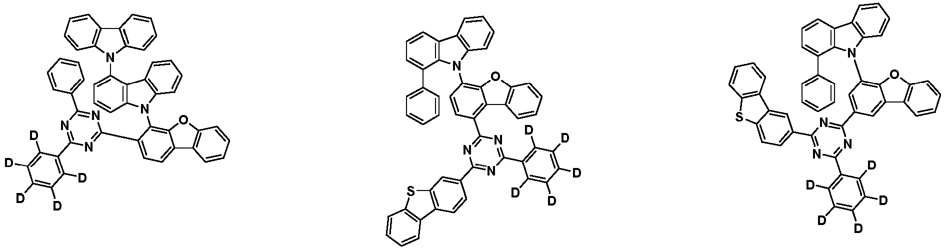

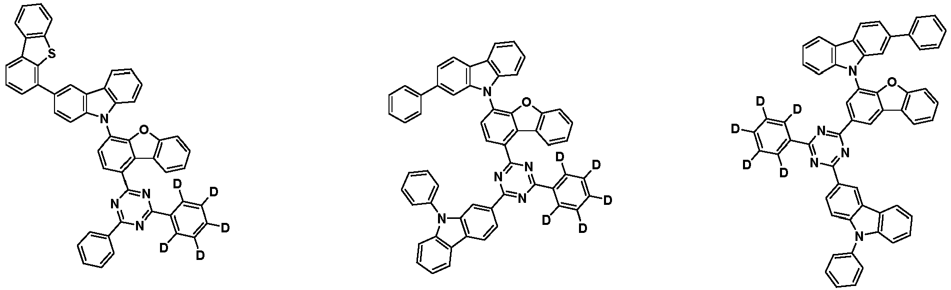

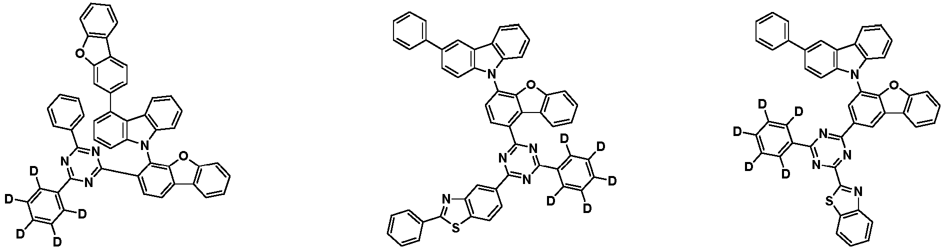

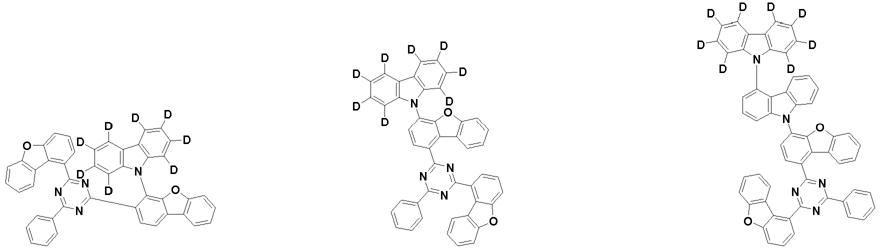

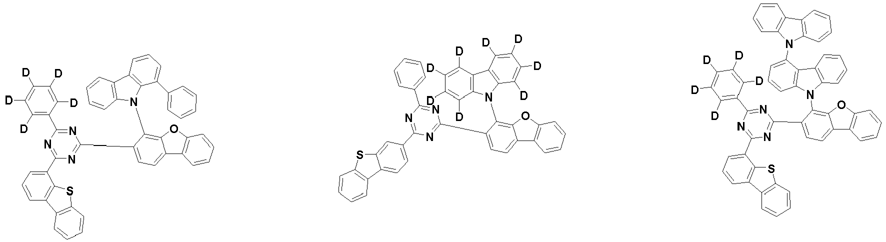

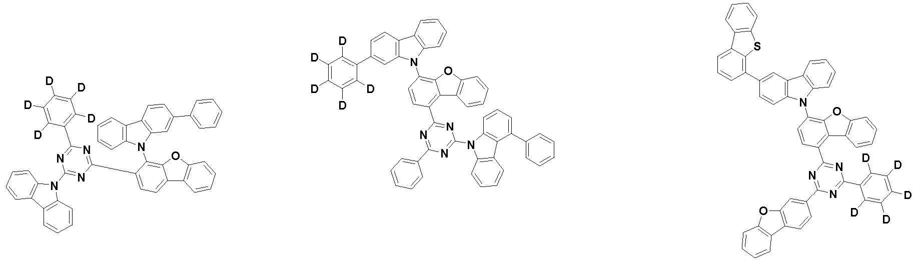

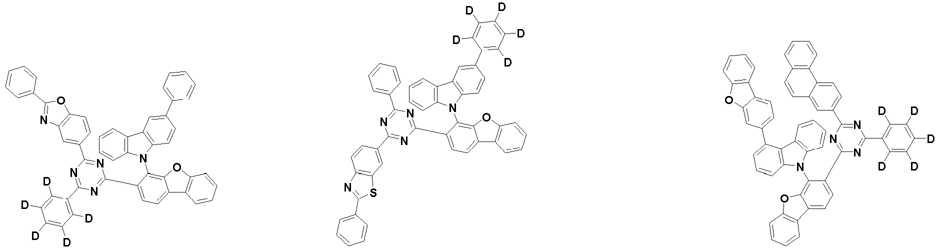

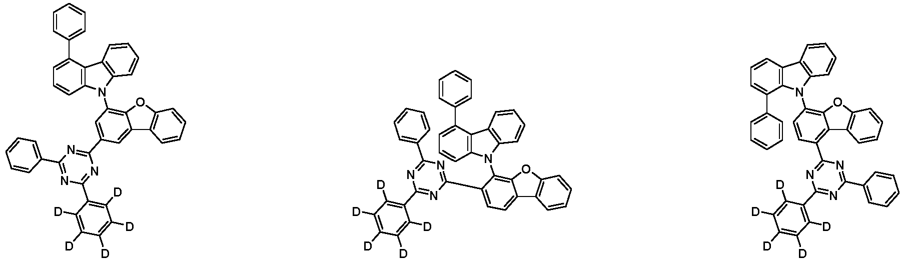

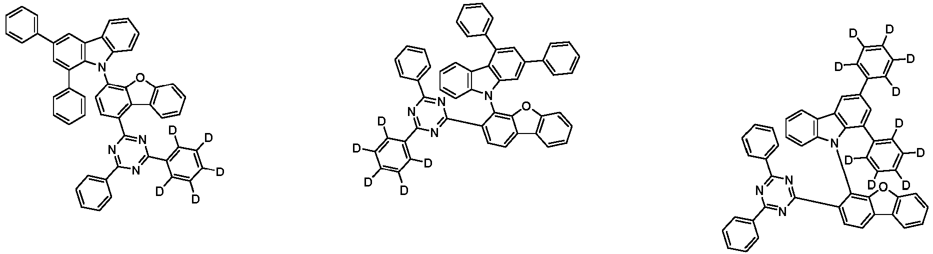

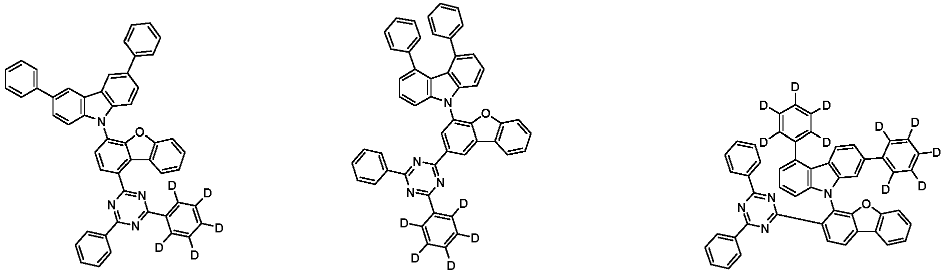

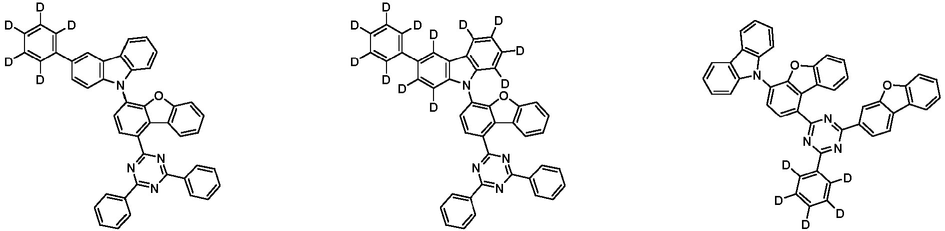

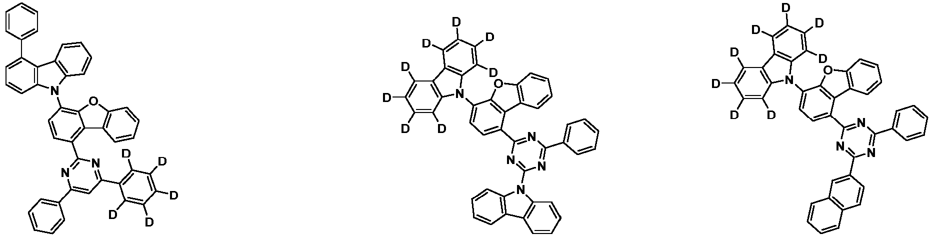

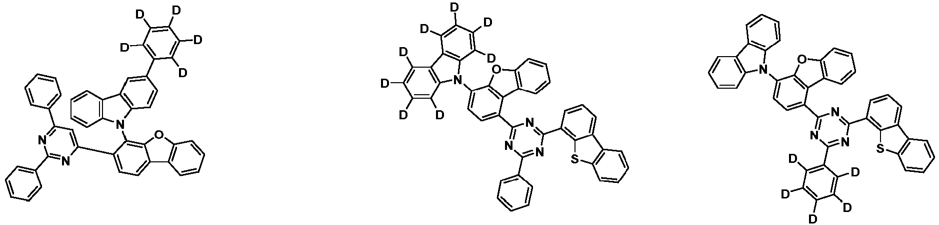

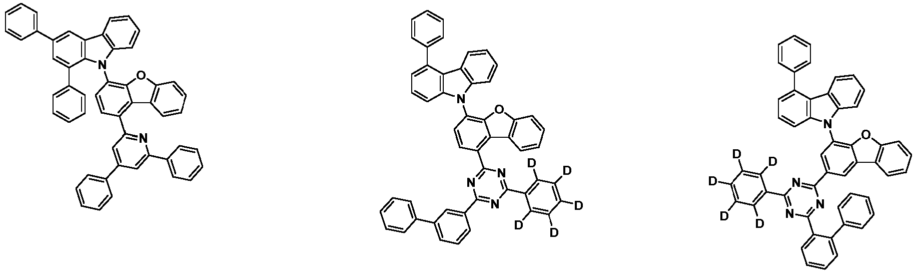

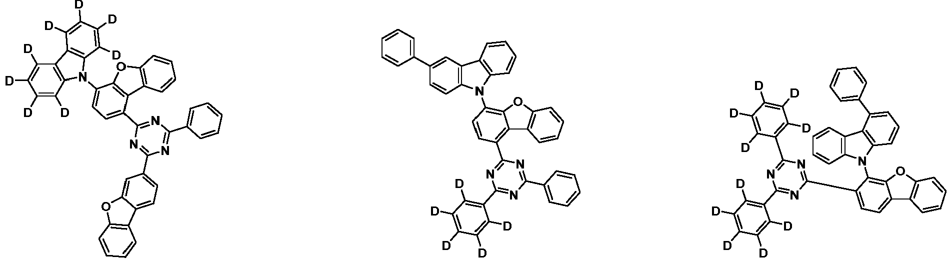

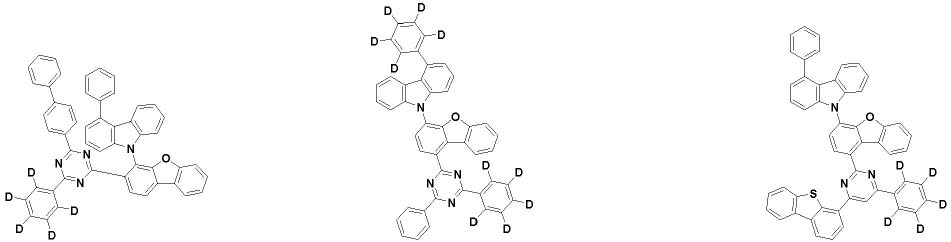

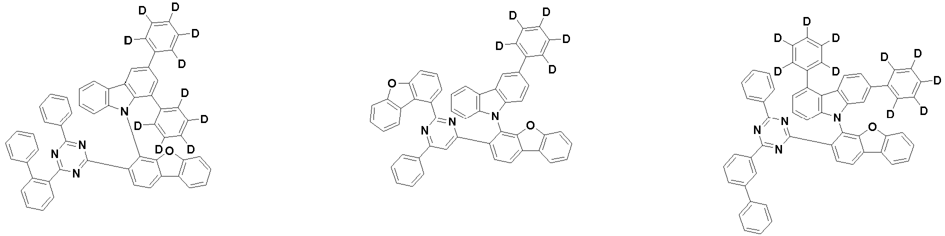

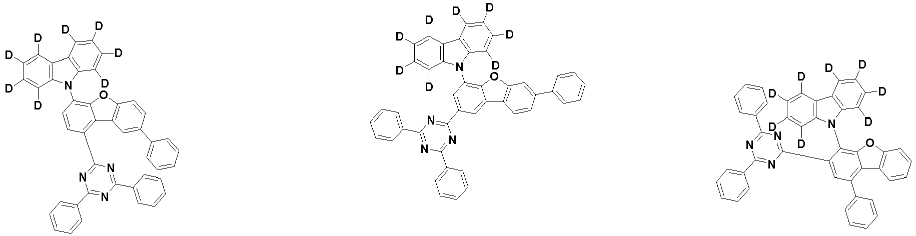

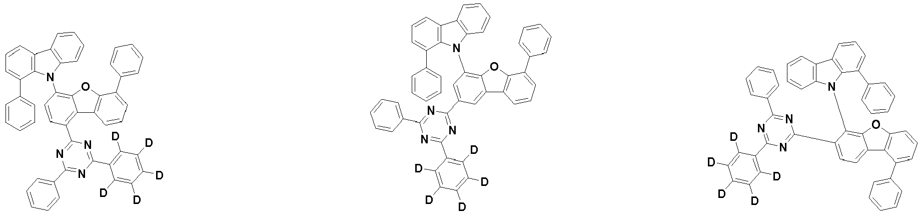

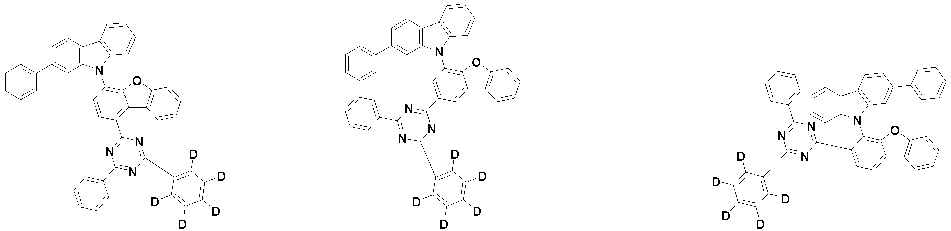

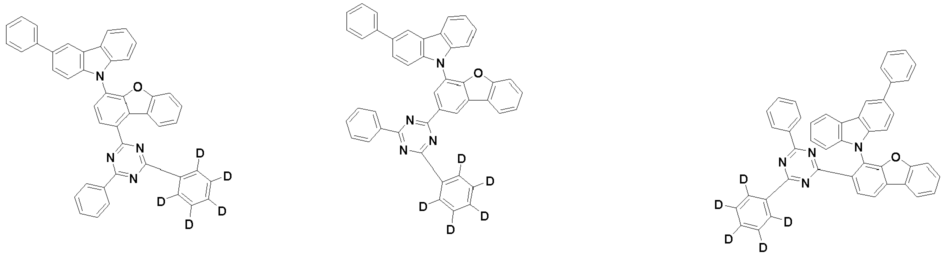

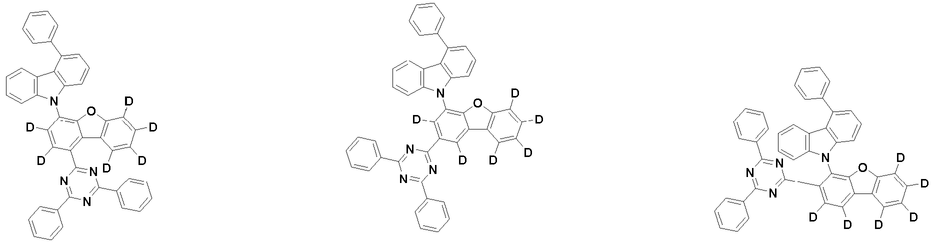

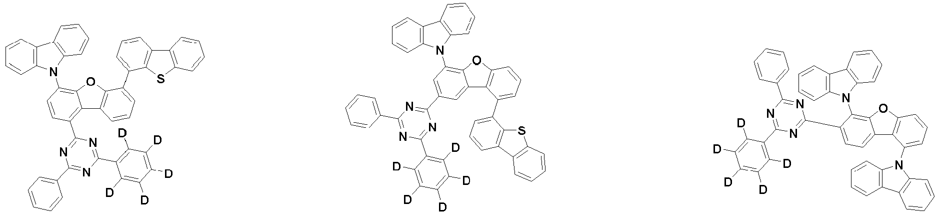

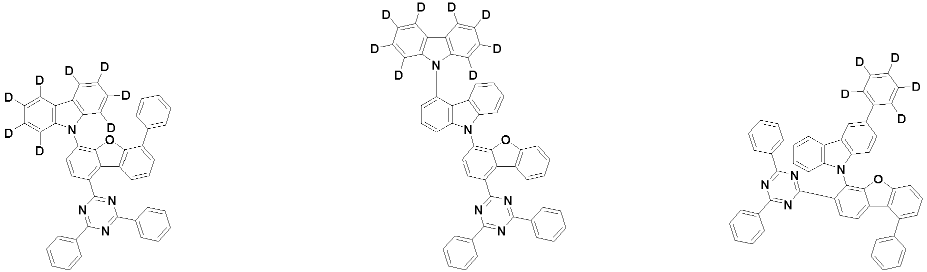

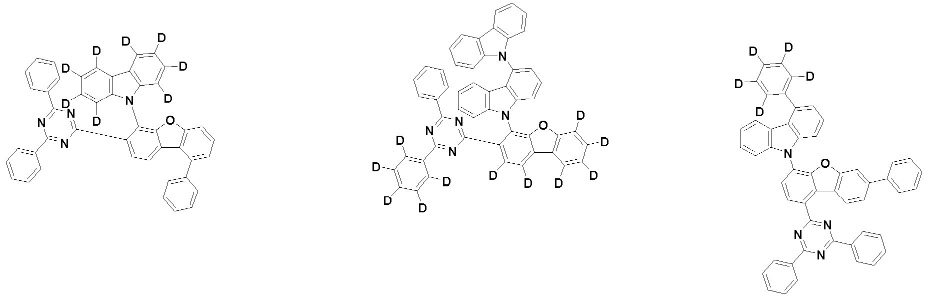

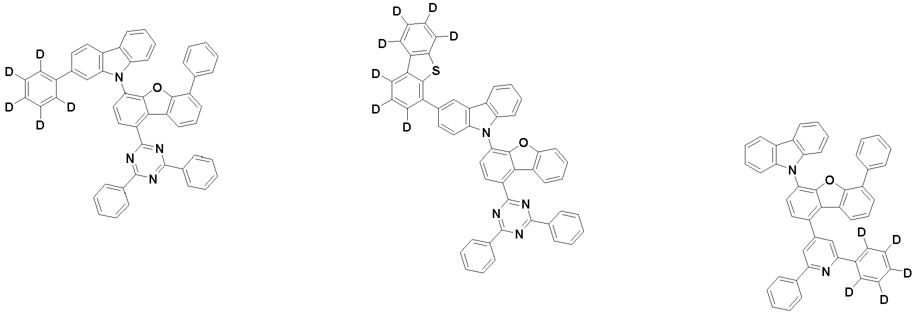

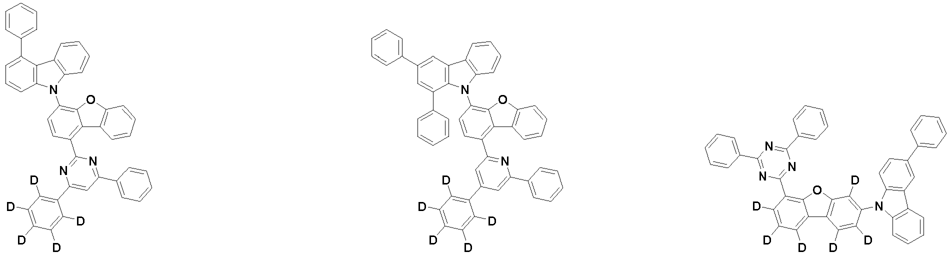

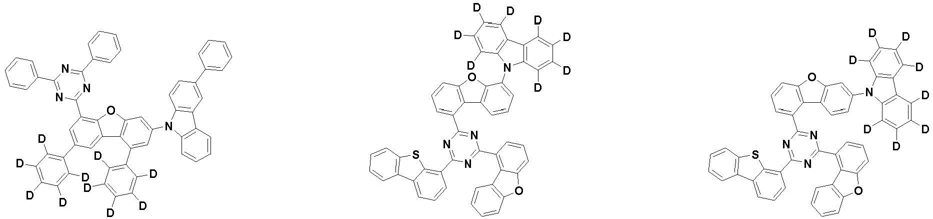

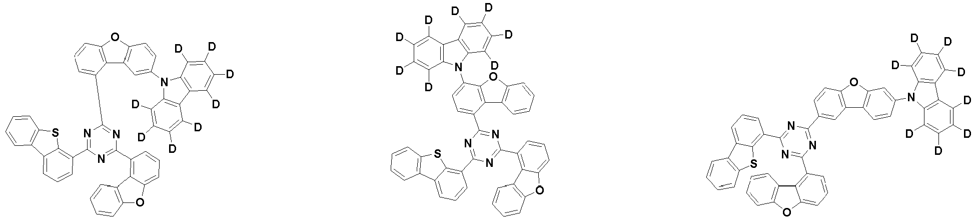

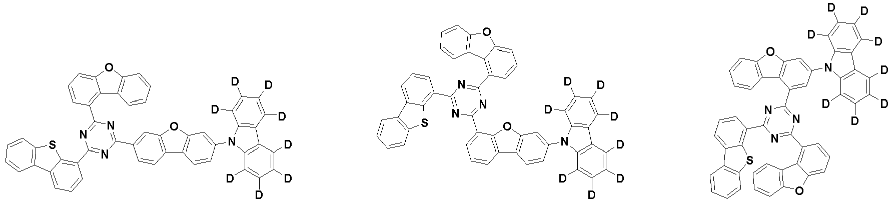

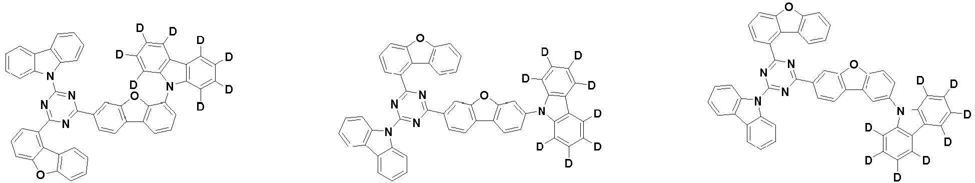

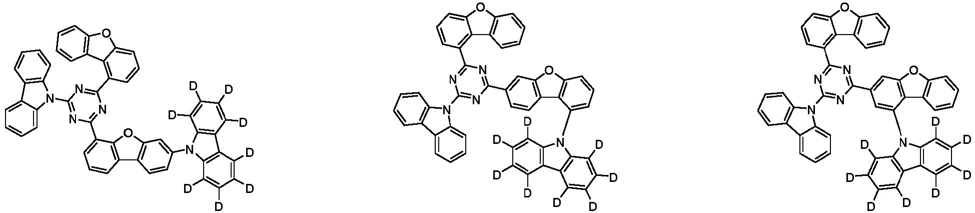

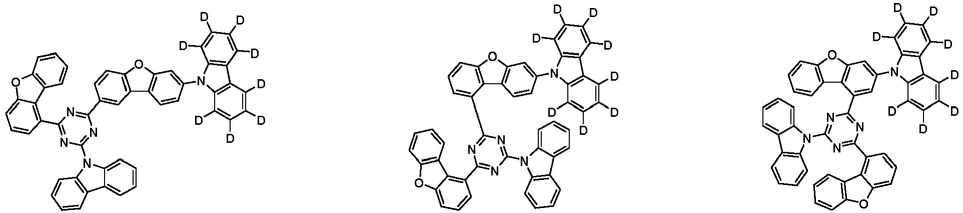

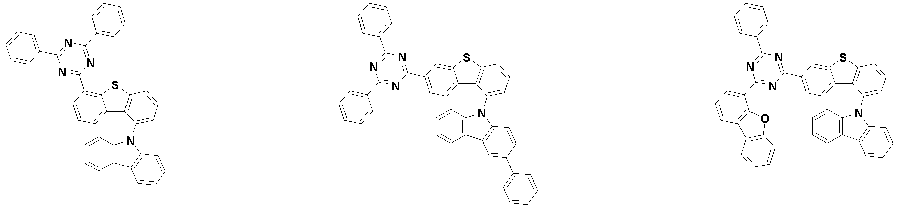

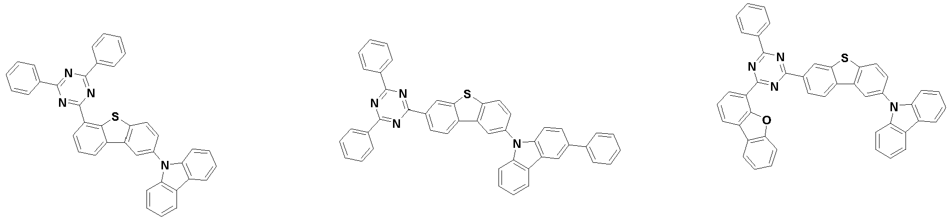

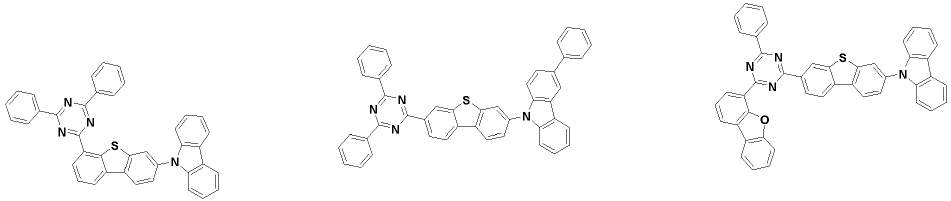

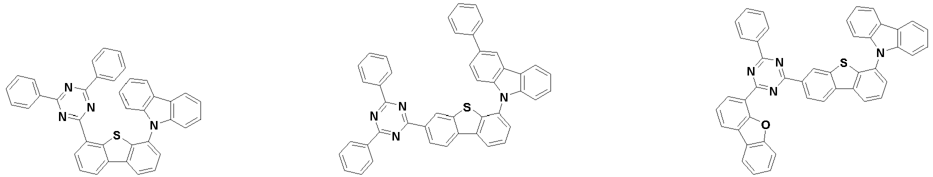

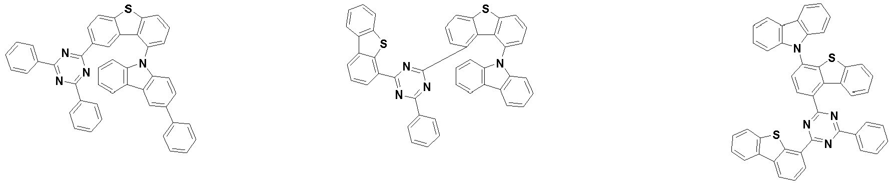

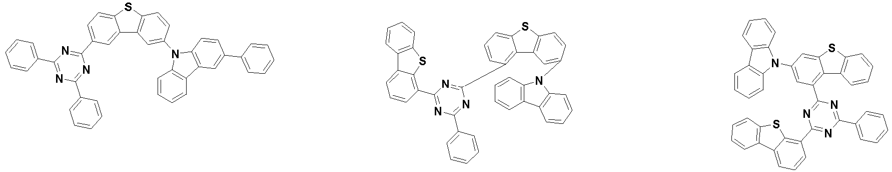

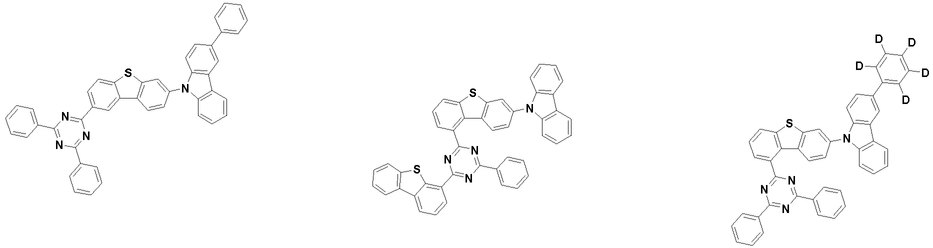

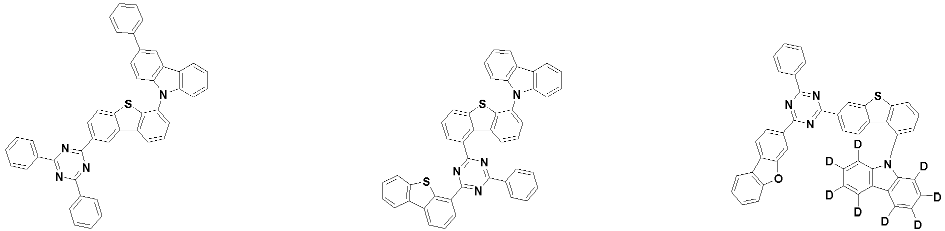

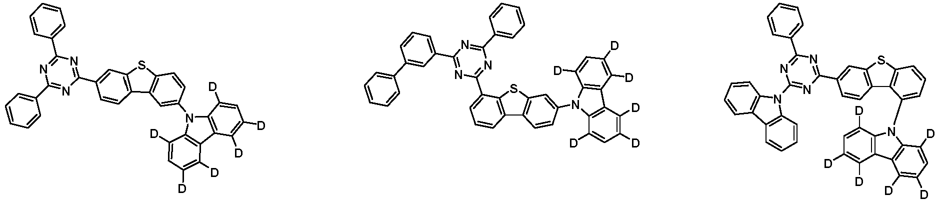

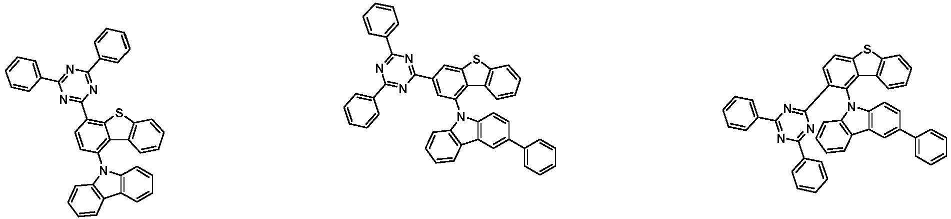

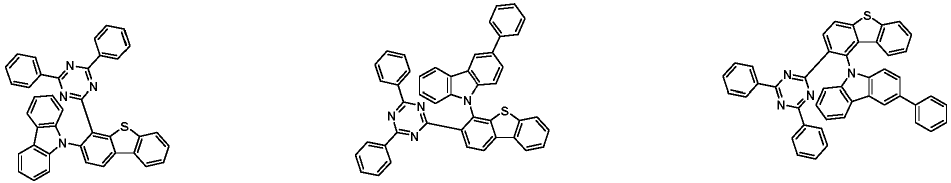

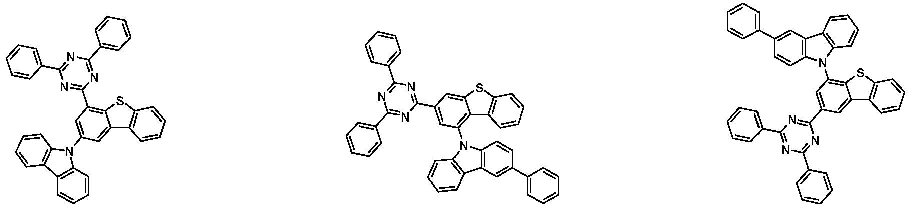

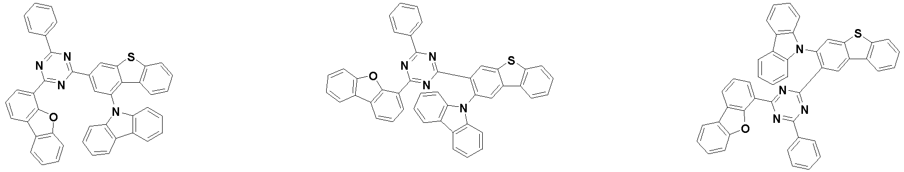

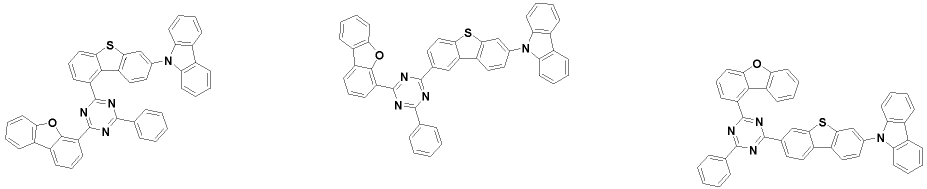

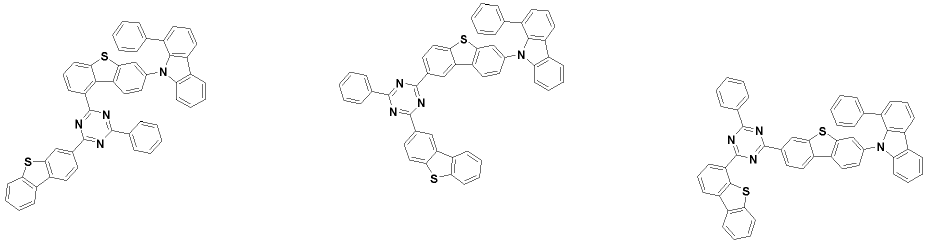

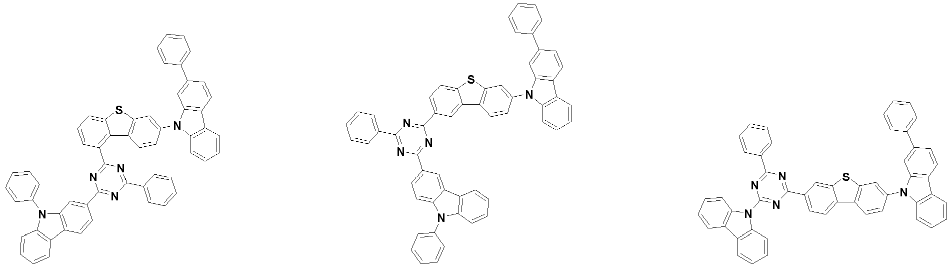

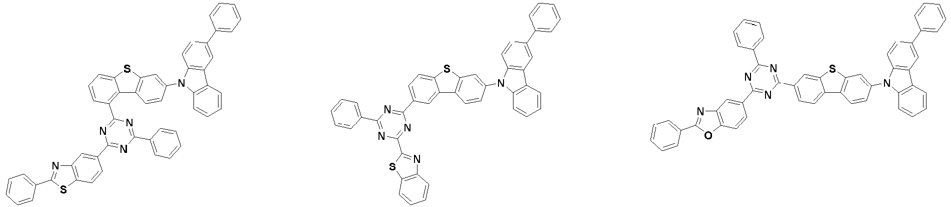

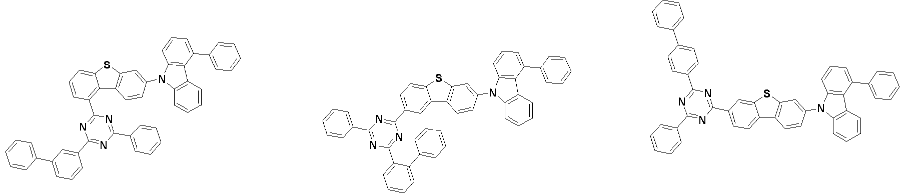

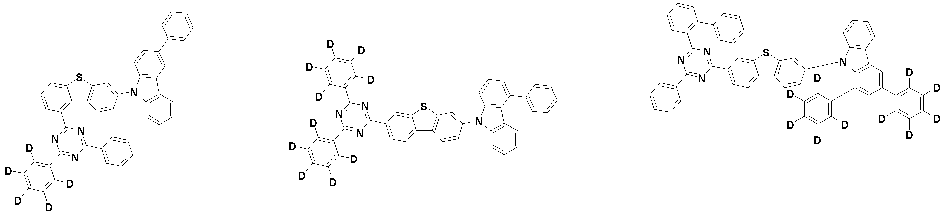

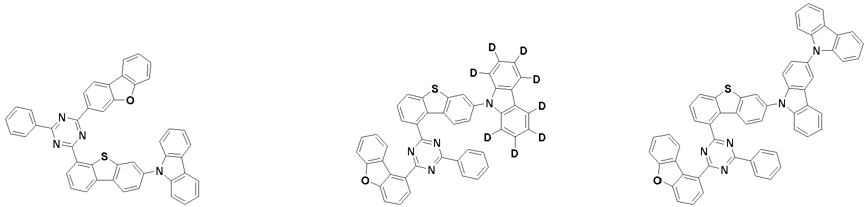

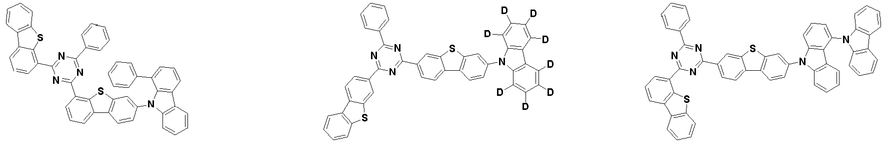

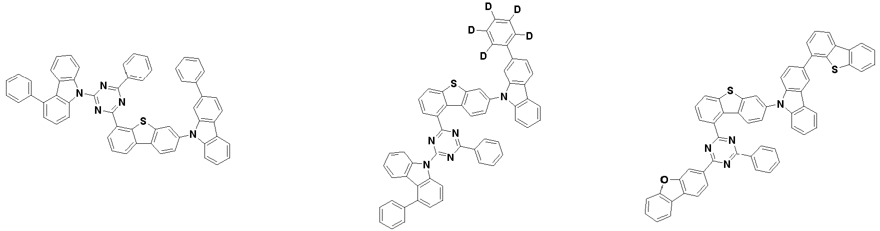

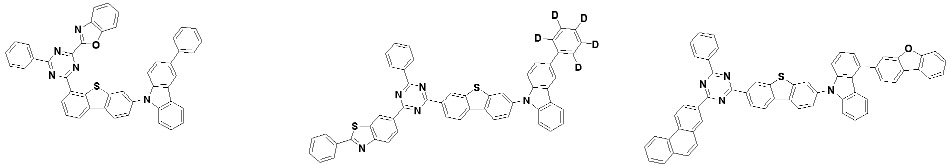

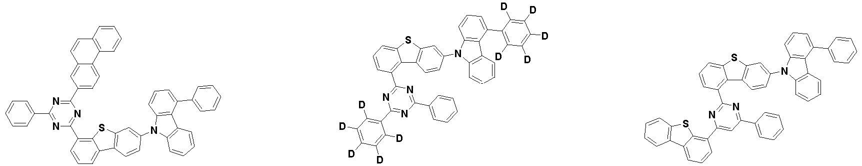

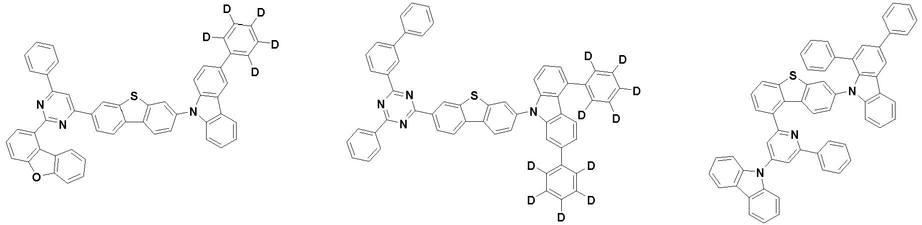

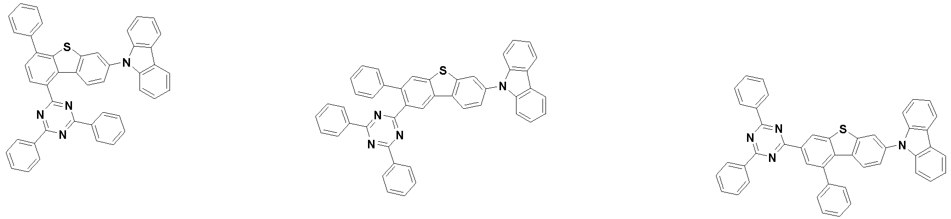

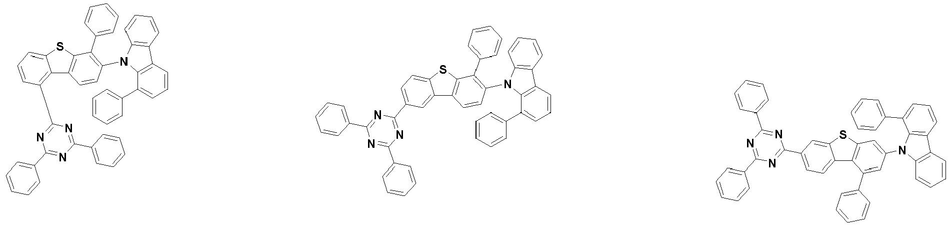

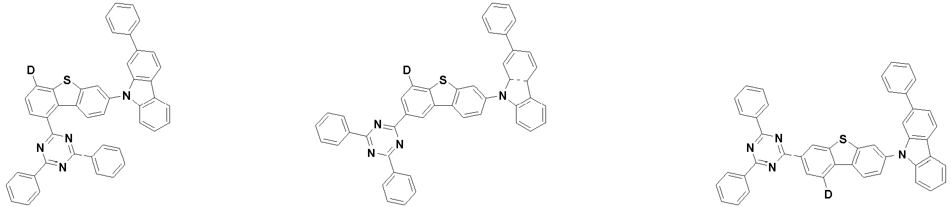

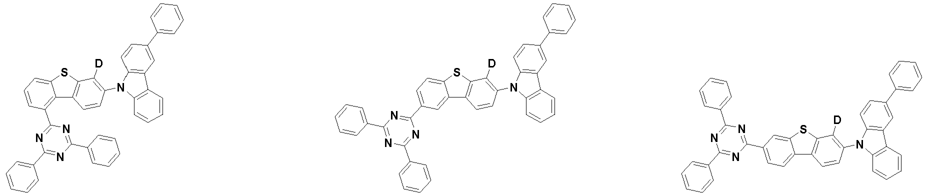

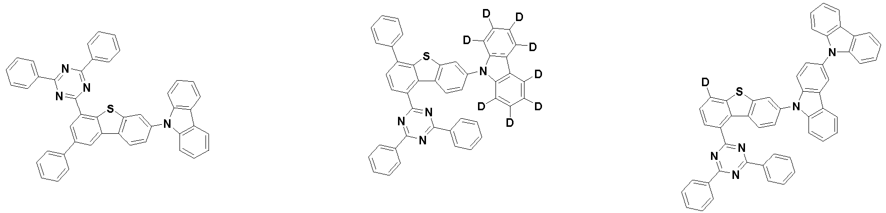

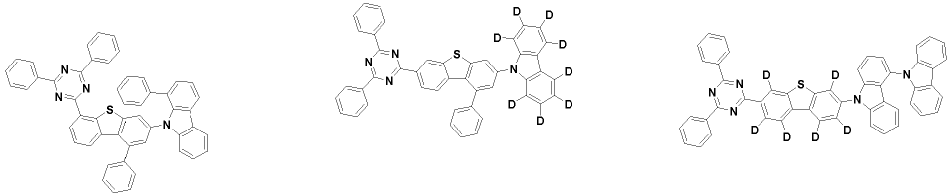

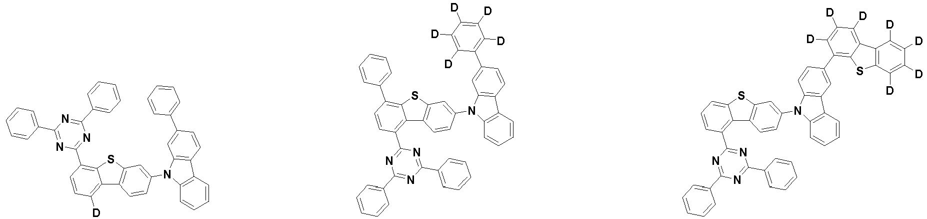

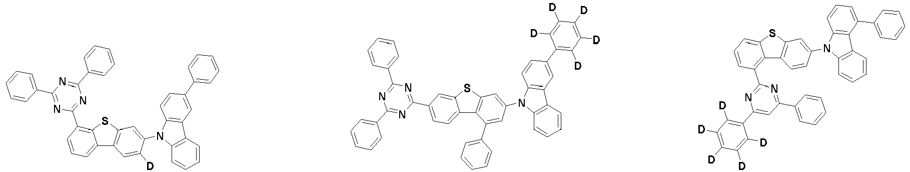

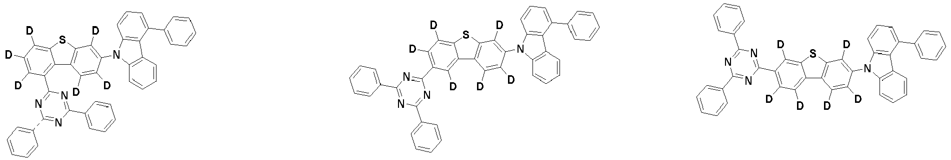

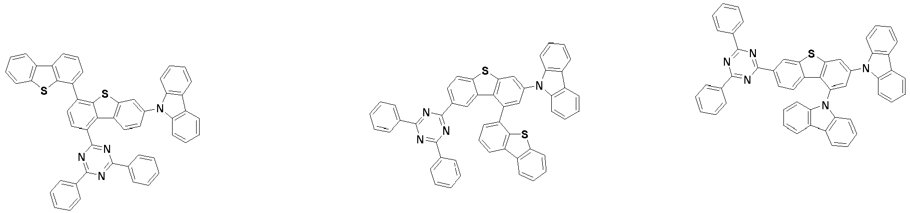

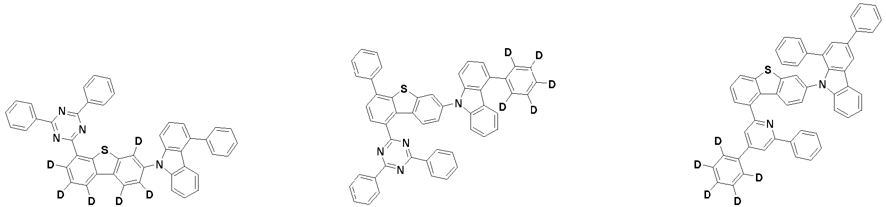

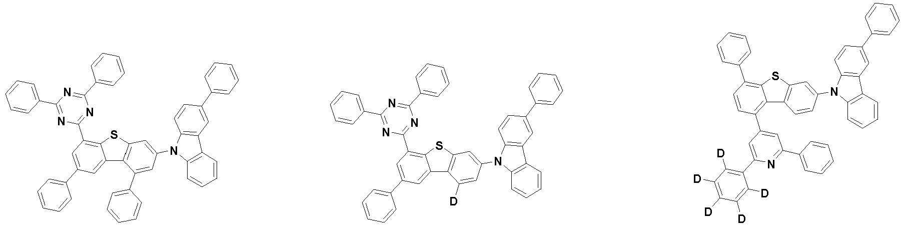

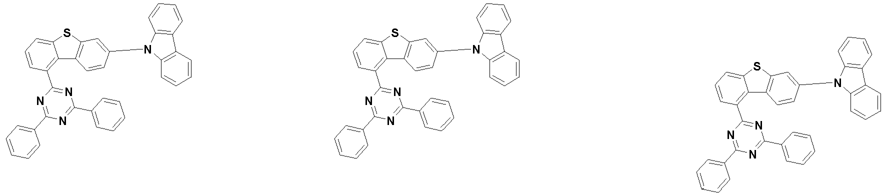

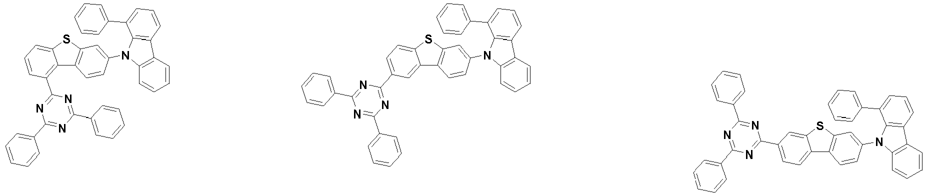

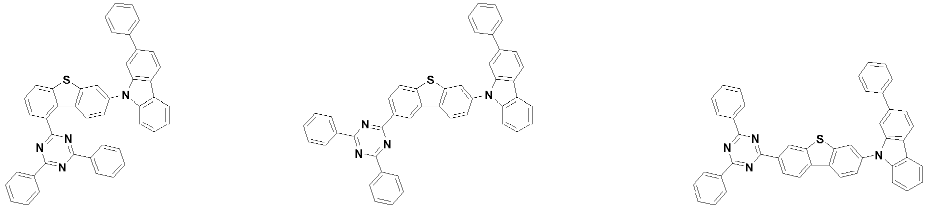

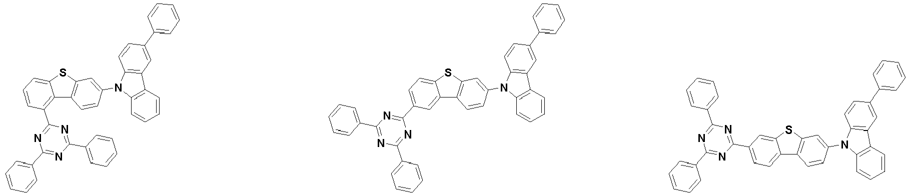

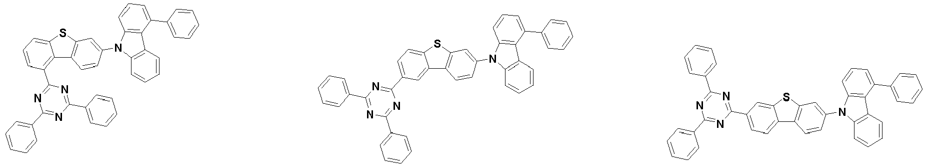

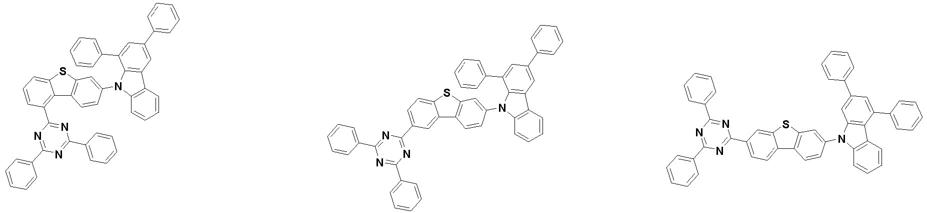

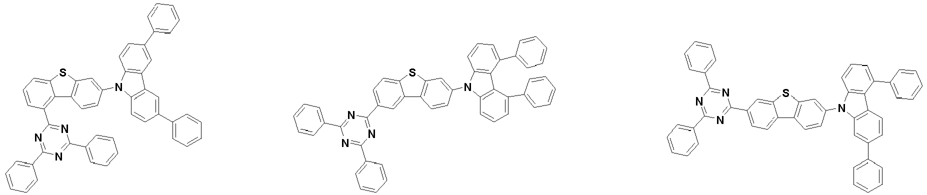

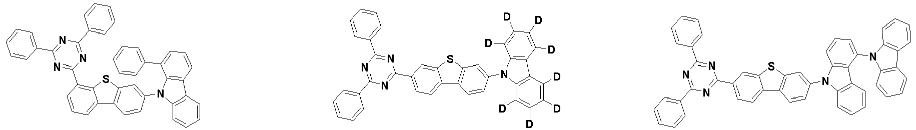

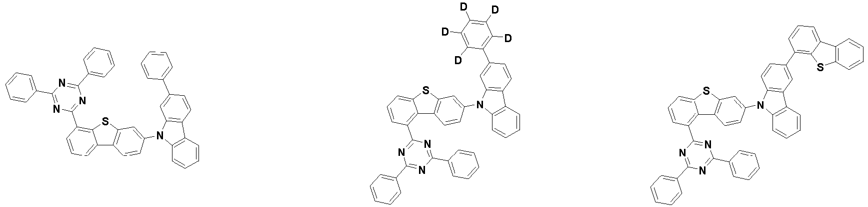

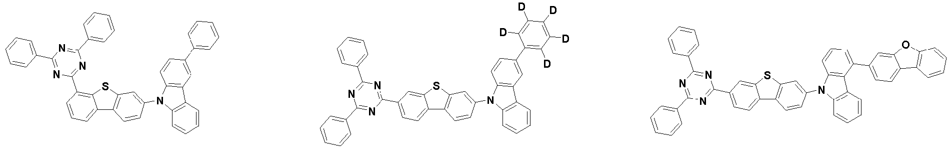

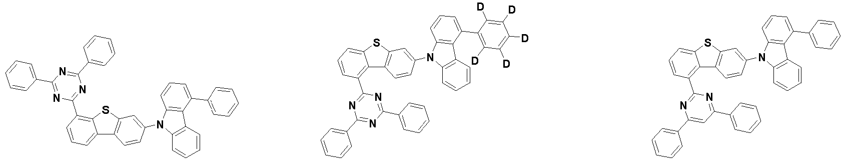

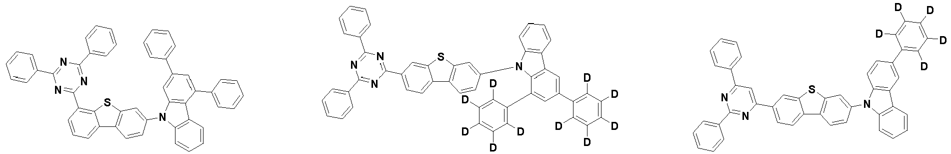

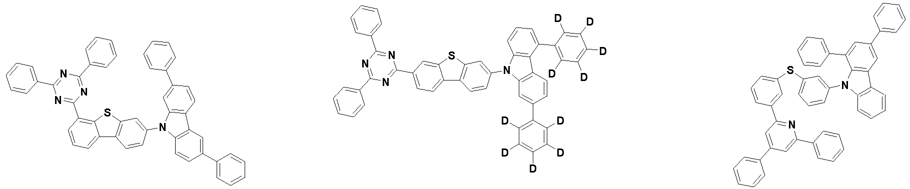

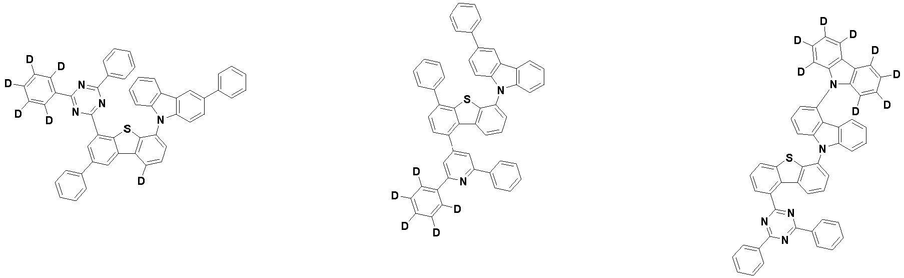

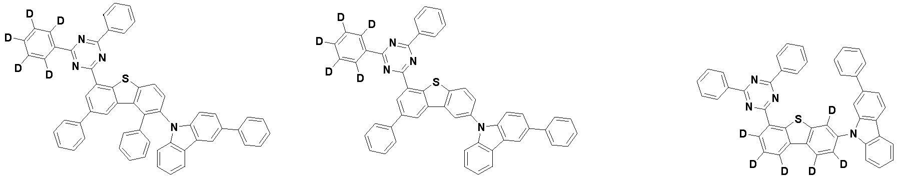

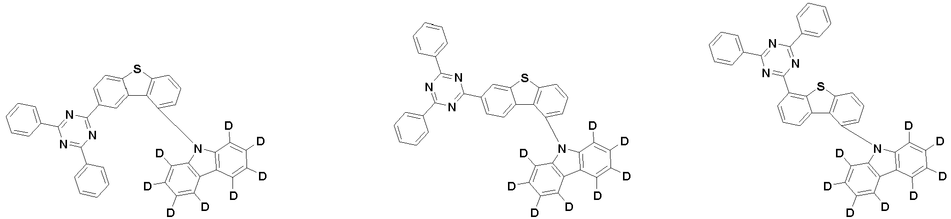

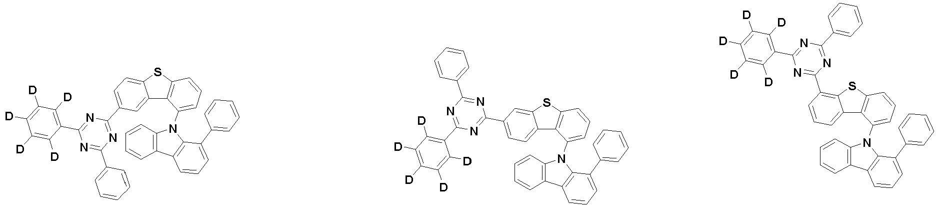

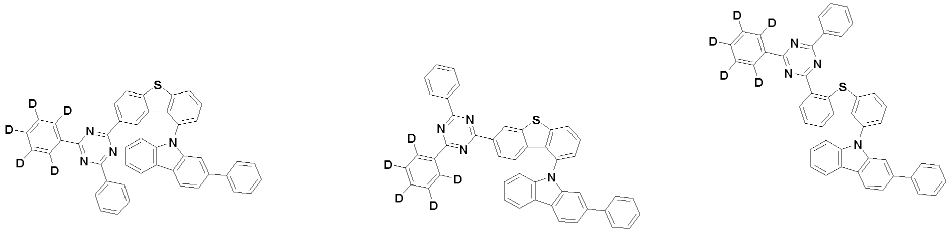

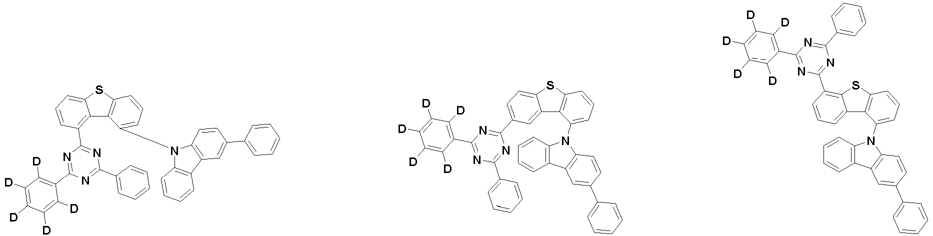

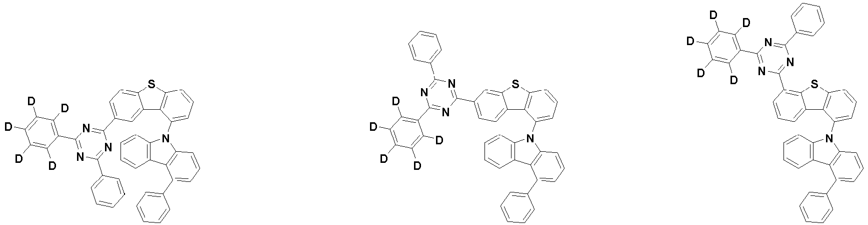

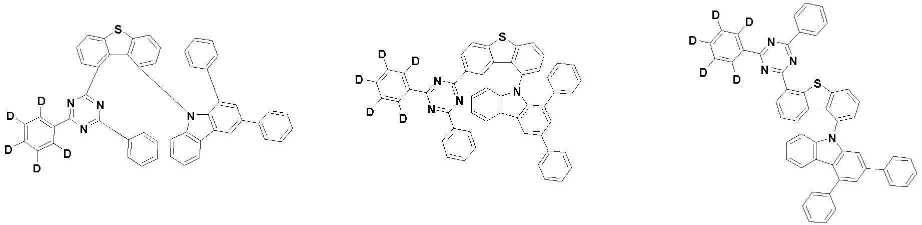

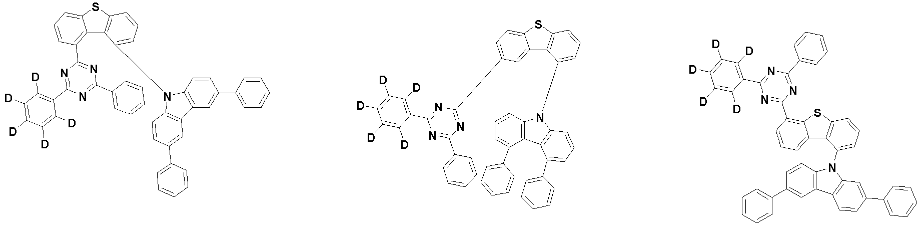

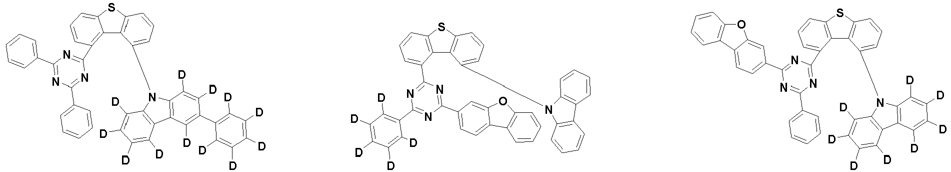

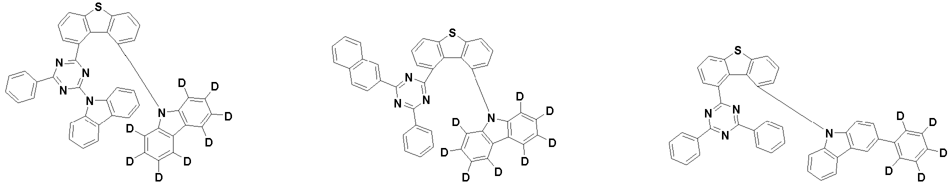

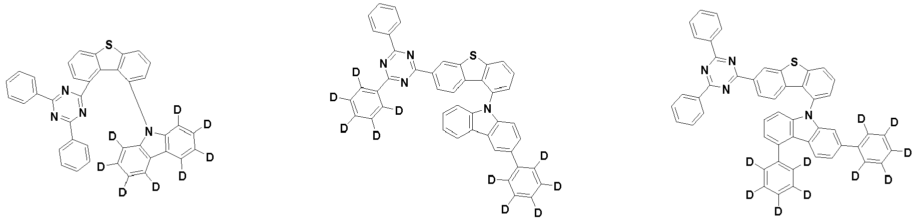

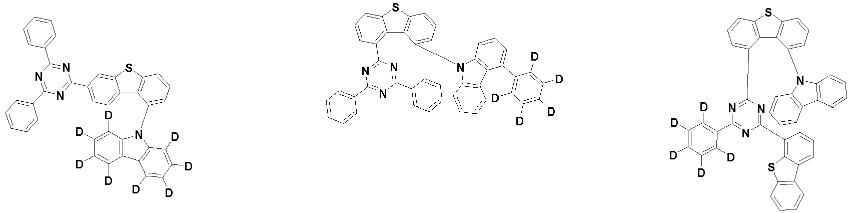

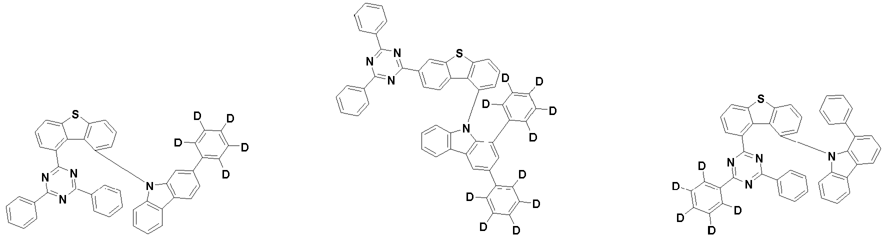

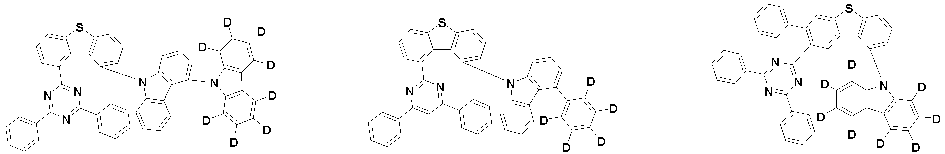

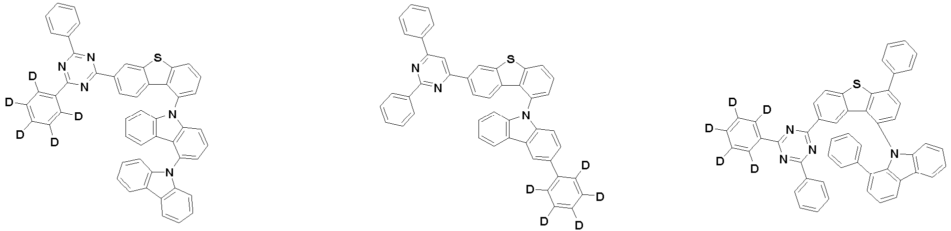

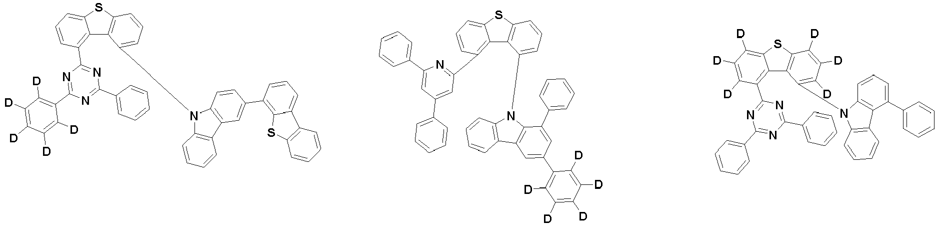

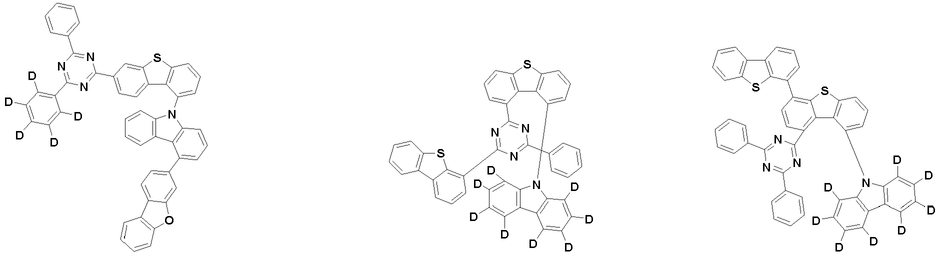

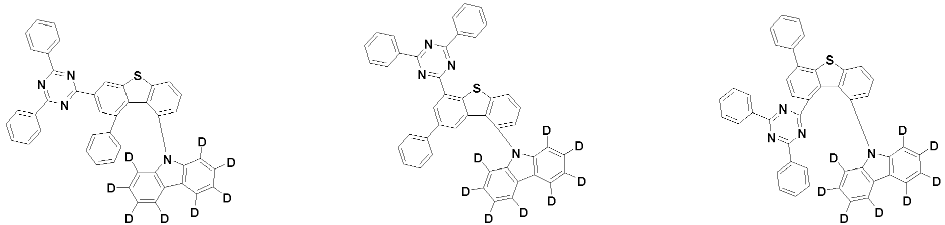

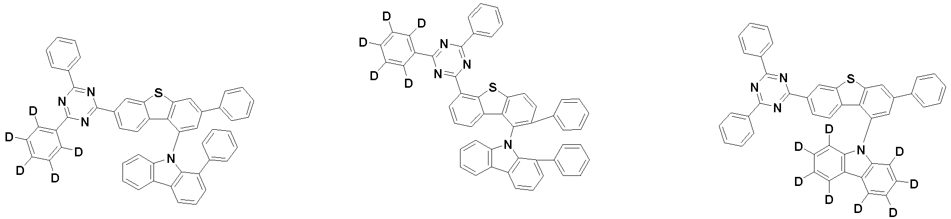

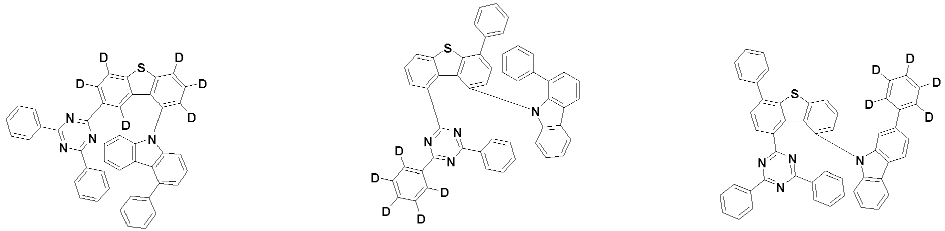

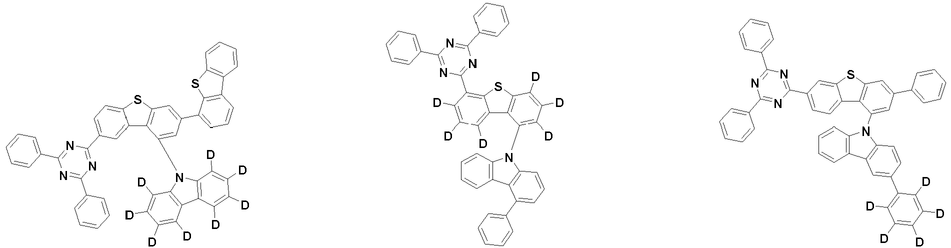

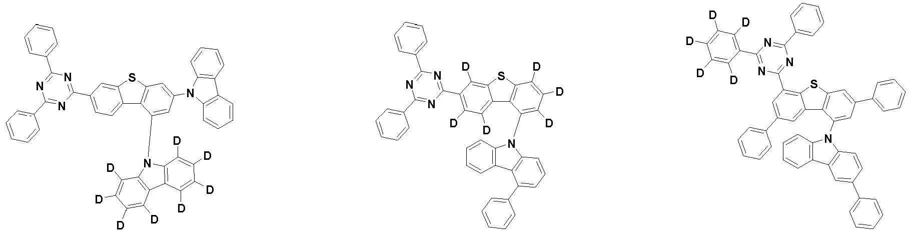

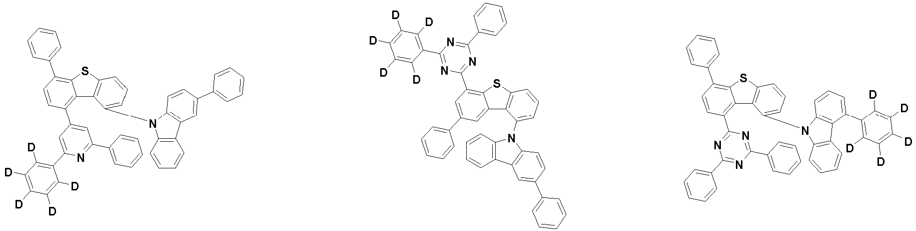

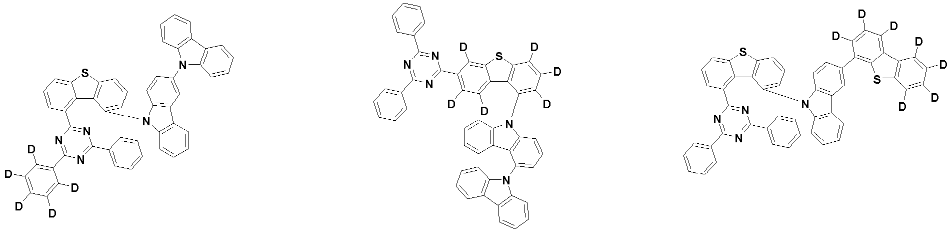

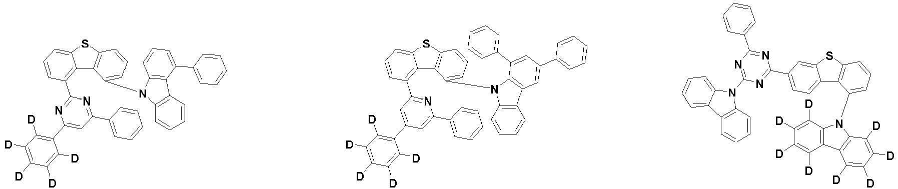

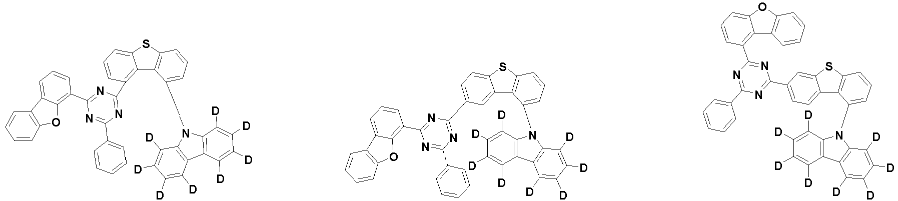

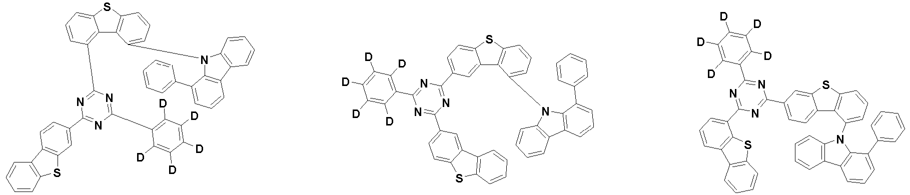

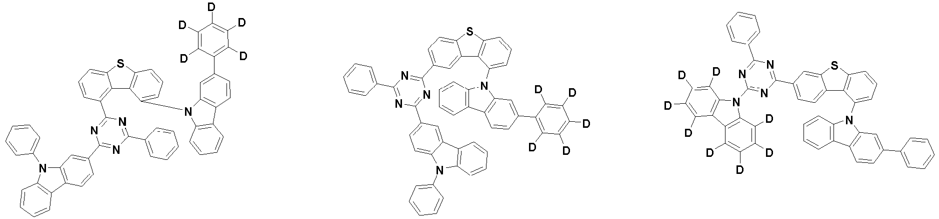

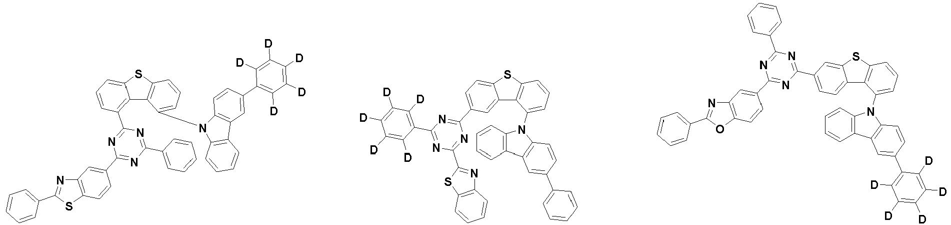

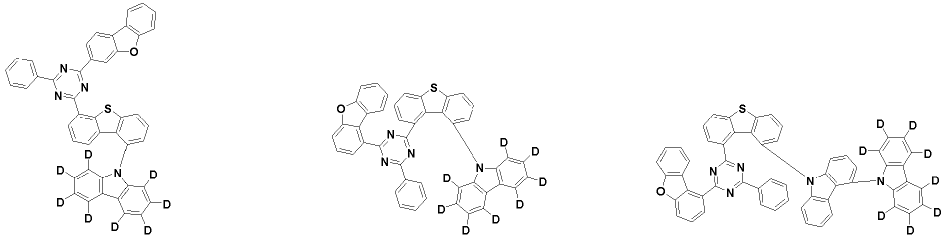

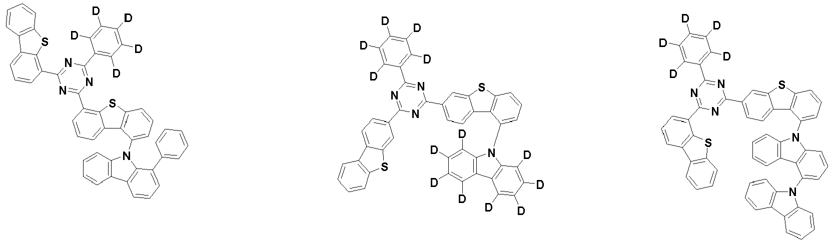

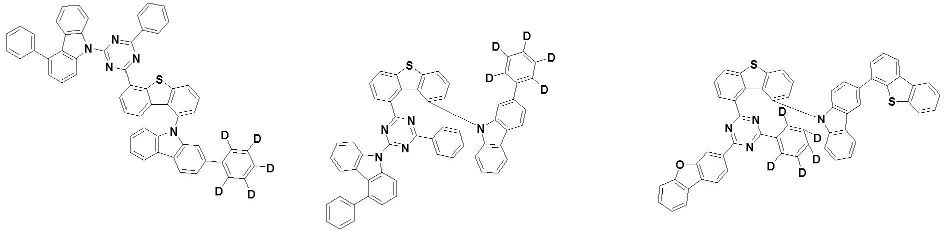

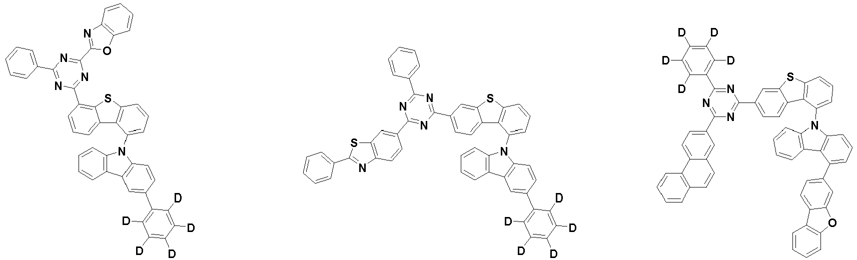

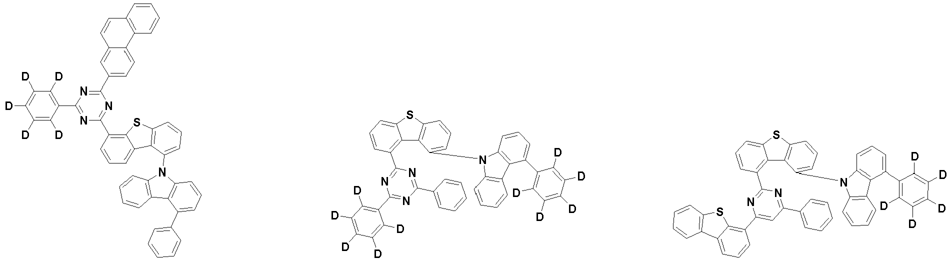

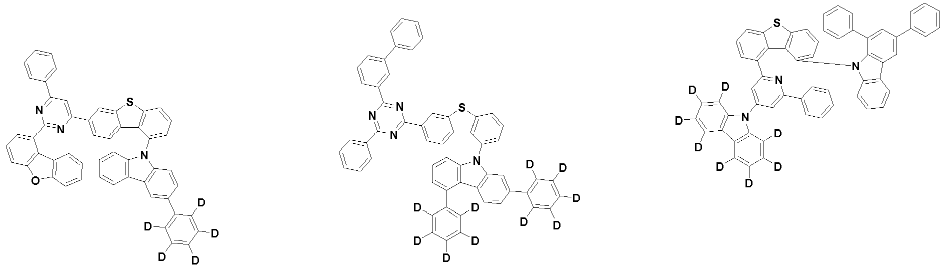

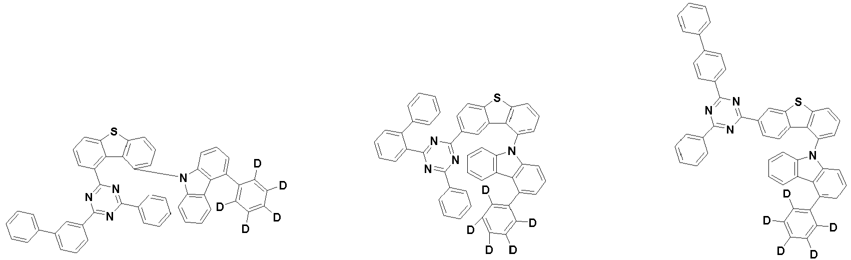

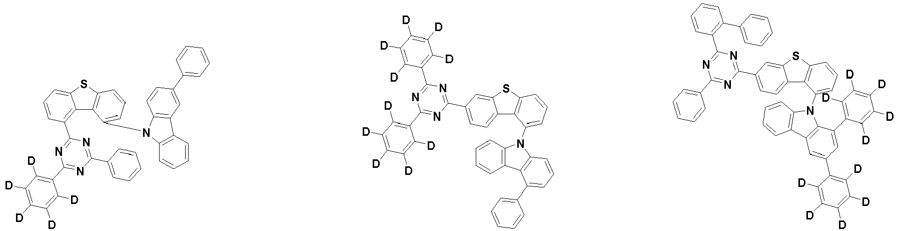

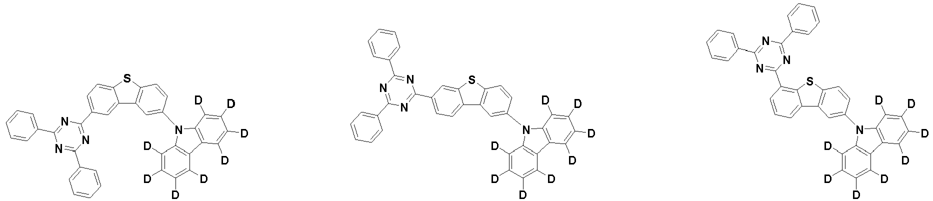

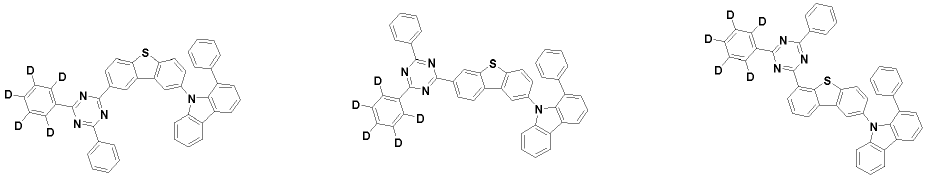

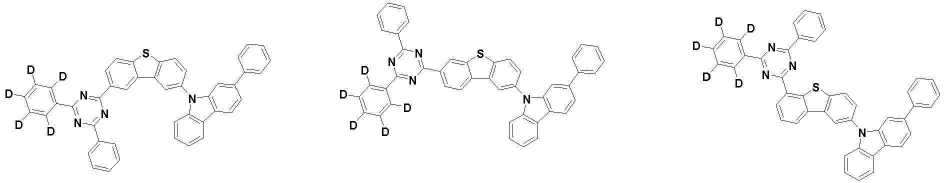

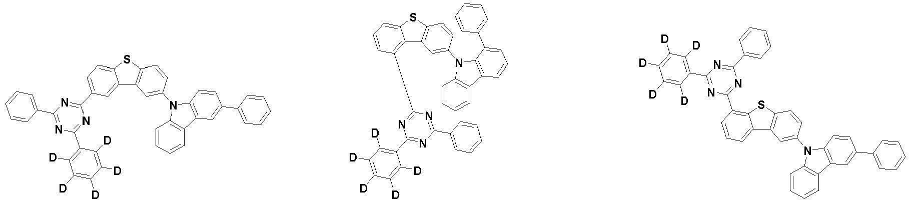

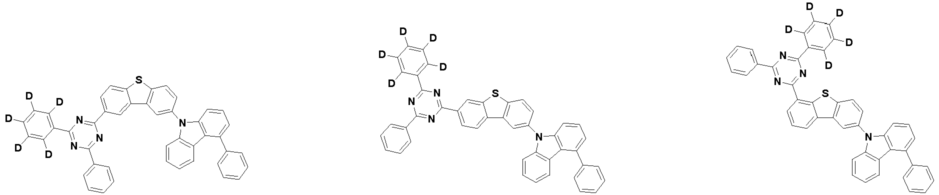

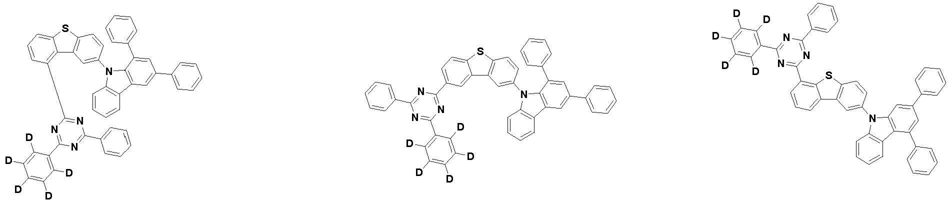

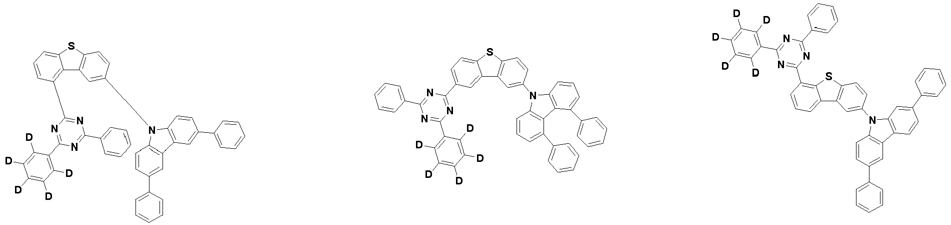

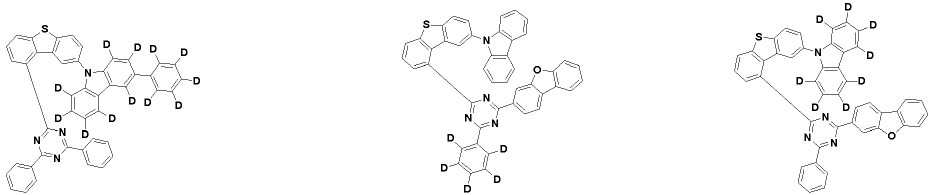

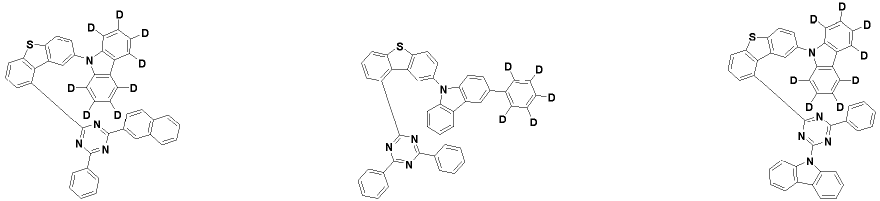

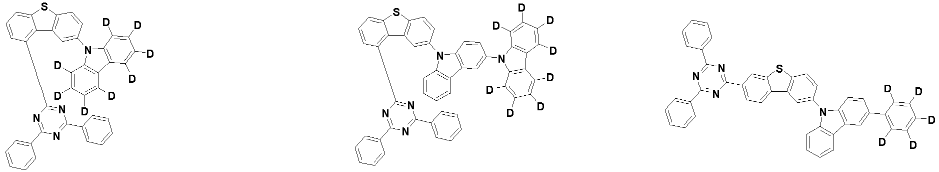

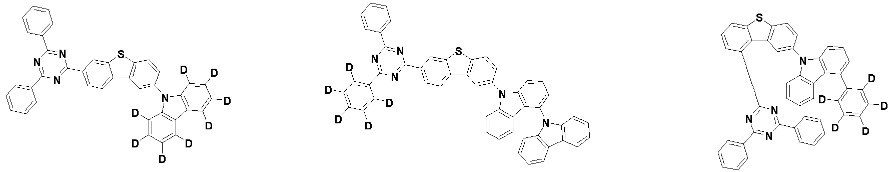

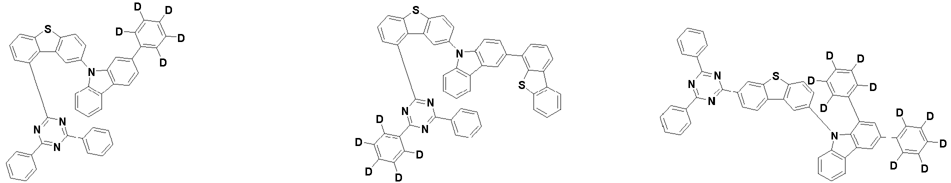

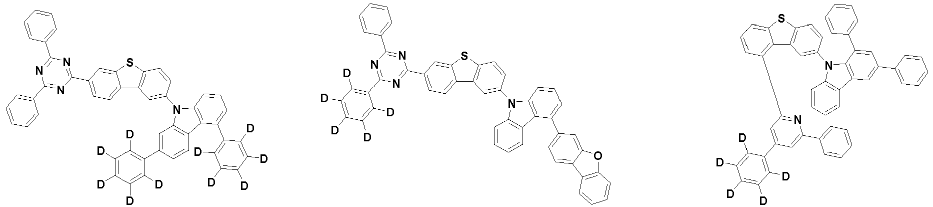

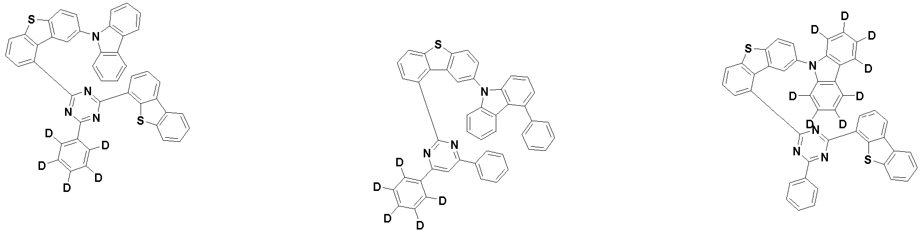

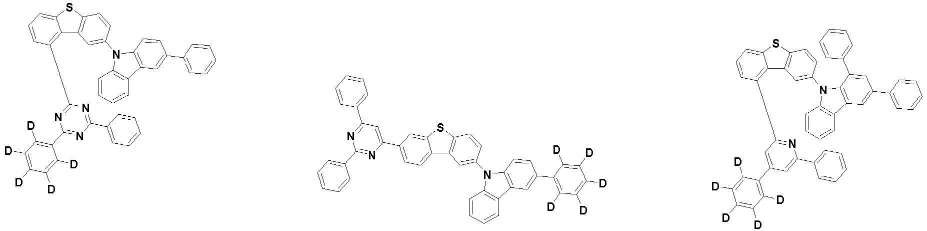

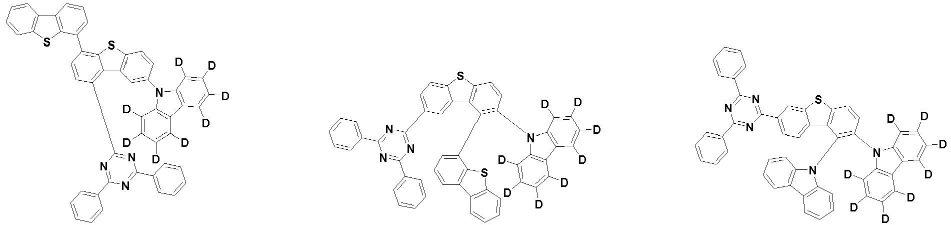

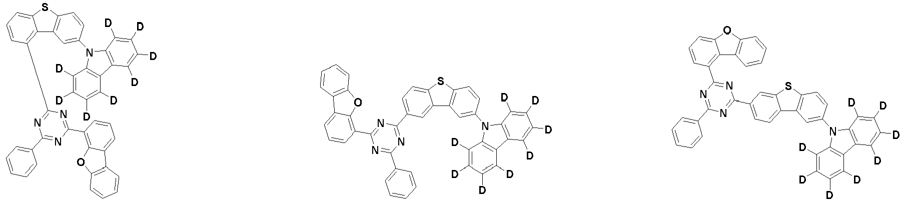

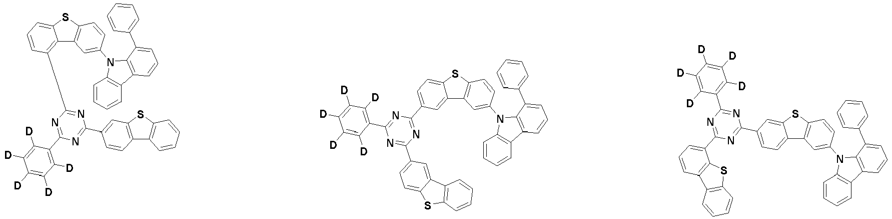

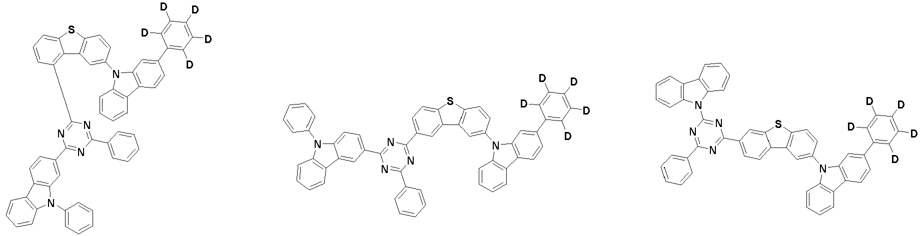

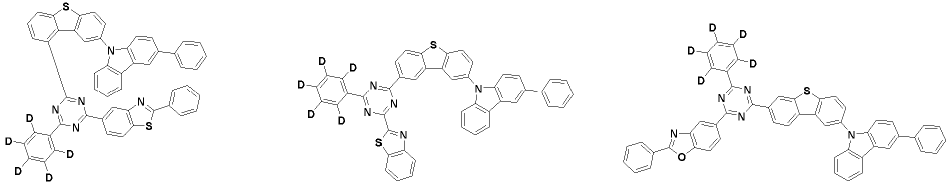

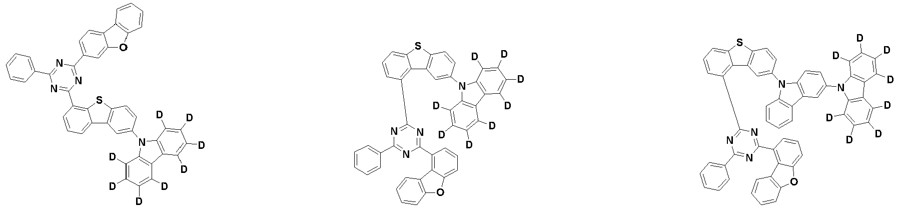

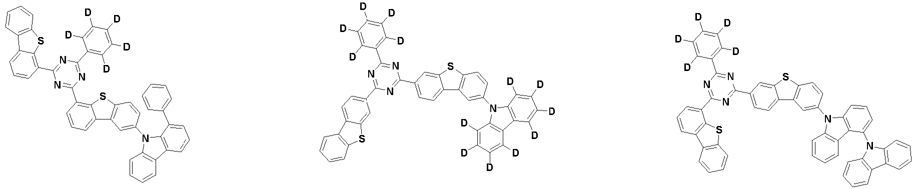

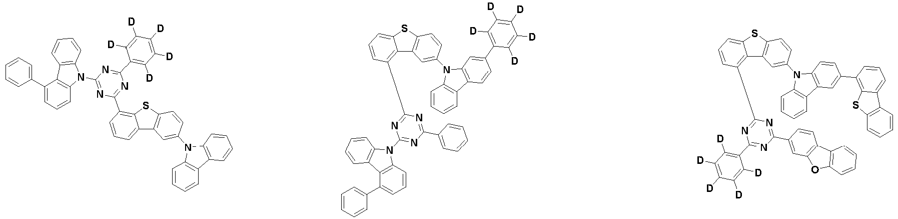

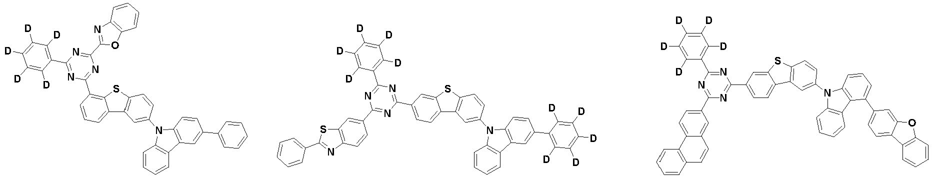

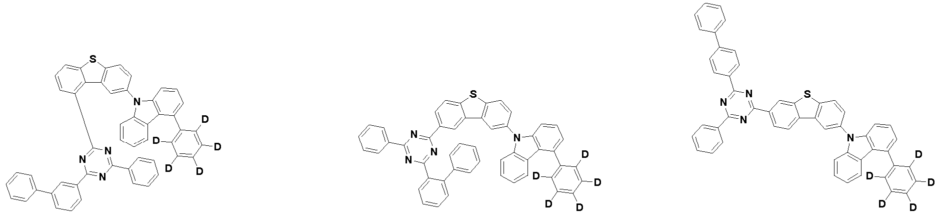

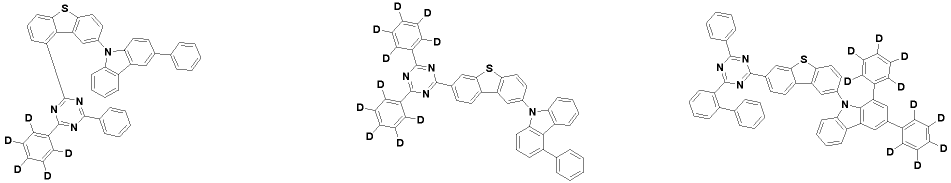

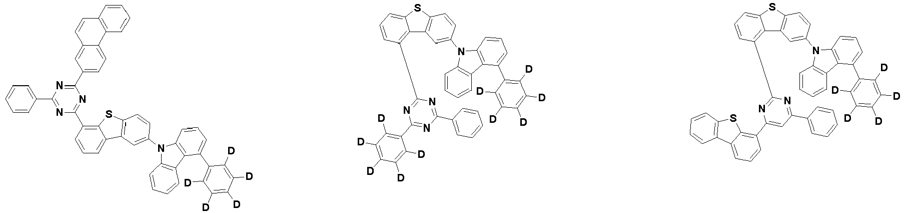

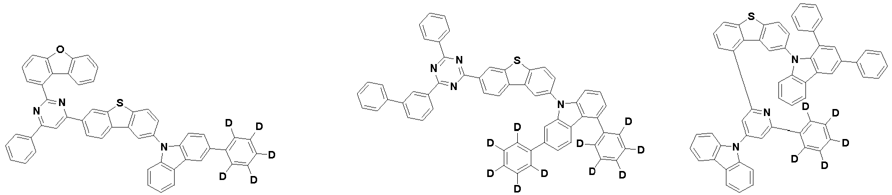

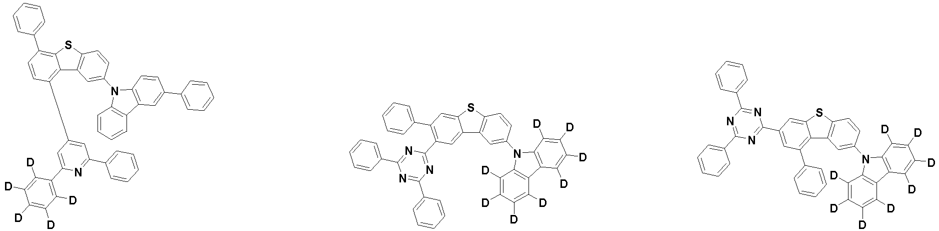

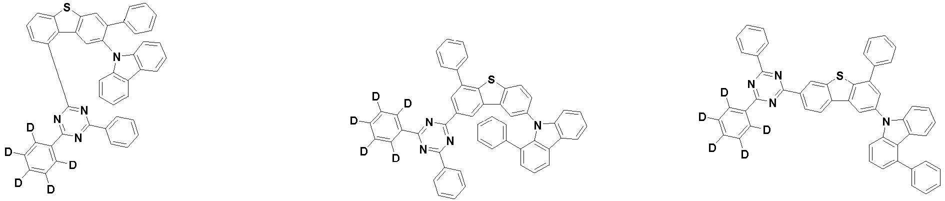

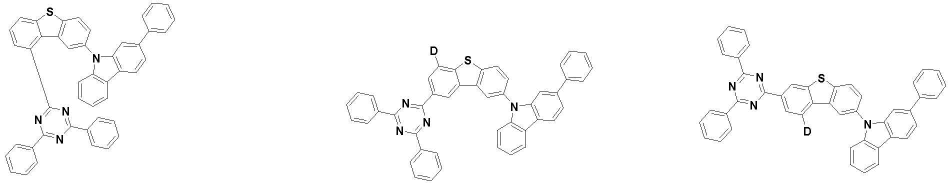

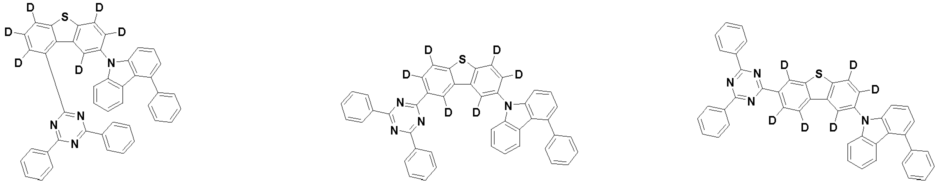

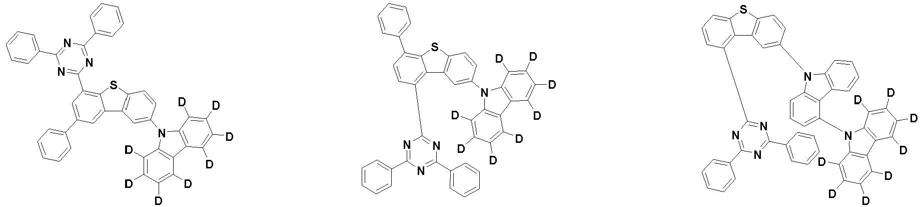

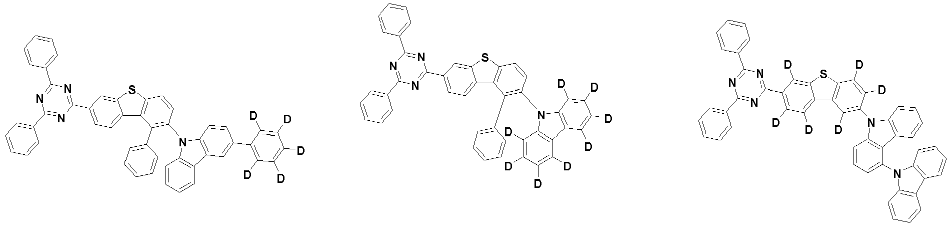

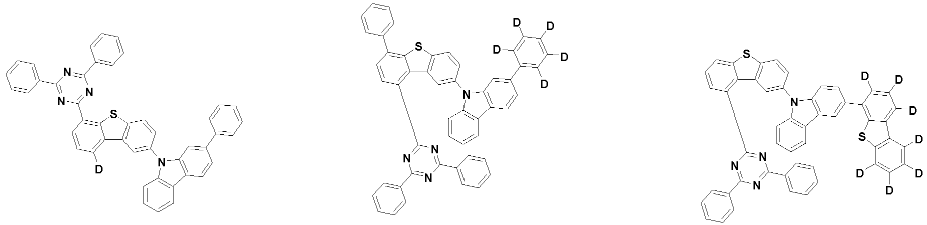

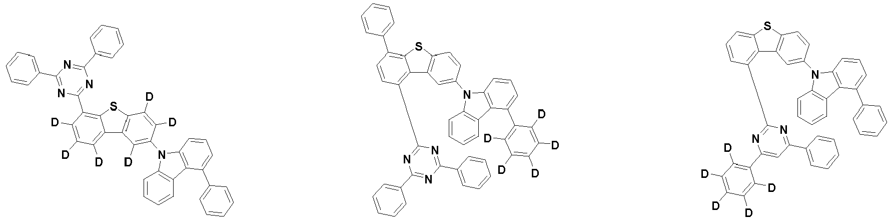

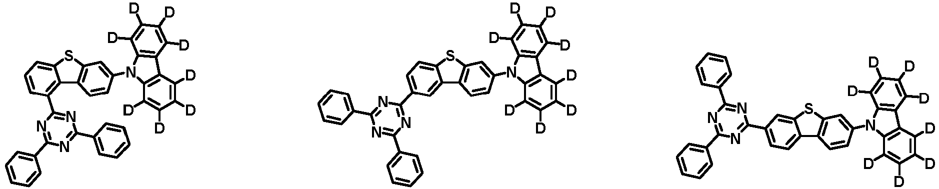

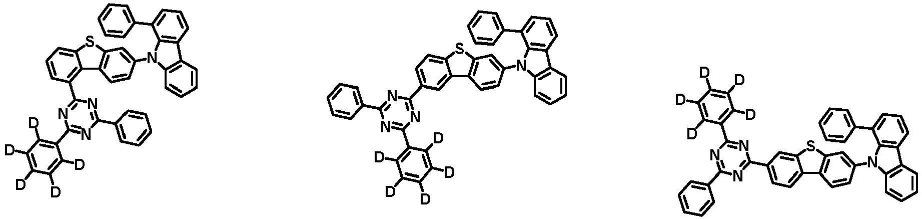

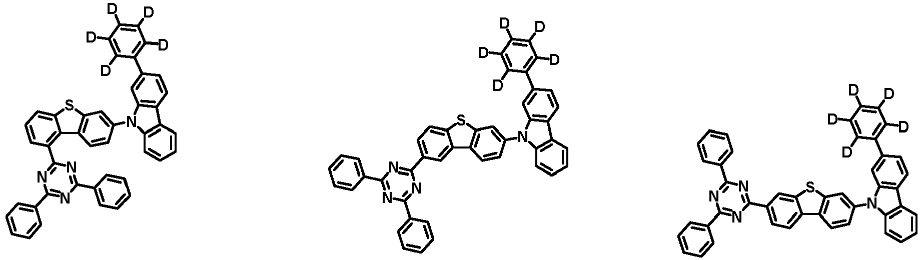

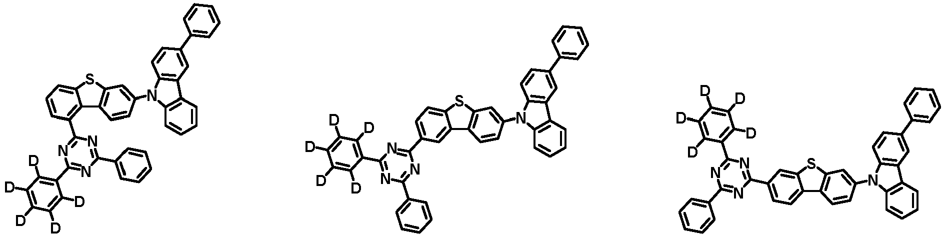

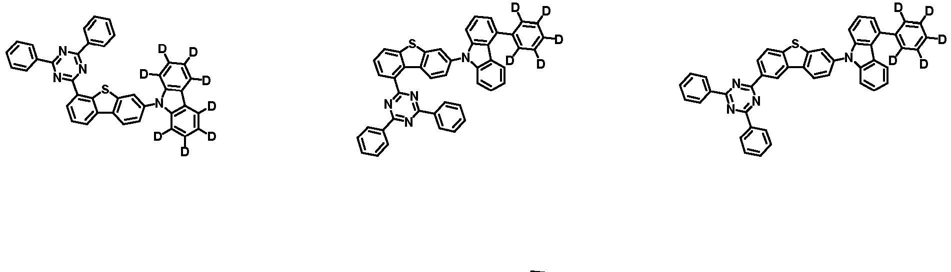

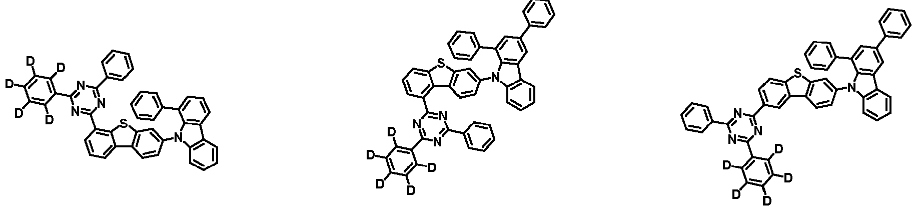

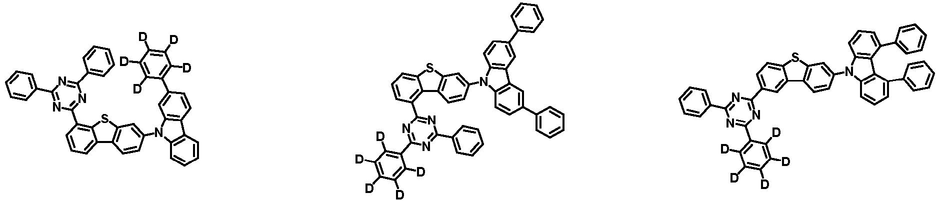

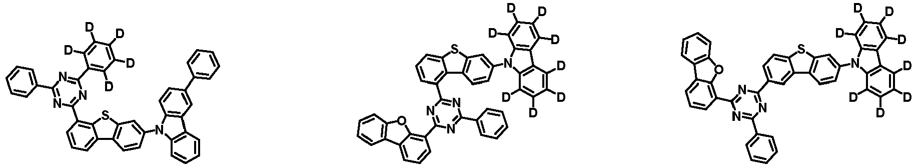

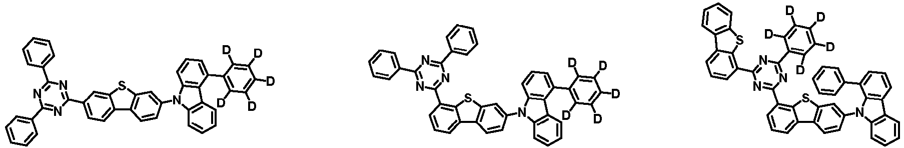

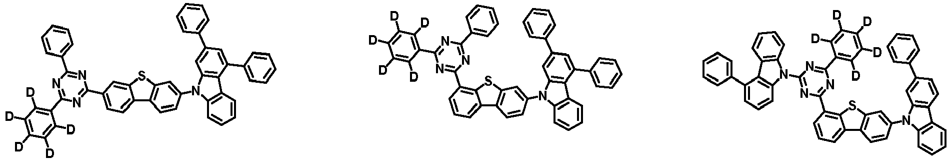

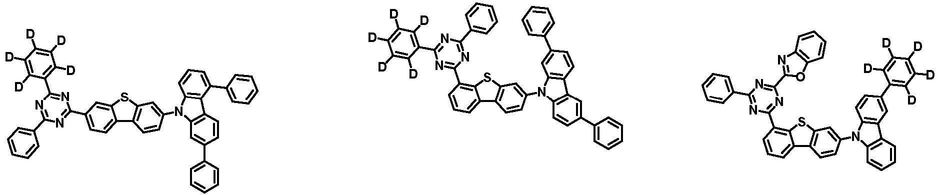

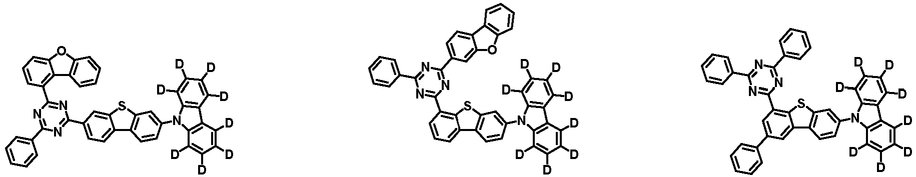

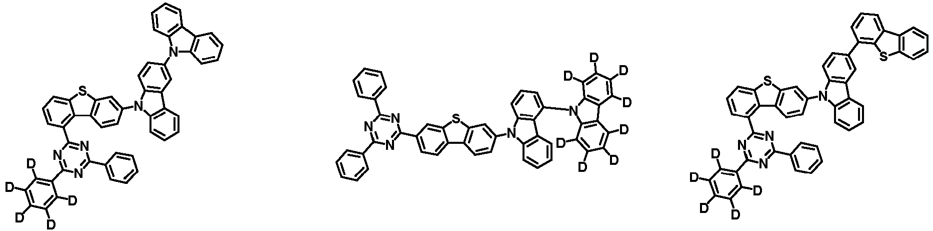

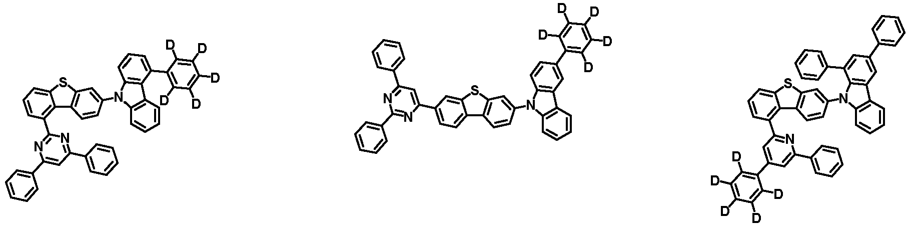

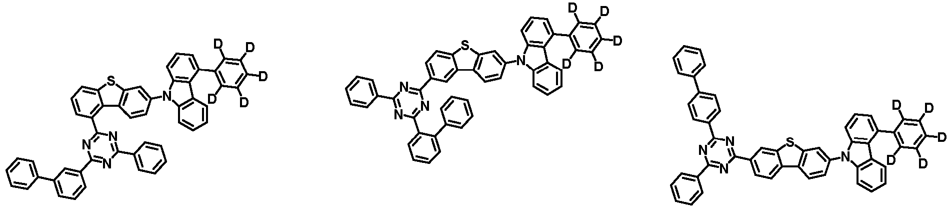

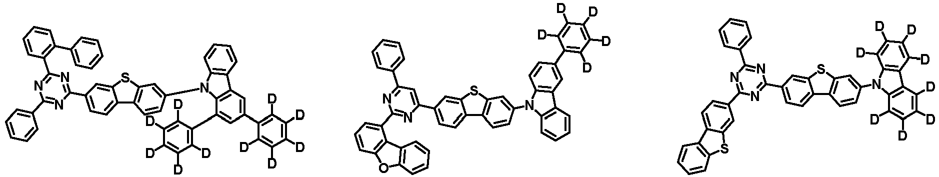

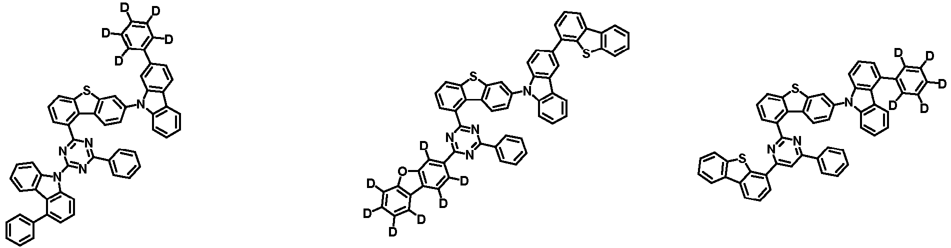

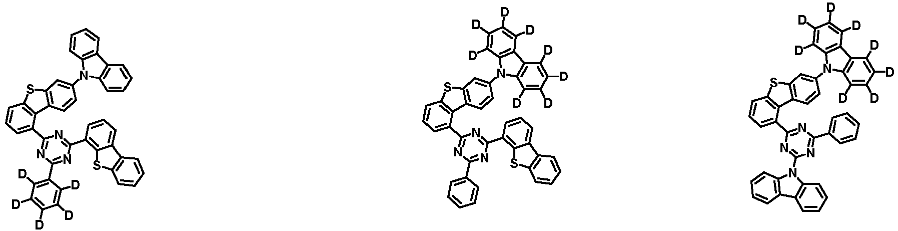

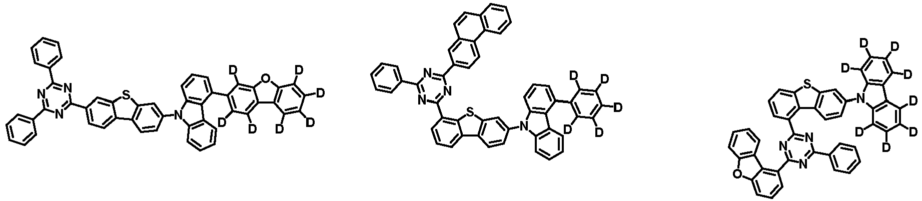

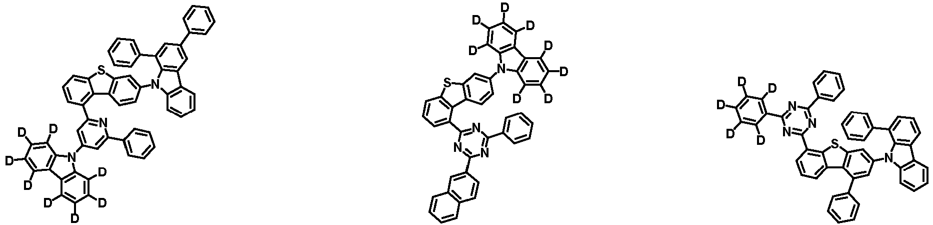

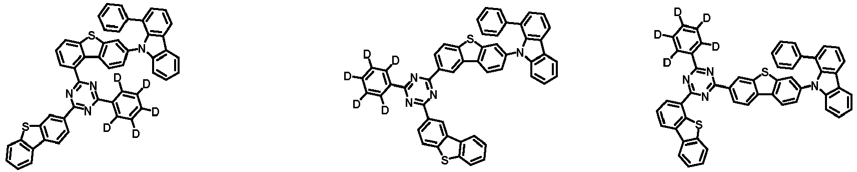

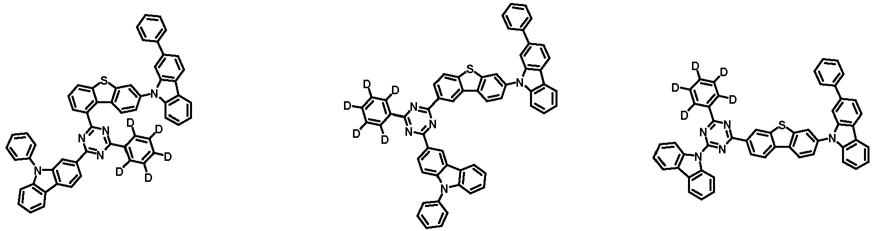

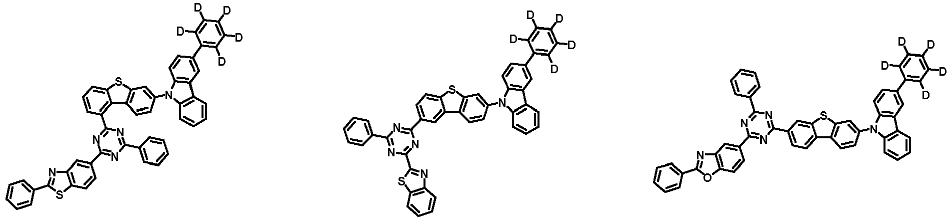

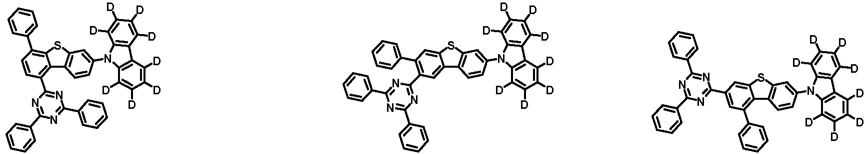

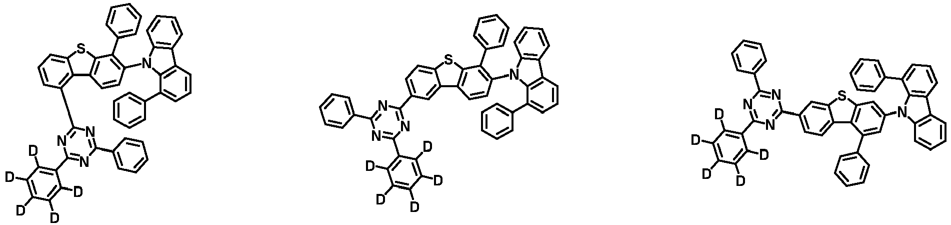

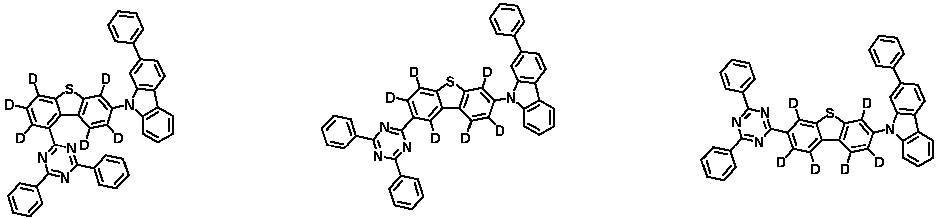

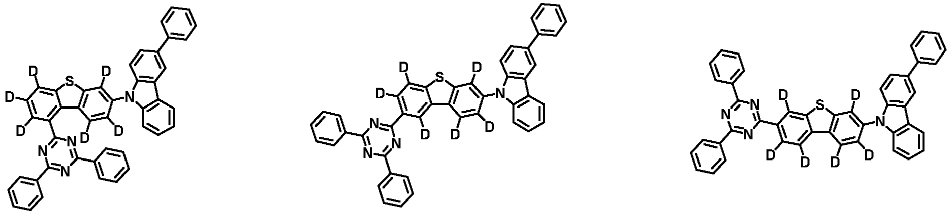

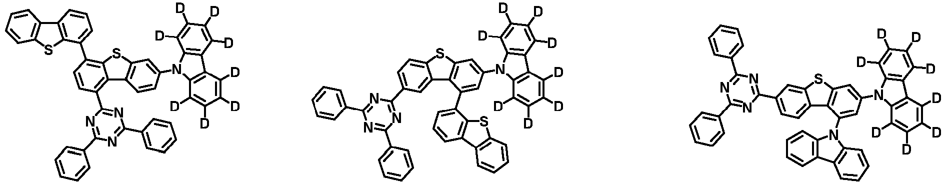

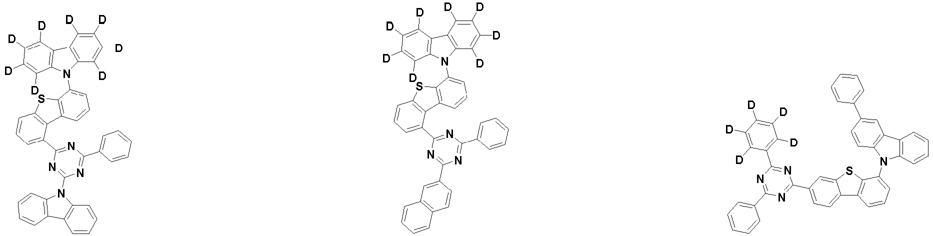

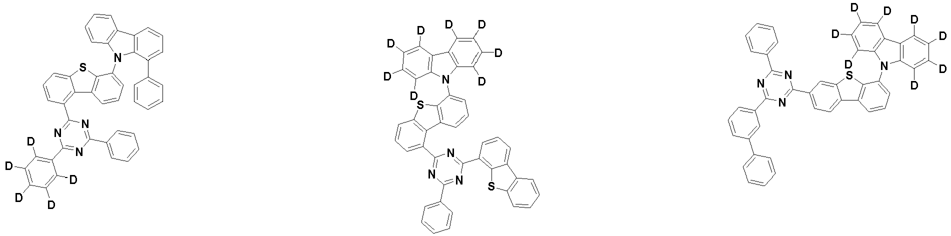

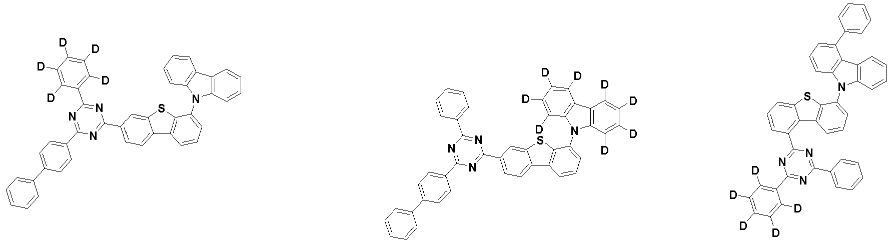

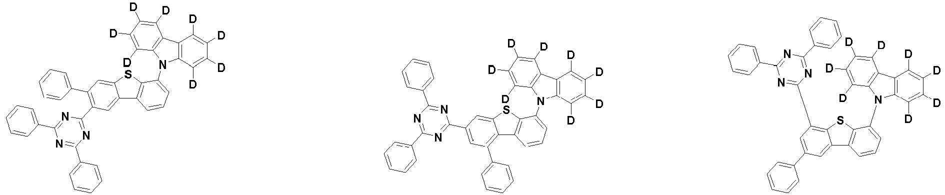

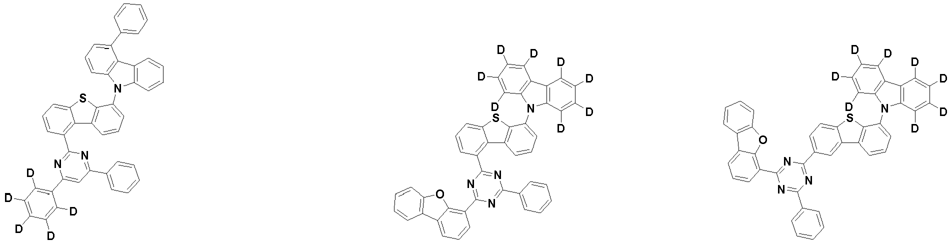

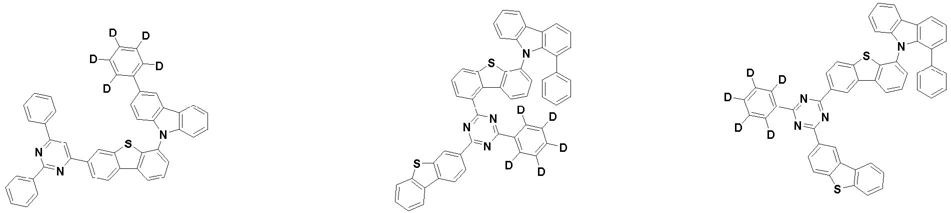

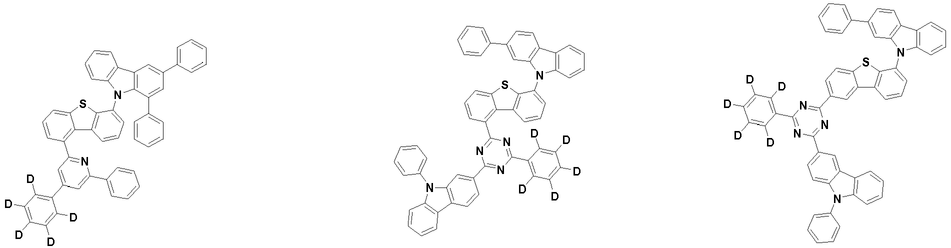

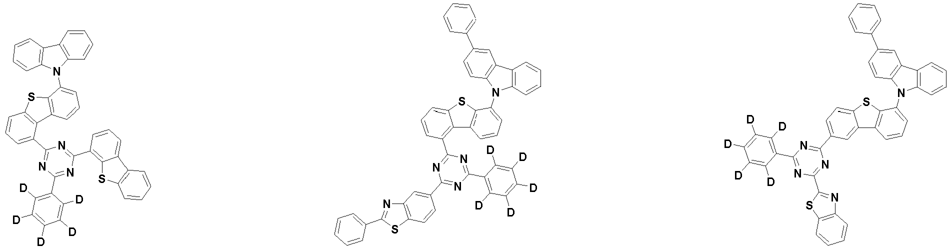

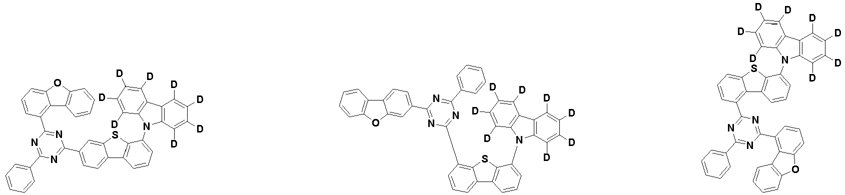

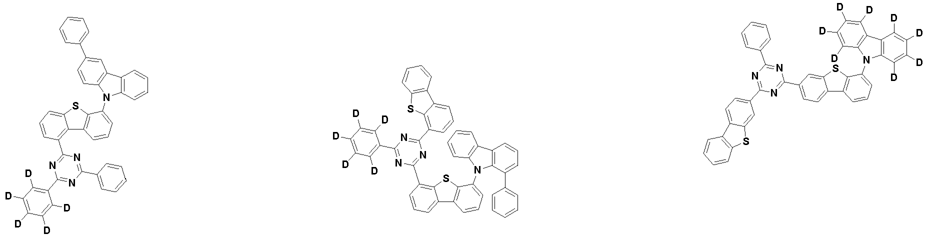

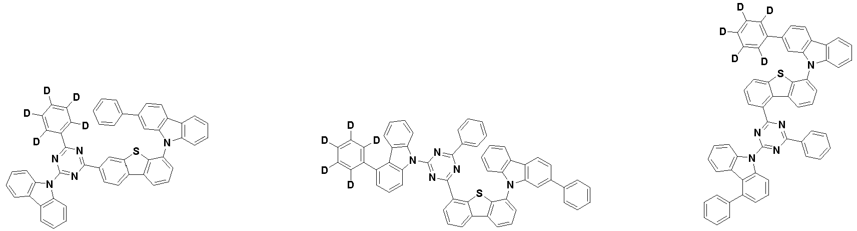

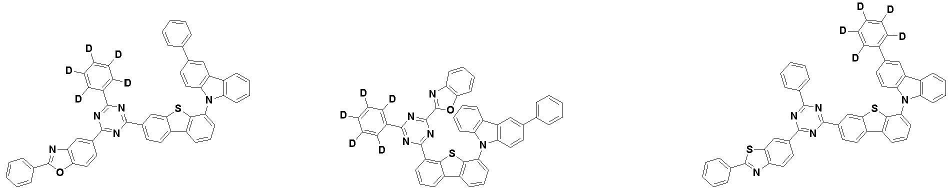

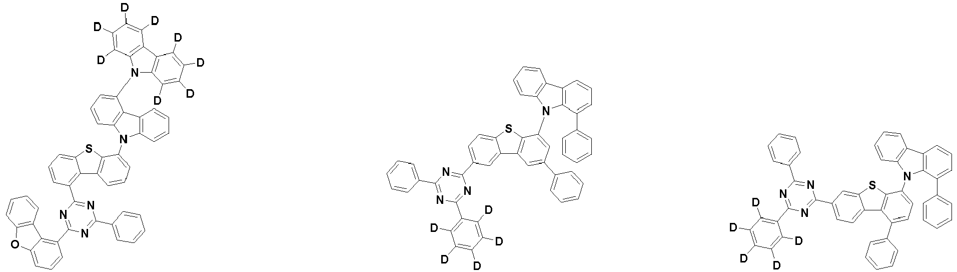

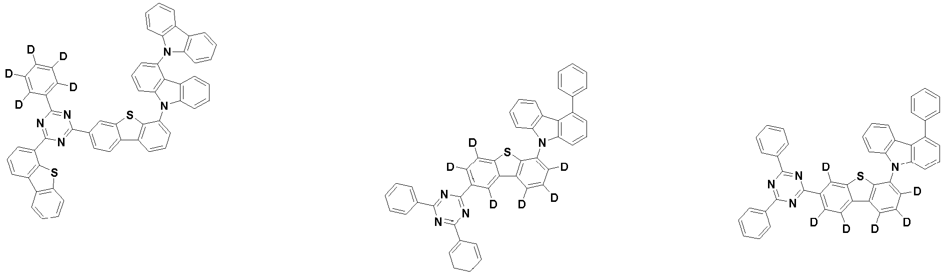

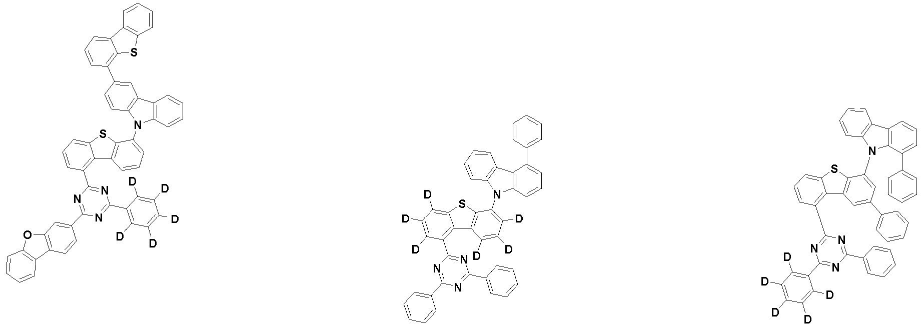

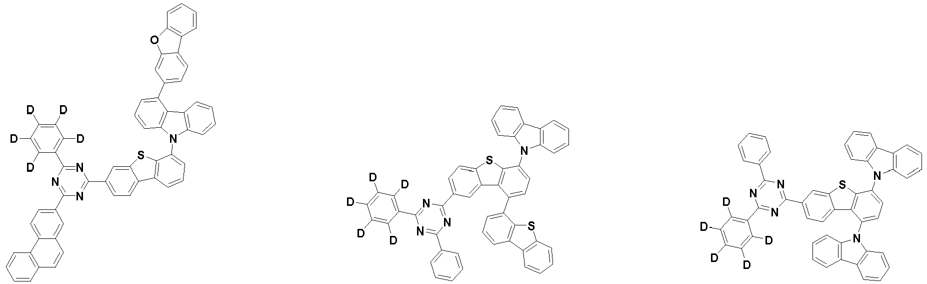

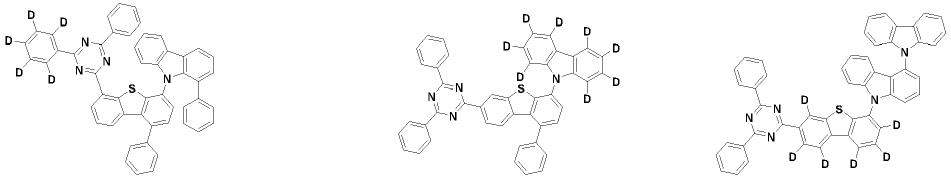

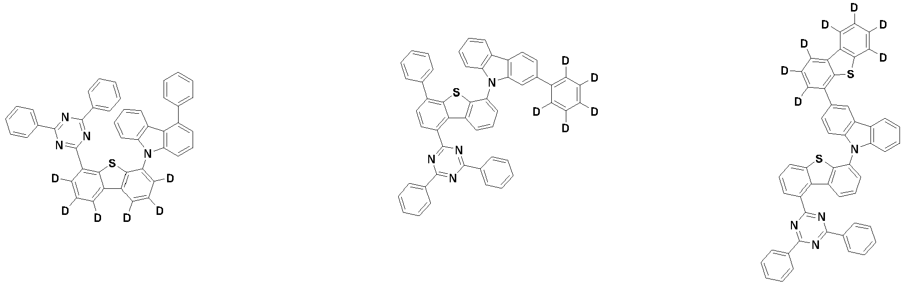

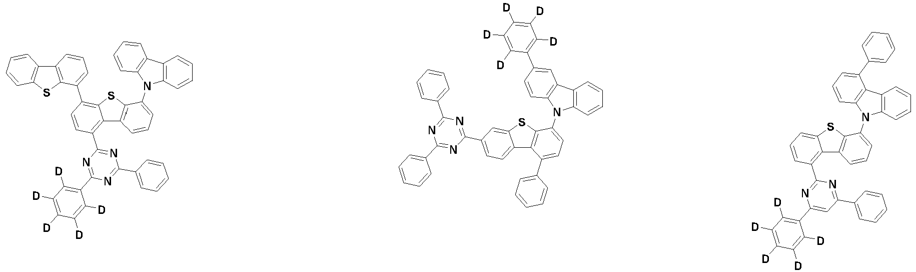

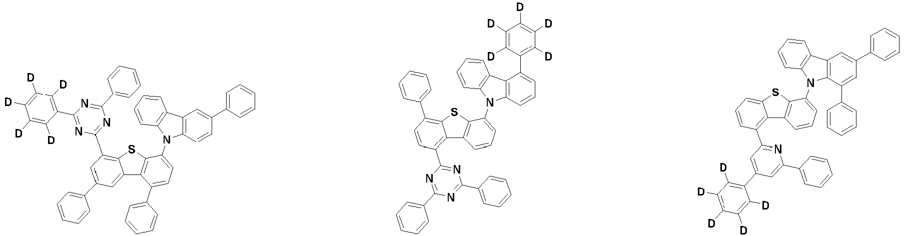

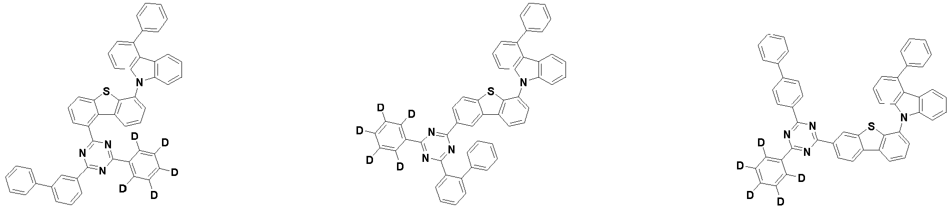

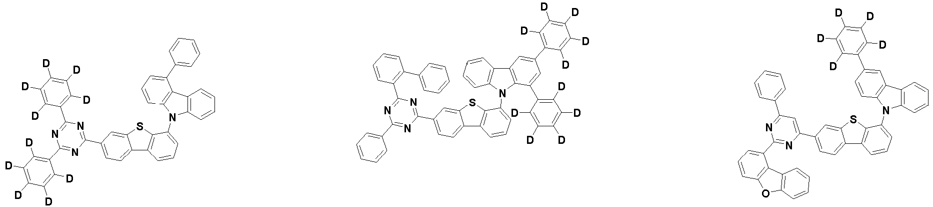

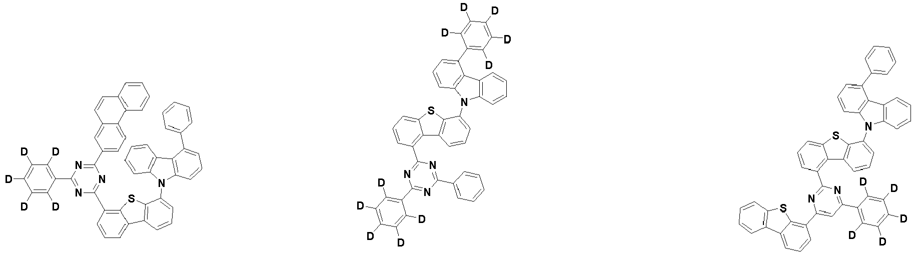

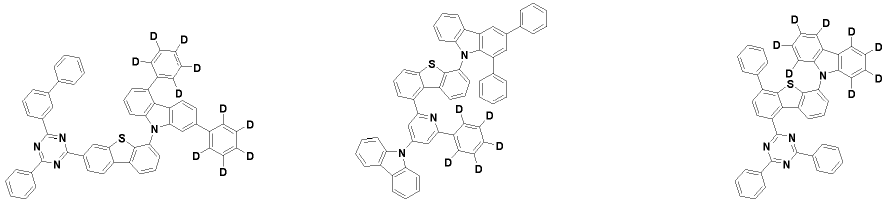

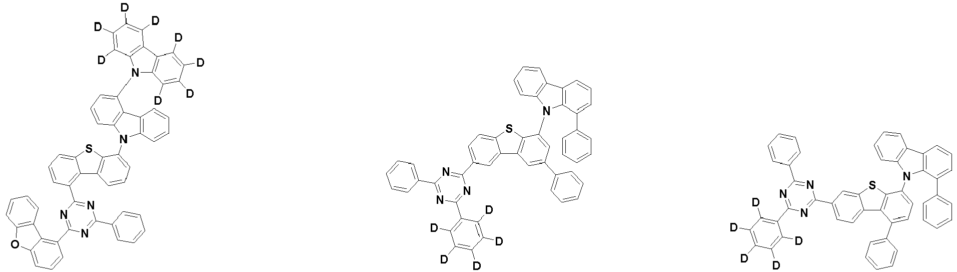

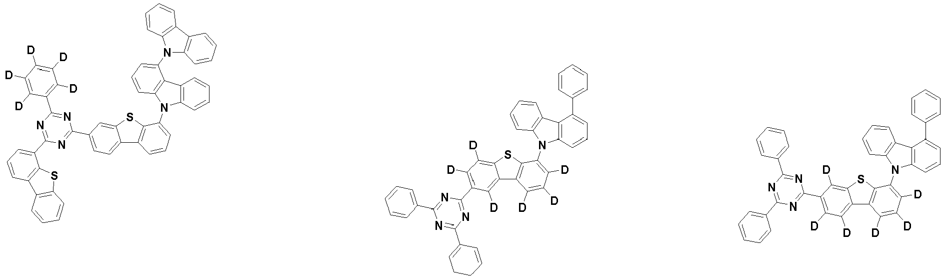

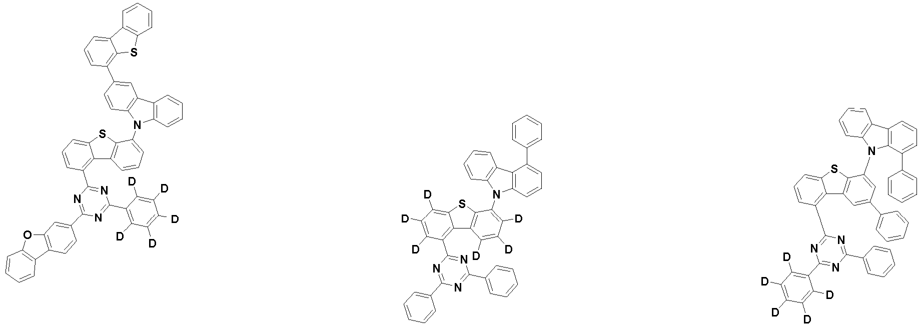

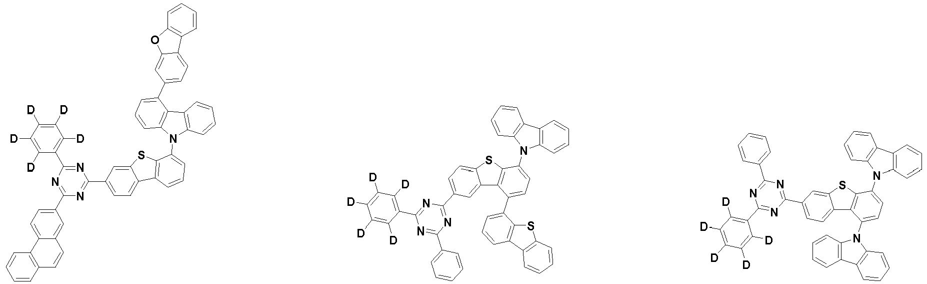

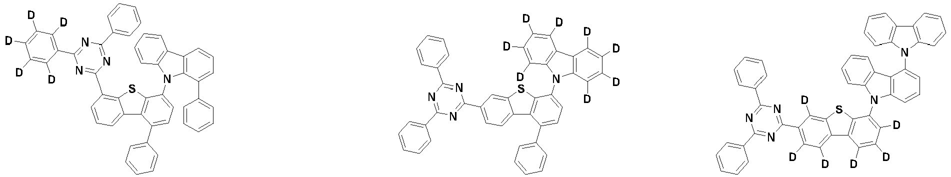

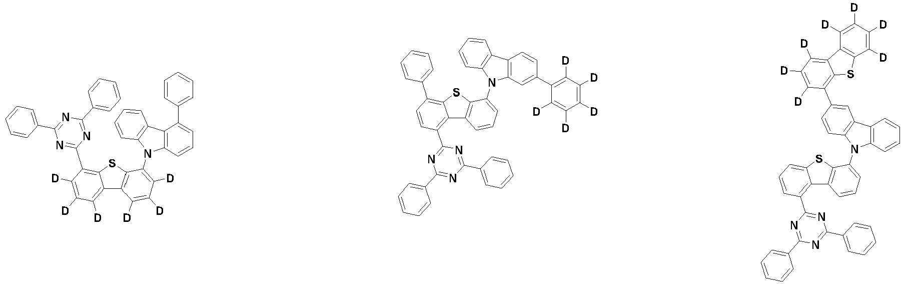

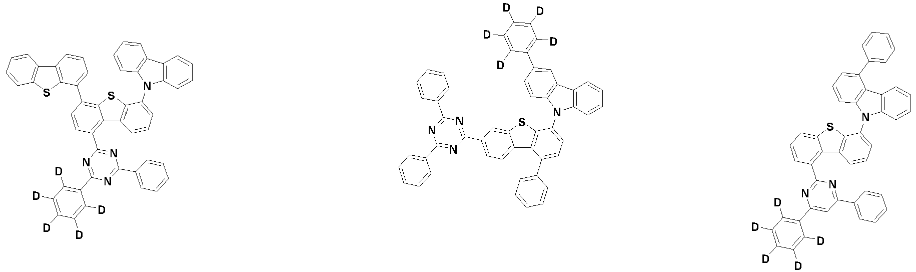

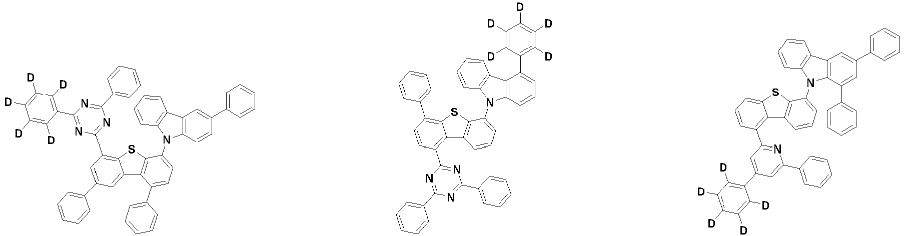

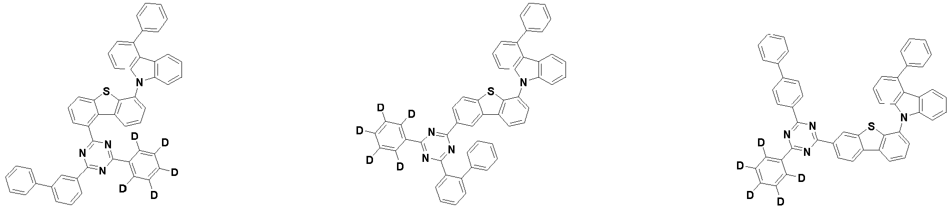

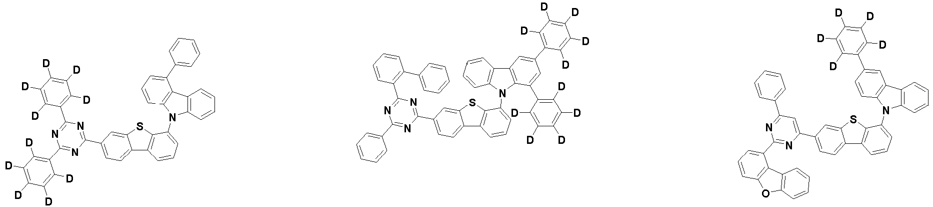

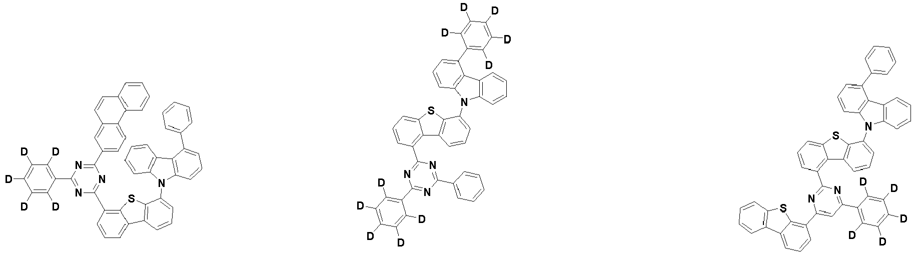

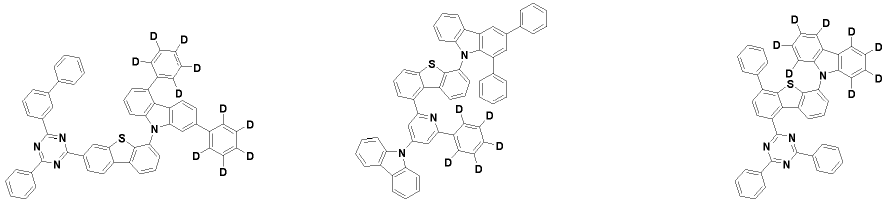

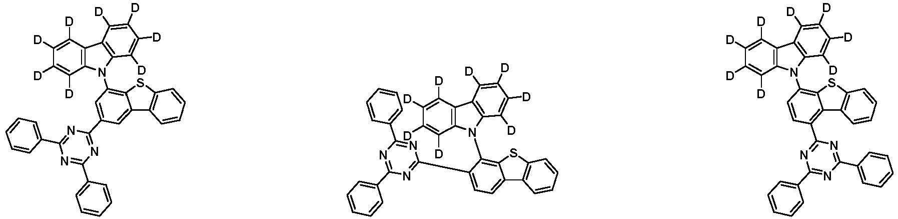

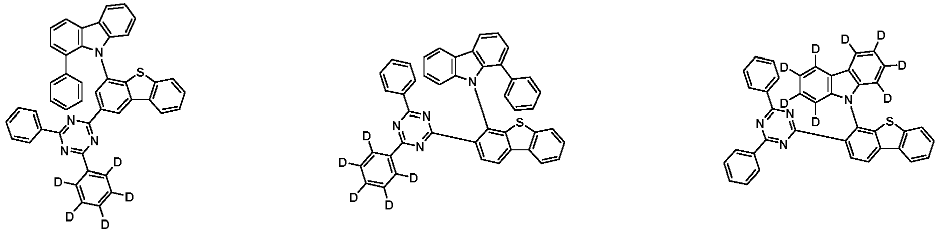

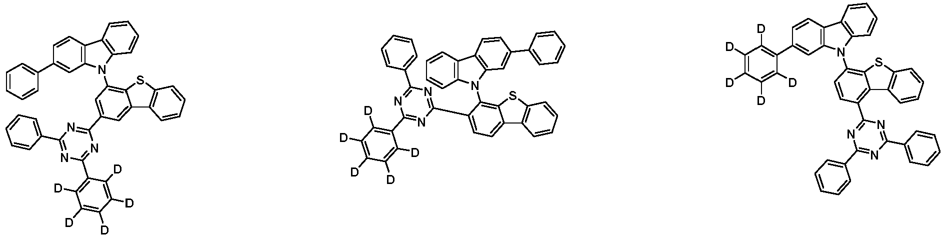

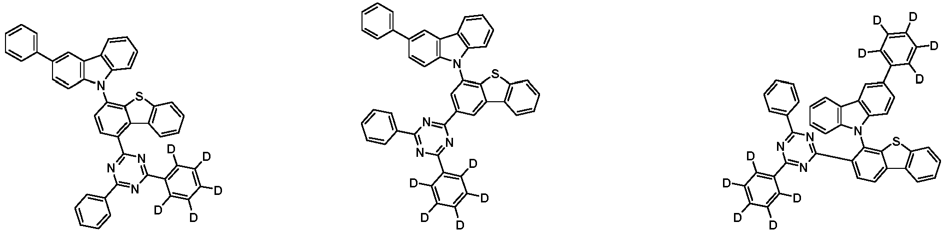

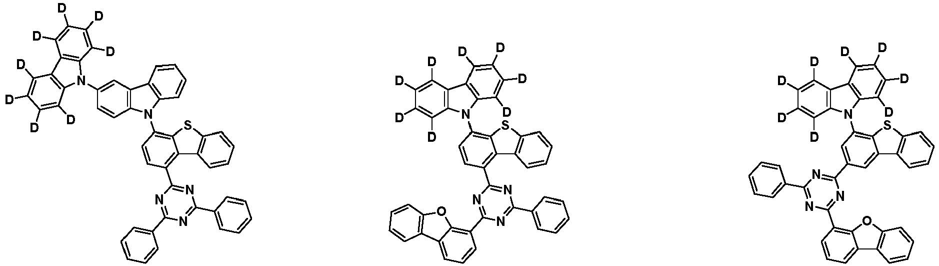

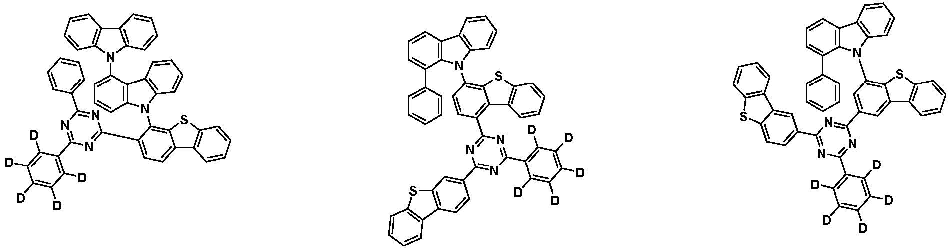

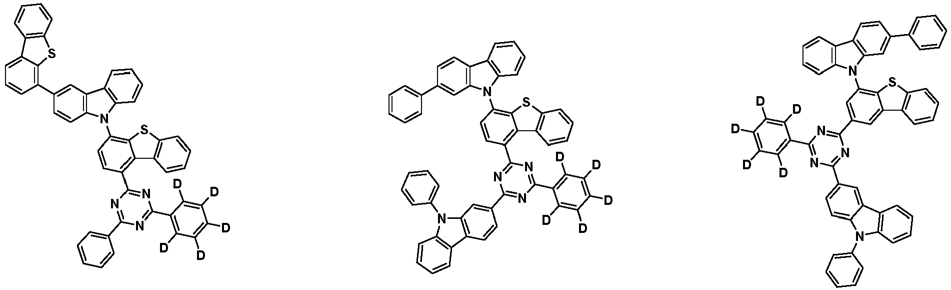

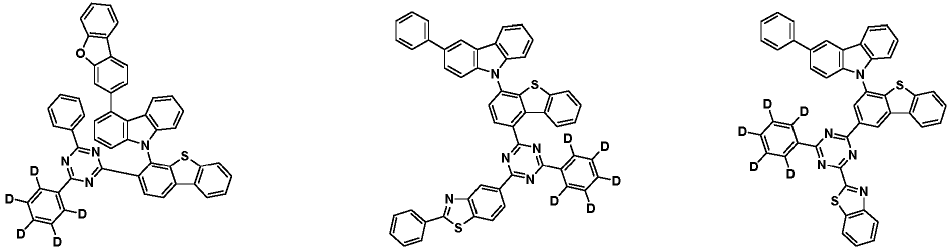

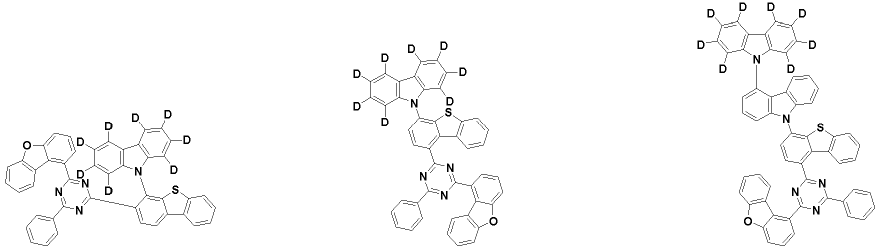

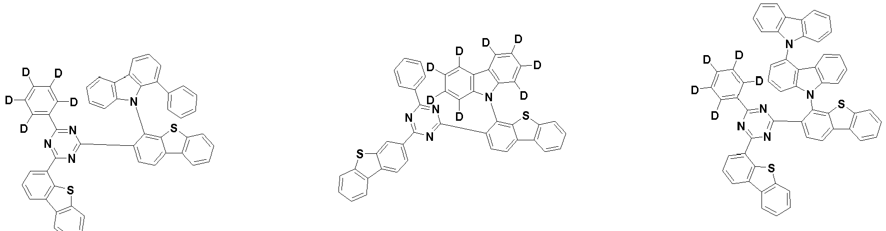

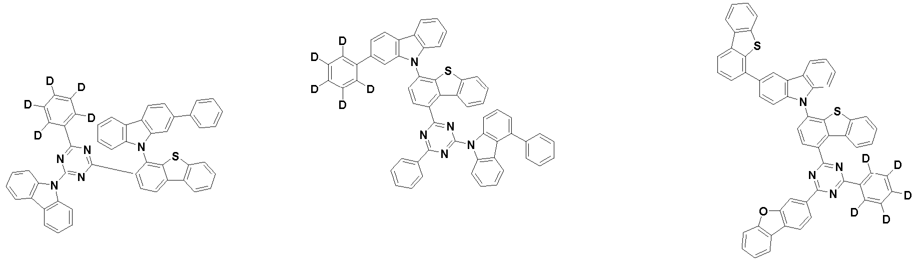

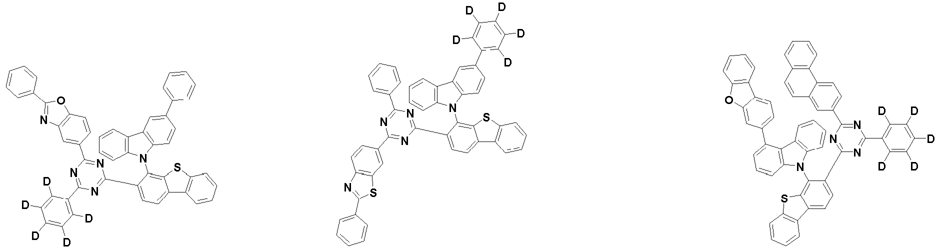

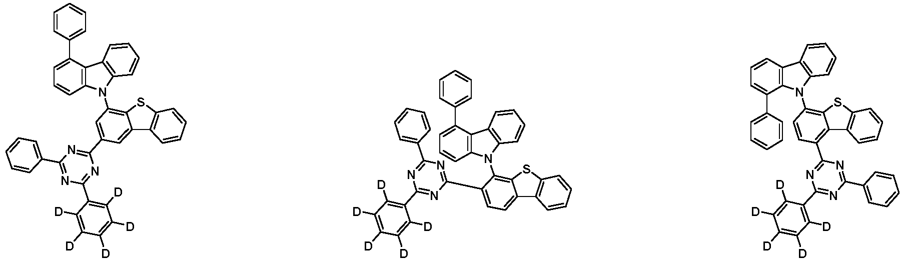

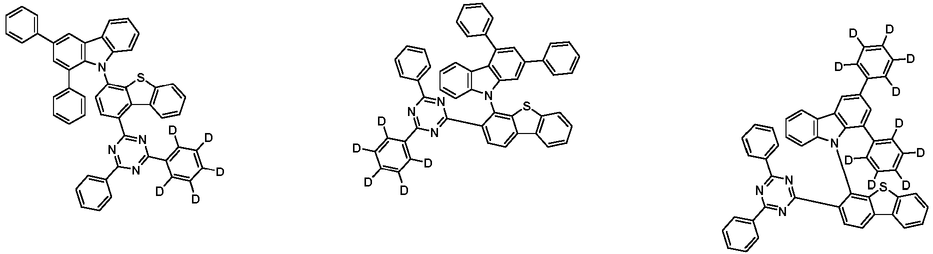

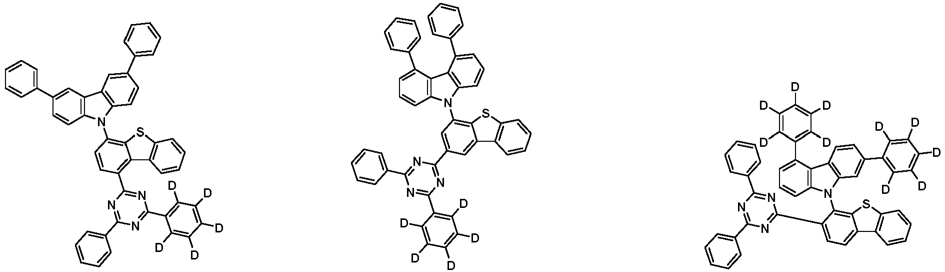

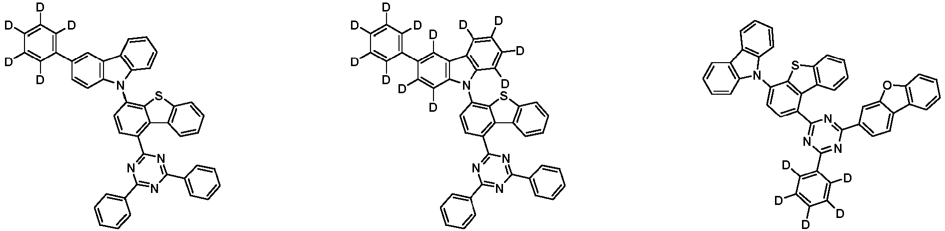

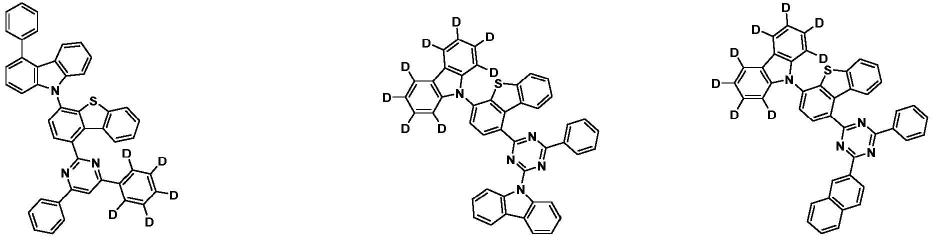

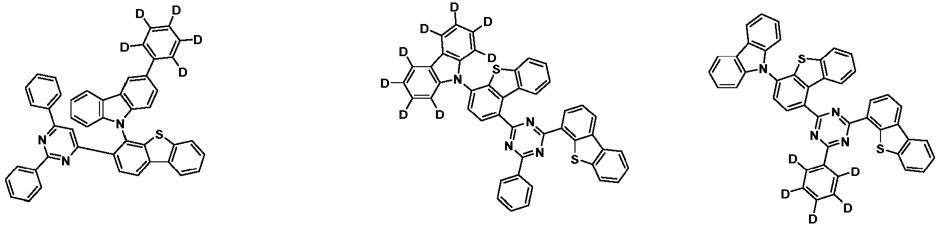

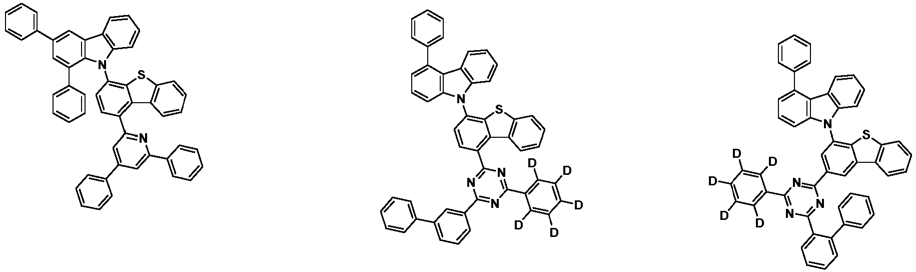

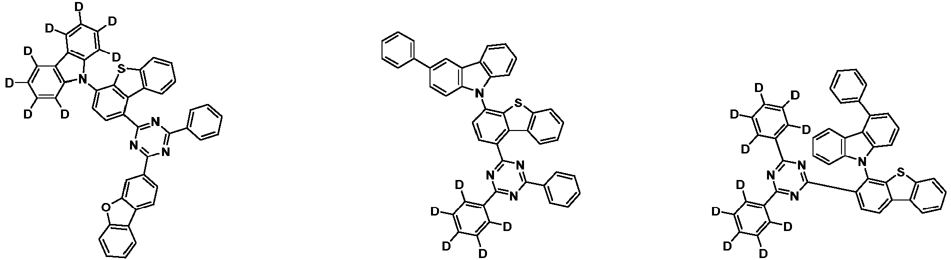

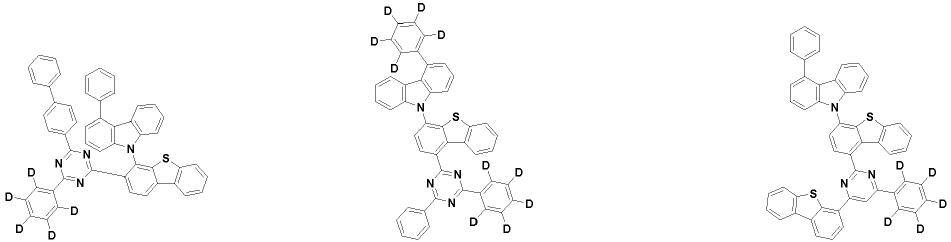

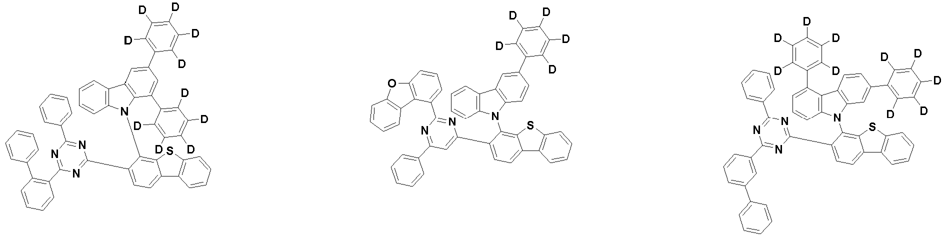

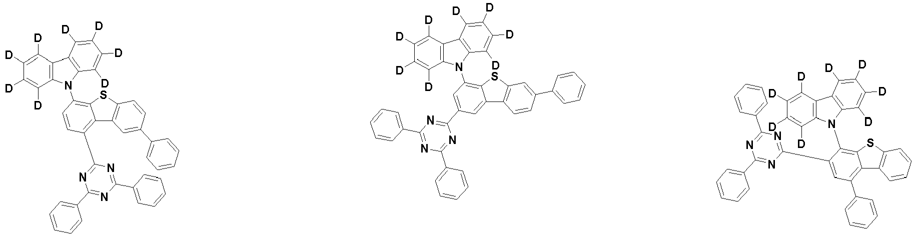

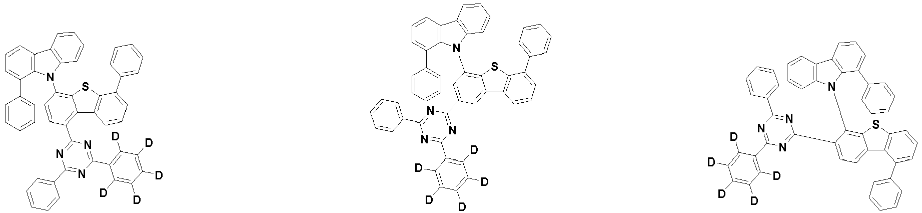

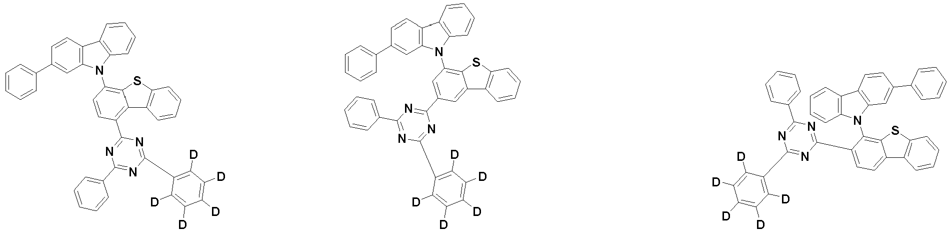

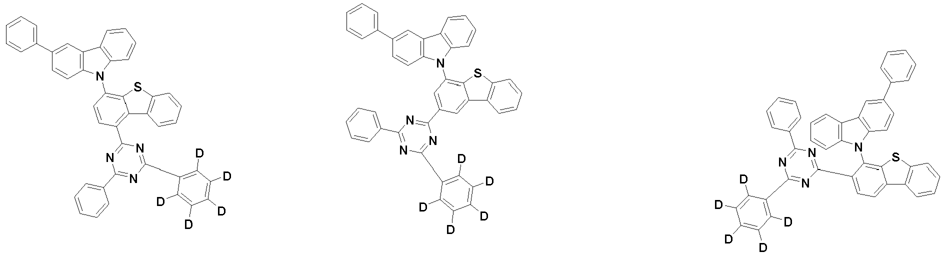

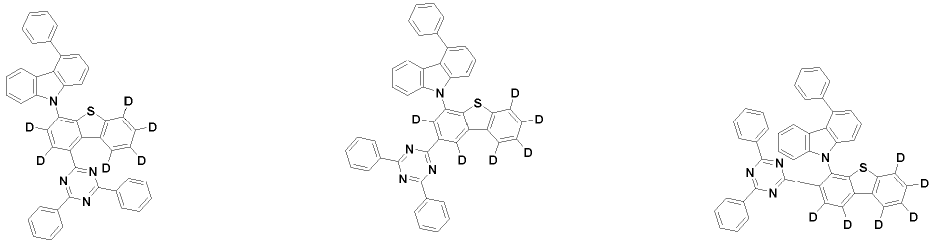

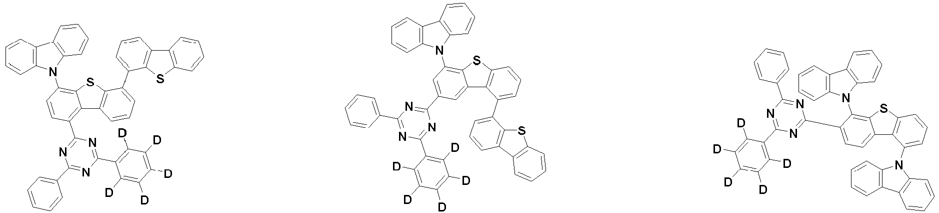

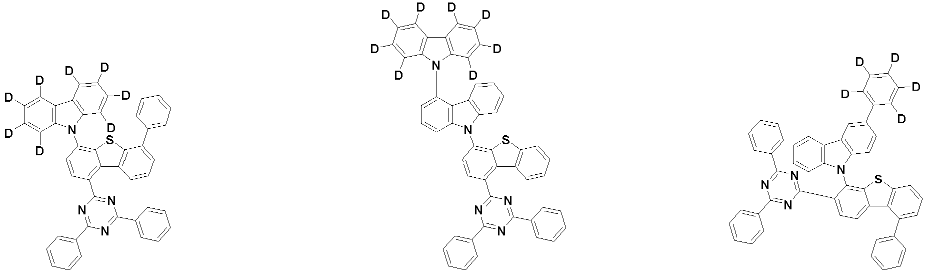

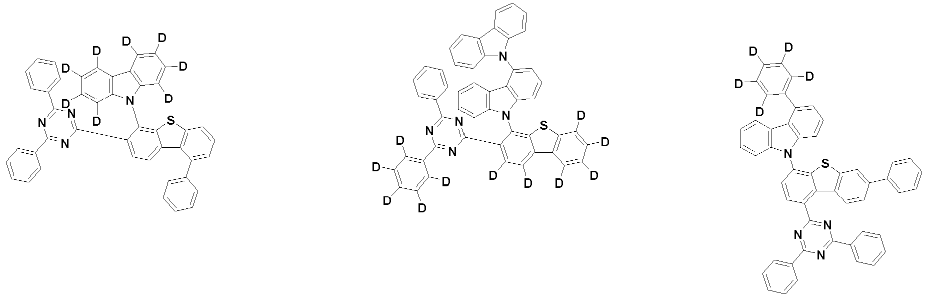

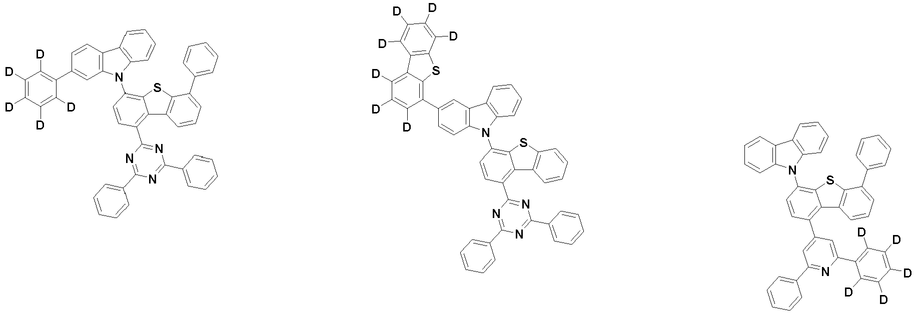

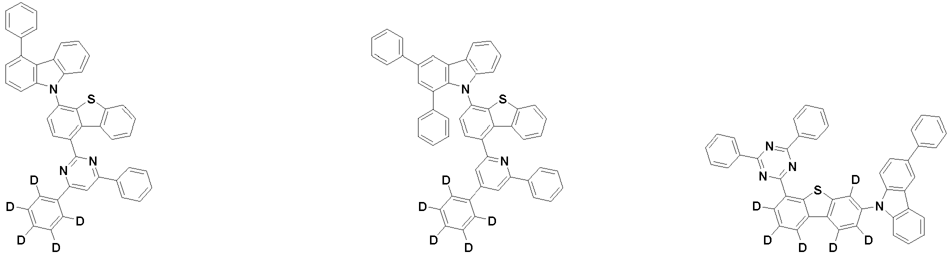

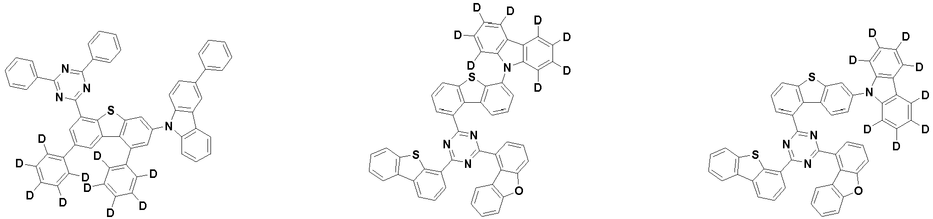

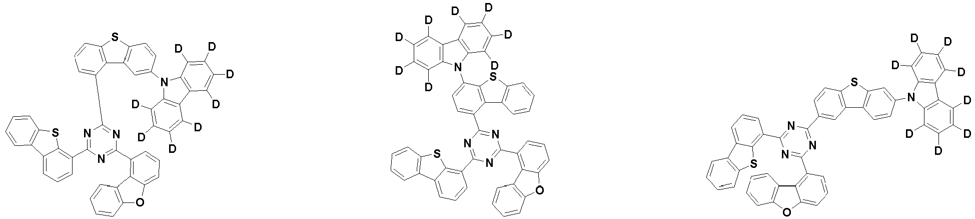

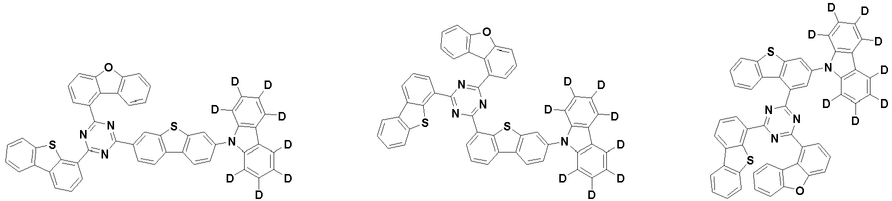

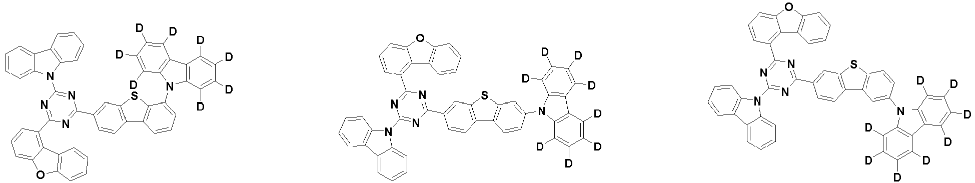

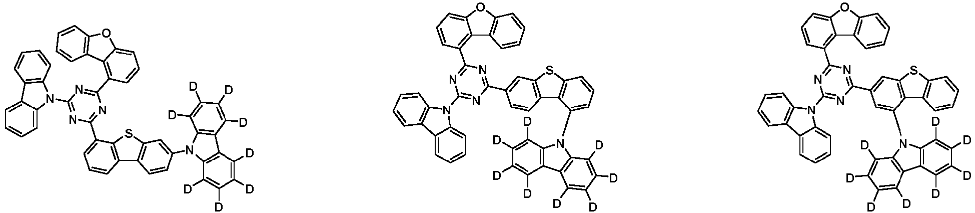

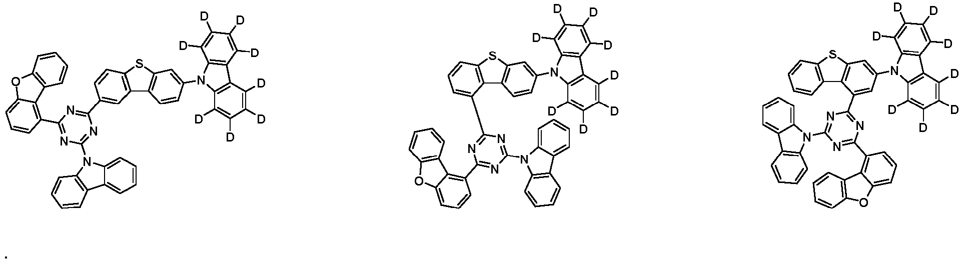

Meanwhile, the compound represented by Chemical Formula 1 may be prepared by, for example, a preparation method as shown in Reaction Scheme 1 below, and other compounds may be prepared similarly. The preparation method may be more specifically described in Synthesis Examples described below.

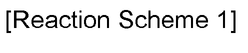

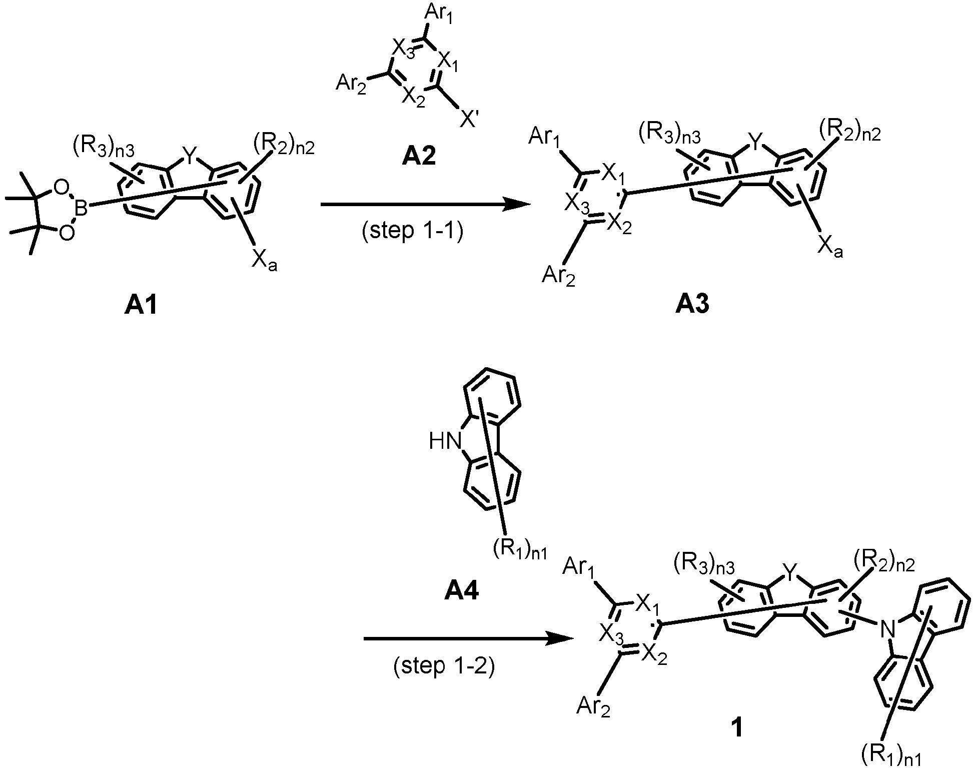

In the Reaction Scheme 1, Xa and X' are each independently halogen. Preferably Xa is fluoro or chloro. Preferably, X' is bromo, or chloro, more preferably chloro. In the Reaction Scheme 1, the definitions of other substituents are the same as described above.

Specifically, the compound represented by Chemical Formula 1 may be prepared through steps 1-1 and 1-2.

The step 1-1 is to prepare an intermediate compound A3 by the Suzuki-coupling reaction of starting materials A1 and A2. The Suzuki-coupling reaction is preferably performed in the presence of a palladium catalyst and a base, respectively, and the reactive group for the Suzuki-coupling reaction may be appropriately changed.

In addition, the step 1-2 is to prepare a compound represented by Chemical Formula 1 in which a carbazole group is introduced into the intermediate compound A3 by an amine substitution reaction of the intermediate compound A3 and the compound A4. The amine substitution reaction is preferably performed in the presence of a base or in the presence of a palladium catalyst and a base. In addition, the reactive group for the amine substitution reaction may also be appropriately changed as known in the art.

For example, in the Reaction Scheme 1, sodium tert-butoxide (NaOtBu), potassium carbonate (K₂CO₃), sodium bicarbonate (NaHCO₃), cesium carbonate (Cs₂CO₃), sodium acetate (NaOAc), potassium acetate (KOAc), sodium ethoxide (NaOEt), triethylamine (Et₃N), N,N-diisopropylethylamine (EtN(iPr)₂), or the like may be used as the base component. Preferably, the base component may be sodium tert-butoxide (NaOtBu), potassium carbonate (K₂CO₃), cesium carbonate (Cs₂CO₃), potassium acetate (KOAc), or N,N-diisopropylethylamine (EtN(iPr)₂). In particular, in the Reaction Scheme 1, potassium carbonate (K₂CO₃), sodium tert-butoxide (NaOtBu), or cesium carbonate (Cs₂CO₃) may be used as the base component.

In addition, in the Reaction Scheme 1, bis(tri-(tert-butyl)phosphine)palladium(0) (Pd(P-tBu₃)₂), tetrakis(triphenylphosphine)palladium(0) (Pd(PPh₃)₄), tris(dibenzylideneacetone)-dipalladium(0) (Pd₂(dba)₃), bis(dibenzylideneacetone)palladium(0) (Pd(dba)₂), palladium(II) acetate (Pd(OAc)₂), or the like may be used as the palladium catalyst. Preferably, the palladium catalyst may be bis(tri-(tert-butyl)phosphine)palladium(0) (Pd(P-tBu₃)₂), tetrakis(triphenylphosphine)palladium(0) (Pd(PPh₃)₄), or bis(dibenzylideneacetone)palladium(0) (Pd(dba)₂). In particular, in the Reaction Scheme 1, tetrakis(triphenylphosphine)palladium(0) (Pd(PPh₃)₄), or bis(tri-(tert-butyl)phosphine)palladium(0) (Pd(P-tBu₃)₂) may be used as the palladium catalyst.

The method for preparing the compound represented by Chemical Formula 1 may be more specifically described in Synthesis Examples described below.

### (Second compound)

The second compound is represented by Chemical Formula 2. Specifically, it has a structure in which two N atoms of an indolocarbazole core are substituted with an aryl group or a heteroaryl group, respectively, and deuterium is substituted in each of the indolocarbazole core and the aryl group or heteroaryl group. The second compound is characterized in that it contains at least two or more deuterium (D). 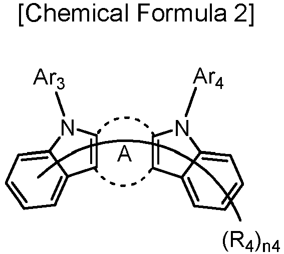 wherein in Chemical Formula 2:
A is a benzene ring fused with two adjacent rings;
Ar₃ and Ar₄ are each independently a substituted or unsubstituted C₆₋₆₀ aryl, or a substituted or unsubstituted C₂₋₆₀ heteroaryl containing at least one heteroatom selected from the group consisting of O and S, provided that at least one of Ar₃ and Ar₄ is substituted with at least one deuterium;
each R₄ is independently hydrogen, deuterium, substituted or unsubstituted C₆₋₆₀ aryl, or substituted or unsubstituted C₂₋₆₀ heteroaryl containing at least one heteroatom selected from the group consisting of N, O and S, provided that at least one of R₄ is deuterium; and
n4 is an integer of 1 to 10.

Preferably, the compound represented by Chemical Formula 2 may be represented by any one of the following Chemical Formulae 2-1 to 2-5: 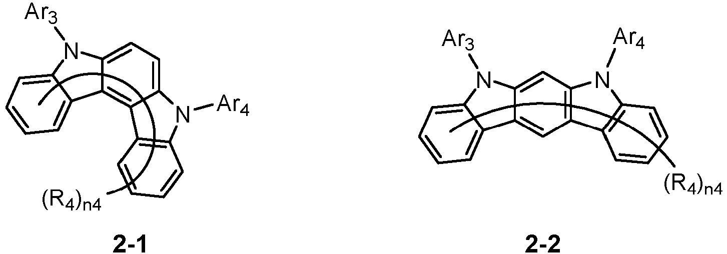 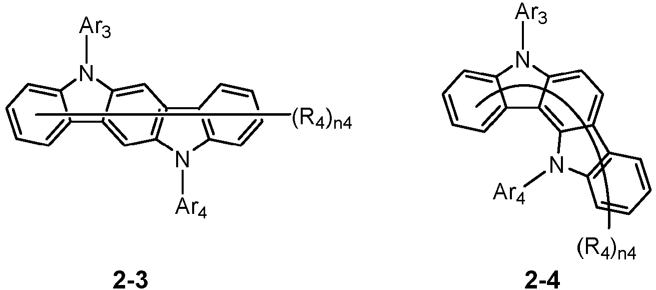 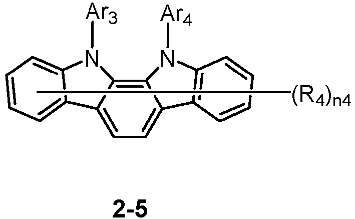
wherein in Chemical Formulae 2-1 to 2-5,
Ar₃, Ar₄, R₄, and n4 are as defined in Chemical Formula 2.

In Chemical Formulae 2 and 2-1 to 2-5, Ar₃ and Ar₄ are each independently substituted or unsubstituted C₆₋₆₀ aryl or substituted or unsubstituted C₂₋₆₀ heteroaryl containing at least one heteroatom selected from the group consisting of O and S, provided that at least one of Ar₃ and Ar₄ is substituted with at least one deuterium.

For example, Ar₃ may be substituted or unsubstituted C₆₋₆₀ aryl, and Ar₄ may be substituted or unsubstituted C₆₋₆₀ aryl or substituted or unsubstituted C₂₋₆₀ heteroaryl containing at least one heteroatom selected from the group consisting of N, O and S, provided that at least one of Ar₃ and Ar₄ is substituted with at least one deuterium.

Preferably, in Chemical Formulae 2 and 2-1 to 2-5, Ar₃ and Ar₄ may each independently be substituted or unsubstituted C₆₋₂₀ aryl or substituted or unsubstituted C₂₋₂₀ heteroaryl containing at least one heteroatom selected from the group consisting of O and S. More preferably, Ar₃ and Ar₄ may each independently be phenyl, biphenylyl, terphenylyl, dibenzofuranyl, dibenzothiophenyl, dimethylfluorenyl, dibenzofuranyl phenyl, dibenzothiophenyl phenyl, or dimethylfluorenyl phenyl, and the phenyl, biphenylyl, terphenylyl, dibenzofuranyl, dibenzothiophenyl, dimethylfluorenyl, dibenzofuranyl phenyl, dibenzothiophenyl phenyl, or dimethylfluorenyl phenyl may be unsubstituted or substituted with deuterium. However, at least one of Ar₃ and Ar₄ is substituted with at least one deuterium.

For example, one of Ar₃ and Ar₄ may be phenyl, biphenylyl, or terphenylyl, and the other may be phenyl, biphenylyl, terphenylyl, dibenzofuranyl, dibenzothiophenyl, dimethylfluorenyl, dibenzofuranyl phenyl, dibenzothiophenyl phenyl, or dimethylfluorenyl phenyl, and the phenyl, biphenylyl, terphenylyl, dibenzofuranyl, dibenzothiophenyl, dimethylfluorenyl, dibenzofuranyl phenyl, dibenzothiophenyl phenyl, or dimethylfluorenyl phenyl may be unsubstituted or substituted with deuterium. However, at least one of Ar₃ and Ar₄ is substituted with at least one deuterium.

Specifically, one of Ar₃ and Ar₄ may be biphenylyl, or deuterium-substituted biphenylyl, and the other may be biphenylyl, deuterium-substituted biphenylyl, terphenylyl, deuterium-substituted terphenylyl, dibenzofuranyl, deuterium-substituted dibenzofuranyl, dibenzothiophenyl, deuterium-substituted dibenzothiophenyl, dimethylfluorenyl, deuterium-substituted dimethylfluorenyl, dibenzofuranyl phenyl, deuterium-substituted dibenzofuranyl phenyl, dibenzothiophenyl phenyl, deuterium-substituted dibenzothiophenyl phenyl, dimethylfluorenyl phenyl, or deuterium-substituted dimethylfluorenyl phenyl. However, at least one of Ar₃ and Ar₄ is substituted with at least one deuterium.

Alternatively, Ar₃ and Ar₄ are each independently any one selected from the group consisting of the following structural formulae, provided that at least one of Ar₃ and Ar₄ is substituted with at least one deuterium: 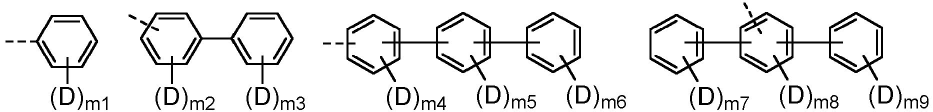 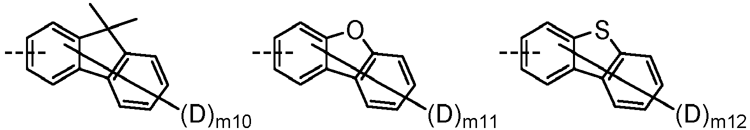 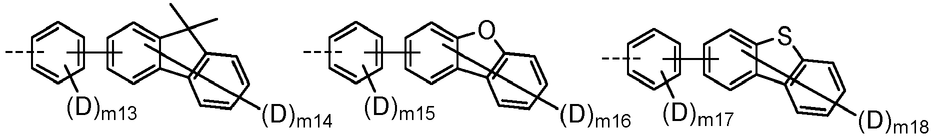
wherein in the above structural formulae,
m1 is an integer of 0 to 5,
m2 is an integer of 0 to 4,
m3 is an integer of 0 to 5,
m4 is an integer of 0 to 4,
m5 is an integer of 0 to 4,
m6 is an integer of 0 to 5,
m7 is an integer of 0 to 5,
m8 is an integer of 0 to 3,
m9 is an integer of 0 to 5,
m10 is an integer of 0 to 13,
m11 is an integer of 0 to 7,
m12 is an integer of 0 to 7,
m13 is an integer of 0 to 4,
m14 is an integer of 0 to 13,
m15 is an integer of 0 to 4,
m16 is an integer of 0 to 7,
m17 is an integer of 0 to 4, and
m18 is an integer of 0 to 7,
provided that at least one of m1 to m18 is 1 or more.

More preferably, in Chemical Formulae 2 and 2-1 to 2-5, Ar₃ may be substituted with at least one deuterium, and Ar₄ may be substituted with at least one deuterium.

For example, in Chemical Formulae 2 and 2-1 to 2-5, Ar₃ and Ar₄ may each independently be any one selected from the group consisting of:

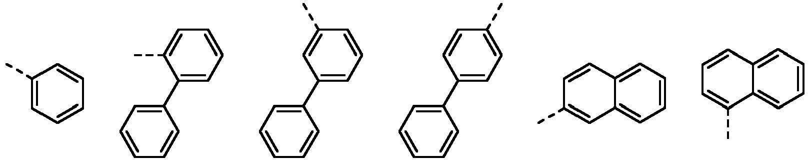

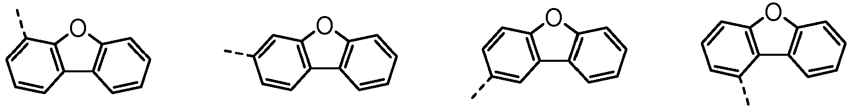

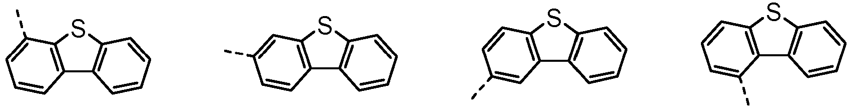

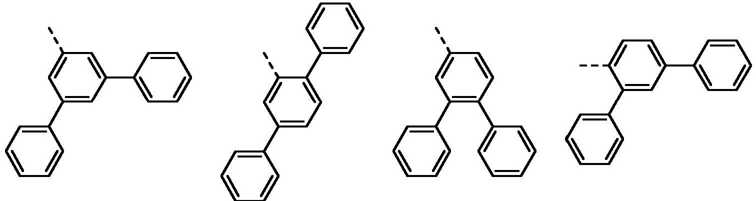

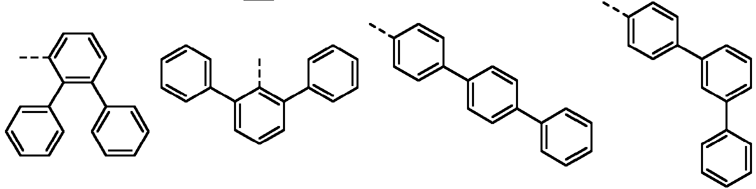

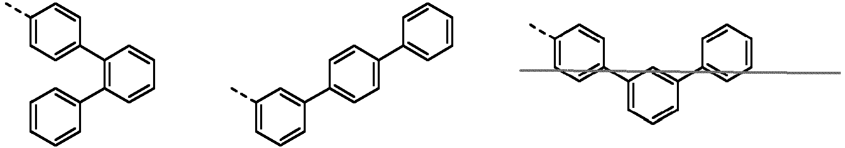

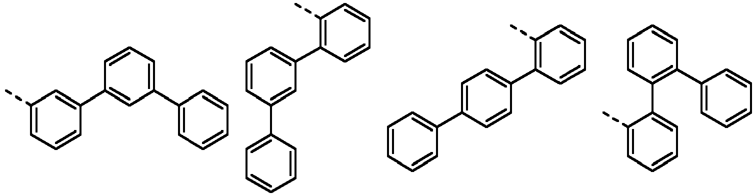

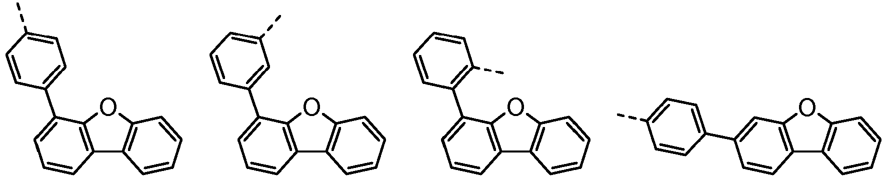

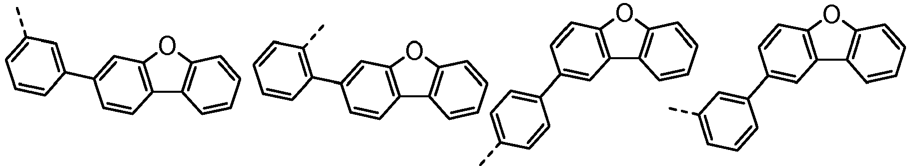

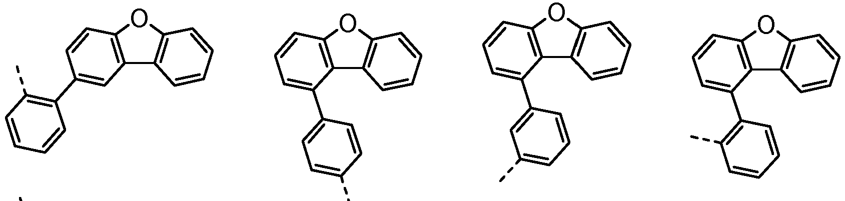

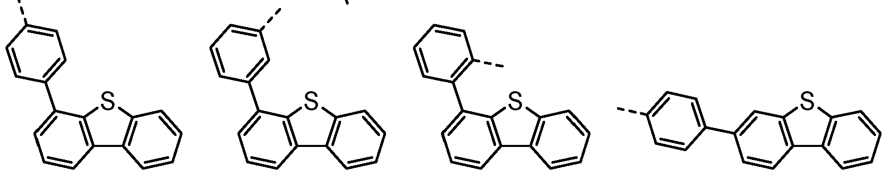

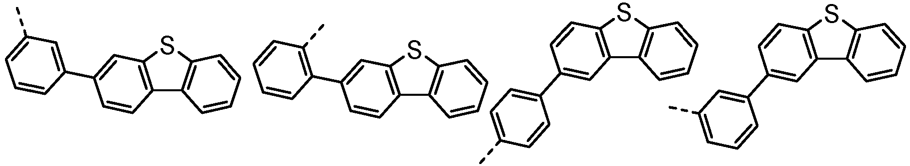

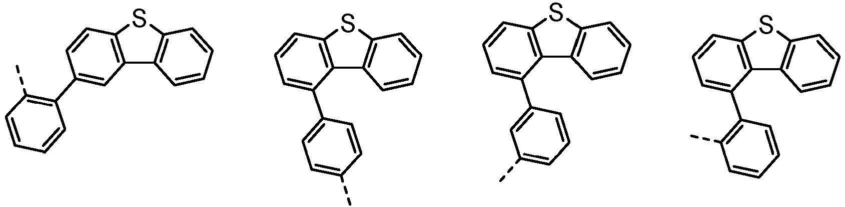

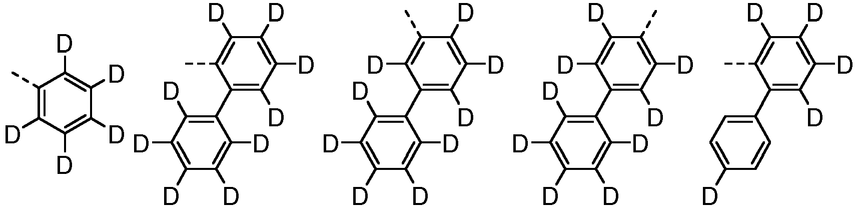

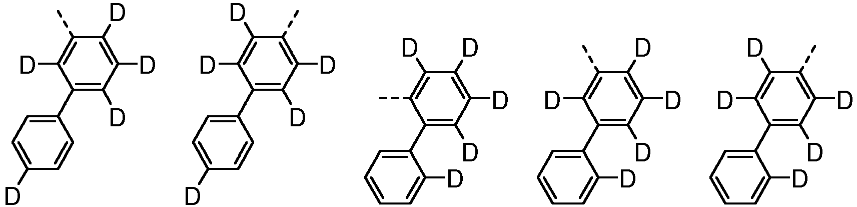

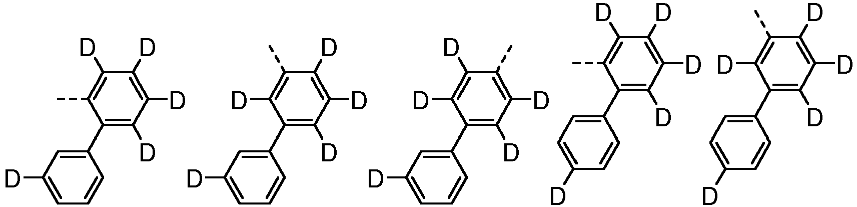

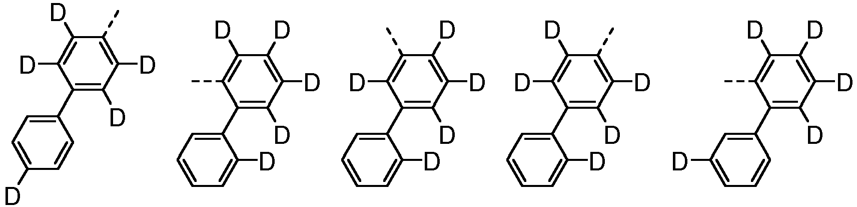

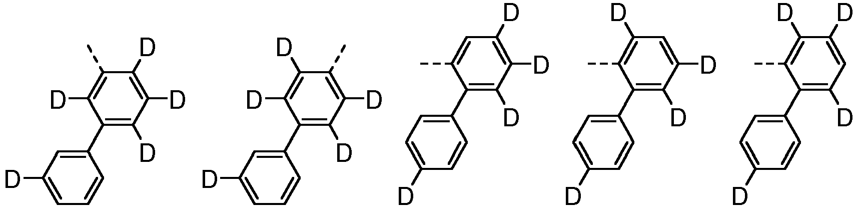

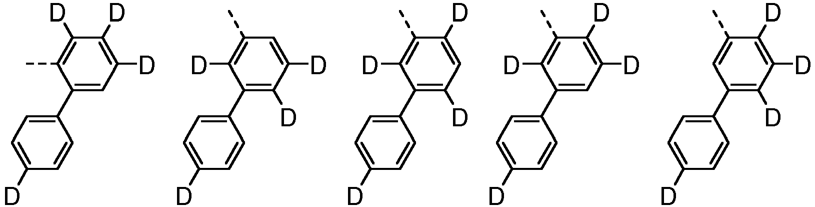

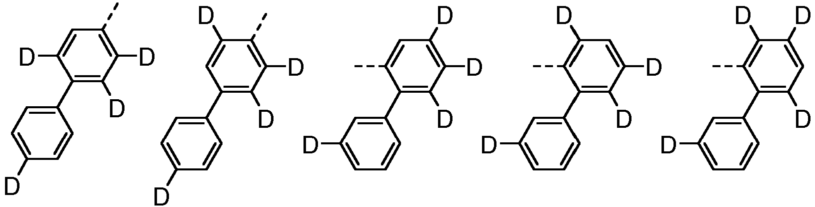

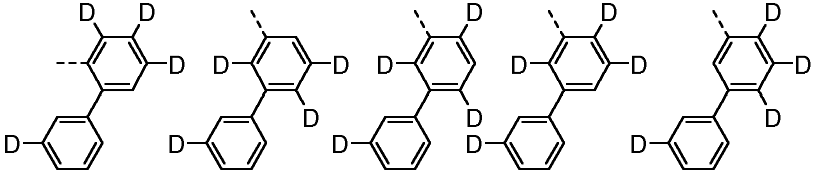

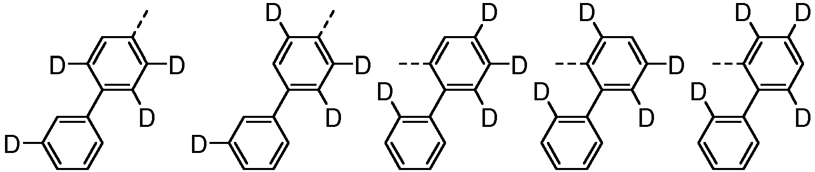

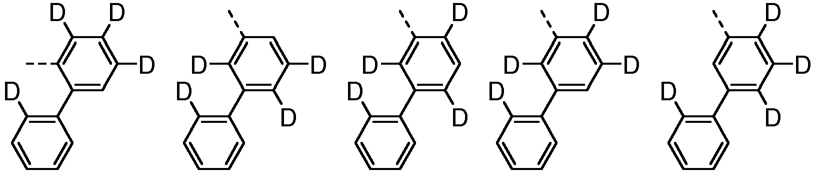

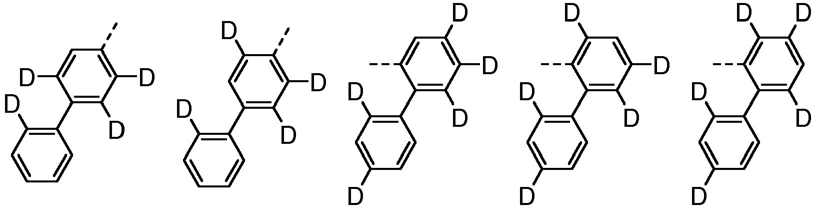

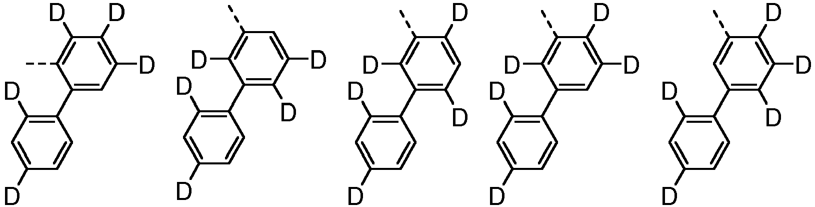

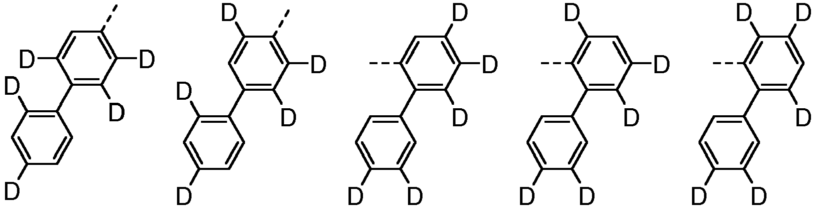

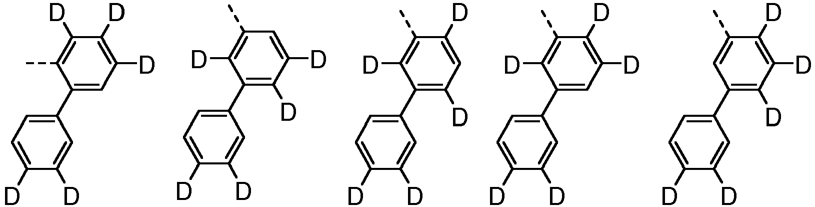

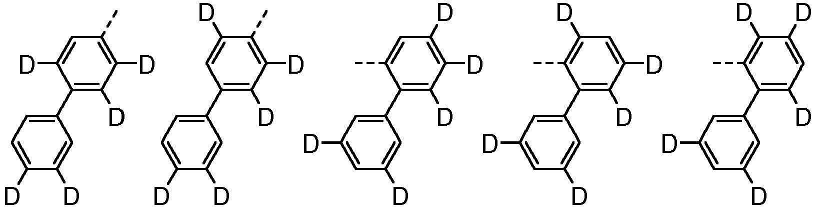

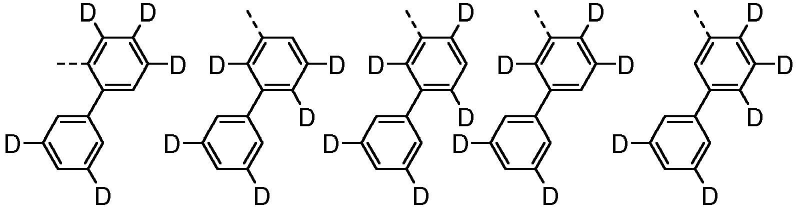

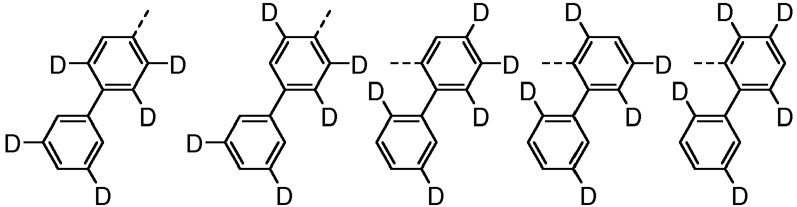

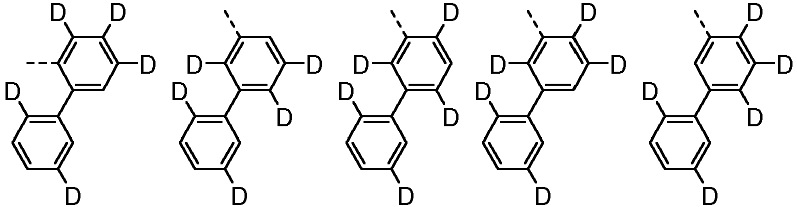

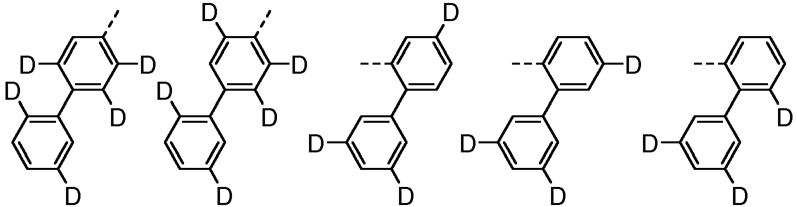

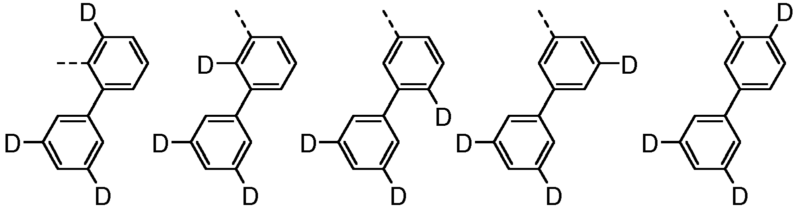

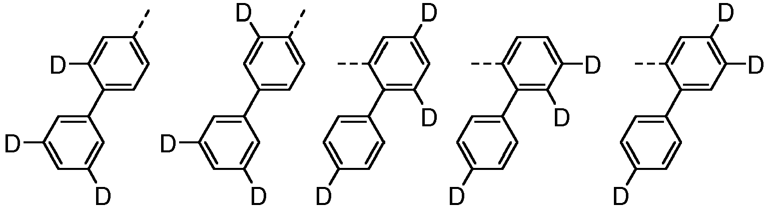

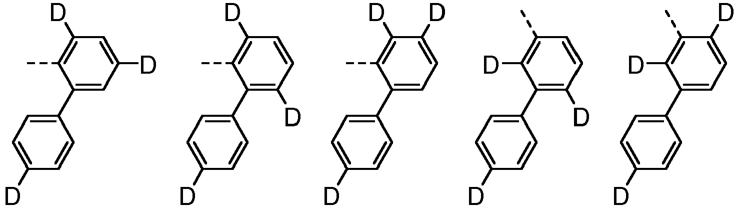

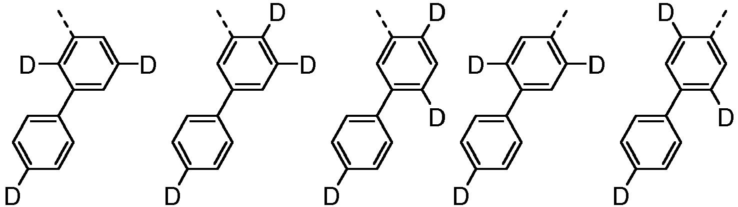

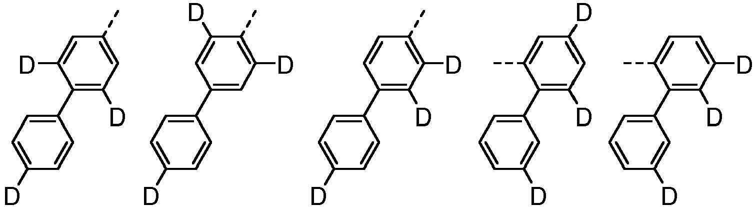

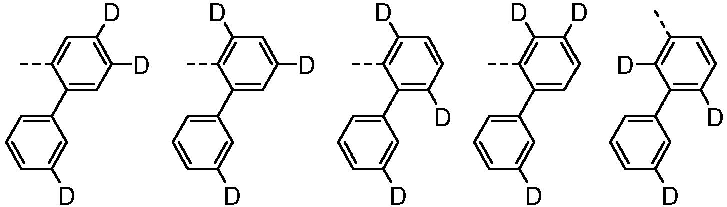

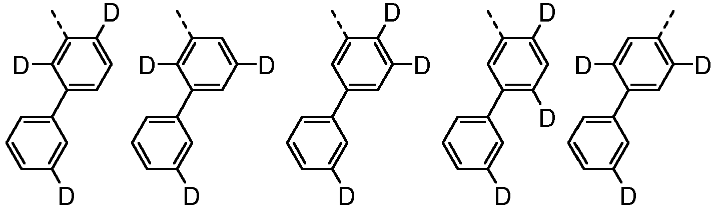

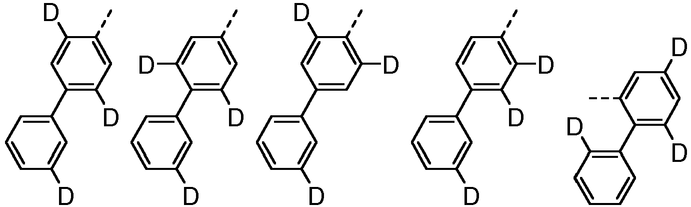

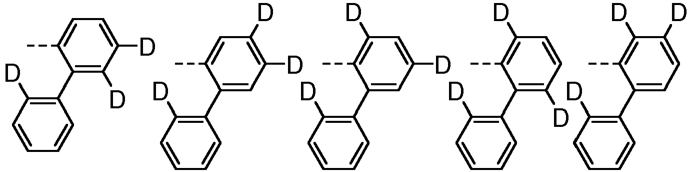

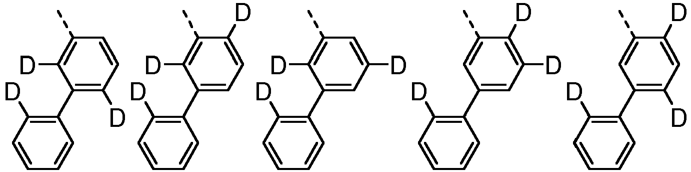

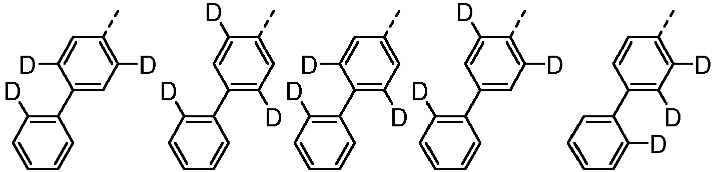

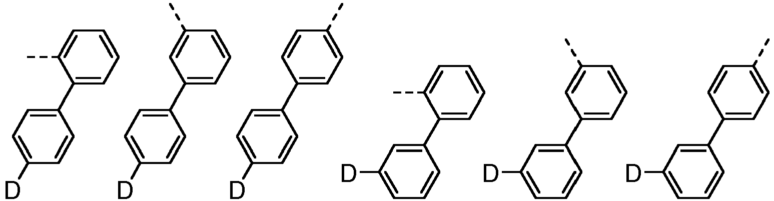

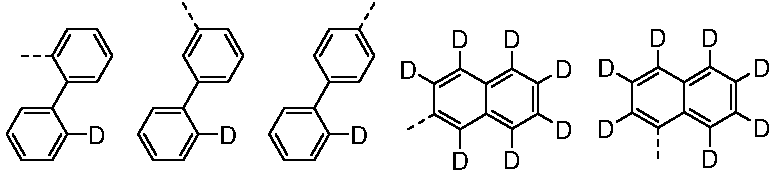

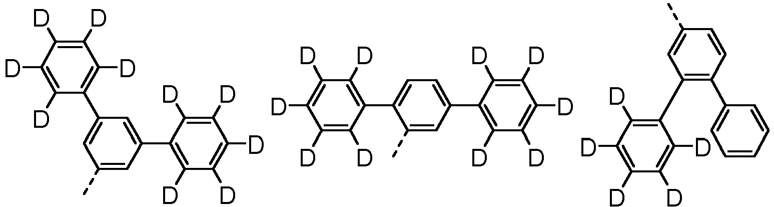

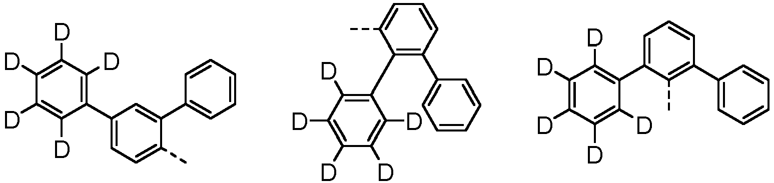

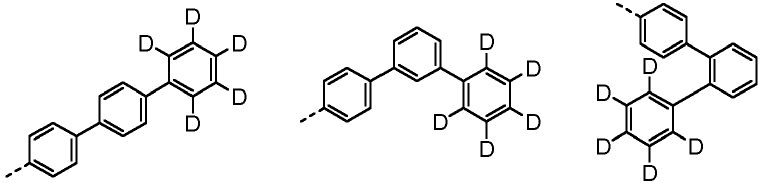

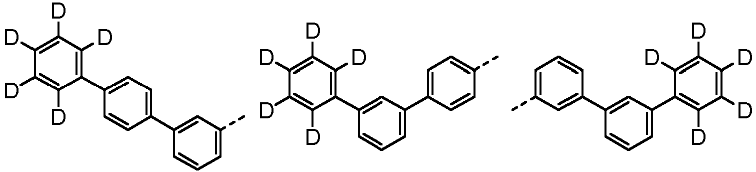

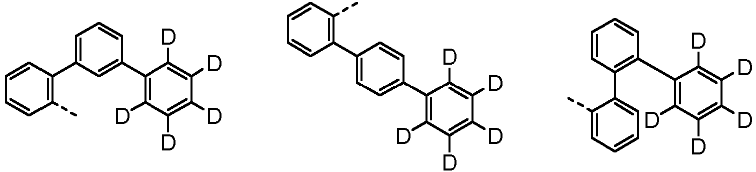

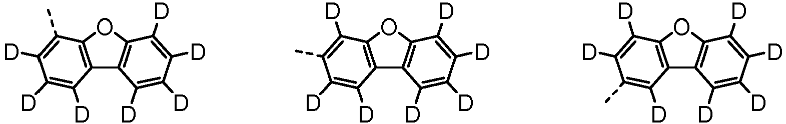

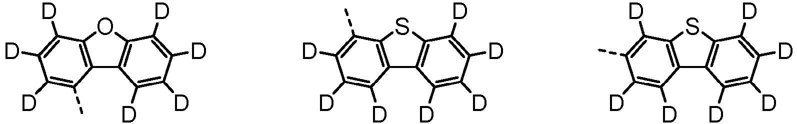

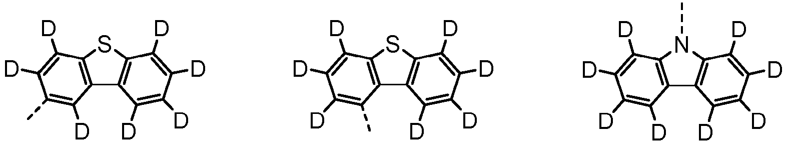

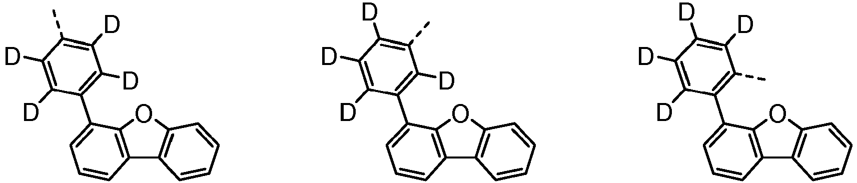

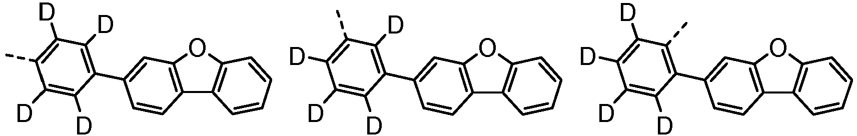

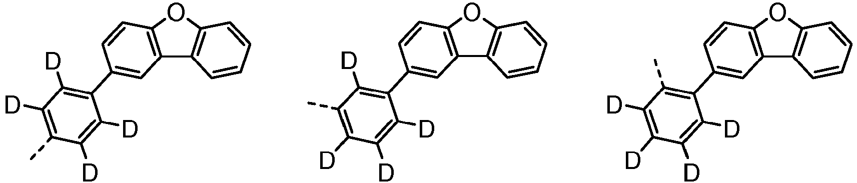

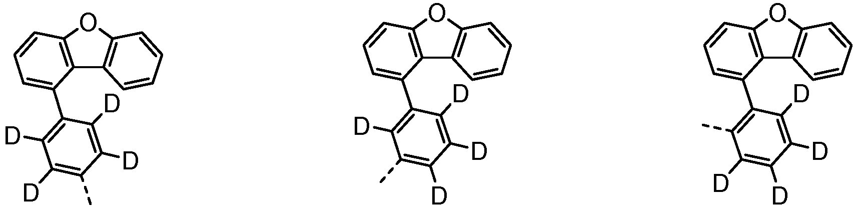

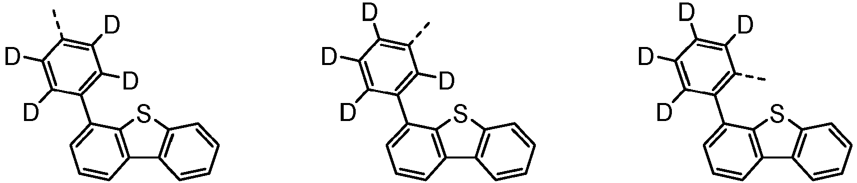

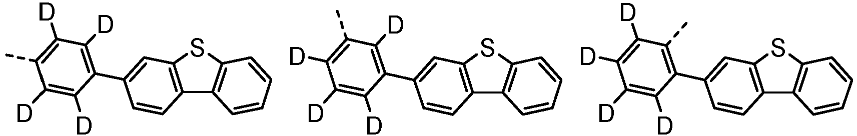

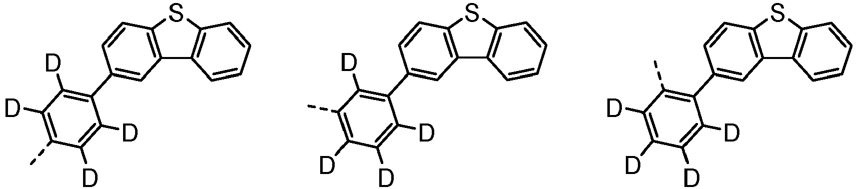

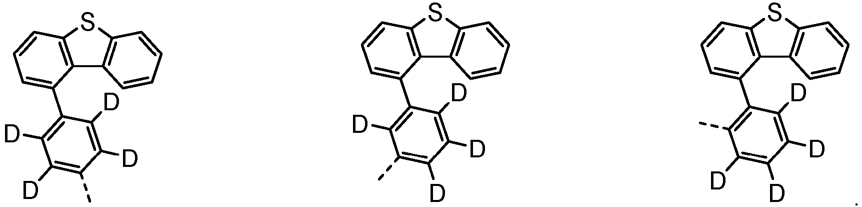

For example, Ar₃ may be biphenylyl, biphenylyl substituted with 1 deuterium, biphenylyl substituted with 3 to 6 deuterium, biphenylyl substituted with 8 deuterium, or biphenylyl substituted with 9 deuterium, and Ar₄ may be biphenylyl, terphenylyl, dibenzofuranyl, dibenzothiophenyl, fluorenyl, dibenzofuranyl-substituted phenyl, dibenzothiophenyl-substituted phenyl, fluorenyl-substituted phenyl, biphenylyl substituted with 1 deuterium, biphenylyl substituted with 3 to 6 deuterium, biphenylyl substituted with 8 deuterium, biphenylyl substituted with 9 deuterium, terphenylyl substituted with 5 to 7 deuterium, dibenzofuranyl substituted with 6 to 7 deuterium, dibenzothiophenyl substituted with 6 to 7 deuterium, fluorenyl substituted with 7 deuterium, phenyl substituted with dibenzofuranyl substituted with 6 to 7 deuterium, phenyl substituted with dibenzothiophenyl substituted with 6 to 7 deuterium, phenyl substituted with fluorenyl substituted with 7 deuterium, phenyl substituted with dibenzofuranyl substituted with 4 deuterium, phenyl substituted with dibenzothiophenyl substituted with 4 deuterium, or phenyl substituted with fluorenyl substituted with 4 deuterium. However, at least one of Ar₃ and Ar₄ is substituted with at least one deuterium.

Preferably, Ar₃ and Ar₄ are each independently substituted with at least one deuterium.

Meanwhile, in Chemical Formulae 2 and 2-1 to 2-5, each R₄ is independently hydrogen, deuterium, substituted or unsubstituted C₆₋₆₀ aryl, or substituted or unsubstituted C₂₋₆₀ heteroaryl containing at least one heteroatom selected from the group consisting of N, O and S, provided that at least one of R₄ is deuterium.

Preferably, each R₄ may independently be hydrogen, deuterium, substituted or unsubstituted C₆₋₂₀ aryl, or substituted or unsubstituted C₂₋₂₀ heteroaryl containing at least one heteroatom selected from the group consisting of N, O and S. More preferably, each R₄ may independently be hydrogen or deuterium. However, at least one of R₄ is deuterium. Preferably, at least two of R₄ are deuterium, and more preferably, at least six of R₄ are deuterium.

For example, in Chemical Formulae 2 and 2-1 to 2-5, Ar₃ is substituted with at least one deuterium, and Ar₄ is substituted with at least one deuterium. At least one of R₄ may be deuterium. Preferably, at least two of R₄ may be deuterium, and more preferably, at least six of R₄ may be deuterium.

The compound represented by Chemical Formula 2 may be represented by any one of Chemical Formula 2A-1 to Chemical Formula 2A-9, Chemical Formula 2B-1 to Chemical Formula 2B-8, Chemical Formula 2C-1 to Chemical Formula 2C-7, Chemical Formula 2D-1 to Chemical Formula 2D-6, Chemical Formula 2E-1 to Chemical Formula 2E-5, and Chemical Formula 2F-1 to Chemical Formula 2F-3: 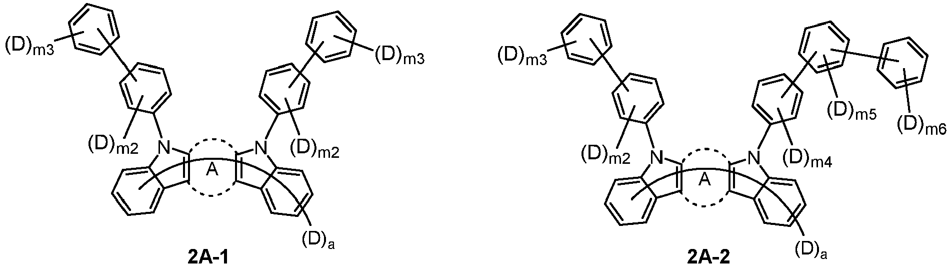 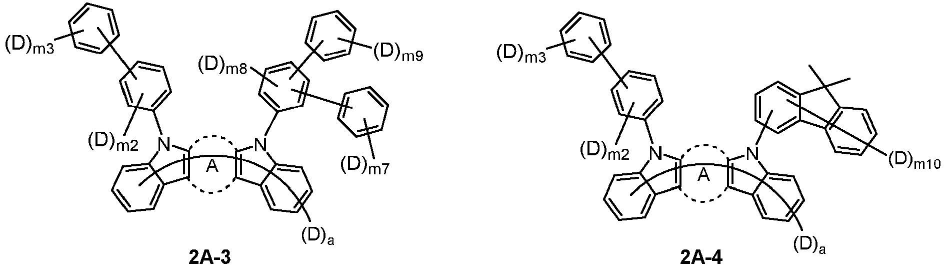 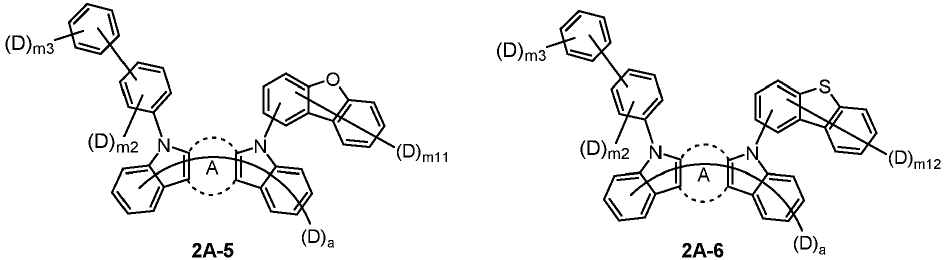 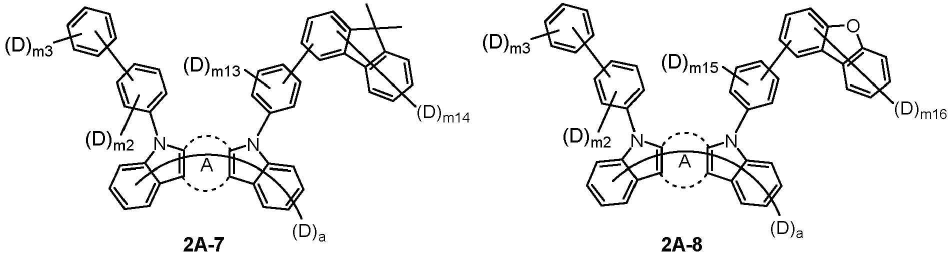 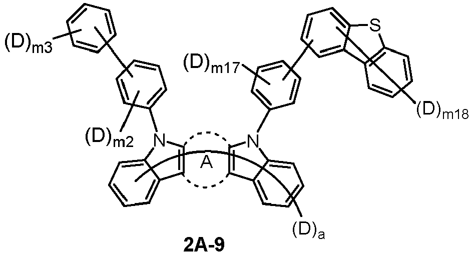
wherein in Chemical Formula 2A-1 to Chemical Formula 2A-9,
A is as defined in Chemical Formula 2,
a is an integer of 1 to 10, preferably an integer of 2 to 10, and more preferably an integer of 6 to 10,
m2, m4, m5, m13, m15, and m17 are each independently an integer of 0 to 4,
m3, m6, m7, and m9 are each independently an integer of 0 to 5,
m8 is an integer of 0 to 3,
m10, and m14 are each independently an integer of 0 to 13, and
m11, m12, m16, and m18 are each independently an integer of 0 to 7,
provided that m2+m3 in Chemical Formula 2A-1 is 1 to 18, and preferably 2 to 18;
m2+m3+m4+m5+m6 in Chemical Formula 2A-2 is 1 to 22, and preferably 2 to 22;
m2+m3+m7+m8+m9 in Chemical Formula 2A-3 is 1 to 22, and preferably 2 to 22;
m2+m3+m10 in Chemical Formula 2A-4 is 1 to 22, and preferably 2 to 22;
m2+m3+m11 in Chemical Formula 2A-5 is 1 to 16, and preferably 2 to 16;
m2+m3+m12 in Chemical Formula 2A-6 is 1 to 16, and preferably 2 to 16;
m2+m3+m13+m14 in Chemical Formula 2A-7 is 1 to 26, and preferably 2 to 26;
m2+m3+m15+m16 in Chemical Formula 2A-8 is 1 to 20, and preferably 2 to 20; or
m2+m3+m17+m18 in Chemical Formula 2A-9 is 1 to 20, and preferably 2 to 20, 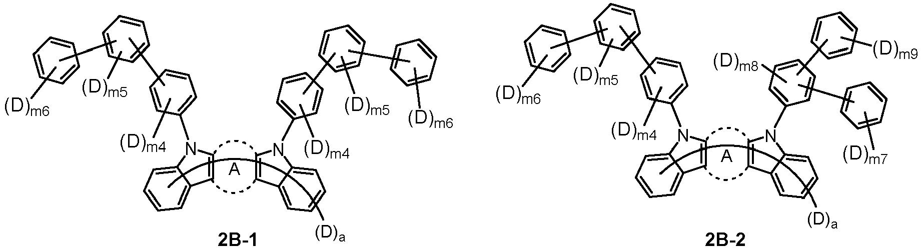 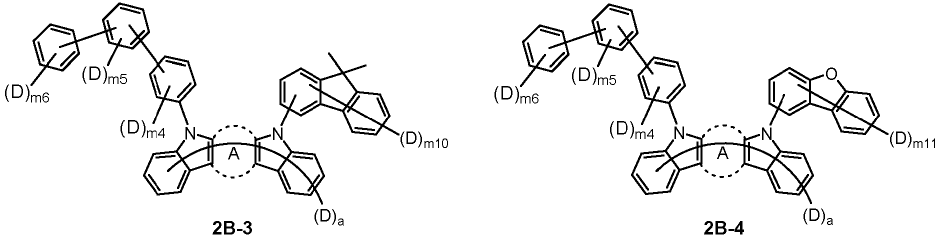 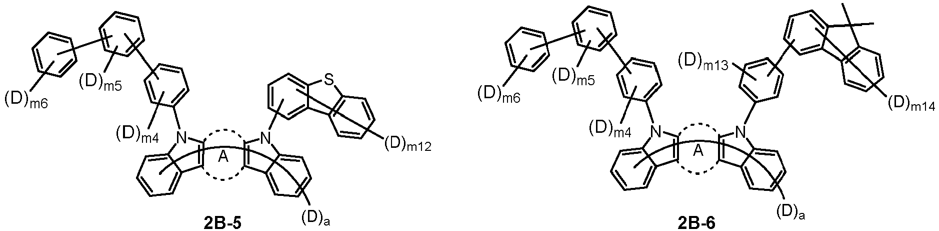 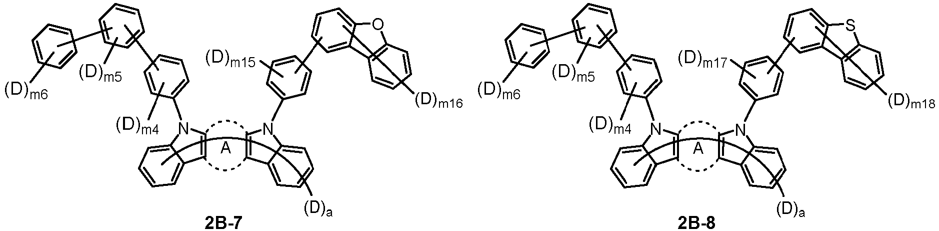
wherein in Chemical Formula 2B-1 to Chemical Formula 2B-8,
A is as defined in Chemical Formula 2,
a is an integer of 1 to 10, preferably an integer of 2 to 10, and more preferably an integer of 6 to 10,
m4, m5, m13, m15, and m17 are each independently an integer of 0 to 4, m6, m7, and m9 are each independently an integer of 0 to 5,
m8 is an integer of 0 to 3,
m10, and m14 are each independently an integer of 0 to 13, and
m11, m12, m16, and m18 are each independently an integer of 0 to 7,
provided that m4+m5+m6 in Chemical Formula 2B-1 is 1 to 26, and preferably 2 to 26;
m4+m5+m6+m7+m8+m9 in Chemical Formula 2B-2 is 1 to 26, and preferably 2 to 26;
m4+m5+m6+m10 in Chemical Formula 2B-3 is 1 to 26, and preferably 2 to 26;
m4+m5+m6+m11 in Chemical Formula 2B-4 is 1 to 20, and preferably 2 to 20;
m4+m5+m6+m12 in Chemical Formula 2B-5 is 1 to 30, and preferably 2 to 30;
m4+m5+m6+m13+m14 in Chemical Formula 2B-6 is 1 to 30, and preferably 2 to 30;
m4+m5+m6+m15+m16 in Chemical Formula 2B-7 is 1 to 24, and preferably 2 to 24; or
m4+m5+m6+m17+m18 in Chemical Formula 2B-8 is 1 to 24, and preferably 2 to 24, 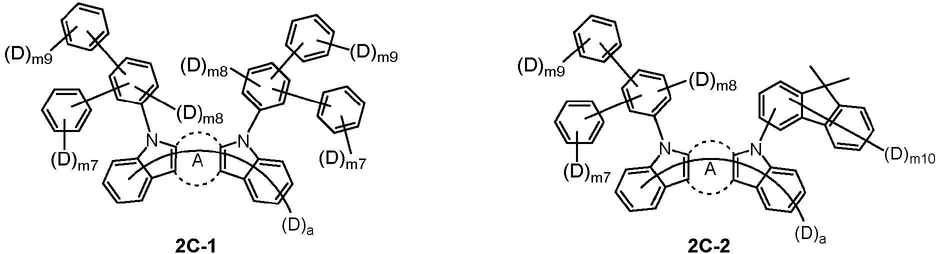 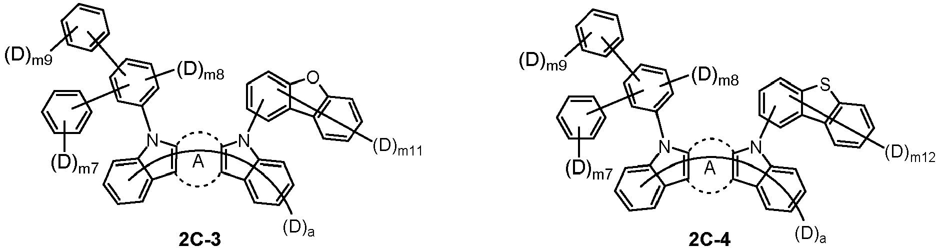 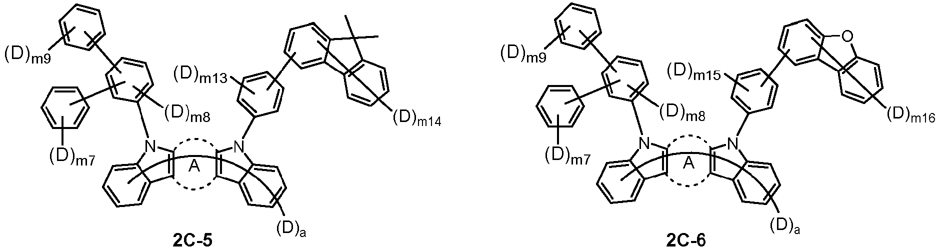 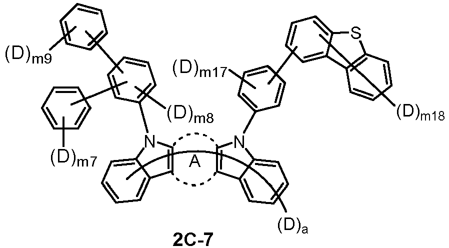
wherein in Chemical Formula 2C-1 to Chemical Formula 2C-7,
A is as defined in Chemical Formula 2,
a is an integer of 1 to 10, preferably an integer of 2 to 10, and more preferably an integer of 6 to 10,
m7, and m9 are each independently an integer of 0 to 5,
m8 is an integer of 0 to 3,
m10, and m14 are each independently an integer of 0 to 13,
m11, m12, m16, and m18 are each independently an integer of 0 to 7, and
m13, m15, and m17 are each independently an integer of 0 to 4,
provided that m7+m8+m9 in Chemical Formula 2C-1 is 1 to 26, and preferably 2 to 26;
m7+m8+m9+m10 in Chemical Formula 2C-2 is 1 to 26, and preferably 2 to 26;
m7+m8+m9+m11 in Chemical Formula 2C-3 is 1 to 20, and preferably 2 to 20;
m7+m8+m9+m12 in Chemical Formula 2C-4 is 1 to 20, and preferably 2 to 20;
m7+m8+m9+m13+m14 in Chemical Formula 2C-5 is 1 to 30, and preferably 2 to 30;
m7+m8+m9+m15+m16 in Chemical Formula 2C-6 is 1 to 24, and preferably 2 to 24; or
m7+m8+m9+m17+m18 in Chemical Formula 2C-7 is 1 to 24, and preferably 2 to 24, 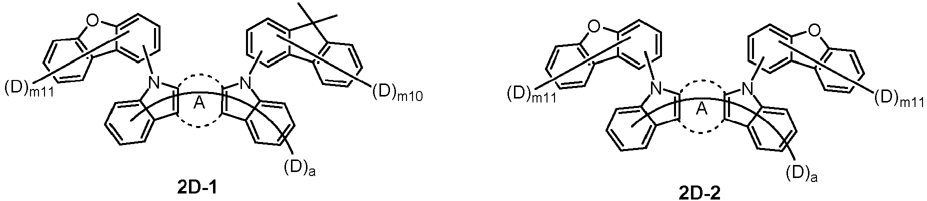 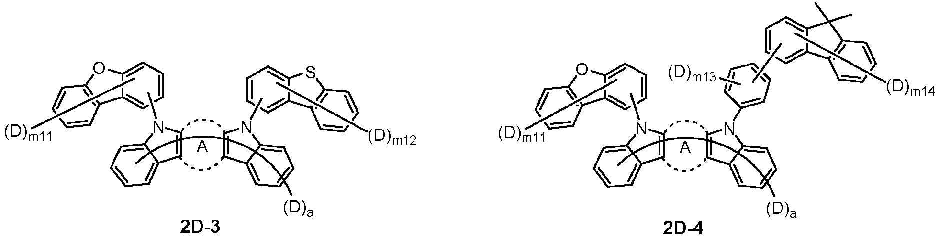 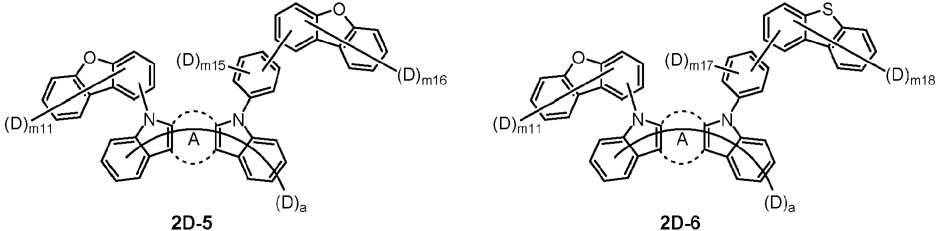
wherein in Chemical Formula 2D-1 to Chemical Formula 2D-6,
A is as defined in Chemical Formula 2,
a is an integer of 1 to 10, preferably an integer of 2 to 10, and more preferably an integer of 6 to 10,
m10, and m14 are each independently an integer of 0 to 13,
m11, m12, m16, and m18 are each independently an integer of 0 to 7, and
m13, m15, and m17 are each independently an integer of 0 to 4,
provided that m10+m11 in Chemical Formula 2D-1 is 1 to 20, and preferably 2 to 20;
m11+m11 in Chemical Formula 2D-2 is 1 to 14, and preferably 2 to 14;
m11+m12 in Chemical Formula 2D-3 is 1 to 14, and preferably 2 to 14;
m11+m13+m14 in Chemical Formula 2D-4 is 1 to 24, and preferably 2 to 24;
m11+m15+m16 in Chemical Formula 2D-5 is 1 to 18, and preferably 2 to 18; or
m11+m17+m18 in Chemical Formula 2D-6 is 1 to 18, and preferably 2 to 18, 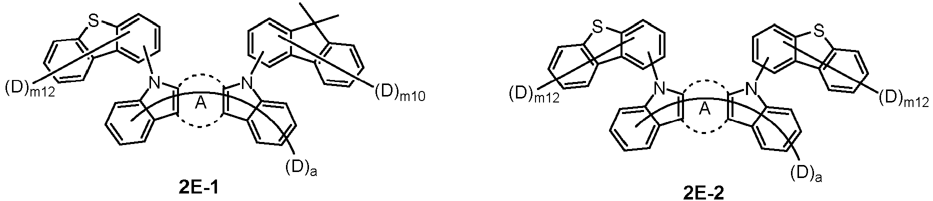 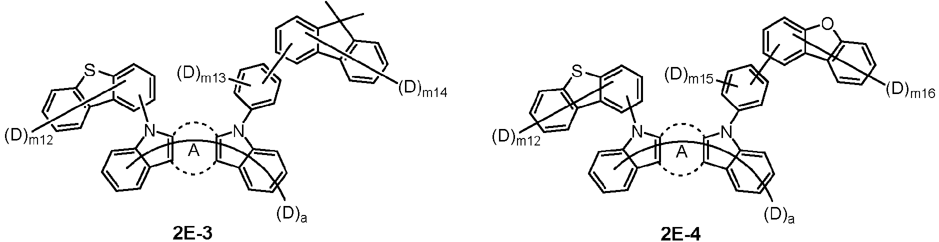 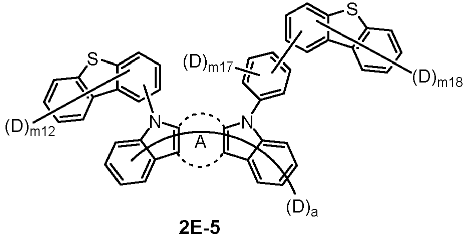
wherein in Chemical Formula 2E-1 to Chemical Formula 2E-5,
A is as defined in Chemical Formula 2,
a is an integer of 1 to 10, preferably an integer of 2 to 10, and more preferably an integer of 6 to 10,
m10, and m14 are each independently an integer of 0 to 13, and
m12, m16, and m18 are each independently an integer of 0 to 7, and
m13, m15, and m17 are each independently an integer of 0 to 4,
provided that m10+m12 in Chemical Formula 2E-1 is 1 to 20, and preferably 2 to 20;
m12+m12 in Chemical Formula 2E-2 is 1 to 14, and preferably 2 to 14;
m12+m13+m14 in Chemical Formula 2E-3 is 1 to 24, and preferably 2 to 24;
m12+m15+m16 in Chemical Formula 2E-4 is 1 to 18, and preferably 2 to 18; or
m12+m17+m18 in Chemical Formula 2E-5 is 1 to 18, and preferably 2 to 18, 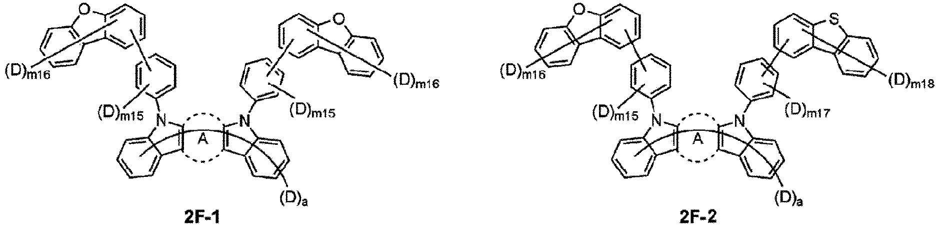 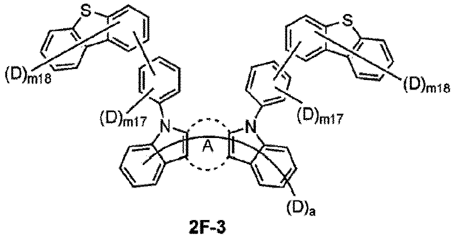
wherein in Chemical Formula 2F-1 to Chemical Formula 2F-3,
A is as defined in Chemical Formula 2,
a is an integer of 1 to 10, preferably an integer of 2 to 10, and more preferably an integer of 6 to 10,
m15, and m17 are each independently an integer of 0 to 4, and
m16, and m18 are each independently an integer of 0 to 7,
provided that m15+m16 in Chemical Formula 2F-1 is 1 to 22, and preferably 2 to 22;
m15+m16+m17+m18 in Chemical Formula 2F-2 is 1 to 22, and preferably 2 to 22; or
m17+m18 in Chemical Formula 2F-3 is 1 to 22, and preferably 2 to 22.

In addition, the compound represented by Chemical Formula 2 has an indolocarbazole-based structure, and deuterium is substituted in each of the indolocarbazole core and its substituents. It is substituted with at least two or more, preferably at least three or more deuterium, and may be substituted with deuterium up to the total number of hydrogens in each compound. For example, the compound represented by Chemical Formula 2 may be substituted with 2 to 50, 2 to 46, or 2 to 44 deuterium. Preferably, it may be substituted with 3 or more, 4 or more, 6 or more, 8 or more, 10 or more, or 14 or more deuterium. In this case, a deuterium substitution rate of Chemical Formula 2 may be 50 % or more to 100% or less. The 'deuterium substitution rate' refers to the number of deuterium contained in Chemical Formula 2 compared to the total number of hydrogens that may be present in Chemical Formula 2. For example, the deuterium substitution rate of Chemical Formula 2 may be 52% or more, 55% or more, 58% or more, 60% or more, 65% or more, 70% or more, 75% or more, 80% or more, 85% or more, or 90% or more, and 99% or less, 98% or less, 97% or less, 96% or less, 95% or less, 94% or less, 93% or less, or 92% or less.

Representative examples of the compound represented by Chemical Formula 2 are as follows:

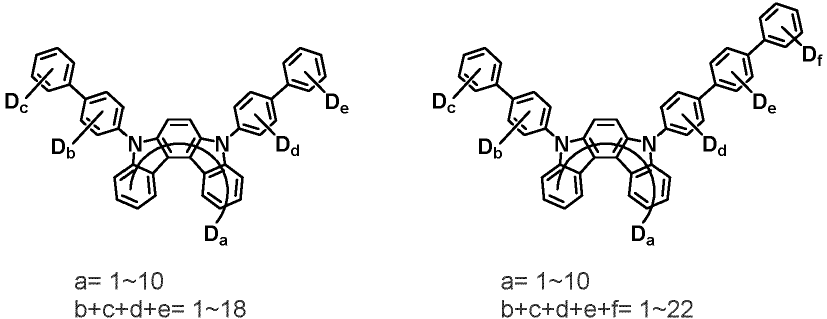

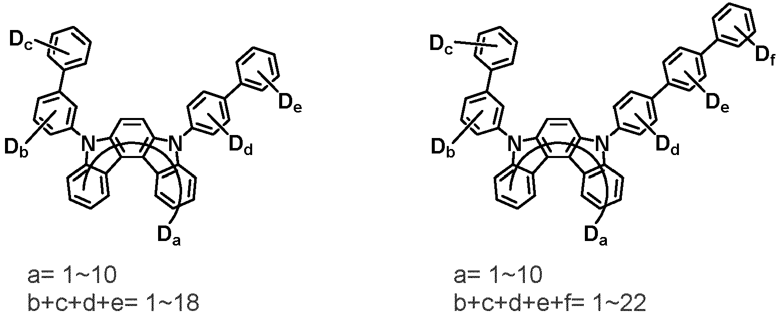

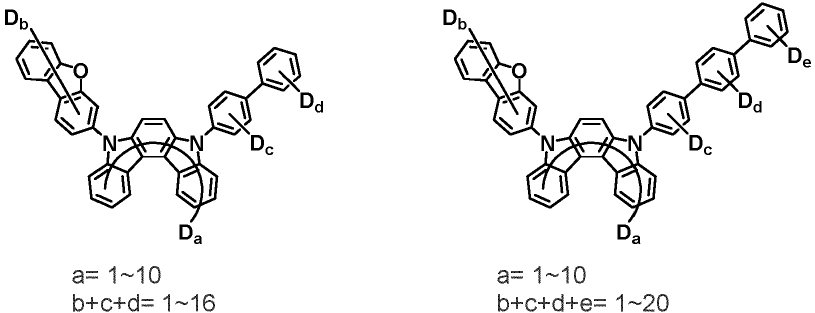

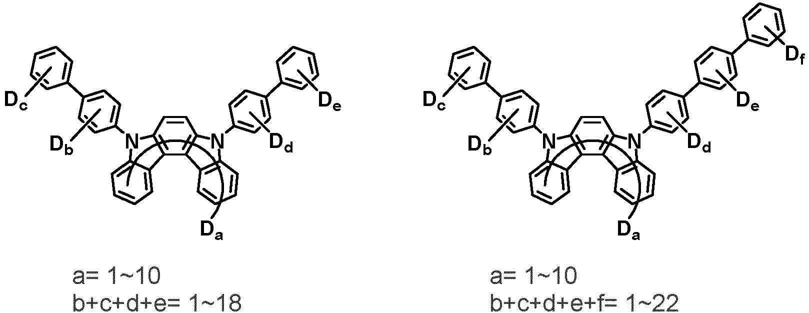

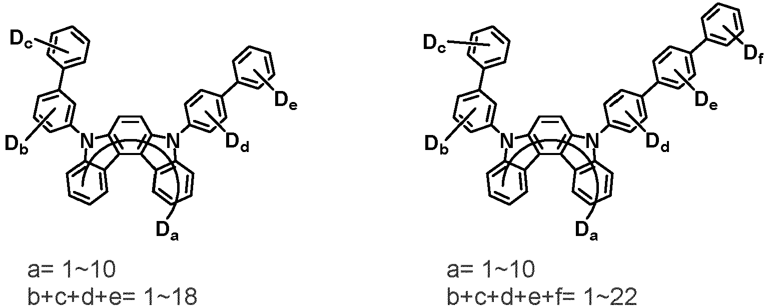

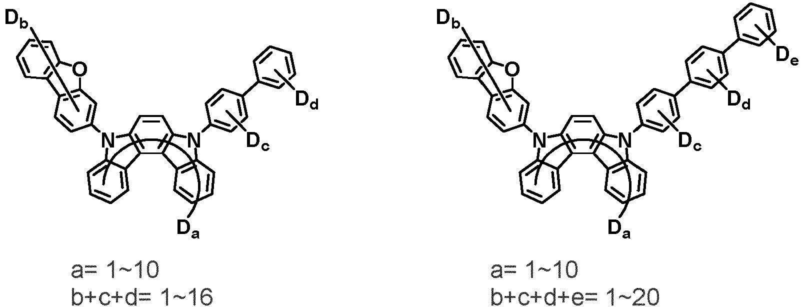

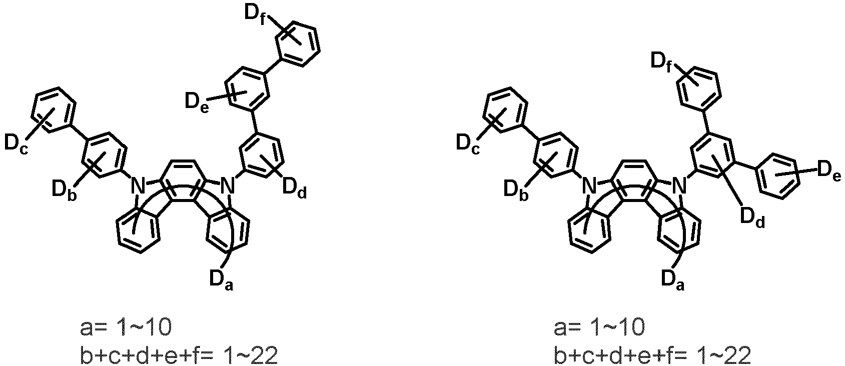

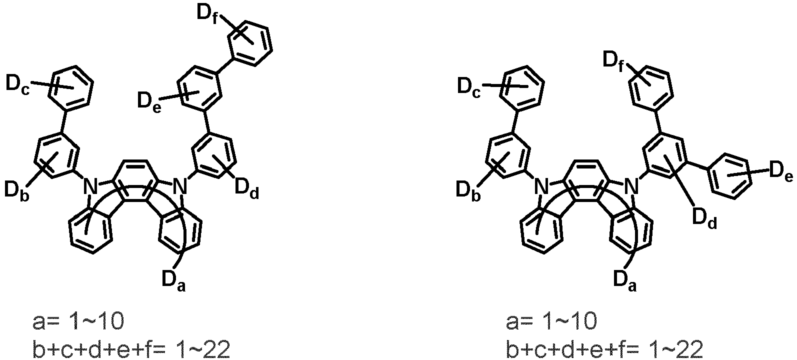

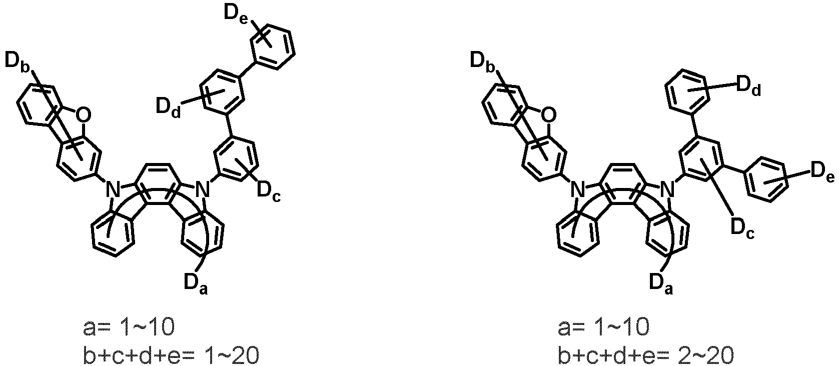

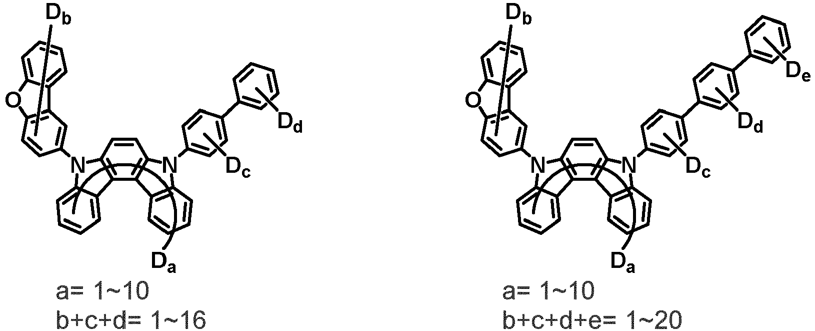

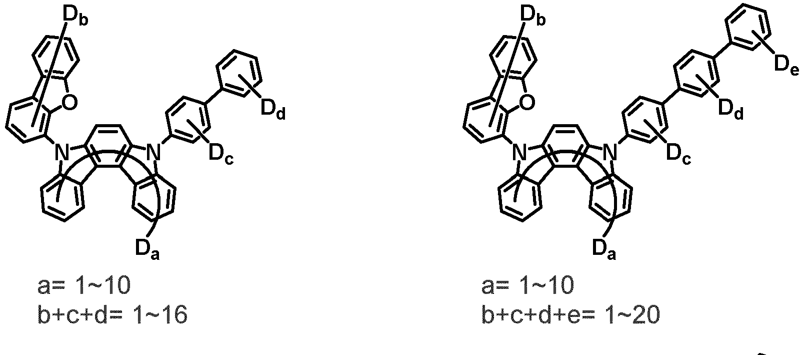

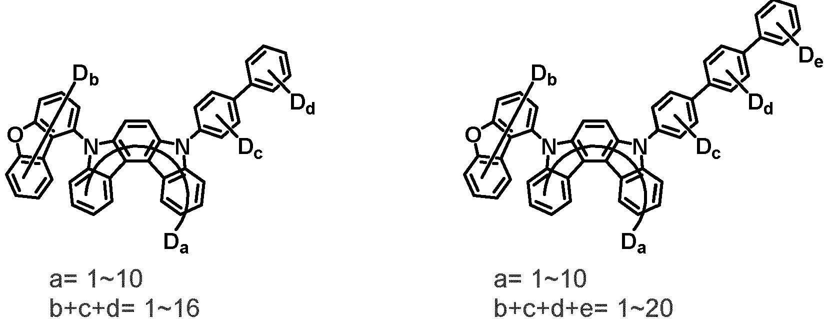

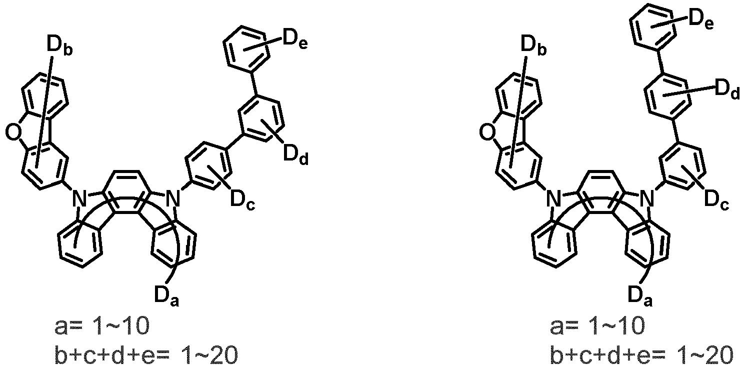

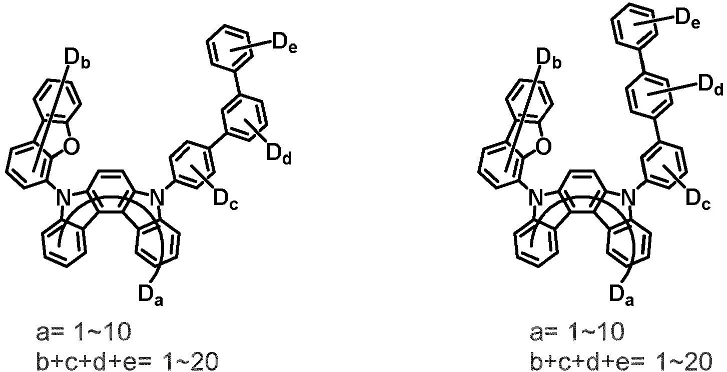

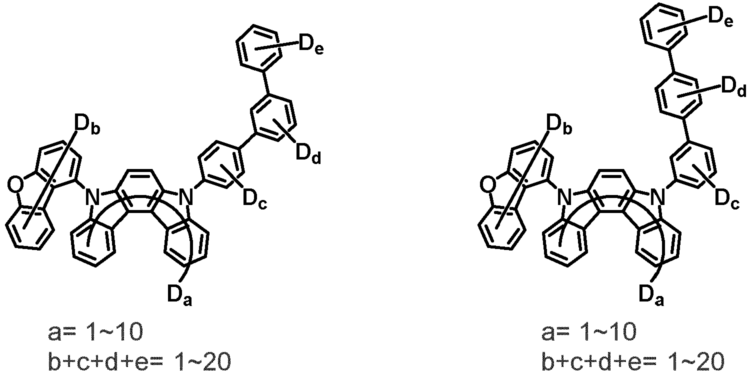

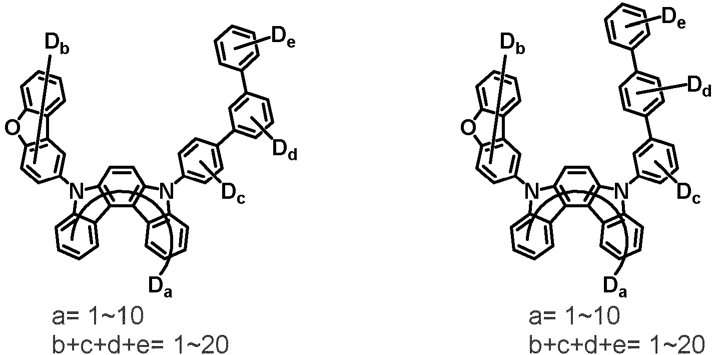

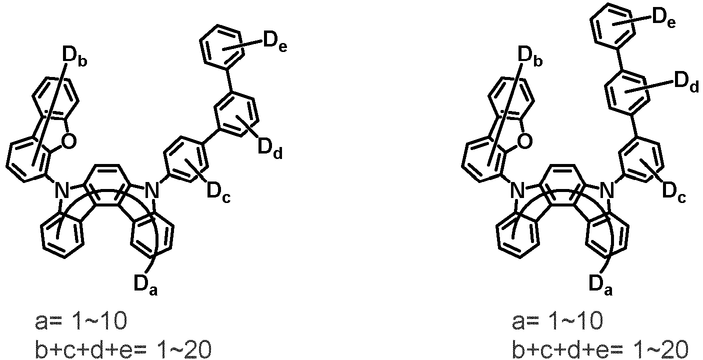

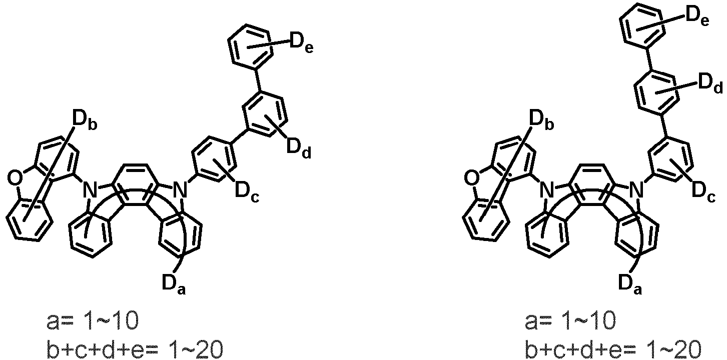

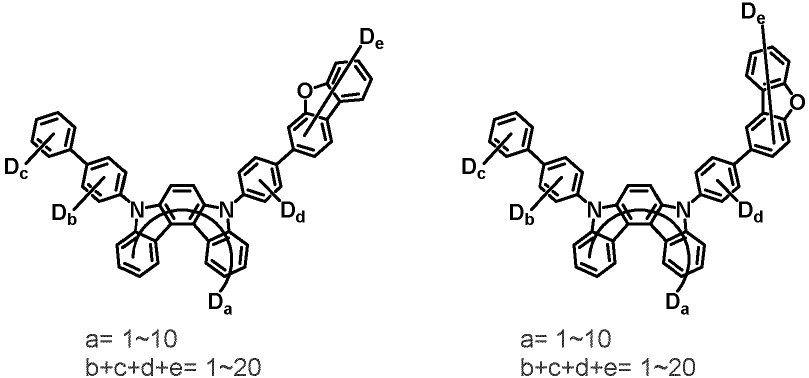

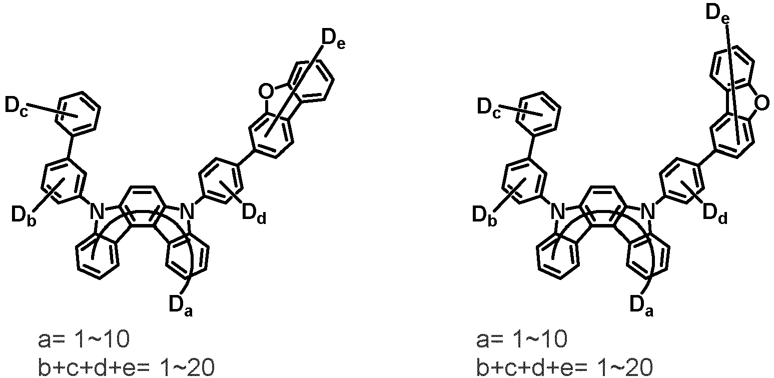

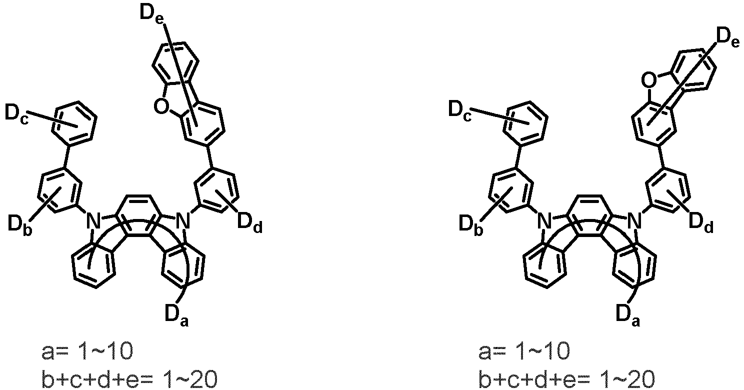

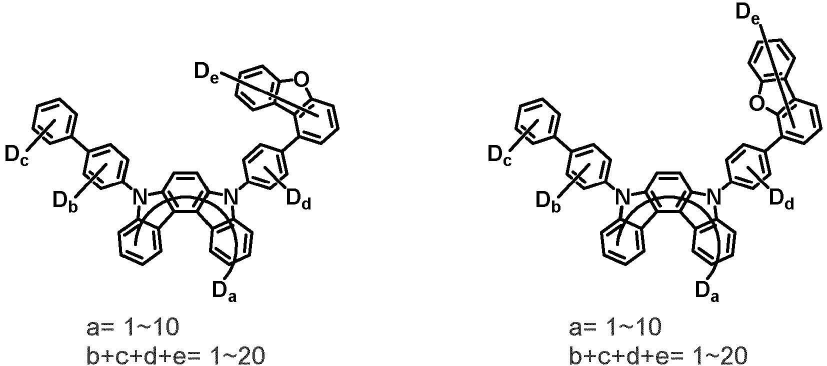

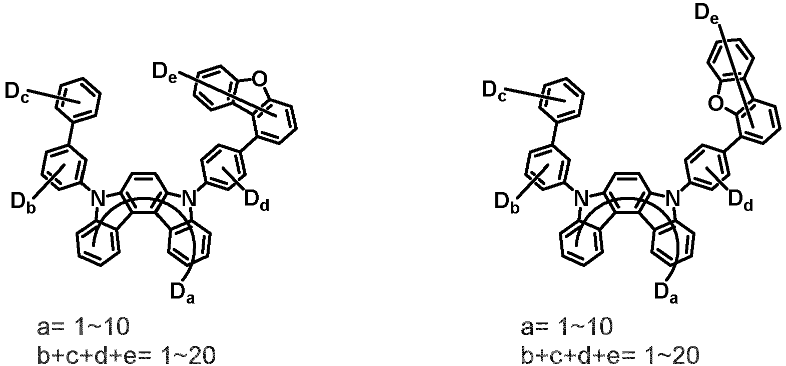

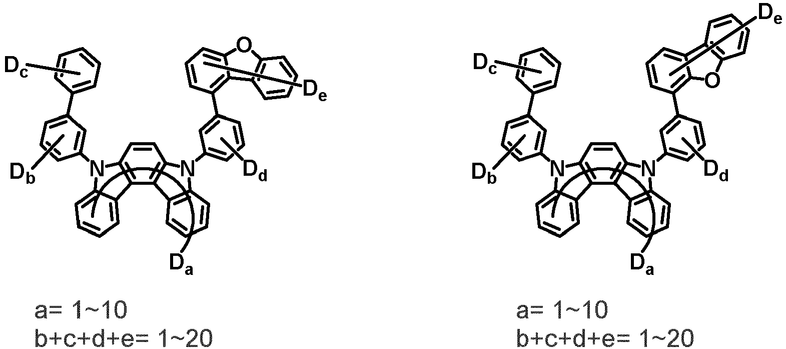

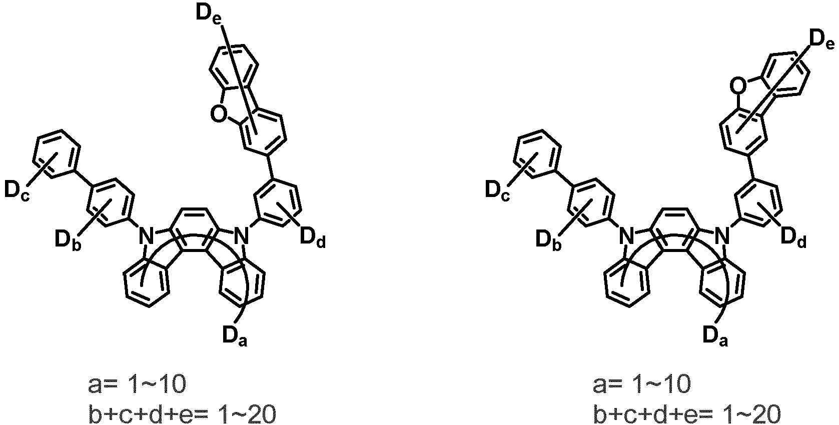

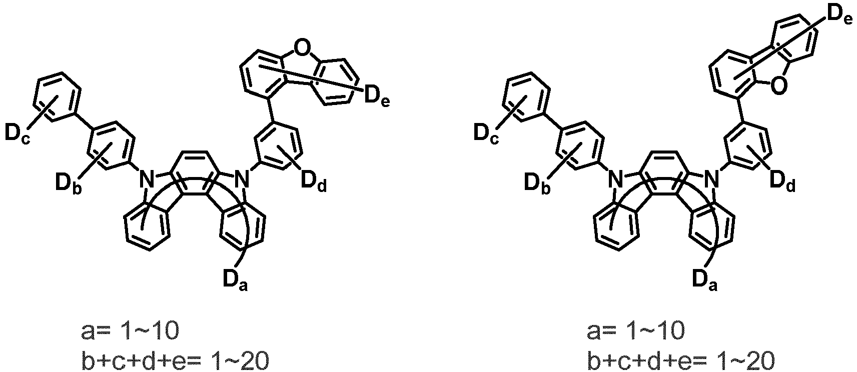

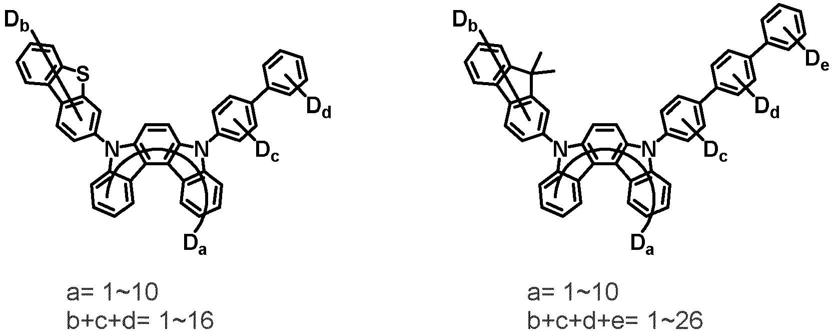

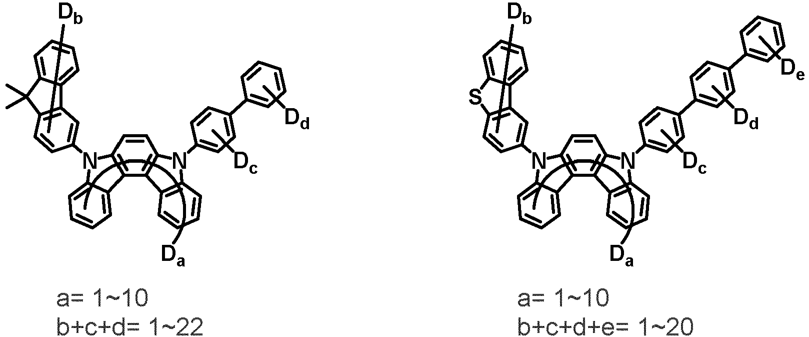

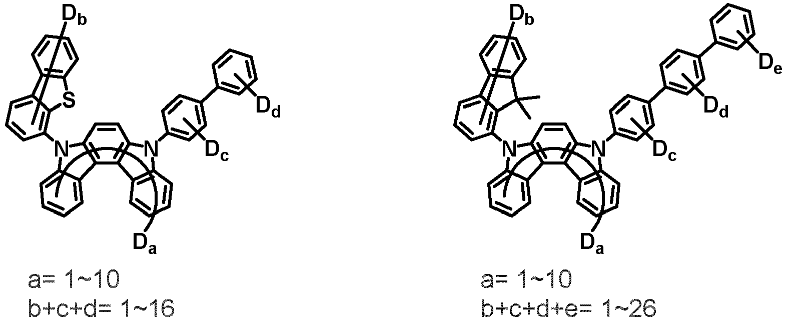

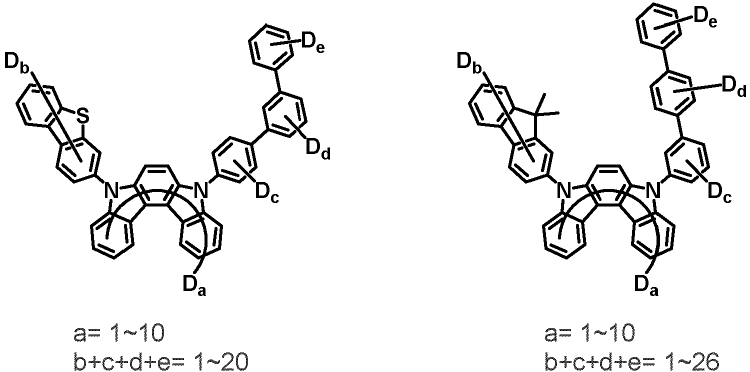

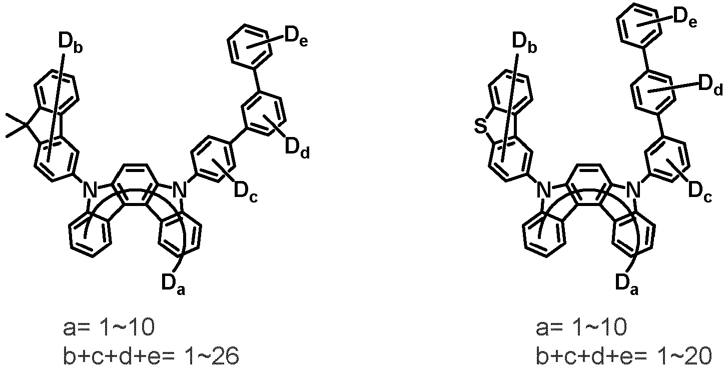

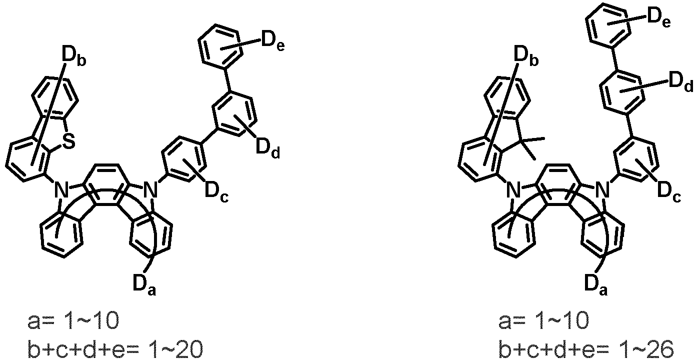

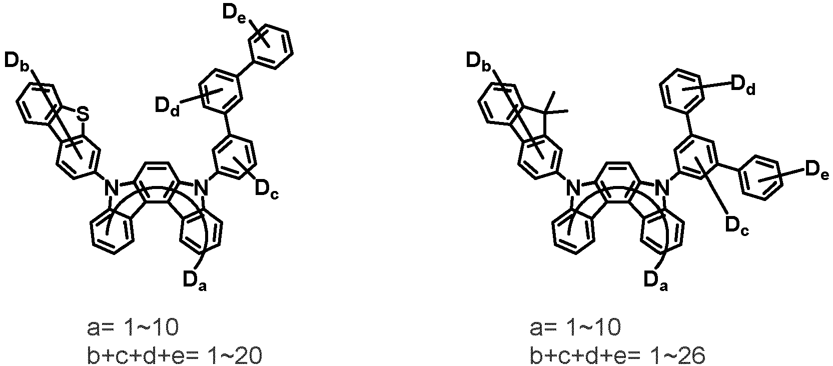

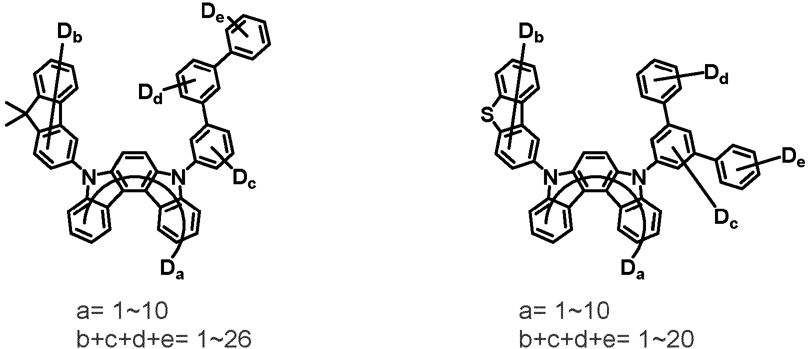

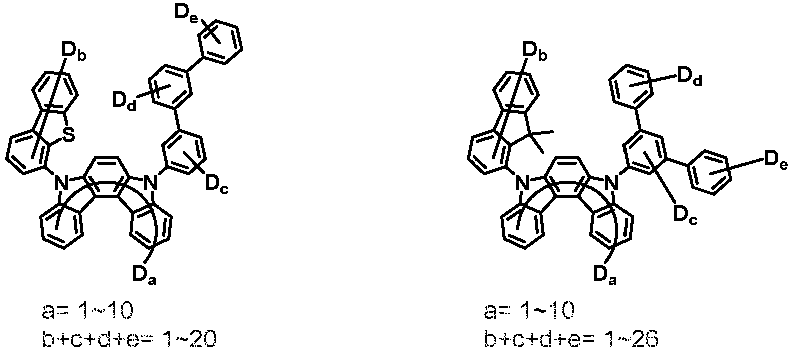

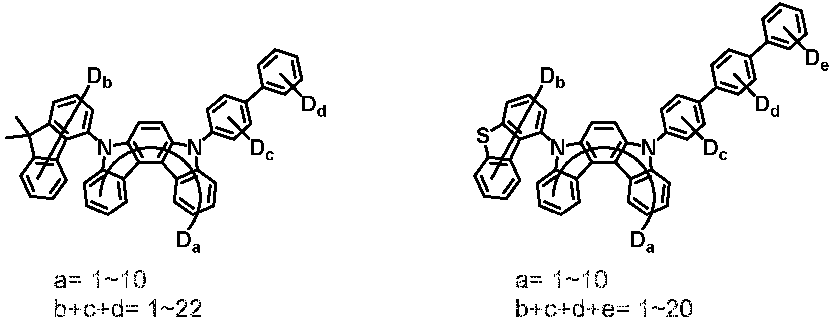

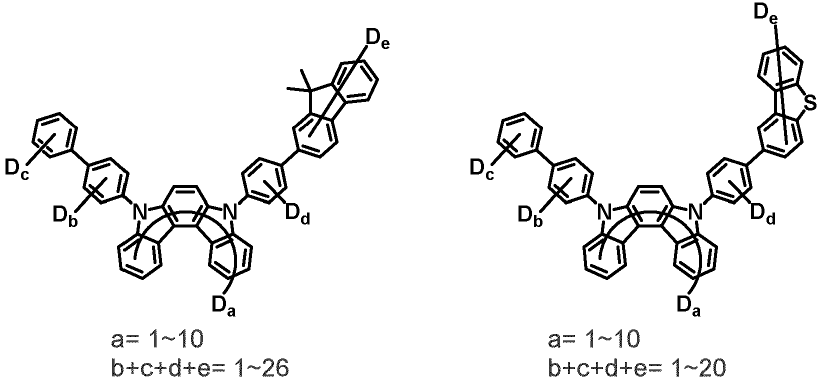

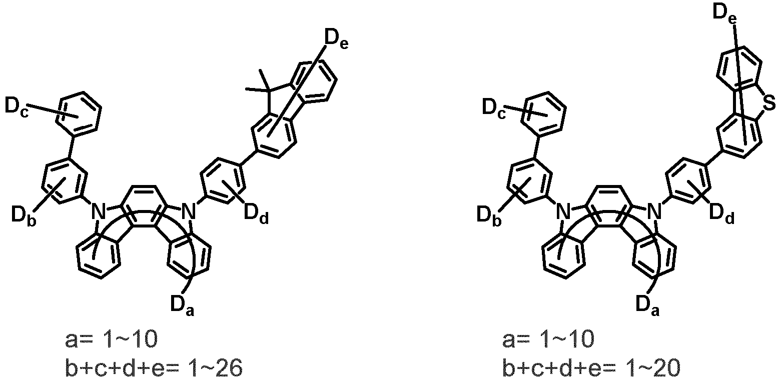

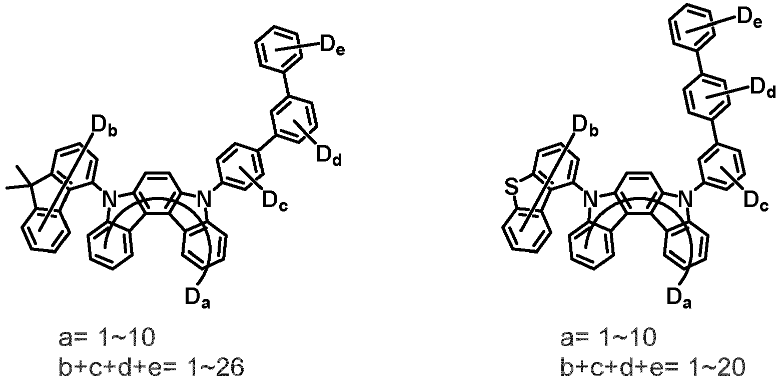

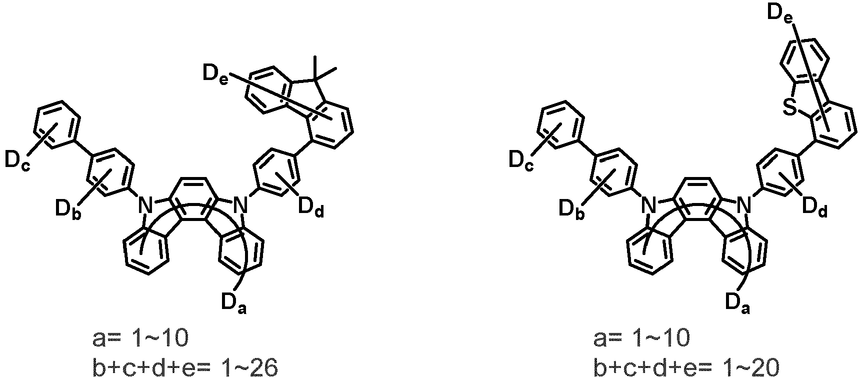

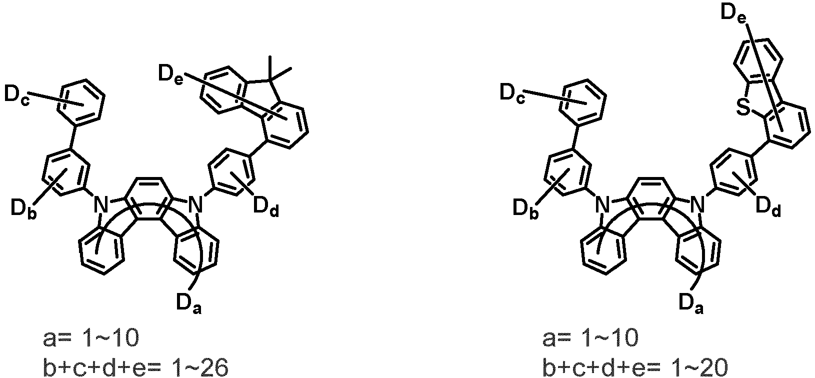

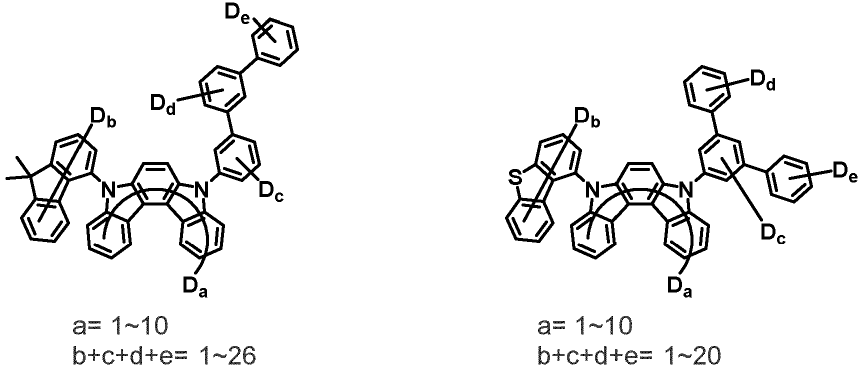

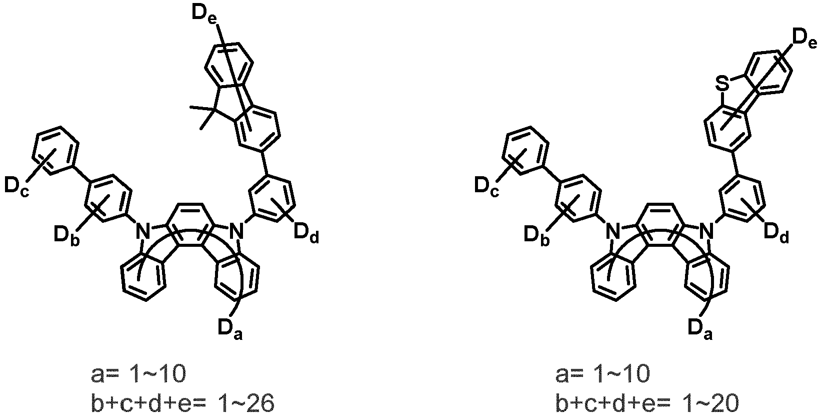

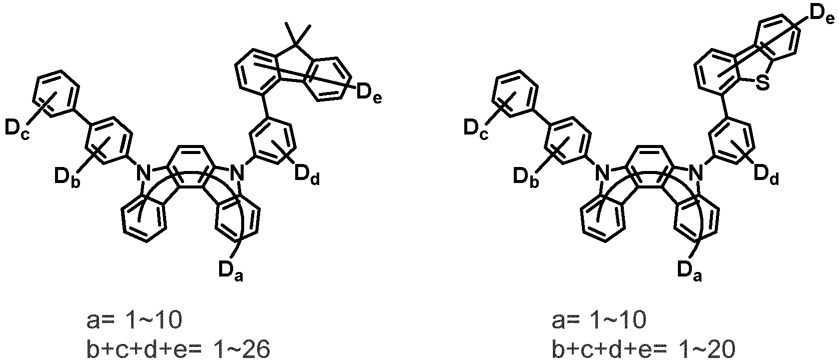

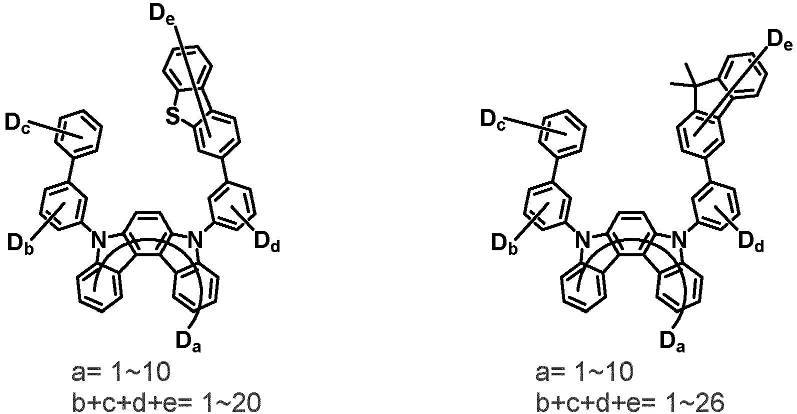

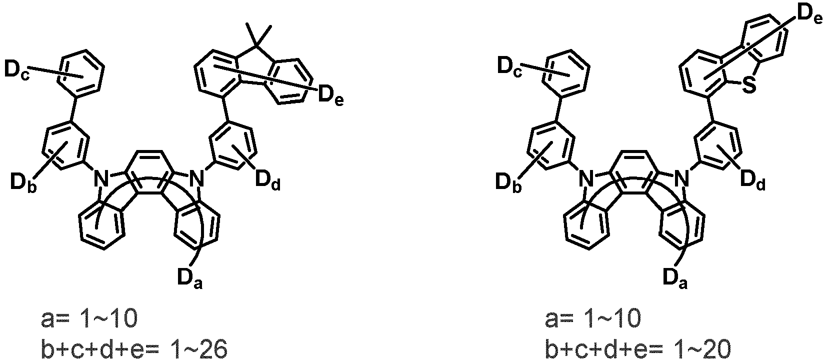

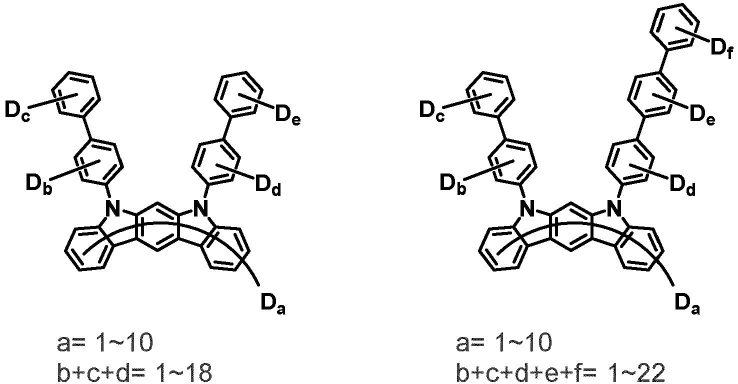

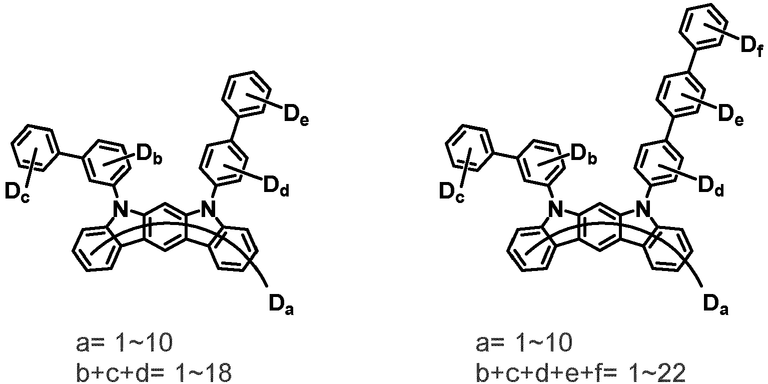

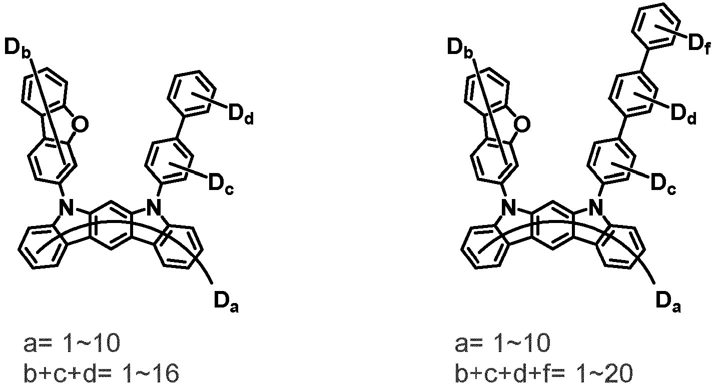

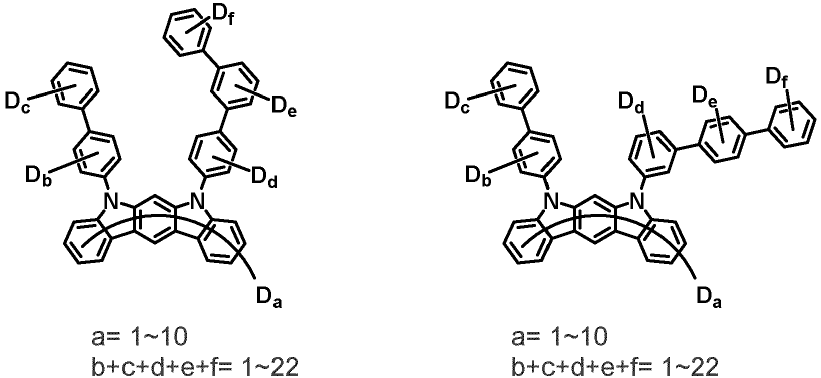

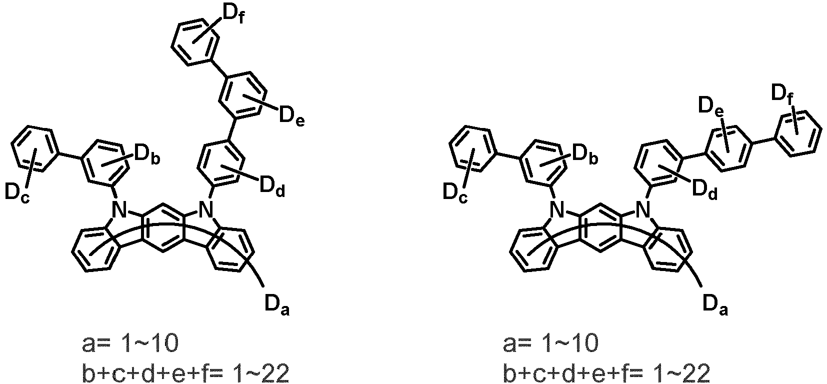

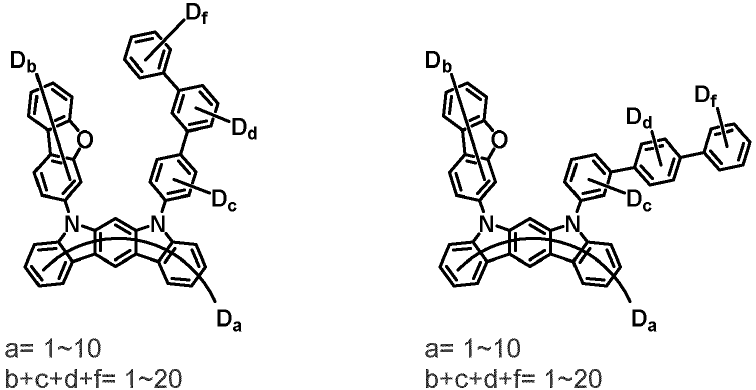

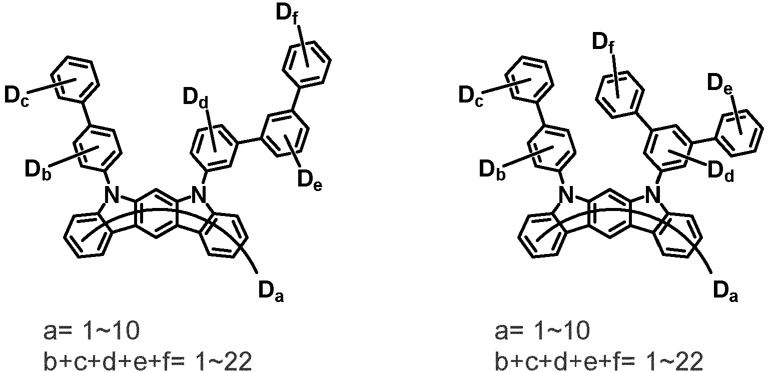

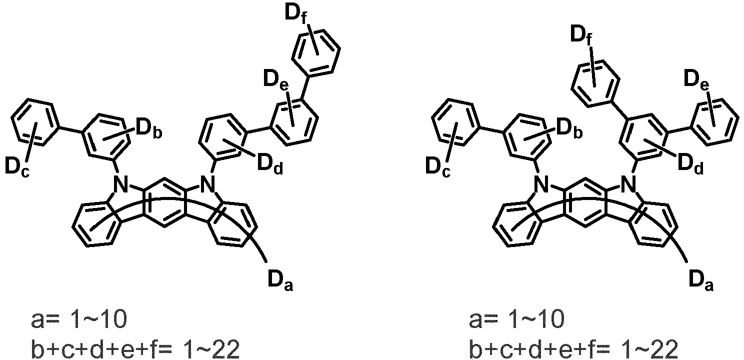

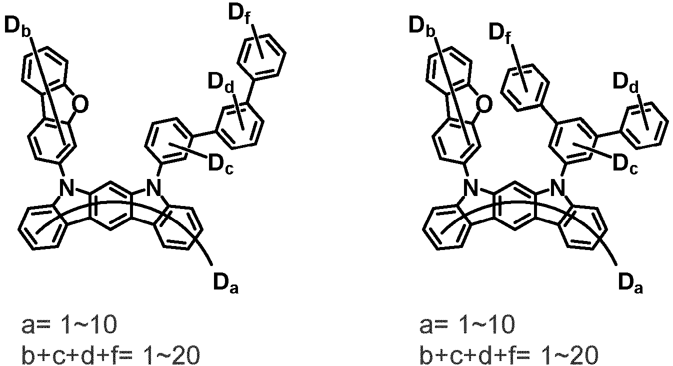

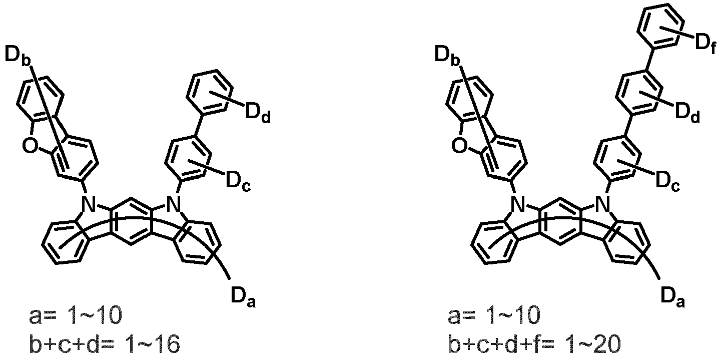

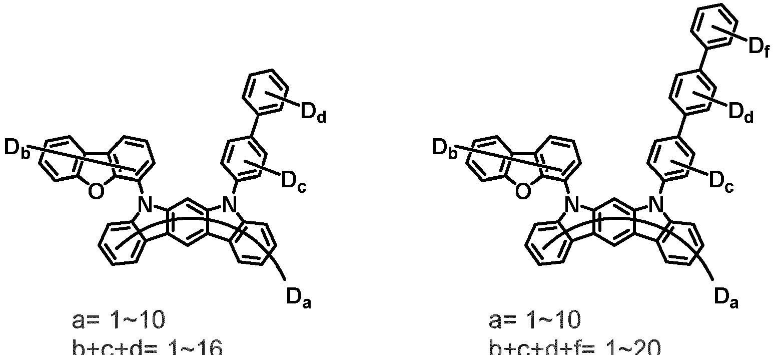

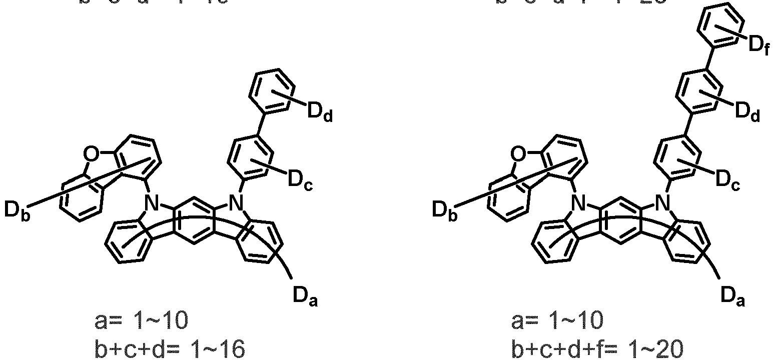

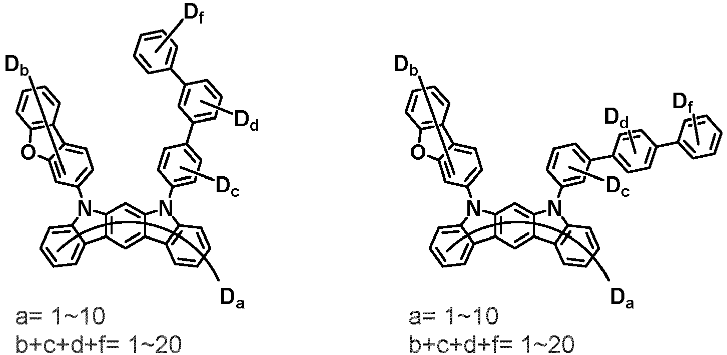

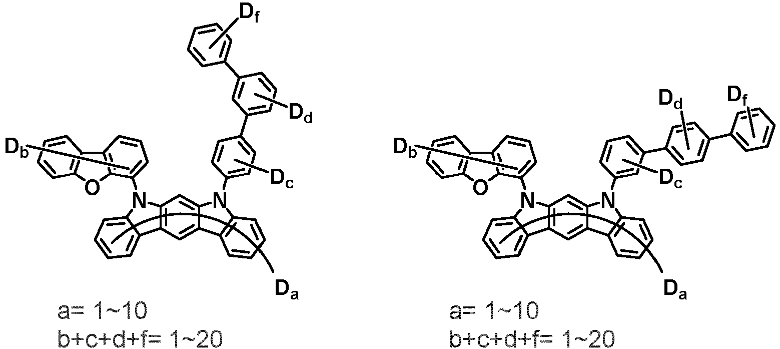

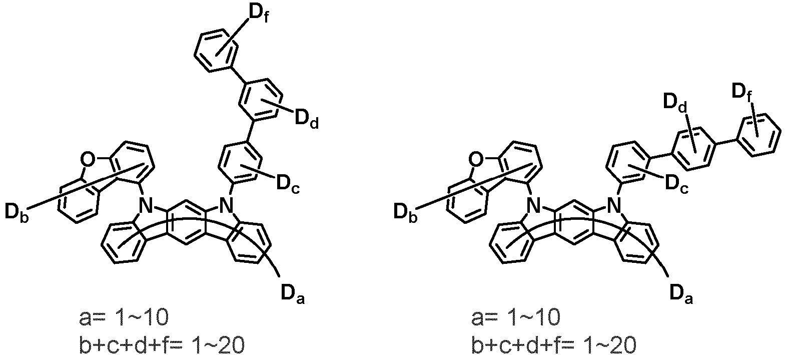

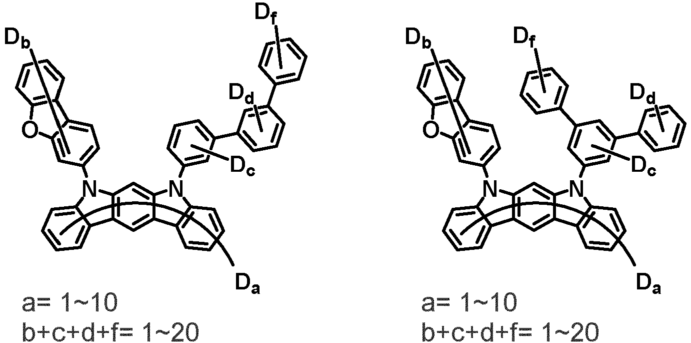

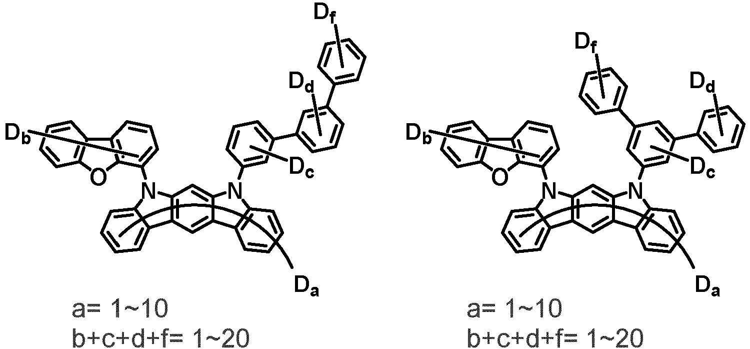

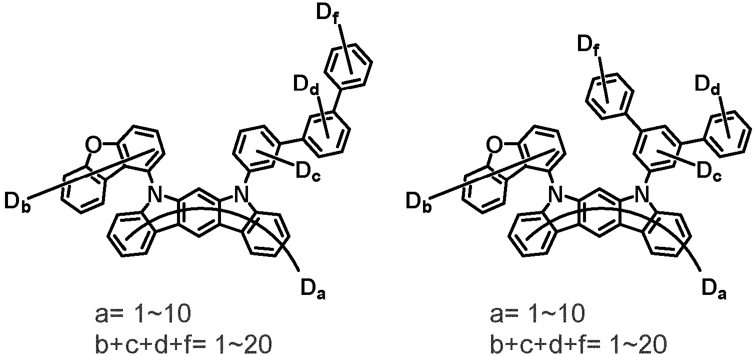

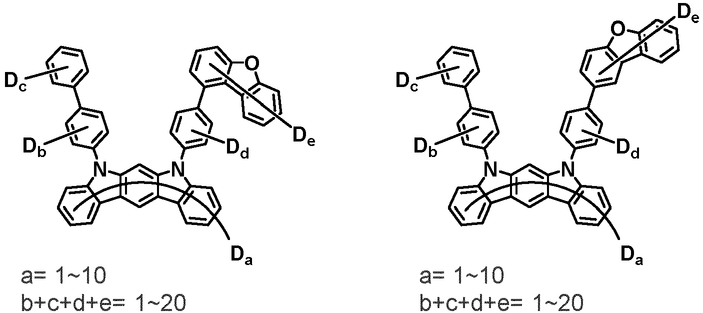

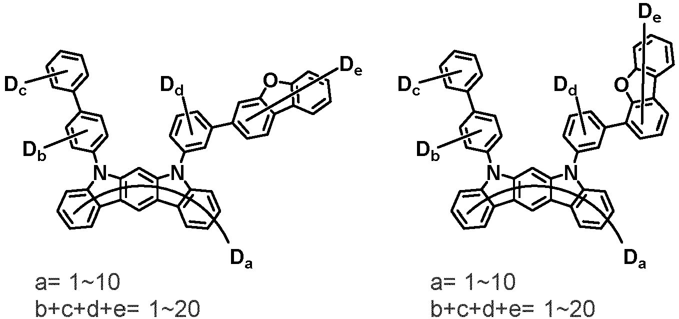

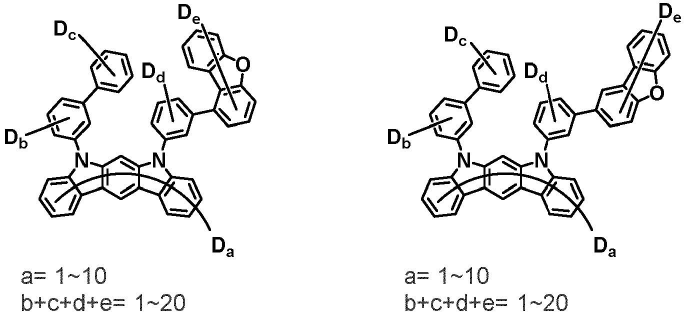

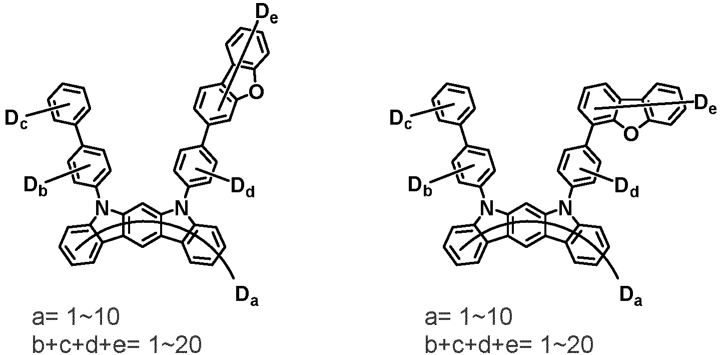

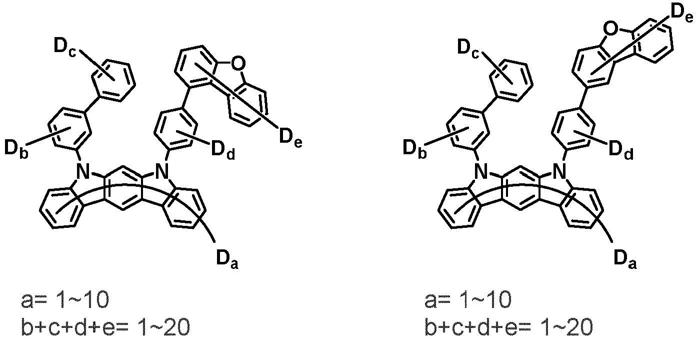

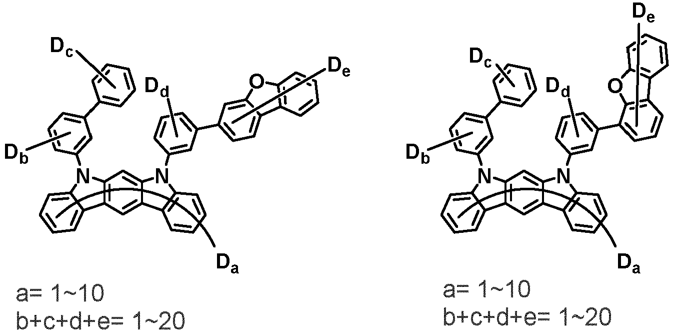

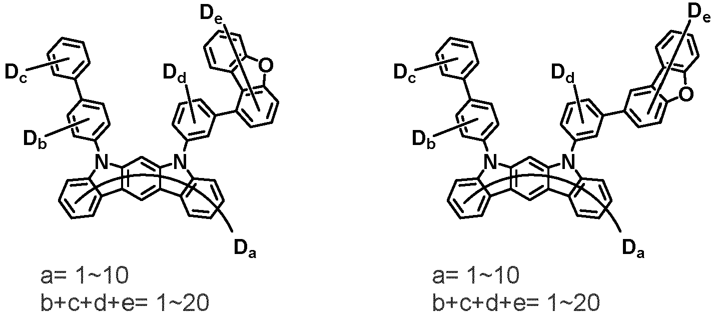

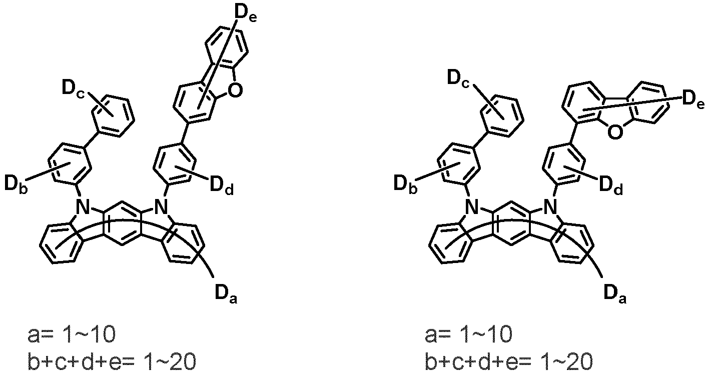

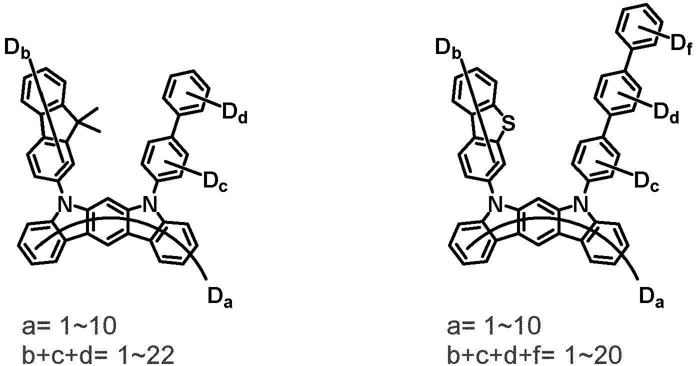

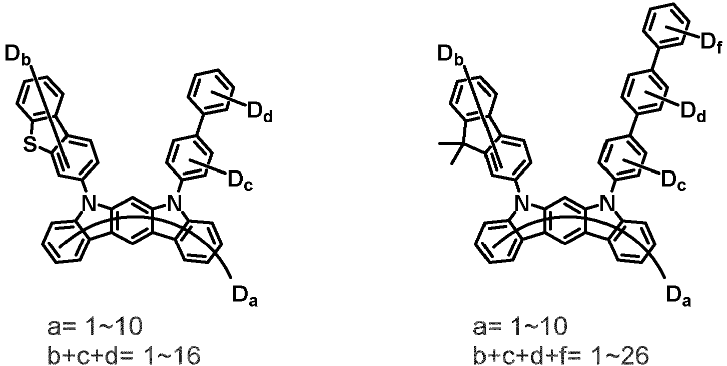

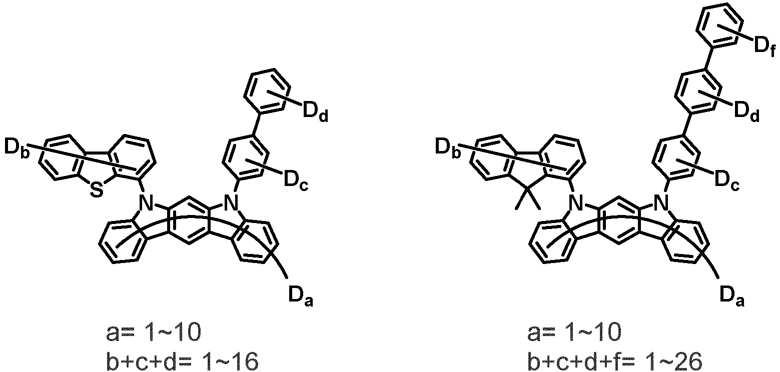

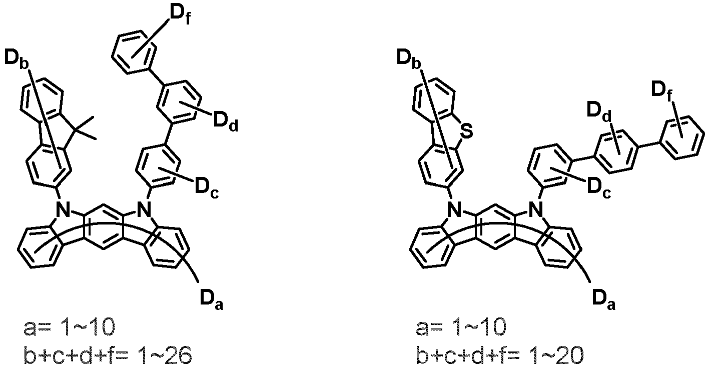

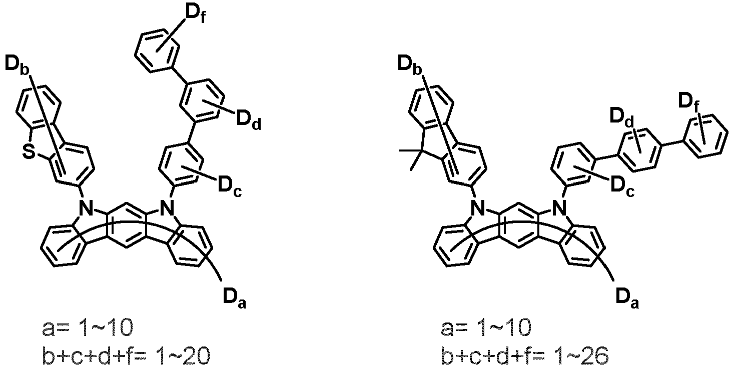

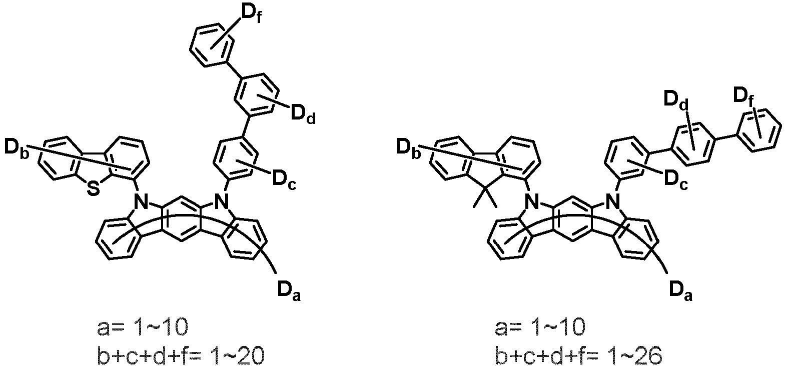

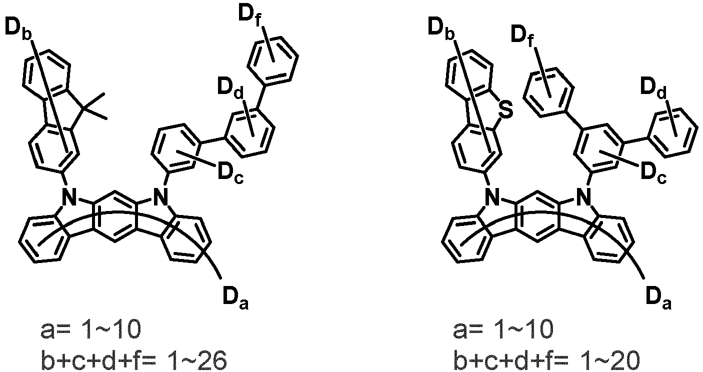

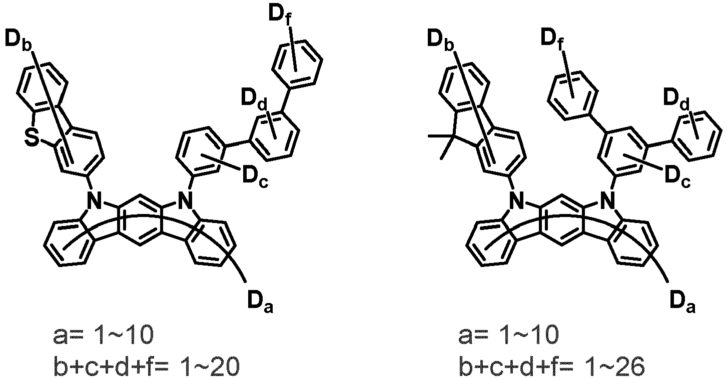

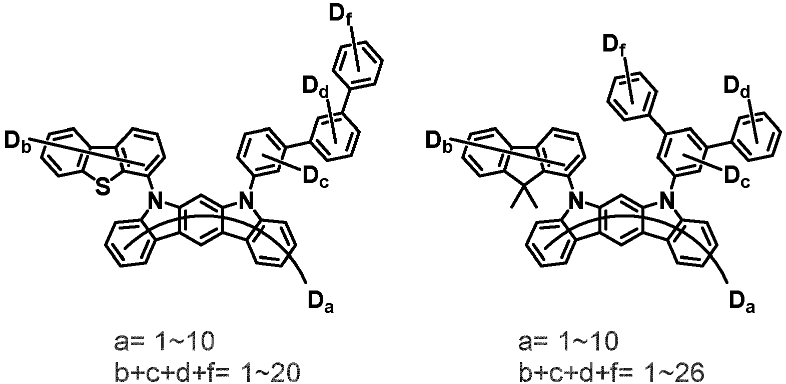

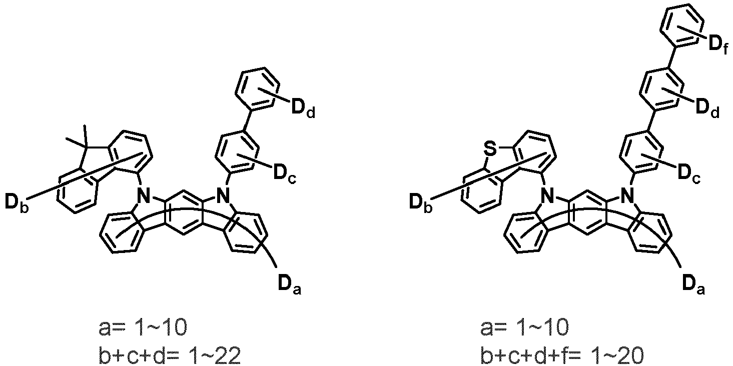

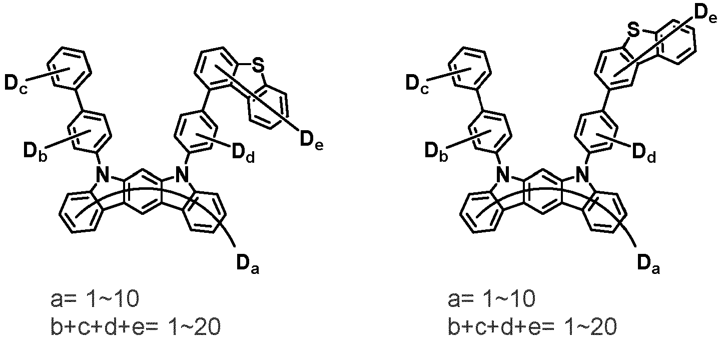

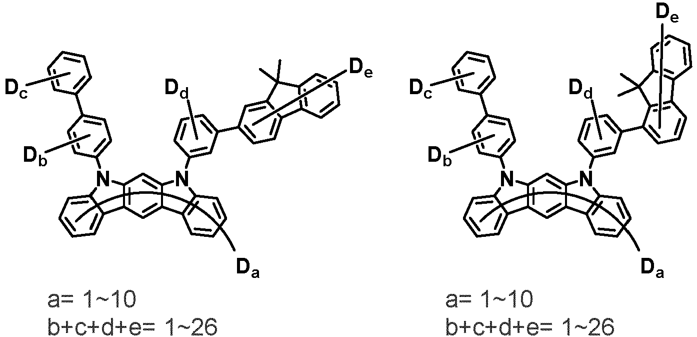

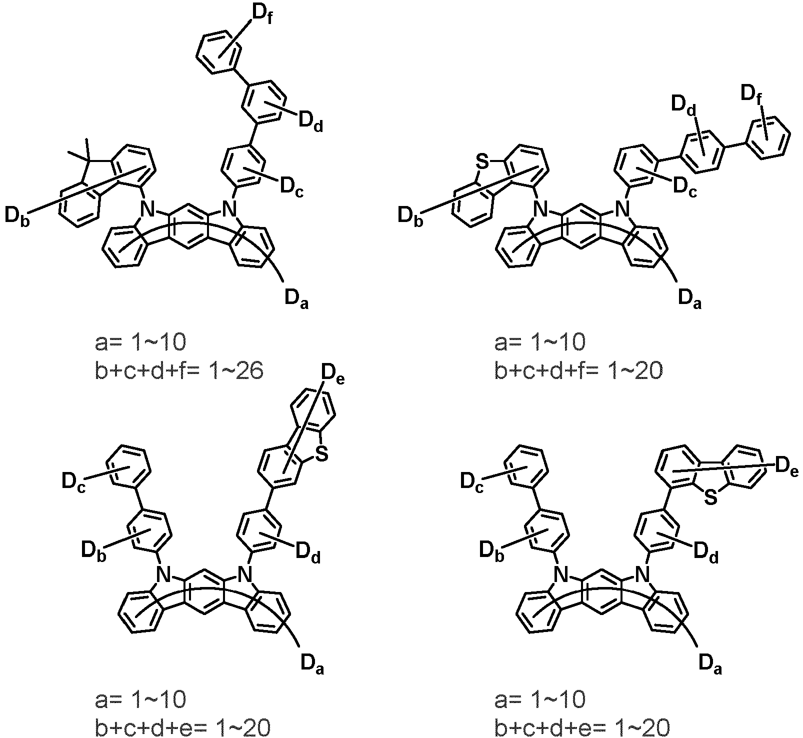

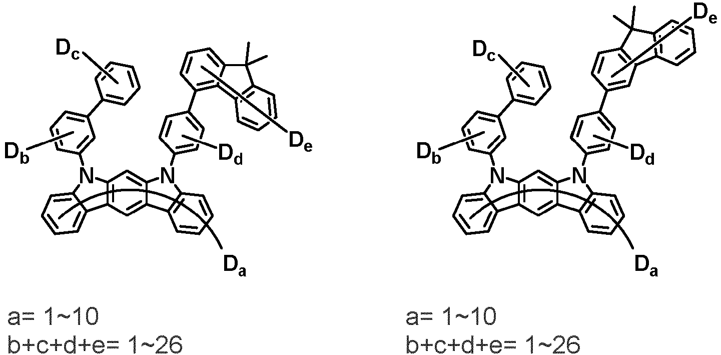

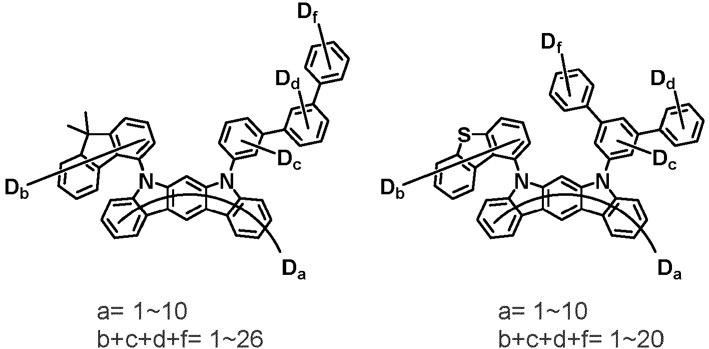

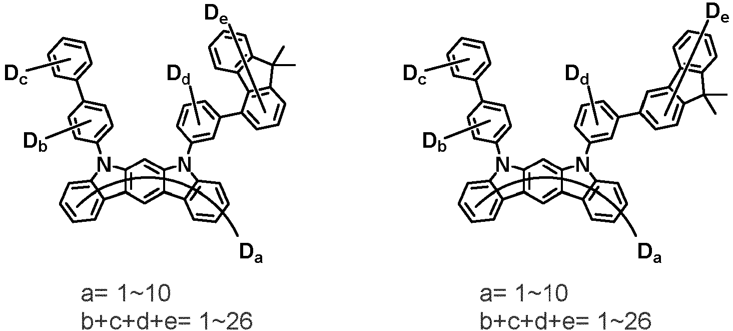

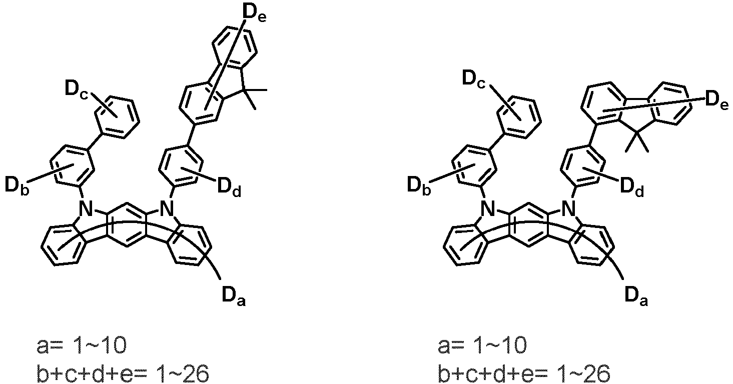

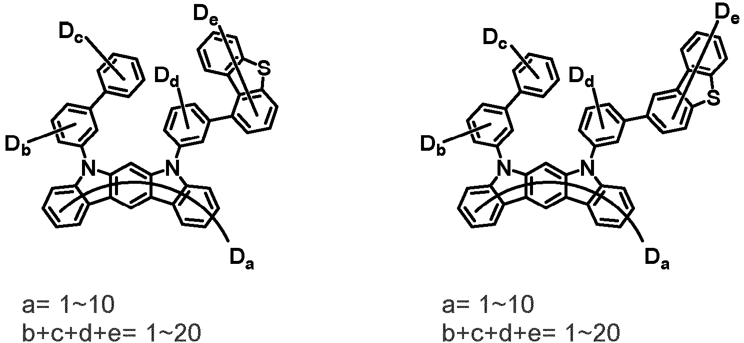

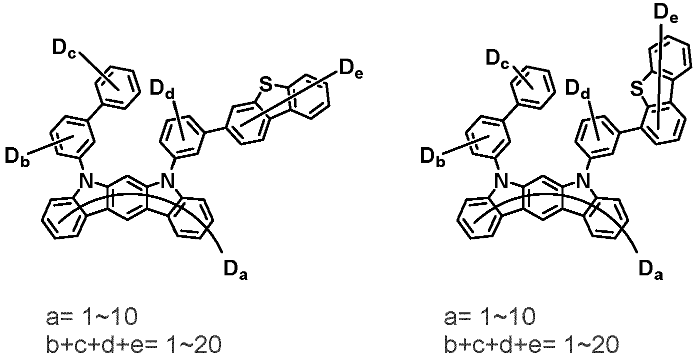

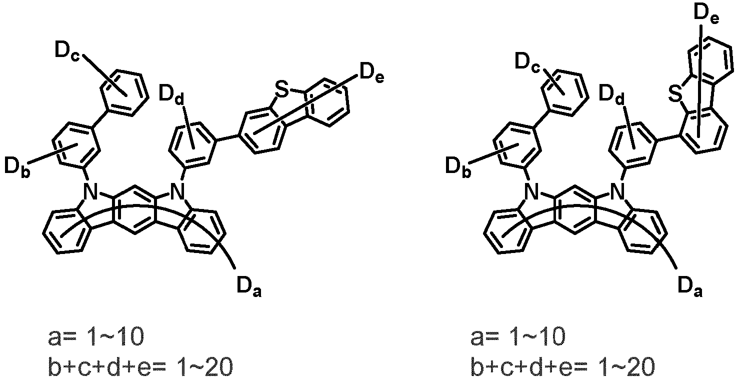

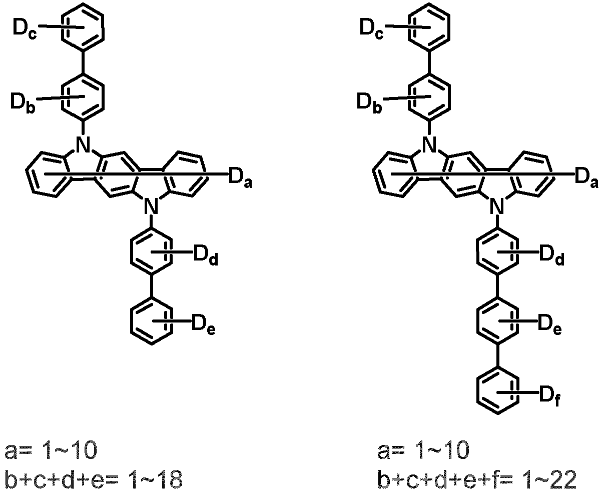

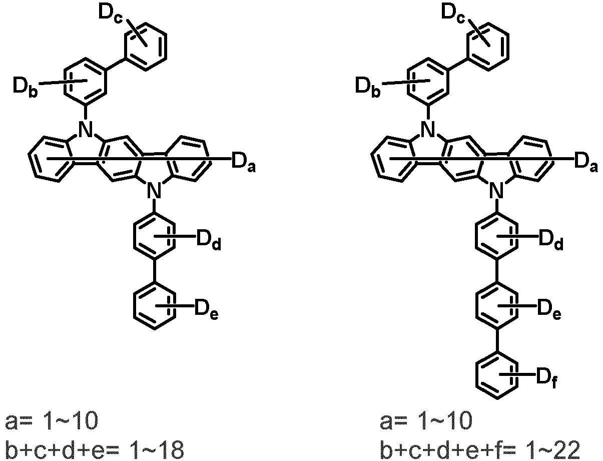

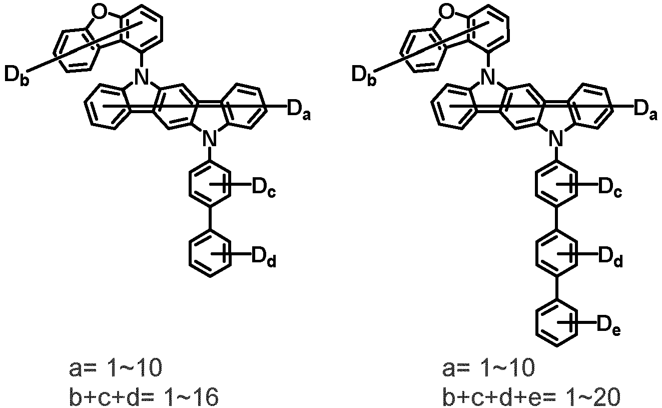

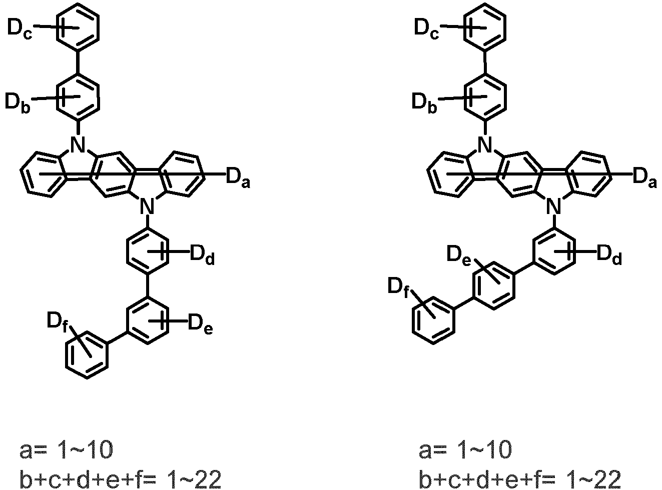

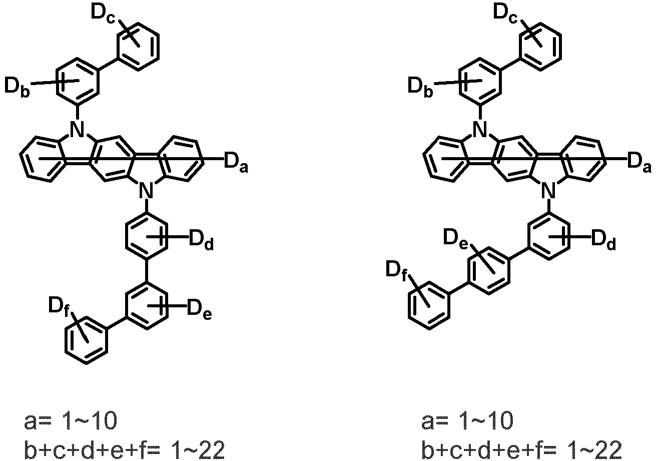

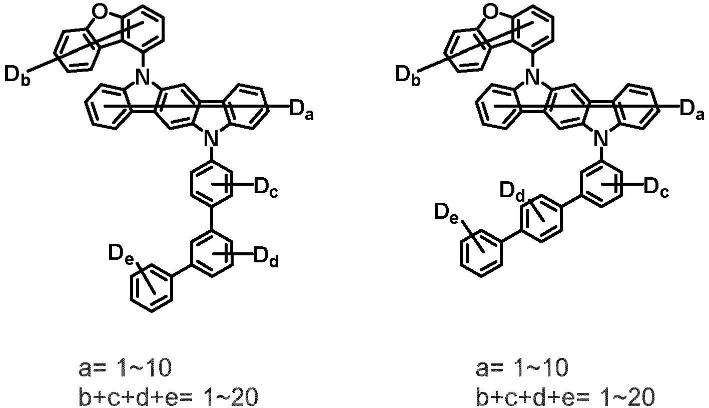

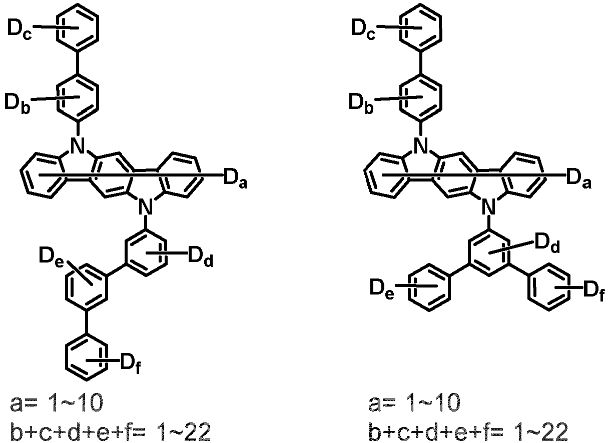

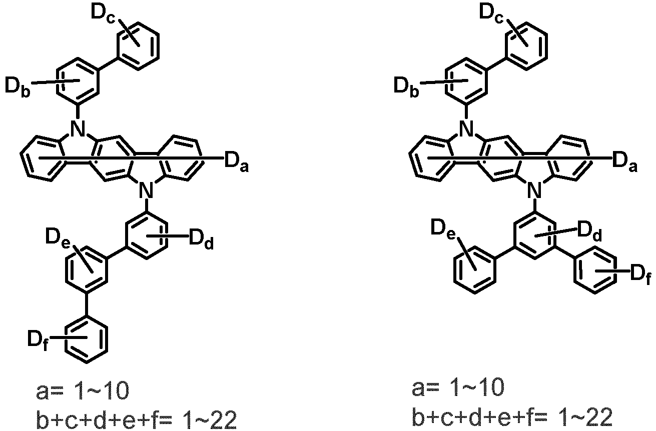

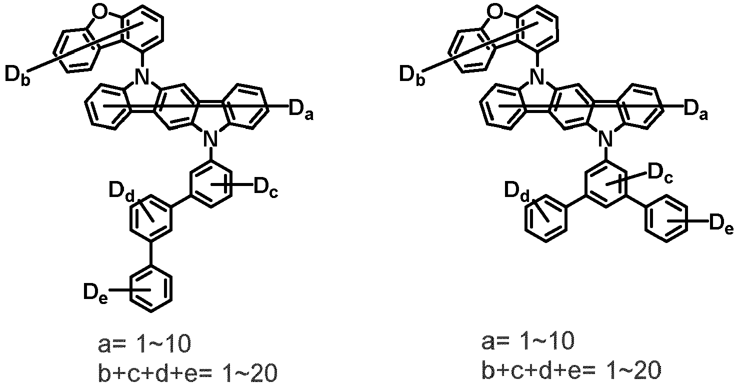

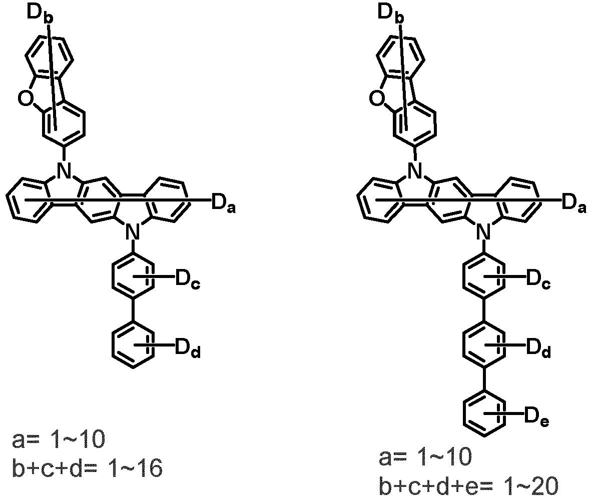

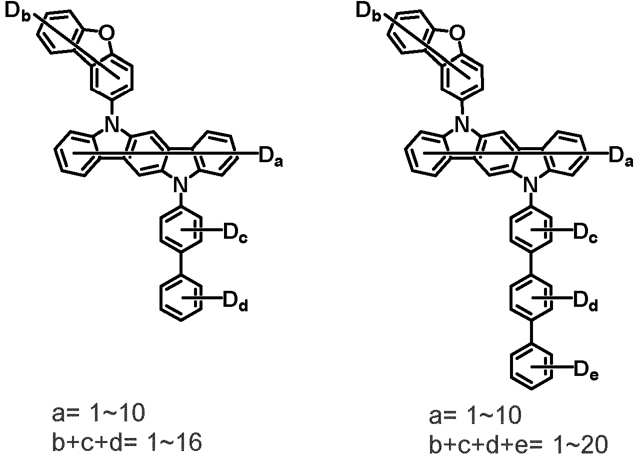

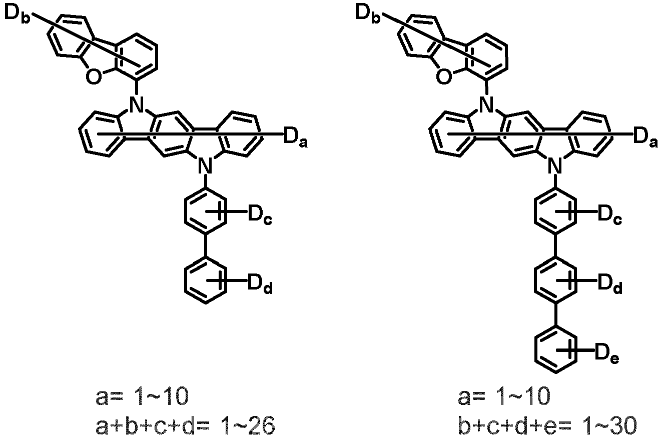

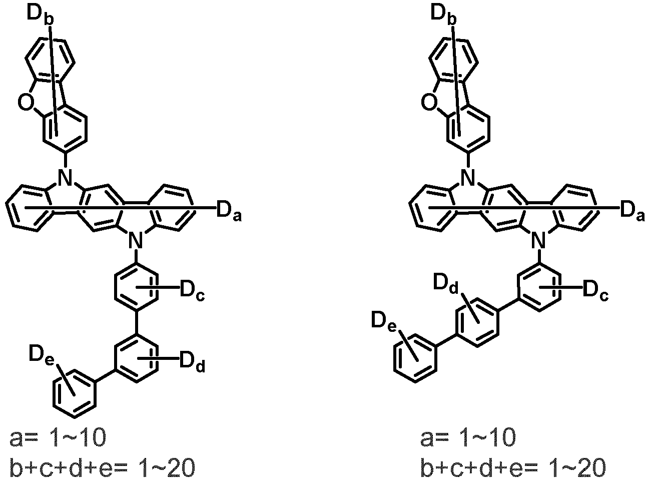

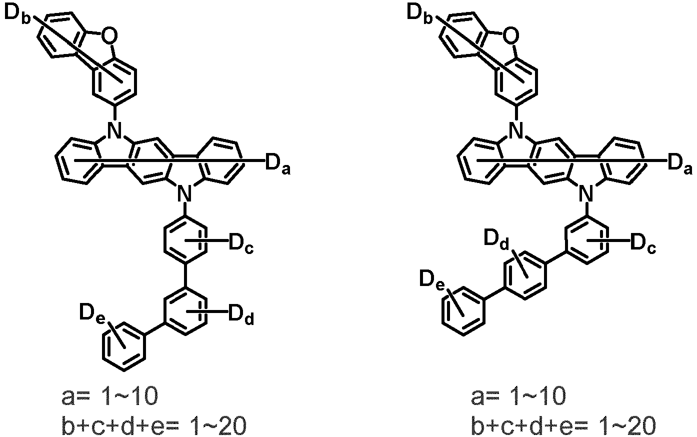

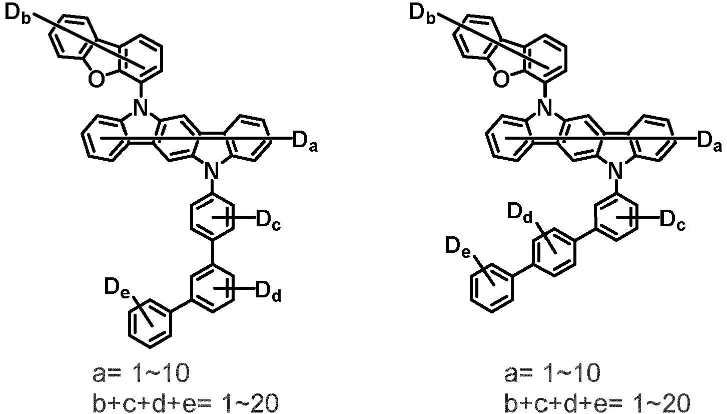

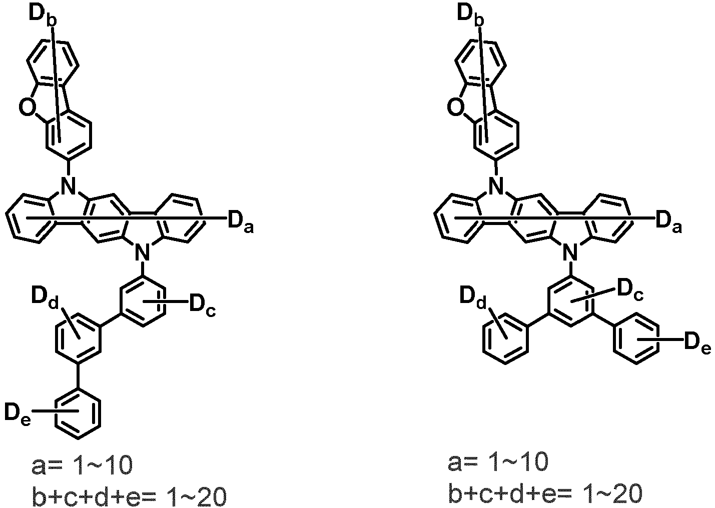

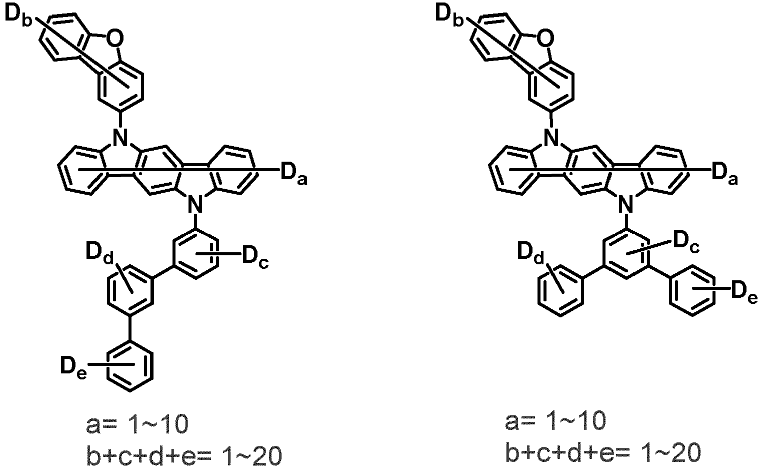

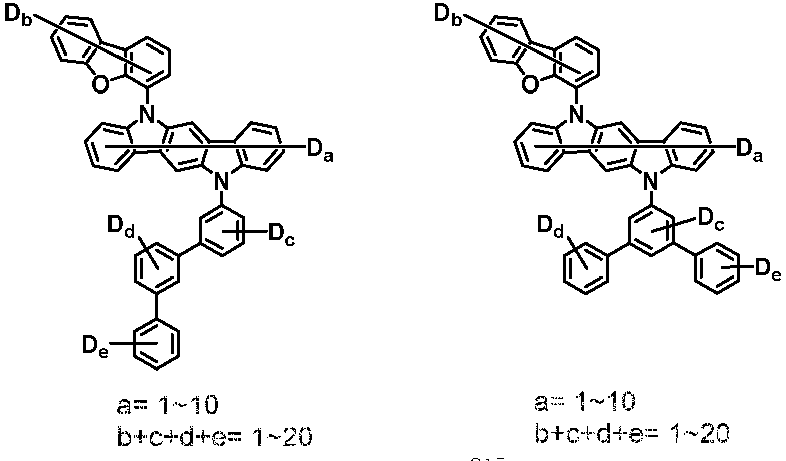

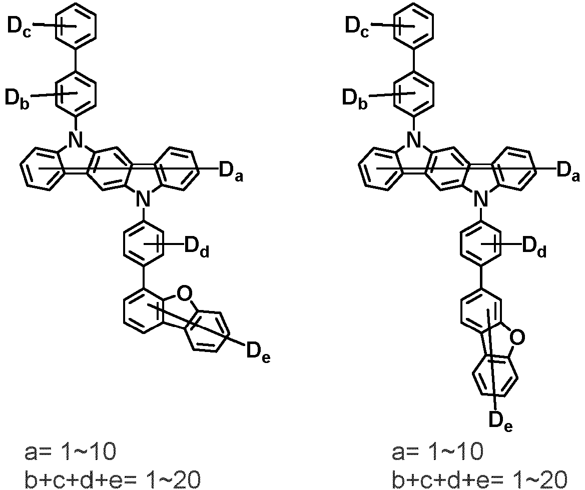

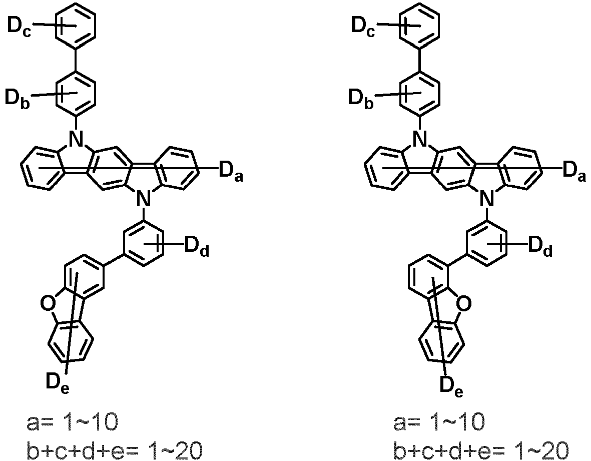

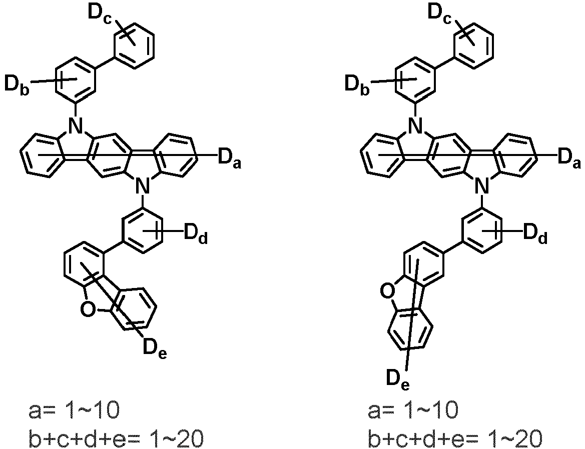

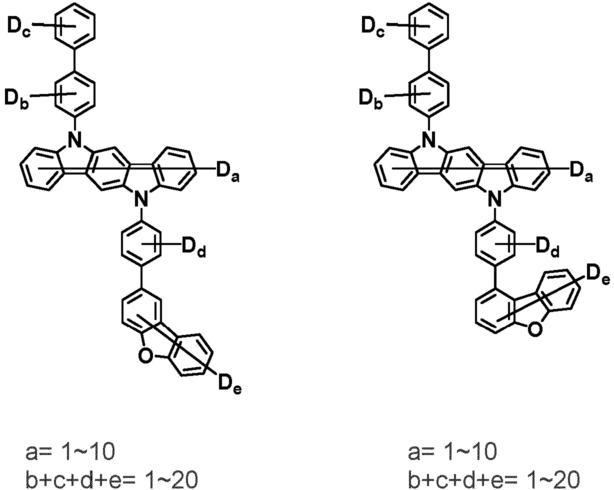

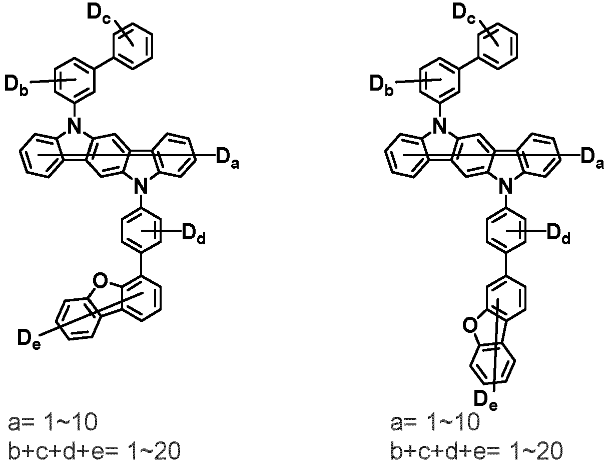

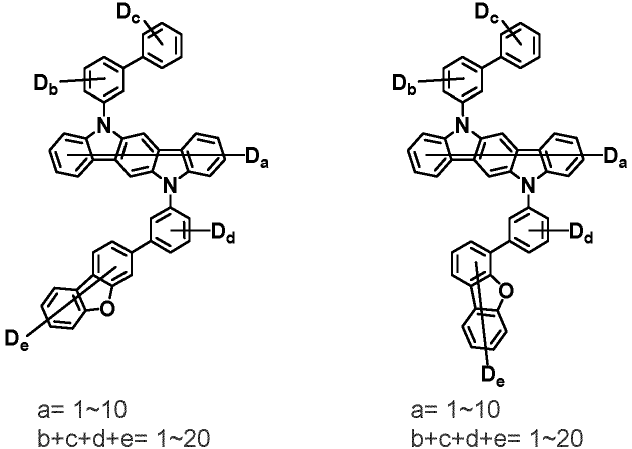

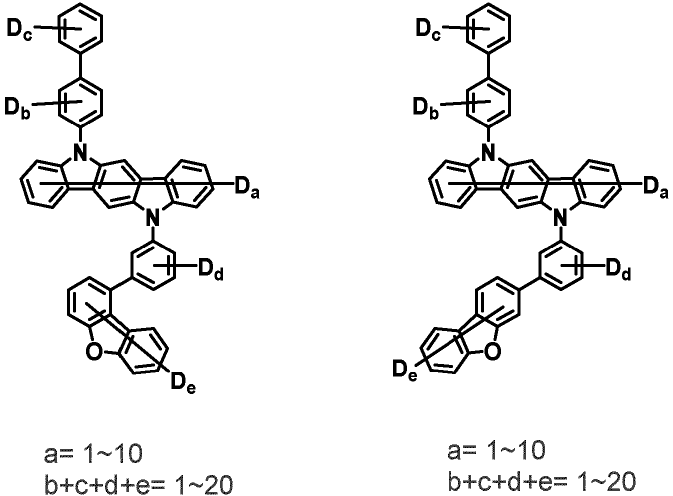

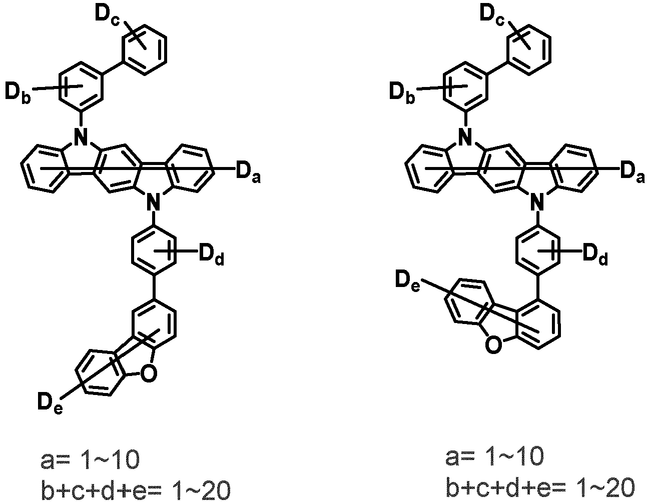

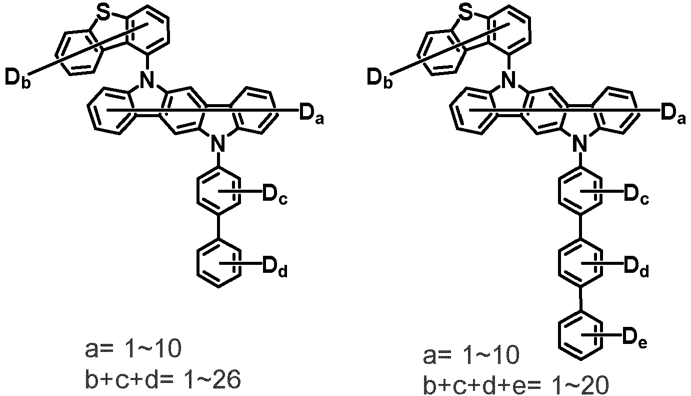

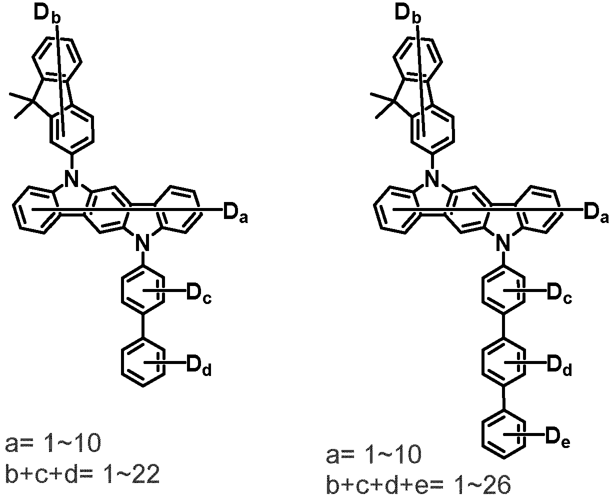

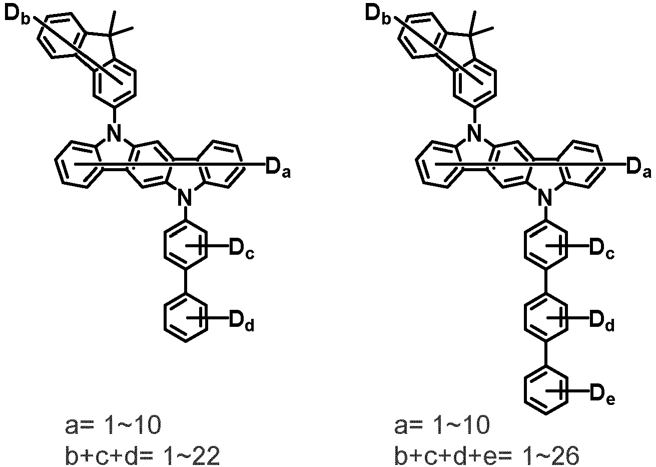

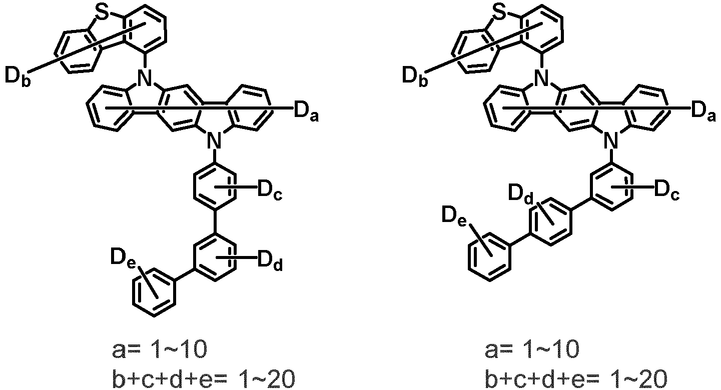

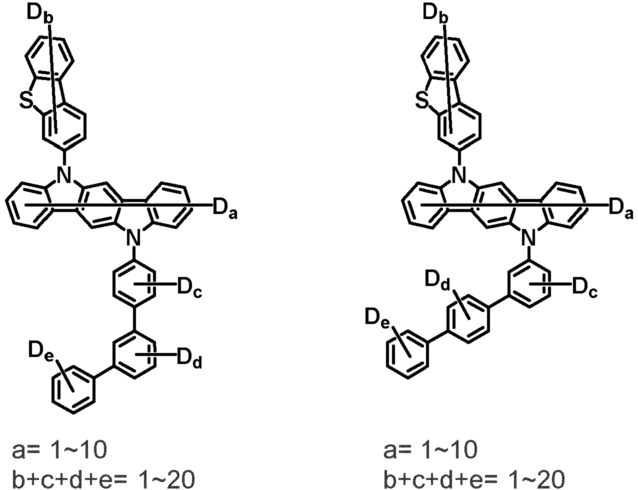

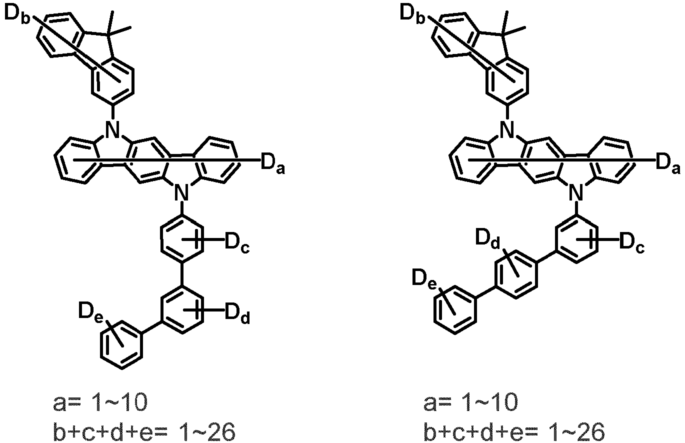

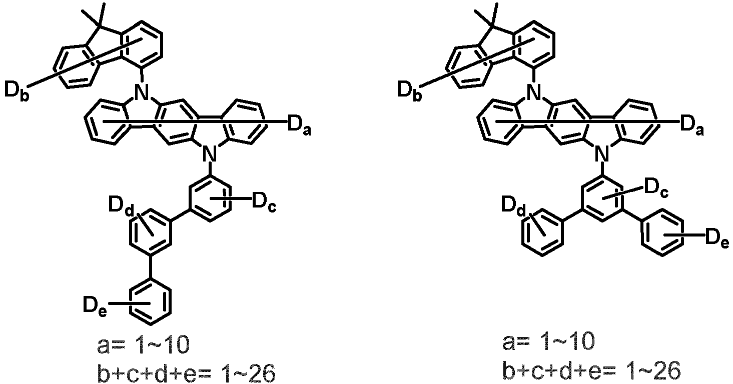

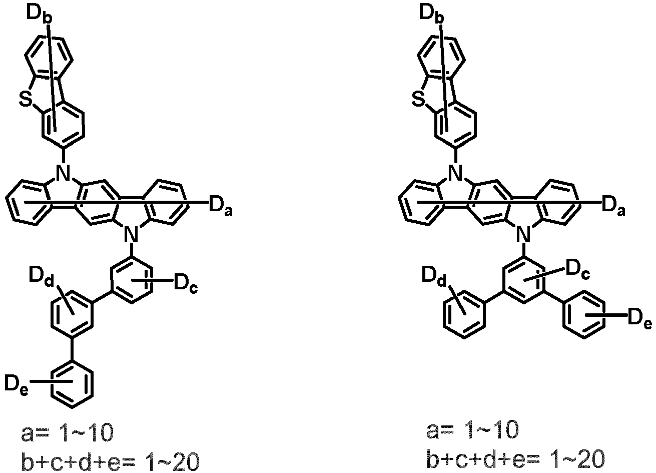

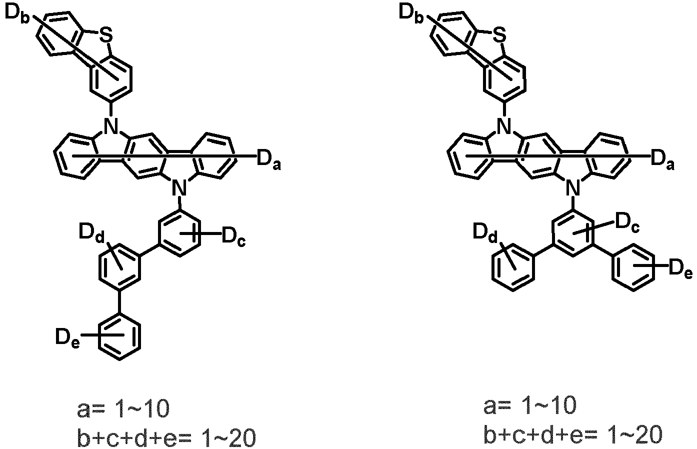

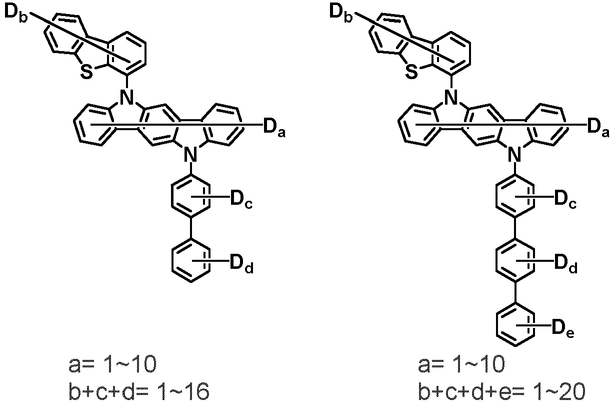

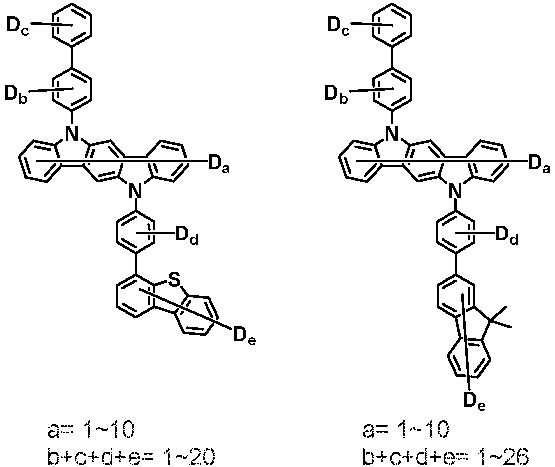

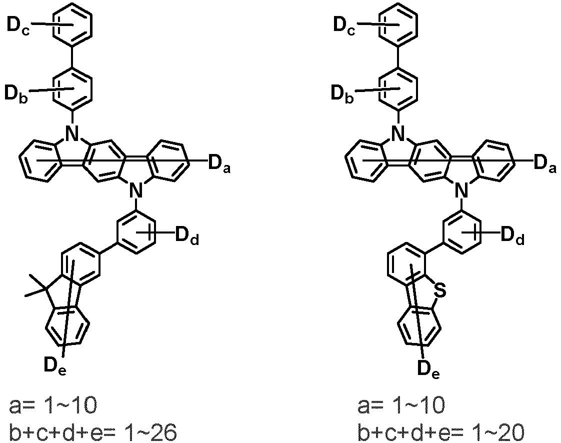

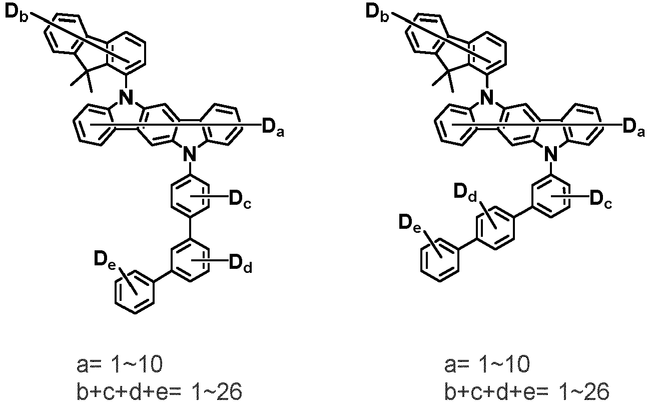

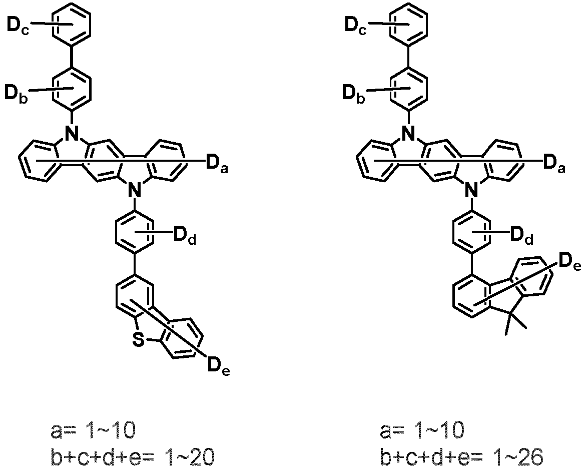

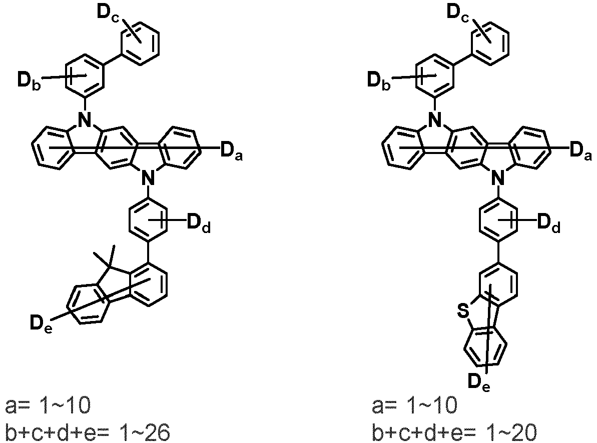

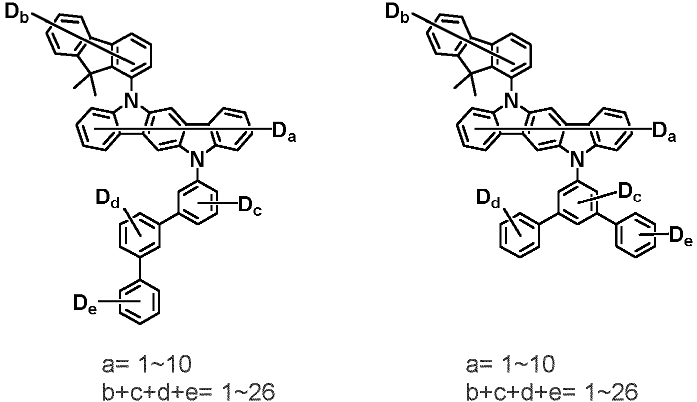

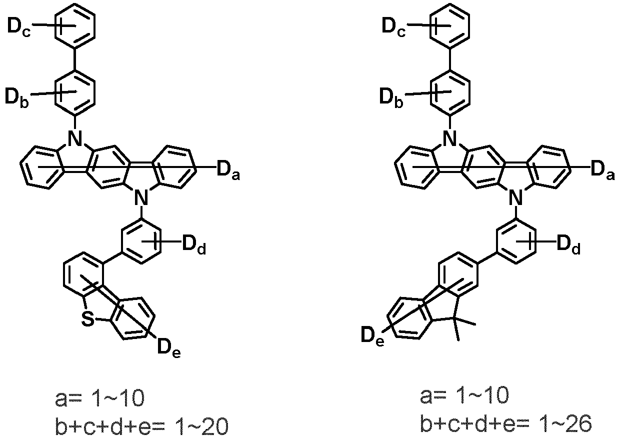

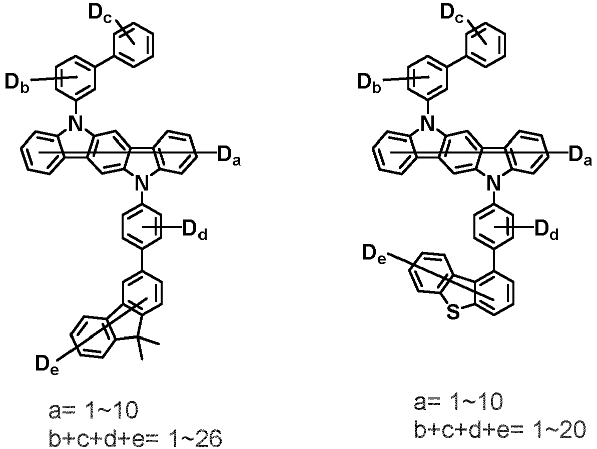

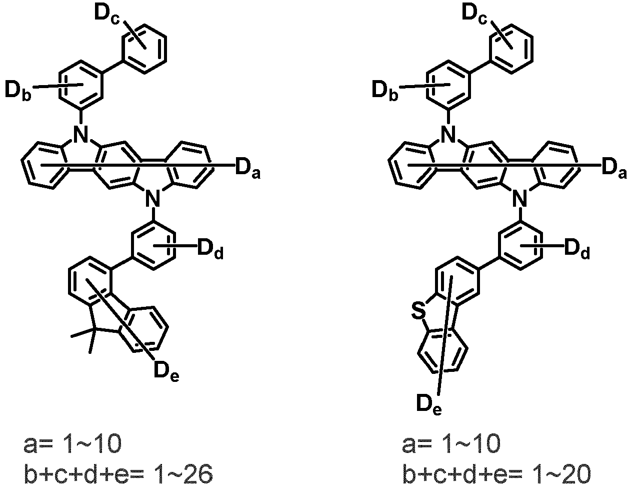

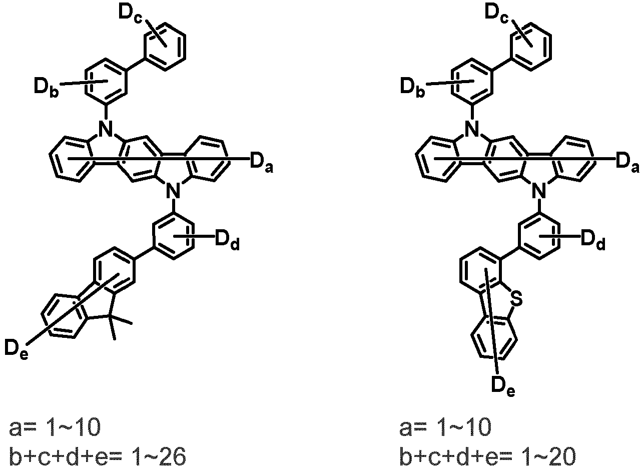

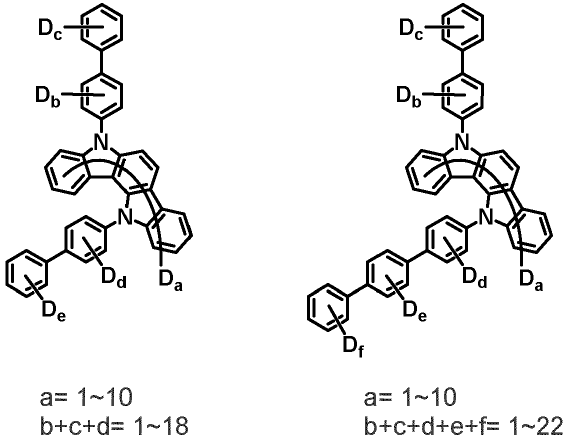

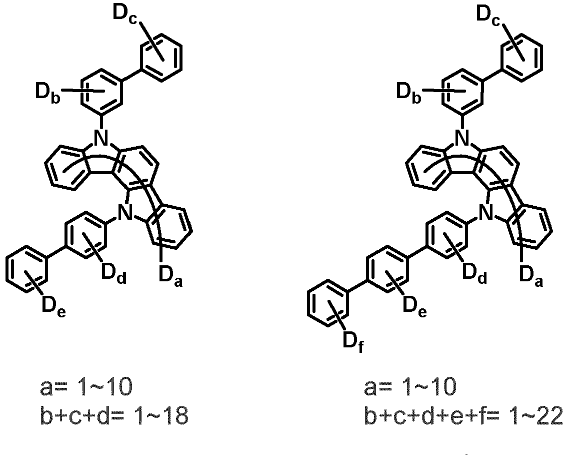

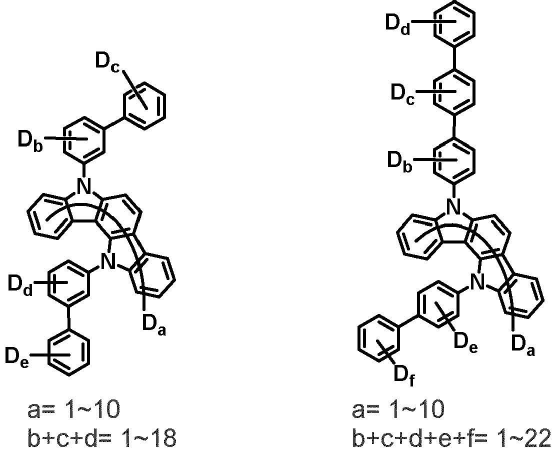

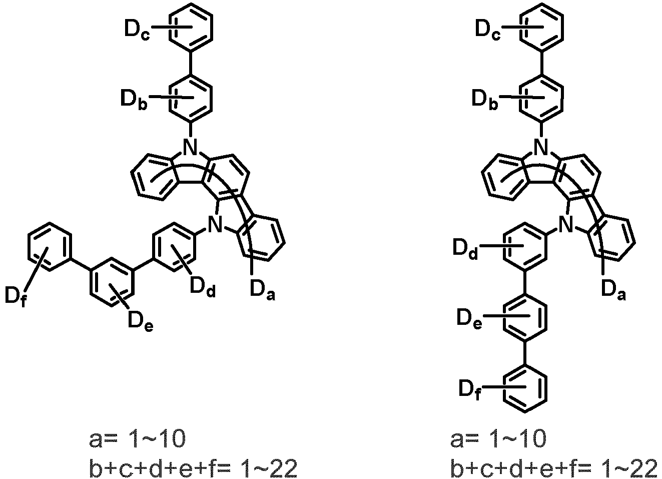

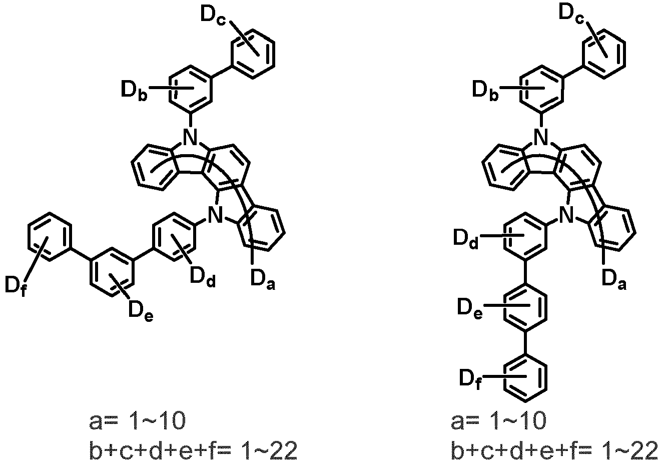

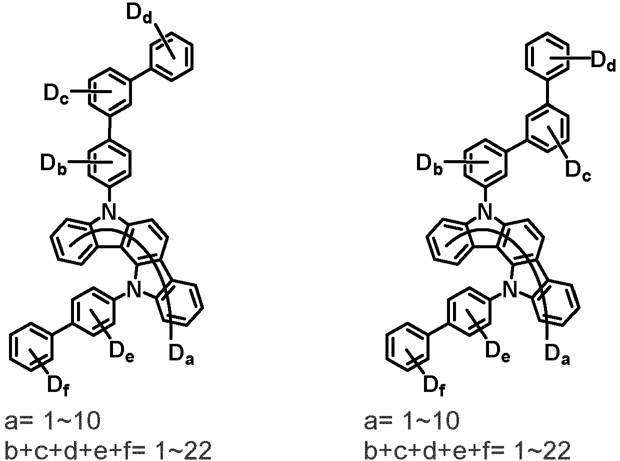

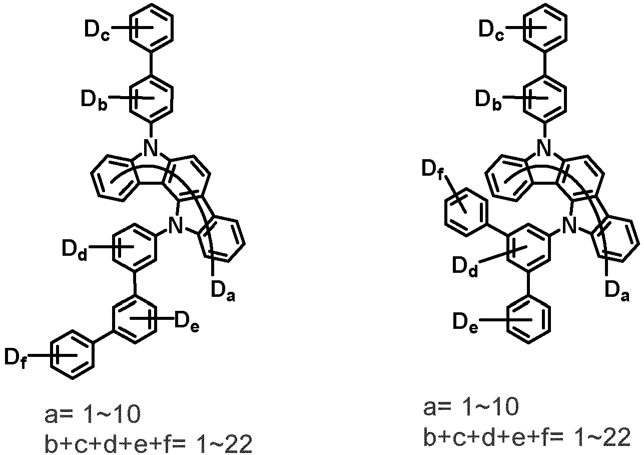

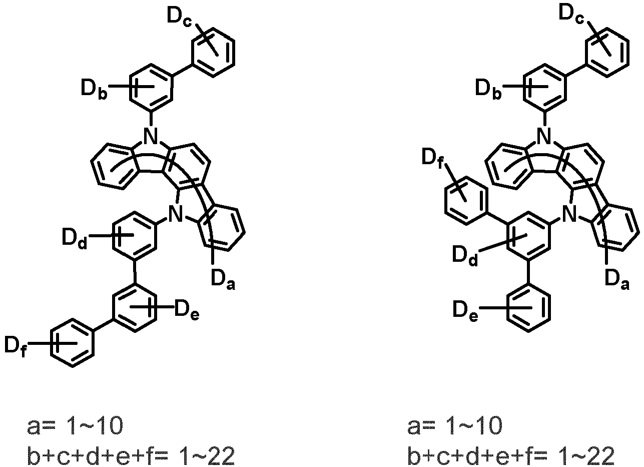

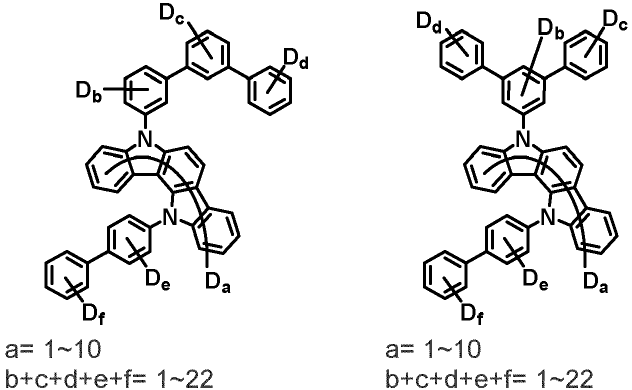

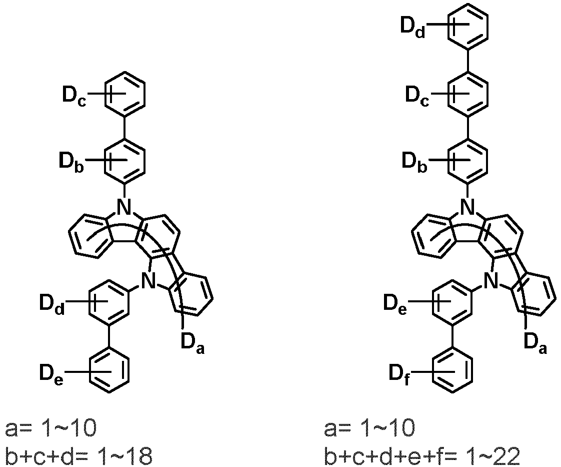

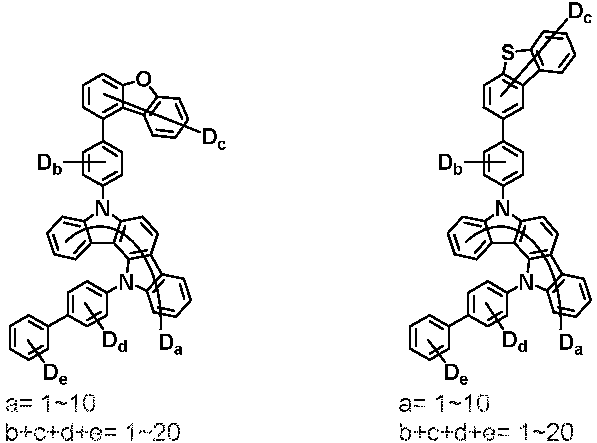

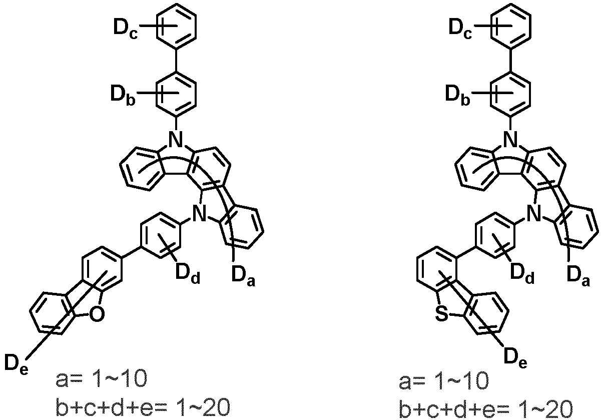

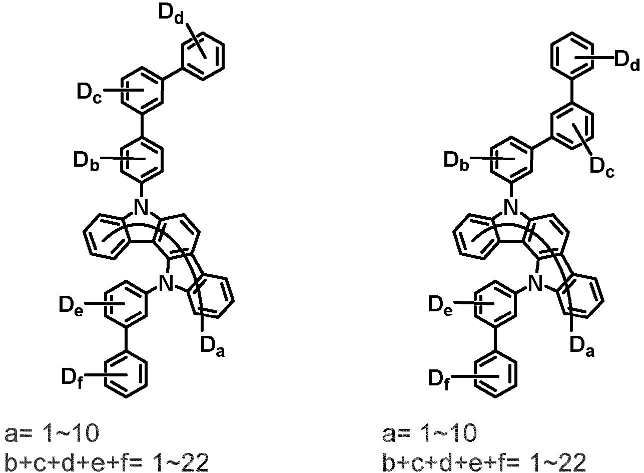

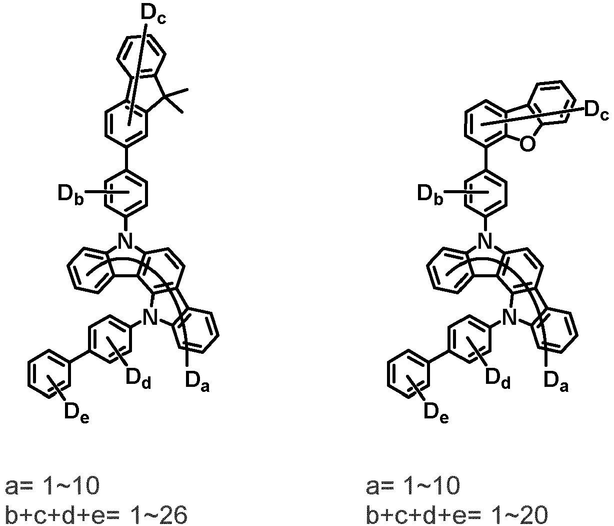

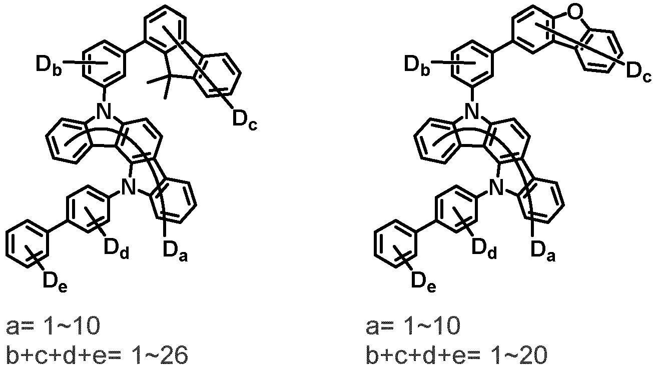

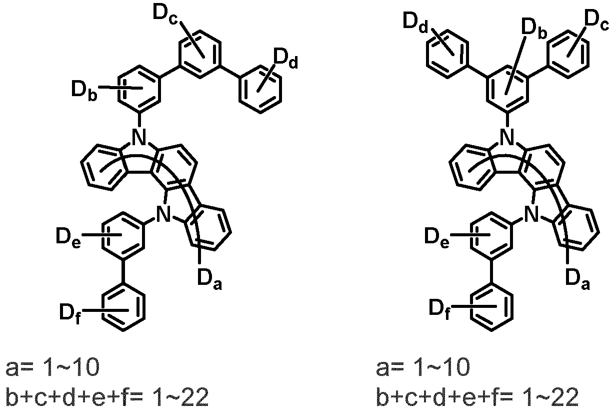

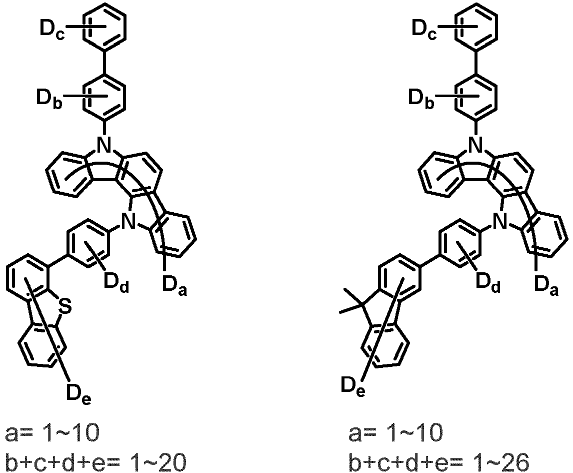

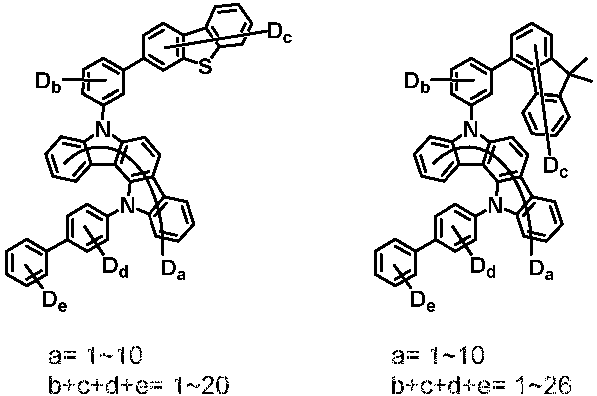

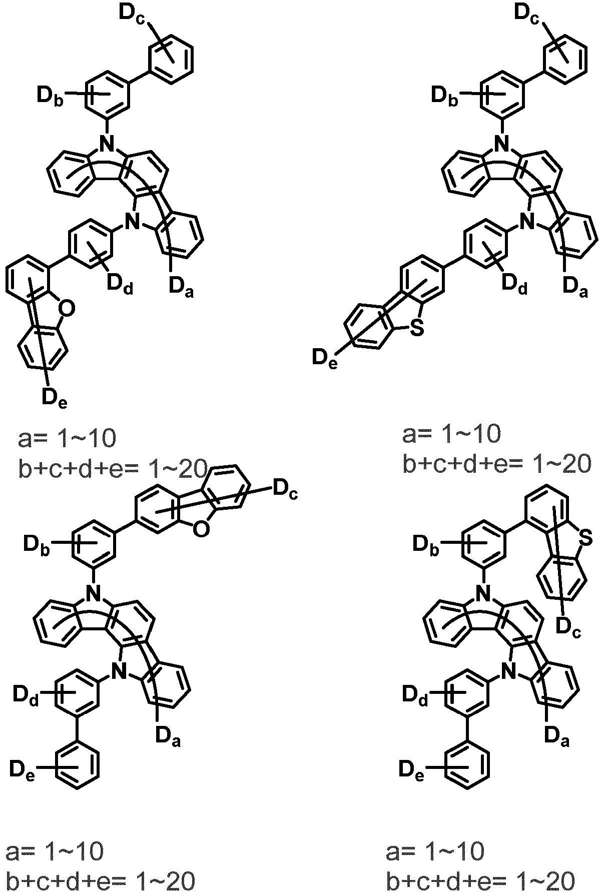

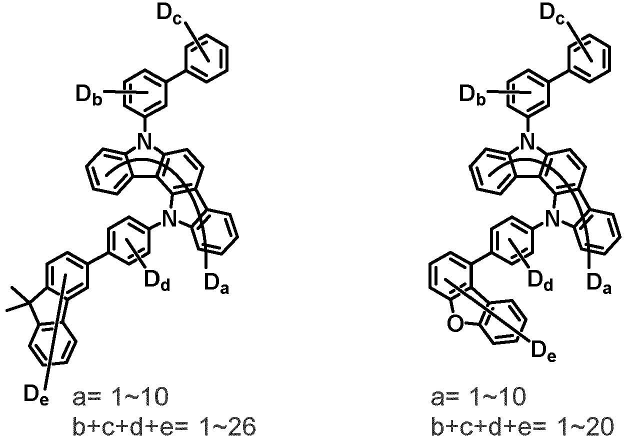

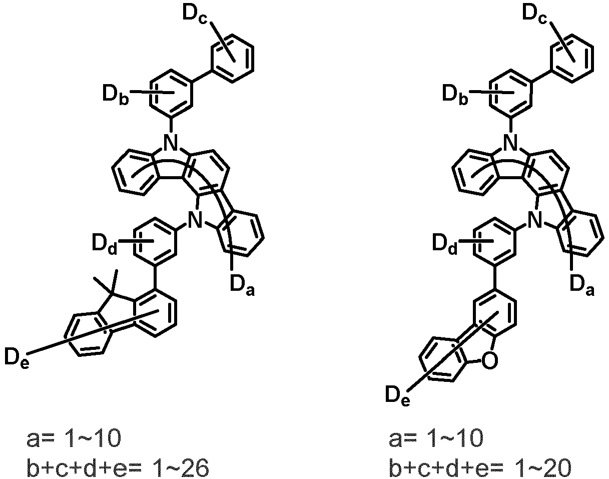

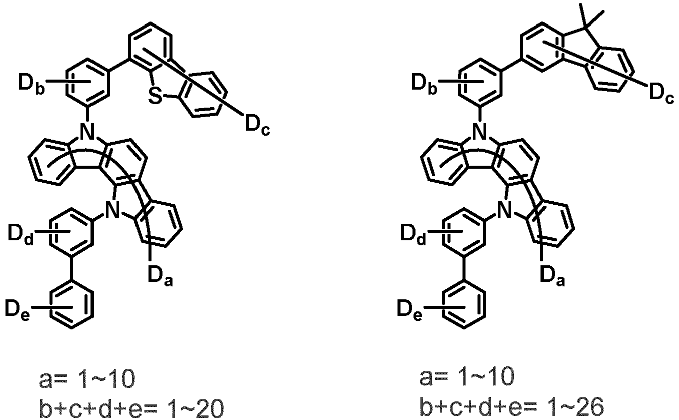

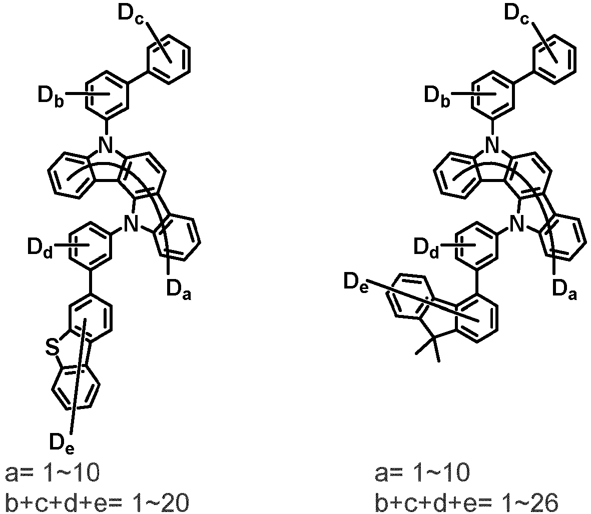

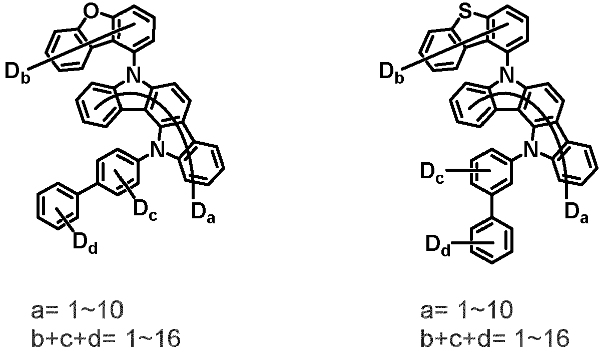

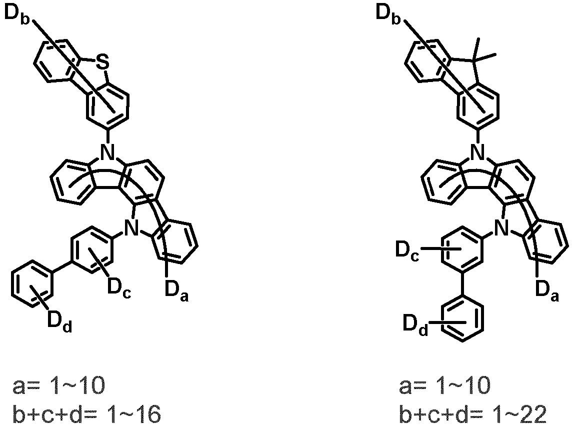

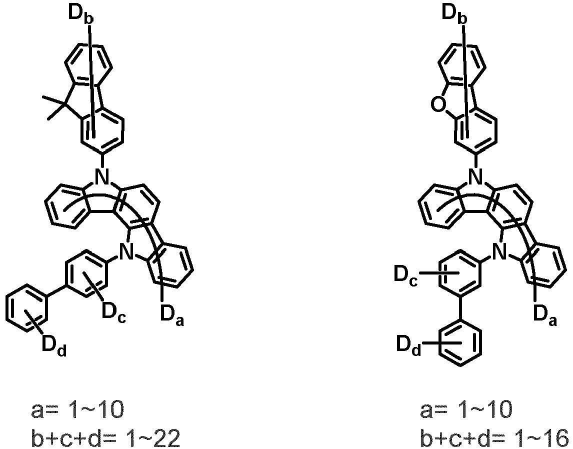

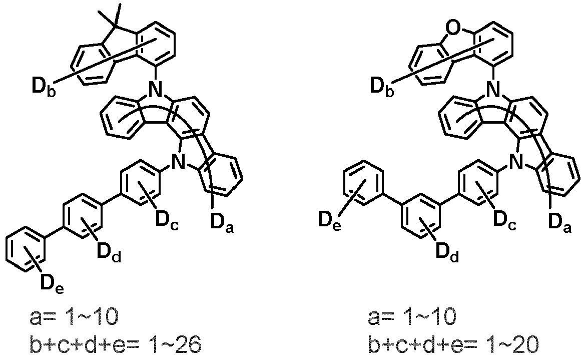

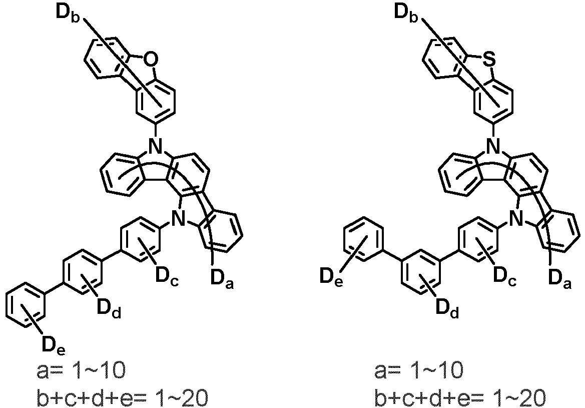

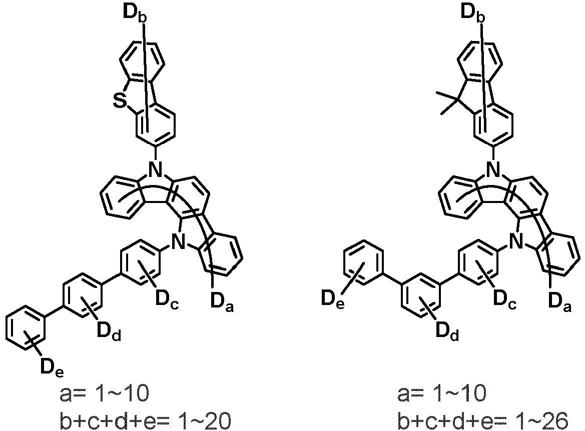

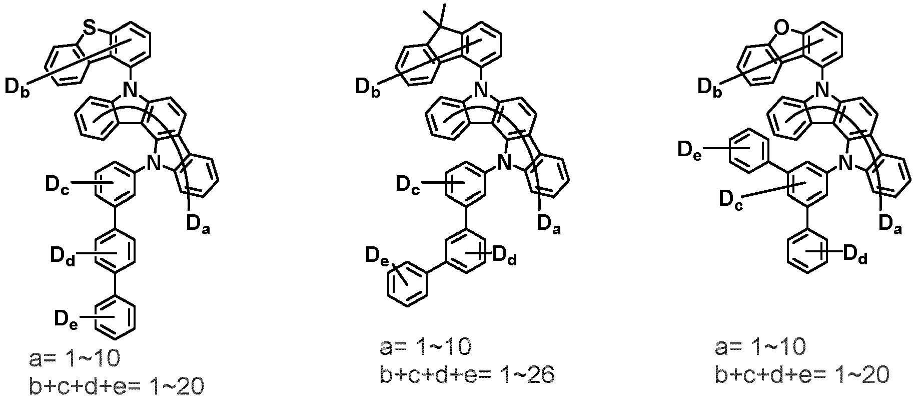

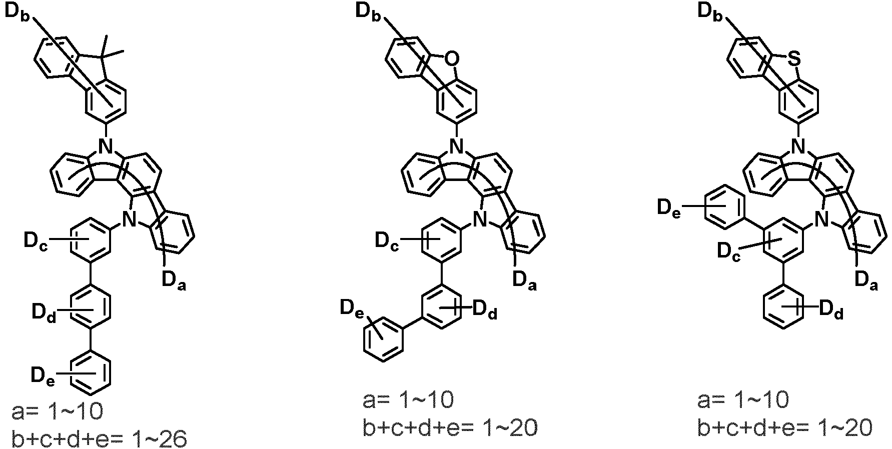

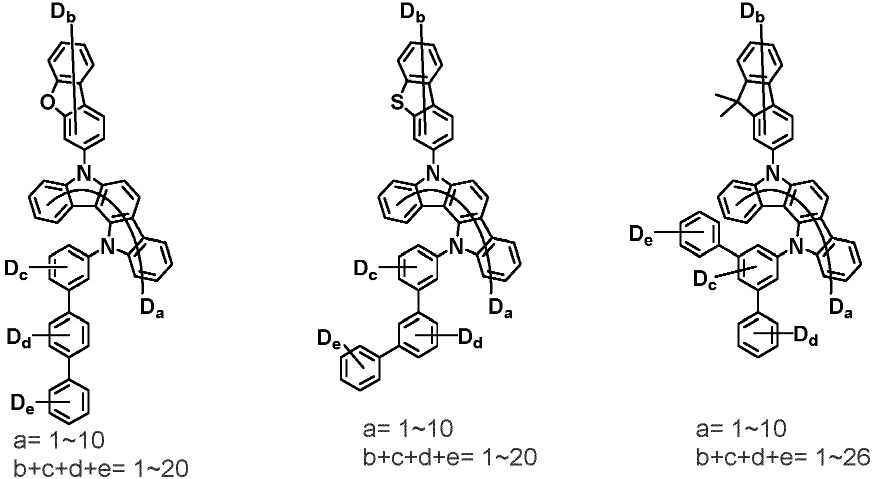

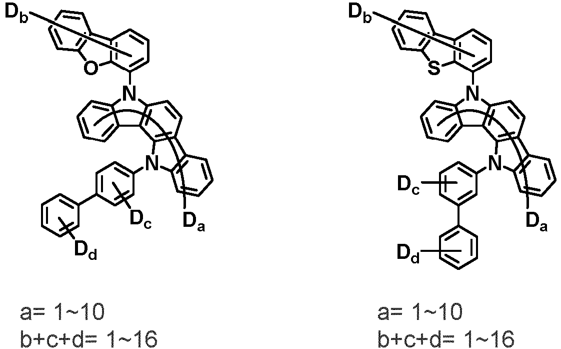

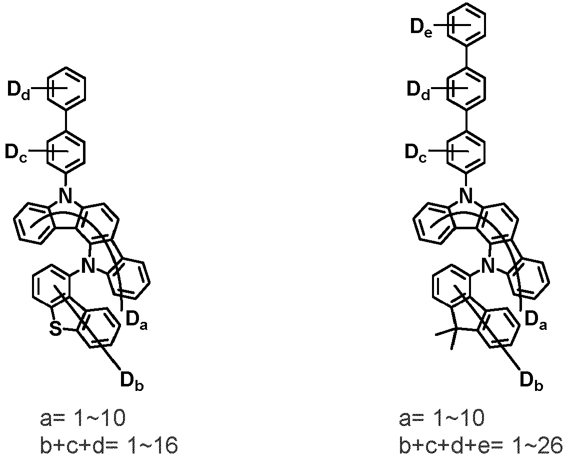

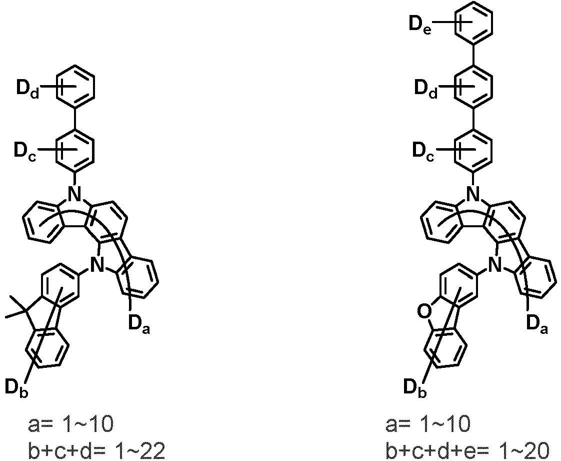

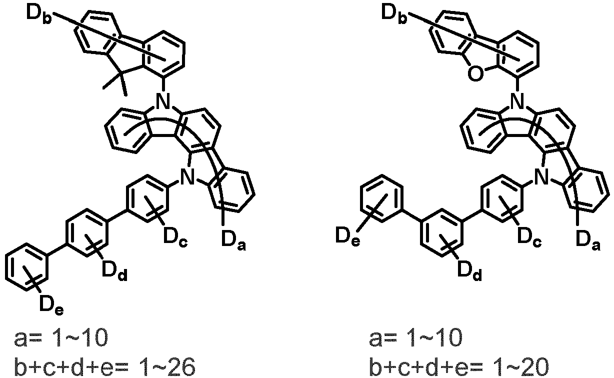

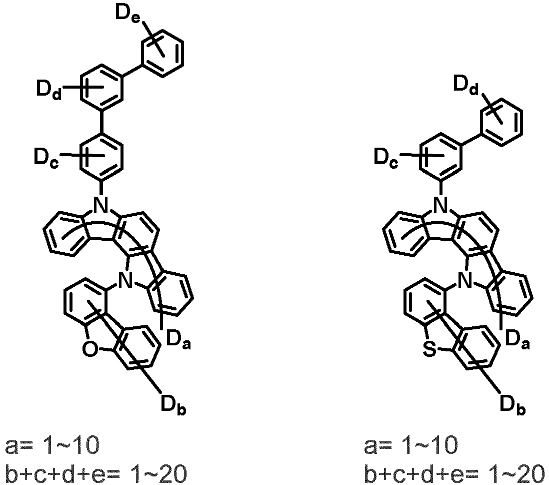

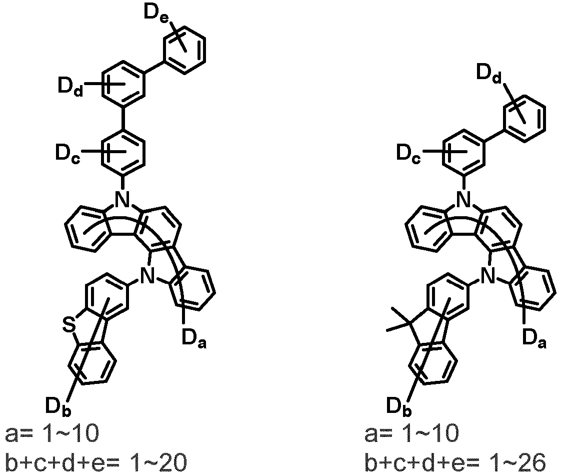

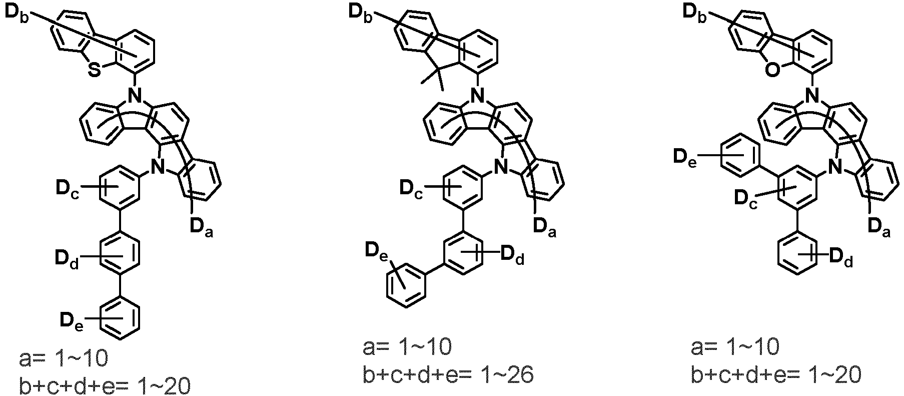

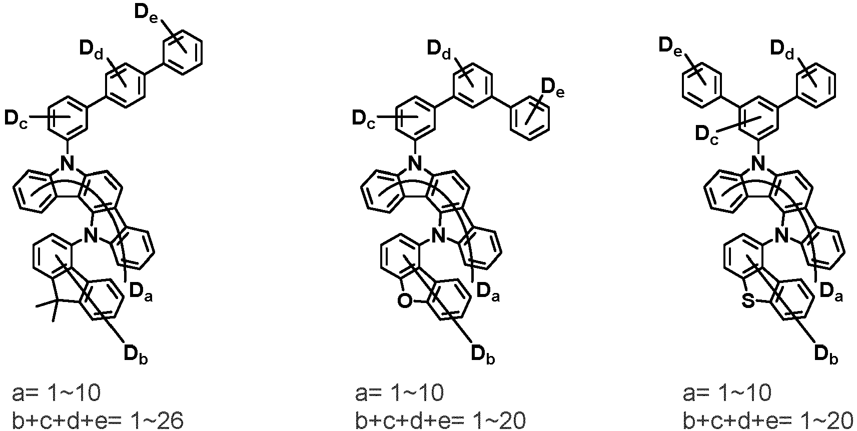

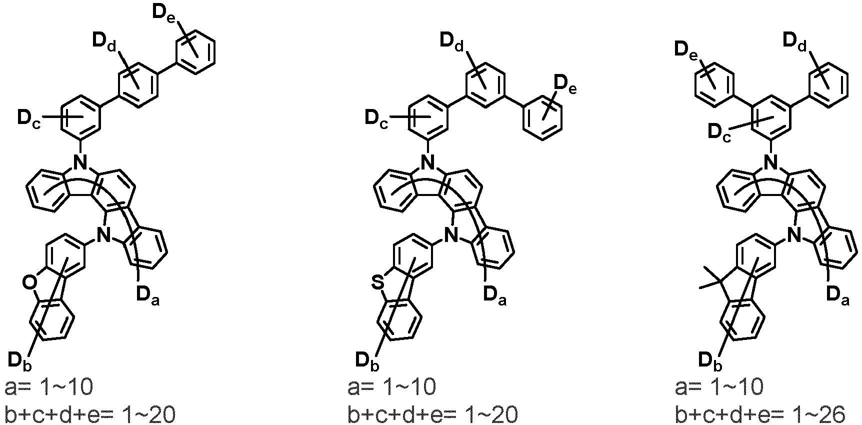

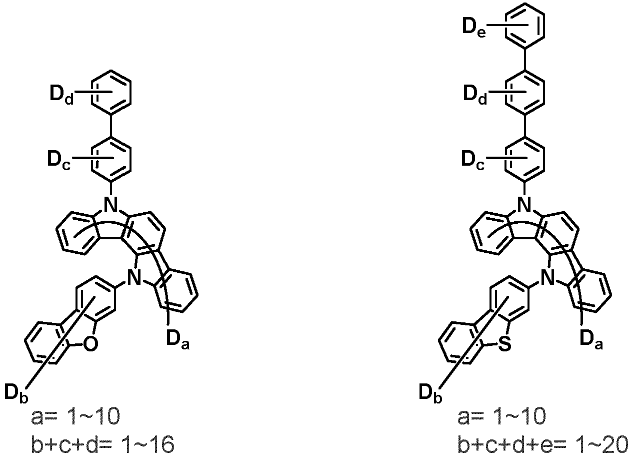

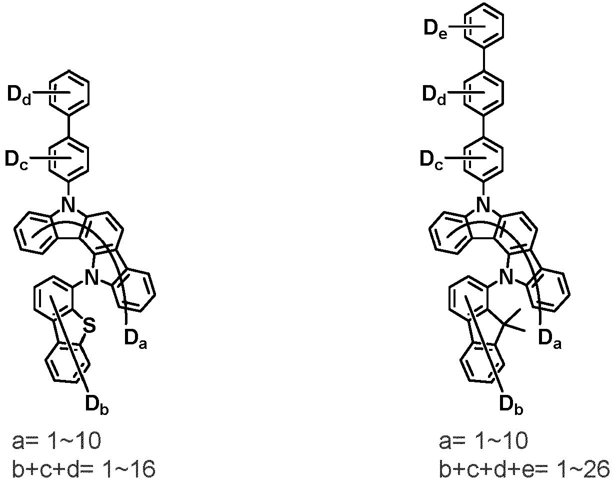

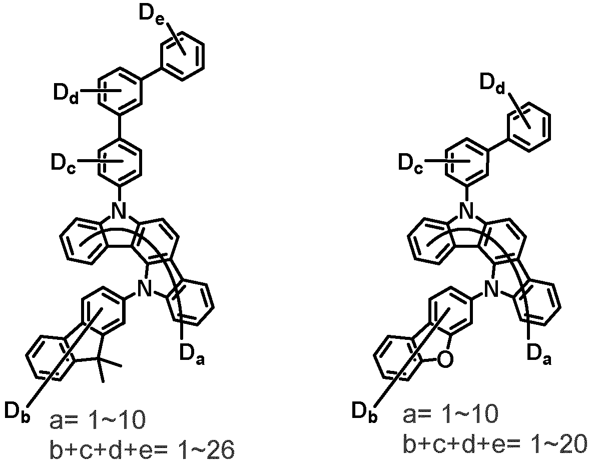

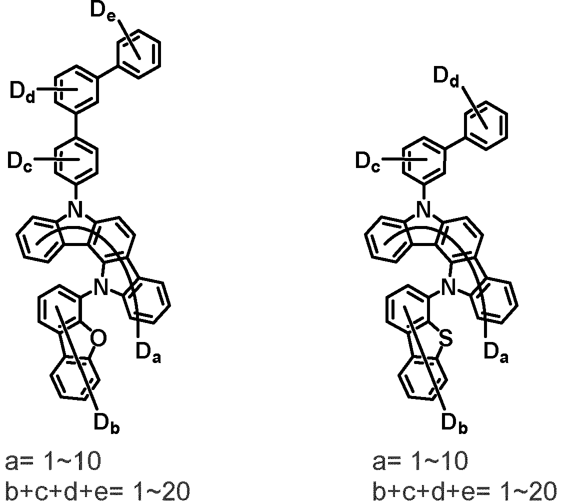

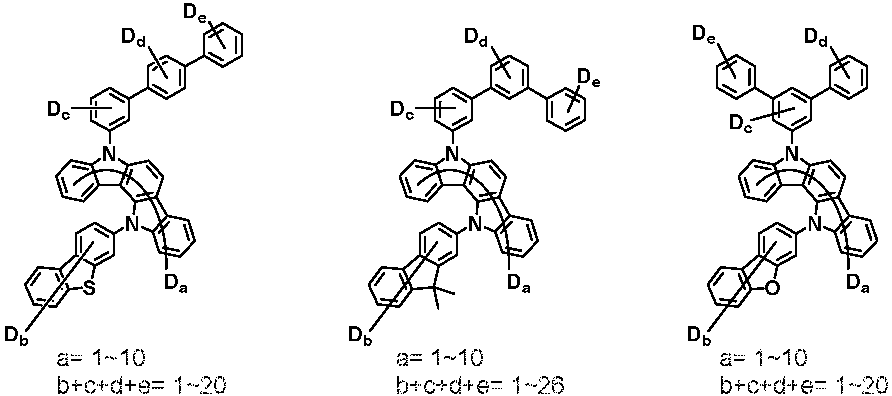

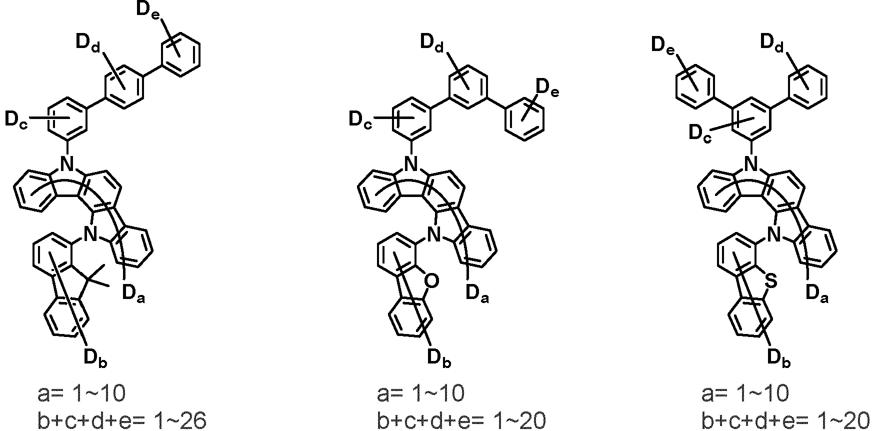

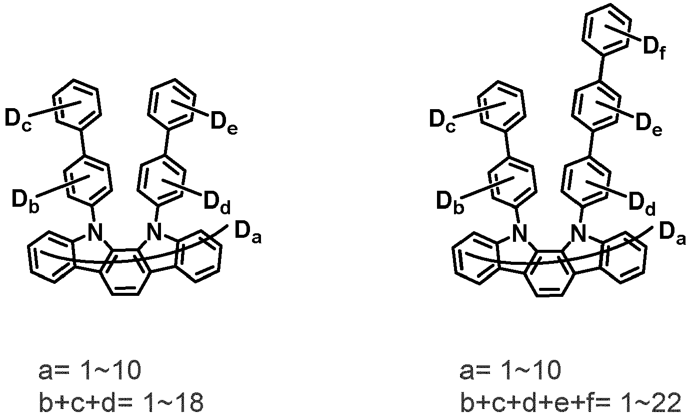

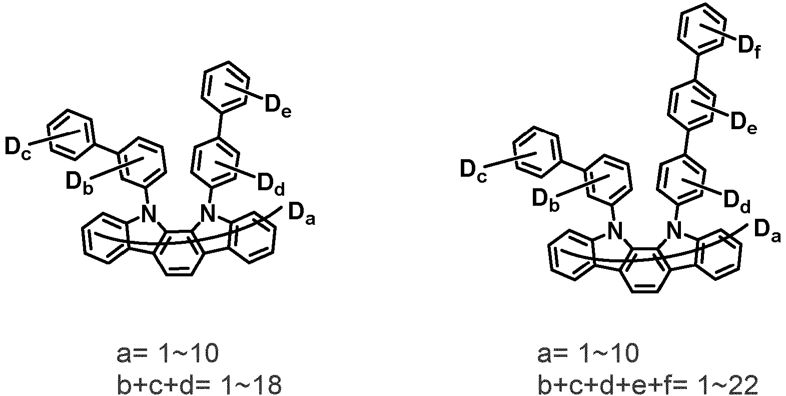

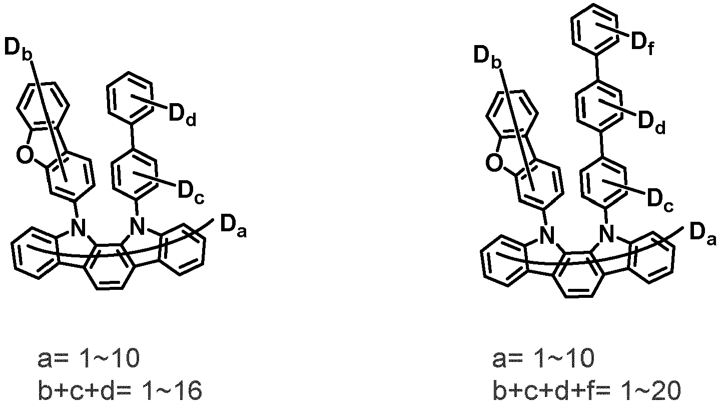

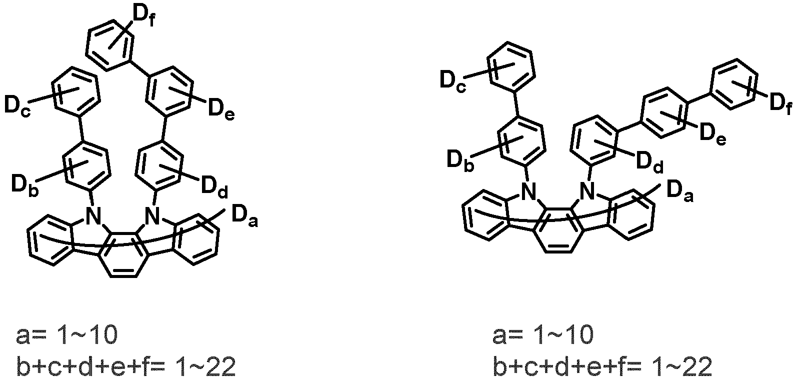

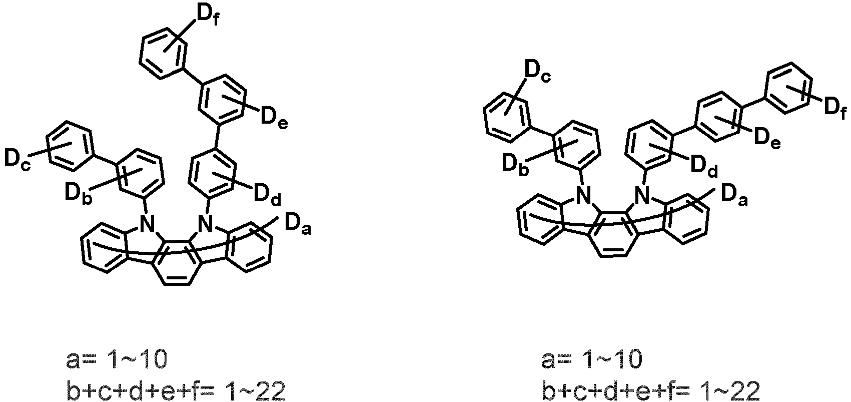

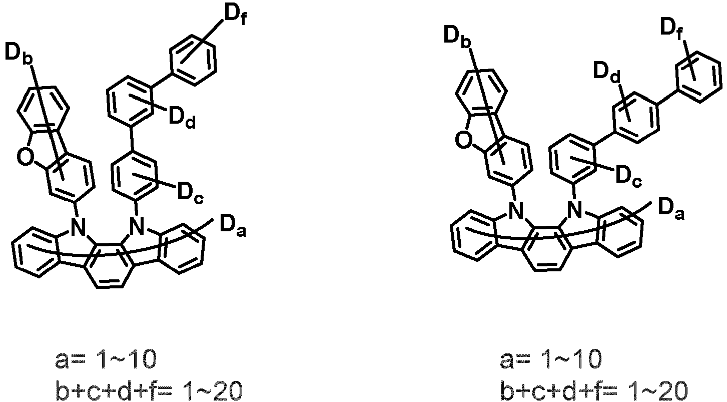

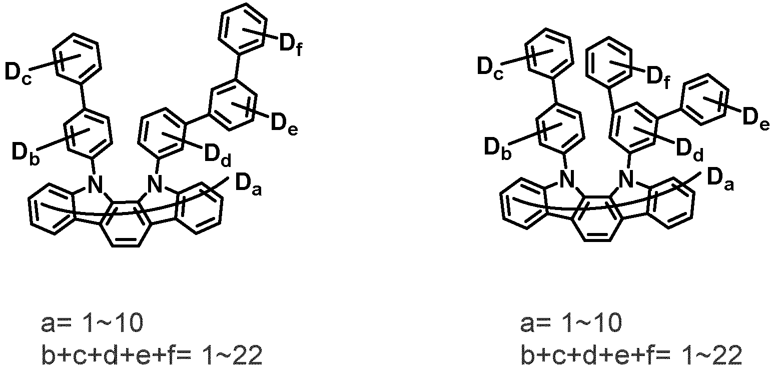

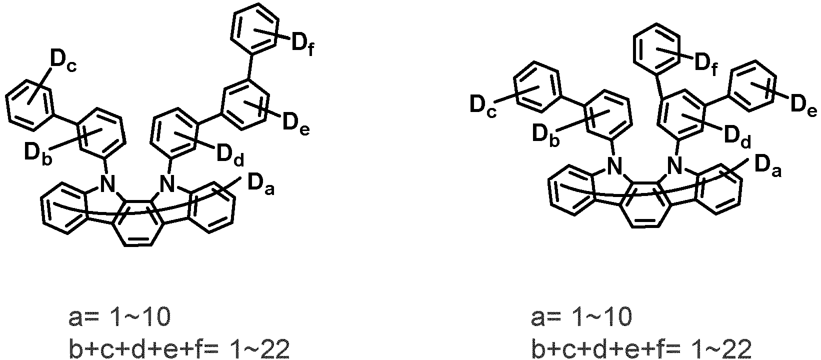

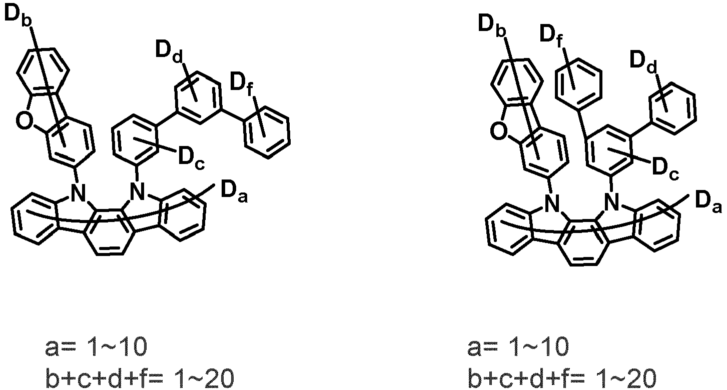

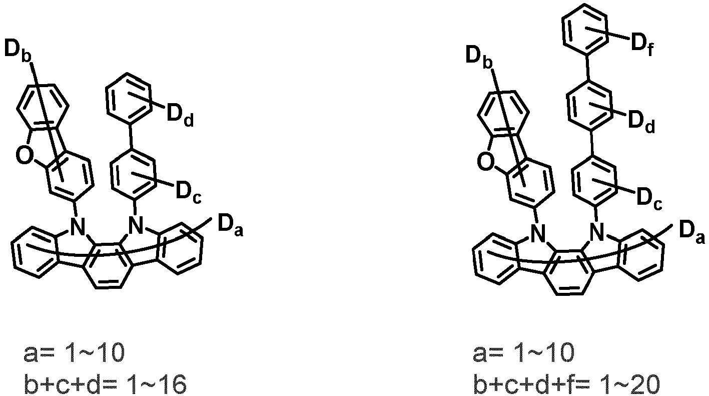

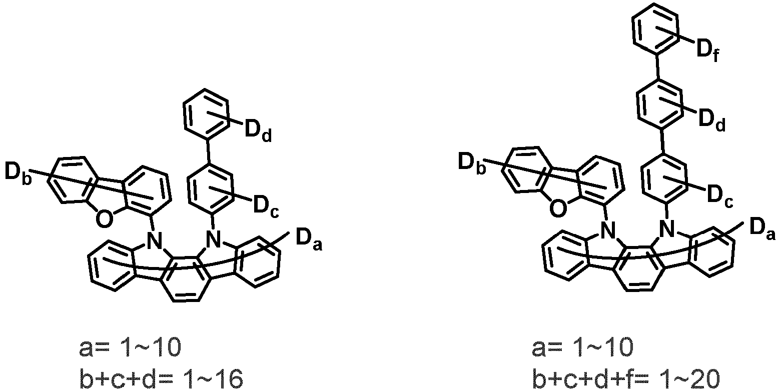

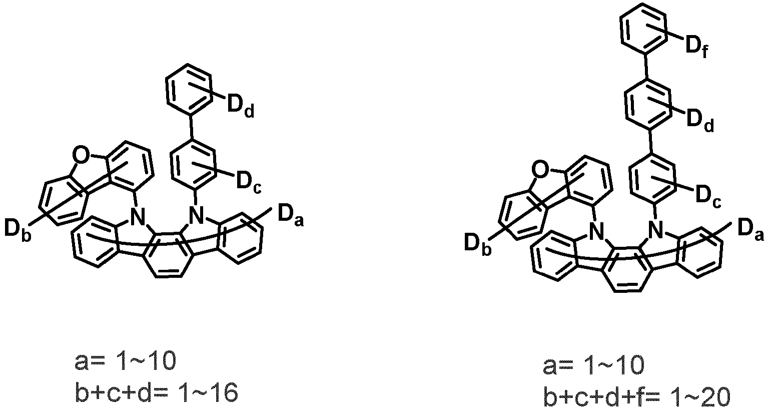

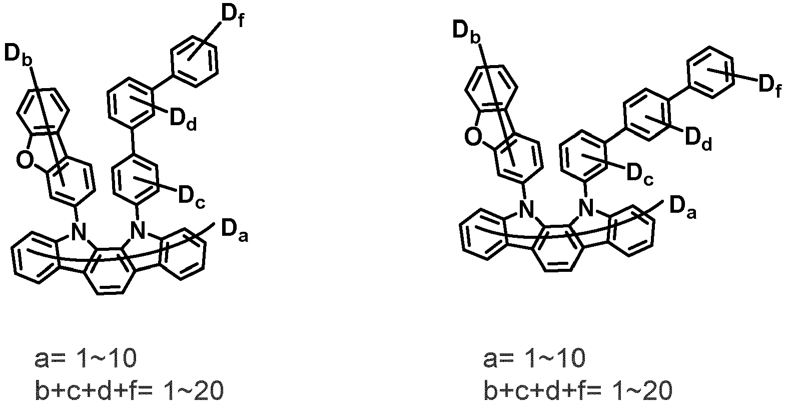

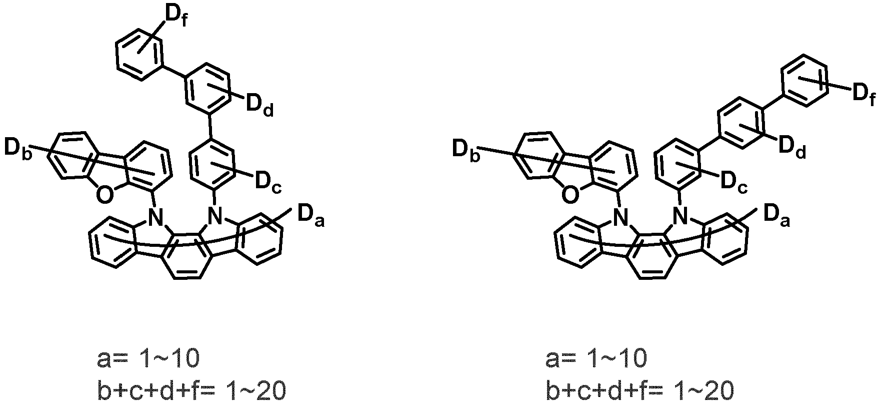

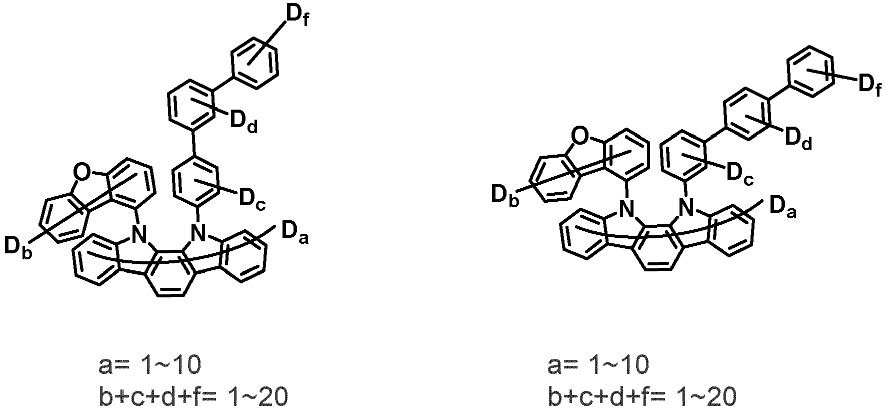

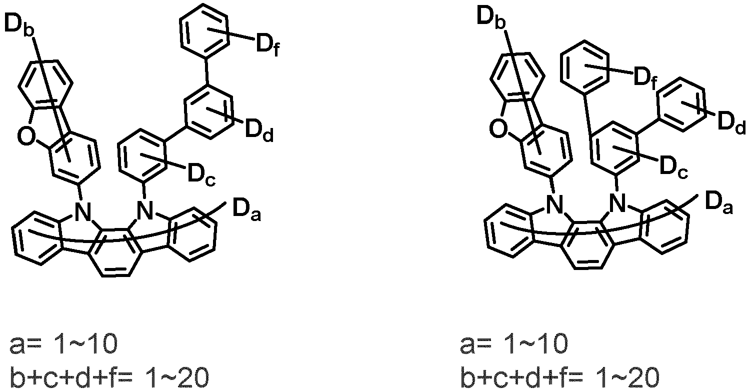

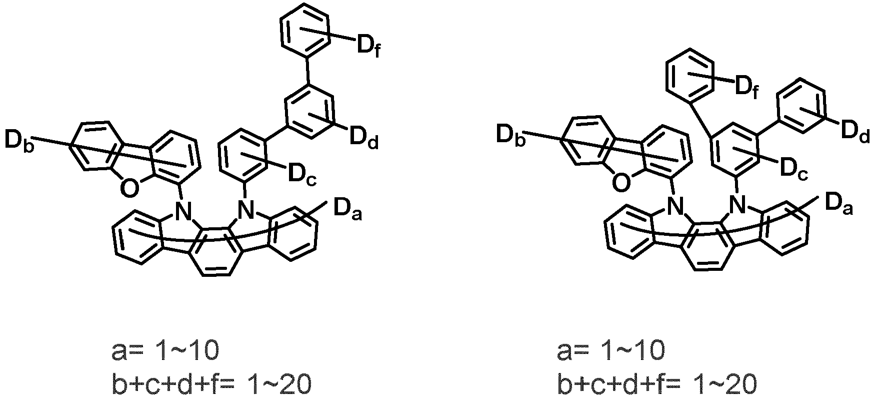

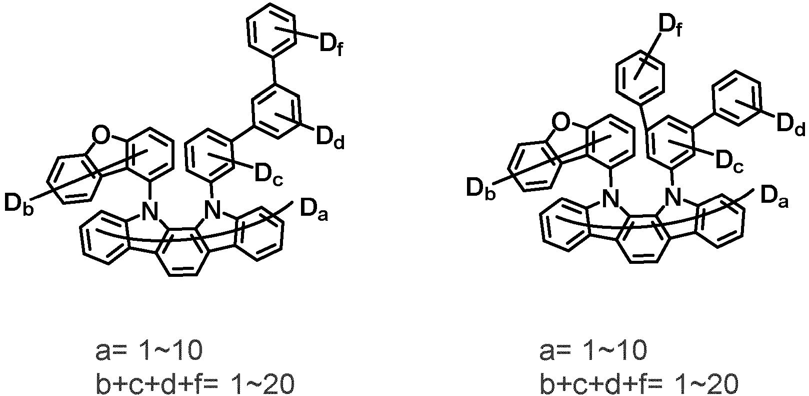

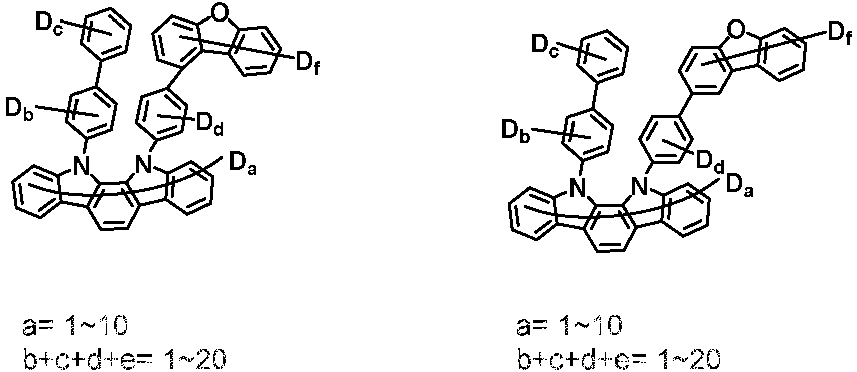

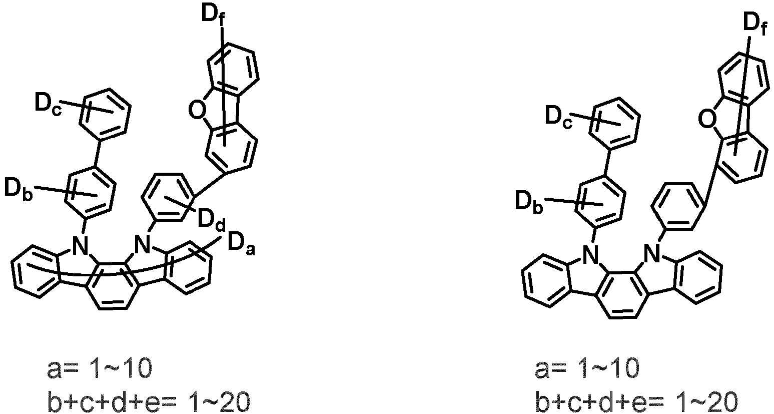

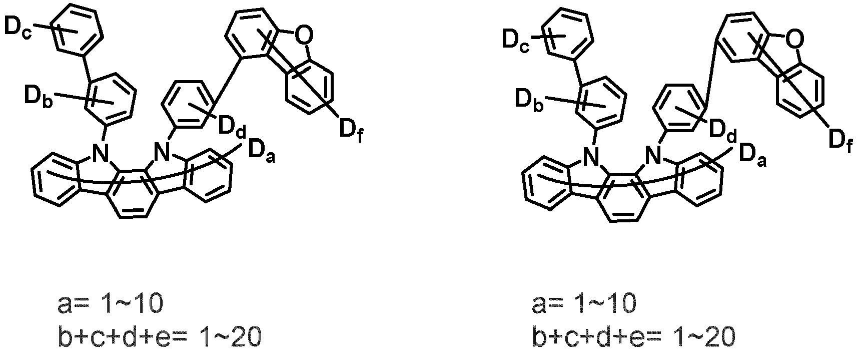

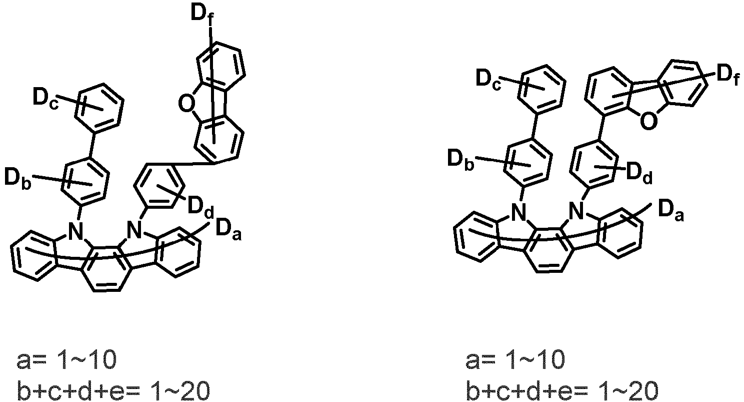

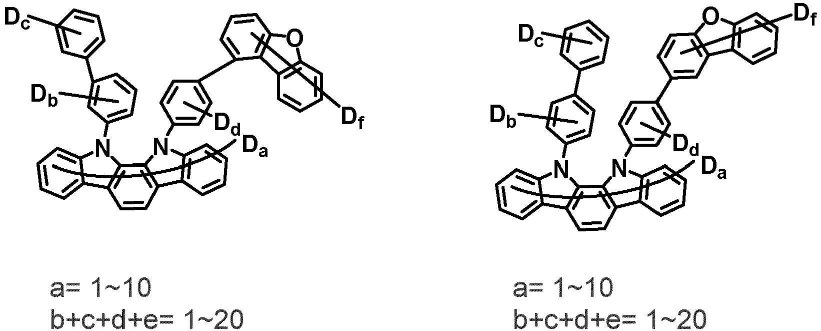

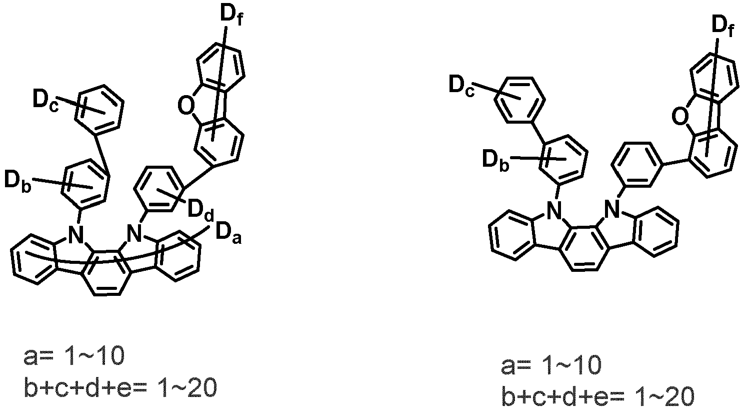

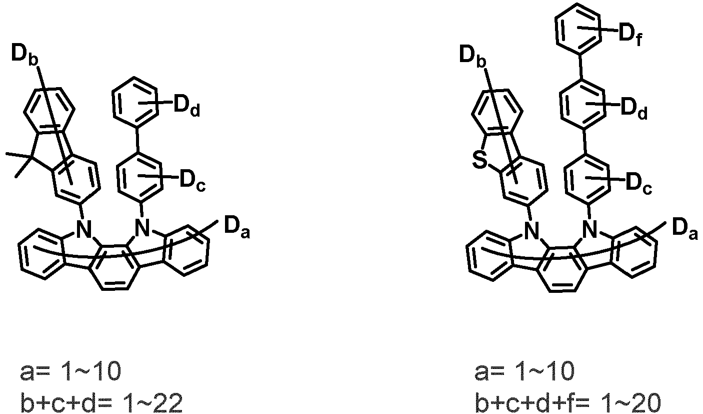

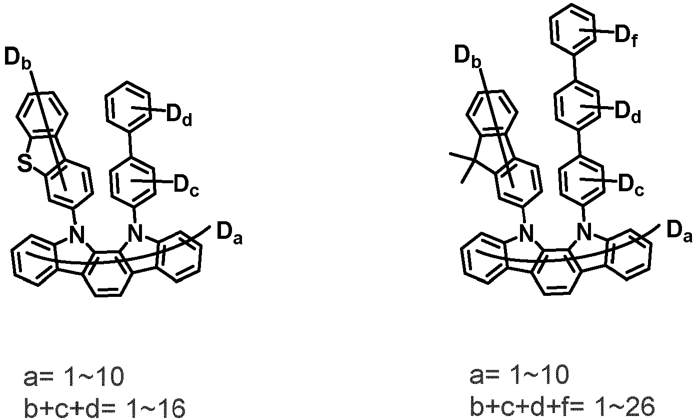

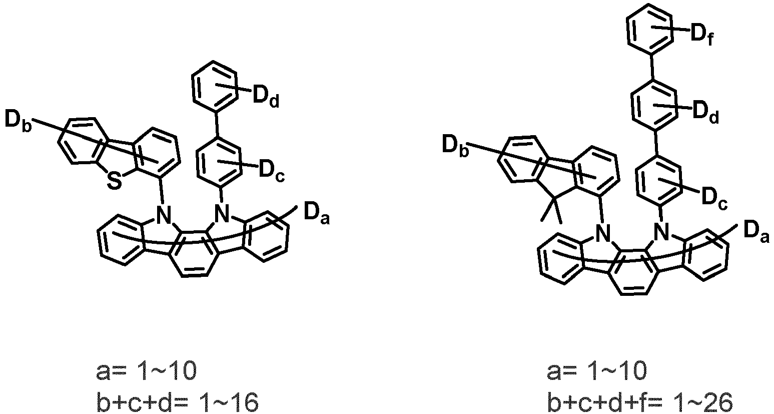

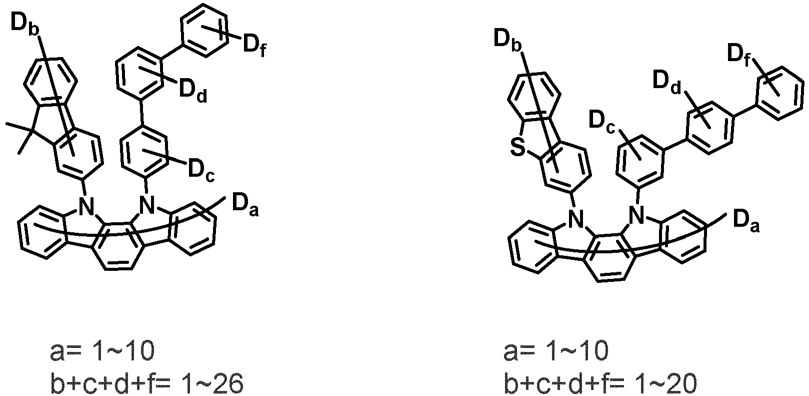

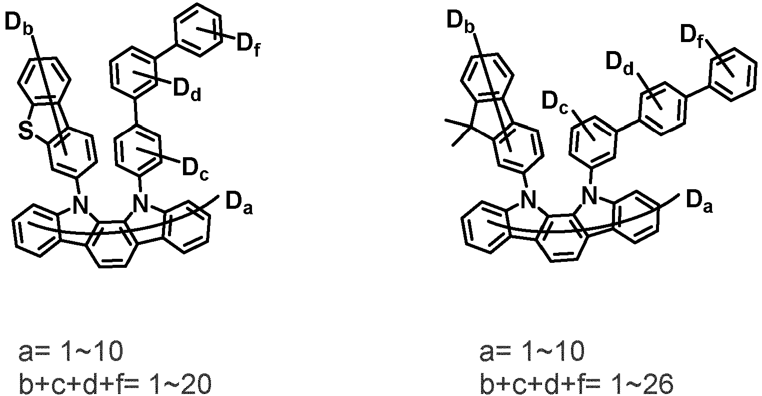

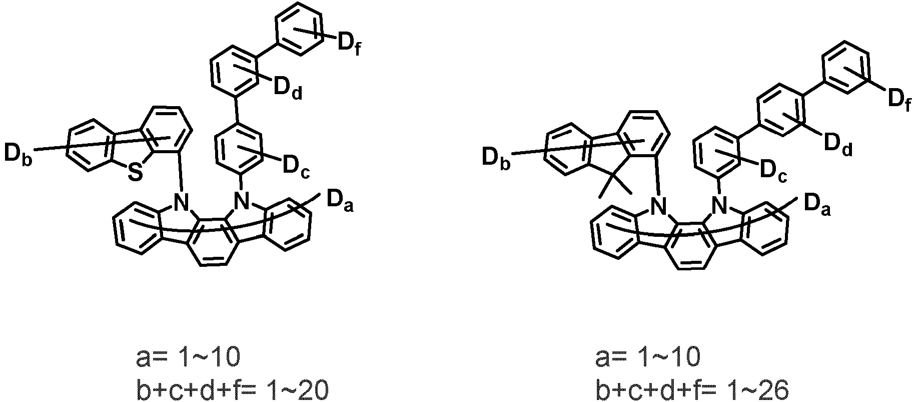

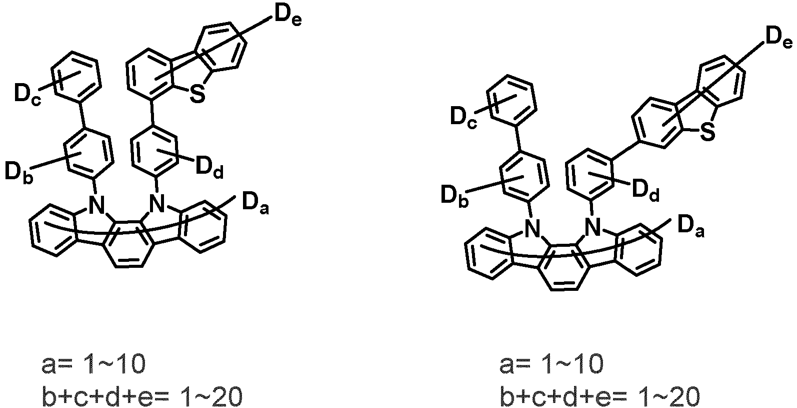

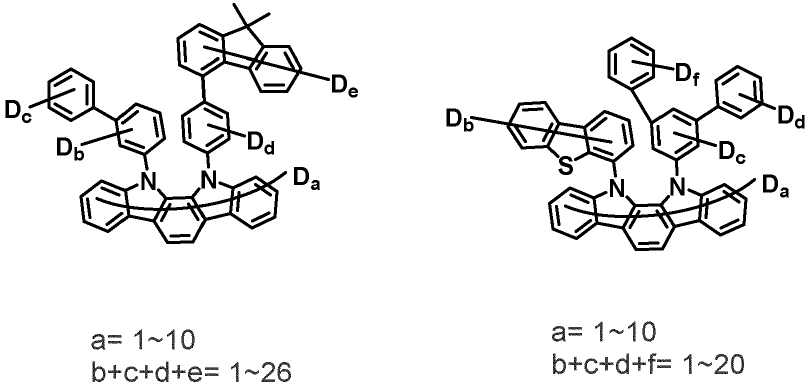

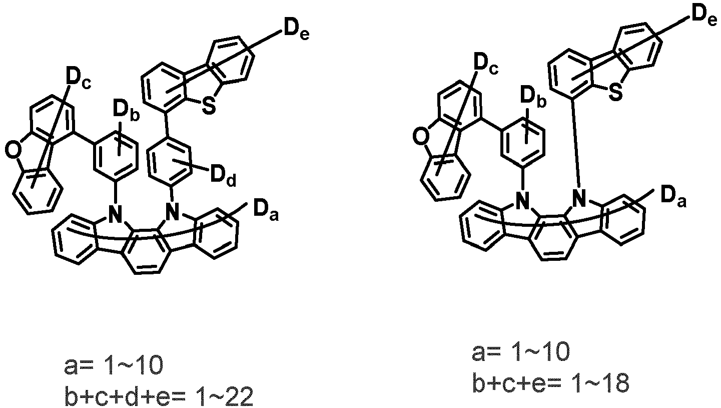

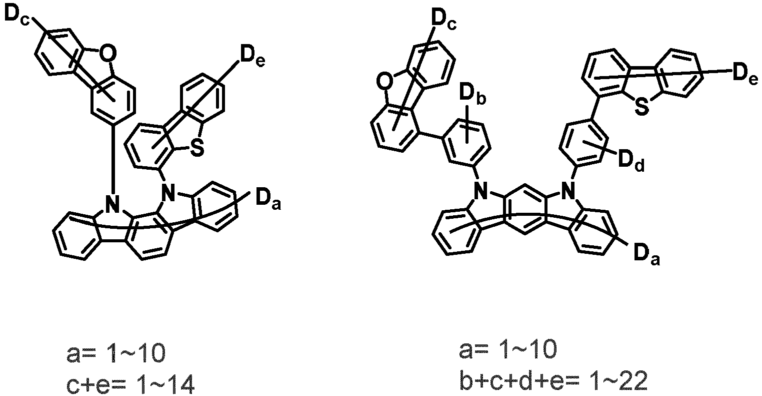

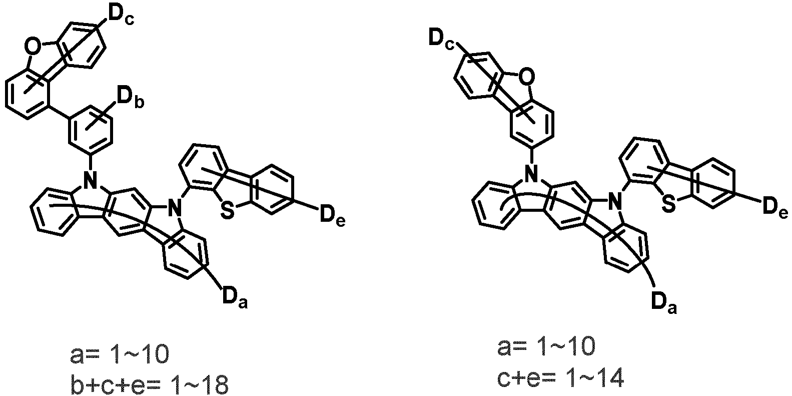

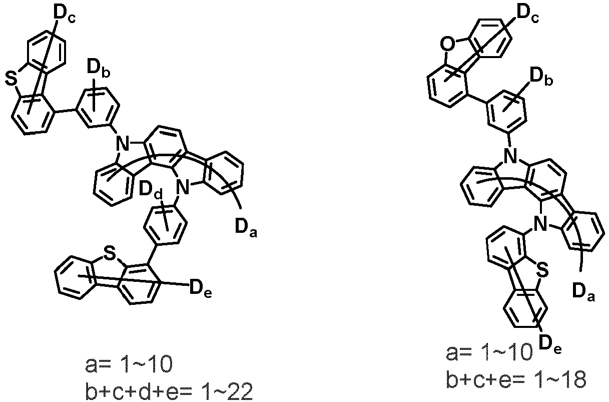

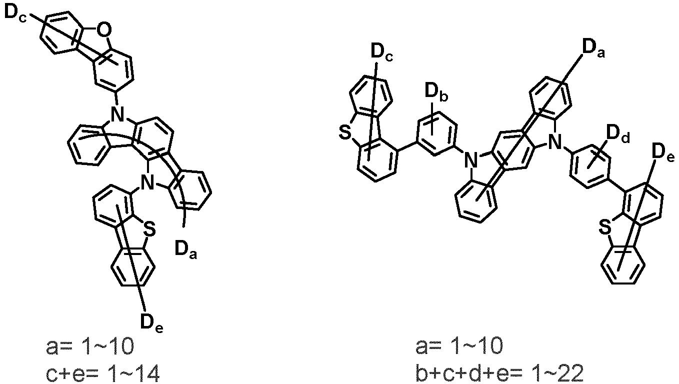

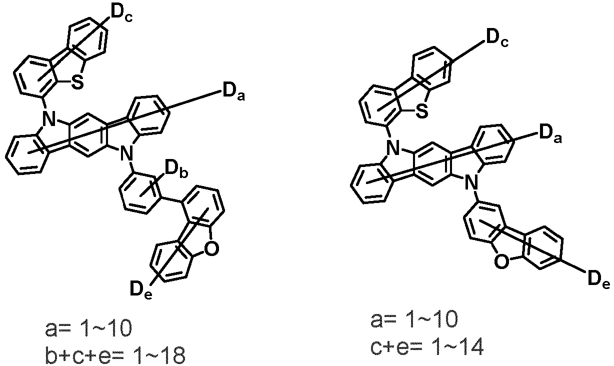

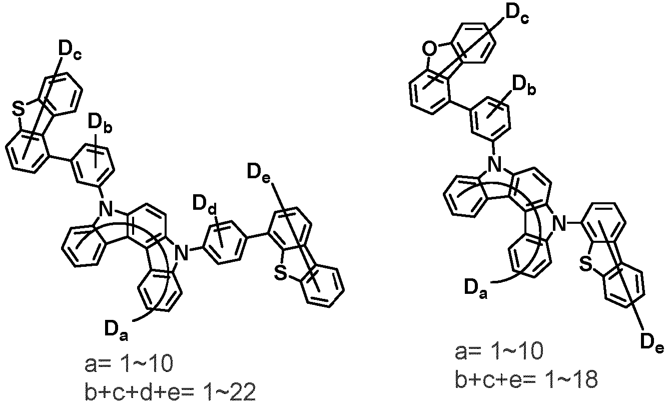

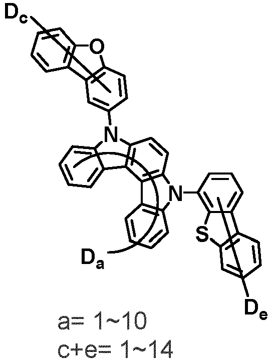

Meanwhile, the compound represented by Chemical Formula 2 may be prepared by, for example, a preparation method as shown in Reaction Scheme 2 below. The preparation method may be more specifically described in Synthesis Examples described below.

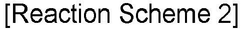

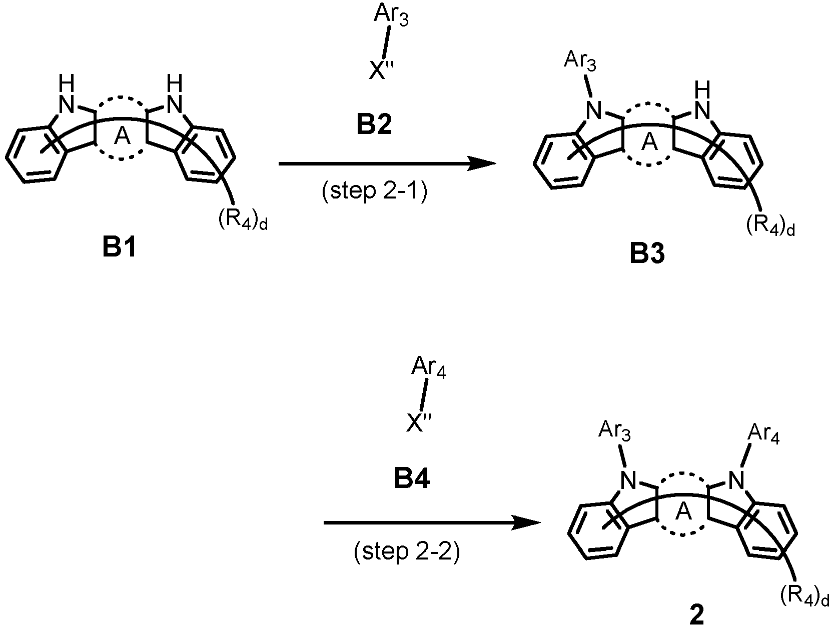

In Reaction Scheme 2, X"s are the same as or different from each other, and each independently represents halogen. Preferably, each X" is bromo or chloro, and more preferably, both are bromo. In the Reaction Scheme 2, the definitions of the other substituents are the same as described above.

Specifically, the compound represented by Chemical Formula 2 may be prepared through steps 2-1 and 2-2.

The step 2-1 is to prepare an intermediate compound B3 by an amine substitution reaction of a starting material B1 and the compound B2. Thereafter, the step 2-2 is to prepare the compound represented by Chemical Formula 2 by an amine substitution reaction of the intermediate compound B3 and the compound B4. The amine substitution reaction is preferably performed in the presence of a base or in the presence of a palladium catalyst and a base. In addition, the reactive group for the amine substitution reaction may also be appropriately changed as known in the art.

For example, in the Reaction Scheme 2, sodium tert-butoxide (NaOtBu), potassium carbonate (K₂CO₃), sodium bicarbonate (NaHCO₃), cesium carbonate (Cs₂CO₃), sodium acetate (NaOAc), potassium acetate (KOAc), sodium ethoxide (NaOEt), triethylamine (Et₃N), N,N-diisopropylethylamine (EtN(iPr)₂), or the like may be used as the base component. Preferably, the base component may be sodium tert-butoxide (NaOtBu), potassium carbonate (K₂CO₃), cesium carbonate (Cs₂CO₃), potassium acetate (KOAc), or N,N-diisopropylethylamine (EtN(iPr)₂). In particular, in the Reaction Scheme 2, sodium tert-butoxide (NaOtBu) may be used as the base component.

In addition, in the Reaction Scheme 2, bis(tri-(tert-butyl)phosphine)palladium(0) (Pd(P-tBu₃)₂), tetrakis(triphenylphosphine)palladium(0) (Pd(PPh₃)₄), tris(dibenzylideneacetone)-dipalladium(0) (Pd₂(dba)₃), bis(dibenzylideneacetone)palladium(0) (Pd(dba)₂), palladium(II) acetate (Pd(OAc)₂), or the like may be used as the palladium catalyst. Preferably, the palladium catalyst may be bis(tri-(tert-butyl)phosphine)palladium(0) (Pd(P-tBu₃)₂), tetrakis(triphenylphosphine)palladium(0) (Pd(PPh₃)₄), or bis(dibenzylideneacetone)palladium(0) (Pd(dba)₂). In particular, in the Reaction Scheme 2, bis(tri-(tert-butyl)phosphine)palladium(0) (Pd(P-tBu₃)₂) may be used as the palladium catalyst.

The method for preparing the compound represented by Chemical Formula 2 may be more specifically described in Synthesis Examples described below.

In addition, the first compound and the second compound may be included in the light emitting layer at a weight ratio of 1:9 to 9:1. When the first compound is included in the light emitting layer in an excessively small amount, electron transport in the light emitting layer is not smooth, and thus holes and electrons are not balanced throughout the device, which may cause problems in voltage, efficiency, and lifespan of the manufactured device. When the second compound is included in the light emitting layer in an excessively small amount compared to the first compound, there may be a problem in that the lifespan is reduced. For example, a weight ratio of the first compound and the second compound in the light emitting layer may be 2:8 to 8:2, 3:7 to 7:3, 4:6 to 6:4, or 4:6 to 5:5.

Meanwhile, the light emitting layer may further include a dopant material other than the two kinds of host materials. Examples of the dopant material include an aromatic amine derivative, a styrylamine compound, a boron complex, a fluoranthene compound, a metal complex, and the like. Specifically, the aromatic amine derivative is a substituted or unsubstituted fused aromatic ring derivative having an arylamino group, and examples thereof include pyrene, anthracene, chrysene, periflanthene and the like, which have an arylamino group. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, the metal complex includes an iridium complex, a platinum complex, and the like, but is not limited thereto. Specifically, the dopant material is an iridium-based metal complex.

For example, the light emitting layer may include a green dopant material. In particular, the combination of the compound of Chemical Formula 1 as a first host and the compound of Chemical Formula 2 as a second host may facilitate energy transfer to the green dopant in the green light emitting layer, and thus may reduce the driving voltage and increase efficiency and lifespan in the organic light emitting device.

Herein, the dopant material may be included in the light emitting layer in an amount of 1 to 25 wt% based on a total weight of the host material (the sum of the weight of the compound represented by Chemical Formula 1 and the weight of the compound represented by Chemical Formula 2) and the dopant material. For example, the dopant material may be included in an amount of 2 to 22 wt%, 5 to 20 wt%, 8 to 20 wt%, or 10 to 18 wt%.

### Hole blocking layer

The organic light emitting device according to the present disclosure may include a hole blocking layer between a light emitting layer and an electron transport layer (or an electron transport and injection layer) to be described later, if necessary.

The hole blocking layer means a layer which is formed on the light emitting layer, is preferably provided in contact with the light emitting layer, and thus serves to control electron mobility, to prevent excessive movement of holes, and to increase the probability of hole-electron bonding, thereby improving the efficiency of the organic light emitting device.

The hole blocking layer includes a hole blocking material, and as an example of such a hole blocking material, compounds having an electron attracting group such as azine-based derivatives including triazine; triazole derivatives; oxadiazole derivatives; phenanthroline derivatives; phosphine oxide derivatives may be used, but is not limited thereto.

### Electron transport layer

The organic light emitting device according to the present disclosure may include an electron transport layer on the light emitting layer (or on the hole blocking layer if there is a hole blocking layer), if necessary.

The electron transport layer receives electrons from a cathode or an electron injection layer formed on the cathode and transports the electrons to a light emitting layer. The electron transport layer includes an electron transport material, and the electron transport material is suitably a material which can receive electrons well from a cathode and transfer the electrons to a light emitting layer and has large mobility for electrons.

Specific examples of the electron transport material include: an Al complex of 8-hydroxyquinoline; a complex including Alq₃; an organic radical compound; a hydroxyflavone-metal complex; and the like, but are not limited thereto. The electron transport layer may be used with any desired cathode material, as used in the related art. In particular, appropriate examples of the cathode material are typical materials having a low work function, followed by an aluminum layer or a silver layer. Specific examples thereof include cesium, barium, calcium, ytterbium, and samarium, in each case followed by an aluminum layer or a silver layer.

### Electron transport and injection layer

The organic light emitting device according to the present disclosure may include an electron injection layer on the light emitting layer (or on the hole blocking layer if there is a hole blocking layer, or on the electron transport layer if there is an electron transport layer), if necessary. The organic light emitting device according to the present disclosure may include an electron transport and injection layer between a light emitting layer (or on the hole blocking layer if there is a hole blocking layer) and a cathode, if necessary.

The electron transport and injection layer is a layer that simultaneously serves as an electron transport layer and an electron injection layer by injecting electrons from an electrode and transferring the received electrons to a light emitting layer, and is formed on the light emitting layer or the electron blocking layer. An electron injection and transport material is suitably a material which can receive electrons well from a cathode and transfer the electrons to a light emitting layer and has large mobility for electrons. Specific examples of the electron injection and transport material include: an Al complex of 8-hydroxyquinoline; a complex including Alq₃; an organic radical compound; a hydroxyflavone-metal complex; a triazine derivative, and the like, but are not limited thereto. Alternatively, it may be used together with fluorenone, anthraquinodimethane, diphenoquinone, thiopyran dioxide, oxazole, oxadiazole, triazole, imidazole, perylenetetracarboxylic acid, fluorenylidene methane, anthrone, or derivatives thereof, a metal complex compound, a nitrogen-containing 5-membered ring derivative, or the like, but are not limited thereto.

The electron transport and injection layer may also be formed separately such as an electron injection layer and an electron transport layer. In this case, the electron transport layer is formed on the light emitting layer or the hole blocking layer, and the electron injection and transport material described above may be used as the electron transport material included in the electron transport layer. In addition, the electron injection layer is formed on the electron transport layer, and the electron injection material included in the electron injection layer may include LiF, NaCl, CsF, Li2O, BaO, fluorenone, anthraquinodimethane, diphenoquinone, thiopyran dioxide, oxazole, oxadiazole, triazole, imidazole, perylenetetracarboxylic acid, fluorenylidene methane, anthrone, and derivatives thereof, a metal complex compound, a nitrogen-containing 5-membered ring derivative, and the like.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

### Organic light emitting device

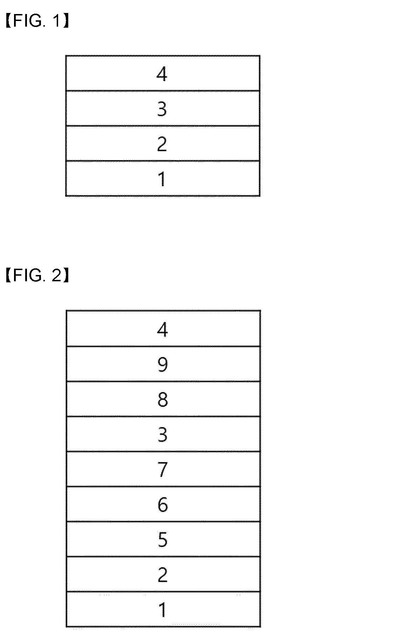

A structure of the organic light emitting device according to the present disclosure is illustrated in FIG. 1. FIG. 1 shows an example of an organic light emitting device including a substrate 1, an anode 2, a light emitting layer 3, and a cathode 4. In such a structure, the first compound and the second compound may be included in the light emitting layer.

The organic light emitting device according to the present disclosure may be manufactured by sequentially laminating the above-described components. In this case, the organic light emitting device may be manufactured by depositing a metal, metal oxides having conductivity, or an alloy thereof on the substrate using a PVD (physical vapor deposition) method such as a sputtering method or an e-beam evaporation method to form an anode, forming the above-mentioned respective layers thereon, and then depositing a material that can be used as the cathode thereon. In addition to such a method, the organic light emitting device may be manufactured by sequentially depositing the above-described components from a cathode material to an anode material in the reverse order on a substrate (WO 2003/012890). Further, the light emitting layer may be formed using the host and the dopant by a solution coating method as well as a vacuum deposition method. Herein, the solution coating method means a spin coating, a dip coating, a doctor blading, an inkjet printing, a screen printing, a spray method, a roll coating, or the like, but is not limited thereto.

In addition to such a method, the organic light emitting device may be manufactured by sequentially depositing a cathode material, an organic material layer and an anode material on a substrate (International Publication WO2003/012890). However, the manufacturing method is not limited thereto.

The organic light emitting device according to the present disclosure may be a bottom emission device, a top emission device, or a double-sided light emitting device, and in particular, may be a bottom emission device requiring relatively high luminous efficiency.

Hereinafter, it will be described in more detail to help the understanding of the present invention. However, the following examples are presented for illustrative purposes only, and are not intended to limit the scope of the present invention.

### [Examples]

### (Preparation of first compound)

### Synthesis Example 1: Synthesis of Compound 1-1

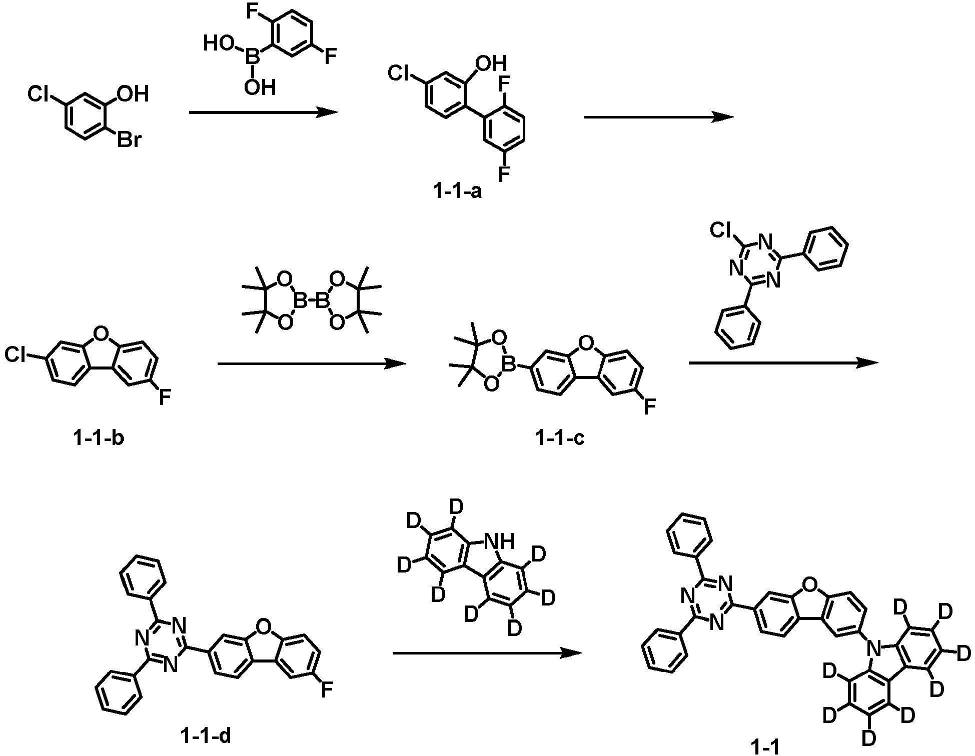

### Step 1) Synthesis of Compound 1-1-a

2-bromo-5-chlorophenol (20 g, 96.4 mmol) and (2,5-difluorophenyl)boronic acid (15.2 g, 96.4 mmol) were added to 400 ml of tetrahydrofuran under a nitrogen atmosphere, and the mixture was stirred and refluxed. Then, potassium carbonate (40 g, 289.2 mmol) was dissolved in 40 ml of water, and then added thereto. Thereafter, it was stirred sufficiently, followed by adding tetrakis(triphenylphosphine)palladium (3.3 g, 2.9 mmol). After 1 hour of reaction, cooling was performed to room temperature. Then, the organic layer was separated from the water layer, and then the organic layer was distilled to remove the solvent. Then, this was dissolved again in 464 mL of chloroform corresponding to 20 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-1-a in the form of white solid (16.2 g, 70%, MS: [M+H]⁺ = 241.6).

### Step 2) Synthesis of Compound 1-1-b

The Compound 1-1-a (20 g, 83.1 mmol) was added to 400 mL of dimethylformamide under a nitrogen atmosphere, and the mixture was stirred and refluxed. Then, cesium carbonate (81.2 g, 249.3 mmol) was added thereto, followed by heating and stirring. After 3 hours of reaction, cooling was performed to room temperature, and the resulting solid was filtered. Then, the solid was dissolved in 550 mL of chloroform corresponding to 30 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-1-b in the form of white solid (13.2 g, 72%, MS: [M+H]⁺ = 221.6).

### Step 3) Synthesis of Compound 1-1-c

The Compound 1-1-b (20 g, 90.6 mmol) and bis(pinacolato)diboron (23 g, 90.6 mmol) were added to 400 mL of 1,4-dioxane under a nitrogen atmosphere, and the mixture was stirred and refluxed. Thereafter, potassium acetate (57.7 g, 271.9 mmol) was added thereto, and sufficiently stirred, followed by adding bis(dibenzylideneacetone)palladium (1.6 g, 2.7 mmol) and tricyclohexylphosphine (1.5 g, 5.4 mmol). After 7 hours of reaction, cooling was performed to room temperature, the organic layer was filtered to remove the salt, and the filtered organic layer was distilled to remove the solvent. Then, this was dissolved again in 283 mL of chloroform corresponding to 10 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethanol to prepare Compound 1-1-c in the form of white solid (20.9 g, 74%, MS: [M+H]⁺ = 313.2).

### Step 4) Synthesis of Compound 1-1-d

The Compound 1-1-c (20 g, 64.1 mmol) and 2-chloro-4,6-diphenyl-1,3,5-triazine (17.2 g, 64.1 mmol) were added to 400 ml of tetrahydrofuran under a nitrogen atmosphere, and the mixture was stirred and refluxed. Then, potassium carbonate (26.6 g, 192.2 mmol) was dissolved in 27 ml of water, and then added thereto. Thereafter, it was stirred sufficiently, followed by adding tetrakis(triphenylphosphine)palladium (2.2 g, 1.9 mmol). After 3 hours of reaction, cooling was performed to room temperature. Then, the organic layer was separated from the water layer, and then the organic layer was distilled to remove the solvent. Then, this was dissolved again in 535 mL of chloroform corresponding to 20 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-1-d in the form of white solid (19.3 g, 72%, MS: [M+H]⁺ = 418.4).

### Step 5) Synthesis of Compound 1-1

The Compound 1-1-d (20 g, 47.9 mmol) and 9H-carbazole-1,2,3,4,5,6,7,8-d8 (8.4 g, 47.9 mmol) were added to 400 mL of dimethylformamide under a nitrogen atmosphere, and the mixture was stirred and refluxed. Then, cesium carbonate (46.8 g, 143.7 mmol) was added thereto, followed by heating and stirring. After 3 hours of reaction, cooling was performed to room temperature, and the resulting solid was filtered. Then, the solid was dissolved in 823 mL of chloroform corresponding to 30 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-1 in the form of white solid (20.9 g, 76%, MS: [M+H]⁺ = 573.7).

### Synthesis Example 2: Synthesis of Compound 1-2

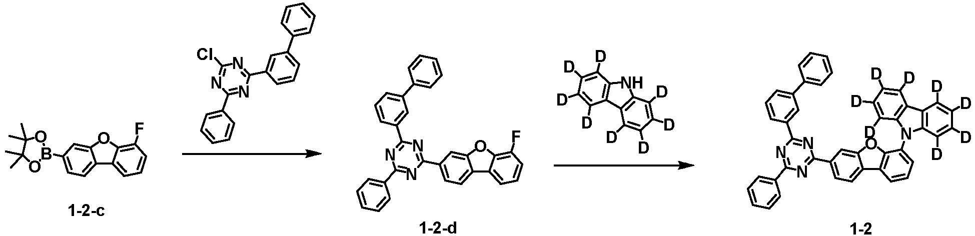

Compound 1-2 (MS: [M+H]⁺ = 649.8) was prepared in the same manner as in the preparation of Compound 1-1 in Synthesis Example 1, except that (2,6-difluorophenyl)boronic acid and 2-([1,1'-biphenyl]-3-yl)-4-chloro-6-phenyl-1,3,5-triazine was used instead of (2,5-difluorophenyl)boronic acid and 2-chloro-4,6-diphenyl-1,3,5-triazine, respectively, in Synthesis Example 1.

### Synthesis Example 3: Synthesis of Compound 1-3

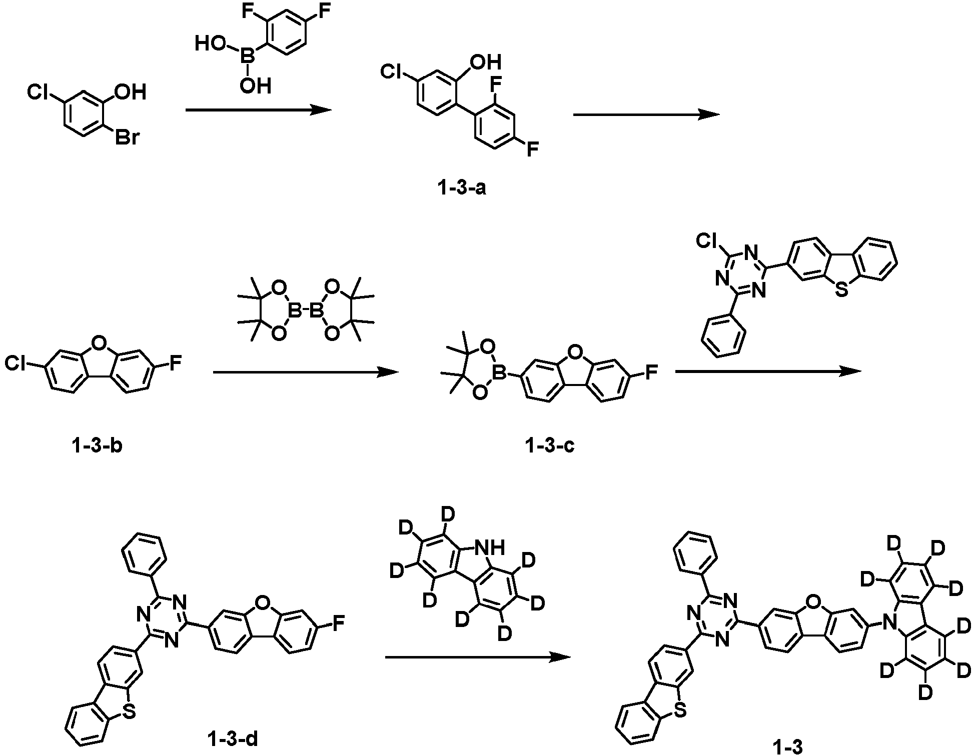

Compound 1-3 (MS: [M+H]⁺ = 679.8) was prepared in the same manner as in the preparation of Compound 1-1 in Synthesis Example 1, except that (2,4-difluorophenyl)boronic acid and 2-chloro-4-(dibenzo[b,d]thiophen-3-yl)-6-phenyl-1,3,5-triazine were used instead of (2,5-difluorophenyl)boronic acid and 2-chloro-4,6-diphenyl-1,3,5-triazine, respectively, in Synthesis Example 1.

### Synthesis Example 4: Synthesis of Compound 1-4

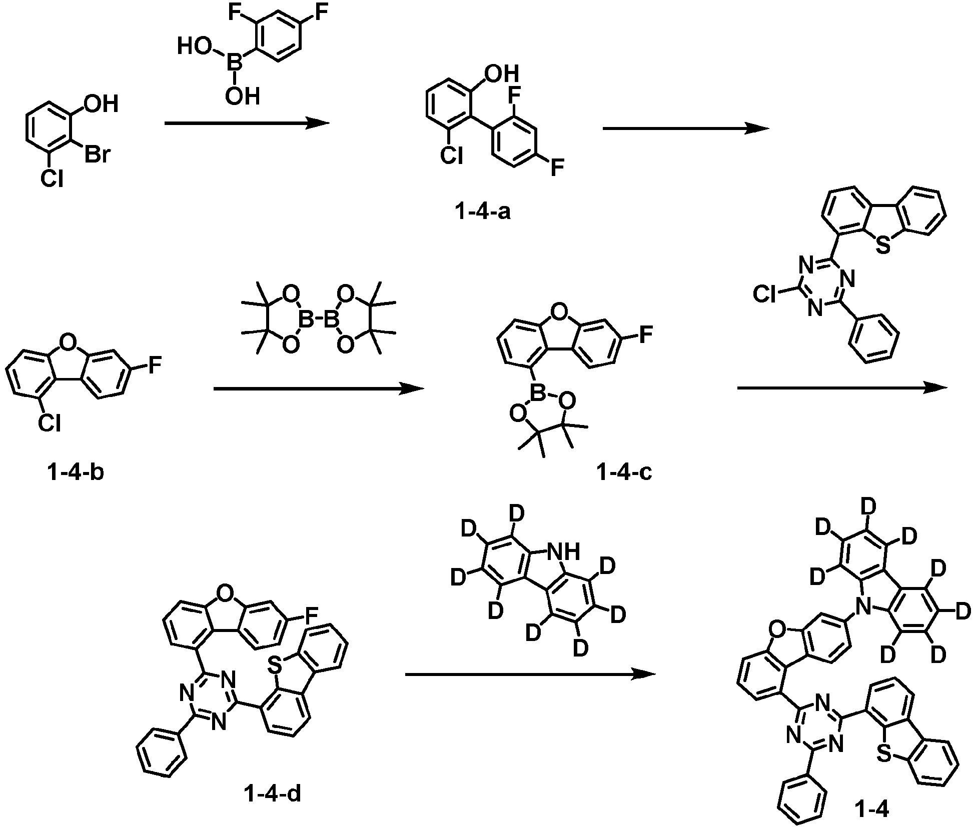

Compound 1-4 (MS: [M+H]⁺ = 679.8) was prepared in the same manner as in the preparation of Compound 1-1 in Synthesis Example 1, except that 2-bromo-3-chlorophenol, (2,4-difluorophenyl)boronic acid and 2-chloro-4-(dibenzo[b,d]thiophen-4-yl)-6-phenyl-1,3,5-triazine were used instead of 2-bromo-5-chlorophenol, (2,5-difluorophenyl)boronic acid and 2-chloro-4,6-diphenyl-1,3,5-triazine, respectively, in Synthesis Example 1.

### Synthesis Example 5: Synthesis of Compound 1-5

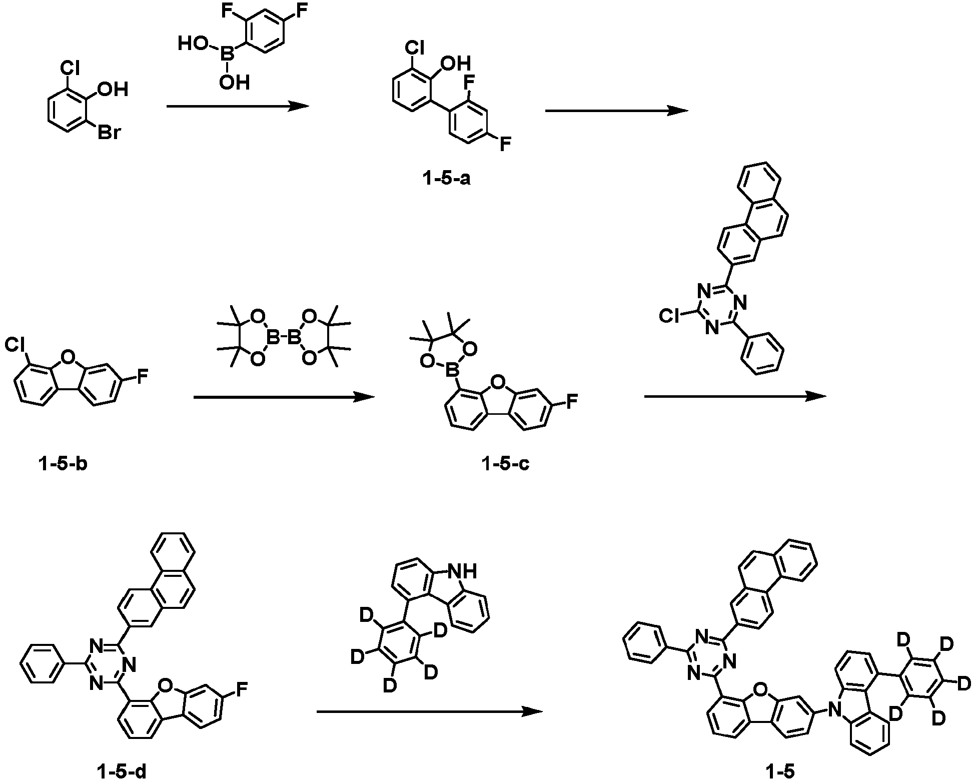

Compound 1-5 (MS: [M+H]⁺ = 746.9) was prepared in the same manner as in the preparation of Compound 1-1 in Synthesis Example 1, except that 2-bromo-6-chlorophenol, (2,4-difluorophenyl)boronic acid, 2-chloro-4-(phenanthren-2-yl)-6-phenyl-1,3,5-triazine and 4-(phenyl-d5)-9H-carbazole were used instead of 2-bromo-5-chlorophenol, (2,5-difluorophenyl)boronic acid, 2-chloro-4,6-diphenyl-1,3,5-triazine, and 9H-carbazole-1,2,3,4,5,6,7,8-d8, respectively, in Synthesis Example 1.

### Synthesis Example 6: Synthesis of Compound 1-6

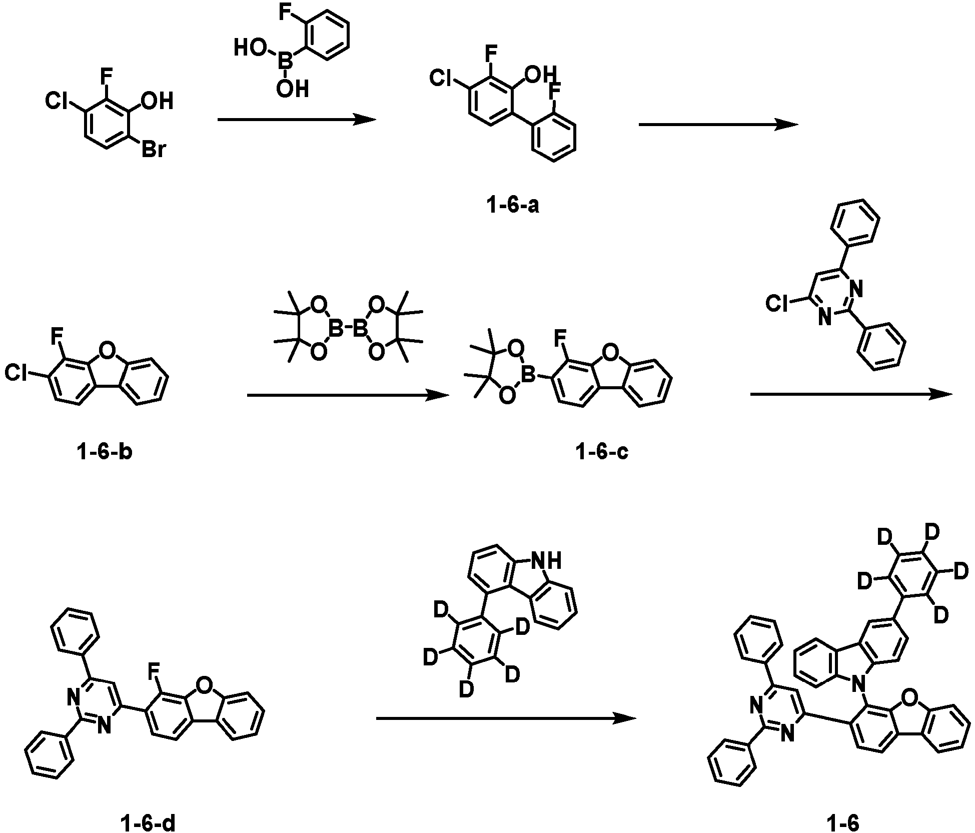

Compound 1-6 (MS: [M+H]⁺ = 645.8) was prepared in the same manner as in the preparation of Compound 1-1 in Synthesis Example 1, except that 6-bromo-3-chloro-2-fluorophenol, (2-fluorophenyl)boronic acid, 4-chloro-2,6-diphenylpyrimidine and 4-(phenyl-d5)-9H-carbazole were used instead of 2-bromo-5-chlorophenol, (2,5-difluorophenyl)boronic acid, 2-chloro-4,6-diphenyl-1,3,5-triazine, and 9H-carbazole-1,2,3,4,5,6,7,8-d8, respectively, in Synthesis Example 1.

### Synthesis Example 7: Synthesis of Compound 1-7

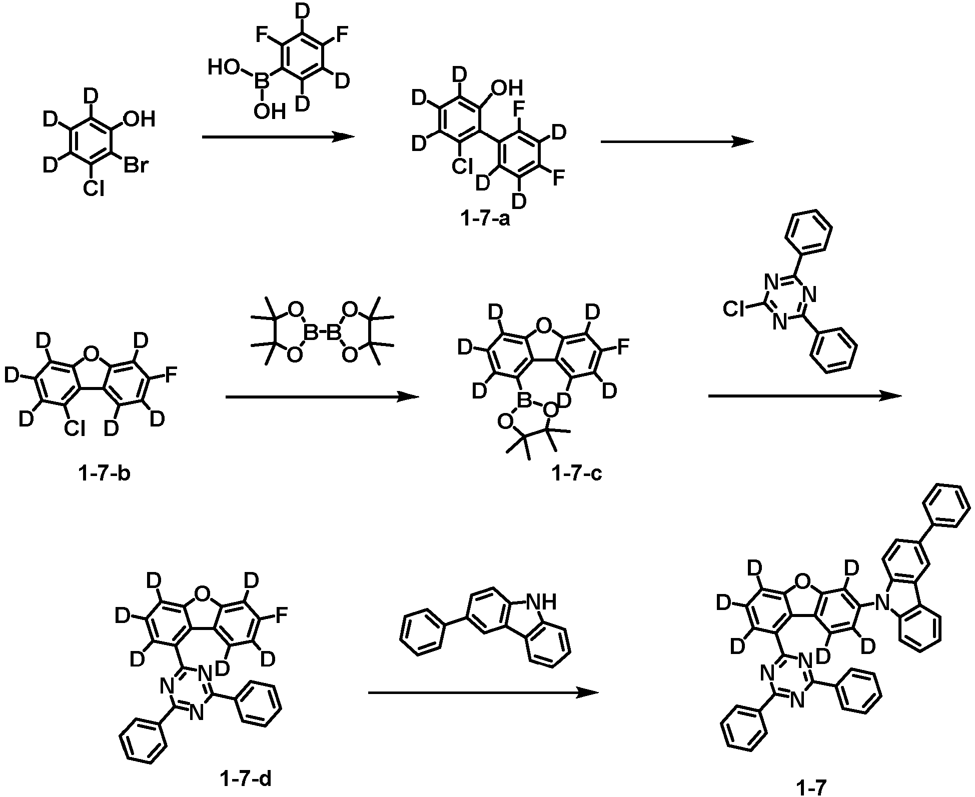

Compound 1-7 (MS: [M+H]⁺ = 647.8) was prepared in the same manner as in the preparation of Compound 1-1 in Synthesis Example 1, except that 2-bromo-3-chlorophe-4,5,6-d3-nol, (2,4-difluorophenyl-3,5,6-d3)boronic acid and 3-phenyl-9H-carbazole were used instead of 2-bromo-5-chlorophenol, (2,5-difluorophenyl)boronic acid, and 9H-carbazole-1,2,3,4,5,6,7,8-d8, respectively, in Synthesis Example 1.

### Synthesis Example 8: Synthesis of Compound 1-8

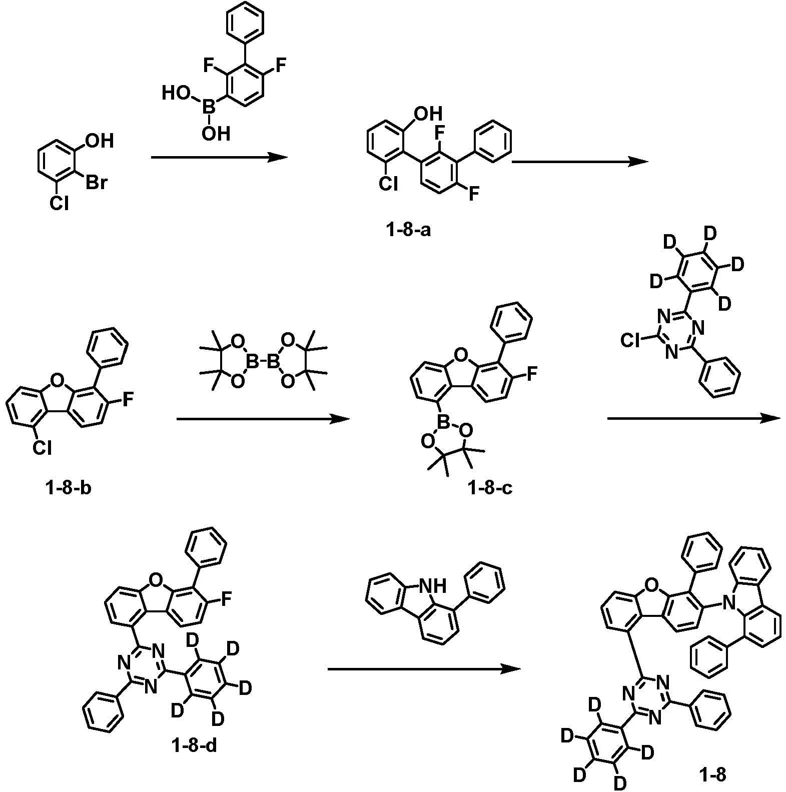

Compound 1-8 (MS: [M+H]⁺ = 722.8) was prepared in the same manner as in the preparation of Compound 1-1 in Synthesis Example 1, except that 2-bromo-3-chlorophenol, (2,6-difluoro-[1,1'-biphenyl]-3-yl)boronic acid, 2-chloro-4-phenyl-6-(phenyl-d5)-1,3,5-triazine and 1-phenyl-9H-carbazole were used instead of 2-bromo-5-chlorophenol, (2,5-difluorophenyl)boronic acid, 2-chloro-4,6-diphenyl-1,3,5-triazine, and 9H-carbazole-1,2,3,4,5,6,7,8-d8, respectively, in Synthesis Example 1.

### Synthesis Example 9: Synthesis of Compound 1-9

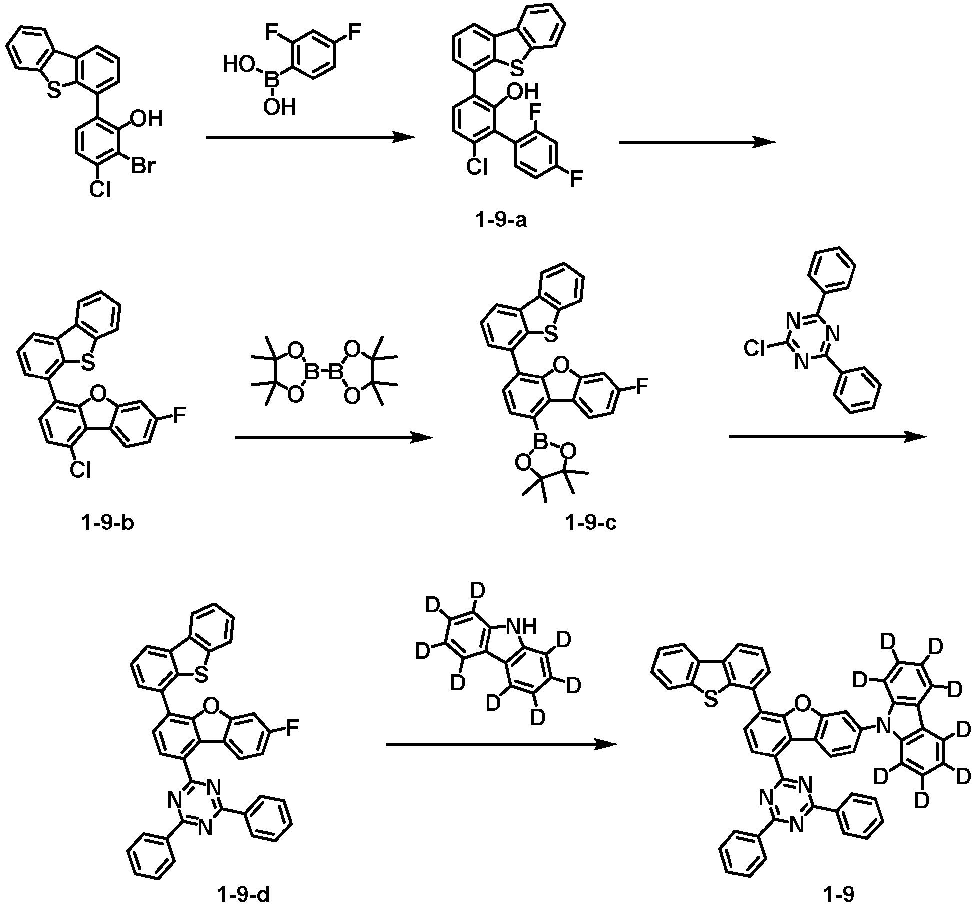

Compound 1-9 (MS: [M+H]⁺ = 755.9) was prepared in the same manner as in the preparation of Compound 1-1 in Synthesis Example 1, except that 2-bromo-3-chloro-6-(dibenzo[b,d]thiophen-4-yl)phenol and (2,4-difluorophenyl)boronic acid were used instead of 2-bromo-5-chlorophenol and (2,5-difluorophenyl)boronic acid, respectively, in Synthesis Example 1.

### Synthesis Example 10: Synthesis of Compound 1-10

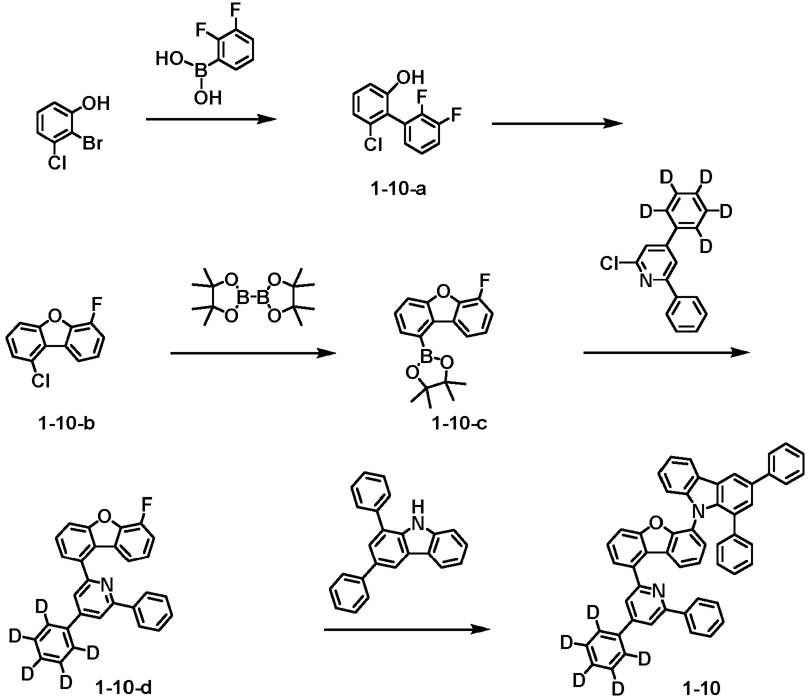

Compound 1-10 (MS: [M+H]⁺ = 720.9) was prepared in the same manner as in the preparation of Compound 1-1 in Synthesis Example 1, except that 2-bromo-3-chlorophenol, (2,3-difluorophenyl)boronic acid, 2-chloro-6-phenyl-4-(phenyl-d5)pyridine and 1,3-diphenyl-9H-carbazole were used instead of 2-bromo-5-chlorophenol, (2,5-difluorophenyl)boronic acid, 2-chloro-4,6-diphenyl-1,3,5-triazine, and 9H-carbazole-1,2,3,4,5,6,7,8-d8, respectively, in Synthesis Example 1.

### Synthesis Example 11: Synthesis of Compound 1-11

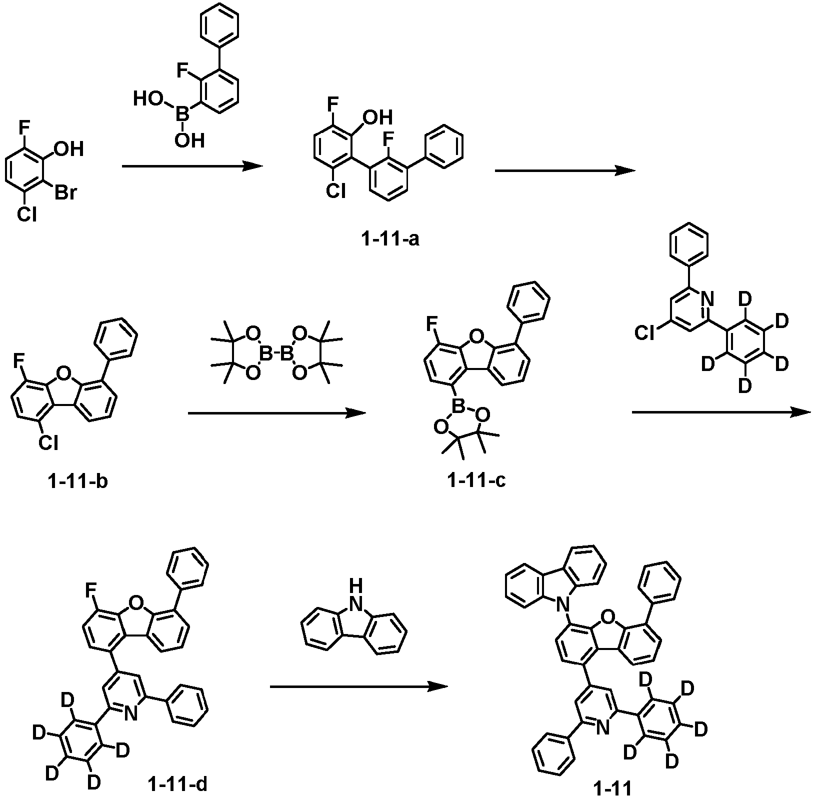

Compound 1-11 (MS: [M+H]⁺ = 644.7) was prepared in the same manner as in the preparation of Compound 1-1 in Synthesis Example 1, except that 2-bromo-3-chloro-6-fluorophenol, (2-fluoro-[1,1'-biphenyl]-3-yl)boronic acid, 4-chloro-6-phenyl-2-(phenyl-d5)pyridine and 9H-carbazole were used instead of 2-bromo-5-chlorophenol, (2,5-difluorophenyl)boronic acid, 2-chloro-4,6-diphenyl-1,3,5-triazine, and 9H-carbazole-1,2,3,4,5,6,7,8-d8, respectively, in Synthesis Example 1.

### Synthesis Example 12: Synthesis of Compound 1-12

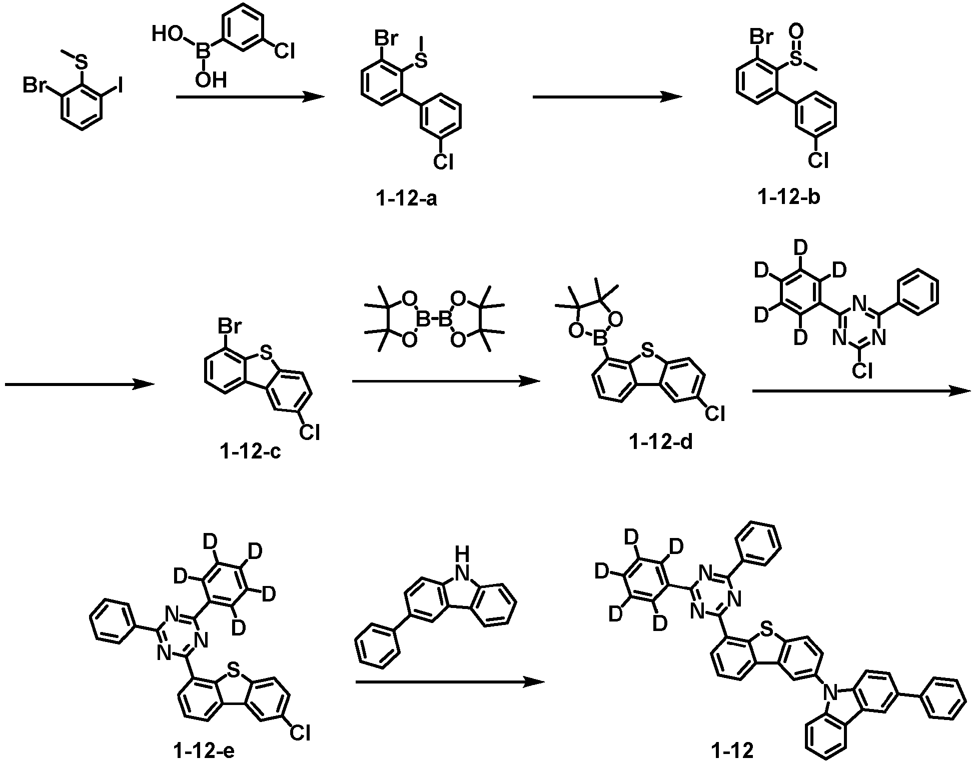

### Step 1) Synthesis of Compound 1-12-a

1-bromo-3-iodo-2-(methylthio)benzene (100 g, 304 mmol) and (3-chlorophenyl)boronic acid (47.5 g, 304 mmol) were added to 2000 ml of tetrahydrofuran under a nitrogen atmosphere, and the mixture was stirred and refluxed. Then, potassium carbonate (126 g, 911.9 mmol) was dissolved in 126 ml of water, and then added thereto. Thereafter, it was stirred sufficiently, followed by adding tetrakis(triphenylphosphine)palladium (10.5 g, 9.1 mmol). After 1 hour of reaction, cooling was performed to room temperature. Then, the organic layer was separated from the water layer, and then the organic layer was distilled to remove the solvent. Then, this was dissolved again in 1907 mL of chloroform corresponding to 20 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-12-a in the form of white solid (81 g, 85%, MS: [M+H]⁺ = 314.6).

### Step 2) Synthesis of Compound 1-12-b

The Compound 1-12-a (78.7 g, 252.3 mmol) was dissolved in 750 mL of acetic acid under a nitrogen atmosphere, and then cooled to 0 °C. 35% hydrogen peroxide (8.6 g, 252.3 mmol) was added thereto, and stirred at room temperature for 2 hours. When the reaction was completed, water was added for neutralization. Then, the organic layer was separated, treated with anhydrous magnesium sulfate, stirred, then filtered, and the filtrate was distilled under reduced pressure to prepare Compound 1-12-b (72 g, 87%, MS: [M+H]⁺ = 328.9).

### Step 3) Synthesis of Compound 1-12-c

The Compound 1-12-b (72.0 g, 219.6 mmol) and 290 mL of sulfuric acid were added to a flask at 5 °C, and the temperature was gradually increased while stirring, followed by stirring at room temperature for 1.5 hours. After the reaction, it was added dropwise to 3000 mL of ice water, and neutralized with an aqueous potassium carbonate solution. Then, the organic layer was separated using ethyl acetate, treated with anhydrous magnesium sulfate, stirred, then filtered, and the filtrate was distilled under reduced pressure to prepare Compound 1-12-c (40.3 g, 62%, MS: [M+H]⁺ = 296.9).

### Step 4) Synthesis of Compound 1-12-d

The Compound 1-12-c (40 g, 134.4 mmol) and bis(pinacolato)diboron (34.1 g, 134.4 mmol) were added to 800 mL of 1,4-dioxane under a nitrogen atmosphere, and the mixture was stirred and refluxed. Thereafter, potassium acetate (85.6 g, 403.2 mmol) was added thereto, and sufficiently stirred, followed by adding bis(dibenzylideneacetone)palladium (2.3 g, 4 mmol) and tricyclohexylphosphine (2.3 g, 8.1 mmol). After 5 hours of reaction, cooling was performed to room temperature, the organic layer was filtered to remove the salt, and the filtered organic layer was distilled to remove the solvent. Then, this was dissolved again in 463 mL of chloroform corresponding to 10 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethanol to prepare Compound 1-12-d in the form of white solid (23.2 g, 50%, MS: [M+H]⁺ = 345.7).

### Step 5) Synthesis of Compound 1-12-e

The Compound 1-12-d (23 g, 66.7 mmol) and 2-chloro-4-phenyl-6-(phenyl-d5)-1,3,5-triazine (18.2 g, 66.7 mmol) were added to 460 ml of tetrahydrofuran under a nitrogen atmosphere, and the mixture was stirred and refluxed. Then, potassium carbonate (27.7 g, 200.2 mmol) was dissolved in 28 ml of water, and then added thereto. Thereafter, it was stirred sufficiently, followed by adding tetrakis(triphenylphosphine)palladium (2.3 g, 2 mmol). After 2 hours of reaction, cooling was performed to room temperature. Then, the organic layer was separated from the water layer, and then the organic layer was distilled to remove the solvent. Then, this was dissolved again in 606 mL of chloroform corresponding to 20 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-12-e in the form of yellow solid (21.5 g, 71%, MS: [M+H]⁺ = 455.1).

### Step 6) Synthesis of Compound 1-12

The Compound 1-12-e (20 g, 44 mmol) and 3-phenyl-9H-carbazole (10.7 g, 44 mmol) were added to 400 mL of xylene under a nitrogen atmosphere, and the mixture was stirred and refluxed. Then, sodium tert-butoxide (12.7 g, 131.9 mmol) was added thereto, and sufficiently stirred, followed by adding bis(tri-tertiary-butylphosphine)palladium (0.7 g, 1.3 mmol). After 4 hours of reaction, cooling was performed to room temperature, the organic layer was filtered to remove the salt, and the filtered organic layer was distilled to remove the solvent. Then, this was dissolved again in 291 mL of chloroform corresponding to 10 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 1-12 in the form of yellow solid (19.2 g, 66%, MS: [M+H]⁺ = 662.2).

### Synthesis Example 13: Synthesis of Compound 1-13

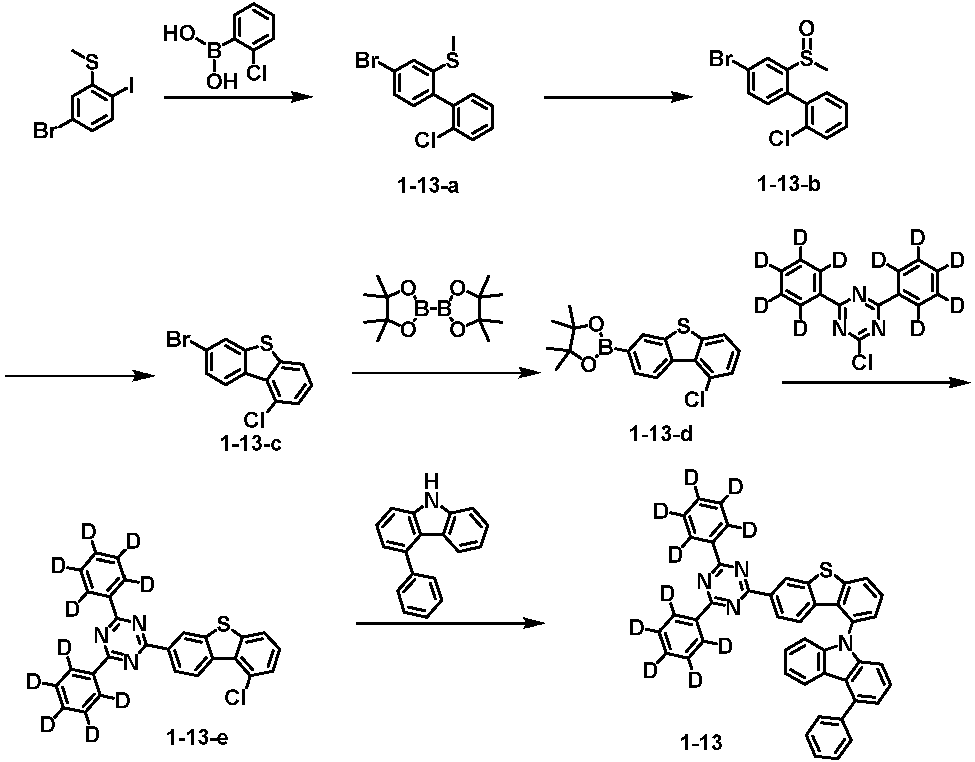

Compound 1-13 (MS: [M+H]⁺ = 667.3) was prepared in the same manner as in the preparation of Compound 1-12 in Synthesis Example 12, except that 1-bromo-4-iodo-3-(methylthio)benzene, (2-chlorophenyl)boronic acid, 2-chloro-4,6-bis(phenyl-d5)-1,3,5-triazine and 3-phenyl-9H-carbazole were used instead of 1-bromo-3-iodo-2-(methylthio)benzene, (3-chlorophenyl)boronic acid, 2-chloro-4-phenyl-6-(phenyl-d5)-1,3,5-triazine and 4-phenyl-9H-carbazole, respectively, in Synthesis Example 12.

### Synthesis Example 14: Synthesis of Compound 1-14

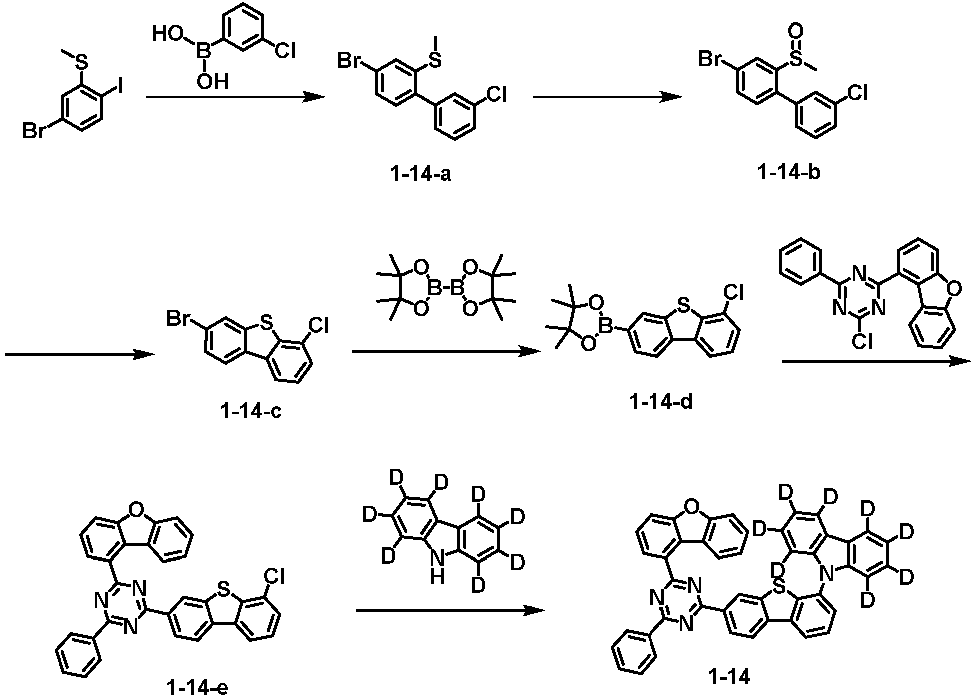

Compound 1-14 (MS: [M+H]⁺ = 679.3) was prepared in the same manner as in the preparation of Compound 1-12 in Synthesis Example 12, except that 4-bromo-1-iodo-2-(methylthio)benzene, (3-chlorophenyl)boronic acid, 2-chloro-4-(dibenzo[b,d]furan-1-yl)-6-phenyl-1,3,5-triazine and 9H-carbazole-1,2,3,4,5,6,7,8-d8 were used instead of 1-bromo-3-iodo-2-(methylthio)benzene, (3-chlorophenyl)boronic acid, 2-chloro-4-phenyl-6-(phenyl-d5)-1,3,5-triazine and 3-phenyl-9H-carbazole, respectively, in Synthesis Example 12.

### Synthesis Example 15: Synthesis of Compound 1-15

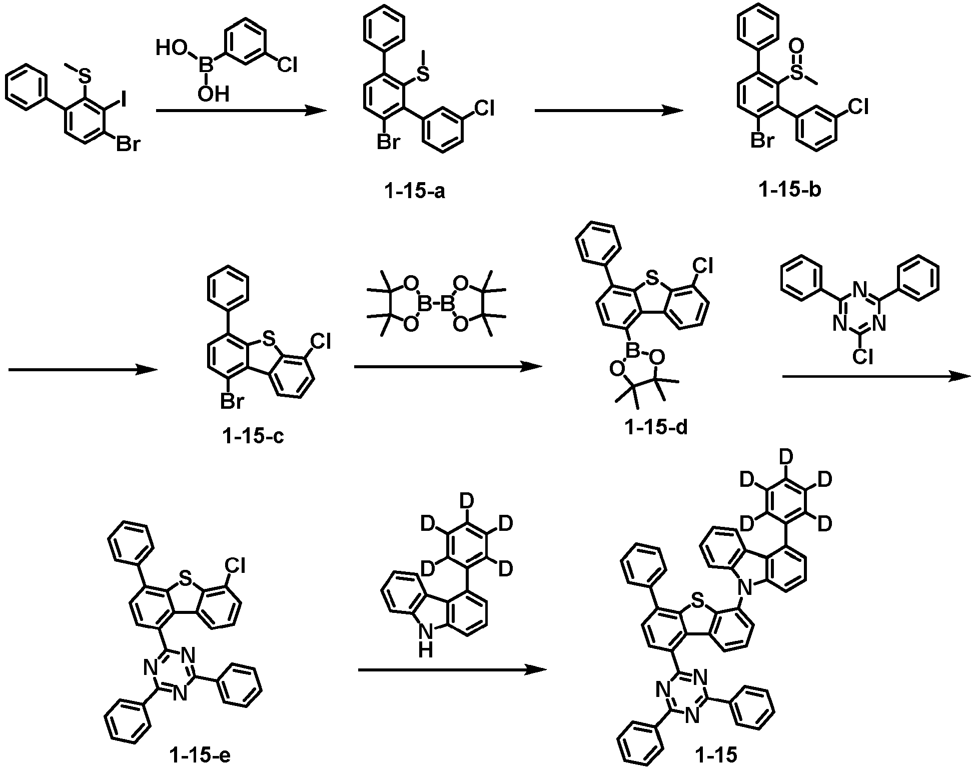

Compound 1-15 (MS: [M+H]⁺ = 738.3) was prepared in the same manner as in the preparation of Compound 1-12 in Synthesis Example 12, except that (4-bromo-3-iodo-[1,1'-biphenyl]-2-yl)(methyl)sulfane, (3-chlorophenyl)boronic acid, 2-chloro-4,6-diphenyl-1,3,5-triazine and 4-(phenyl-d5)-9H-carbazole were used instead of 1-bromo-3-iodo-2-(methylthio)benzene, (3-chlorophenyl)boronic acid, 2-chloro-4-phenyl-6-(phenyl-d5)-1,3,5-triazine and 3-phenyl-9H-carbazole, respectively, in Synthesis Example 12.

### (Preparation of second compound)

### Synthesis Example 16: Synthesis of Compound 2-1

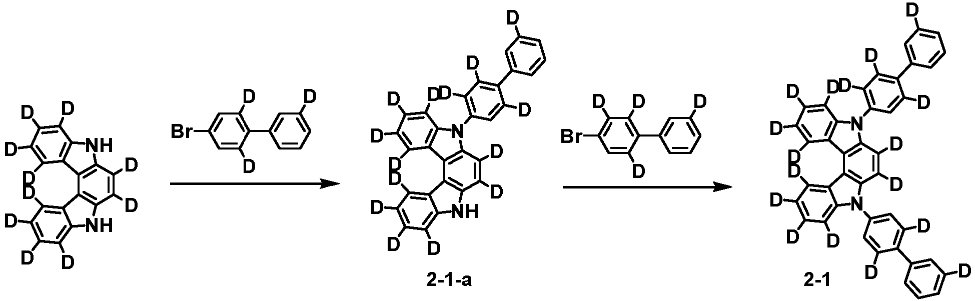

### Step 1) Synthesis of Compound 2-1-a

5,8-dihydroindolo[2,3-c]carbazole-1,2,3,4,6,7,9,10,11,12-d10 (50 g, 187.7 mmol) and 4-bromo-1,1'-biphenyl-2,3',6-d3 (44.3 g, 187.7 mmol) were added to 1000 mL of toluene under a nitrogen atmosphere, and the mixture was stirred and refluxed. Then, sodium tert-butoxide (54.1 g, 563.1 mmol) was added thereto, and sufficiently stirred, followed by adding bis(tri-tertiary-butylphosphine)palladium (2.9 g, 5.6 mmol). After 5 hours of reaction, cooling was performed to room temperature, the organic layer was filtered to remove the salt, and the filtered organic layer was distilled to remove the solvent. Then, this was dissolved again in 793 mL of chloroform corresponding to 10 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 2-1-a in the form of white solid (71.4 g, 90%, MS: [M+H]⁺ = 423.6).

### Step 2) Synthesis of Compound 2-1

The Compound 2-1-a (50 g, 118.3 mmol) and 4-bromo-1,1'-biphenyl-2,3,3',6-d4 (28.1 g, 118.3 mmol) were added to 1000 mL of toluene under a nitrogen atmosphere, and the mixture was stirred and refluxed. Then, sodium tert-butoxide (34.1 g, 355 mmol) was added thereto, and sufficiently stirred, followed by adding bis(tri-tertiary-butylphosphine)palladium (1.8 g, 3.5 mmol). After 3 hours of reaction, cooling was performed to room temperature, the organic layer was filtered to remove the salt, and the filtered organic layer was distilled to remove the solvent. Then, this was dissolved again in 683 mL of chloroform corresponding to 10 times (by volume), and washed twice with water. Thereafter, the organic layer was separated, treated with anhydrous magnesium sulfate, stirred, then filtered, and the filtrate was distilled under reduced pressure. The concentrated compound was recrystallized using chloroform and ethyl acetate to prepare Compound 2-1 in the form of white solid (41.7 g, 61%, MS: [M+H]⁺ = 578.3).

### Synthesis Example 17: Synthesis of Compound 2-2

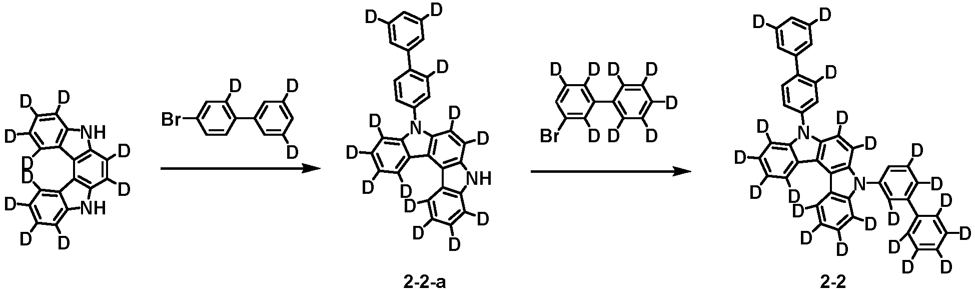

Compound 2-2 (MS: [M+H]⁺ = 582.4) was prepared in the same manner as in the preparation of Compound 2-1 in Synthesis Example 16, except that 4-bromo-1,1'-biphenyl-2,3',5'-d3 and 3-bromo-1,1'-biphenyl-2,2',3',4',5,5 ',6,6'-d8 were used instead of 4-bromo-1,1'-biphenyl-2,3',6-d3 and 4-bromo-1,1'-biphenyl-2,3,3',6-d4, respectively, in Synthesis Example 16.

### Synthesis Example 18: Synthesis of Compound 2-3

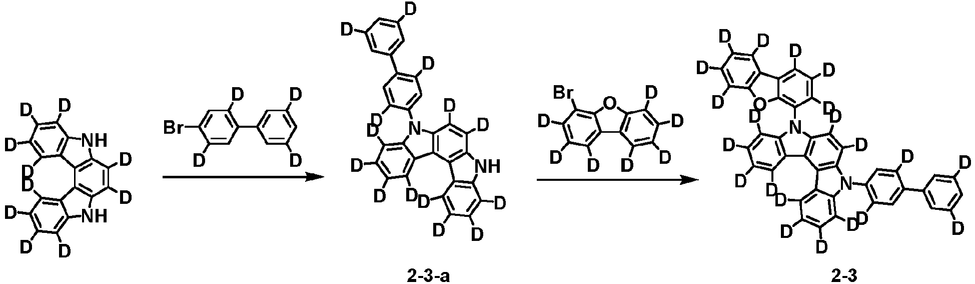

Compound 2-3 (MS: [M+H]⁺ = 596.4) was prepared in the same manner as in the preparation of Compound 2-1 in Synthesis Example 16, except that 4-bromo-1,1'-biphenyl-2,3',5,5'-d4 and 4-bromodibenzo[b,d]furan-1,2,3,6,7,8,9-d7 were used instead of 4-bromo-1,1'-biphenyl-2,3',6-d3 and 4-bromo-1,1'-biphenyl-2,3,3',6-d4, respectively, in Synthesis Example 16.

### Synthesis Example 19: Synthesis of Compound 2-4

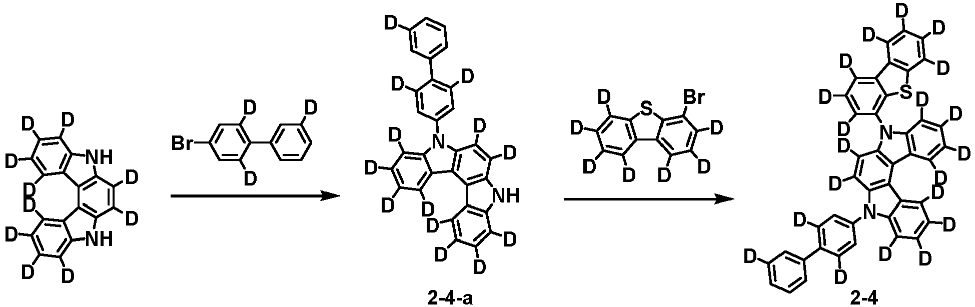

Compound 2-4 (MS: [M+H]⁺ = 611.4) was prepared in the same manner as in the preparation of Compound 2-1 in Synthesis Example 16, except that 4-bromodibenzo [b, d]thiophene-1,2,3,6,7,8,9-d7 was used instead of 4-bromo-1,1'-biphenyl-2,3,3',6-d4 in Synthesis Example 16.

### Synthesis Example 20: Synthesis of Compound 2-5

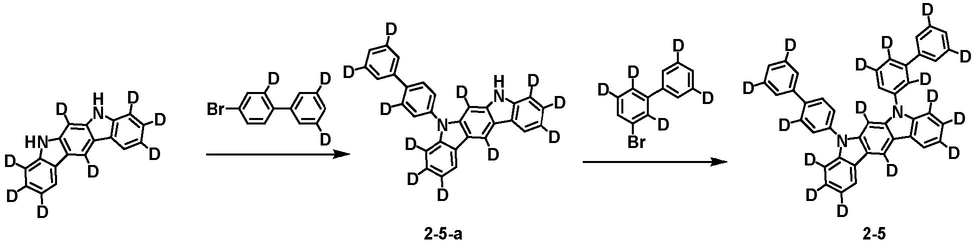

Compound 2-5 (MS: [M+H]⁺ = 577.4) was prepared in the same manner as in the preparation of Compound 2-1 in Synthesis Example 16, except that 5,7-dihydroindolo[2,3-b]carbazole-2,3,4,6,8,9,10,12-d8, 4-bromo-1,1'-biphenyl-2,3',5'-d3, and 3-bromo-1,1'-biphenyl-2,3',5,5',6-d5 were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 21: Synthesis of Compound 2-6

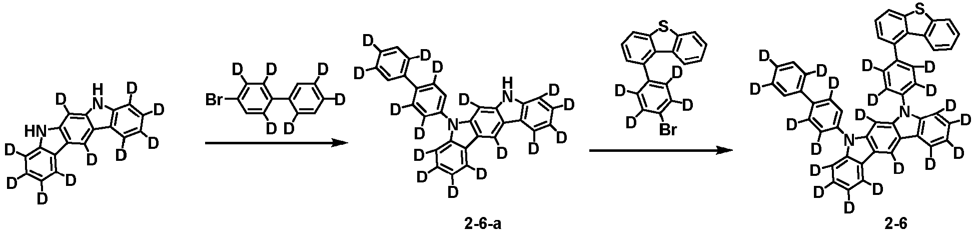

Compound 2-6 (MS: [M+H]⁺ = 687.5) was prepared in the same manner as in the preparation of Compound 2-1 in Synthesis Example 16, except that 5,7-dihydroindolo[2,3-b]carbazole-1,2,3,4,6,8,9,10,11,12-d10, 4-bromo-1,1'-biphenyl-2,2',3,4',5',6-d6, and 1-(4-bromophenyl-2,3,5,6-d4)dibenzo[b,d]thiophene were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 22: Synthesis of Compound 2-7

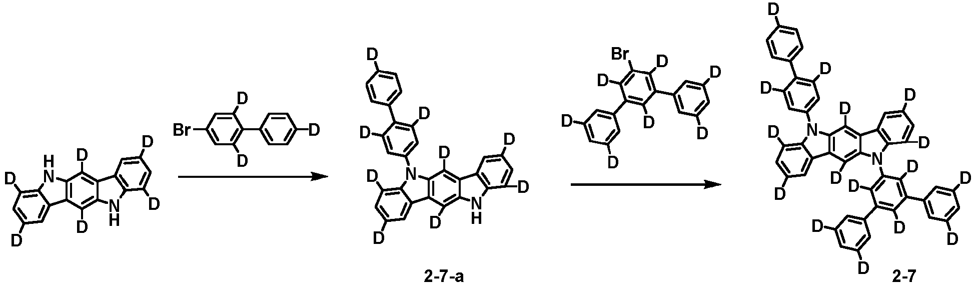

Compound 2-7 (MS: [M+H]⁺ = 654.3) was prepared in the same manner as in the preparation of Compound 2-1 in Synthesis Example 16, except that 5,11-dihydroindolo[3,2-b]carbazole-2,4,6,8,10,12-d6, 4-bromo-1,1'-biphenyl-2,4',6-d3, and 5'-bromo-1,1':3',1"-terphenyl-2',3,3",4',5,5",6'-d7 were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 23: Synthesis of Compound 2-8

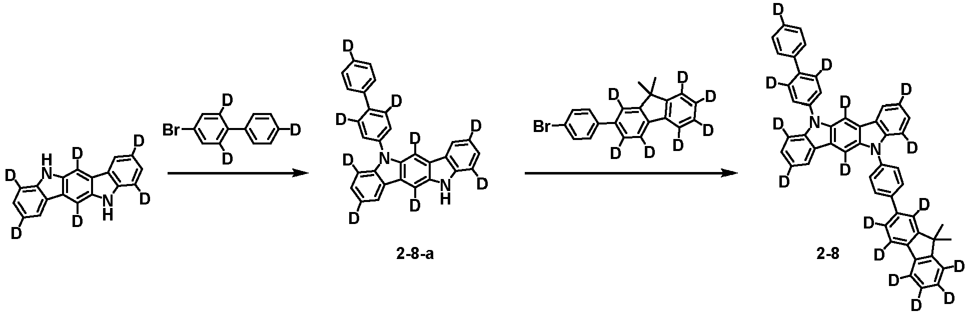

Compound 2-8 (MS: [M+H]⁺ = 693.3) was prepared in the same manner as in the preparation of Compound 2-1 in Synthesis Example 16, except that 5,11-dihydro indolo[3,2-b]carbazole-2,4,6,8,10,12-d6, 4-bromo-1,1'-biphenyl-2,4',6-d3, and 2-(4-bromophenyl)-9,9-dimethyl-9H-fluorene-1,3,4,5,6,7,8-d7 were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 24: Synthesis of Compound 2-9

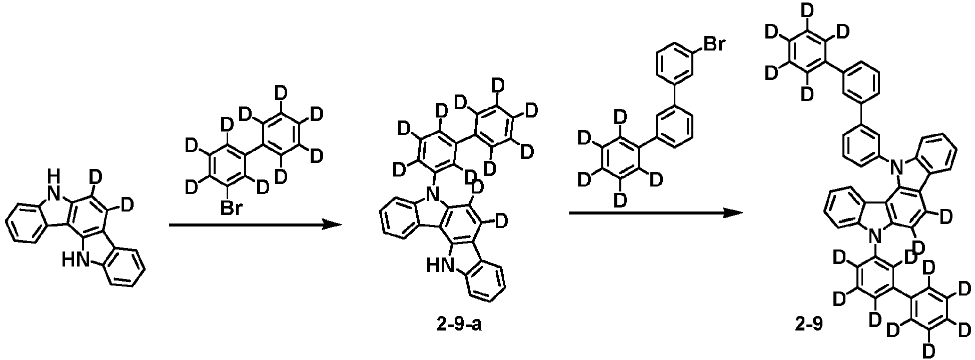

Compound 2-9 (MS: [M+H]⁺ = 653.3) was prepared in the same manner as in the preparation of Compound 2-1 in Synthesis Example 16, except that 5,12-dihydroindolo[3,2-a]carbazole-6,7-d2, 3-bromo-1,1'-biphenyl-2,2',3',4,4',5,5',6,6'-d9, and 3-bromo-1,1':3',1"-terphenyl-2",3",4",5",6"-d5 were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 25: Synthesis of Compound 2-10

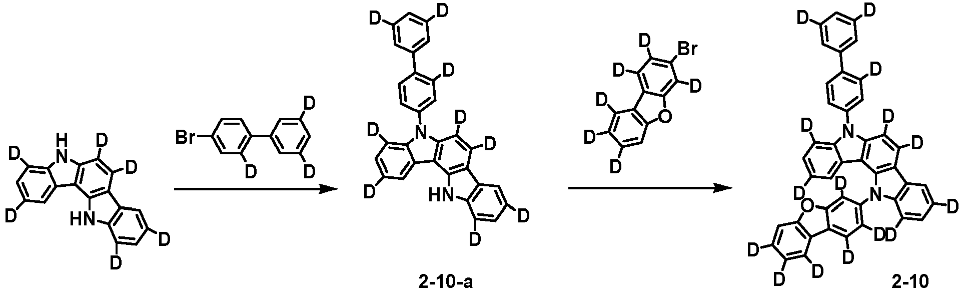

Compound 2-10 (MS: [M+H]⁺ = 590.3) was prepared in the same manner as in the preparation of Compound 2-1 in Synthesis Example 16, except that 5,12-dihydroindolo[3,2-a]carbazole-2,4,6,7,9,11-d6, 4-bromo-1,1'-biphenyl-2,3',5'-d3, and 3-bromodibenzo[b,d]furan-1,2,4,7,8,9-d6 were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 26: Synthesis of Compound 2-11

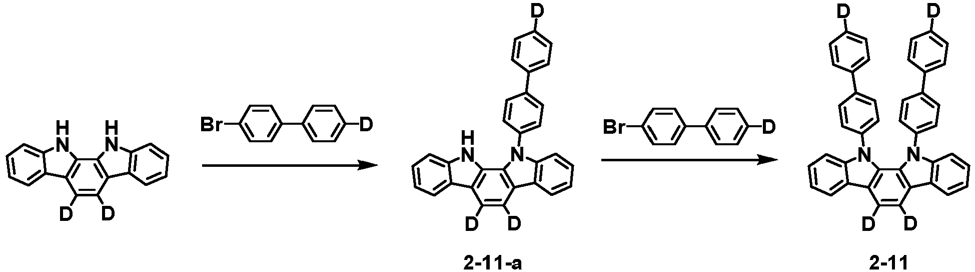

Compound 2-11 (MS: [M+H]⁺ = 565.2) was prepared in the same manner as in the preparation of Compound 2-1 in Synthesis Example 16, except that 11,12-dihydroindolo[2,3-a]carbazole-5,6-d2, 4-bromo-1,1'-biphenyl-4'-d, and 4-bromo-1,1'-biphenyl-4'-d were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Synthesis Example 27: Synthesis of Compound 2-12

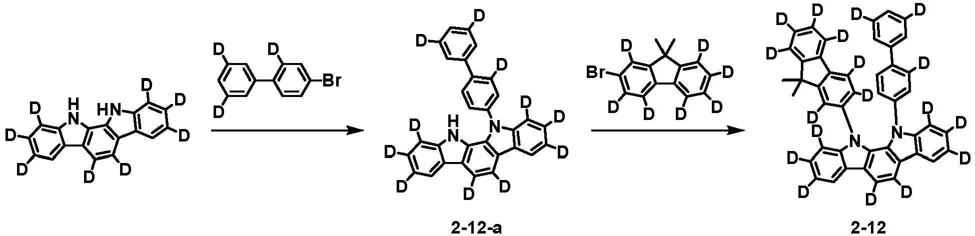

Compound 2-12 (MS: [M+H]⁺ = 619.2) was prepared in the same manner as in the preparation of Compound 2-1 in Synthesis Example 16, except that 11,12-dihydroindolo[2,3-a]carbazole-1,2,3,5,6,8,9,10-d8, 4-bromo-1,1'-biphenyl-2,3',5'-d3, and 2-bromo-9,9-dimethyl-9H-fluorene-1,3,4,5,6,7,8-d7 were used instead of 5,8-dihydroindolo[2,3-c]carbazole-1,2,3,4,6,7,9,10,11,12-d10, 4-bromo-1,1'-biphenyl-2,3',6-d3 and 4-bromo-1,1'-biphenyl-2,3,3',6-d4, respectively, in Synthesis Example 16.

### Example 1

A glass substrate on which ITO (Indium Tin Oxide) was coated as a thin film to a thickness of 1400 Å(angstrom) was put into distilled water in which a detergent was dissolved, and ultrasonically cleaned. At this time, a product manufactured by Fischer Co. was used as the detergent, and distilled water filtered twice using a filter manufactured by Millipore Co. was used as the distilled water. After the ITO was cleaned for 30 minutes, ultrasonic cleaning was repeated twice using distilled water for 10 minutes. After the cleaning with distilled water was completed, the substrate was ultrasonically cleaned with solvents of isopropyl alcohol, acetone, and methanol, dried, and then transferred to a plasma cleaner. In addition, the substrate was cleaned for 5 minutes using oxygen plasma and then transferred to a vacuum depositor.

On the prepared ITO transparent electrode, the following Compound HT-A and the following Compound PD were thermally vacuum-deposited to a thickness of 100 Å at a weight ratio of 95:5 to form a hole injection layer. Then, only the following Compound HT-A was deposited to a thickness of 1150 Å to form a hole transport layer. On the hole transport layer, the following Compound HT-B was thermally vacuum-deposited to a thickness of 450 Å to form an electron blocking layer.

On the electron blocking layer, the Compound 1-1 and the Compound 2-1 as a host compound and the following Compound GD as a dopant compound were vacuum-deposited to a thickness of 400 Å at a weight ratio of 85:15 to form a light emitting layer. At this time, a weight ratio of the Compound 1-1 and the Compound 2-1 was 1:1.

On the light emitting layer, the following Compound ET-A was vacuum-deposited to a thickness of 50 Å to form a hole blocking layer. On the hole blocking layer, the following Compound ET-B and the following Compound Liq were thermally vacuum-deposited to a thickness of 250 Å at a weight ratio of 2:1, and then LiF and magnesium were vacuum-deposited to a thickness of 30 Å at a weight ratio of 1:1 to form an electron injection and transport layer. On the electron injection and transport layer, magnesium and silver were deposited to a thickness of 160 Å at a weight ratio of 1:4 to form a cathode, thereby manufacturing an organic light emitting device.

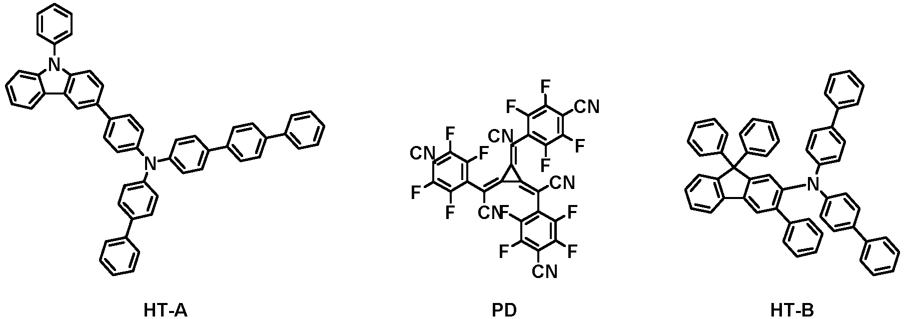

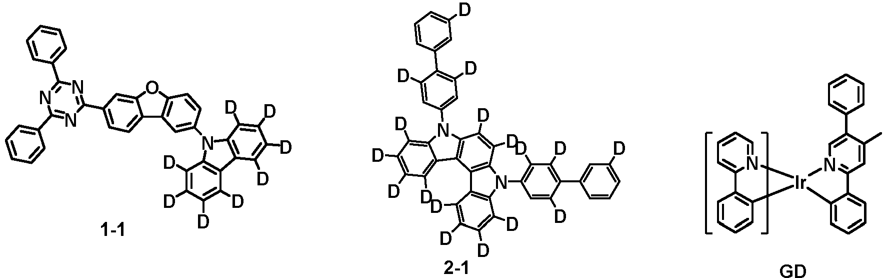

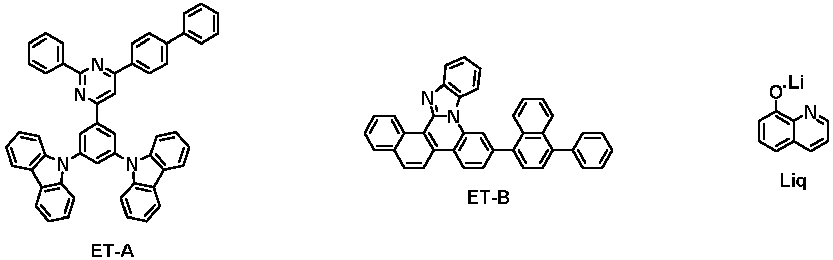

In the above process, the deposition rate of the organic material was maintained at 0.4 Å/sec to 0.7 Å/sec, the deposition rate of lithium fluoride of the cathode was maintained at 0.3Å/sec, and the deposition rate of silver and aluminum was maintained at 2 Å/sec. In addition, the degree of vacuum during the deposition was maintained at 2×10⁻⁷ torr to 5×10⁻⁶ torr, thereby manufacturing an organic light emitting device.

### Examples 2 to 18

An organic light emitting device was manufactured in the same manner as in Example 1, except that the compound of Chemical Formula 1 as a first host and the compound of Chemical Formula 2 as a second host were used by co-deposition at a weight ratio of 1:1 as shown in Table 1 below instead of Compound 1-1 as a first host and Compound 2-1 as a second host in the organic light emitting device of Example 1.

At this time, the structure of the compounds used in Examples is summarized as follows.

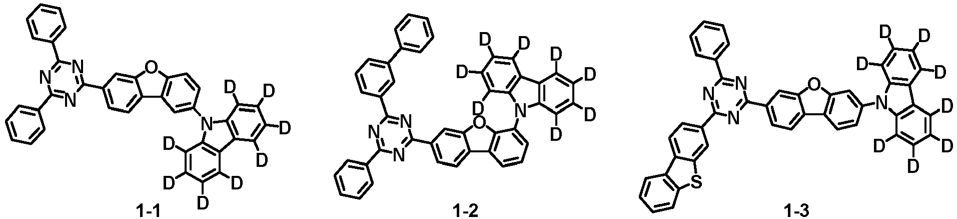

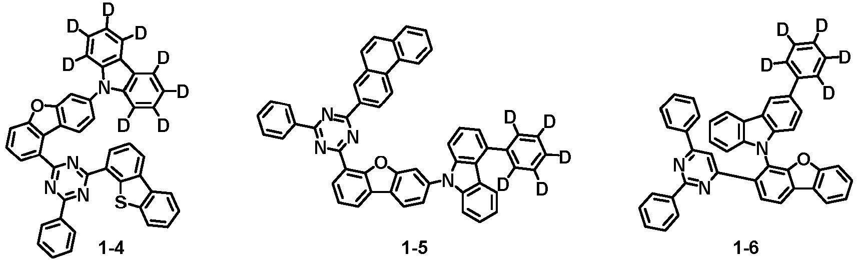

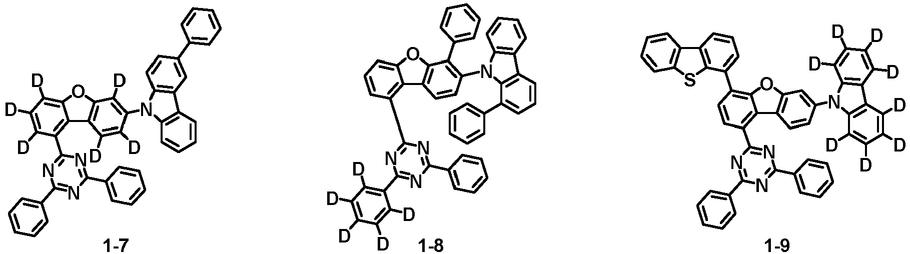

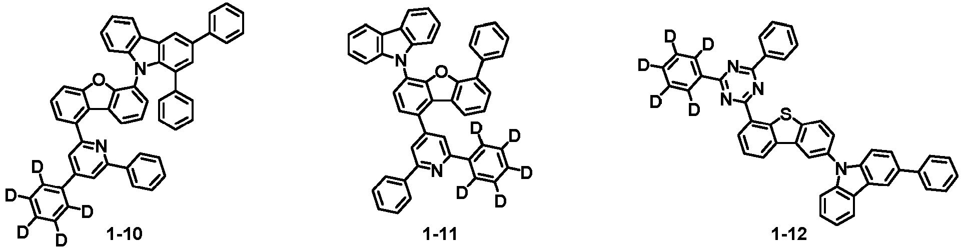

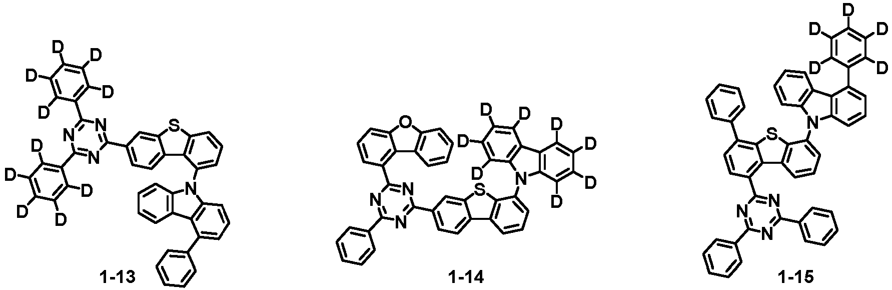

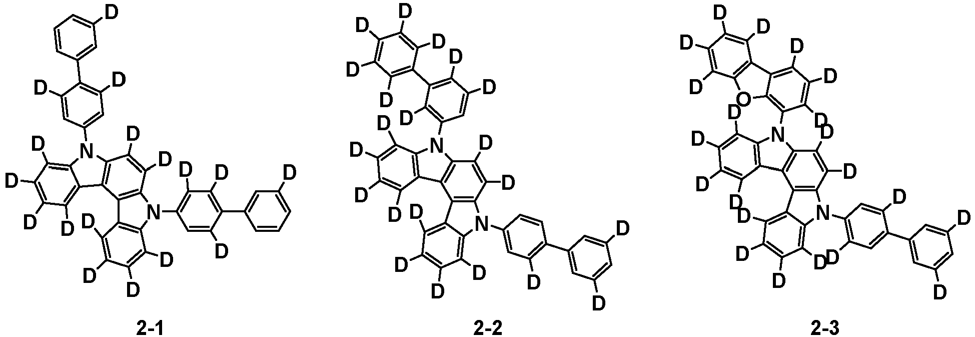

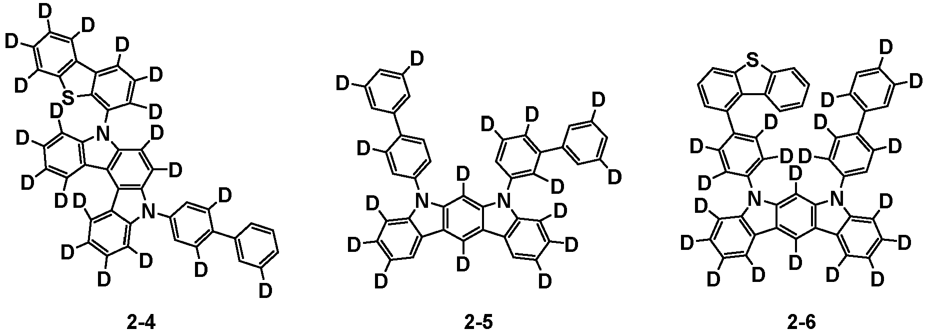

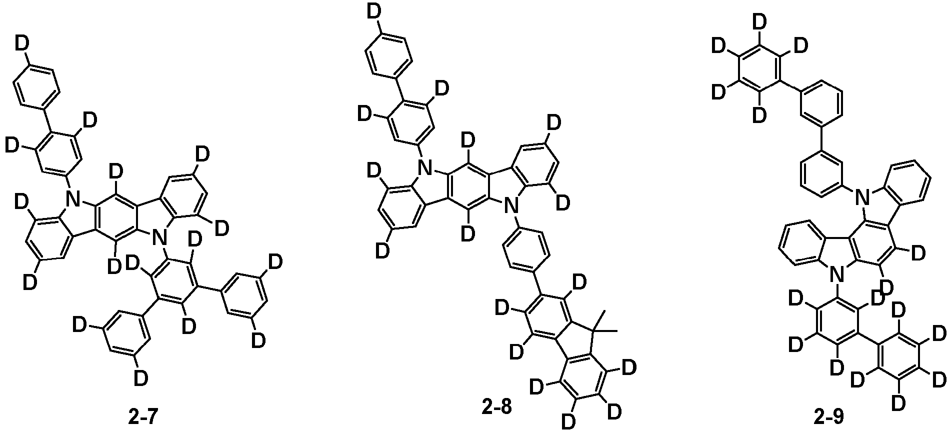

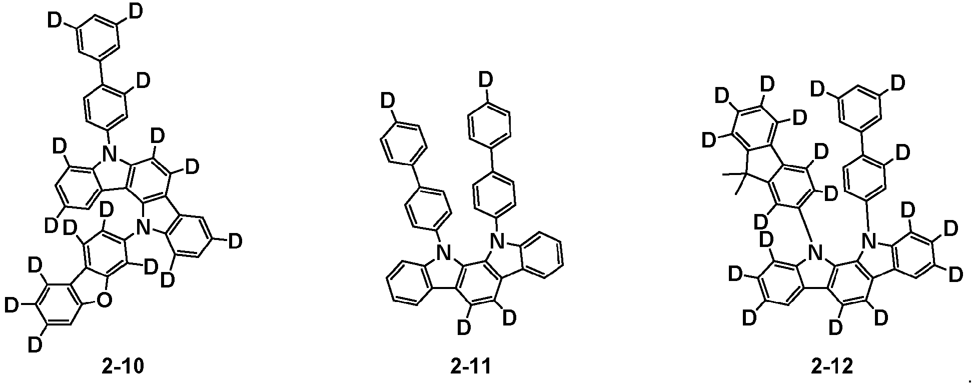

### Comparative Examples 1 to 3

An organic light emitting device was manufactured in the same manner as in Example 1, except that the Compound 1-1, Compound 1-2, or Compound 2-1 was used as a single host instead of using the first host and the second host by co-deposition as shown in Table 1 below in the organic light emitting device of Example 1.

### Comparative Example 4

An organic light emitting device was manufactured in the same manner as in Example 1, except that the following Compound C1 as a first host and the Compound 2-2 as a second host were used by co-deposition at a weight ratio of 1:1 as shown in Table 1 below in the organic light emitting device of Example 1.

### Comparative Examples 5 to 11

An organic light emitting device was manufactured in the same manner as in Example 1, except that the Compound 1-2, the Compound 1-12, or the following Compound C1 as a first host and the following Compound H1 to H4 as a second host were used by co-deposition at a weight ratio of 1:1 as shown in Table 1 below in the organic light emitting device of Example 1.

At this time, Compounds C1 and H1 to H4 used in Table 1 below are as follows.

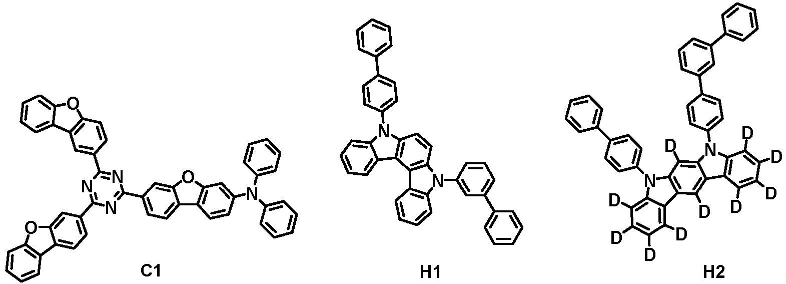

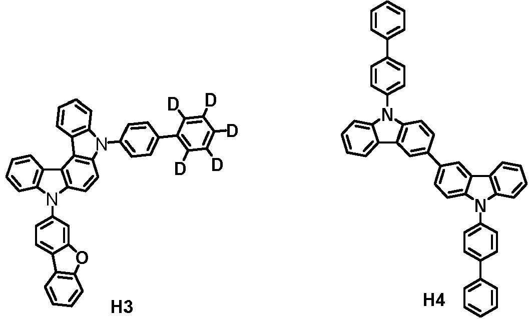

### Experimental Examples

For the organic light emitting devices prepared in Examples and Comparative Examples, the voltage, efficiency, and lifespan (T95) were measured by applying a current, and the results are shown in Table 1 below. At this time, the voltage and efficiency were measured by applying a current density of 10 mA/cm². In addition, T95 means the time (hr) taken until the initial luminance decreases to 95% at a current density of 20 mA/cm².

**[Table 1]**

| Category | Compound in light emitting layer (first host, second host) | Voltage (V) (@10mA/cm²) | Efficiency (cd/A) (@10mA/cm²) | Emission color | T95(hr) (@20mA/cm²) |
|---|---|---|---|---|---|
| Example 1 | Compound 1-1, Compound 2-1 | 3.02 | 59.8 | Green | 70 |
| Example 2 | Compound 1-2, Compound 2-1 | 3.02 | 61.3 | Green | 76 |
| Example 3 | Compound 1-2, Compound 2-2 | 3.01 | 65.2 | Green | 79 |
| Example 4 | Compound 1-3, Compound 2-3 | 3.01 | 60.2 | Green | 81.2 |
| Example 5 | Compound 1-4, Compound 2-4 | 3.00 | 66.2 | Green | 79 |
| Example 6 | Compound 1-5, Compound 2-5 | 3.09 | 64.2 | Green | 75 |
| Example 7 | Compound 1-6, Compound 2-6 | 3.12 | 65.2 | Green | 72 |
| Example 8 | Compound 1-7, Compound 2-7 | 3.05 | 63.2 | Green | 80 |
| Example 9 | Compound 1-7, Compound 2-8 | 2.95 | 62.2 | Green | 71 |
| Example 10 | Compound 1-8, Compound 2-9 | 3.03 | 63.2 | Green | 72 |
| Example 11 | Compound 1-9, Compound 2-10 | 3.07 | 63.5 | Green | 70 |
| Example 12 | Compound 1-10, Compound 2-11 | 3.02 | 62.1 | Green | 77 |
| Example 13 | Compound 1-11, Compound 2-12 | 3.03 | 65.9 | Green | 76 |
| Example 14 | Compound 1-12, Compound 2-4 | 3.10 | 71.1 | Green | 70 |
| Example 15 | Compound 1-12, Compound 2-6 | 3.15 | 72.2 | Green | 76 |
| Example 16 | Compound 1-13, Compound 2-8 | 3.18 | 71.8 | Green | 80 |
| Example 17 | Compound 1-14, Compound 2-9 | 3.11 | 73.2 | Green | 77 |
| Example 18 | Compound 1-15, Compound 2-11 | 3.19 | 73.9 | Green | 79 |
| Comparative Example 1 | Compound 1-1 | 3.88 | 38.1 | Green | 15 |
| Comparative Example 2 | Compound 1-12 | 3.75 | 32.5 | Green | 19 |
| Comparative Example 3 | Compound 2-1 | 4.10 | 22.1 | Green | 23 |
| Comparative Example 4 | Compound C1, Compound 2-2 | 3.28 | 55.2 | Green | 40 |
| Comparative Example 5 | Compound C1, Compound H1 | 3.35 | 58.2 | Green | 52 |
| Comparative Example 6 | Compound 1-2, Compound H1 | 3.02 | 60.9 | Green | 53 |
| Comparative Example 7 | Compound 1-2, Compound H2 | 3.07 | 58.2 | Green | 55 |
| Comparative Example 8 | Compound 1-2, Compound H4 | 3.12 | 62.5 | Green | 30 |
| Comparative Example 9 | Compound 1-12, Compound H2 | 3.10 | 71.1 | Green | 48 |
| Comparative Example 10 | Compound 1-12, Compound H3 | 3.11 | 72.9 | Green | 44 |
| Comparative Example 11 | Compound 1-12, Compound H4 | 3.30 | 59.5 | Green | 35 |

As shown in Table 1, the organic light emitting devices of the Examples using both the first compound and the second compound of the present disclosure as a host exhibited superior characteristics in terms of efficiency and lifespan compared to the organic light emitting devices of Comparative Examples 1 to 3 using the first compound or the second compound as a single host, and the organic light emitting devices of Comparative Examples 4 and 11 employing a combination of other hosts instead of the combination of the first compound and the second compound.

Specifically, the organic light emitting devices of Examples 1 to 18 according to the present disclosure had the efficiency improved by about 50% or more, or by about 230% or more in some cases, and the lifespan improved by about 200% or more, compared to the organic light emitting devices of Comparative Examples 1 to 3 using the first compound or the second compound alone. Further, the organic light emitting devices of Examples 1 to 18 according to the present disclosure were greatly improved in both efficiency and lifespan, compared to the organic light emitting device of Comparative Example 4 using the second compound and a compound having a structure different from that of the first compound and the organic light emitting device of Comparative Example 5 using compounds having a structure different from that of the first compound and the second compound. In addition, the organic light emitting devices of Examples 1 to 18 according to the present disclosure had the lifespan improved by about 20% to about 30%, compared to the organic light emitting devices of Comparative Examples 6 to 11 using the first compound and a compound having a structure different from that of the second compound. In particular, the organic light emitting devices of Examples 3 and 14 using Compound 2-2 and Compound 2-4 containing deuterium-substituted indolocarbazole having improved hole transport properties as the second compound, respectively, were very advantageous in balancing charges according to the change of common layers, compared to Comparative Examples 8 and 11 using the conventionally known Compound H4 having a biscarbazole structure as the second host.

Inferred from these results, it can be confirmed that the increase in efficiency and lifespan while maintaining the low driving voltage of the organic light emitting device is because the combination of the compound of Chemical Formula 1 as a first host and the compound of Chemical Formula 2 as a second host facilitates energy transfer to the green dopant in the green light emitting layer. It can be also confirmed that the combination of the compounds of the Examples according to the present disclosure, that is, the combination of the compound of Chemical Formula 1 and the compound of Chemical Formula 2, facilitates electron-hole bonding in a more stable balance to form excitons in the light emitting layer, thereby greatly increasing the efficiency and lifespan. In conclusion, when the compound of Chemical Formula 1 and the compound of Chemical Formula 2 of the present disclosure are combined and co-deposited to be used as a host for the green light emitting layer, it is possible to significantly improve the lifespan while maintaining the low driving voltage and high luminous efficiency of the organic light emitting device.

### [DESCRIPTION OF SYMBOLS]

| | | | |
|---|---|---|---|
| 1: | Substrate | 2: | Anode |
| 3: | Light emitting layer | 4: | Cathode |
| 5: | Hole injection layer | 6: | Hole transport layer |
| 7: | Electron blocking layer | 8: | Hole blocking layer |
| 9: | Electron injection and transport layer. | | |

## Claims

1. An organic light emitting device comprising:
an anode (2);
a cathode (4); and
a light emitting layer (3) that is provided between the anode and the cathode,
wherein the light emitting layer comprises a compound represented by the following Chemical Formula 1 and a compound represented by the following Chemical Formula 2: 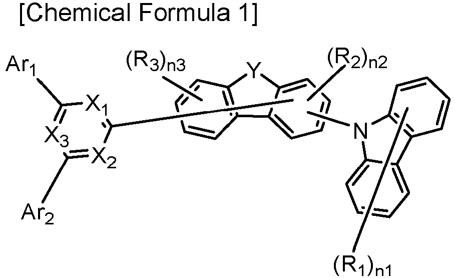 wherein in Chemical Formula 1:
Y is O or S;
X₁, X₂ and X₃ are each independently CH or N, provided that at least one of X₁, X₂ and X₃ is N; and
Ar₁ and Ar₂ are each independently a substituted or unsubstituted C₆₋₆₀ aryl, or a substituted or unsubstituted C₂₋₆₀ heteroaryl containing at least one heteroatom selected from the group consisting of N, O and S;
R₁, R₂, and R₃ are each independently hydrogen, deuterium, substituted or unsubstituted C₆₋₆₀ aryl, or substituted or unsubstituted C₂₋₆₀ heteroaryl containing at least one heteroatom selected from the group consisting of N, O and S;
n1 is an integer of 0 to 8; and
n2+n3 is an integer of 0 to 6; 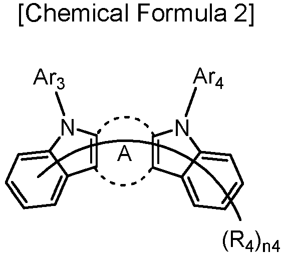 wherein in Chemical Formula 2:
A is a benzene ring fused with two adjacent rings;
Ar₃ and Ar₄ are each independently a substituted or unsubstituted C₆₋₆₀ aryl, or a substituted or unsubstituted C₂₋₆₀ heteroaryl containing at least one heteroatom selected from the group consisting of O and S, provided that at least one of Ar₃ and Ar₄ is substituted with at least one deuterium;
each R₄ is independently hydrogen, deuterium, substituted or unsubstituted C₆₋₆₀ aryl, or substituted or unsubstituted C₂₋₆₀ heteroaryl containing at least one heteroatom selected from the group consisting of N, O and S, provided that at least one of R₄ is deuterium; and
n4 is an integer of 1 to 10.

2. The organic light emitting device of Claim 1,
wherein X₁ to X₃ are all N;
X₁ and X₂ are N, and X₃ is CH;
X₁ and X₃ are N, and X₂ is CH;
X₁ is N, and X₂ and X₃ are CH; or
X₂ is N, and X₁ and X₃ are CH.

3. The organic light emitting device of Claim 1,
wherein at least one of Ar₁ and Ar₂ is deuterium-substituted C₆₋₆₀ aryl or deuterium-substituted C₂₋₆₀ heteroaryl containing at least one heteroatom selected from the group consisting of N, O and S; or
at least one of R₁ to R₃ is deuterium; deuterium-substituted C₆₋₆₀ aryl; or deuterium-substituted C₂₋₆₀ heteroaryl containing at least one heteroatom selected from the group consisting of N, O and S, and n1+n2+n3 is 1 or more.

4. The organic light emitting device of Claim 1, wherein Ar₁ and Ar₂ are each independently any one selected from the group consisting of:

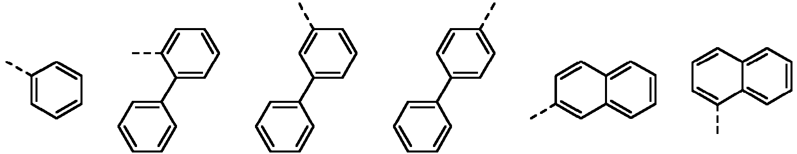

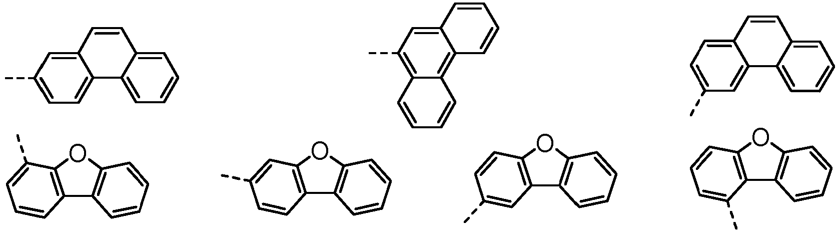

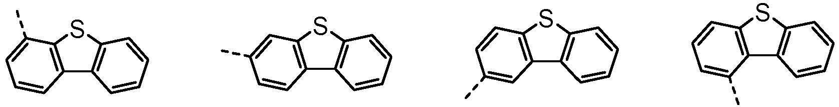

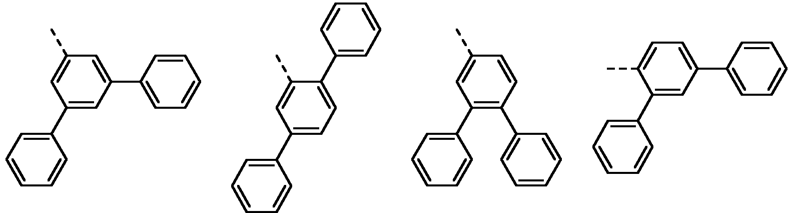

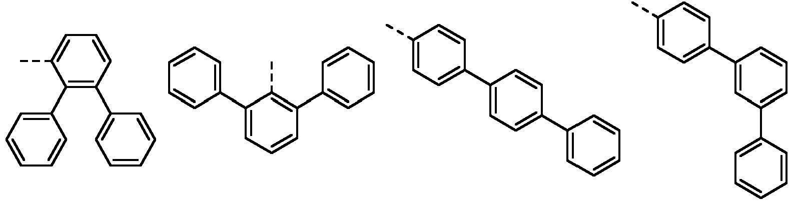

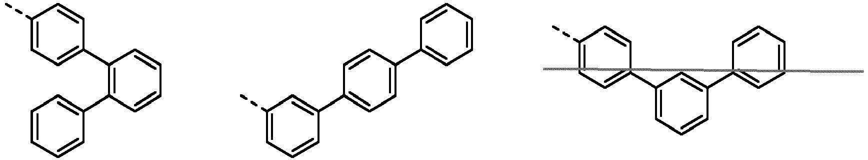

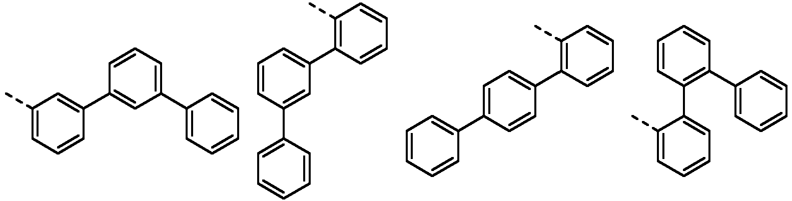

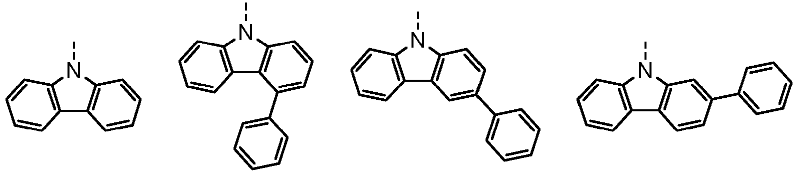

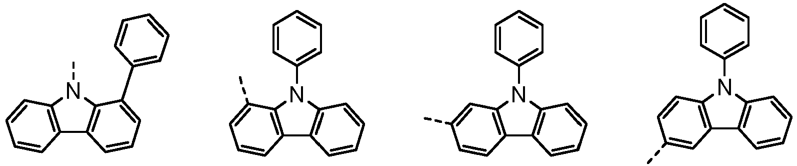

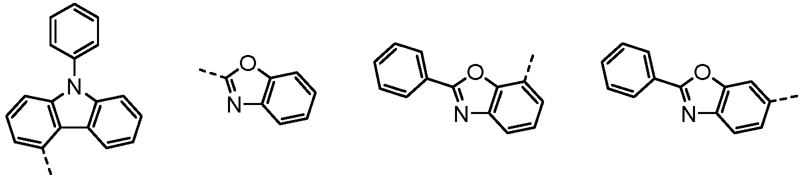

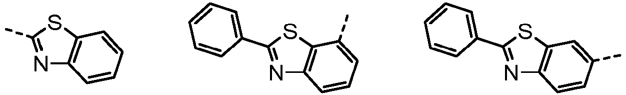

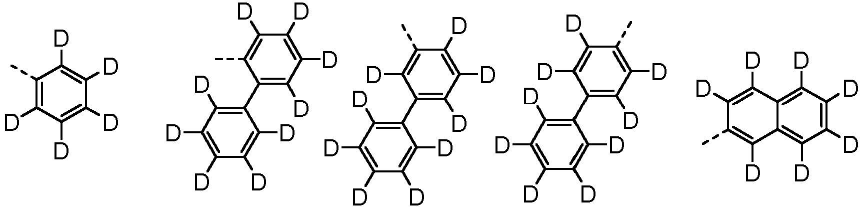

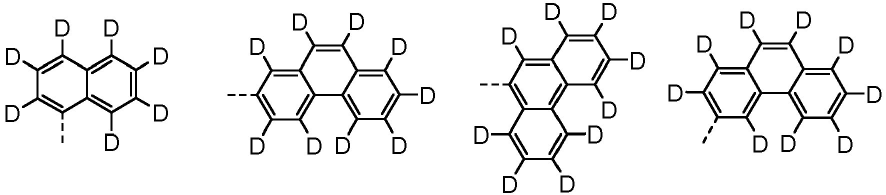

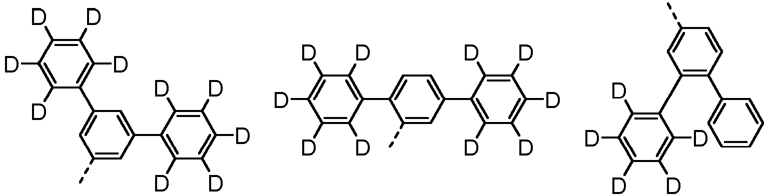

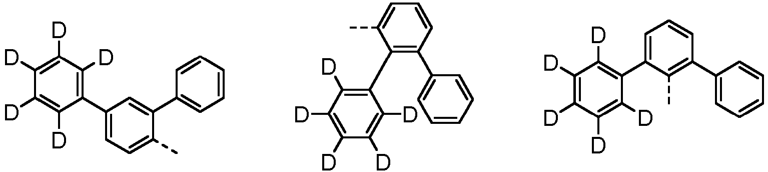

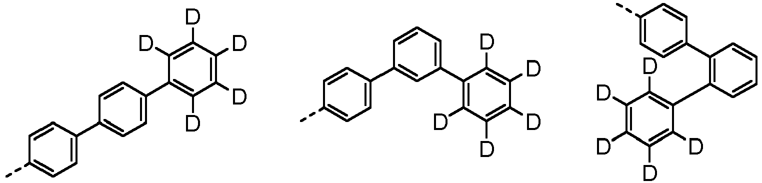

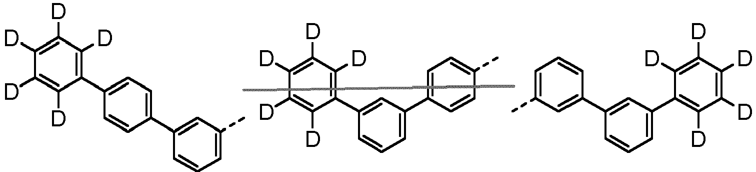

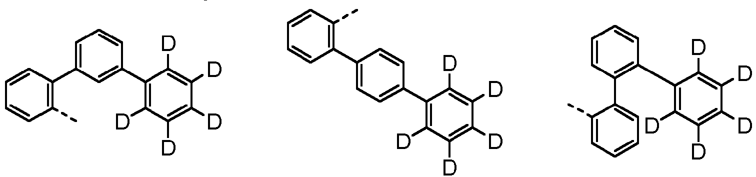

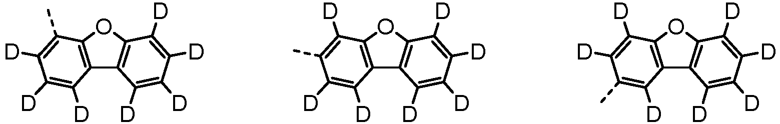

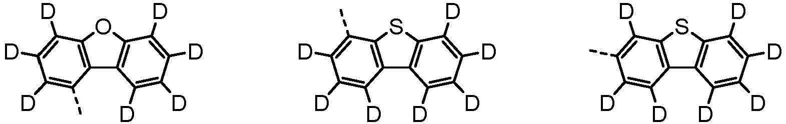

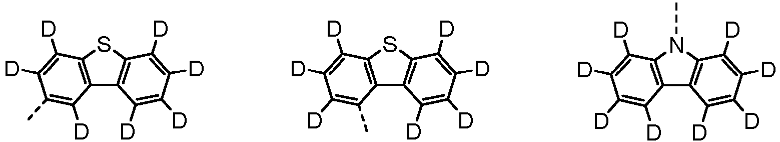

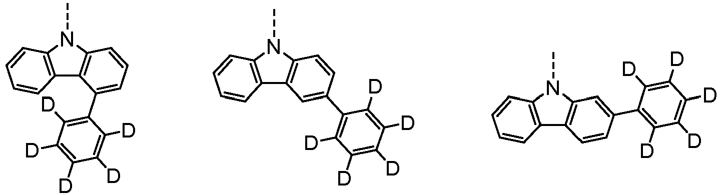

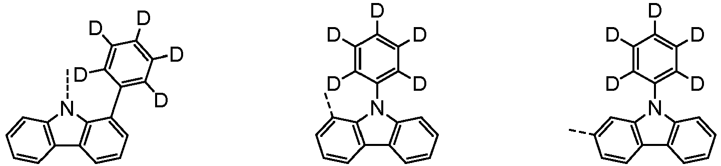

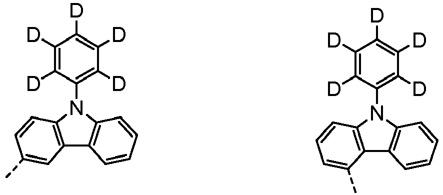

5. The organic light emitting device of Claim 1, wherein at least one of Ar₁ and Ar₂ is phenyl or phenyl substituted with 5 deuterium.

6. The organic light emitting device of Claim 1, wherein each R₁ is independently hydrogen, deuterium, phenyl, dibenzofuranyl, dibenzothiophenyl, carbazolyl, phenyl substituted with 5 deuterium, dibenzofuranyl substituted with 7 deuterium, dibenzothiophenyl substituted with 7 deuterium, or carbazolyl substituted with 8 deuterium.

7. The organic light emitting device of Claim 1, wherein R₂ and R₃ are each independently hydrogen, deuterium, phenyl, dibenzothiophenyl, carbazolyl, or phenyl substituted with 5 deuterium.

8. The organic light emitting device of Claim 1, wherein the compound represented by Chemical Formula 1 is any one compound selected from the group consisting of:

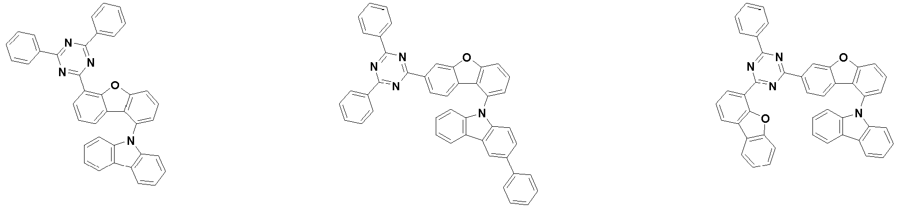

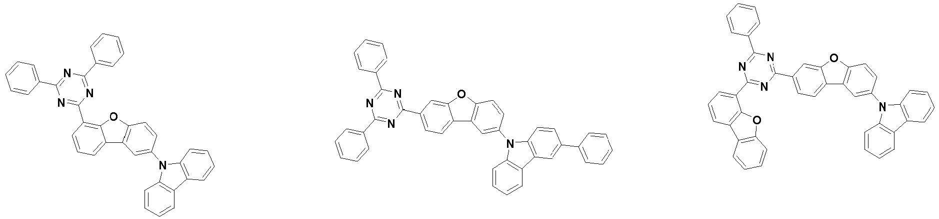

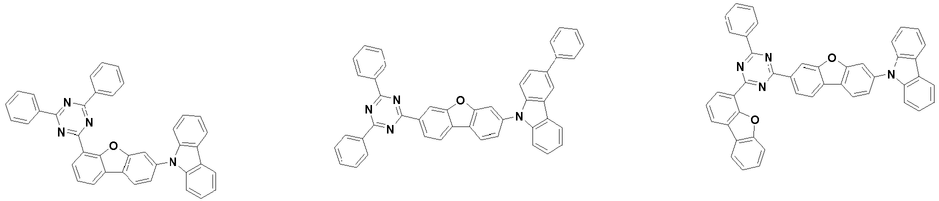

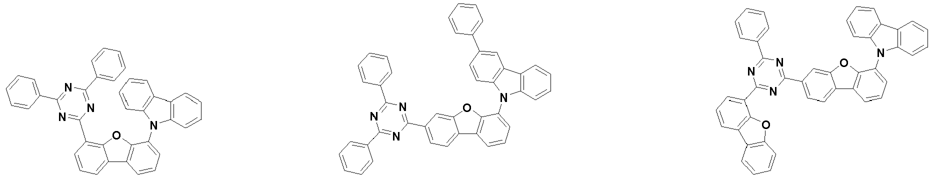

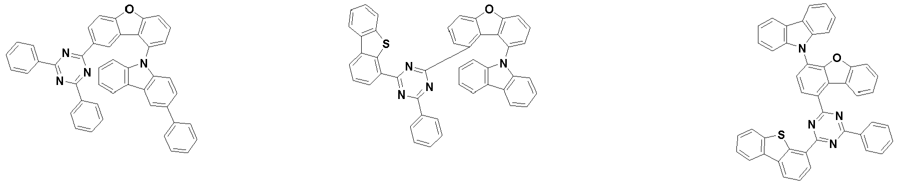

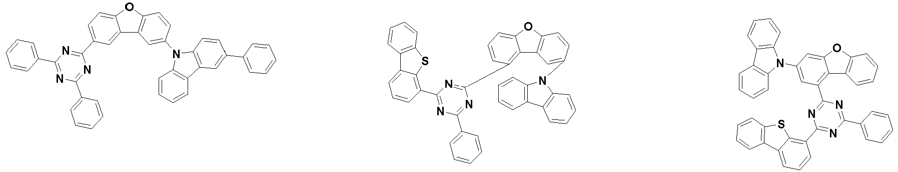

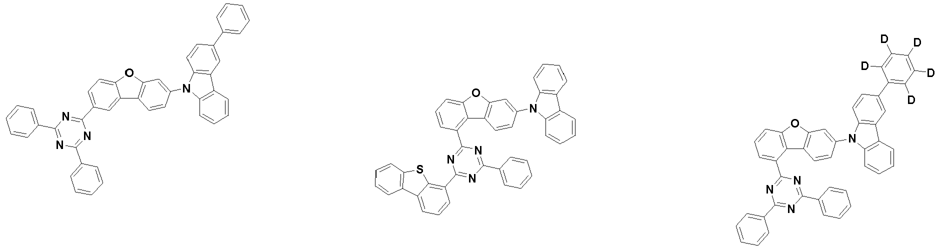

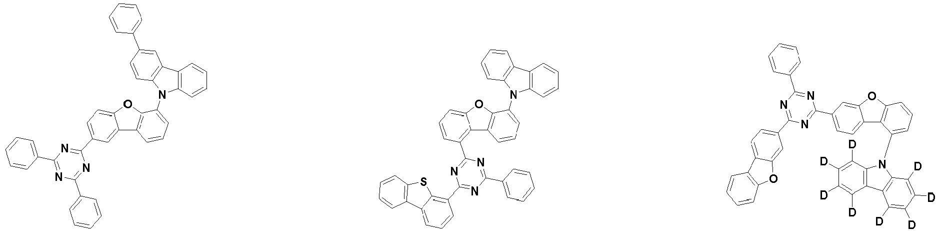

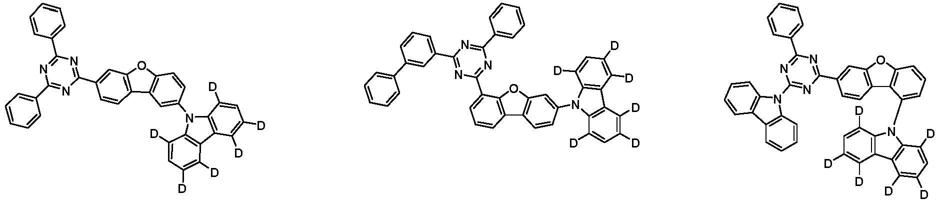

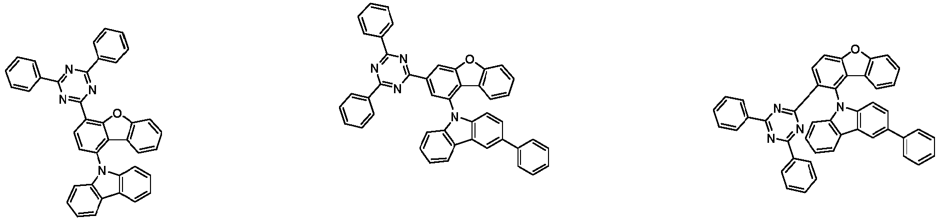

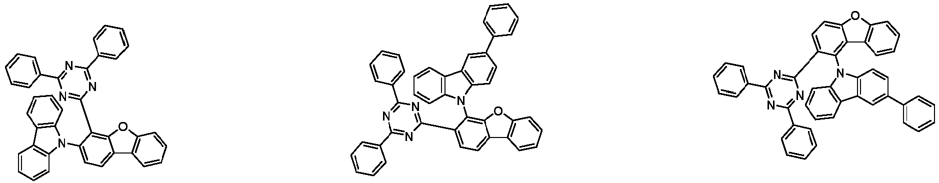

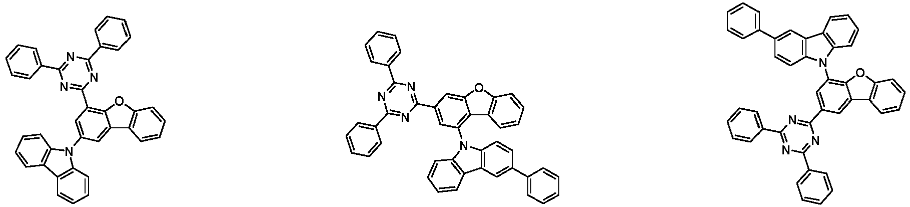

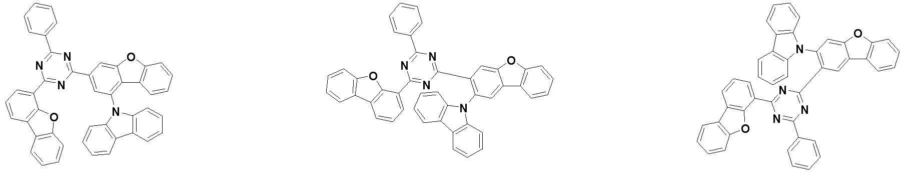

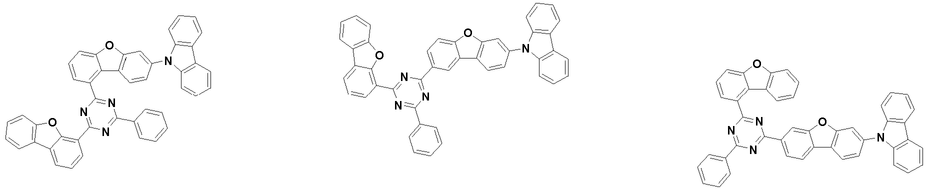

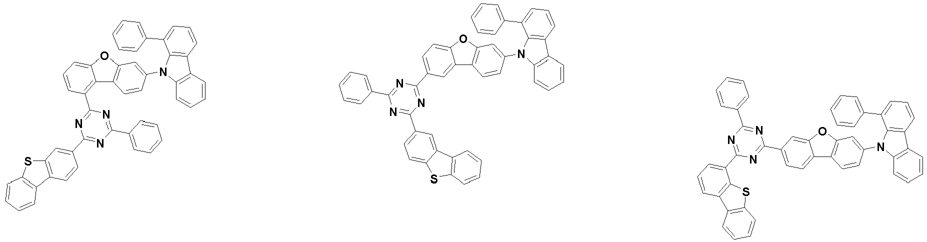

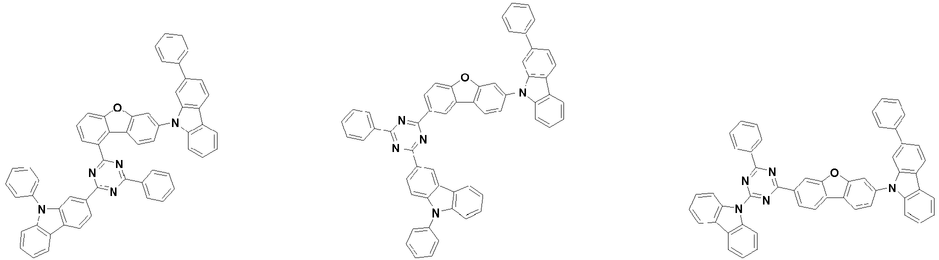

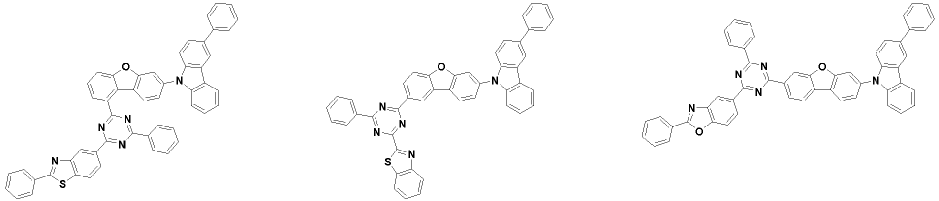

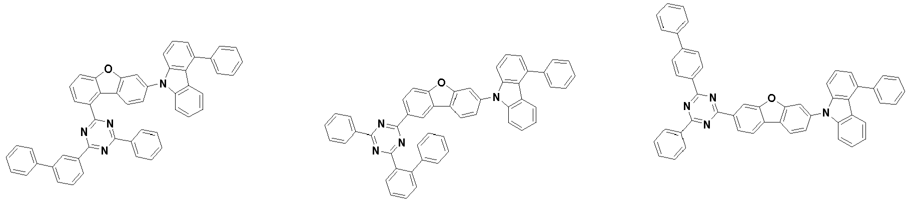

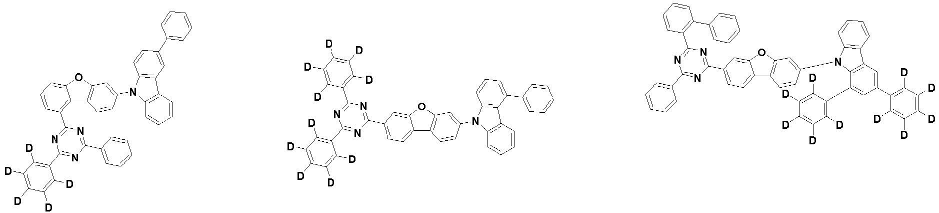

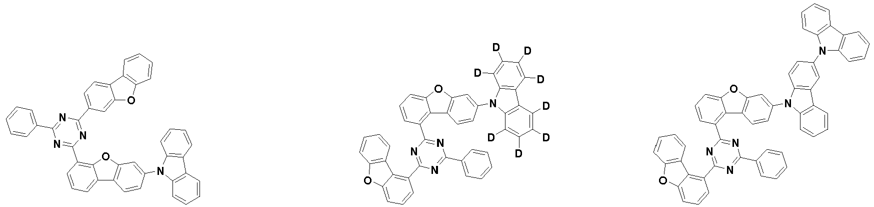

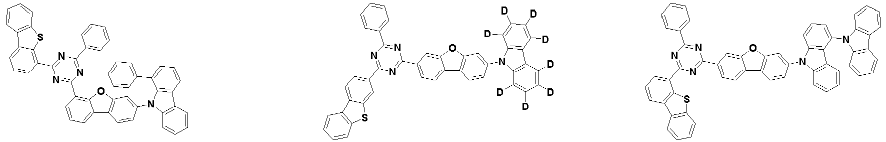

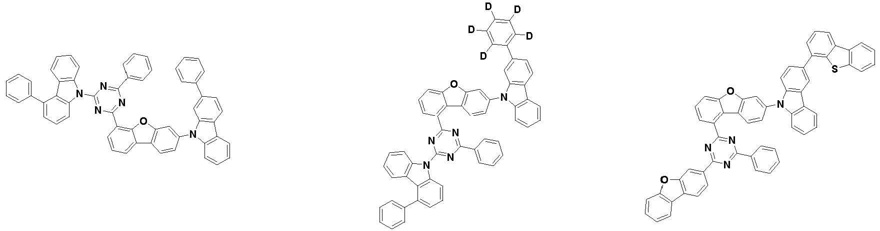

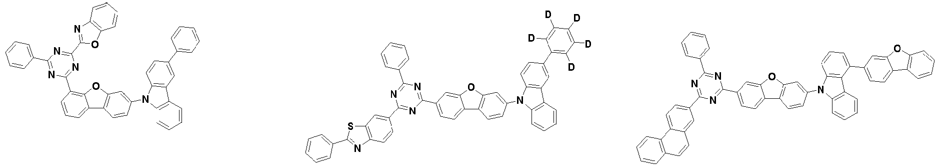

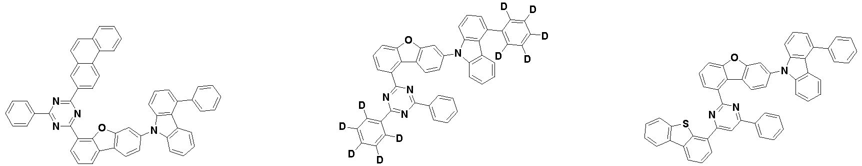

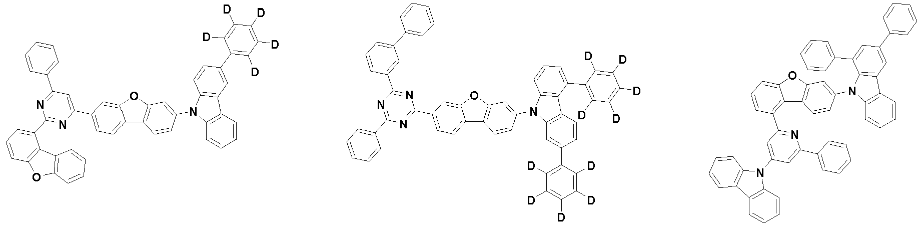

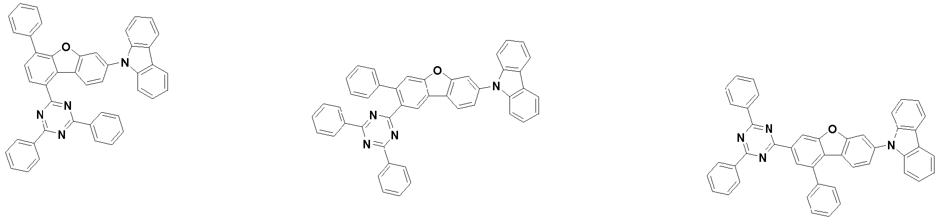

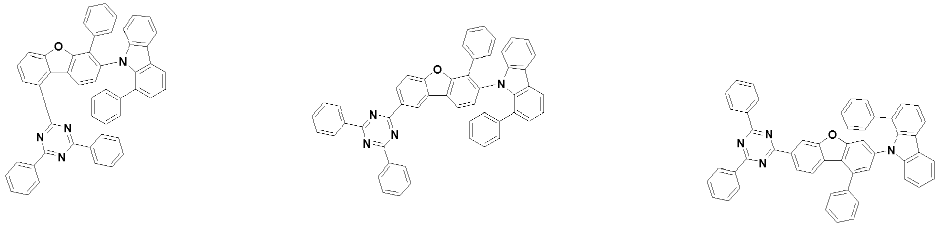

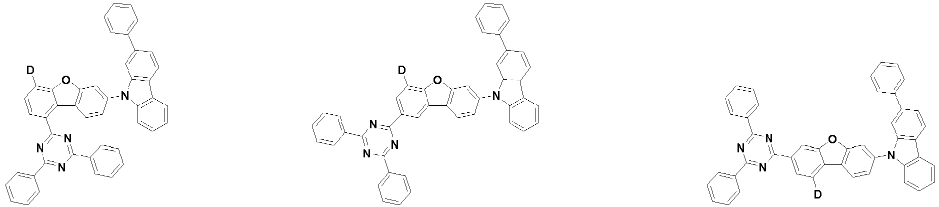

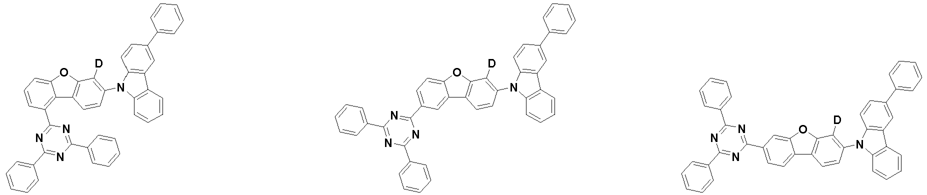

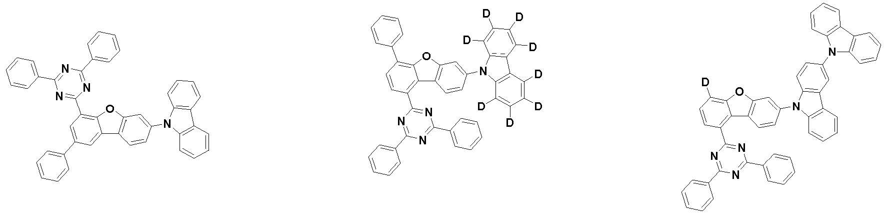

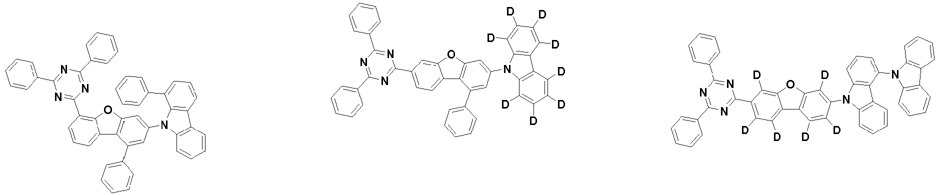

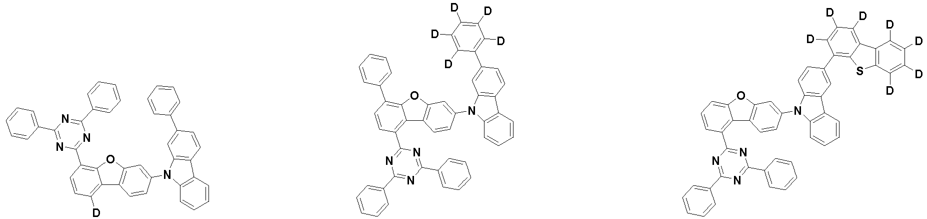

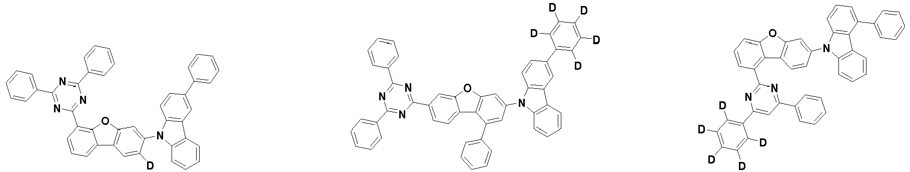

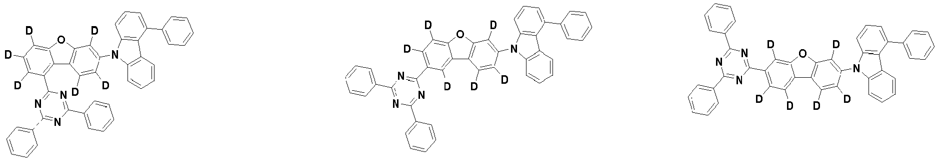

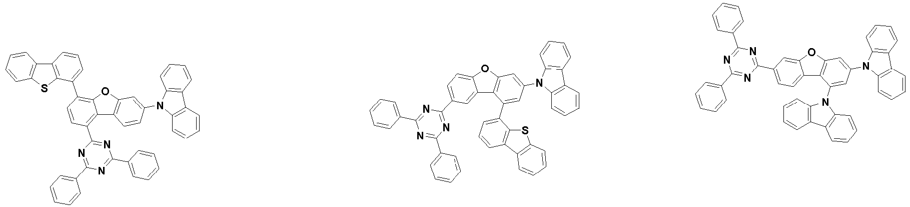

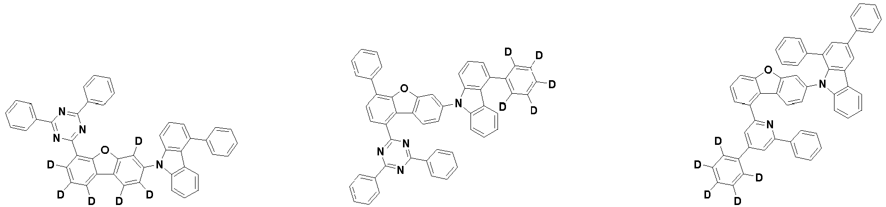

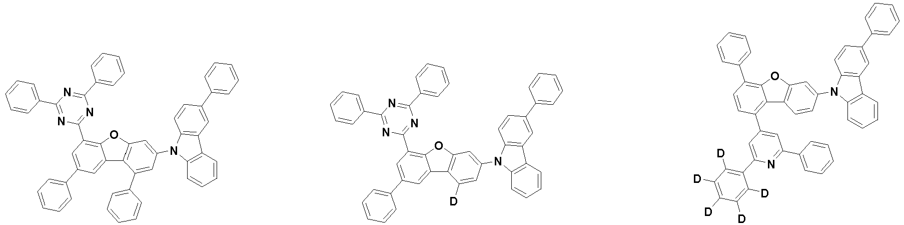

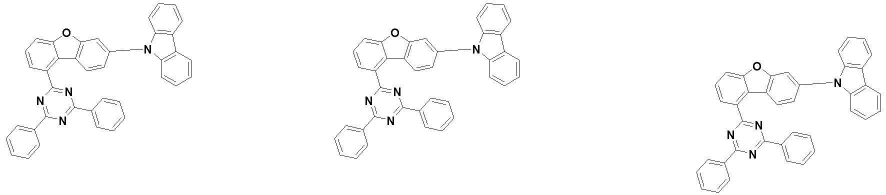

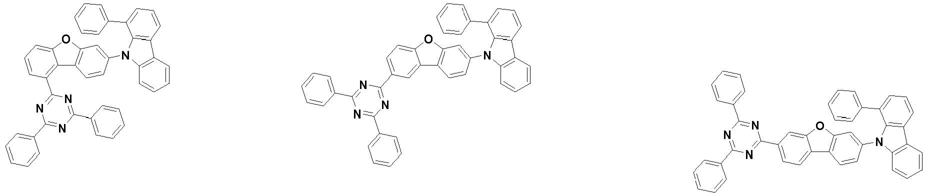

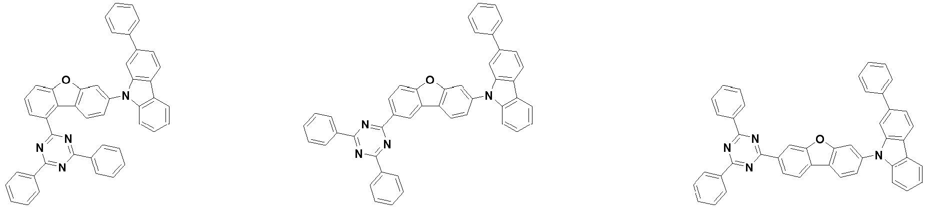

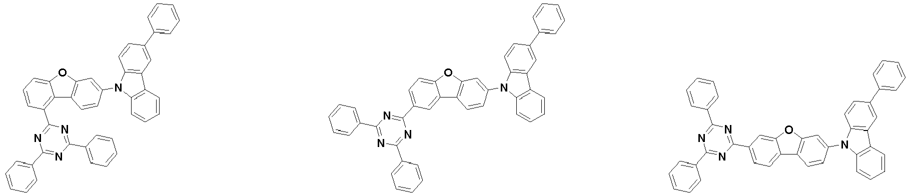

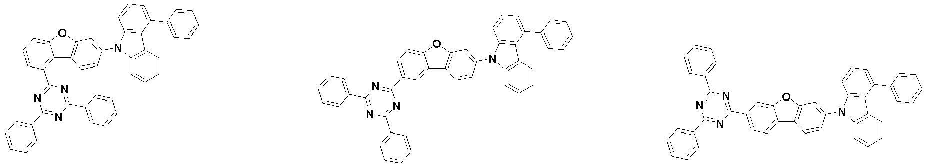

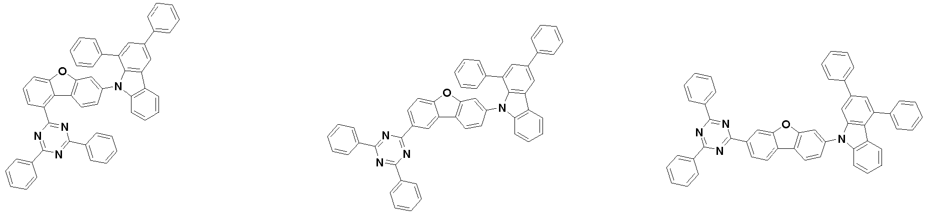

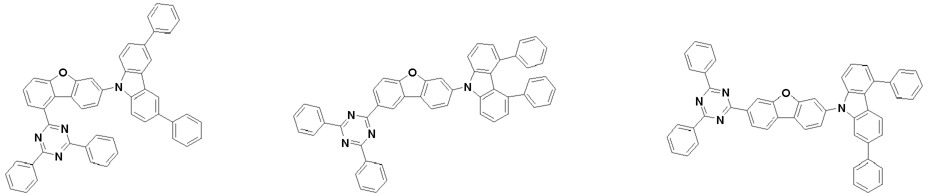

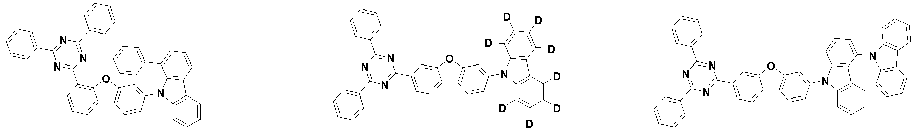

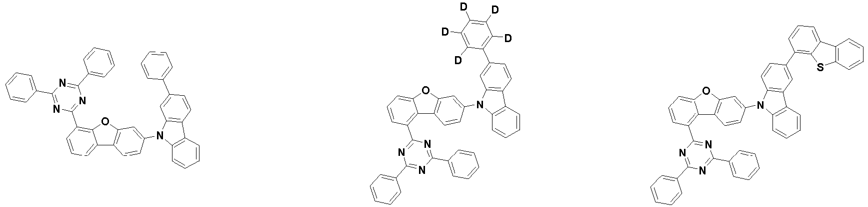

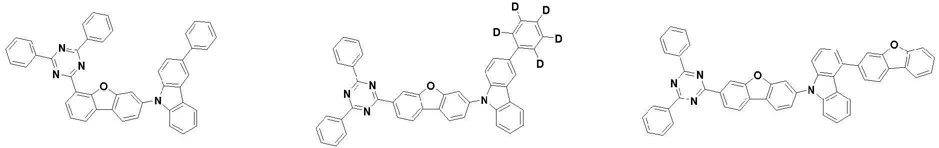

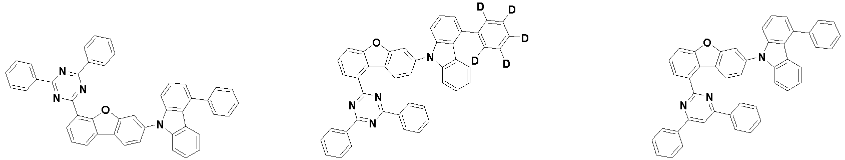

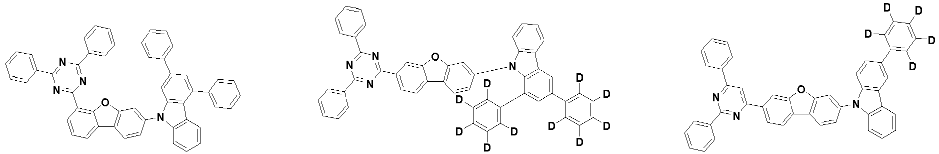

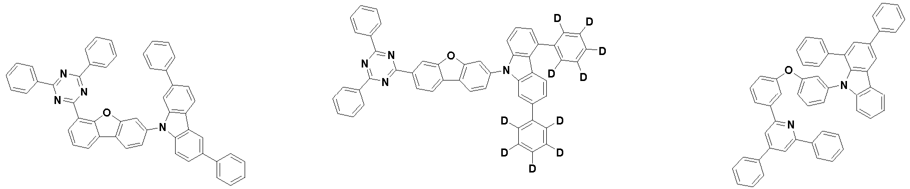

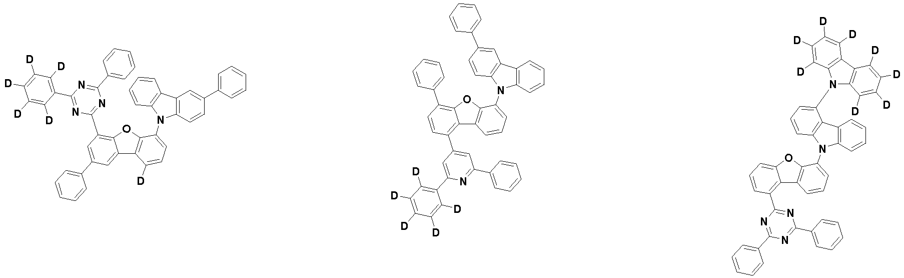

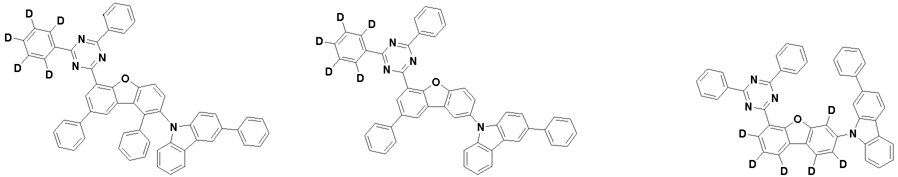

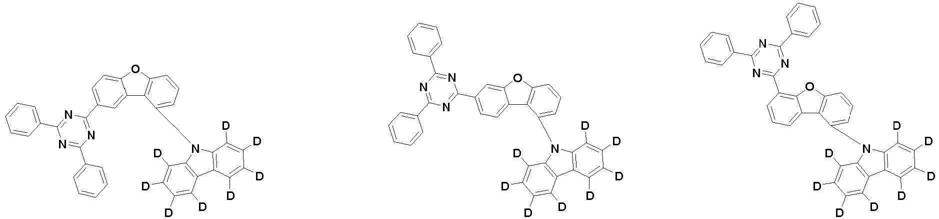

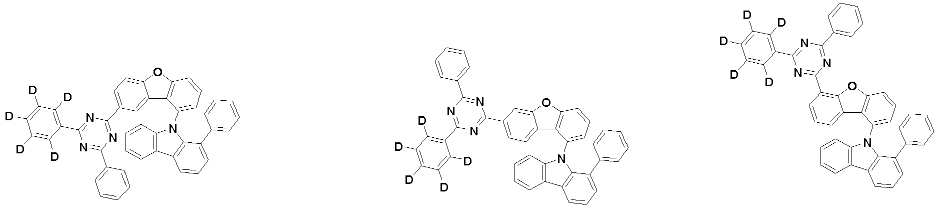

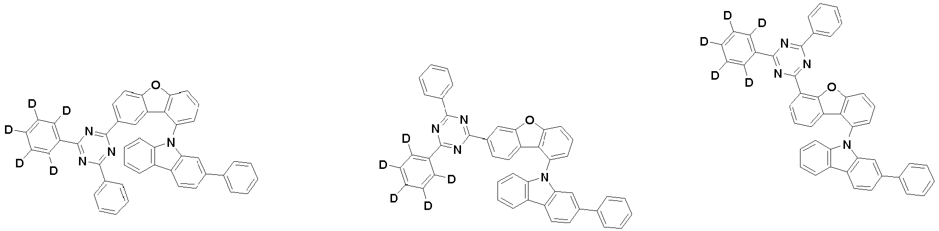

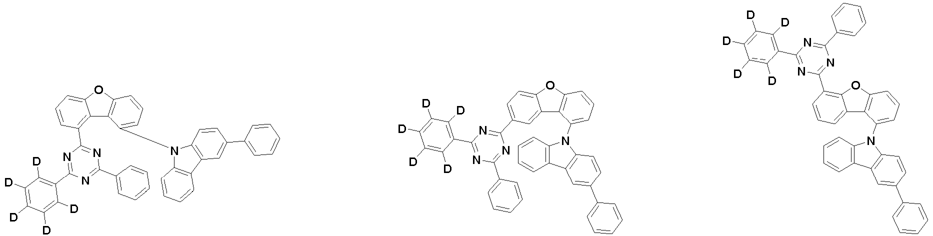

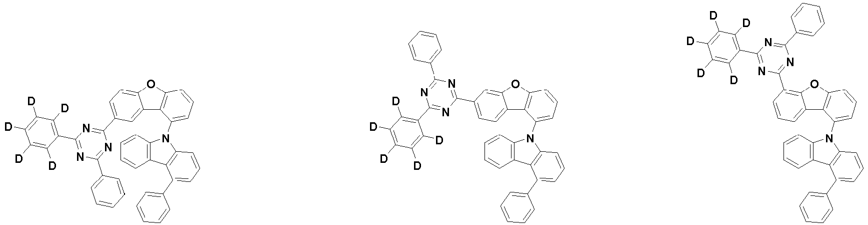

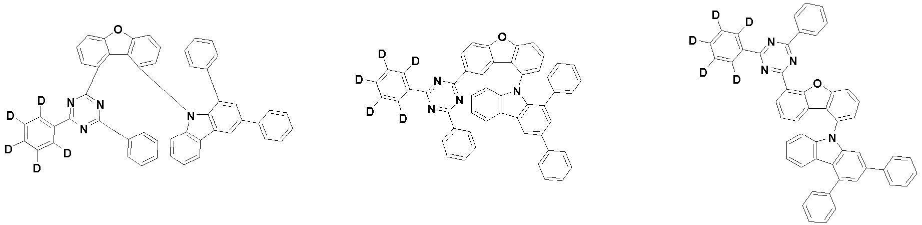

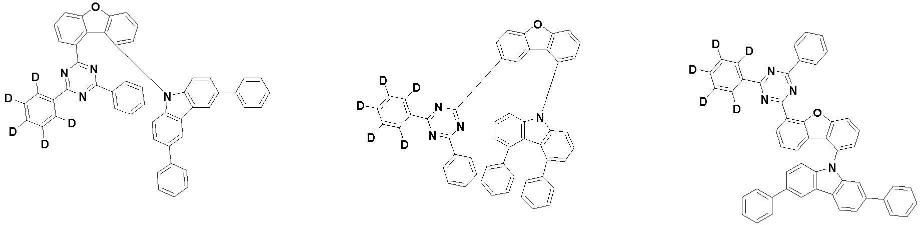

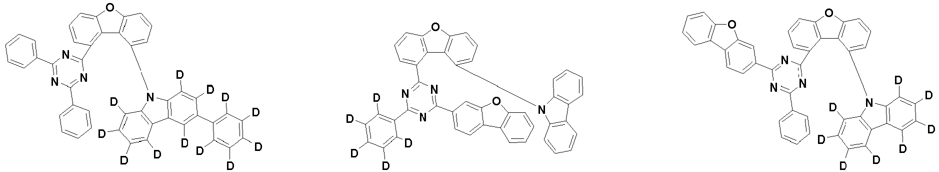

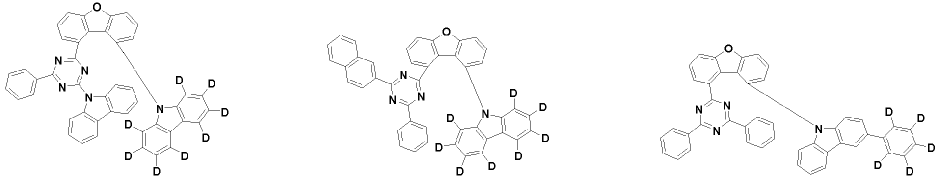

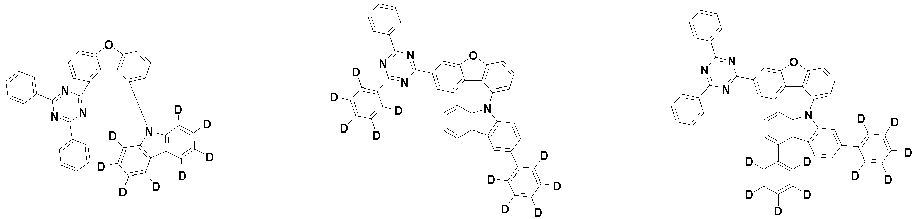

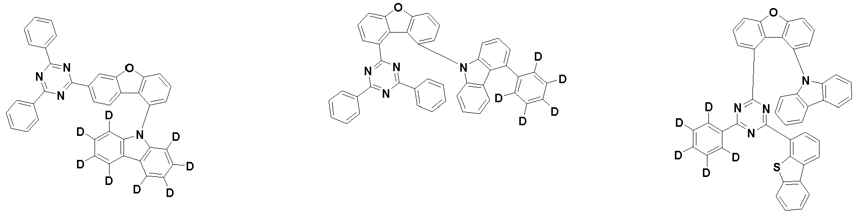

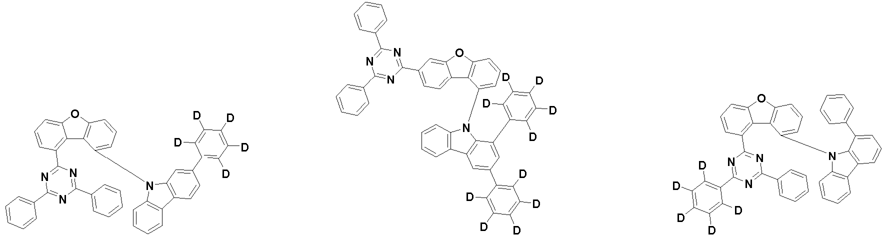

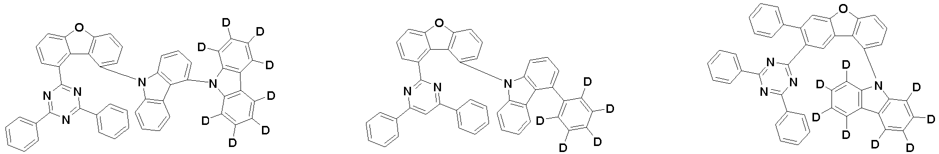

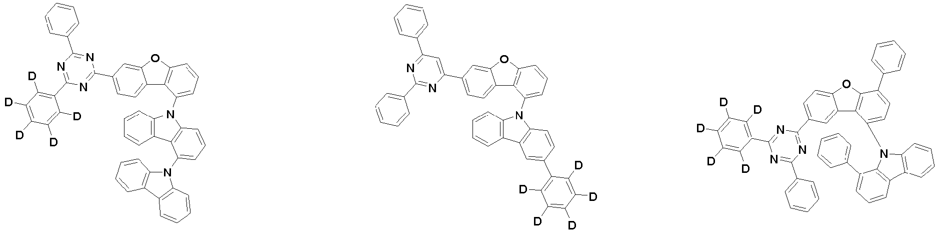

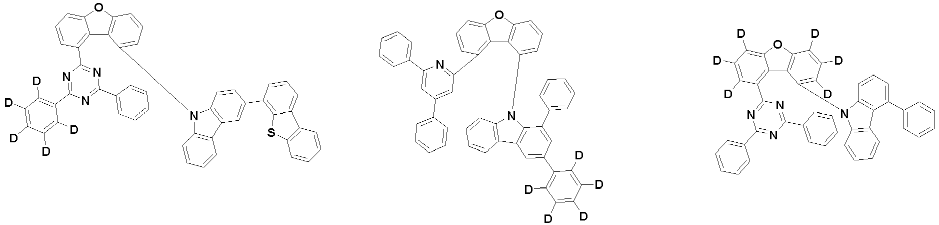

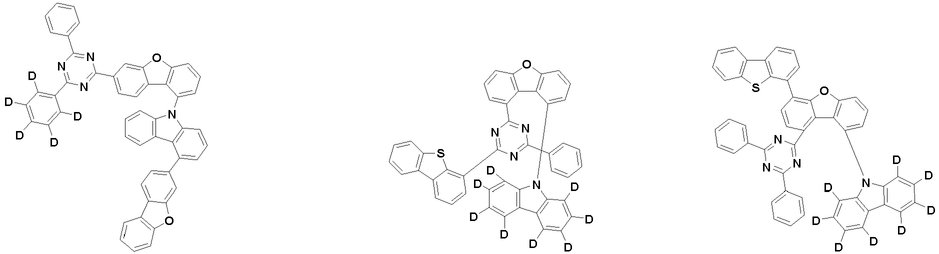

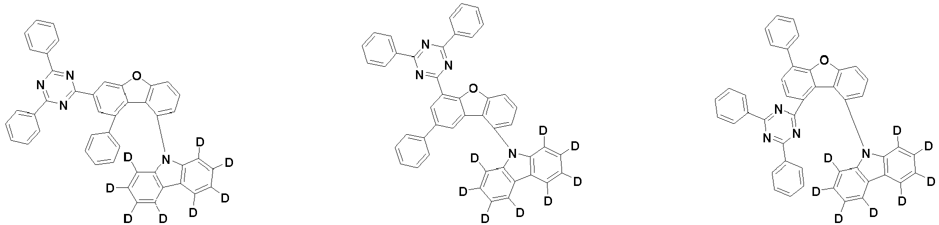

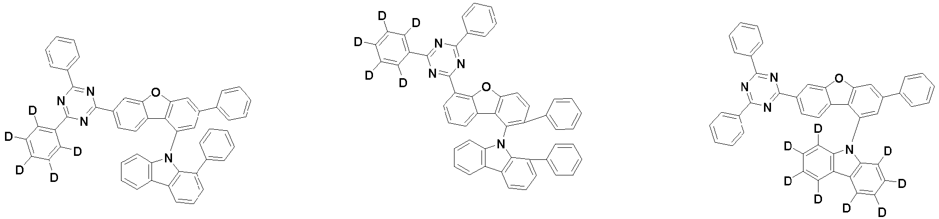

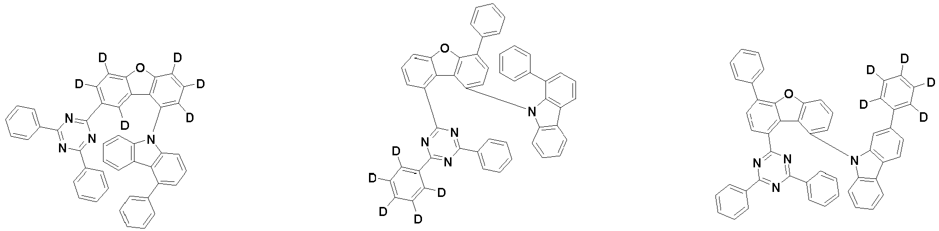

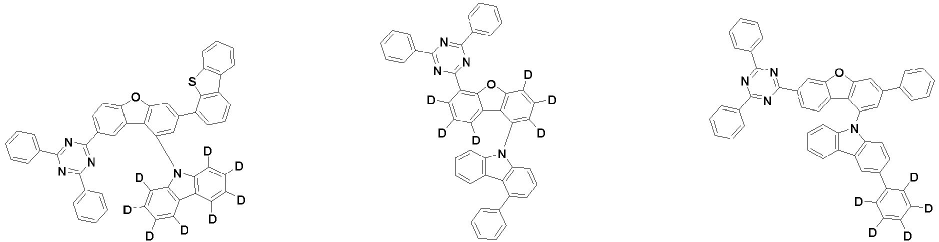

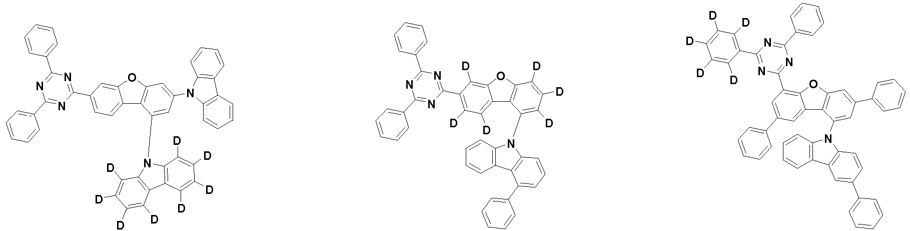

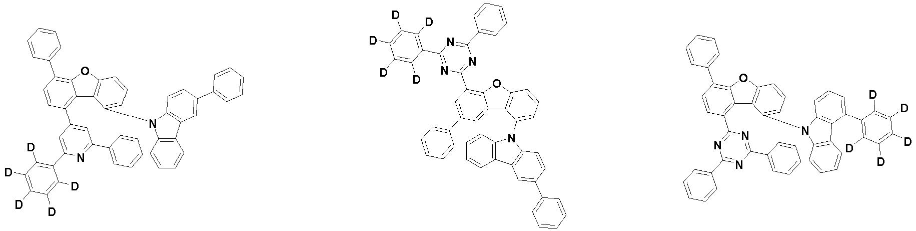

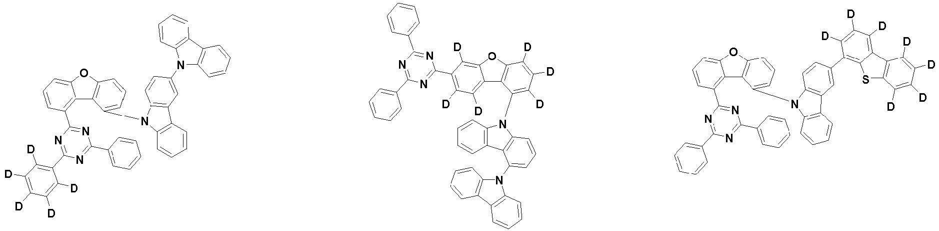

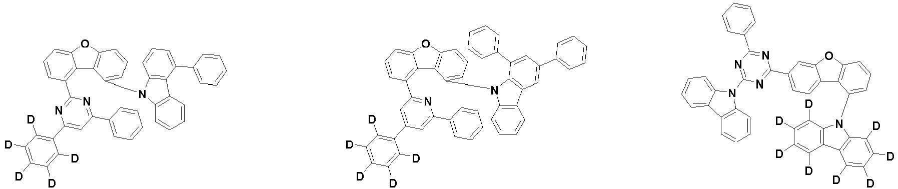

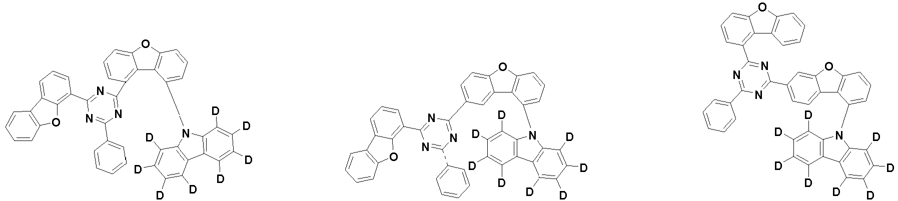

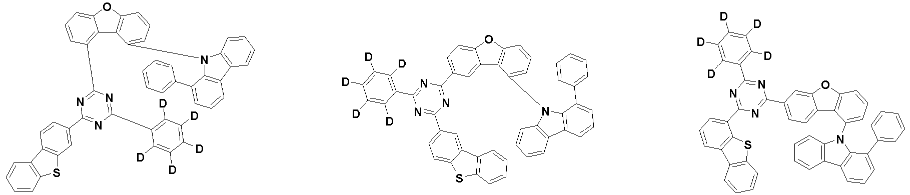

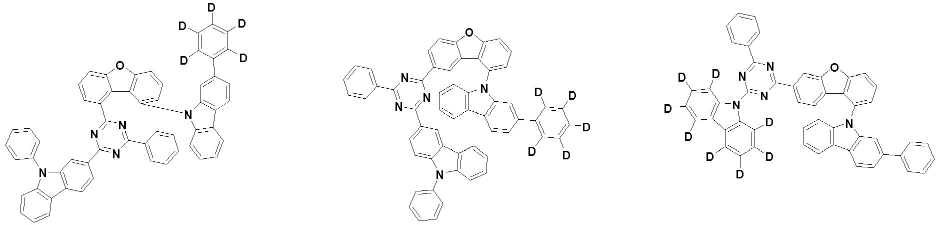

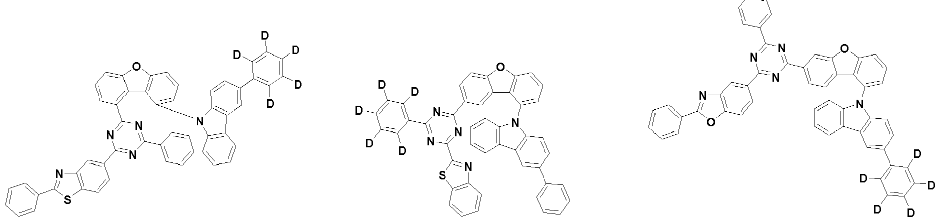

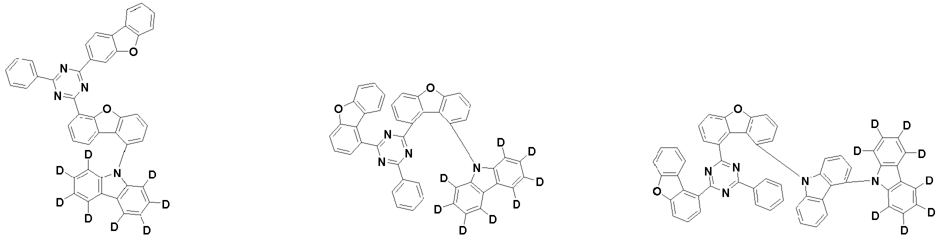

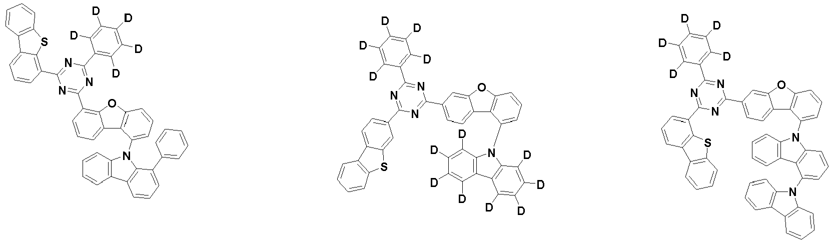

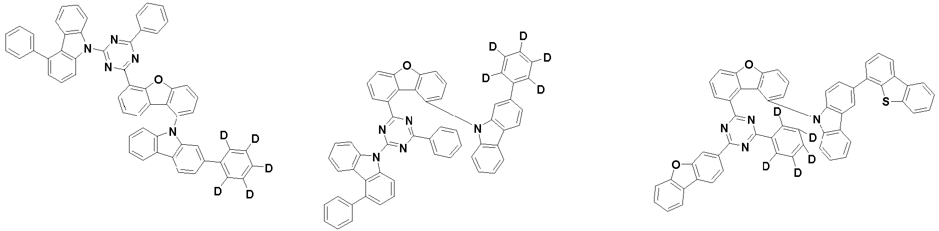

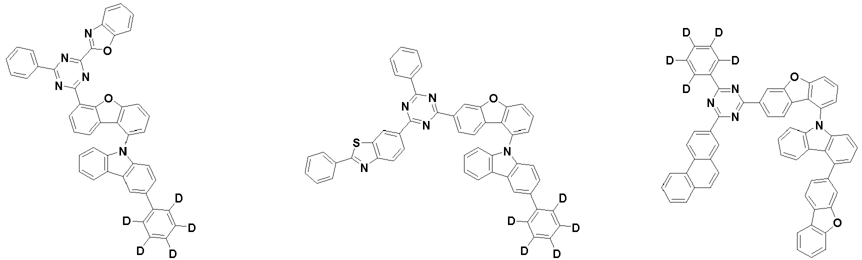

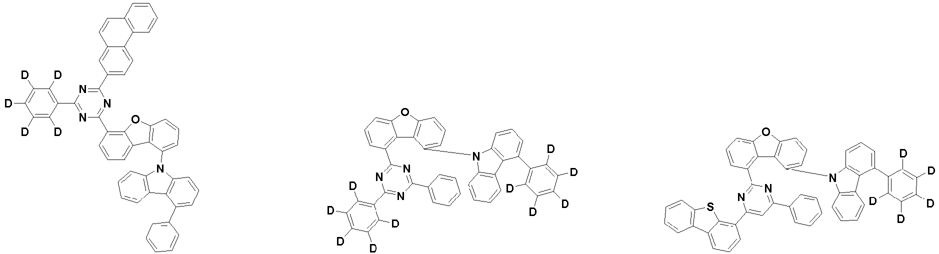

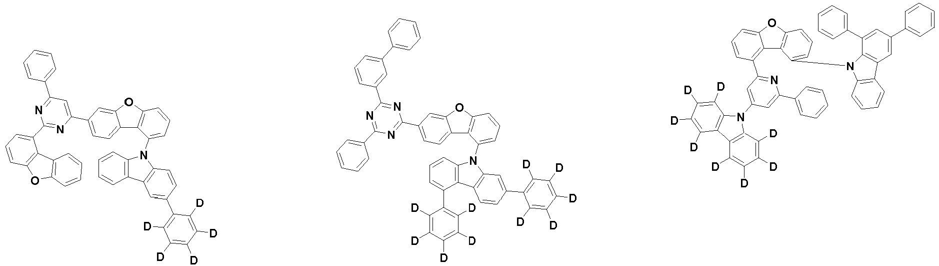

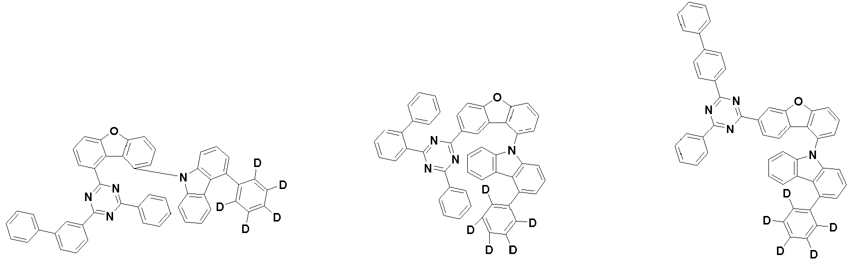

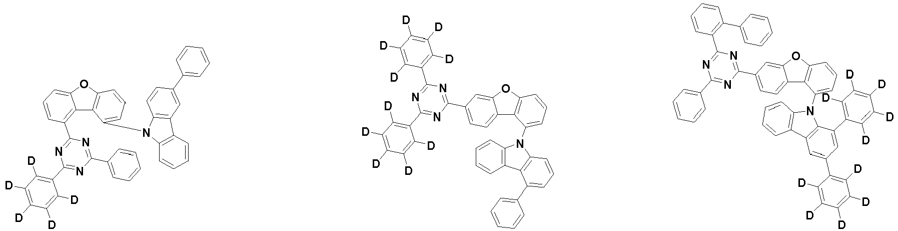

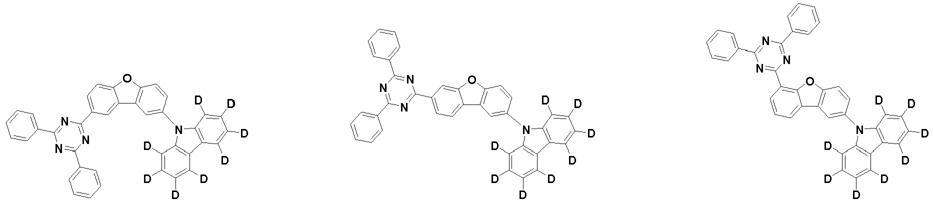

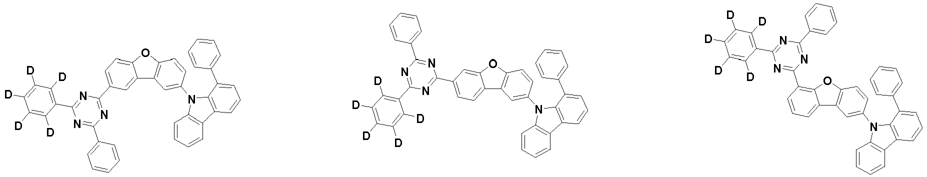

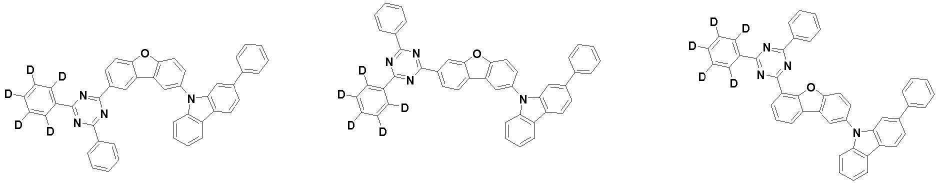

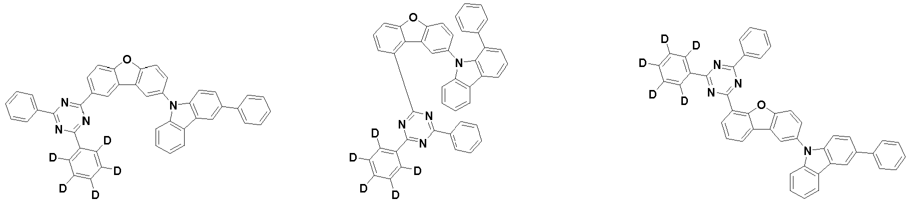

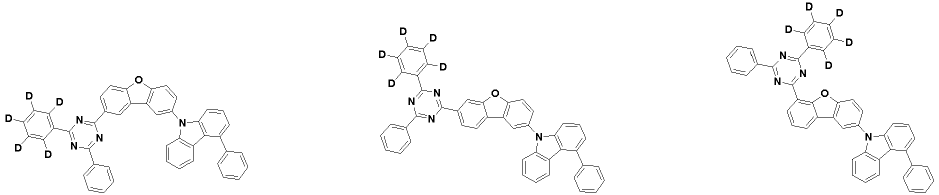

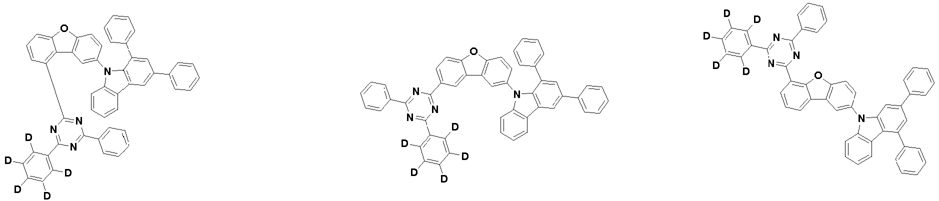

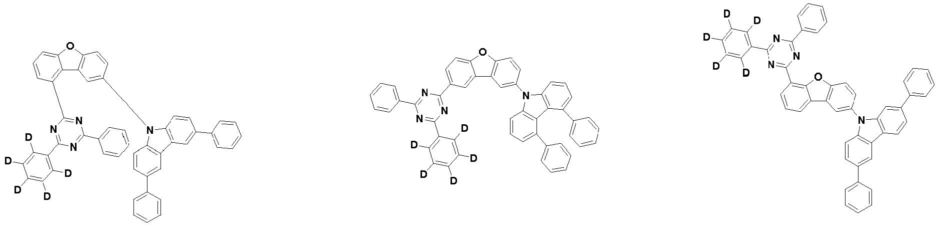

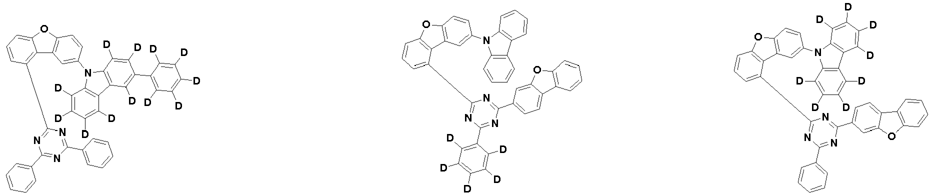

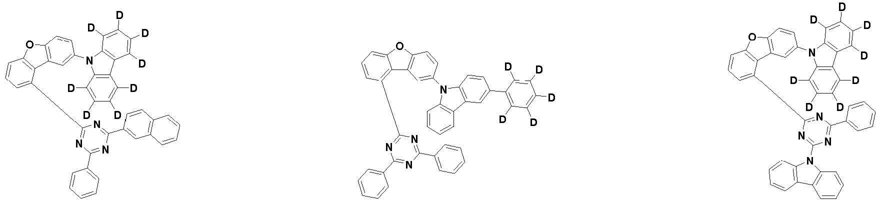

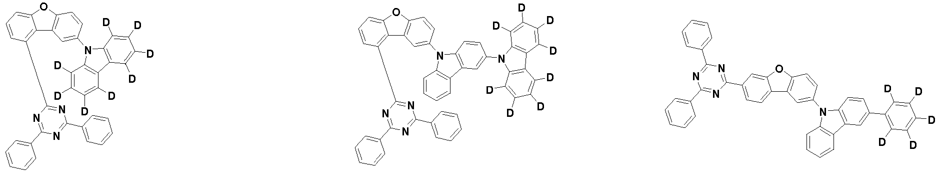

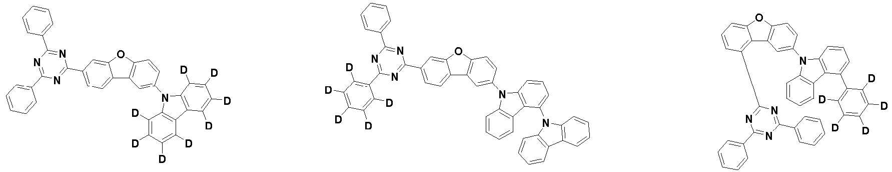

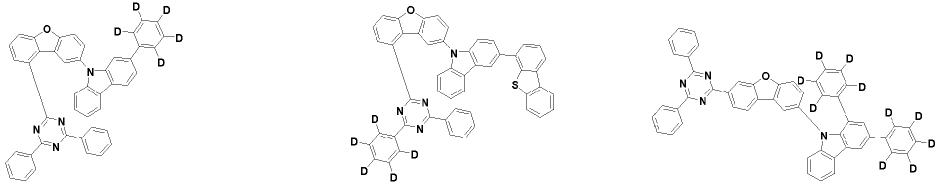

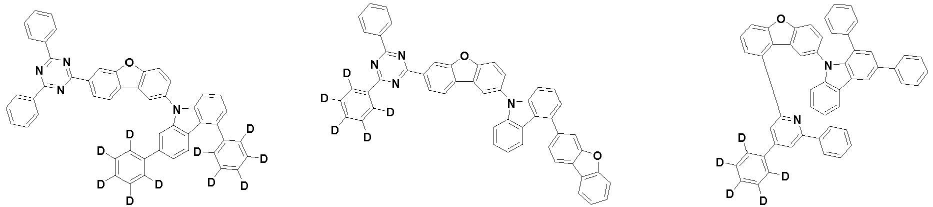

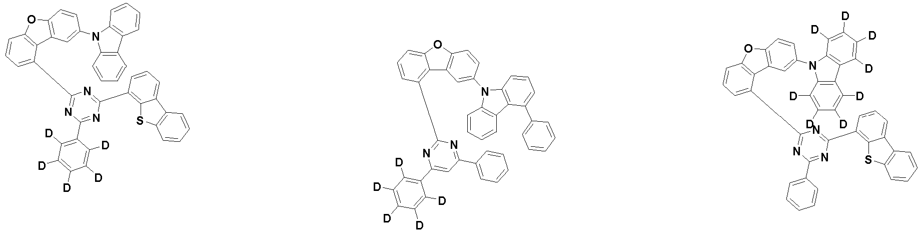

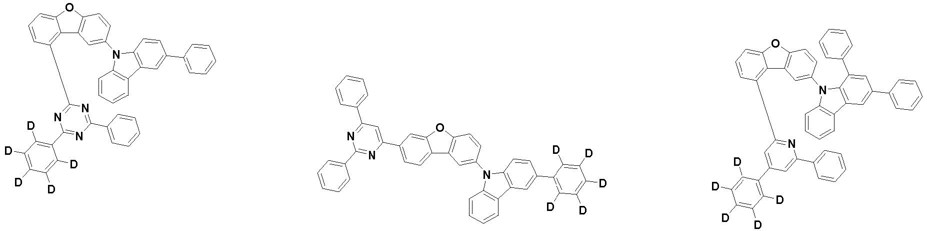

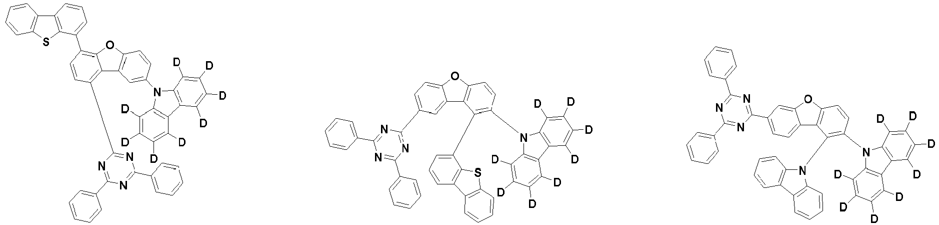

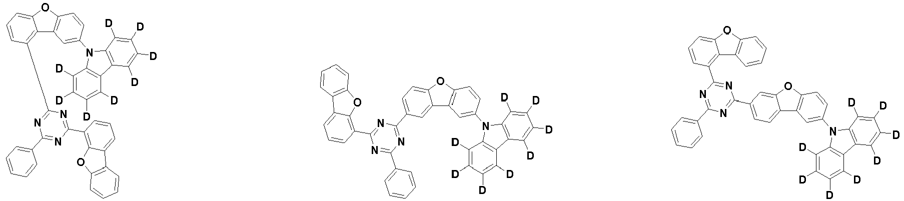

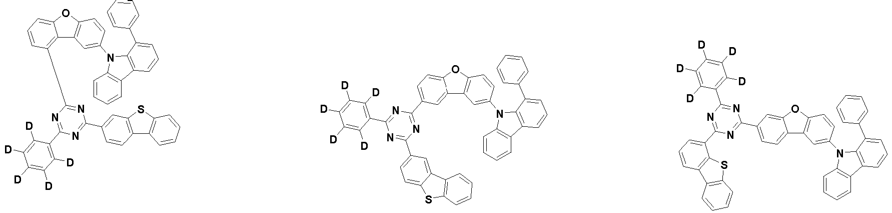

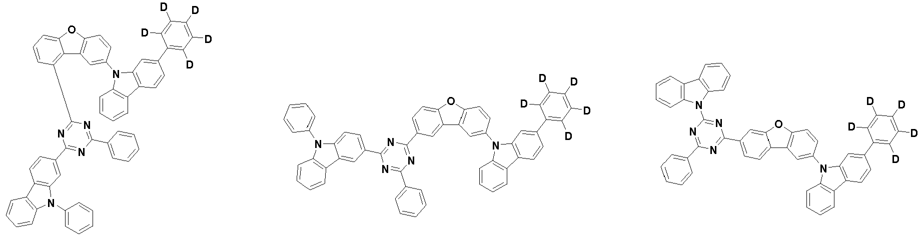

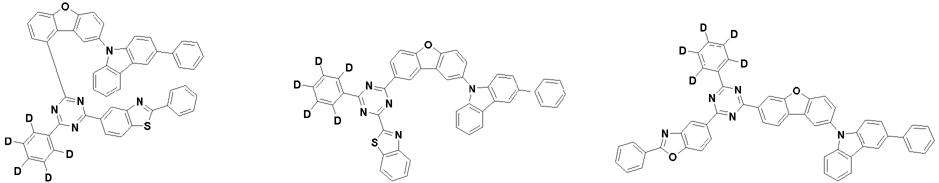

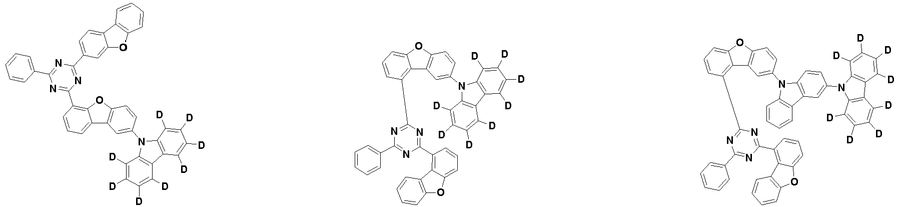

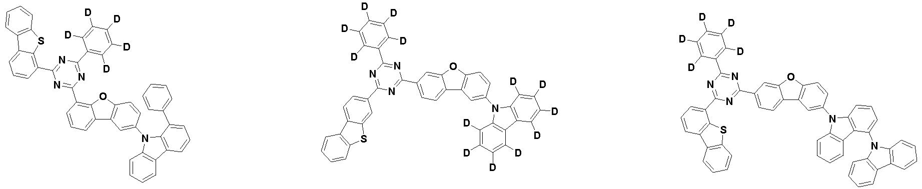

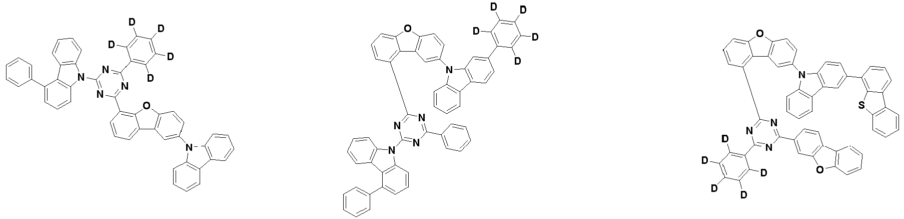

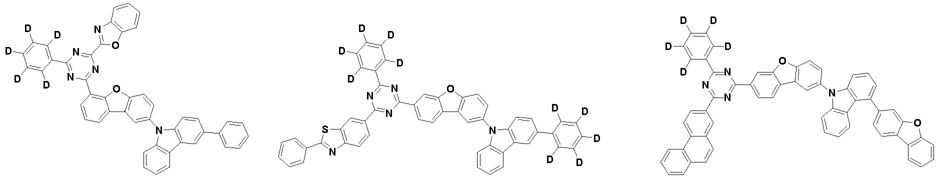

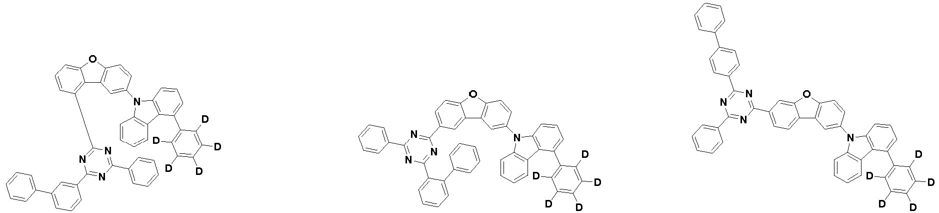

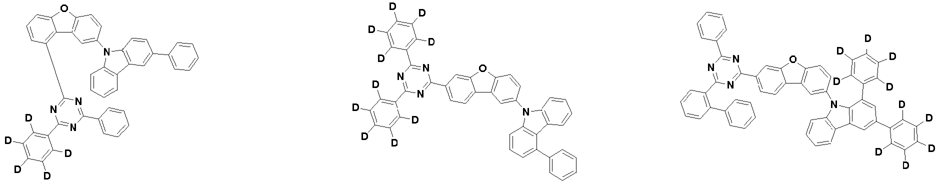

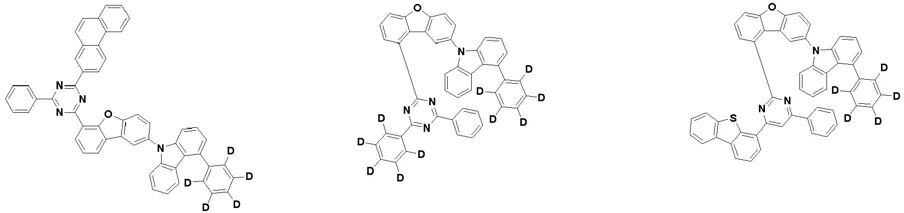

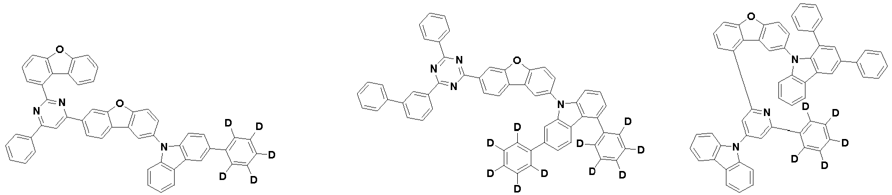

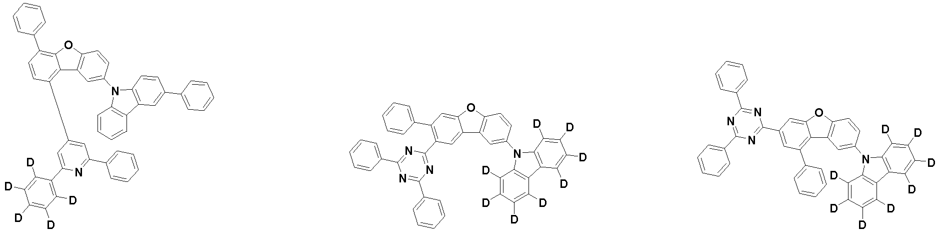

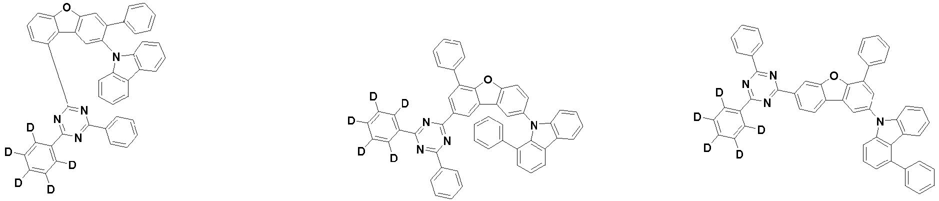

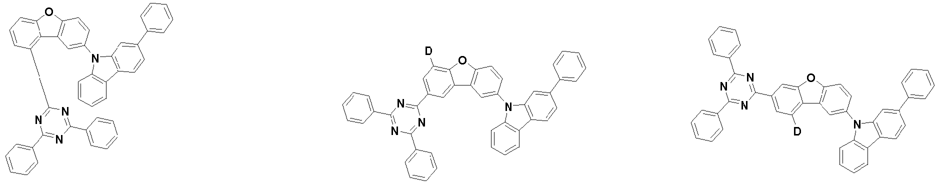

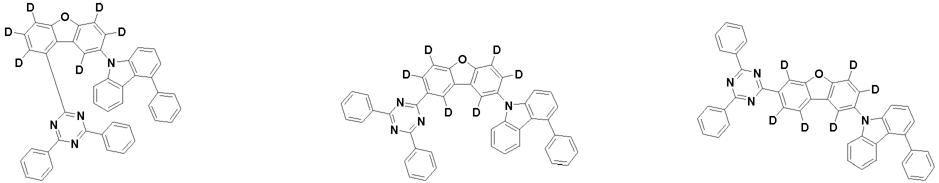

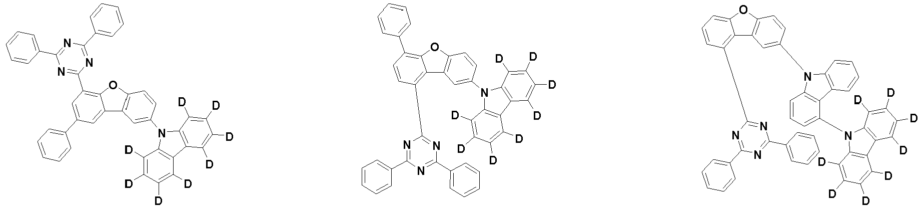

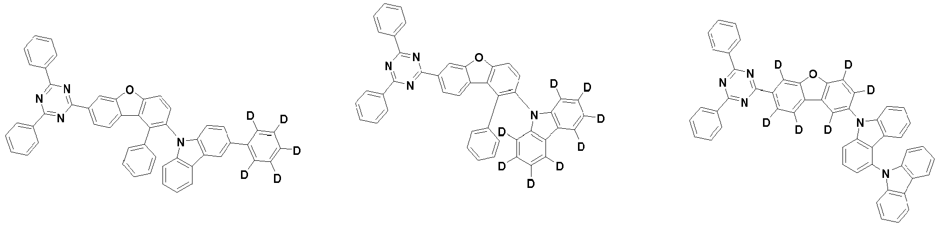

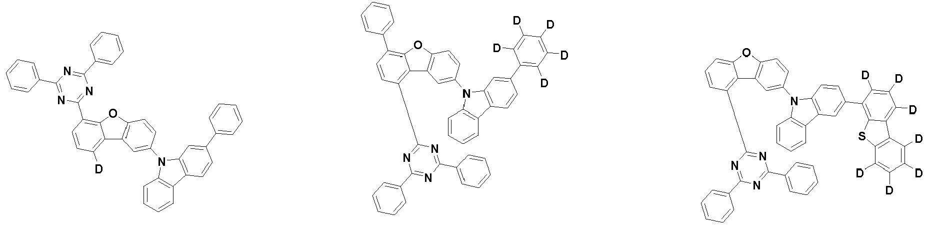

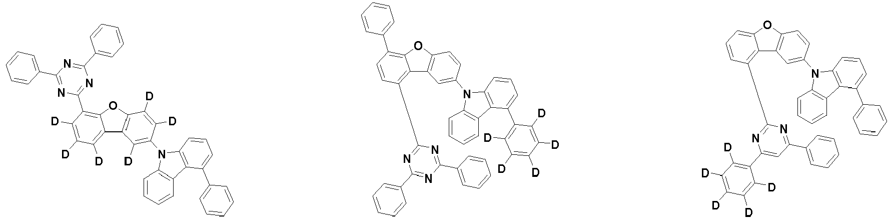

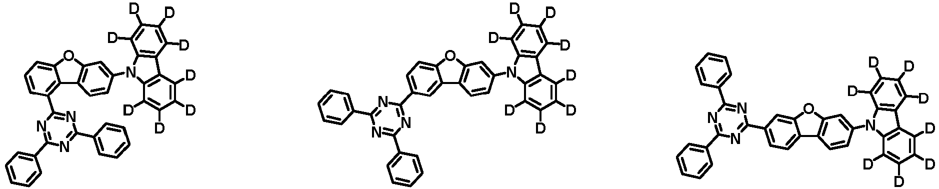

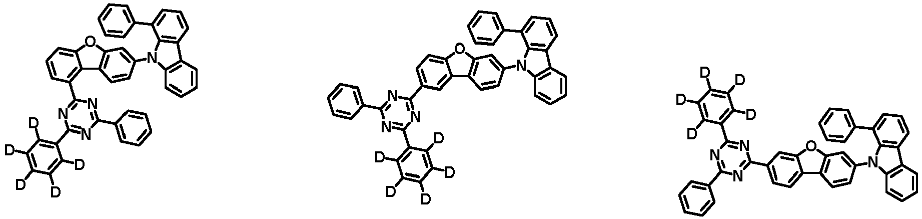

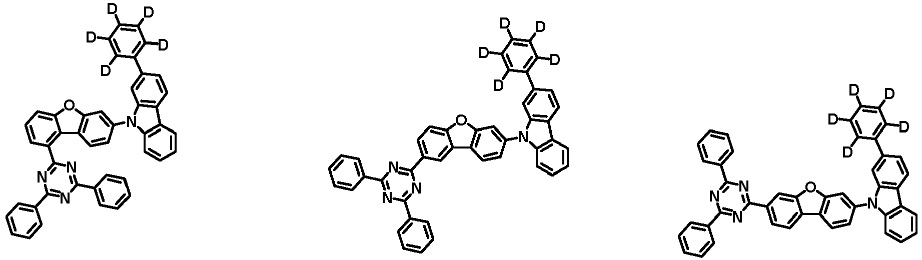

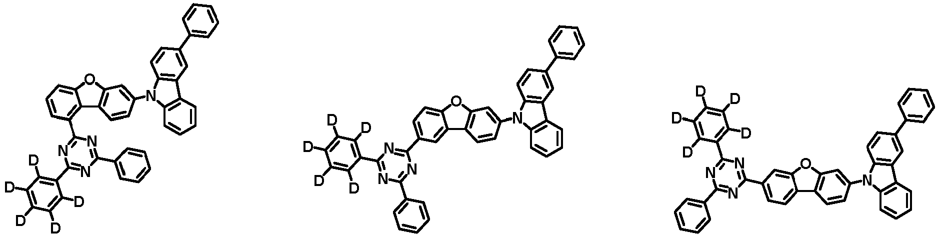

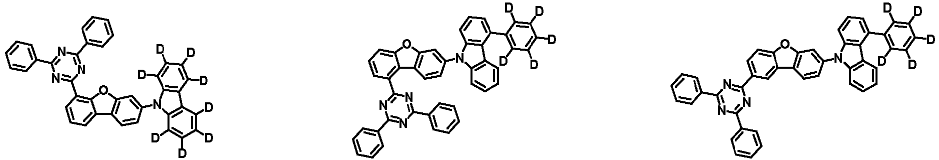

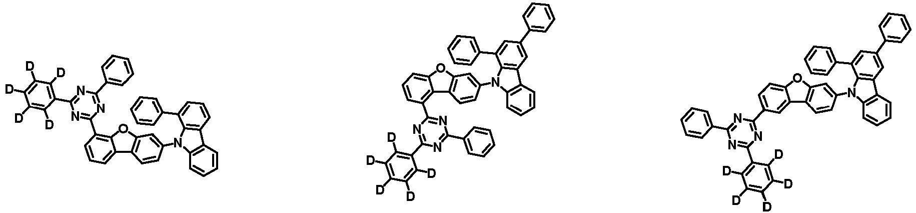

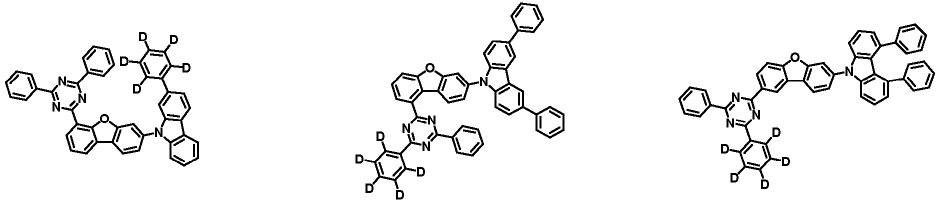

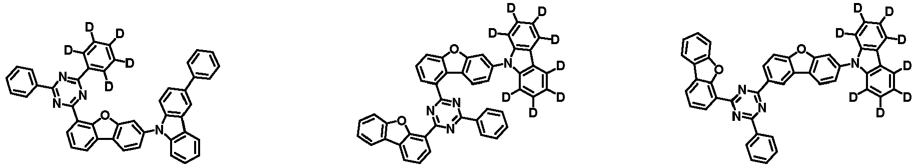

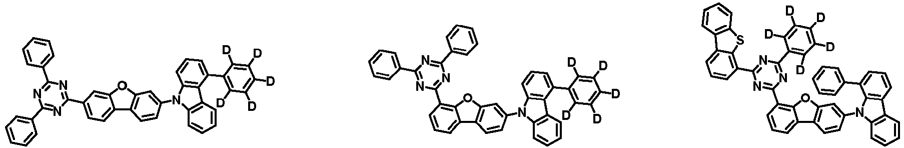

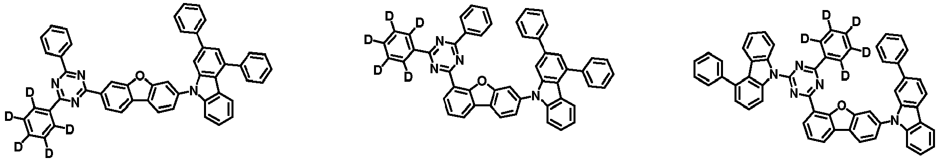

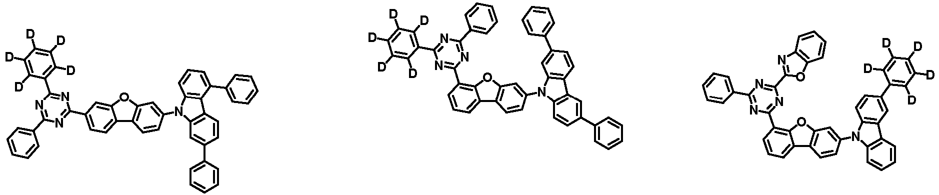

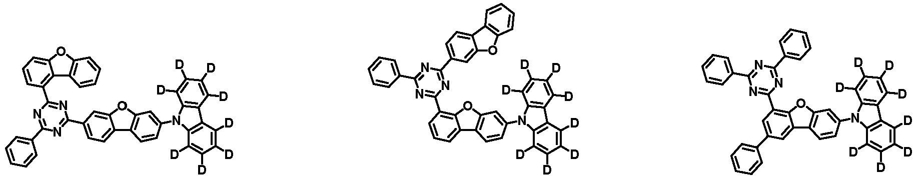

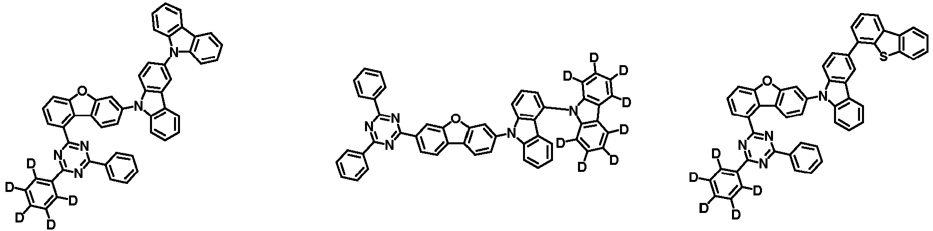

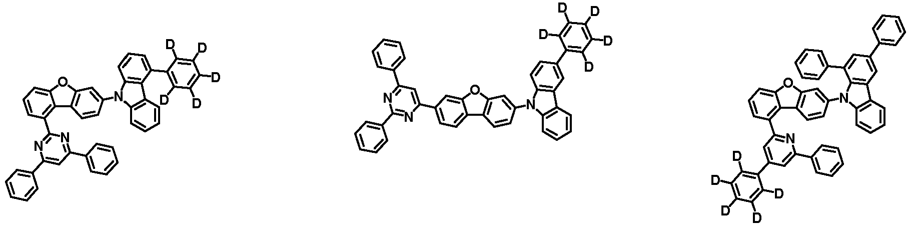

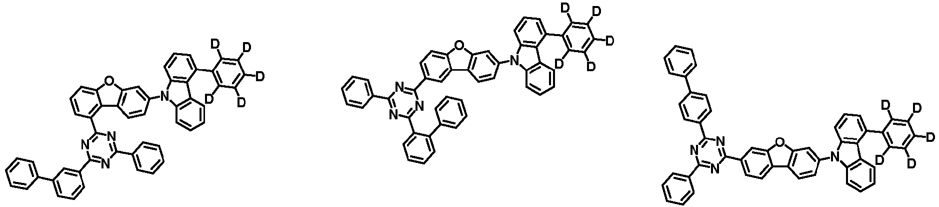

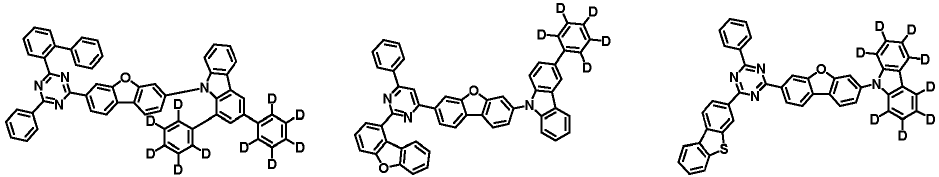

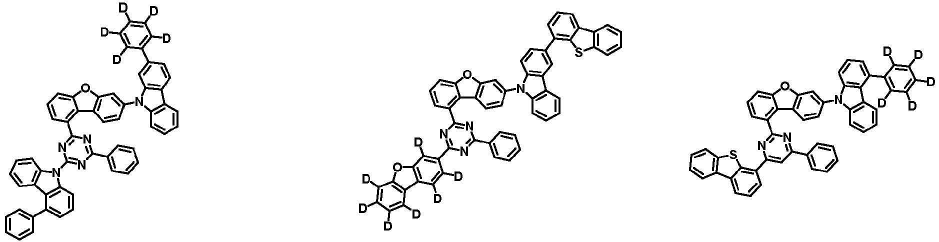

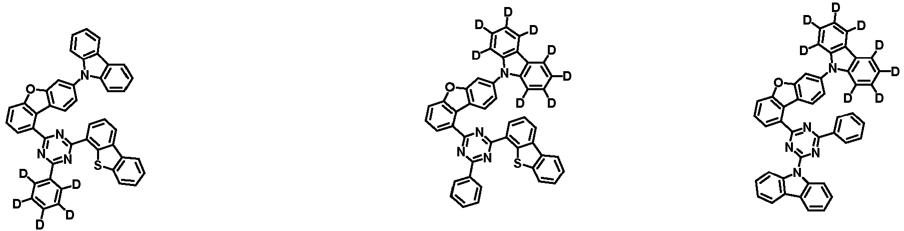

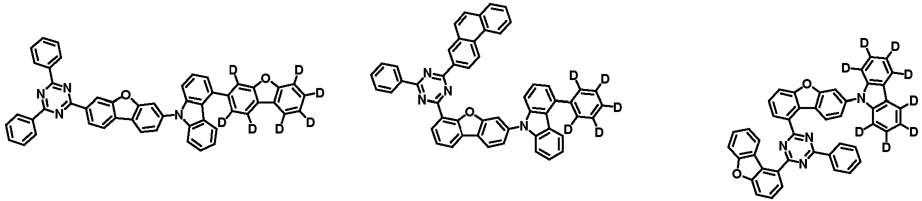

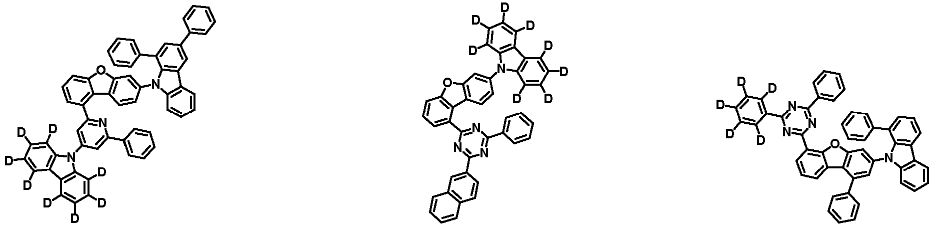

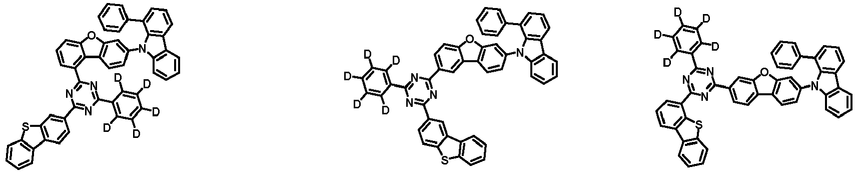

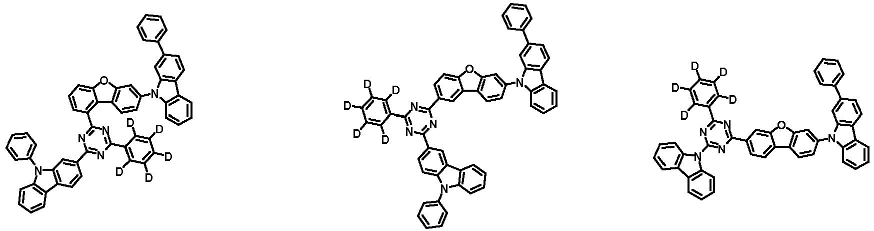

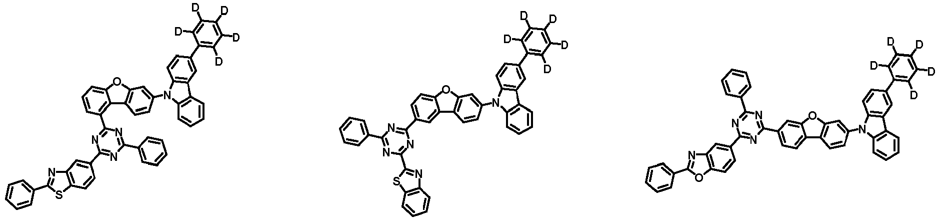

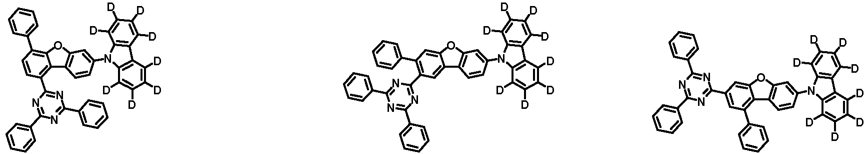

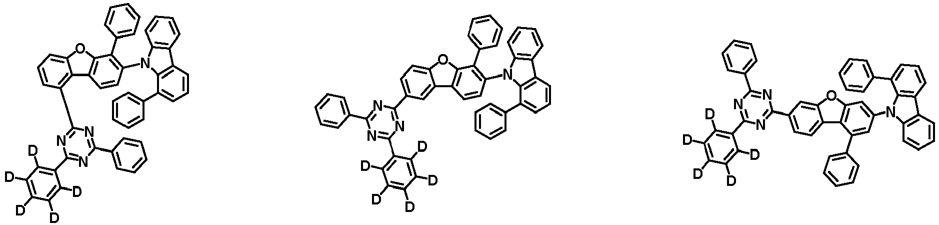

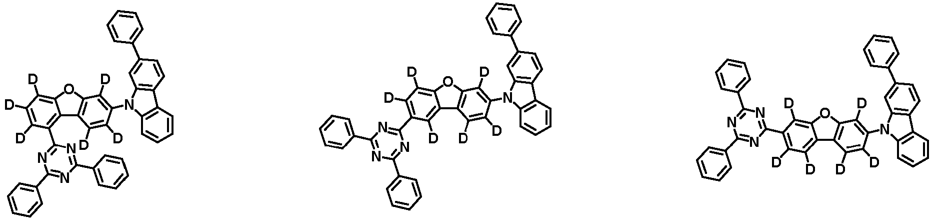

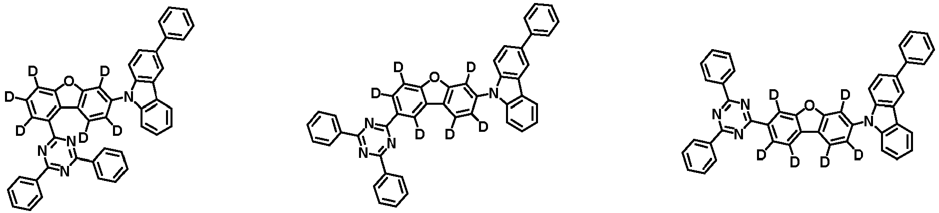

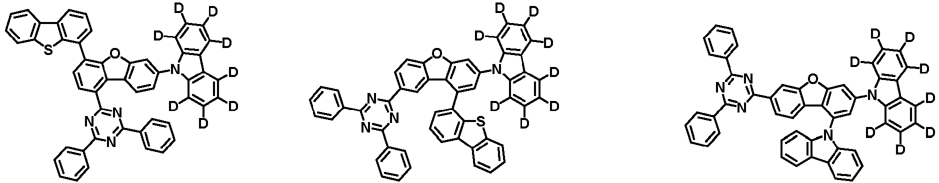

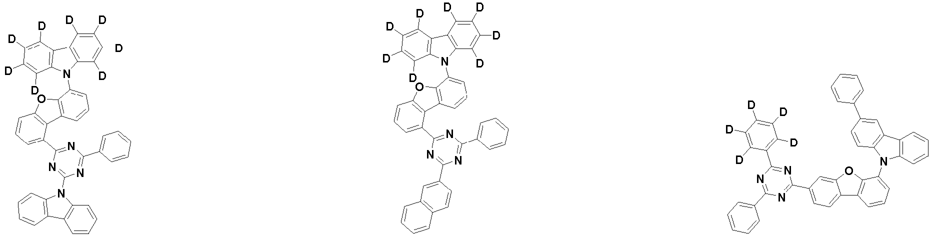

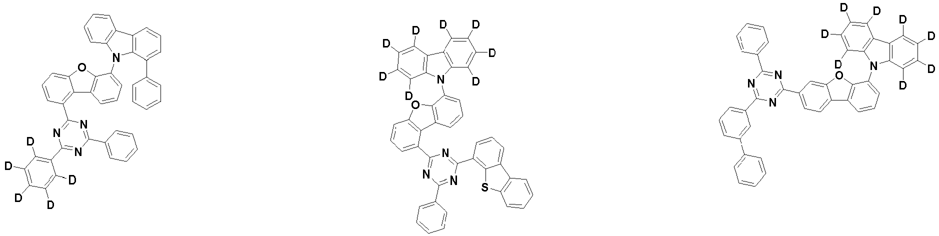

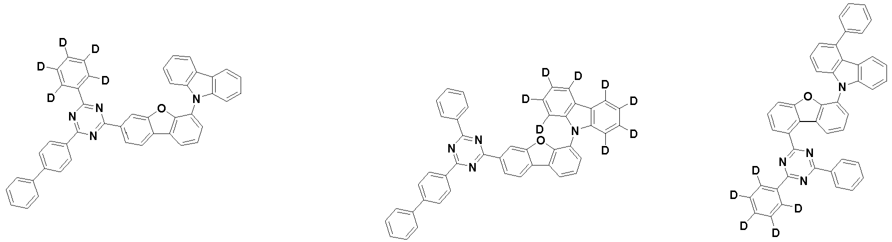

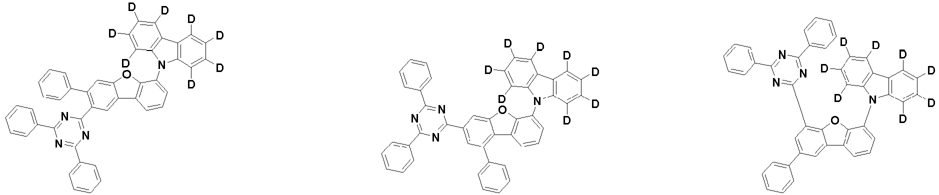

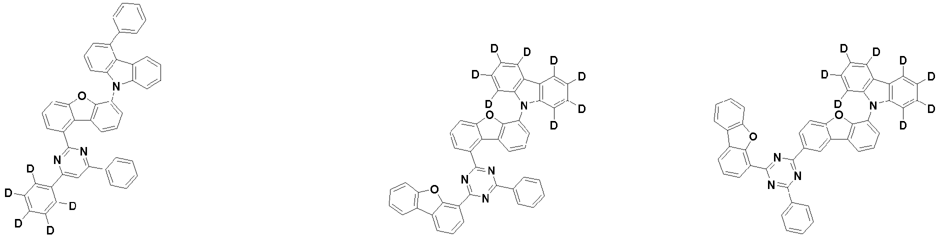

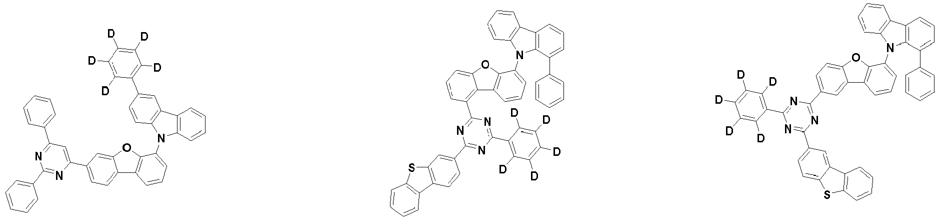

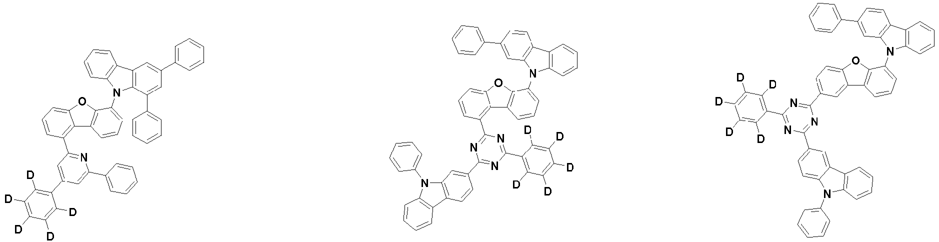

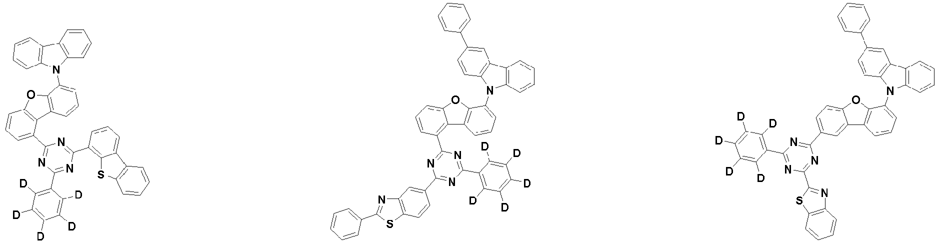

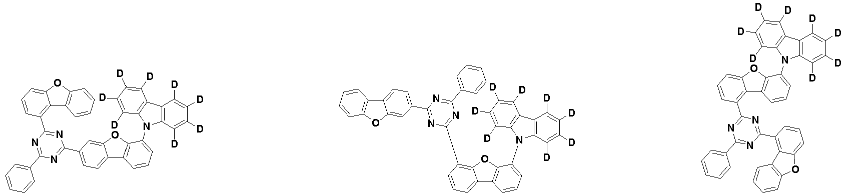

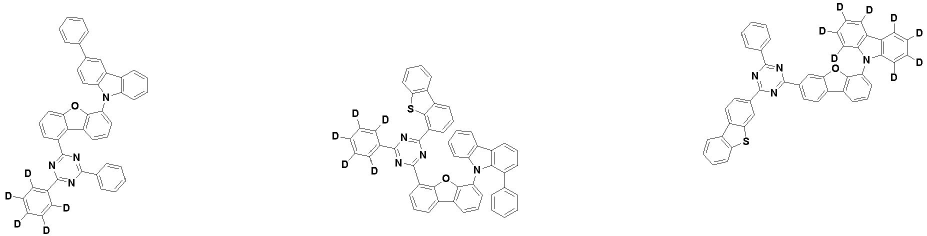

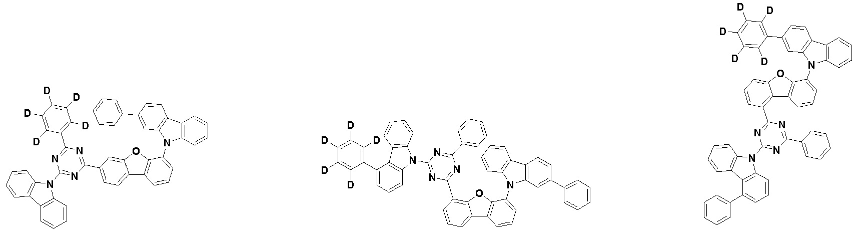

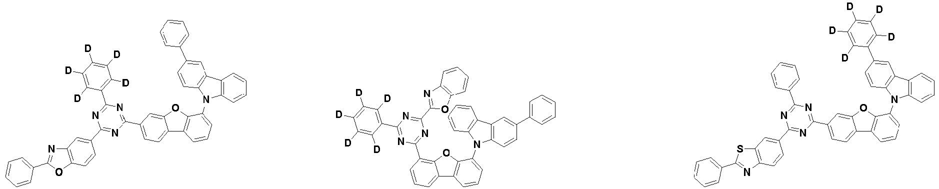

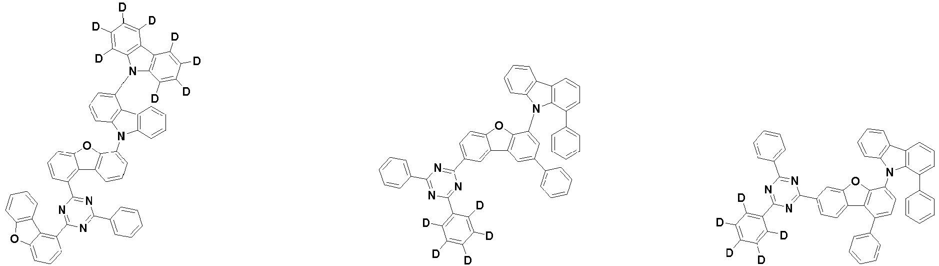

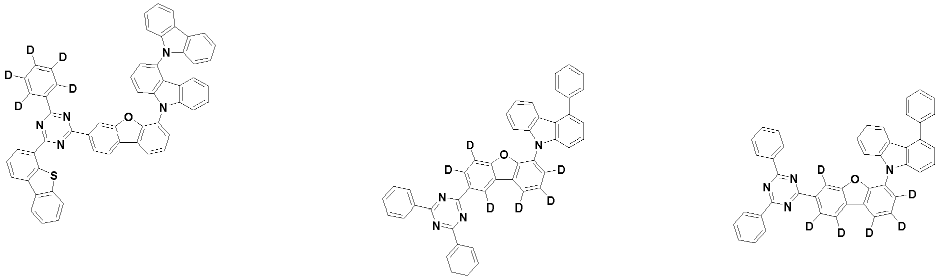

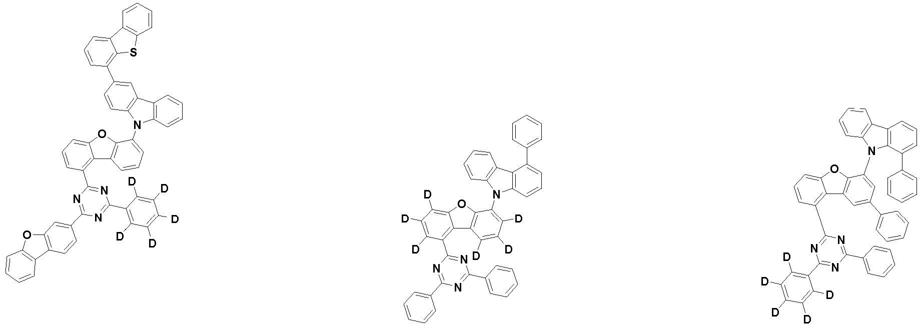

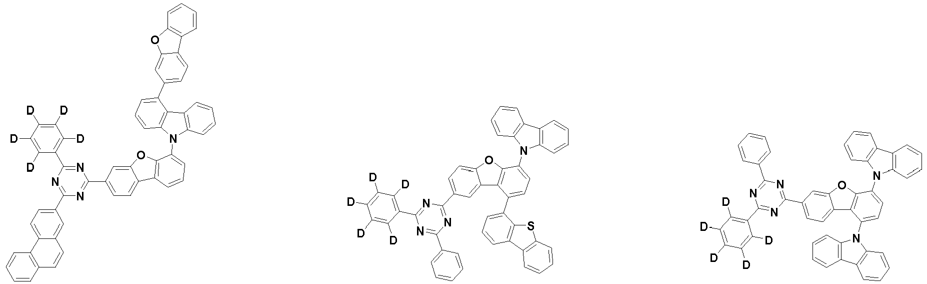

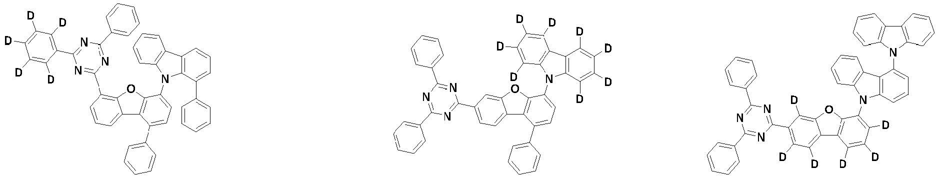

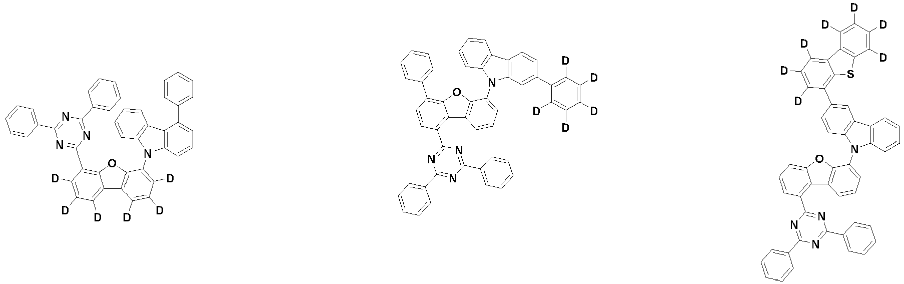

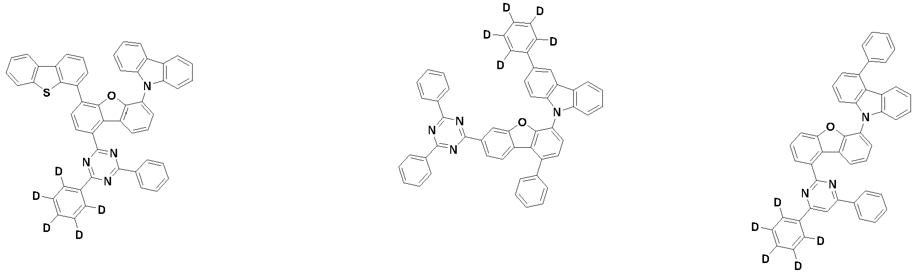

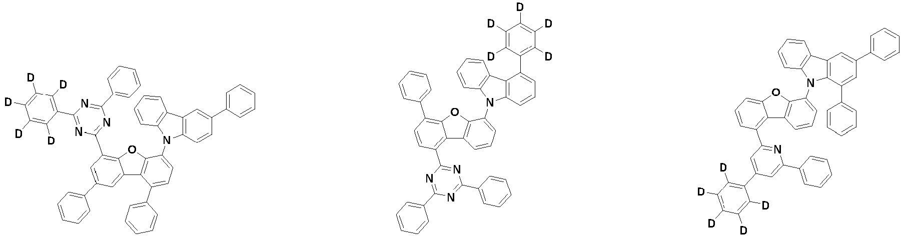

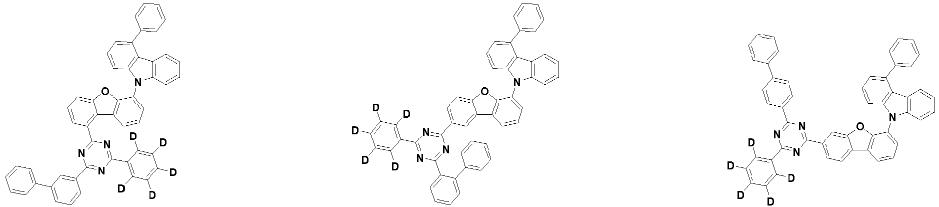

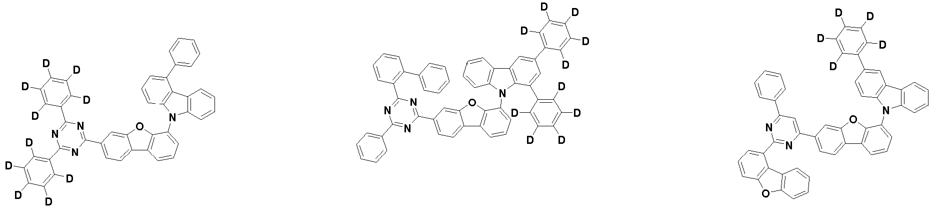

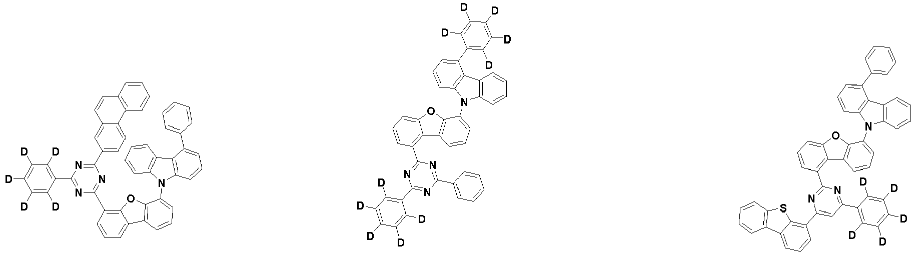

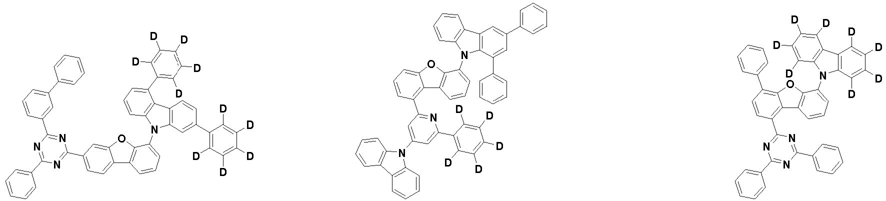

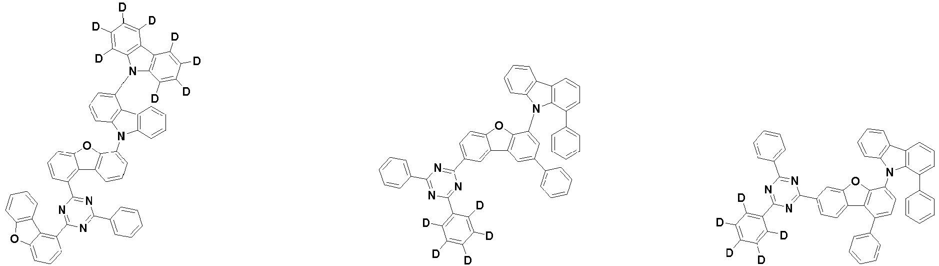

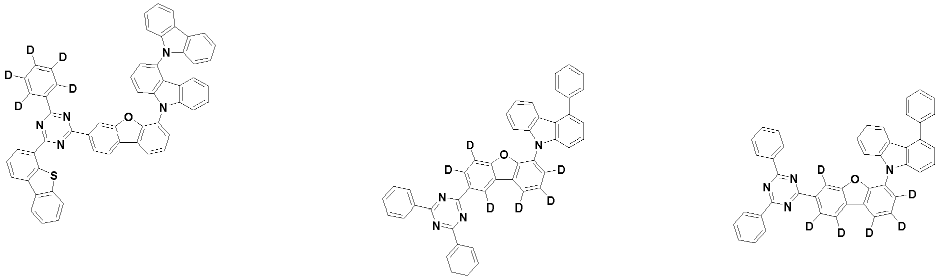

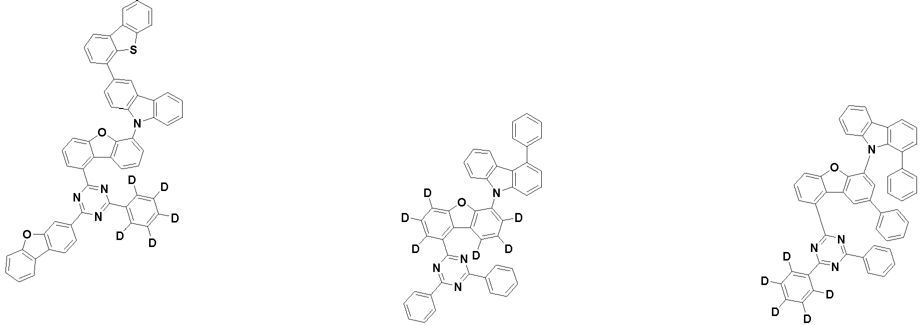

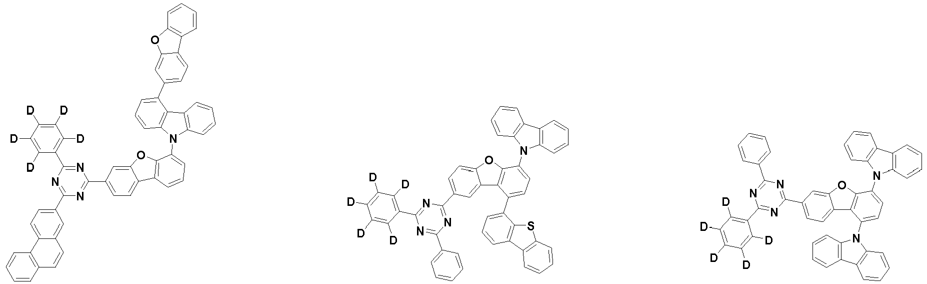

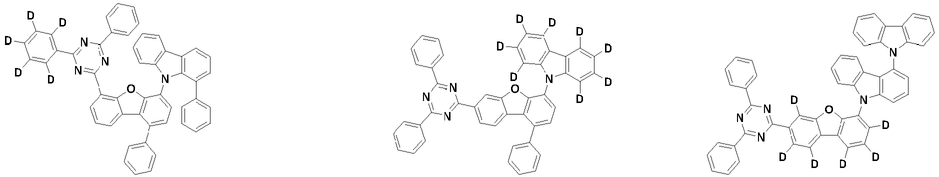

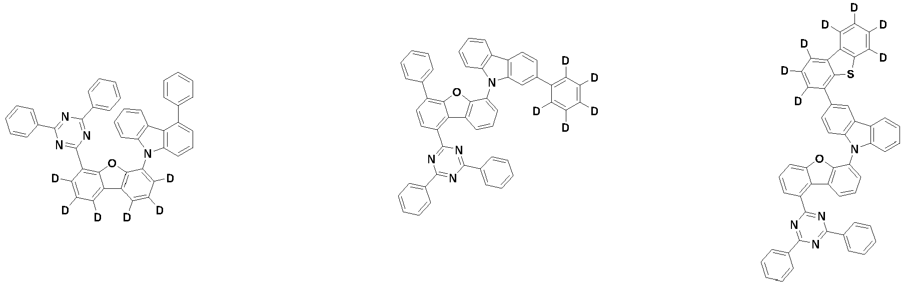

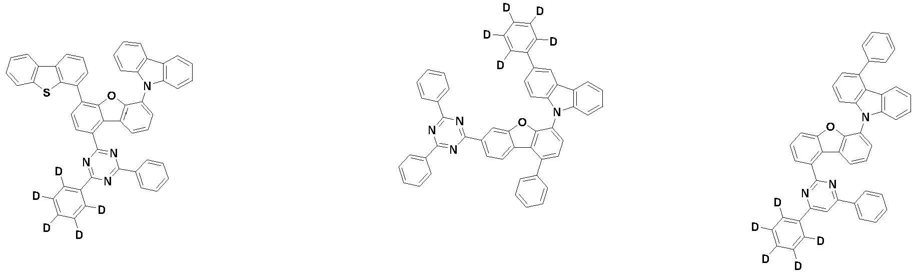

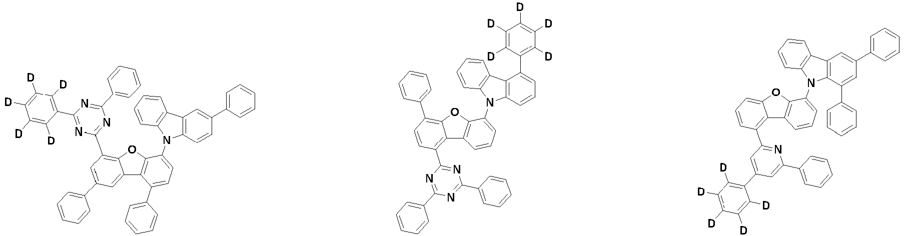

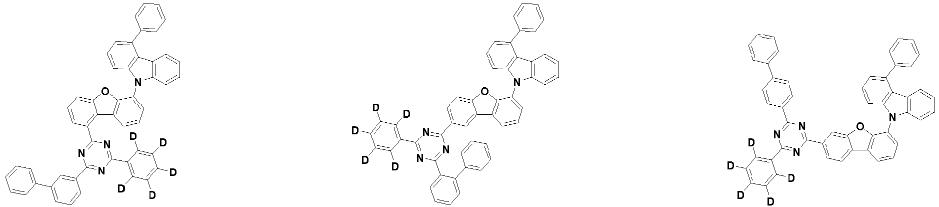

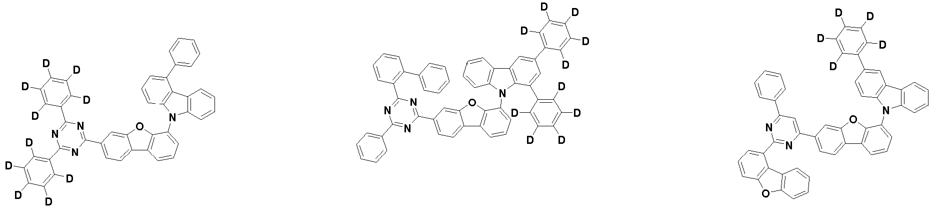

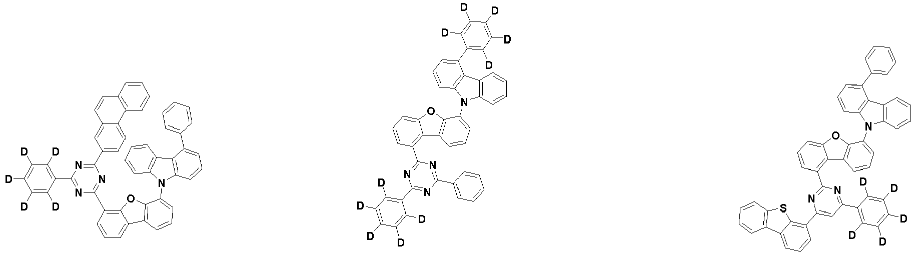

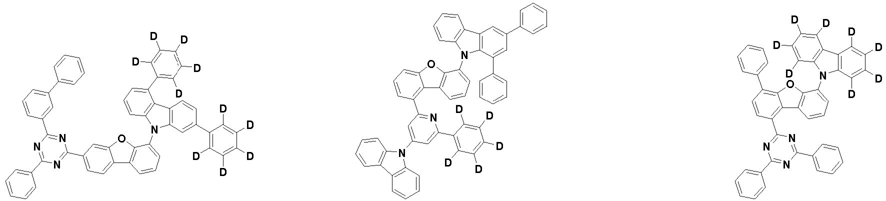

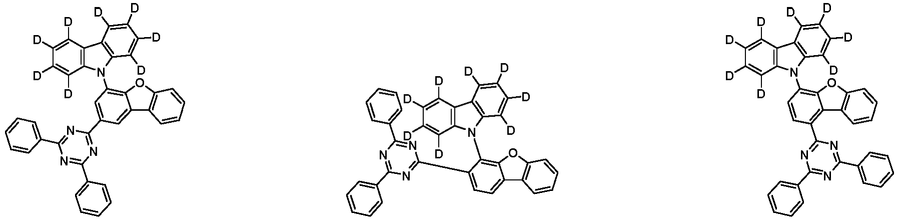

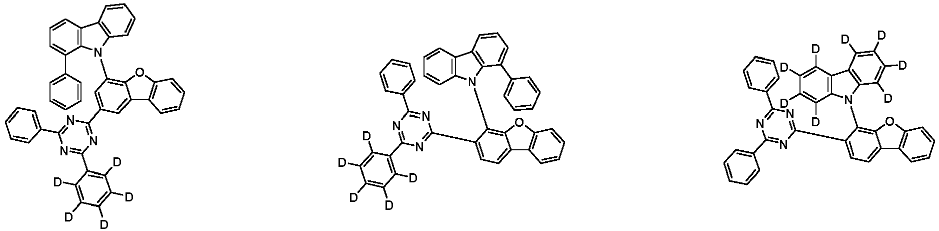

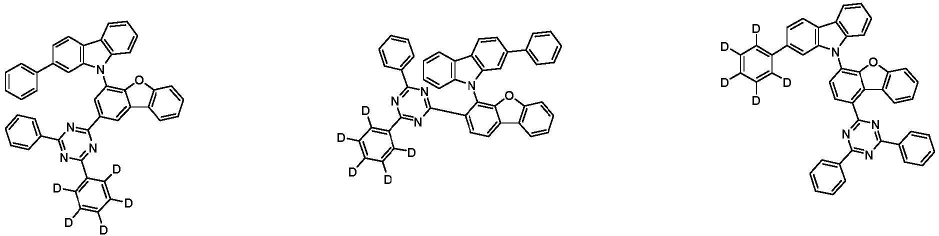

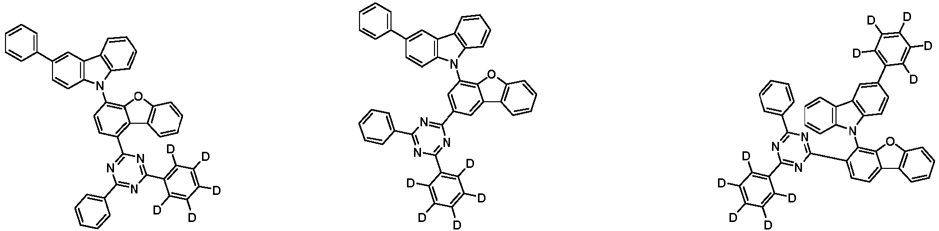

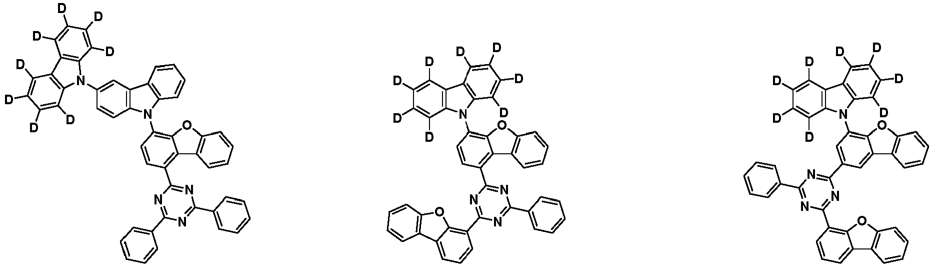

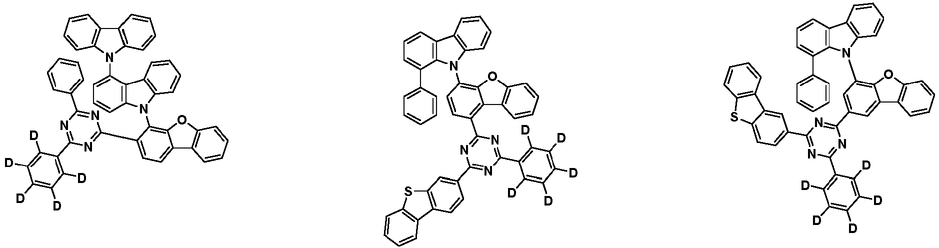

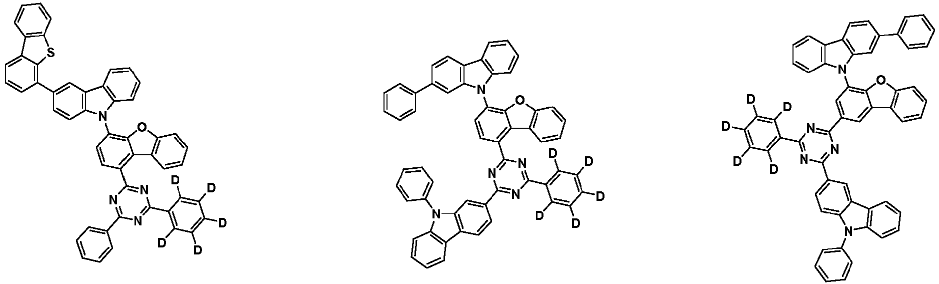

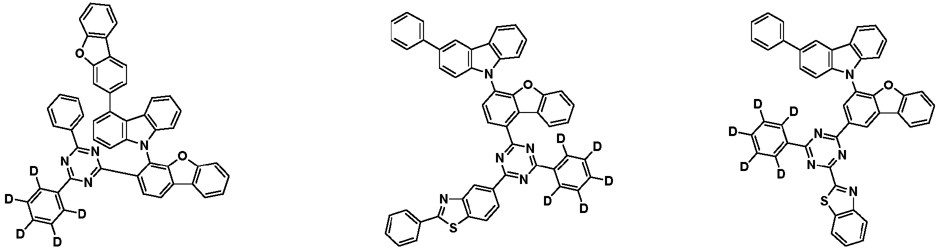

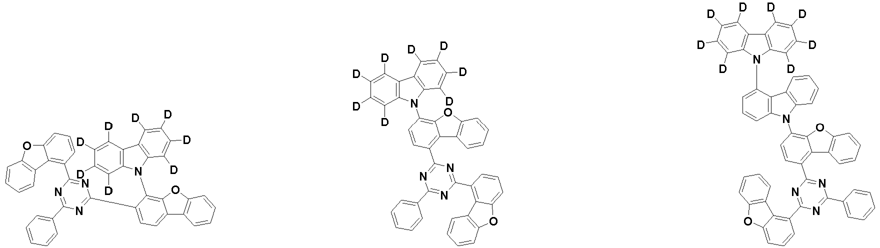

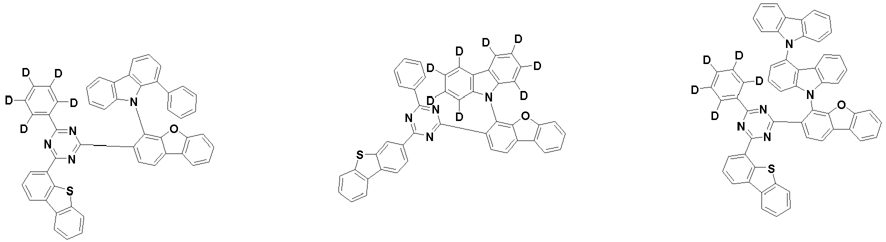

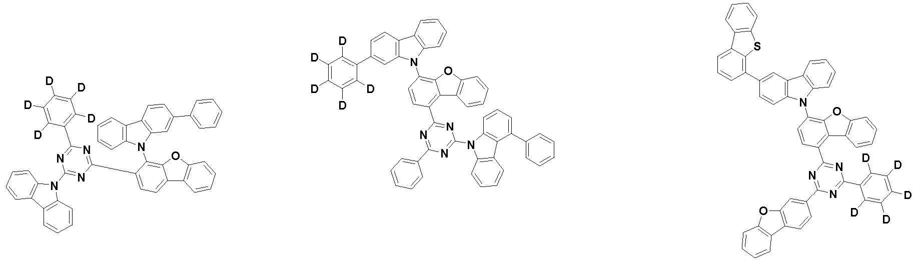

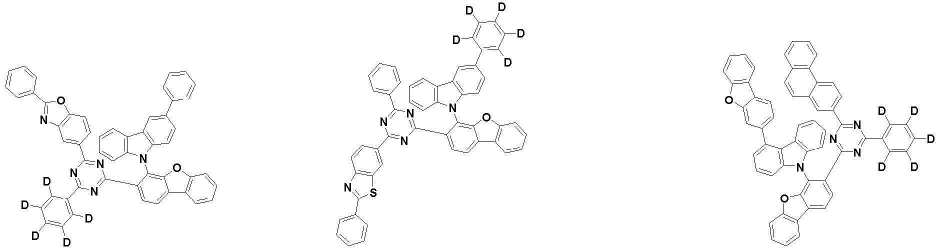

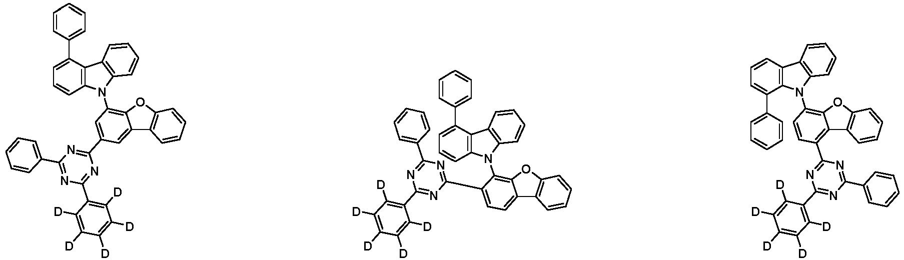

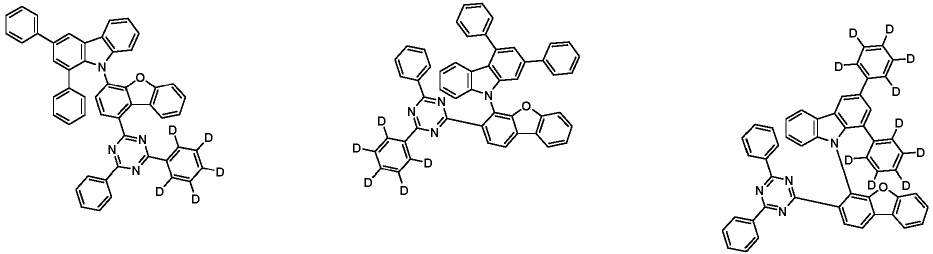

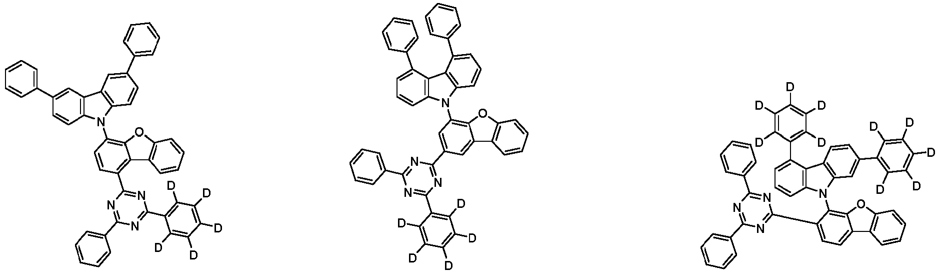

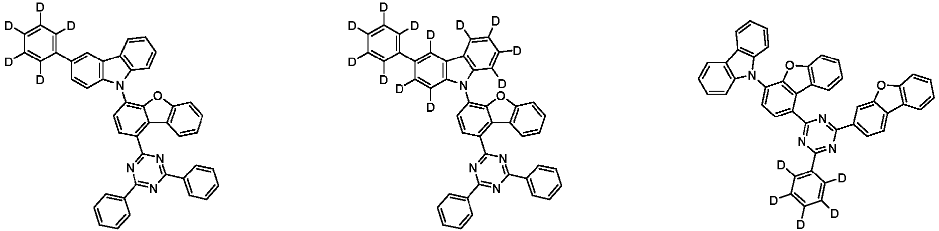

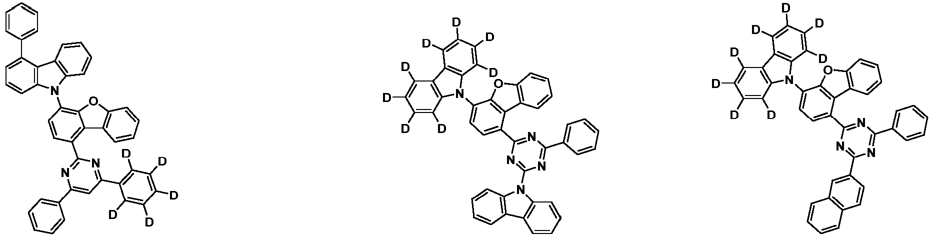

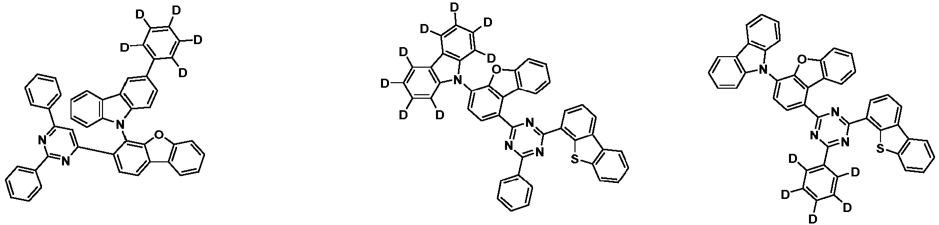

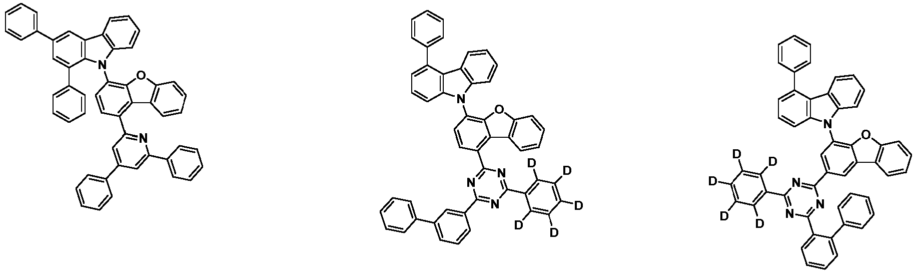

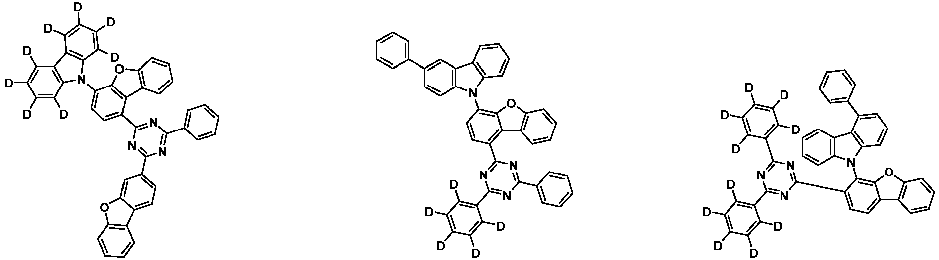

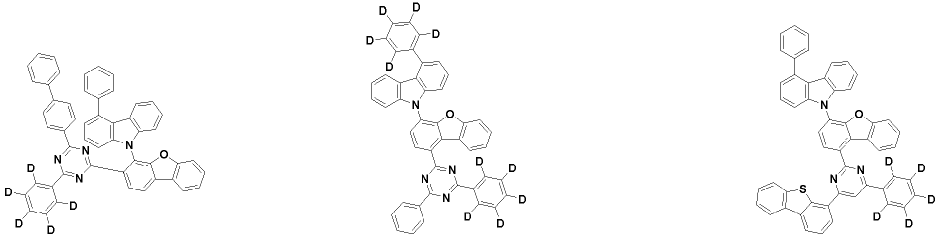

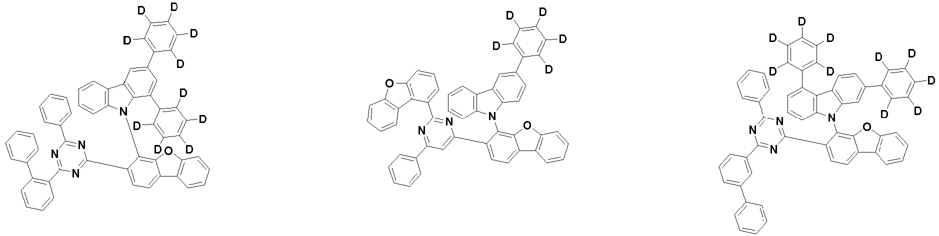

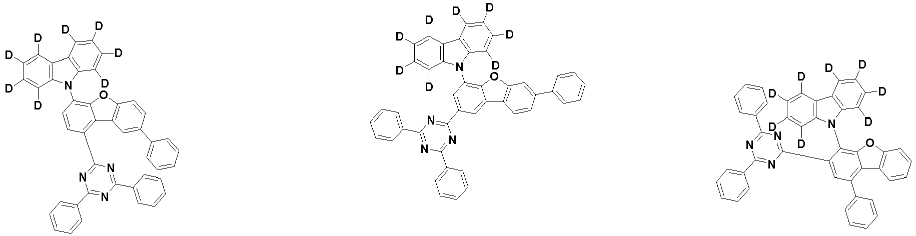

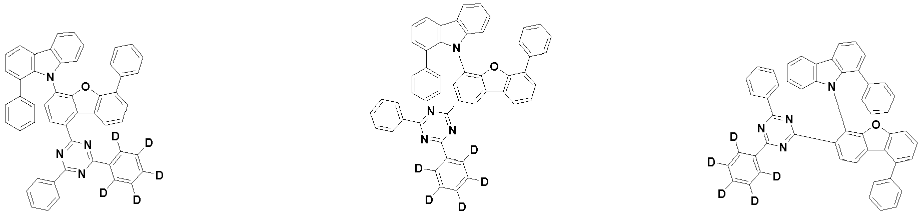

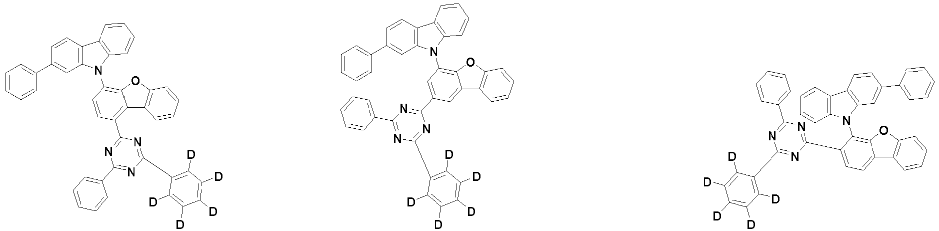

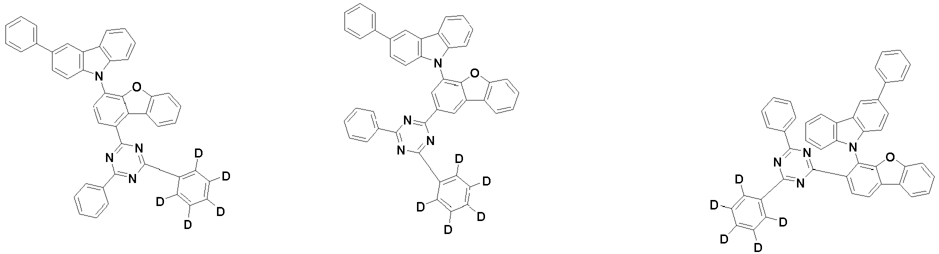

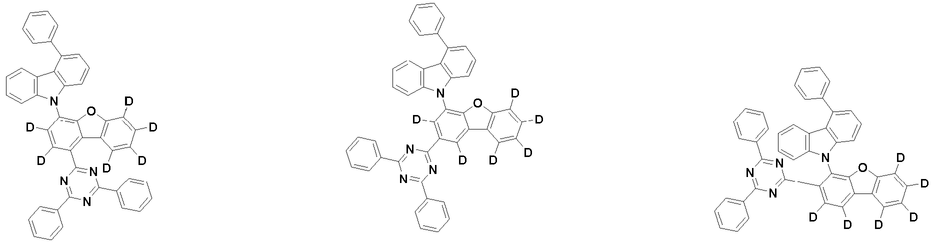

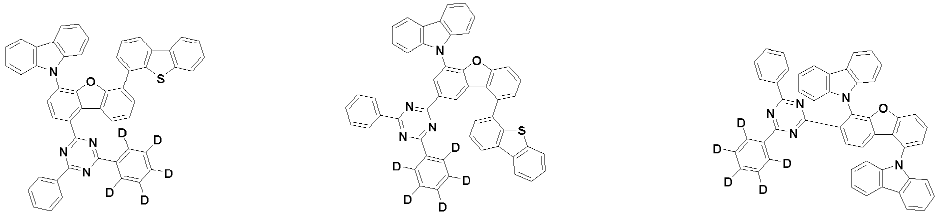

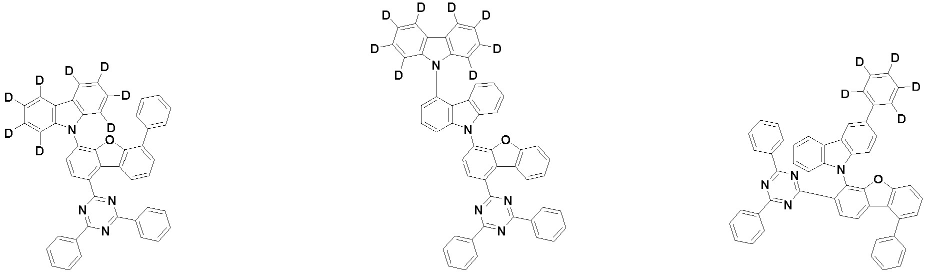

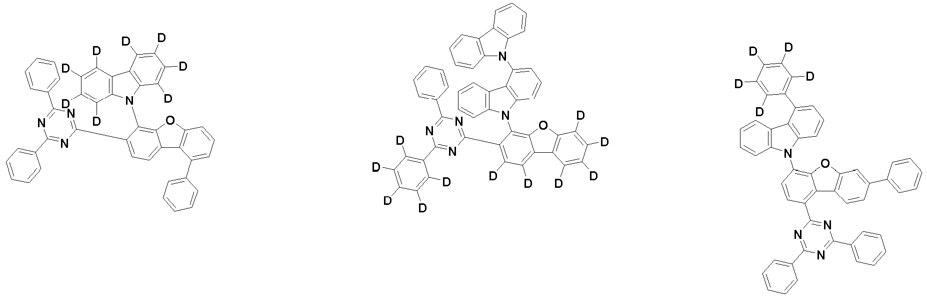

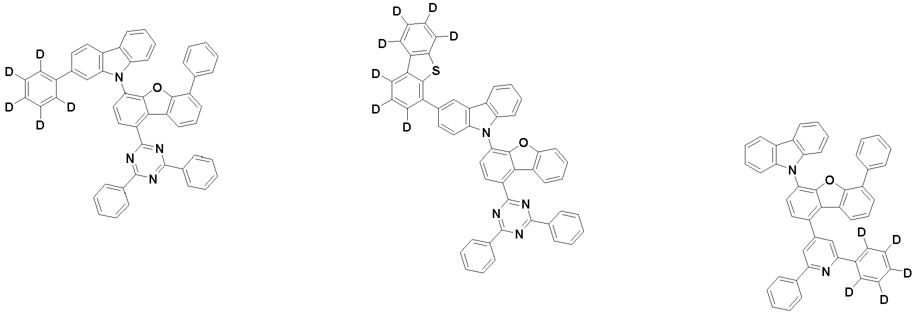

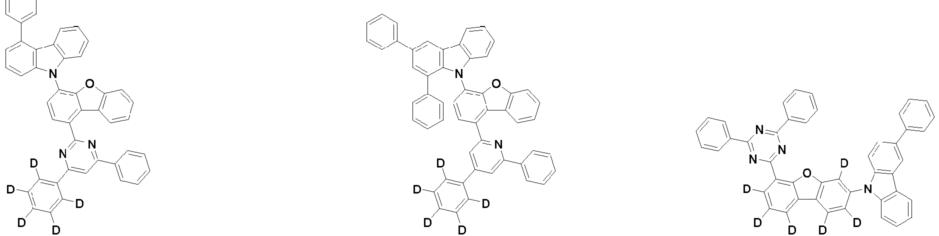

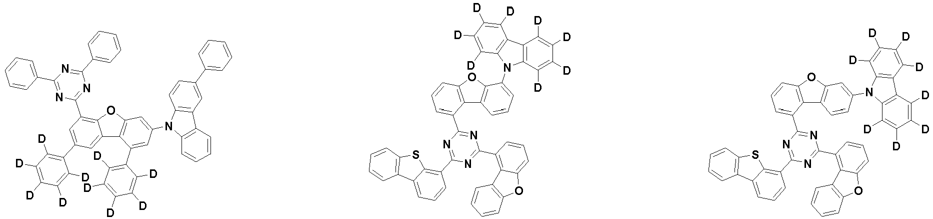

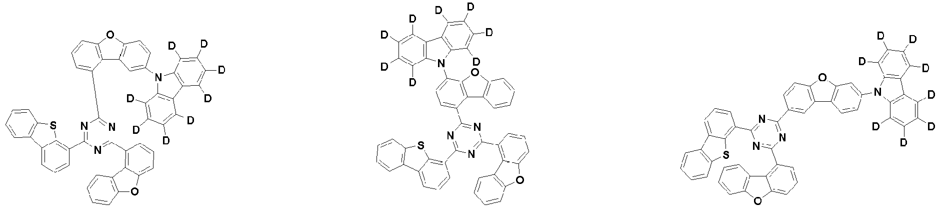

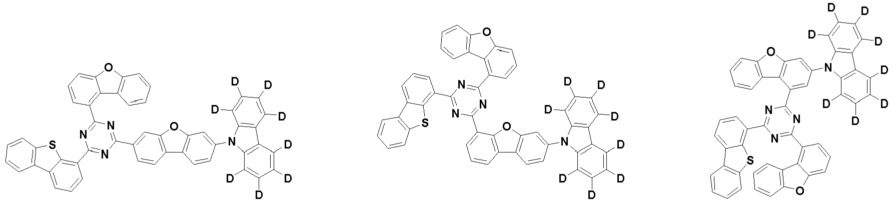

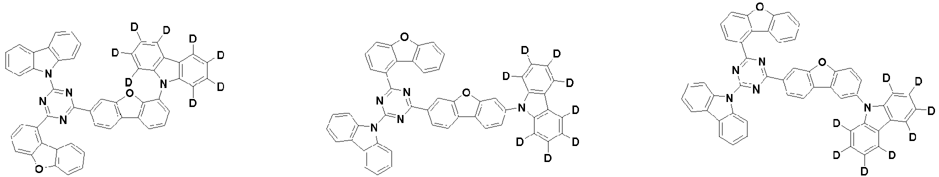

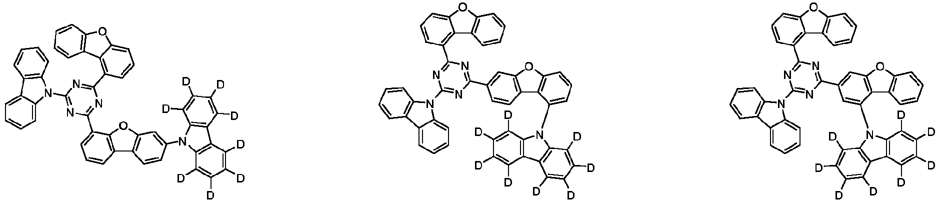

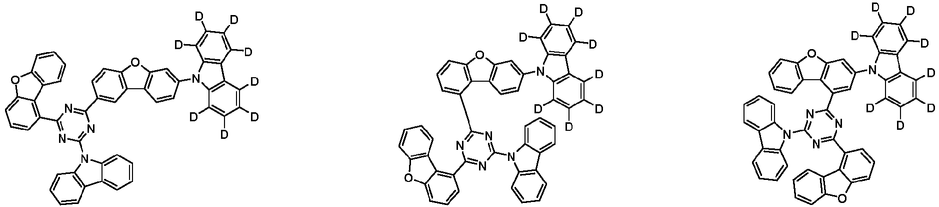

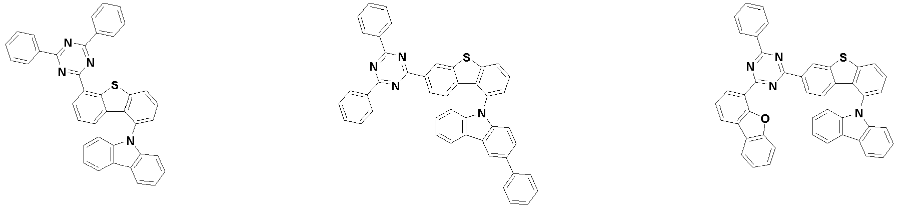

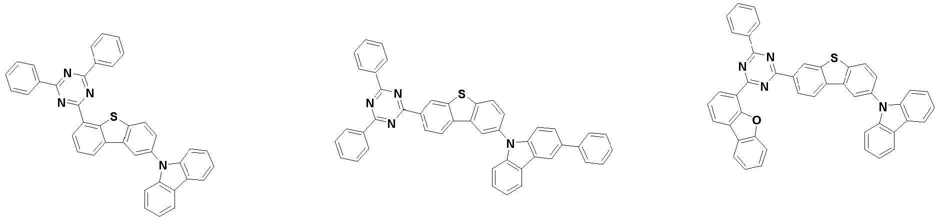

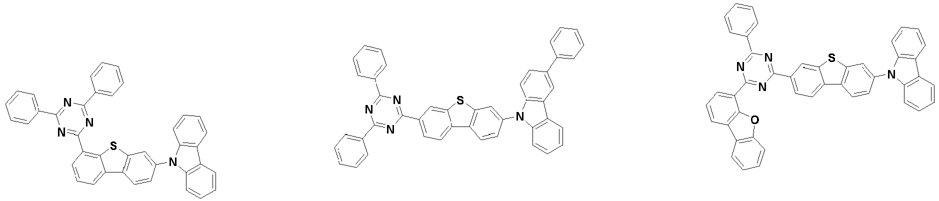

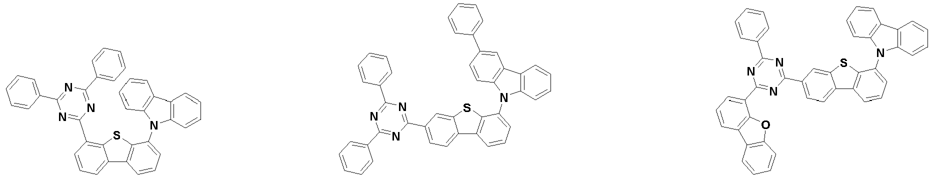

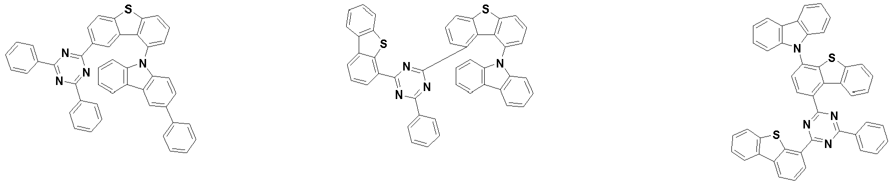

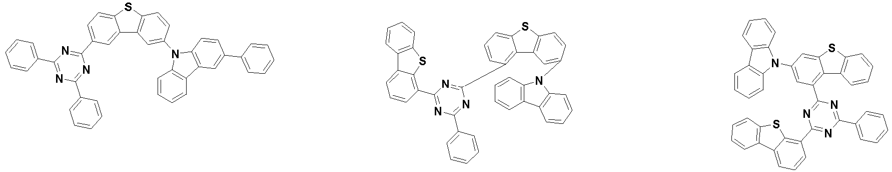

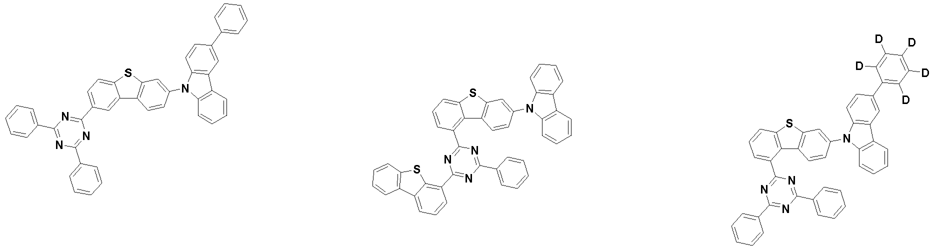

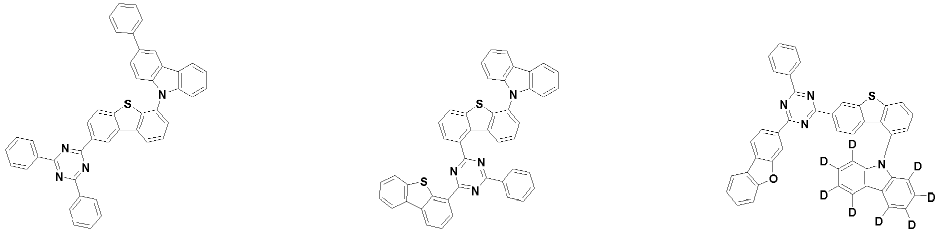

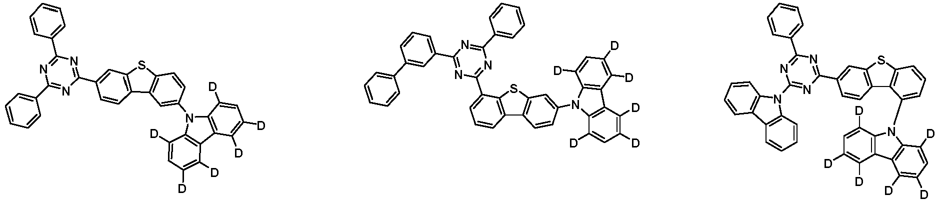

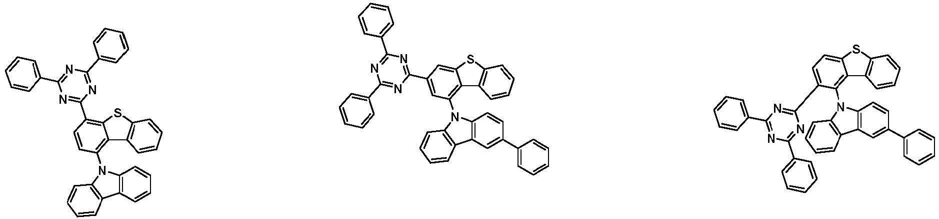

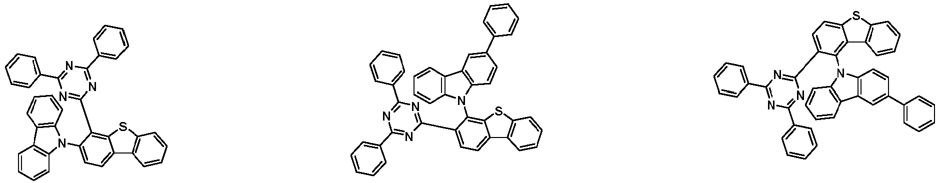

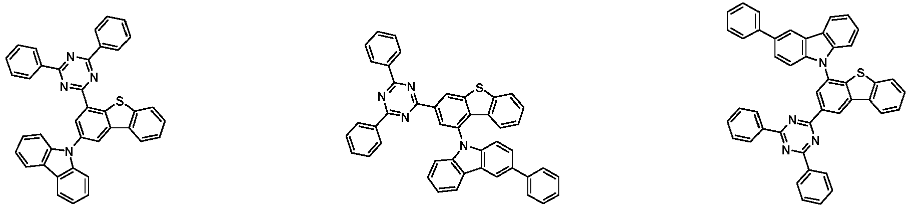

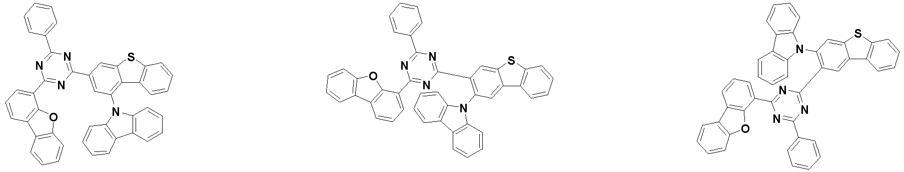

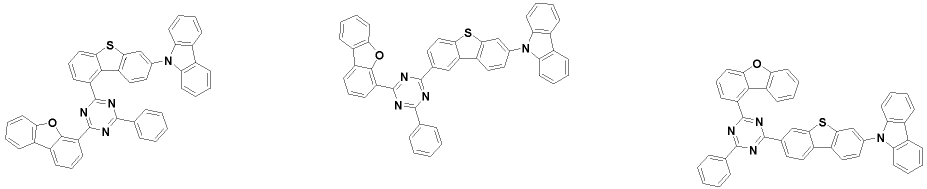

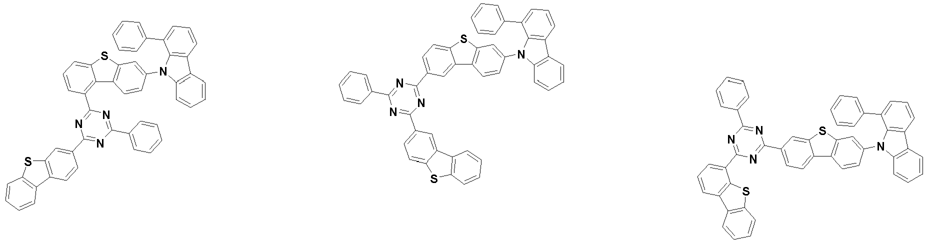

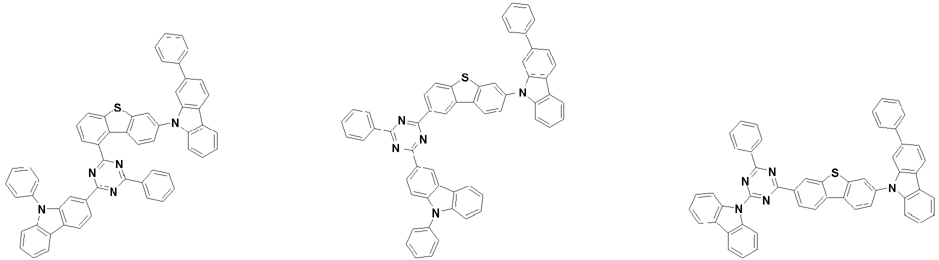

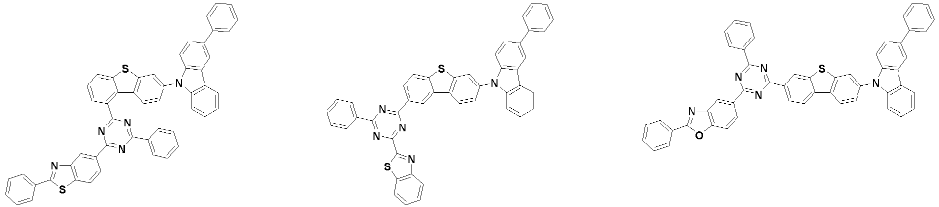

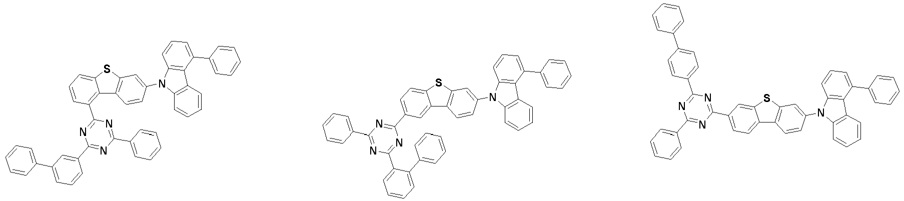

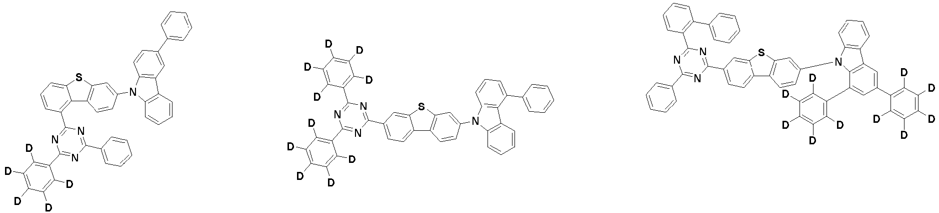

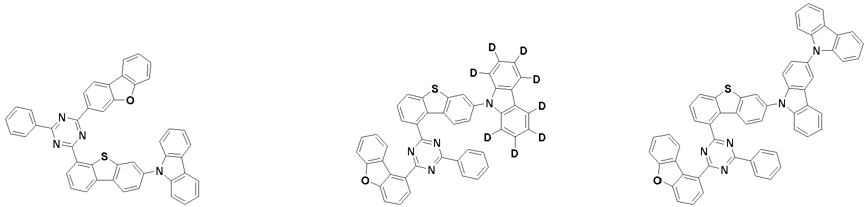

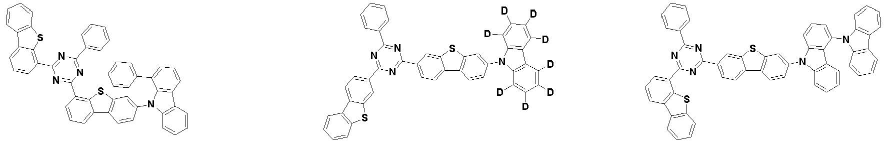

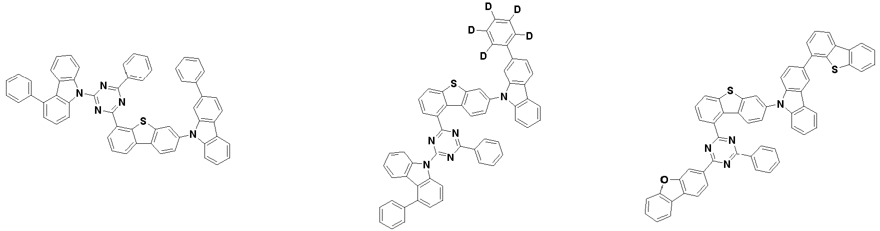

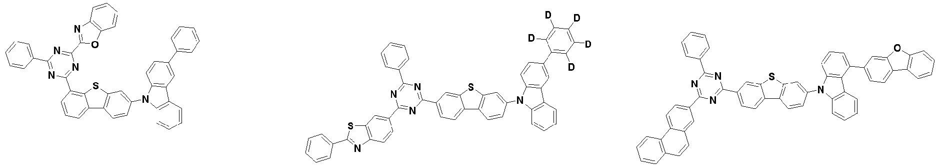

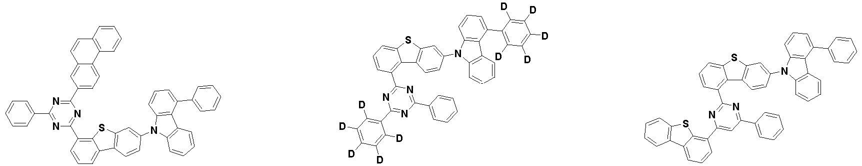

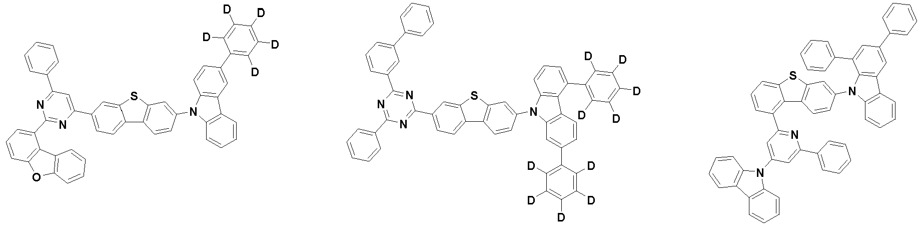

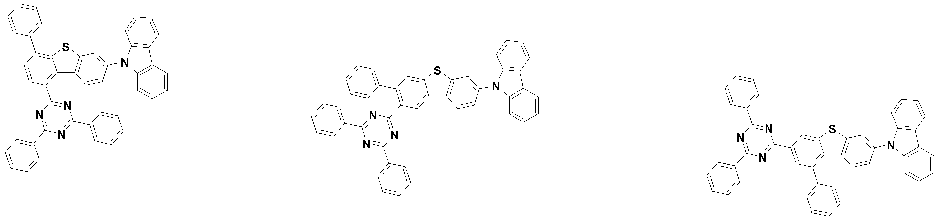

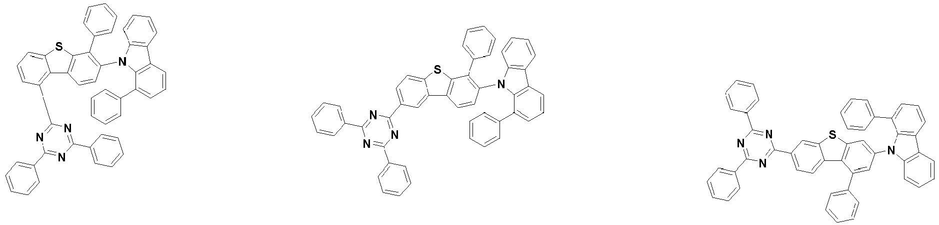

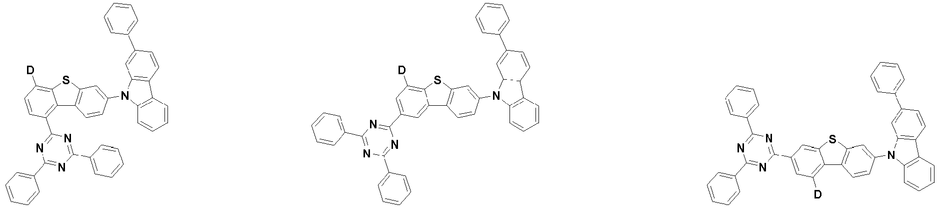

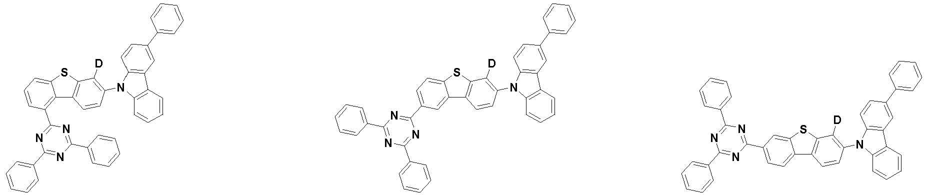

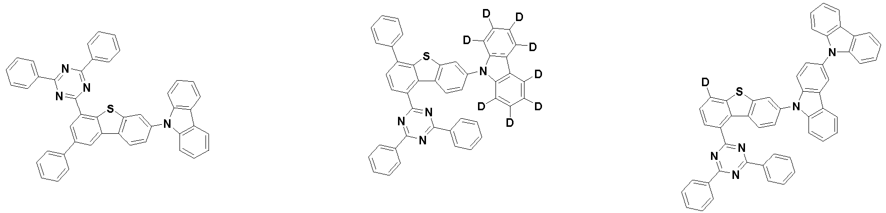

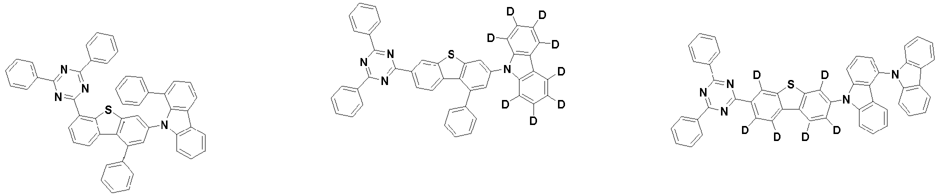

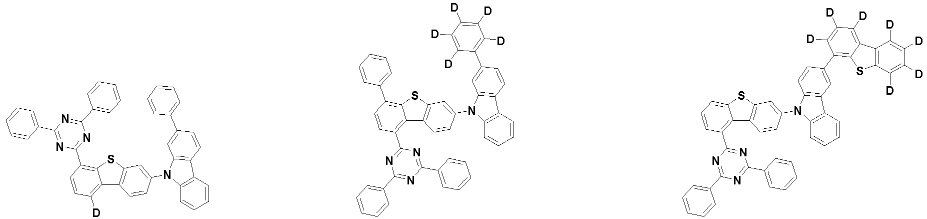

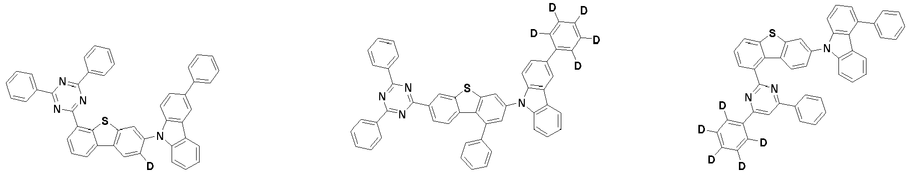

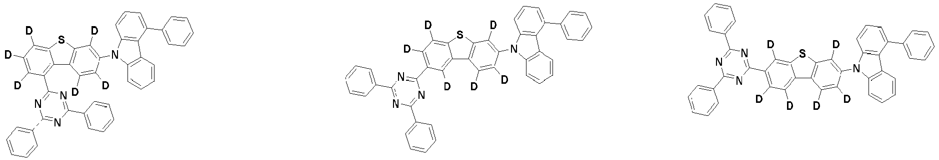

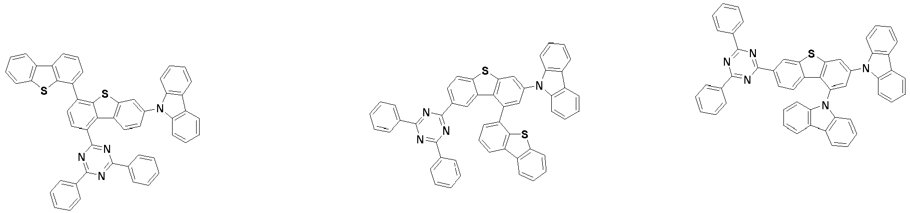

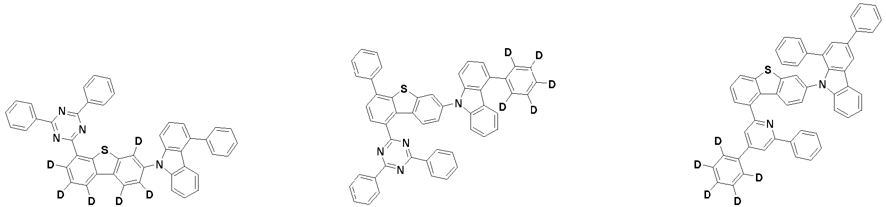

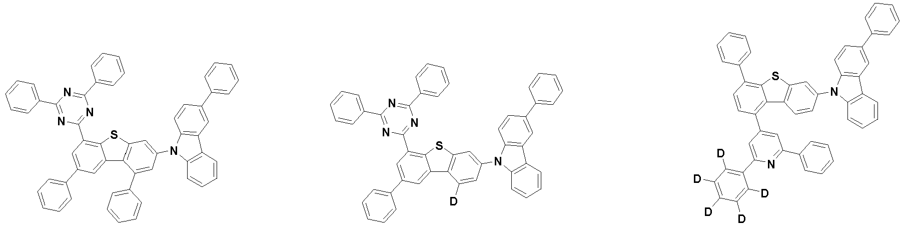

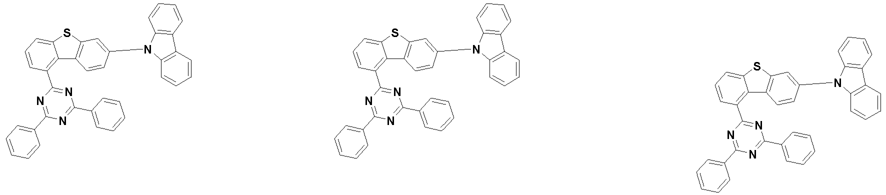

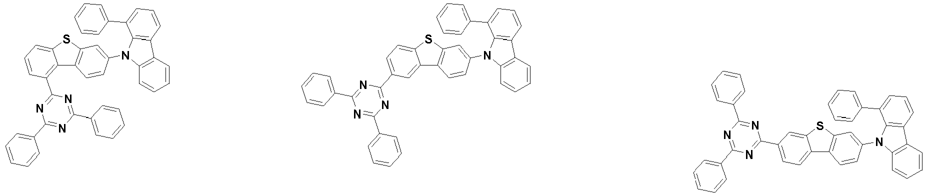

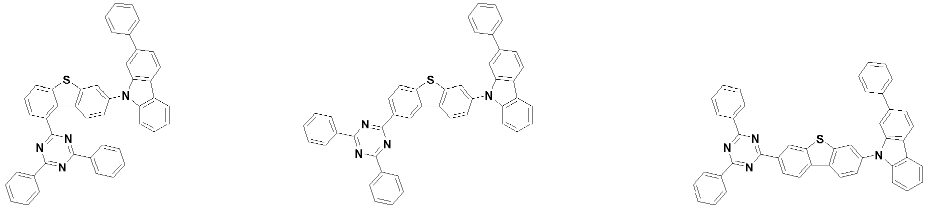

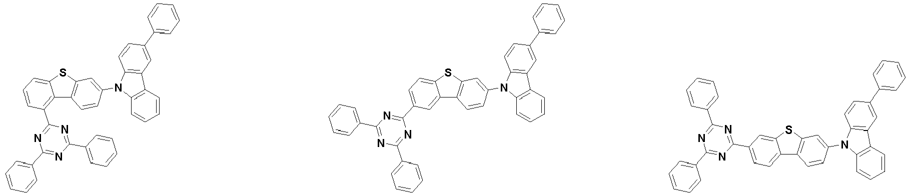

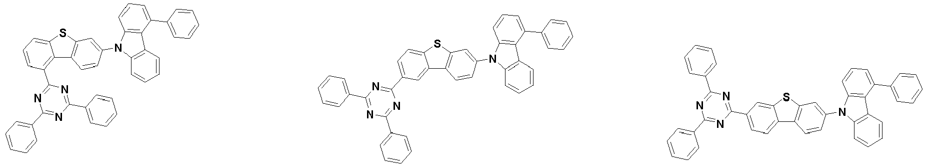

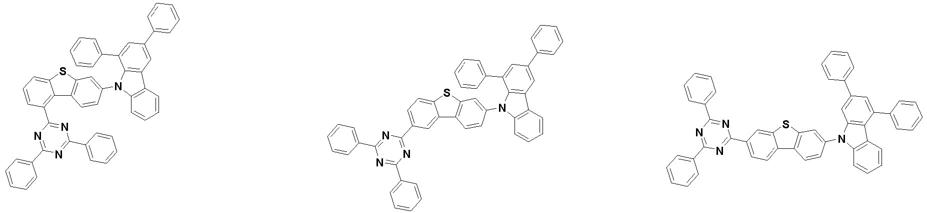

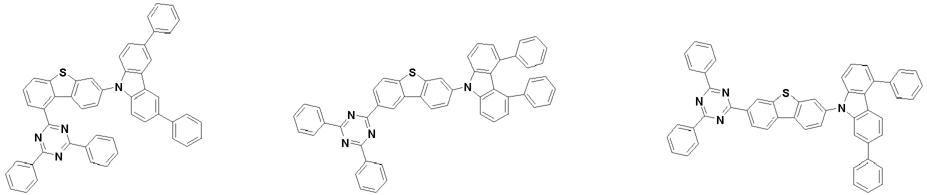

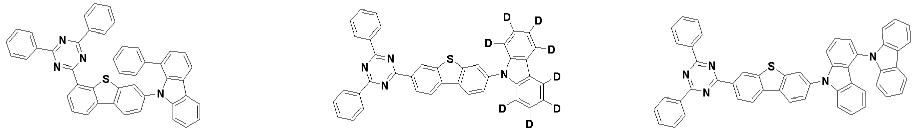

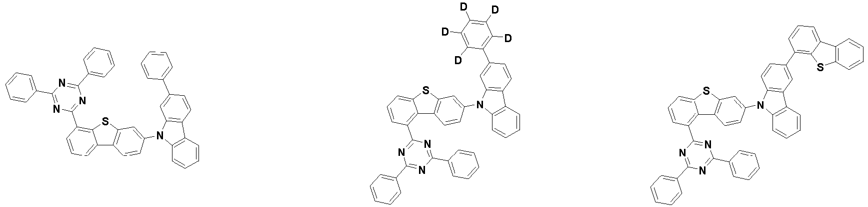

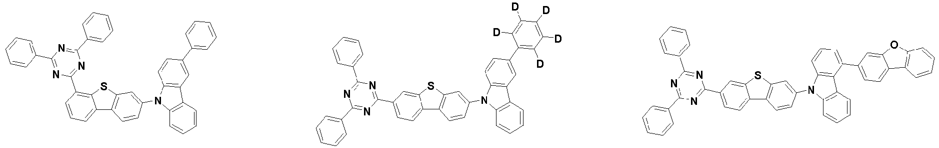

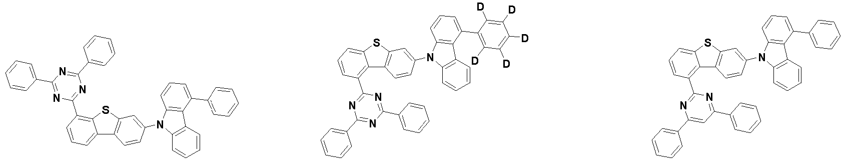

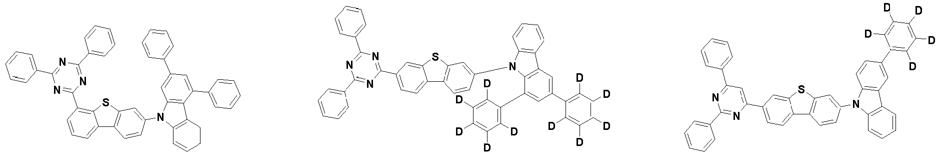

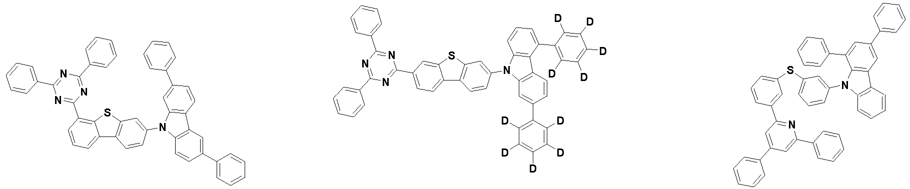

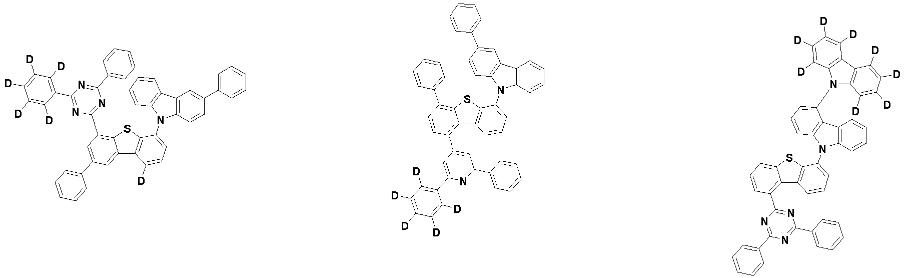

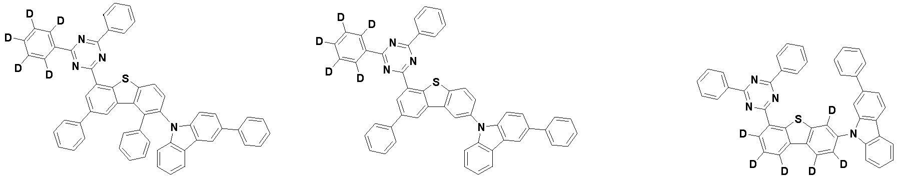

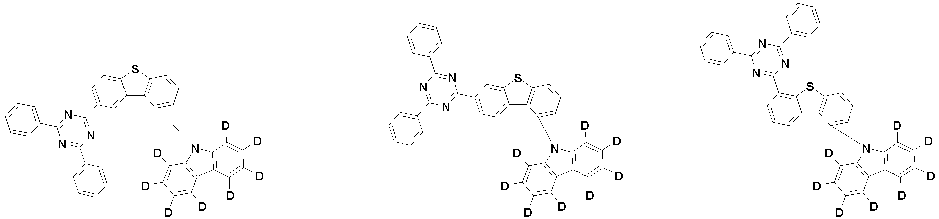

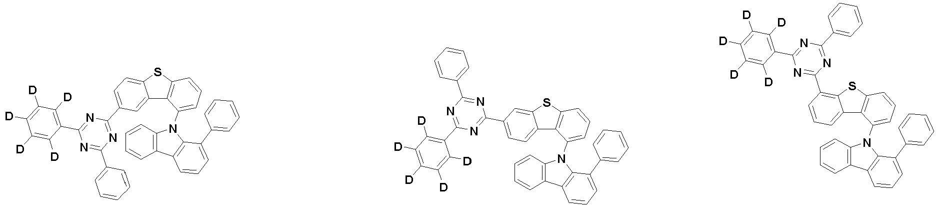

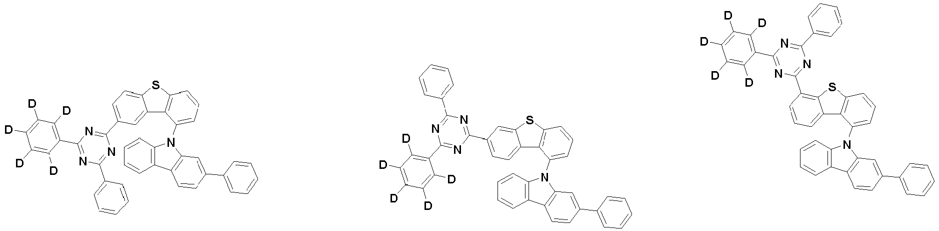

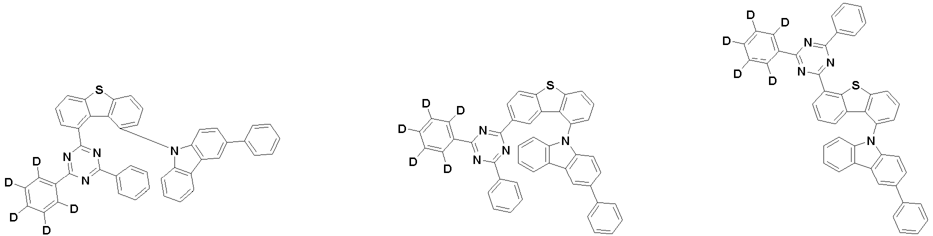

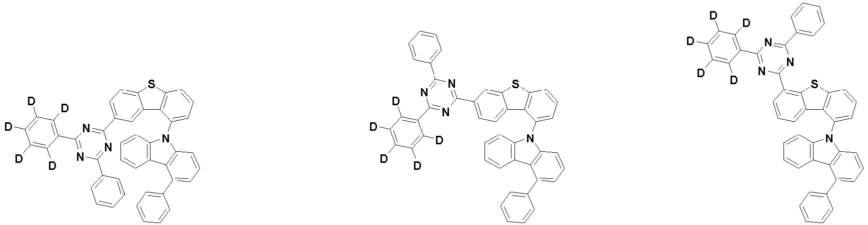

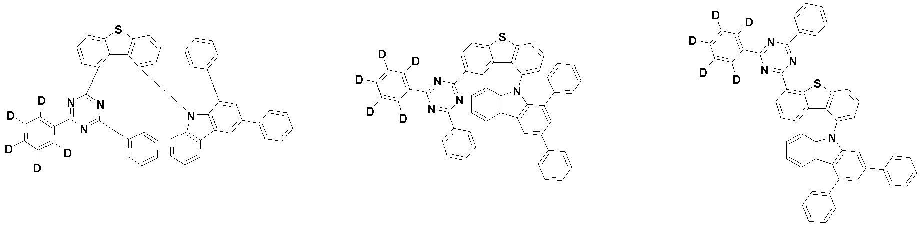

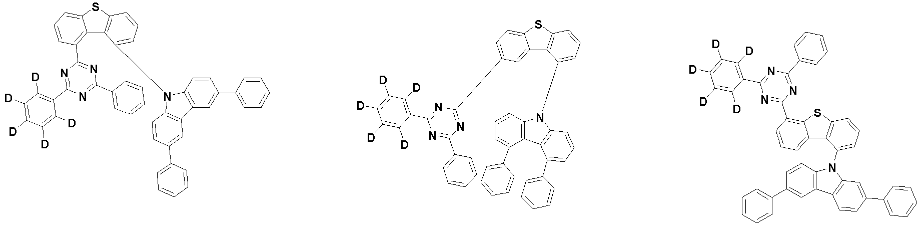

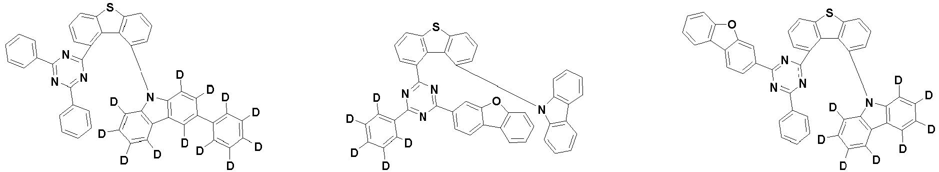

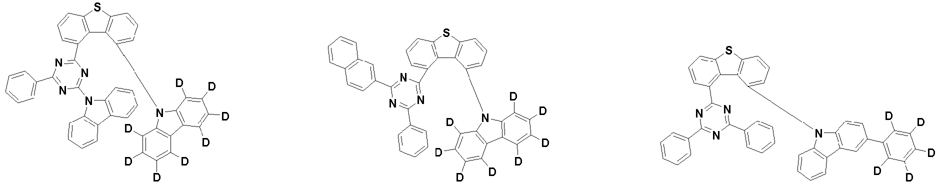

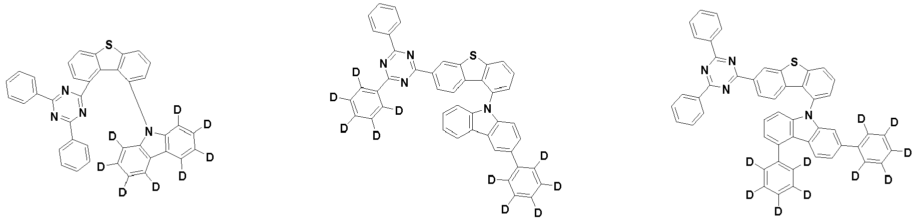

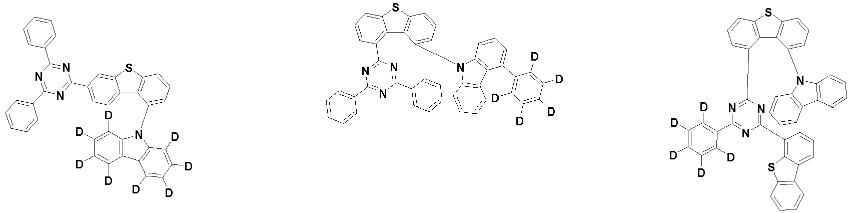

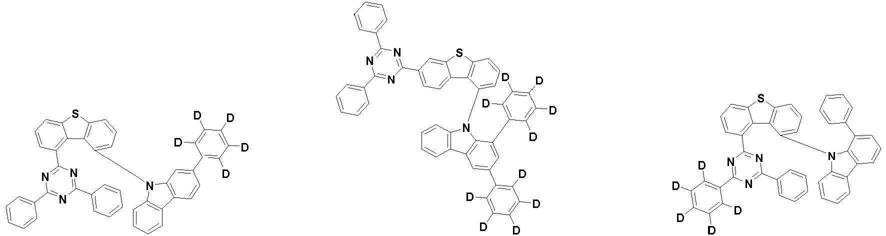

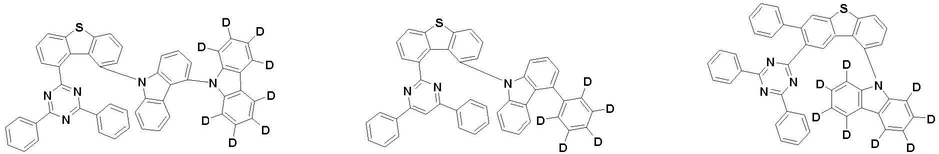

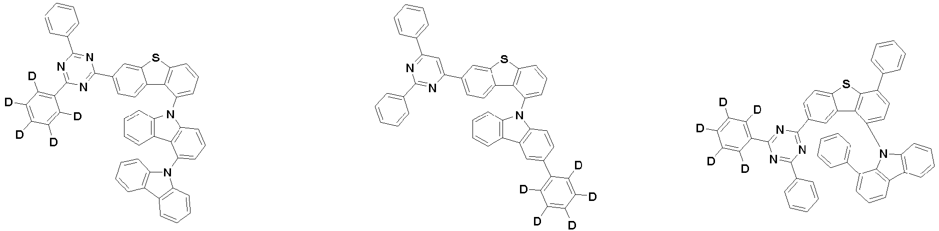

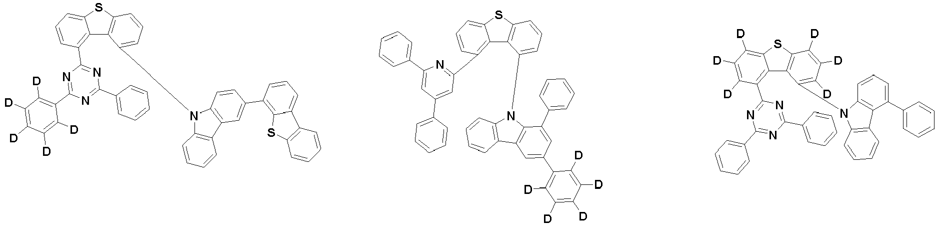

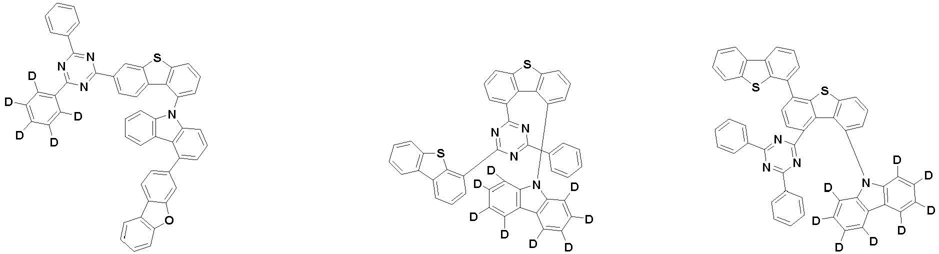

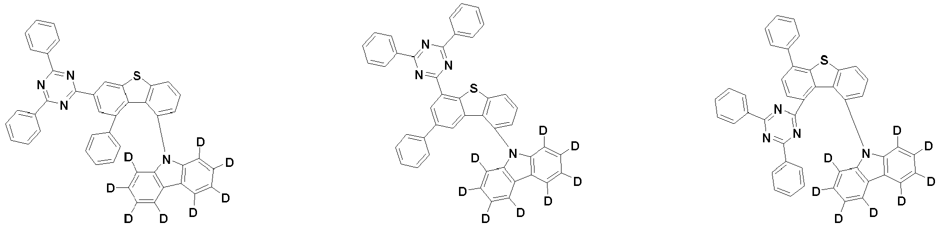

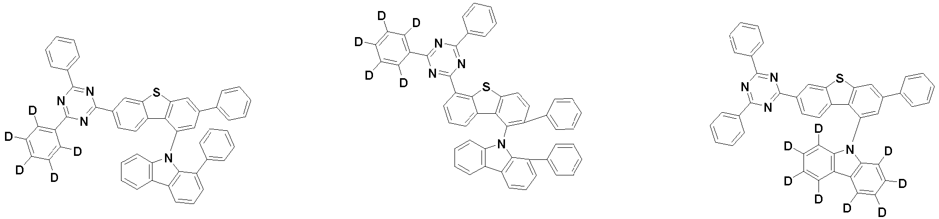

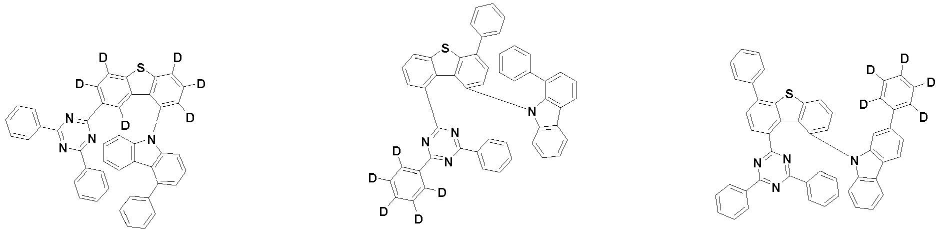

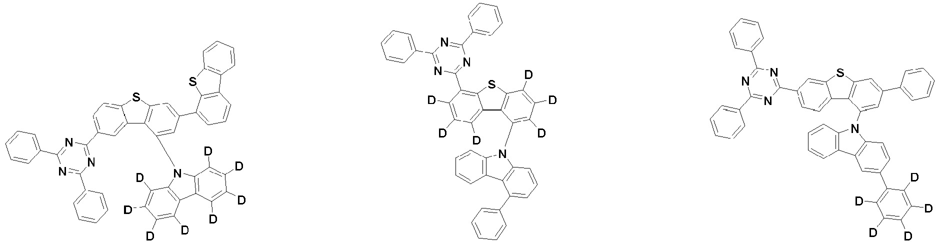

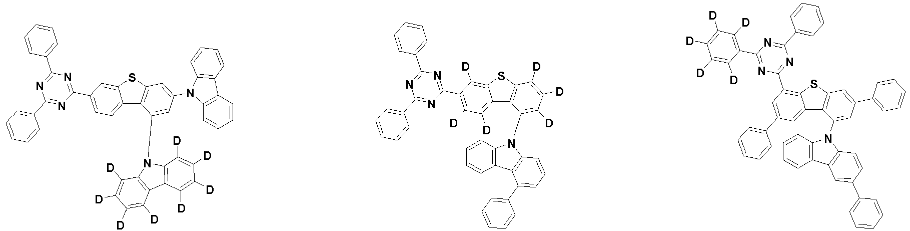

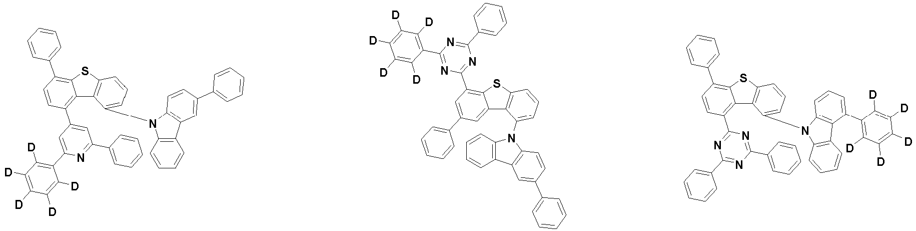

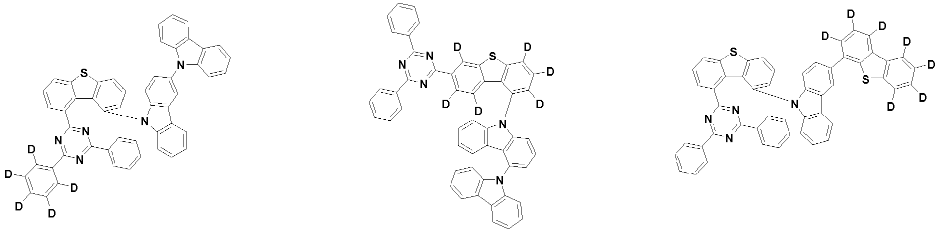

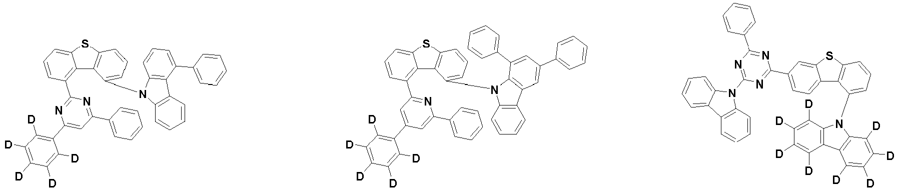

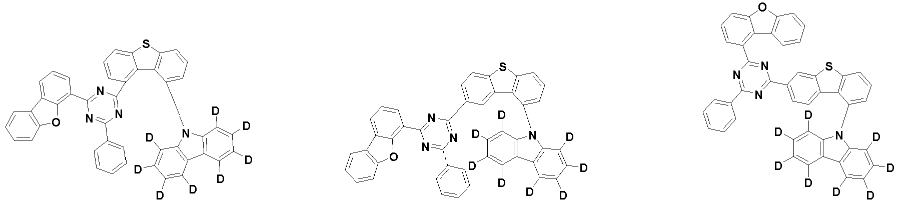

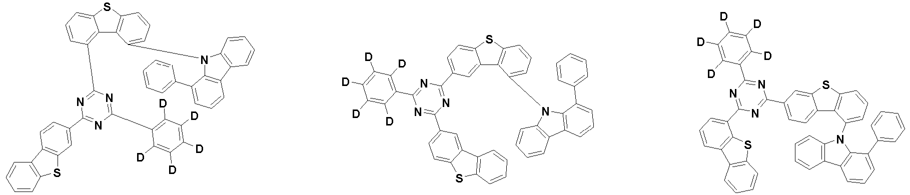

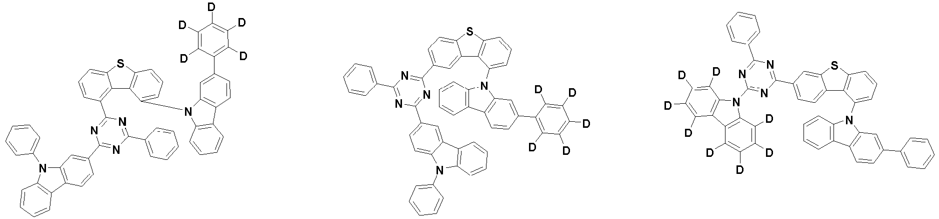

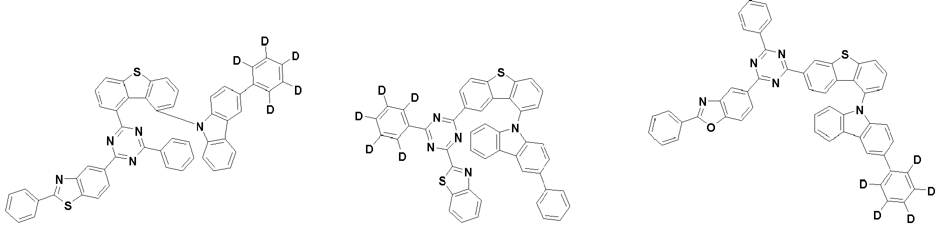

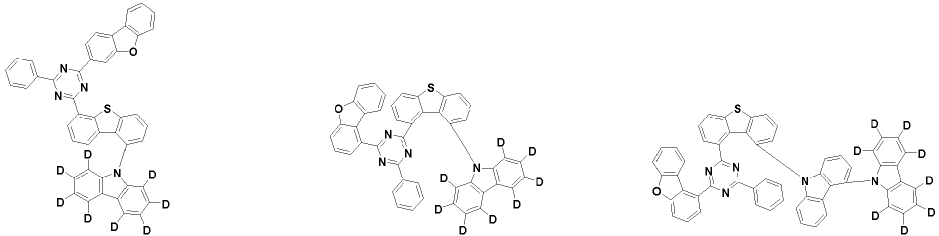

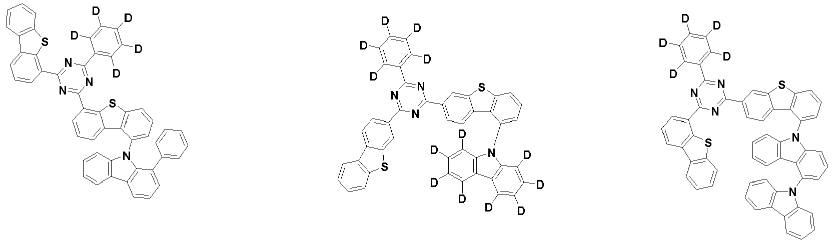

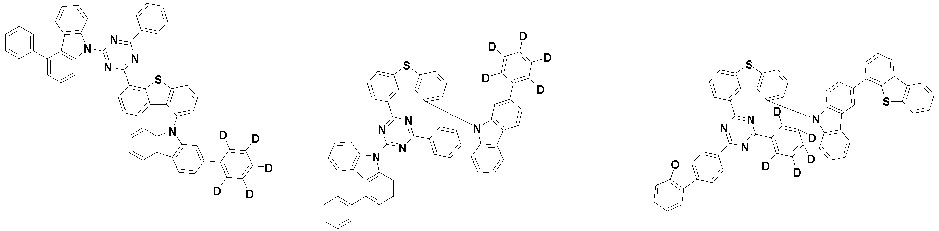

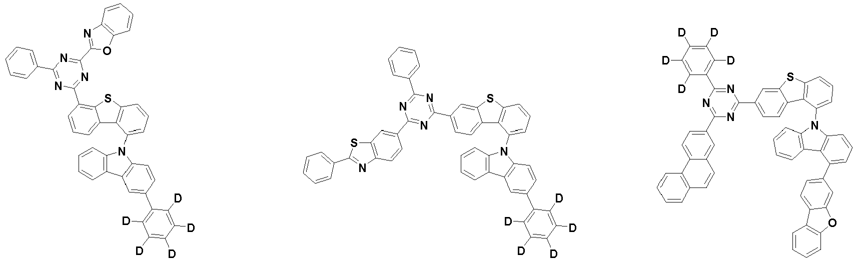

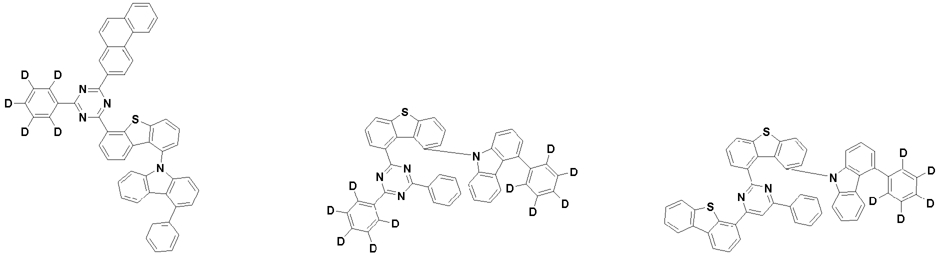

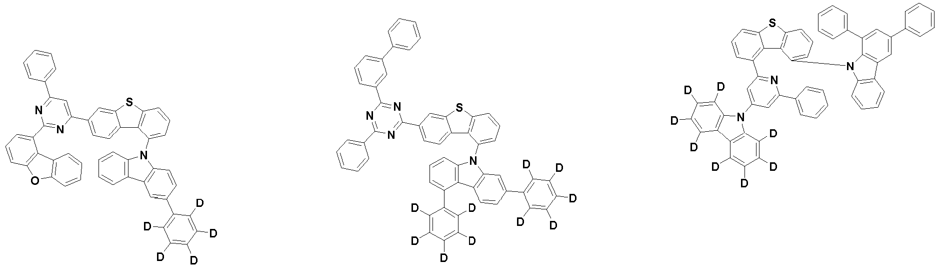

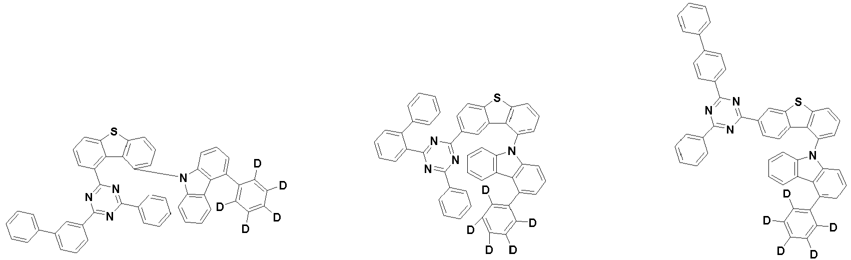

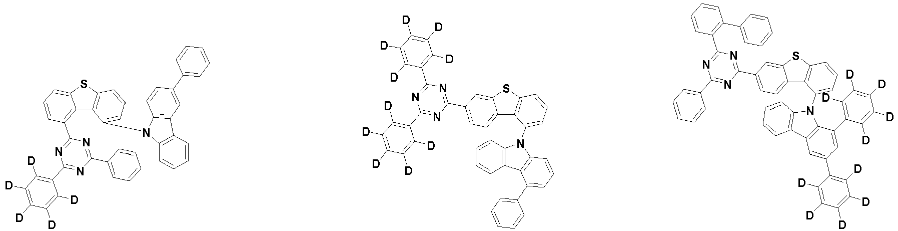

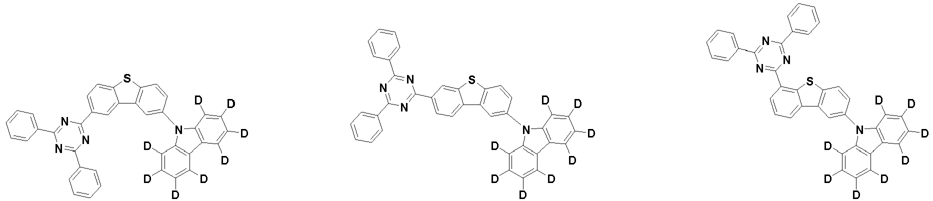

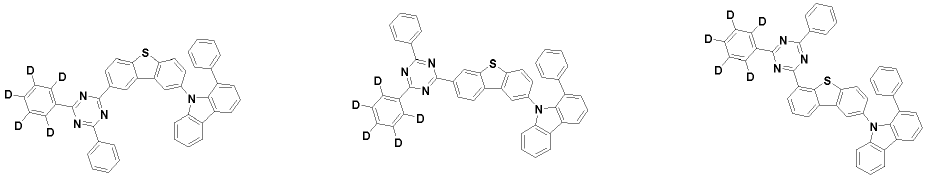

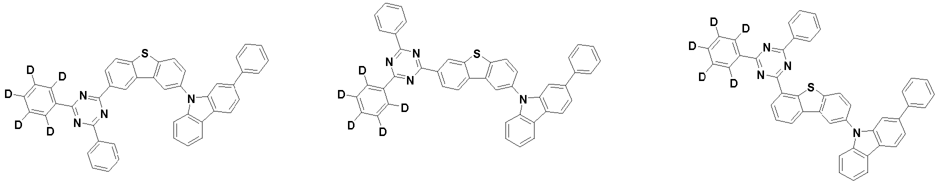

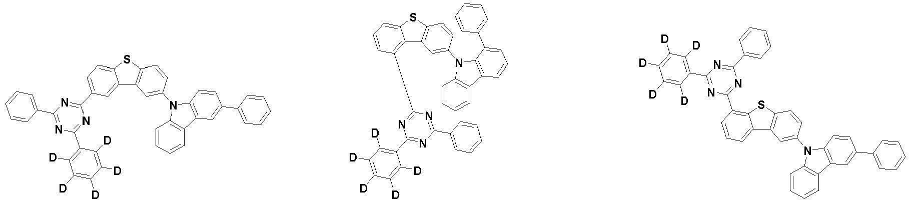

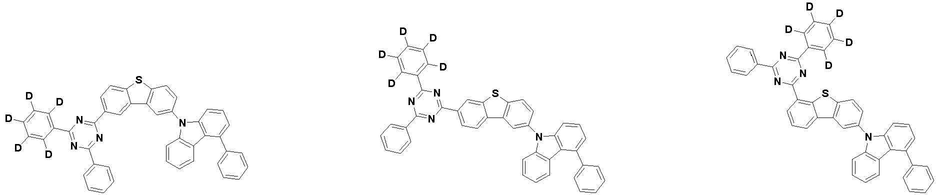

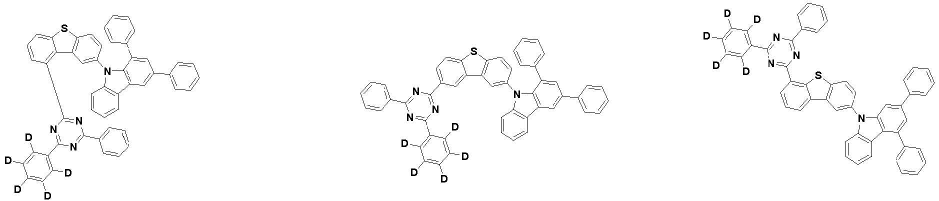

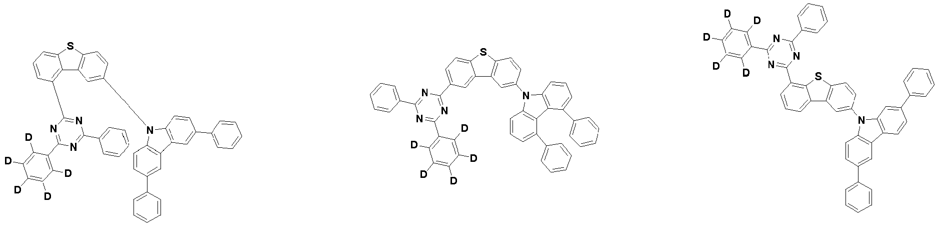

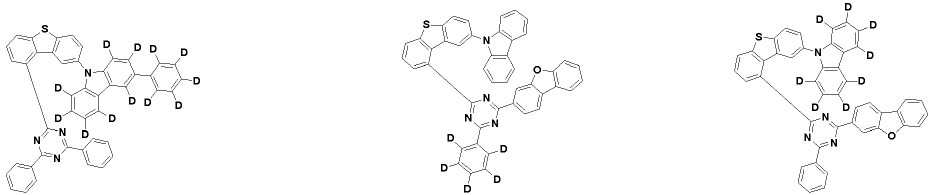

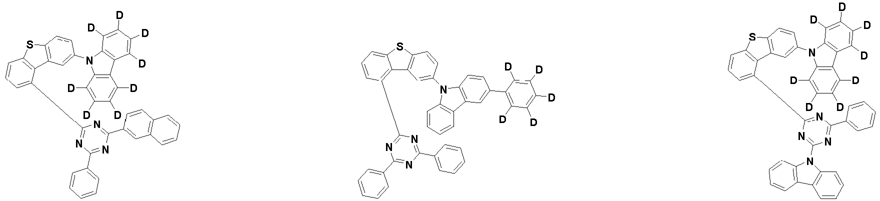

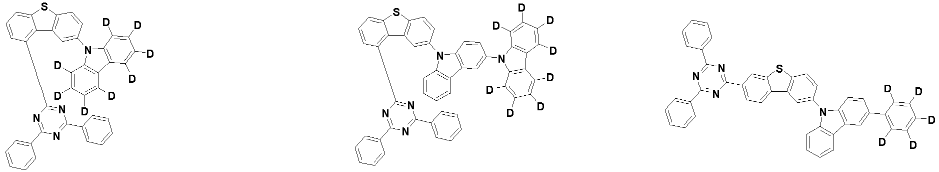

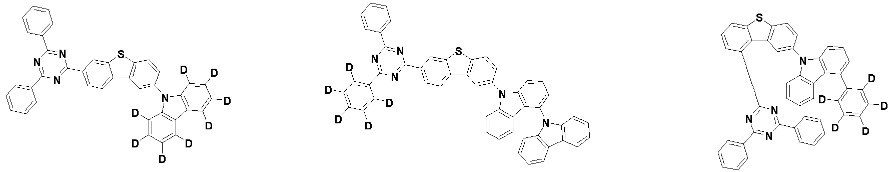

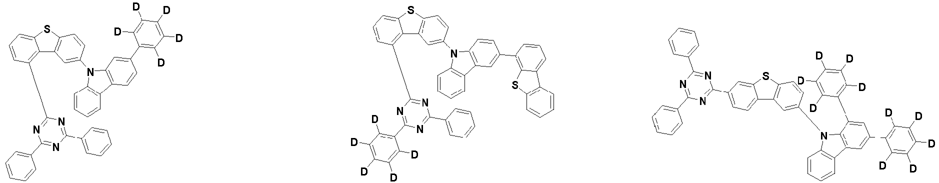

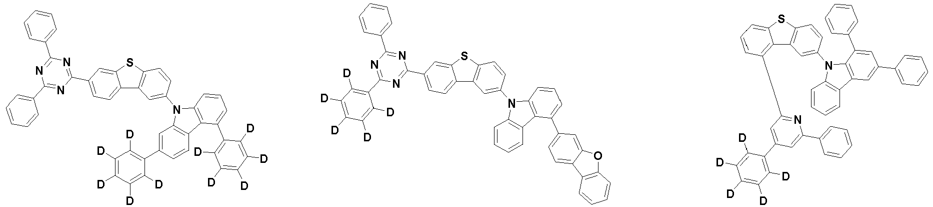

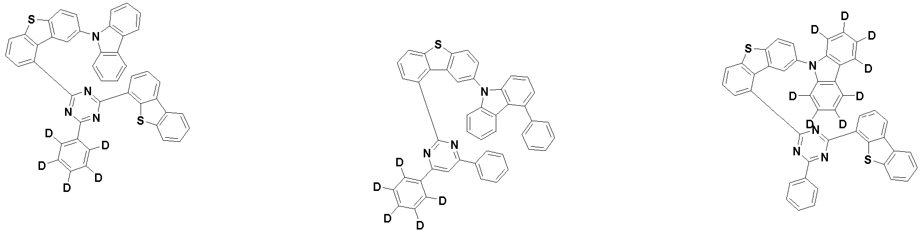

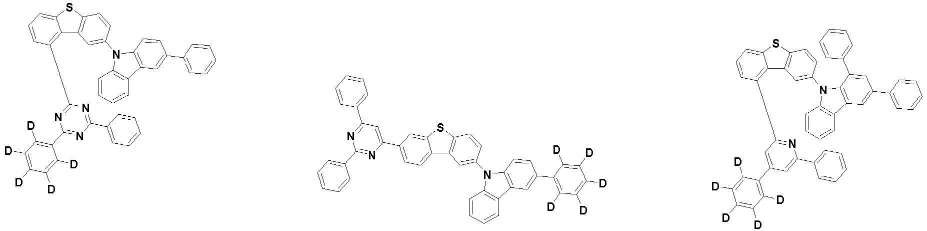

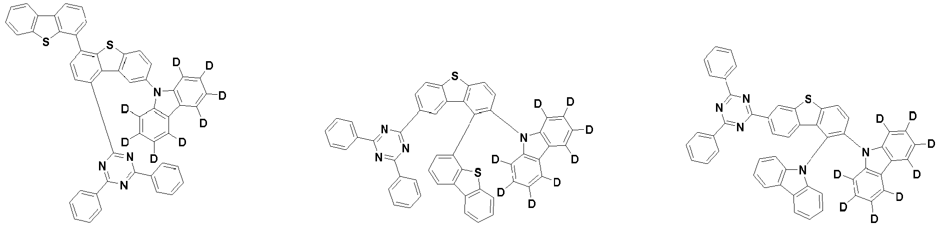

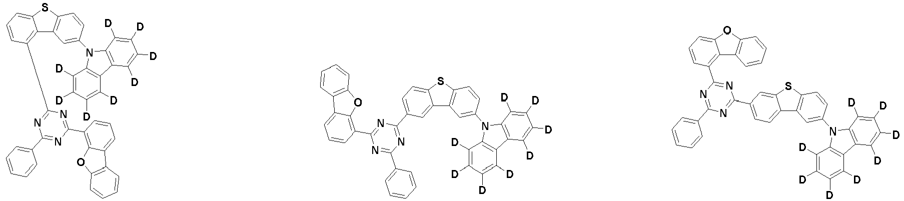

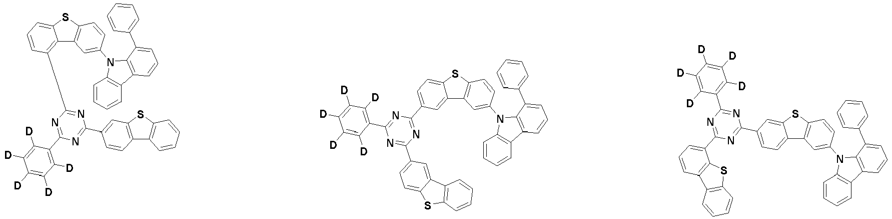

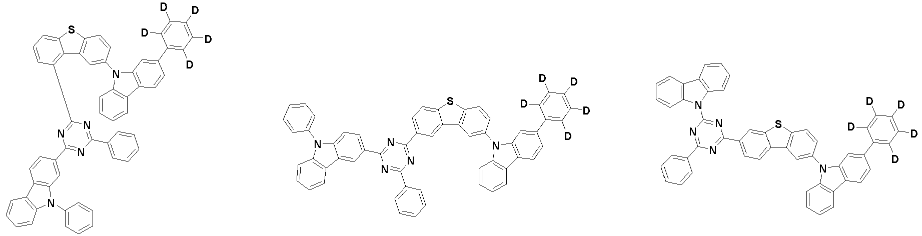

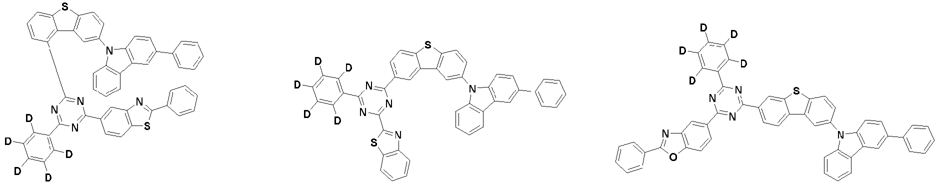

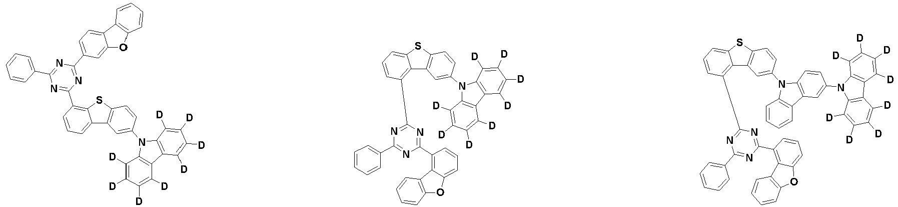

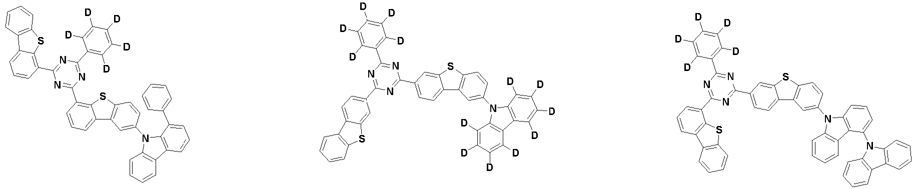

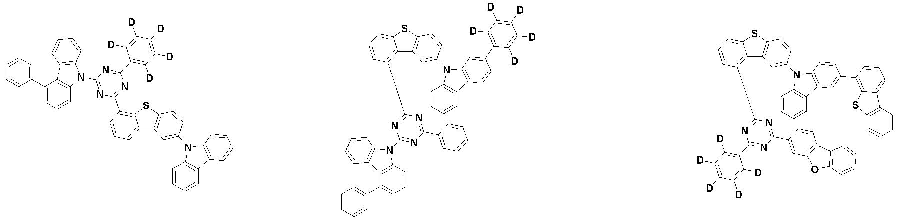

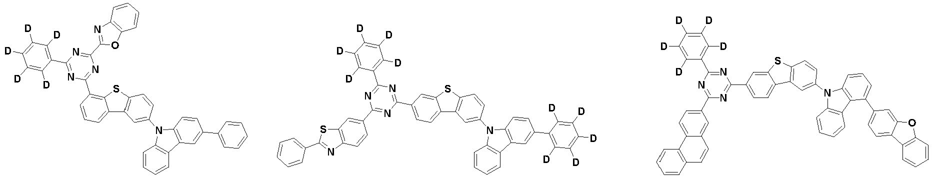

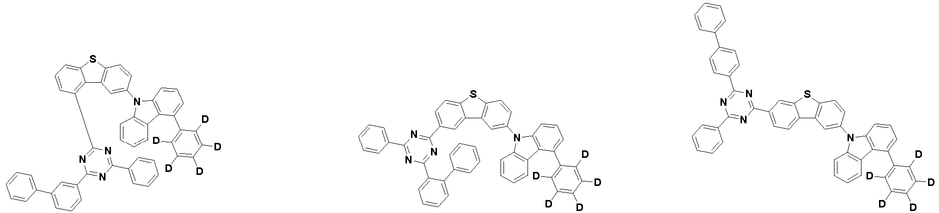

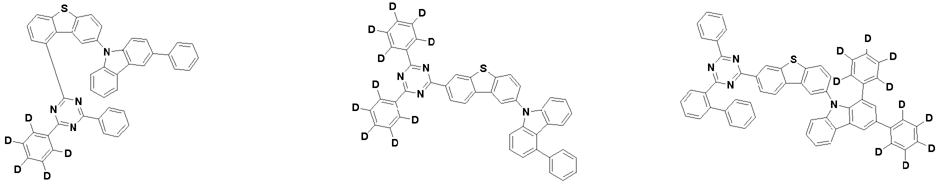

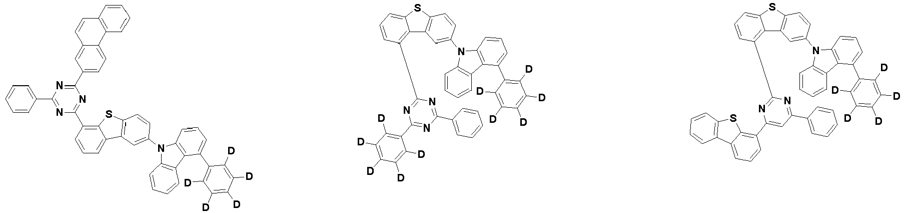

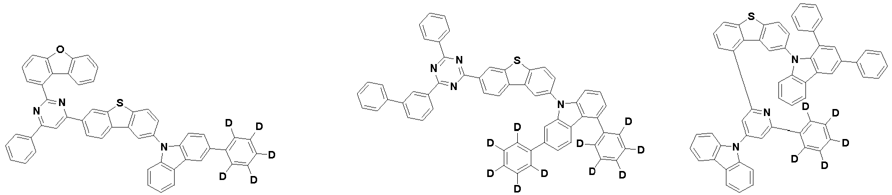

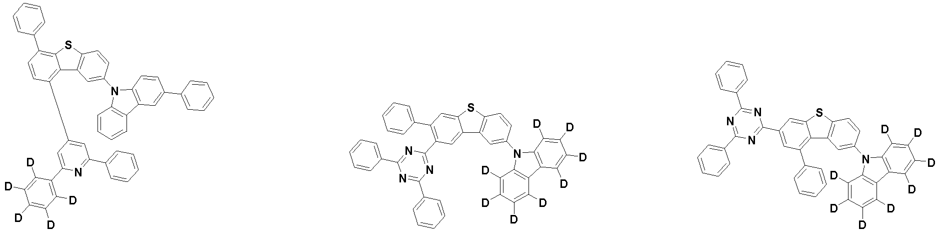

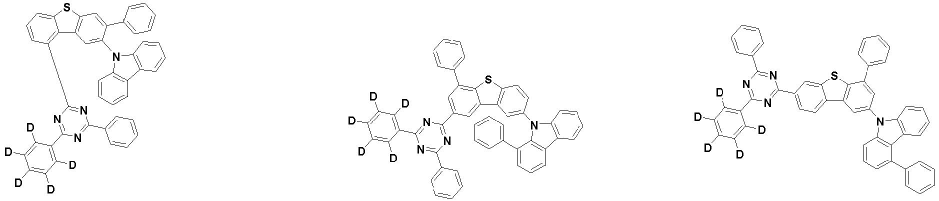

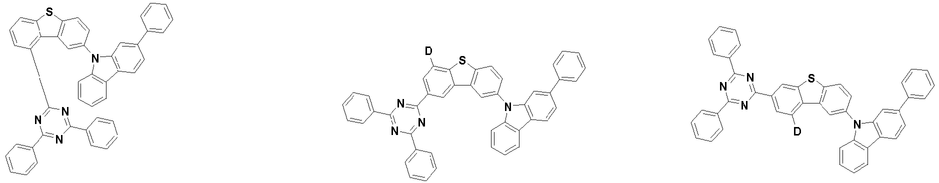

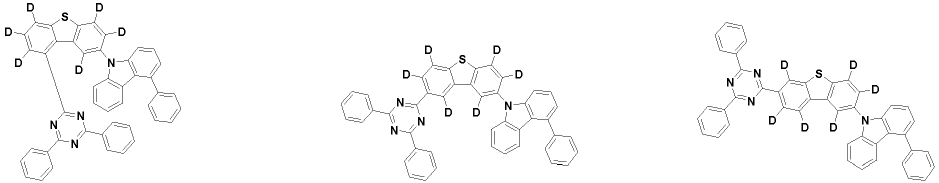

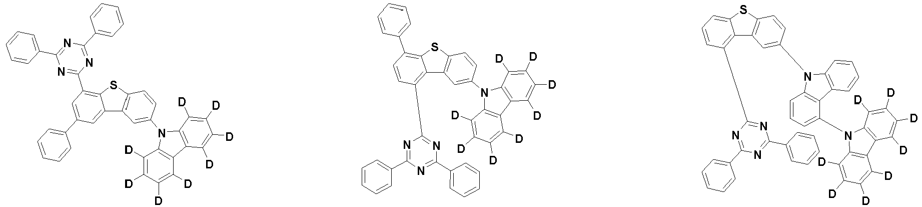

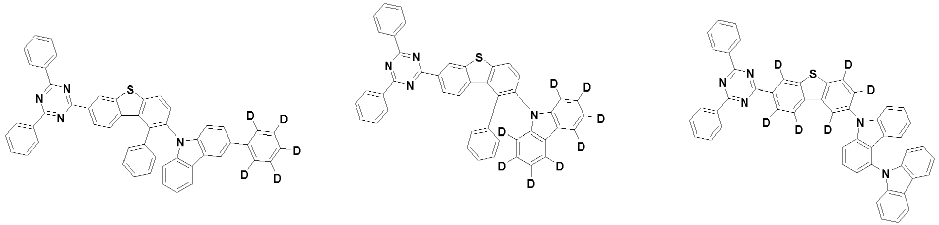

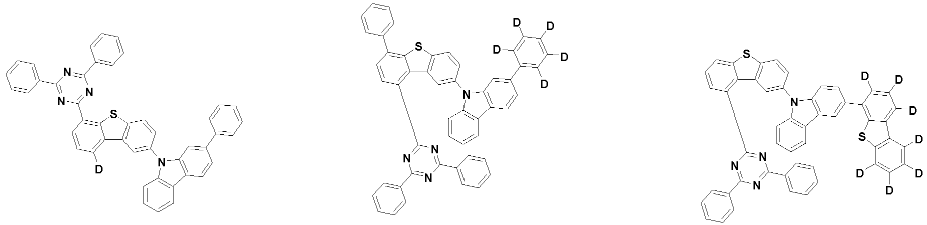

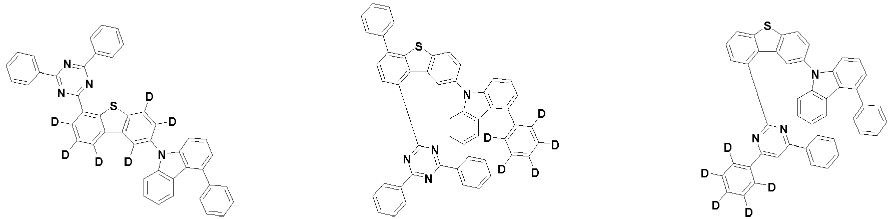

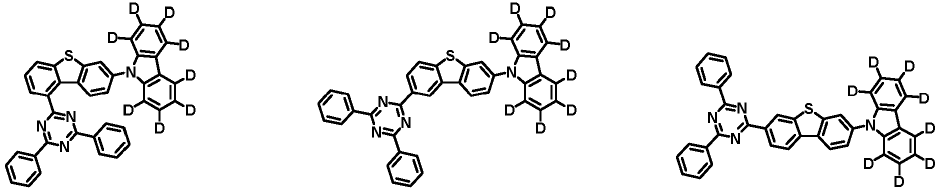

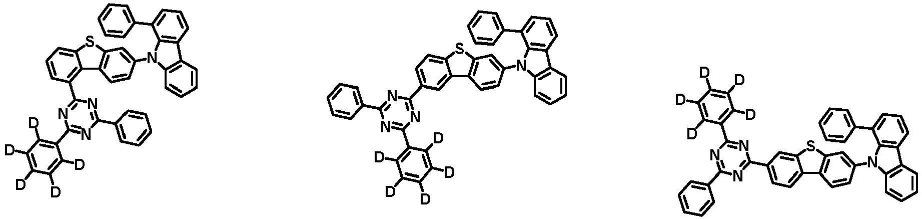

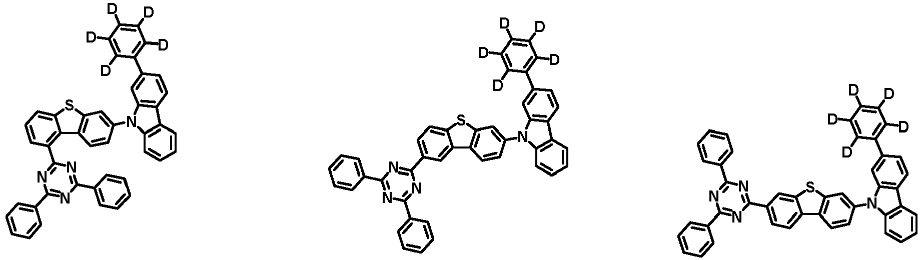

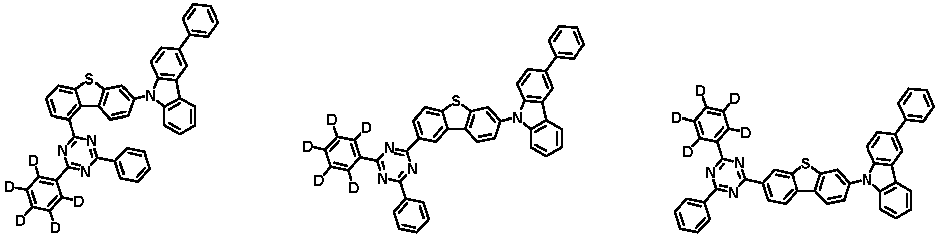

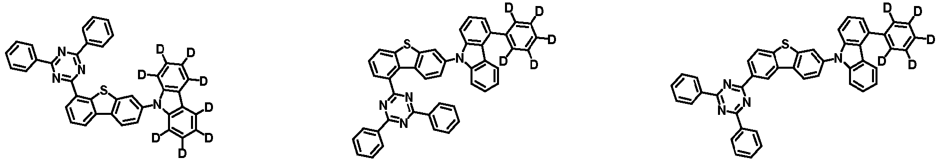

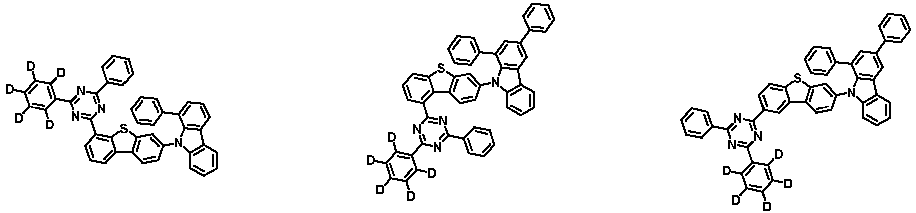

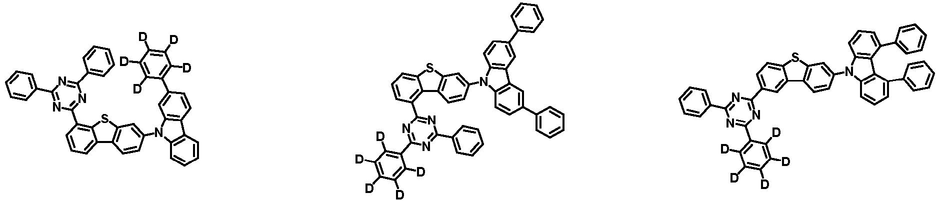

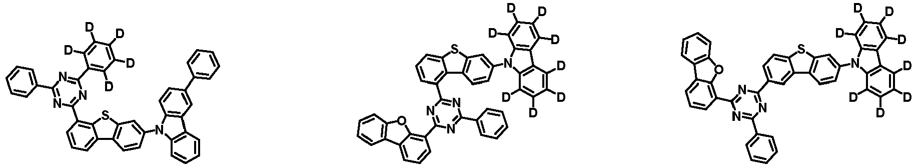

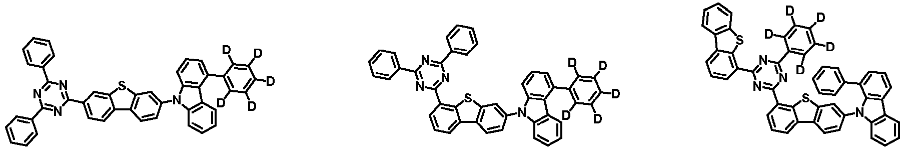

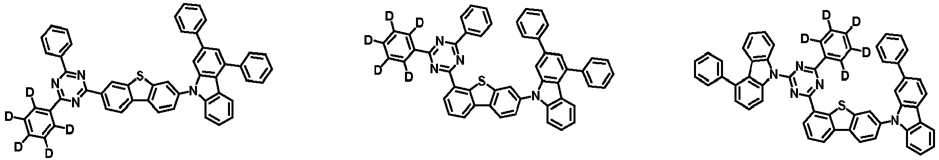

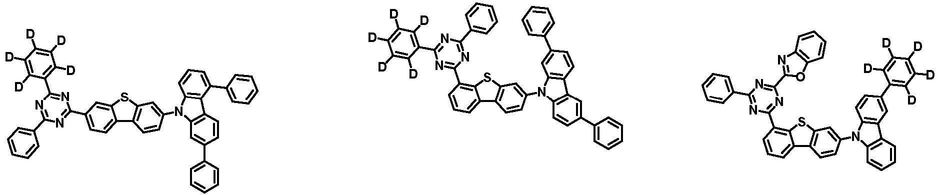

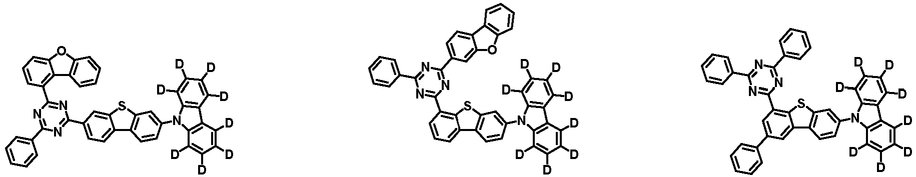

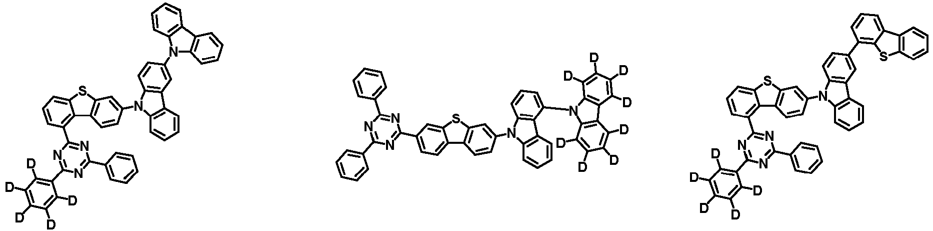

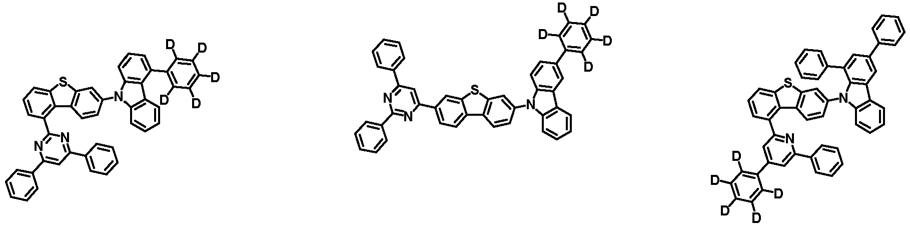

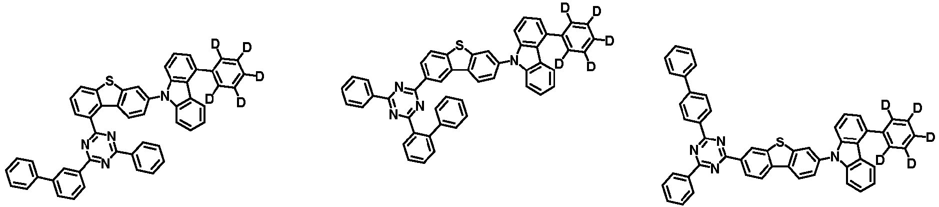

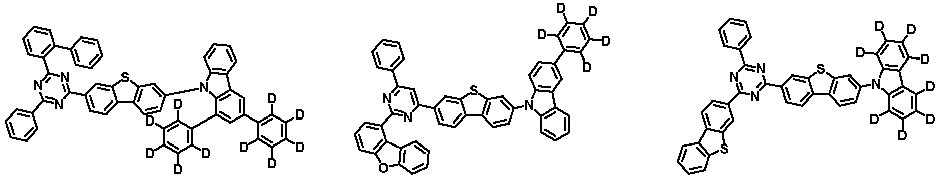

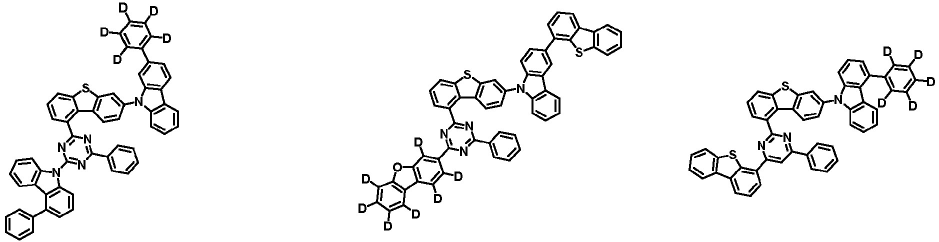

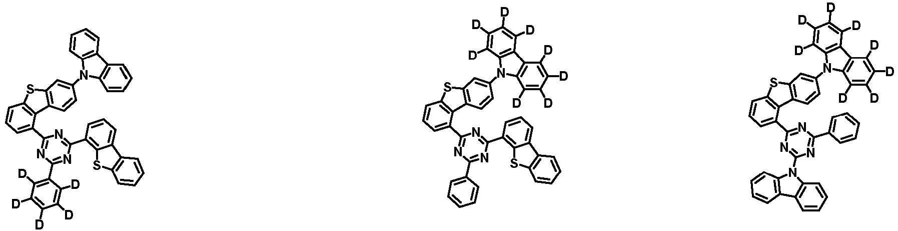

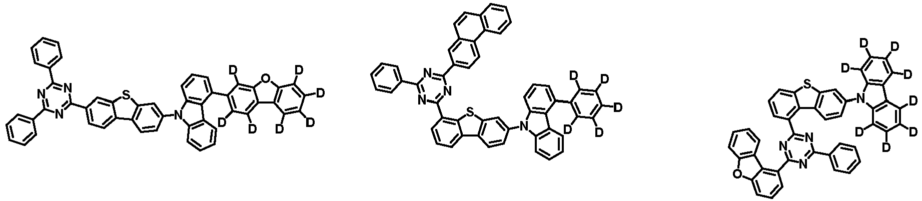

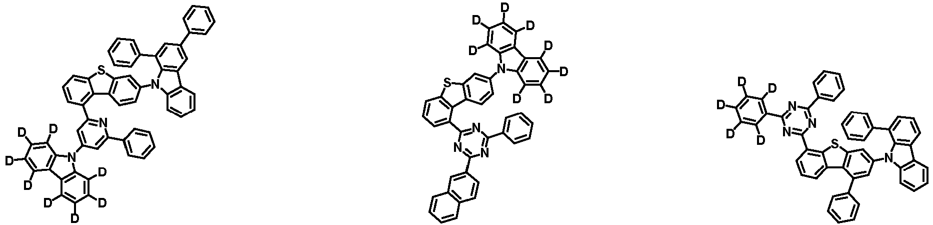

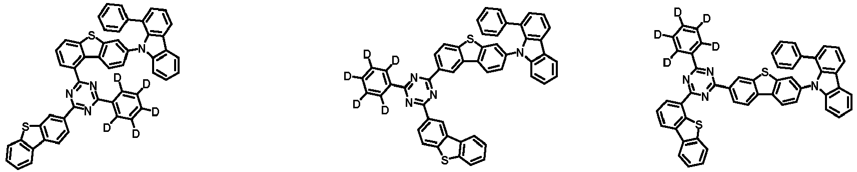

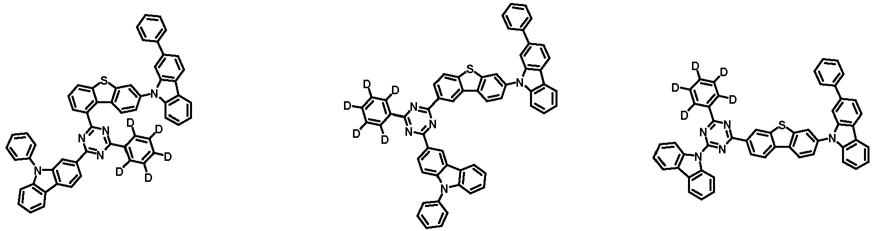

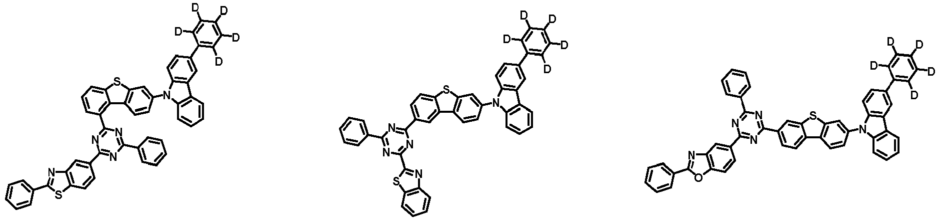

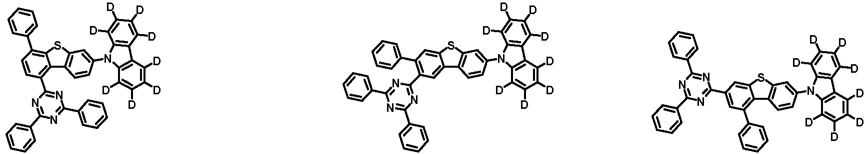

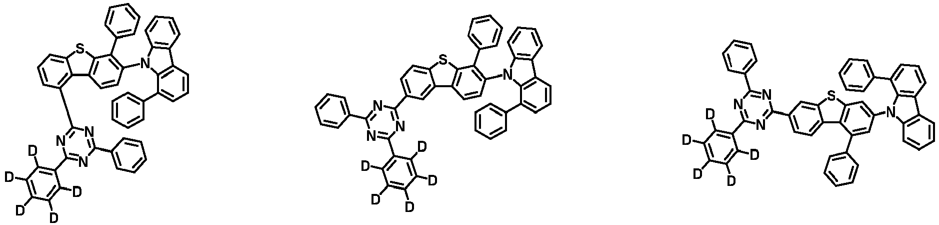

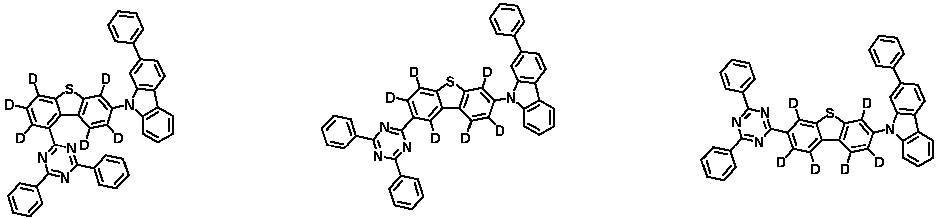

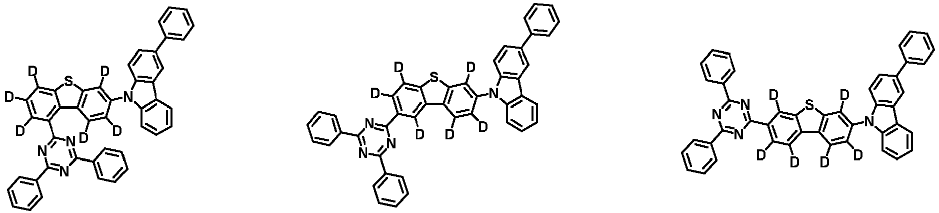

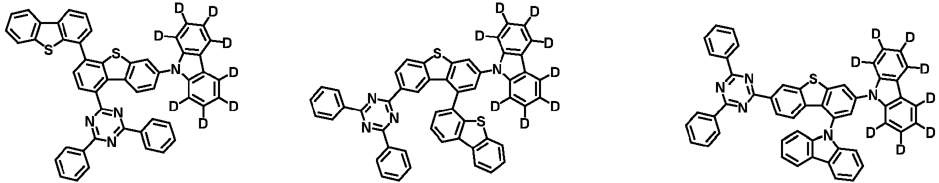

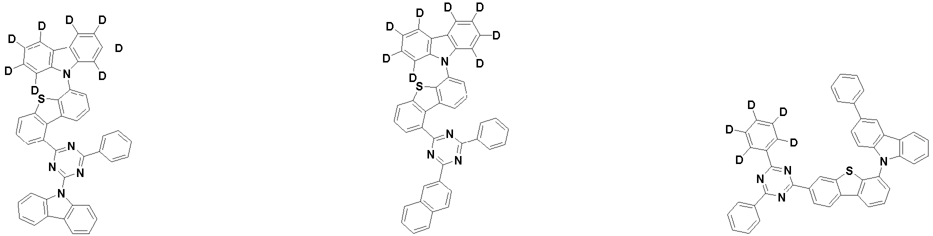

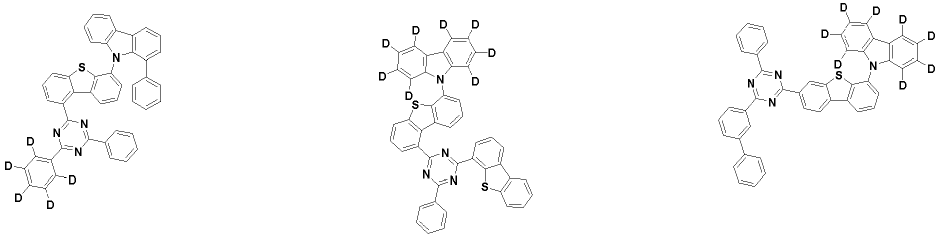

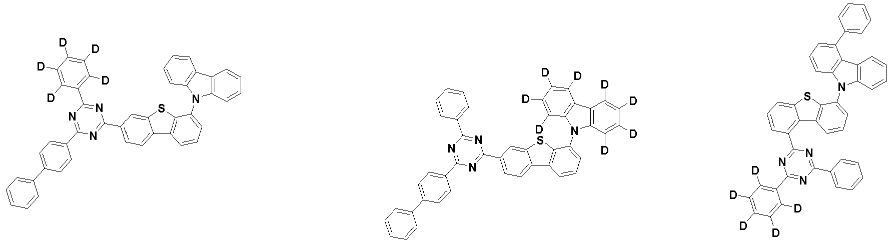

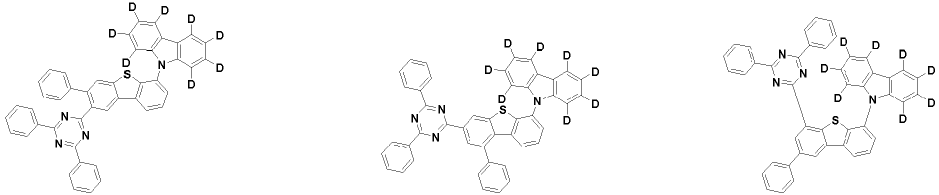

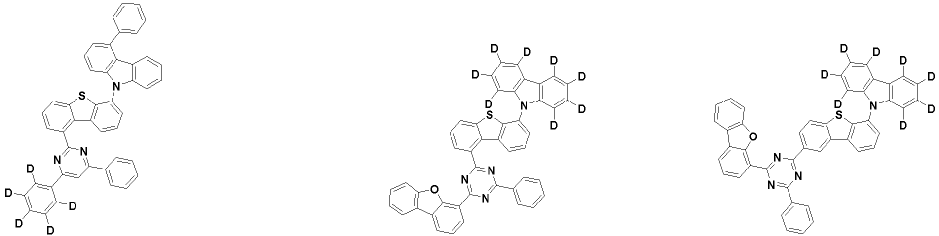

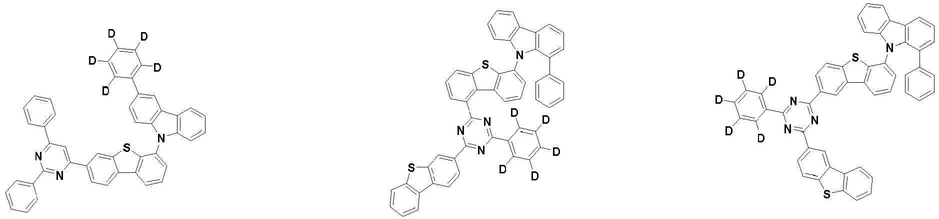

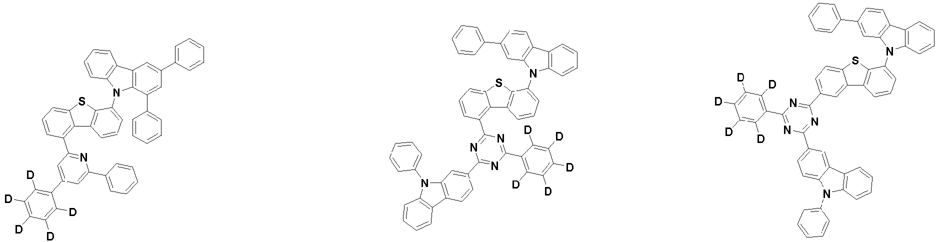

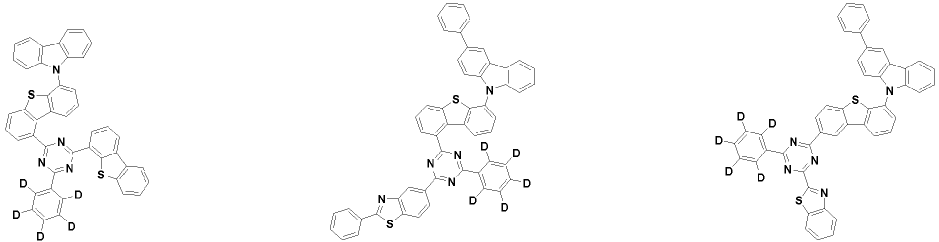

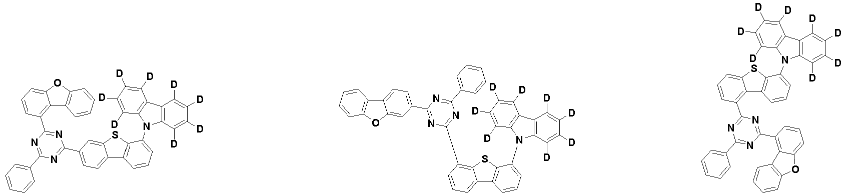

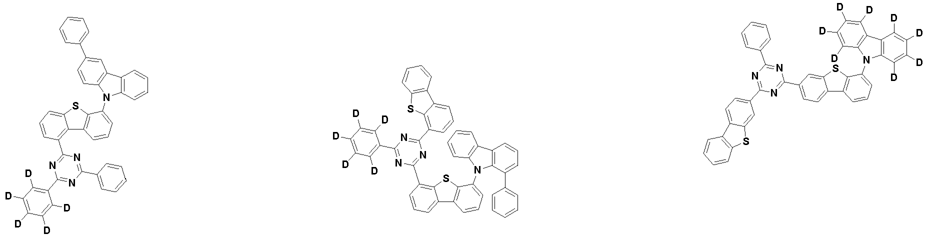

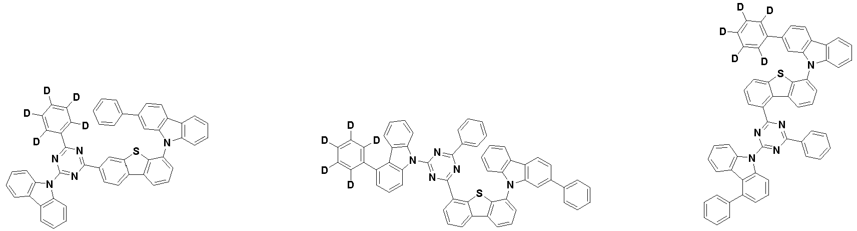

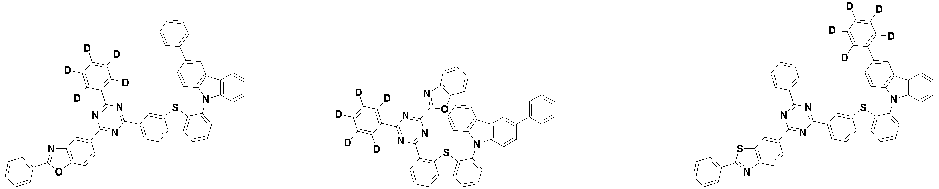

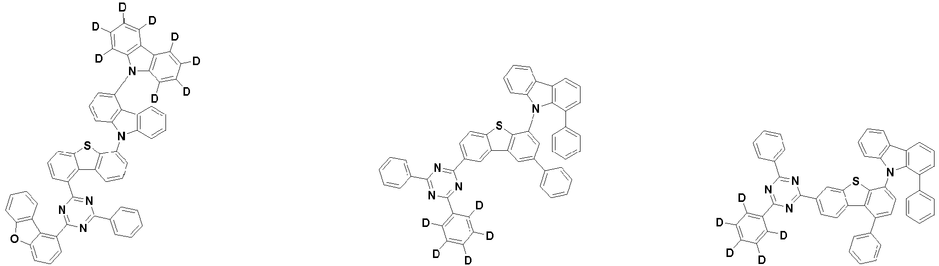

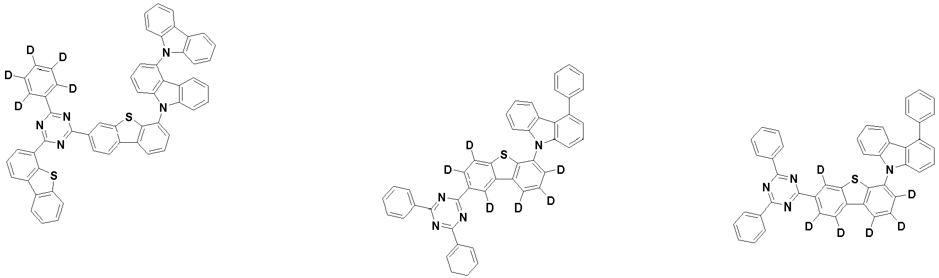

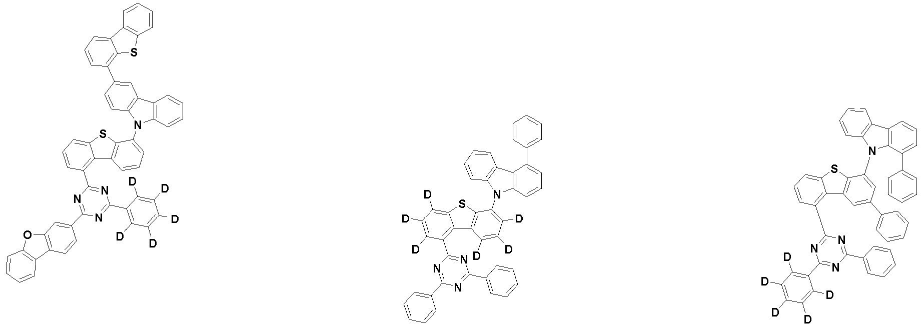

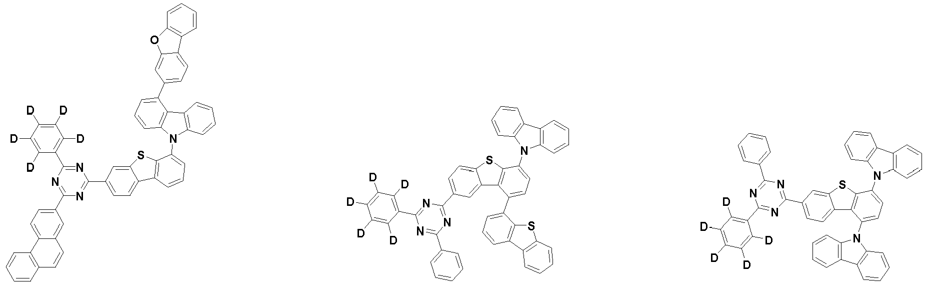

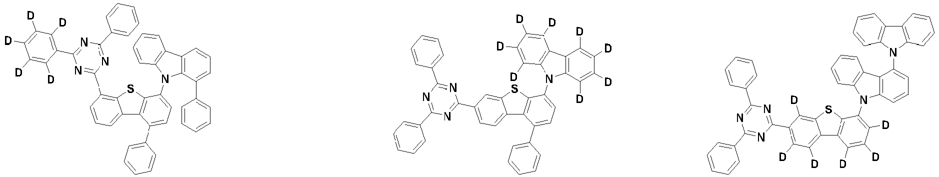

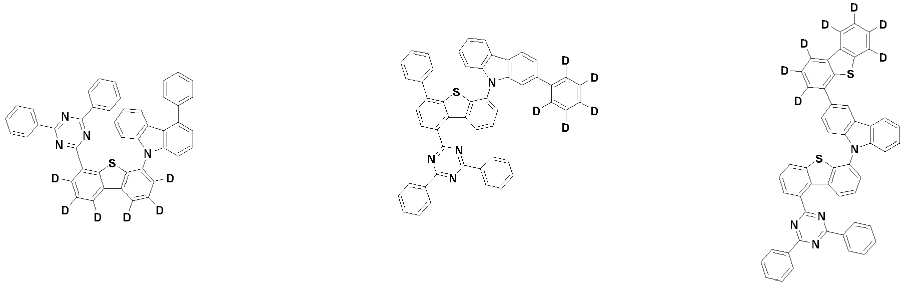

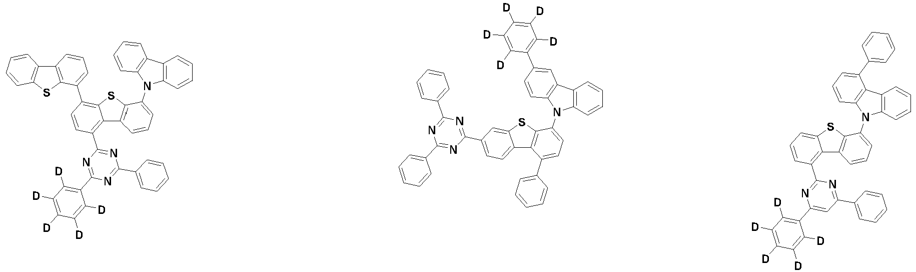

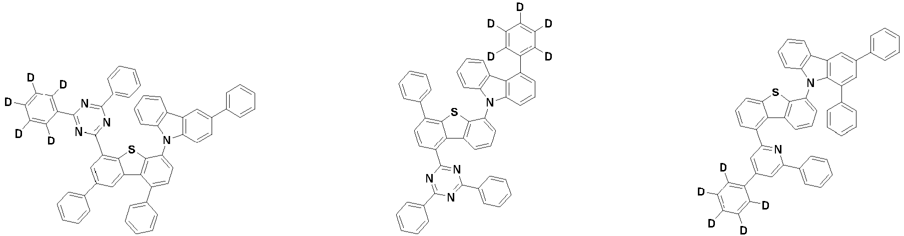

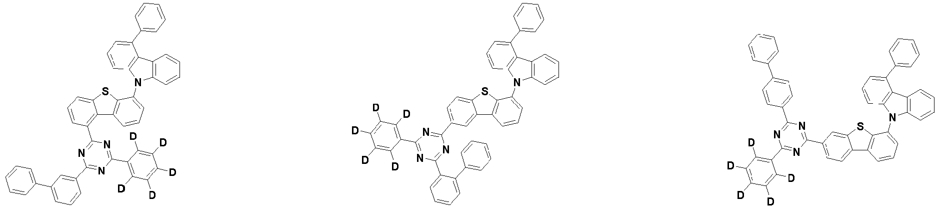

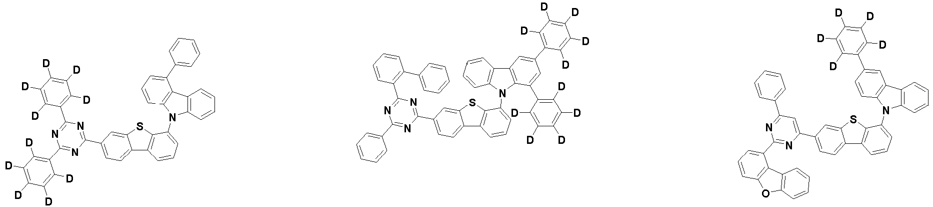

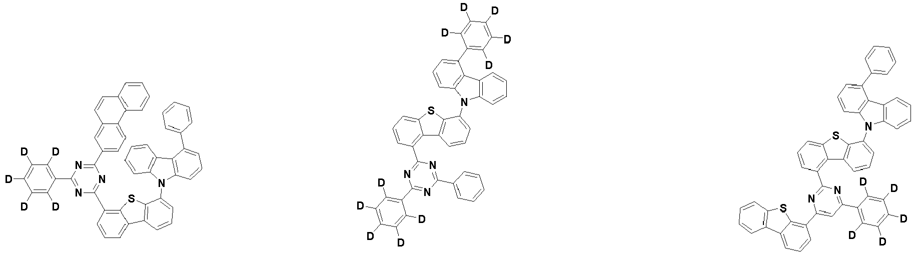

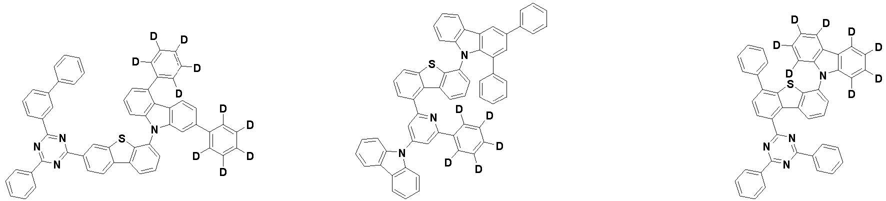

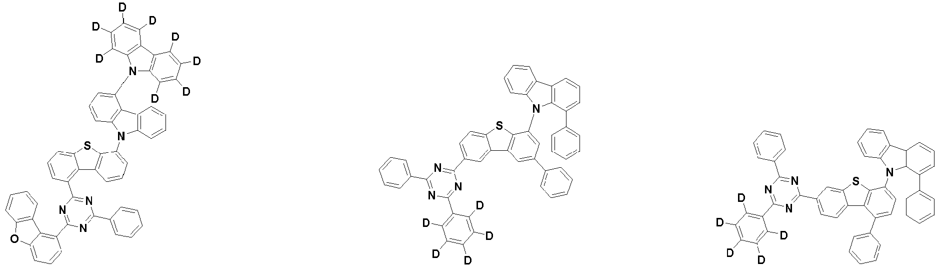

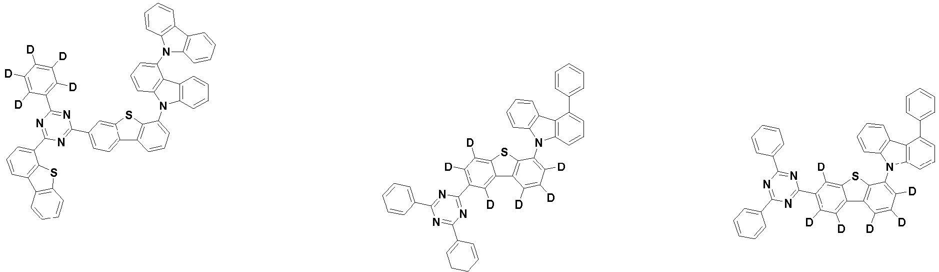

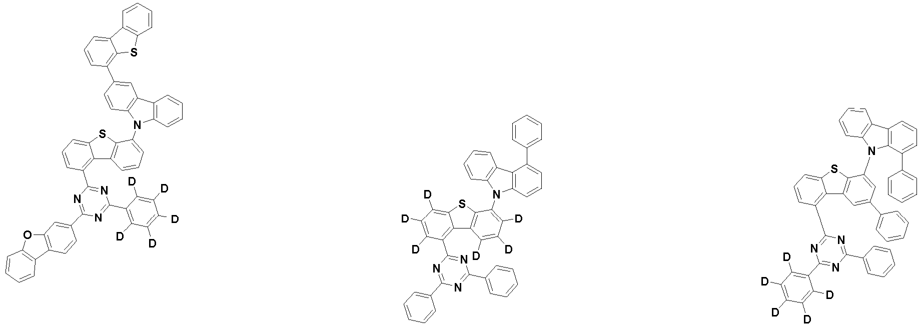

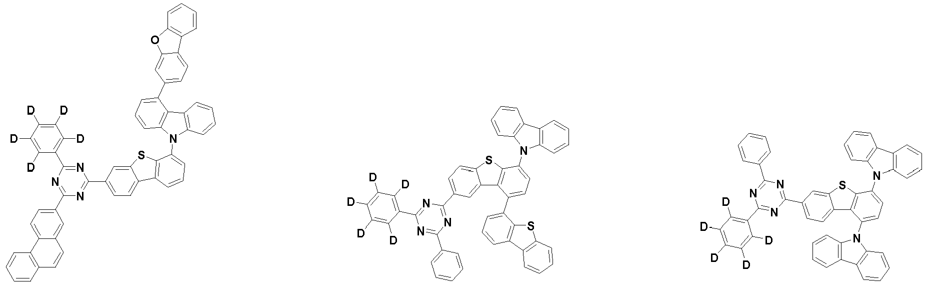

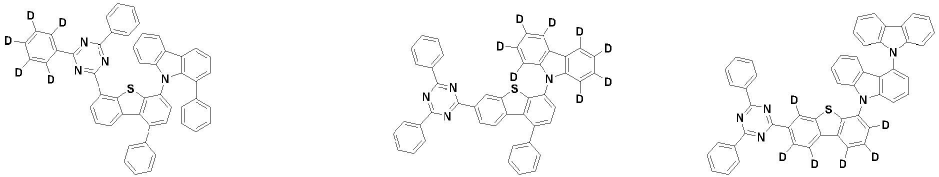

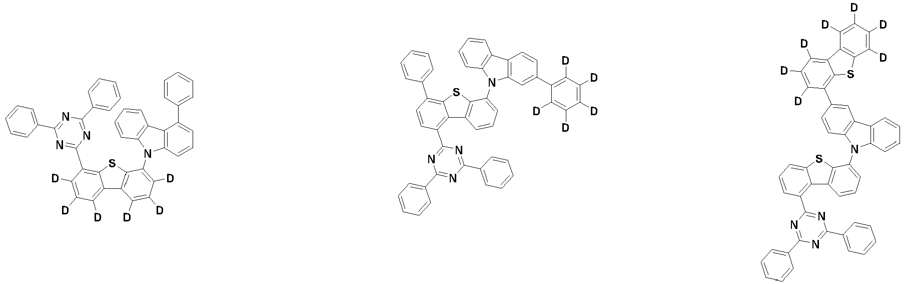

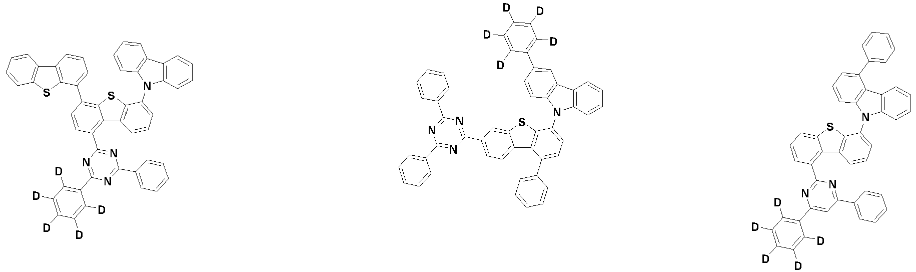

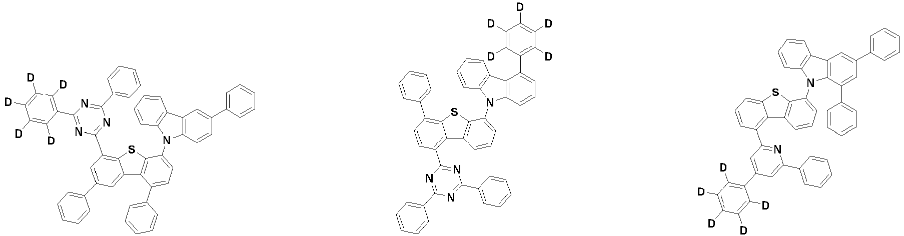

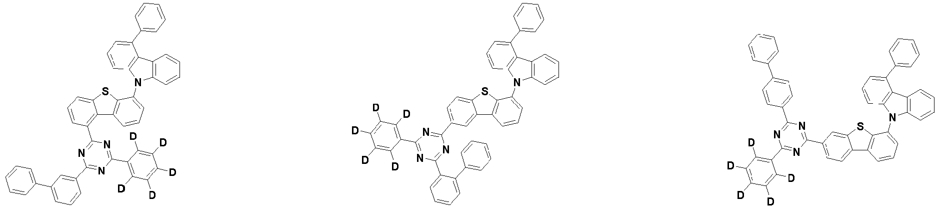

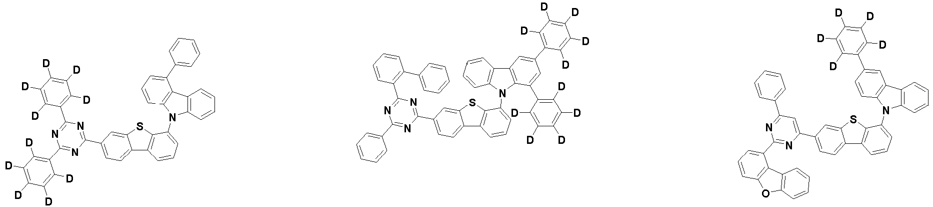

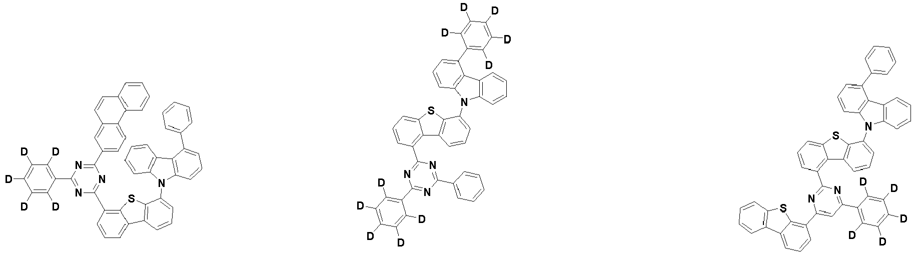

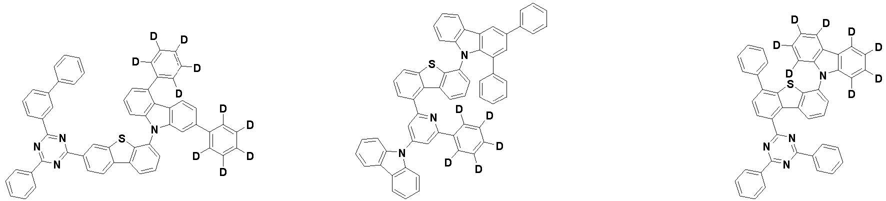

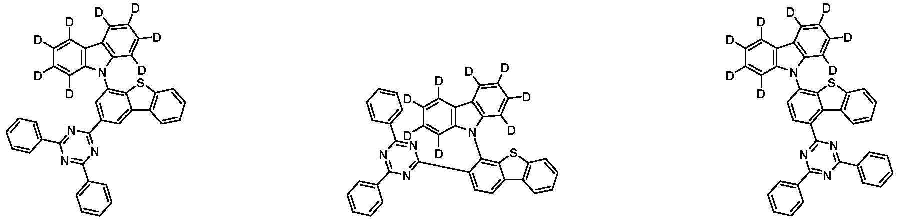

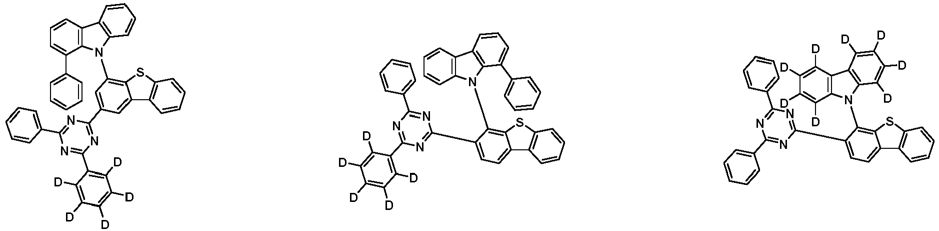

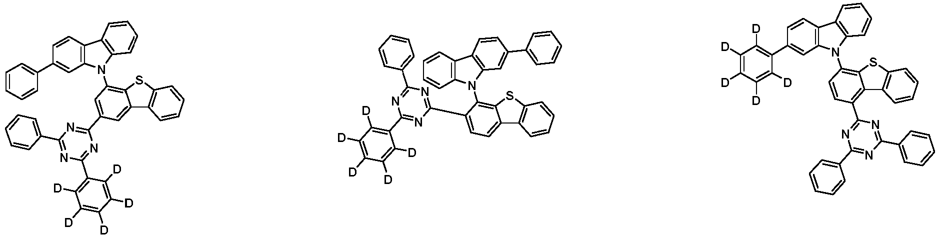

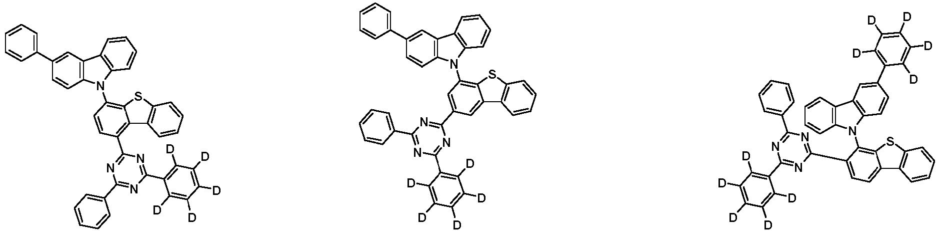

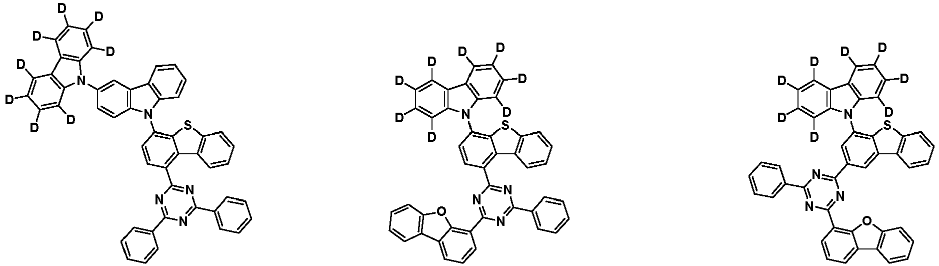

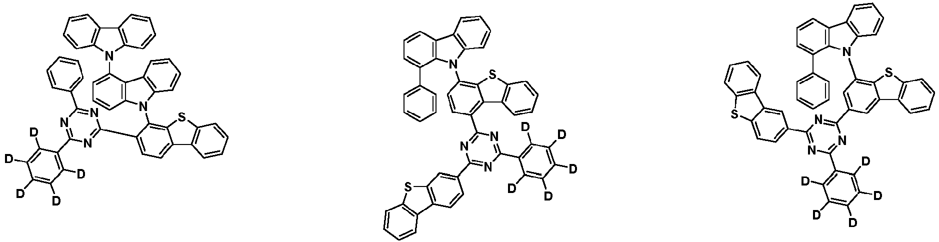

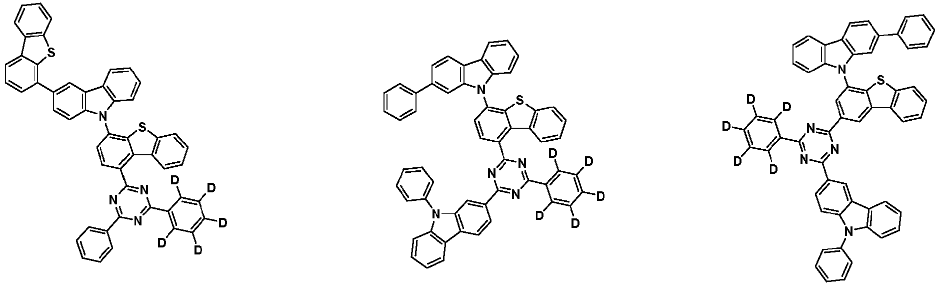

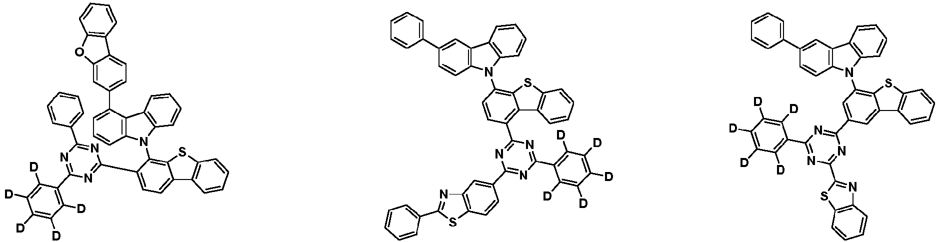

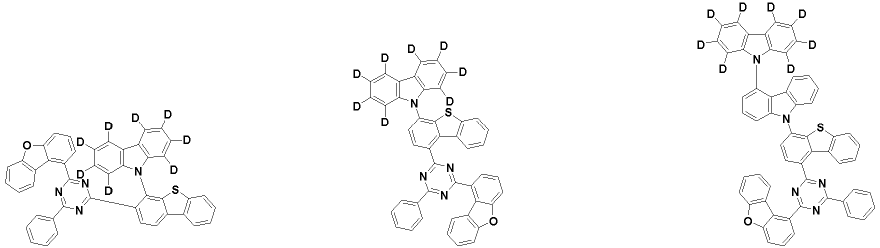

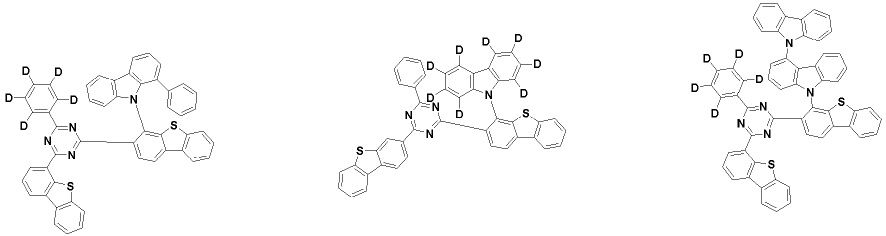

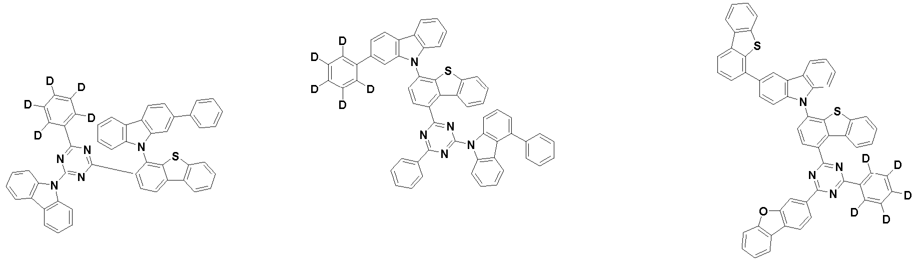

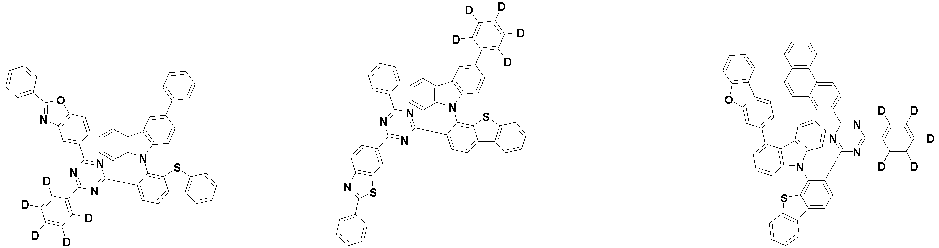

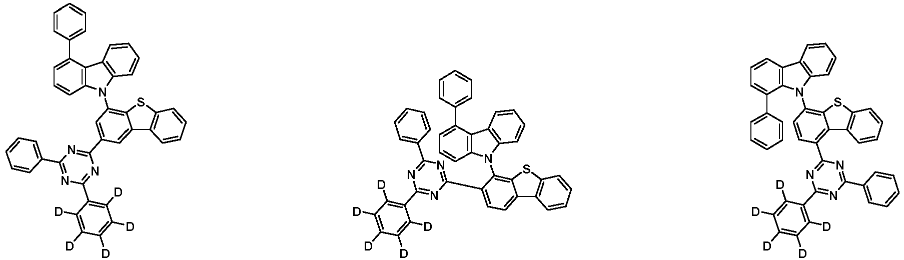

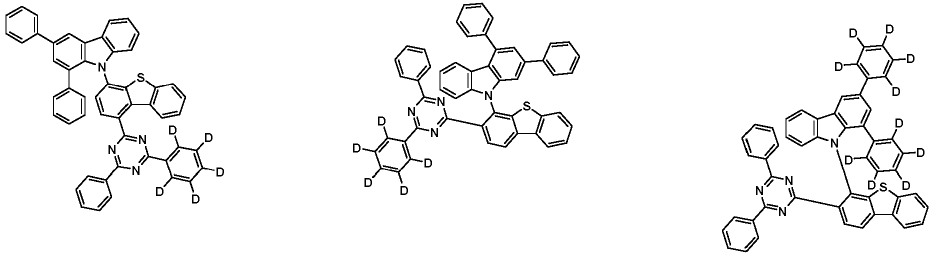

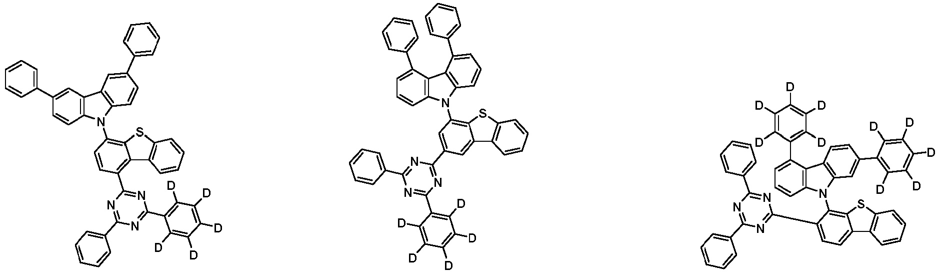

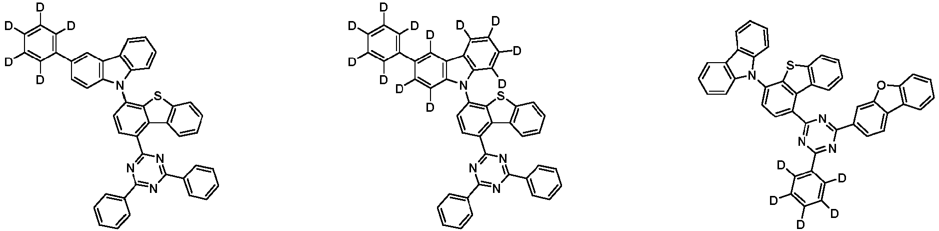

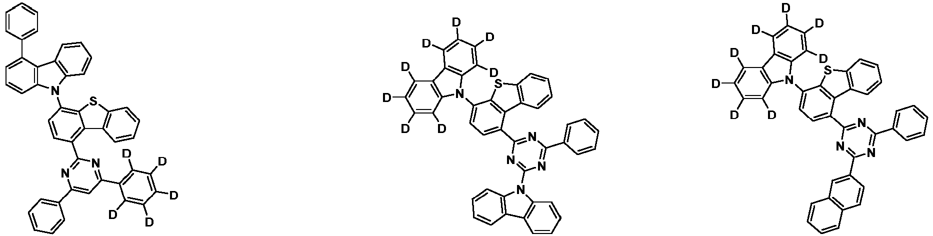

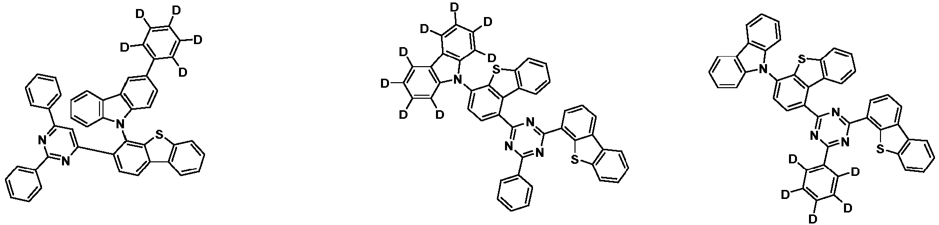

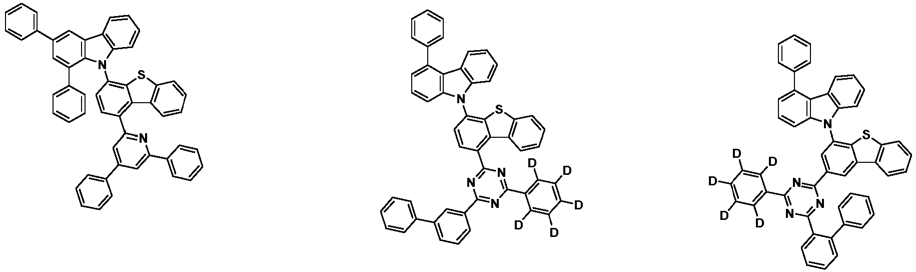

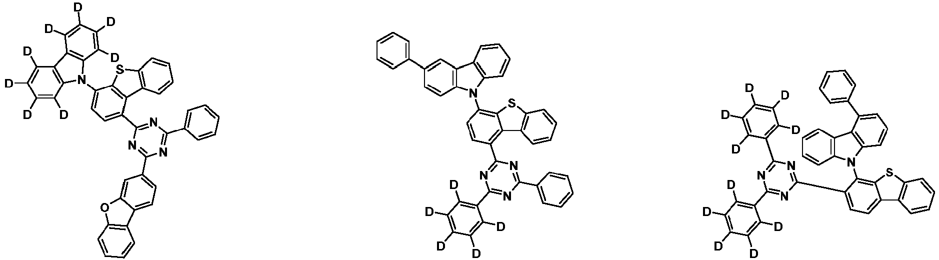

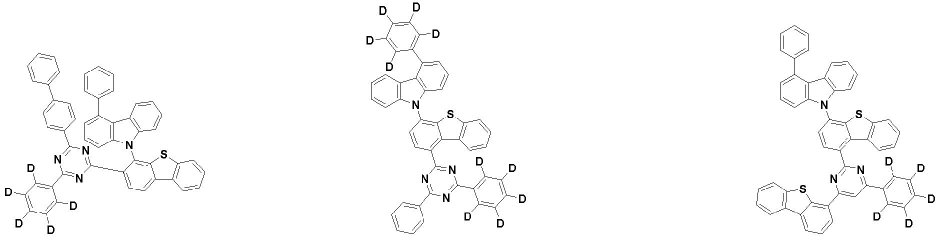

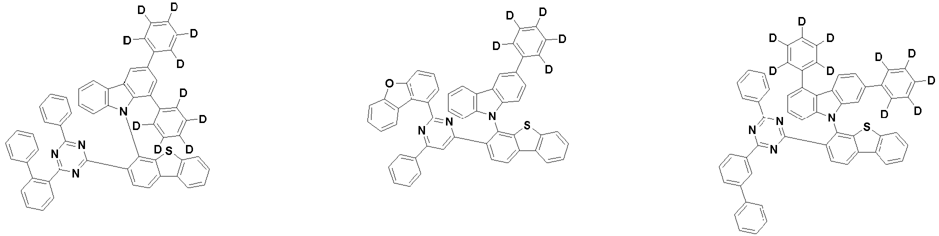

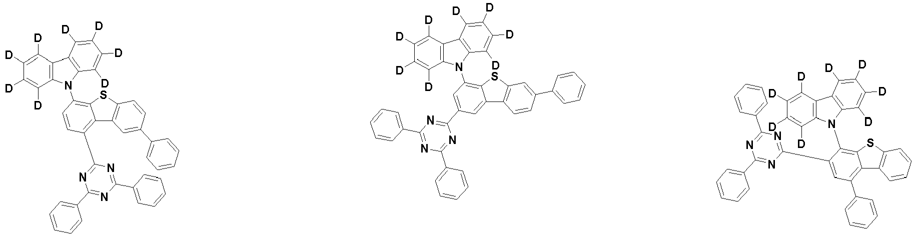

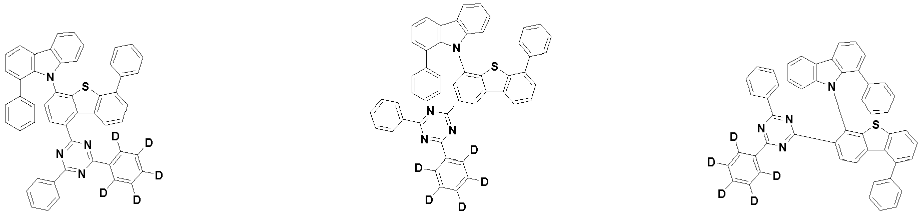

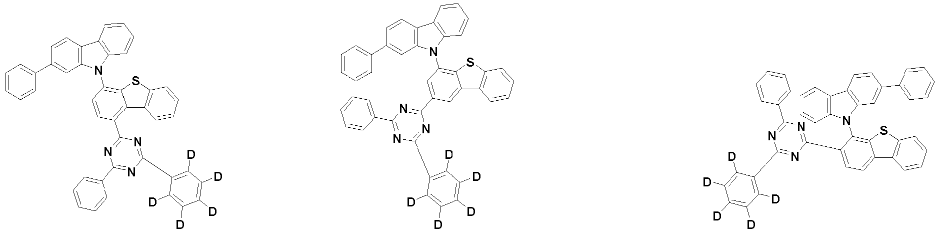

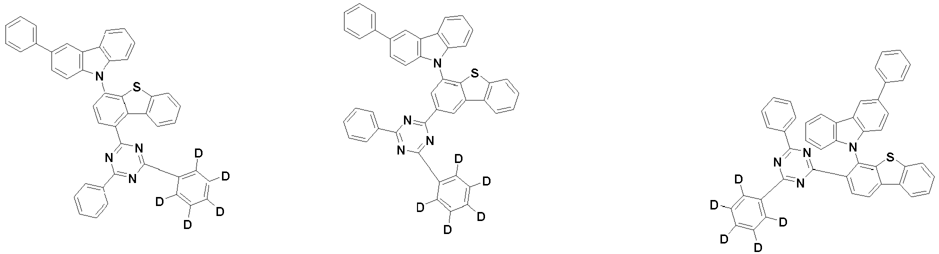

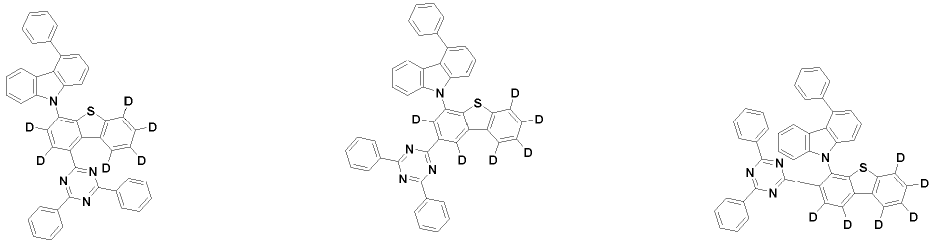

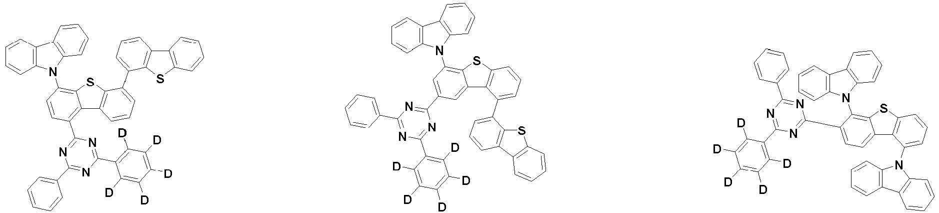

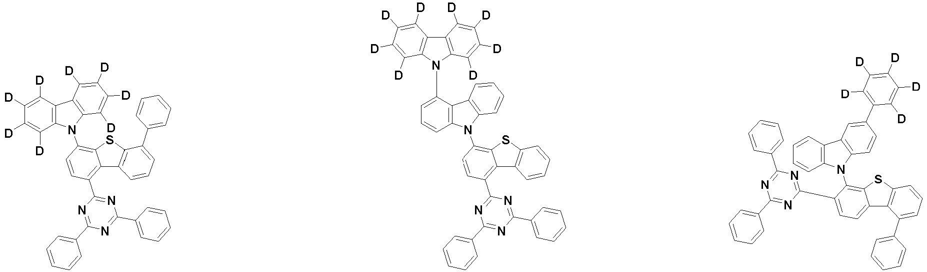

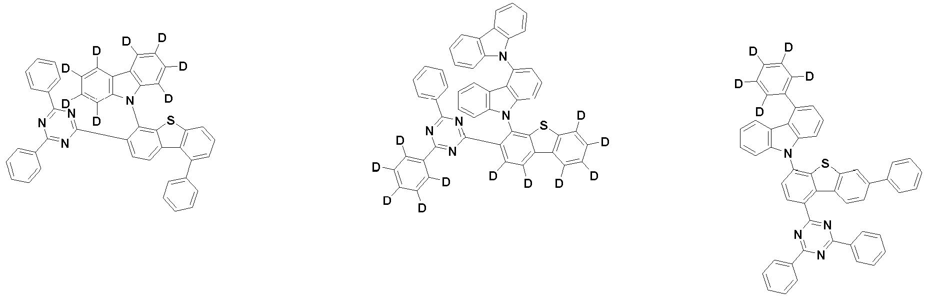

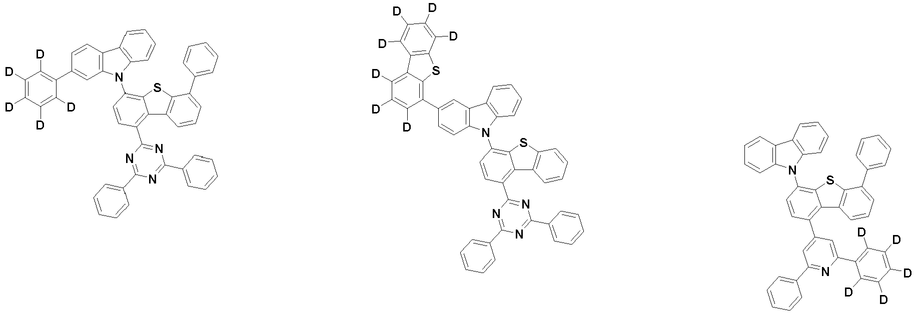

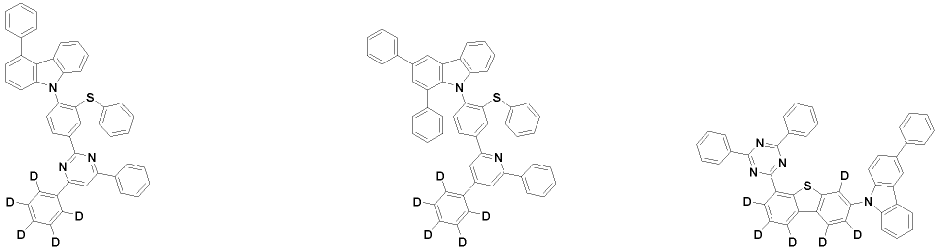

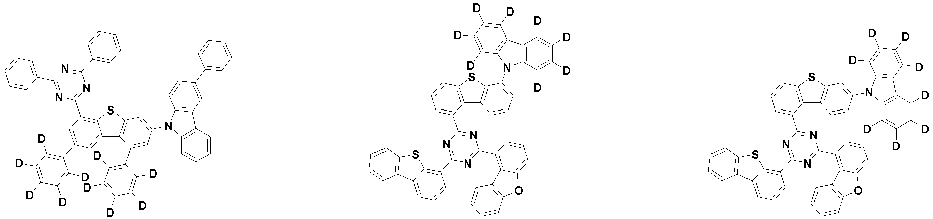

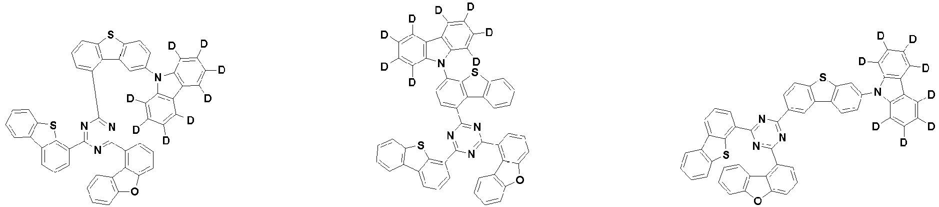

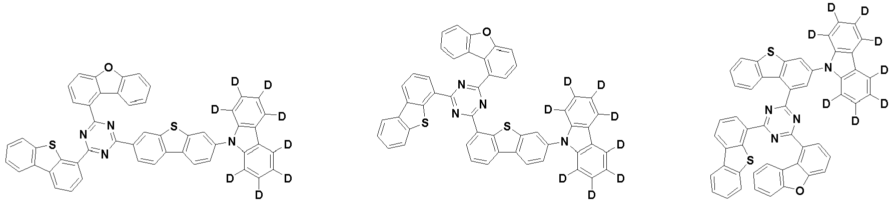

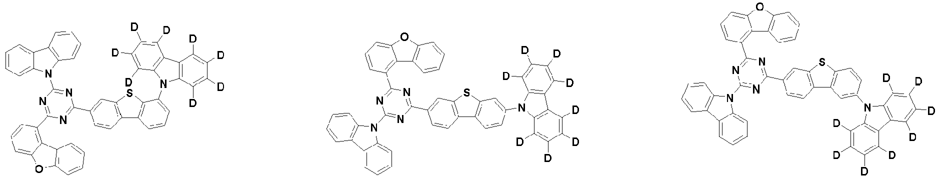

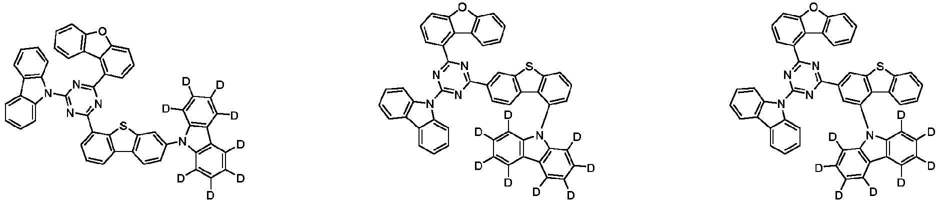

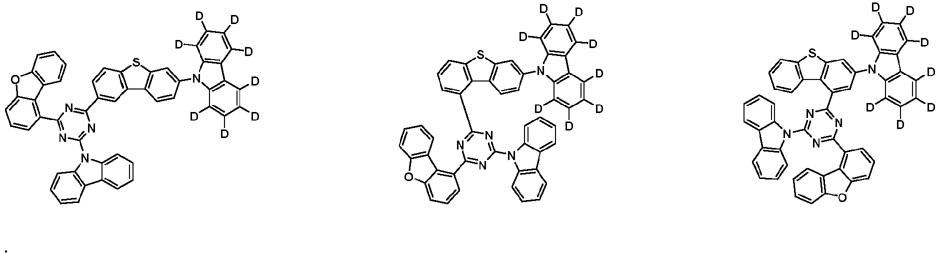

9. The organic light emitting device of Claim 1, wherein the compound represented by Chemical Formula 2 is represented by any one of the following Chemical Formulae 2-1 to 2-5: 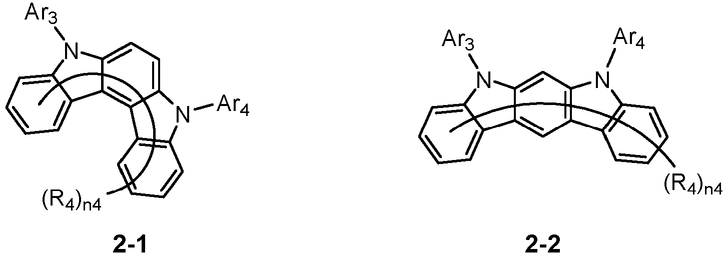 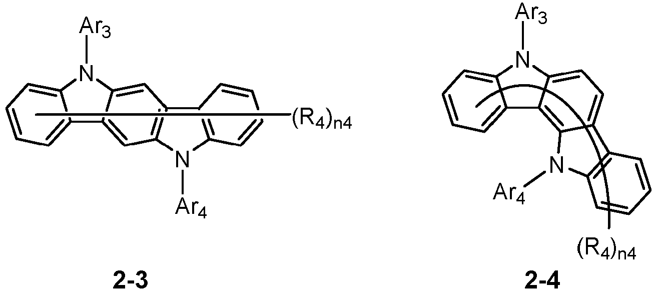 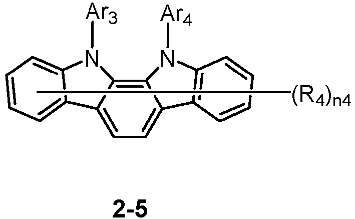 in Chemical Formulae 2-1 to 2-5, Ar₃, Ar₄, R₄, and n4 are as defined in Claim 1.

10. The organic light emitting device of Claim 1,
wherein Ar₃ and Ar₄ are each independently phenyl, biphenylyl, terphenylyl, dibenzofuranyl, dibenzothiophenyl, dimethylfluorenyl, dibenzofuranyl phenyl, dibenzothiophenyl phenyl, or dimethylfluorenyl phenyl, and
the phenyl, biphenylyl, terphenylyl, dibenzofuranyl, dibenzothiophenyl, dimethylfluorenyl, dibenzofuranyl phenyl, dibenzothiophenyl phenyl, or dimethylfluorenyl phenyl is unsubstituted or substituted with deuterium,
provided that at least one of Ar₃ and Ar₄ is substituted with at least one deuterium.

11. The organic light emitting device of Claim 1, wherein Ar₃ and Ar₄ are each independently any one selected from the group consisting of the following structural formulae, provided that at least one of Ar₃ and Ar₄ is substituted with at least one deuterium: 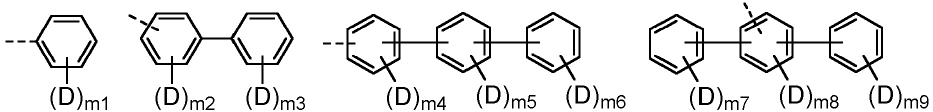 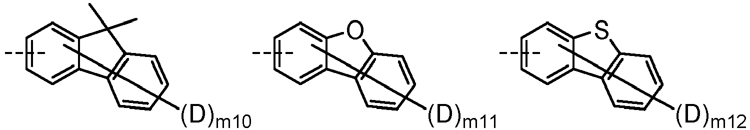 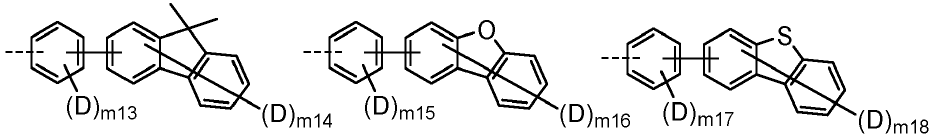
wherein in the above structural formulae,
m1 is an integer of 0 to 5,
m2 is an integer of 0 to 4,
m3 is an integer of 0 to 5,
m4 is an integer of 0 to 4,
m5 is an integer of 0 to 4,
m6 is an integer of 0 to 5,
m7 is an integer of 0 to 5,
m8 is an integer of 0 to 3,
m9 is an integer of 0 to 5,
m10 is an integer of 0 to 13,
m11 is an integer of 0 to 7,
m12 is an integer of 0 to 7,
m13 is an integer of 0 to 4,
m14 is an integer of 0 to 13,
m15 is an integer of 0 to 4,
m16 is an integer of 0 to 7,
m17 is an integer of 0 to 4, and
m18 is an integer of 0 to 7,
provided that at least one of m1 to m18 is 1 or more.

12. The organic light emitting device of Claim 1, wherein each R₄ is independently hydrogen or deuterium, provided that at least one of R₄ is deuterium.

13. The organic light emitting device of Claim 1, wherein the compound represented by Chemical Formula 2 is represented by any one of Chemical Formula 2A-1 to Chemical Formula 2A-9, Chemical Formula 2B-1 to Chemical Formula 2B-8, Chemical Formula 2C-1 to Chemical Formula 2C-7, Chemical Formula 2D-1 to Chemical Formula 2D-6, Chemical Formula 2E-1 to Chemical Formula 2E-5, and Chemical Formula 2F-1 to Chemical Formula 2F-3: 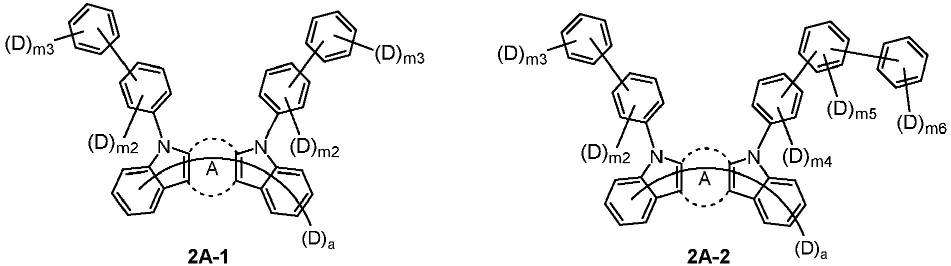 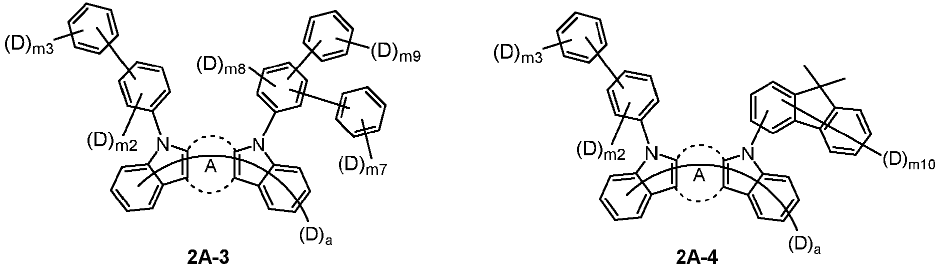 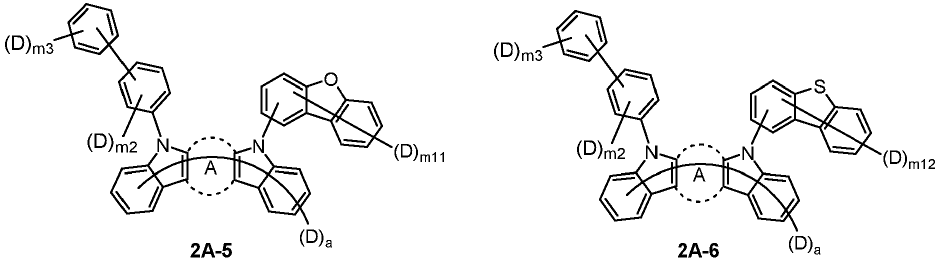 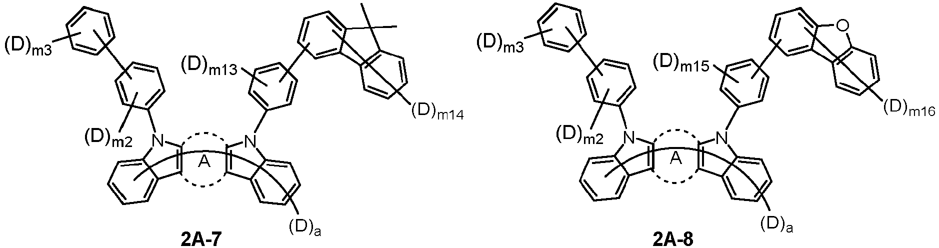 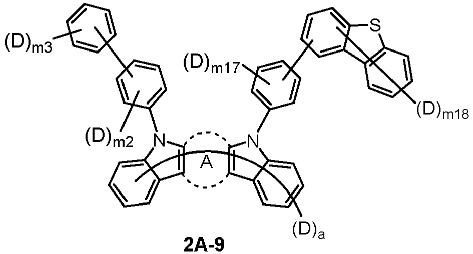 wherein in Chemical Formula 2A-1 to Chemical Formula 2A-9:
A is as defined in Claim 1;
a is an integer of 1 to 10;
m2, m4, m5, m13, m15, and m17 are each independently an integer of 0 to 4;
m3, m6, m7, and m9 are each independently an integer of 0 to 5;
m8 is an integer of 0 to 3;
m10, and m14 are each independently an integer of 0 to 13; and
m11, m12, m16, and m18 are each independently an integer of 0 to 7, provided that:
m2+m3 in Chemical Formula 2A-1 is 1 to 18,
m2+m3+m4+m5+m6 in Chemical Formula 2A-2 is 1 to 22,
m2+m3+m7+m8+m9 in Chemical Formula 2A-3 is 1 to 22,
m2+m3+m10 in Chemical Formula 2A-4 is 1 to 22,
m2+m3+m11 in Chemical Formula 2A-5 is 1 to 16,
m2+m3+m12 in Chemical Formula 2A-6 is 1 to 16,
m2+m3+m13+m14 in Chemical Formula 2A-7 is 1 to 26,
m2+m3+m15+m16 in Chemical Formula 2A-8 is 1 to 20, or
m2+m3+m17+m18 in Chemical Formula 2A-9 is 1 to 20; 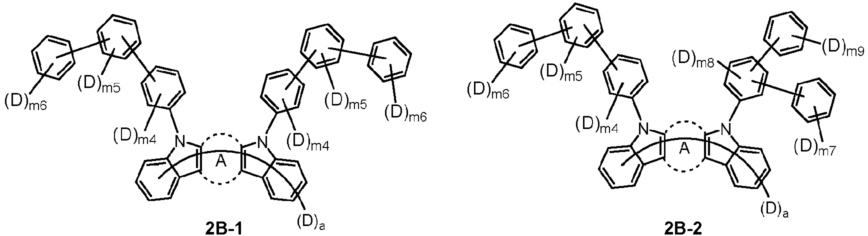 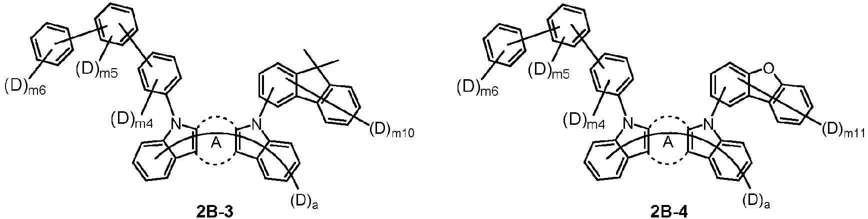 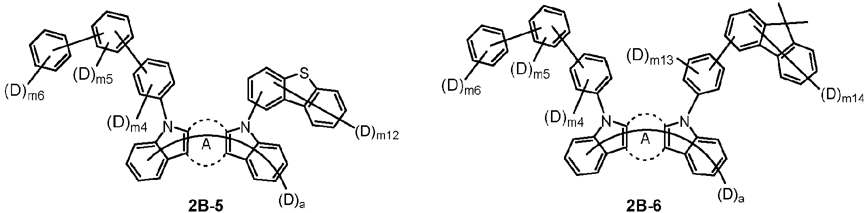 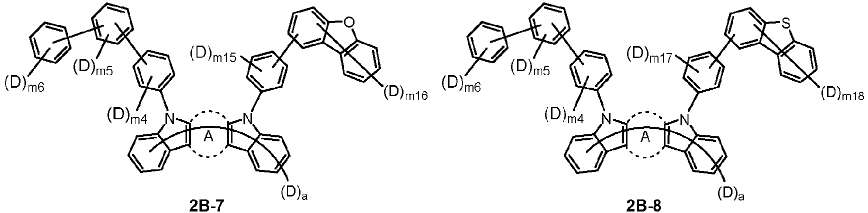
wherein in Chemical Formula 2B-1 to Chemical Formula 2B-8:
A is as defined in Claim 1;
a is an integer of 1 to 10;
m4, m5, m13, m15, and m17 are each independently an integer of 0 to 4;
m6, m7, and m9 are each independently an integer of 0 to 5;
m8 is an integer of 0 to 3;
m10, and m14 are each independently an integer of 0 to 13, and
m11, m12, m16, and m18 are each independently an integer of 0 to 7, provided that:
m4+m5+m6 in Chemical Formula 2B-1 is 1 to 26,
m4+m5+m6+m7+m8+m9 in Chemical Formula 2B-2 is 1 to 26,
m4+m5+m6+m10 in Chemical Formula 2B-3 is 1 to 26,
m4+m5+m6+m11 in Chemical Formula 2B-4 is 1 to 20,
m4+m5+m6+m12 in Chemical Formula 2B-5 is 1 to 20,
m4+m5+m6+m13+m14 in Chemical Formula 2B-6 is 1 to 30,
m4+m5+m6+m15+m16 in Chemical Formula 2B-7 is 1 to 24, or
m4+m5+m6+m17+m18 in Chemical Formula 2B-8 is 1 to 24; 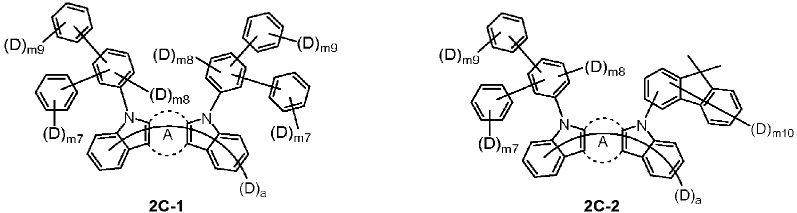 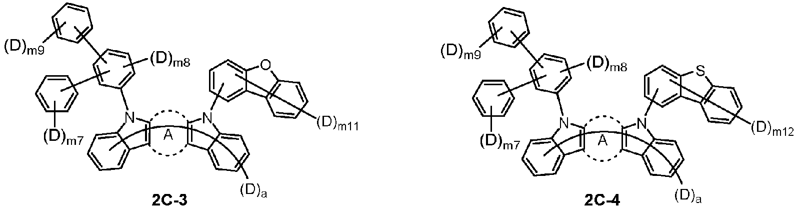 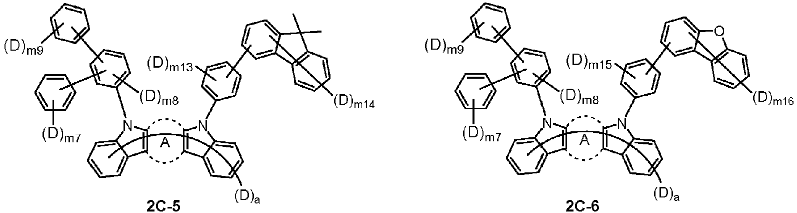 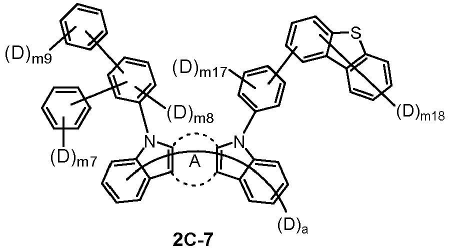
wherein in Chemical Formula 2C-1 to Chemical Formula 2C-7:
A is as defined in Claim 1;
a is an integer of 1 to 10;
m7, and m9 are each independently an integer of 0 to 5;
m8 is an integer of 0 to 3;
m10, and m14 are each independently an integer of 0 to 13;
m11, m12, m16, and m18 are each independently an integer of 0 to 7; and
m13, m15, and m17 are each independently an integer of 0 to 4, provided that:
m7+m8+m9 in Chemical Formula 2C-1 is 1 to 26,
m7+m8+m9+m10 in Chemical Formula 2C-2 is 1 to 26,
m7+m8+m9+m11 in Chemical Formula 2C-3 is 1 to 20,
m7+m8+m9+m12 in Chemical Formula 2C-4 is 1 to 20,
m7+m8+m9+m13+m14 in Chemical Formula 2C-5 is 1 to 30,
m7+m8+m9+m15+m16 in Chemical Formula 2C-6 is 1 to 24, or
m7+m8+m9+m17+m18 in Chemical Formula 2C-7 is 1 to 24; 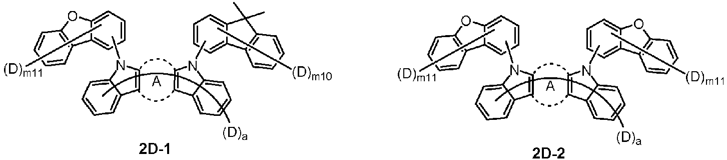 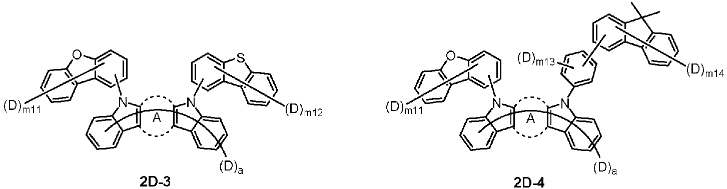 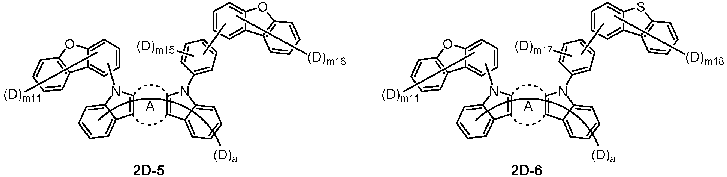
wherein in Chemical Formula 2D-1 to Chemical Formula 2D-6:
A is as defined in Claim 1;
a is an integer of 1 to 10;
m10, and m14 are each independently an integer of 0 to 13;
m11, m12, m16, and m18 are each independently an integer of 0 to 7; and
m13, m15, and m17 are each independently an integer of 0 to 4, provided that:
m10+m11 in Chemical Formula 2D-1 is 1 to 20,
m11+m11 in Chemical Formula 2D-2 is 1 to 14,
m11+m12 in Chemical Formula 2D-3 is 1 to 14,
m11+m13+m14 in Chemical Formula 2D-4 is 1 to 24,
m11+m15+m16 in Chemical Formula 2D-5 is 1 to 18, or
m11+m17+m18 in Chemical Formula 2D-6 is 1 to 18; 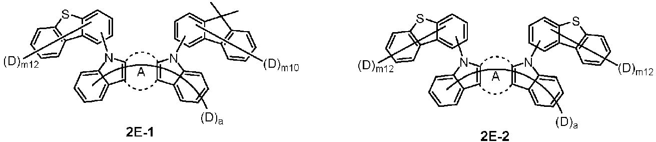 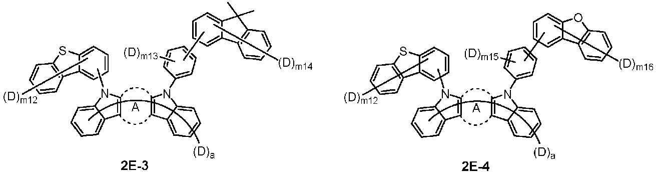 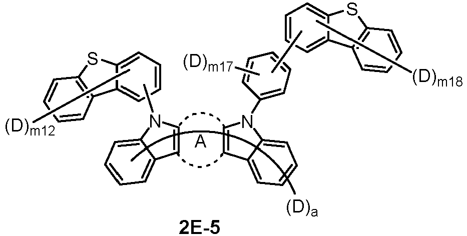
wherein in Chemical Formula 2E-1 to Chemical Formula 2E-5:
A is as defined in Claim 1;
a is an integer of 1 to 10;
m10, and m14 are each independently an integer of 0 to 13;
m12, m16, and m18 are each independently an integer of 0 to 7; and
m13, m15, and m17 are each independently an integer of 0 to 4, provided that:
m10+m12 in Chemical Formula 2E-1 is 1 to 20,
m12+m12 in Chemical Formula 2E-2 is 1 to 14,
m12+m13+m14 in Chemical Formula 2E-3 is 1 to 24,
m12+m15+m16 in Chemical Formula 2E-4 is 1 to 18, or
m12+m17+m18 in Chemical Formula 2E-5 is 1 to 18; 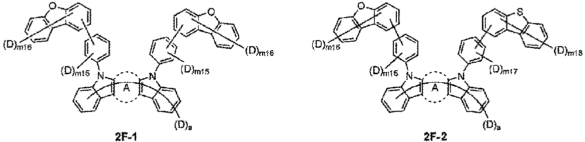 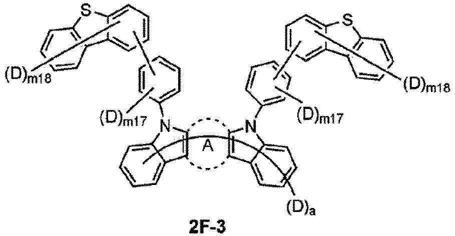
wherein in Chemical Formula 2F-1 to Chemical Formula 2F-3:
A is as defined in Claim 1;
a is an integer of 1 to 10,
m15, and m17 are each independently an integer of 0 to 4; and
m16, and m18 are each independently an integer of 0 to 7, provided that:
m15+m16 in Chemical Formula 2F-1 is 1 to 22,
m15+m16+m17+m18 in Chemical Formula 2F-2 is 1 to 22, or
m17+m18 in Chemical Formula 2F-3 is 1 to 22.

14. The organic light emitting device of Claim 1, wherein a deuterium substitution ratio of Chemical Formula 2 is 50% to 100%.

15. The organic light emitting device of Claim 1, wherein the compound represented by Chemical Formula 2 is any one compound selected from the group consisting of:

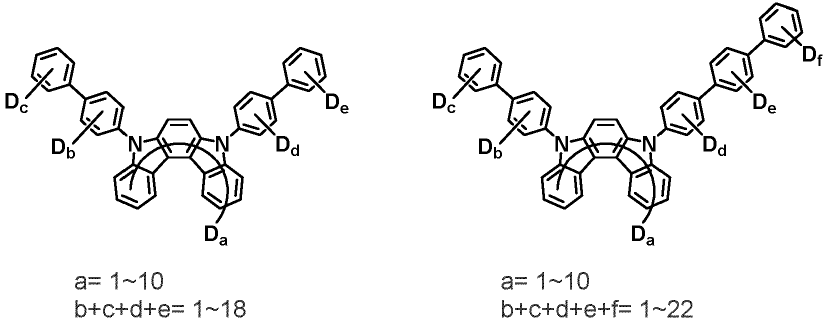

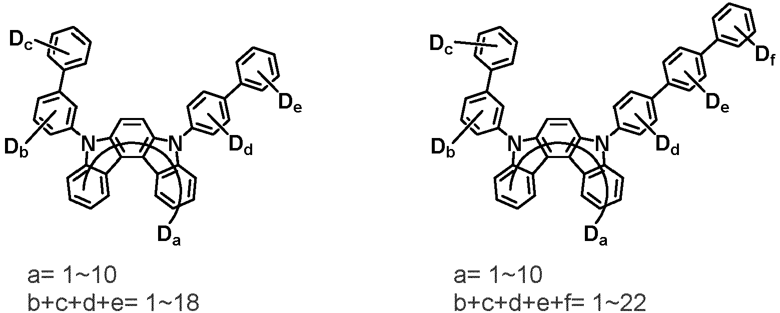

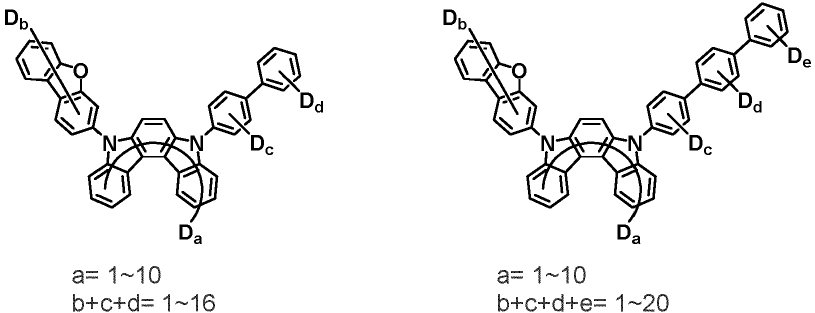

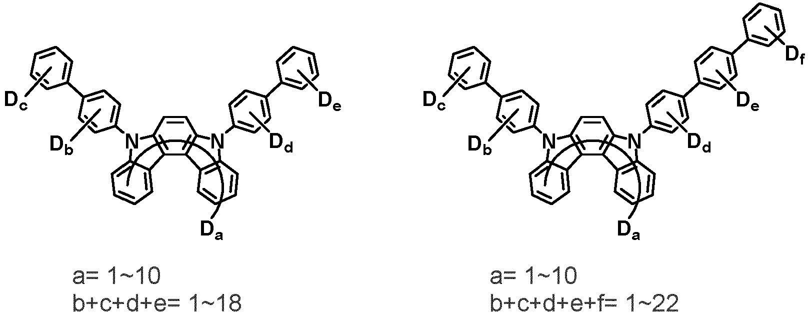

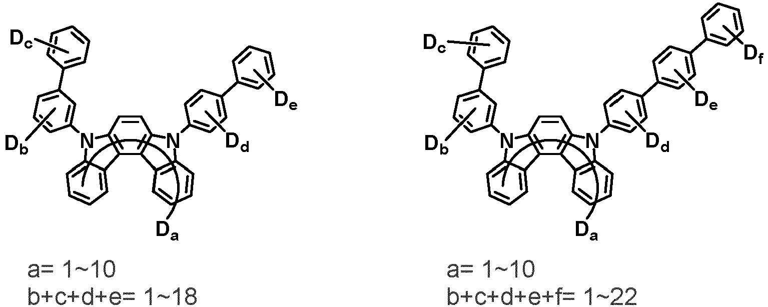

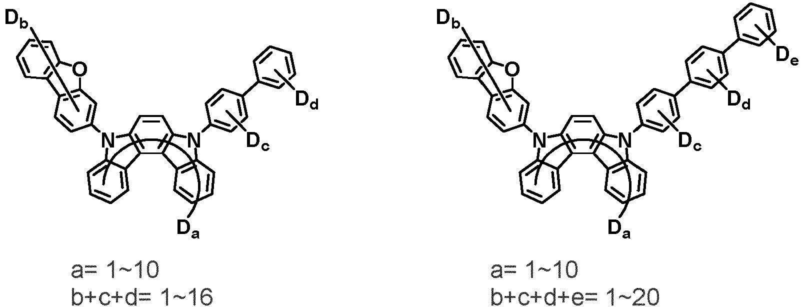

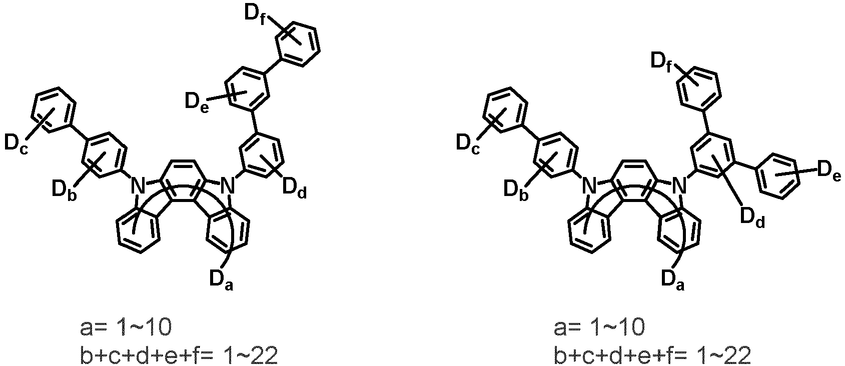

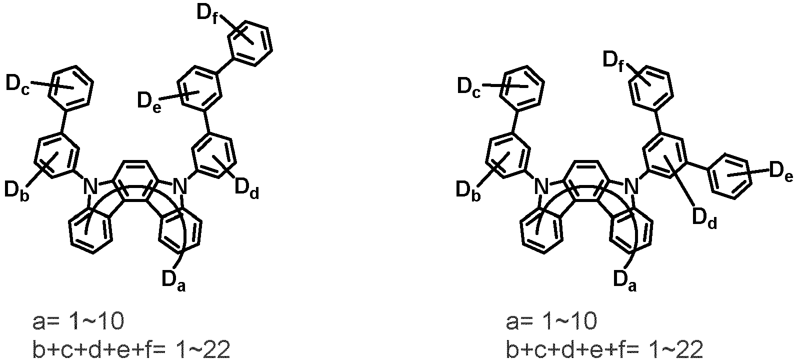

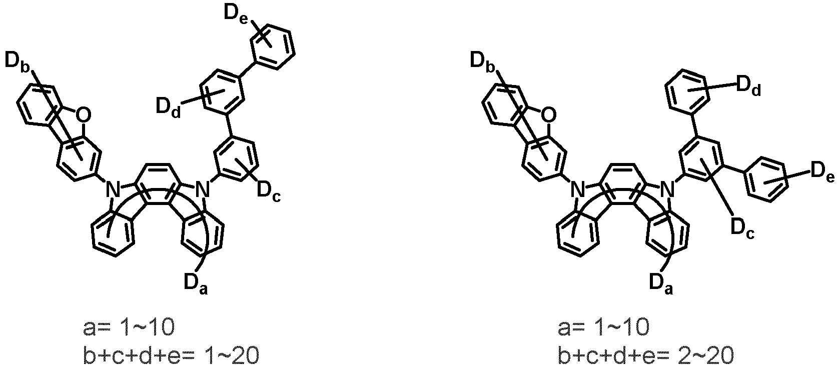

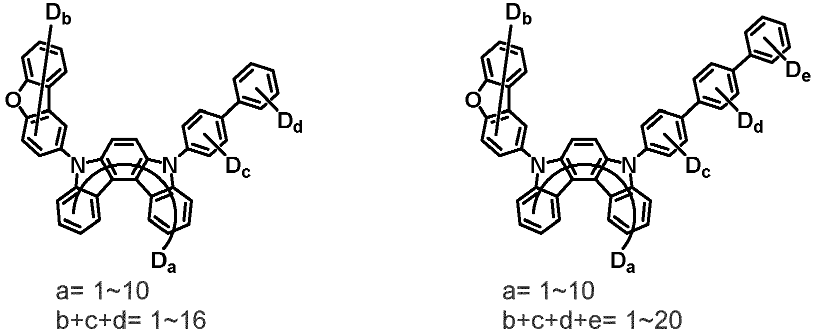

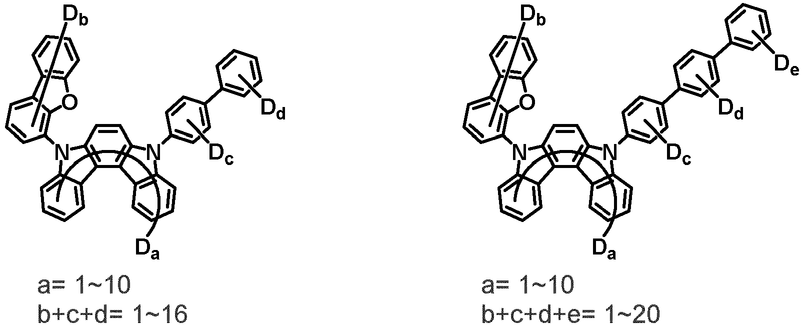

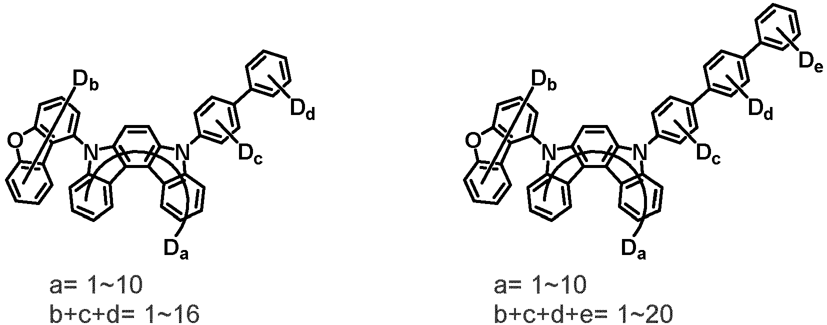

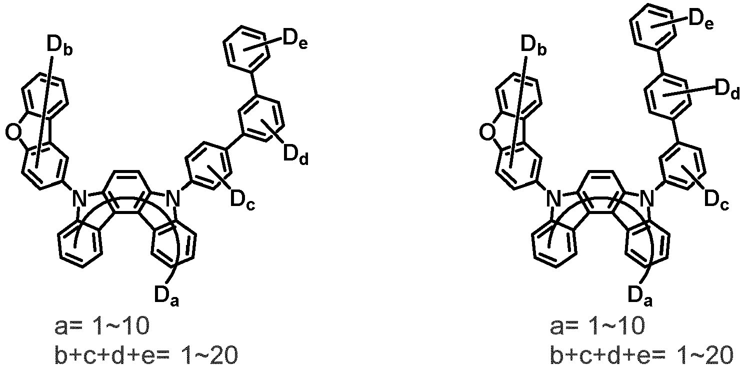

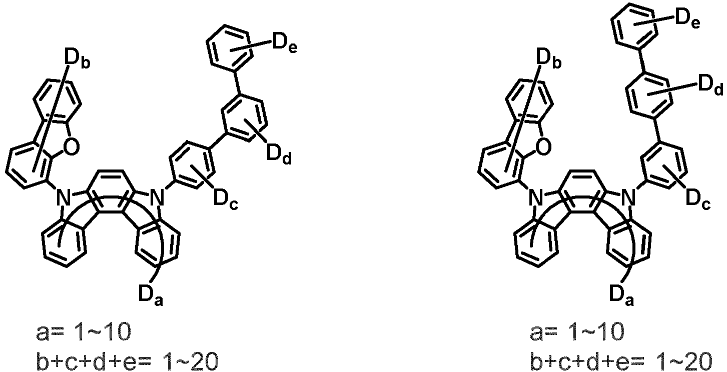

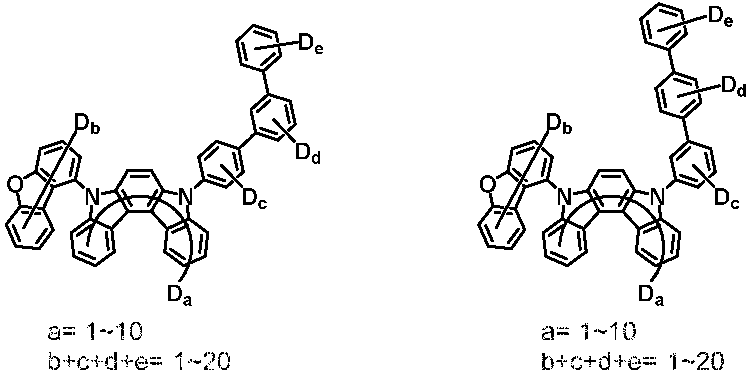

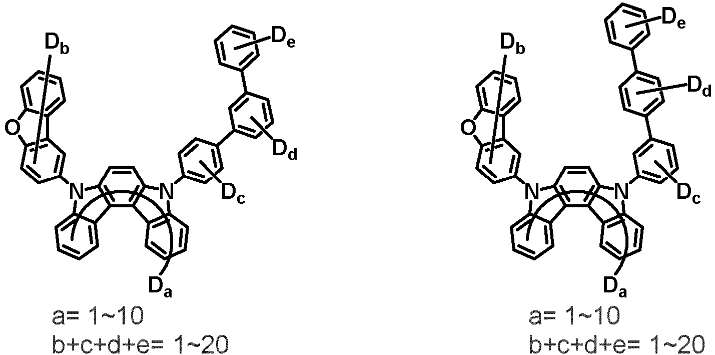

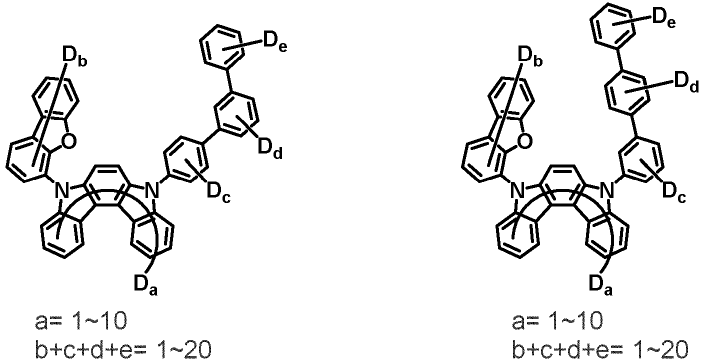

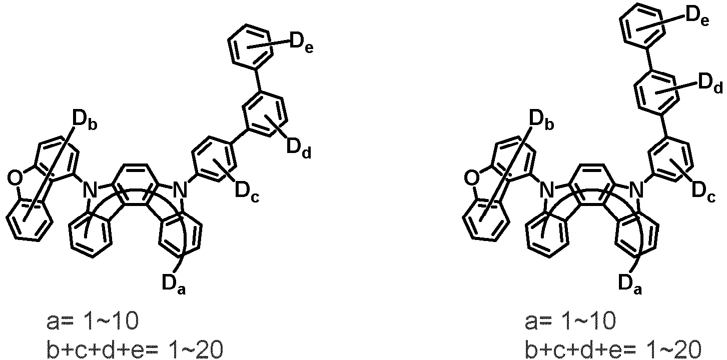

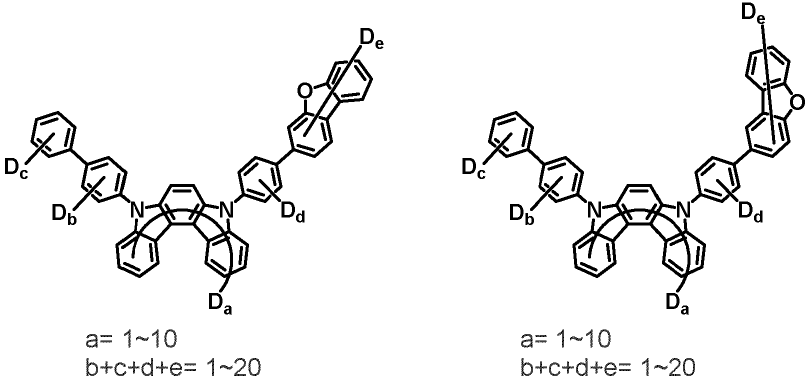

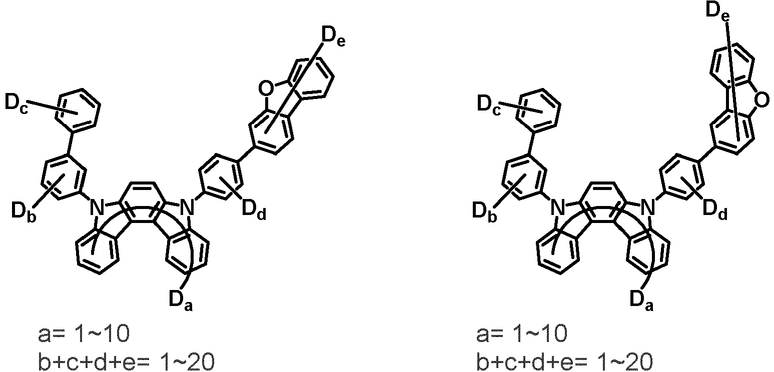

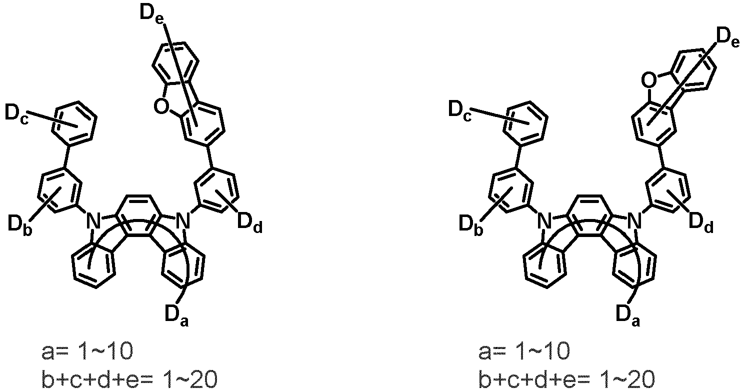

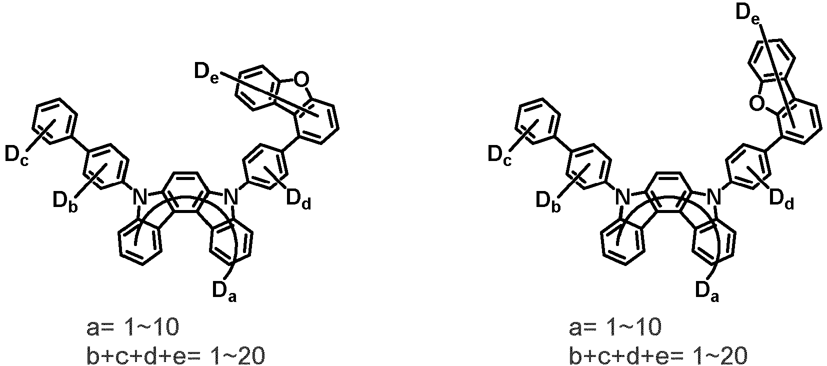

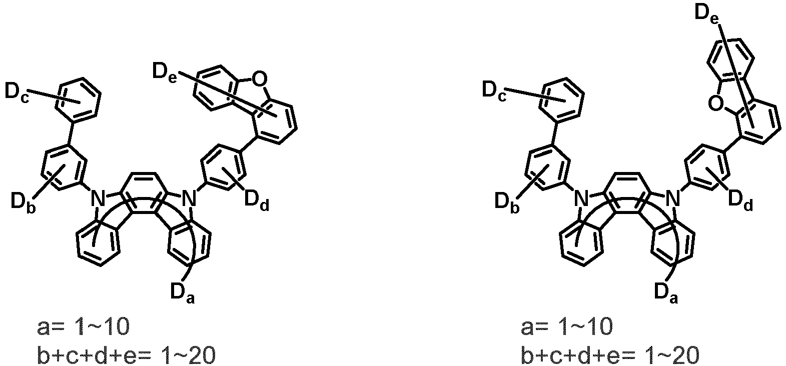

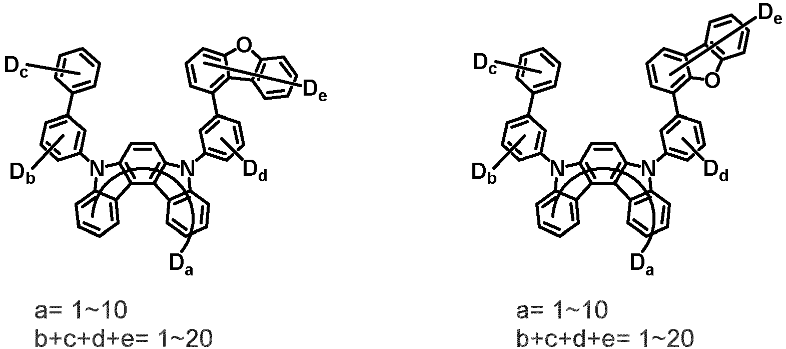

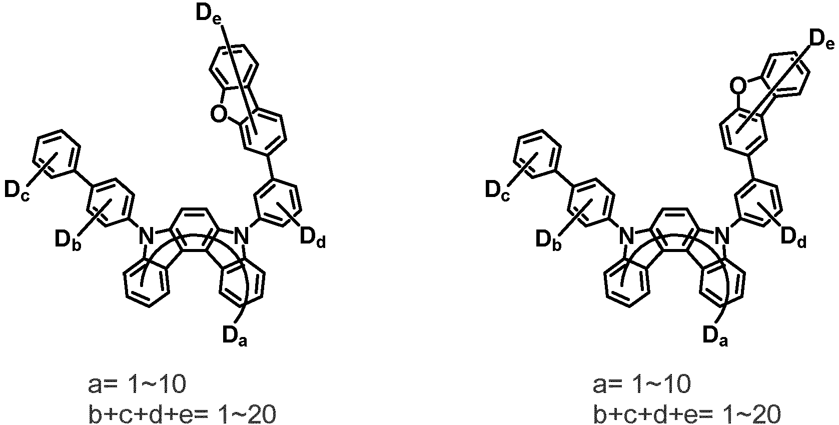

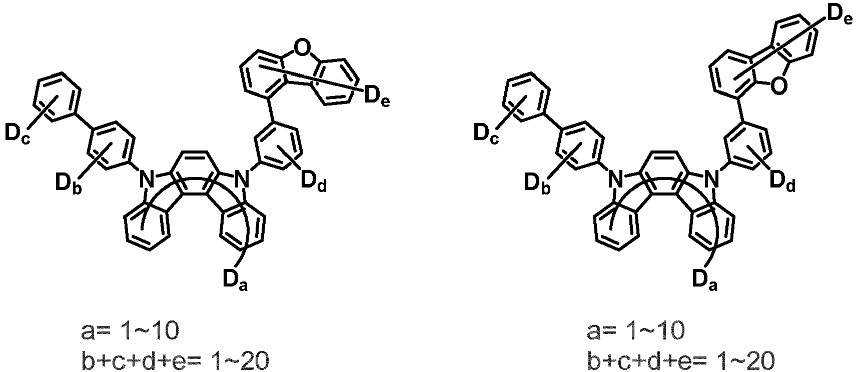

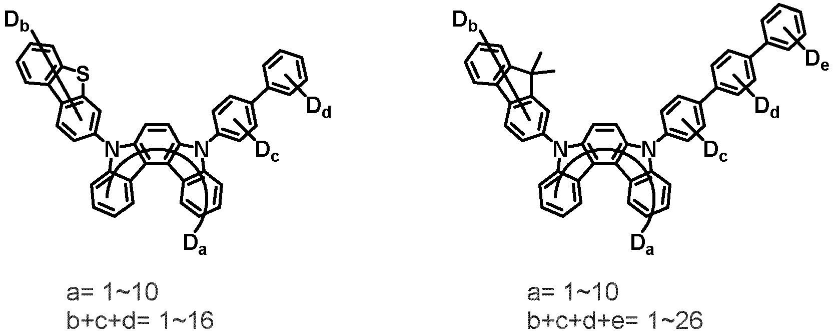

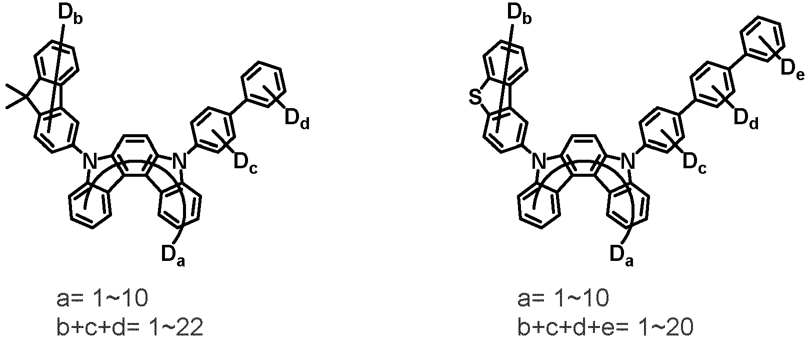

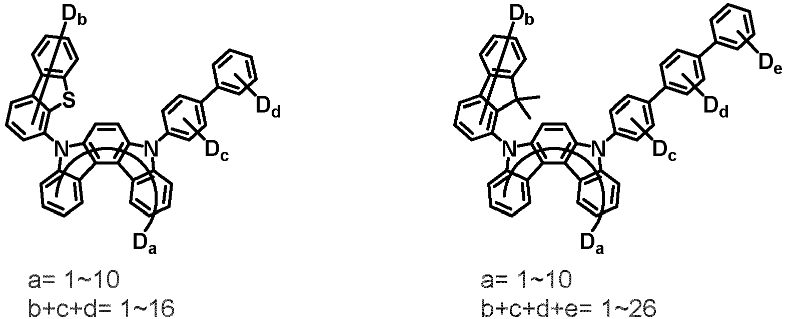

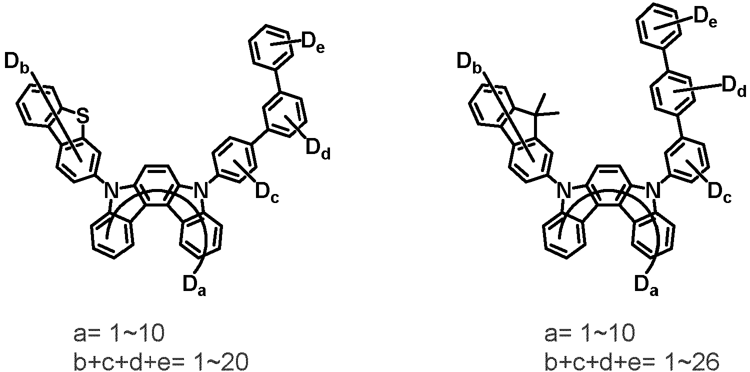

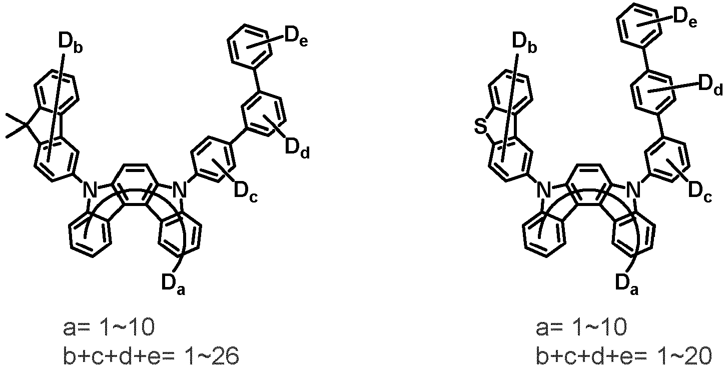

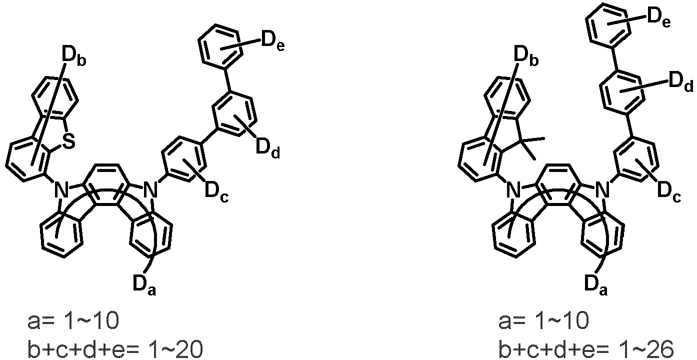

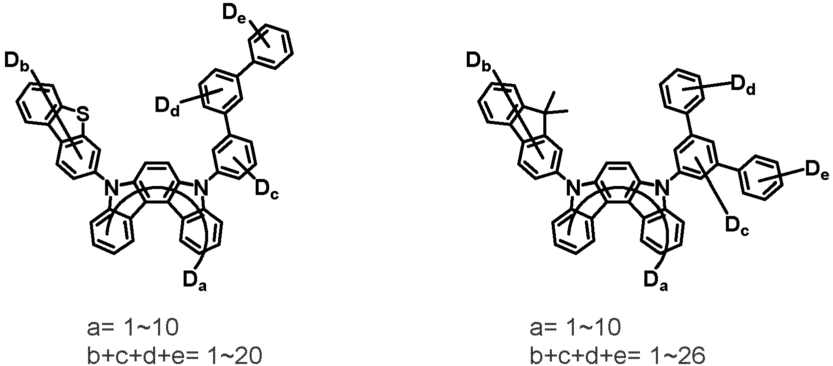

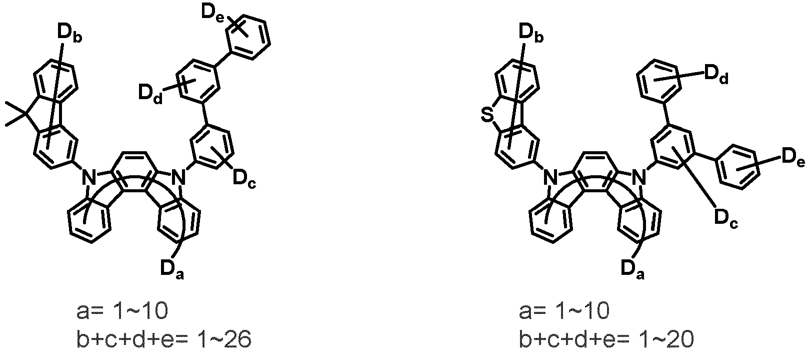

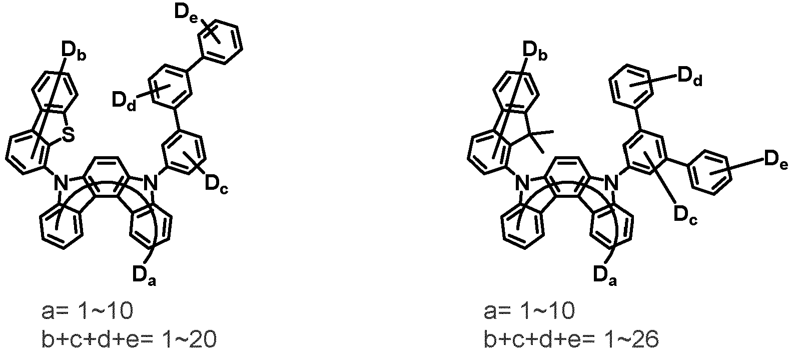

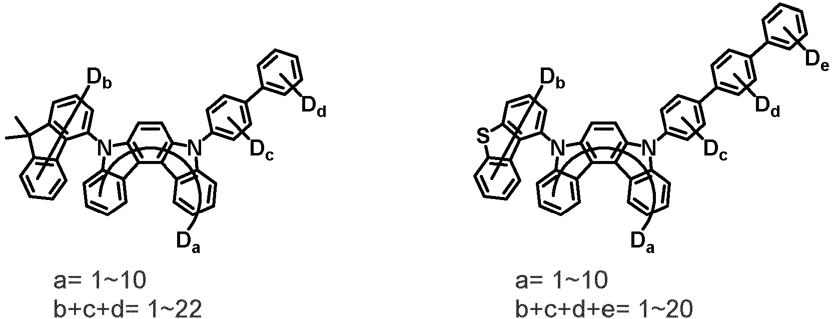

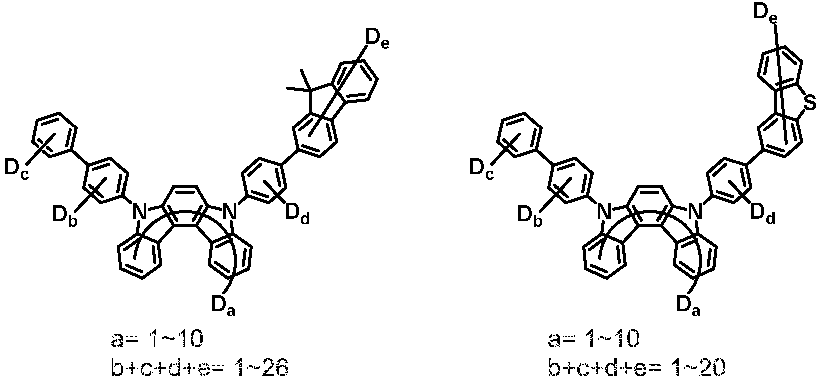

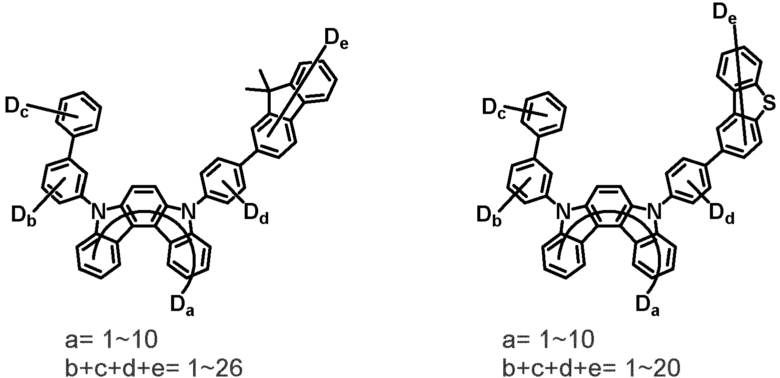

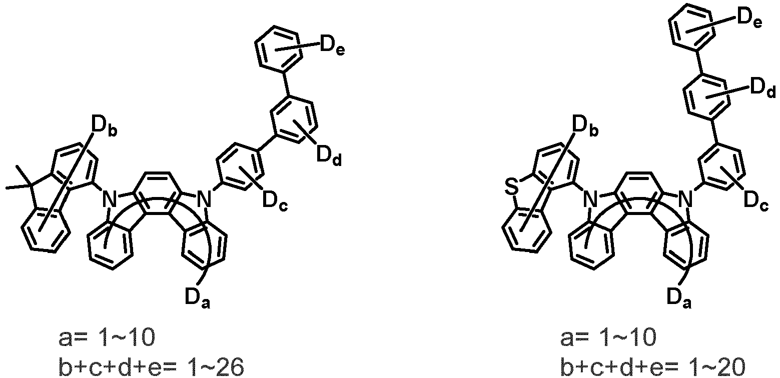

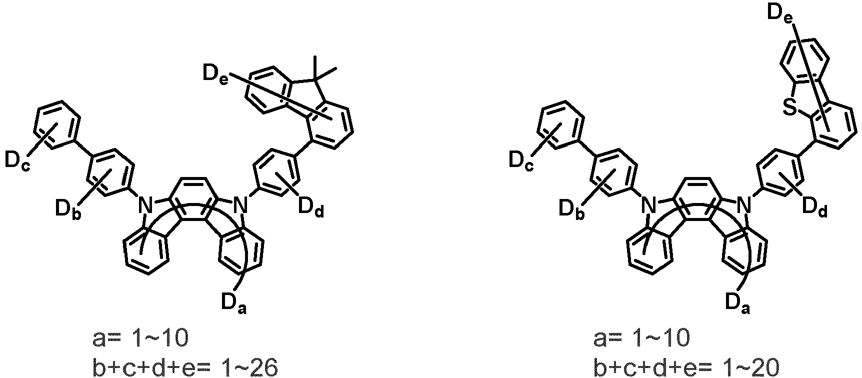

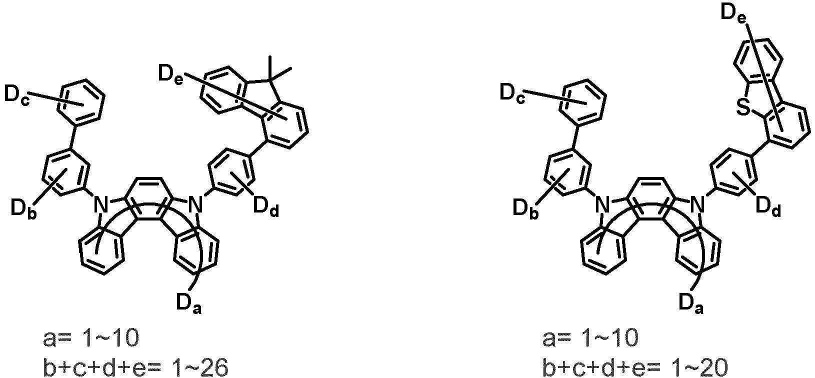

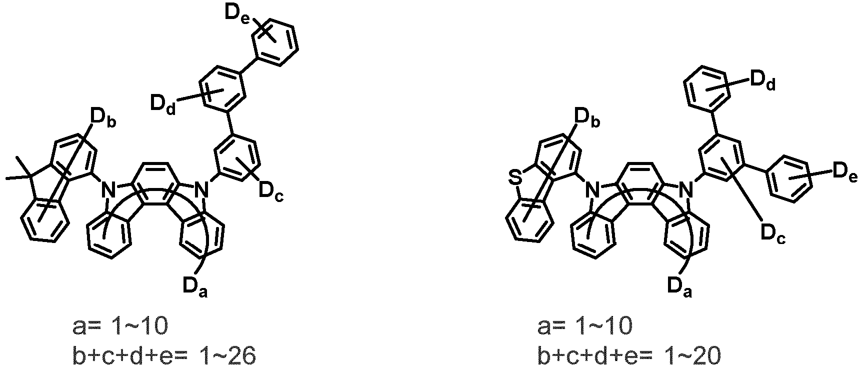

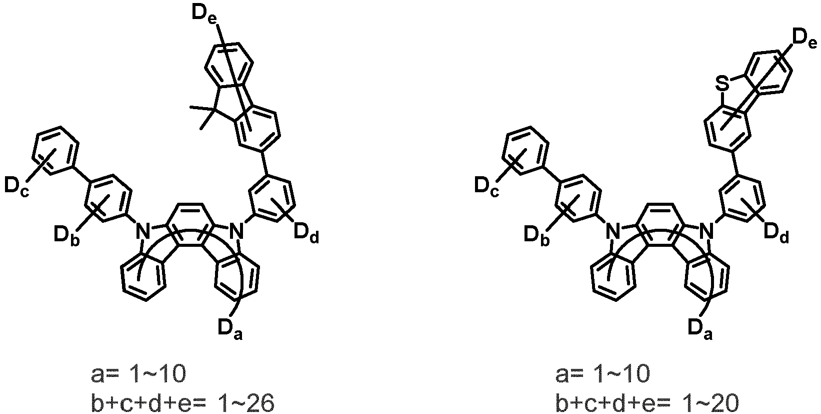

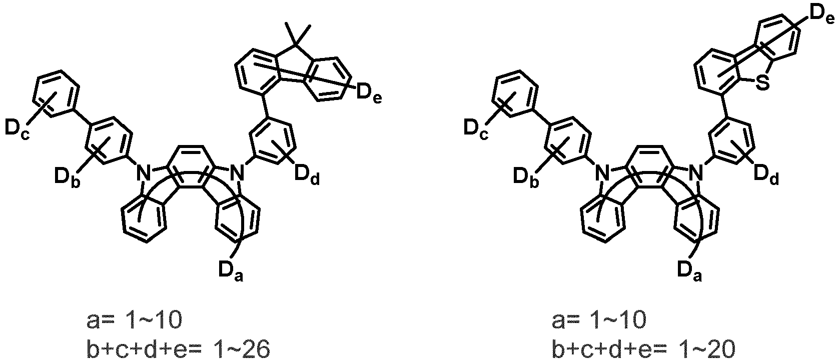

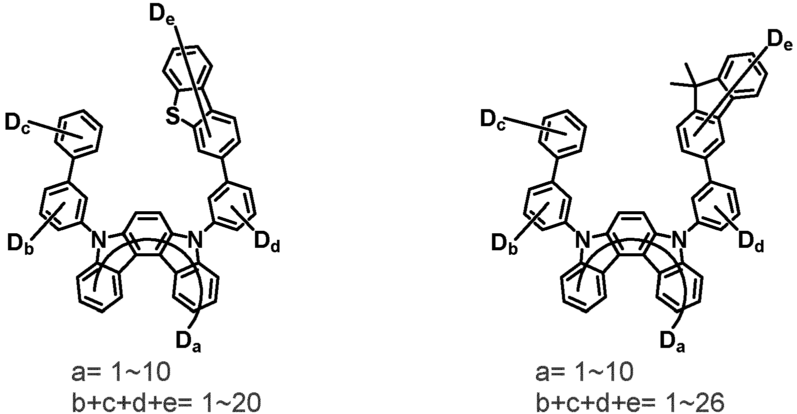

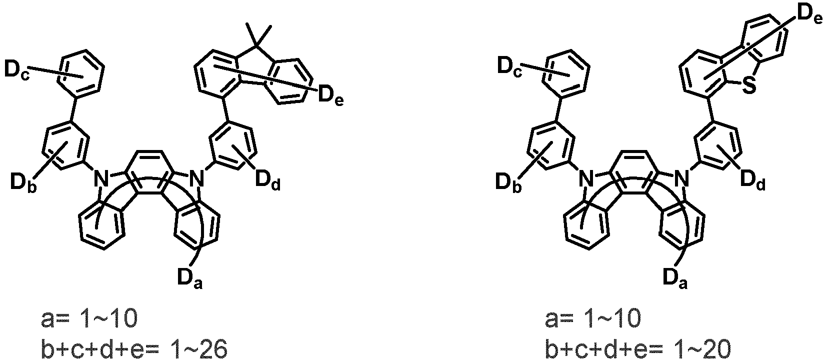

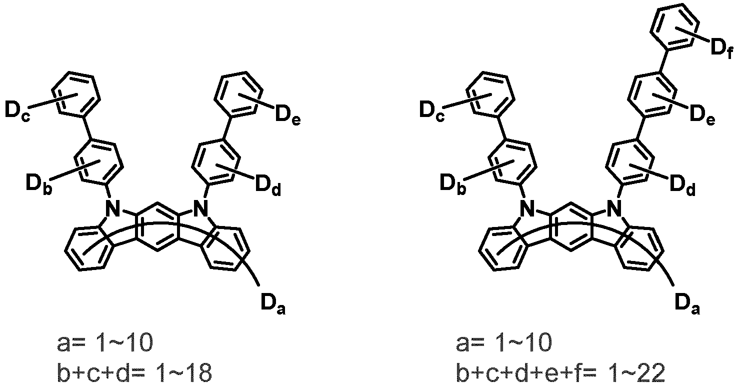

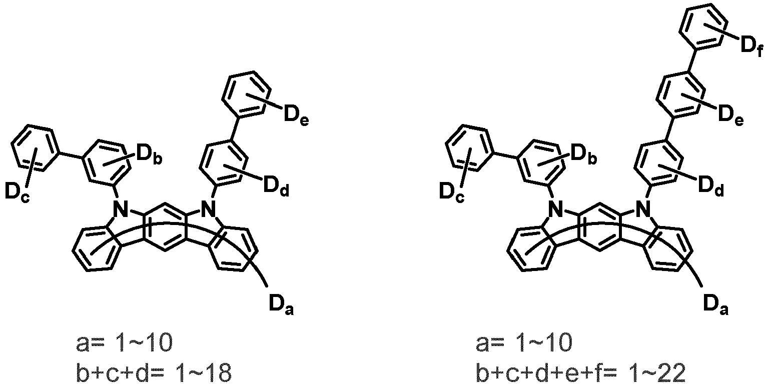

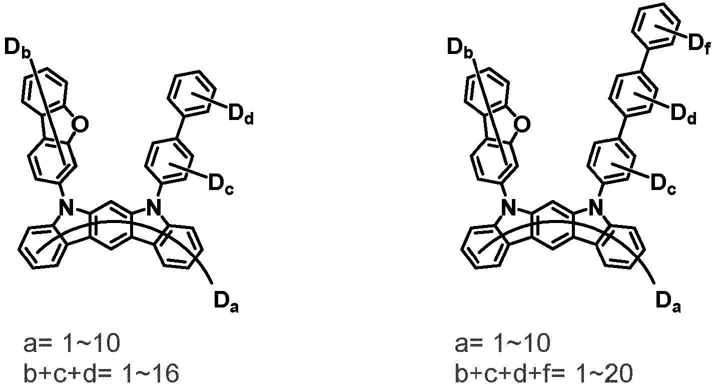

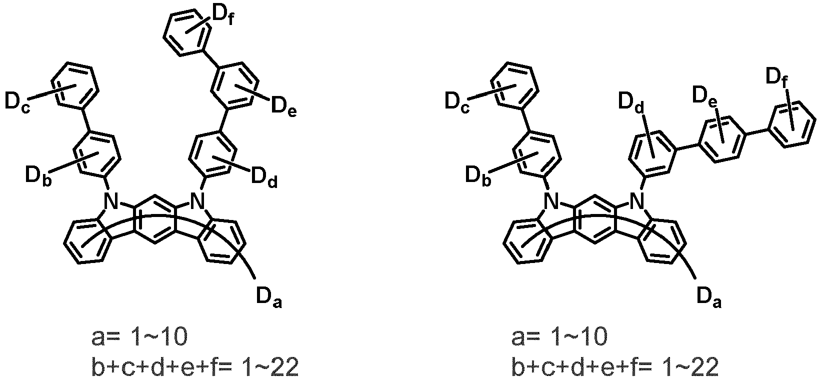

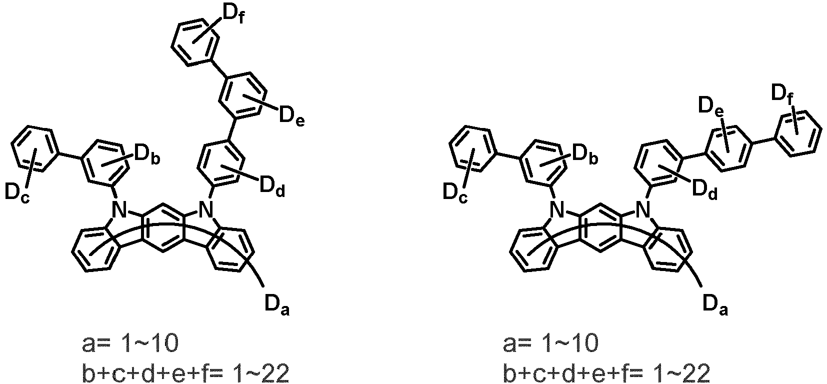

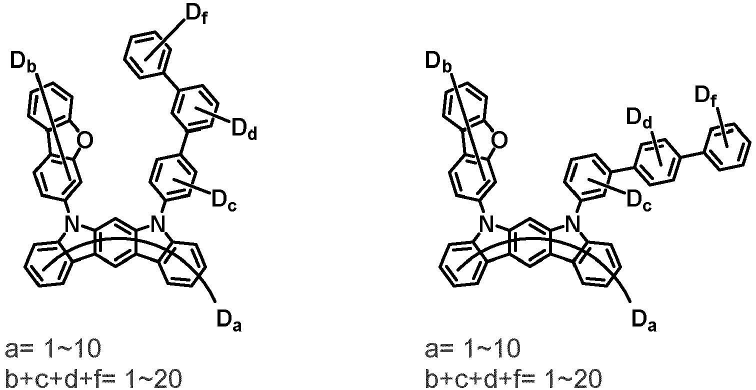

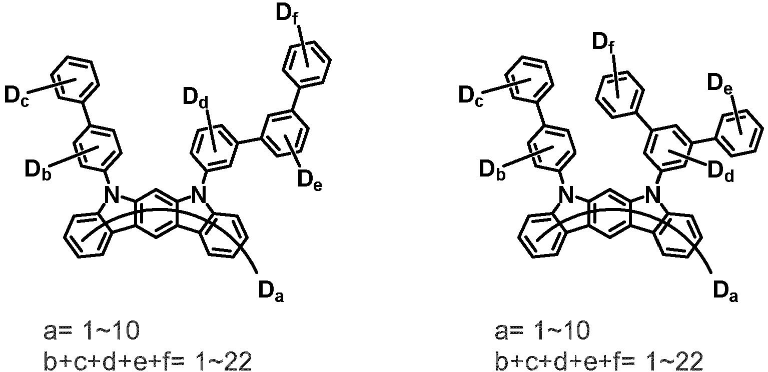

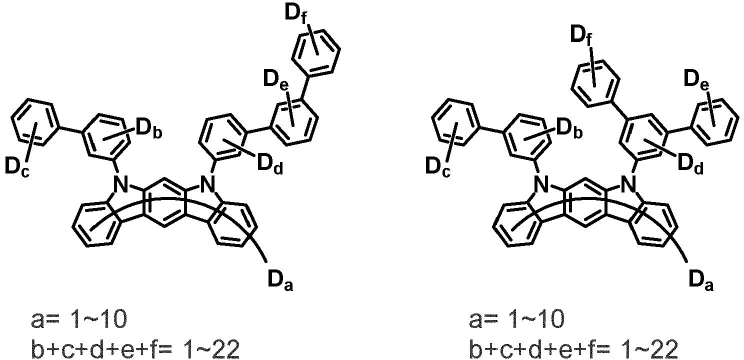

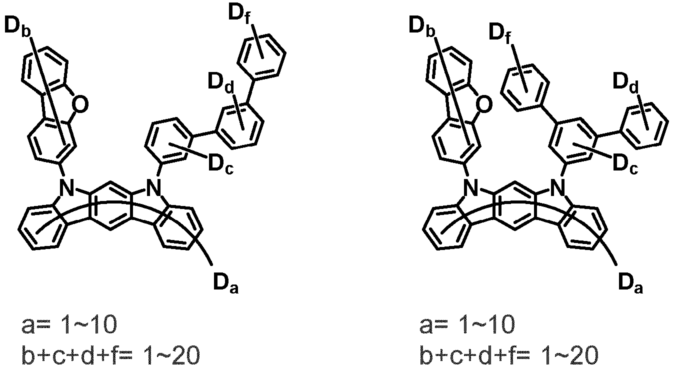

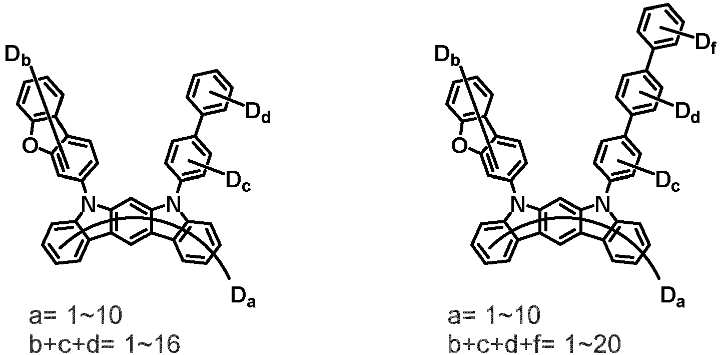

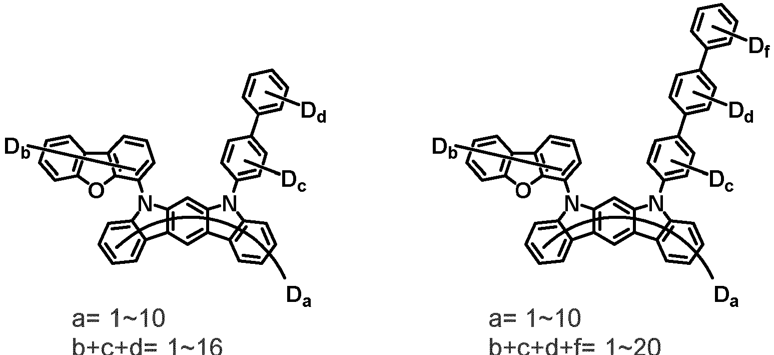

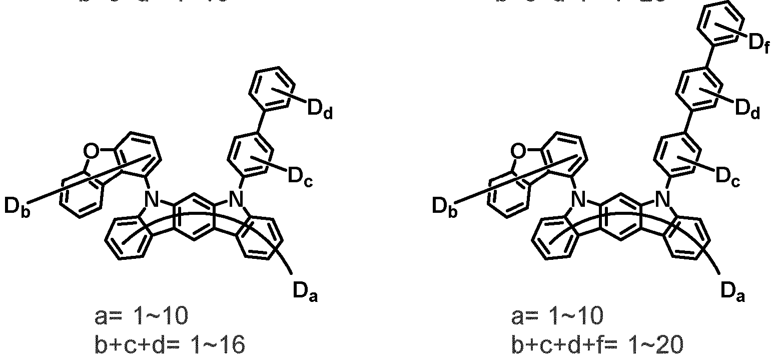

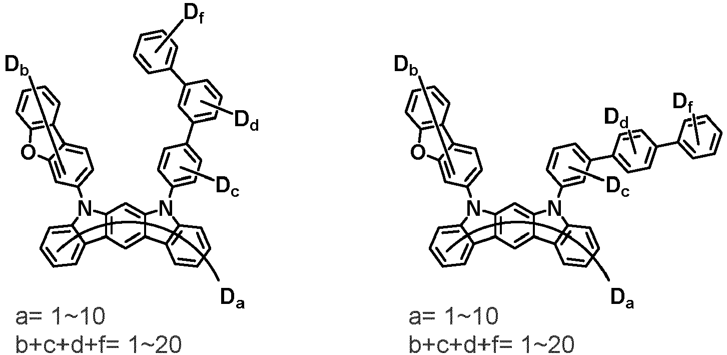

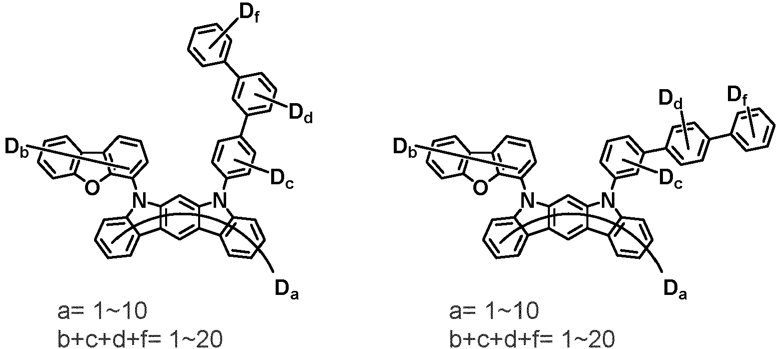

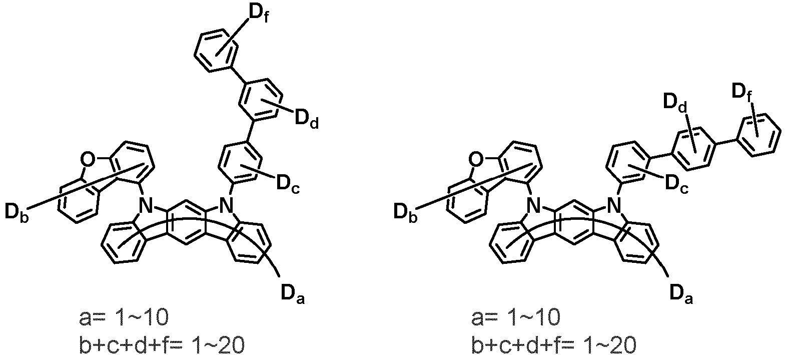

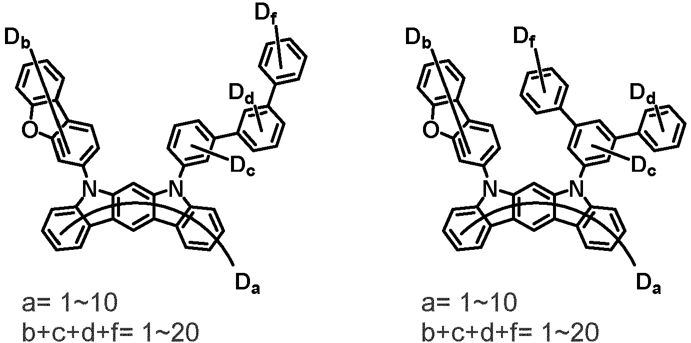

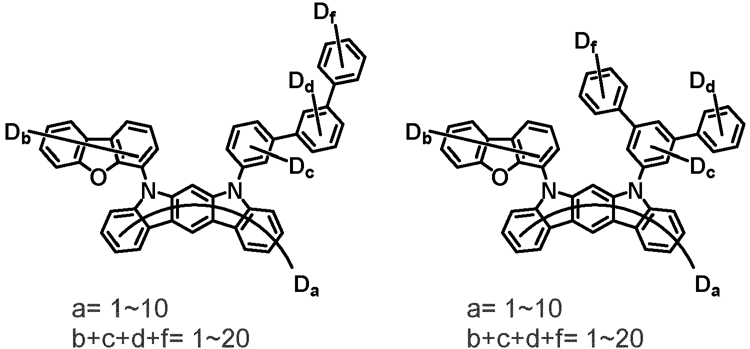

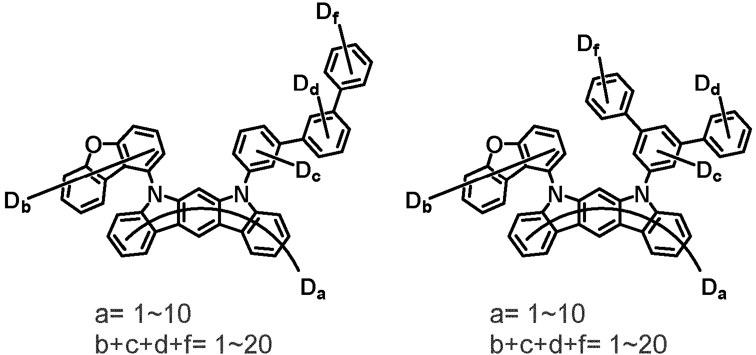

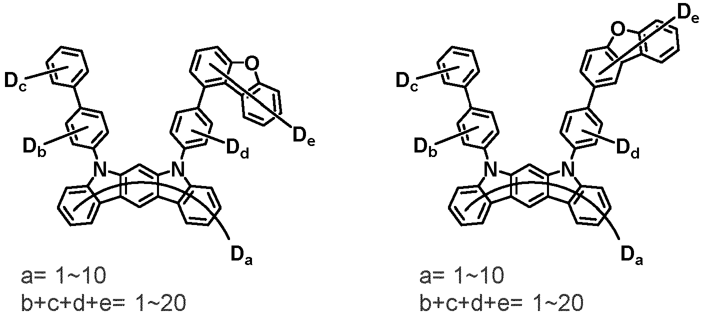

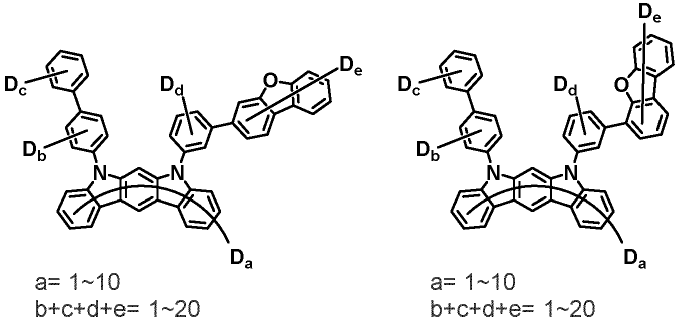

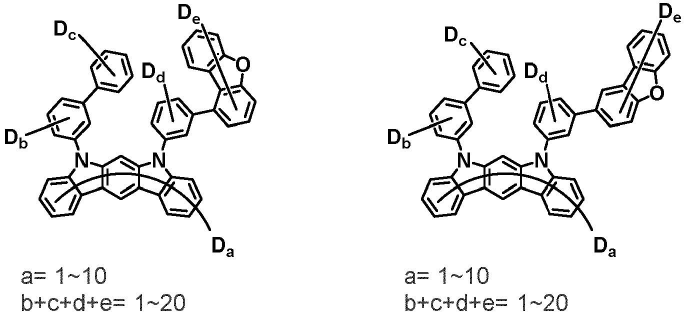

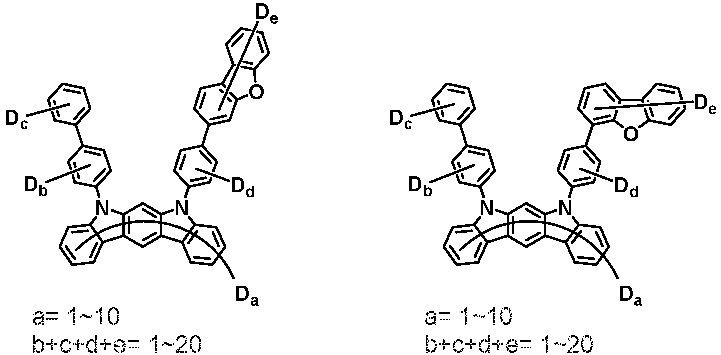

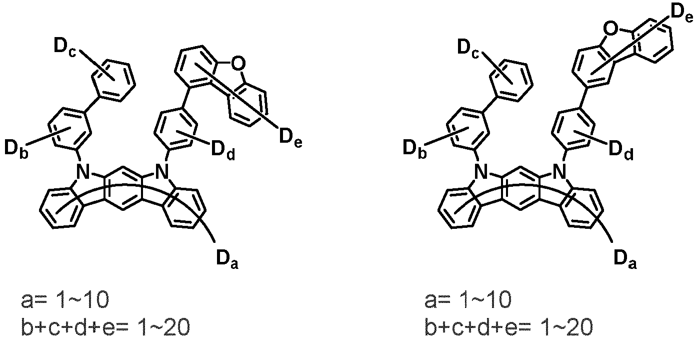

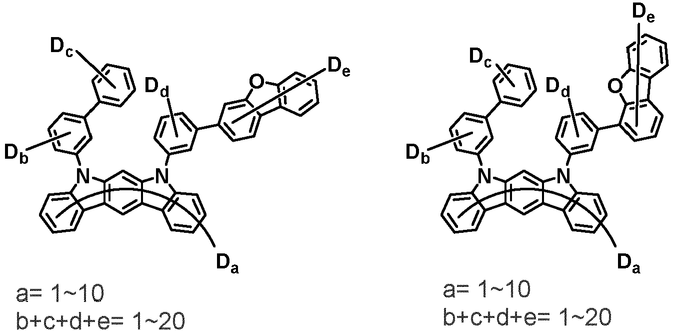

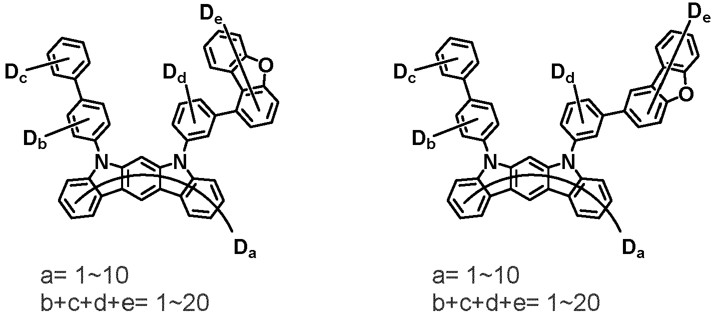

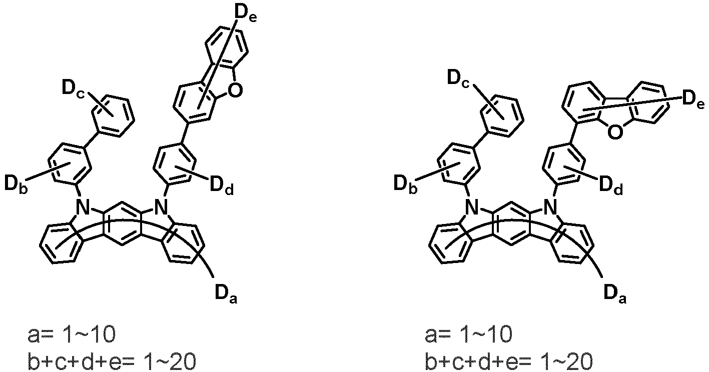

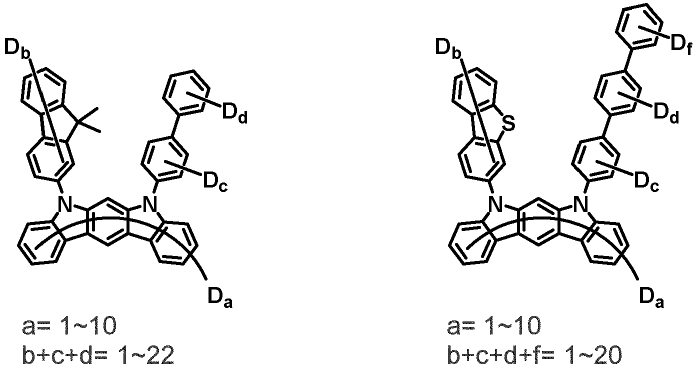

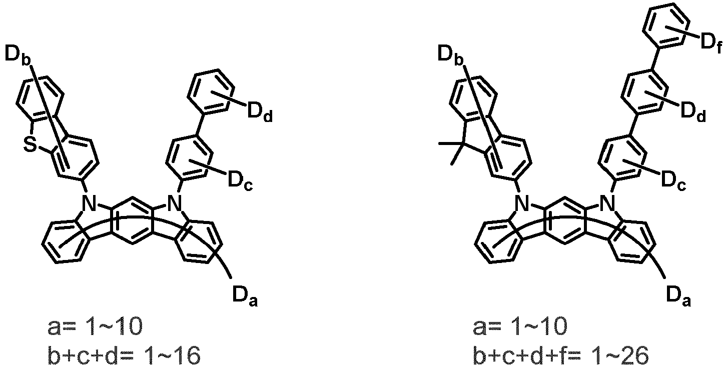

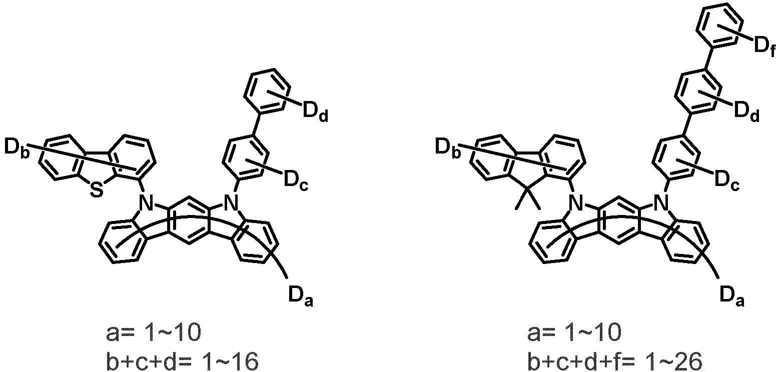

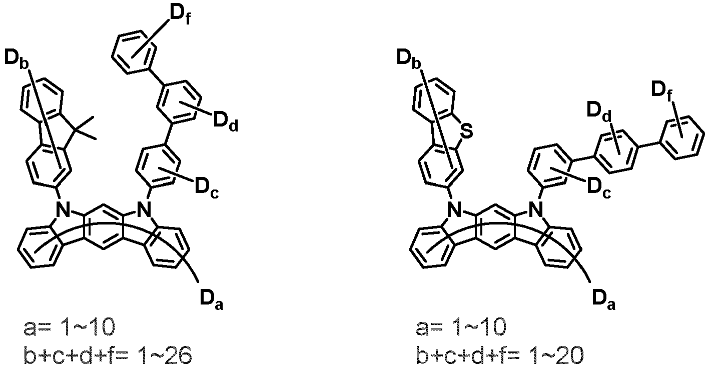

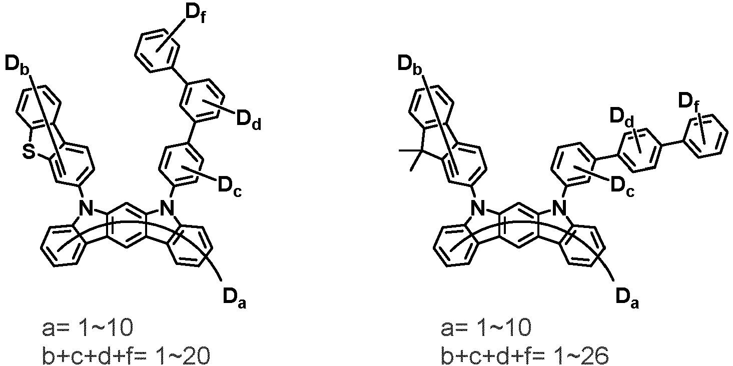

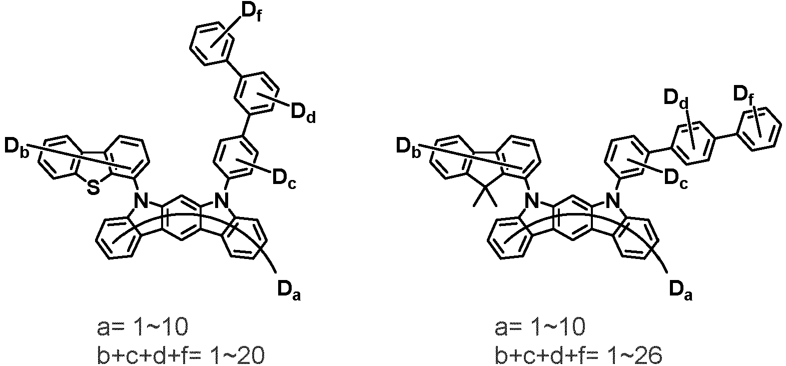

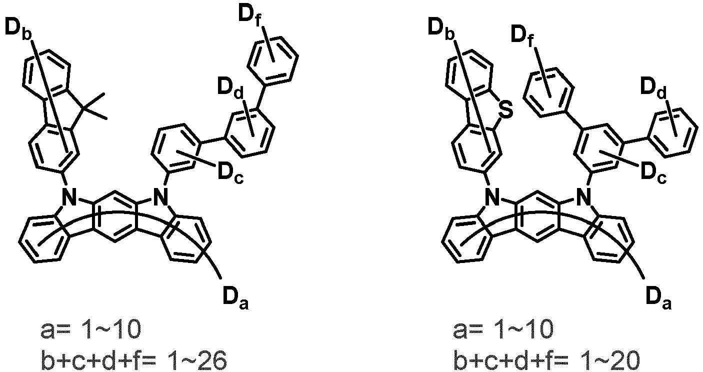

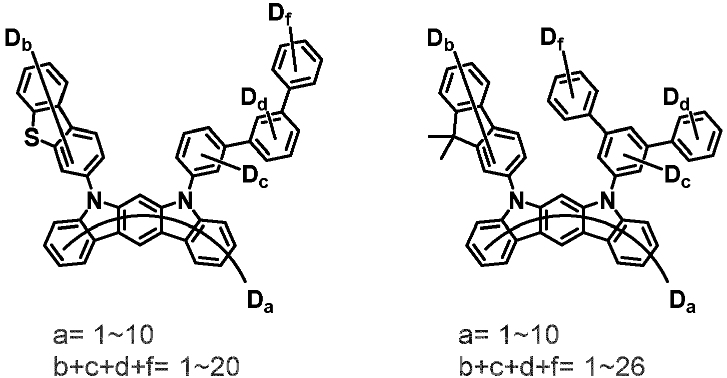

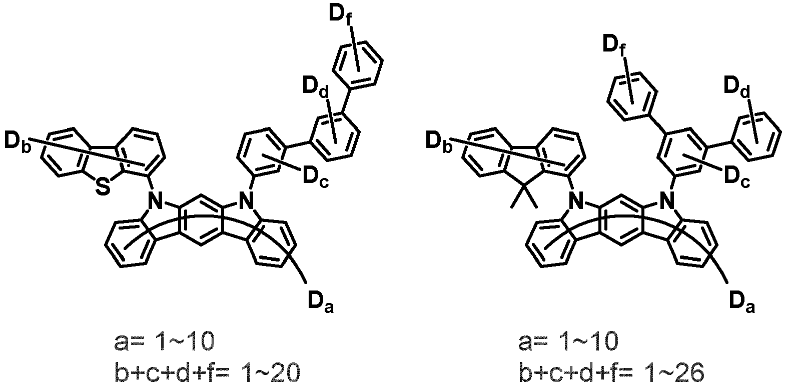

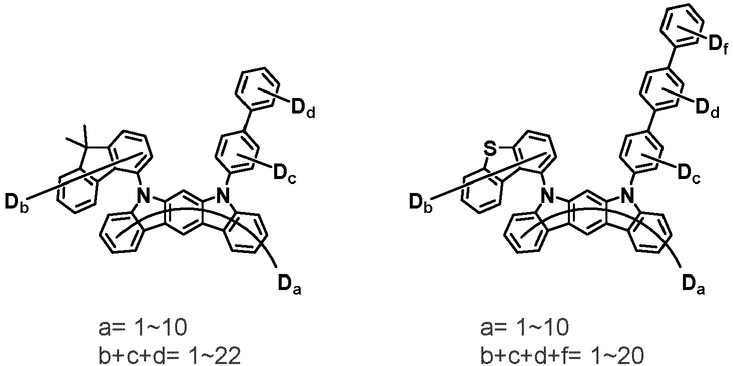

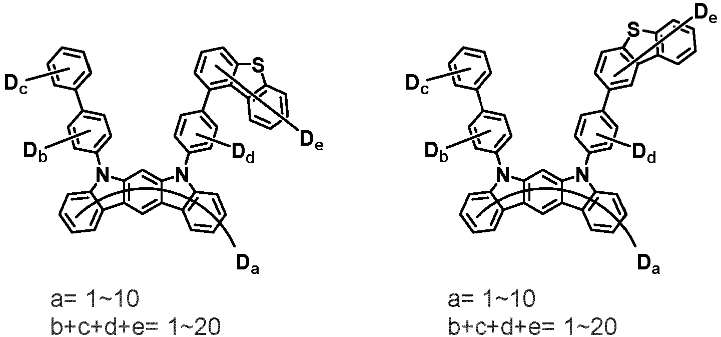

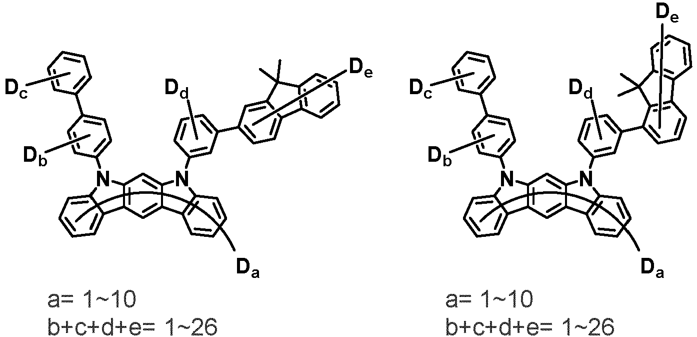

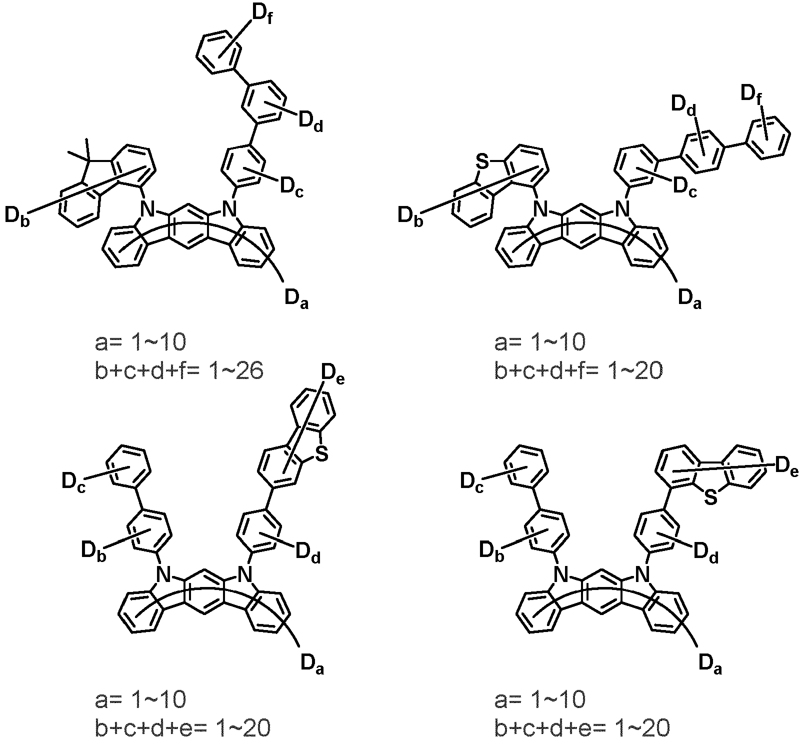

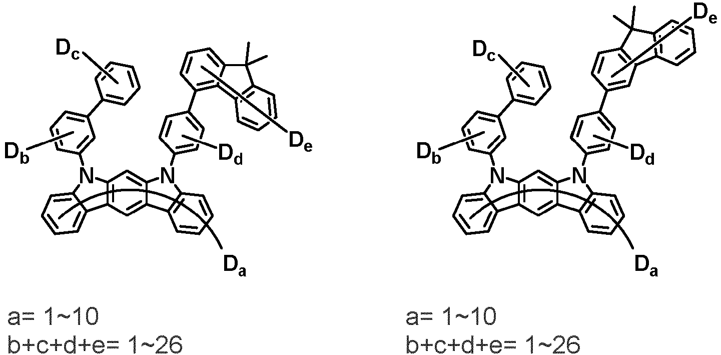

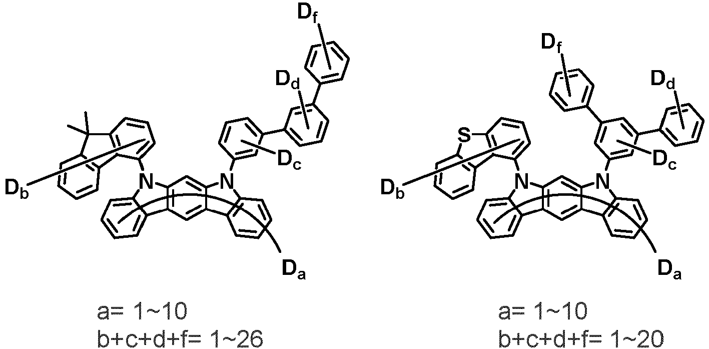

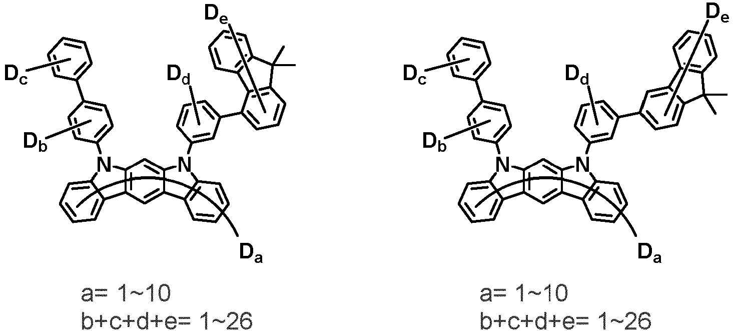

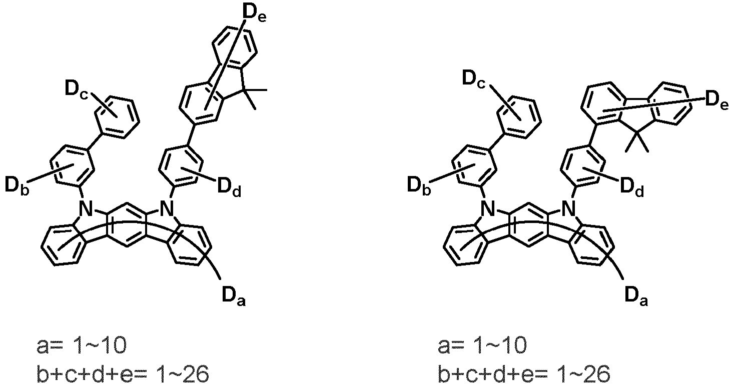

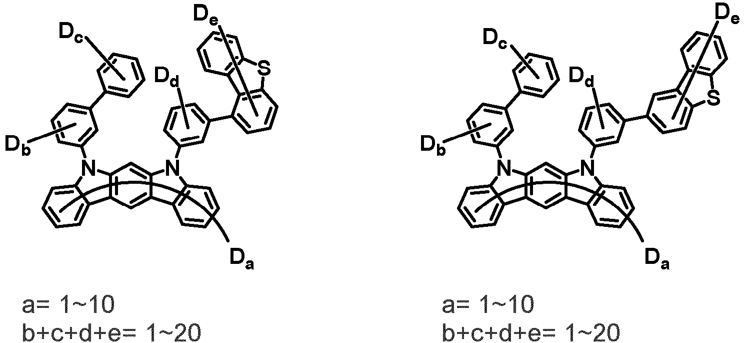

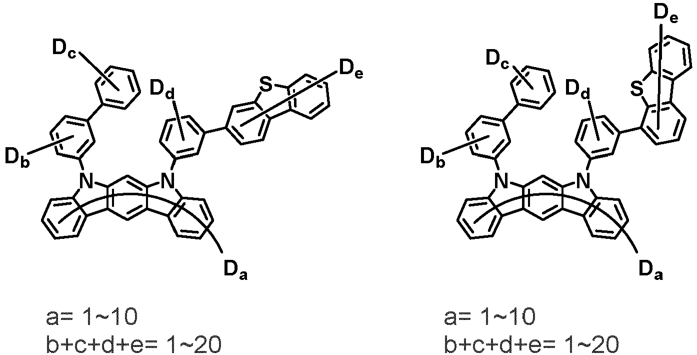

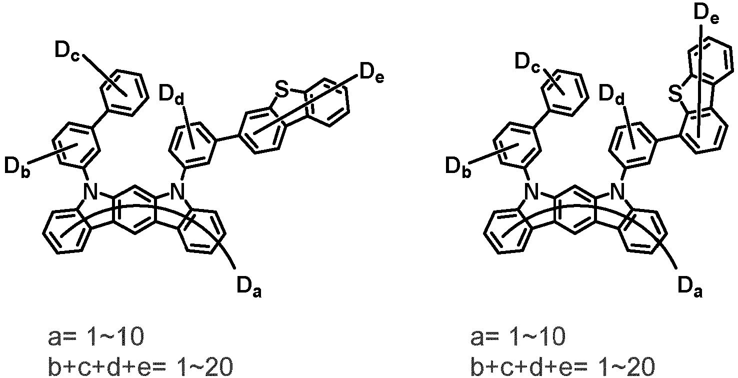

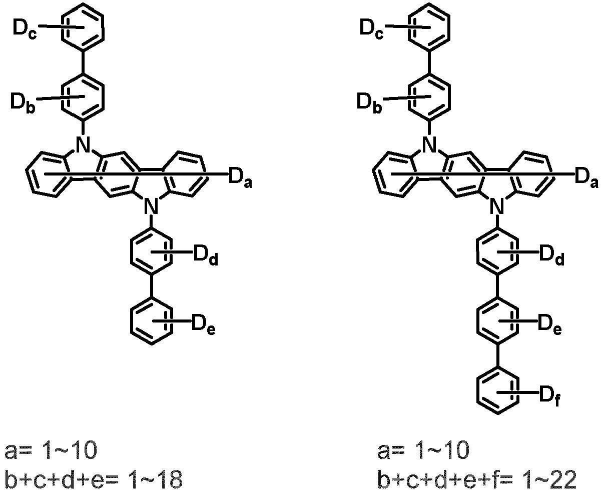

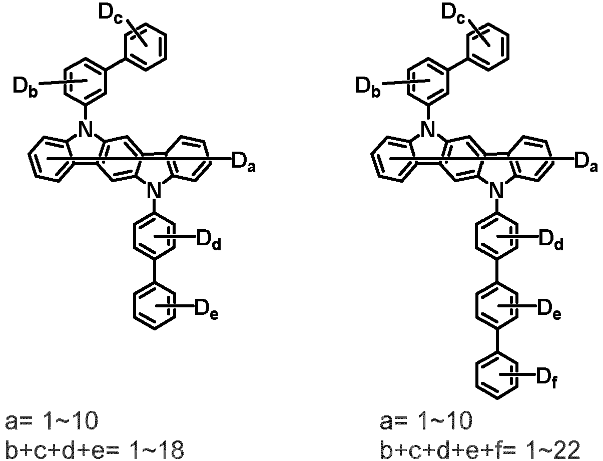

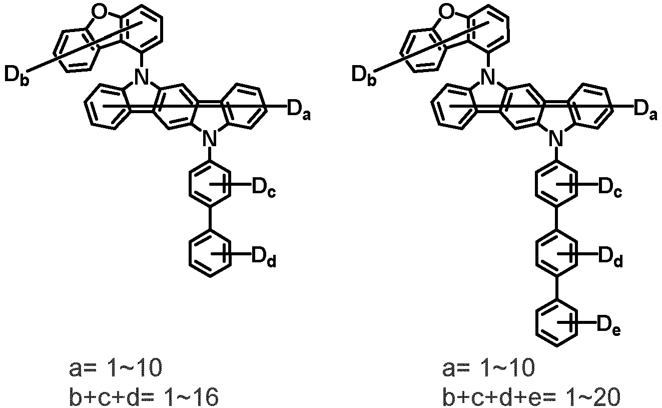

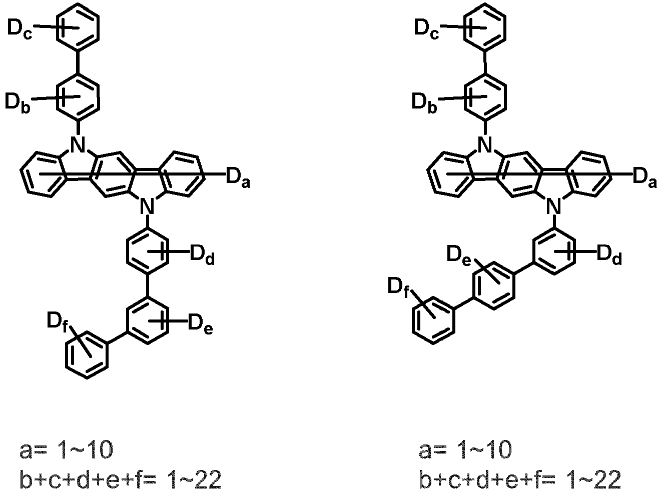

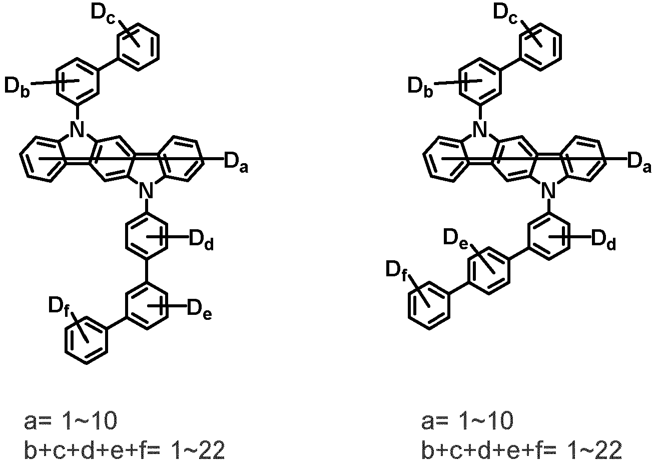

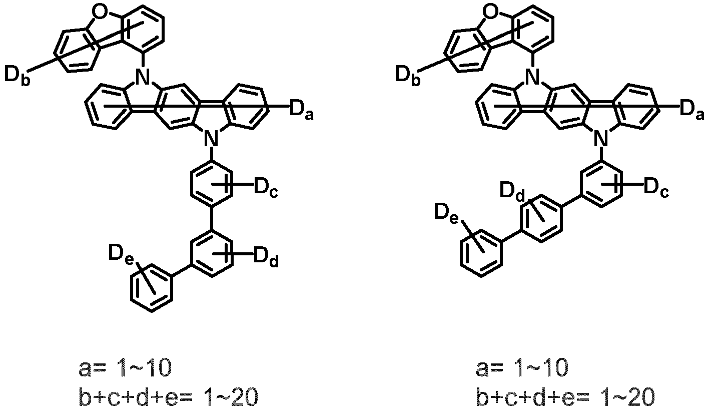

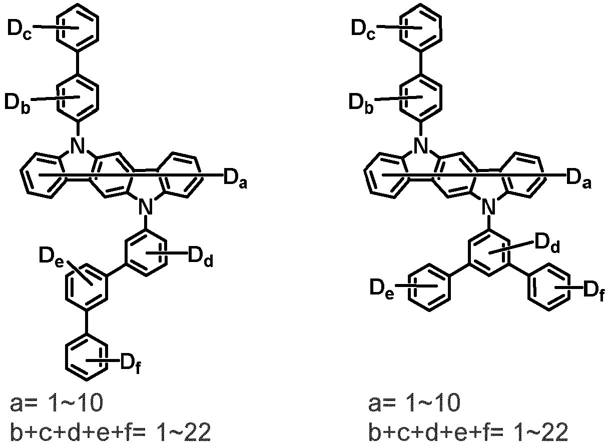

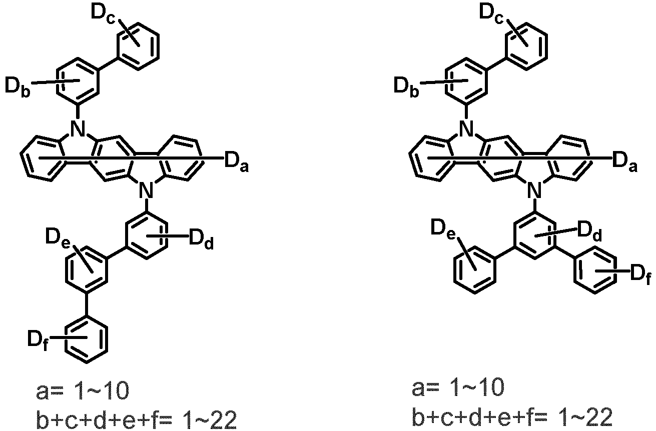

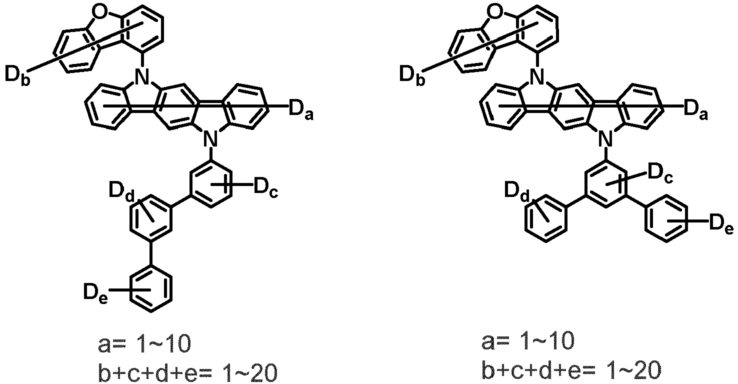

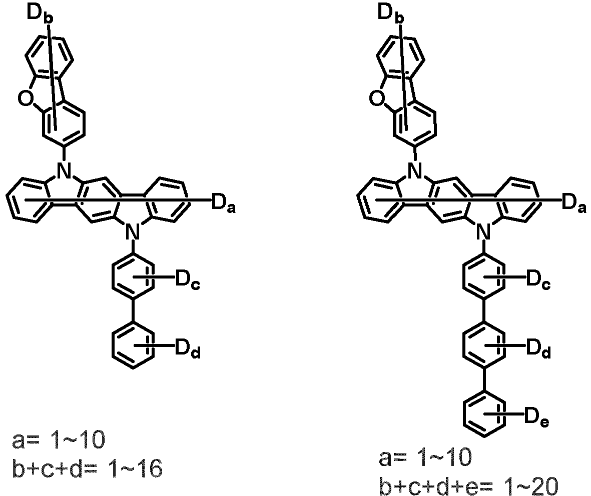

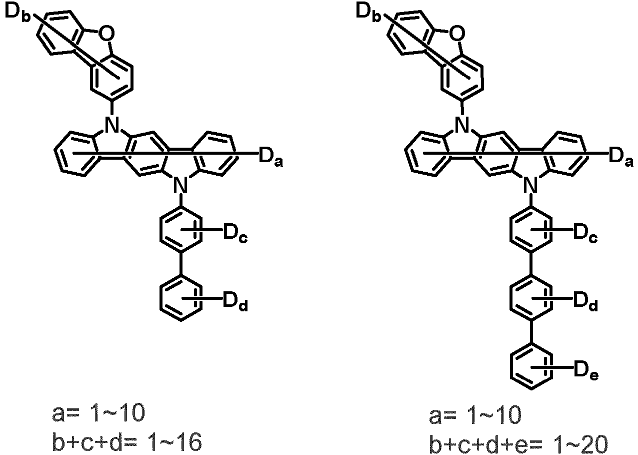

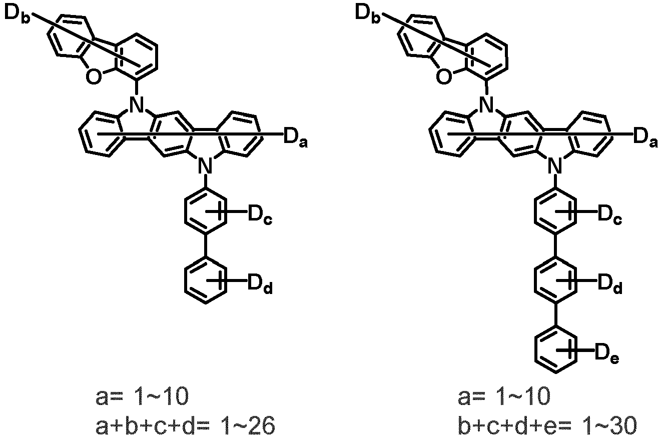

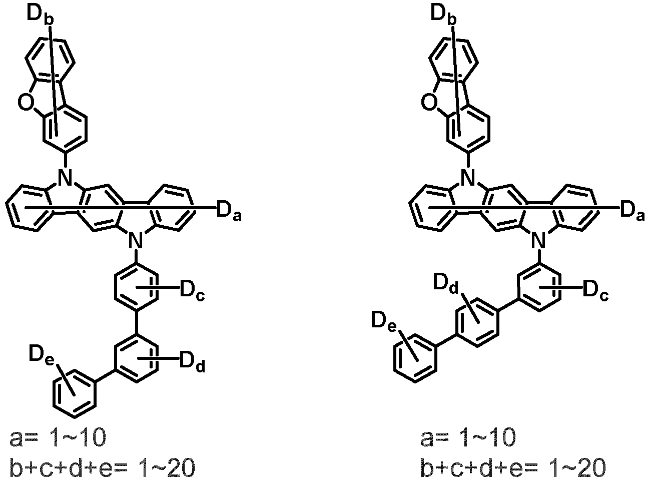

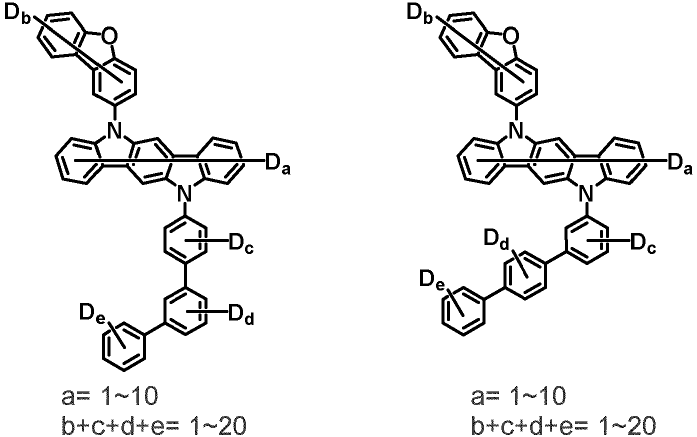

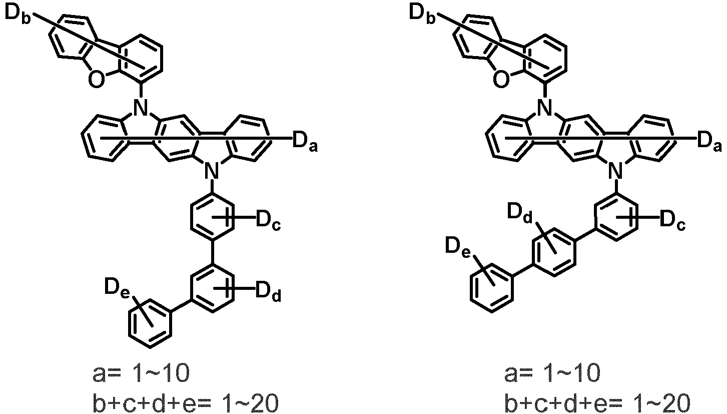

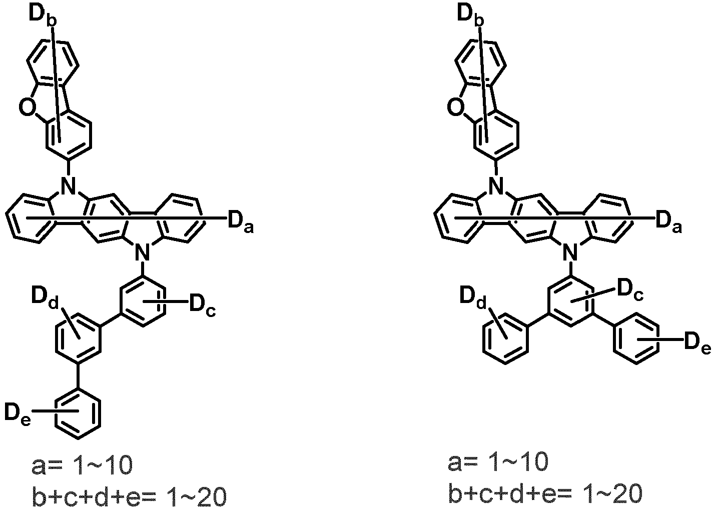

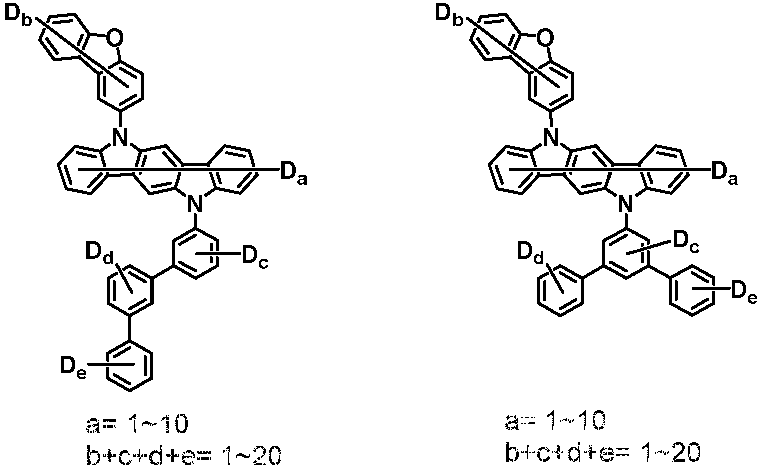

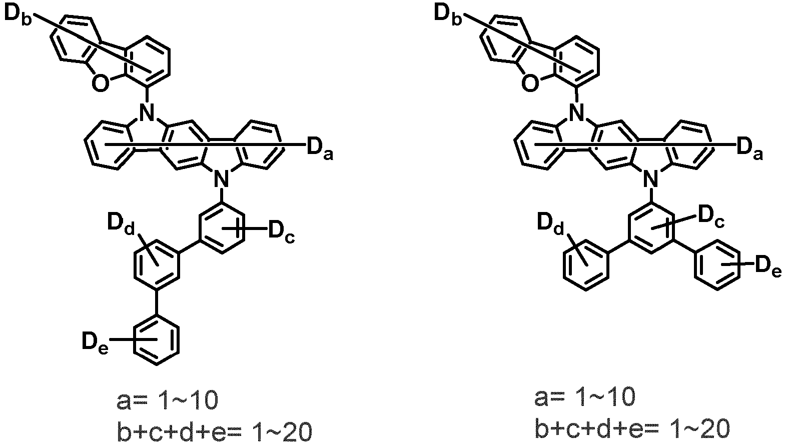

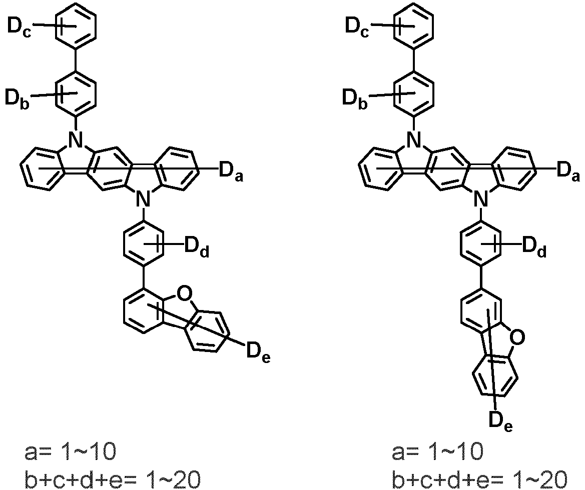

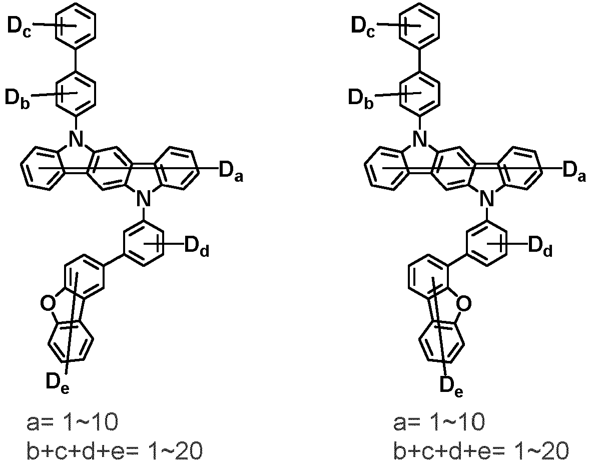

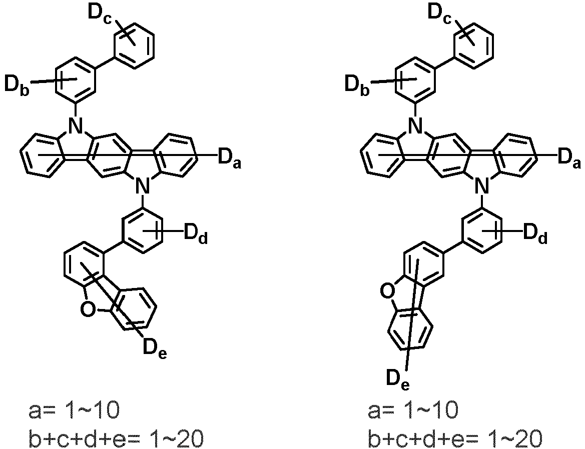

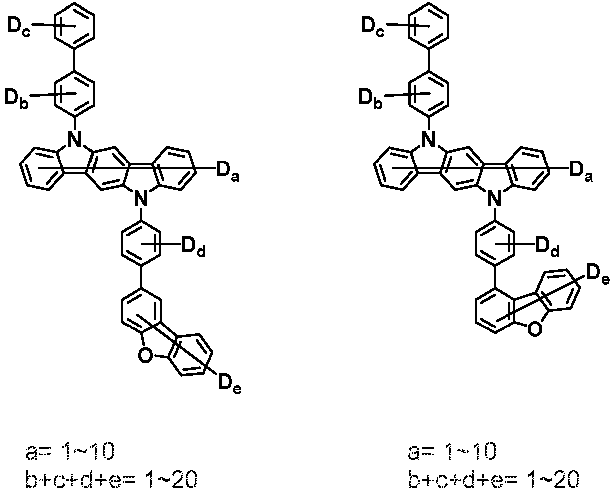

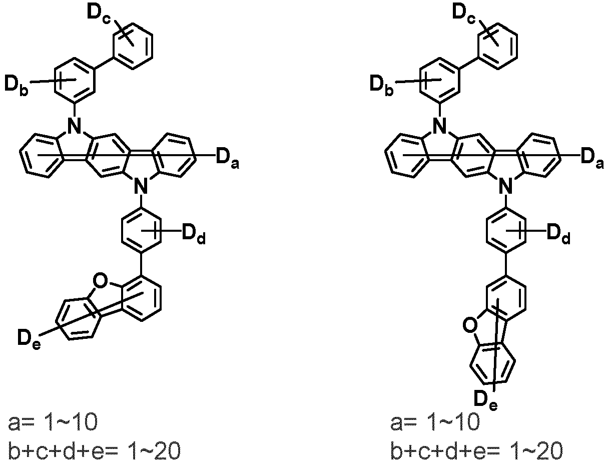

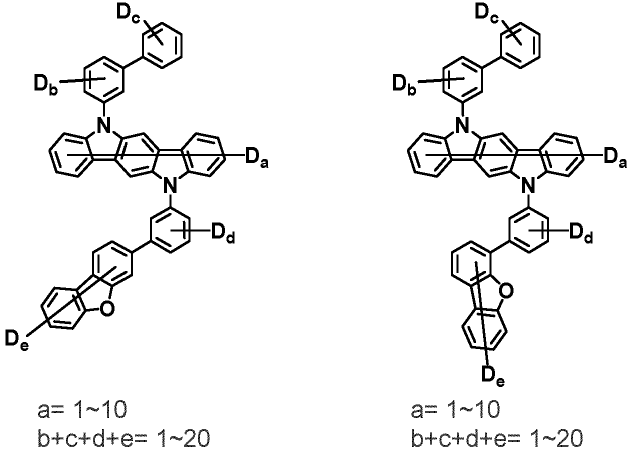

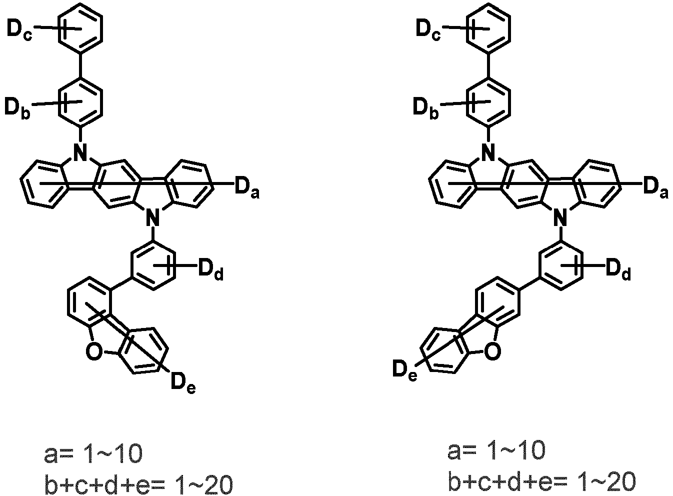

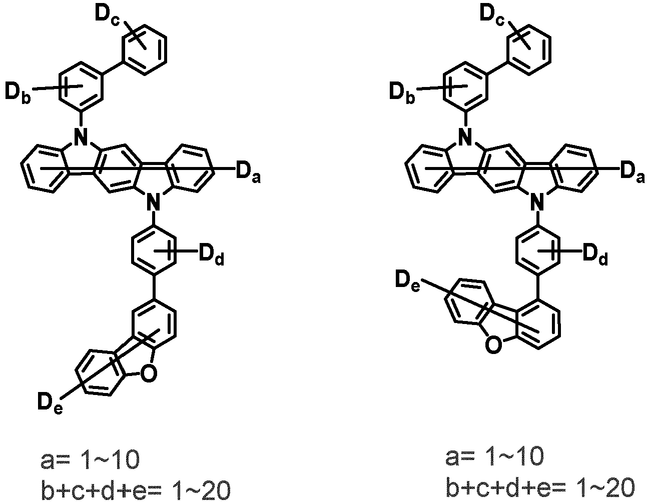

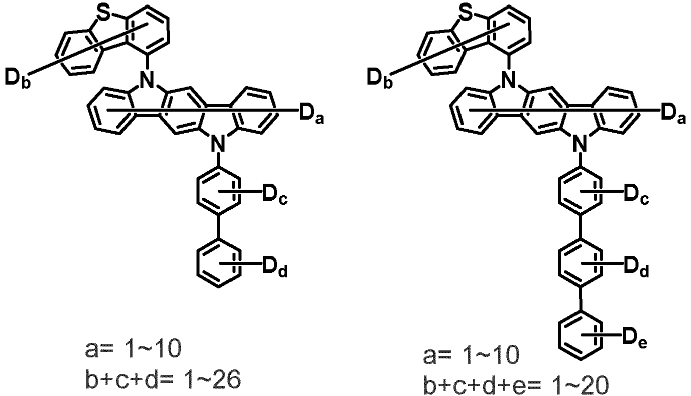

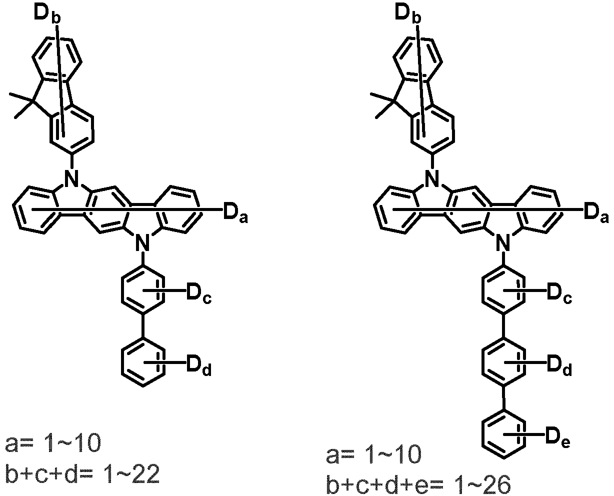

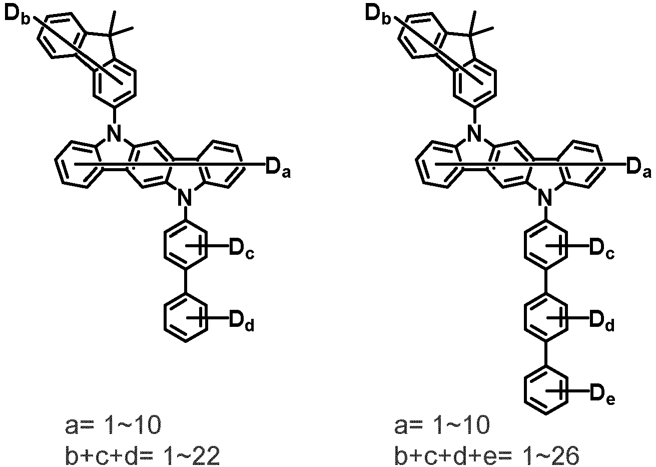

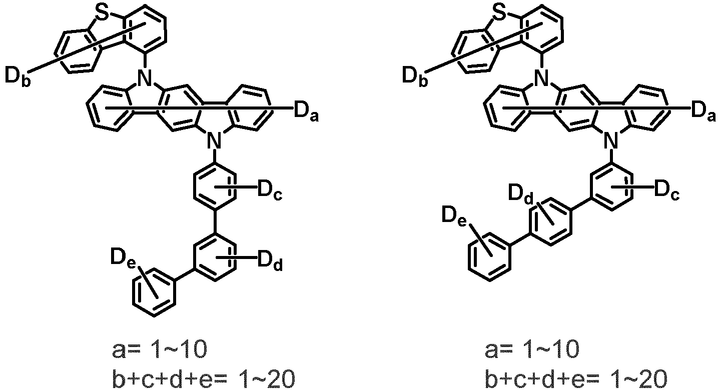

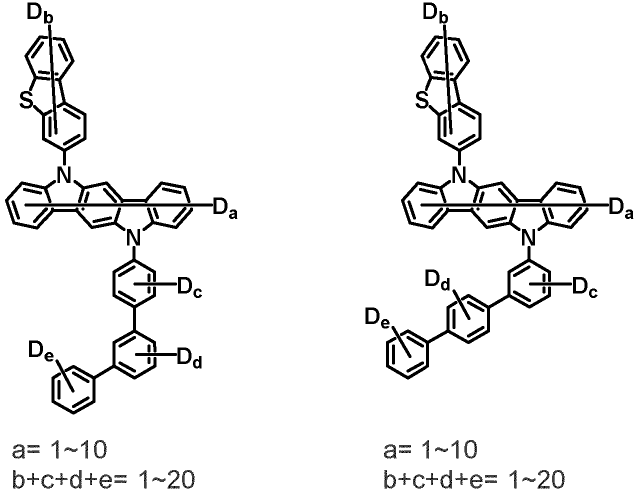

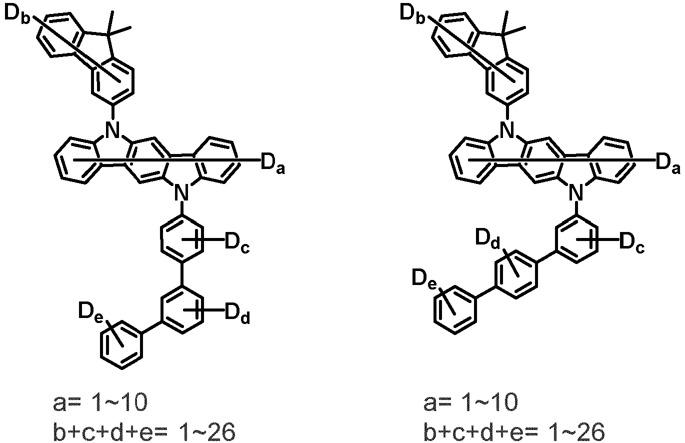

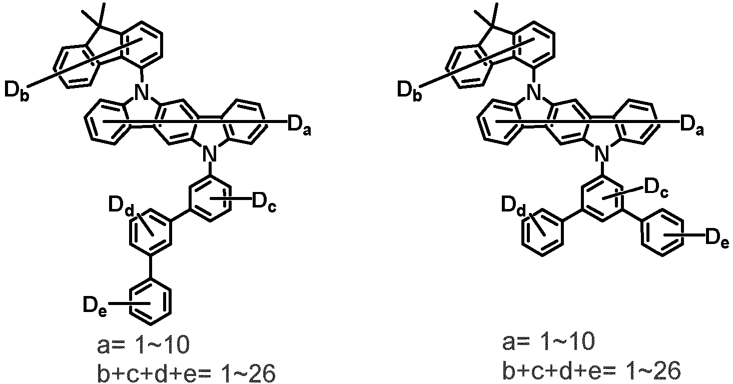

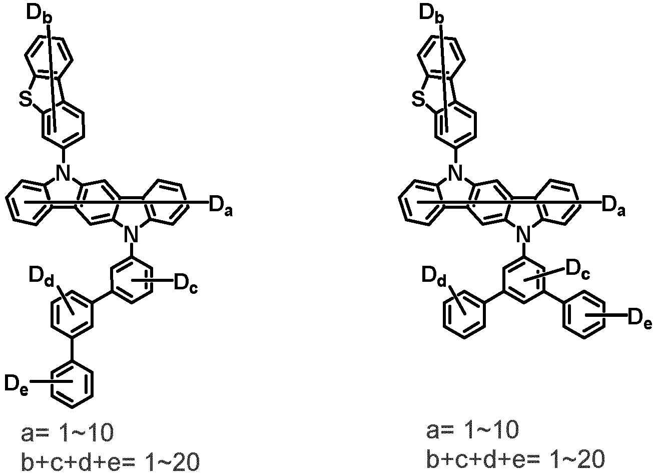

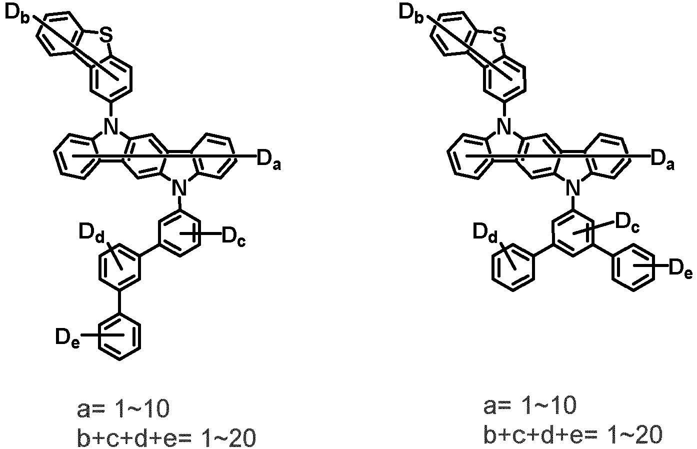

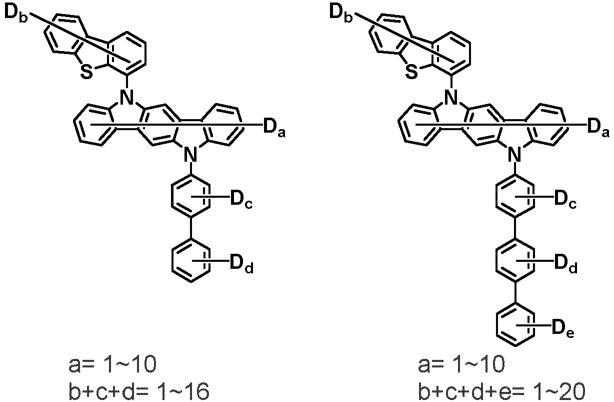

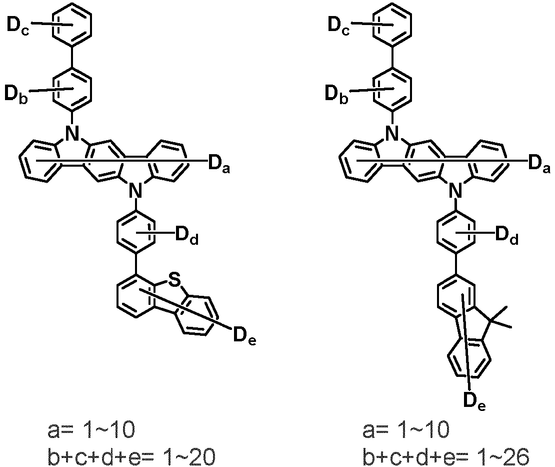

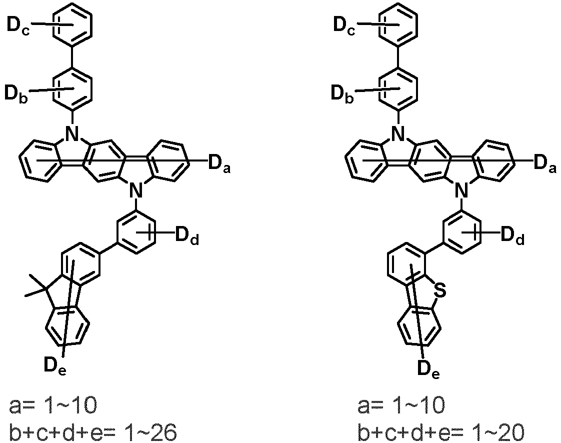

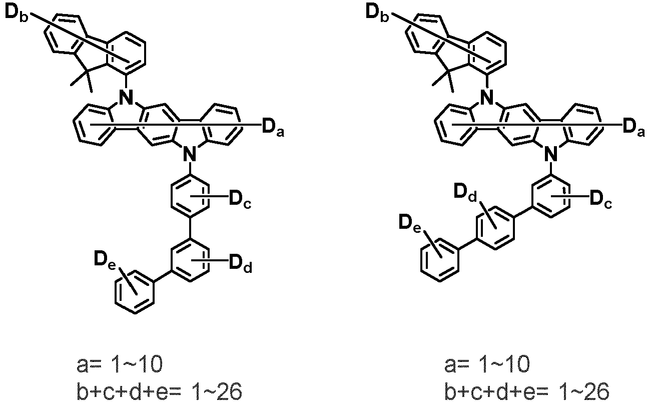

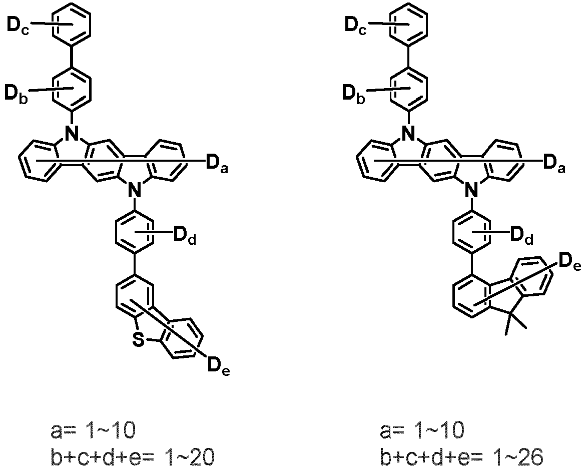

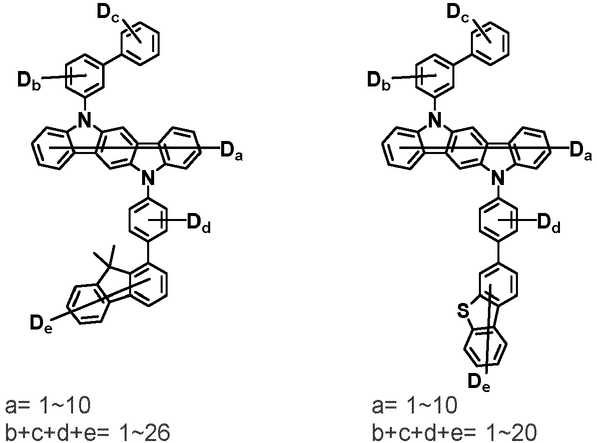

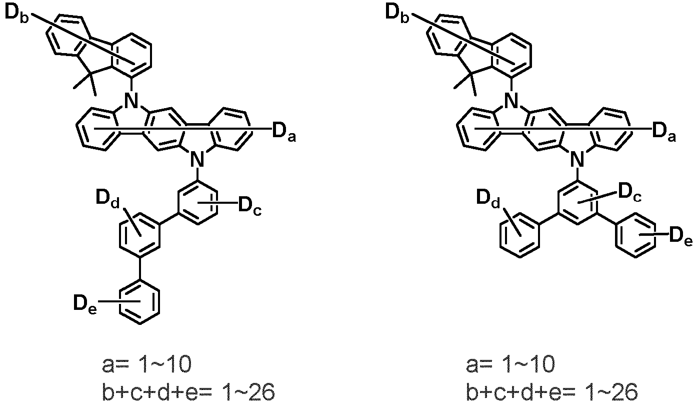

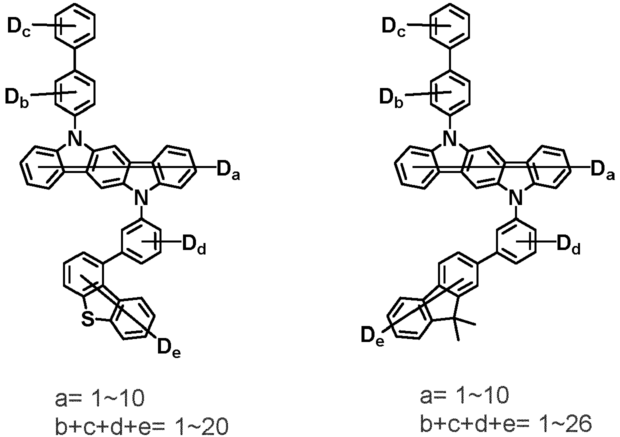

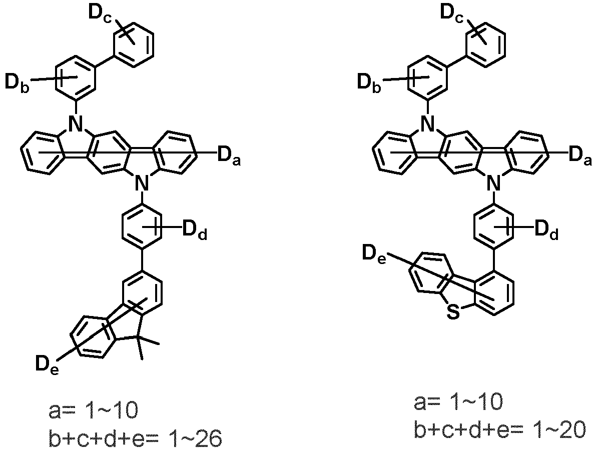

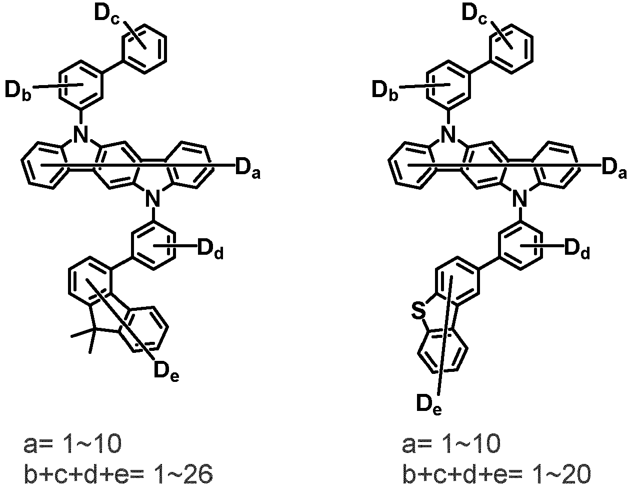

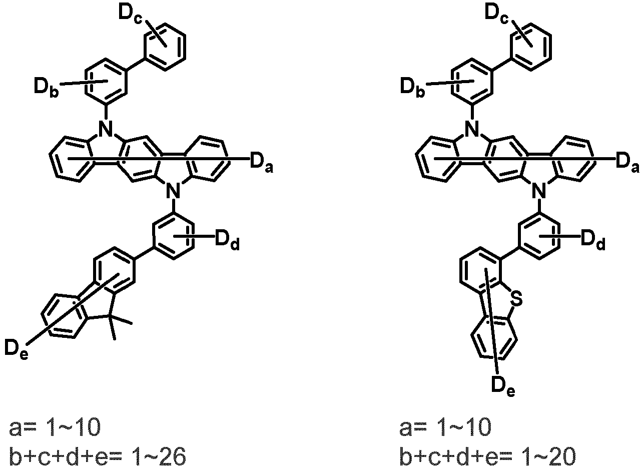

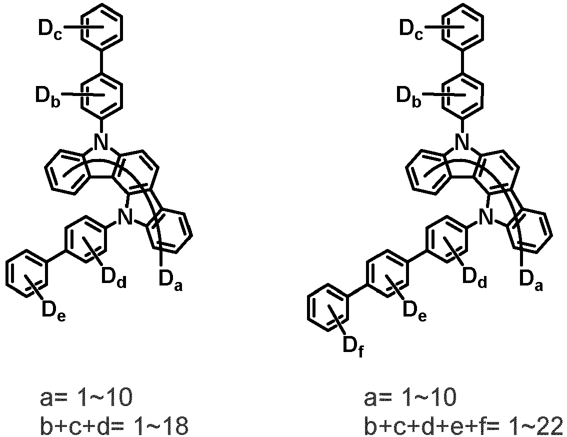

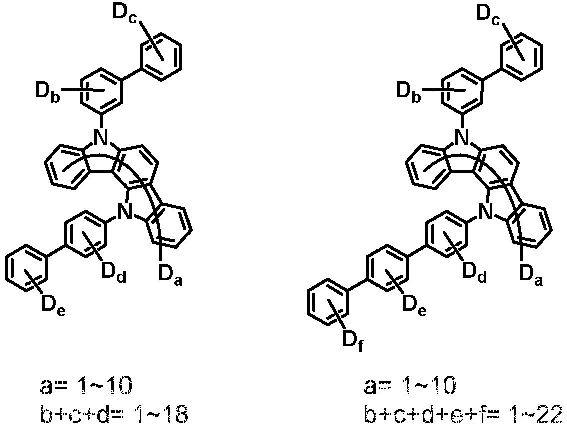

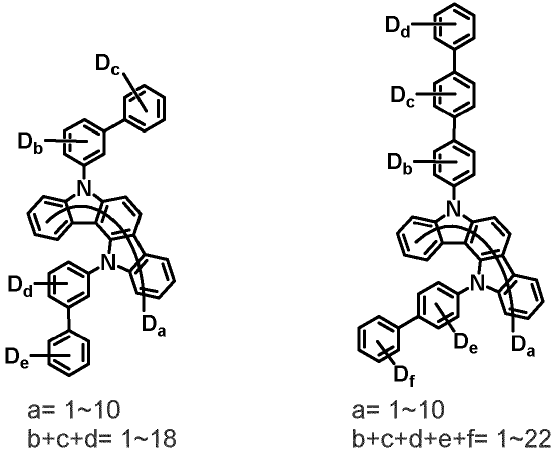

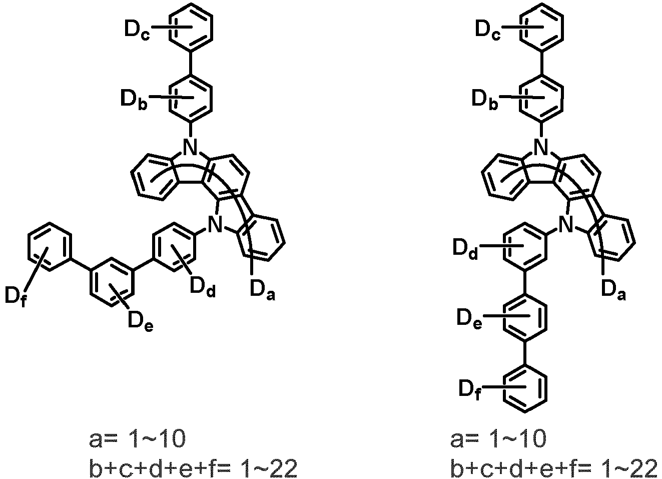

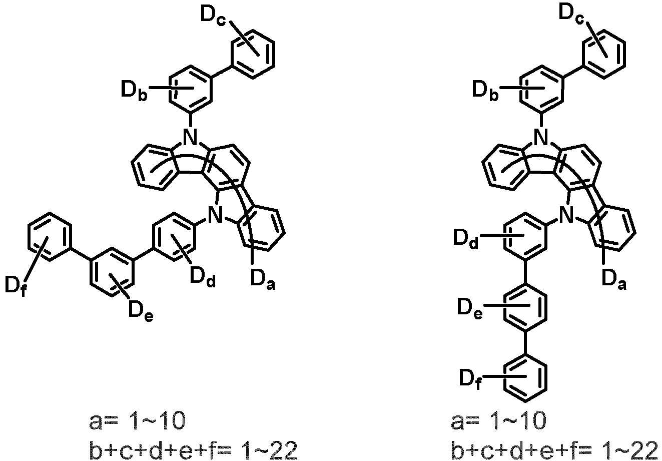

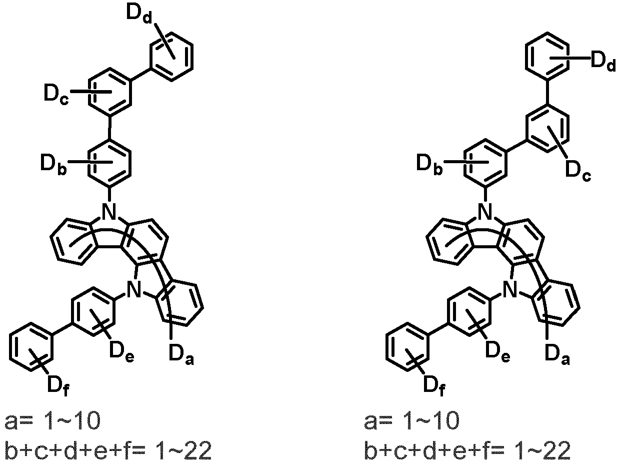

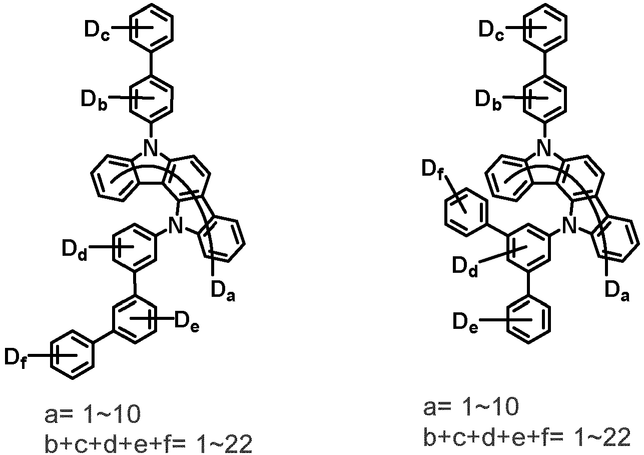

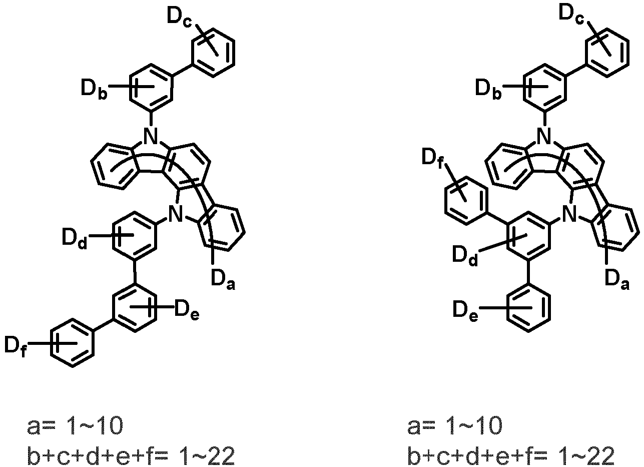

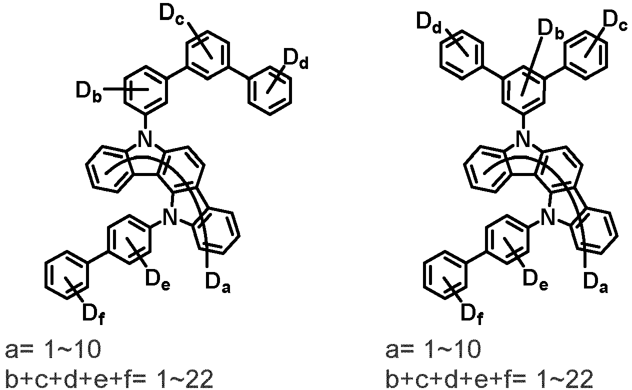

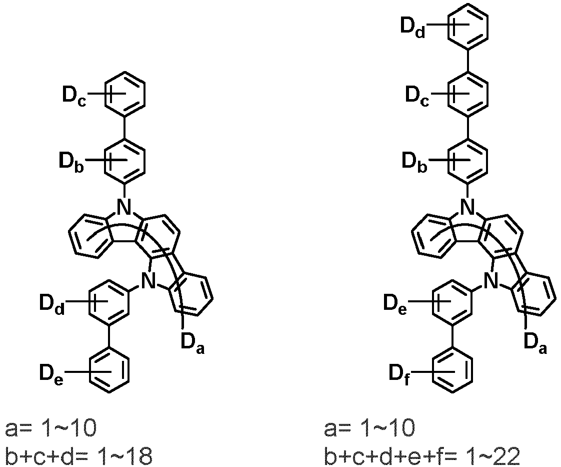

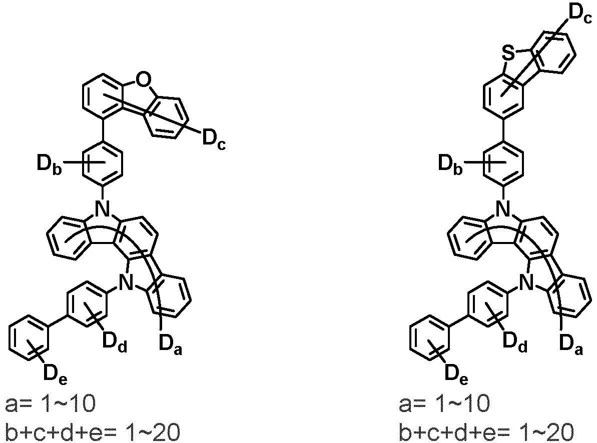

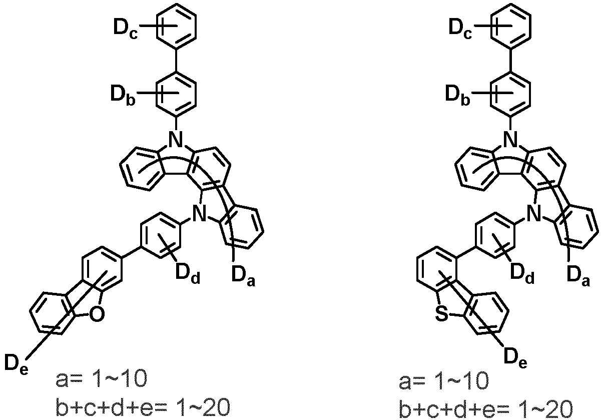

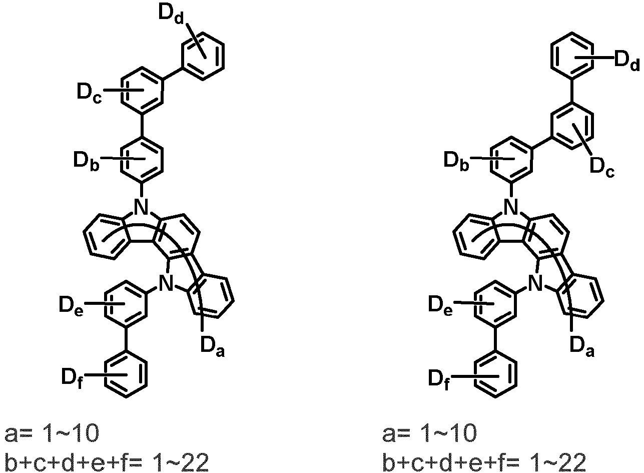

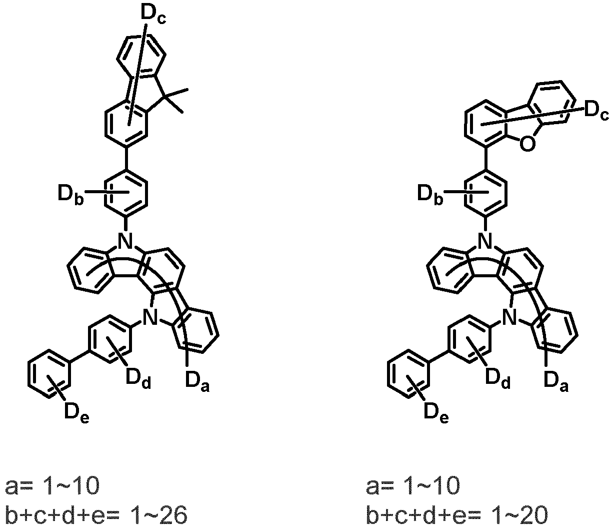

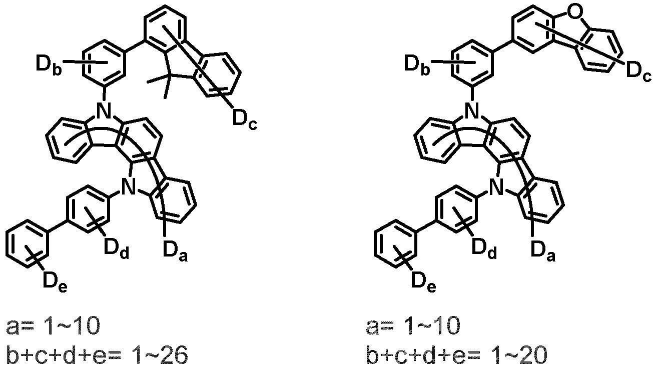

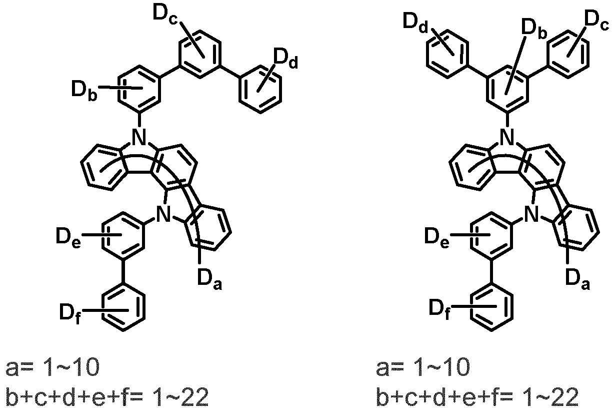

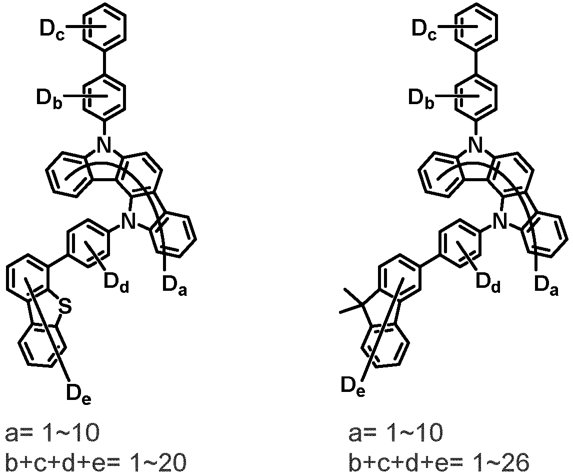

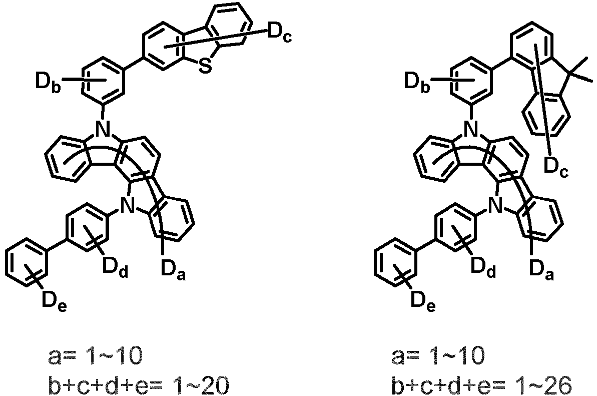

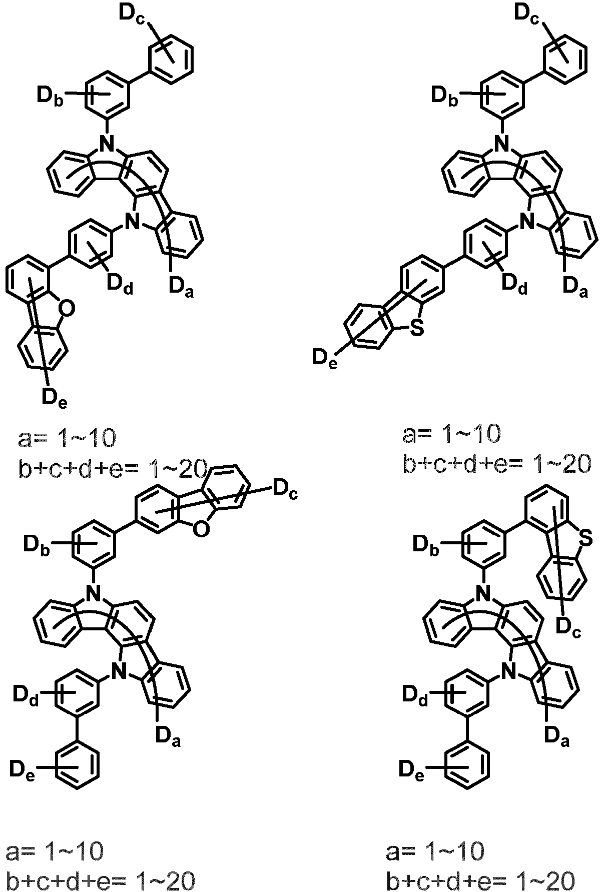

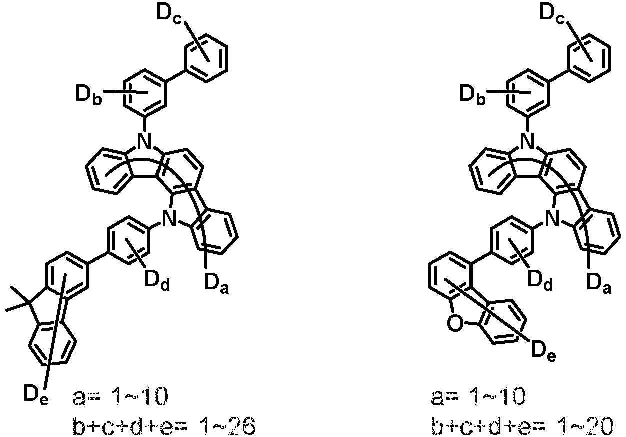

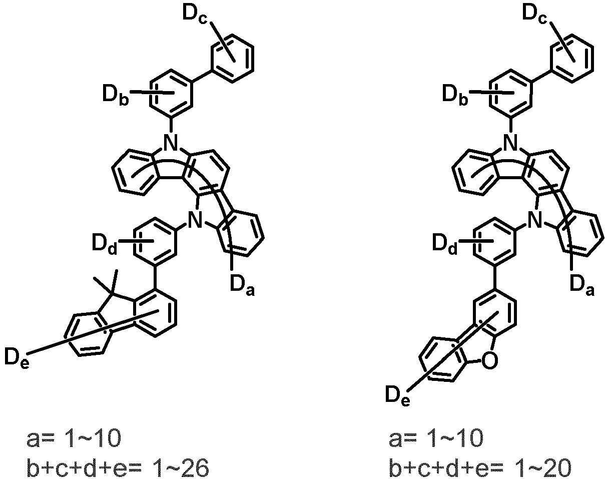

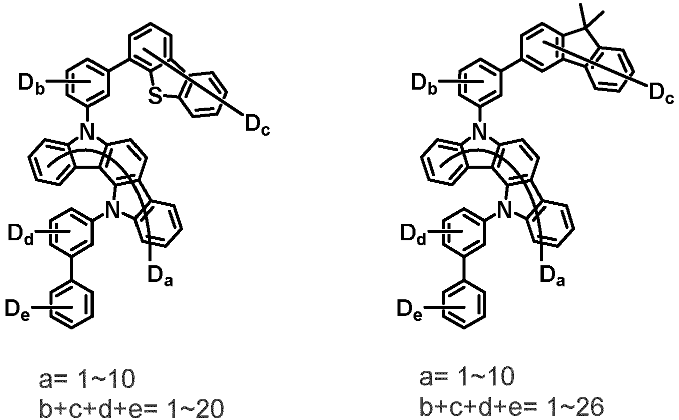

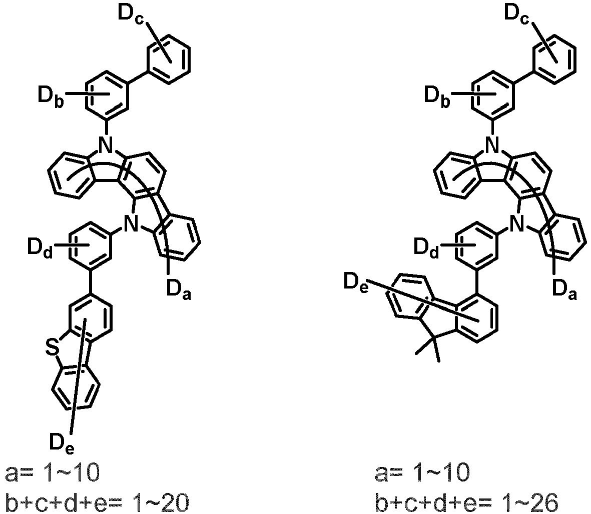

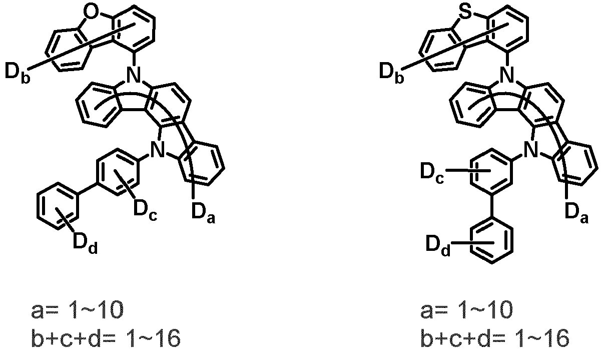

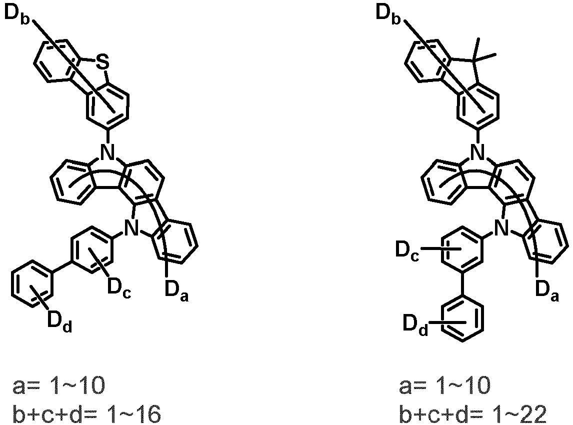

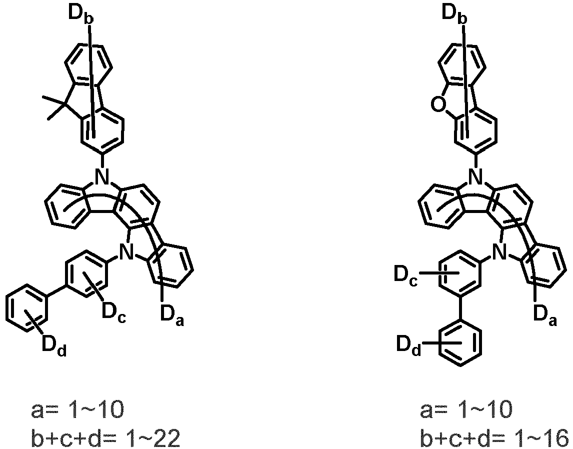

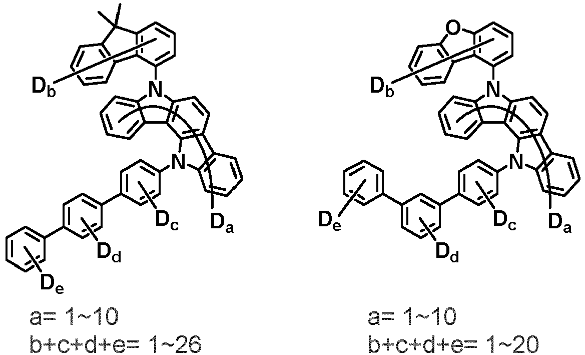

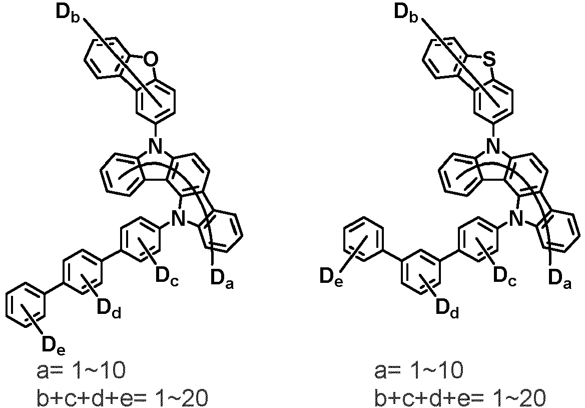

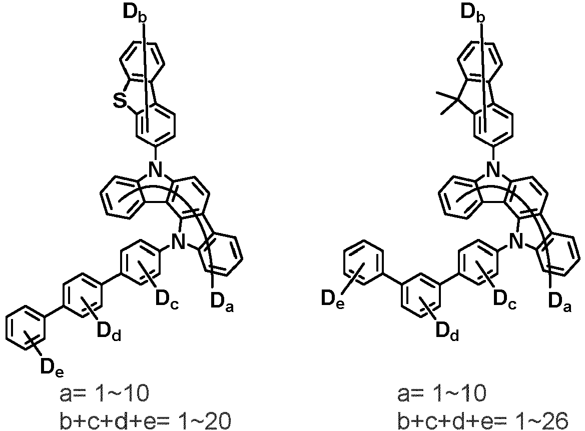

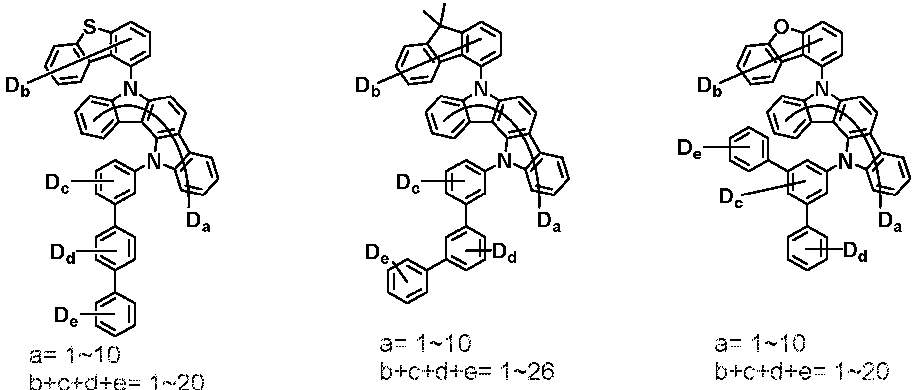

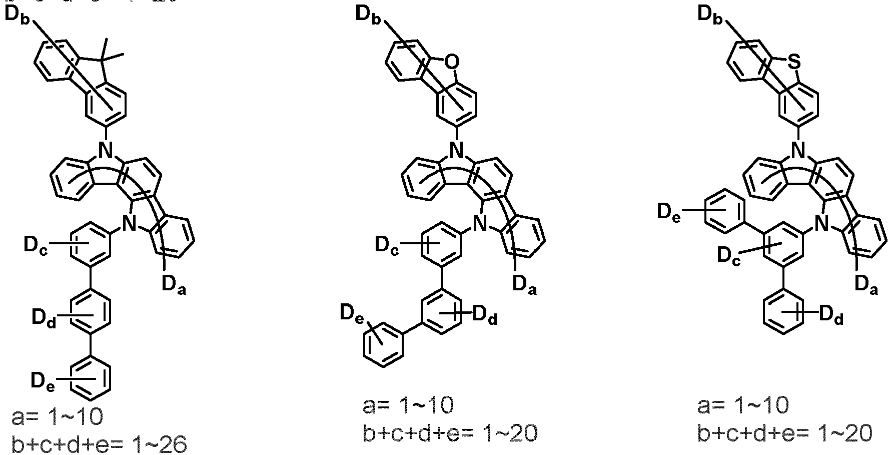

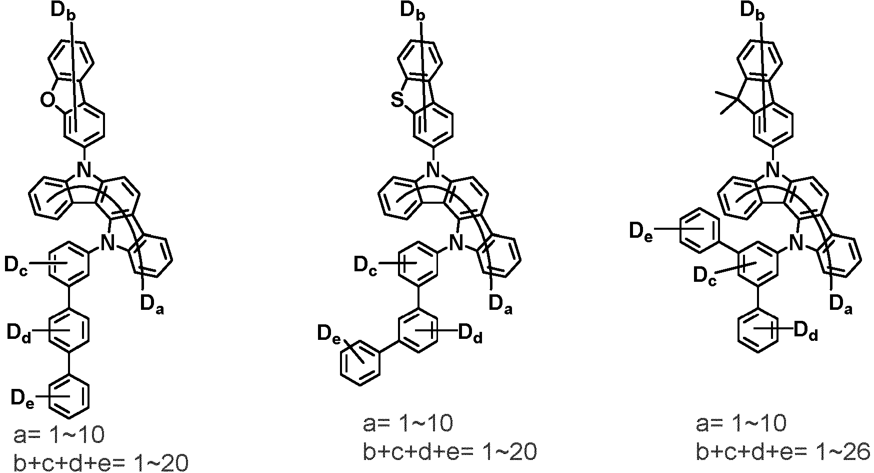

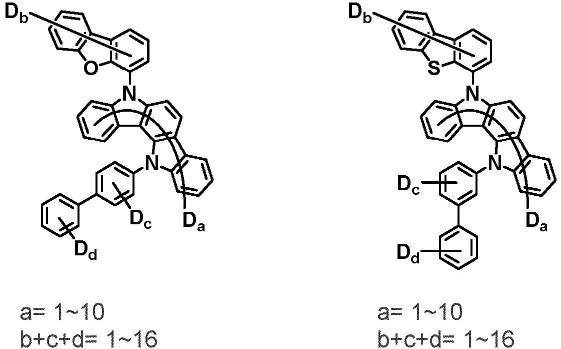

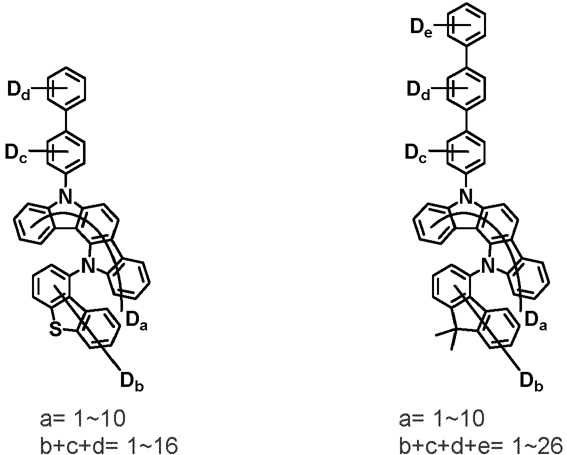

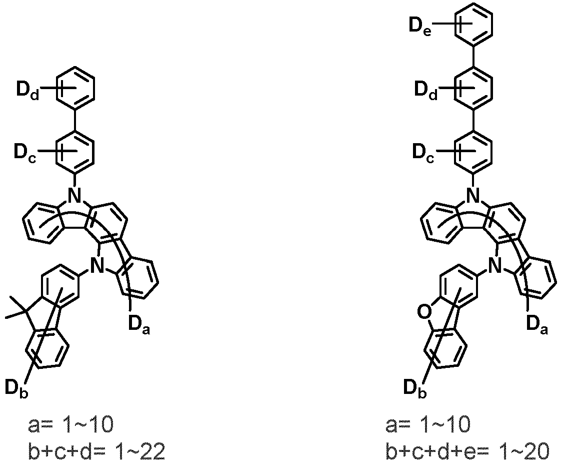

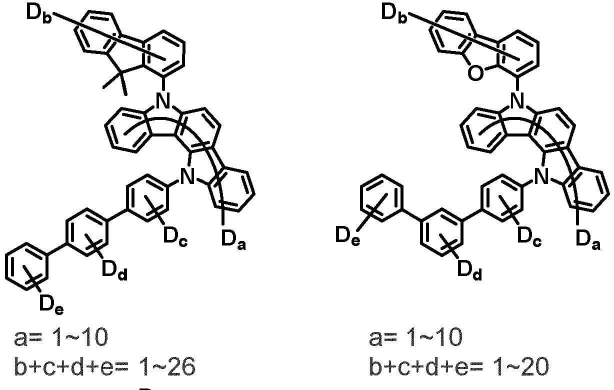

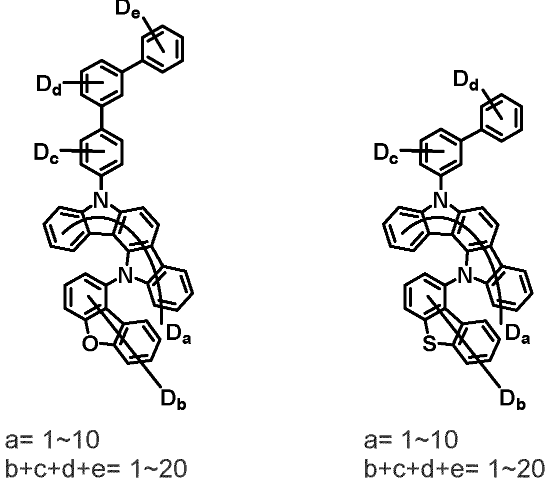

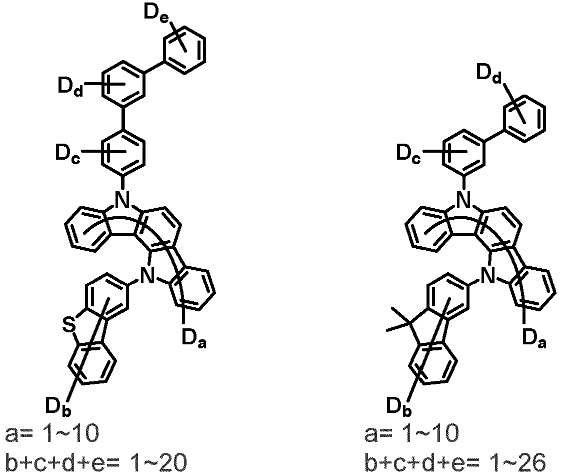

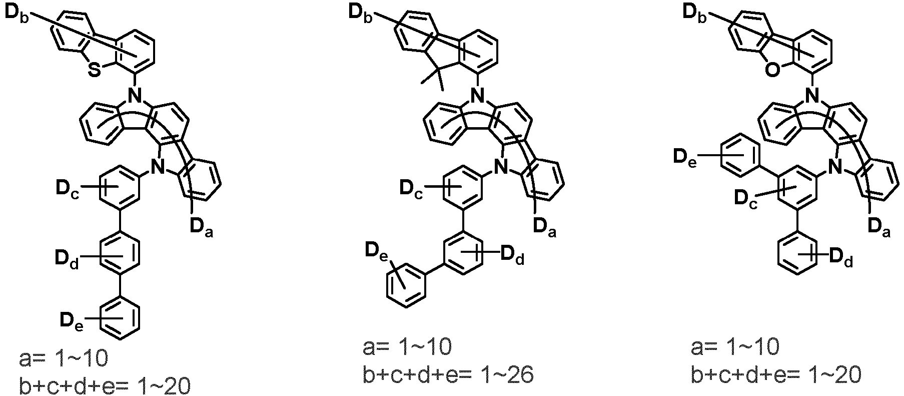

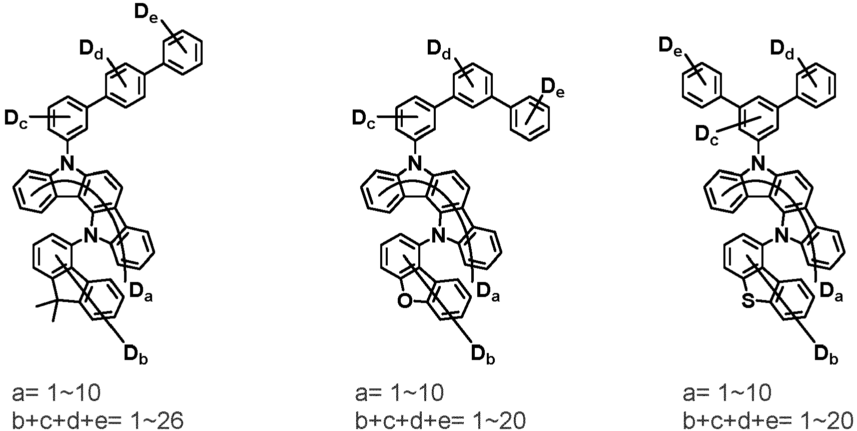

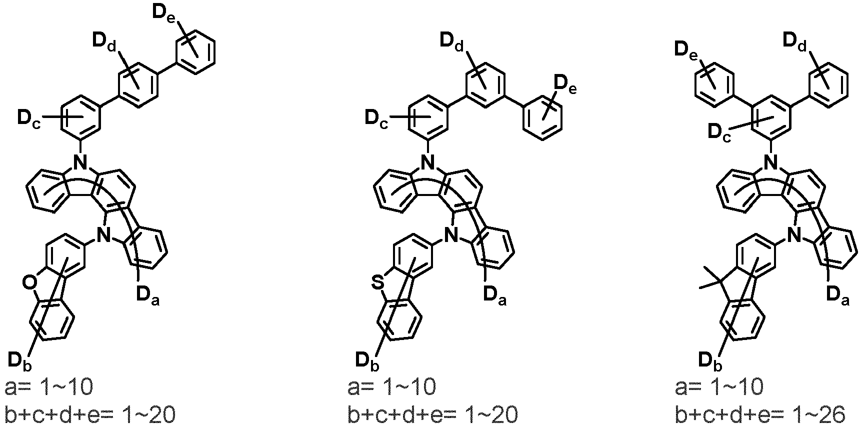

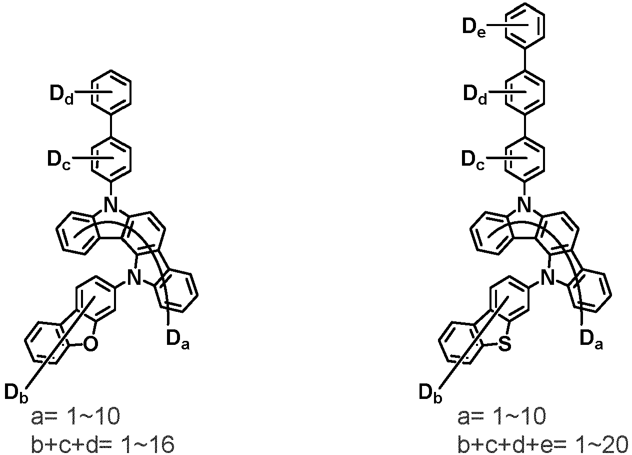

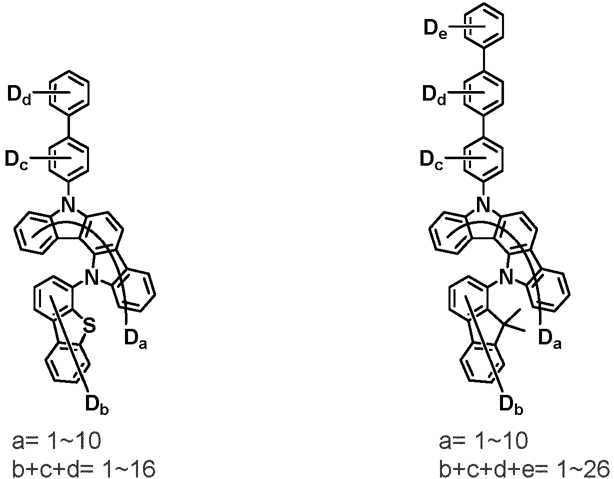

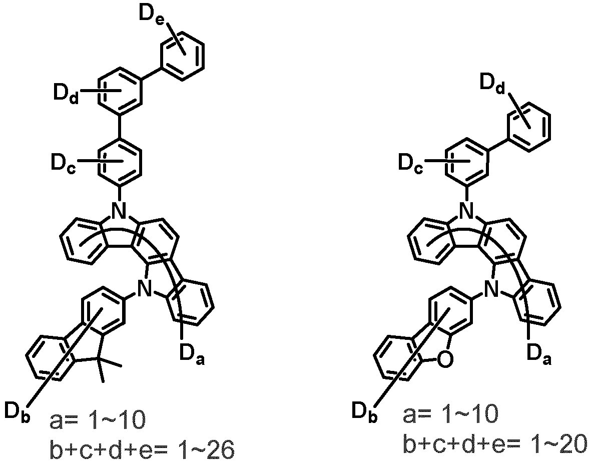

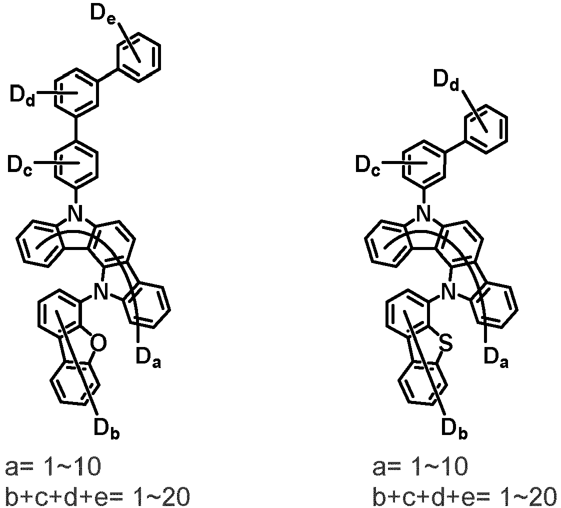

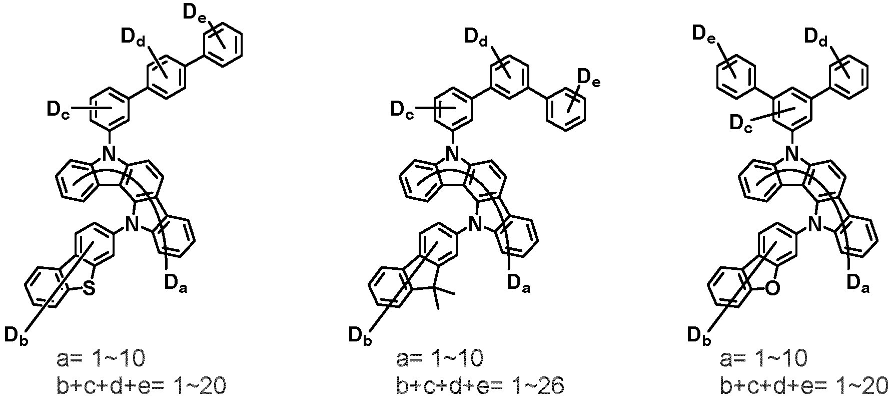

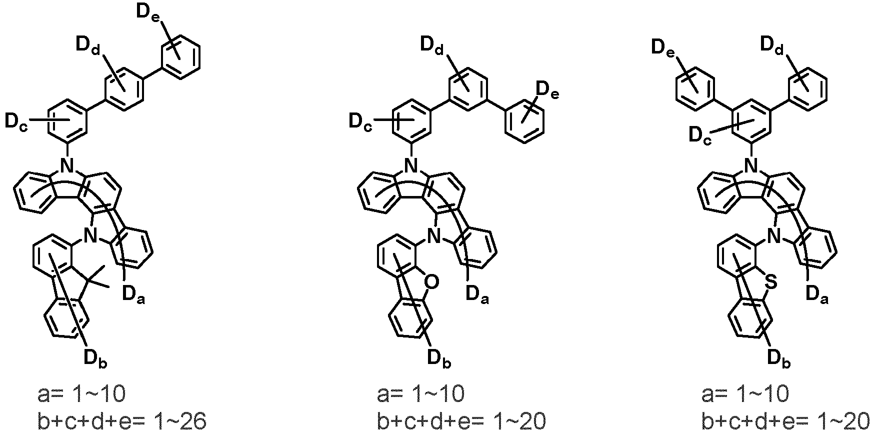

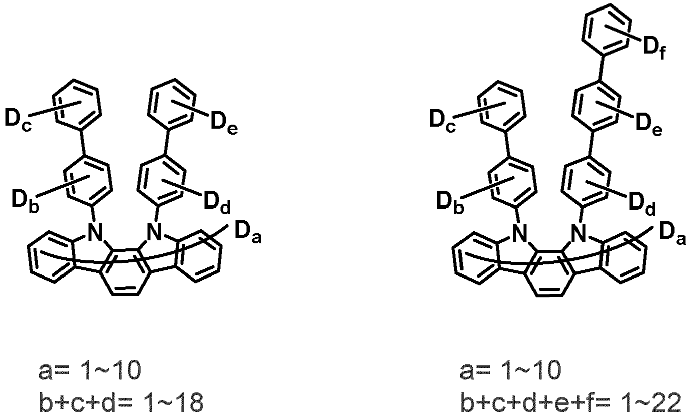

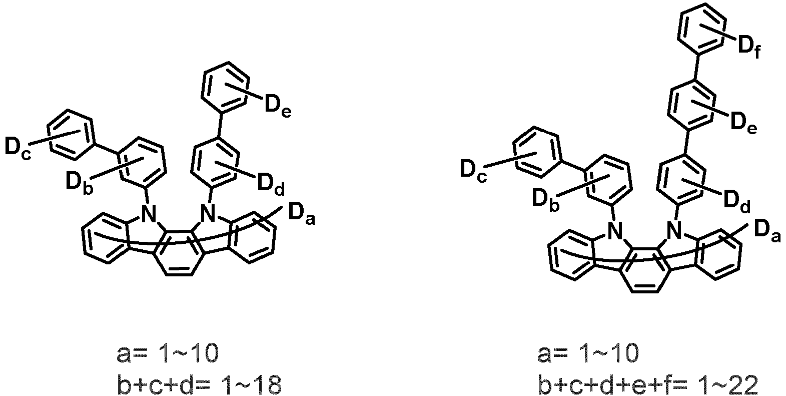

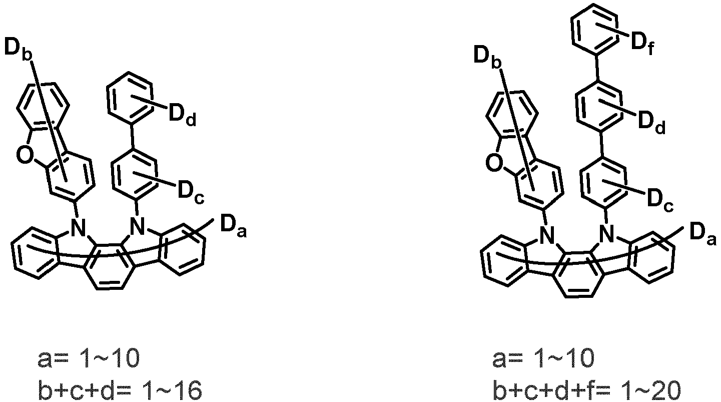

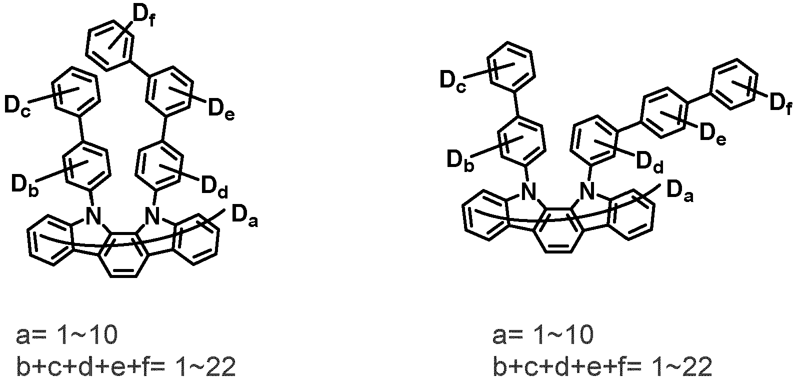

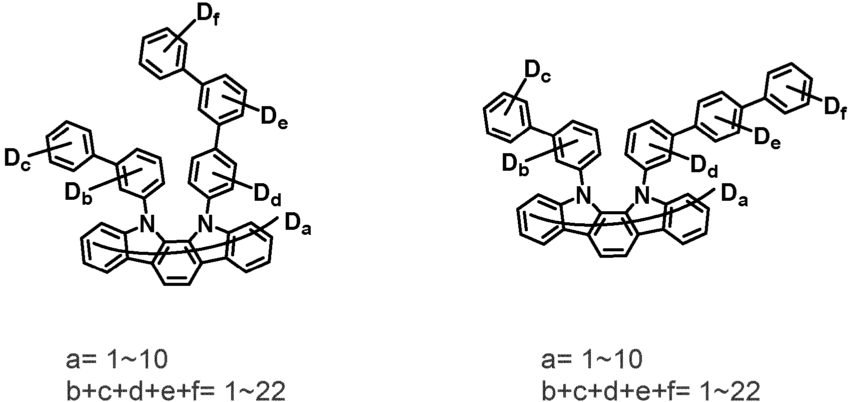

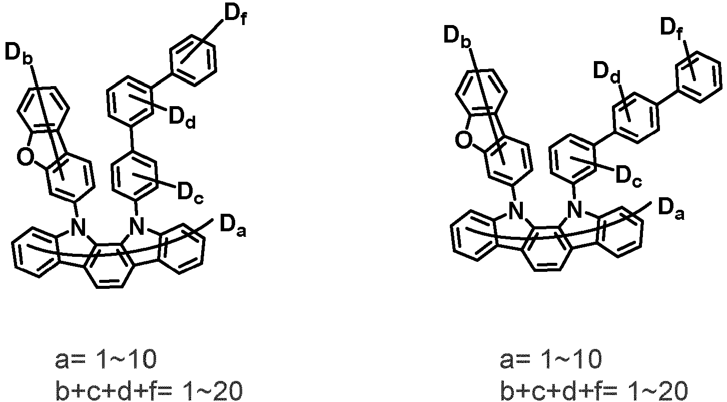

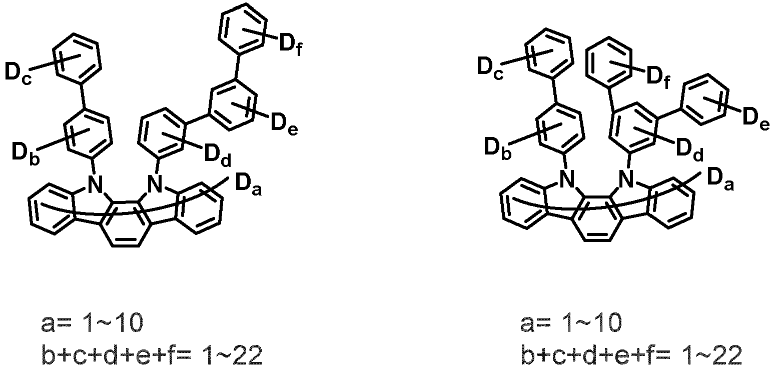

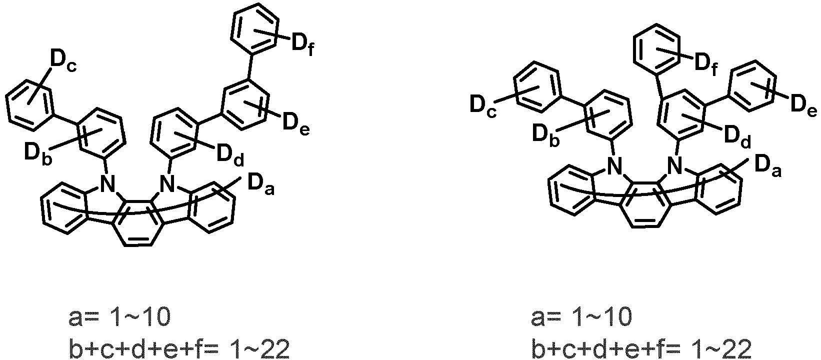

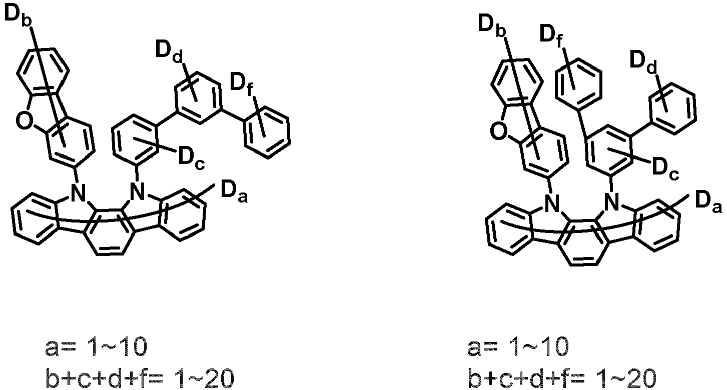

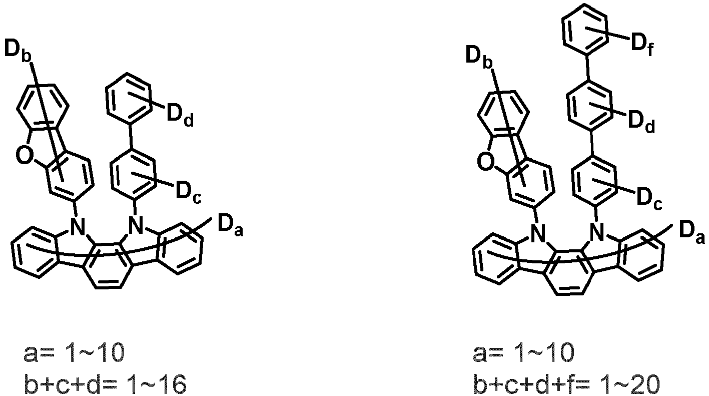

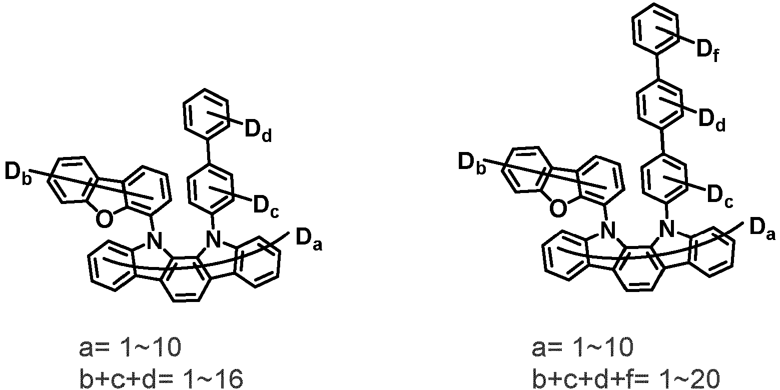

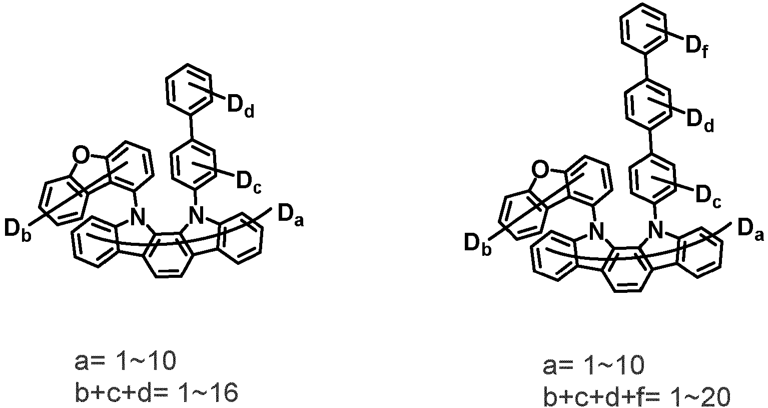

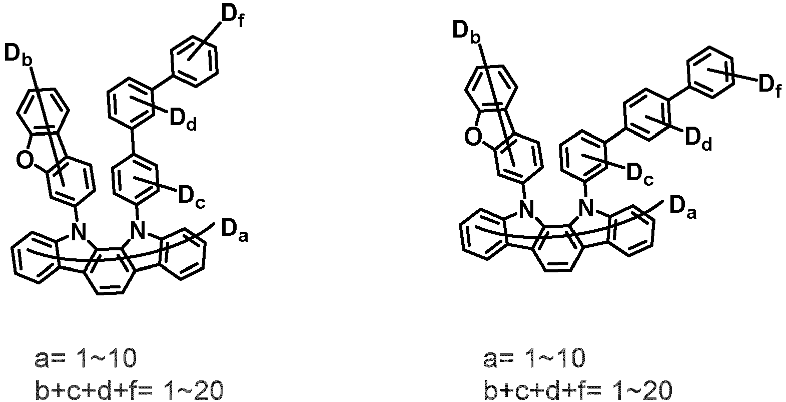

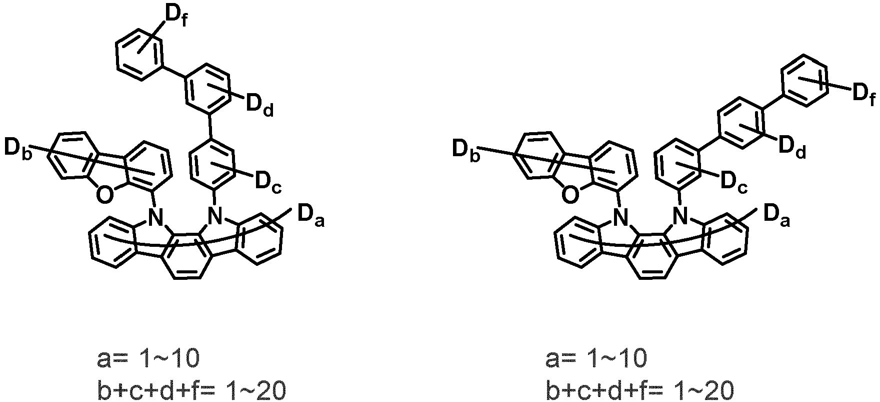

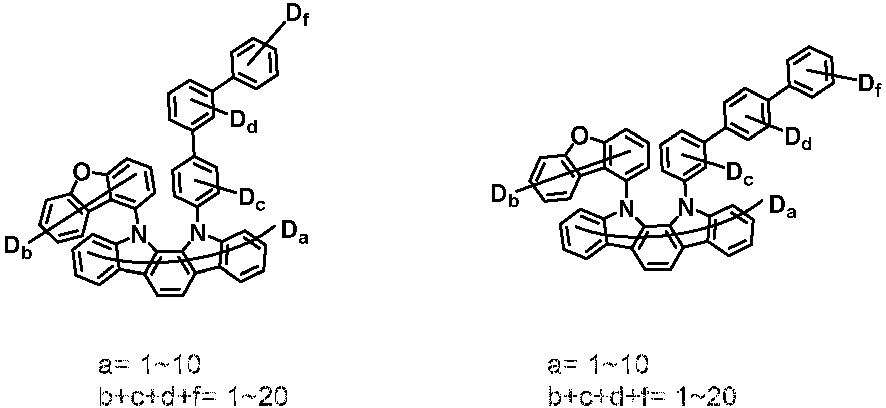

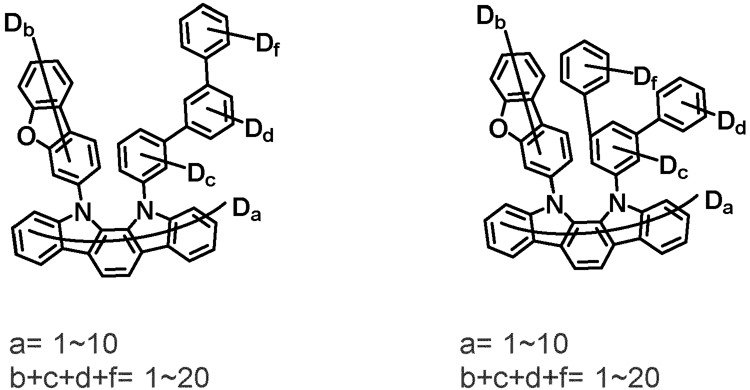

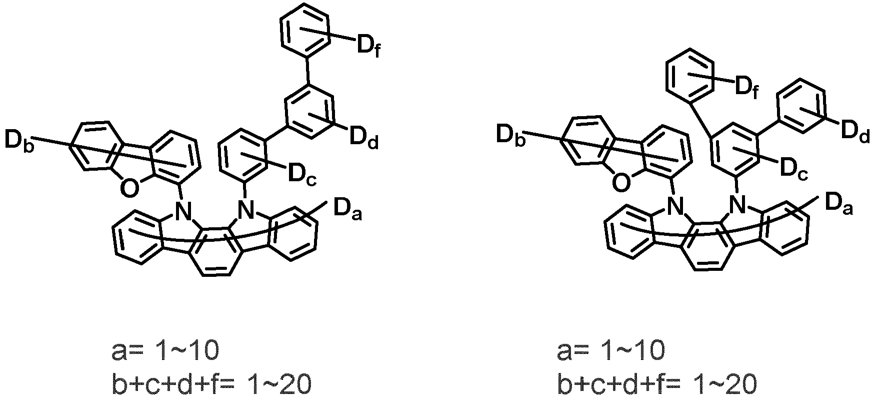

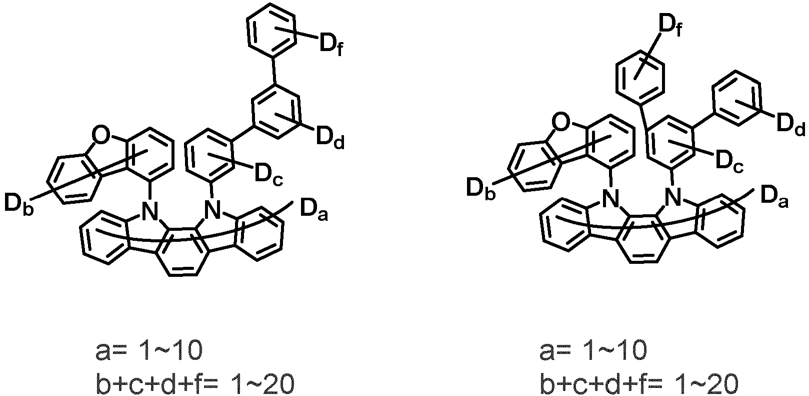

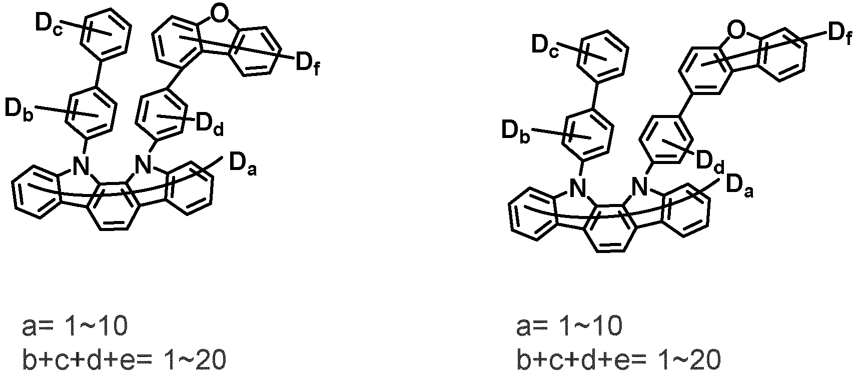

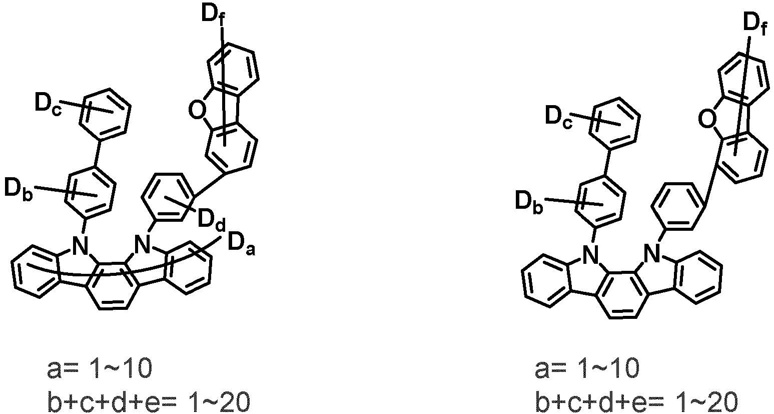

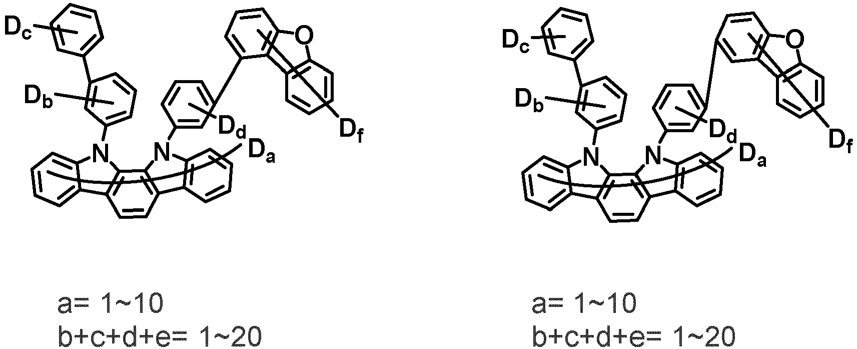

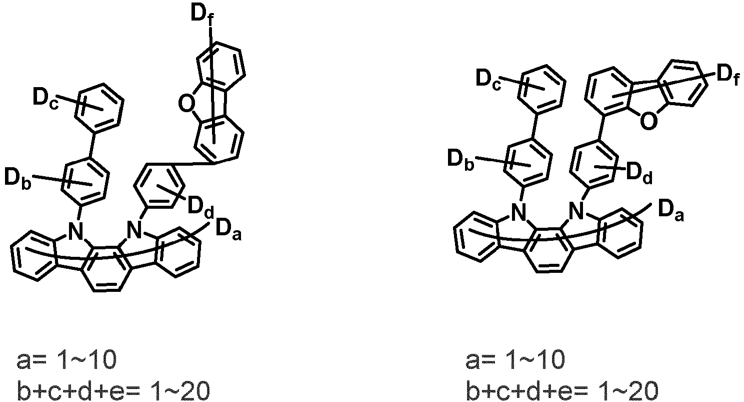

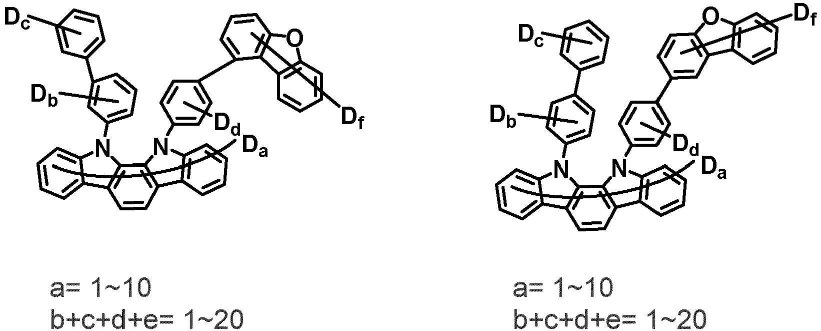

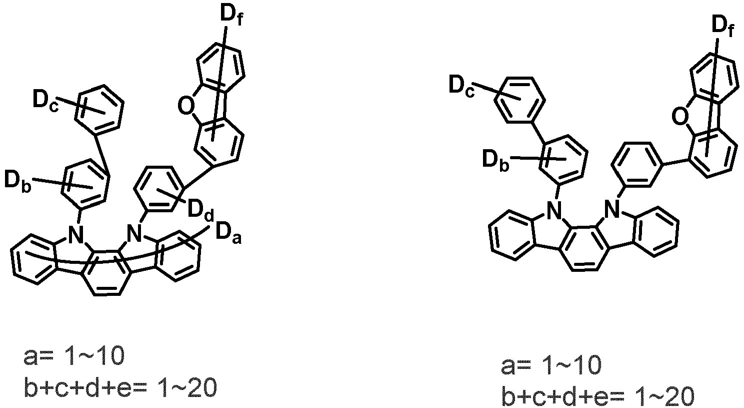

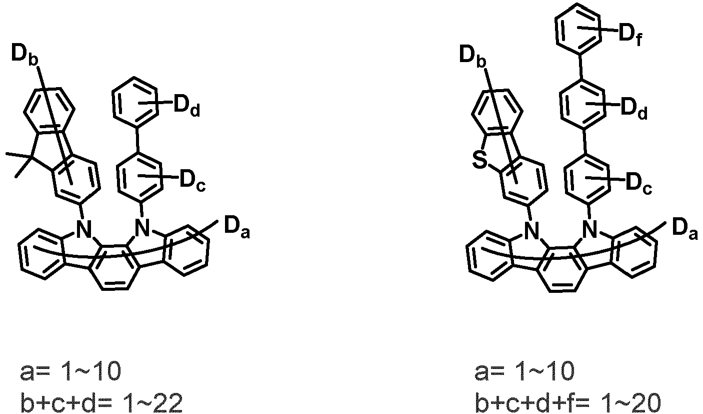

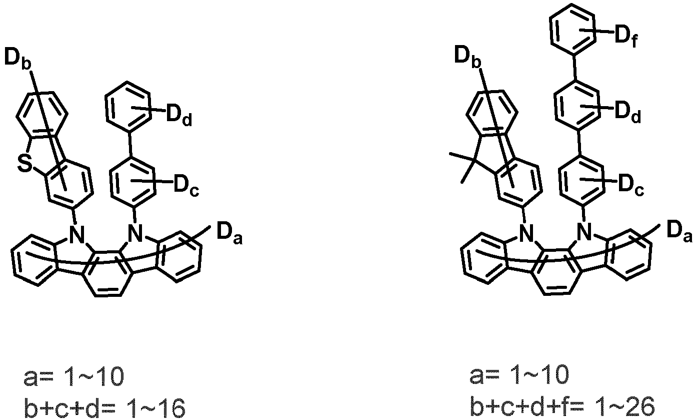

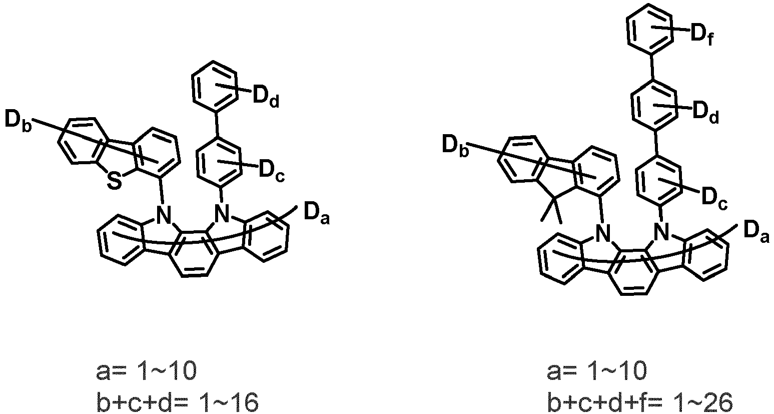

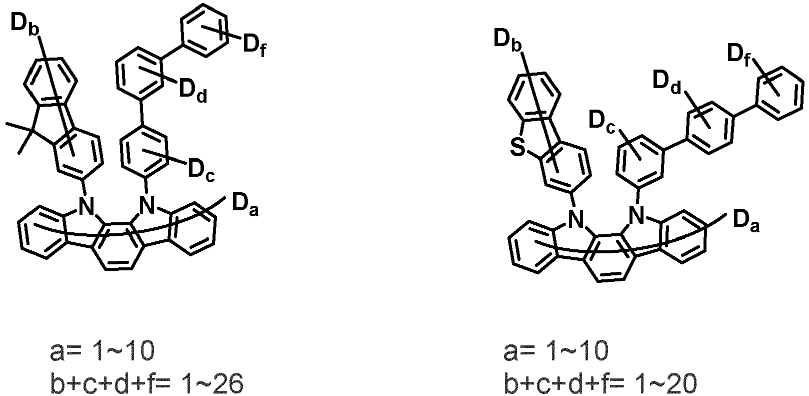

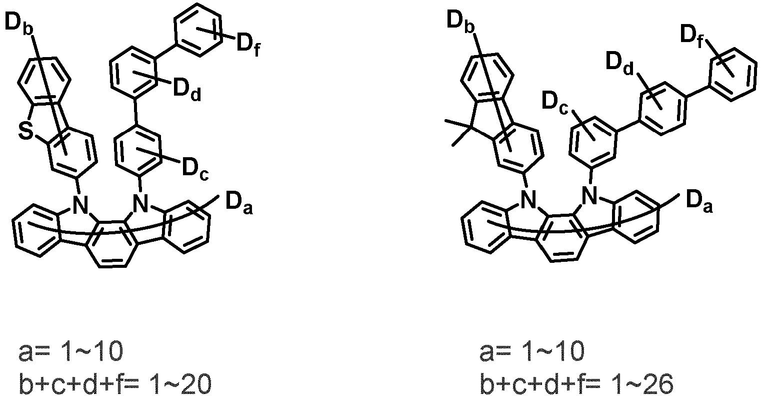

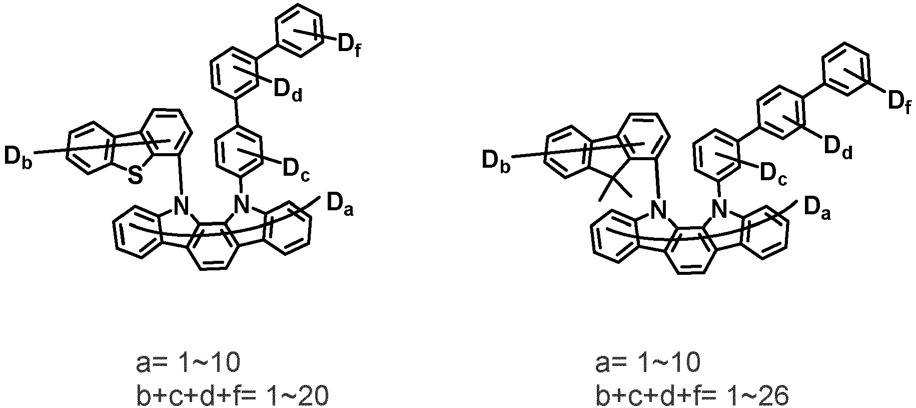

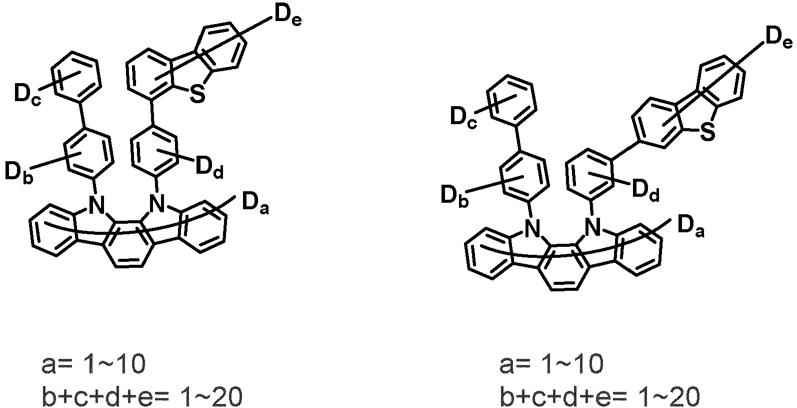

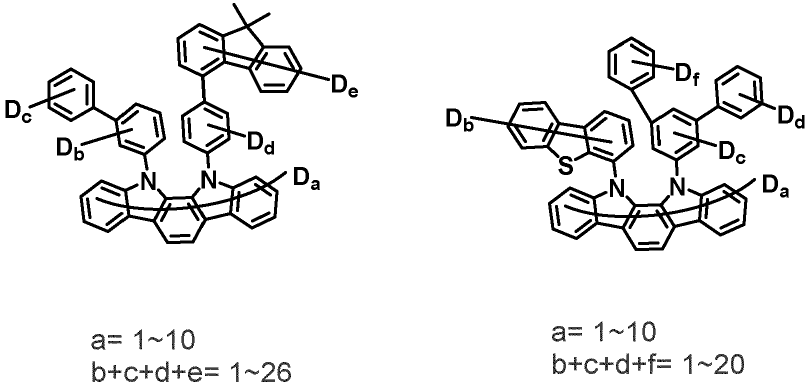

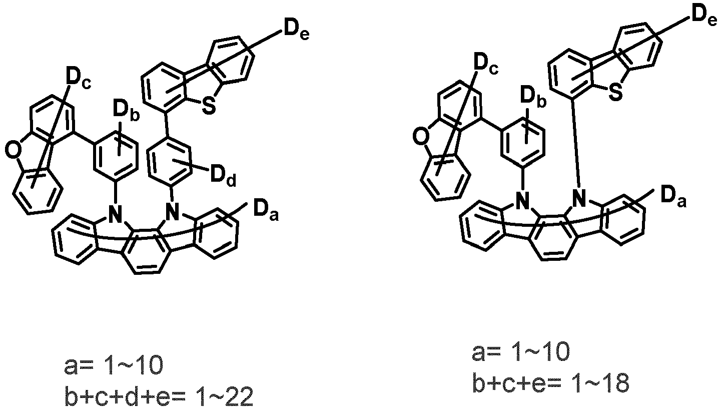

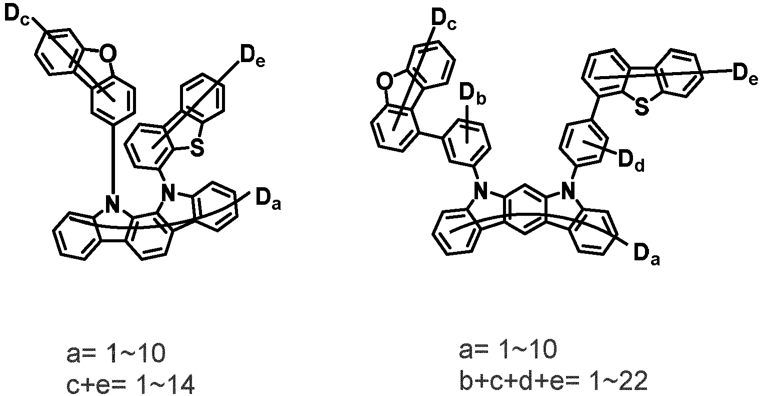

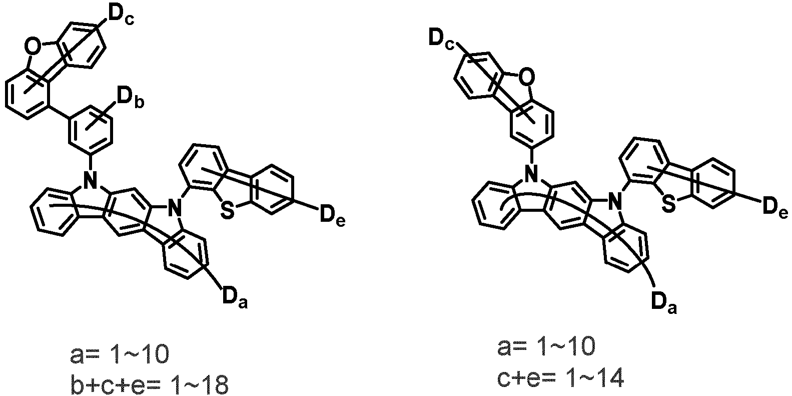

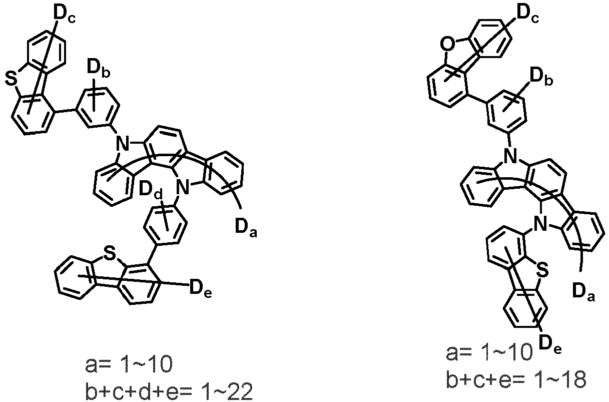

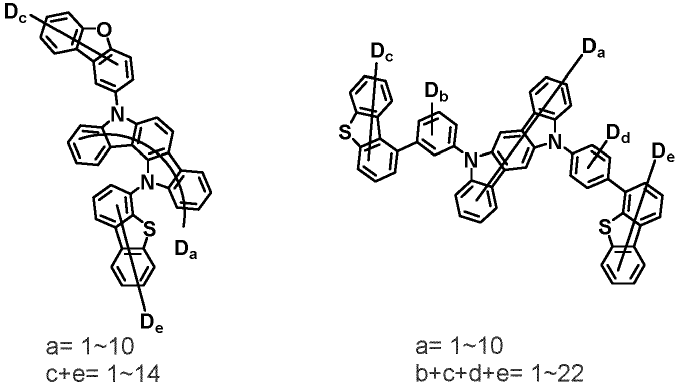

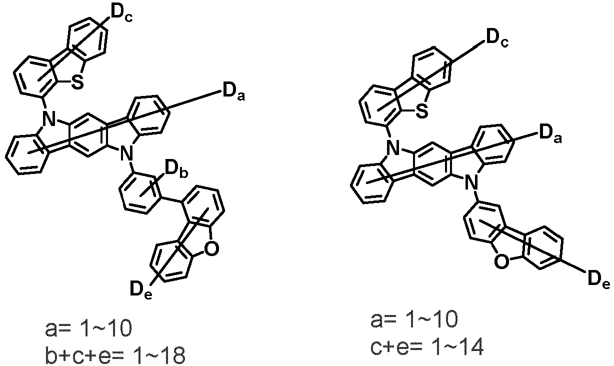

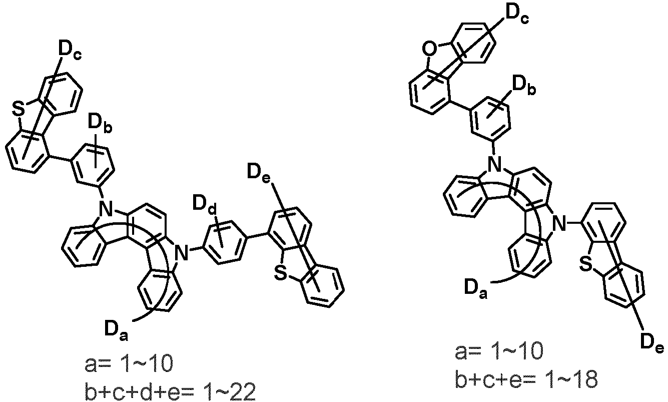

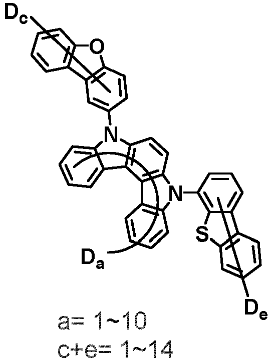

## Patentansprüche

1. Organische lichtemittierende Vorrichtung, umfassend:
eine Anode (2);
eine Kathode (4); und
eine lichtemittierende Schicht (3), die zwischen der Anode und der Kathode angeordnet ist,
wobei die lichtemittierende Schicht eine durch die folgende chemische Formel 1 dargestellte Verbindung und eine durch die folgende chemische Formel 2 dargestellte Verbindung umfasst: 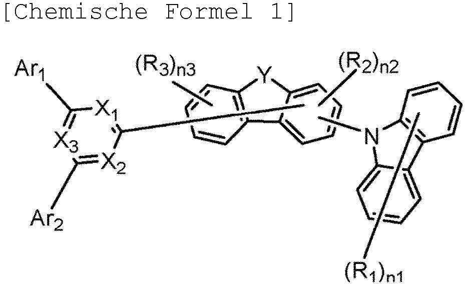
worin, in der chemischen Formel 1:
Y O oder S ist;
X₁, X₂ und X₃ jeweils unabhängig CH oder N sind, mit der Maßgabe, dass mindestens eines von X₁, X₂ und X₃ N ist; und
Ar₁ und Ar₂ jeweils unabhängig ein substituiertes oder unsubstituiertes C₆₋₆₀-Aryl oder ein substituiertes oder unsubstituiertes C₂₋₆₀-Heteroaryl mit mindestens einem Heteroatom ausgewählt aus der Gruppe bestehend aus N, O und S, sind;
R₁, R₂ und R₃ jeweils unabhängig Wasserstoff, Deuterium, substituiertes oder unsubstituiertes C₆₋₆₀-Aryl oder substituiertes oder unsubstituiertes C₂₋₆₀-Heteroaryl mit mindestens einem Heteroatom, ausgewählt aus der Gruppe, bestehend aus N, O und S, sind;
n1 eine ganze Zahl von 0 bis 8 ist; und
n2+n3 eine ganze Zahl von 0 bis 6 ist; 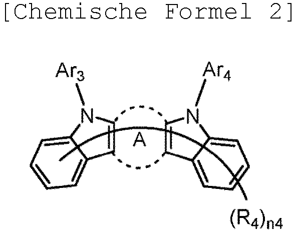
worin, in der chemischen Formel 2:
A ein Benzolring ist, der mit zwei benachbarten Ringen kondensiert ist;
Ar₃ und Ar₄ jeweils unabhängig ein substituiertes oder unsubstituiertes C₆₋₆₀-Aryl oder ein substituiertes oder unsubstituiertes C₂₋₆₀-Heteroaryl mit mindestens einem Heteroatom, ausgewählt aus der Gruppe, bestehend aus O und S, sind, mit der Maßgabe, dass mindestens eines aus Ar₃ und Ar₄ mit mindestens einem Deuterium substituiert ist;
jedes R₄ unabhängig Wasserstoff, Deuterium, substituiertes oder unsubstituiertes C₆₋₆₀-Aryl oder ein substituiertes oder unsubstituiertes C₂₋₆₀-Heteroaryl mit mindestens einem Heteroatom, ausgewählt aus der Gruppe, bestehend aus N, O und S, ist, mit der Maßgabe, dass mindestens ein R₄ Deuterium ist; und
n4 eine ganze Zahl von 1 bis 10 ist.

2. Organische lichtemittierende Vorrichtung nach Anspruch 1,
wobei alle X₁ bis X₃ N sind;
X₁ und X₂ N sind, und X₃ CH ist;
X₁ und X₃ N sind, und X₂ CH ist;
X₁ N ist, und X₂ und X₃ CH sind; oder
X₂ N ist, und X₁ und X₃ CH sind.

3. Organische lichtemittierende Vorrichtung nach Anspruch 1,
wobei mindestens einer aus Ar₁ und Ar₂ ein Deuterium-substituiertes C₆₋₆₀-Aryl oder ein Deuterium-substituiertes C₂₋₆₀-Heteroaryl mit mindestens einem Heteroatom, ausgewählt aus der Gruppe, bestehend aus N, O und S, ist; oder
mindestens einer aus R₁ bis R₃ Deuterium, Deuterium-substituiertes C₆₋₆₀-Aryl oder Deuterium-substituiertes C₂₋₆₀-Heteroaryl mit mindestens einem Heteroatom, ausgewählt aus der Gruppe, bestehend aus N, O und S, ist, und n1+n2+n3 1 oder mehr ist.

4. Organische lichtemittierende Vorrichtung nach Anspruch 1, wobei Ar₁ und Ar₂ jeweils unabhängig ausgewählt sind aus der Gruppe bestehend aus:

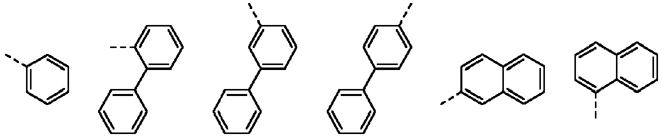

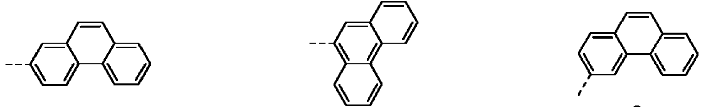

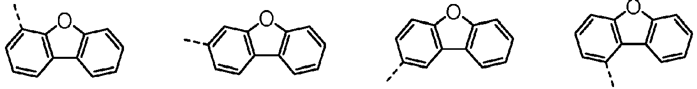

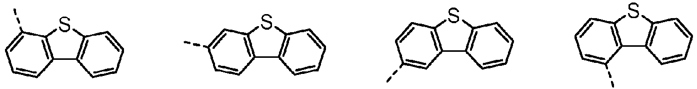

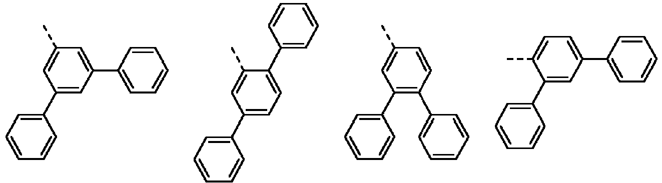

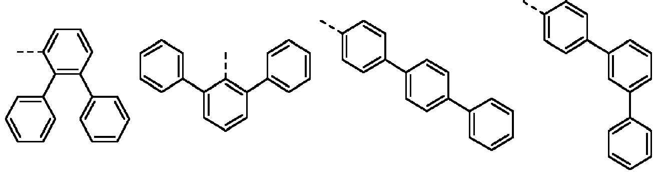

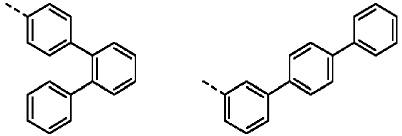

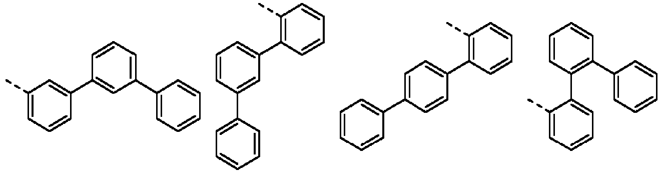

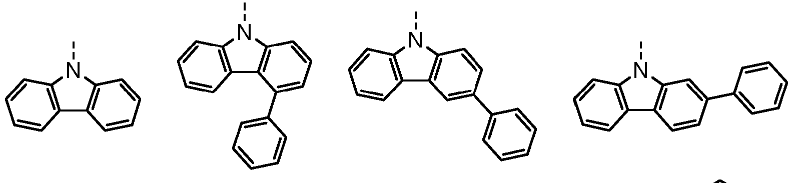

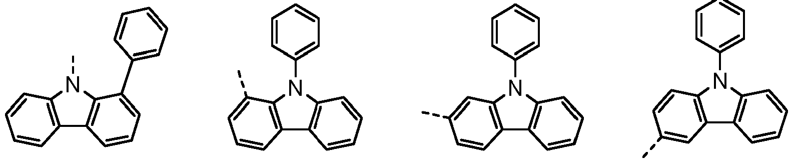

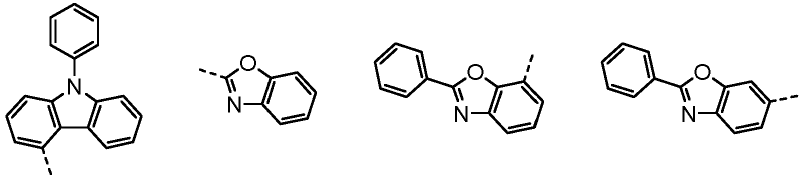

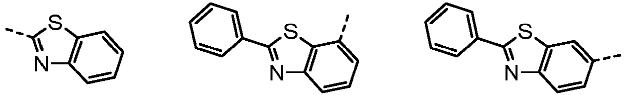

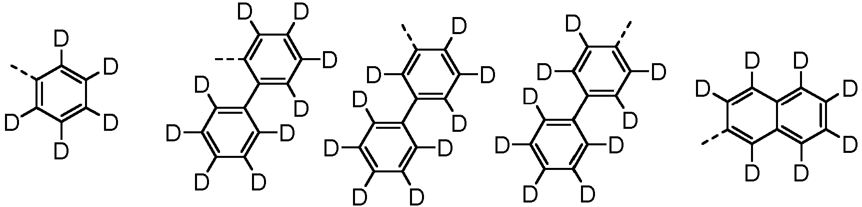

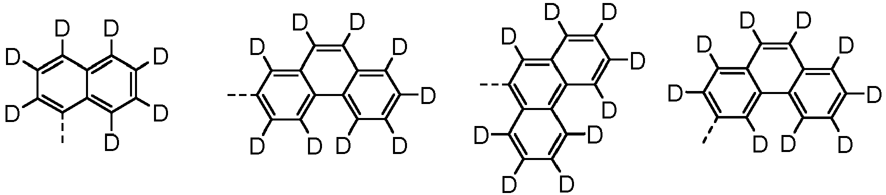

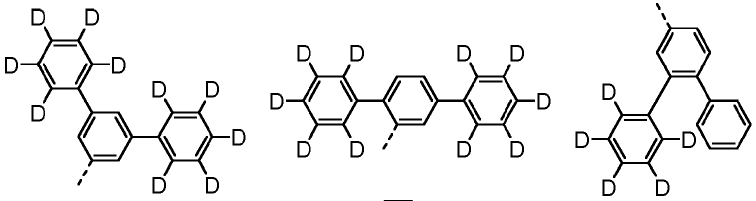

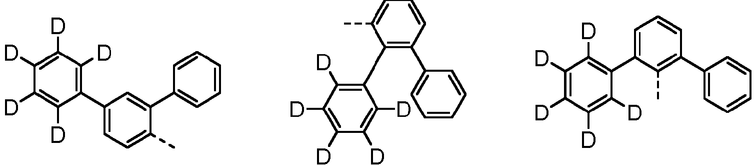

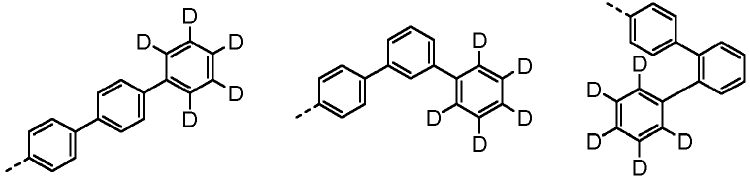

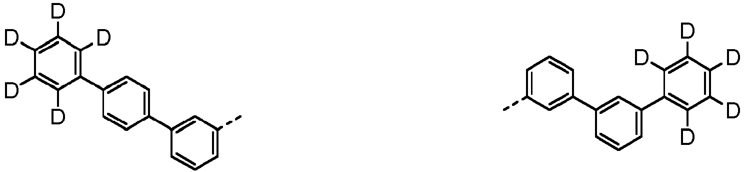

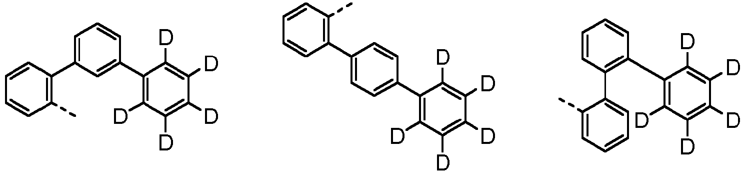

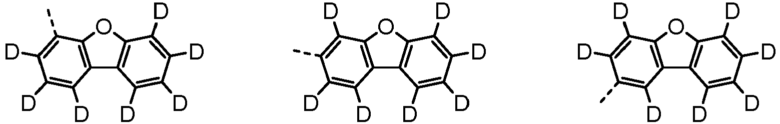

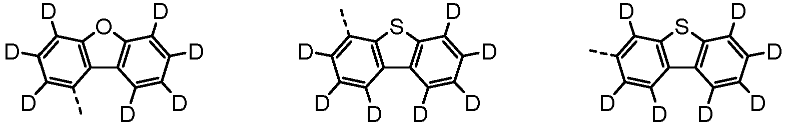

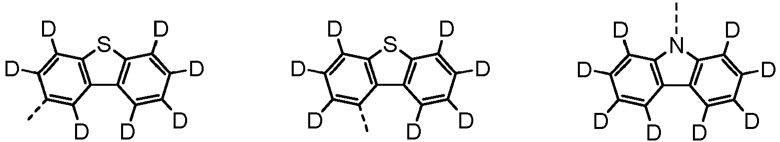

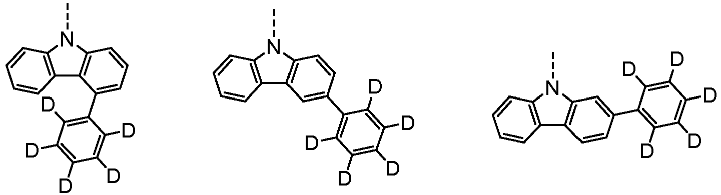

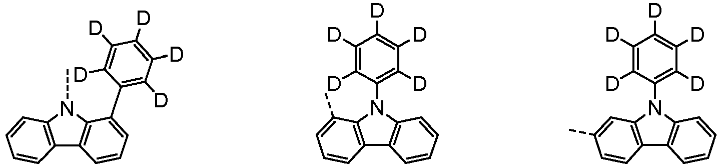

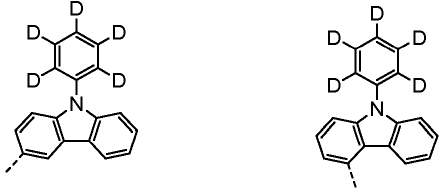

5. Organische lichtemittierende Vorrichtung nach Anspruch 1, wobei mindestens eines aus Ar₁ und Ar₂ Phenyl oder mit 5 Deuterium substituiertes Phenyl ist.

6. Organische lichtemittierende Vorrichtung nach Anspruch 1, wobei jedes R₁ unabhängig Wasserstoff, Deuterium, Phenyl, Dibenzofuranyl, Dibenzothiophenyl, Carbazolyl, mit 5 Deuterium substituiertes Phenyl, mit 7 Deuterium substituiertes Dibenzofuranyl, mit 7 Deuterium substituiertes Dibenzothiophenyl oder mit 8 Deuterium substituiertes Carbazolyl ist.

7. Organische lichtemittierende Vorrichtung nach Anspruch 1, wobei R₂ und R₃ jeweils unabhängig Wasserstoff, Deuterium, Phenyl, Dibenzothiophenyl, Carbazolyl oder mit 5 Deuterium substituiertes Phenyl sind.

8. Organische lichtemittierende Vorrichtung nach Anspruch 1, wobei die durch die chemische Formel 1 dargestellte Verbindung eine beliebige Verbindung ist, ausgewählt aus der Gruppe bestehend aus:

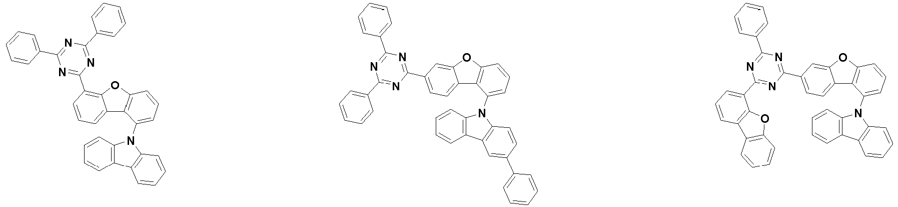

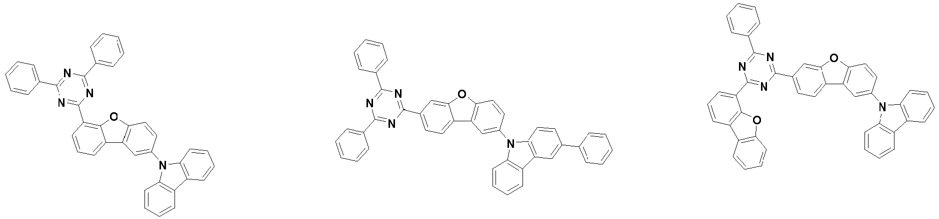

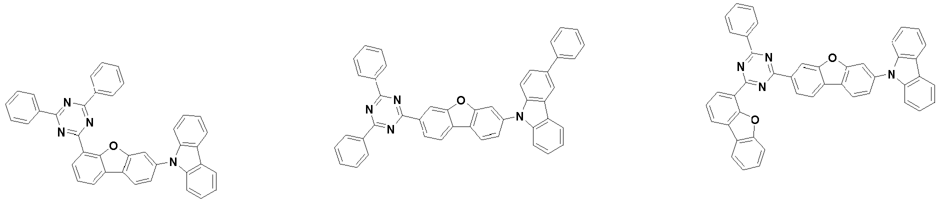

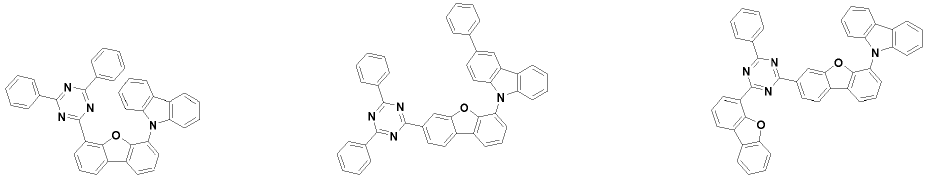

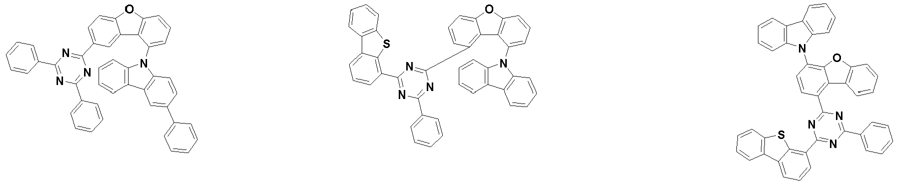

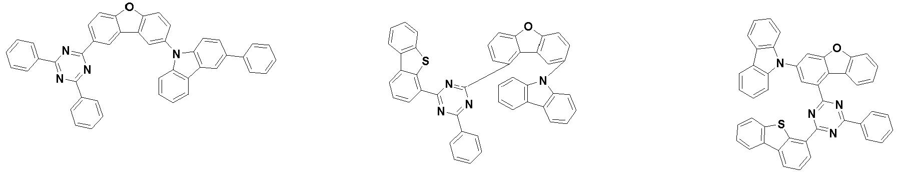

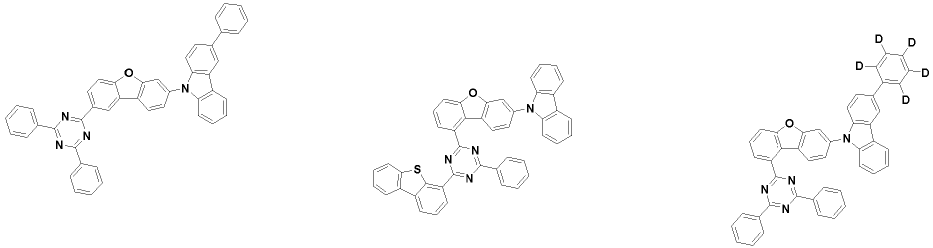

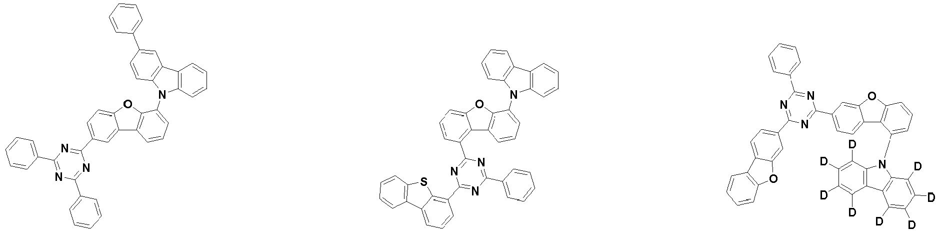

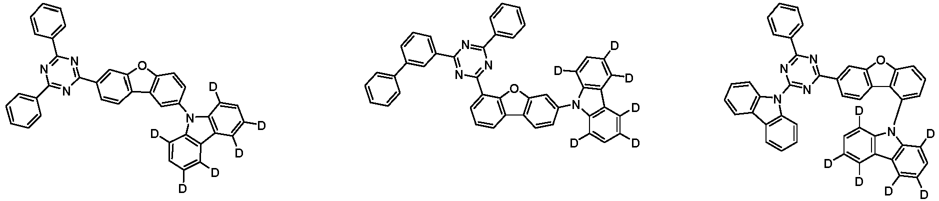

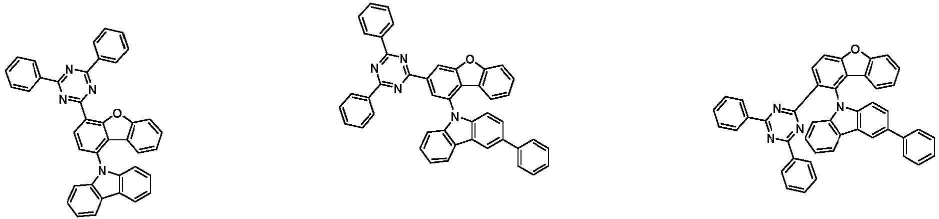

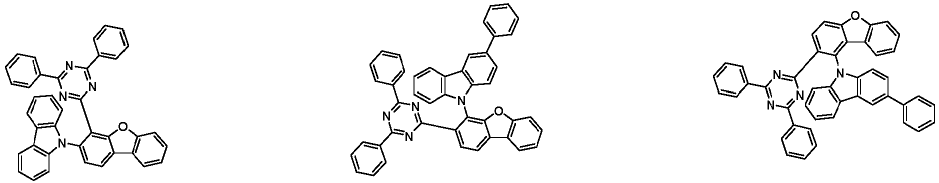

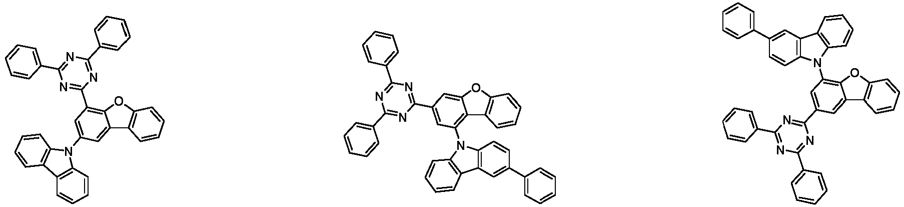

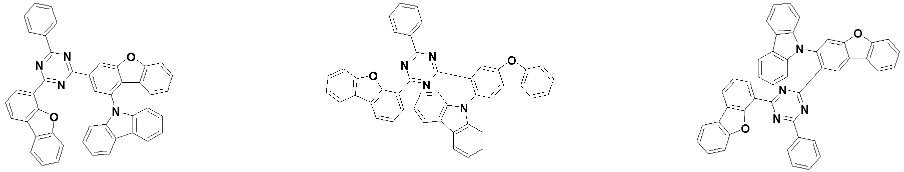

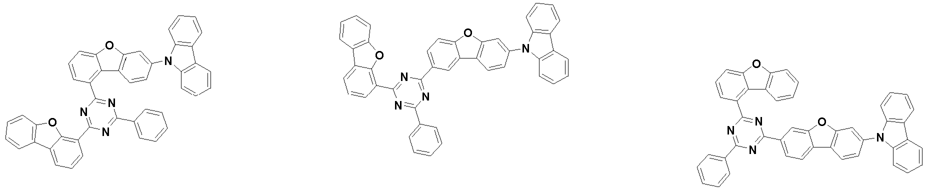

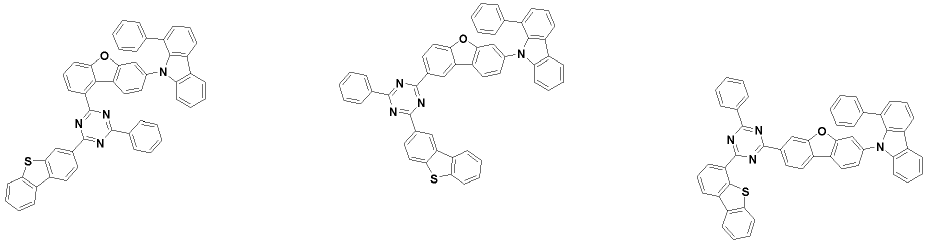

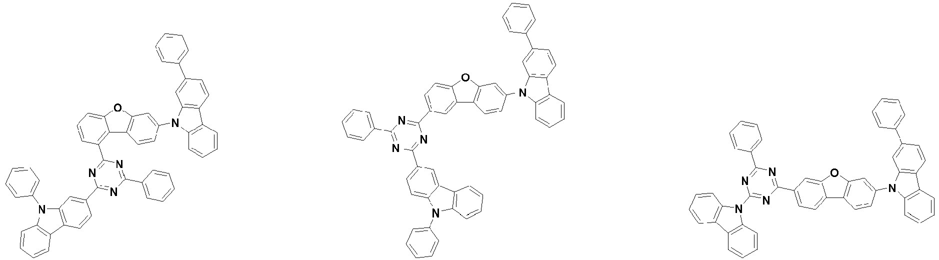

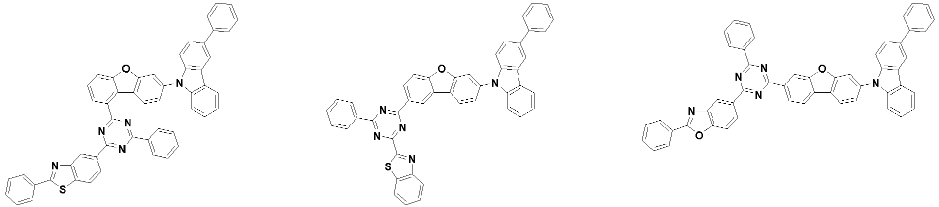

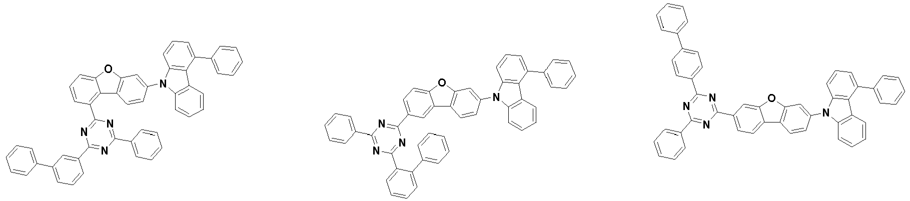

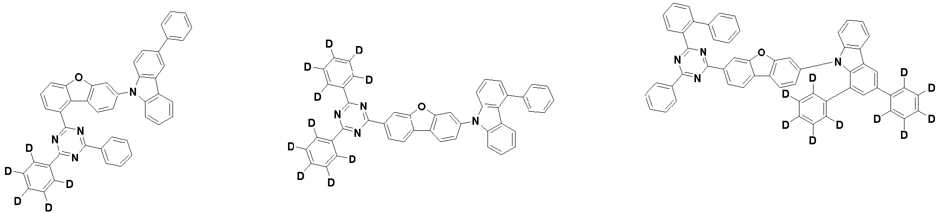

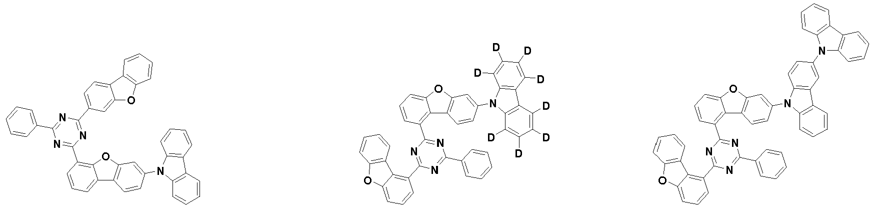

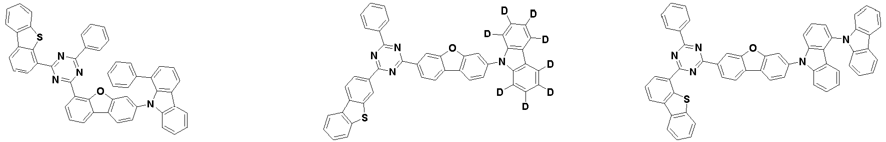

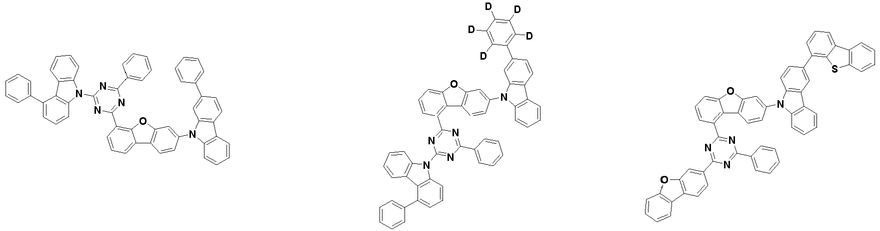

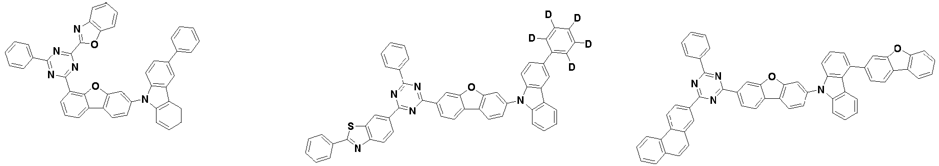

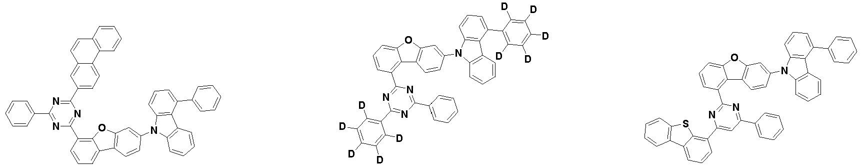

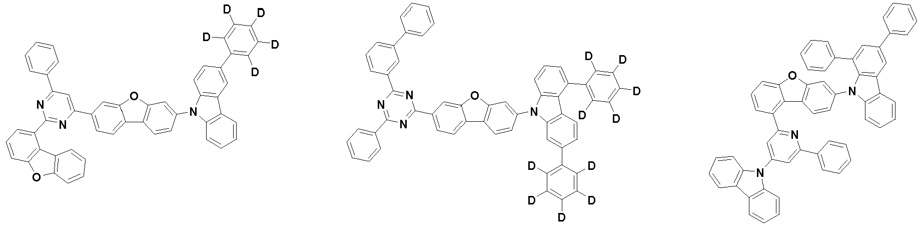

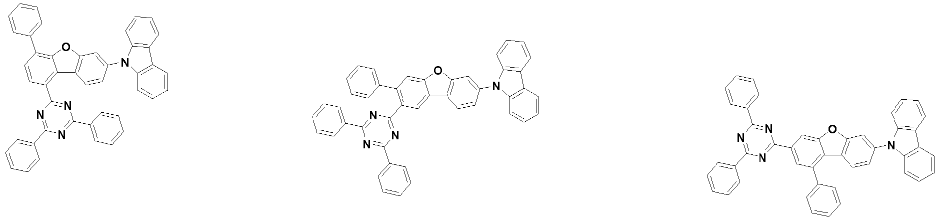

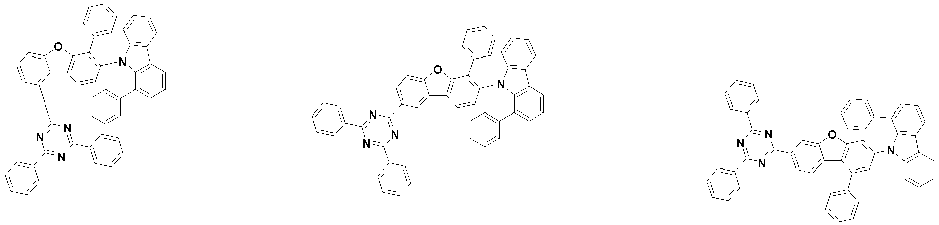

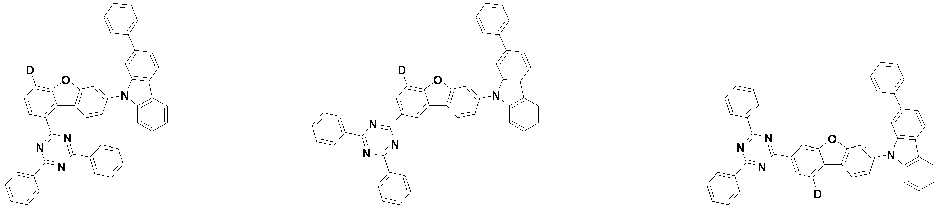

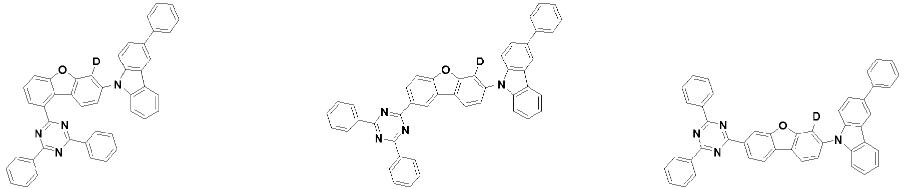

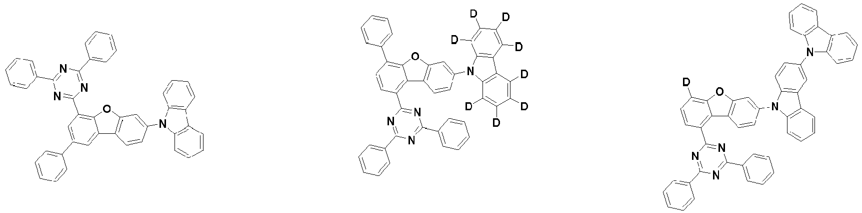

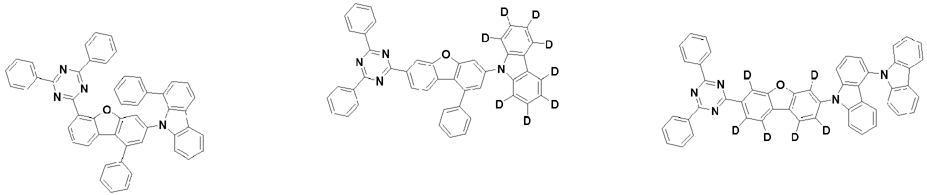

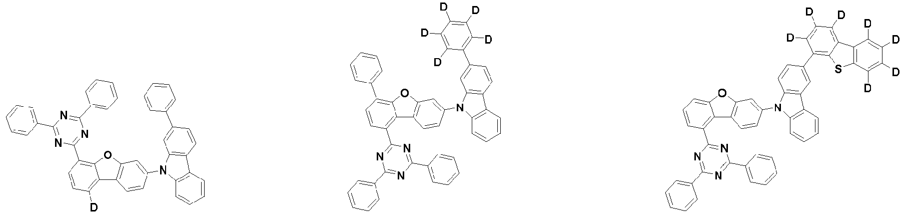

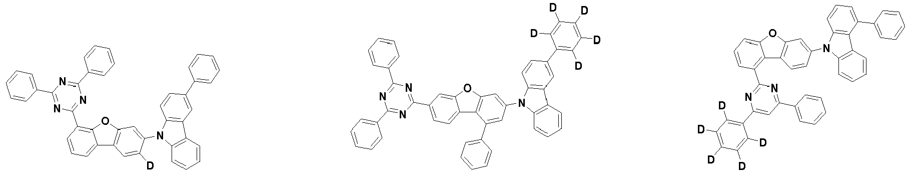

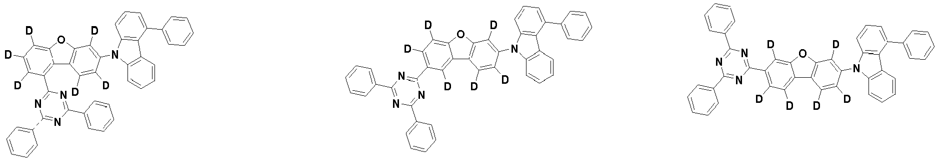

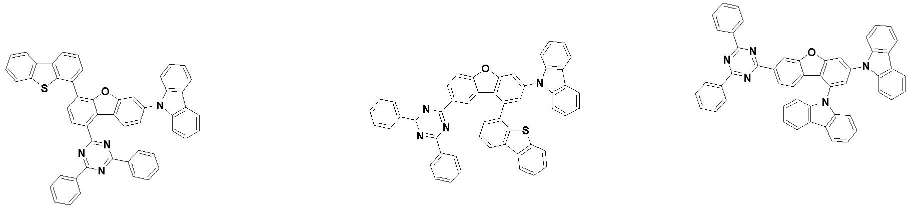

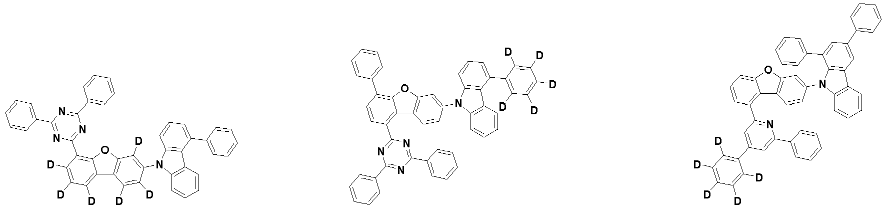

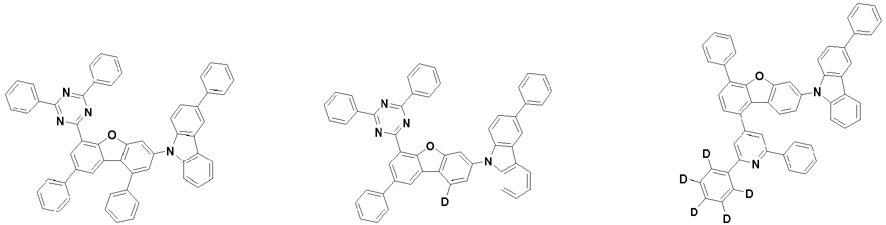

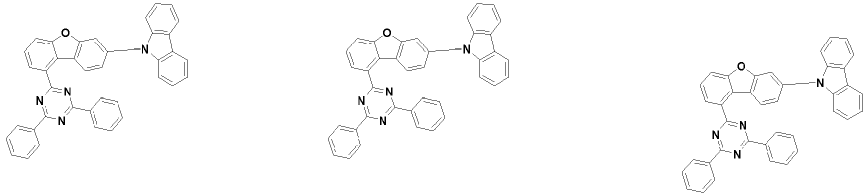

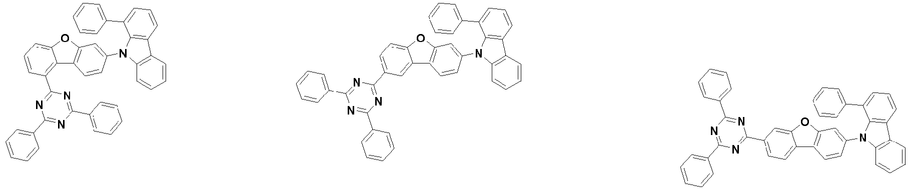

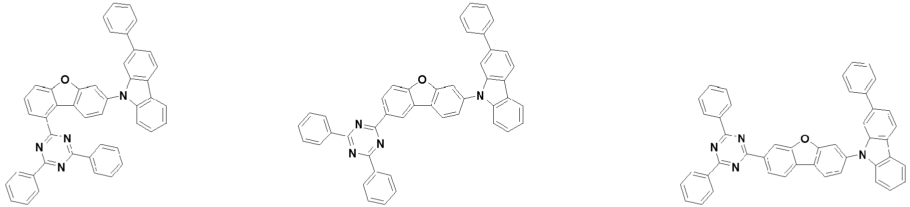

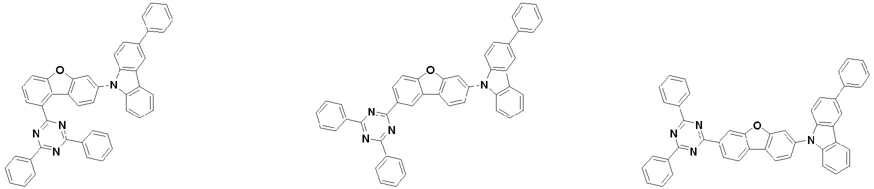

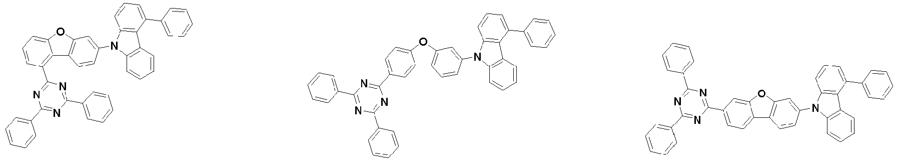

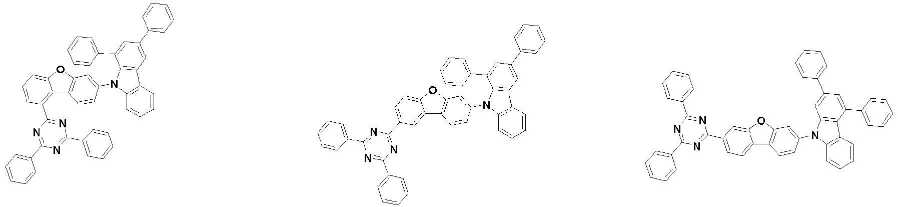

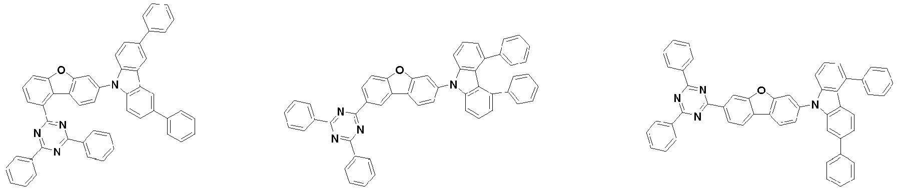

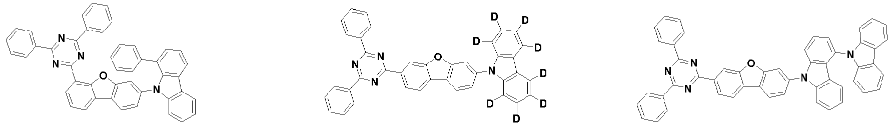

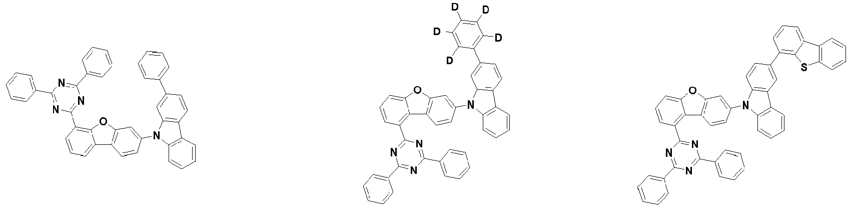

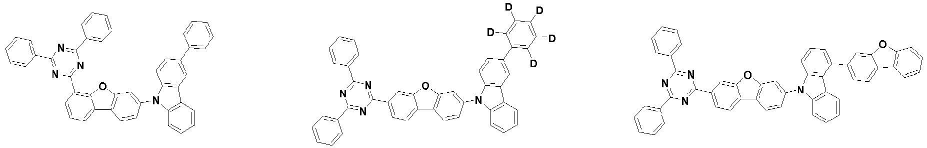

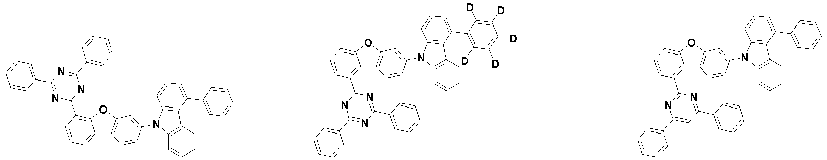

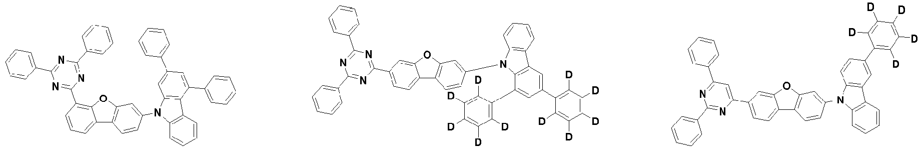

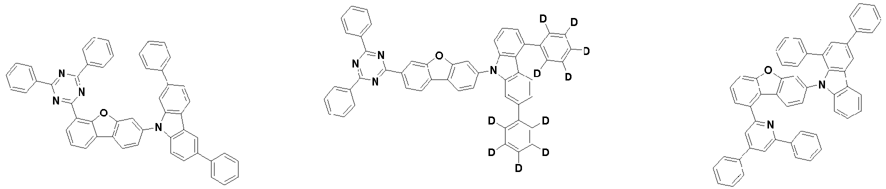

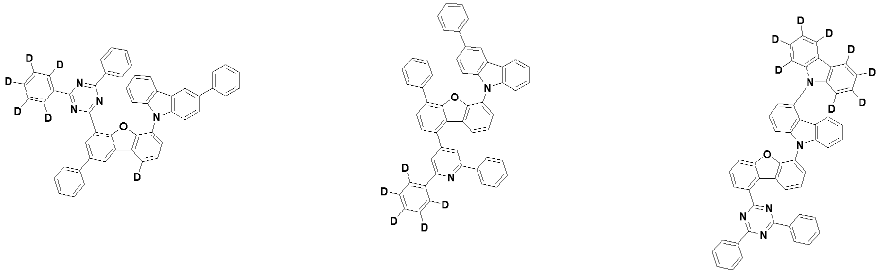

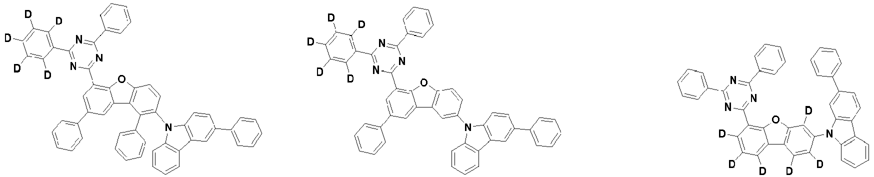

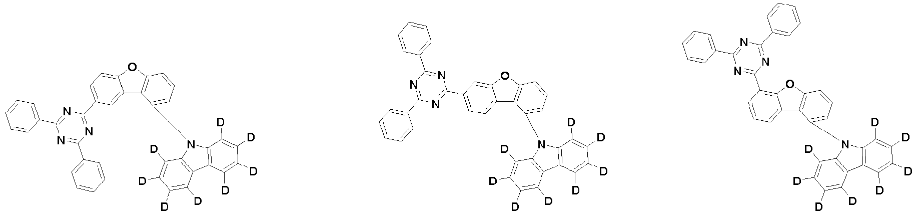

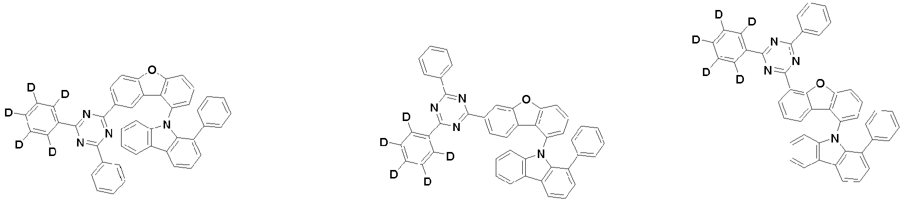

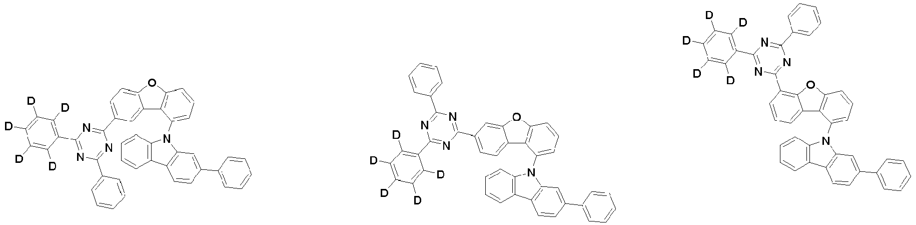

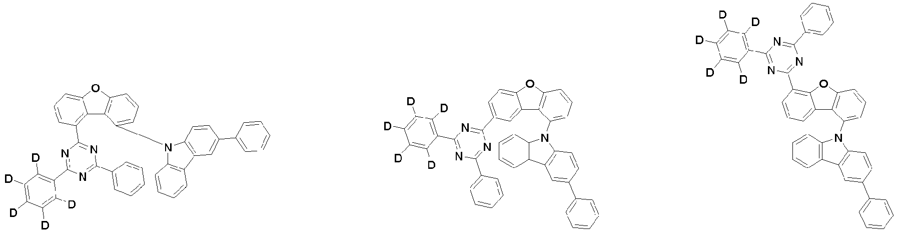

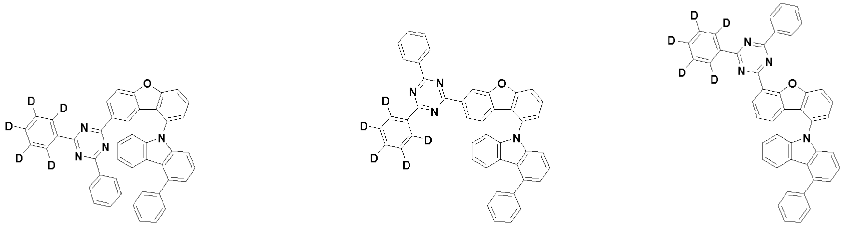

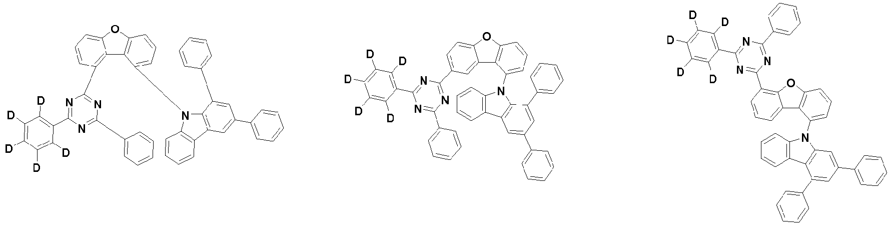

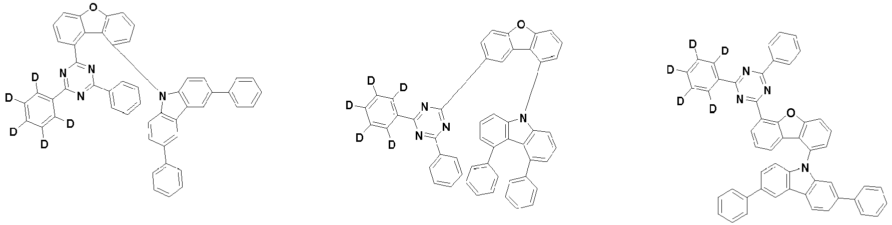

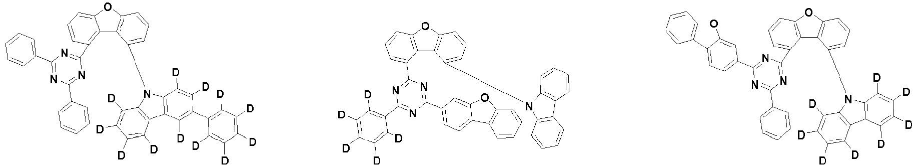

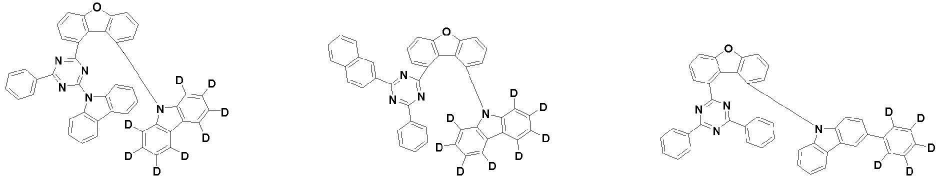

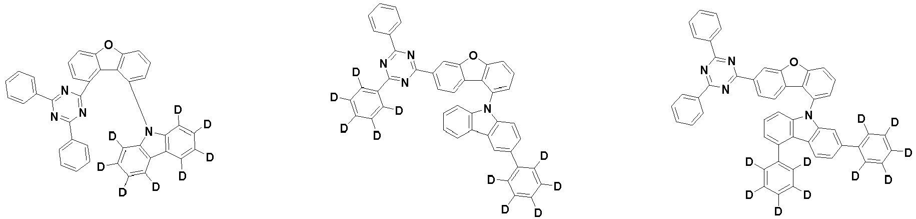

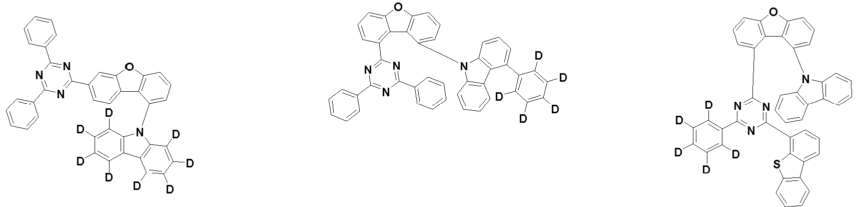

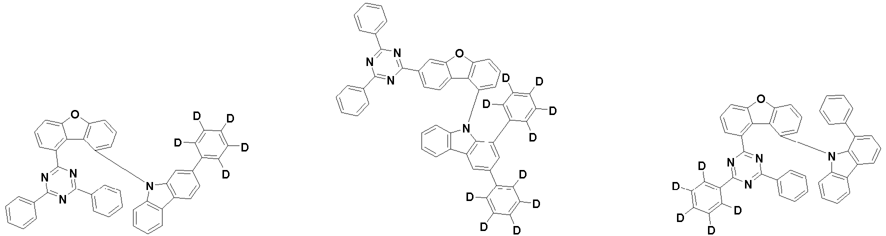

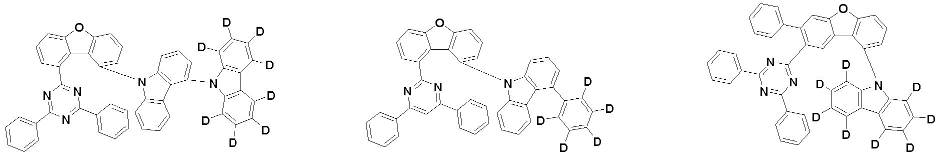

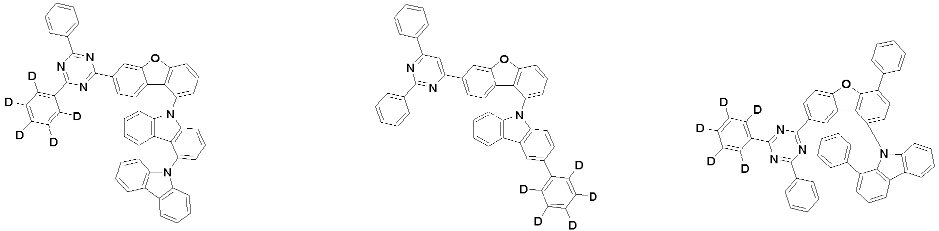

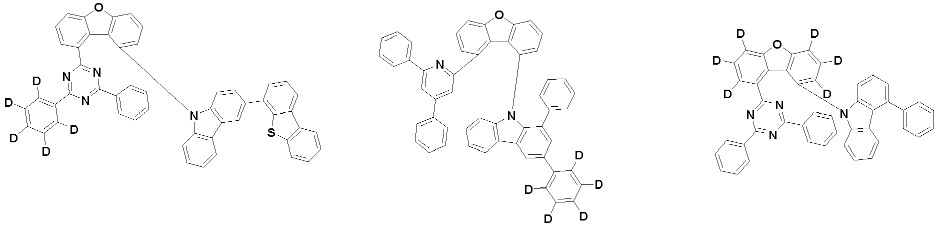

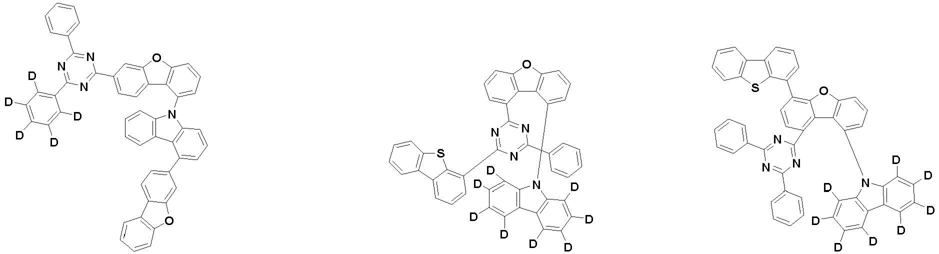

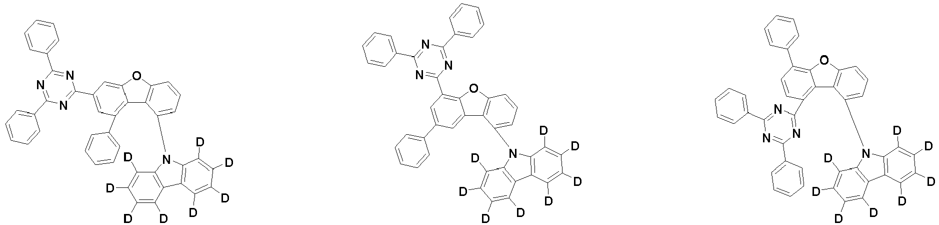

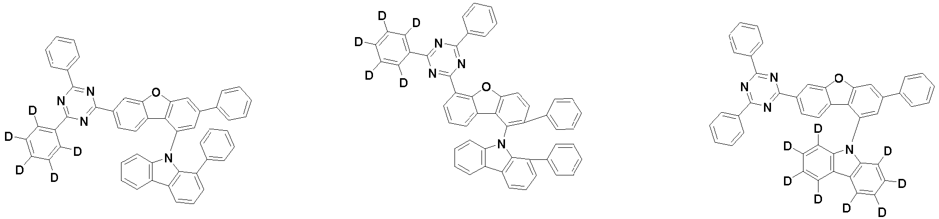

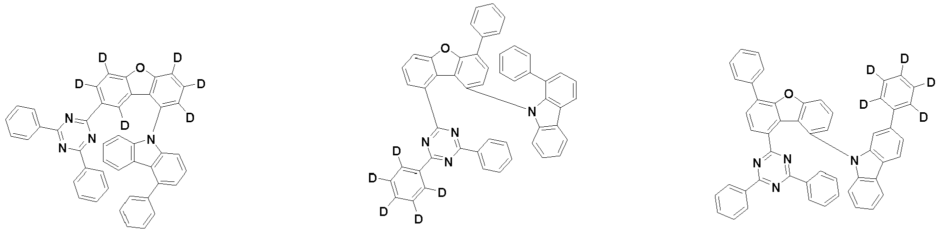

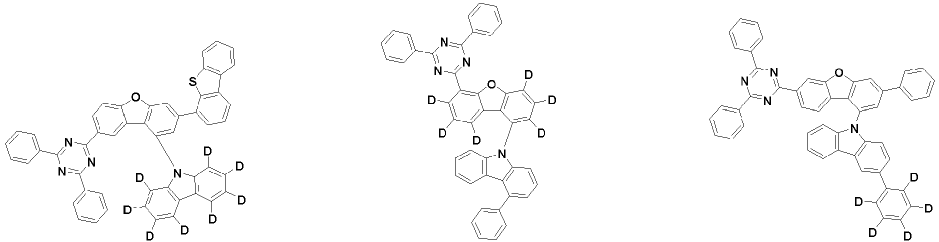

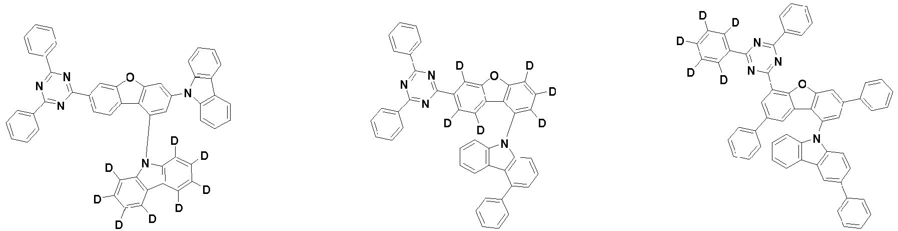

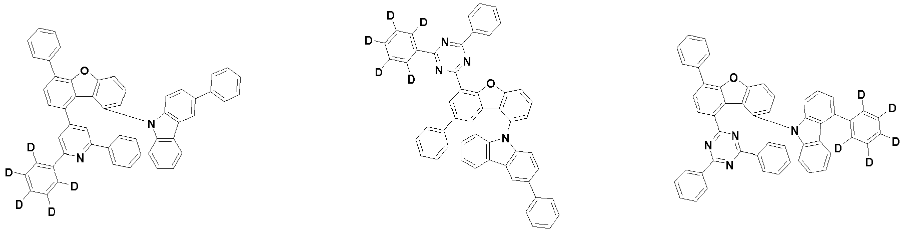

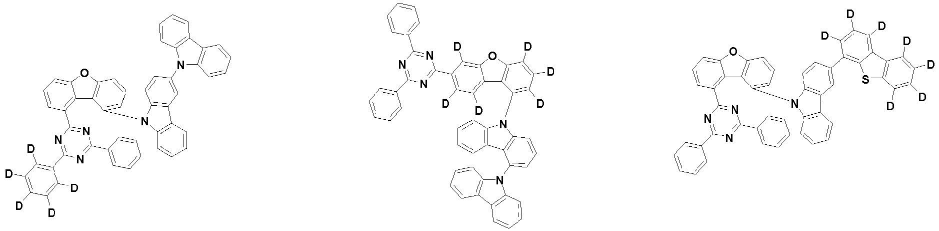

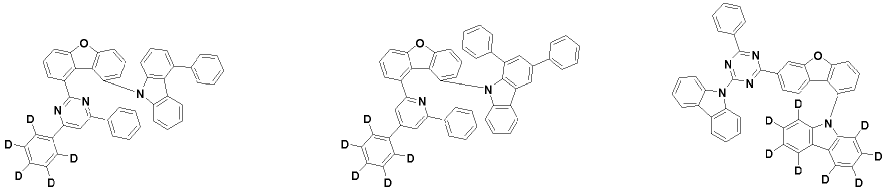

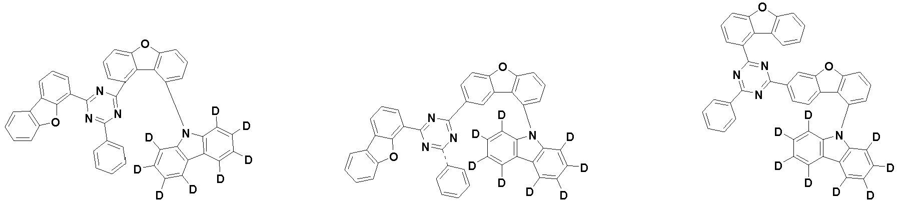

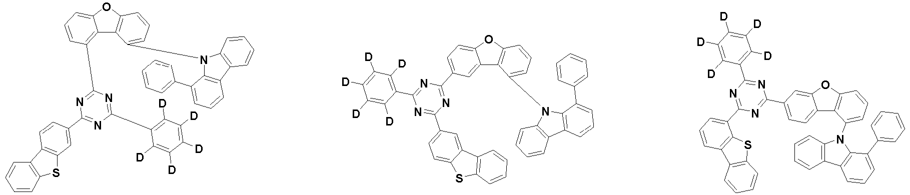

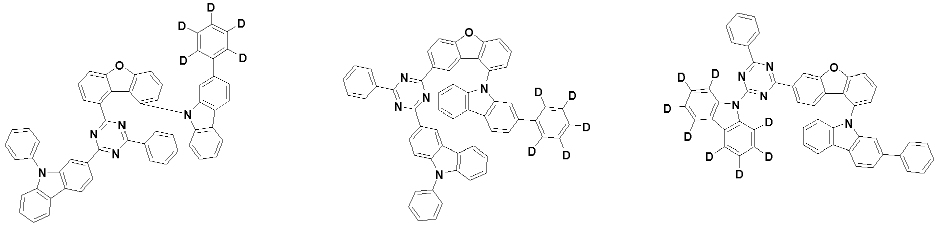

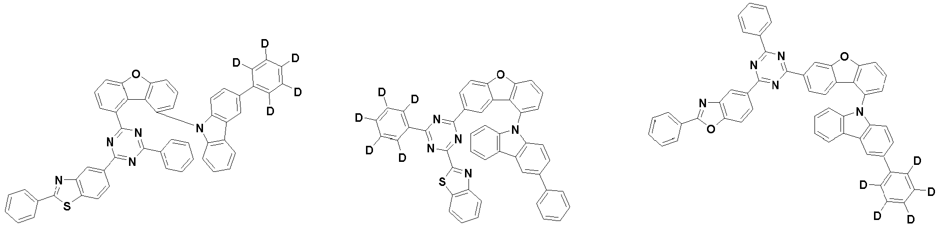

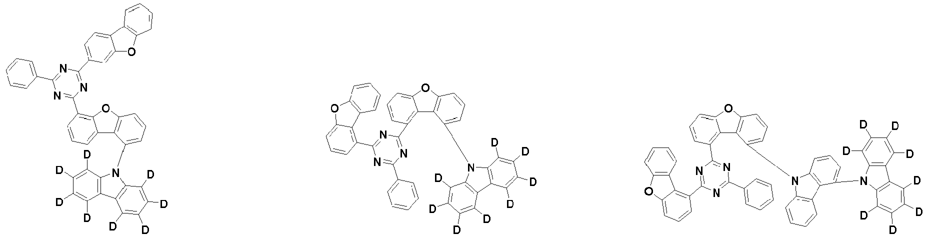

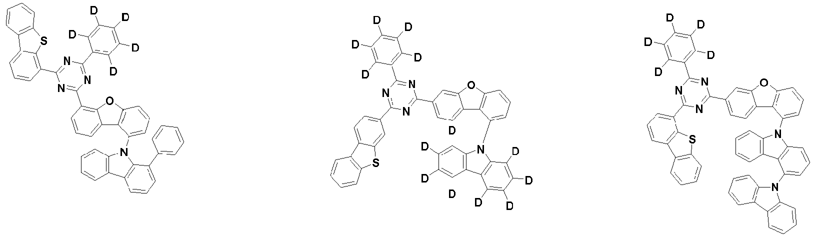

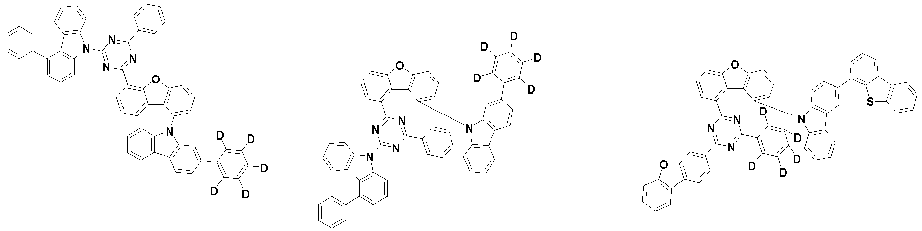

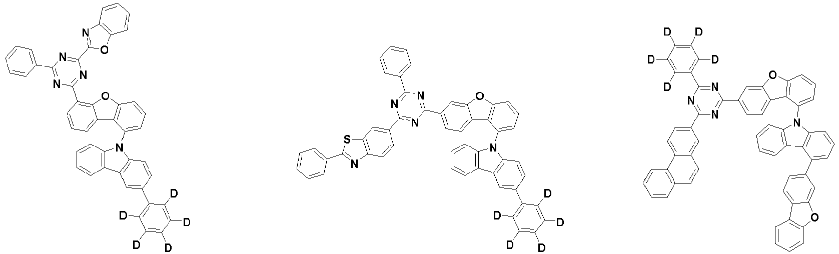

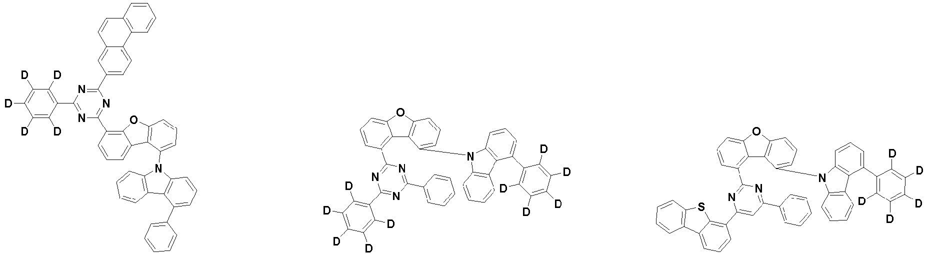

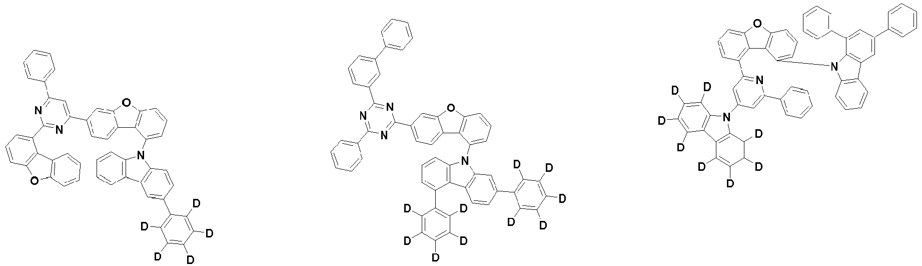

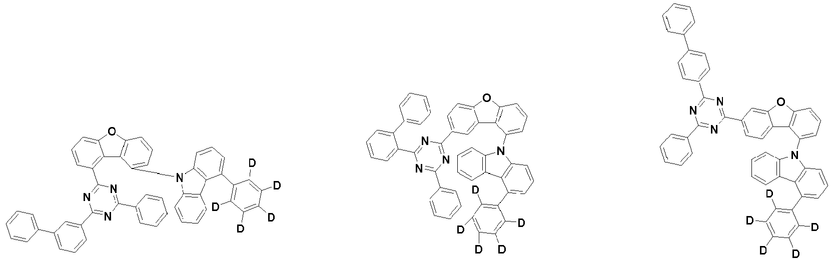

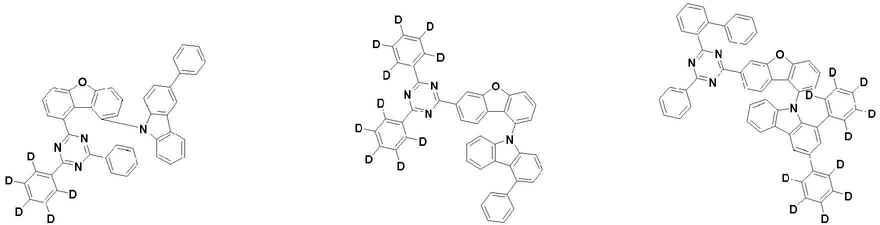

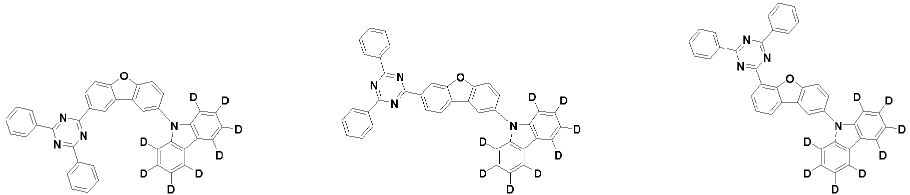

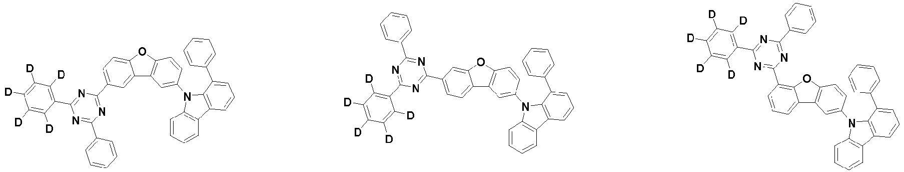

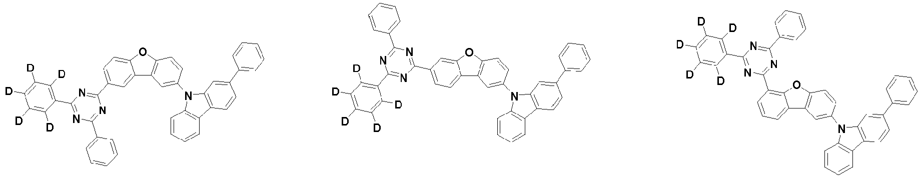

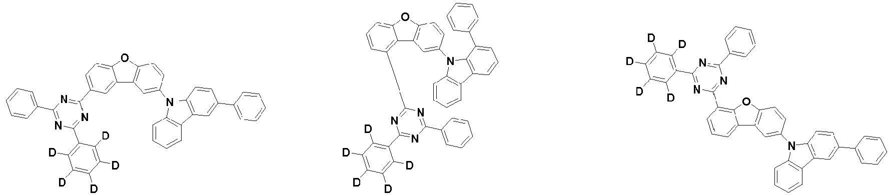

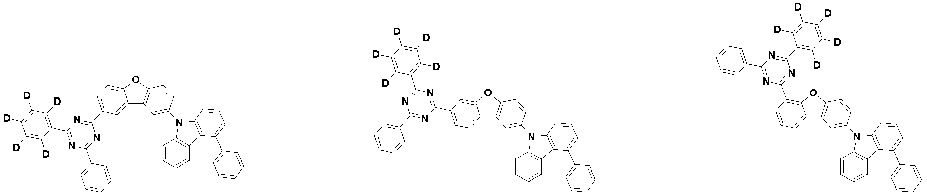

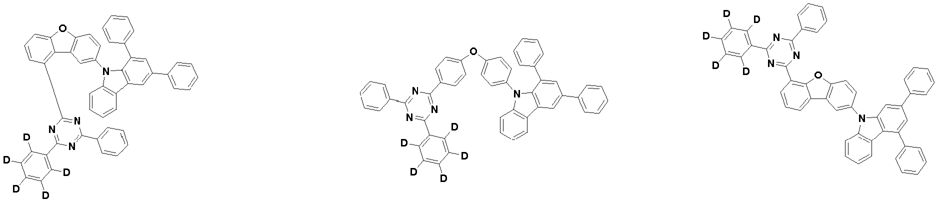

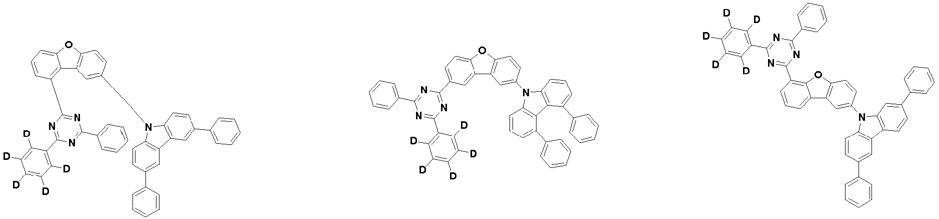

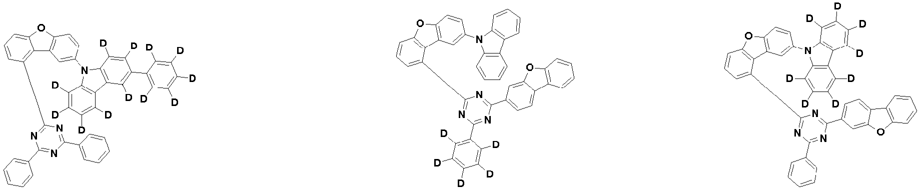

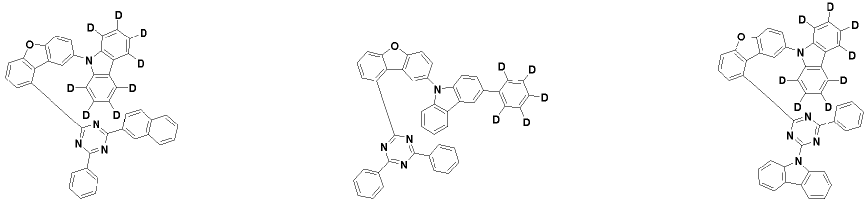

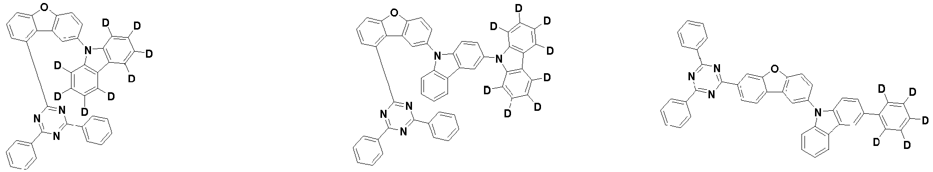

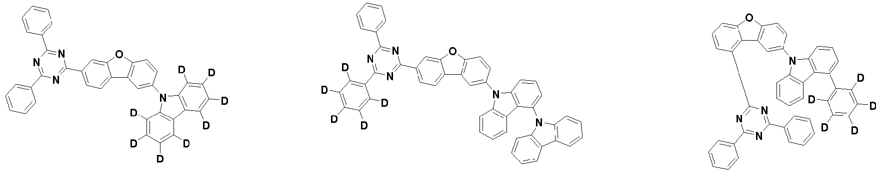

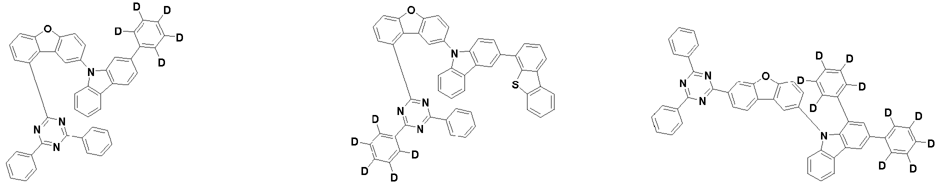

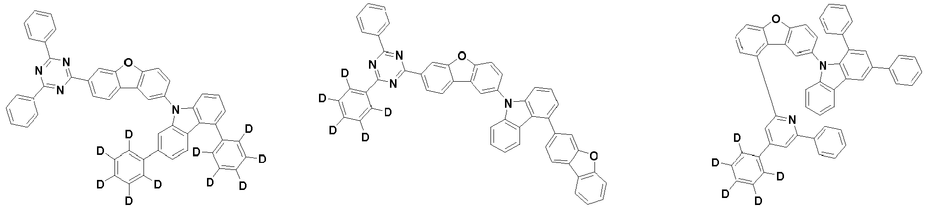

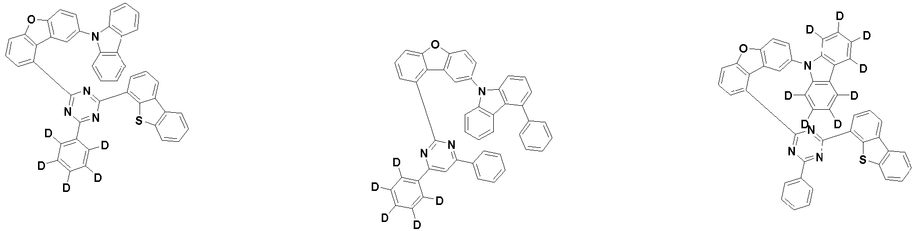

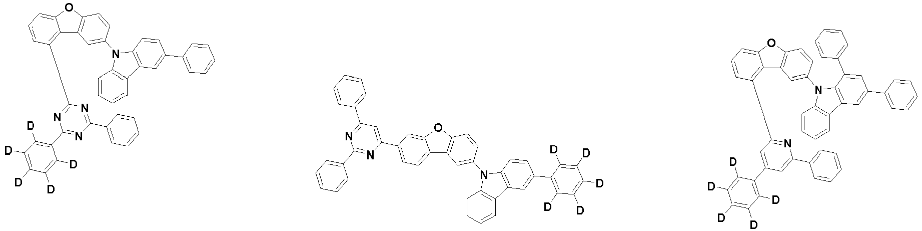

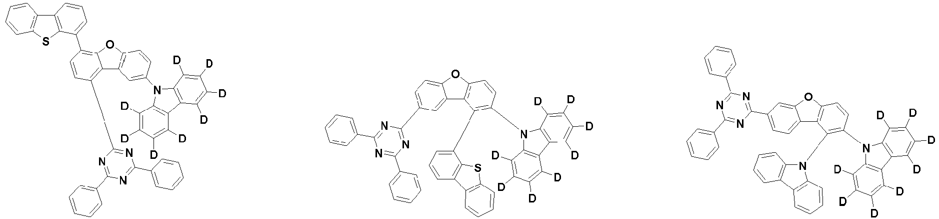

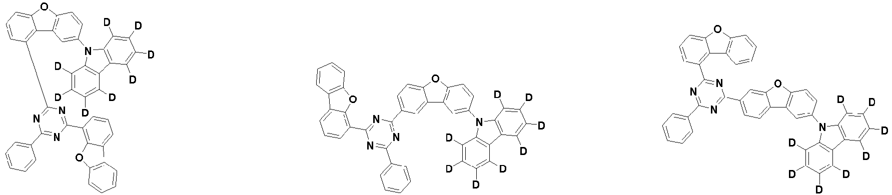

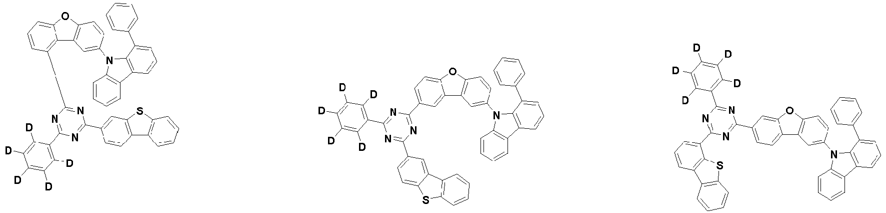

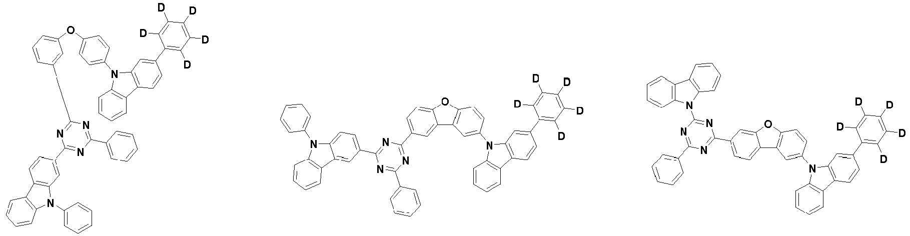

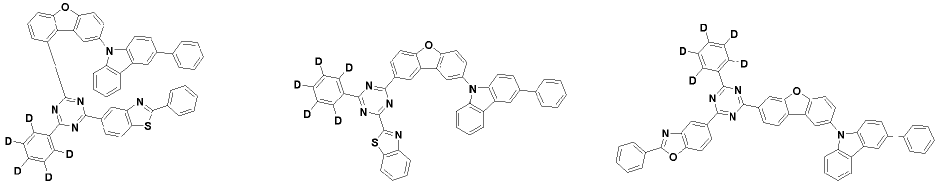

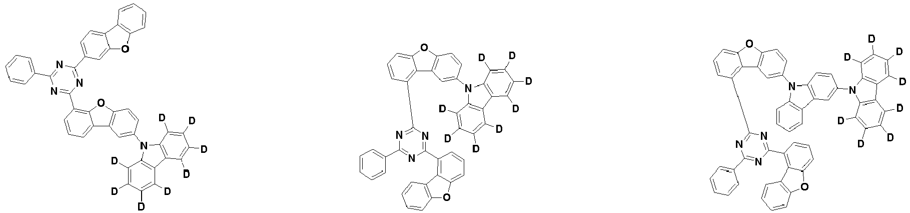

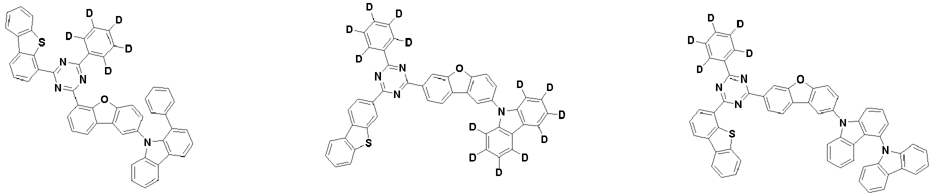

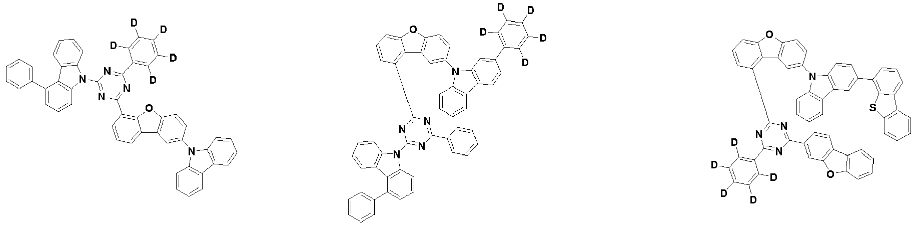

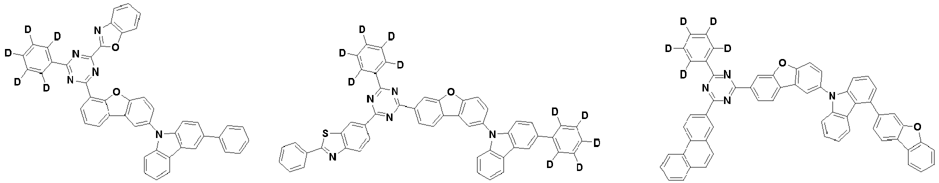

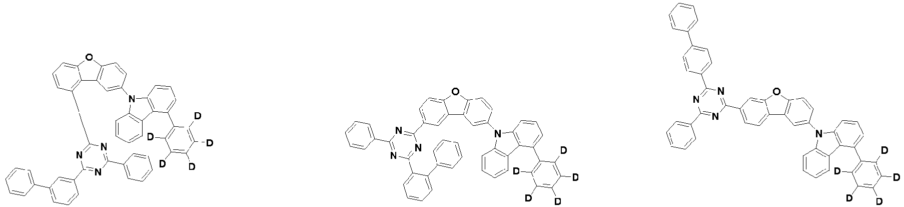

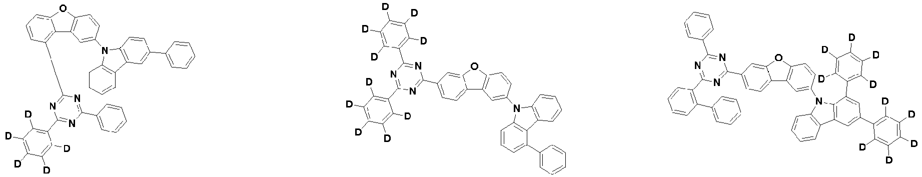

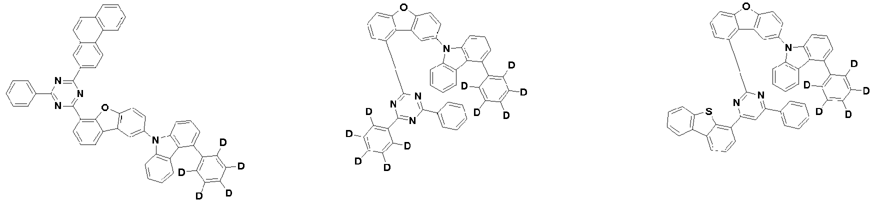

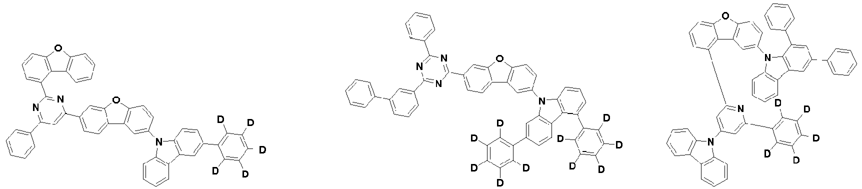

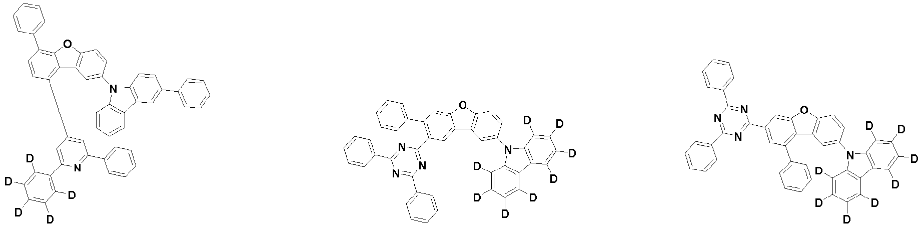

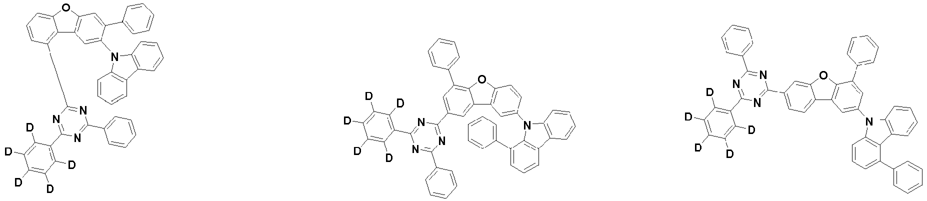

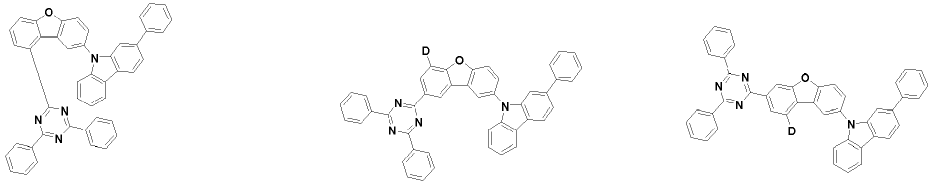

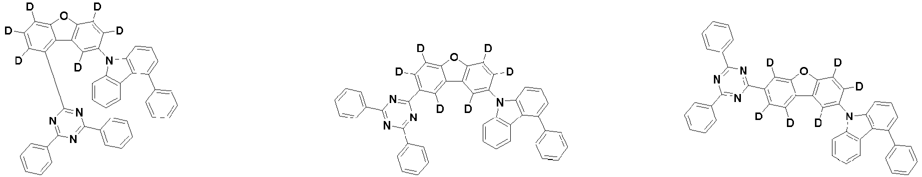

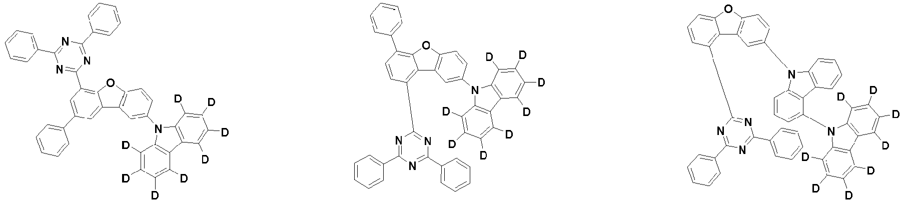

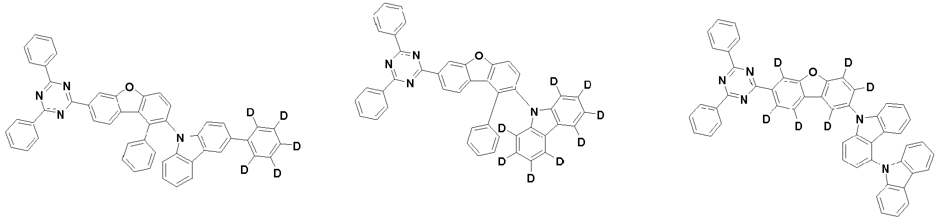

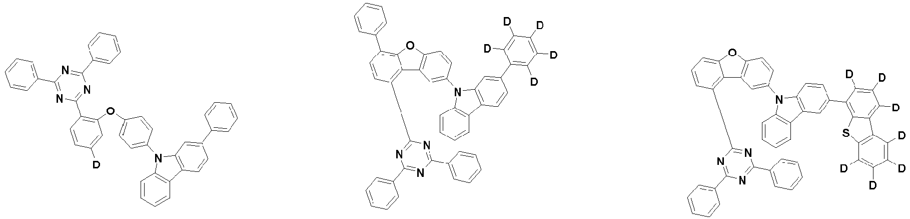

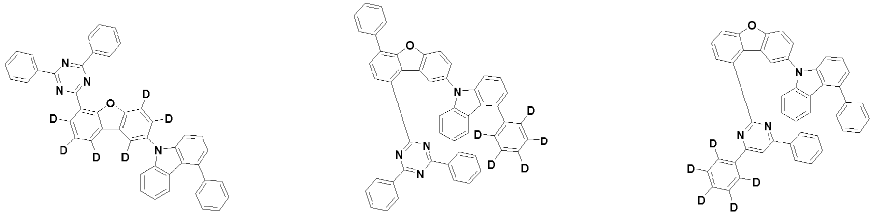

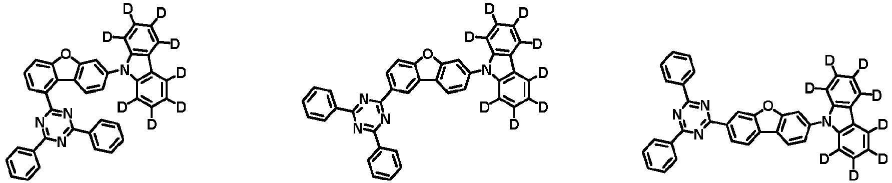

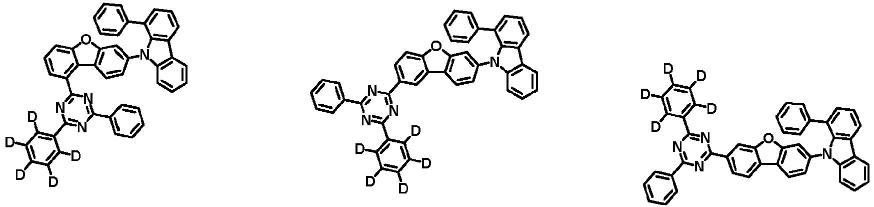

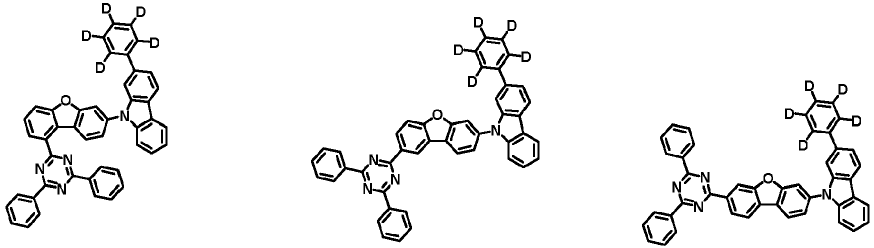

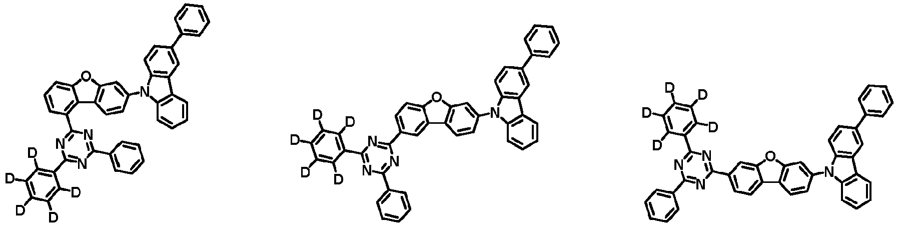

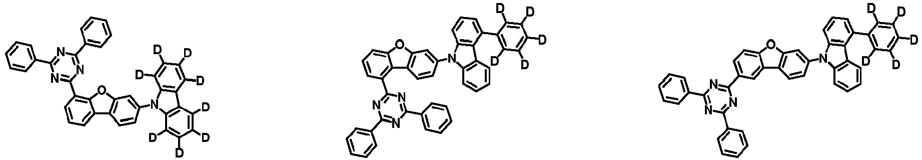

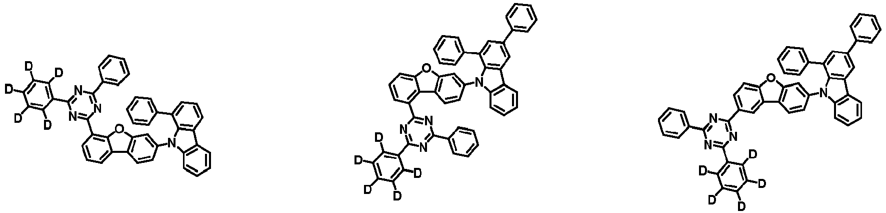

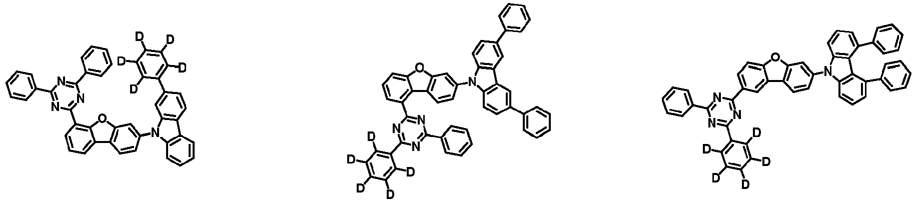

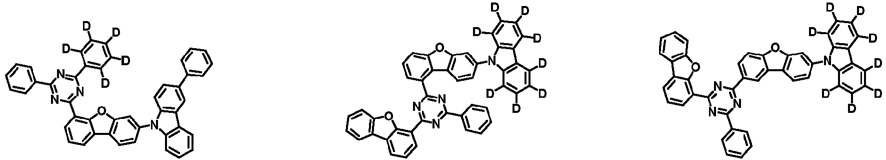

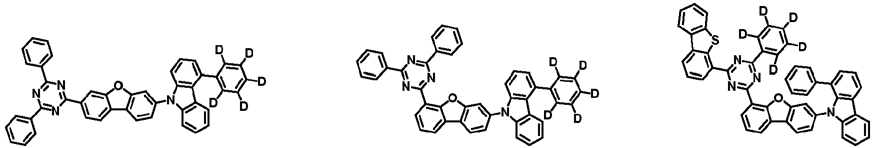

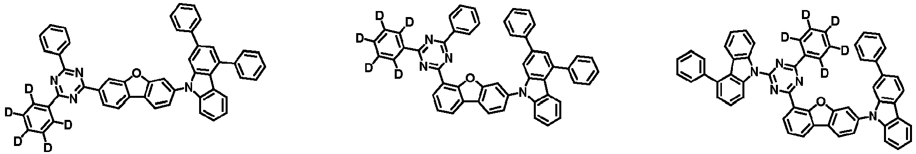

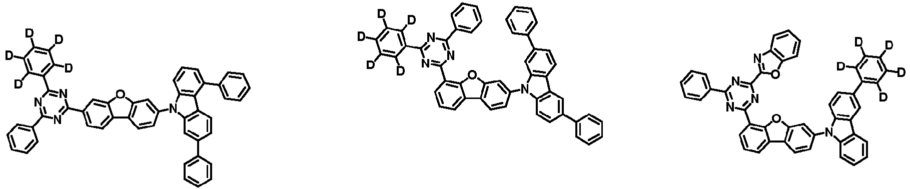

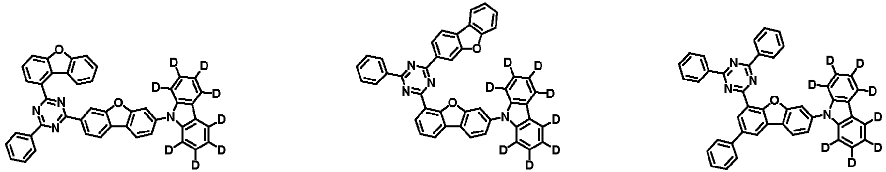

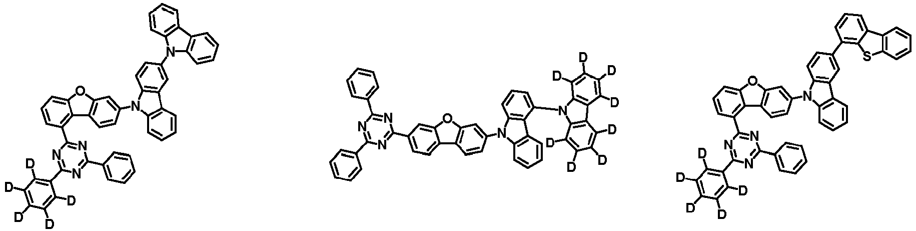

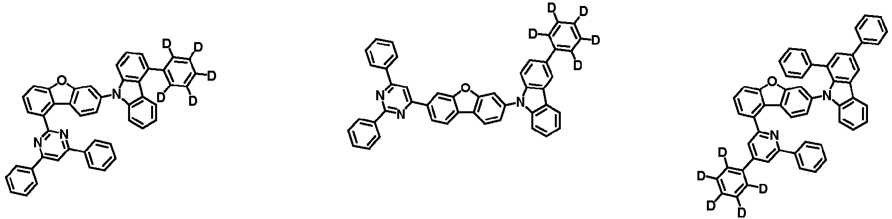

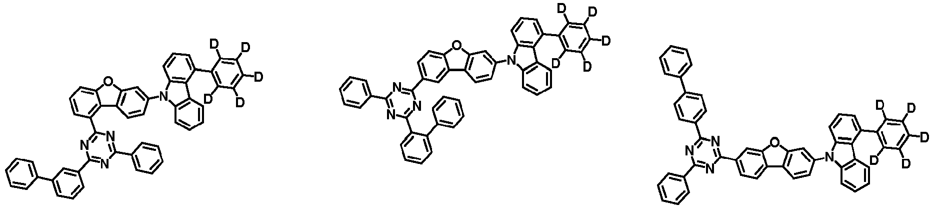

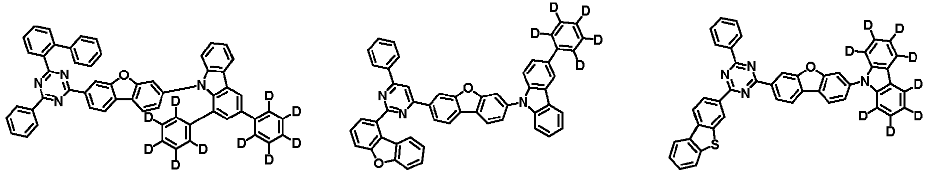

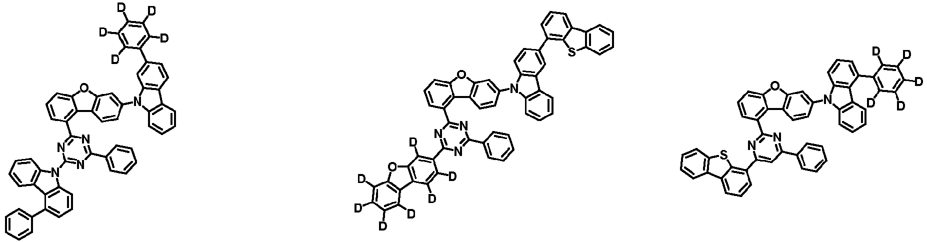

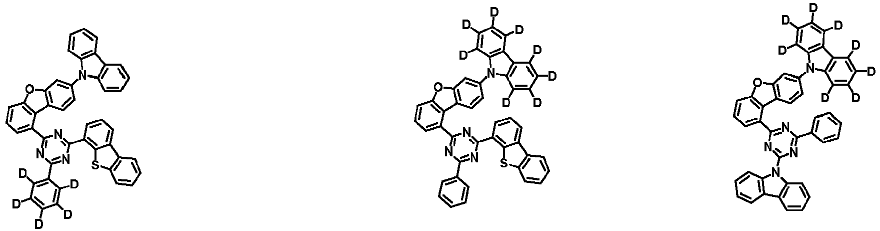

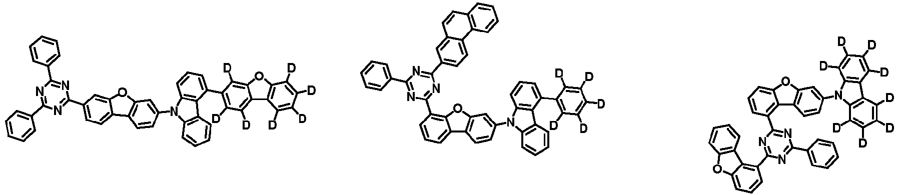

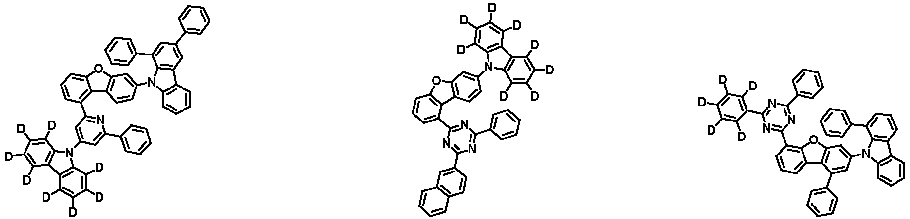

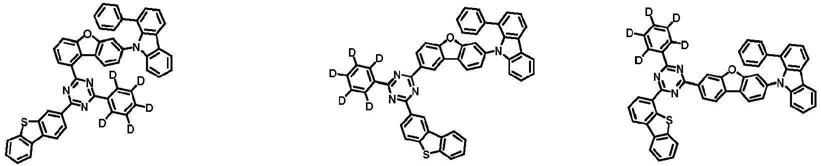

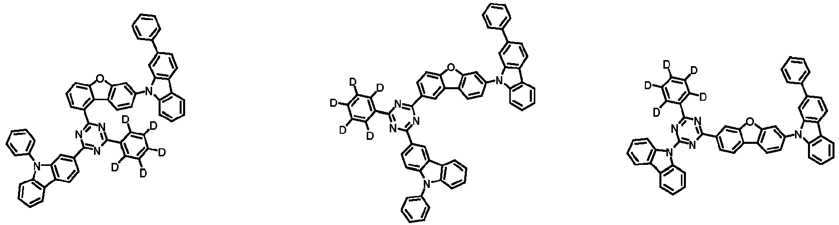

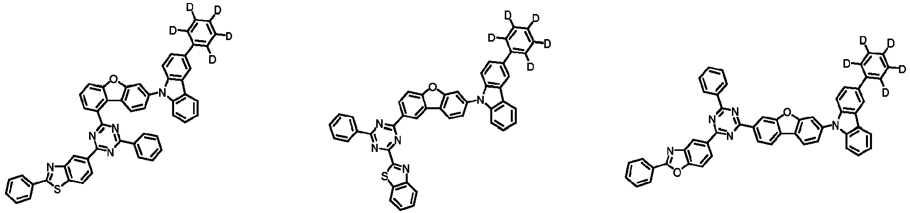

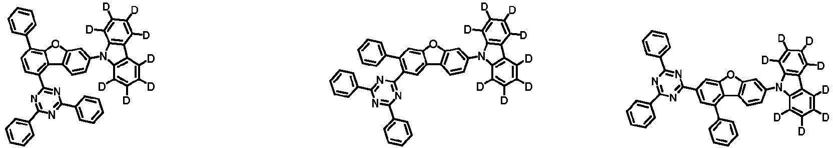

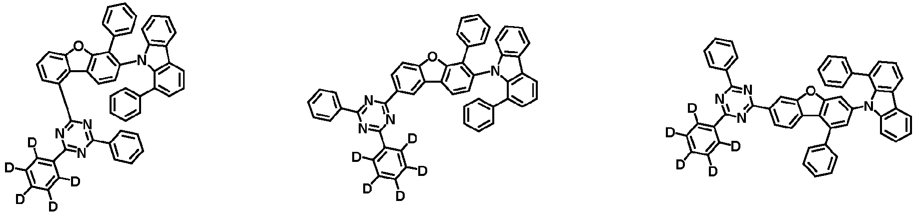

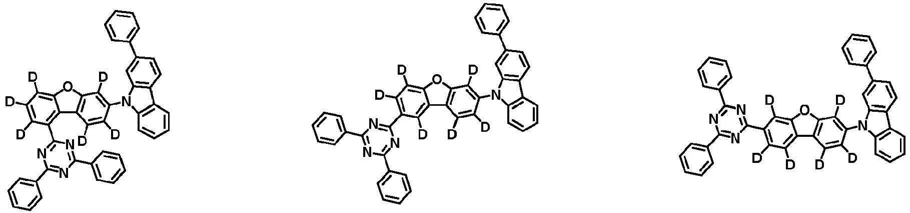

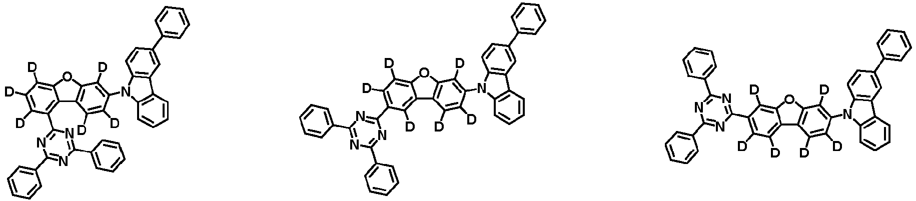

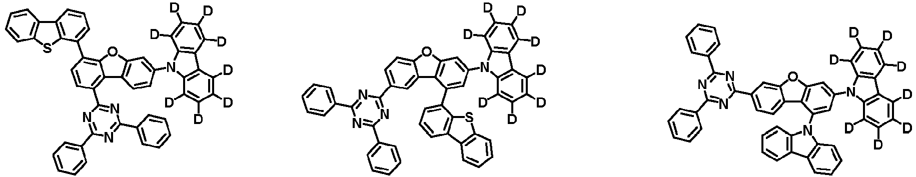

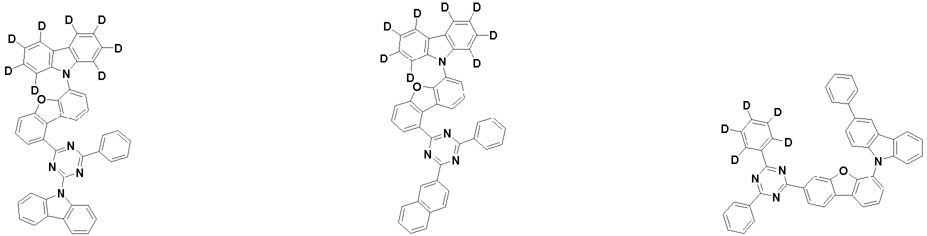

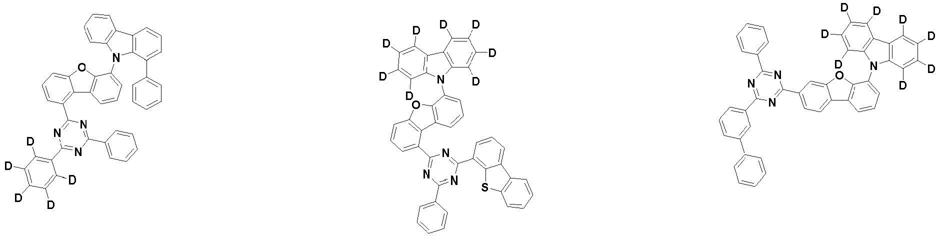

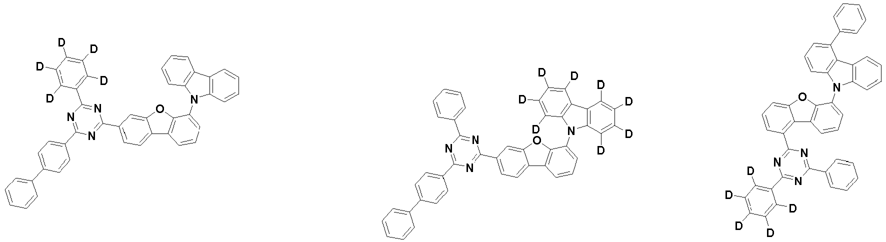

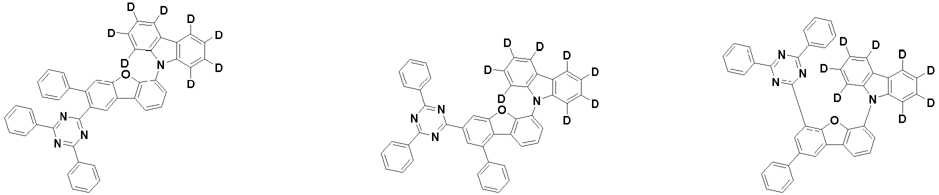

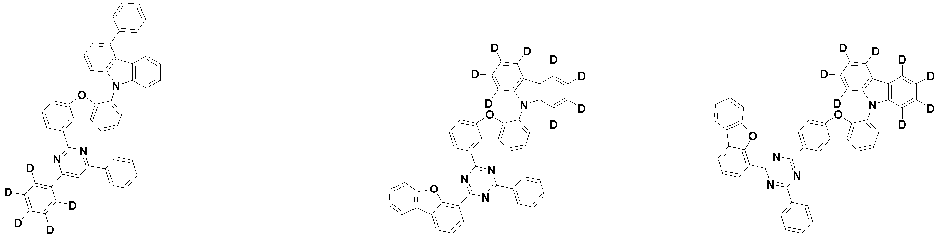

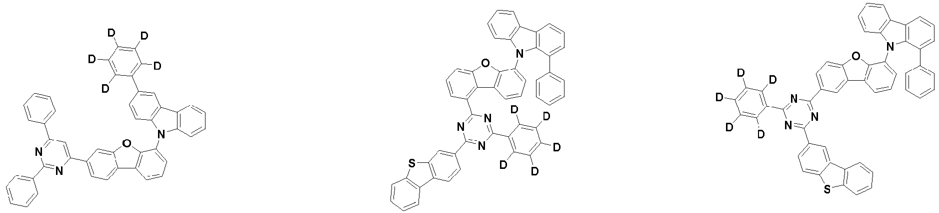

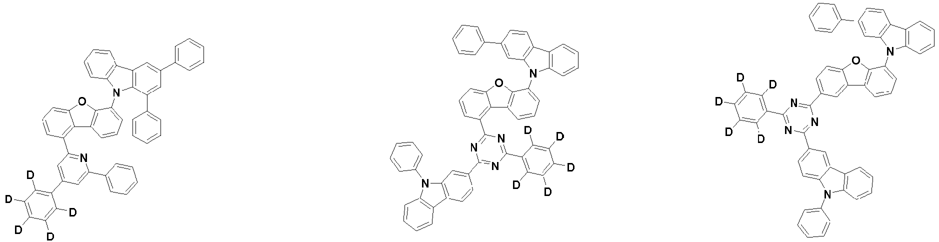

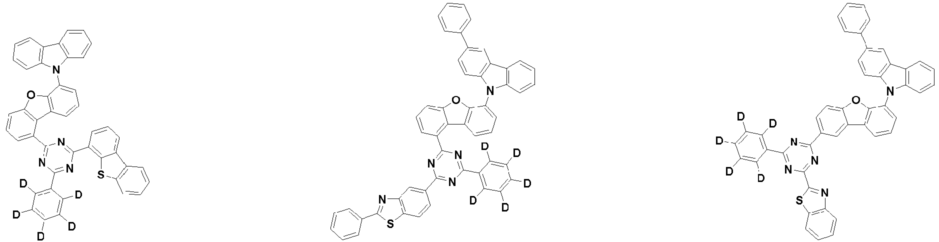

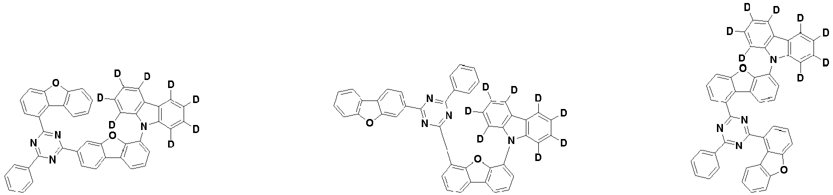

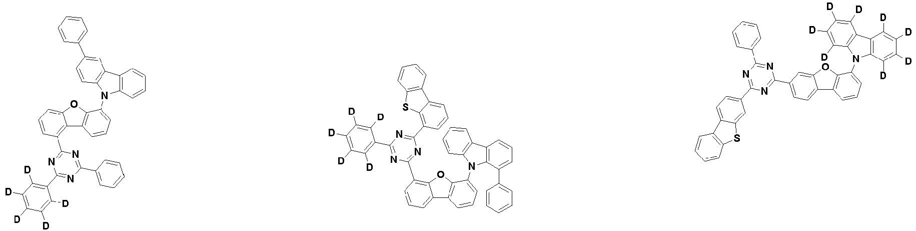

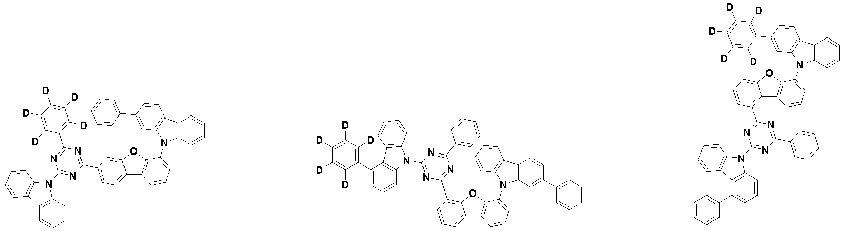

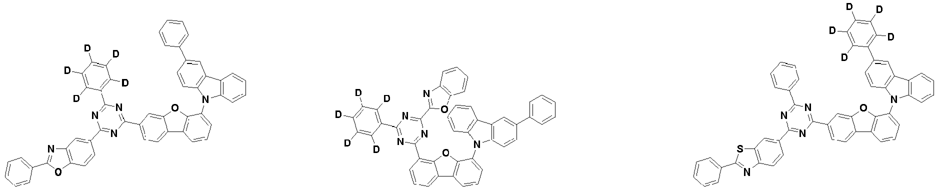

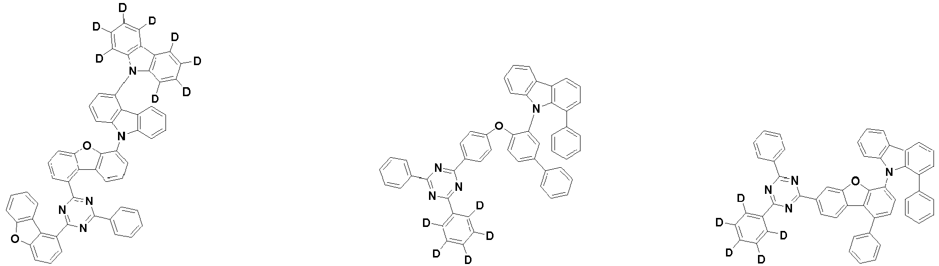

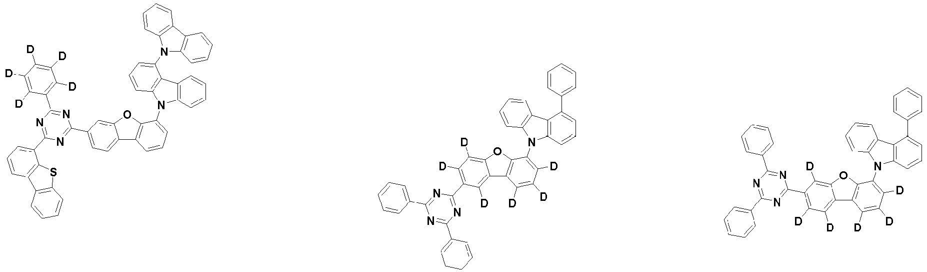

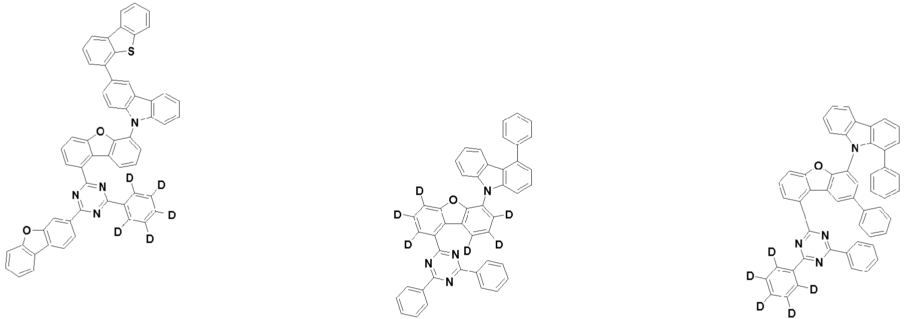

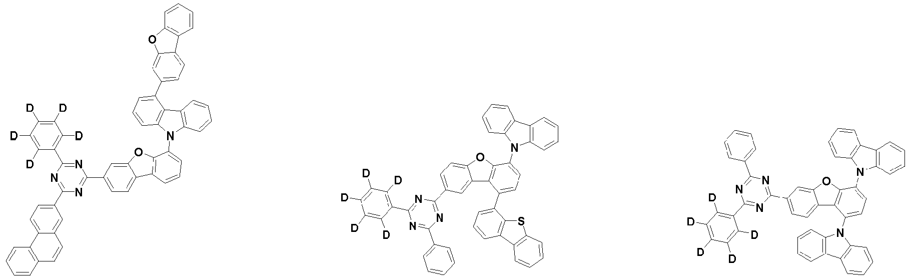

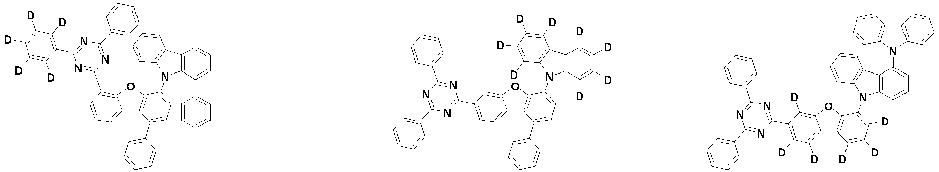

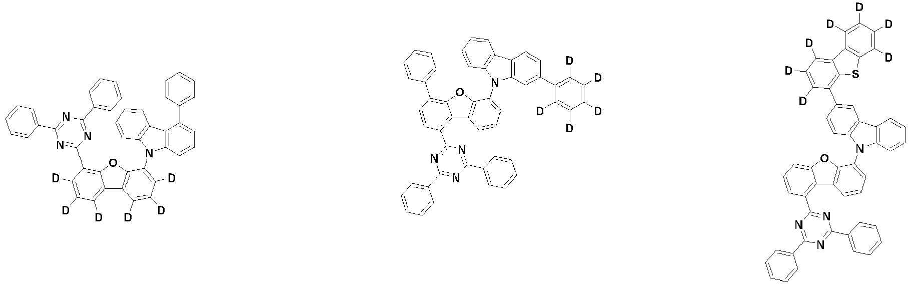

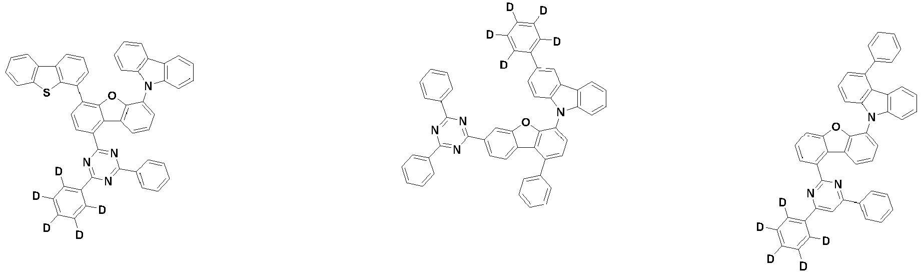

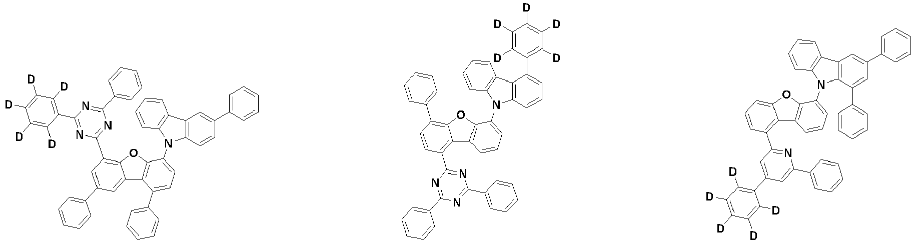

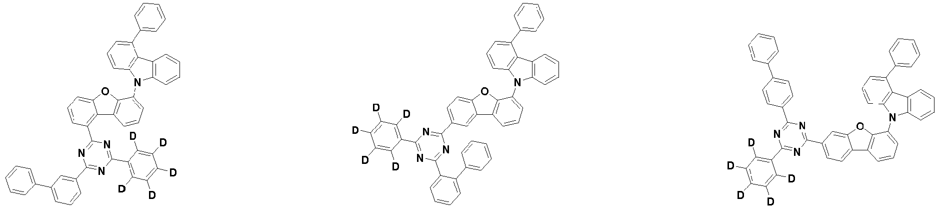

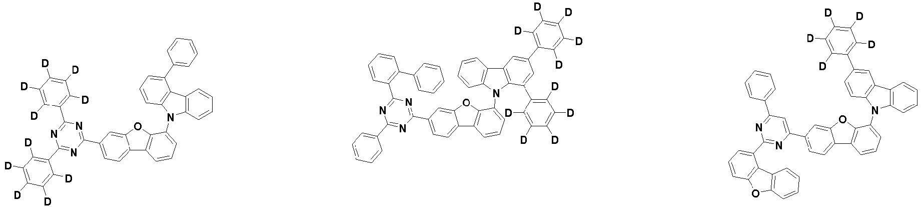

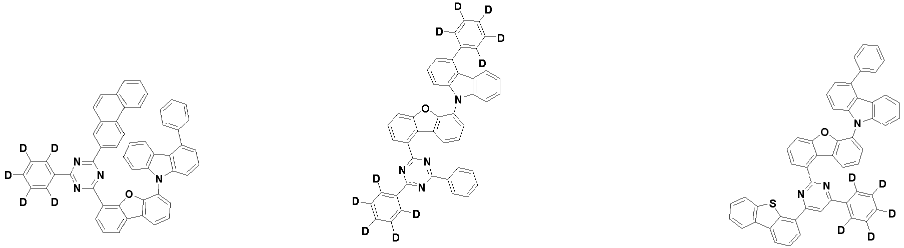

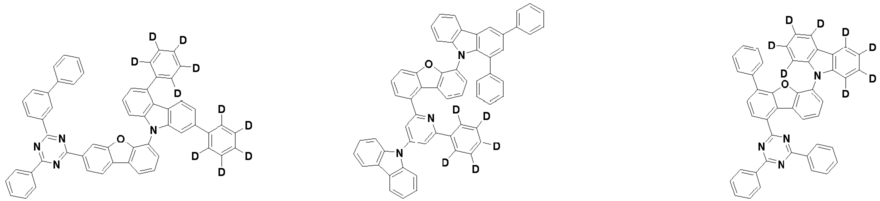

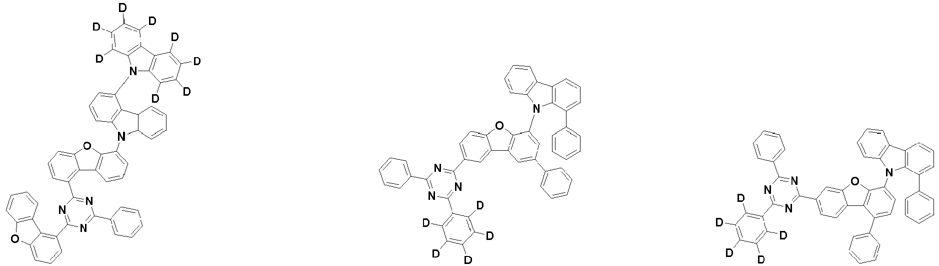

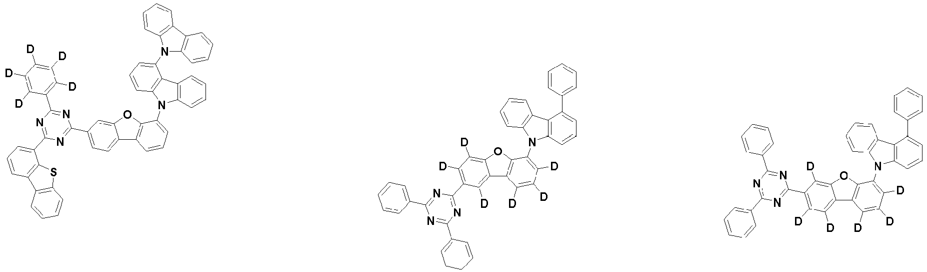

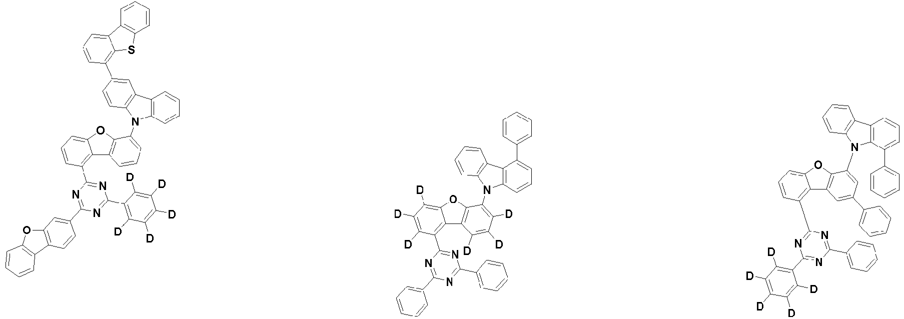

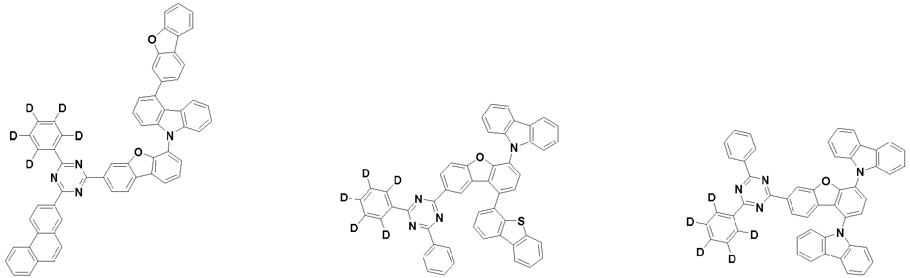

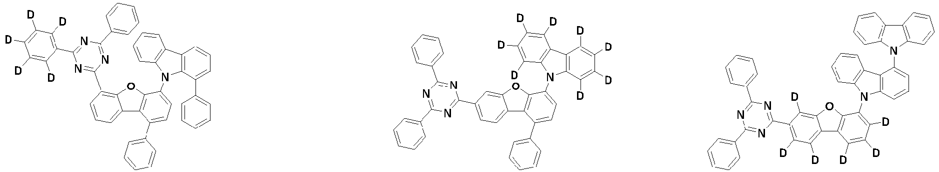

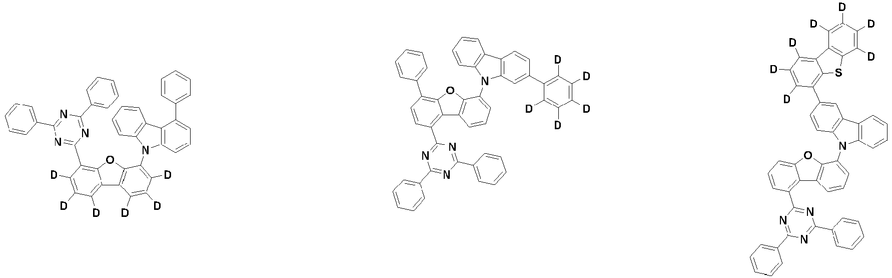

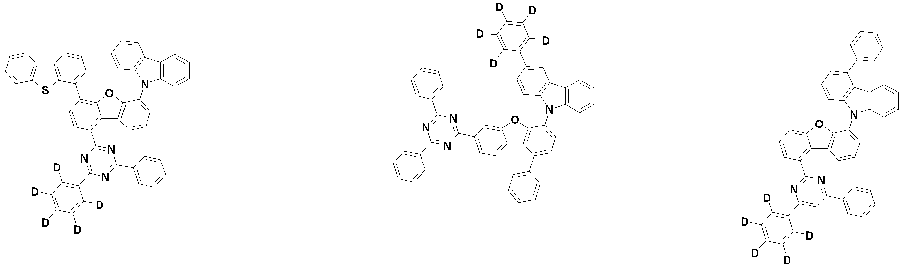

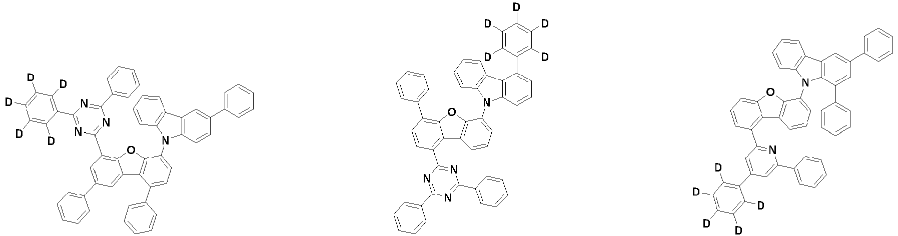

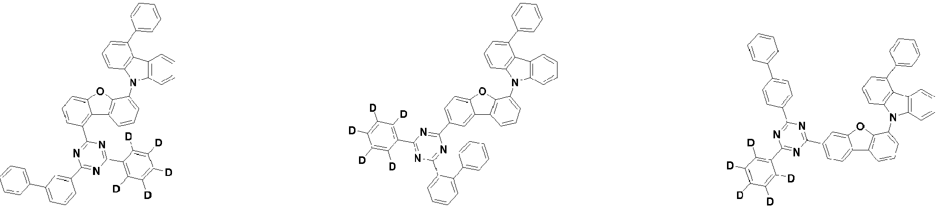

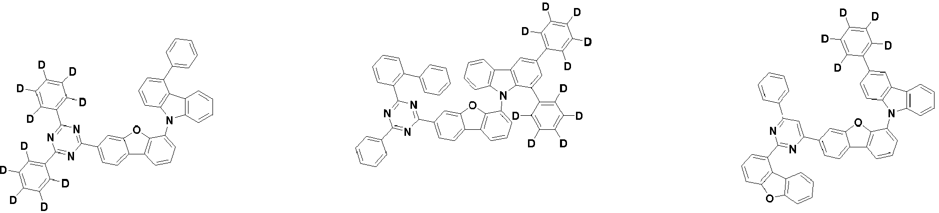

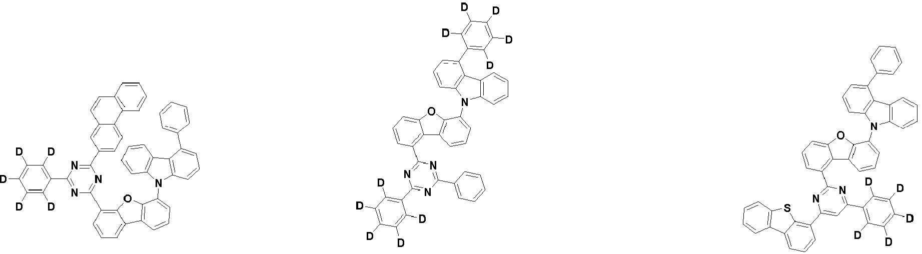

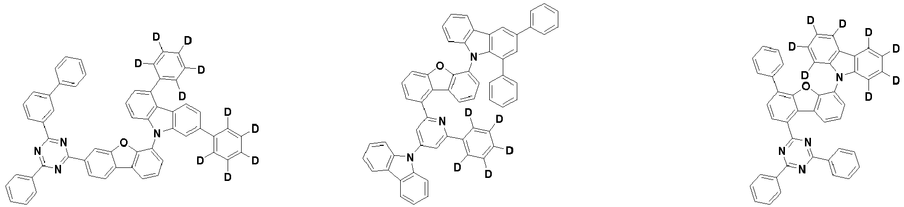

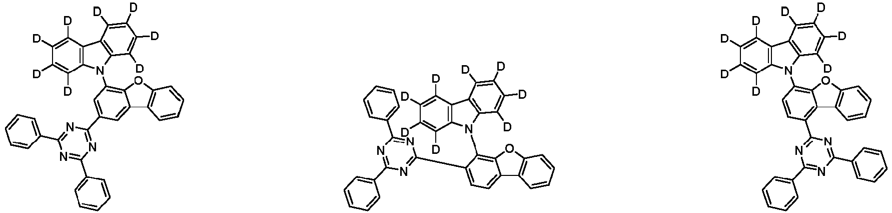

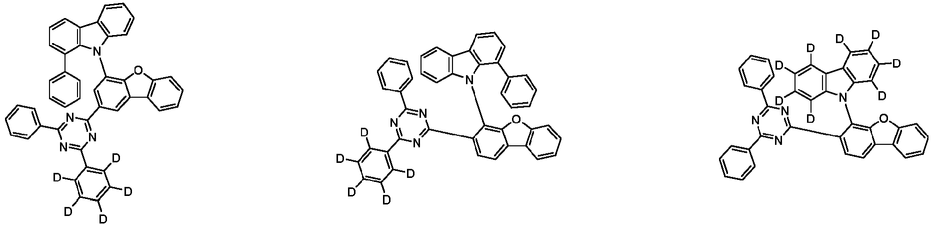

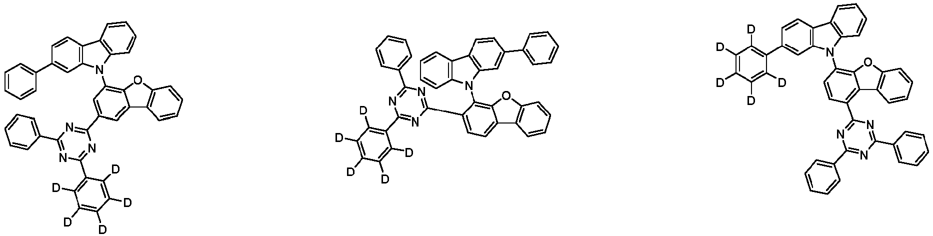

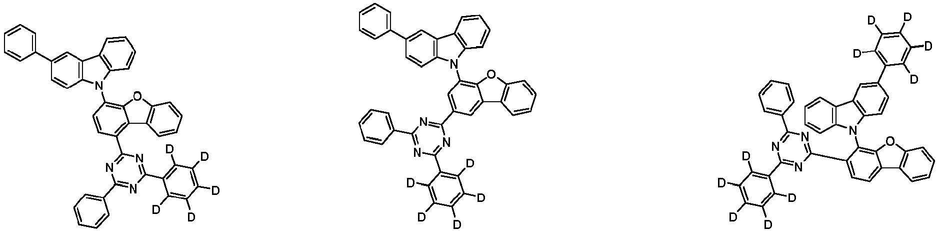

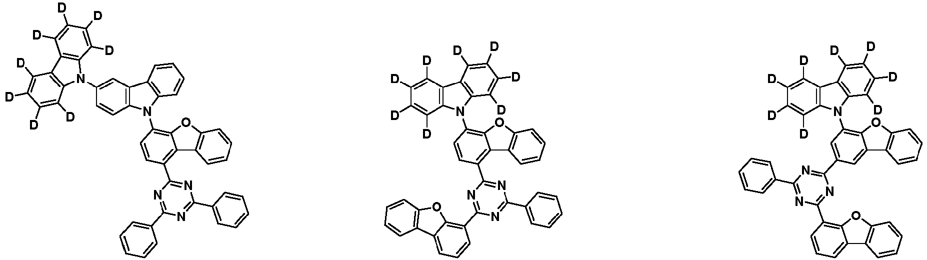

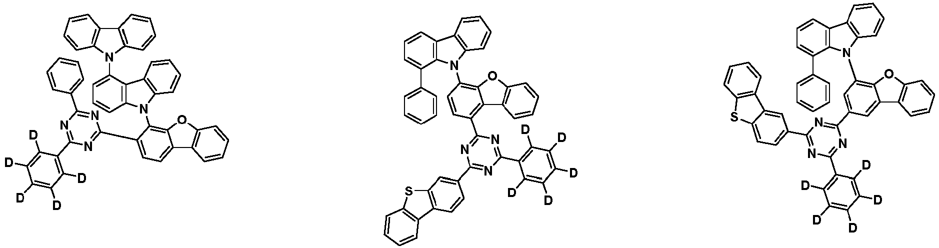

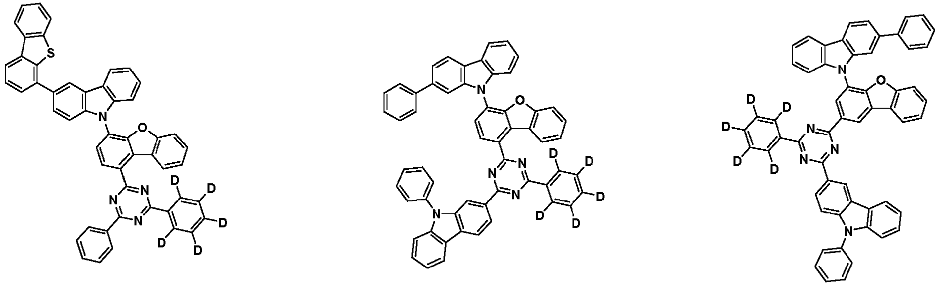

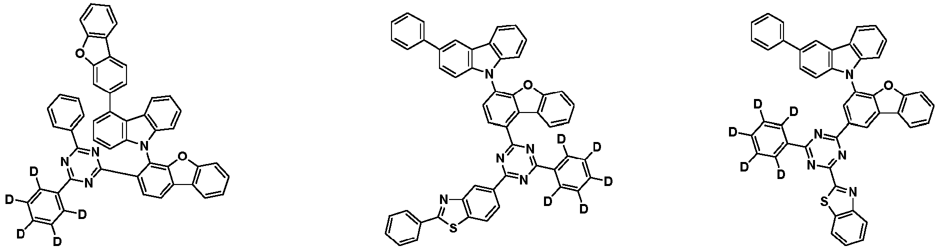

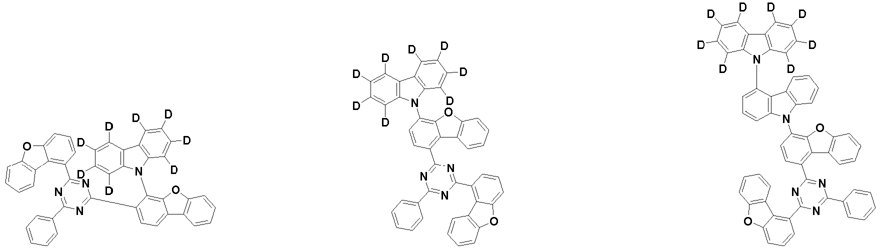

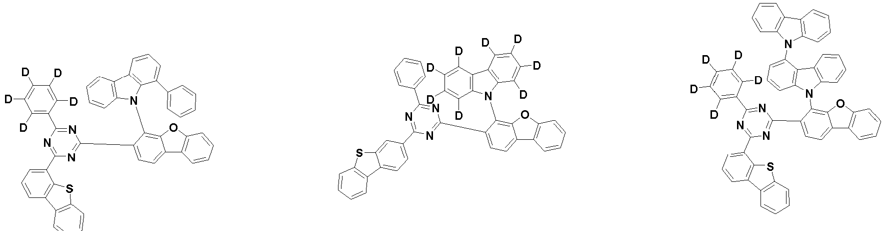

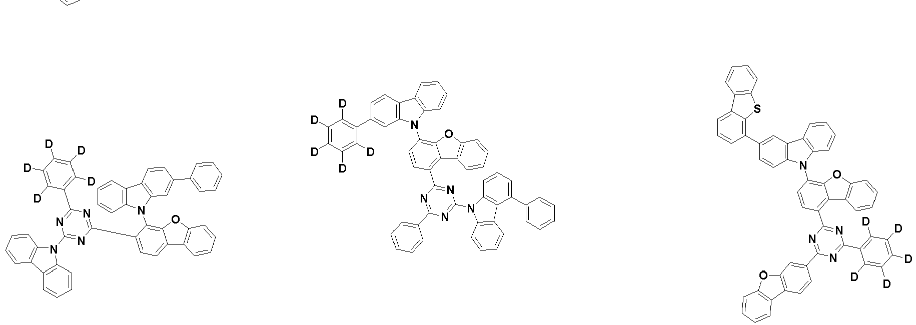

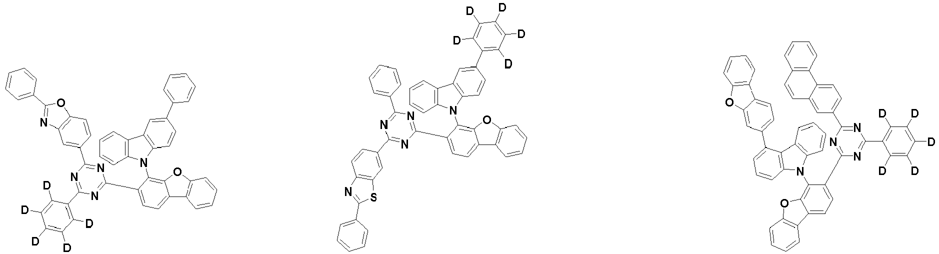

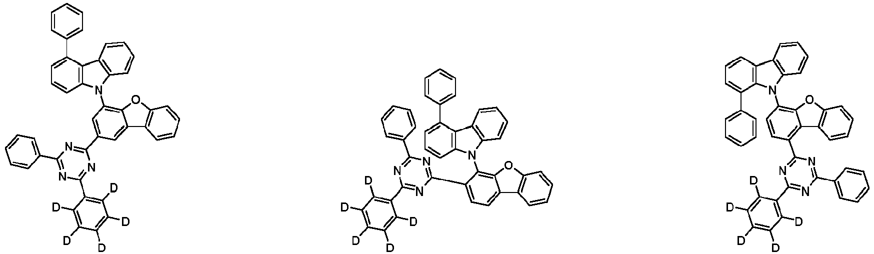

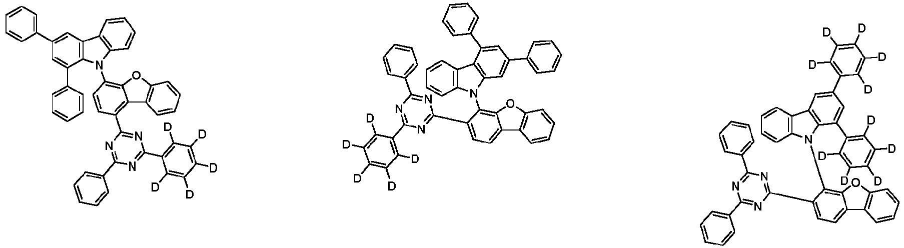

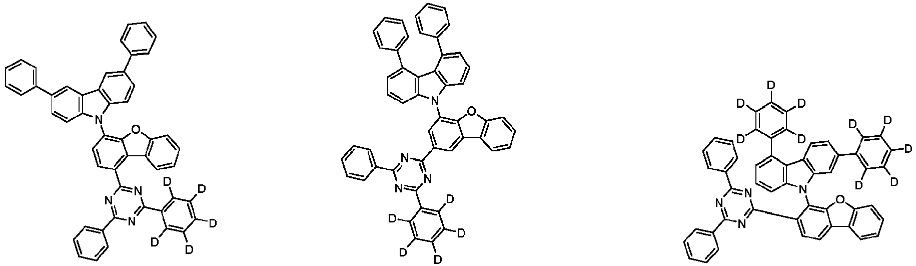

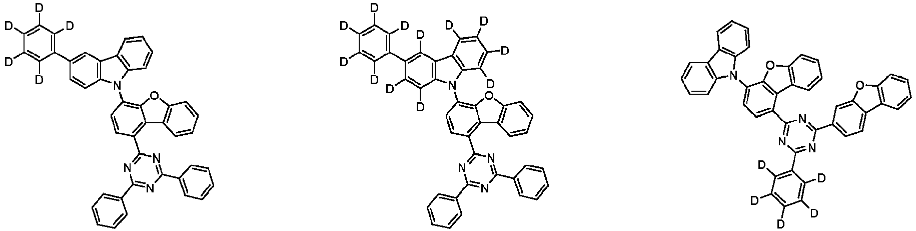

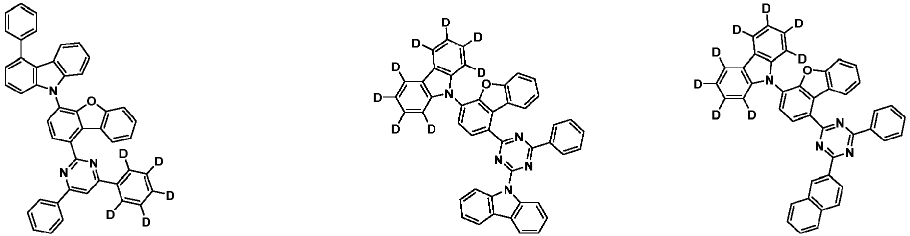

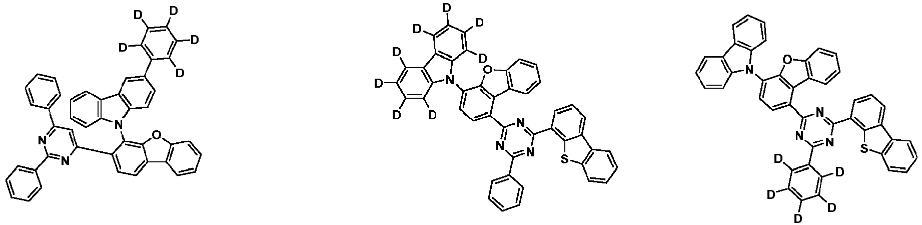

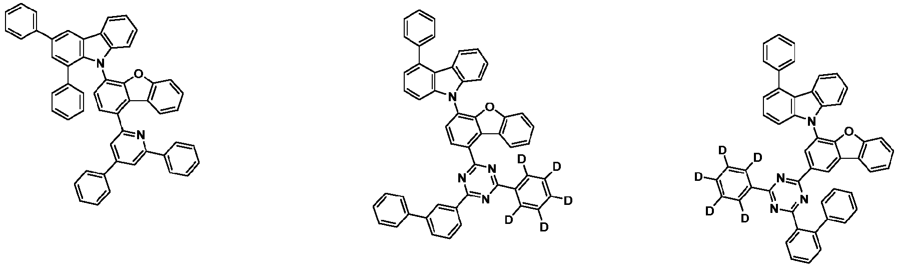

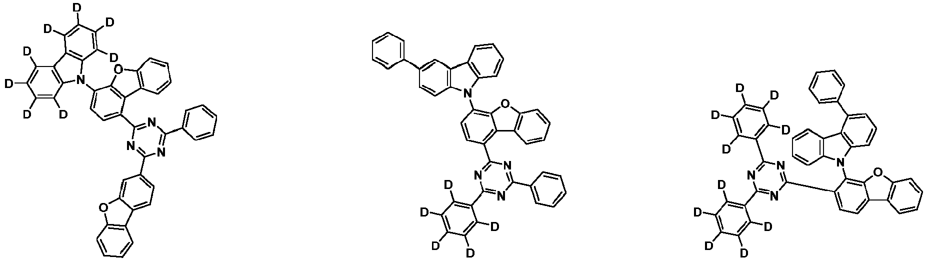

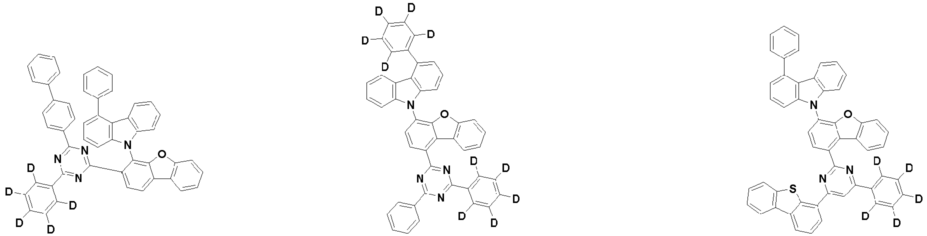

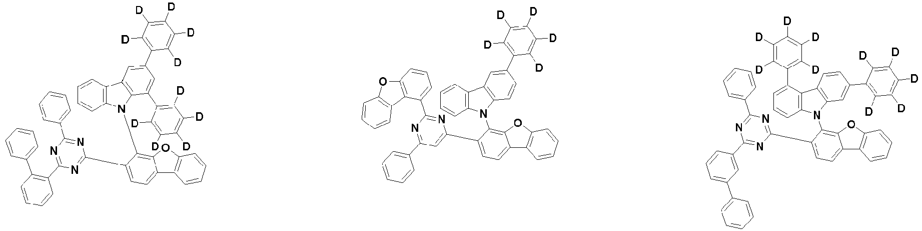

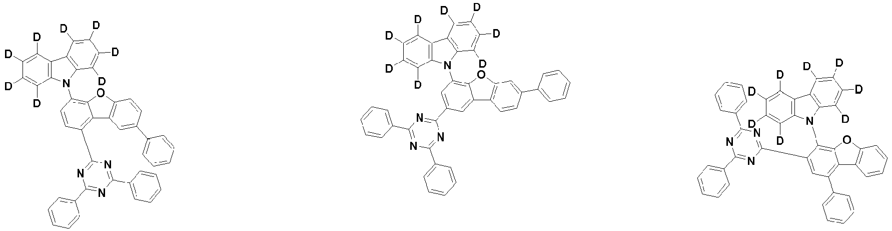

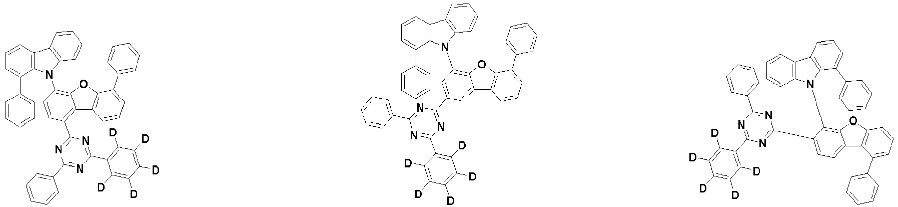

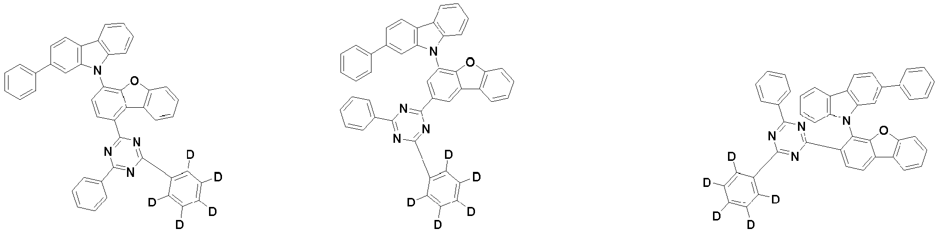

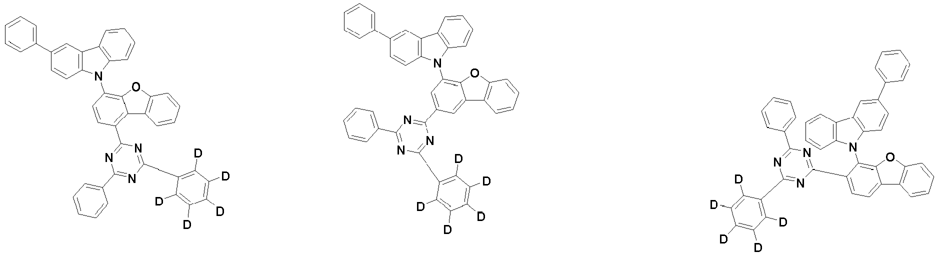

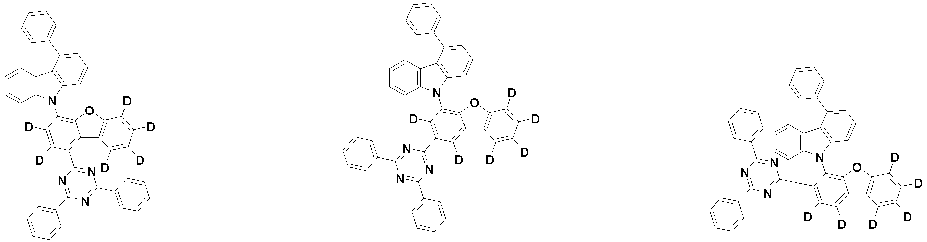

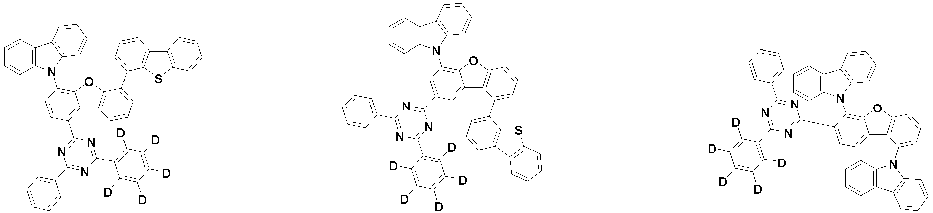

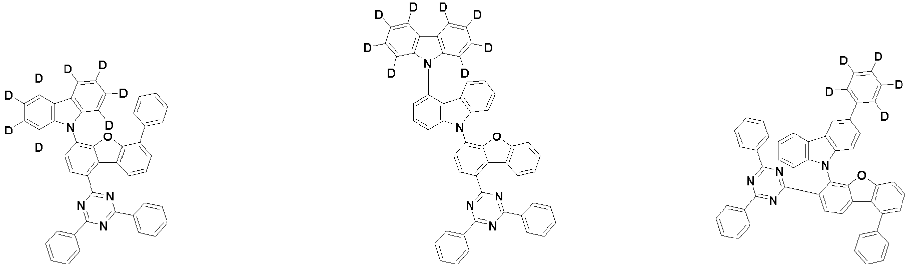

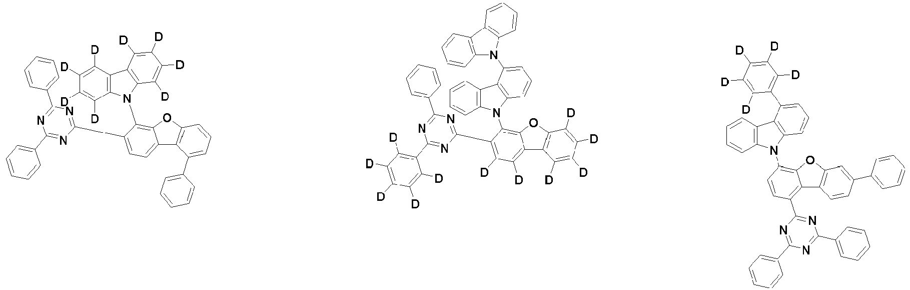

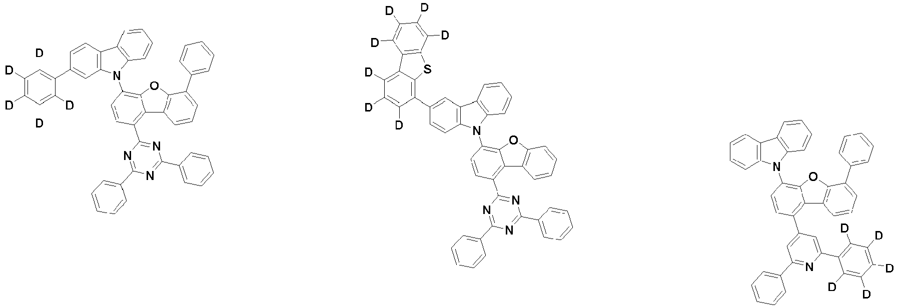

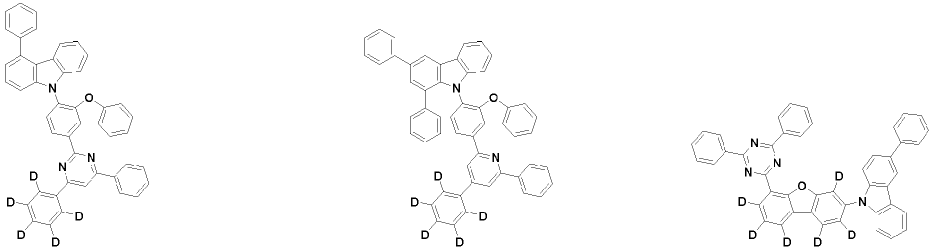

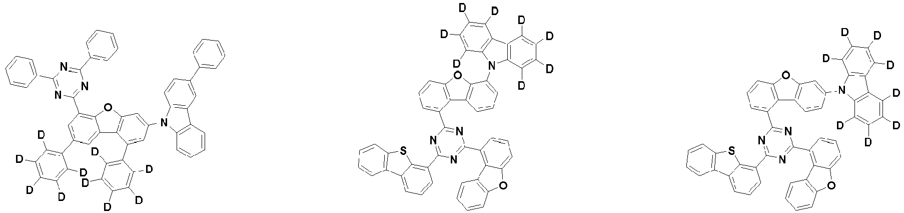

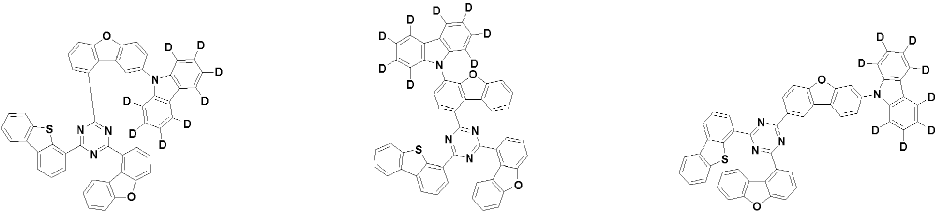

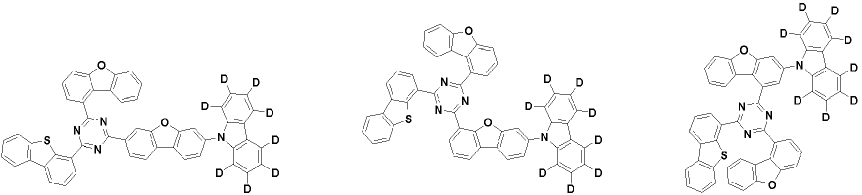

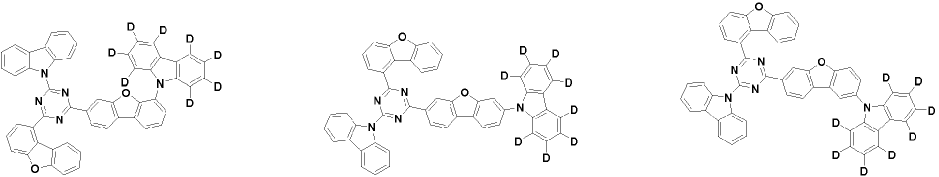

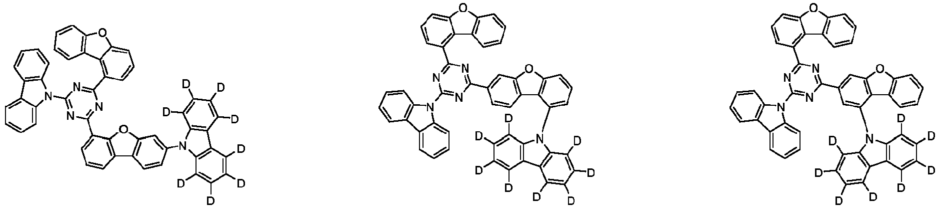

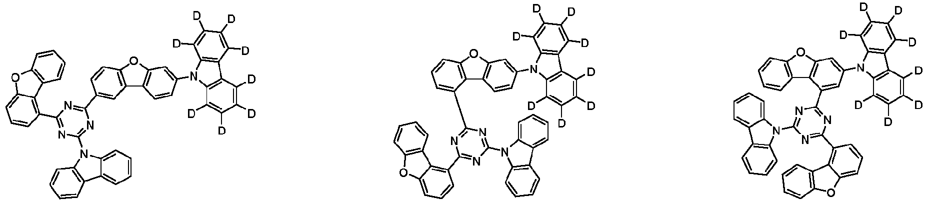

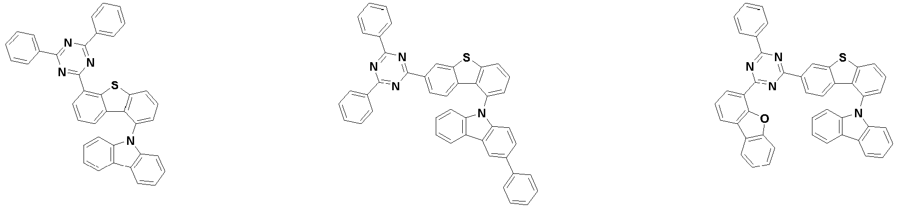

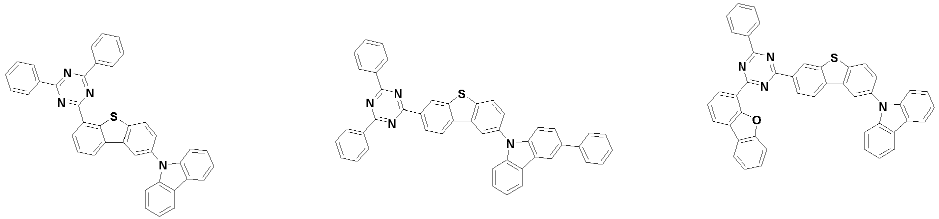

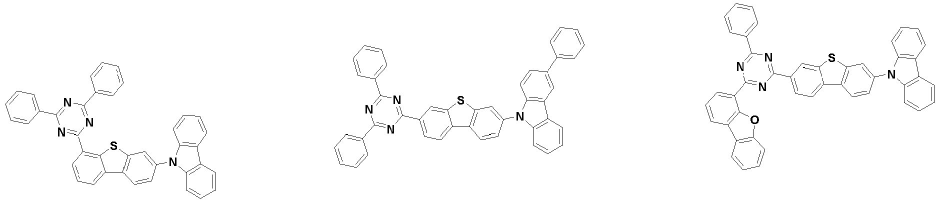

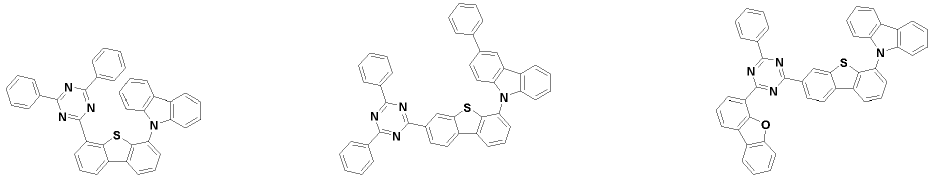

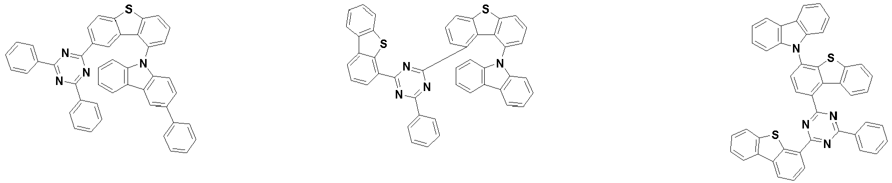

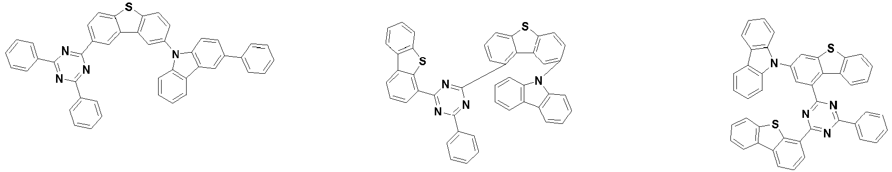

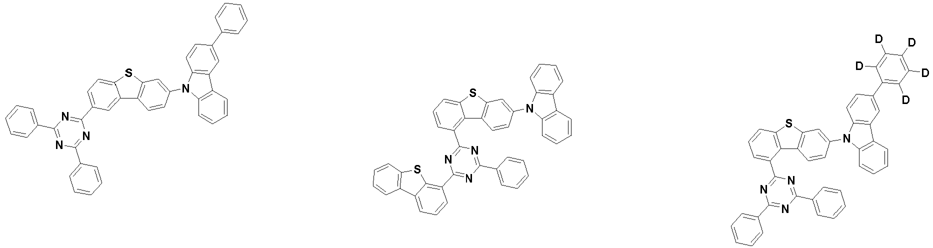

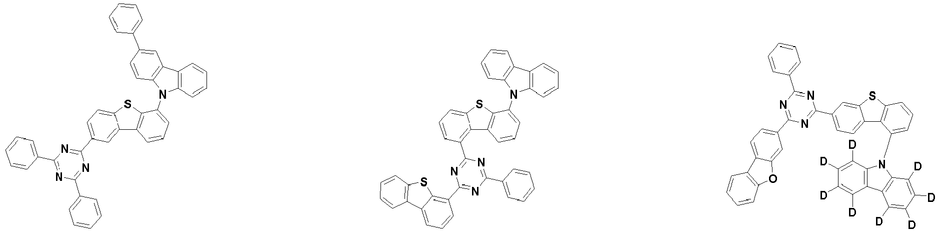

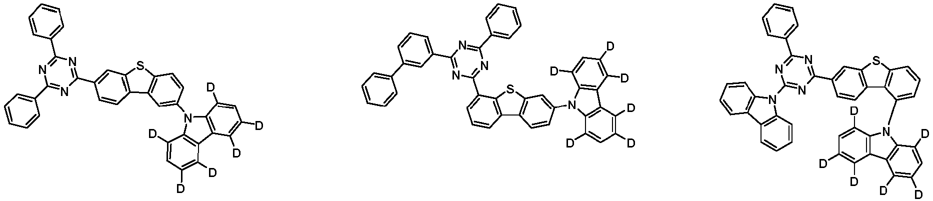

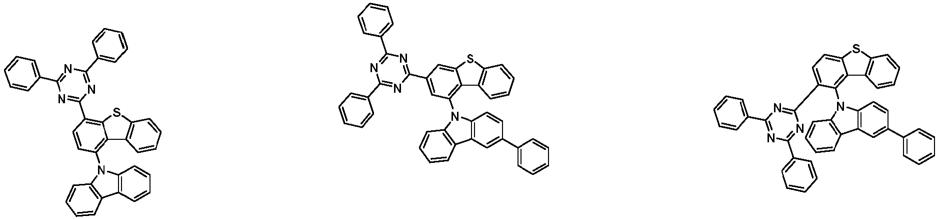

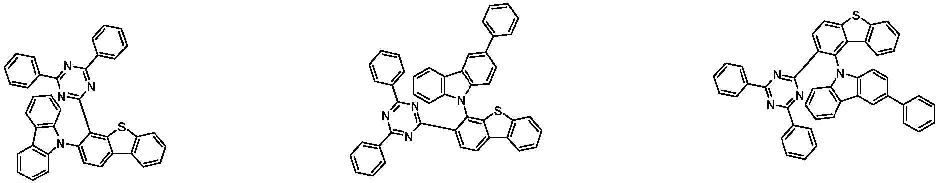

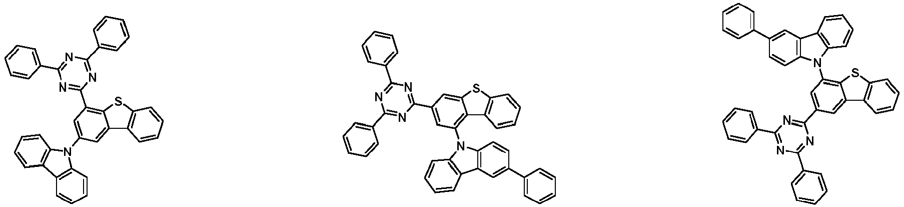

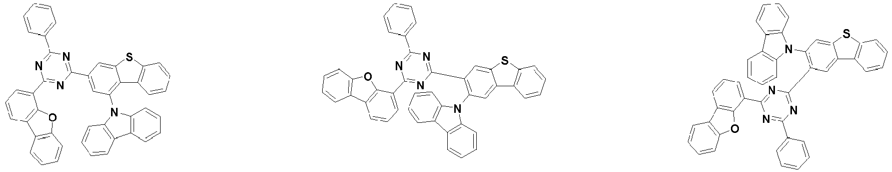

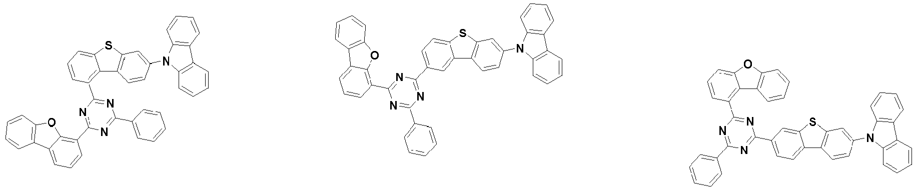

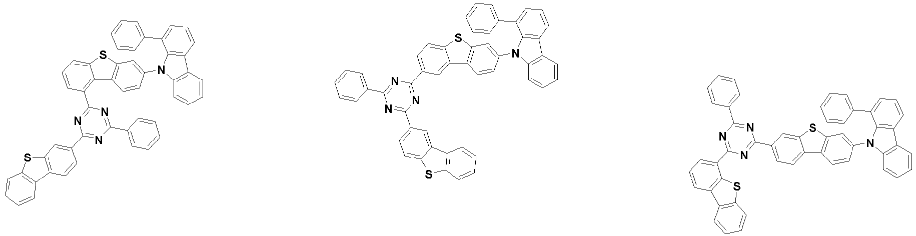

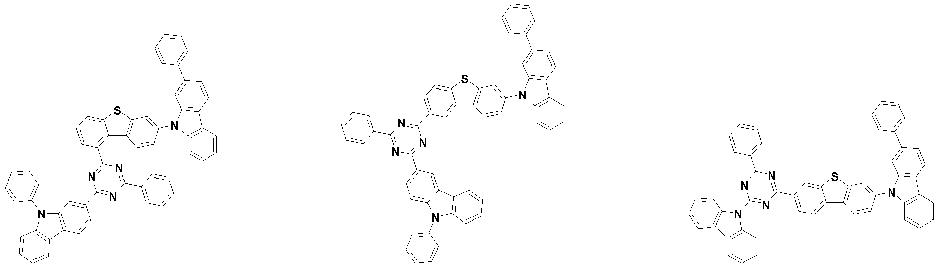

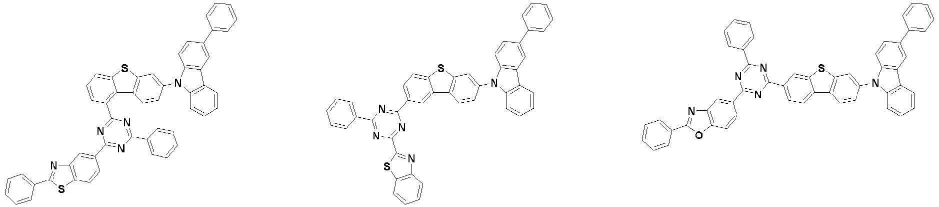

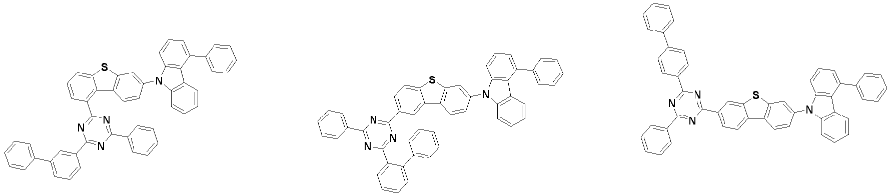

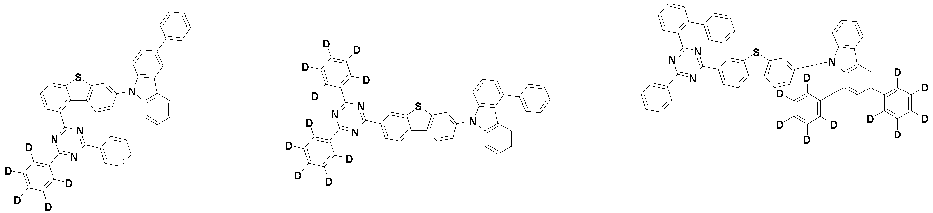

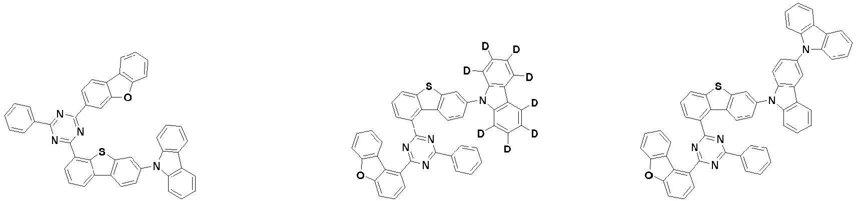

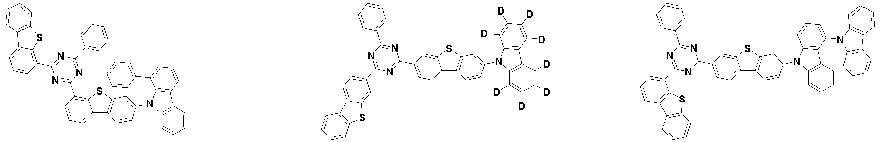

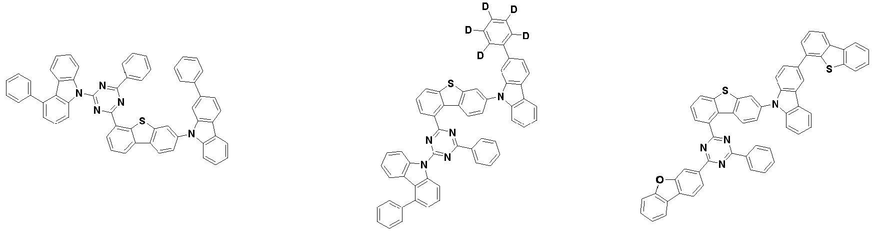

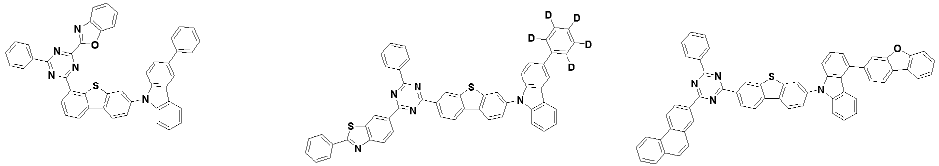

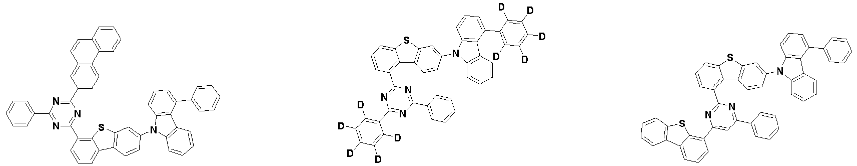

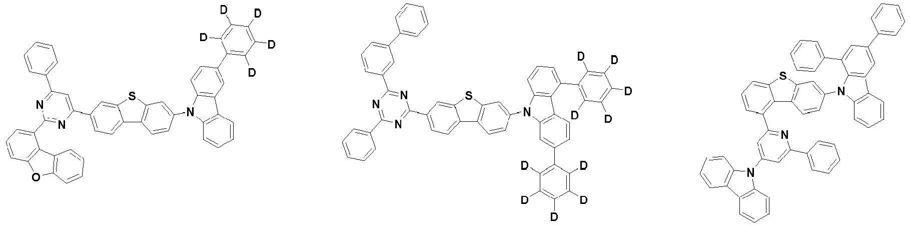

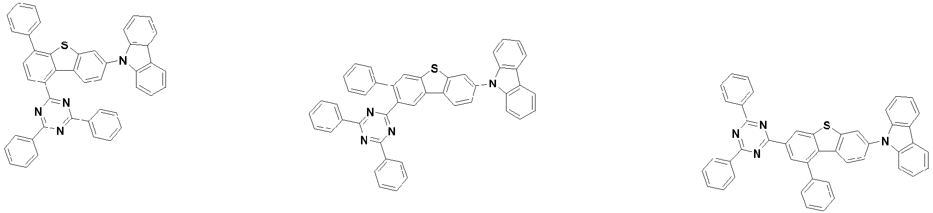

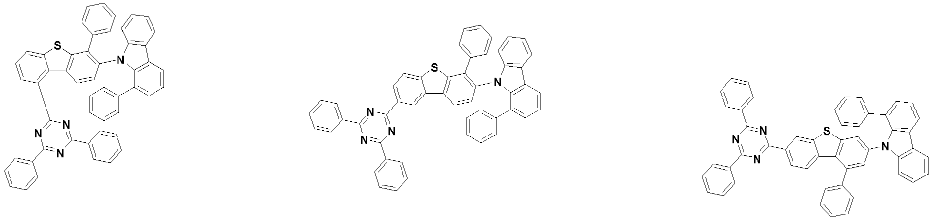

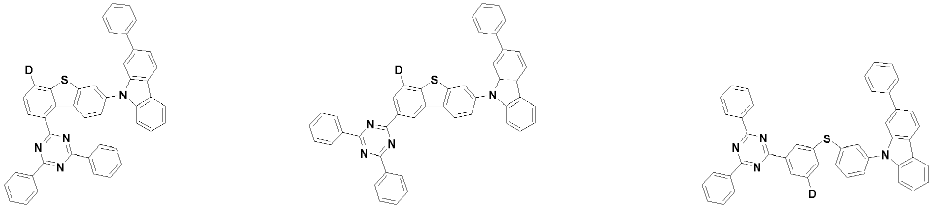

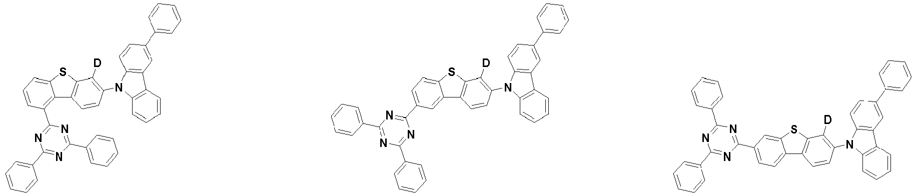

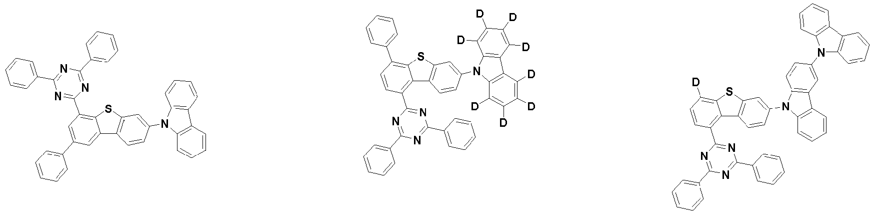

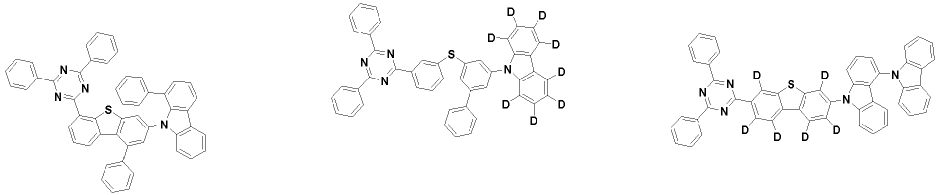

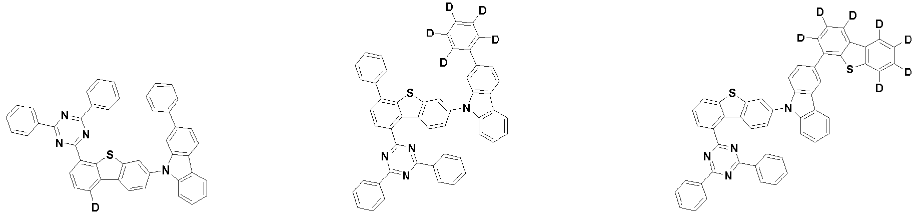

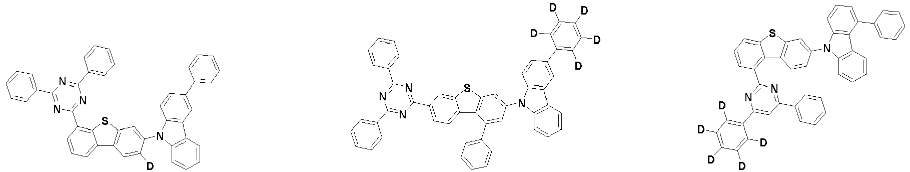

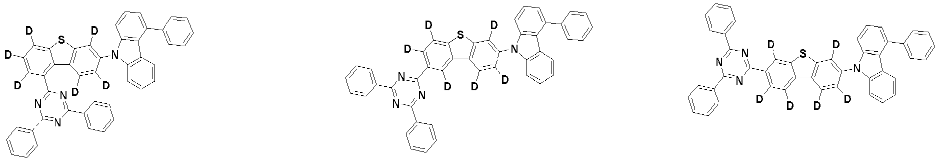

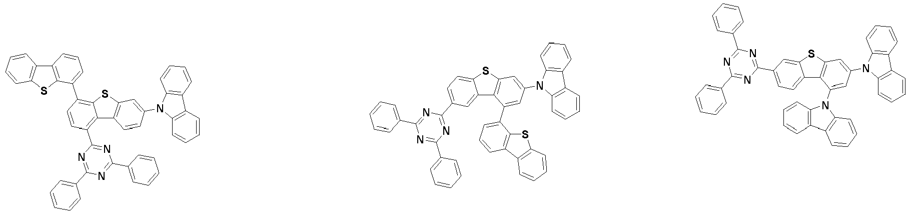

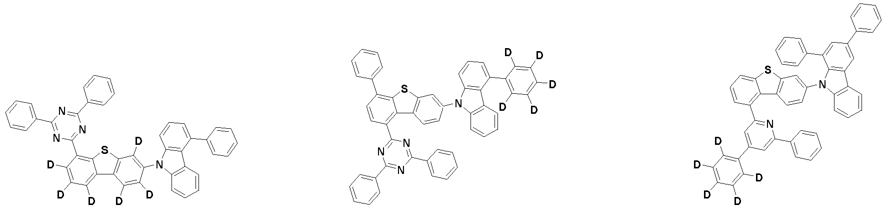

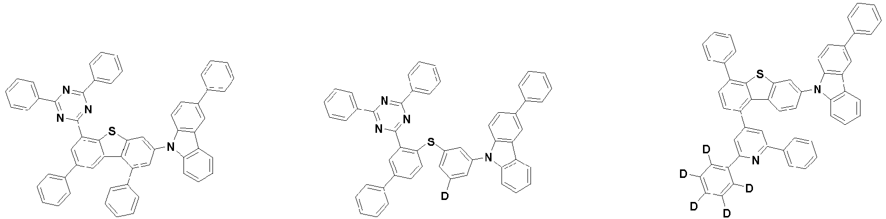

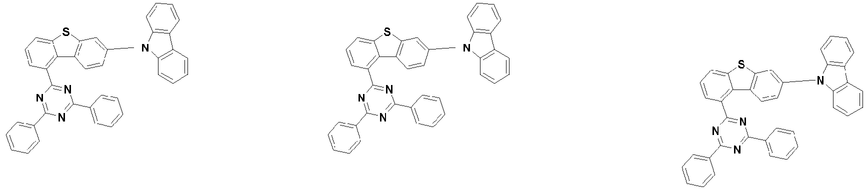

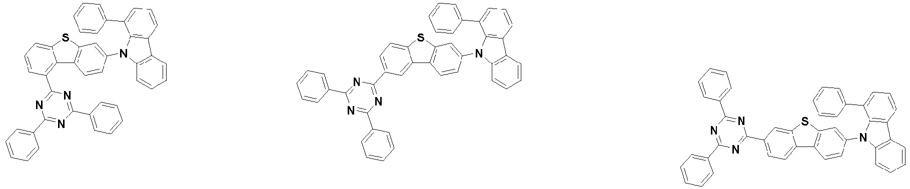

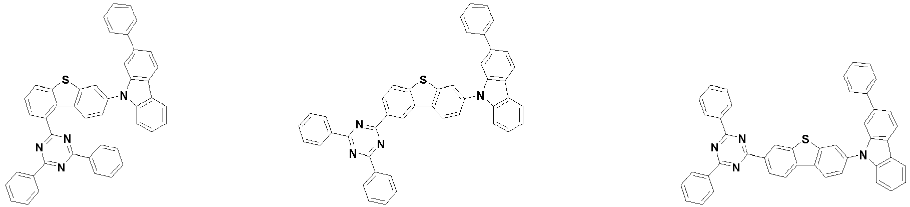

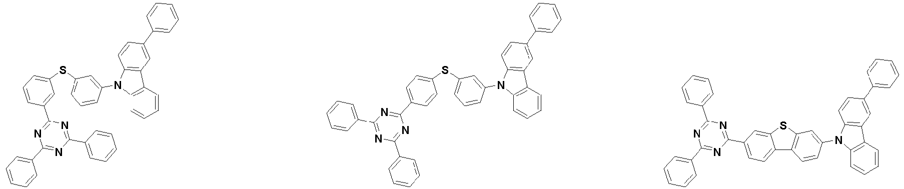

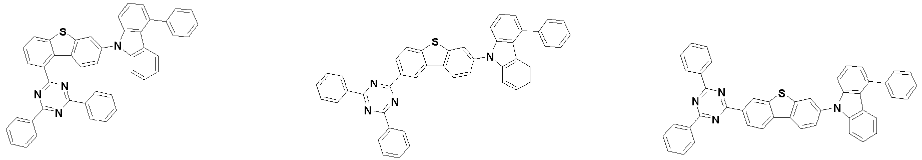

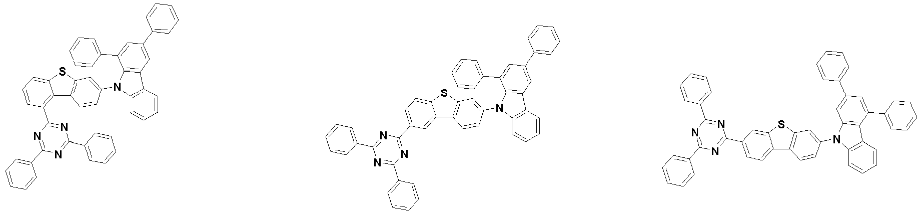

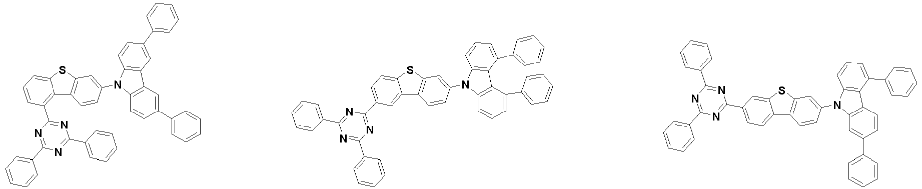

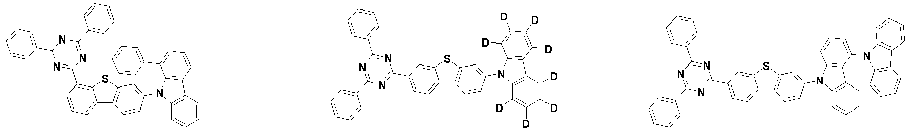

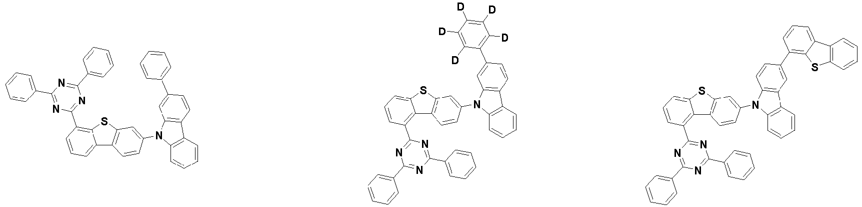

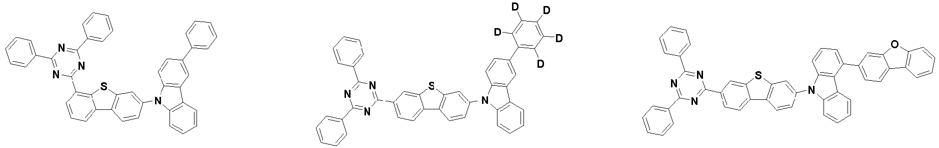

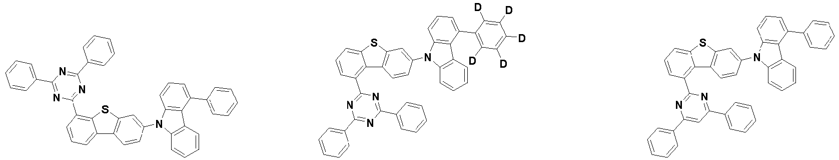

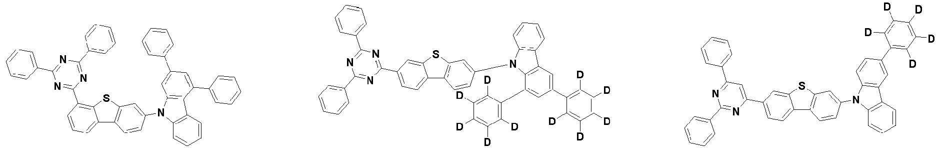

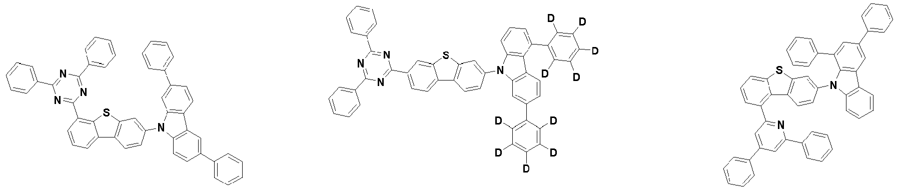

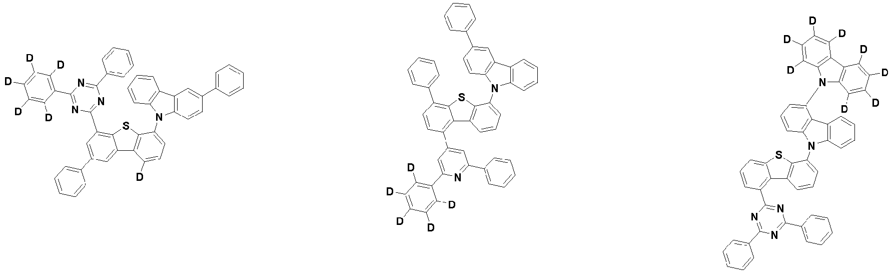

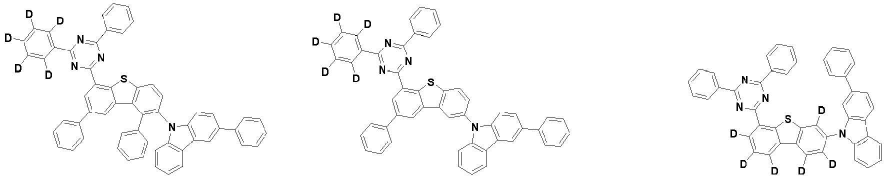

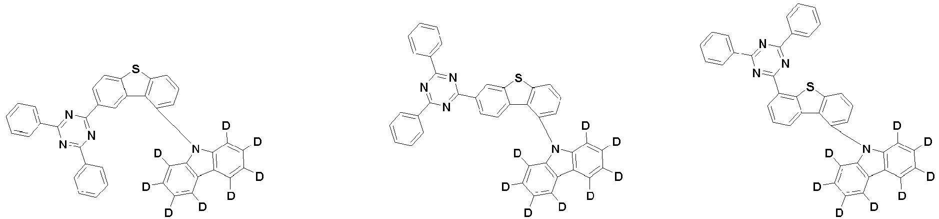

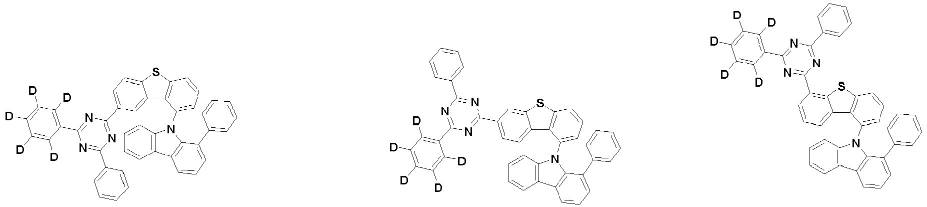

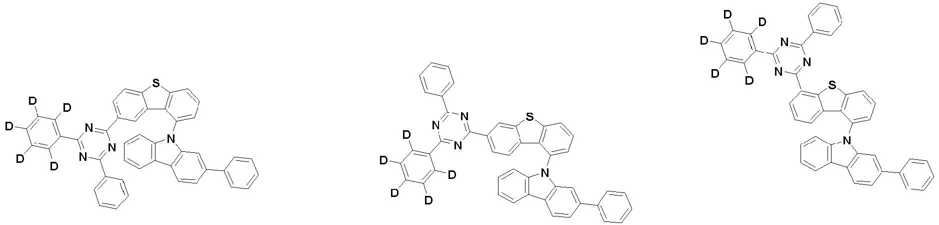

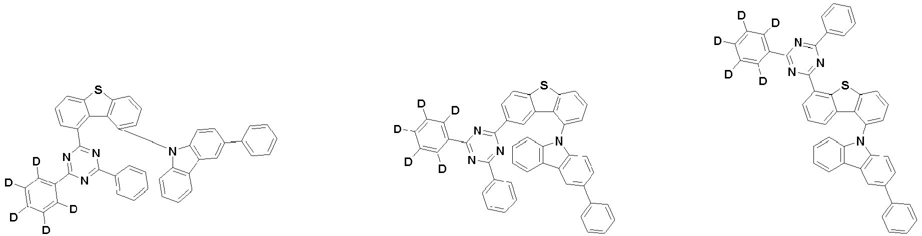

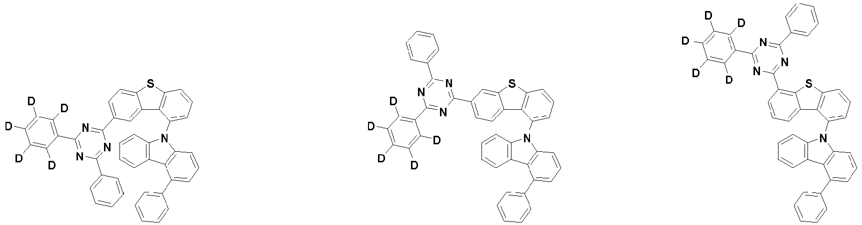

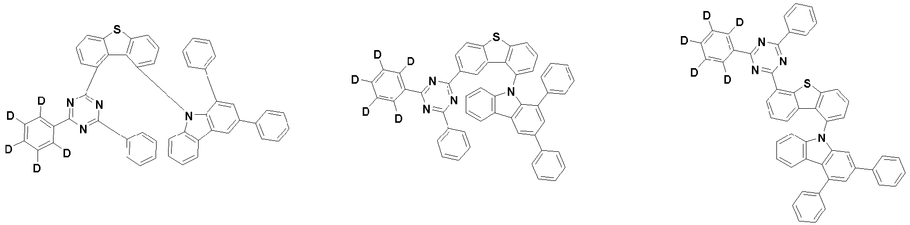

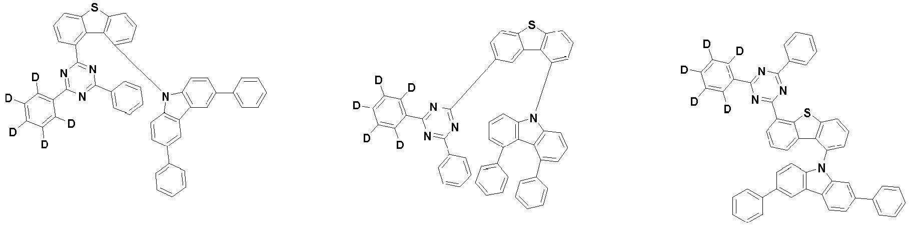

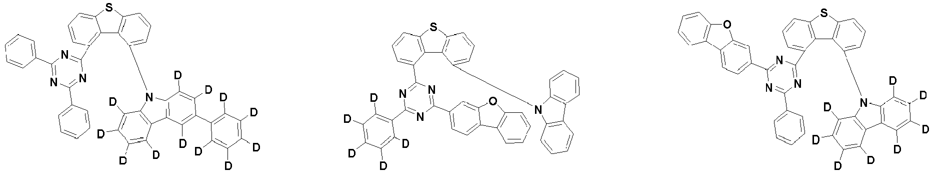

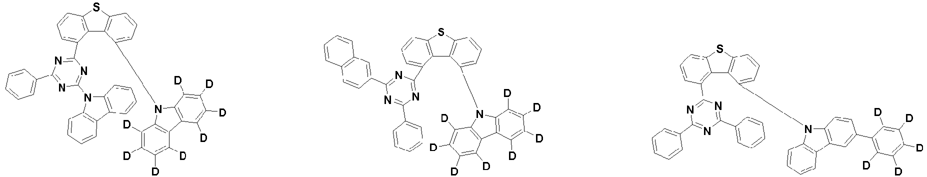

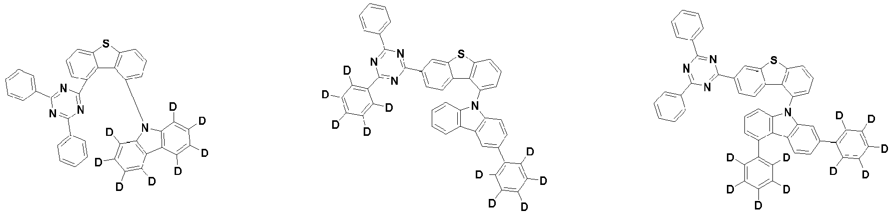

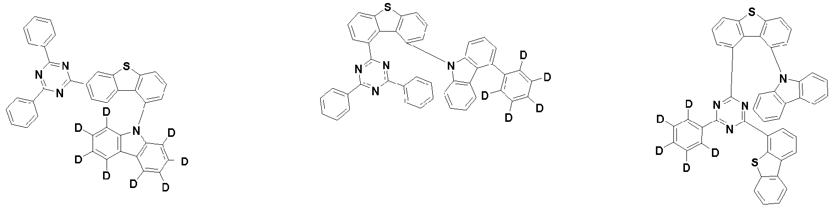

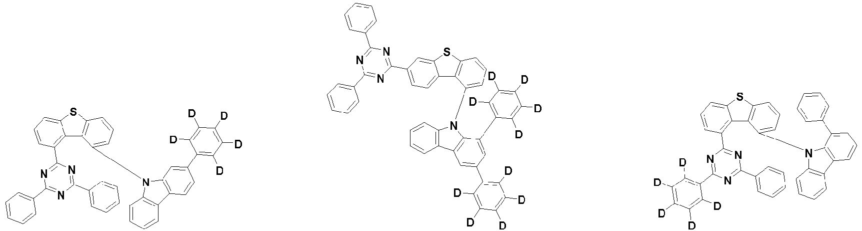

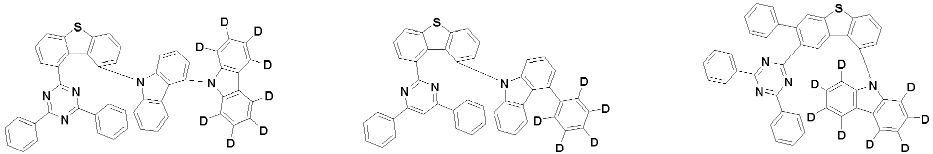

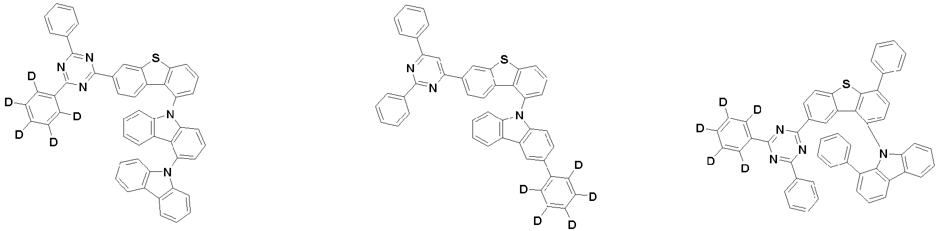

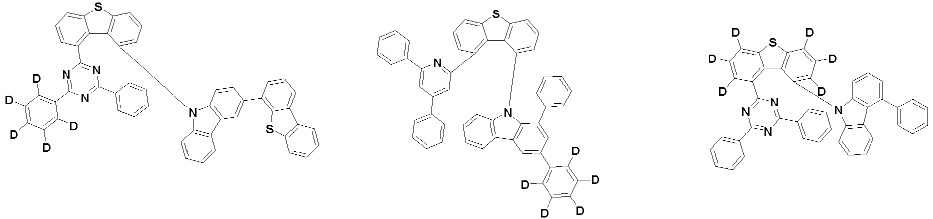

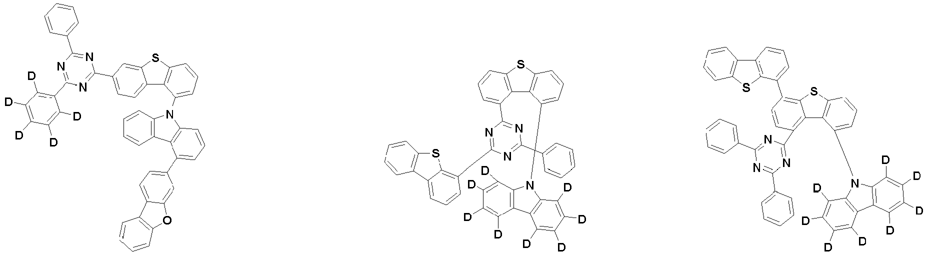

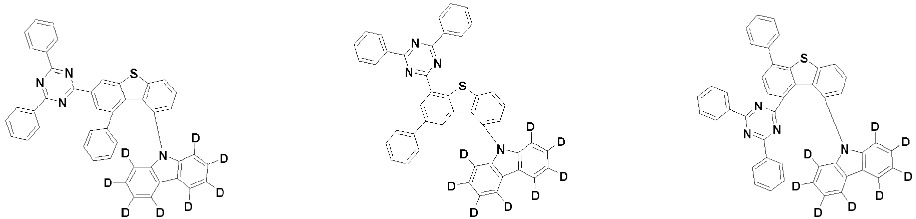

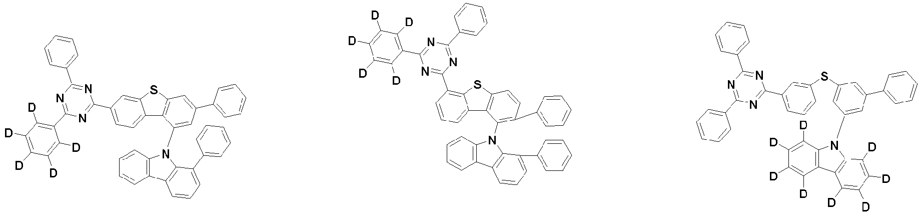

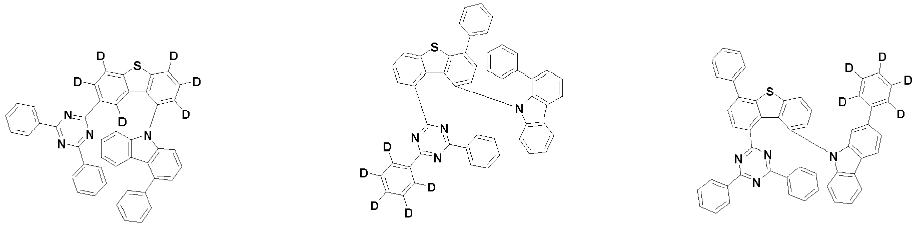

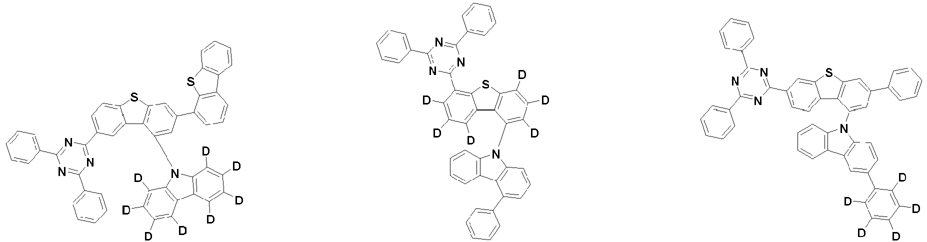

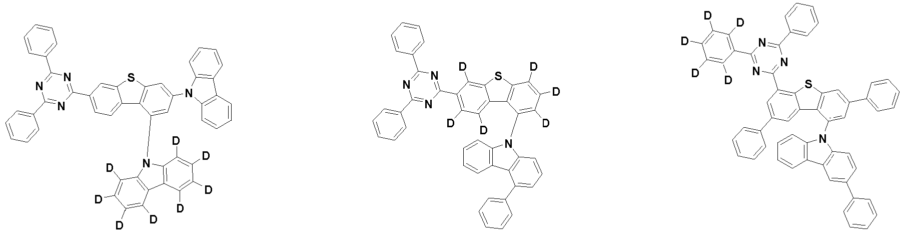

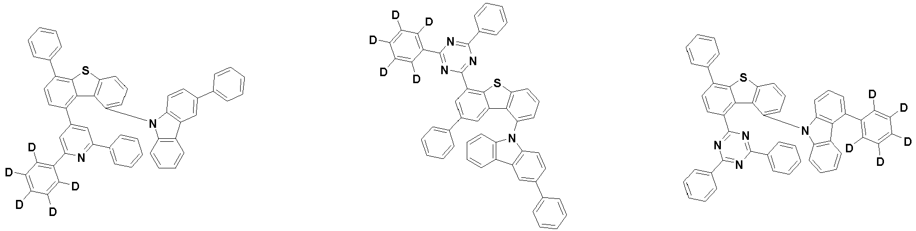

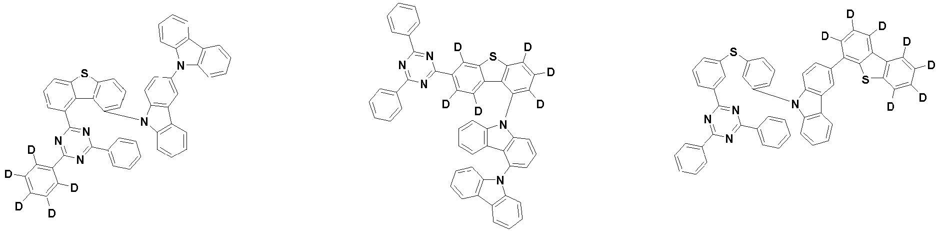

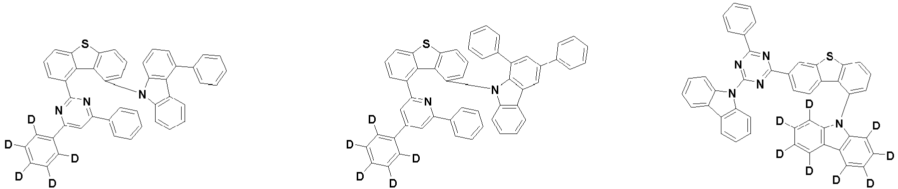

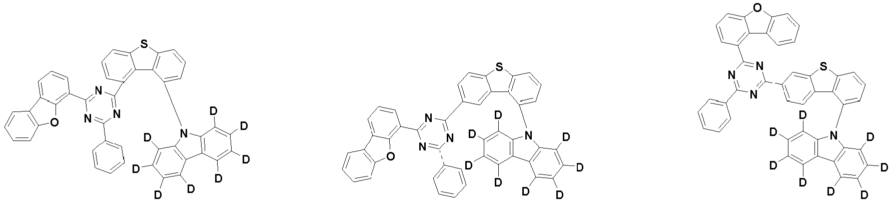

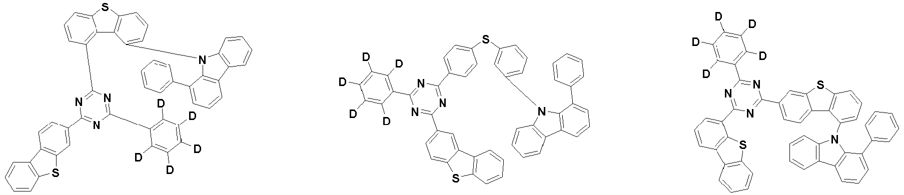

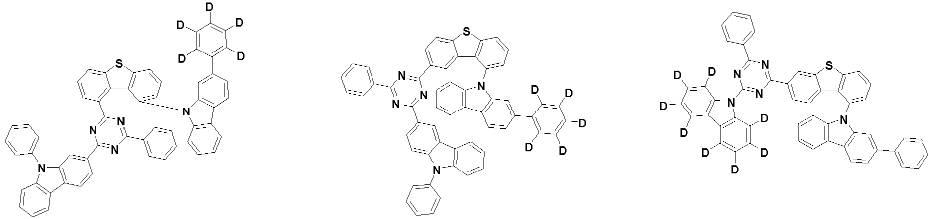

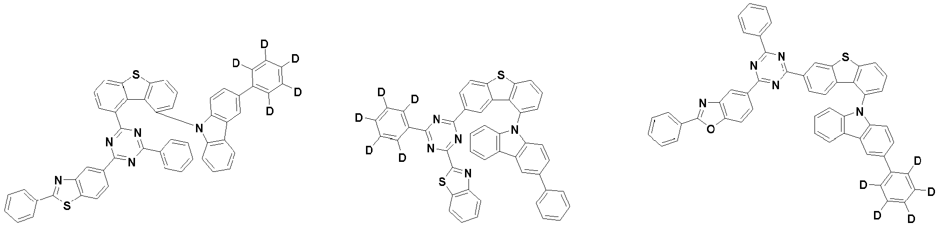

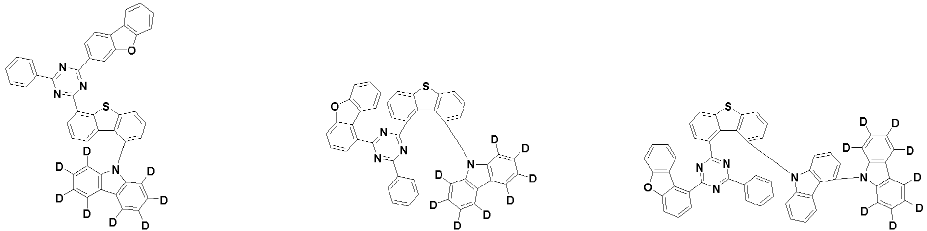

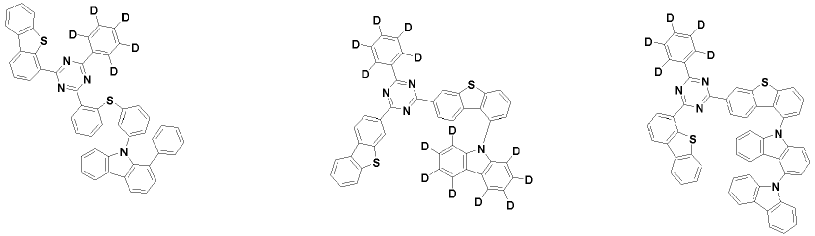

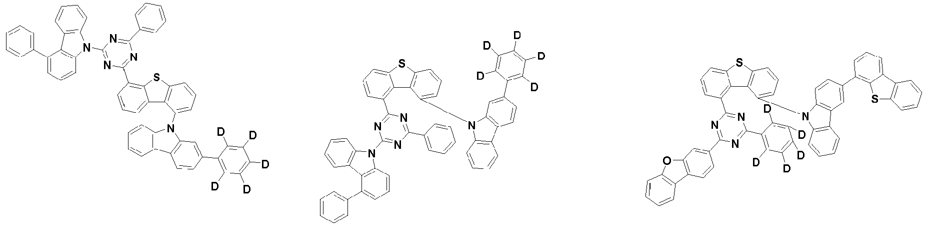

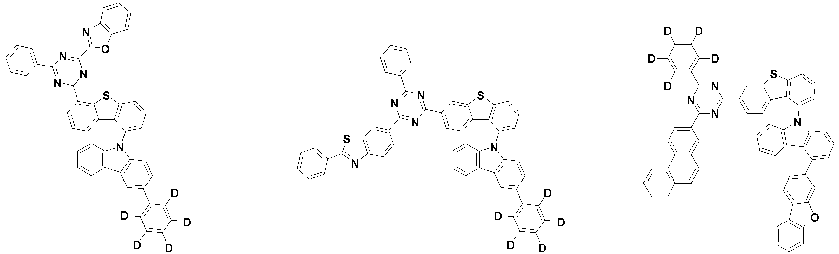

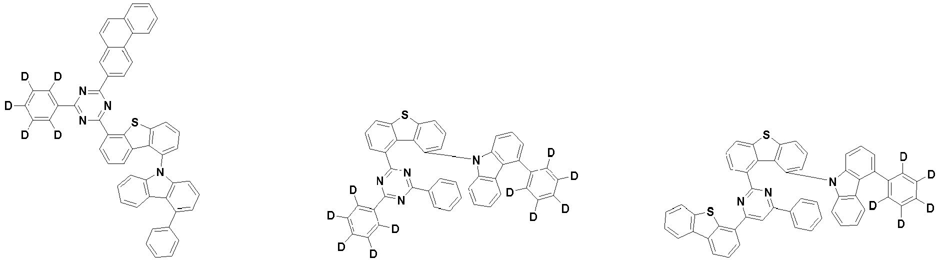

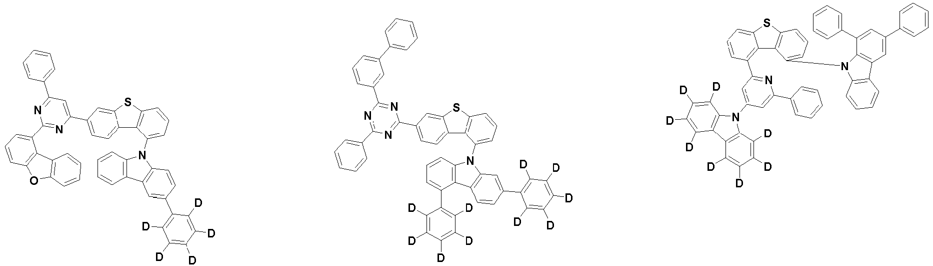

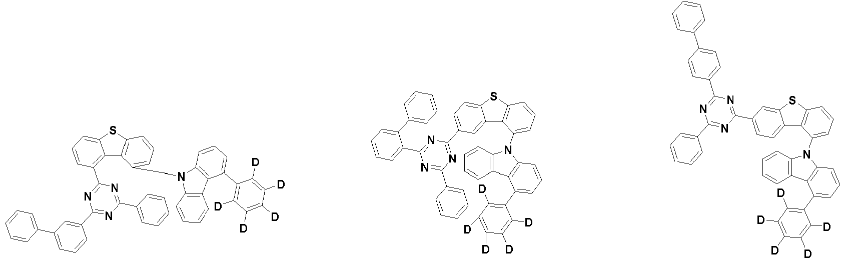

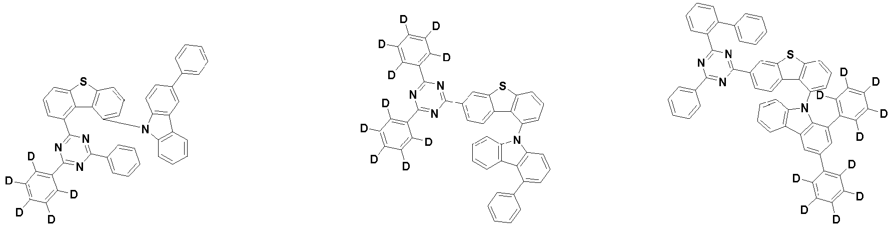

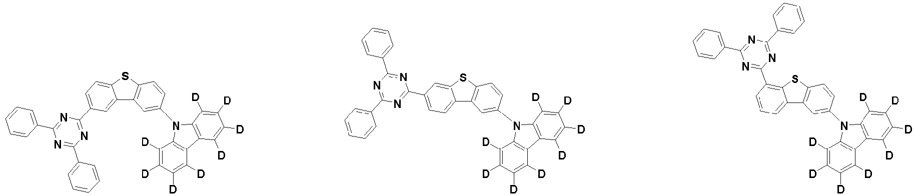

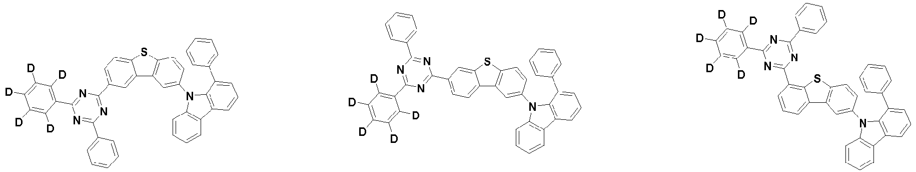

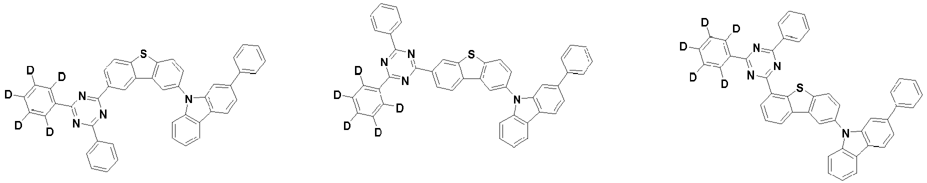

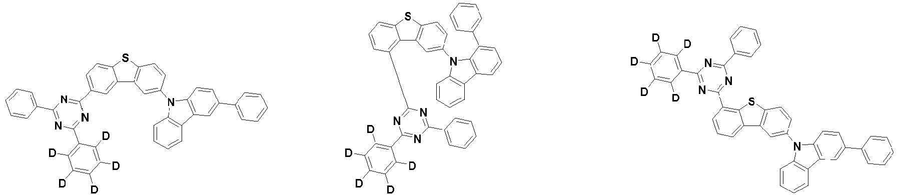

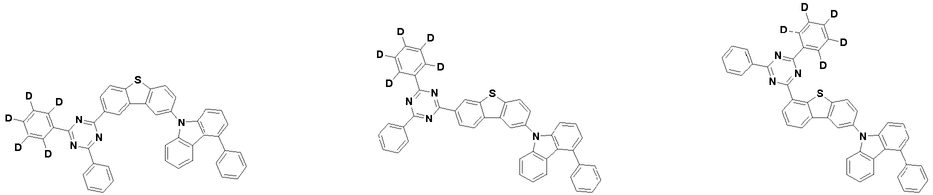

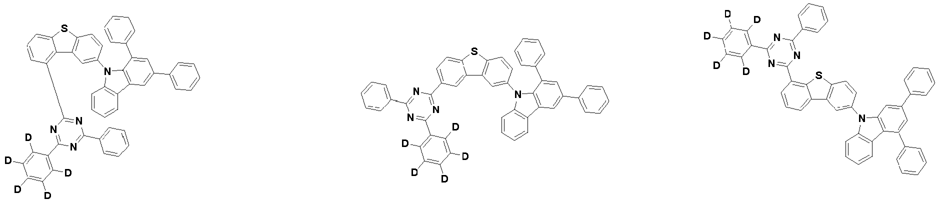

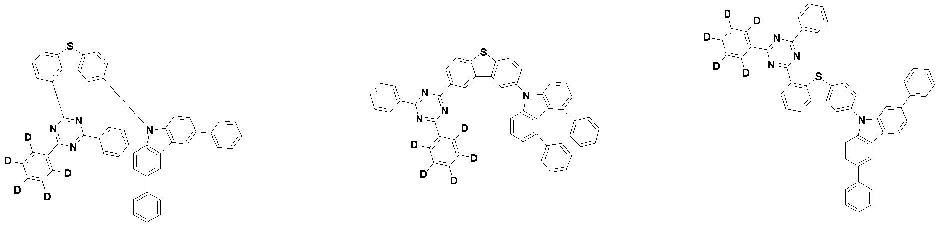

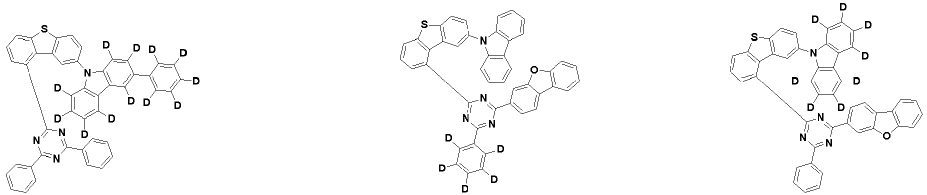

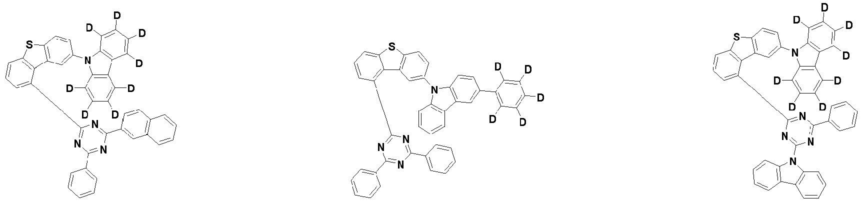

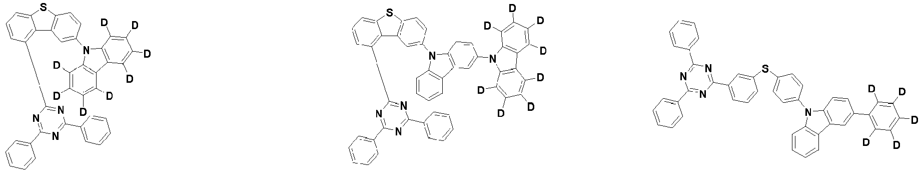

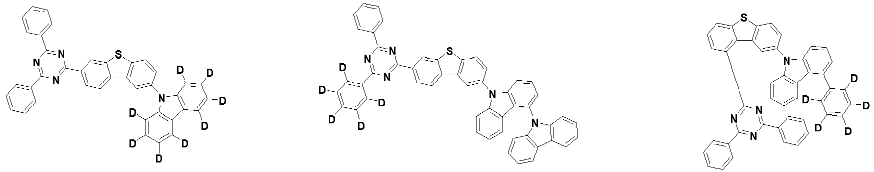

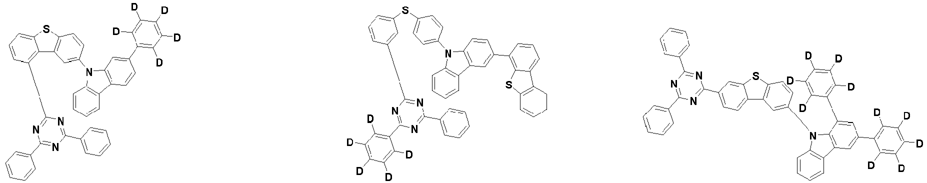

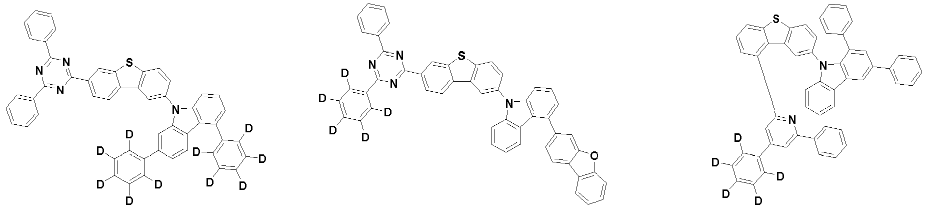

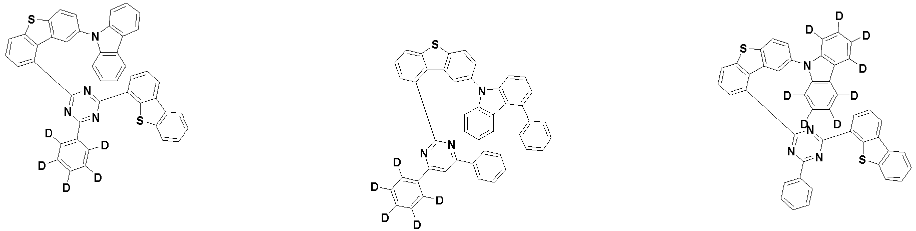

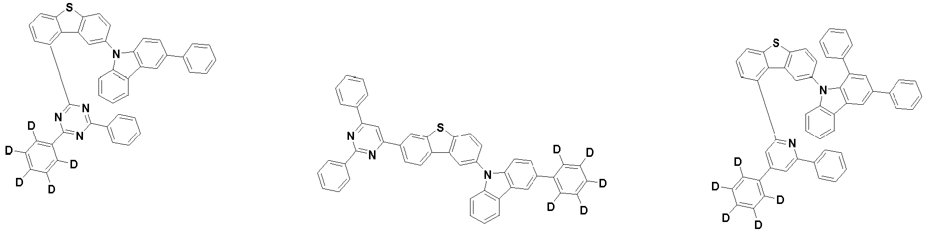

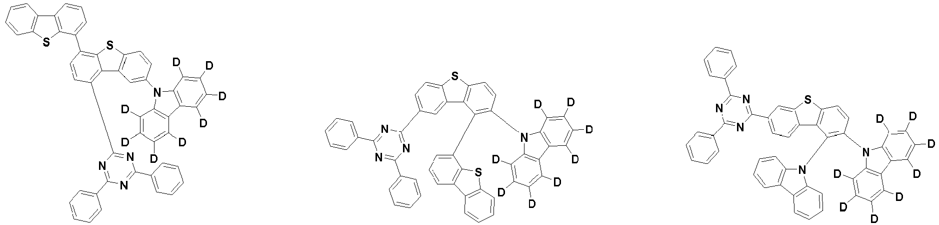

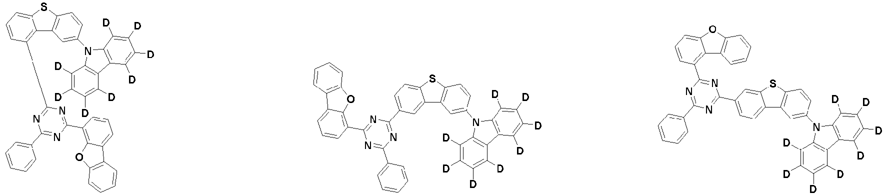

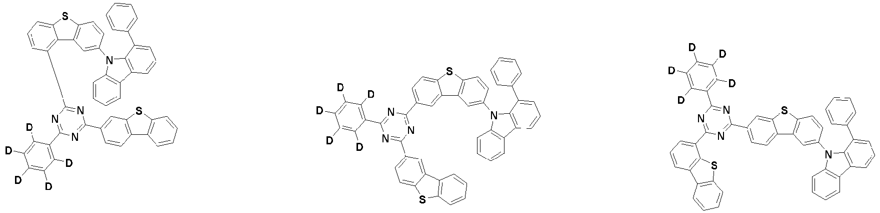

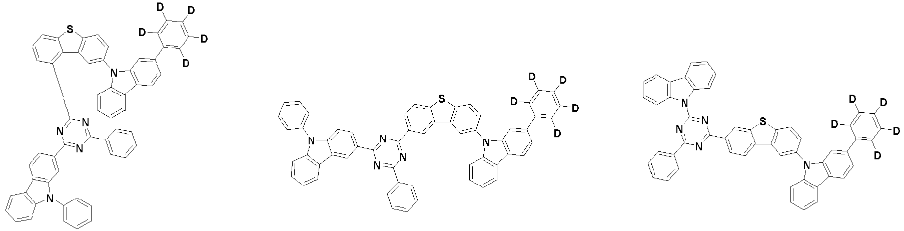

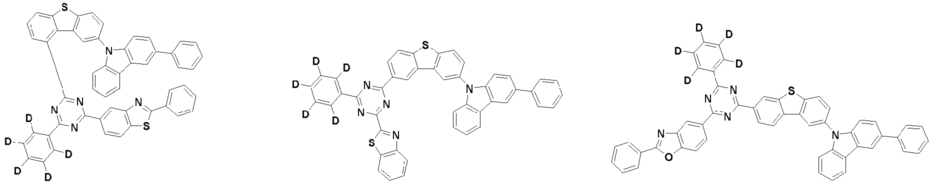

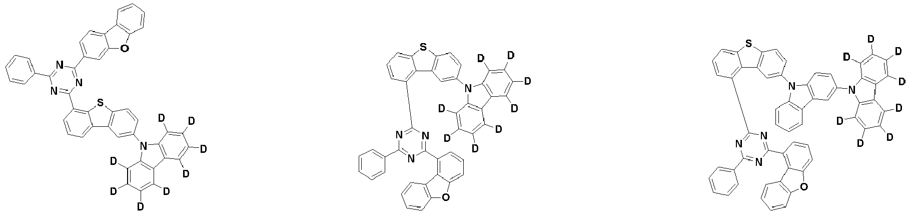

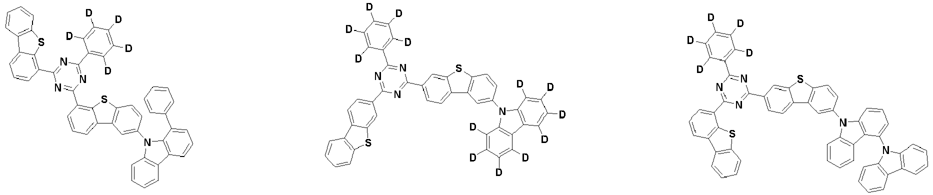

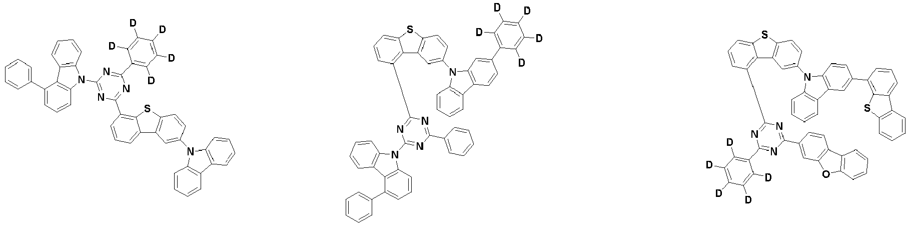

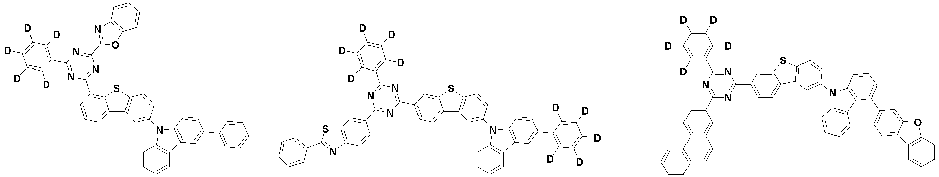

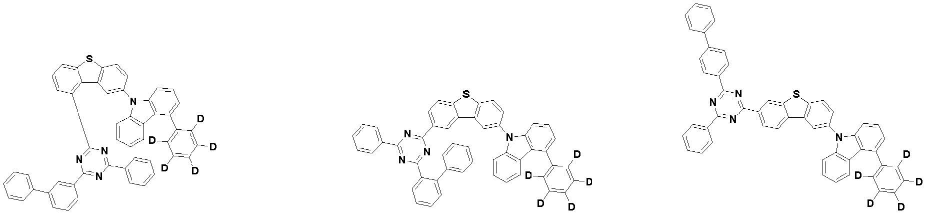

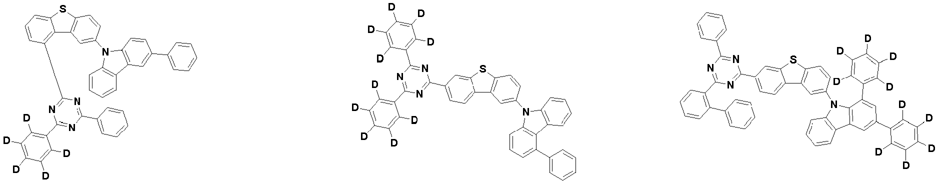

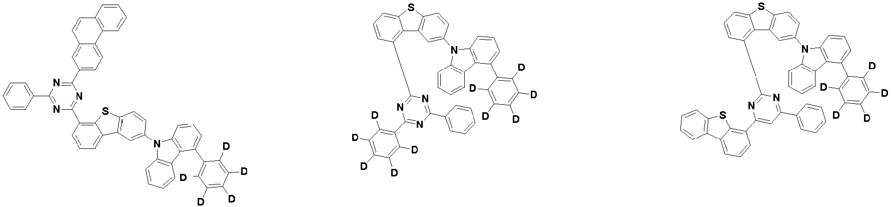

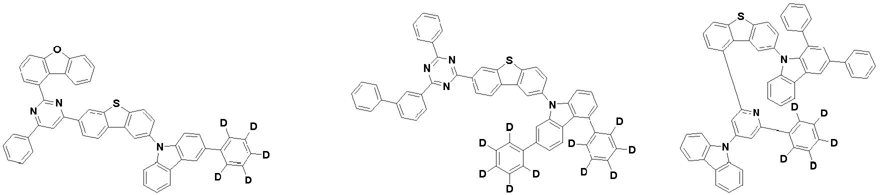

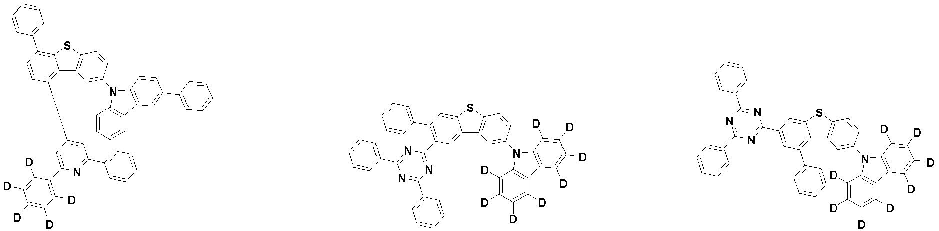

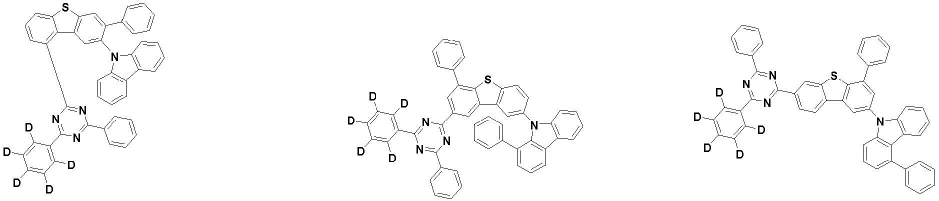

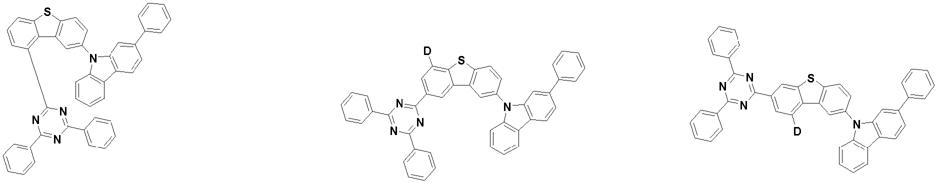

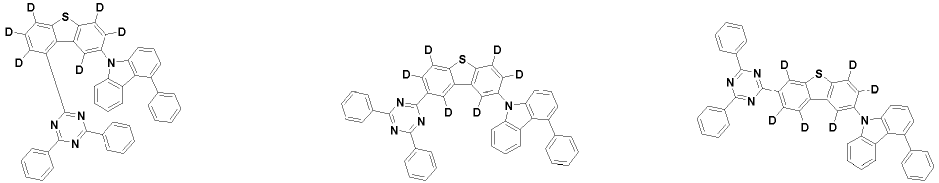

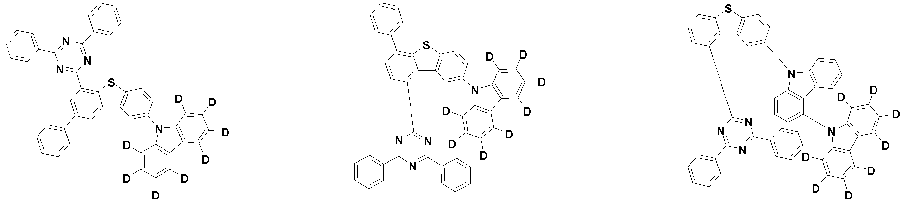

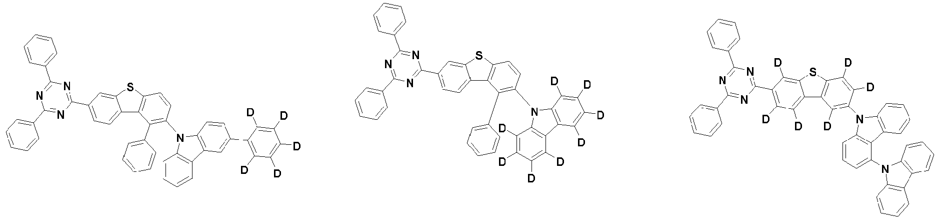

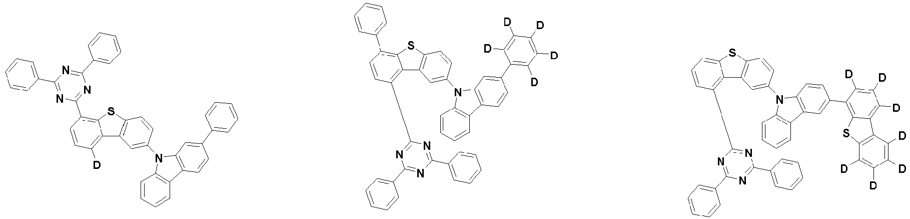

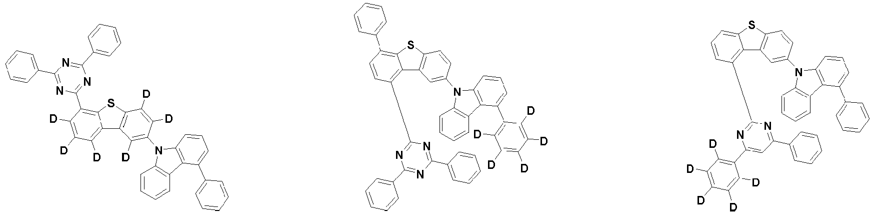

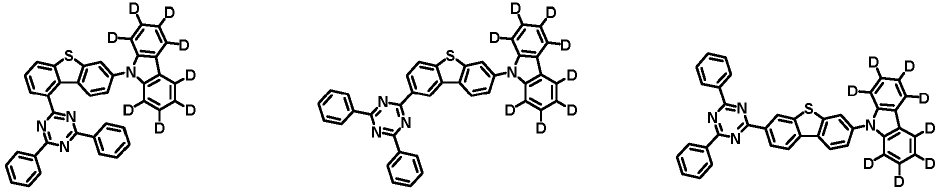

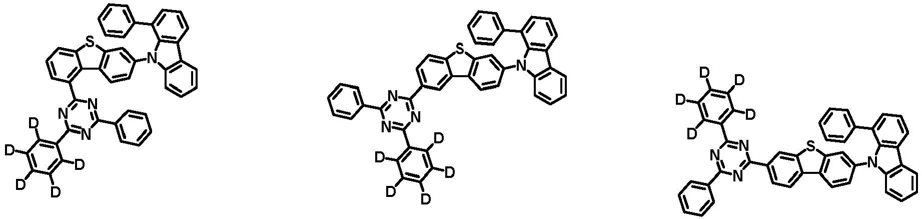

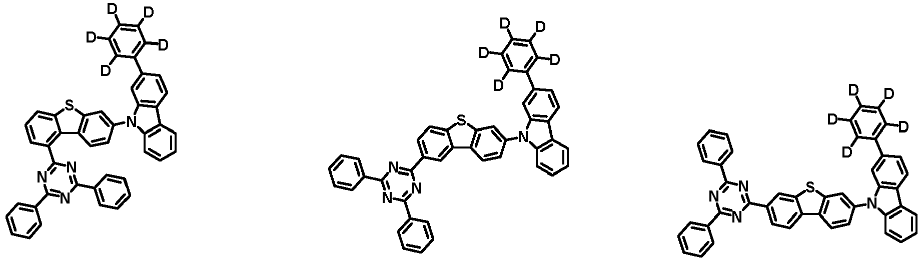

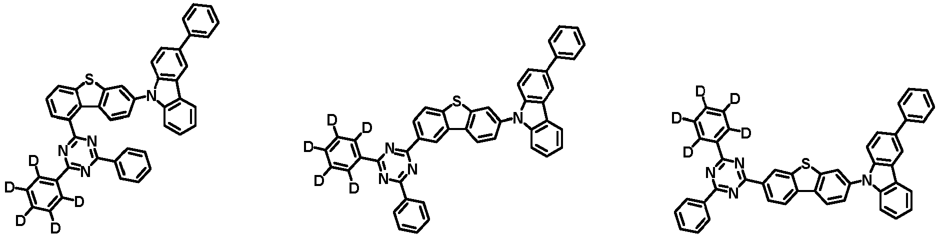

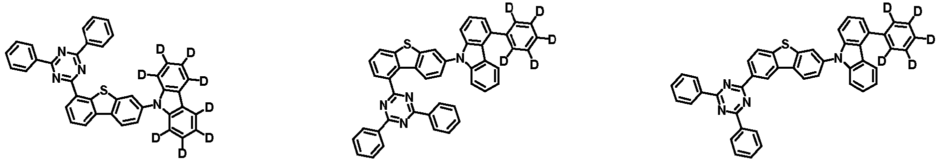

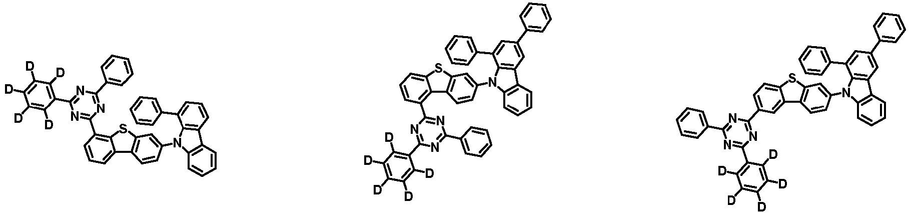

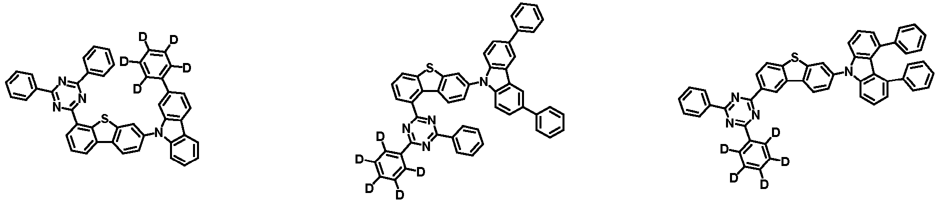

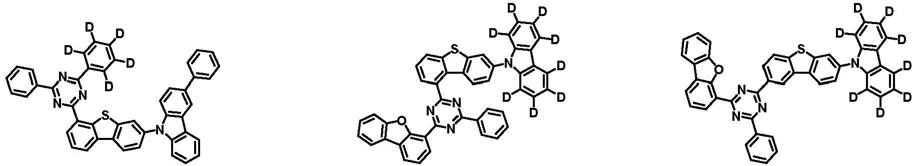

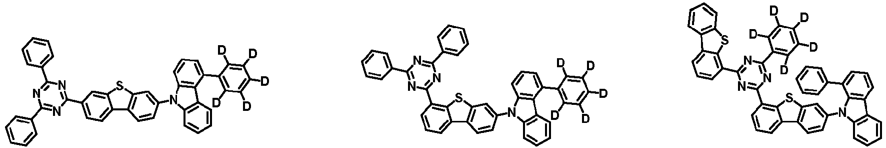

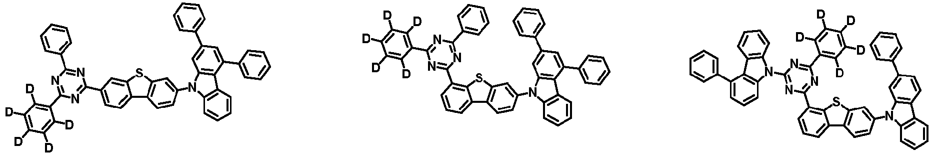

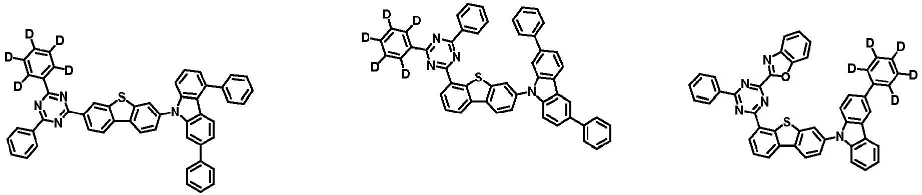

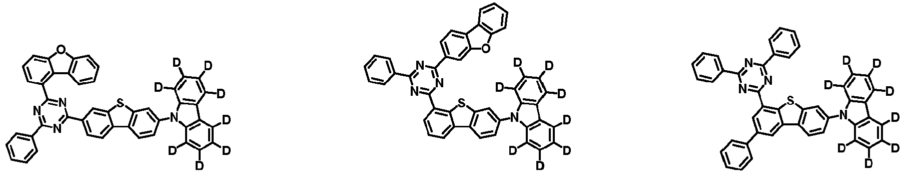

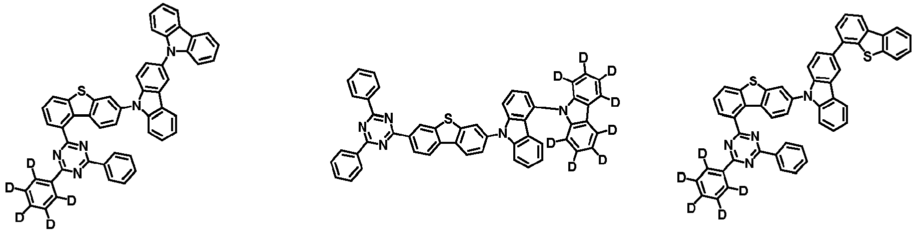

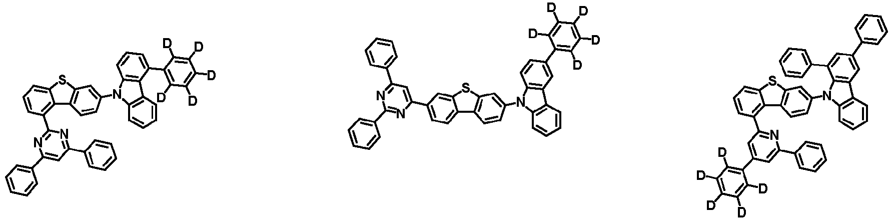

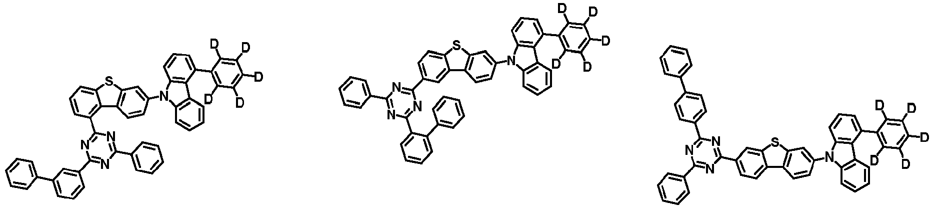

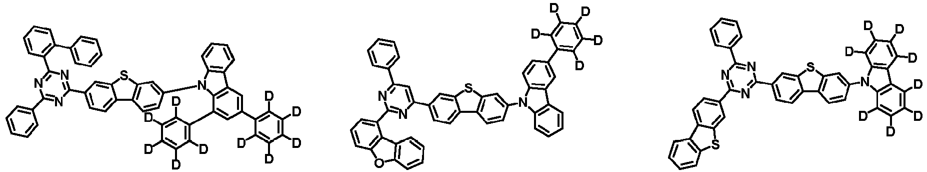

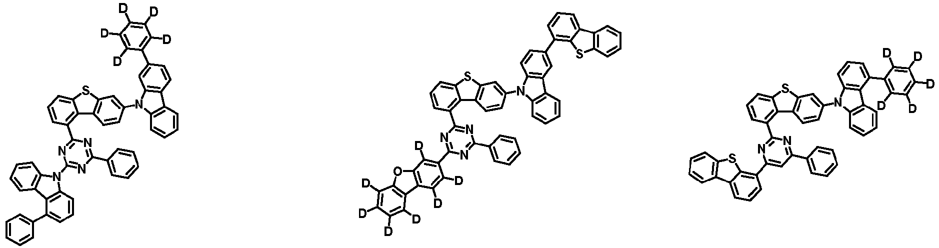

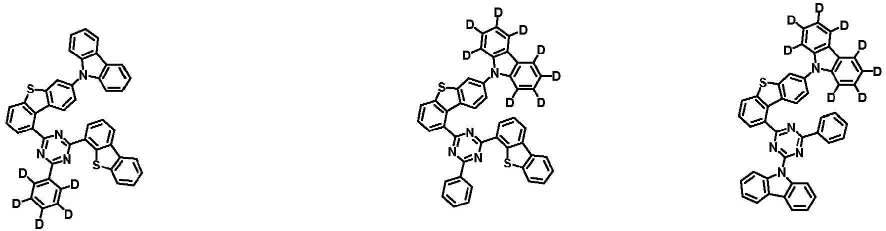

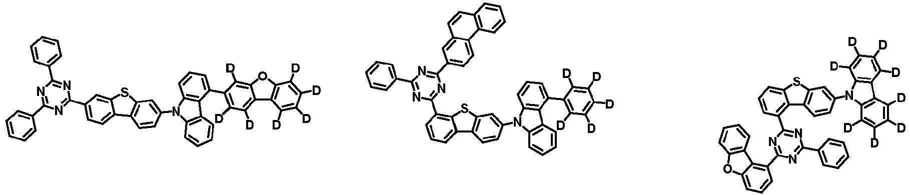

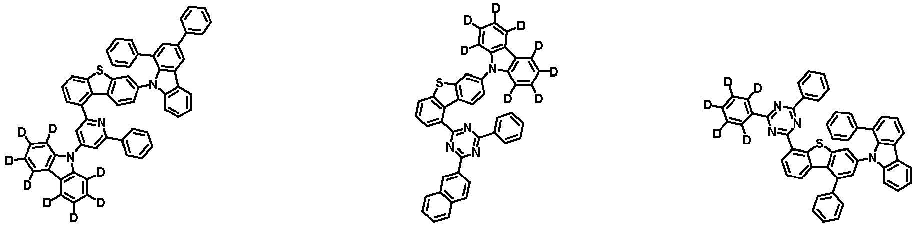

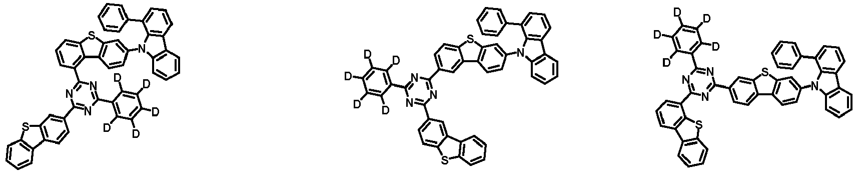

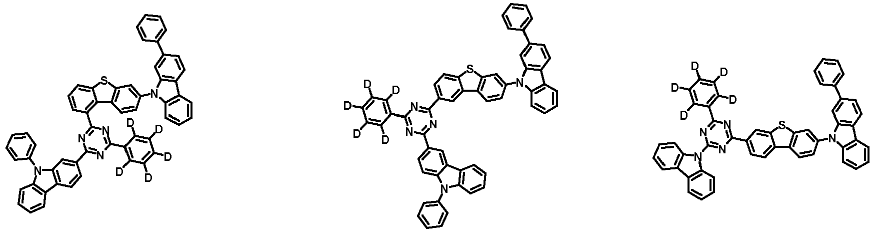

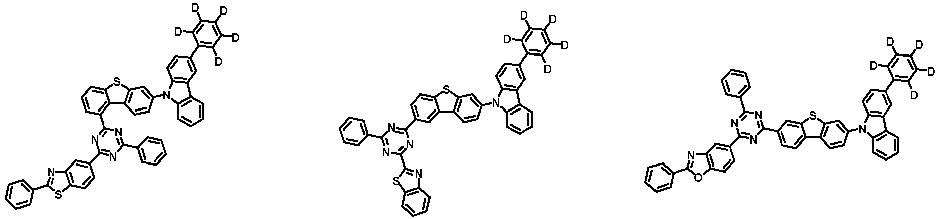

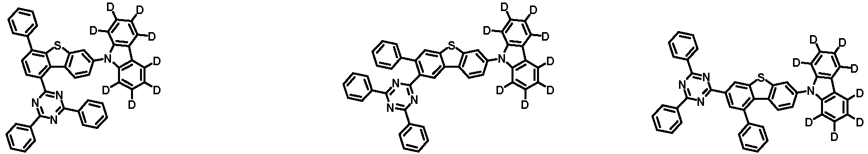

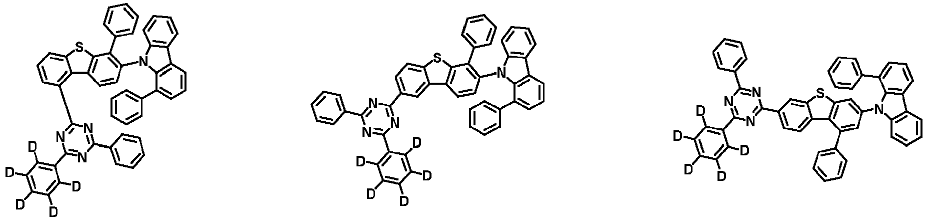

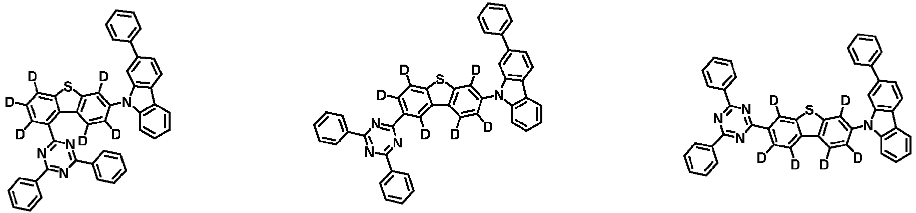

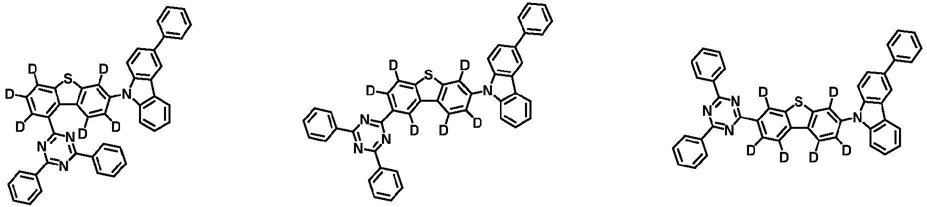

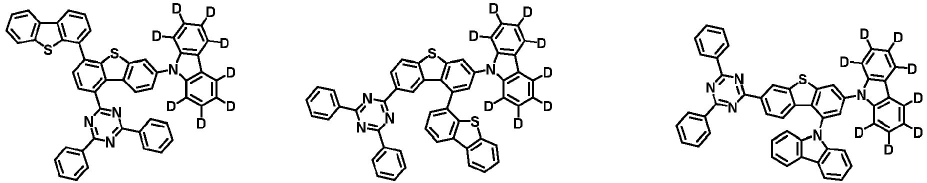

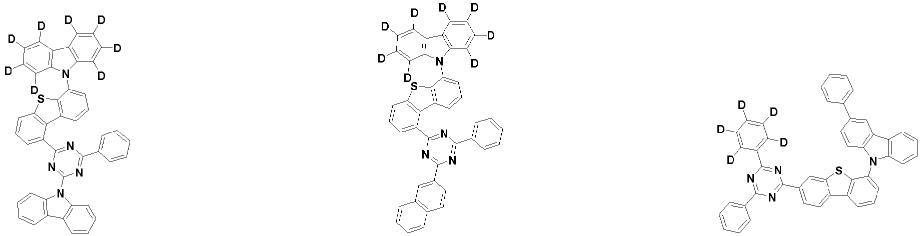

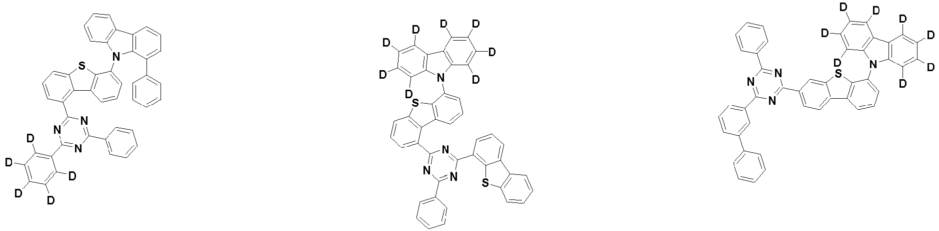

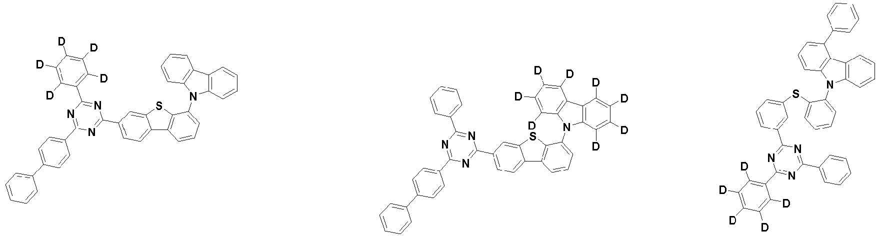

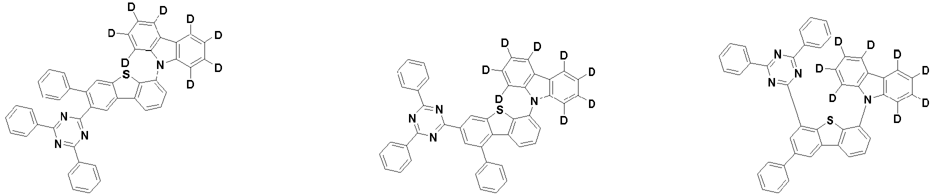

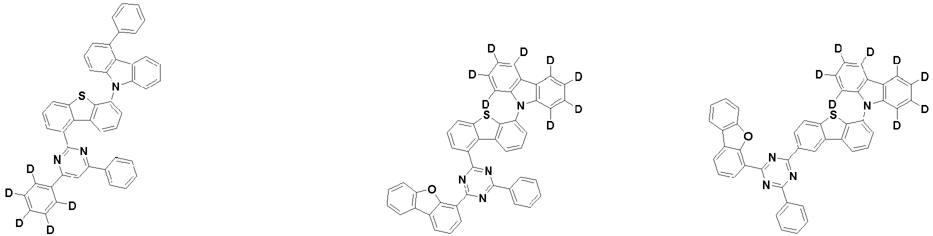

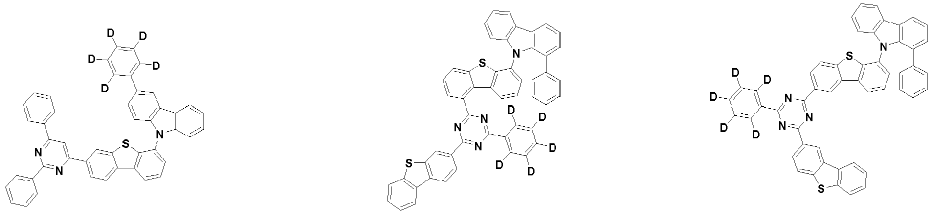

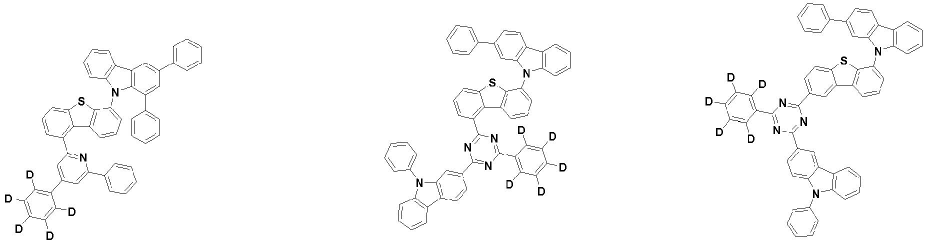

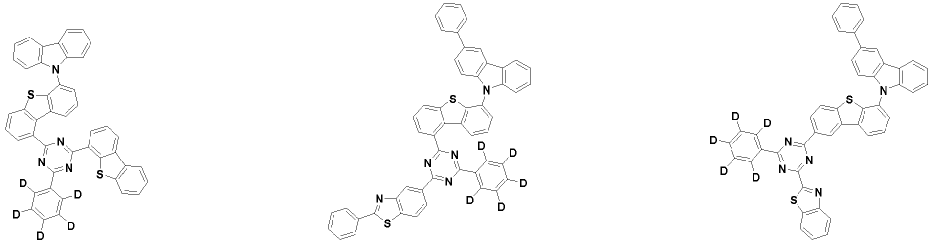

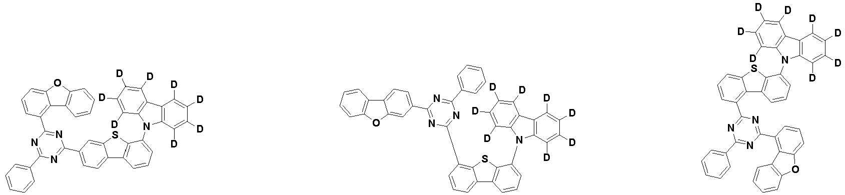

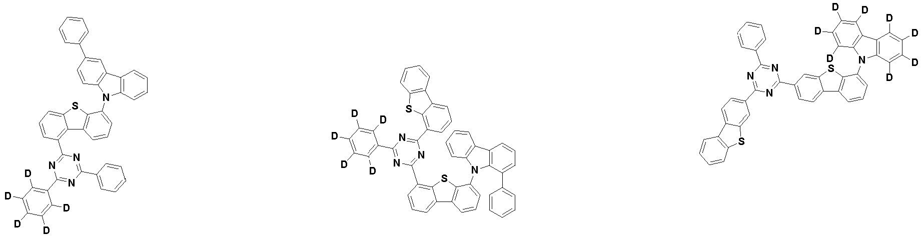

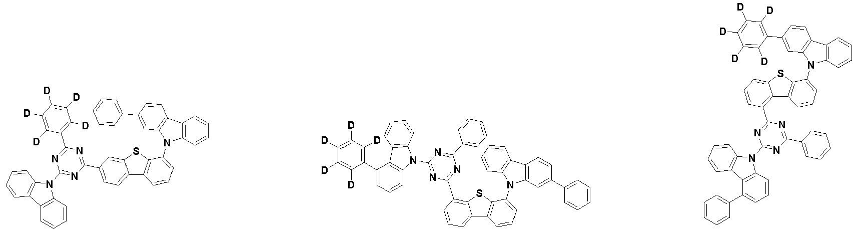

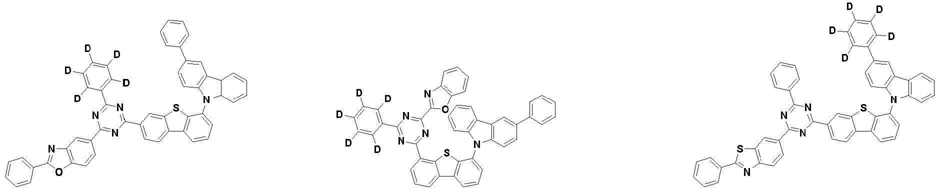

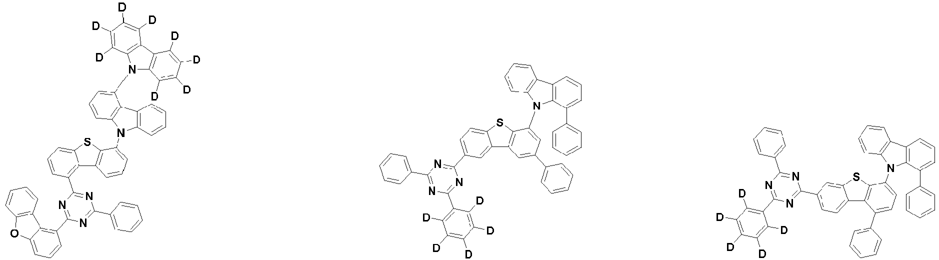

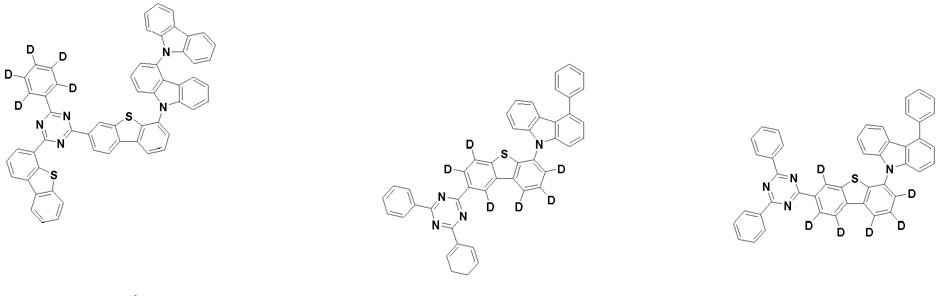

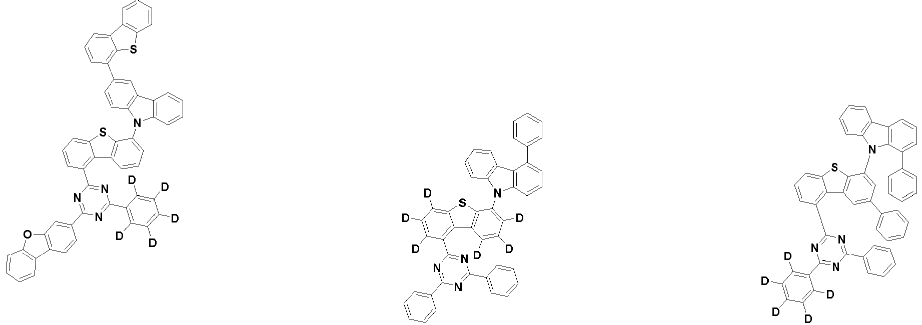

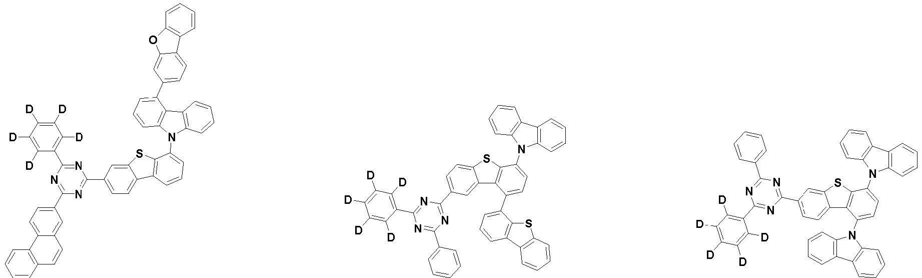

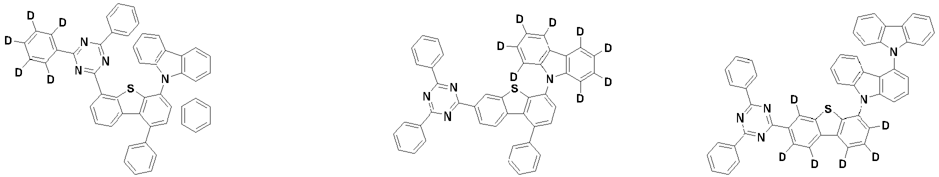

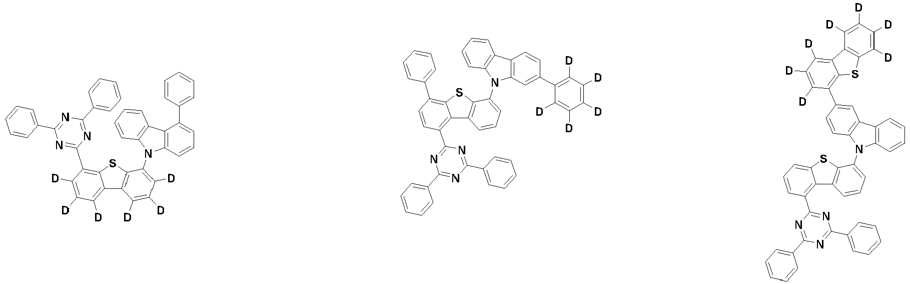

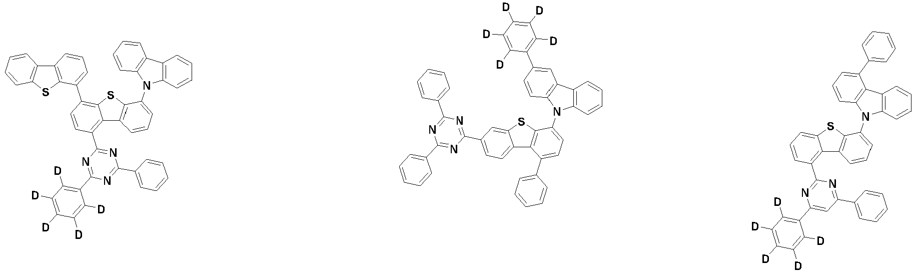

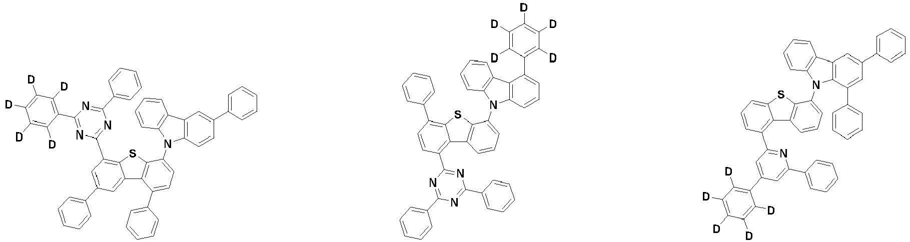

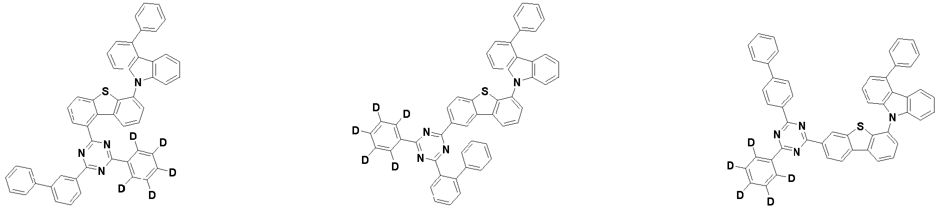

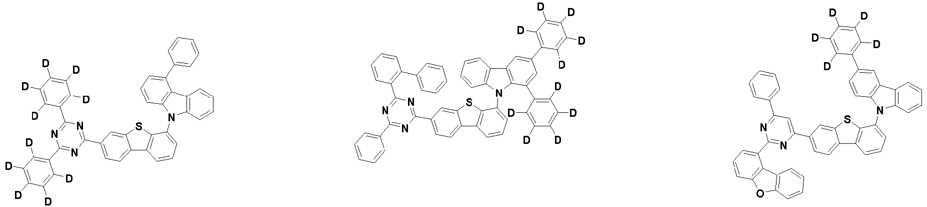

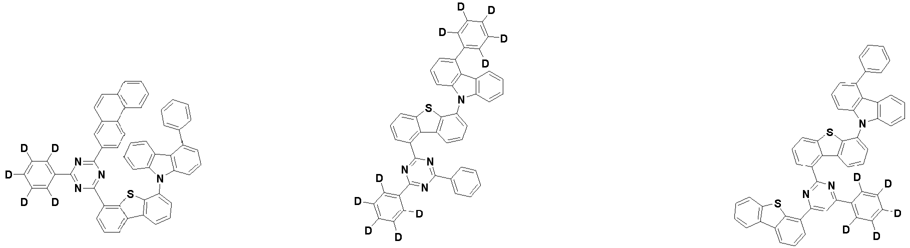

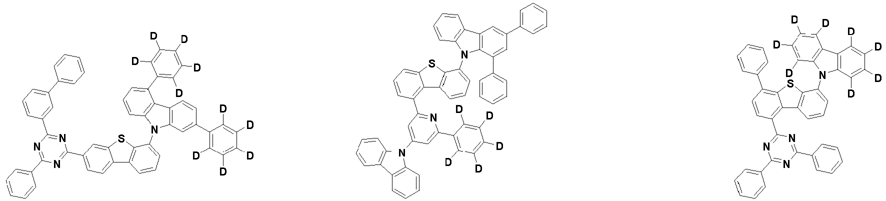

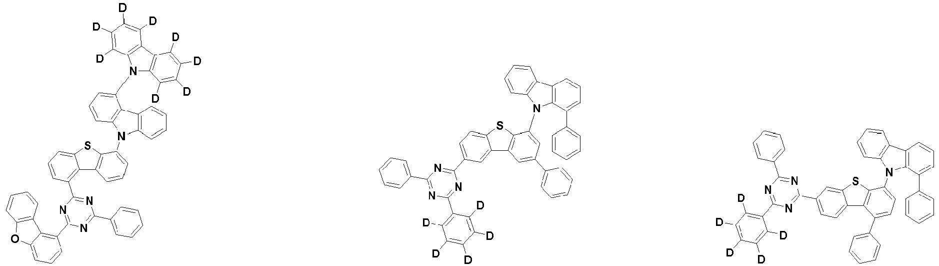

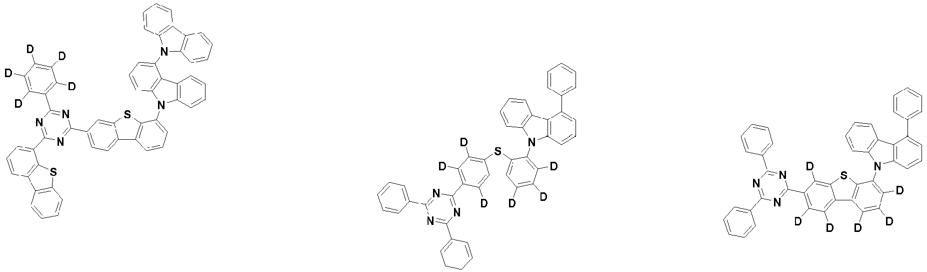

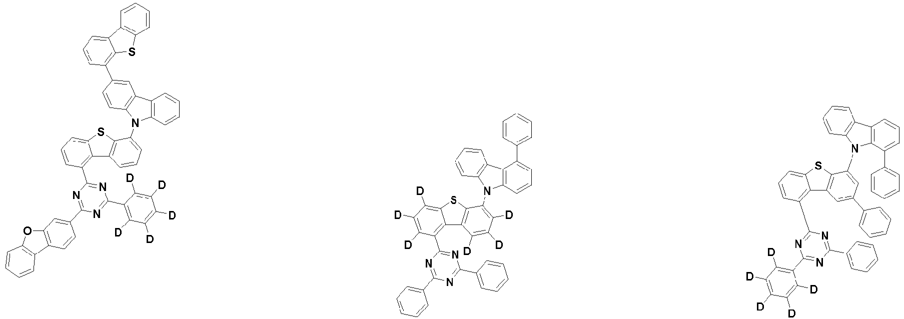

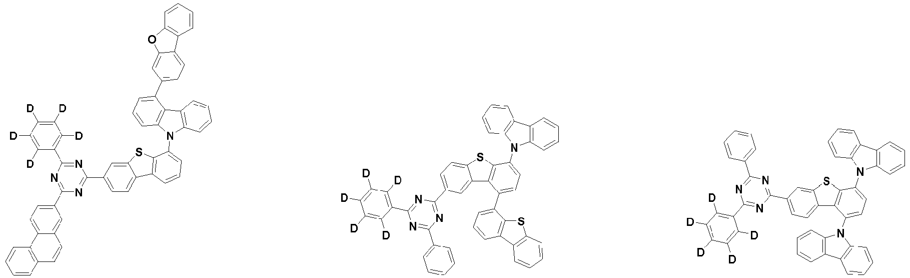

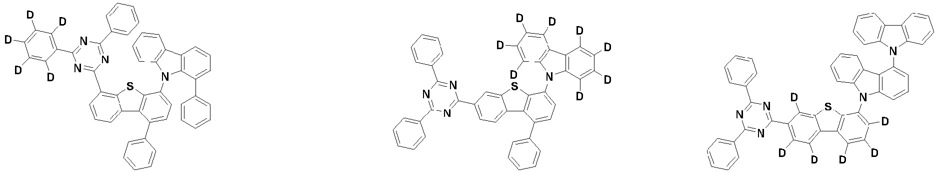

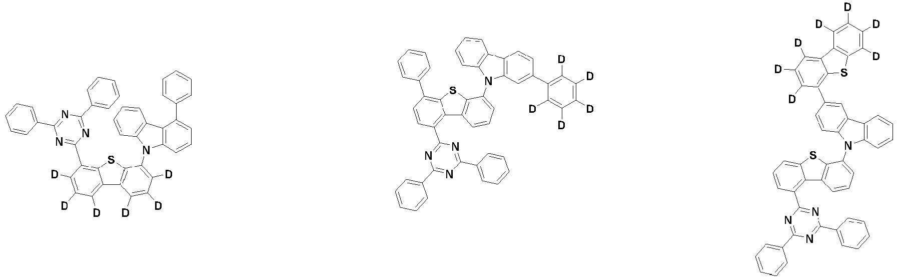

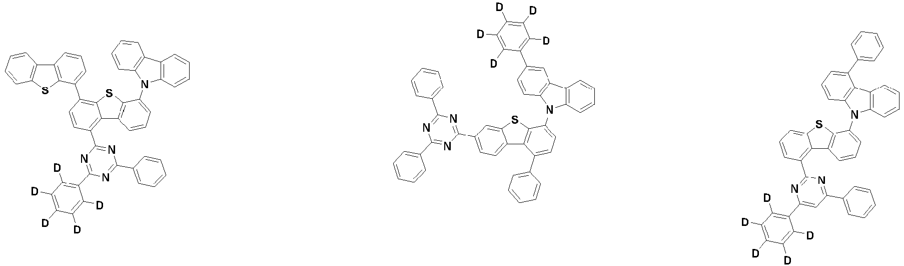

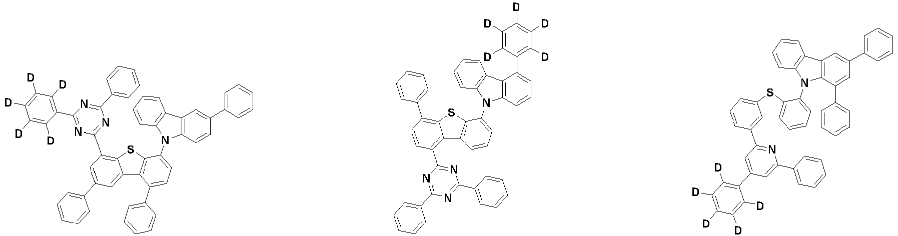

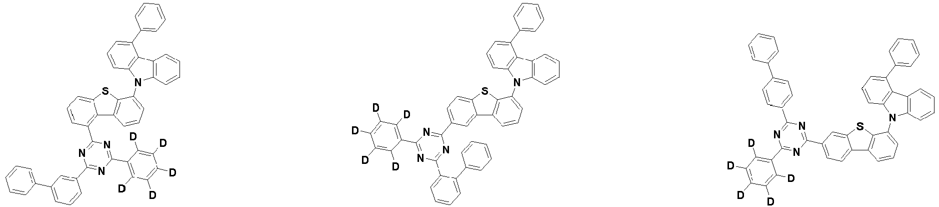

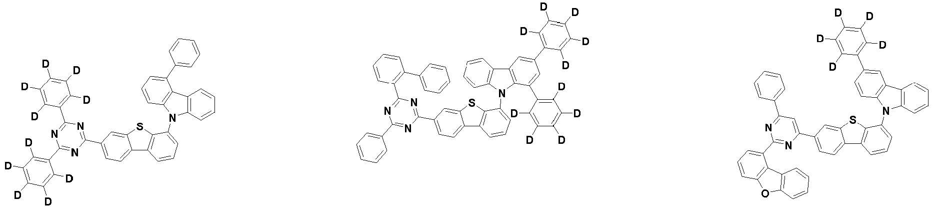

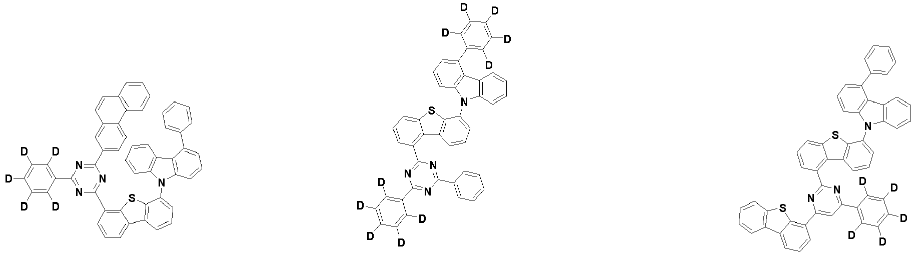

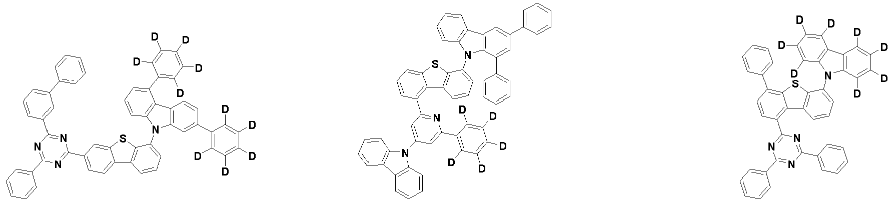

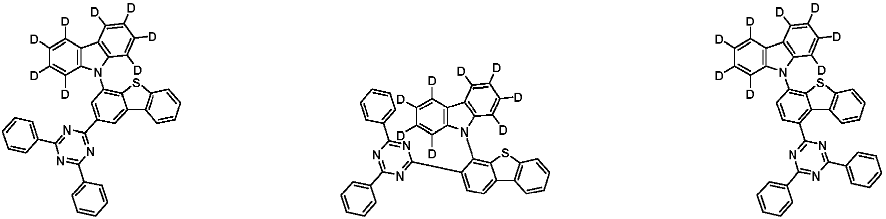

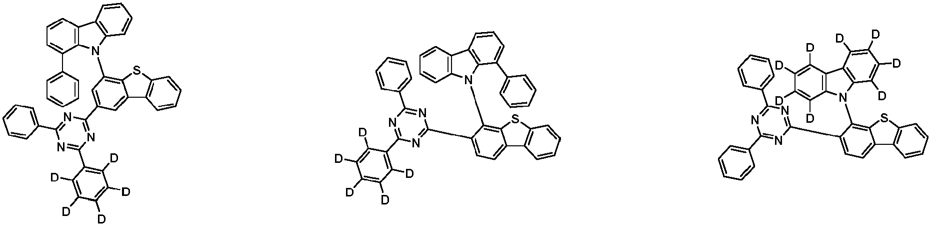

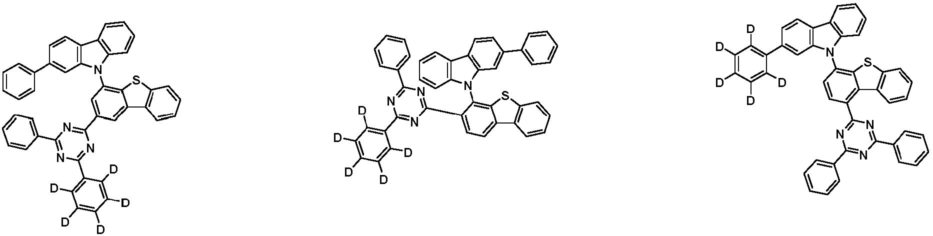

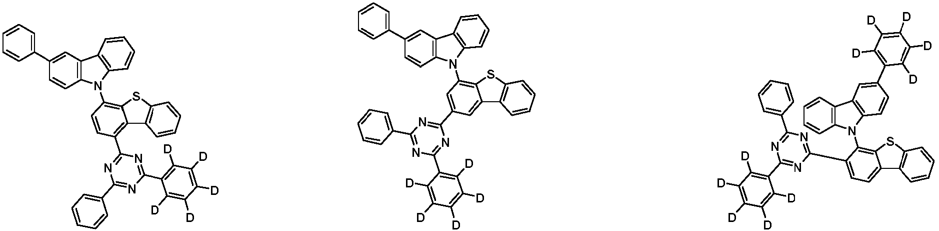

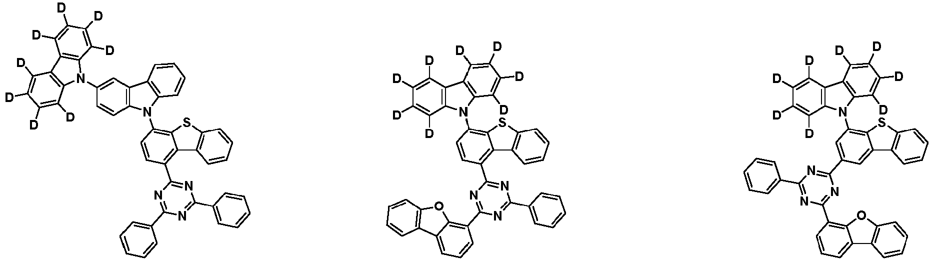

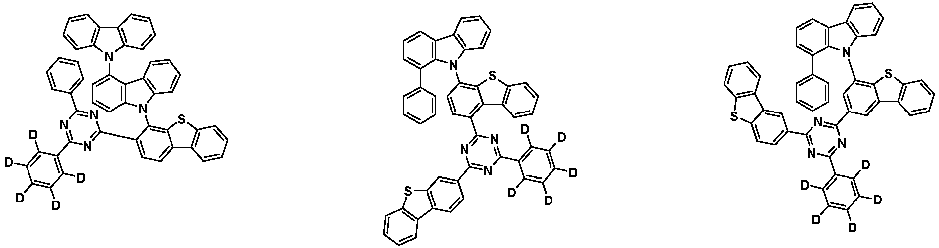

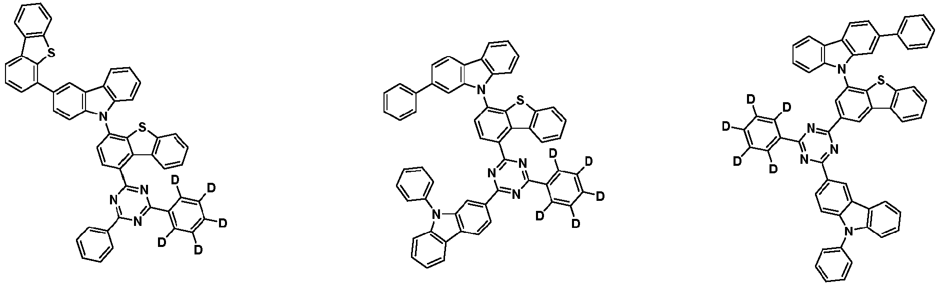

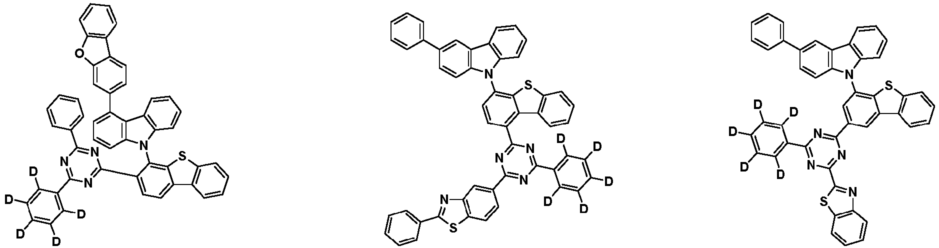

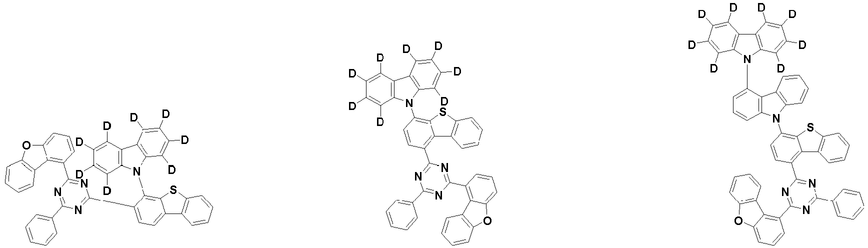

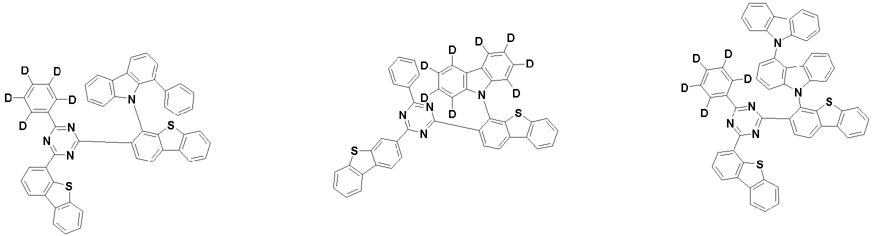

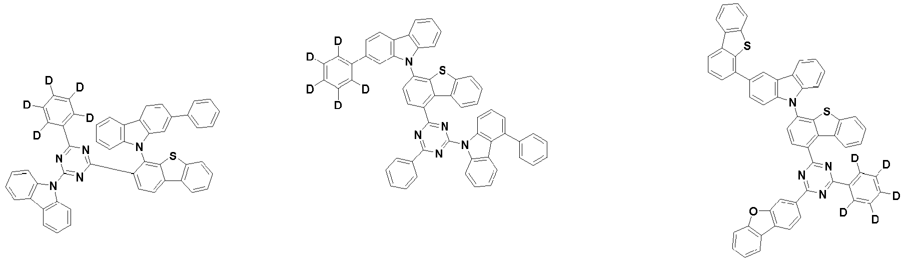

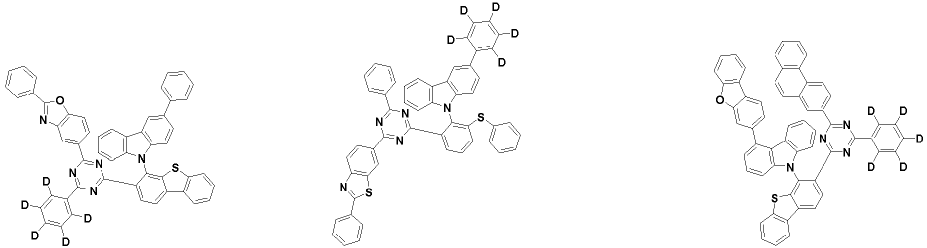

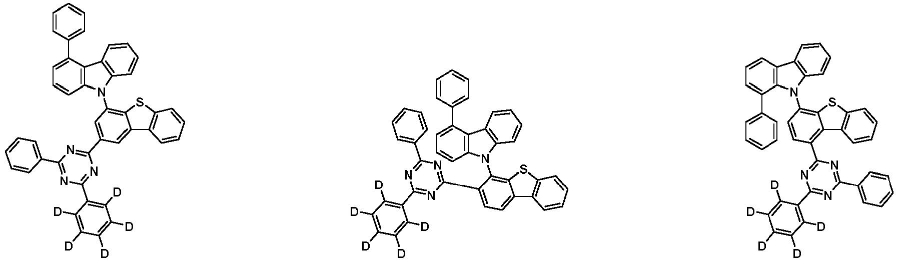

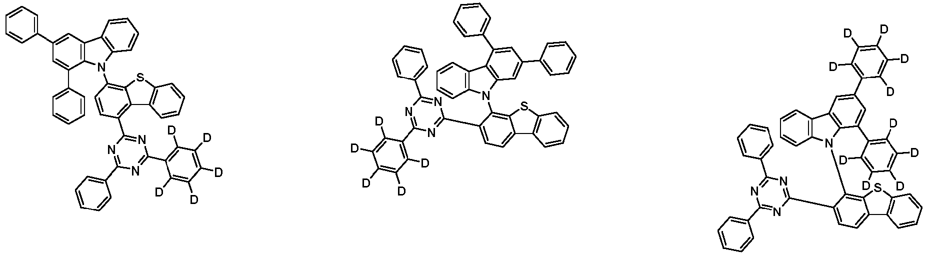

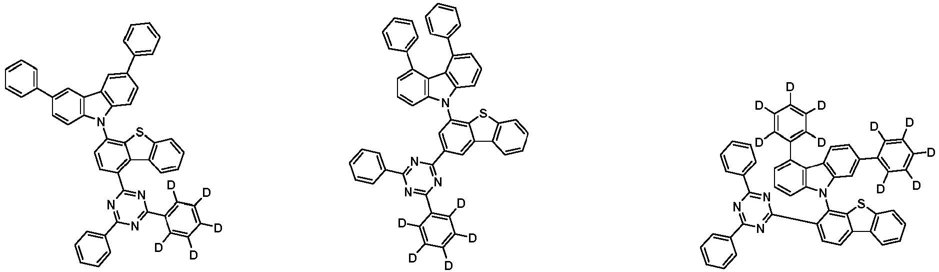

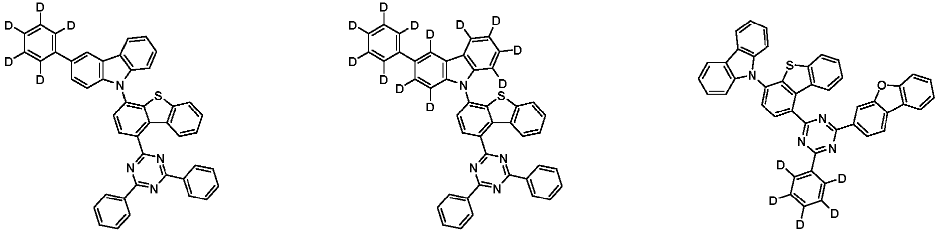

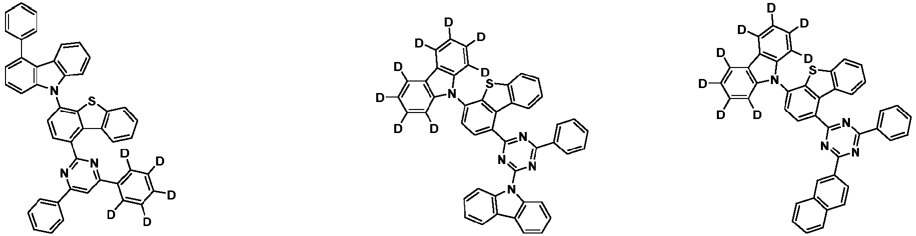

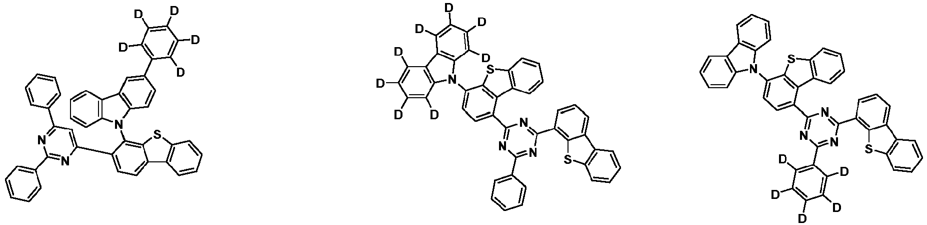

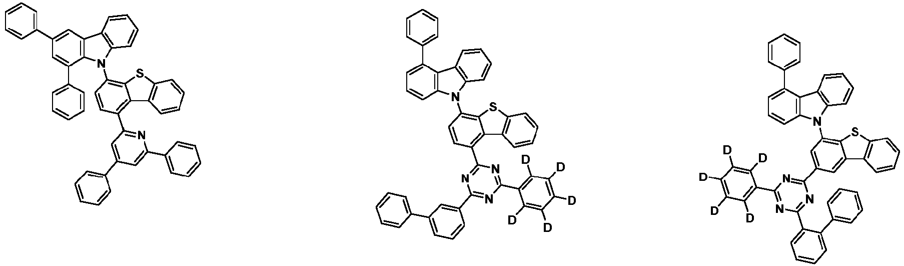

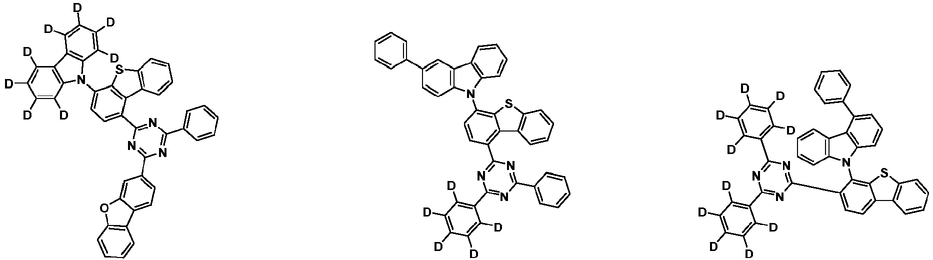

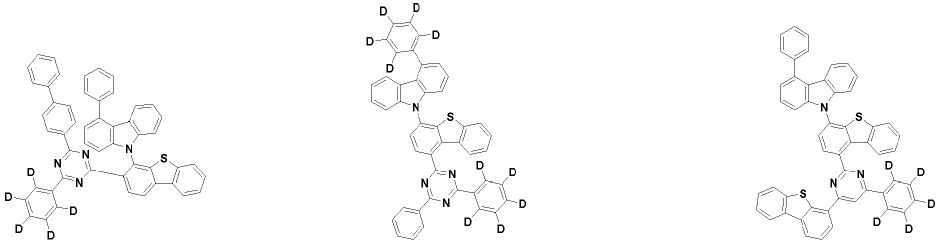

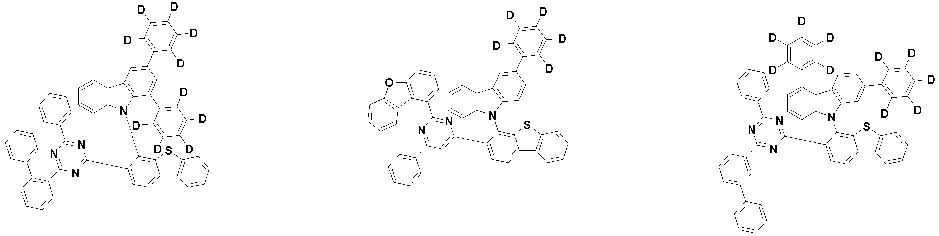

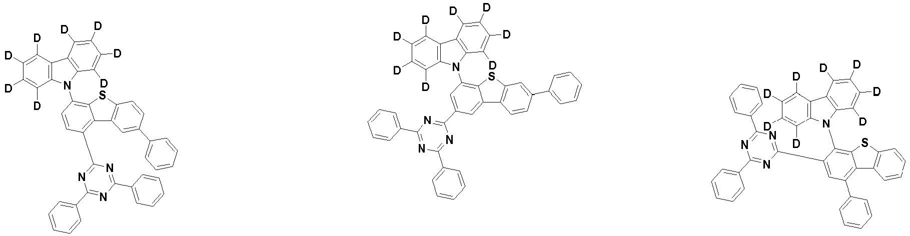

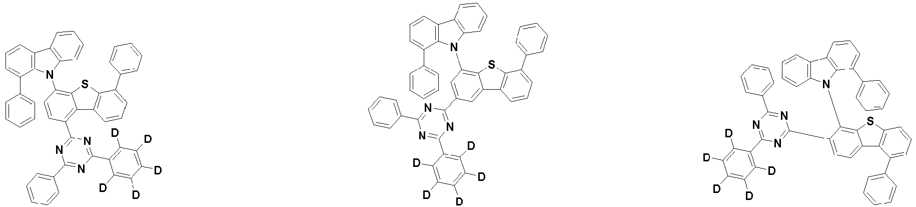

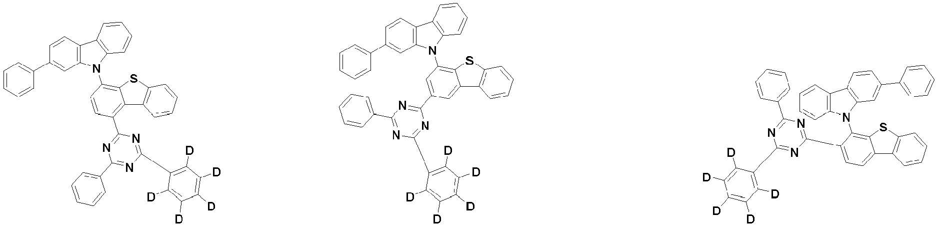

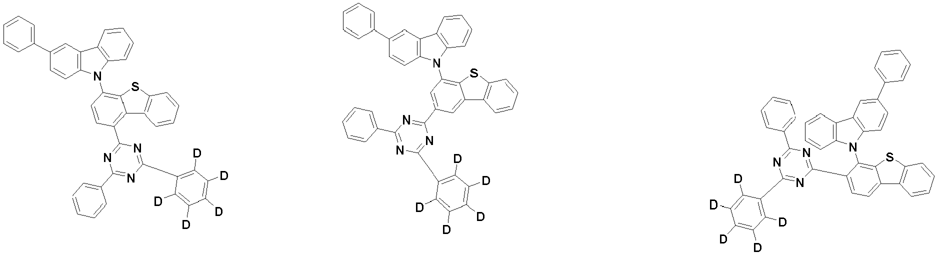

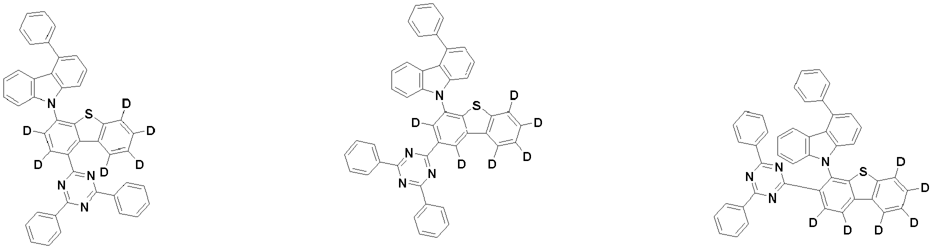

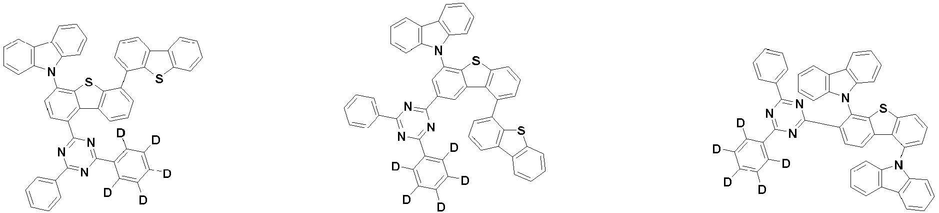

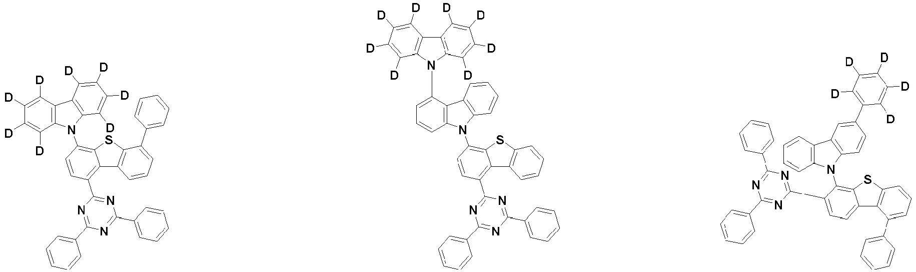

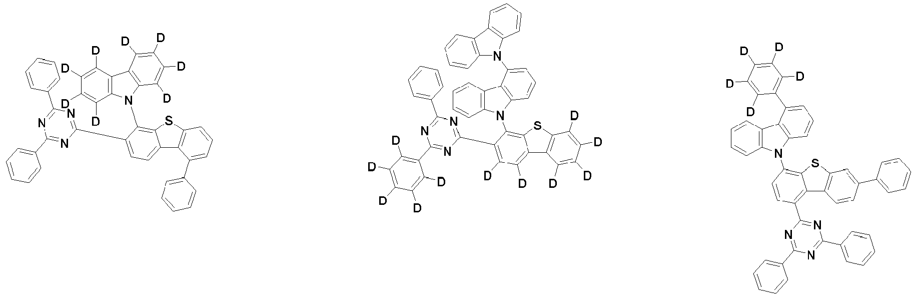

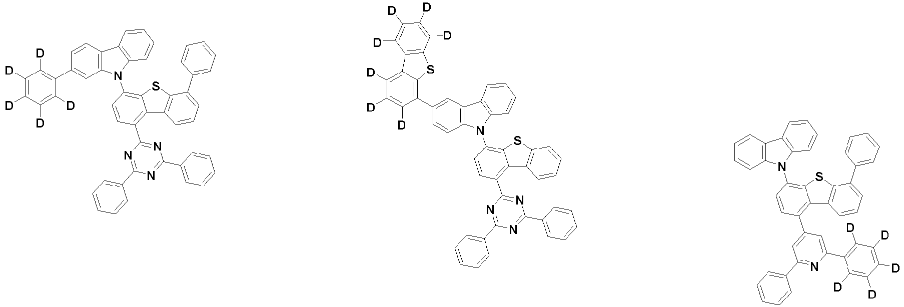

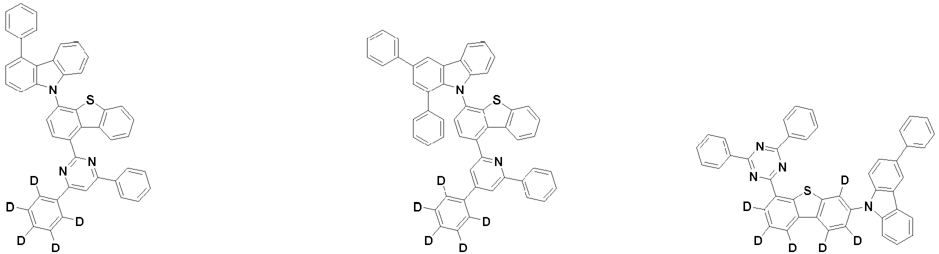

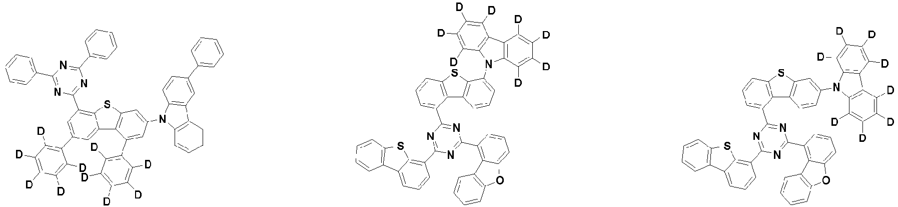

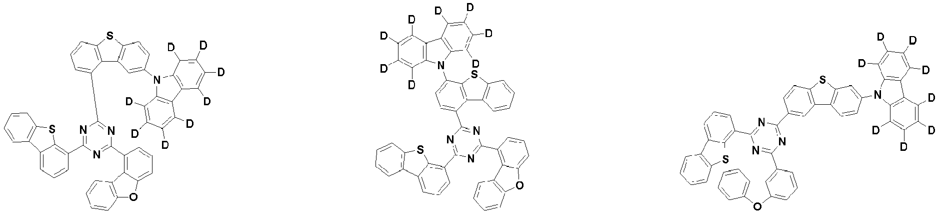

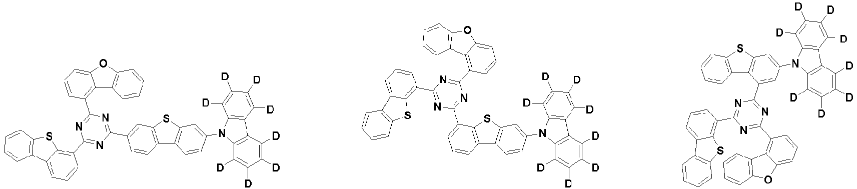

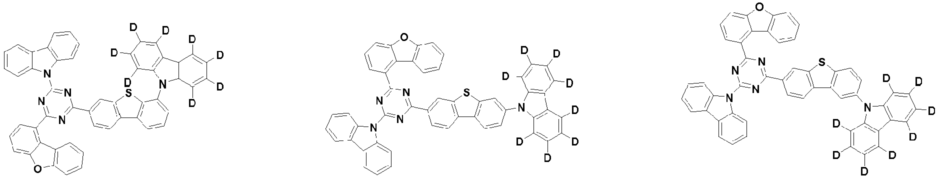

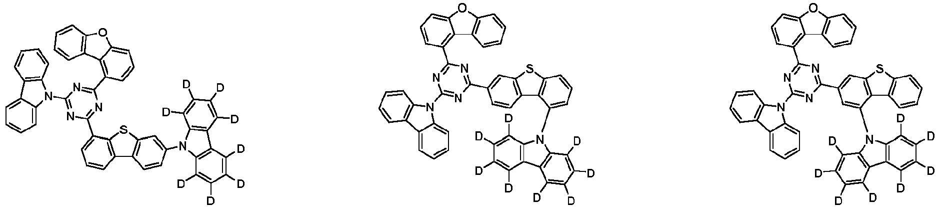

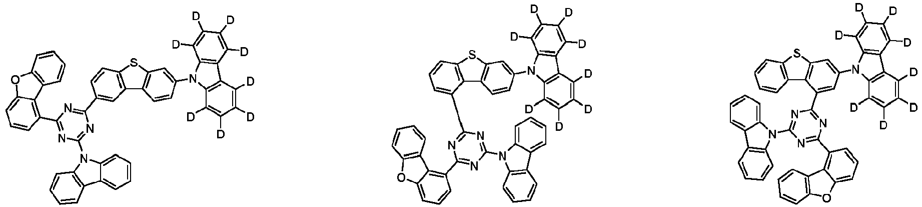

9. Organische lichtemittierende Vorrichtung nach Anspruch 1, wobei die durch die chemische Formel 2 dargestellte Verbindung durch eine beliebige der folgenden chemischen Formeln 2-1 bis 2-5 dargestellt wird: 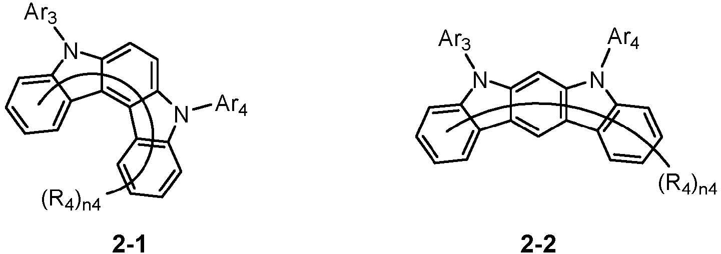 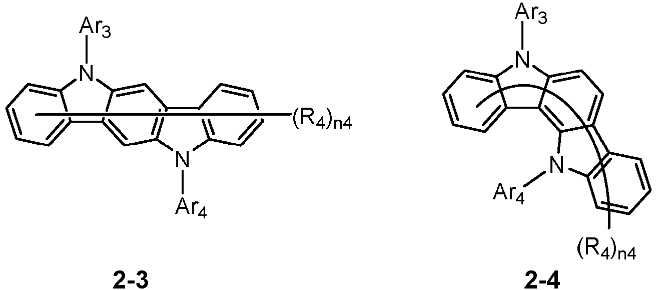 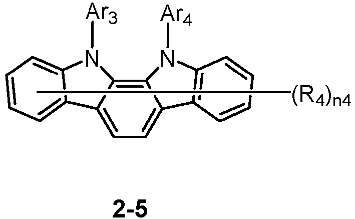 in den chemischen Formeln 2-1 bis 2-5, sind Ar₃, Ar₄, R₄ und n4 wie in Anspruch 1 definiert.

10. Organische lichtemittierende Vorrichtung nach Anspruch 1,
wobei Ar₃ und Ar₄ jeweils unabhängig Phenyl, Biphenylyl, Terphenylyl, Dibenzofuranyl, Dibenzothiophenyl, Dimethylfluorenyl, Dibenzofuranylphenyl, Dibenzothiophenylphenyl oder Dimethylfluorenylphenyl sind, und
das Phenyl, Biphenylyl, Terphenylyl, Dibenzofuranyl, Dibenzothiophenyl, Dimethylfluorenyl, Dibenzofuranylphenyl, Dibenzothiophenylphenyl oder Dimethylfluorenylphenyl unsubstituiert oder mit Deuterium substituiert ist,
mit der Maßgabe, dass mindestens eines aus Ar₃ und Ar₄ mit mindestens einem Deuterium substituiert ist.

11. Organische lichtemittierende Vorrichtung nach Anspruch 1, wobei Ar₃ und Ar₄ jeweils unabhängig ausgewählt sind aus der Gruppe bestehend aus den folgenden Strukturformeln, mit der Maßgabe, dass mindestens eines aus Ar₃ und Ar₄ mit mindestens einem Deuterium substituiert ist: 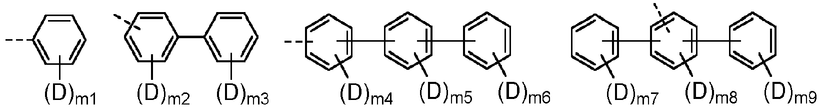 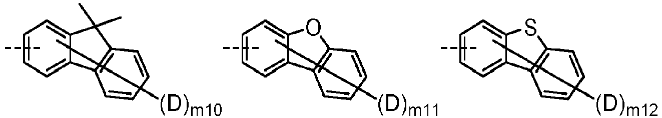 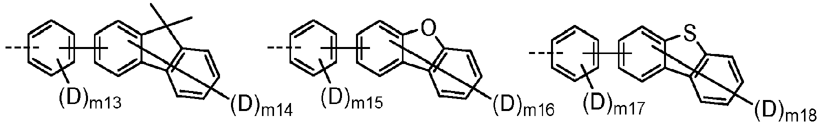 worin, in den obigen Strukturformeln:
m1 eine ganze Zahl von 0 bis 5 ist,
m2 eine ganze Zahl von 0 bis 4 ist,
m3 eine ganze Zahl von 0 bis 5 ist,
m4 eine ganze Zahl von 0 bis 4 ist,
m5 eine ganze Zahl von 0 bis 4 ist,
m6 eine ganze Zahl von 0 bis 5 ist,
m7 eine ganze Zahl von 0 bis 5 ist,
m8 eine ganze Zahl von 0 bis 3 ist,
m9 eine ganze Zahl von 0 bis 5 ist,
m10 eine ganze Zahl von 0 bis 13 ist,
m11 eine ganze Zahl von 0 bis 7 ist,
m12 eine ganze Zahl von 0 bis 7 ist,
m13 eine ganze Zahl von 0 bis 4 ist,
m14 eine ganze Zahl von 0 bis 13 ist,
m15 eine ganze Zahl von 0 bis 4 ist,
m16 eine ganze Zahl von 0 bis 7 ist,
m17 eine ganze Zahl von 0 bis 4 ist, und
m18 eine ganze Zahl von 0 bis 7 ist,
mit der Maßgabe, dass mindestens eines aus m1 bis m18 1 oder mehr ist.

12. Organische lichtemittierende Vorrichtung nach Anspruch 1, wobei jedes R₄ unabhängig Wasserstoff oder Deuterium ist, mit der Maßgabe, dass mindestens ein R₄ Deuterium ist.

13. Organische lichtemittierende Vorrichtung nach Anspruch 1, wobei die durch die chemische Formel 2 dargestellte Verbindung durch eine beliebeige der chemischen Formeln 2A-1 bis 2A-9, der chemischen Formel 2B-1 bis 2B-8, der chemischen Formel 2C-1 bis 2C-7, der chemischen Formel 2D-1 bis 2D-6, der chemischen Formel 2E-1 bis 2E-5 und der chemischen Formel 2F-1 bis 2F-3 dargestellt ist: 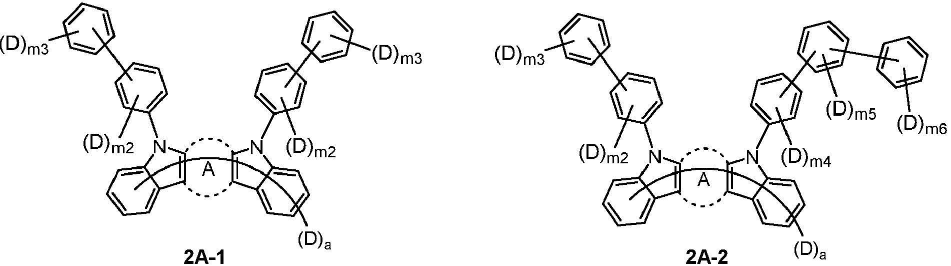 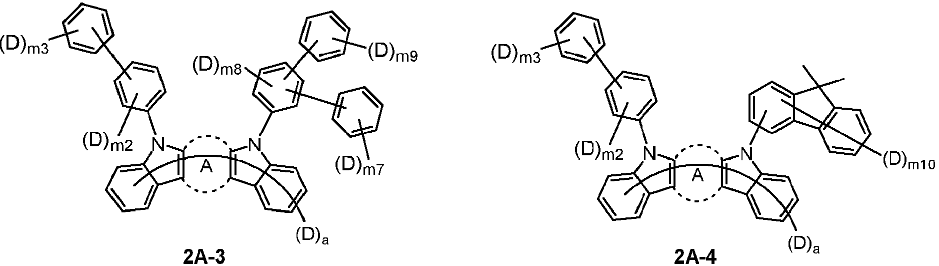 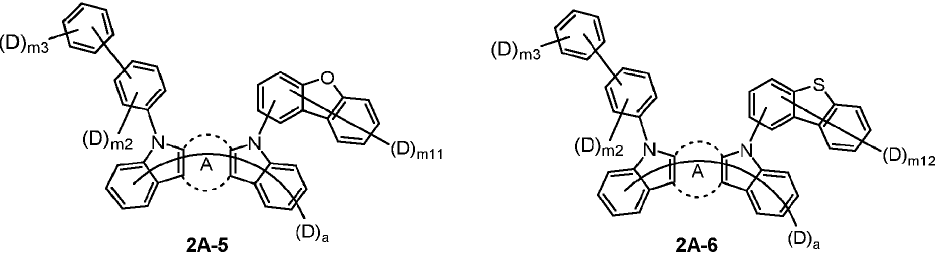 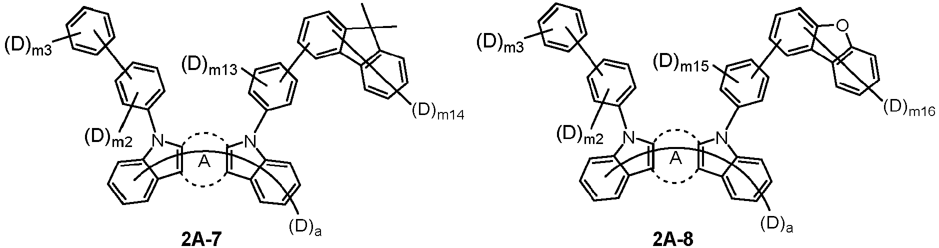 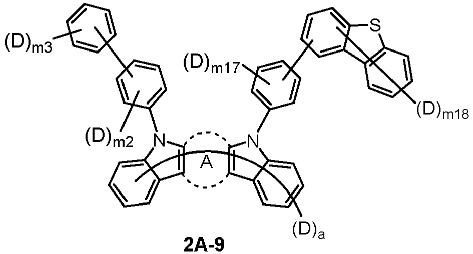 worin, in der chemischen Formel 2A-1 bis zur chemischen Formel 2A-9:
A wie in Anspruch 1 definiert ist;
a eine ganze Zahl von 1 bis 10 ist;
m2, m4, m5, m13, m15 und m17 jeweils unabhängig eine ganze Zahl von 0 bis 4 sind;
m3, m6, m7 und m9 jeweils unabhängig eine ganze Zahl von 0 bis 5 sind;
m8 eine ganze Zahl von 0 bis 3 ist;
m10 und m14 jeweils unabhängig eine ganze Zahl von 0 bis 13 sind; und
m11, m12, m16 und m18 jeweils unabhängig eine ganze Zahl von 0 bis 7 sind,
mit der Maßgabe, dass:
m2+m3 in der chemischen Formel 2A-1 1 bis 18 ist,
m2+m3+m4+m5+m6 in der chemischen Formel 2A-2 1 bis 22 ist,
m2+m3+m7+m8+m9 in der chemischen Formel 2A-3 1 bis 22 ist,
m2+m3+m10 in der chemischen Formel 2A-4 1 bis 22 ist,
m2+m3+m11 in der chemischen Formel 2A-5 1 bis 16 ist,
m2+m3+m12 in der chemischen Formel 2A-6 1 bis 16 ist,
m2+m3+m13+m14 in der chemischen Formel 2A-7 1 bis 26 ist,
m2+m3+m15+m16 in der chemischen Formel 2A-8 1 bis 20 ist, oder
m2+m3+m17+m18 in der chemischen Formel 2A-9 1 bis 20 ist; 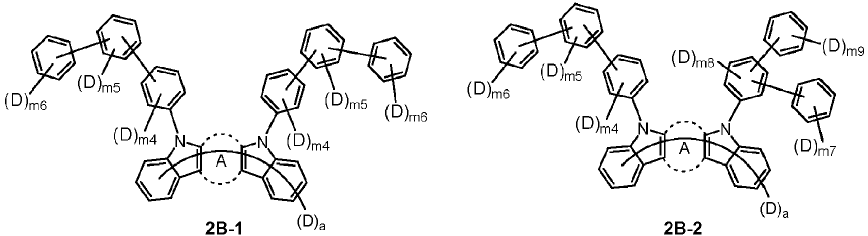 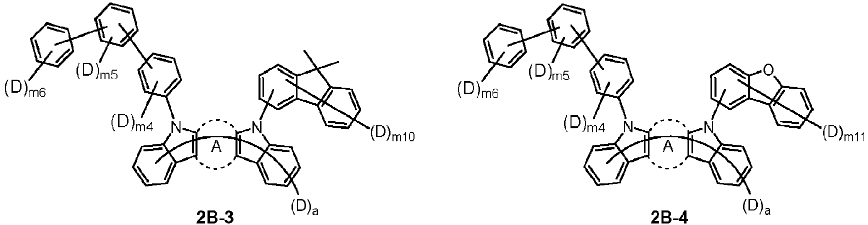 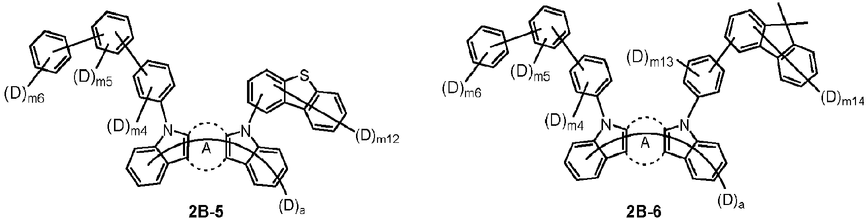 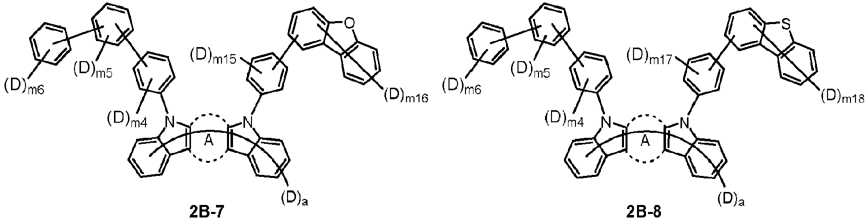
worin, in der chemischen Formel 2B-1 bis zur chemischen Formel 2B-8:
A wie in Anspruch 1 definiert ist;
a eine ganze Zahl von 1 bis 10 ist;
m4, m5, m13, m15 und m17 jeweils unabhängig eine ganze Zahl von 0 bis 4 sind;
m6, m7 und m9 jeweils unabhängig eine ganze Zahl von 0 bis 5 sind;
m8 eine ganze Zahl von 0 bis 3 ist;
m10 und m14 jeweils unabhängig eine ganze Zahl von 0 bis 13 sind, und
m11, m12, m16 und m18 jeweils unabhängig eine ganze Zahl von 0 bis 7 sind,
mit der Maßgabe, dass:
m4+m5+m6 in der chemischen Formel 2B-1 1 bis 26 ist,
m4+m5+m6+m7+m8+m9 in der chemischen Formel 2B-2 1 bis 26 ist,
m4+m5+m6+m10 in der chemischen Formel 2B-3 1 bis 26 ist,
m4+m5+m6+m11 in der chemischen Formel 2B-4 1 bis 20 ist,
m4+m5+m6+m12 in der chemischen Formel 2B-5 1 bis 20 ist,
m4+m5+m6+m13+m14 in der chemischen Formel 2B-6 1 bis 30 ist,
m4+m5+m6+m15+m16 in der chemischen Formel 2B-7 1 bis 24 ist, oder
m4+m5+m6+m17+m18 in der chemischen Formel 2B-8 1 bis 24 ist; 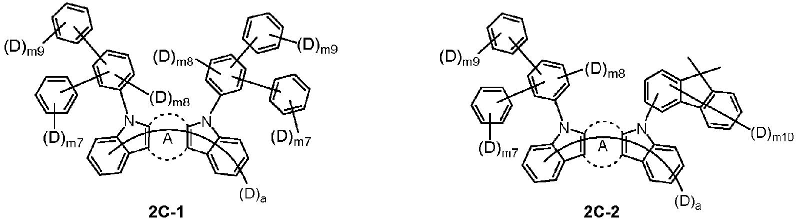 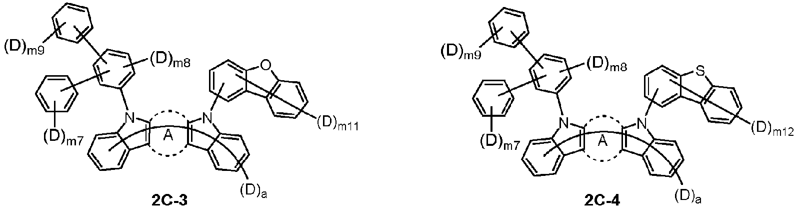 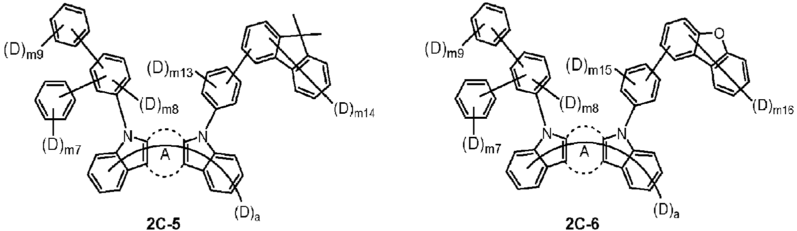 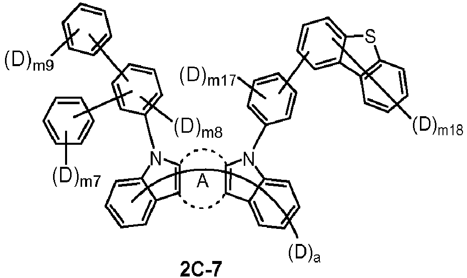
worin, in der chemischen Formel 2C-1 bis zur chemischen Formel 2C-7:
A wie in Anspruch 1 definiert ist;
a eine ganze Zahl von 1 bis 10 ist;
m7 und m9 jeweils unabhängig eine ganze Zahl von 0 bis 5 sind;
m8 eine ganze Zahl von 0 bis 3 ist;
m10 und m14 jeweils unabhängig eine ganze Zahl von 0 bis 13 sind;
m11, m12, m16 und m18 jeweils unabhängig eine ganze Zahl von 0 bis 7 sind; und
m13, m15 und m17 jeweils unabhängig eine ganze Zahl von 0 bis 4 sind,
mit der Maßgabe, dass:
m7+m8+m9 in der chemischen Formel 2C-1 1 bis 26 ist,
m7+m8+m9+m10 in der chemischen Formel 2C-2 1 bis 26 ist,
m7+m8+m9+m11 in der chemischen Formel 2C-3 1 bis 20 ist,
m7+m8+m9+m12 in der chemischen Formel 2C-4 1 bis 20 ist,
m7+m8+m9+m13+m14 in der chemischen Formel 2C-5 1 bis 30 ist,
m7+m8+m9+m15+m16 in der chemischen Formel 2C-6 1 bis 24 ist, oder
m7+m8+m9+m17+m18 in der chemischen Formel 2C-7 1 bis 24 ist; 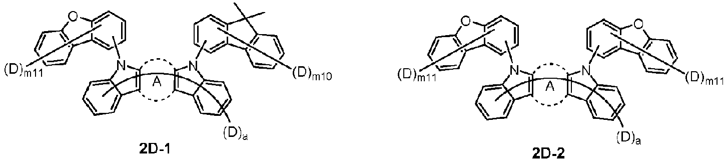 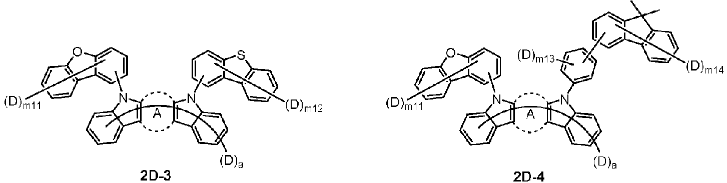 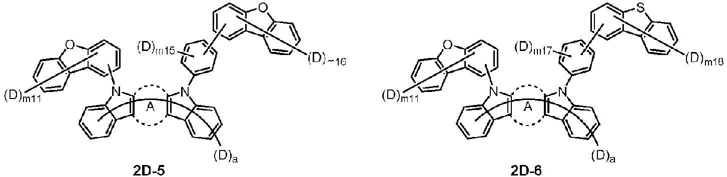
worin, in der chemischen Formel 2D-1 bis zur chemischen Formel 2D-6:
A wie in Anspruch 1 definiert ist;
a eine ganze Zahl von 1 bis 10 ist;
m10 und m14 jeweils unabhängig eine ganze Zahl von 0 bis 13 sind;
m11, m12, m16 und m18 jeweils unabhängig eine ganze Zahl von 0 bis 7 sind; und
m13, m15 und m17 jeweils unabhängig eine ganze Zahl von 0 bis 4 sind,
mit der Maßgabe, dass:
m10+m11 in der chemischen Formel 2D-1 1 bis 20 ist,
m11+m11 in der chemischen Formel 2D-2 1 bis 14 ist,
m11+m12 in der chemischen Formel 2D-3 1 bis 14 ist,
m11+m13+m14 in der chemischen Formel 2D-4 1 bis 24 ist,
m11+m15+m16 in der chemischen Formel 2D-5 1 bis 18 ist, oder
m11+m17+m18 in der chemischen Formel 2D-6 1 bis 18 ist; 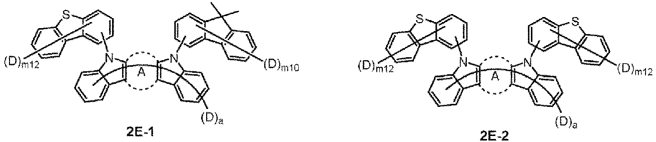 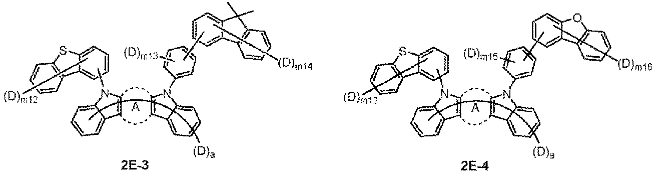 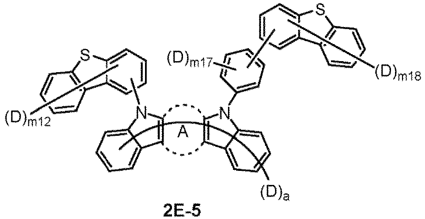
worin, in der chemischen Formel 2E-1 bis zur chemischen Formel 2E-5:
A wie in Anspruch 1 definiert ist;
a eine ganze Zahl von 1 bis 10 ist;
m10 und m14 jeweils unabhängig eine ganze Zahl von 0 bis 13 sind;
m12, m16 und m18 jeweils unabhängig eine ganze Zahl von 0 bis 7 sind; und
m13, m15 und m17 jeweils unabhängig eine ganze Zahl von 0 bis 4 sind,
mit der Maßgabe, dass:
m10+m12 in der chemischen Formel 2E-1 1 bis 20 ist,
m12+m12 in der chemischen Formel 2E-2 1 bis 14 ist,
m12+m13+m14 in der chemischen Formel 2E-3 1 bis 24 ist,
m12+m15+m16 in der chemischen Formel 2E-4 1 bis 18 ist, oder
m12+m17+m18 in der chemischen Formel 2E-5 1 bis 18 ist; 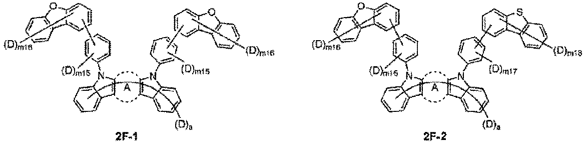 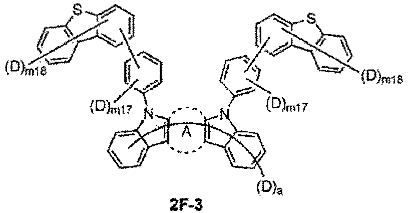
worin, in der chemischen Formel 2F-1 bis zur chemischen Formel 2F-3:
A wie in Anspruch 1 definiert ist;
a eine ganze Zahl von 1 bis 10 ist,
m15 und m17 jeweils unabhängig eine ganze Zahl von 0 bis 4 sind; und
m16 und m18 jeweils unabhängig eine ganze Zahl von 0 bis 7 sind,
mit der Maßgabe, dass:
m15+m16 in der chemischen Formel 2F-1 1 bis 22 ist,
m15+m16+m17+m18 in der chemischen Formel 2F-2 1 bis 22 ist, oder
m17+m18 in der chemischen Formel 2F-3 1 bis 22 ist.

14. Organische lichtemittierende Vorrichtung nach Anspruch 1, wobei ein Deuterium-Substitutionsverhältnis der chemischen Formel 2 50% bis 100% beträgt.

15. Organische lichtemittierende Vorrichtung nach Anspruch 1, wobei die durch die chemische Formel 2 dargestellte Verbindung eine beliebige Verbindung ist, ausgewählt aus der Gruppe bestehend aus:

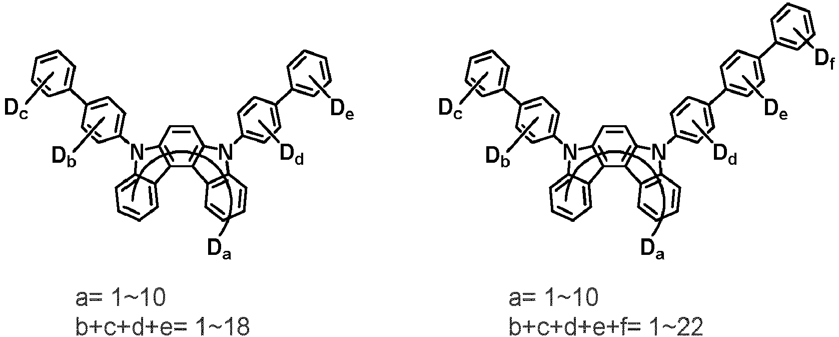

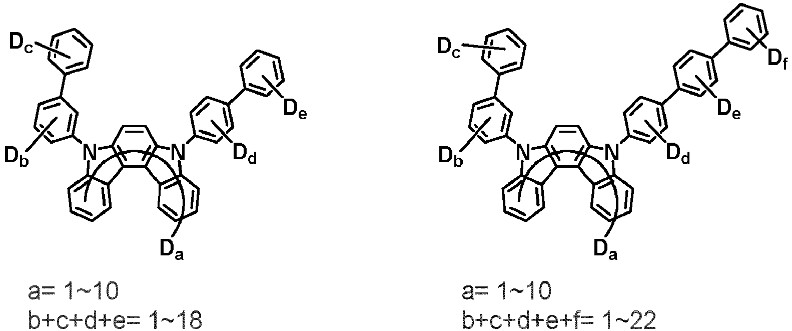

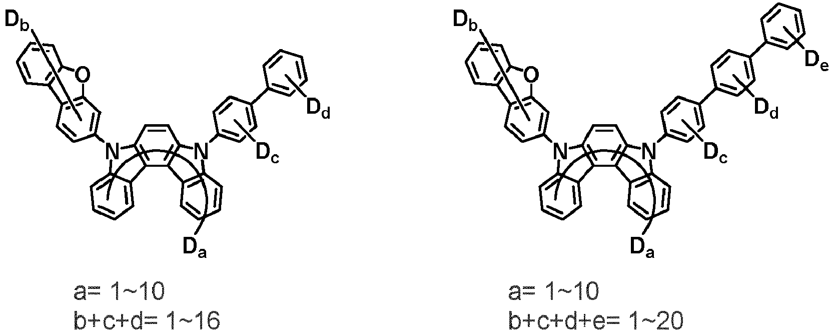

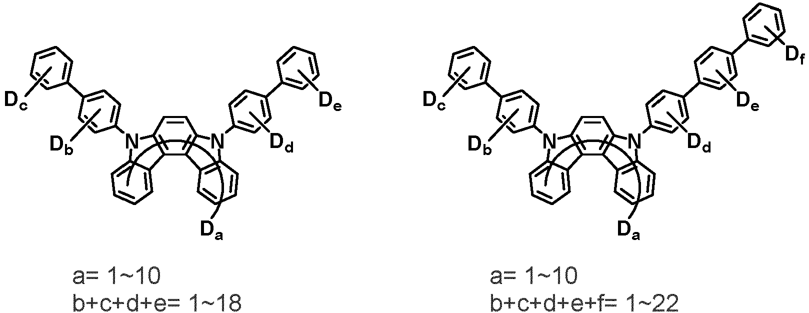

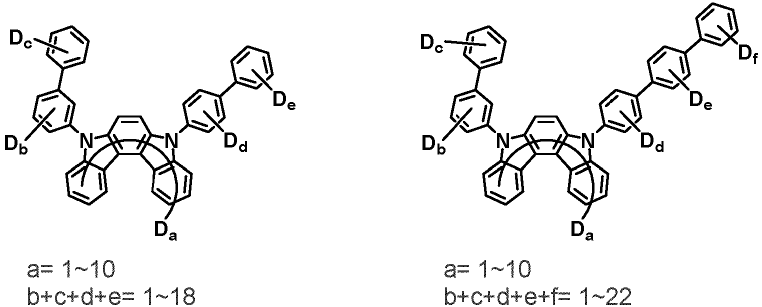

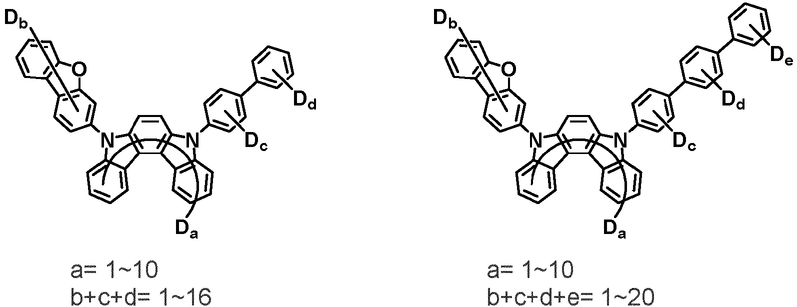

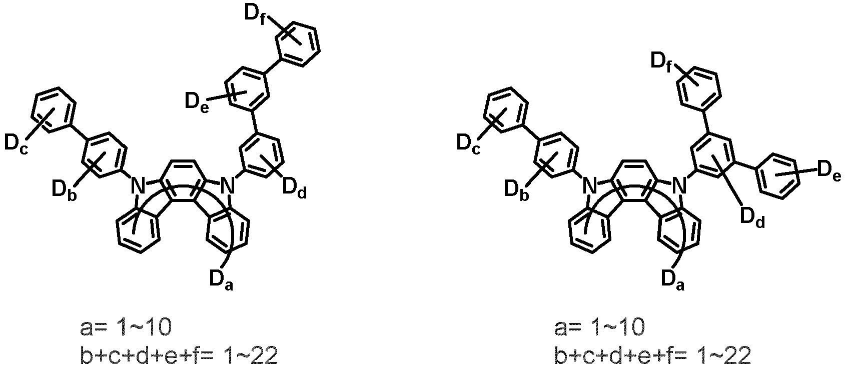

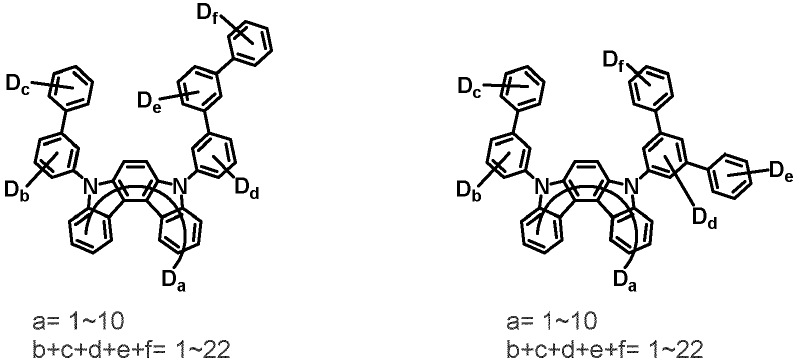

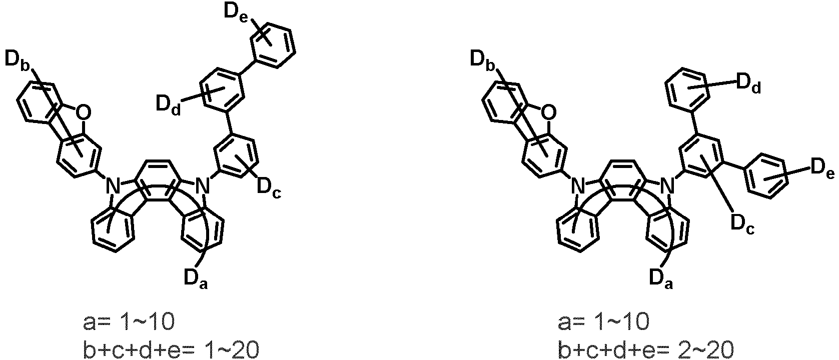

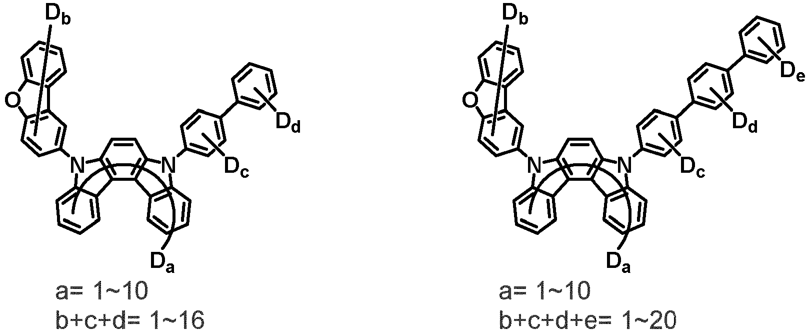

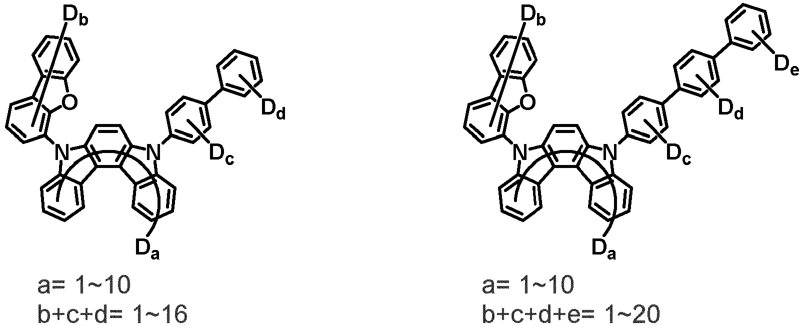

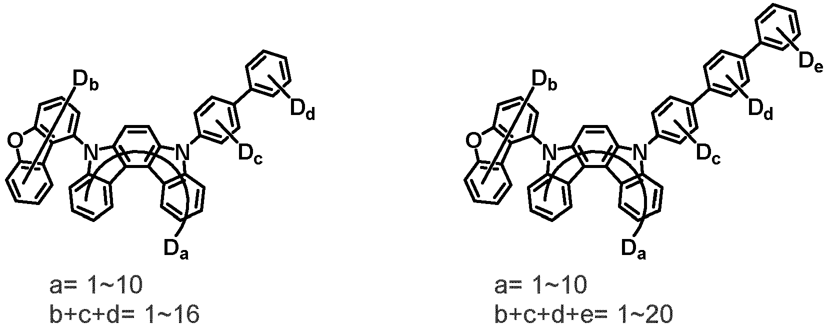

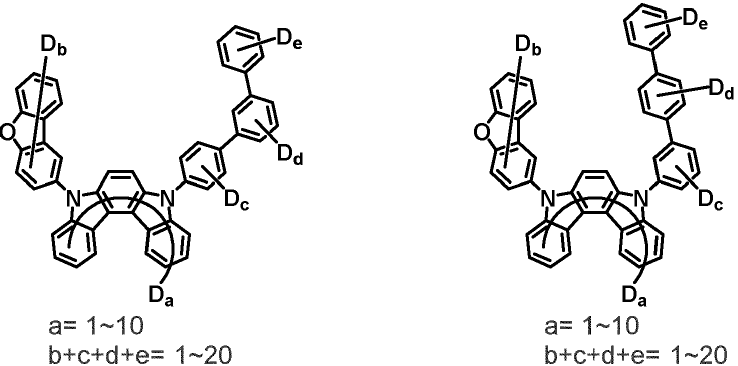

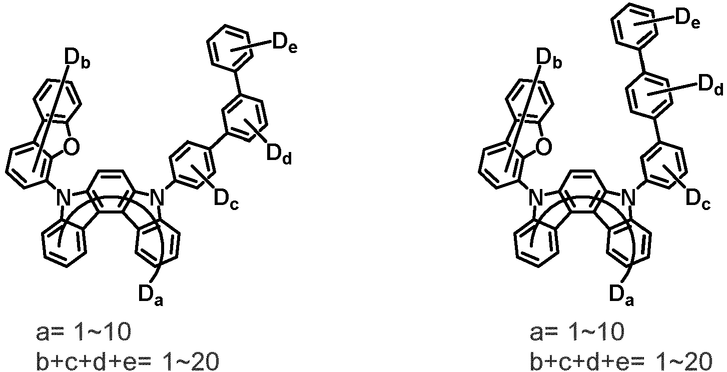

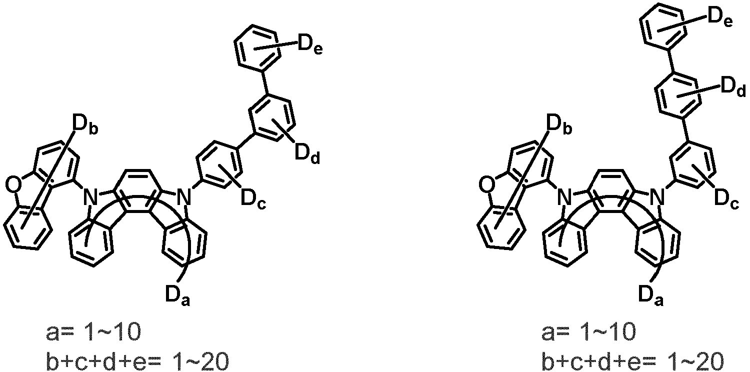

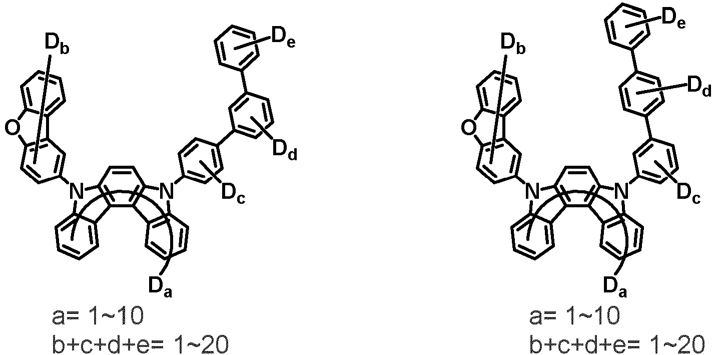

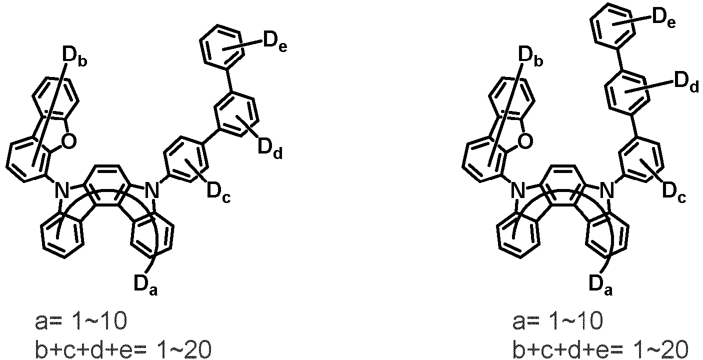

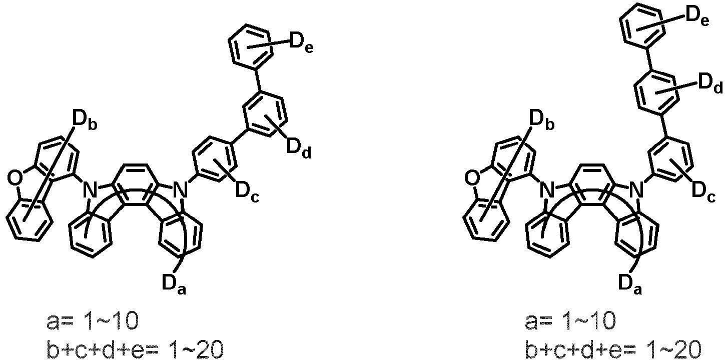

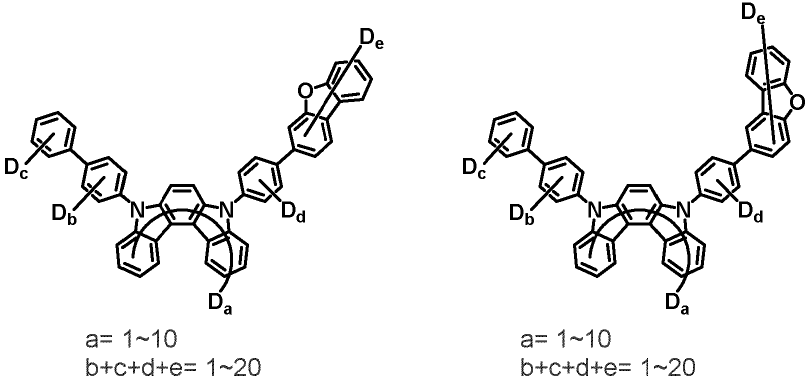

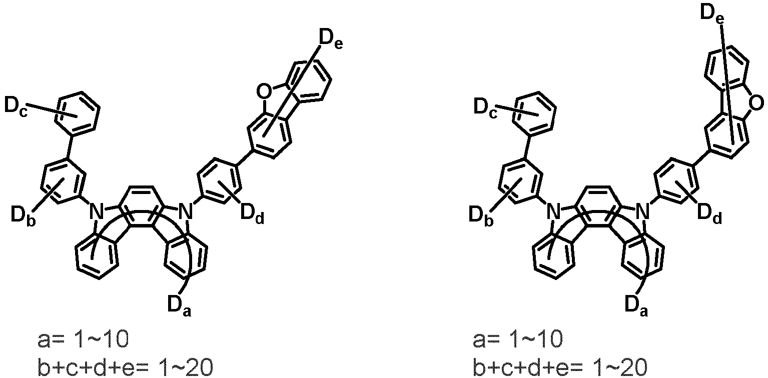

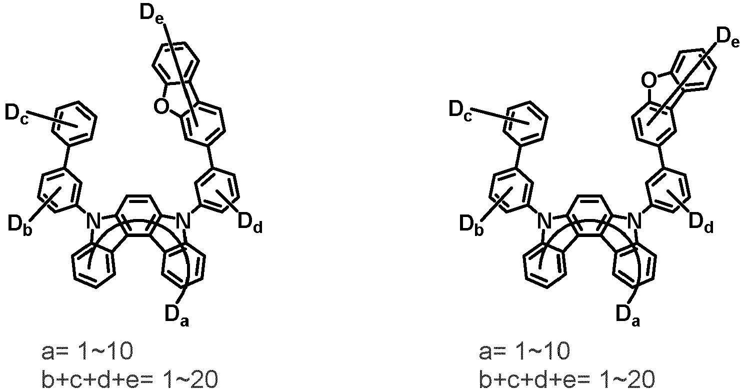

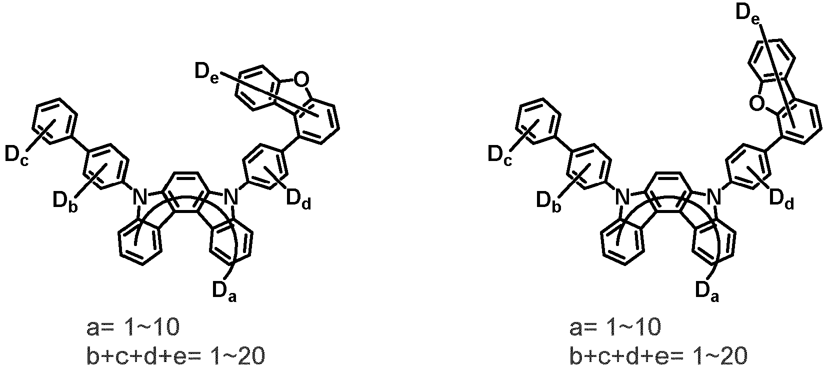

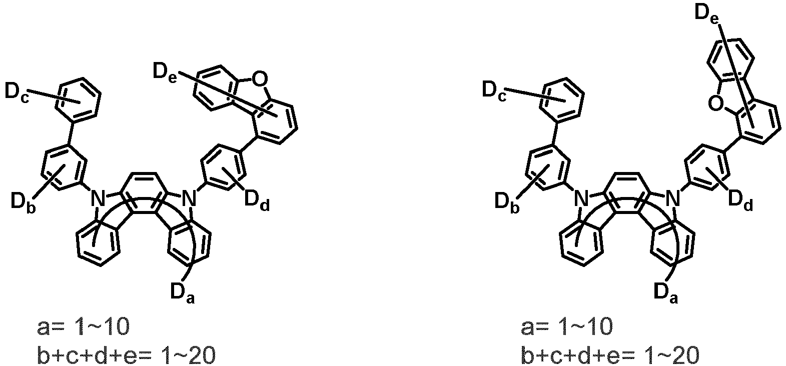

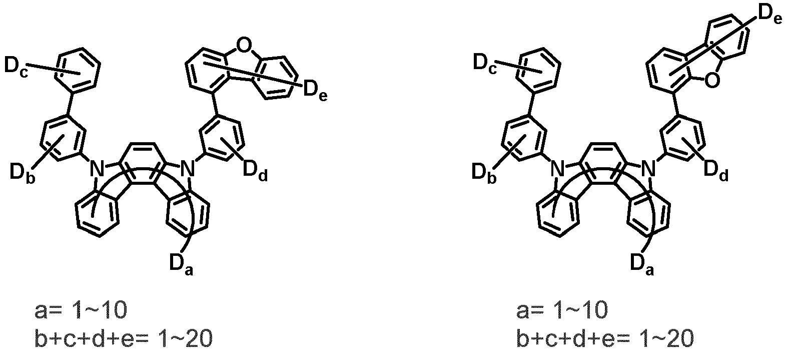

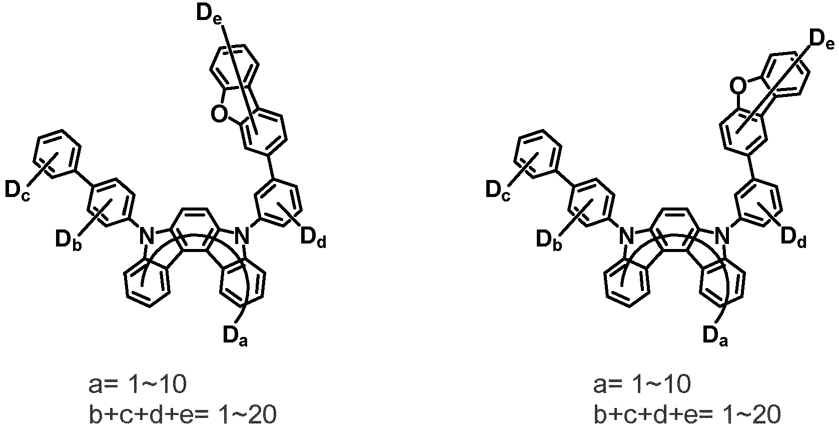

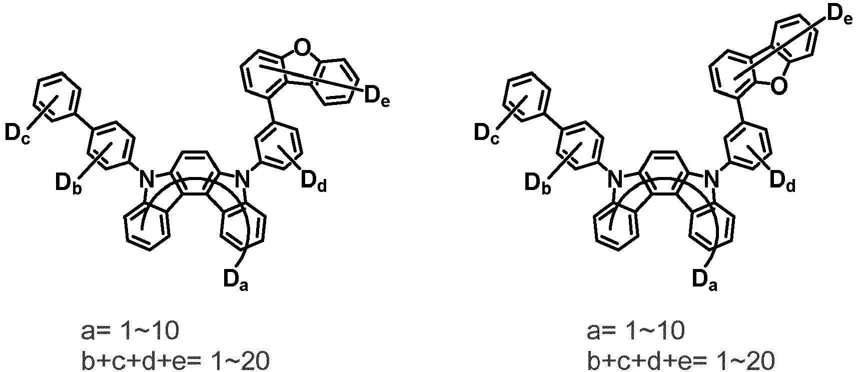

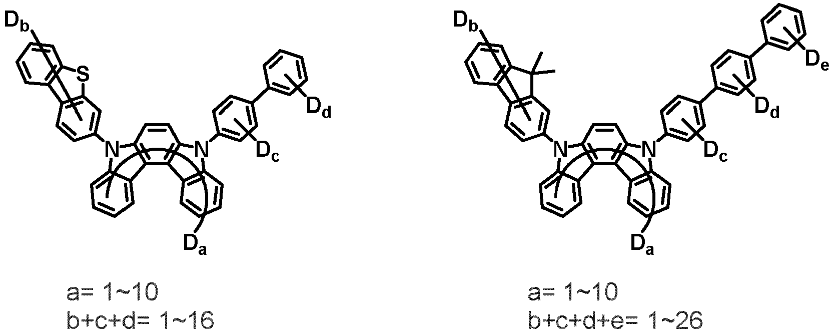

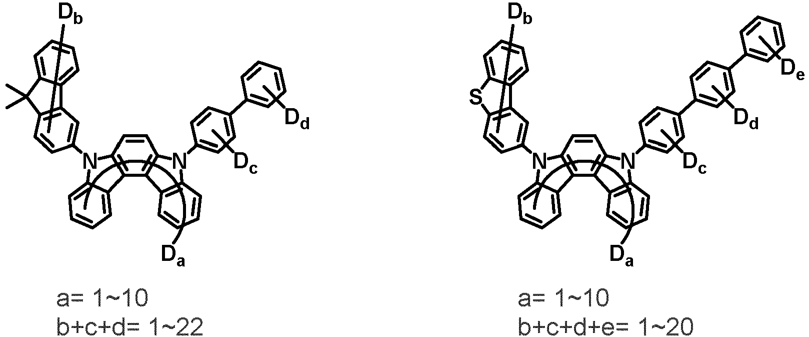

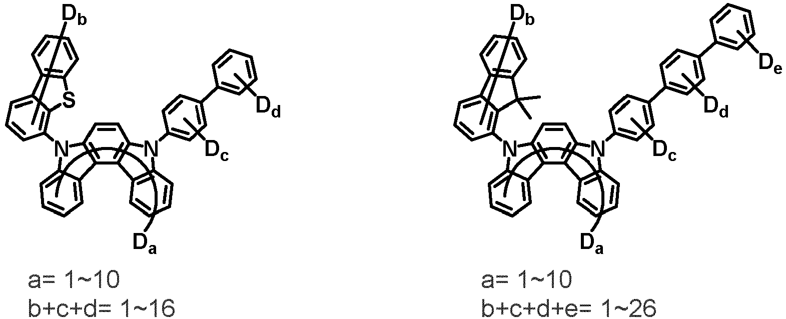

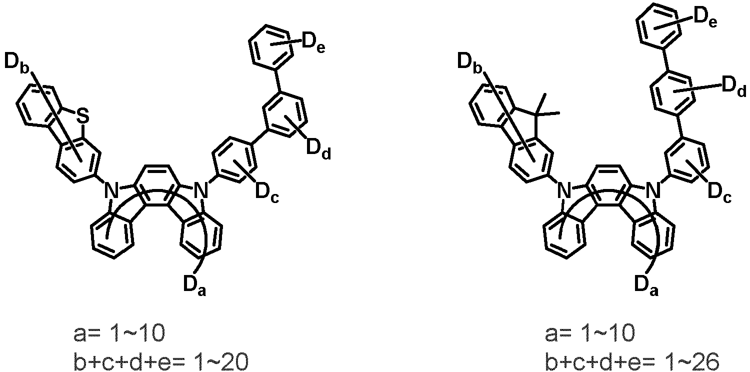

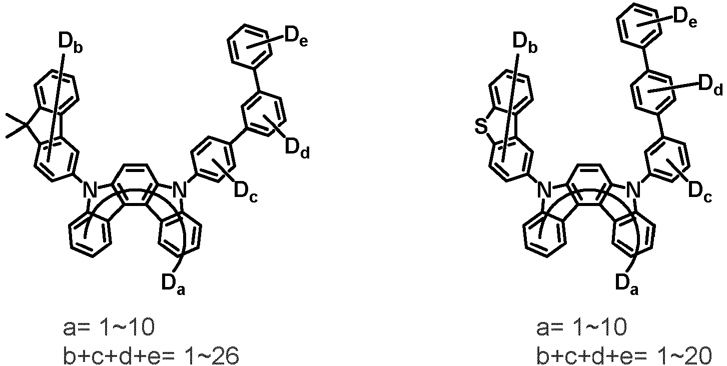

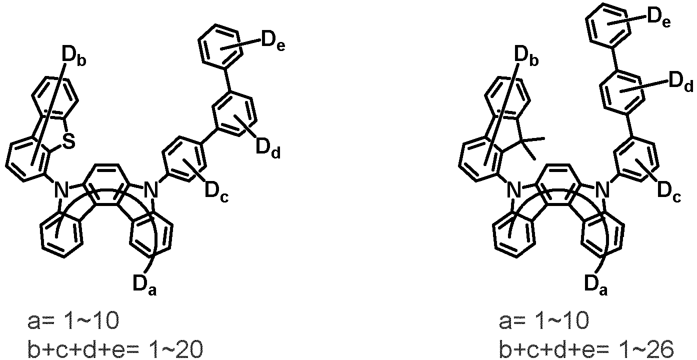

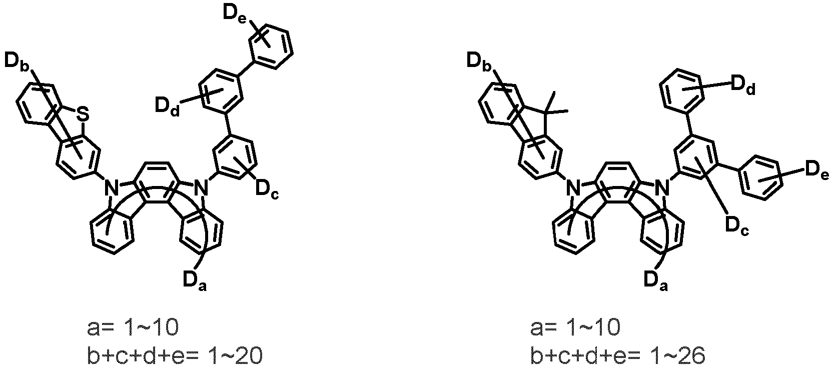

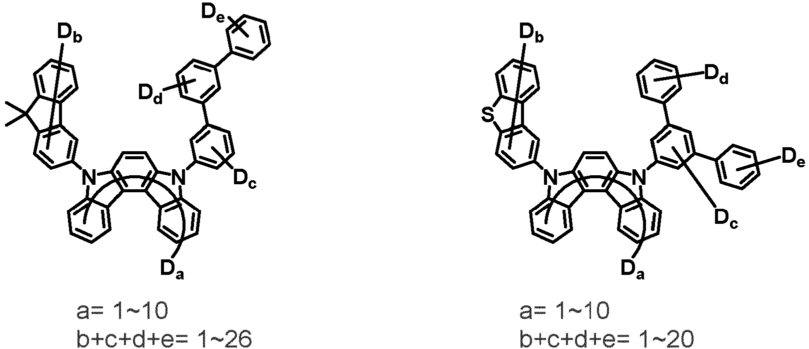

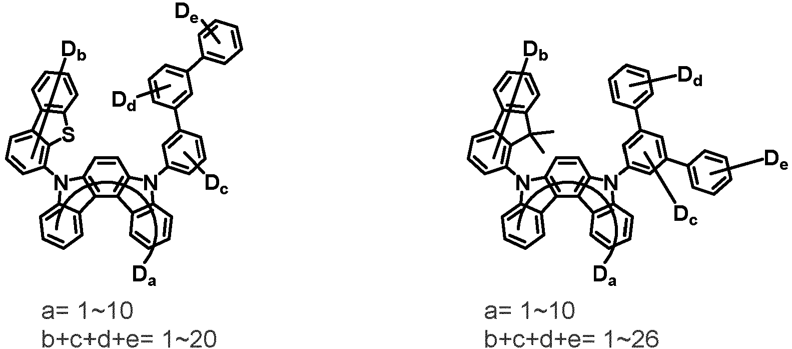

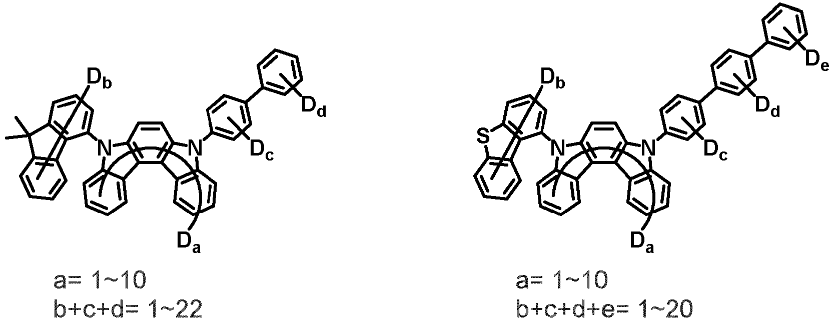

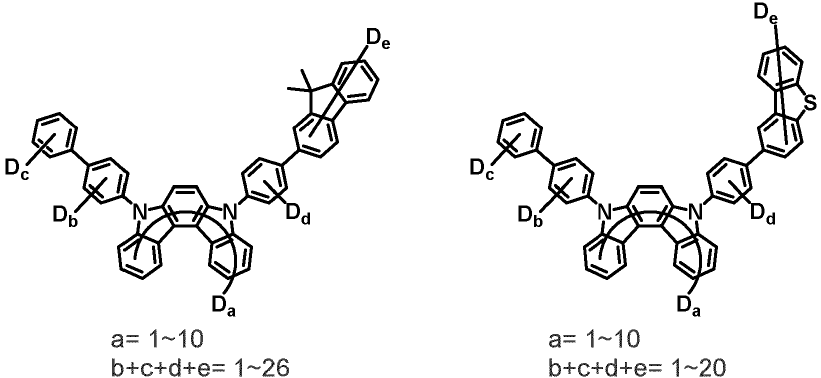

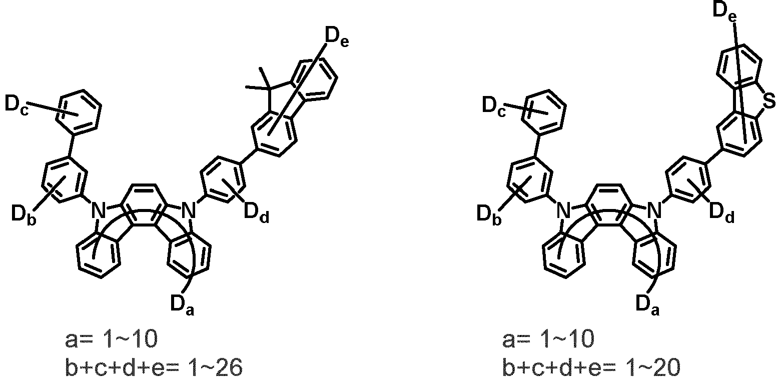

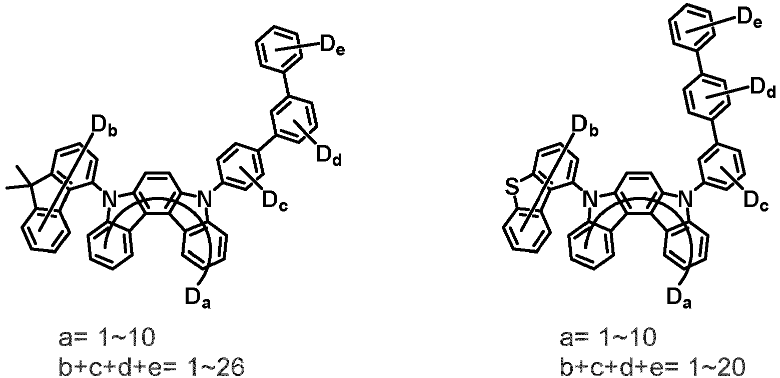

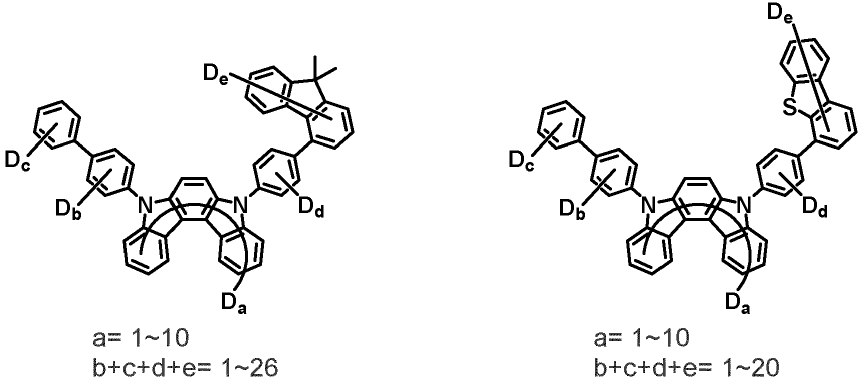

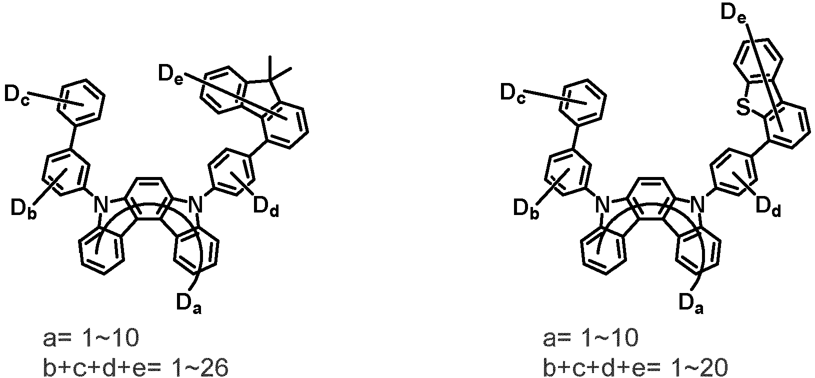

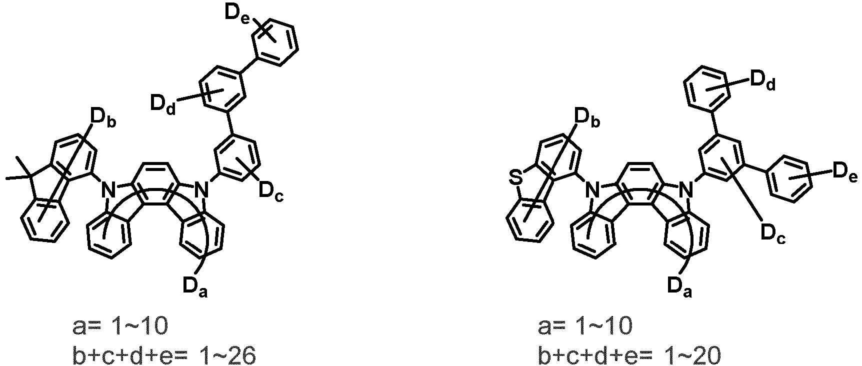

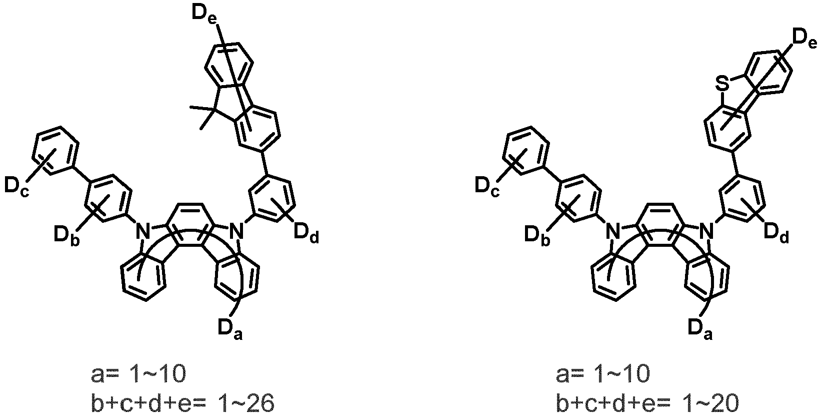

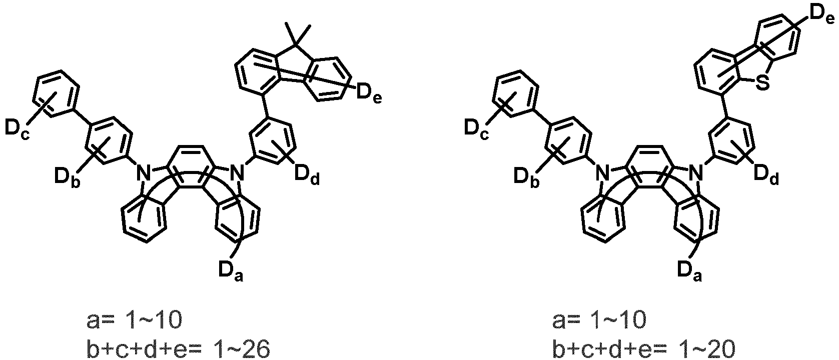

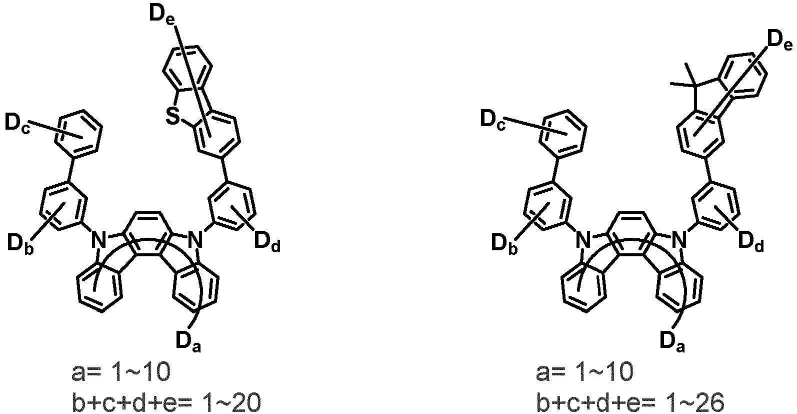

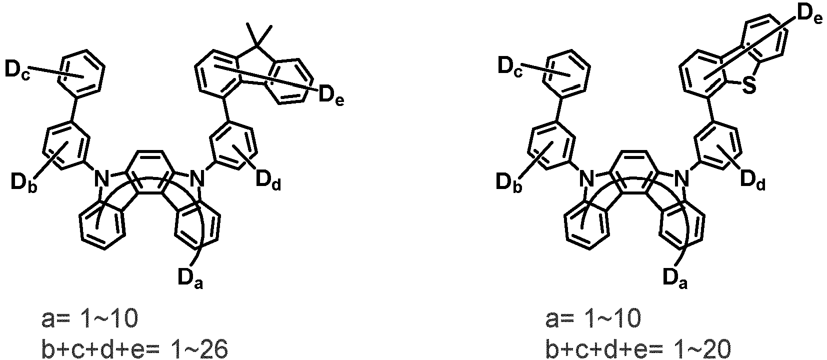

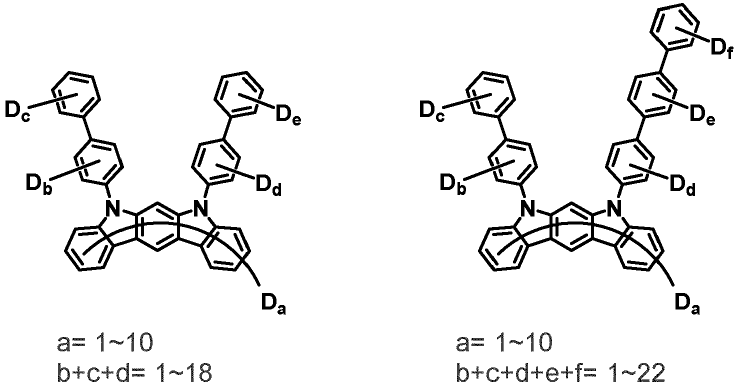

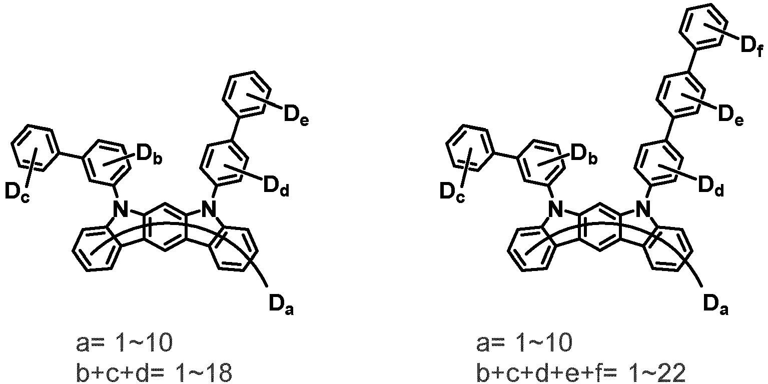

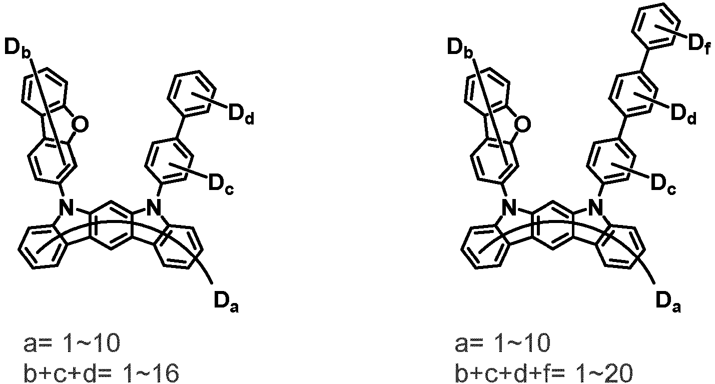

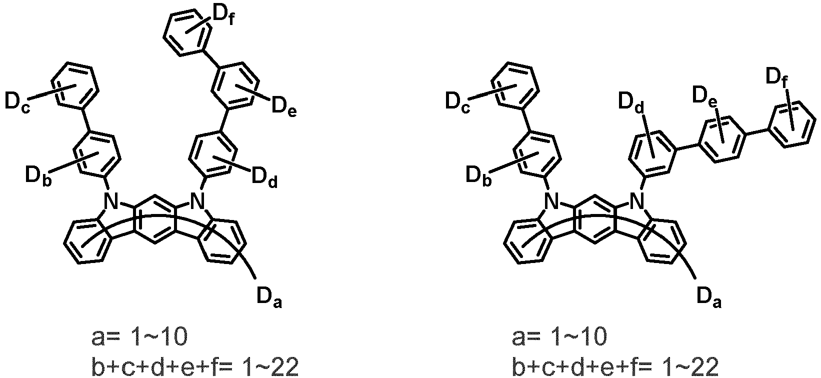

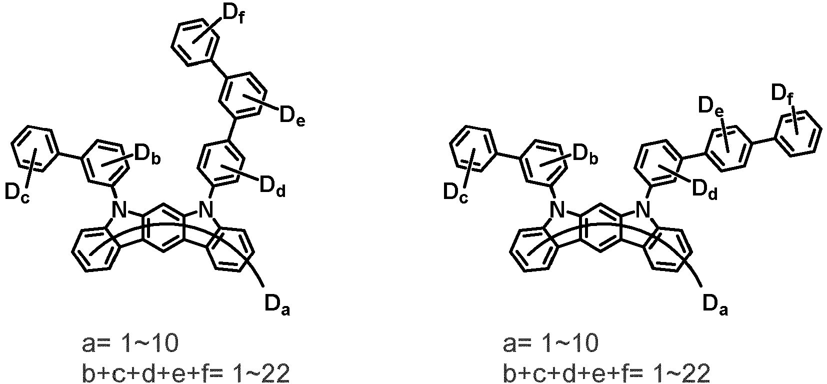

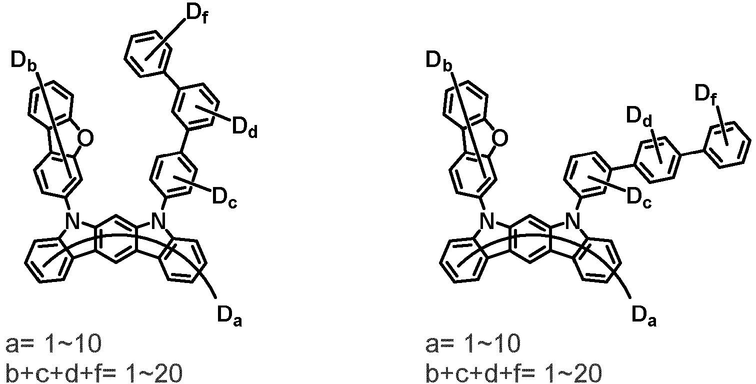

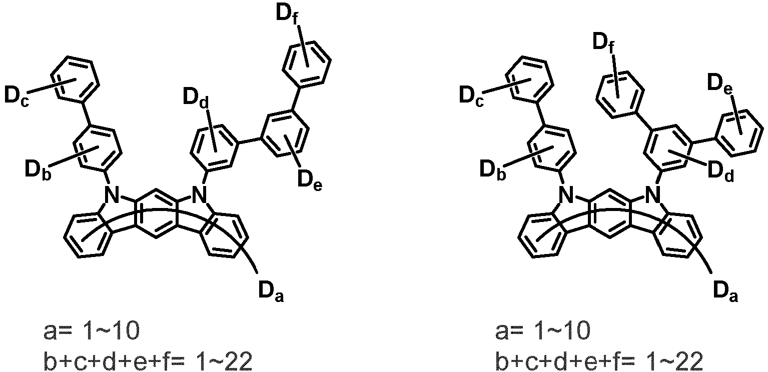

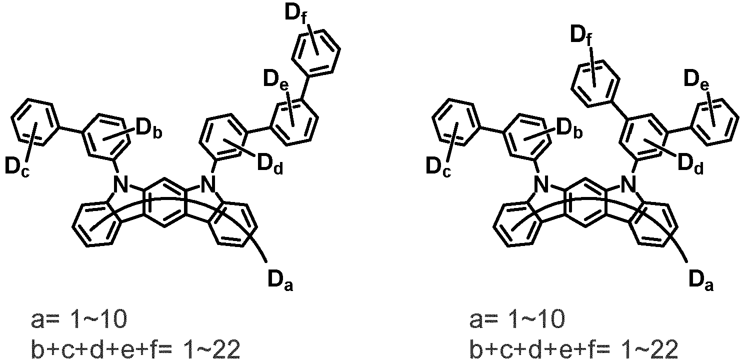

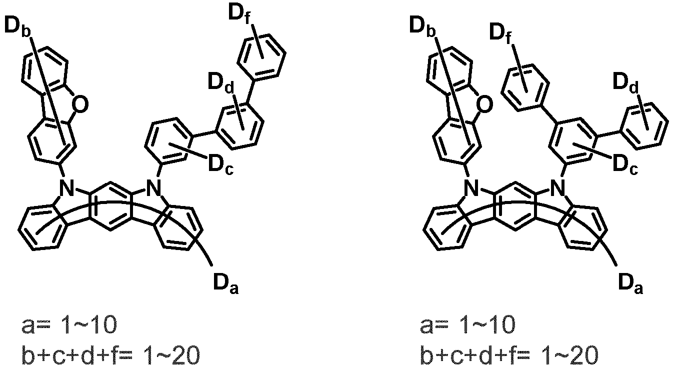

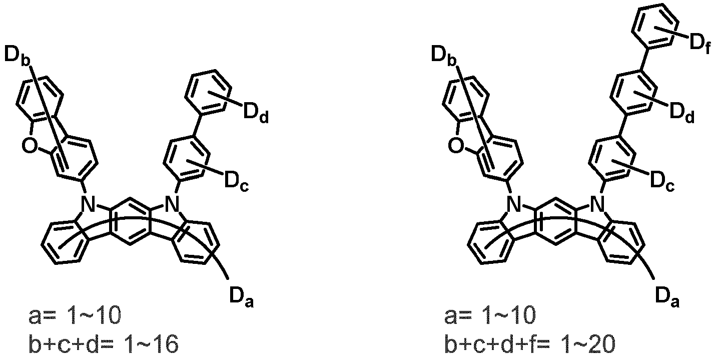

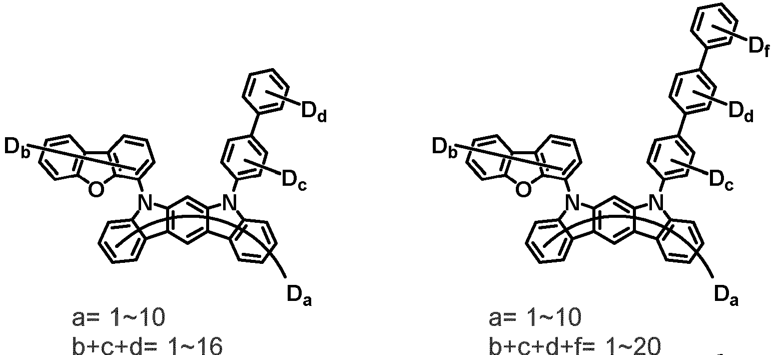

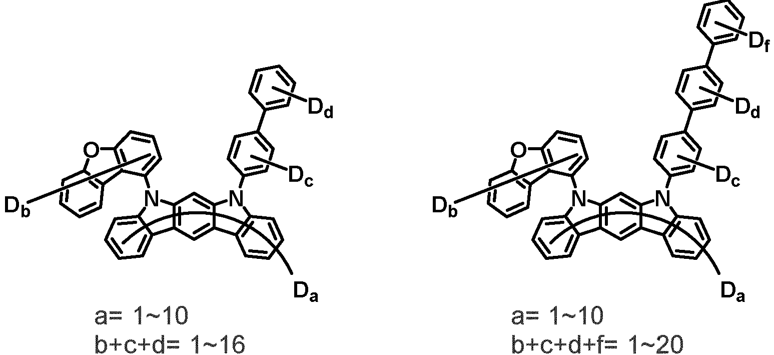

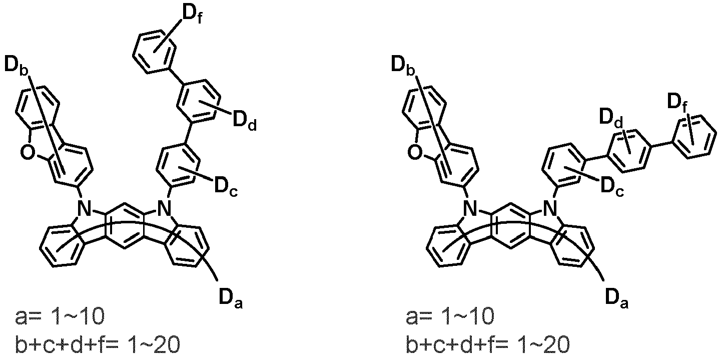

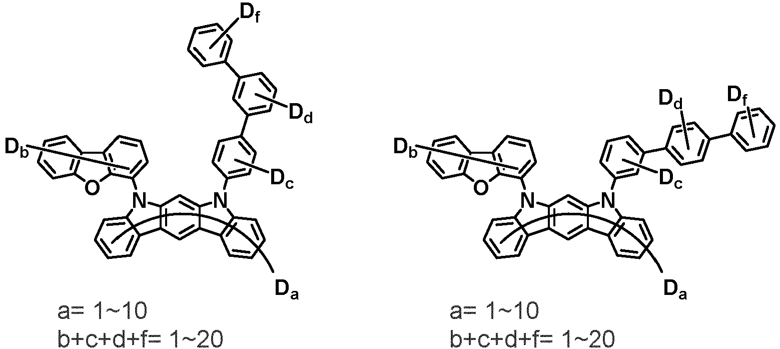

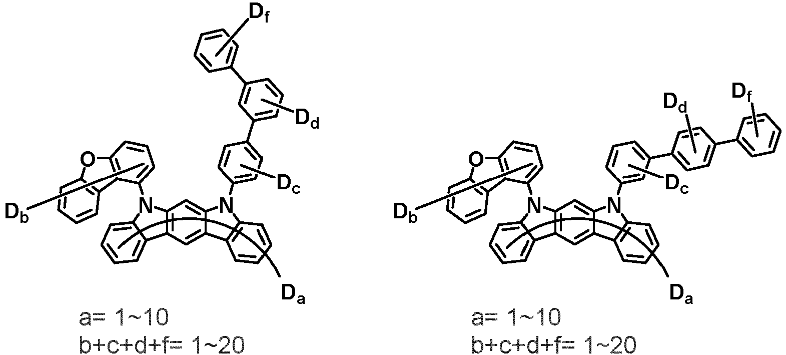

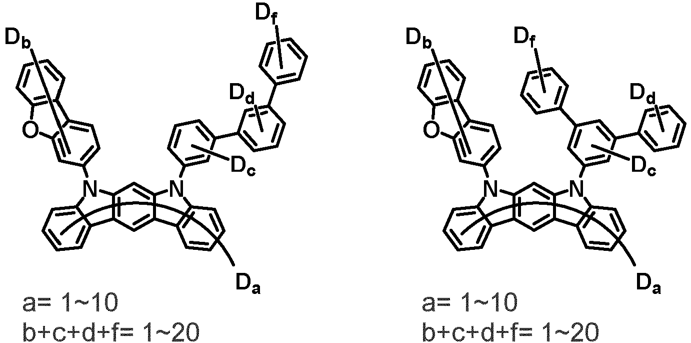

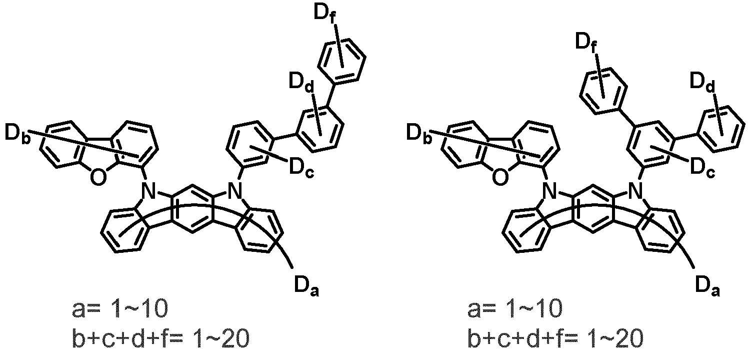

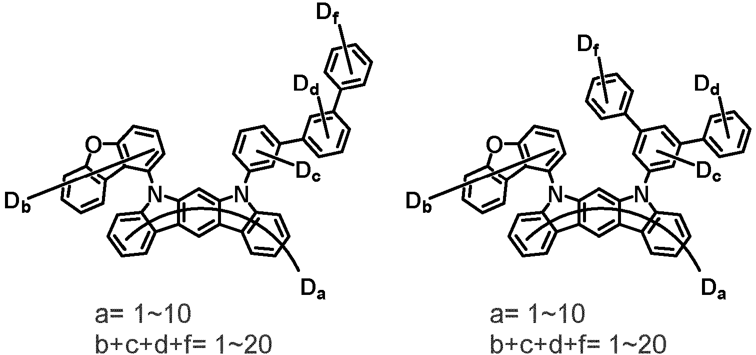

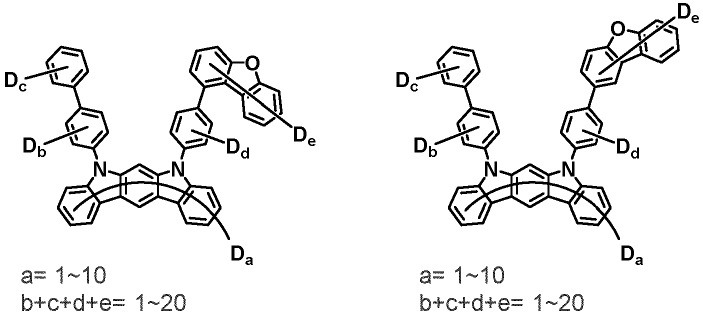

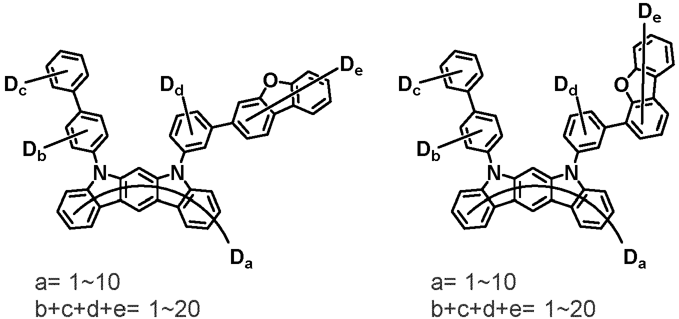

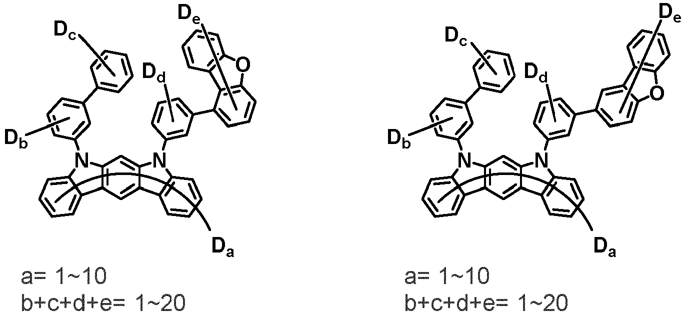

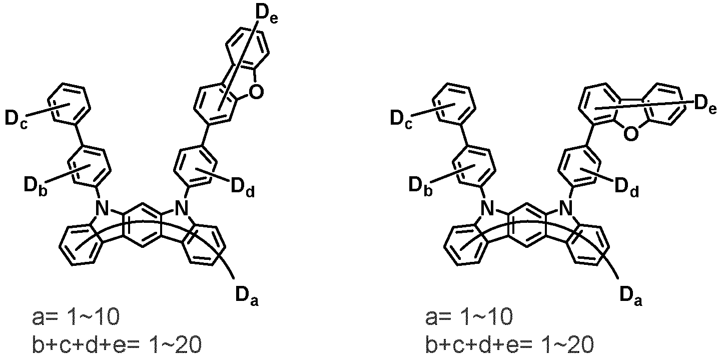

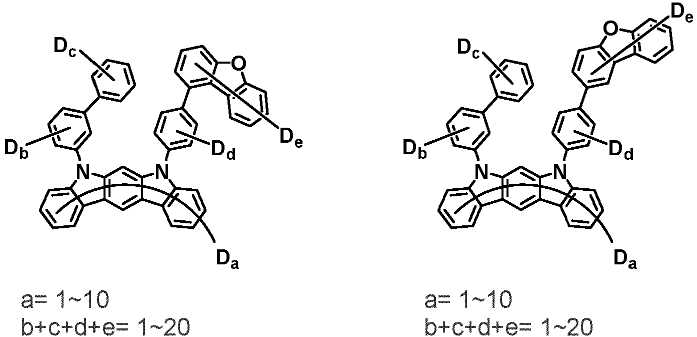

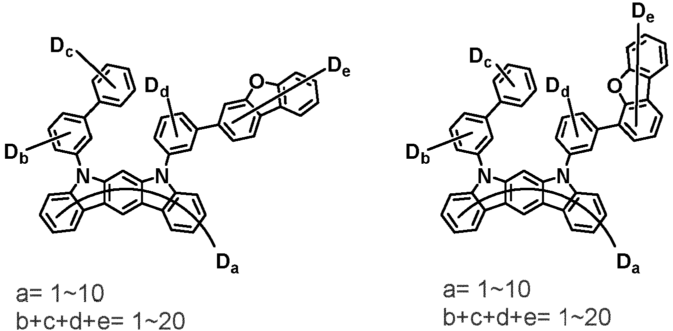

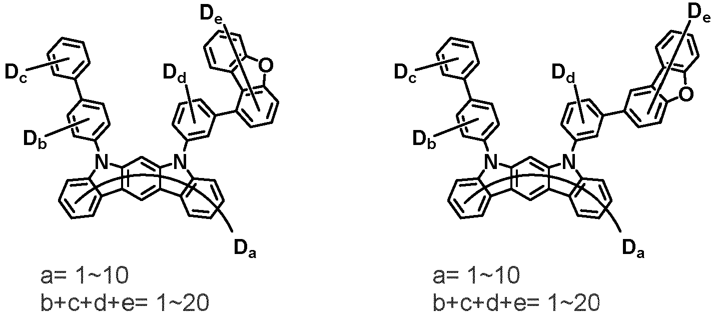

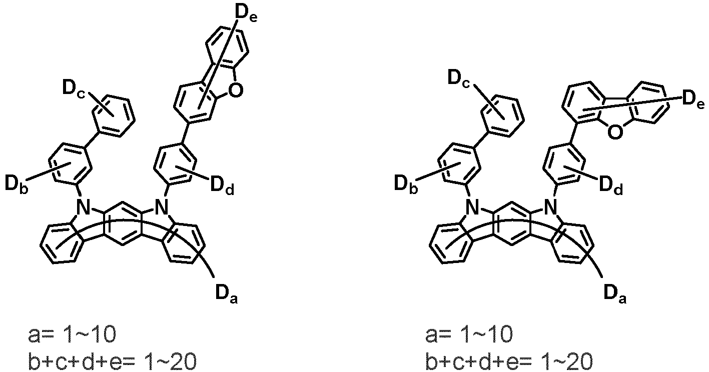

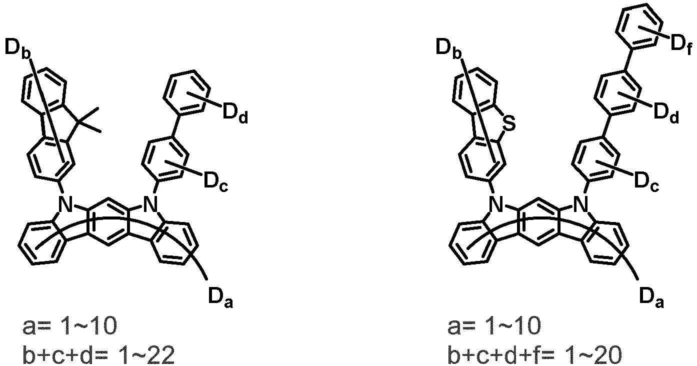

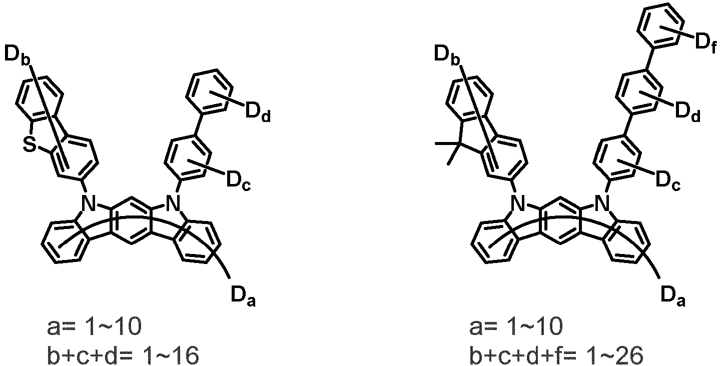

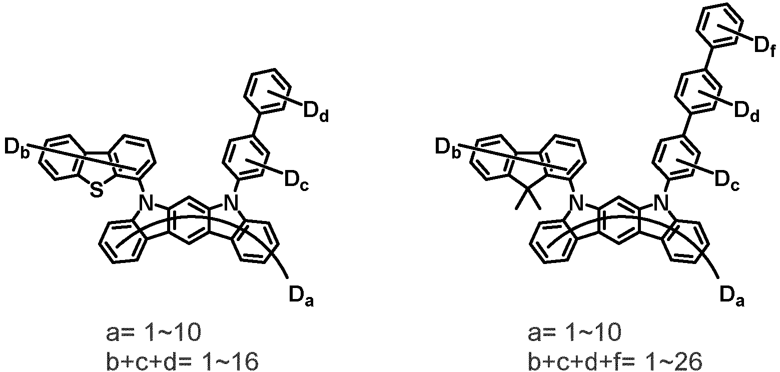

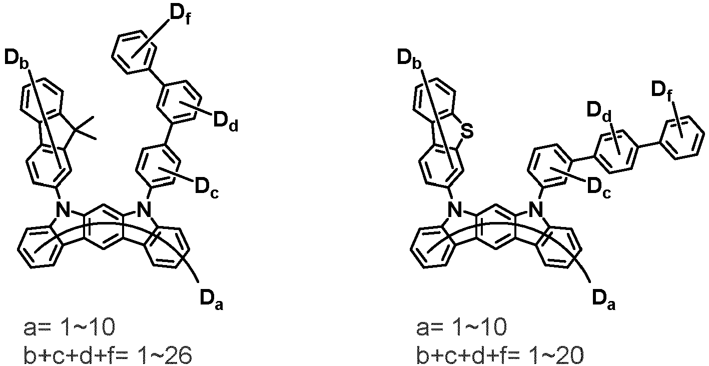

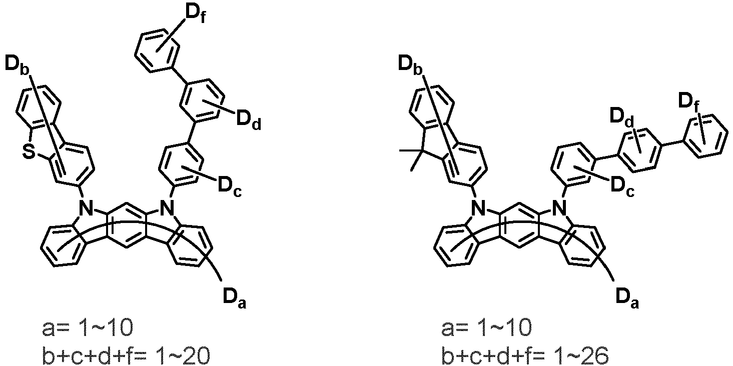

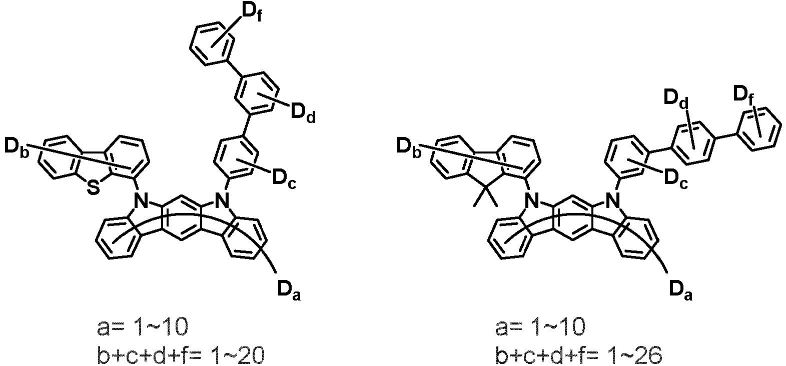

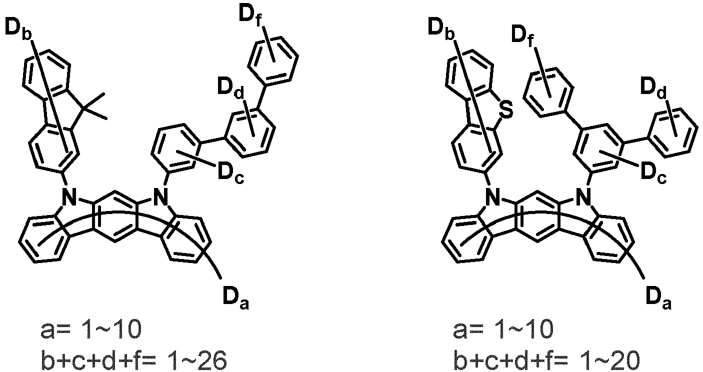

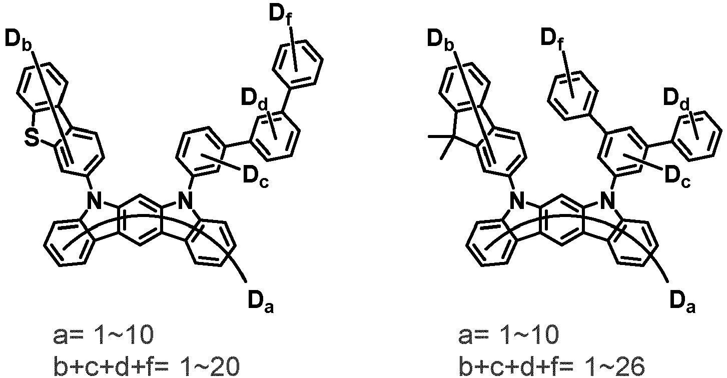

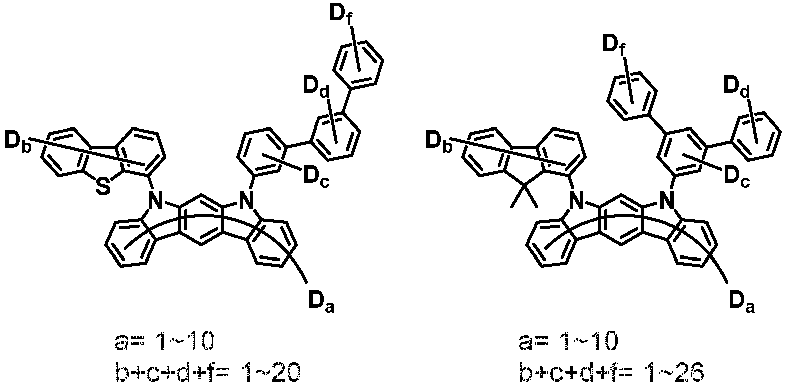

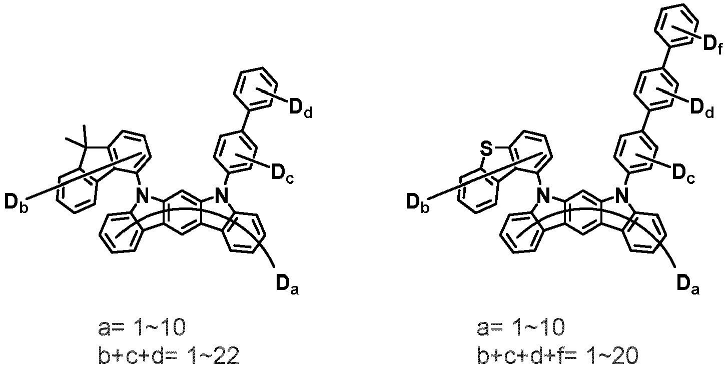

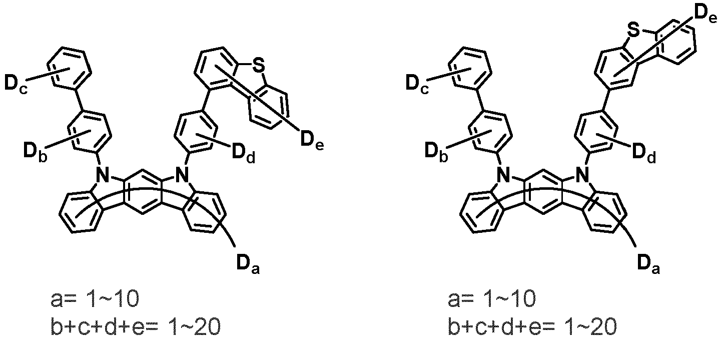

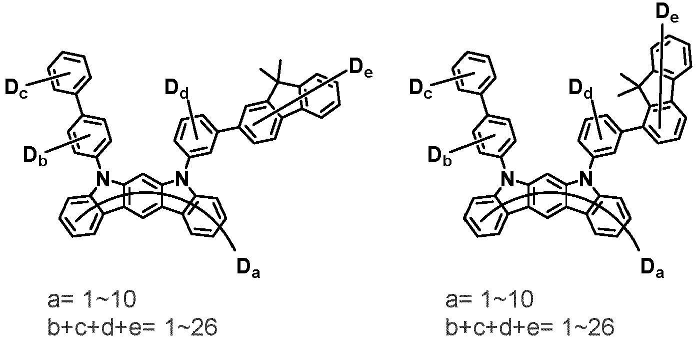

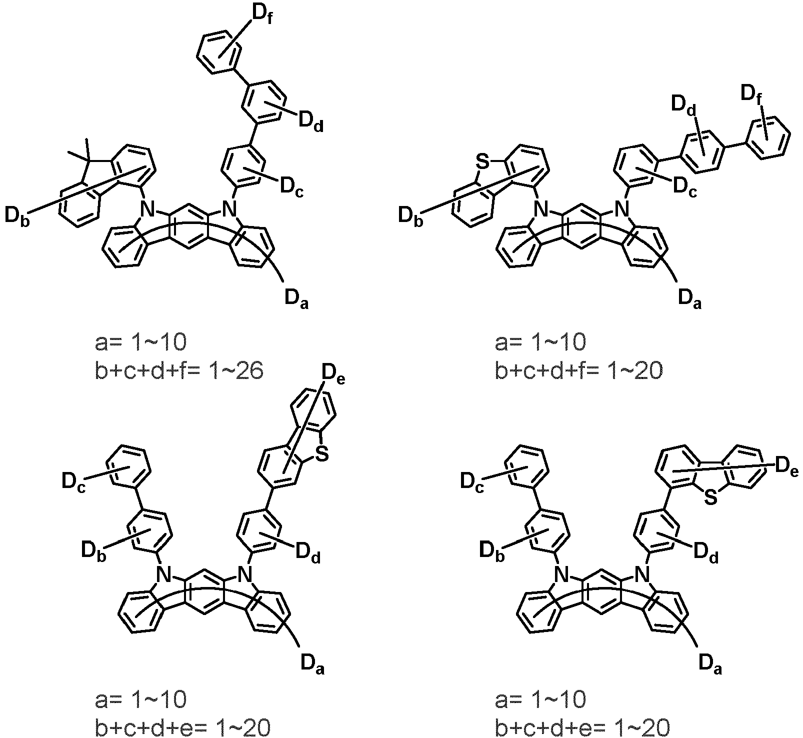

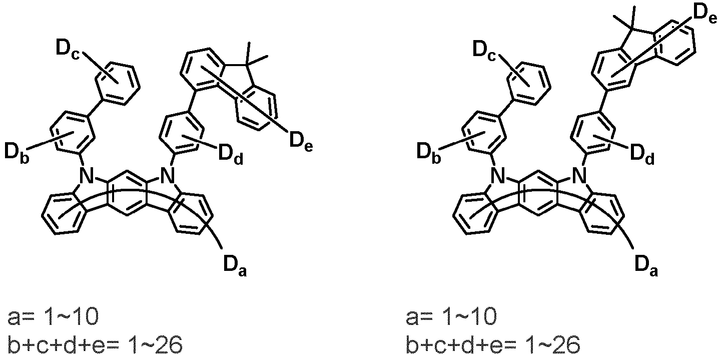

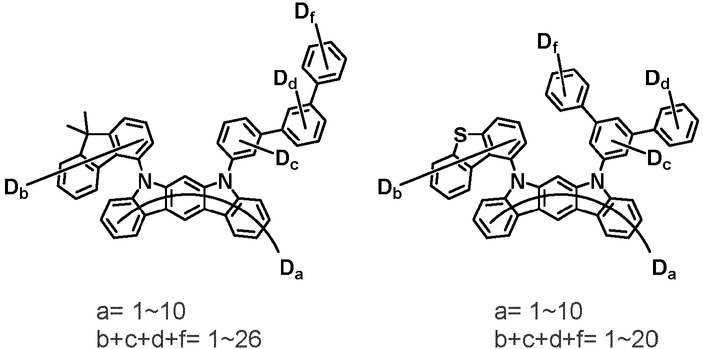

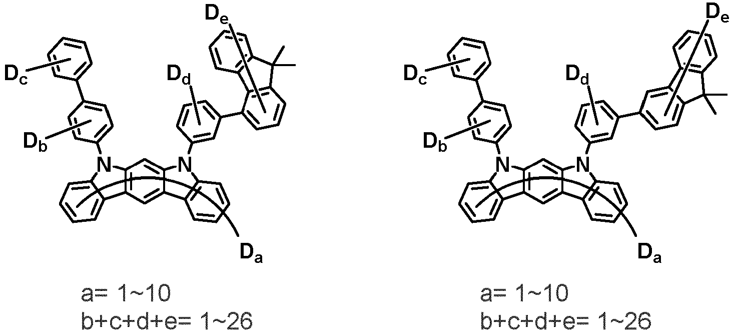

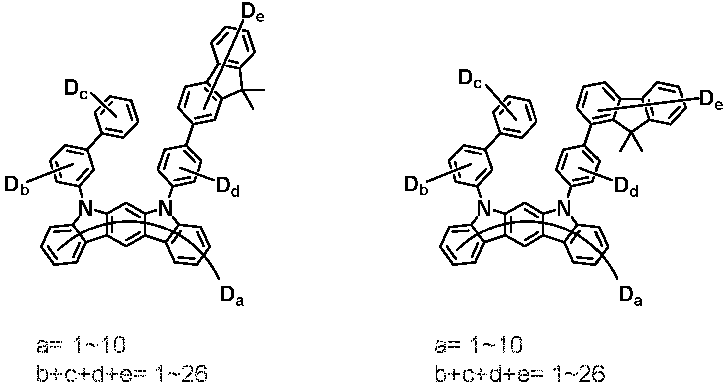

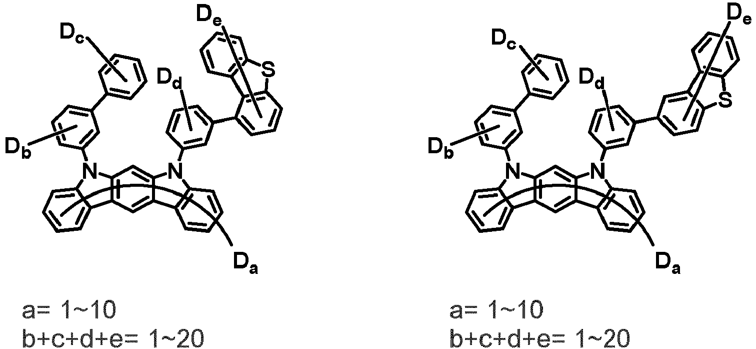

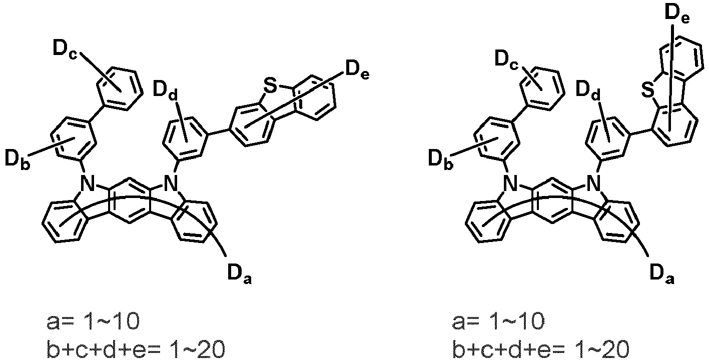

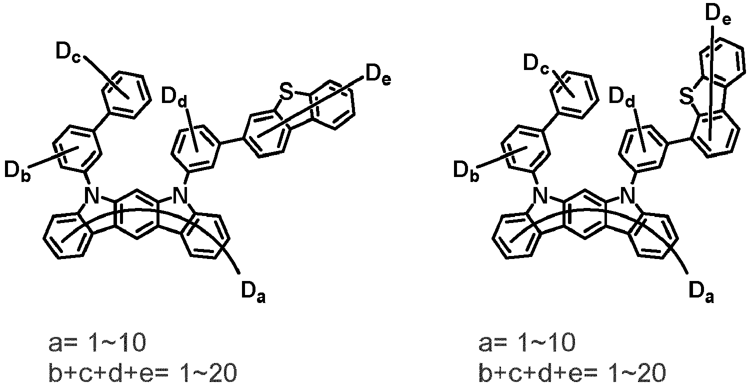

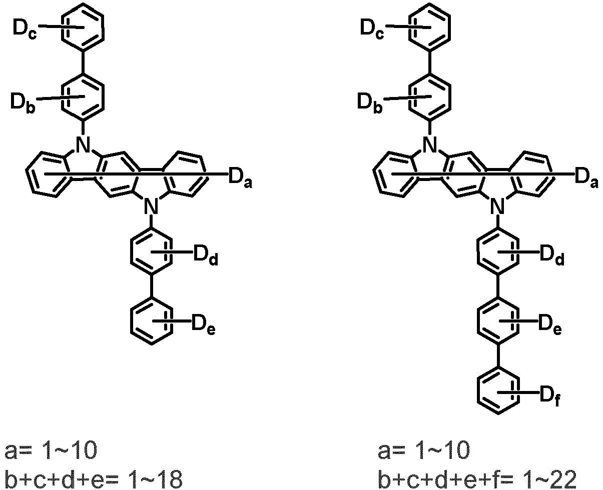

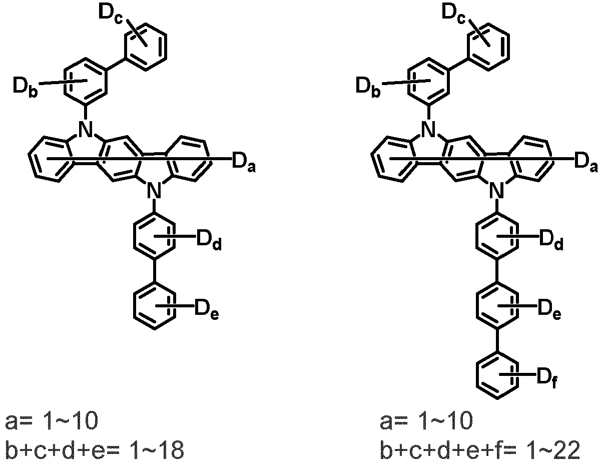

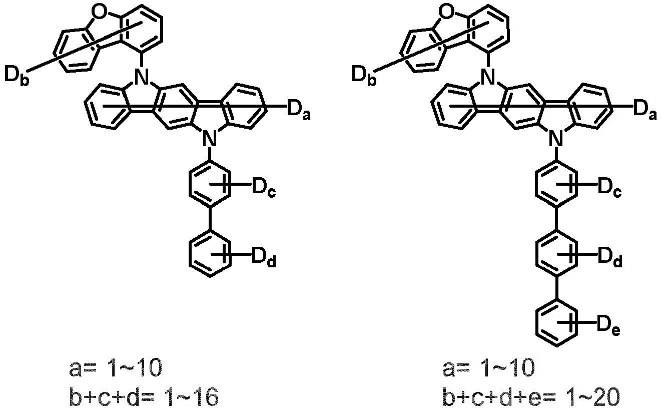

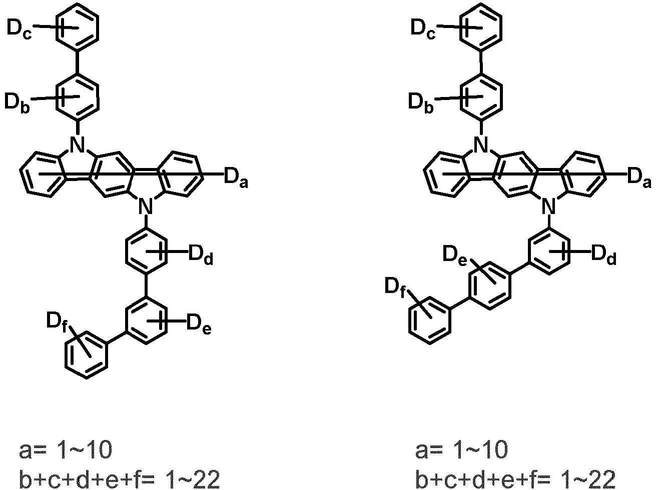

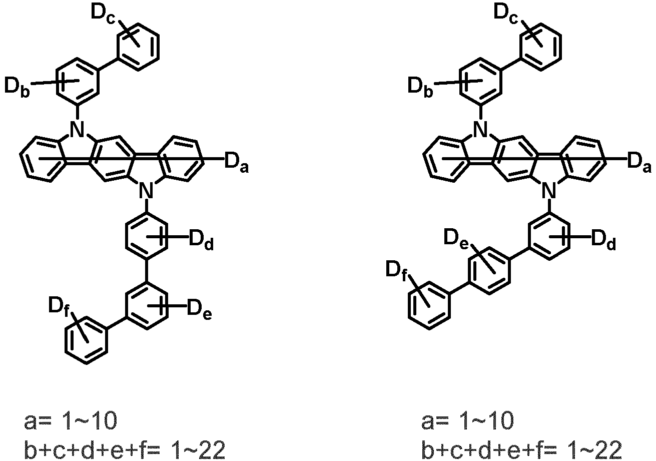

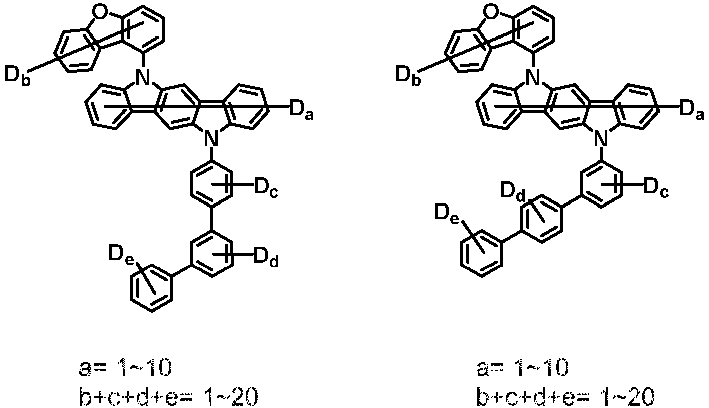

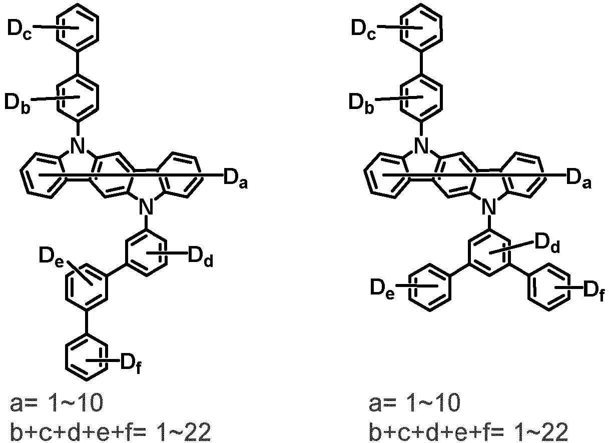

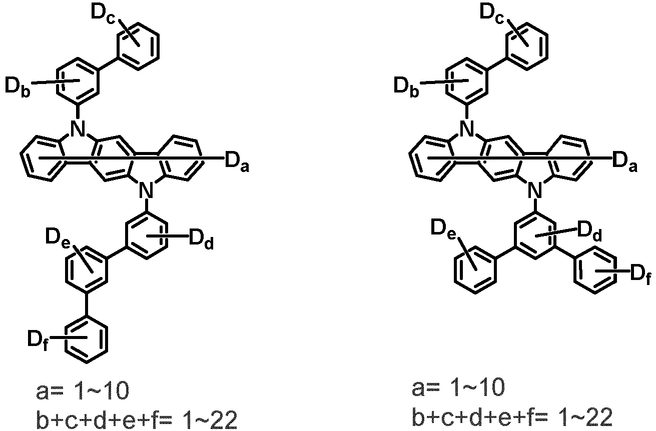

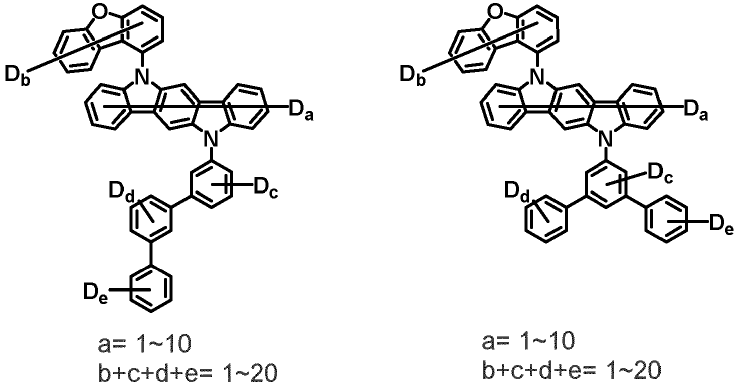

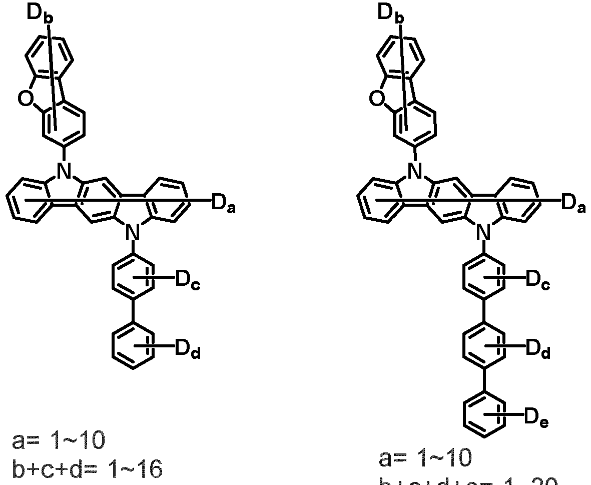

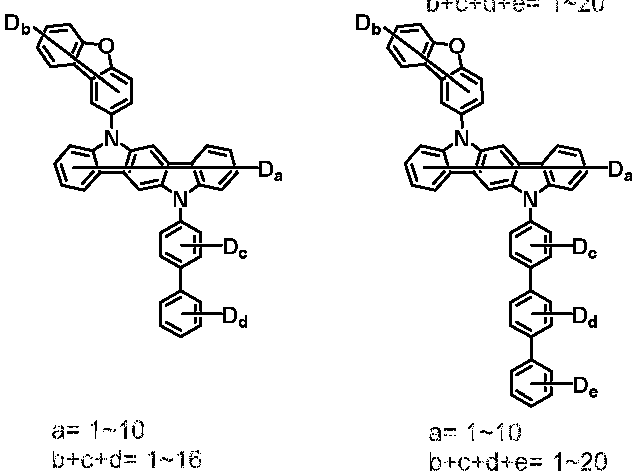

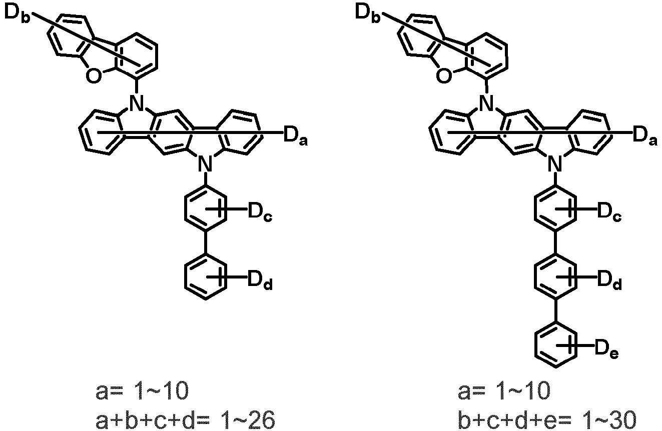

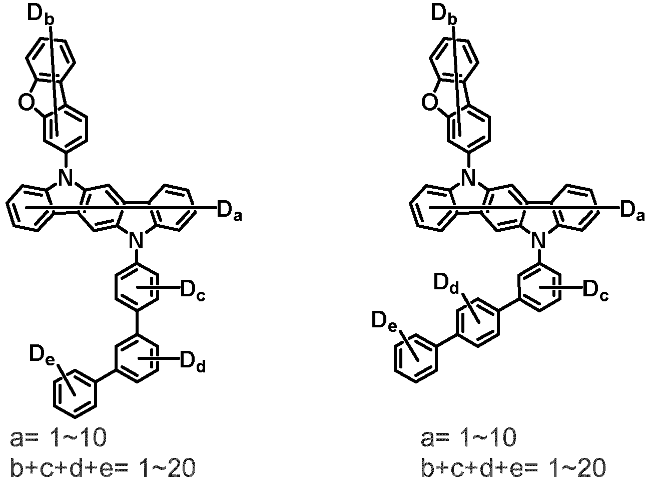

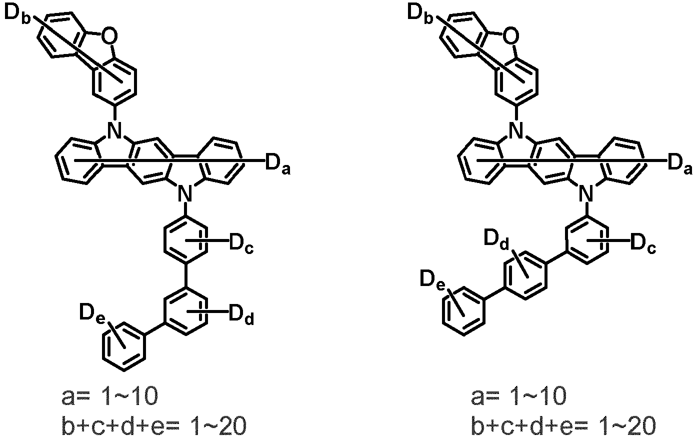

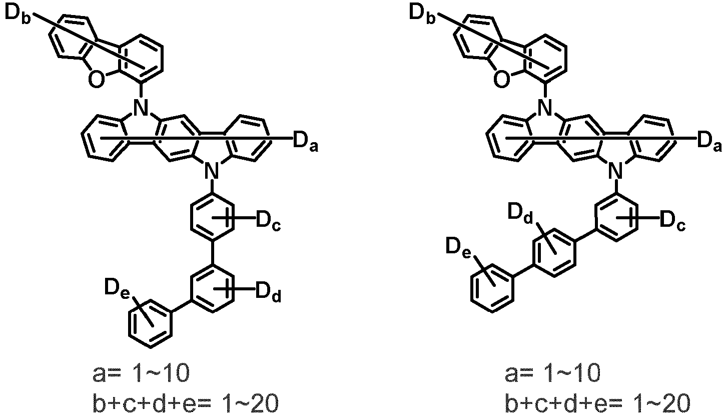

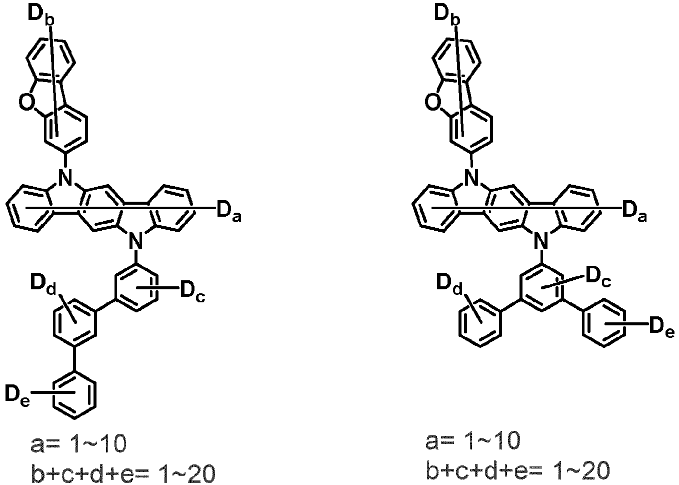

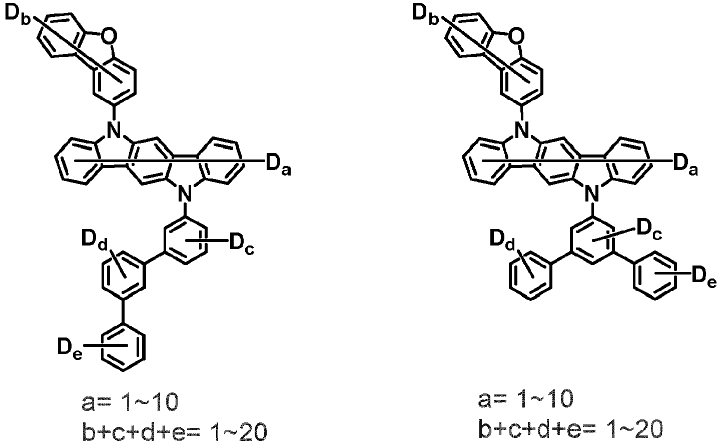

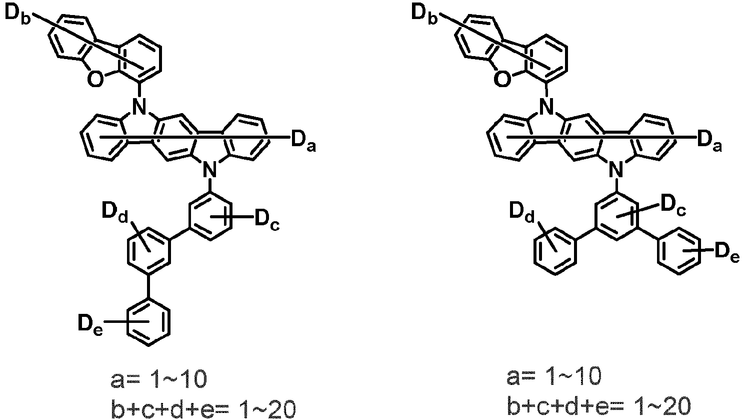

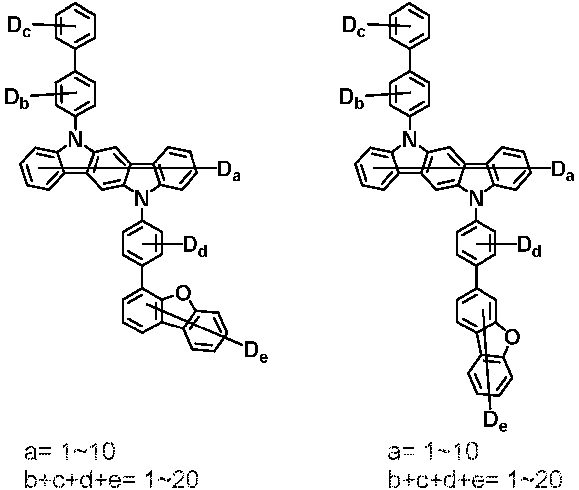

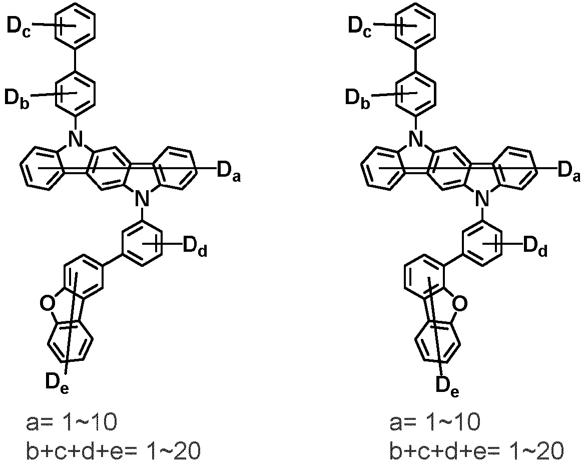

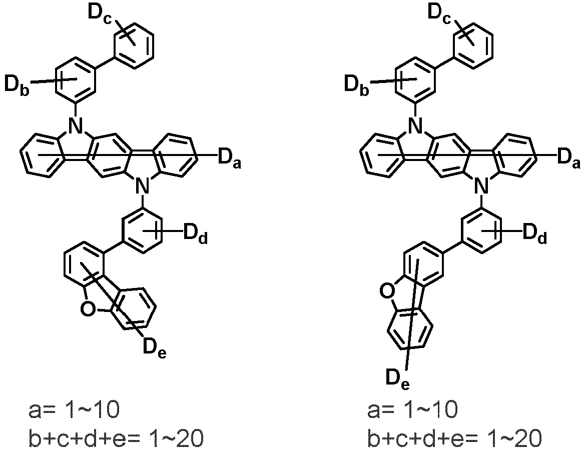

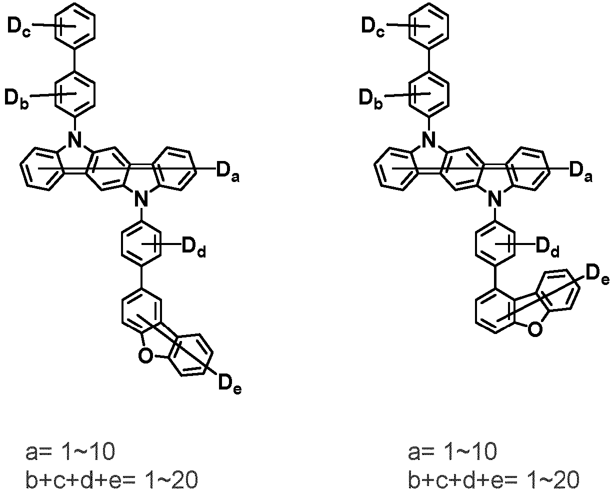

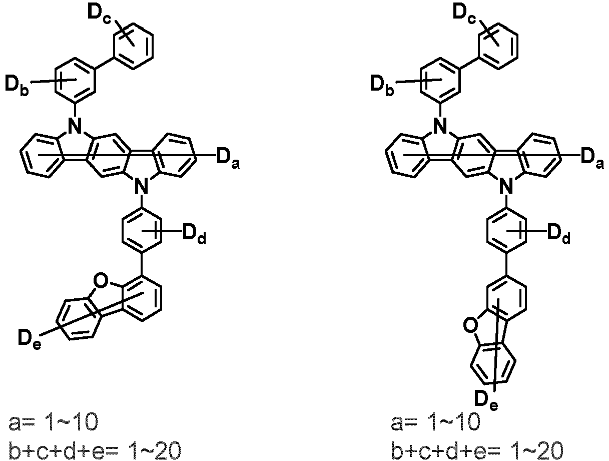

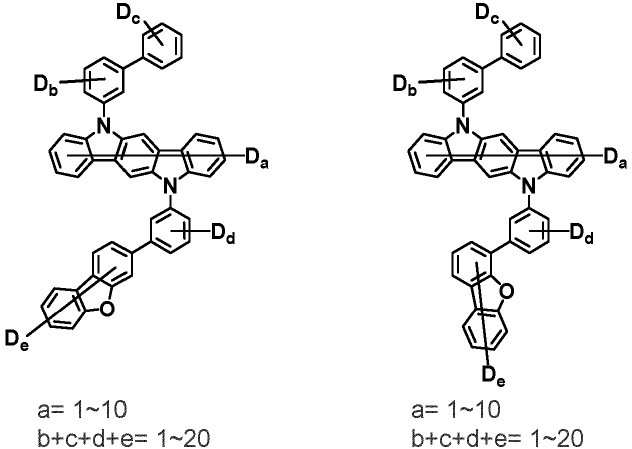

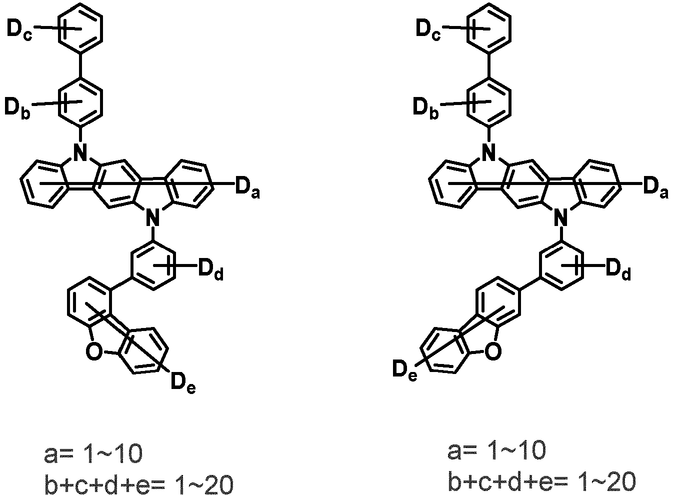

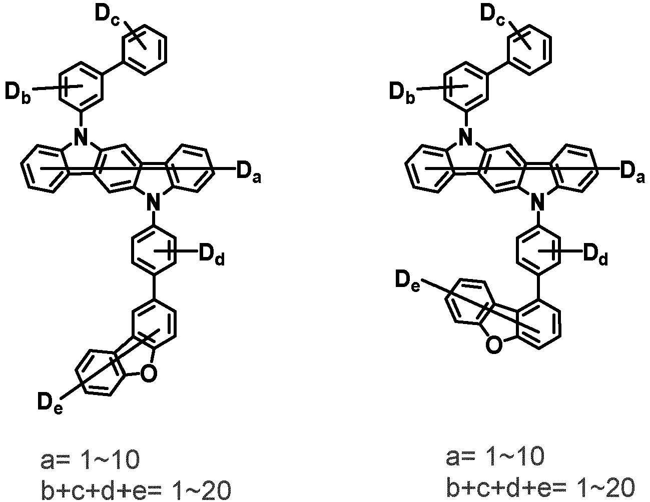

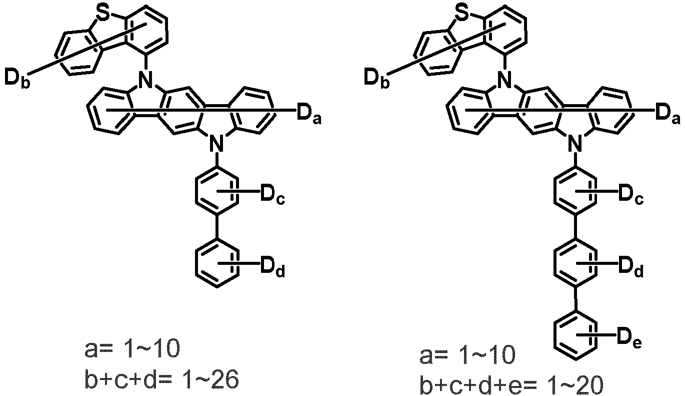

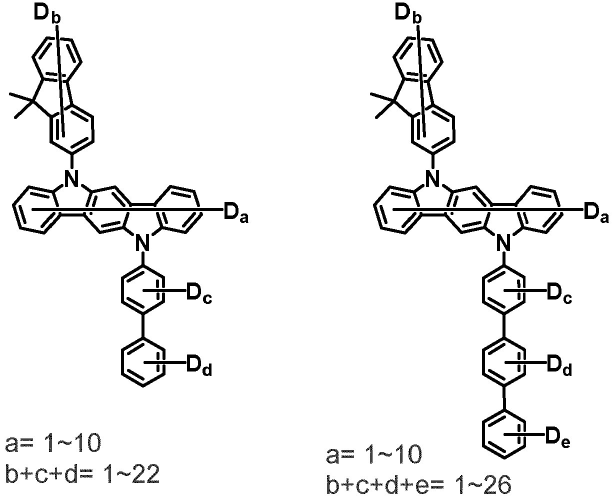

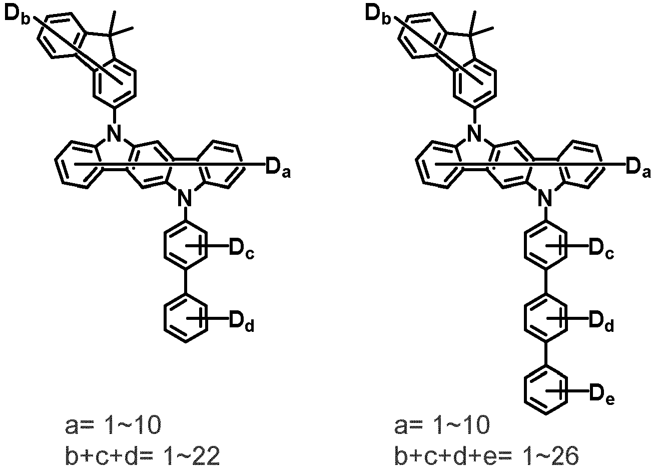

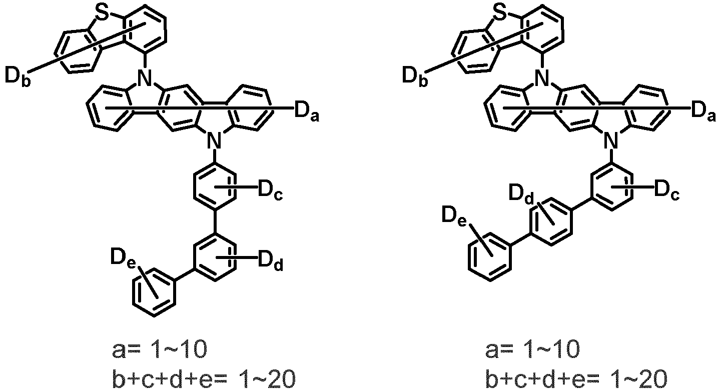

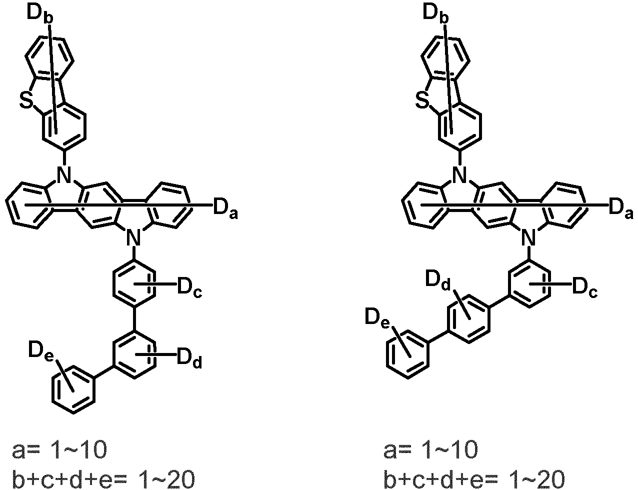

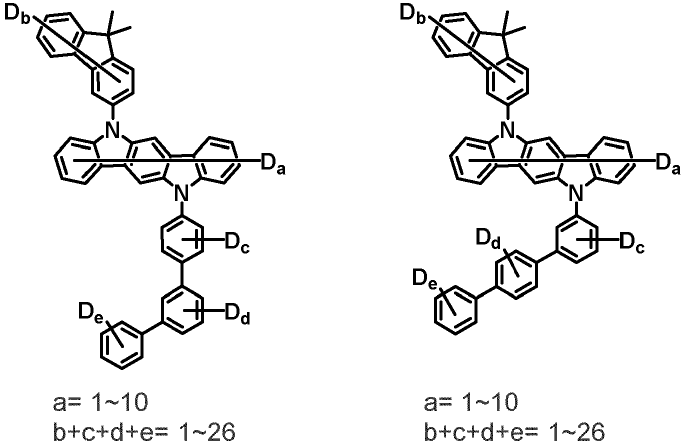

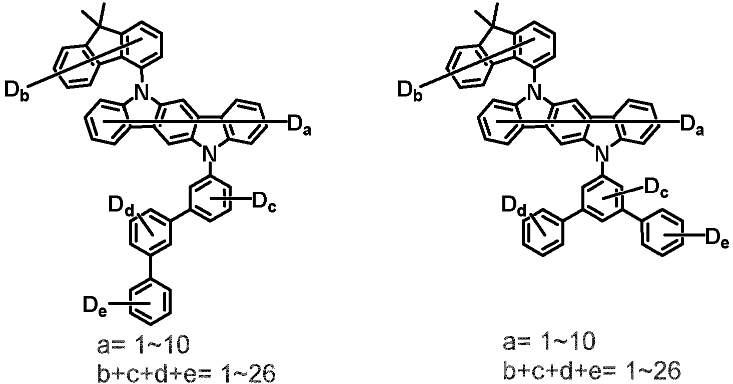

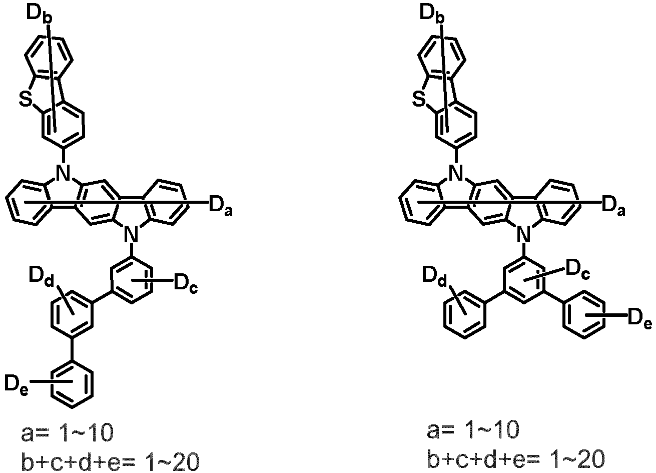

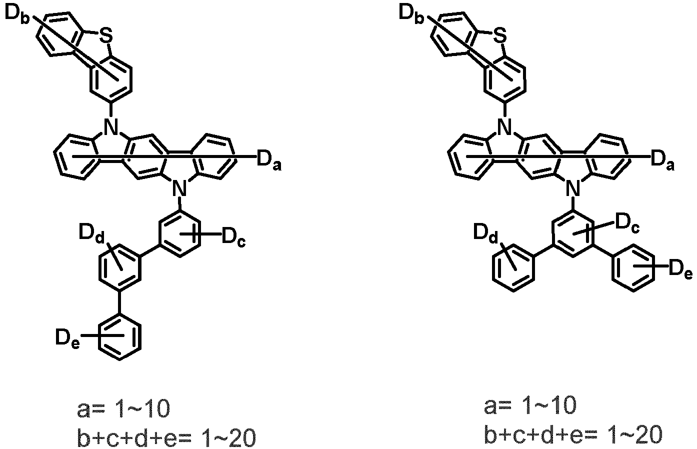

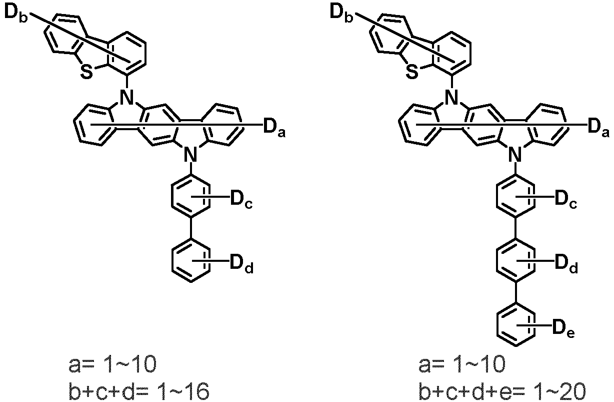

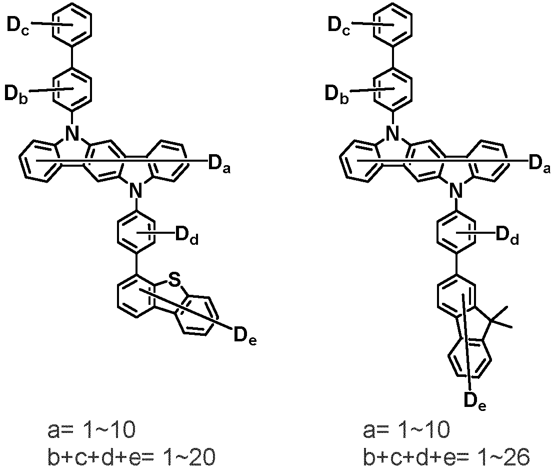

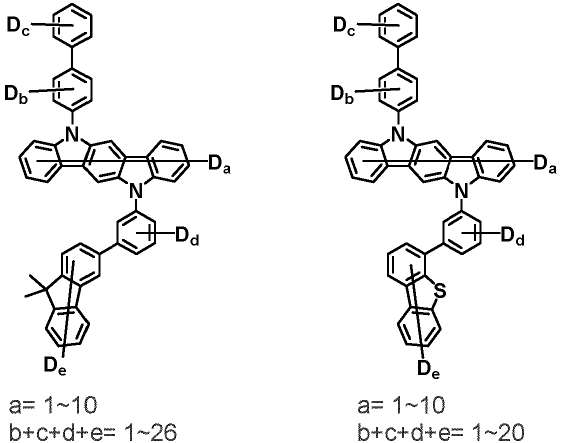

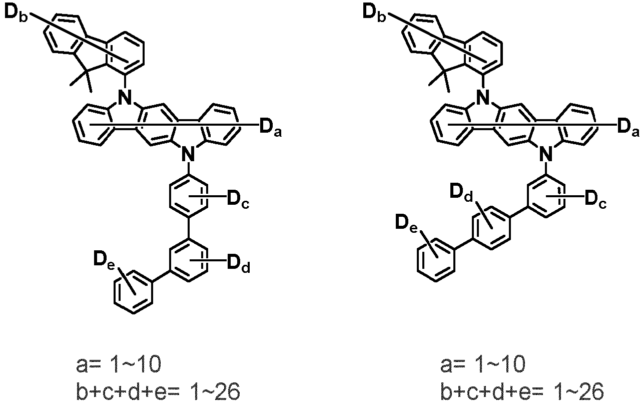

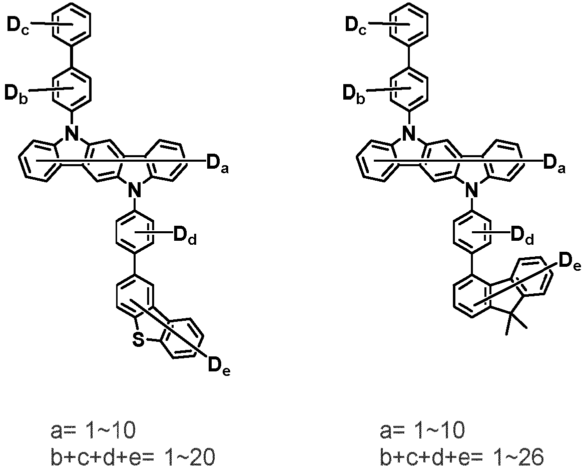

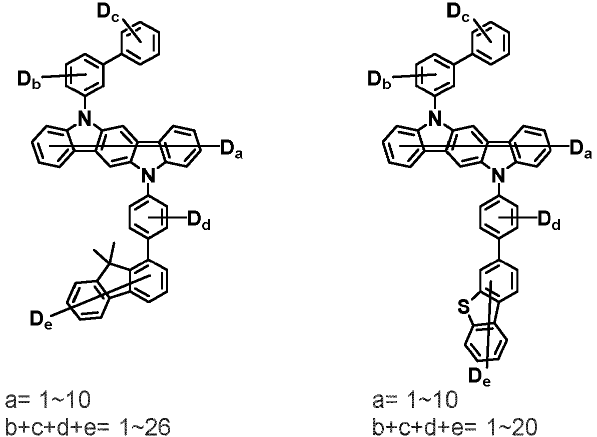

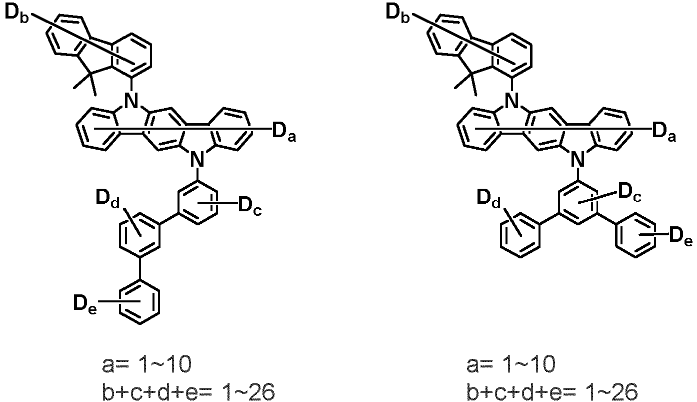

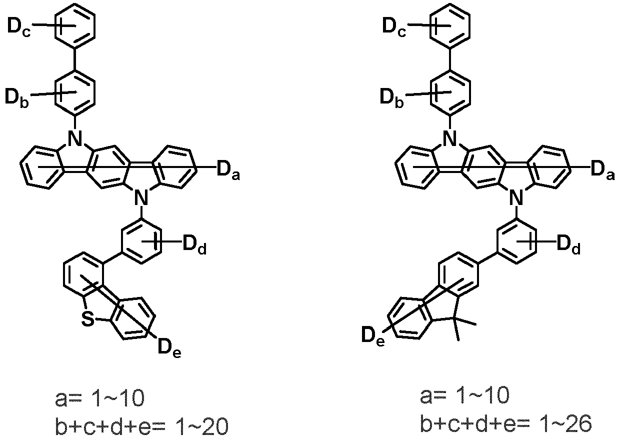

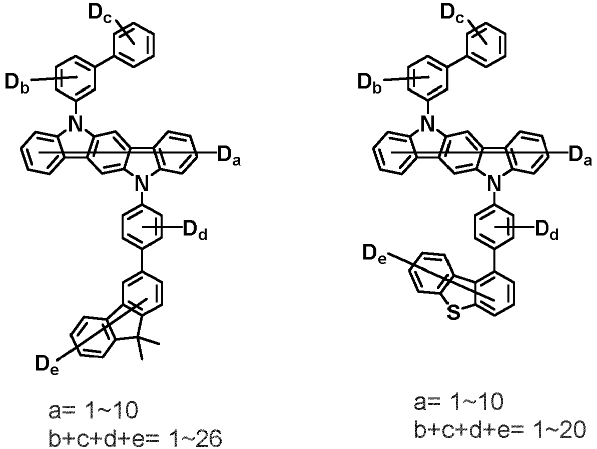

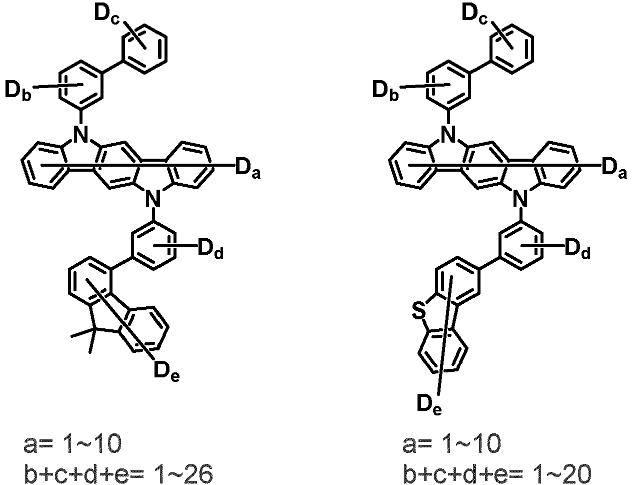

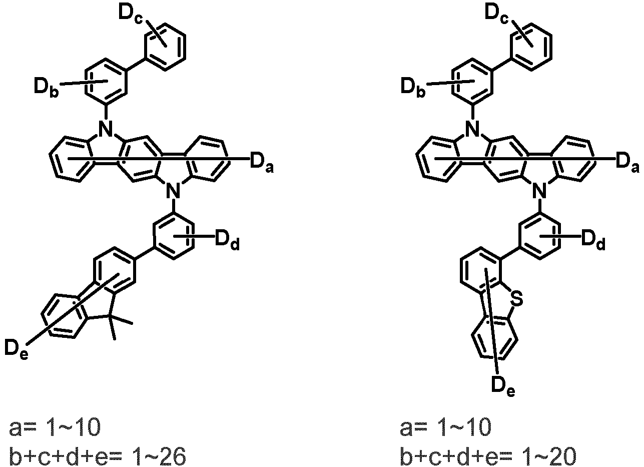

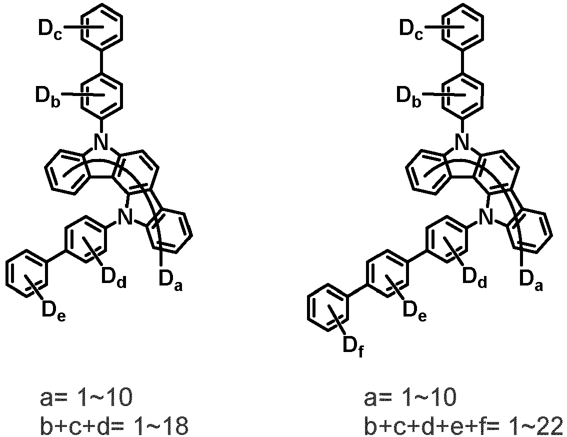

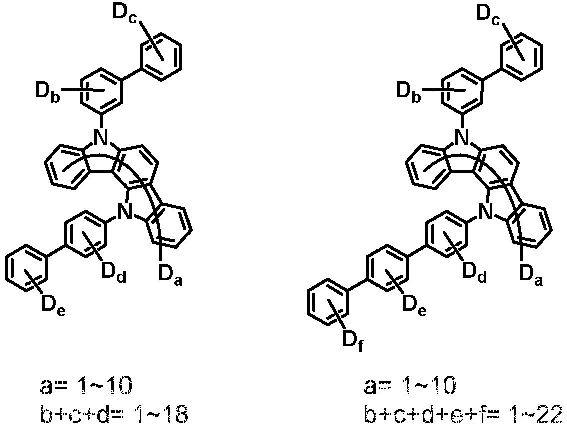

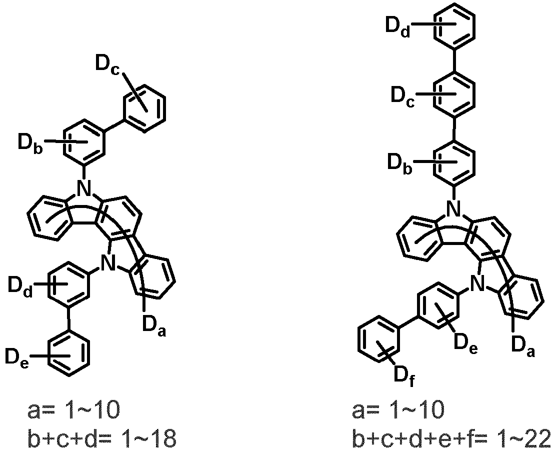

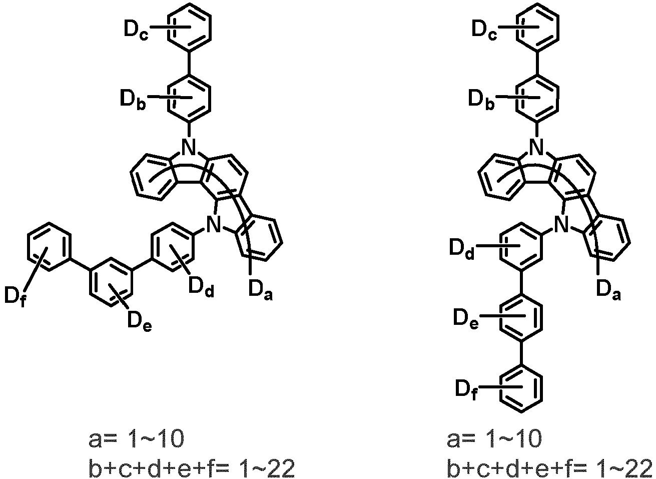

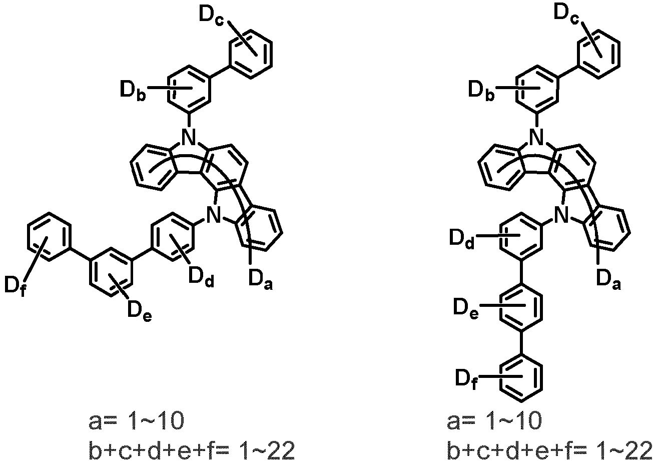

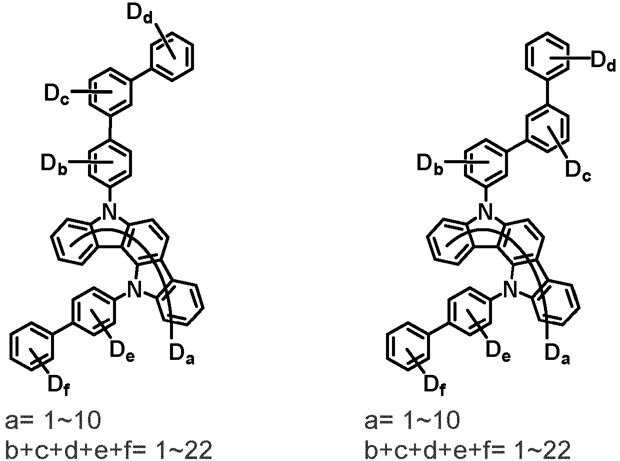

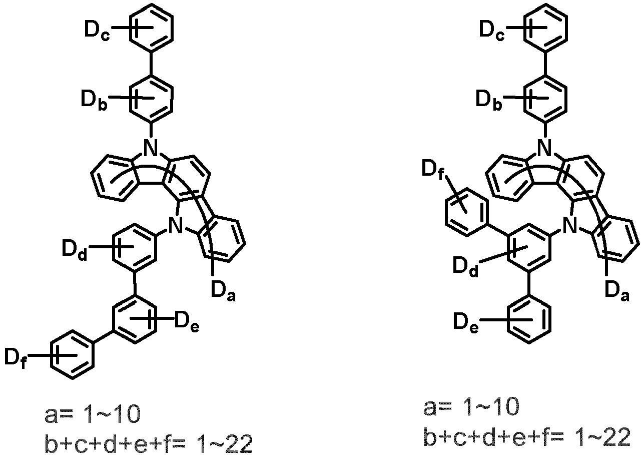

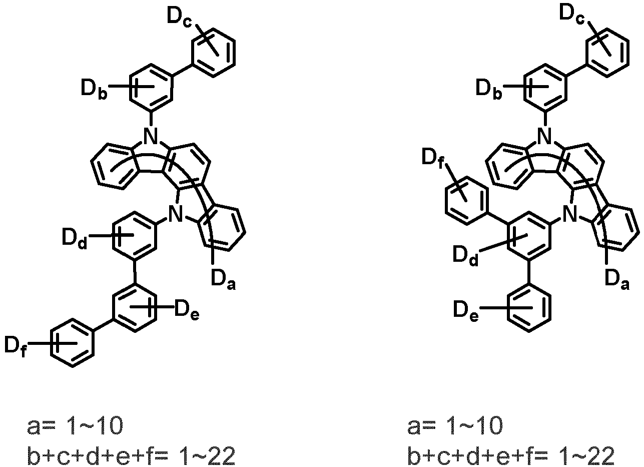

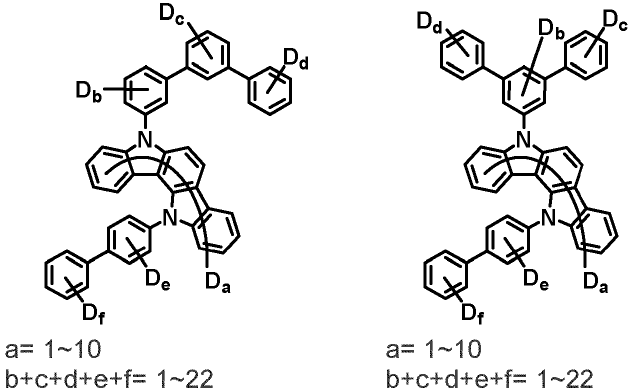

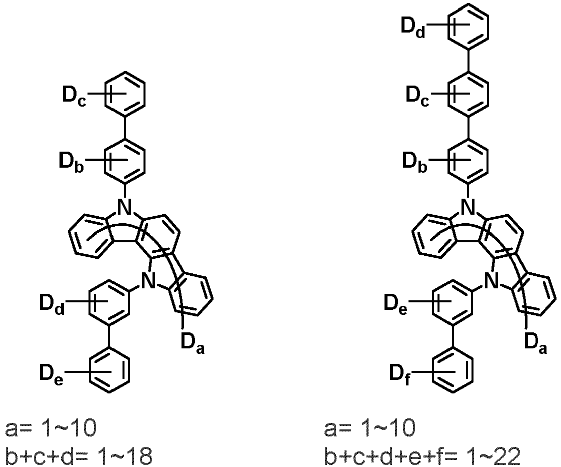

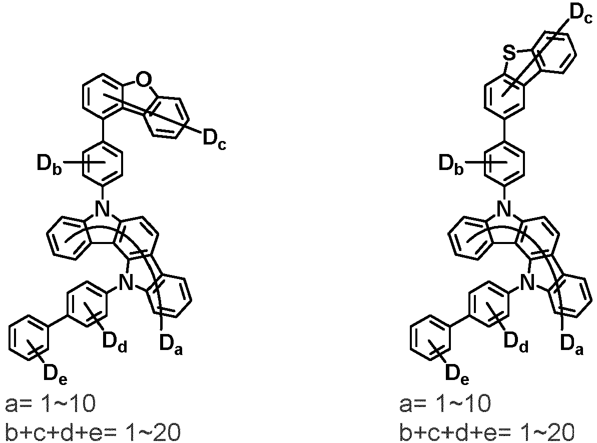

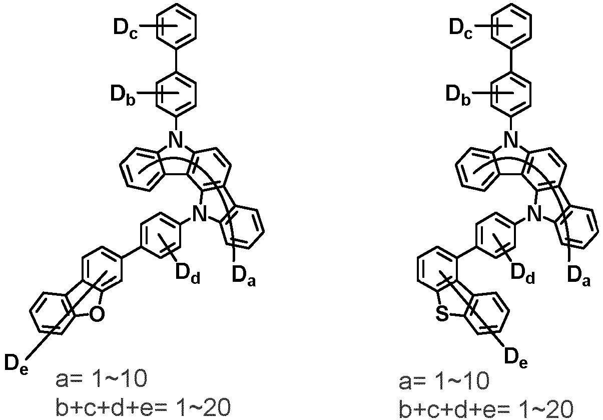

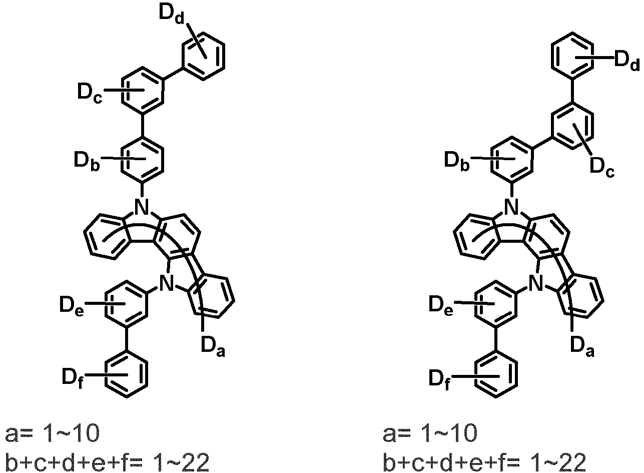

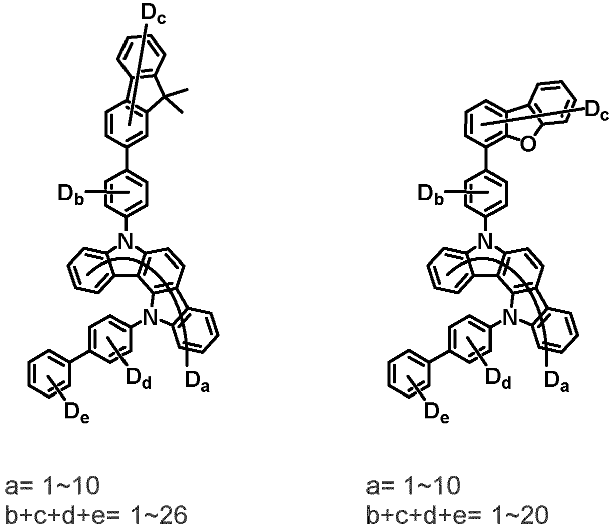

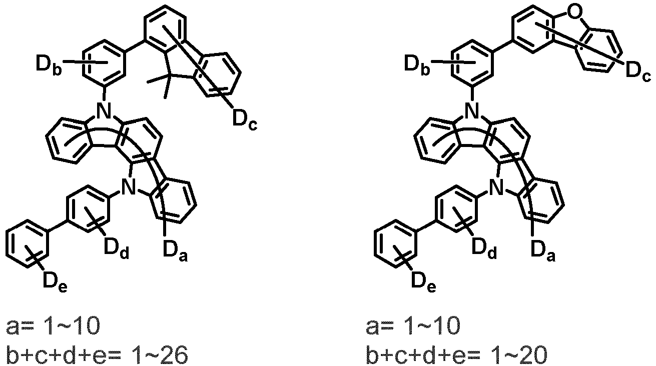

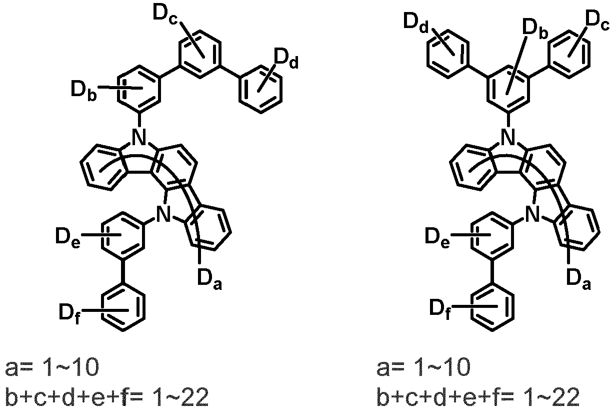

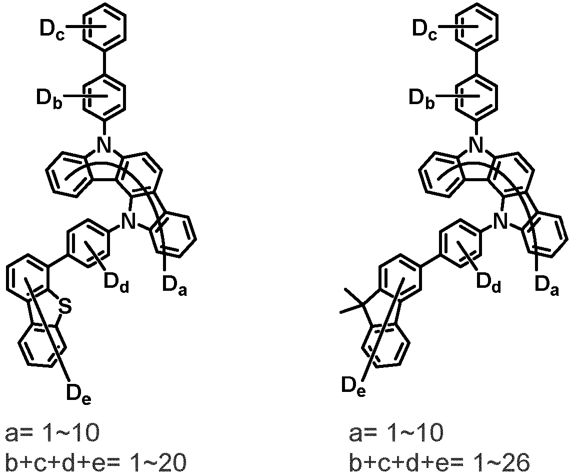

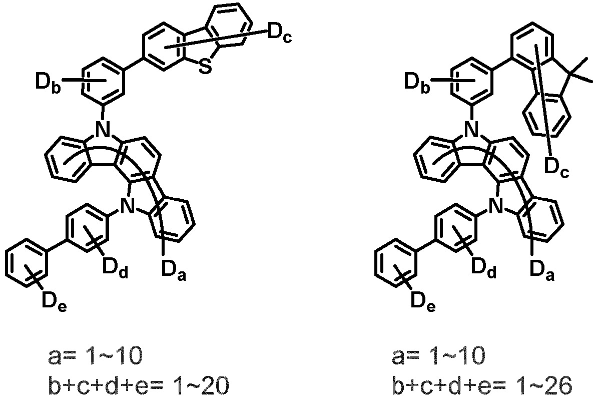

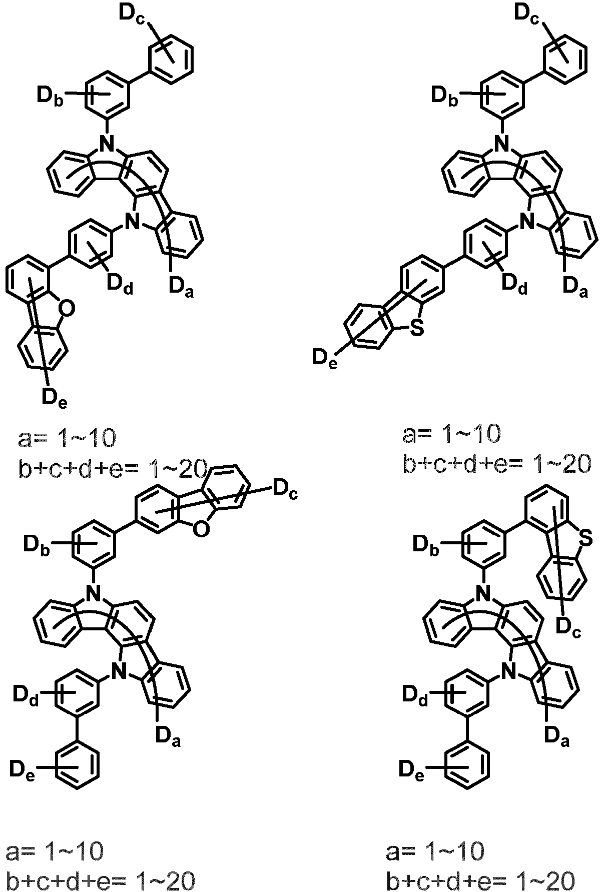

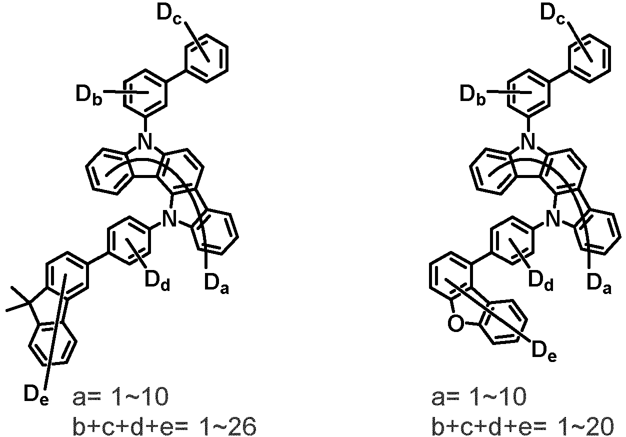

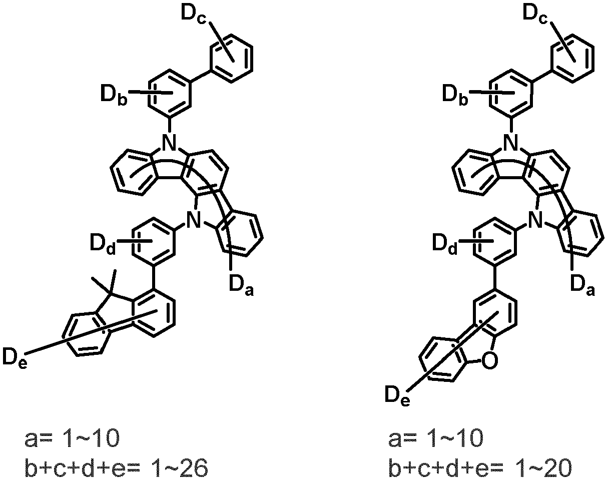

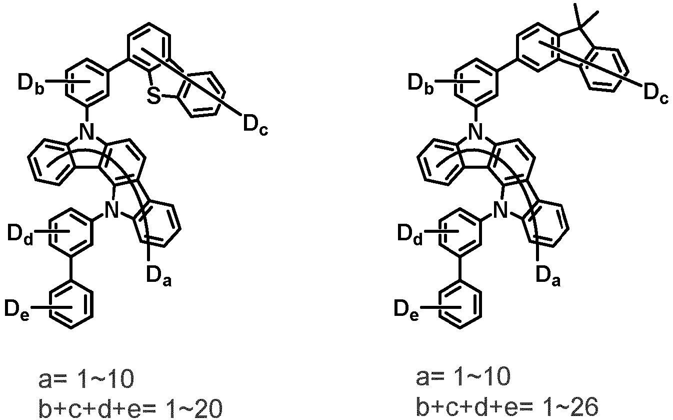

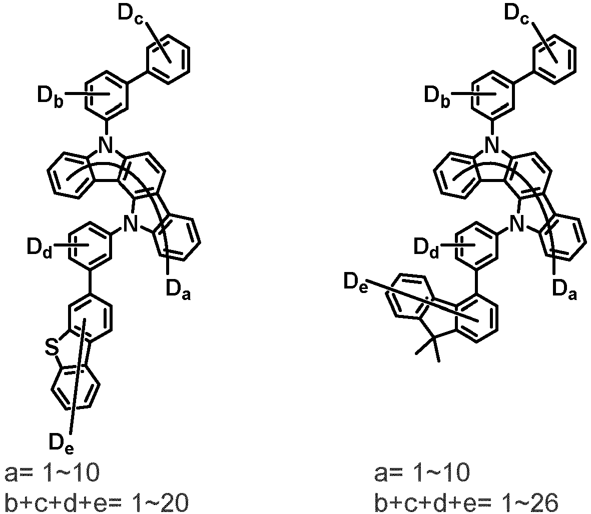

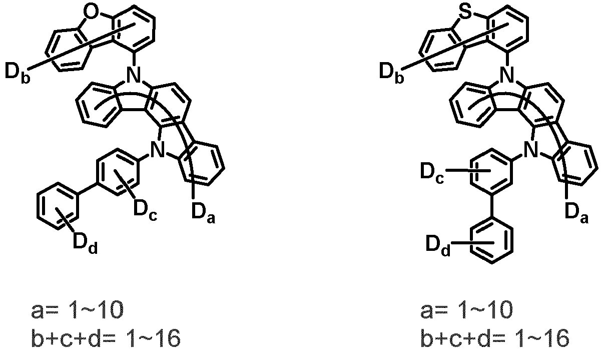

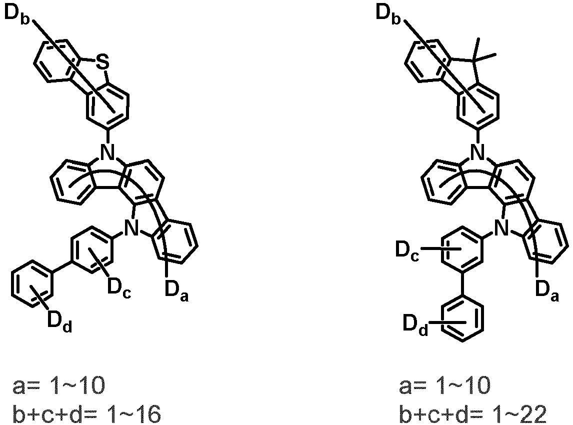

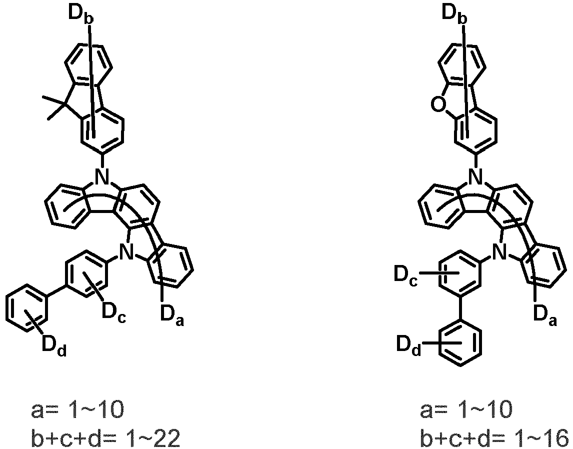

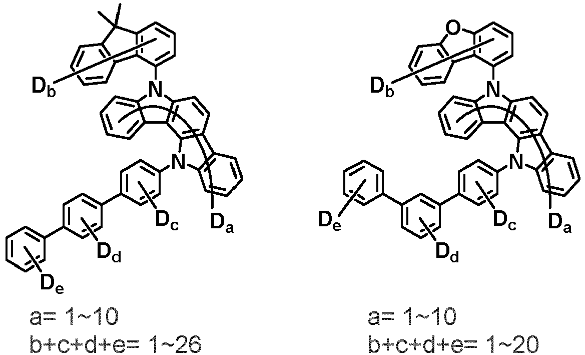

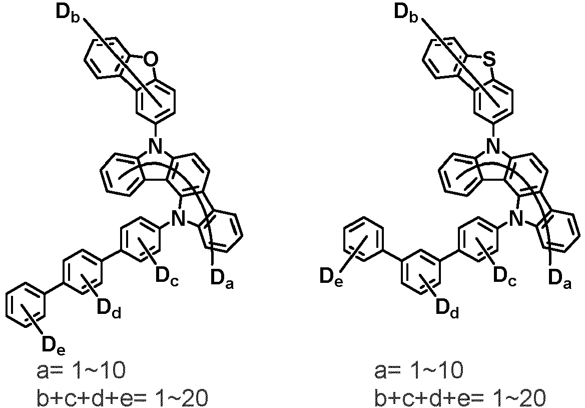

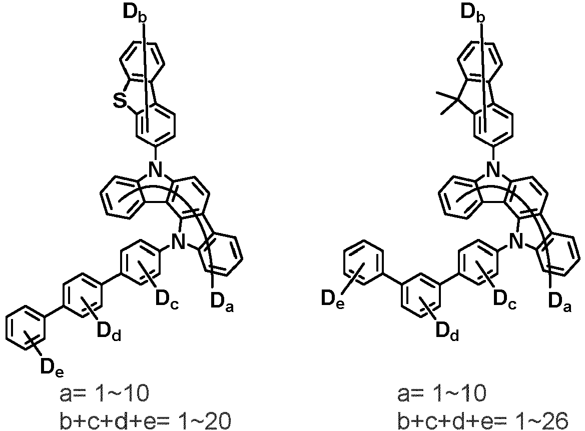

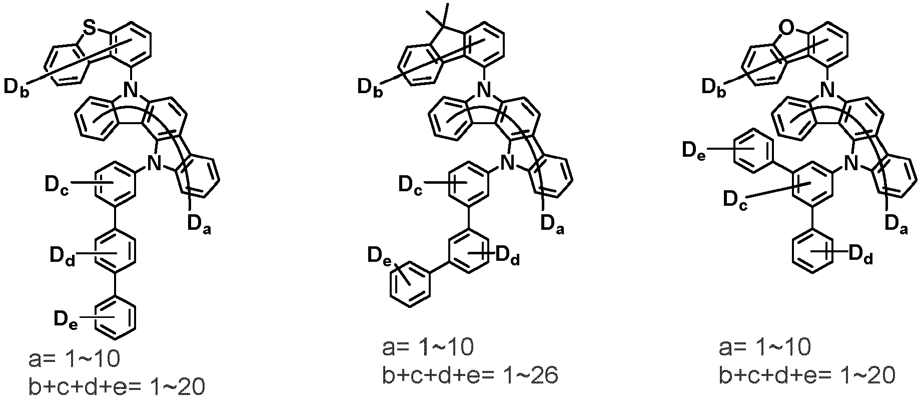

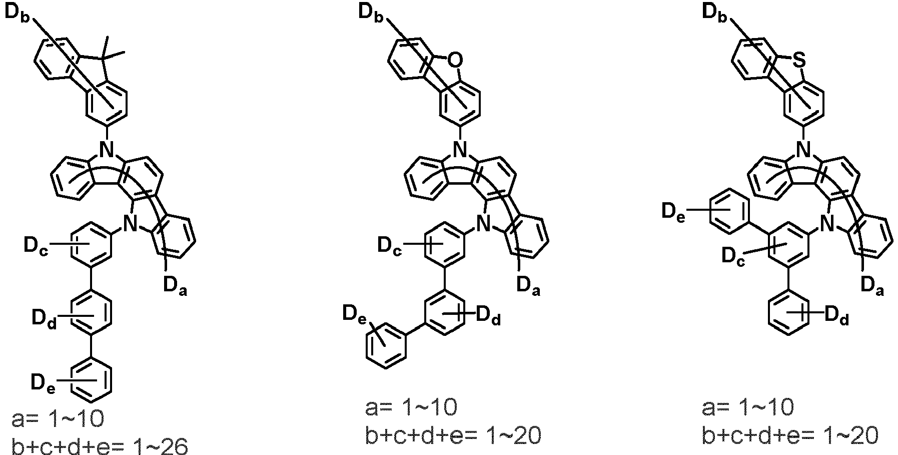

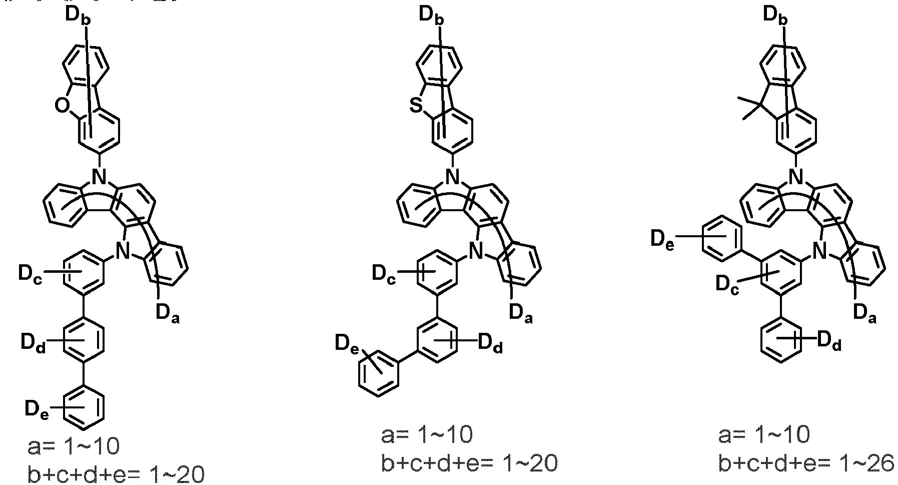

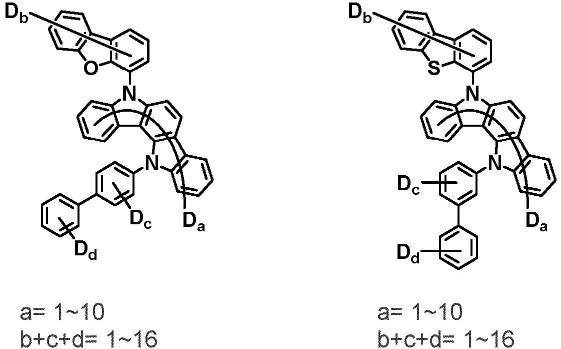

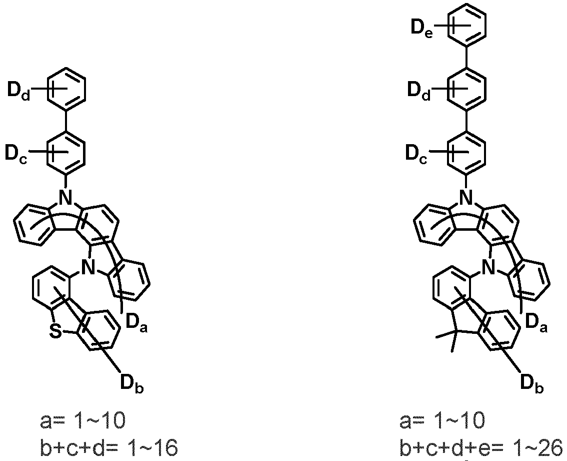

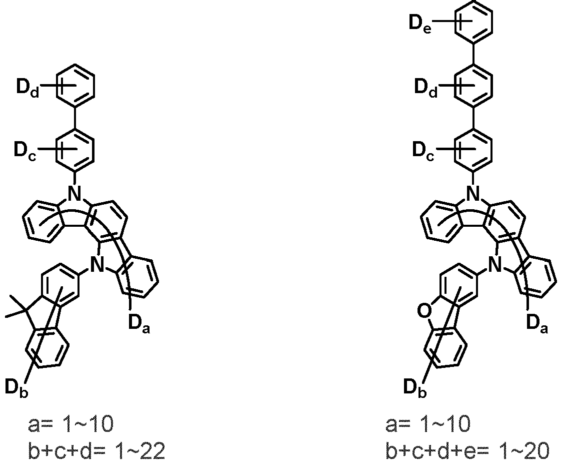

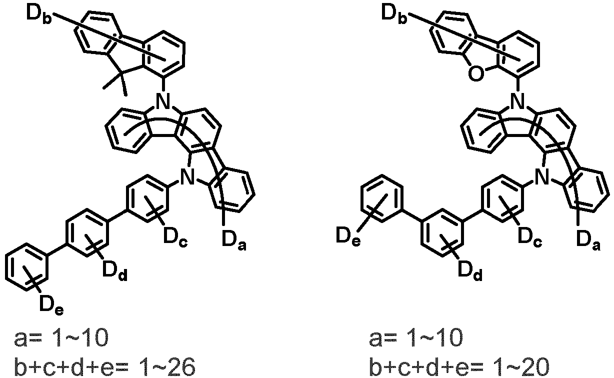

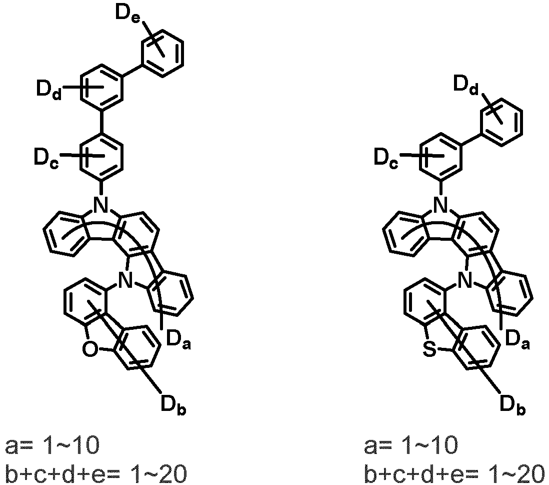

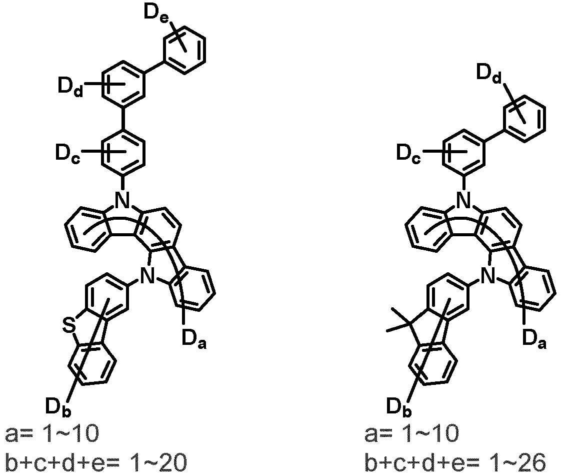

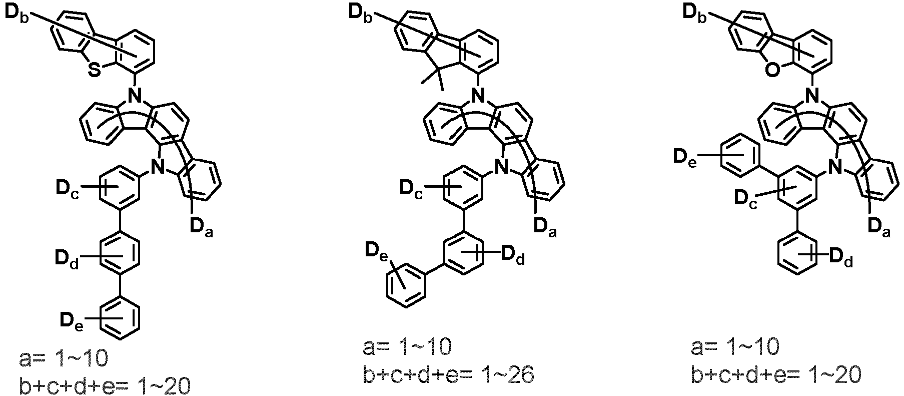

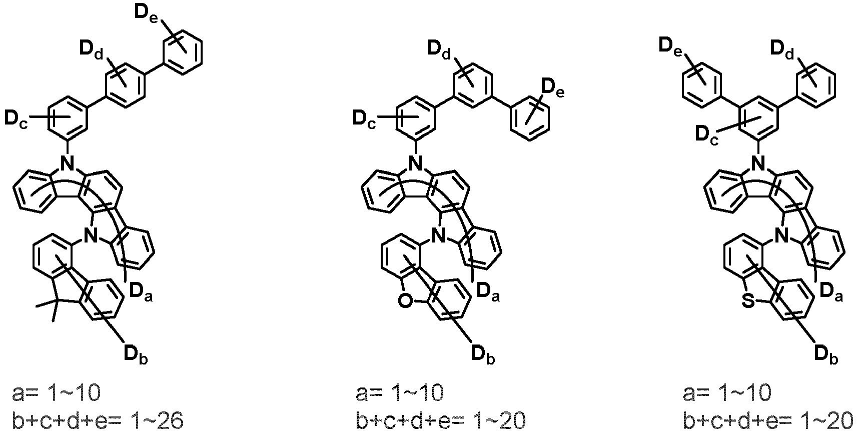

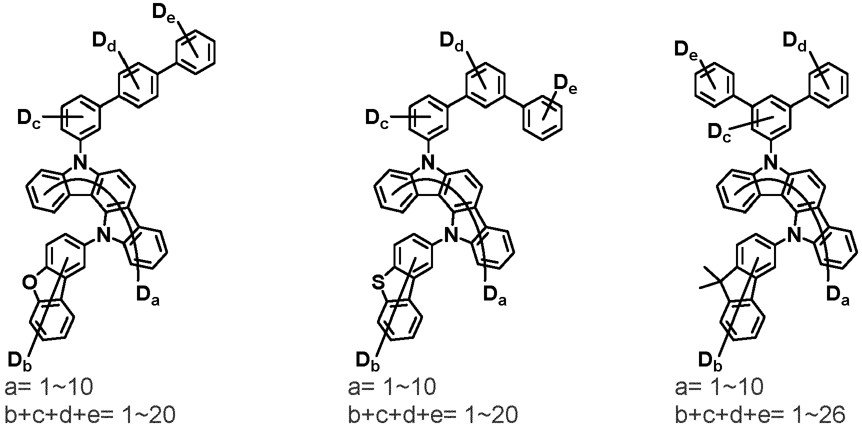

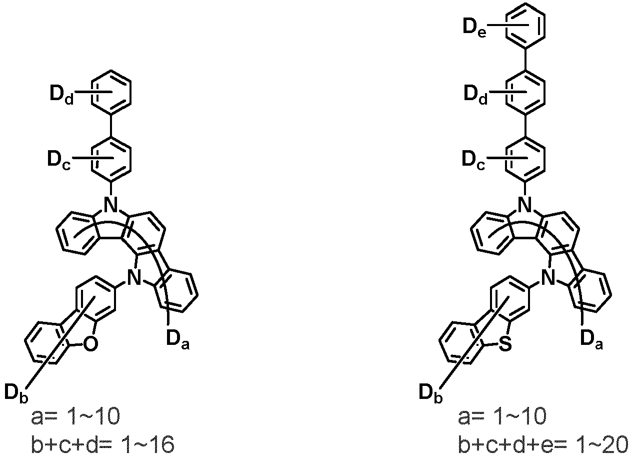

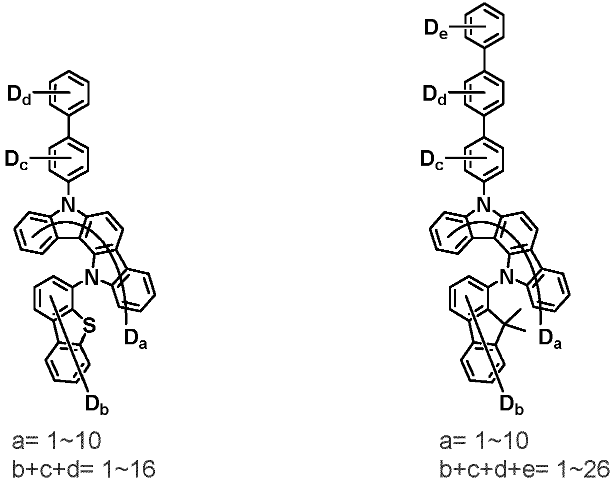

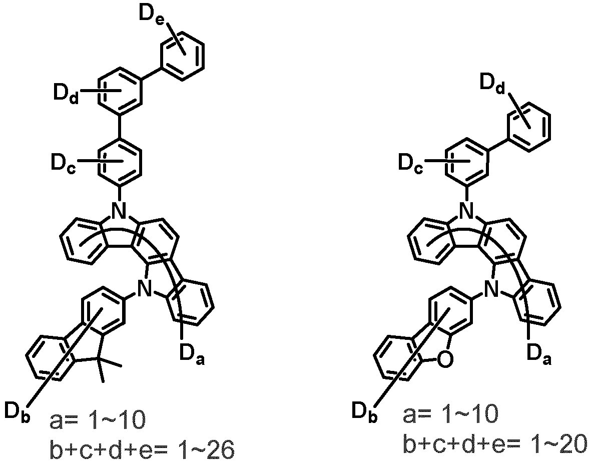

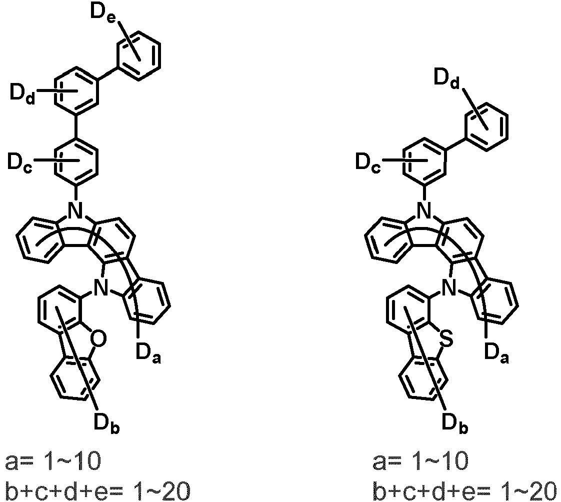

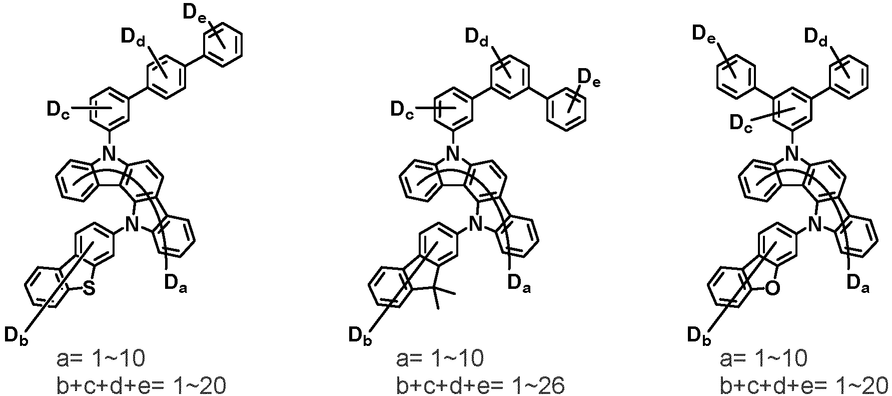

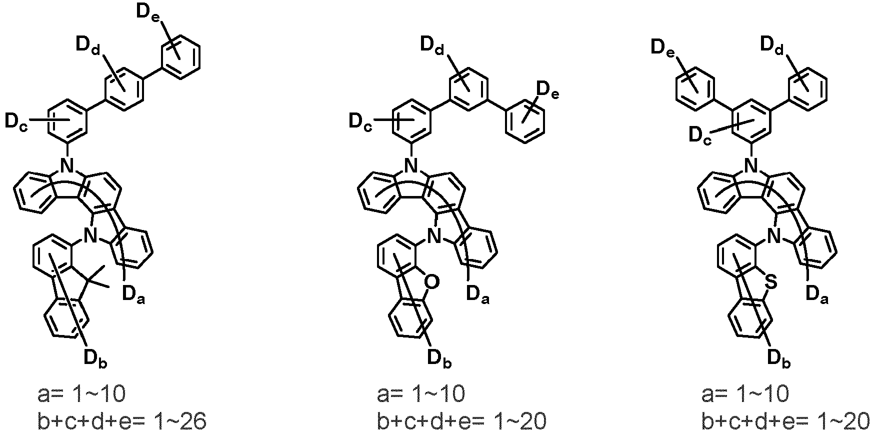

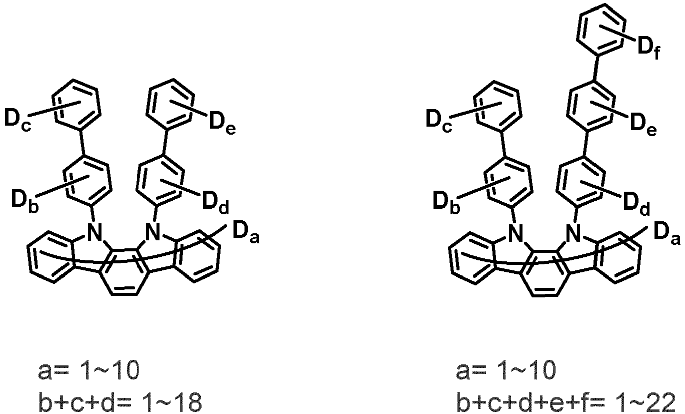

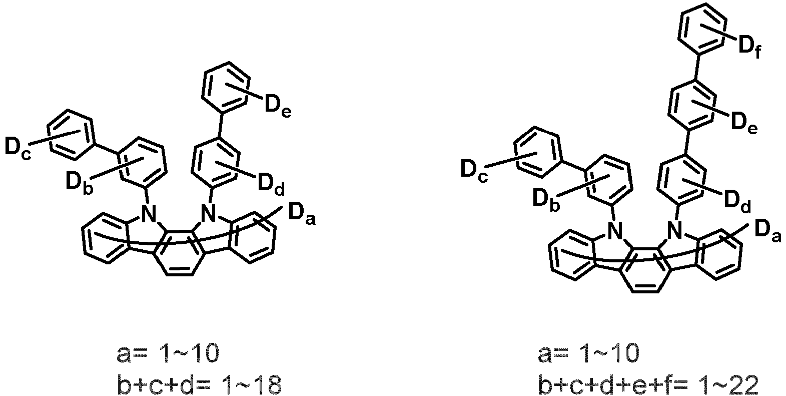

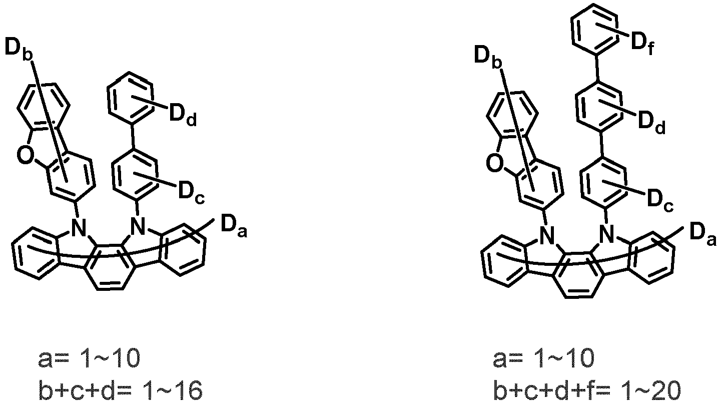

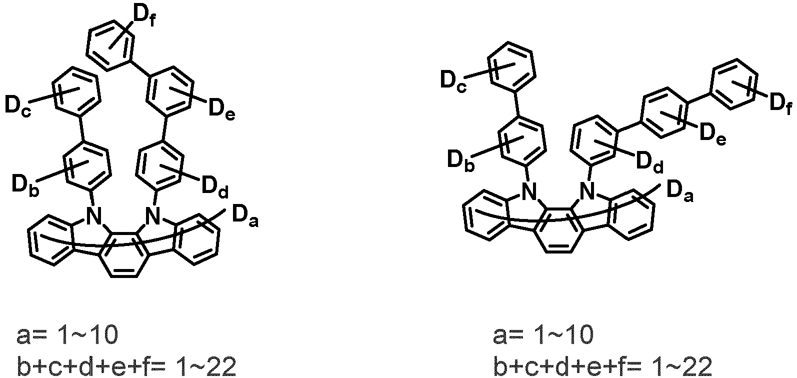

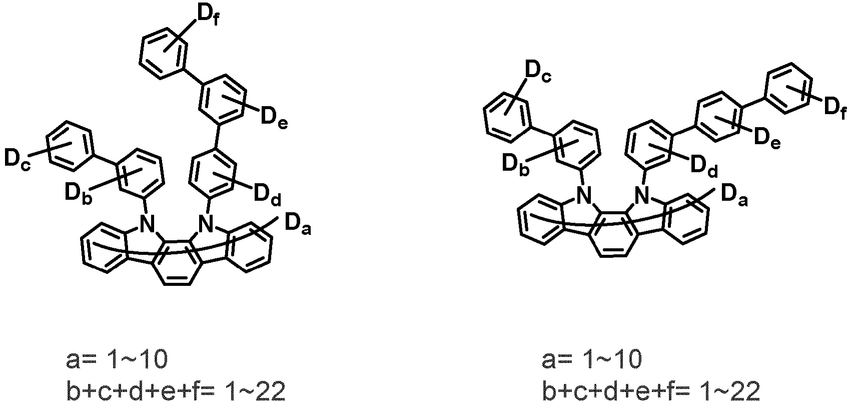

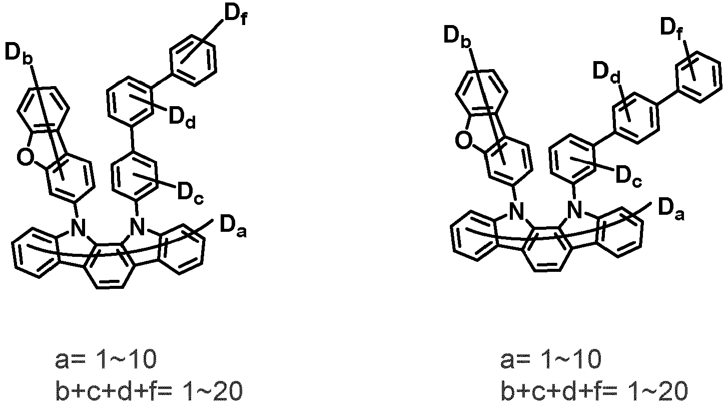

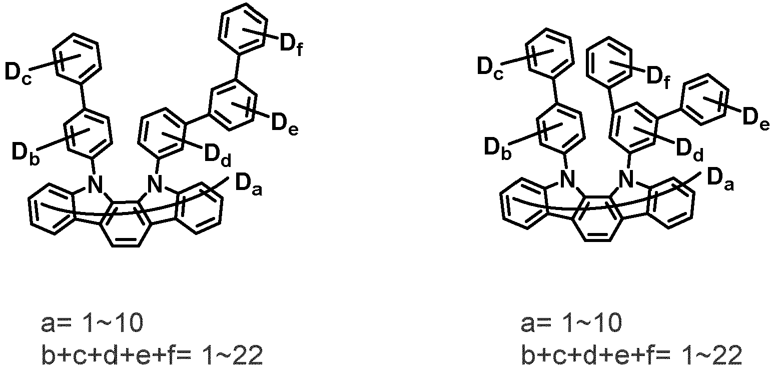

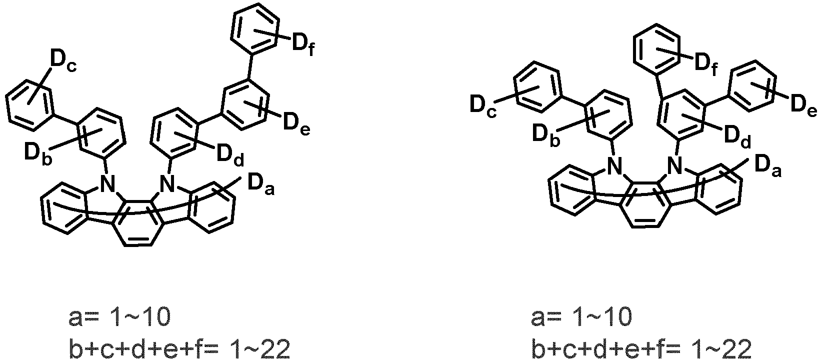

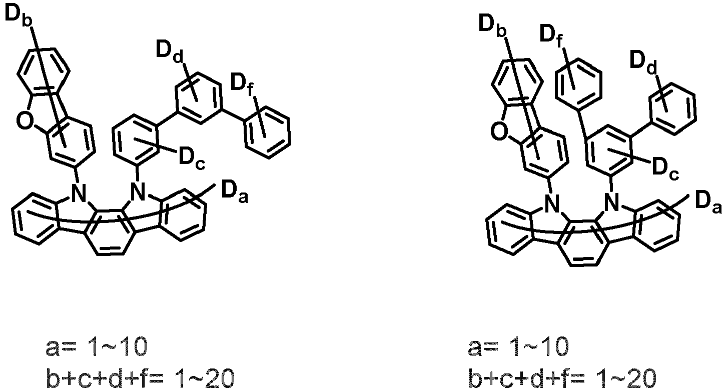

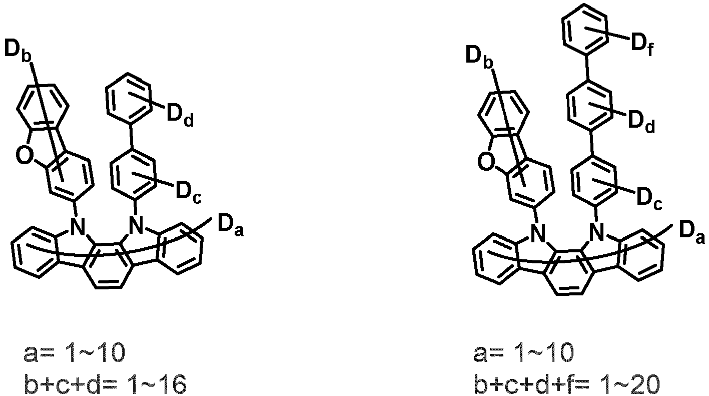

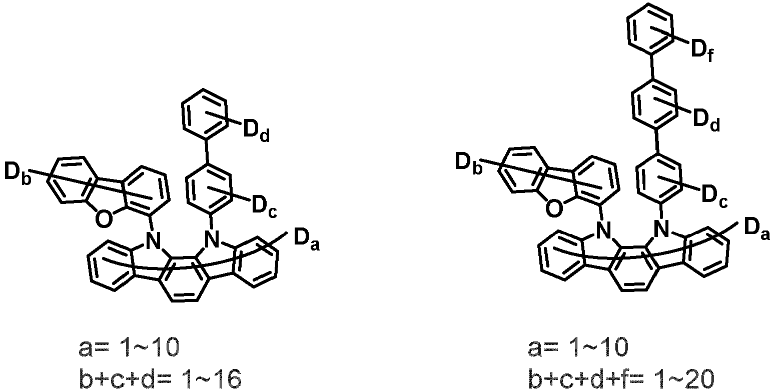

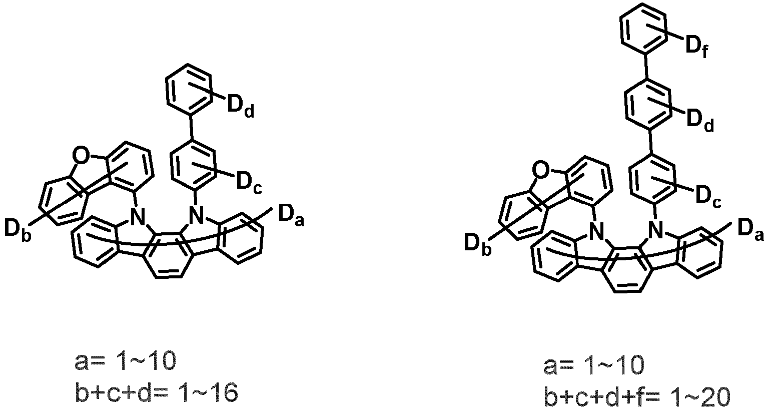

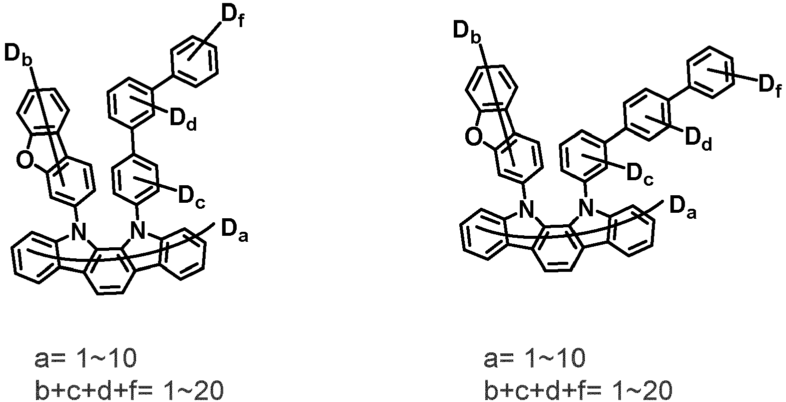

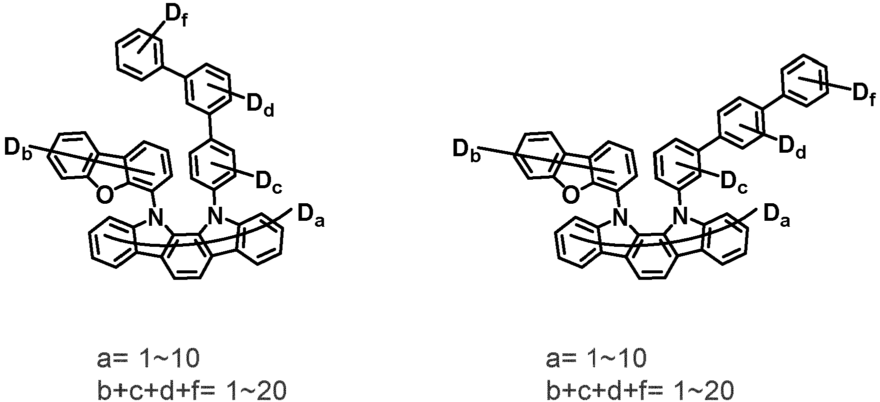

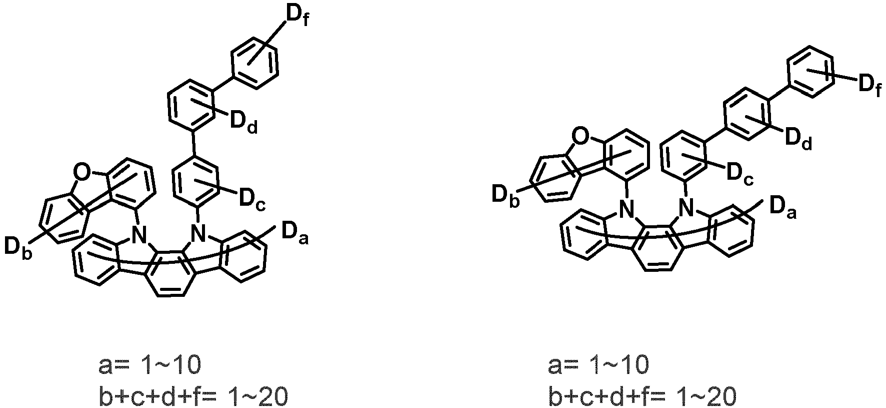

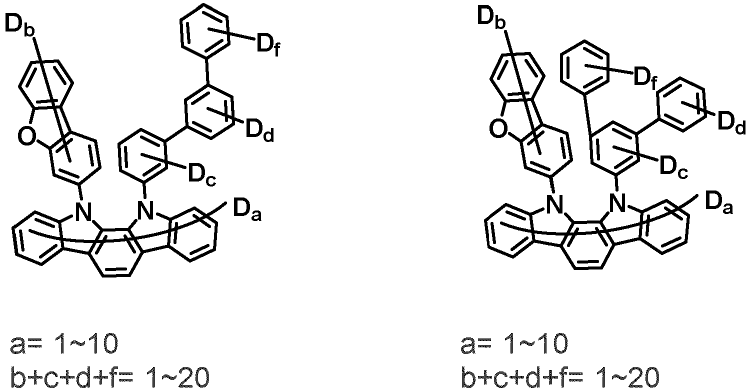

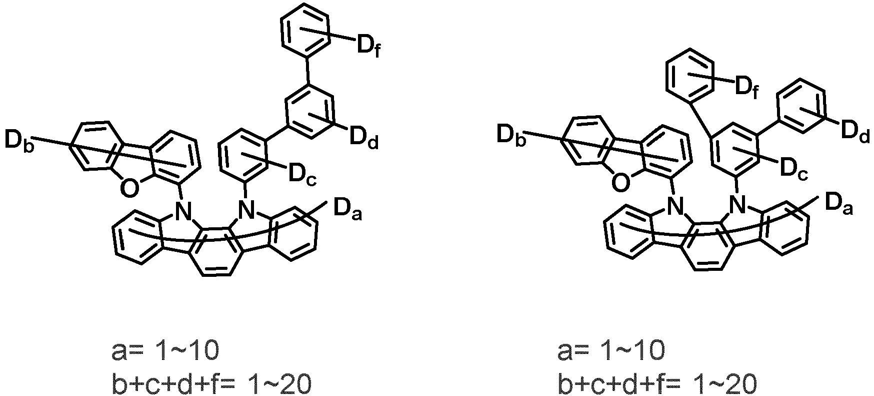

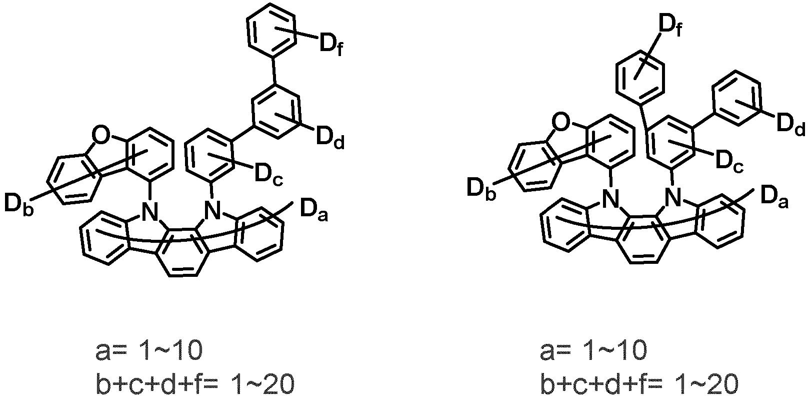

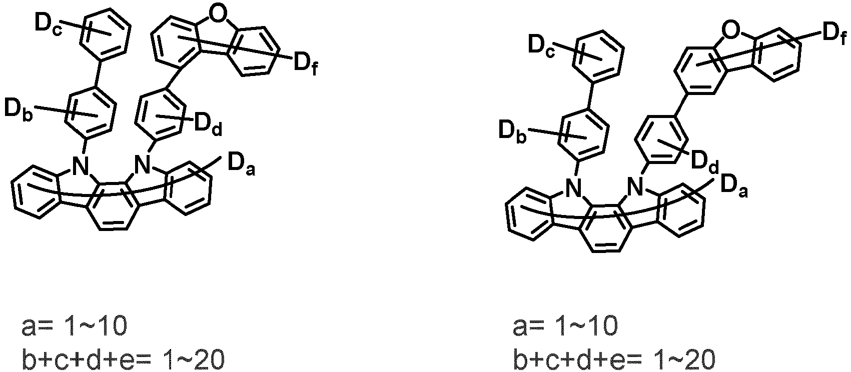

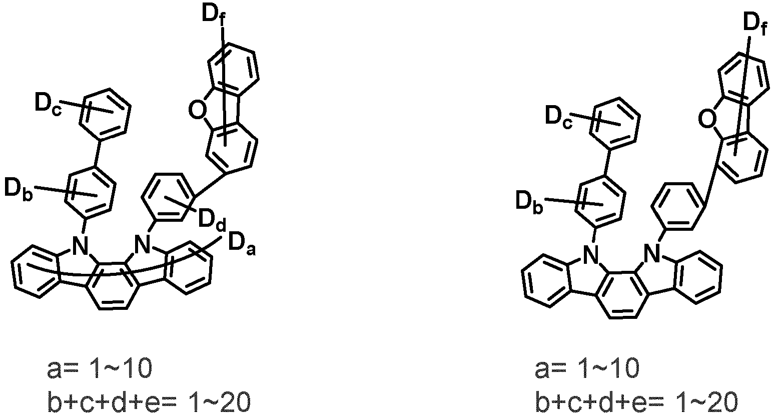

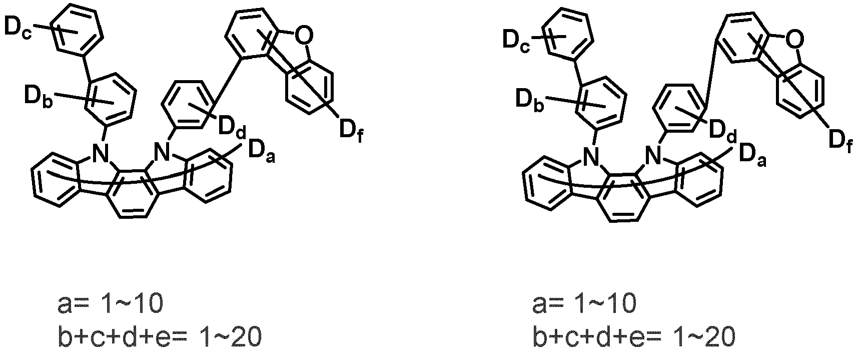

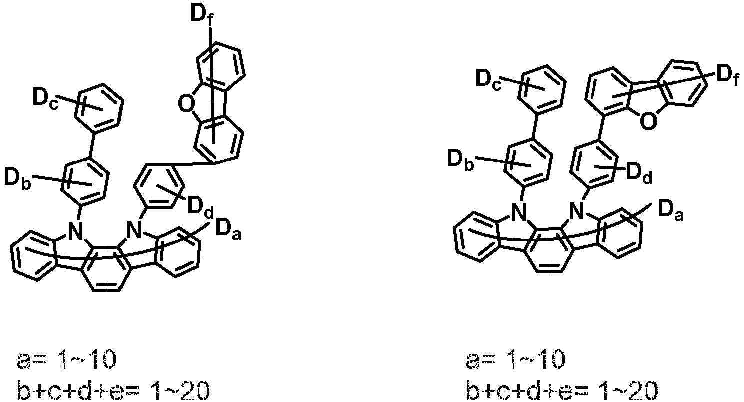

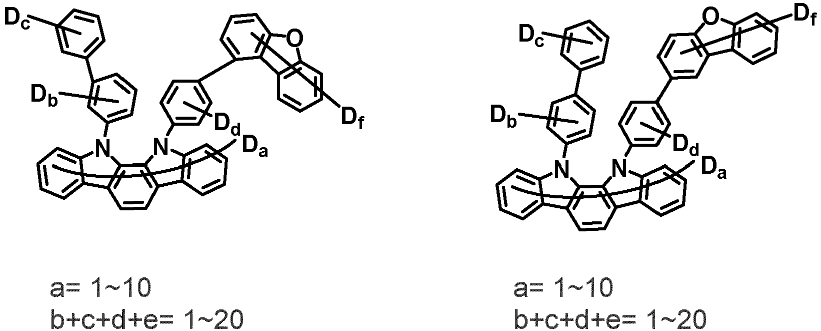

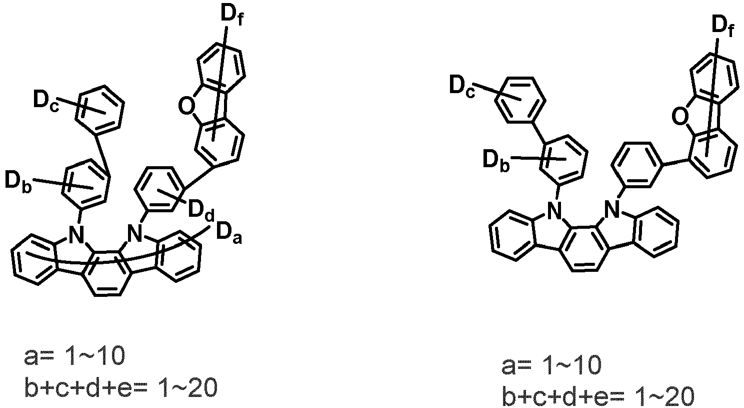

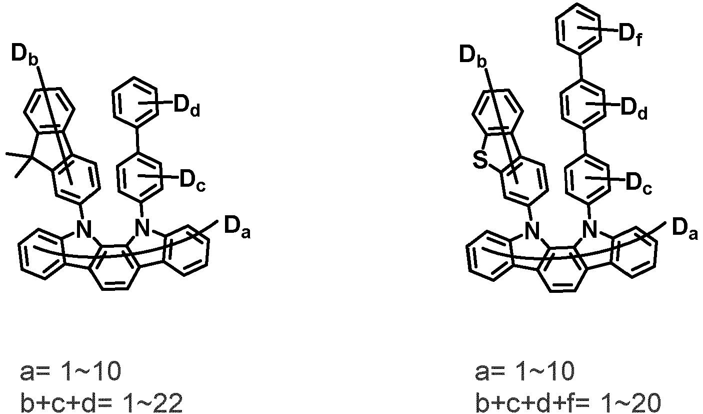

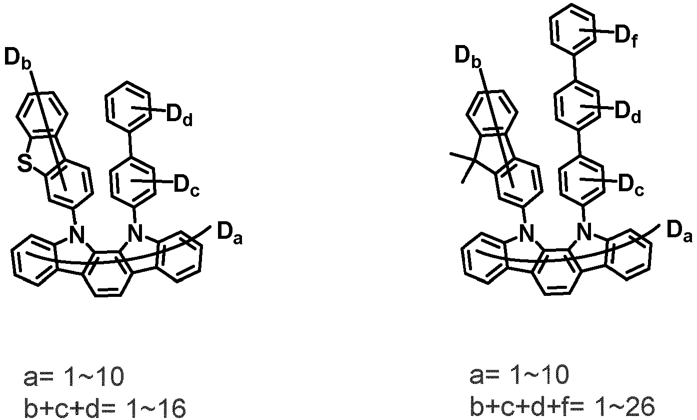

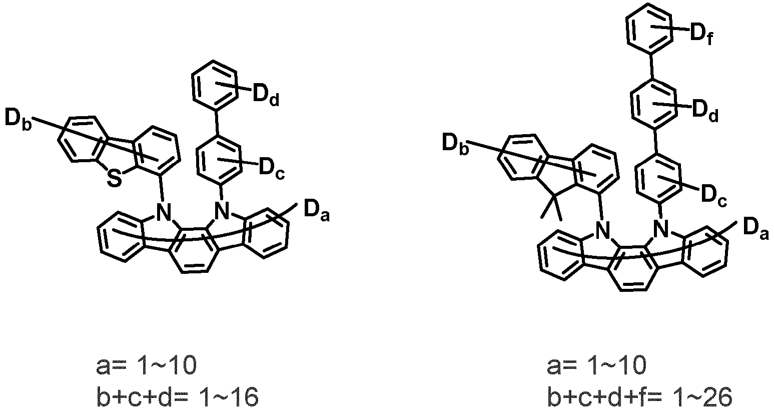

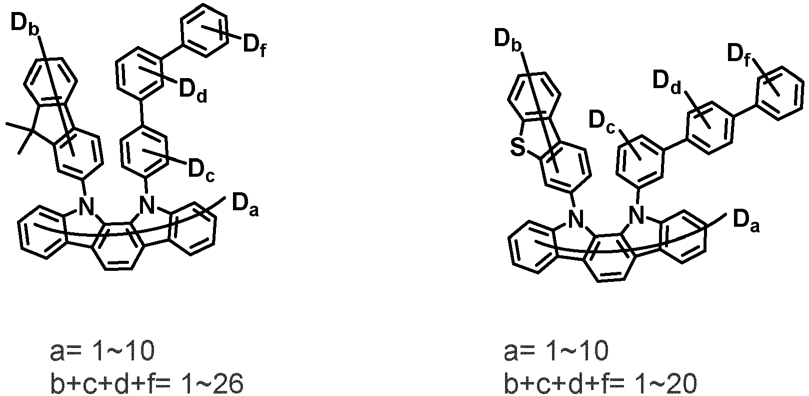

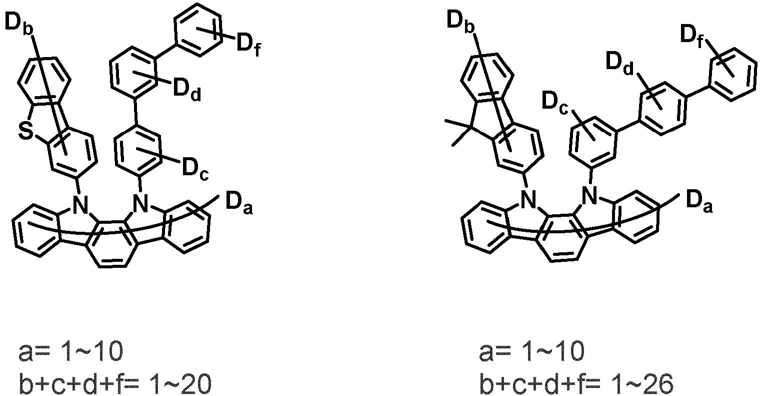

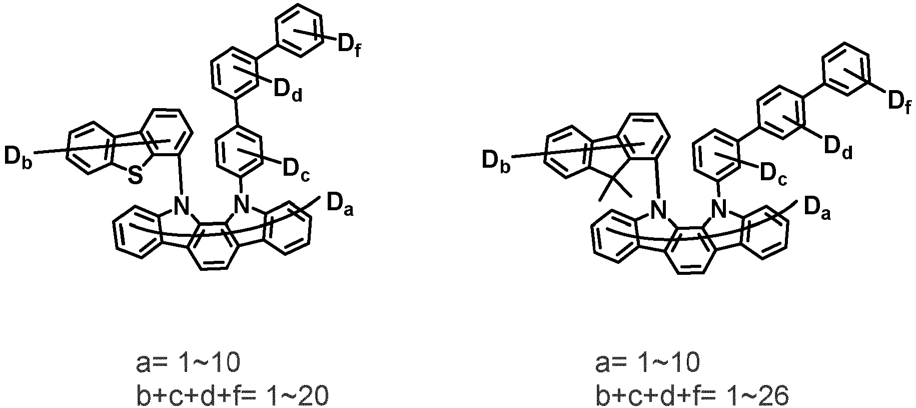

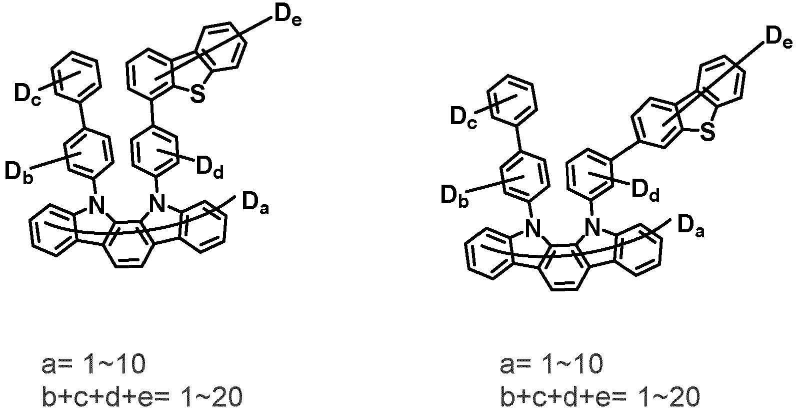

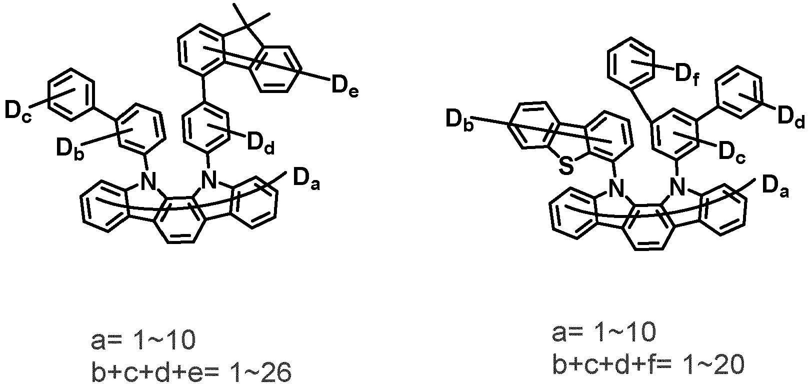

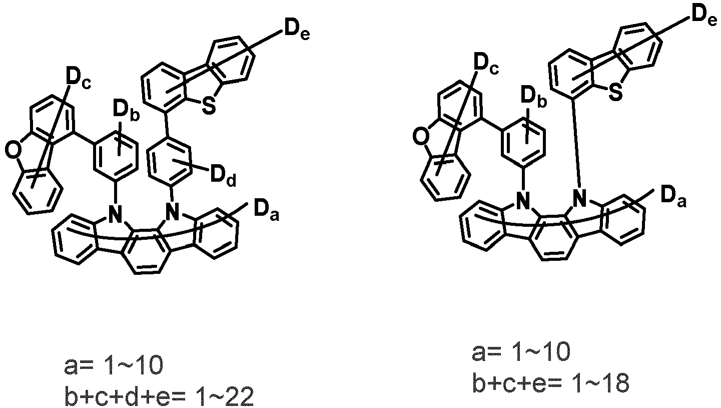

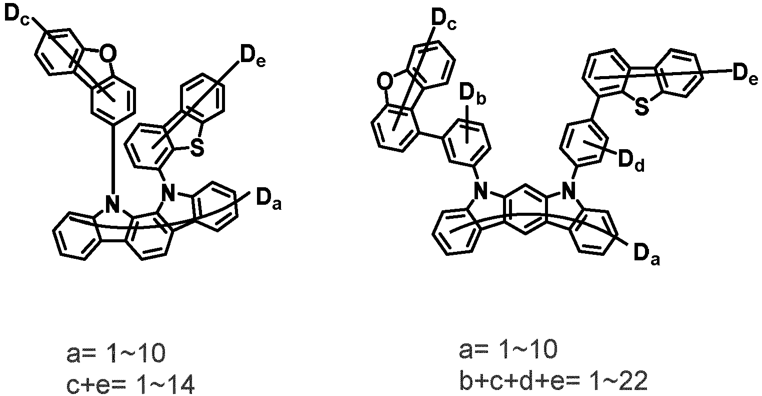

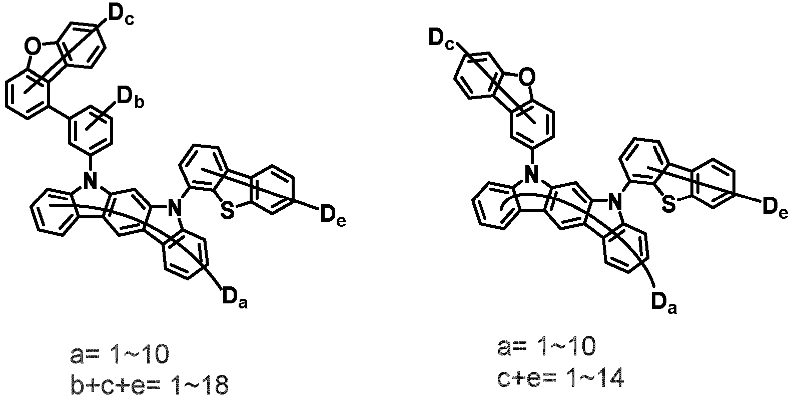

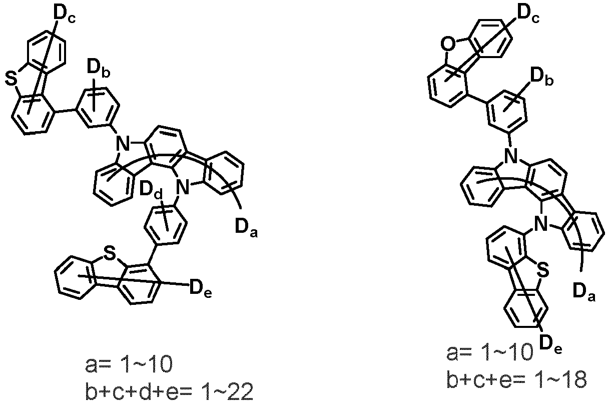

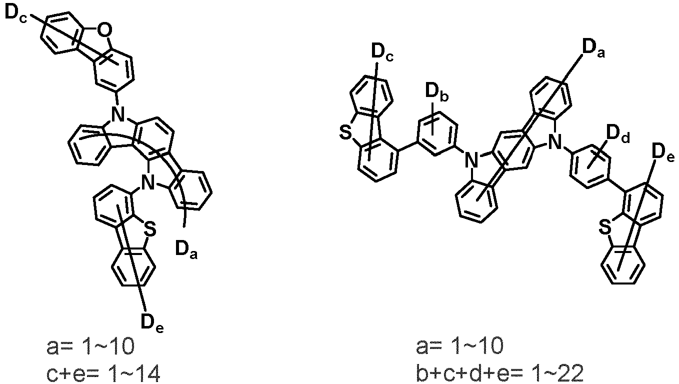

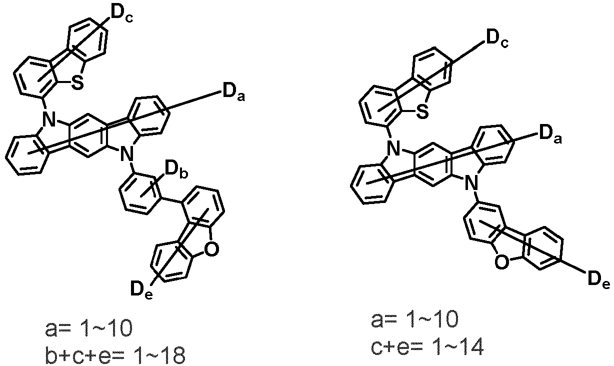

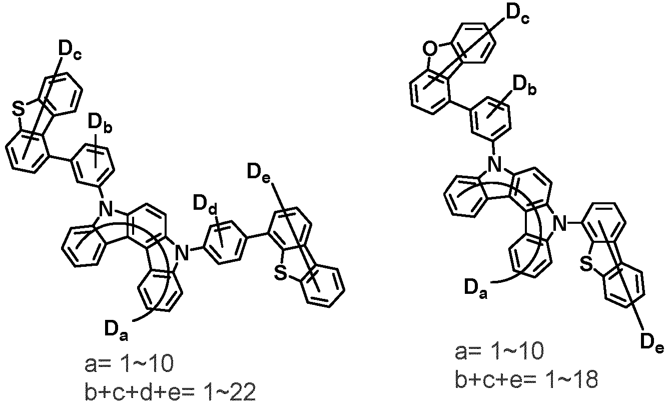

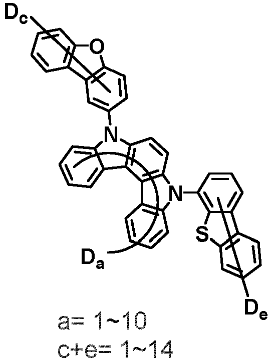

## Revendications

1. Dispositif électroluminescent organique comprenant :
une anode (2) ;
une cathode (4) ; et
une couche (3) électroluminescente qui est disposée entre l'anode et la cathode,
dans lequel la couche électroluminescente comprend un composé représenté par la Formule chimique 1 suivante et un composé représenté par la Formule chimique 2 suivante : 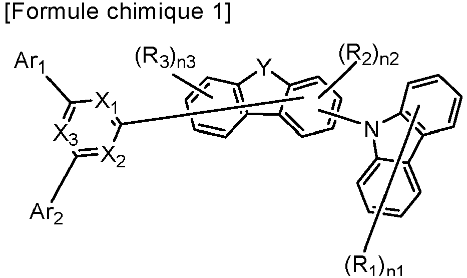
dans lequel, dans la Formule chimique 1 :
Y est O ou S ;
X₁, X₂ et X₃ sont chacun indépendamment CH ou N, à condition qu'au moins un parmi X₁, X₂ et X₃ soit N ; et
Ar₁ et Ar₂ sont chacun indépendamment un aryle en C₆₋₆₀ substitué ou non substitué, ou un hétéroaryle en C₂₋₆₀ substitué ou non substitué contenant au moins un hétéroatome sélectionné dans le groupe consistant en N, O et S ;
R₁, R₂ et R₃ sont chacun indépendamment un hydrogène, un deutérium, un aryle en C₆₋₆₀ substitué ou non substitué, ou un hétéroaryle en C₂₋₆₀ substitué ou non substitué contenant au moins un hétéroatome sélectionné dans le groupe consistant en N, O et S ;
n1 est un nombre entier de 0 à 8 ; et
n2+n3 est un nombre entier de 0 à 6 ; 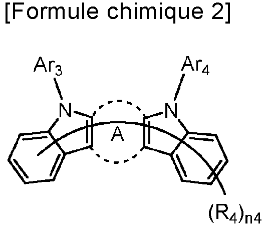
dans lequel, dans la Formule chimique 2 :
A est un cycle benzène condensé avec deux cycles adjacents ;
Ar₃ et Ar₄ sont chacun indépendamment un aryle en C₆₋₆₀ substitué ou non substitué, ou un hétéroaryle en C₂₋₆₀ substitué ou non substitué contenant au moins un hétéroatome sélectionné dans le groupe consistant en O et S, à condition qu'au moins un parmi Ar₃ et Ar₄ soit substitué par au moins un deutérium ;
chaque R₄ est indépendamment un hydrogène, un deutérium, un aryle en C₆₋₆₀ substitué ou non substitué, ou un hétéroaryle en C₂₋₆₀ substitué ou non substitué contenant au moins un hétéroatome sélectionné dans le groupe consistant en N, O et S, à condition qu'au moins un des R₄ soit un deutérium ; et
n4 est un nombre entier de 1 à 10.

2. Dispositif électroluminescent organique selon la revendication 1,
dans lequel X₁ à X₃ sont tous N ;
X₁ et X₂ sont N, et X₃ est CH ;
X₁ et X₃ sont N, et X₂ est CH ;
X₁ est N, et X₂ et X₃ sont CH ; ou
X₂ est N, et X₁ et X₃ sont CH.

3. Dispositif électroluminescent organique selon la revendication 1,
dans lequel au moins un parmi Ar₁ et Ar₂ est un aryle en C₆₋₆₀ substitué par un deutérium ou un hétéroaryle en C₂₋₆₀ substitué par un deutérium contenant au moins un hétéroatome sélectionné dans le groupe consistant en N, O et S ; ou
au moins un parmi R₁ à R₃ est un deutérium ; un aryle en C₆₋₆₀ substitué par un deutérium ; ou un hétéroaryle en C₂₋₆₀ substitué par un deutérium contenant au moins un hétéroatome sélectionné dans le groupe consistant en N, O et S, et n1+n2+n3 est 1 ou plus.

4. Dispositif électroluminescent organique selon la revendication 1, dans lequel Ar₁ et Ar₂ sont chacun indépendamment l'un quelconque sélectionné dans le groupe consistant en :

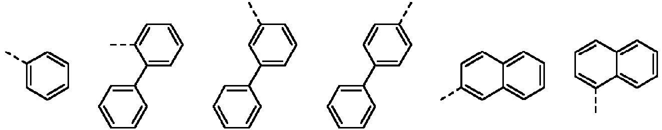

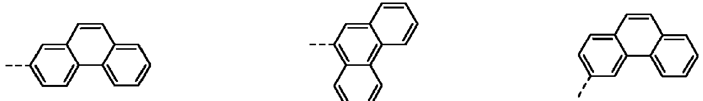

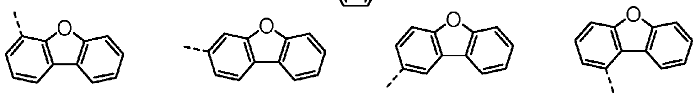

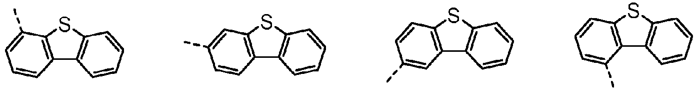

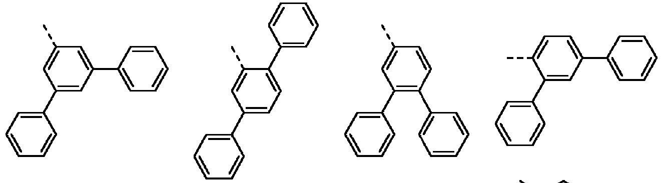

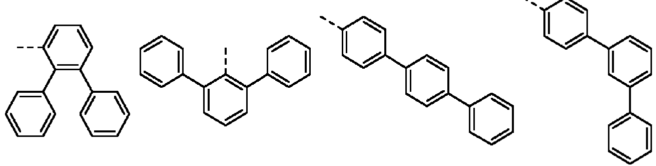

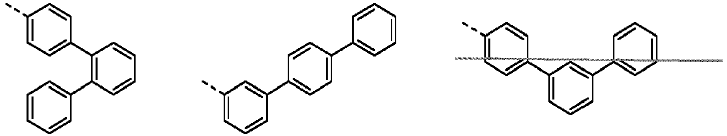

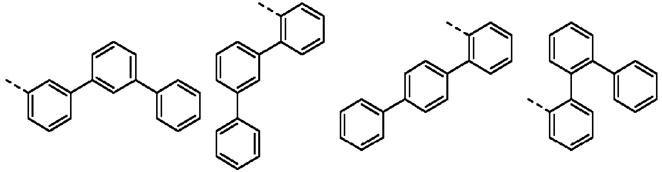

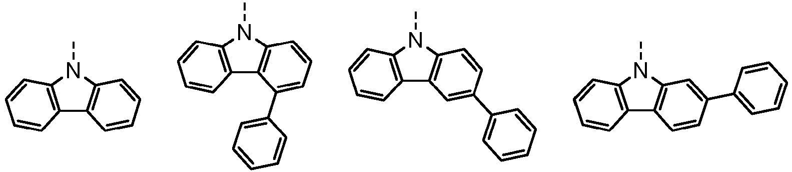

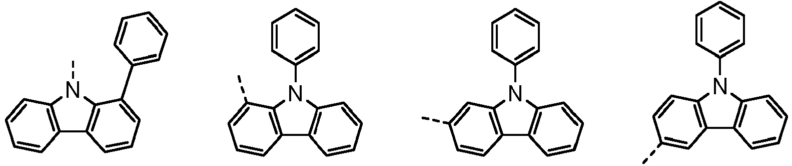

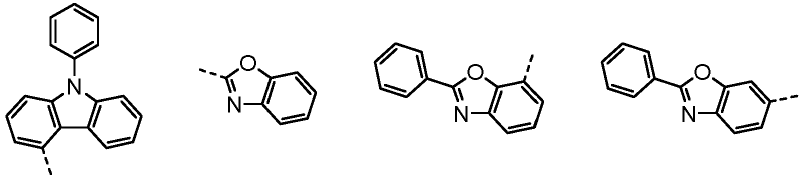

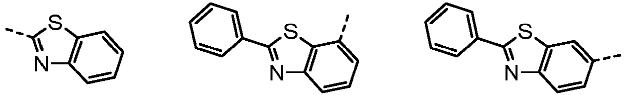

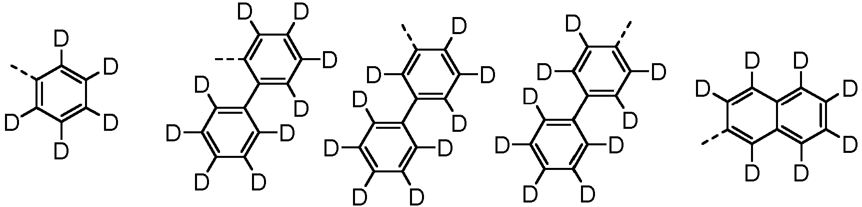

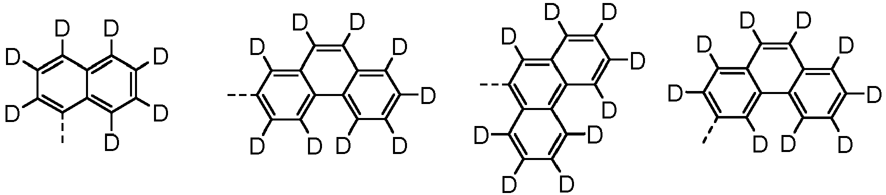

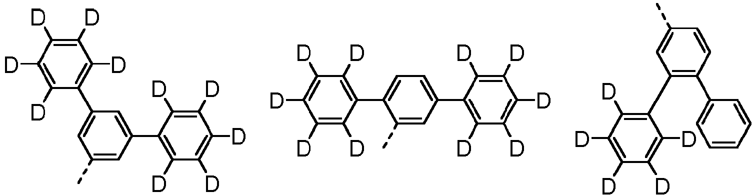

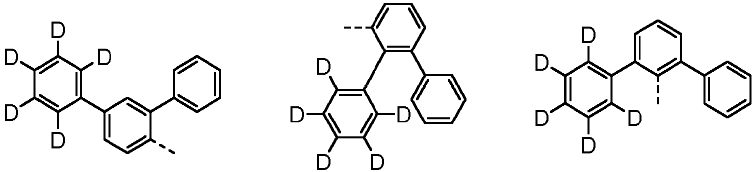

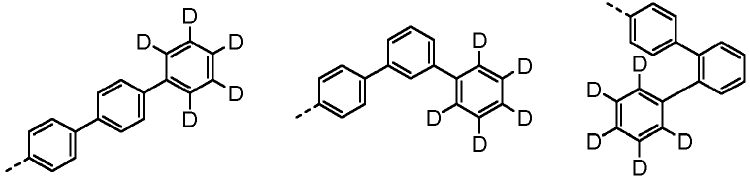

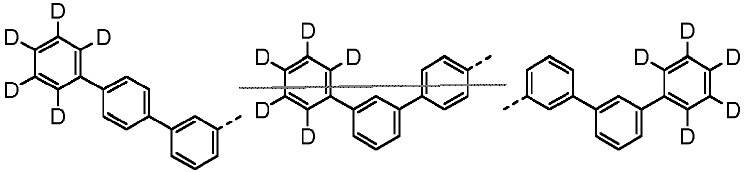

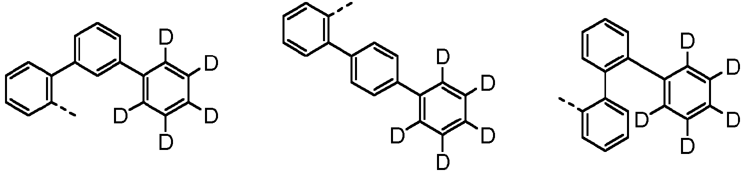

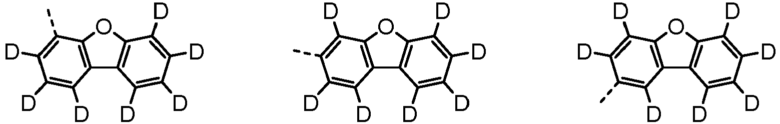

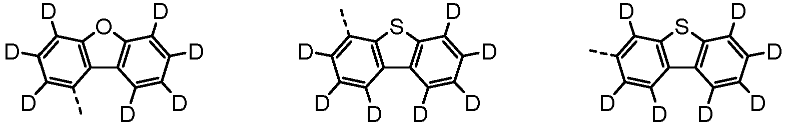

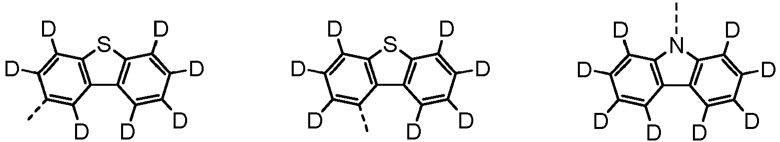

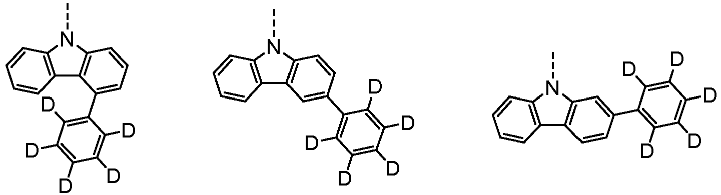

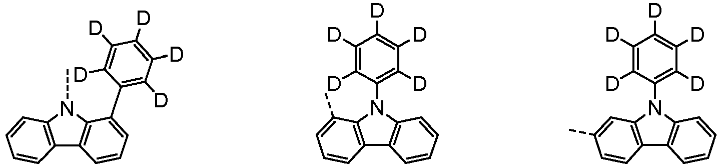

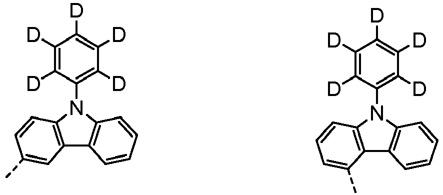

5. Dispositif électroluminescent organique selon la revendication 1, dans lequel au moins un parmi Ar₁ et Ar₂ est un phényle ou un phényle substitué par 5 deutériums.

6. Dispositif électroluminescent organique selon la revendication 1, dans lequel chaque R₁ est indépendamment un hydrogène, un deutérium, un phényle, un dibenzofuranyle, un dibenzothiophényle, un carbazolyle, un phényle substitué par 5 deutériums, un dibenzofuranyle substitué par 7 deutériums, un dibenzothiophényle substitué par 7 deutériums, ou un carbazolyle substitué par 8 deutériums.

7. Dispositif électroluminescent organique selon la revendication 1, dans lequel R₂ et R₃ sont chacun indépendamment un hydrogène, un deutérium, un phényle, un dibenzothiophényle, un carbazolyle, ou un phényle substitué par 5 deutériums.

8. Dispositif électroluminescent organique selon la revendication 1, dans lequel le composé représenté par la Formule chimique 1 est un quelconque composé sélectionné dans le groupe consistant en :

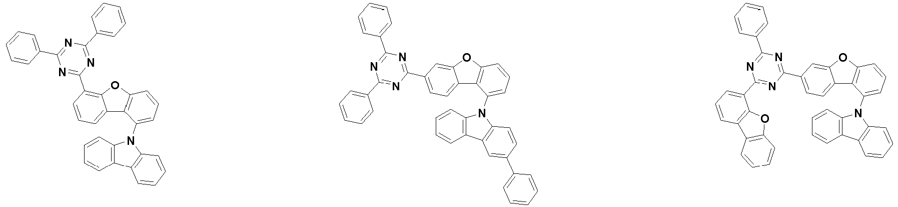

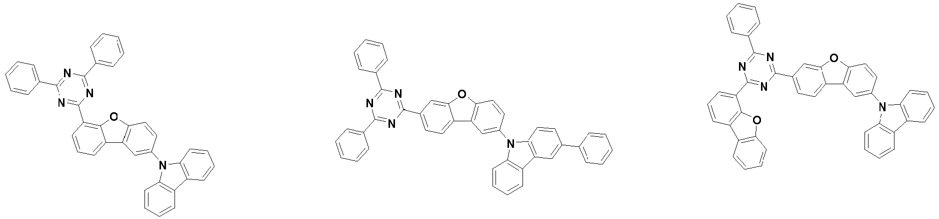

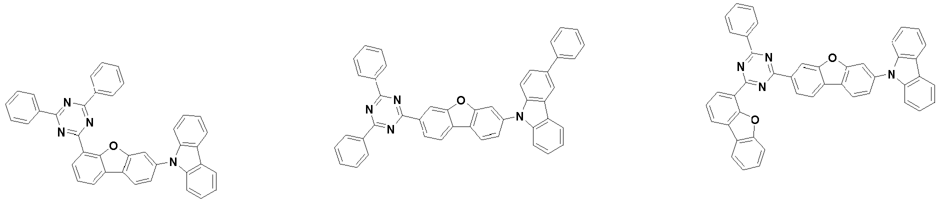

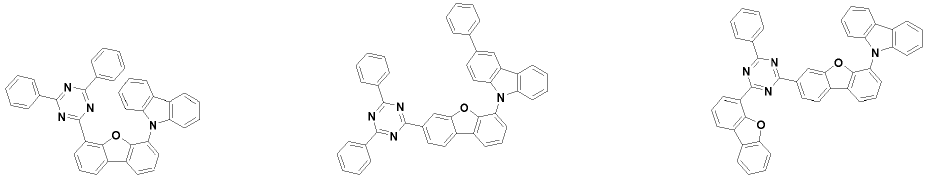

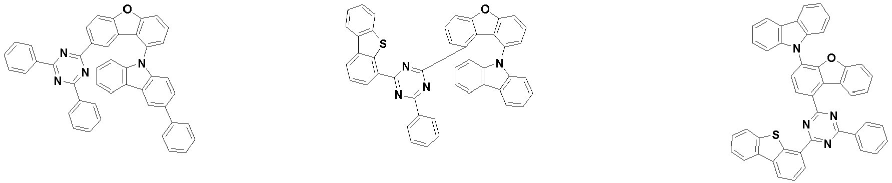

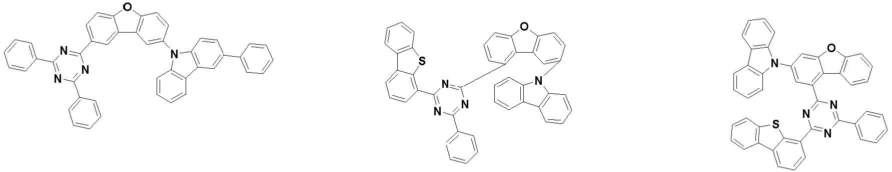

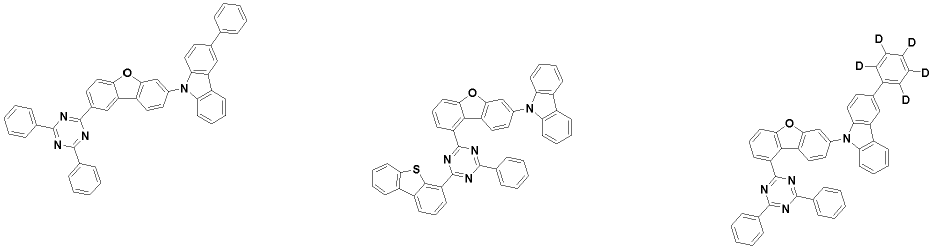

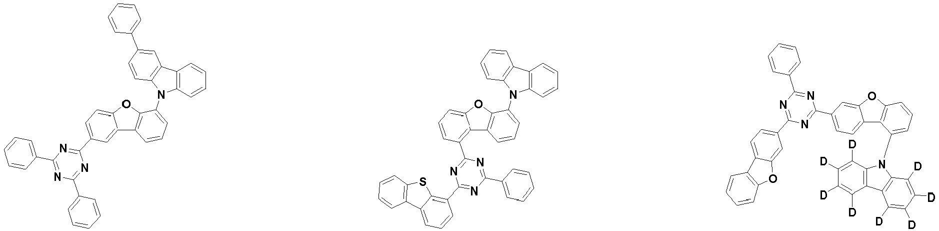

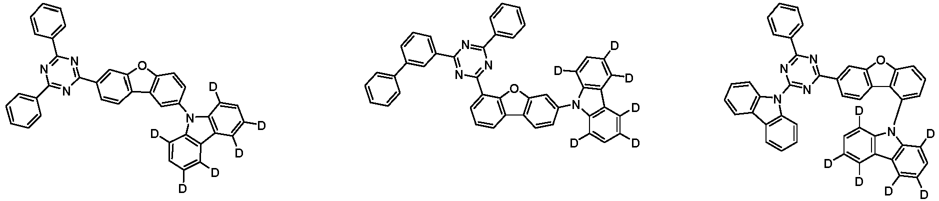

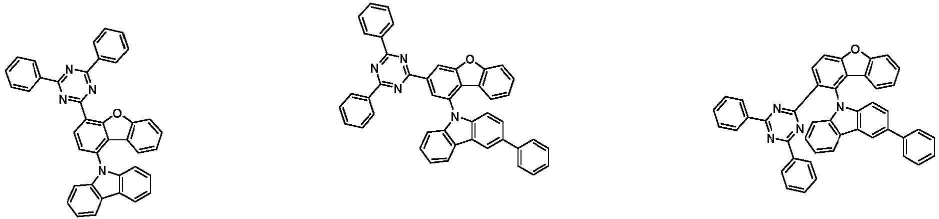

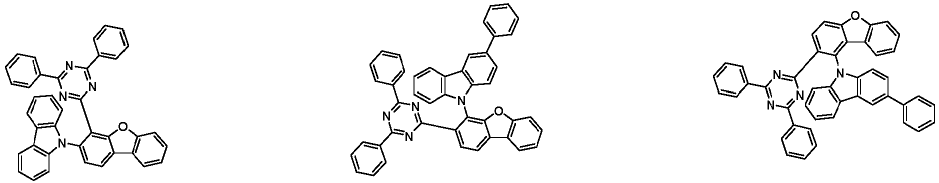

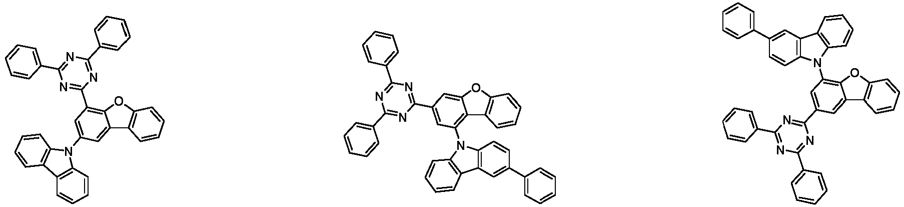

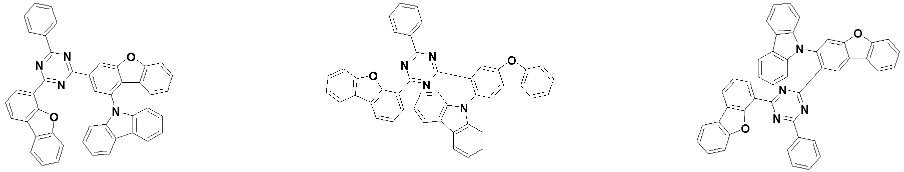

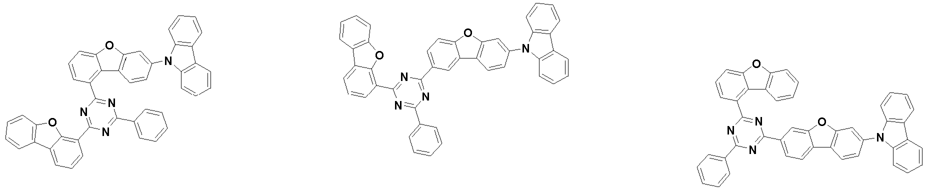

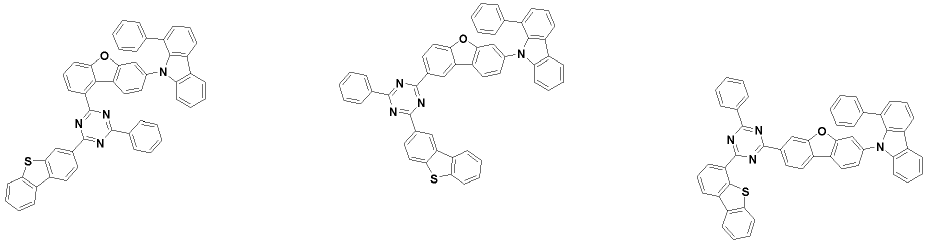

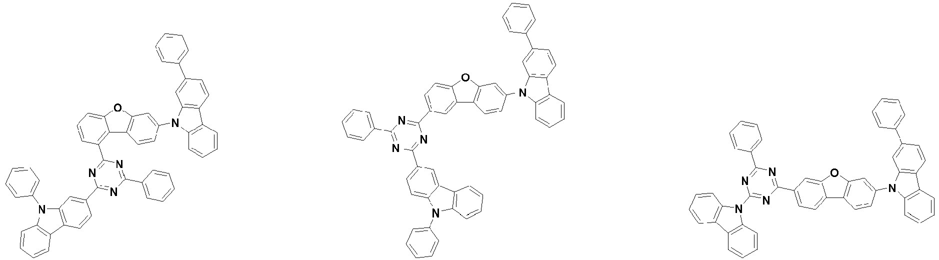

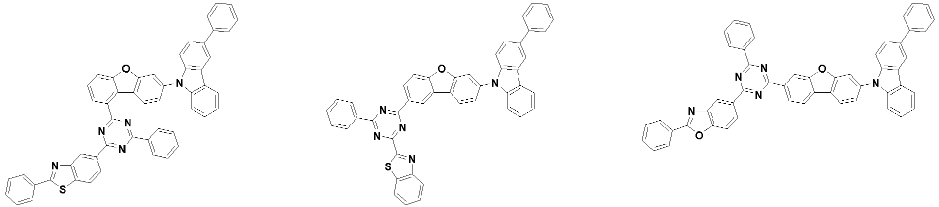

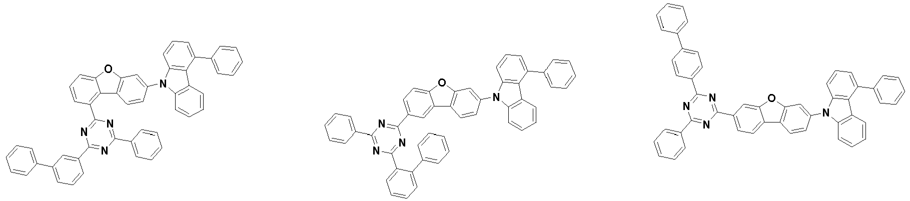

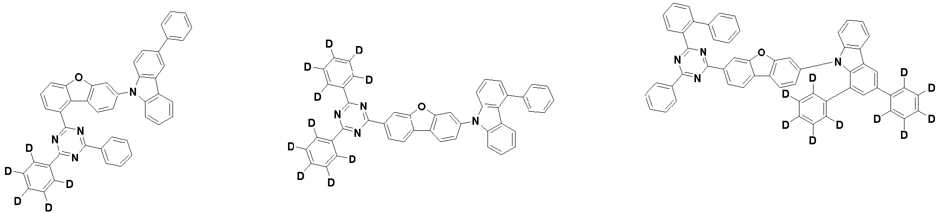

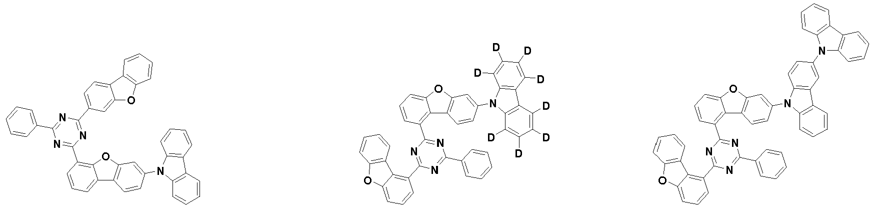

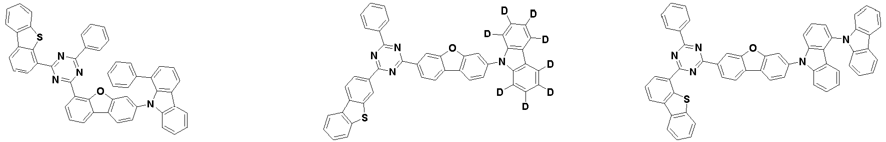

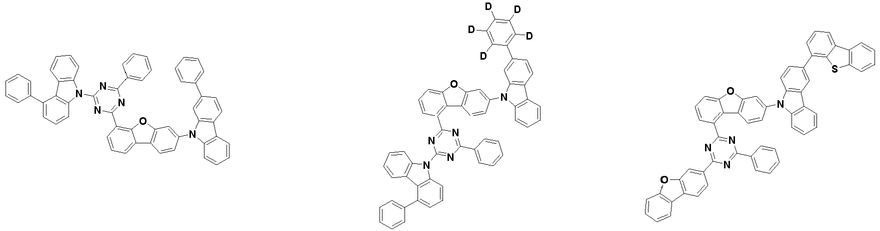

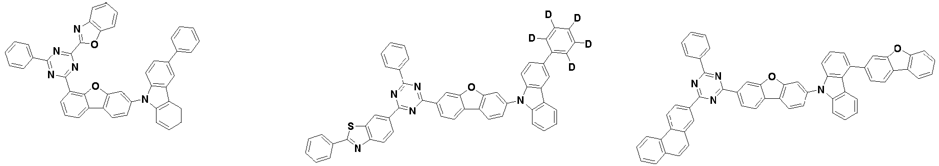

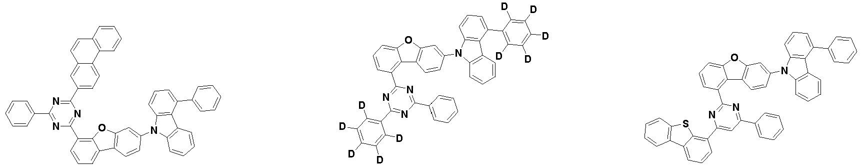

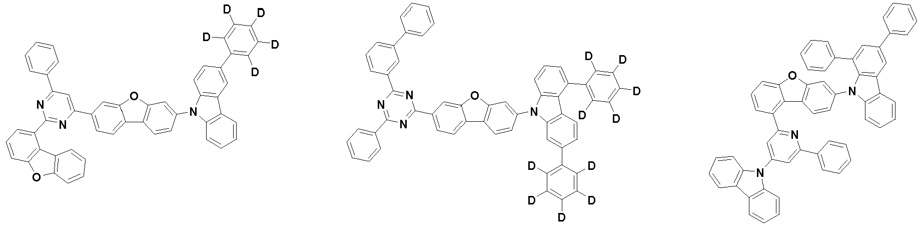

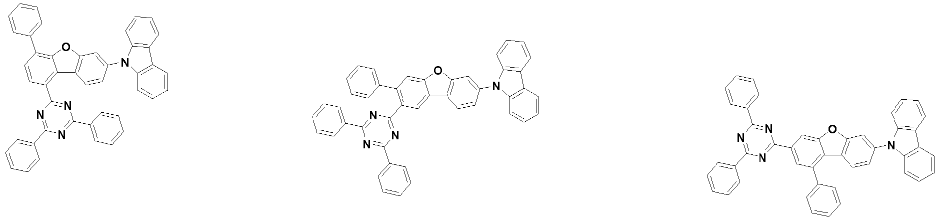

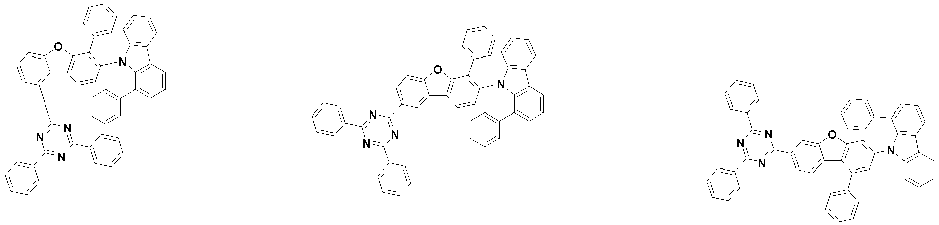

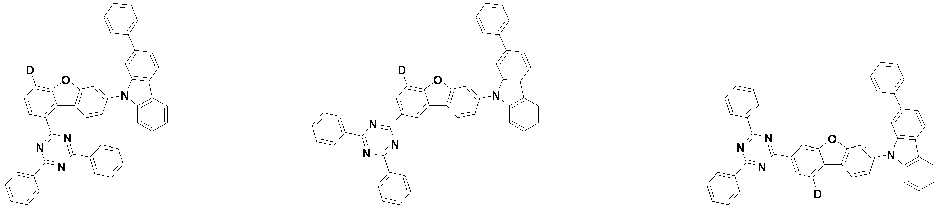

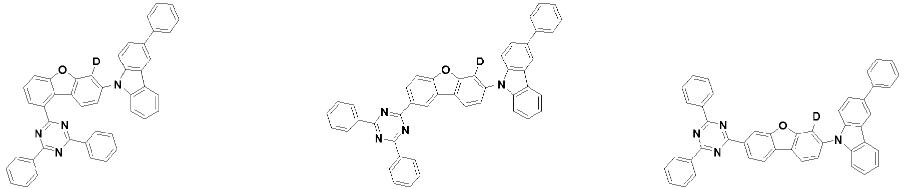

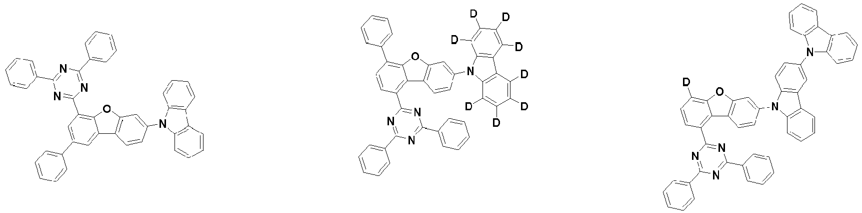

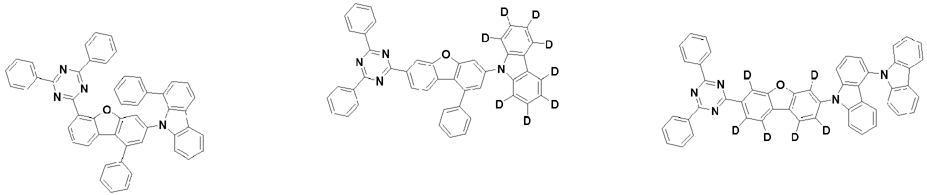

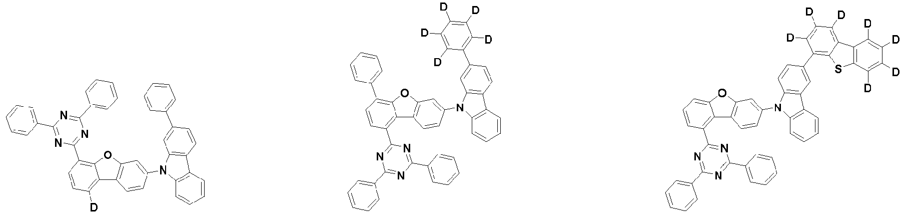

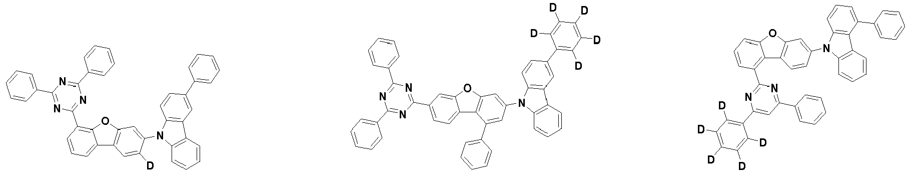

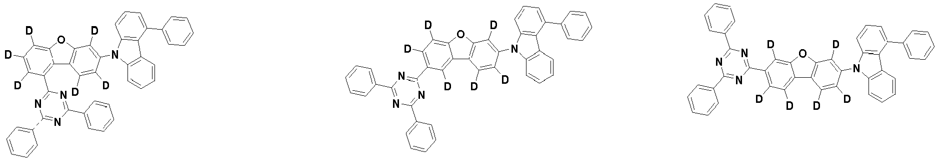

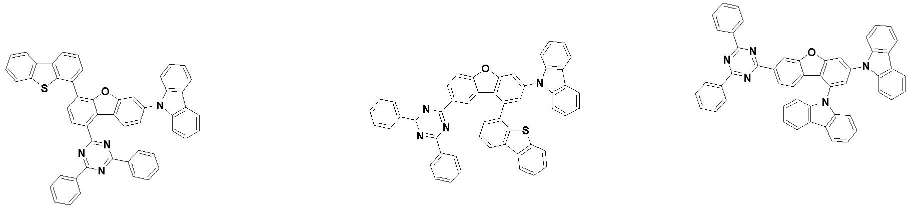

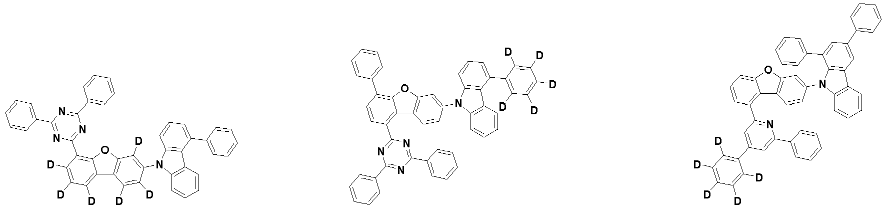

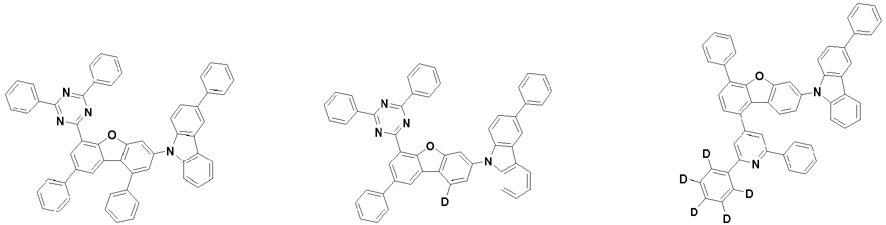

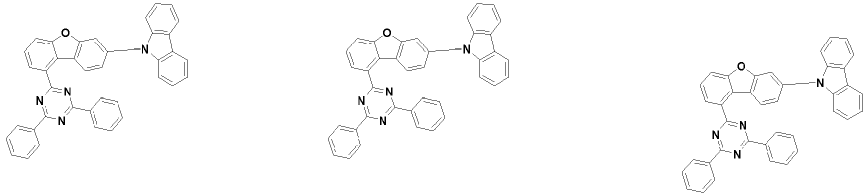

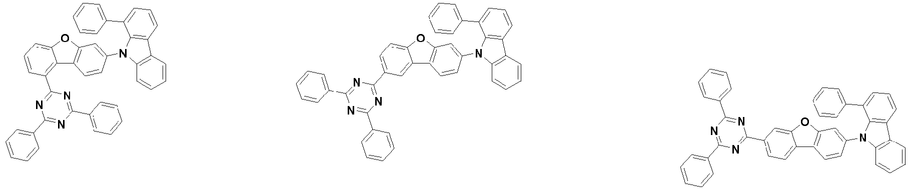

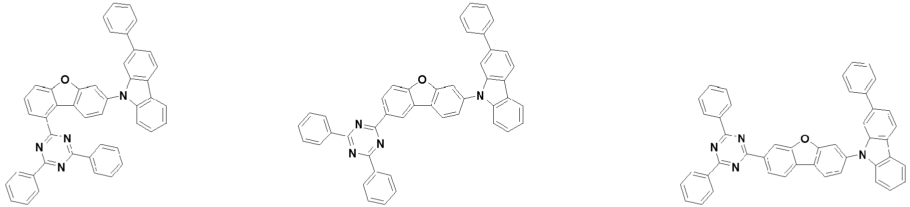

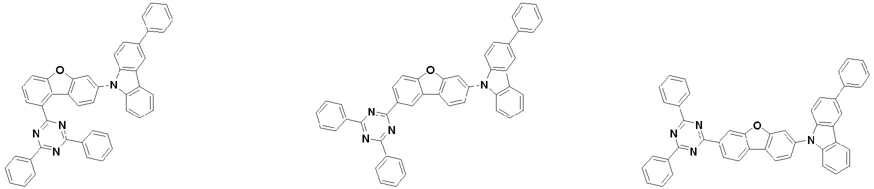

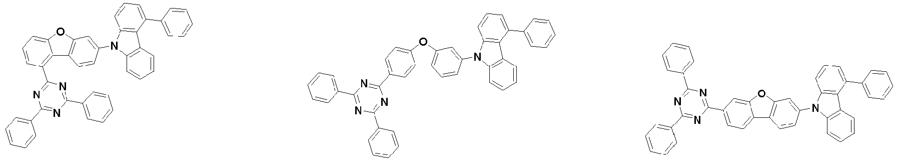

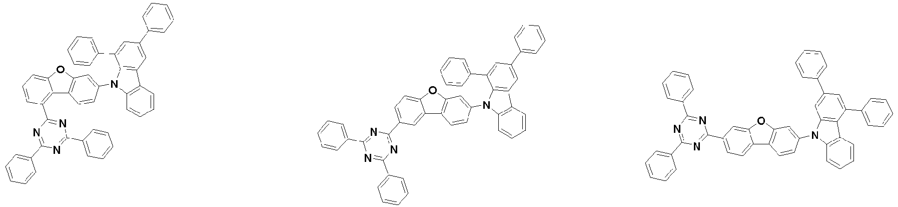

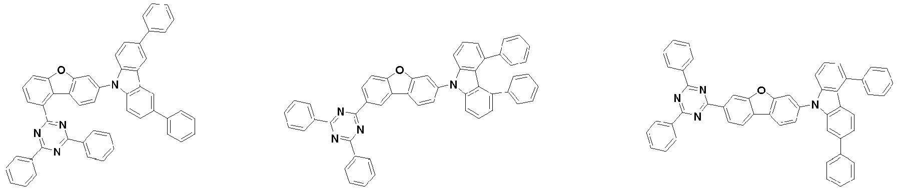

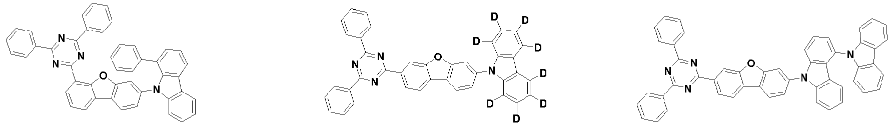

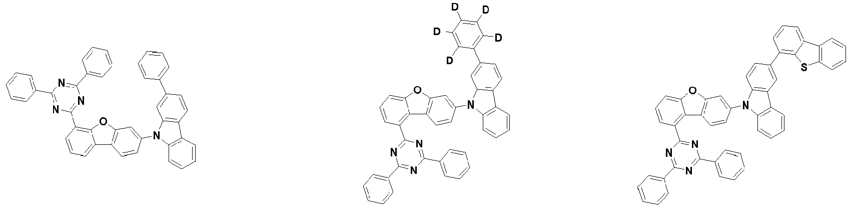

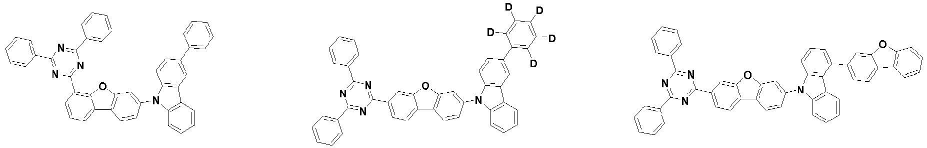

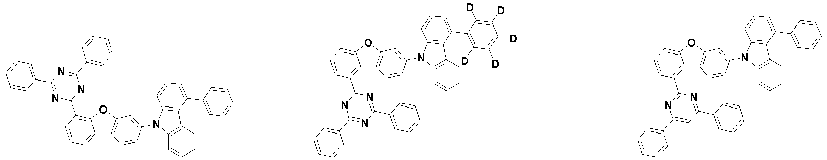

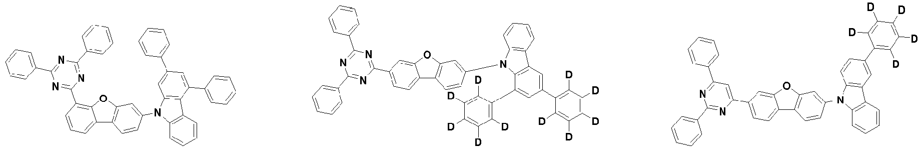

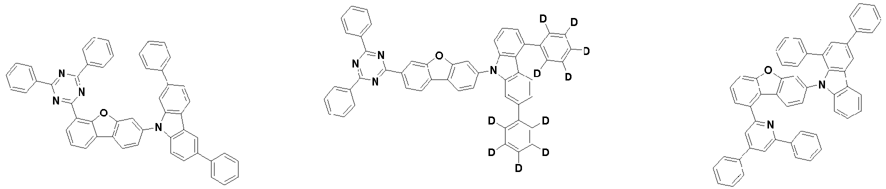

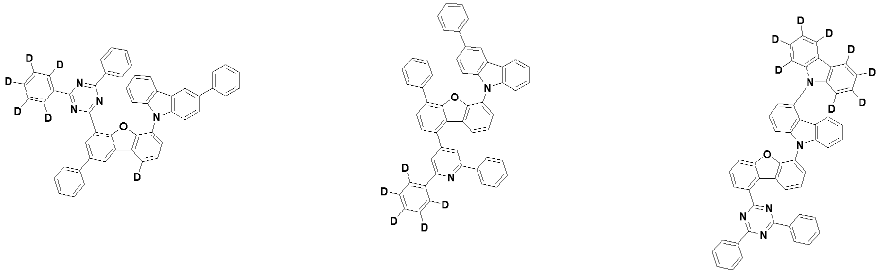

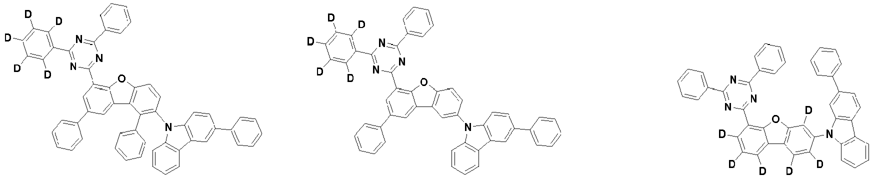

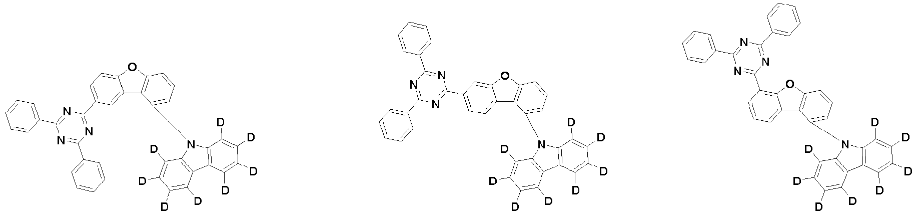

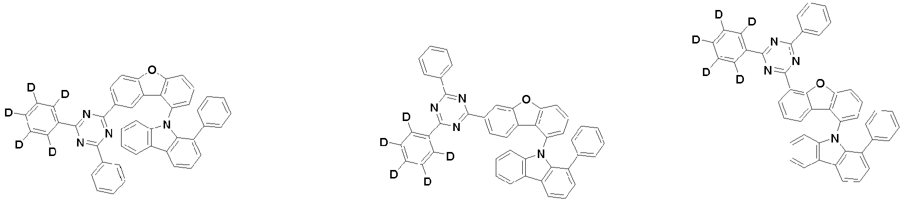

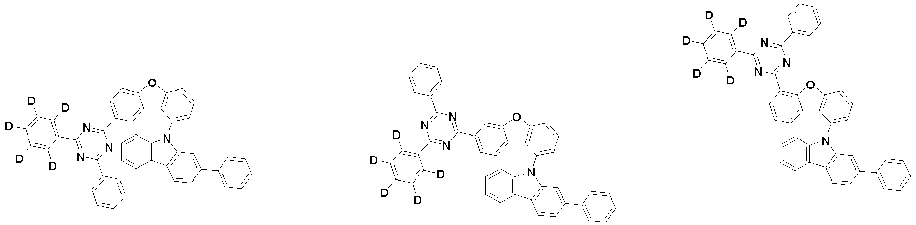

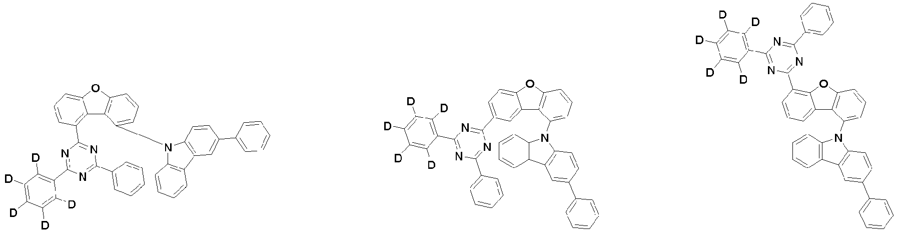

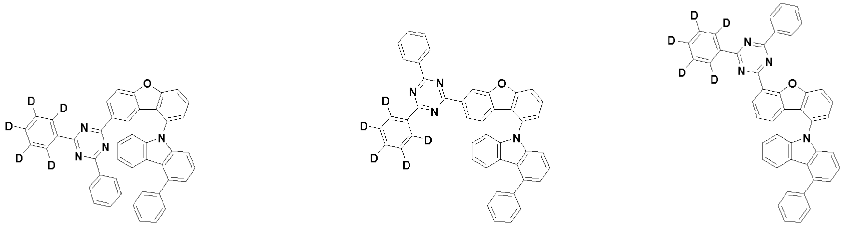

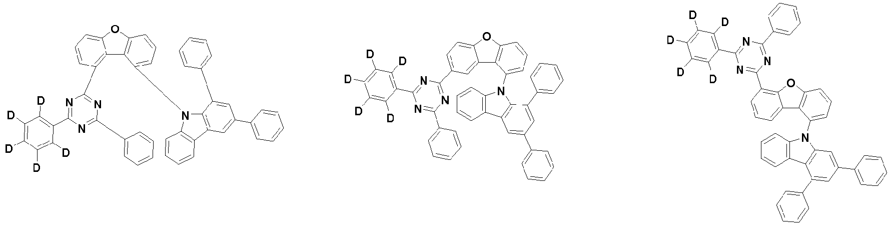

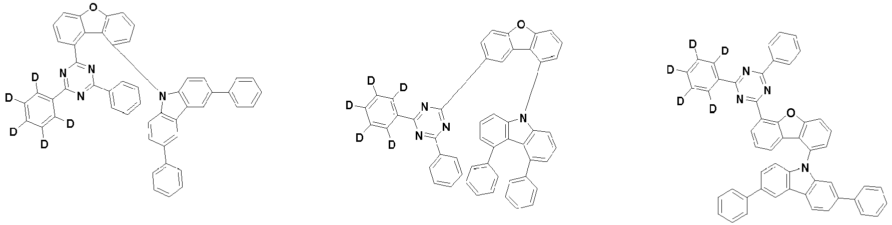

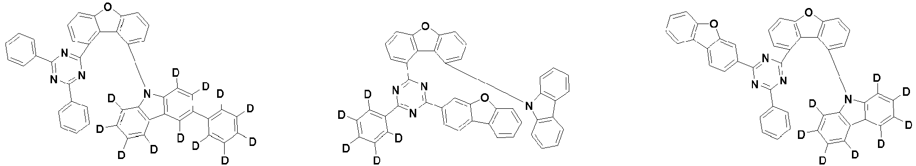

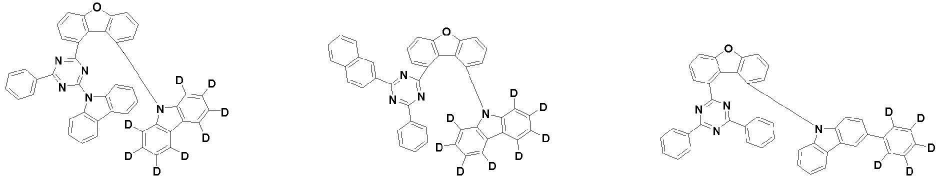

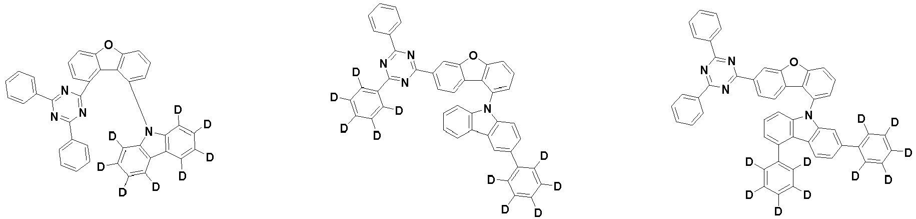

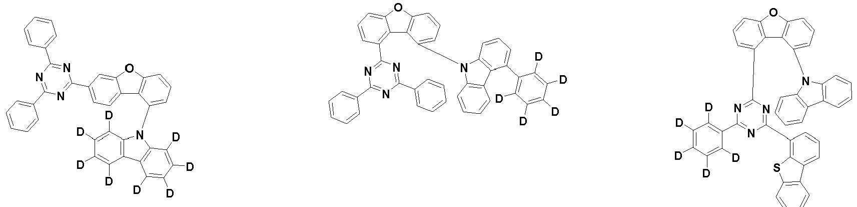

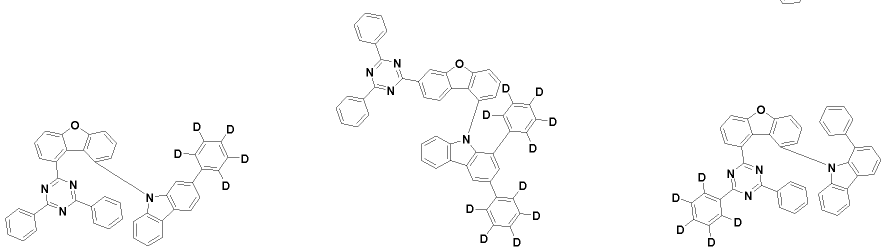

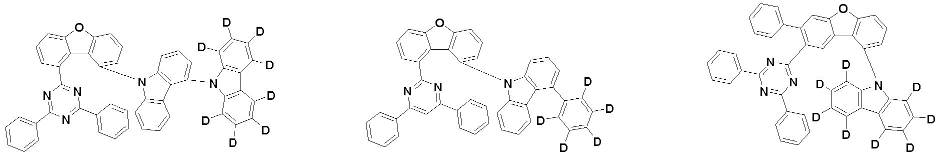

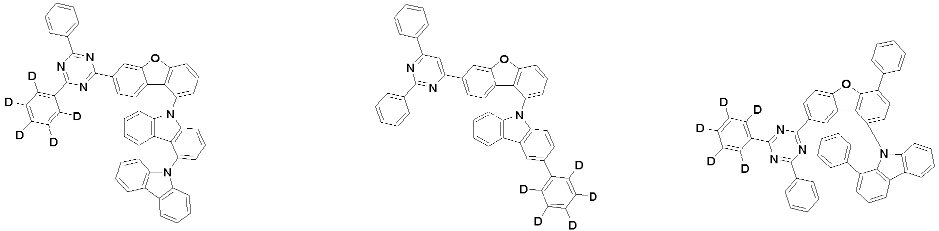

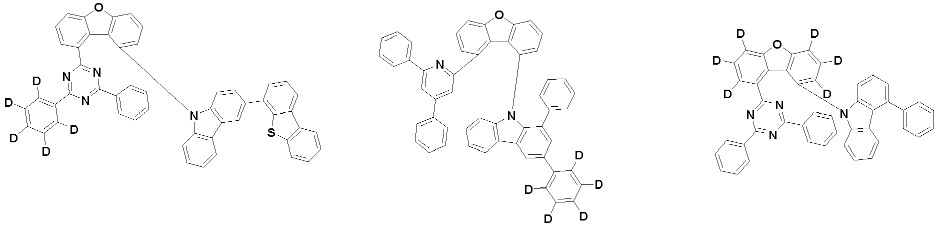

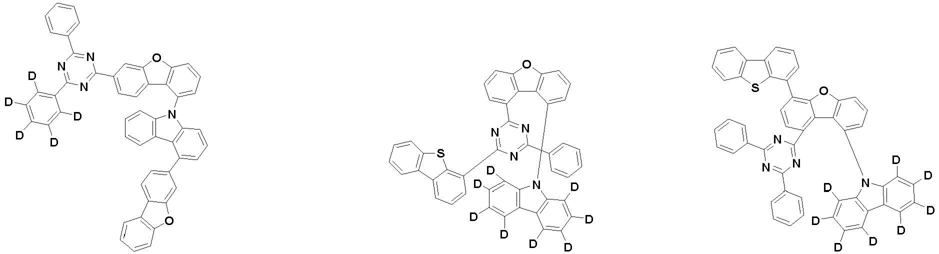

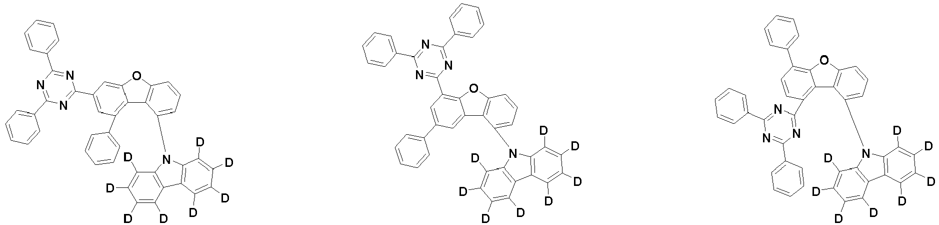

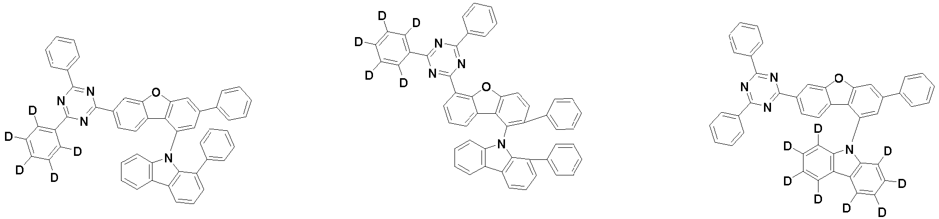

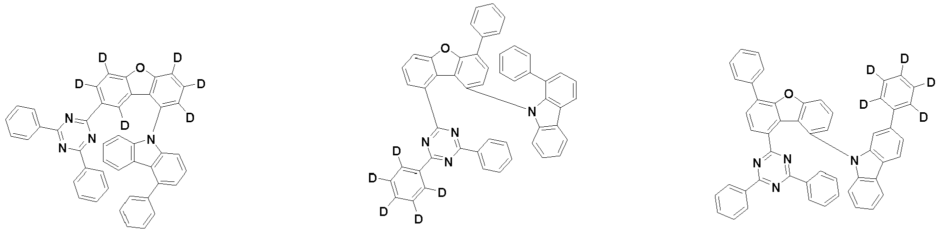

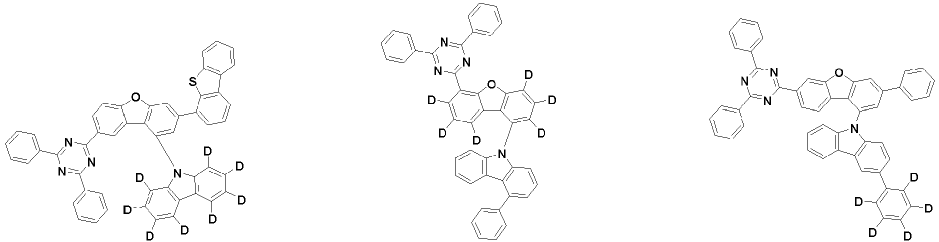

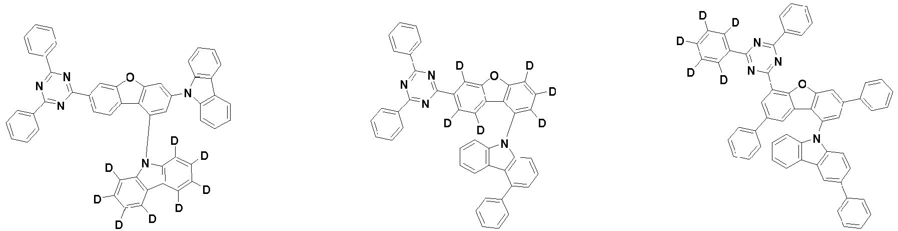

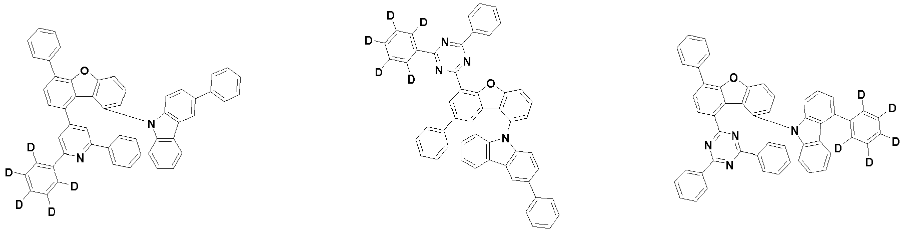

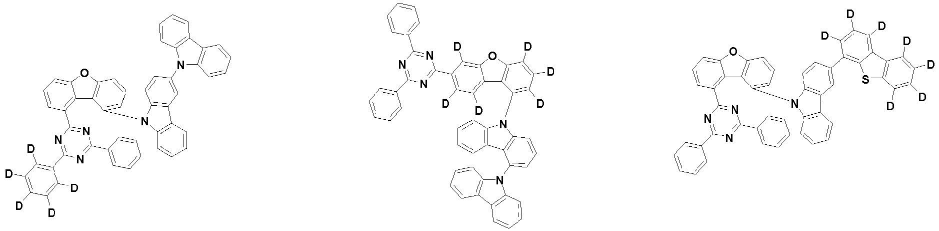

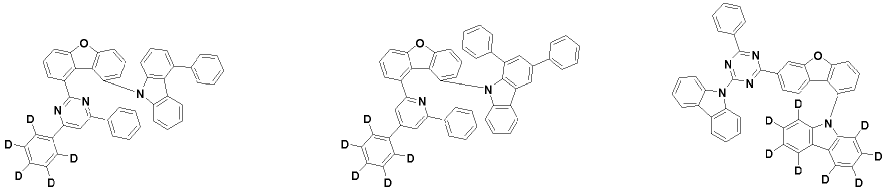

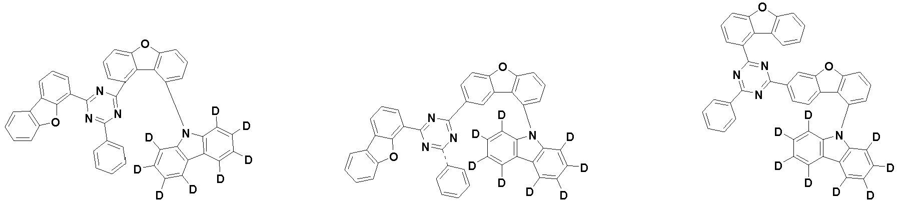

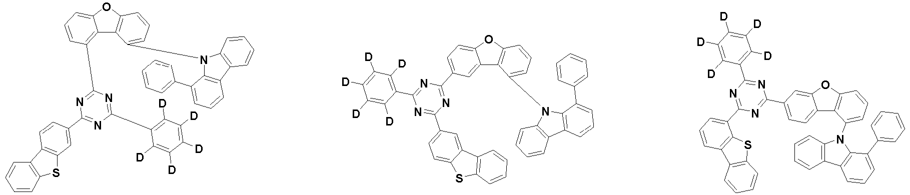

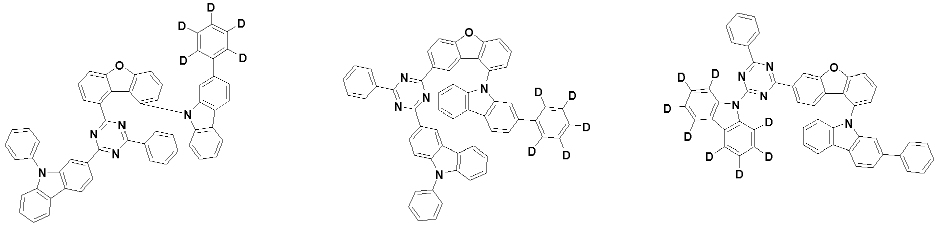

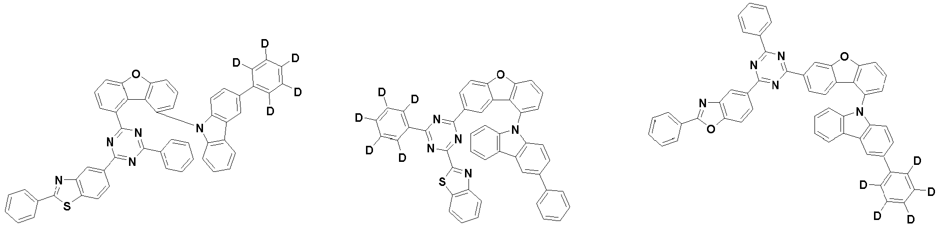

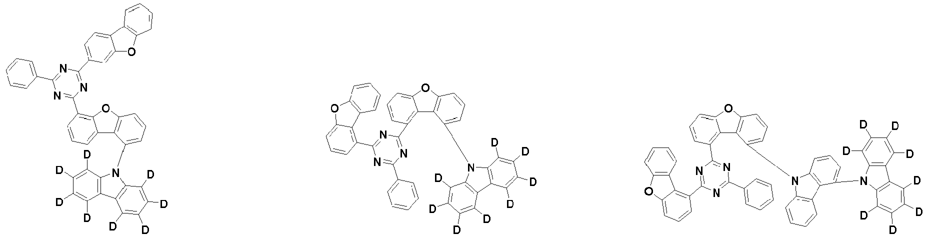

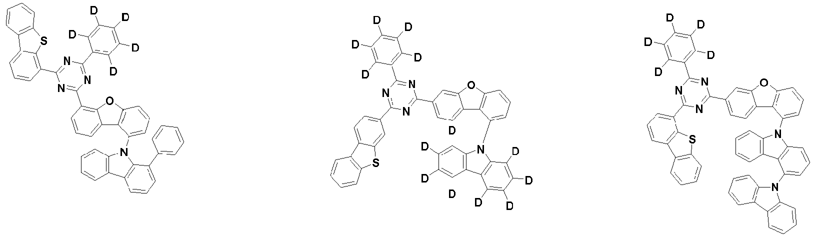

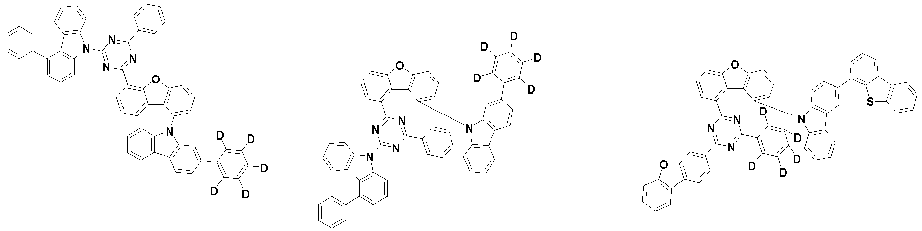

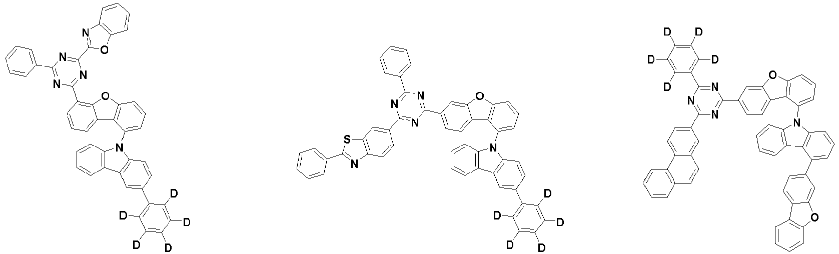

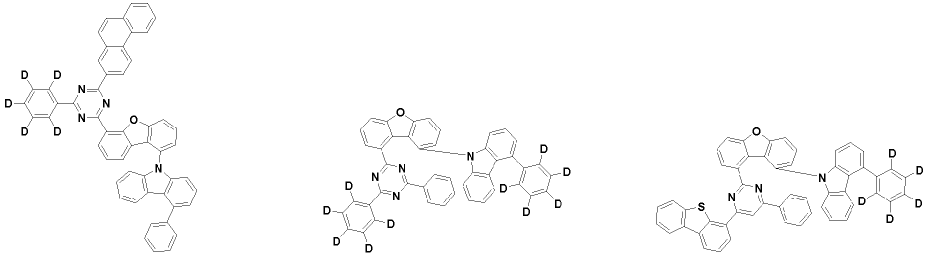

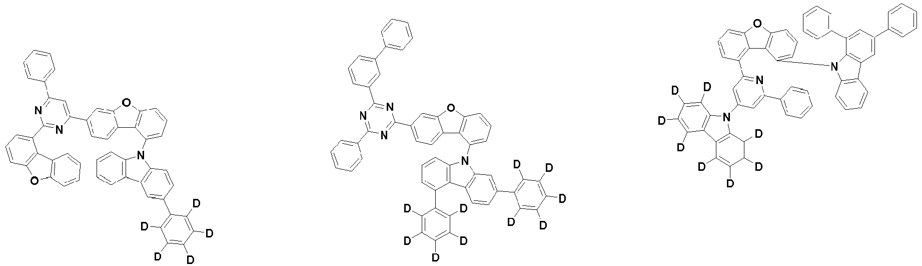

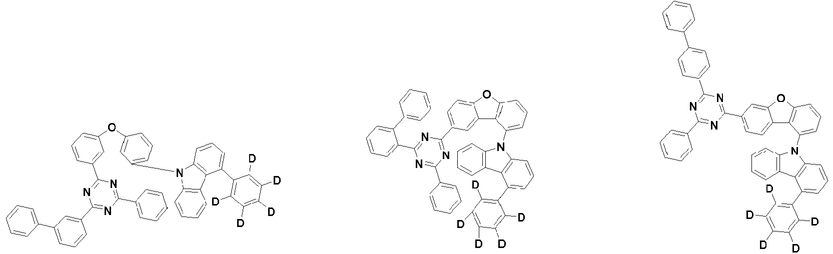

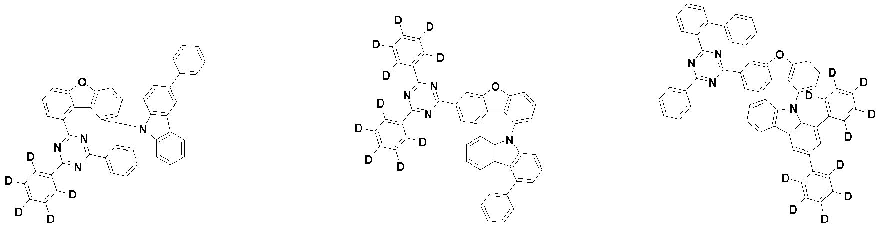

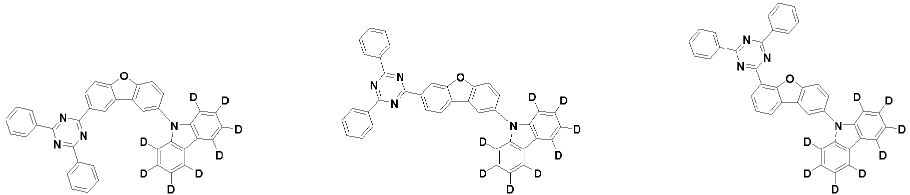

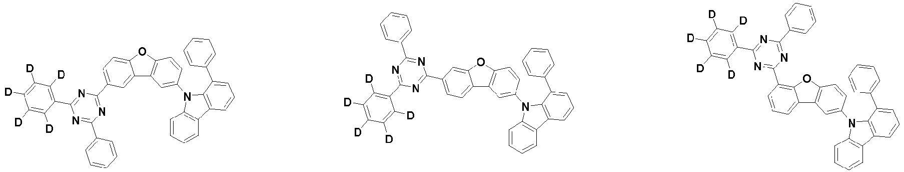

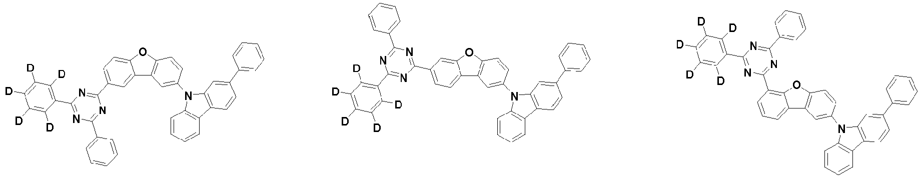

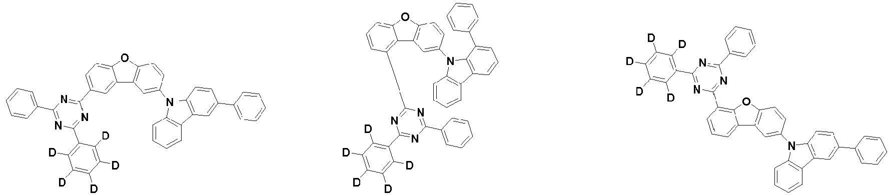

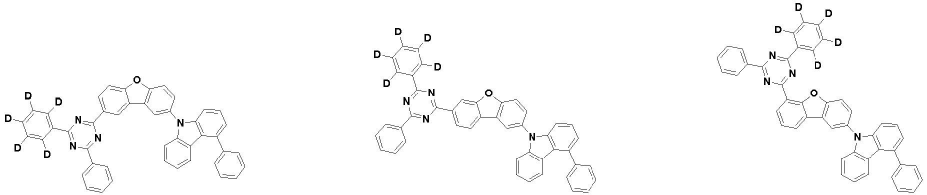

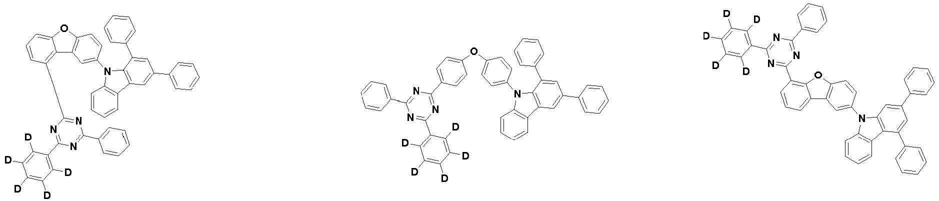

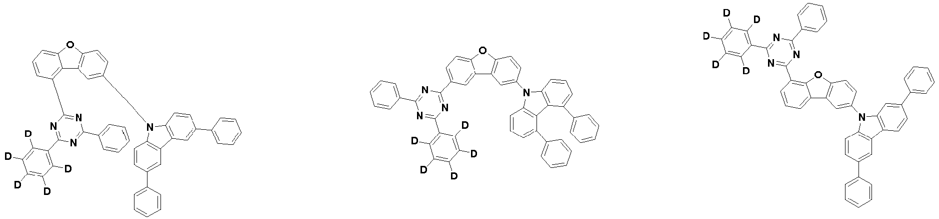

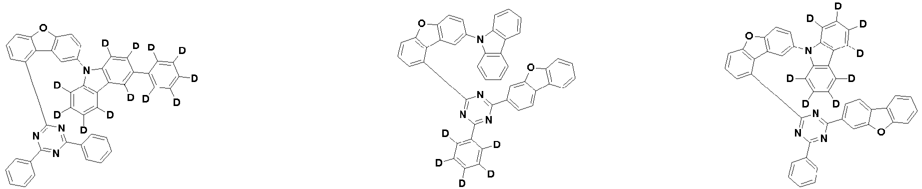

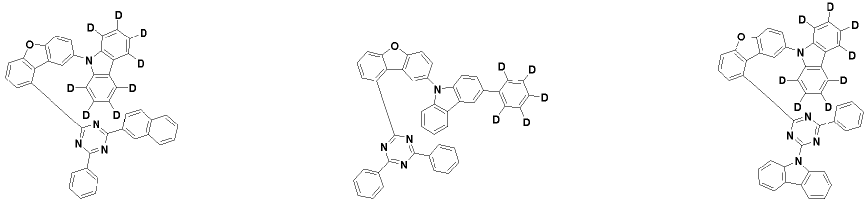

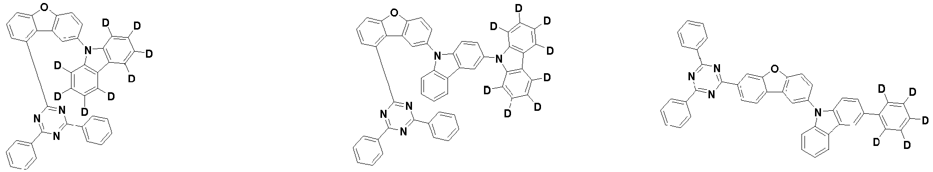

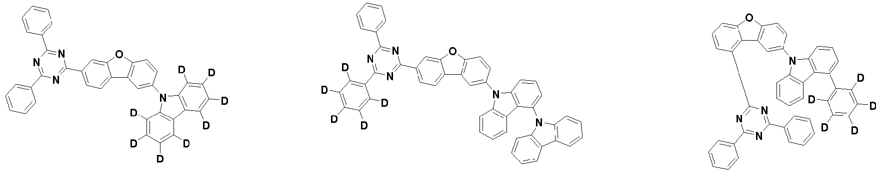

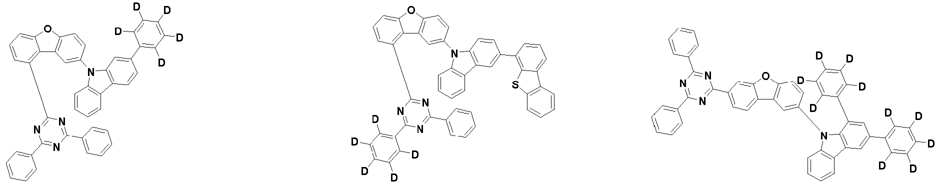

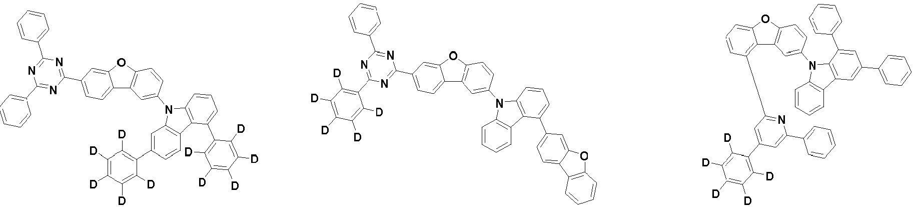

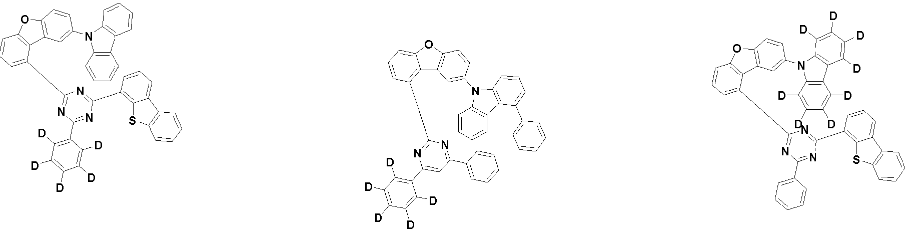

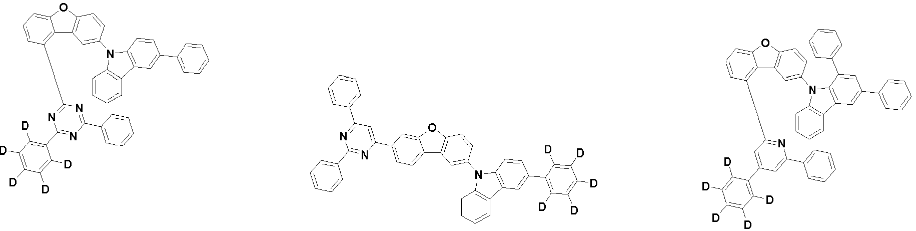

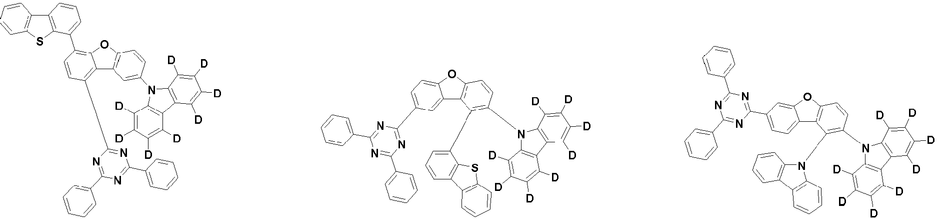

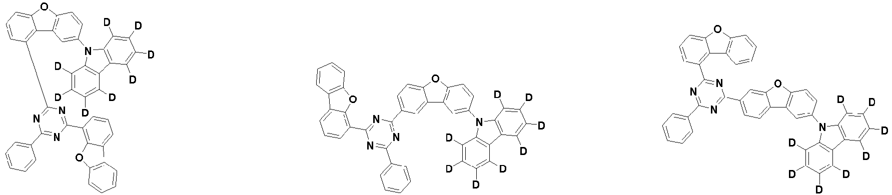

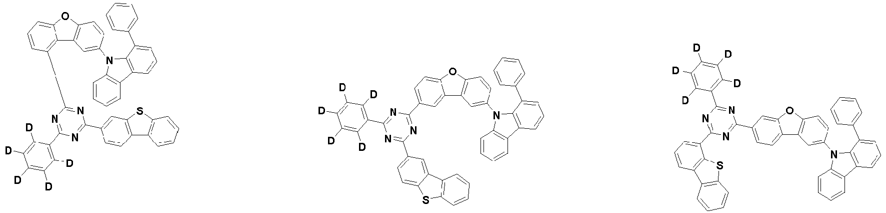

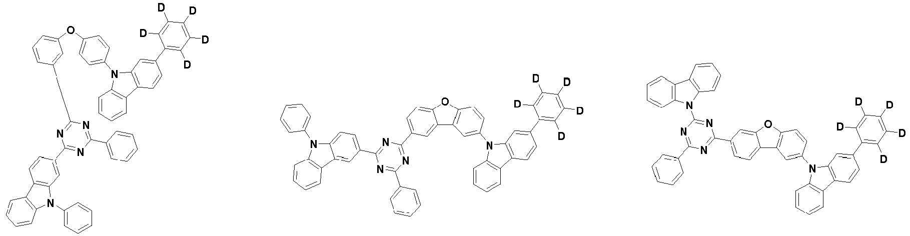

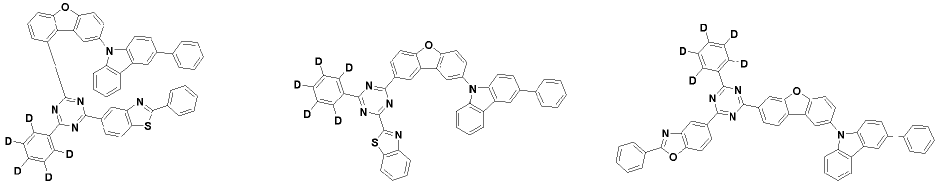

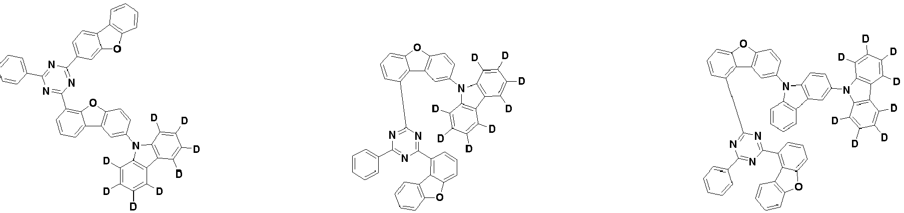

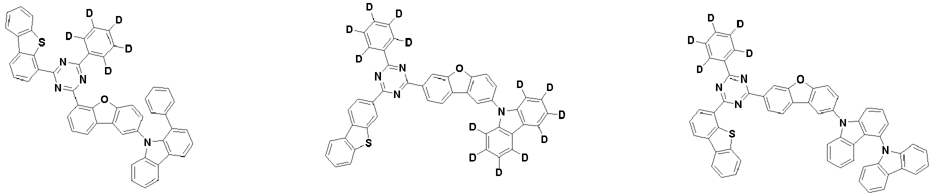

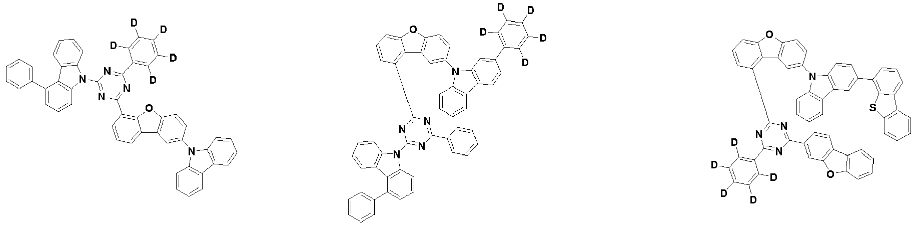

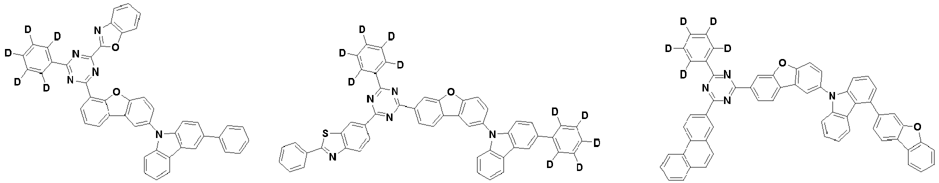

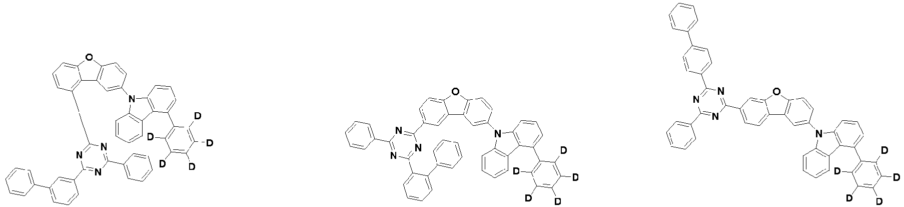

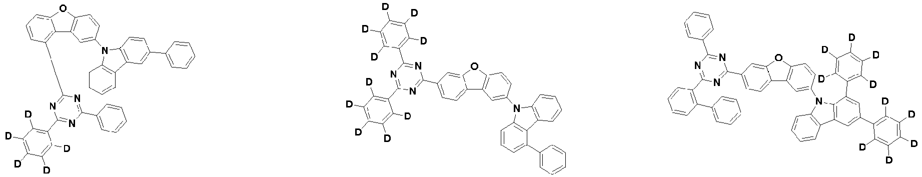

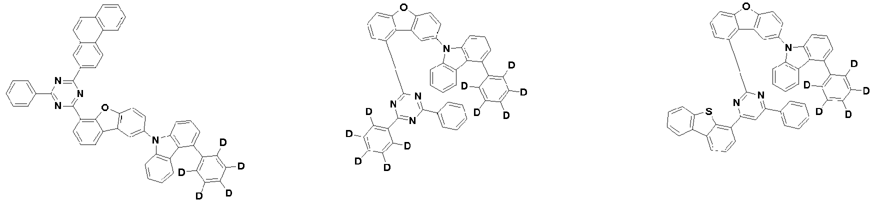

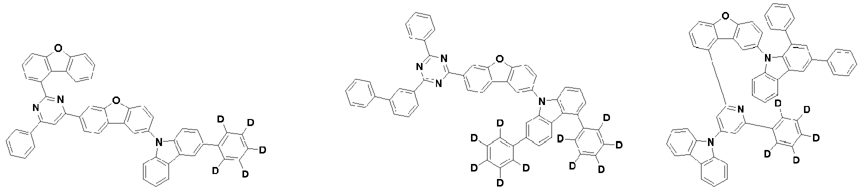

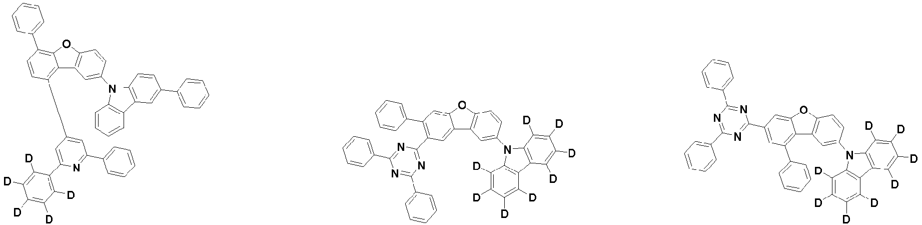

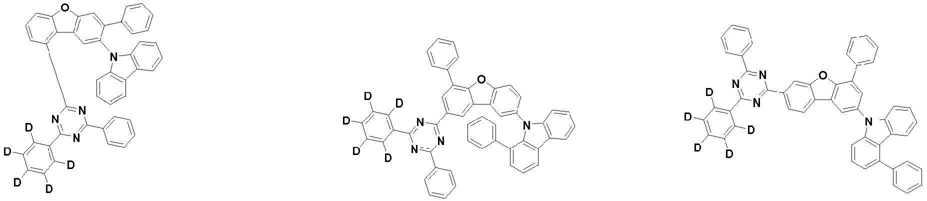

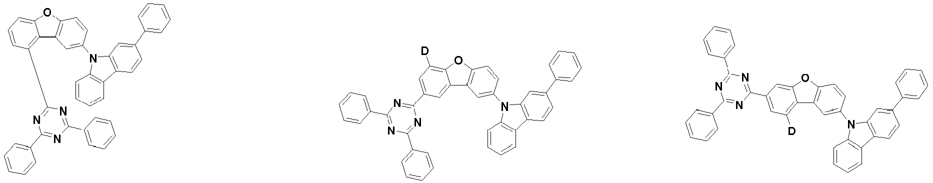

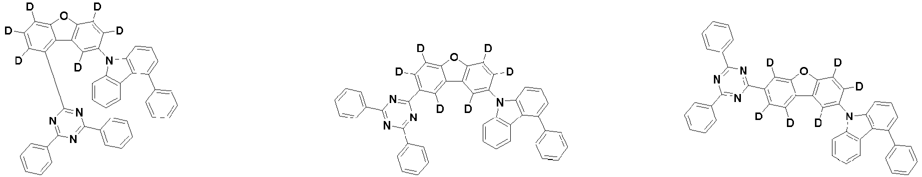

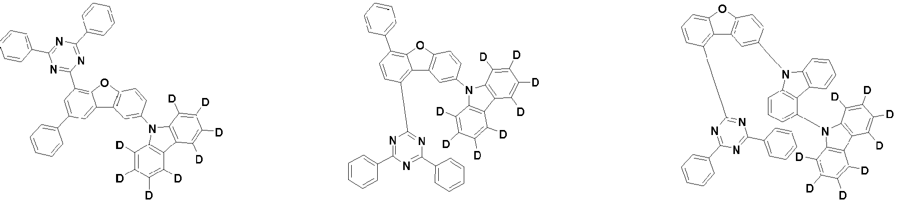

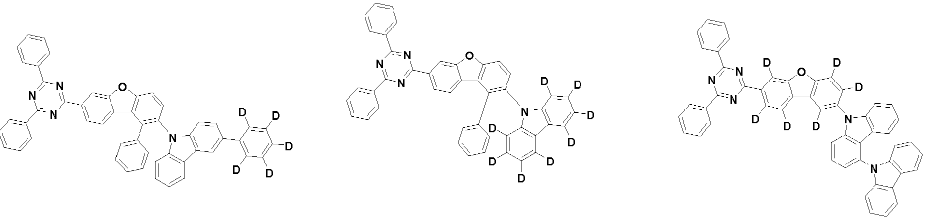

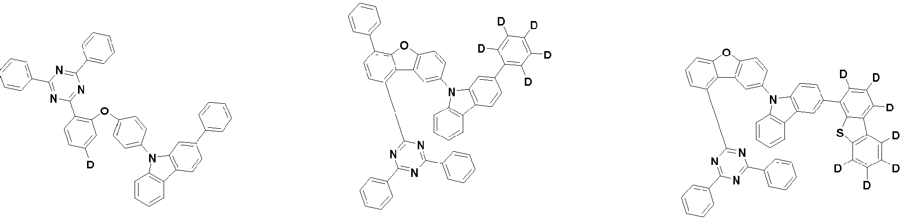

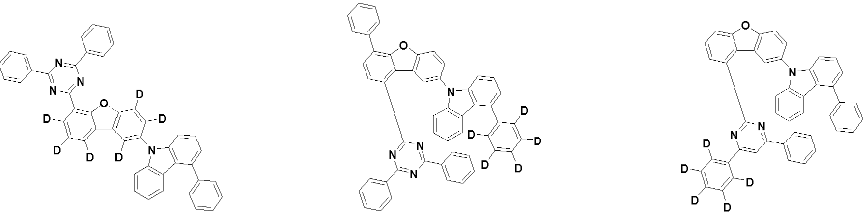

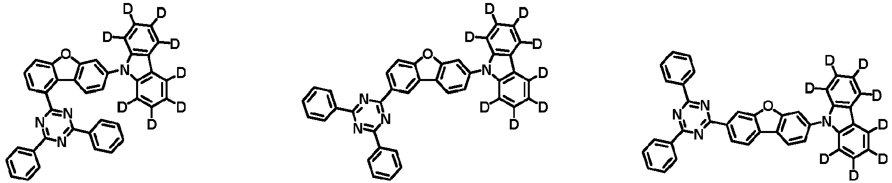

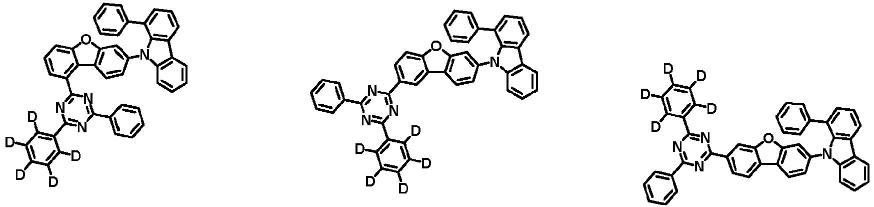

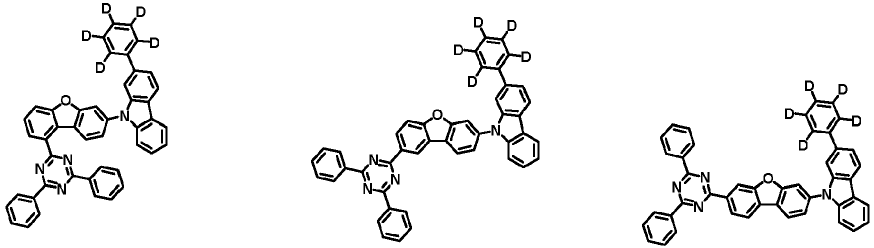

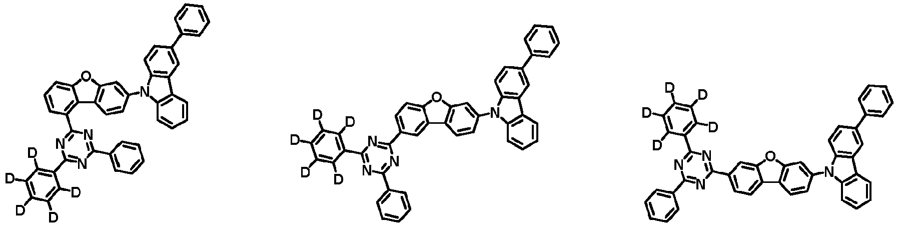

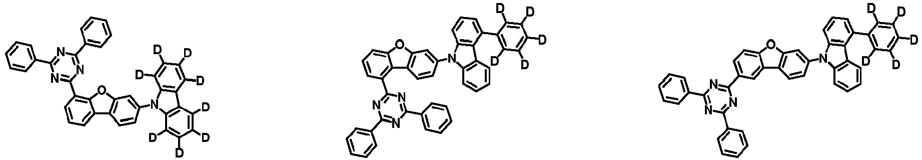

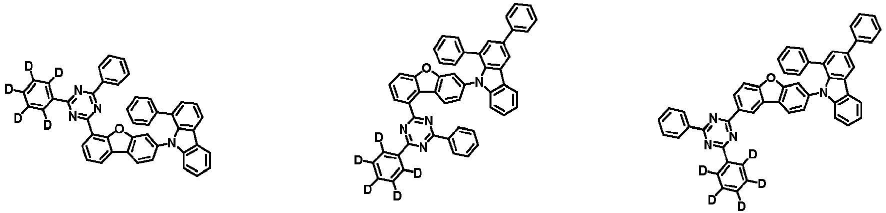

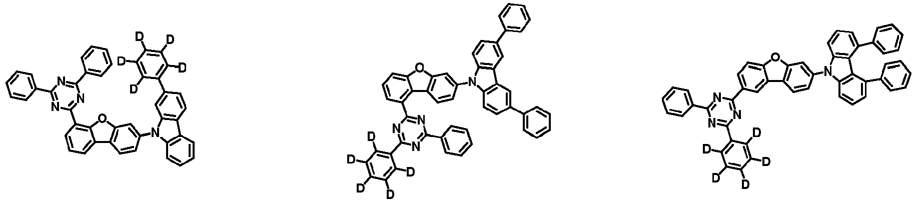

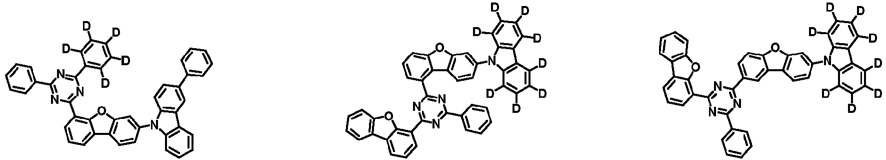

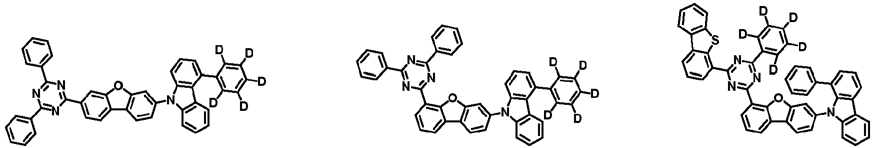

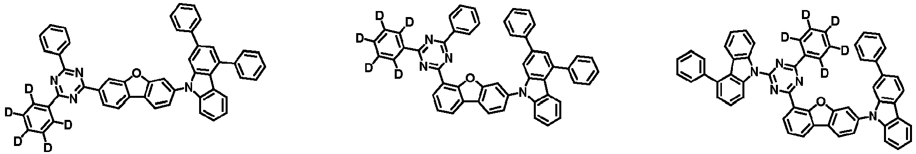

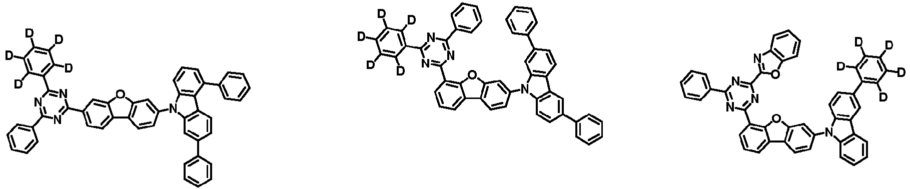

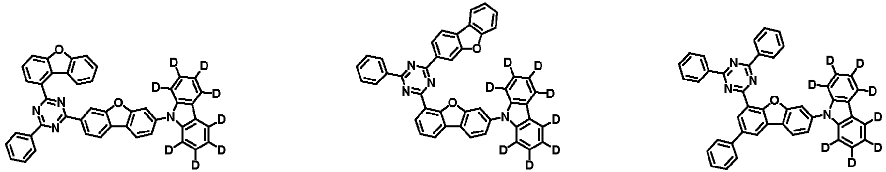

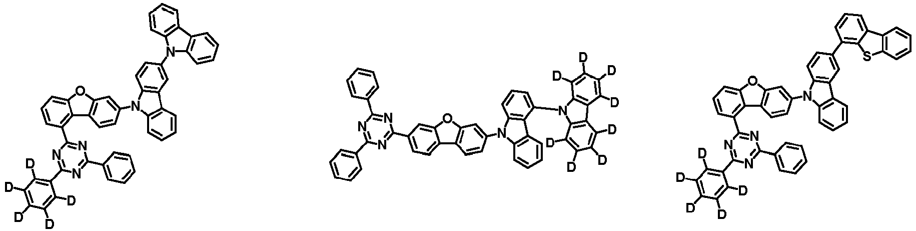

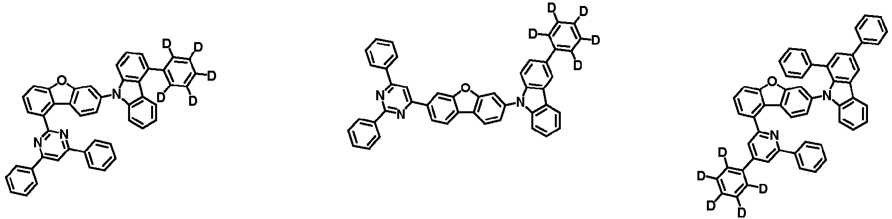

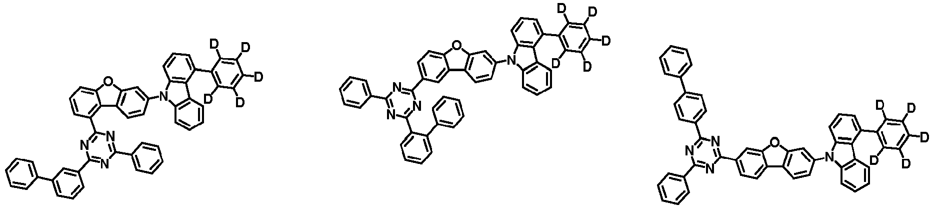

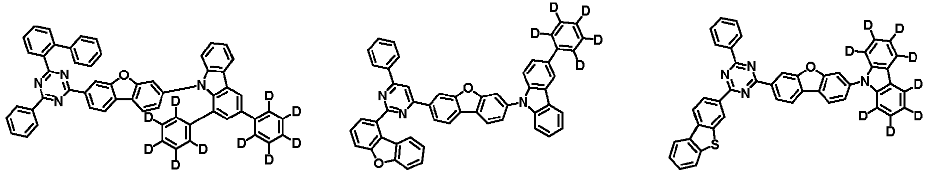

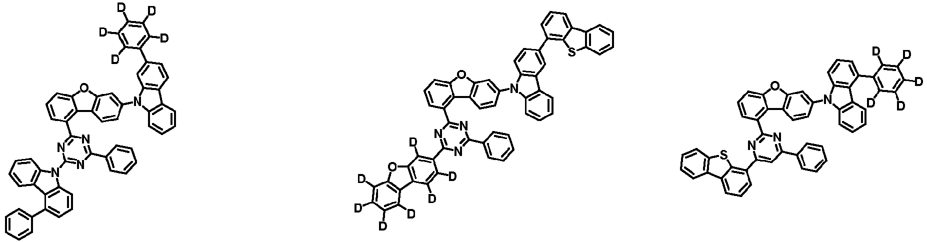

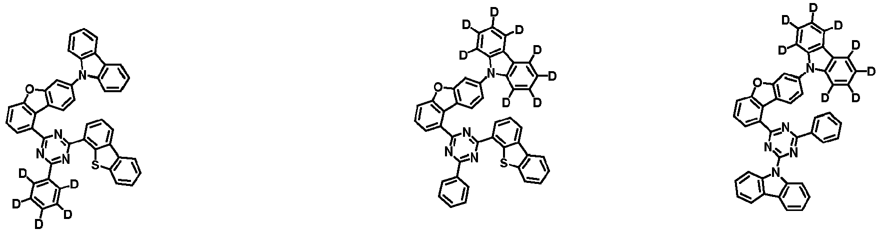

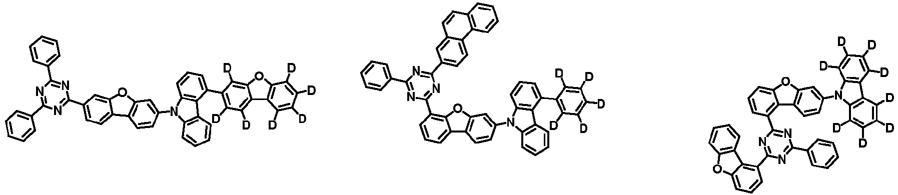

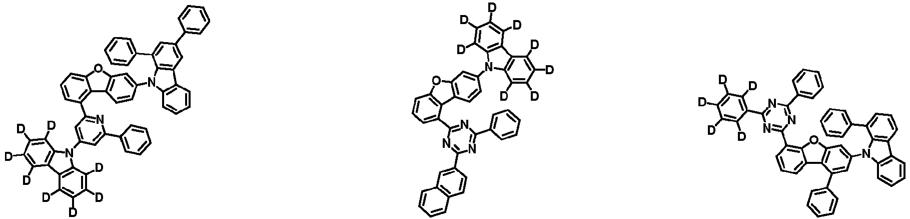

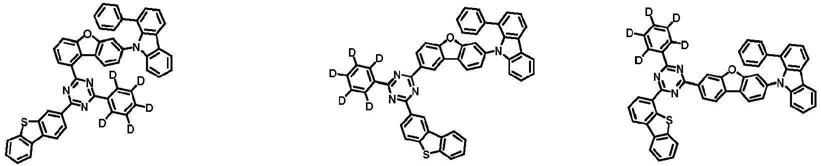

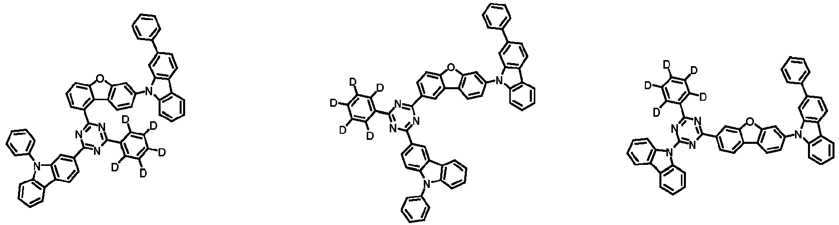

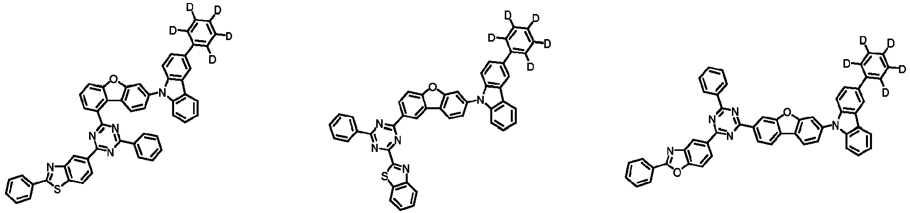

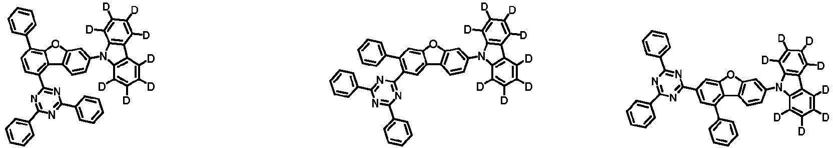

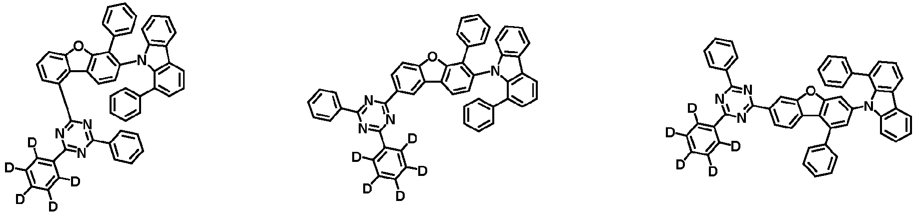

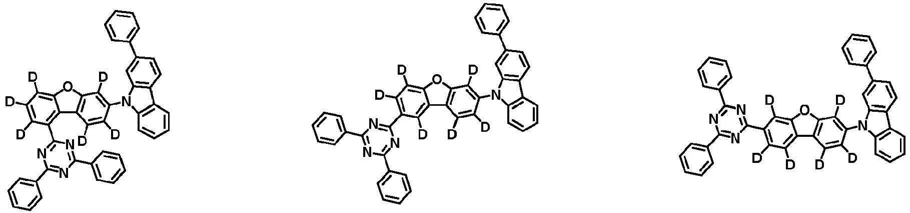

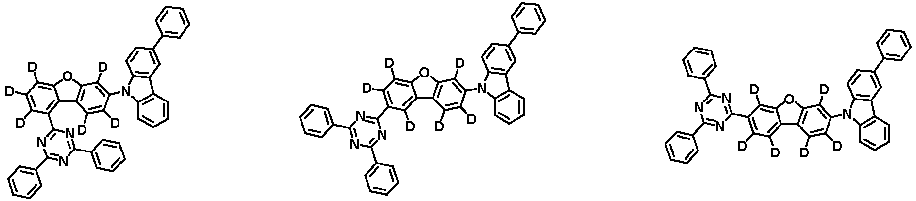

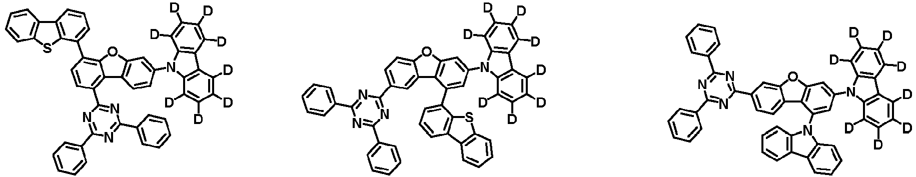

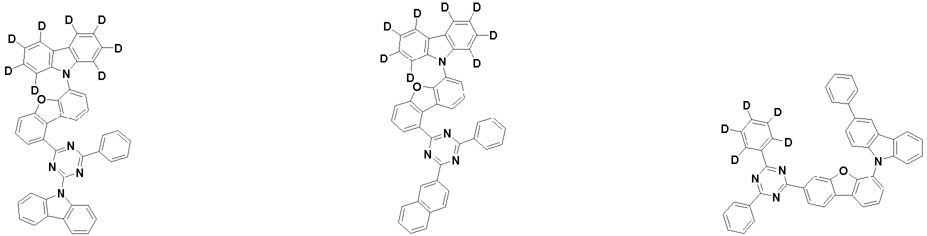

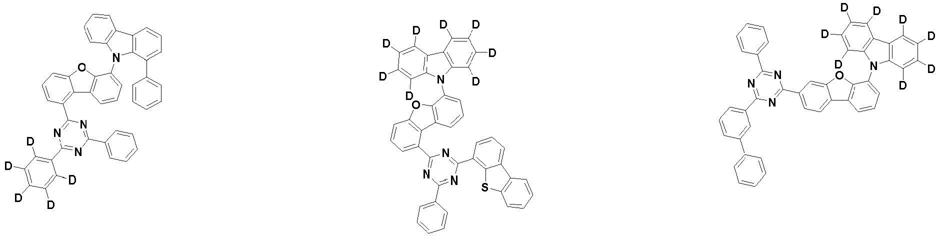

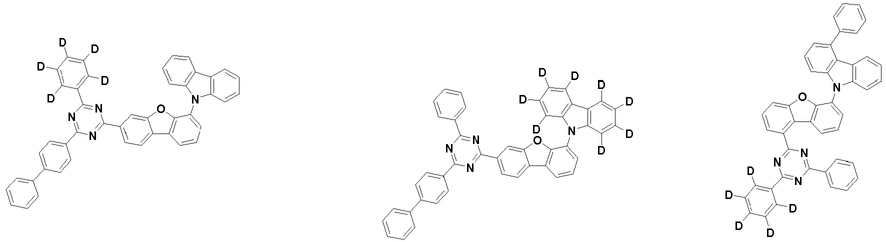

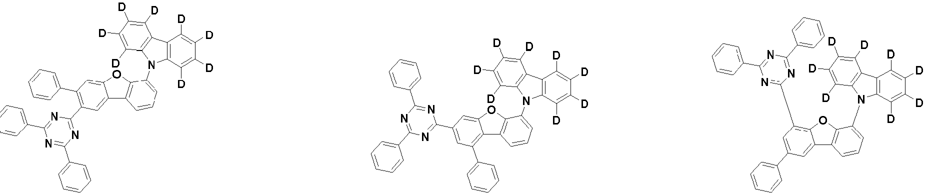

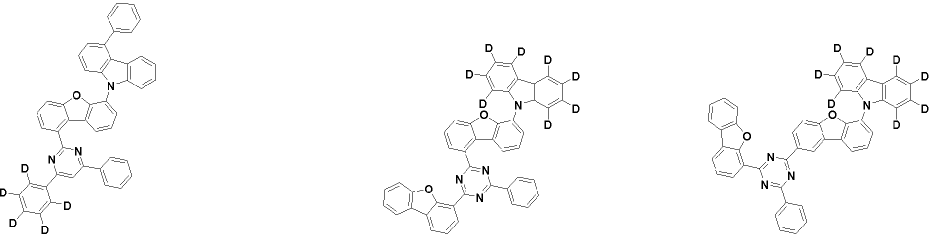

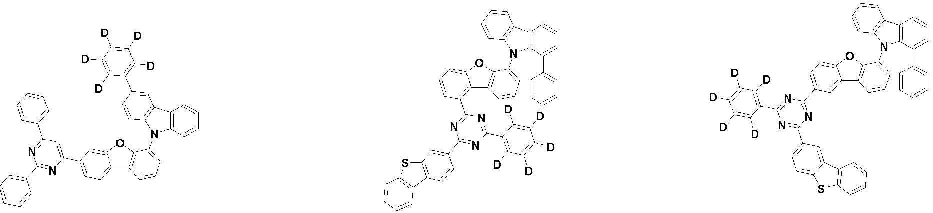

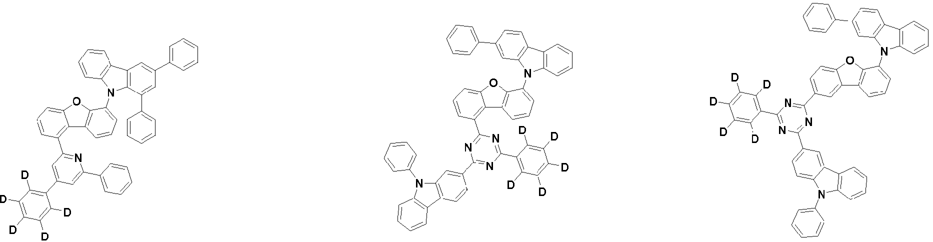

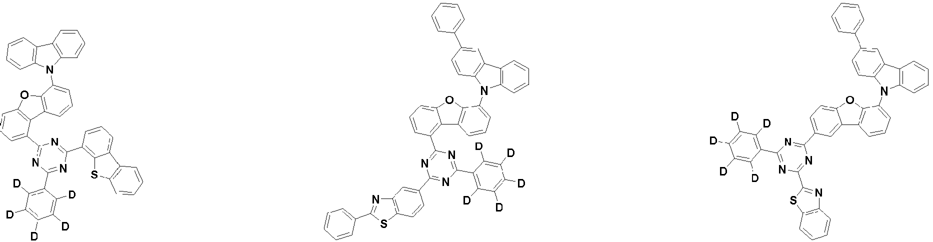

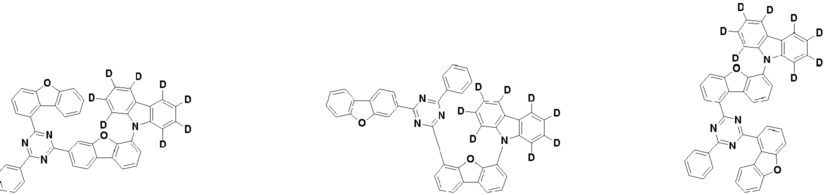

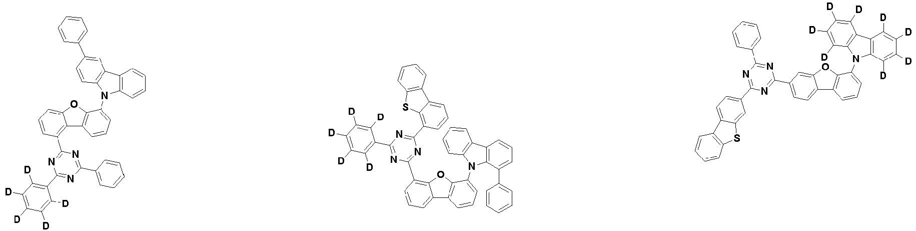

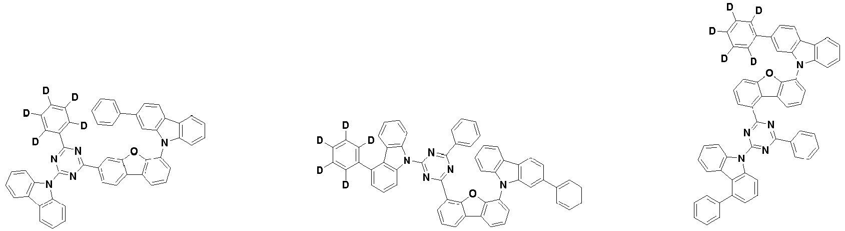

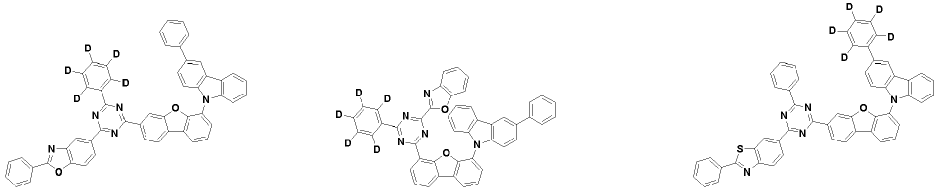

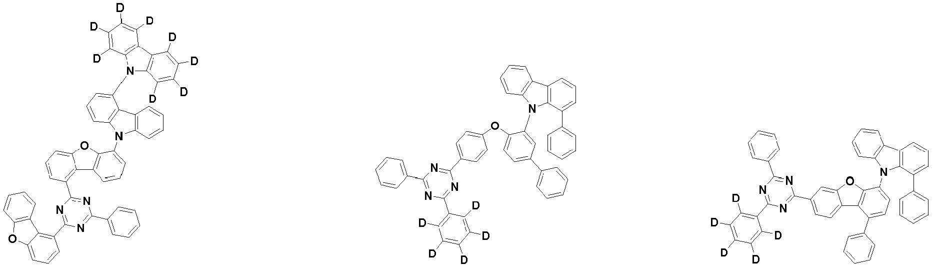

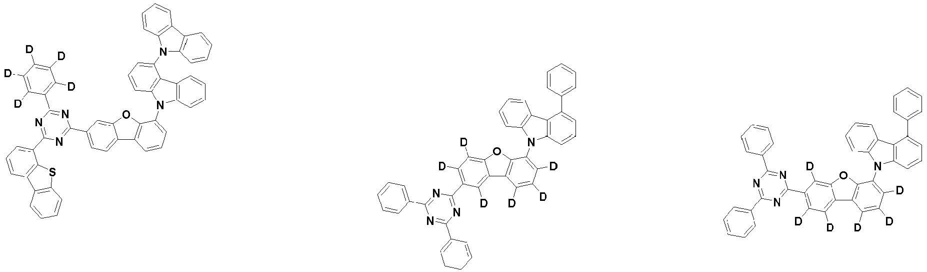

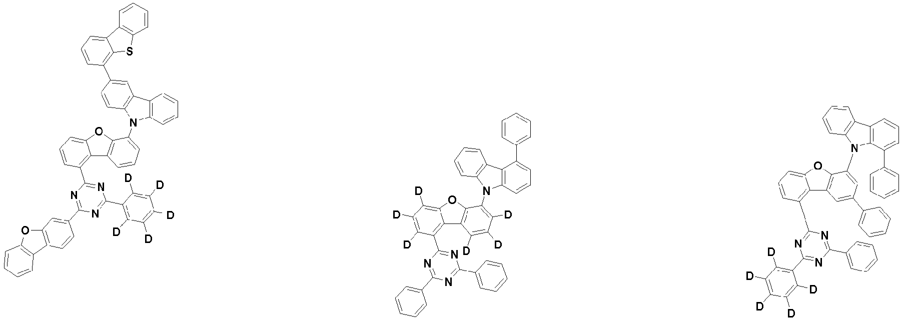

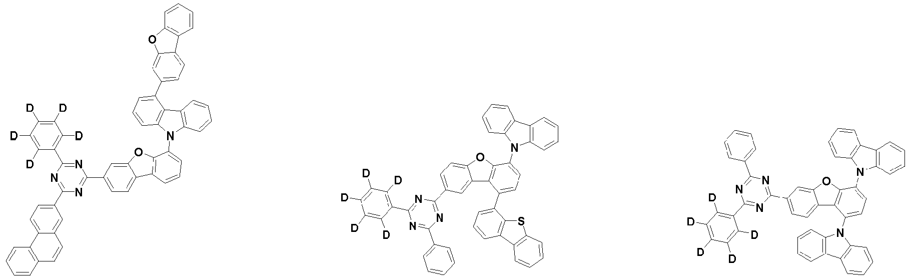

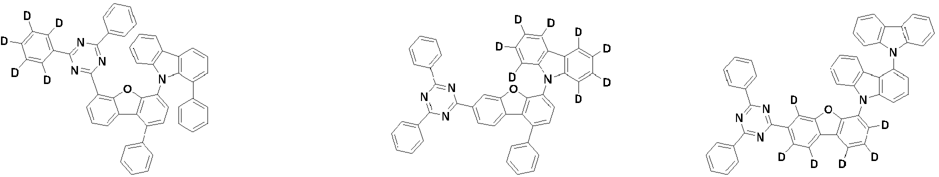

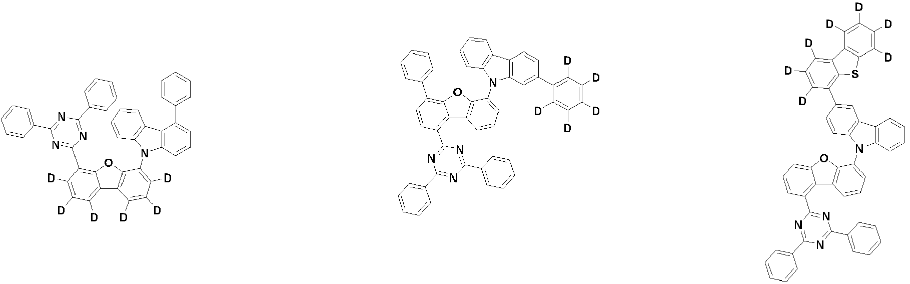

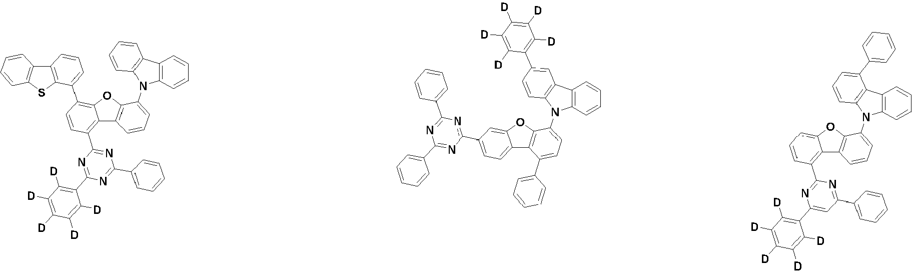

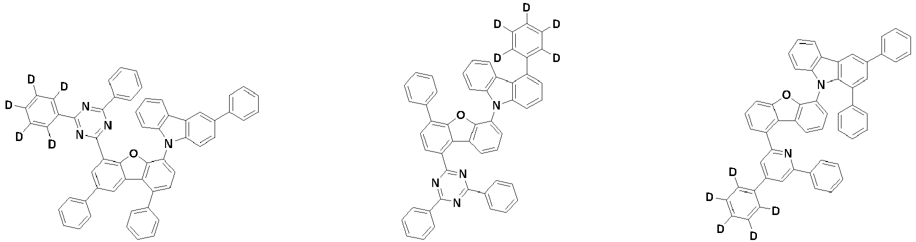

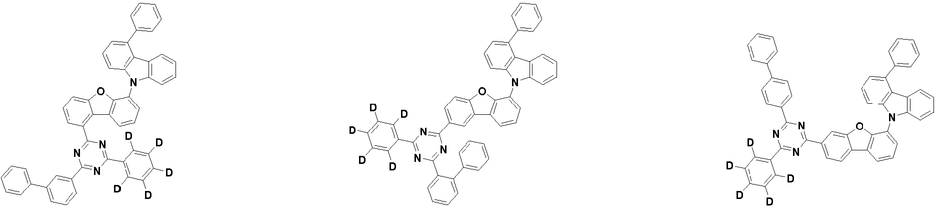

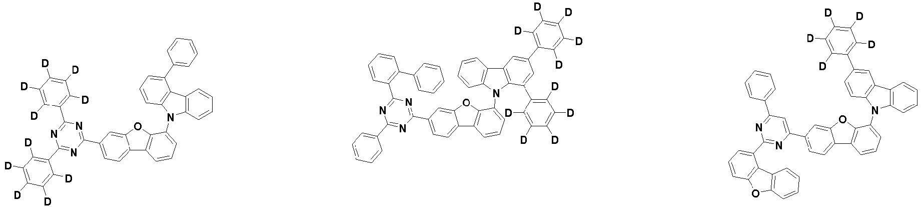

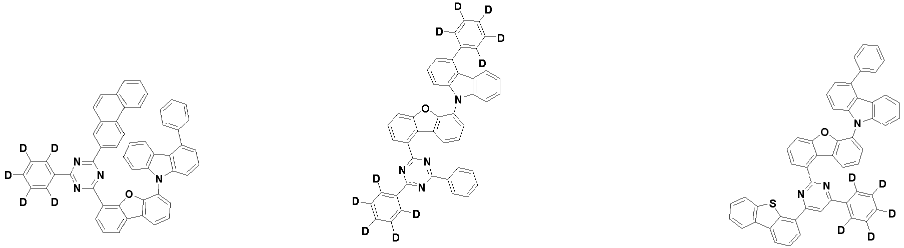

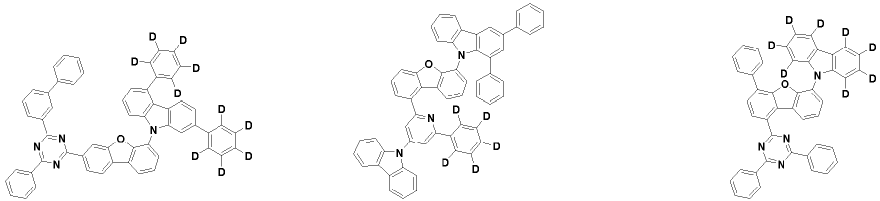

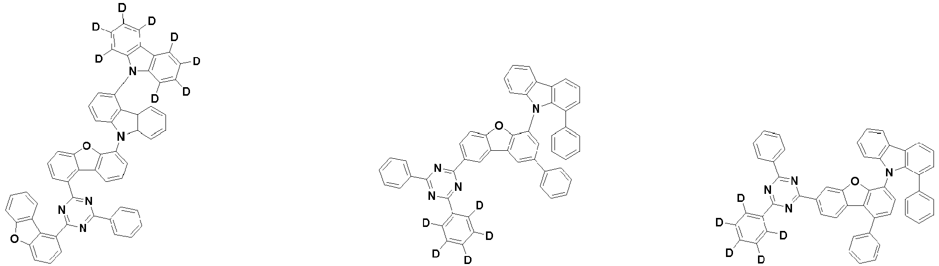

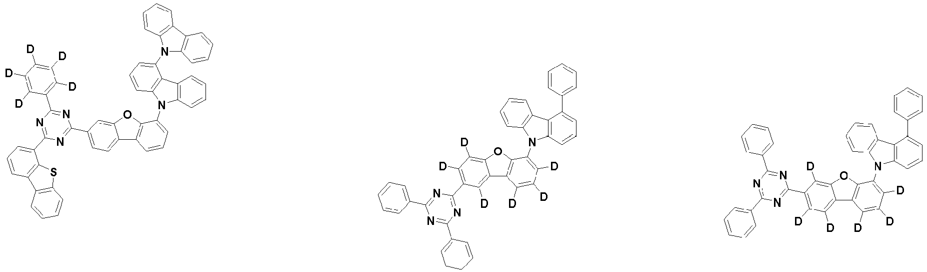

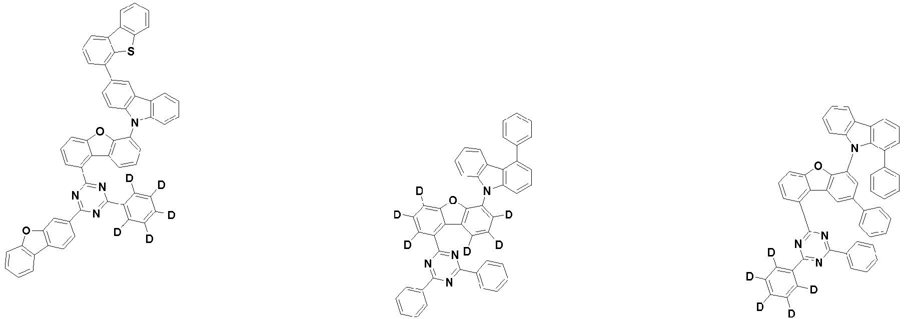

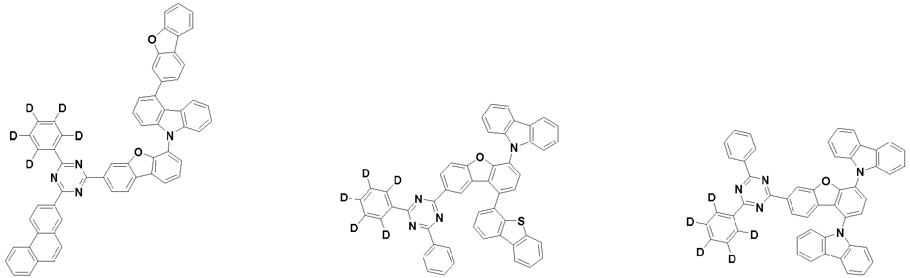

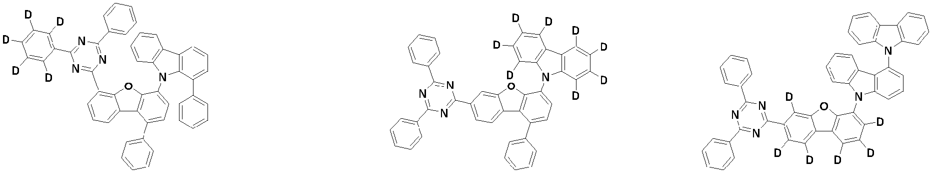

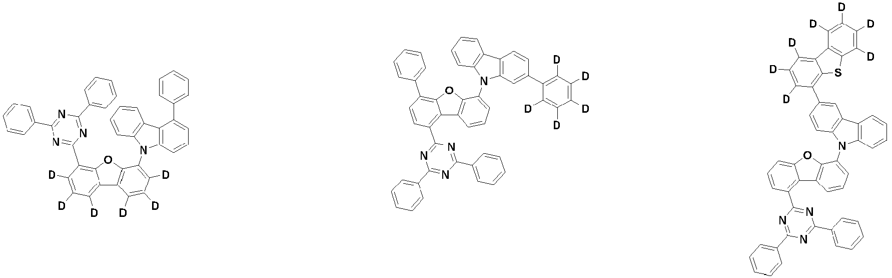

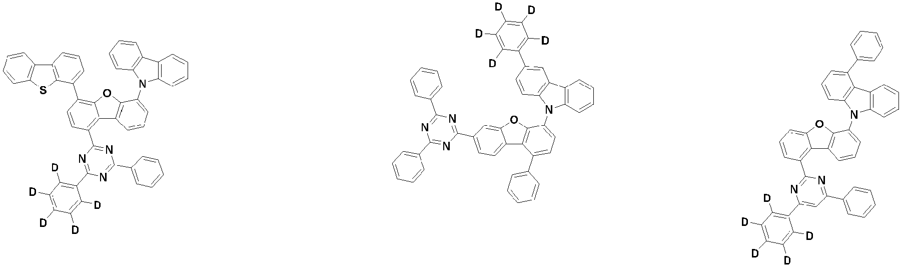

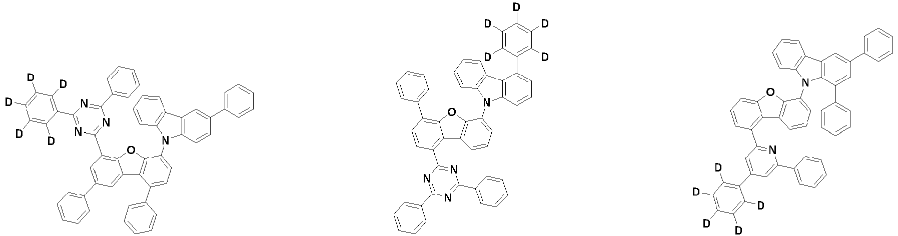

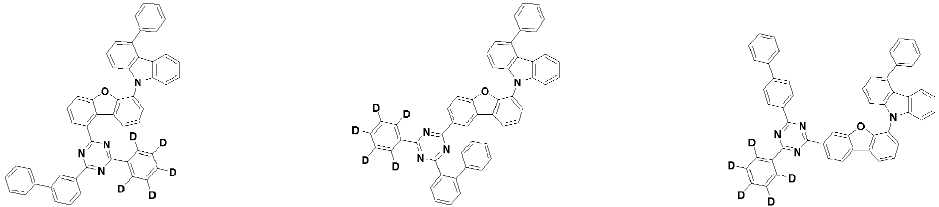

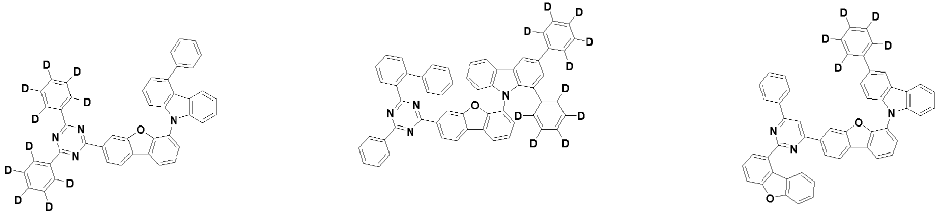

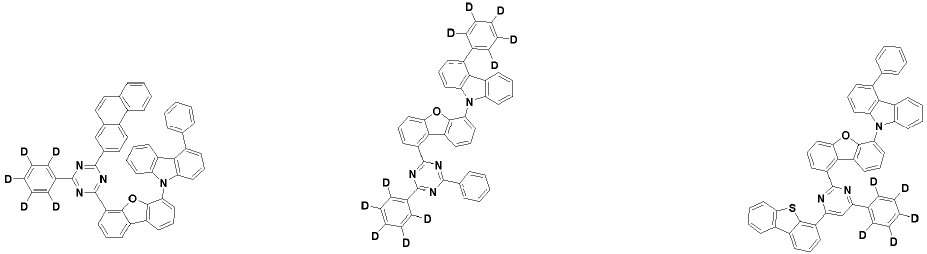

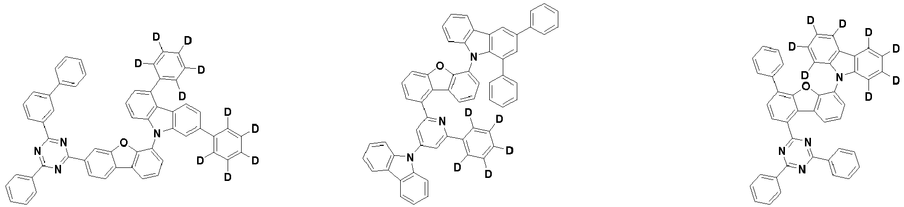

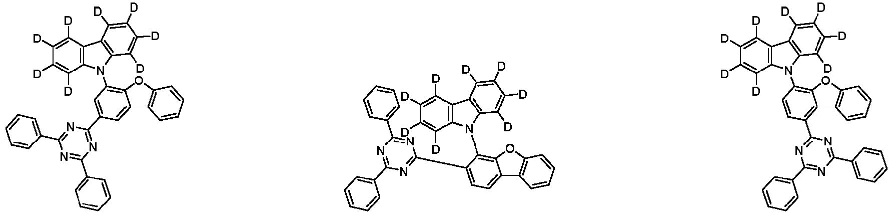

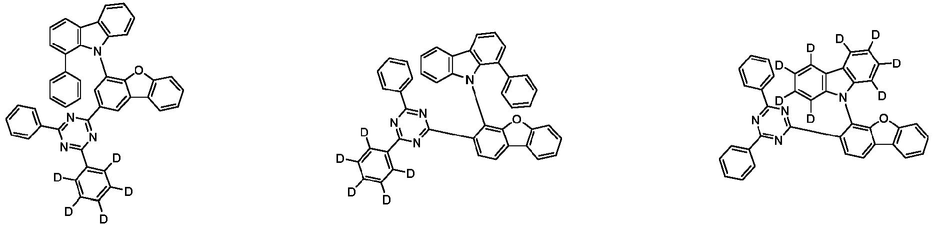

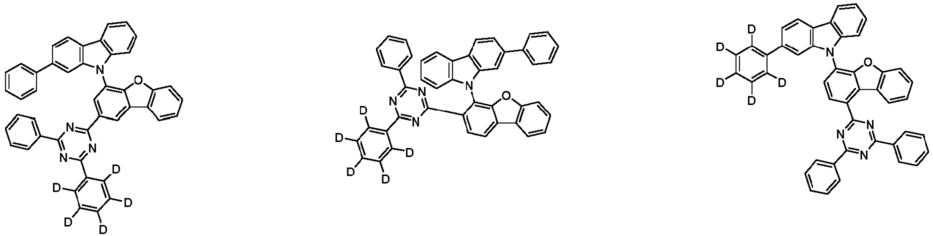

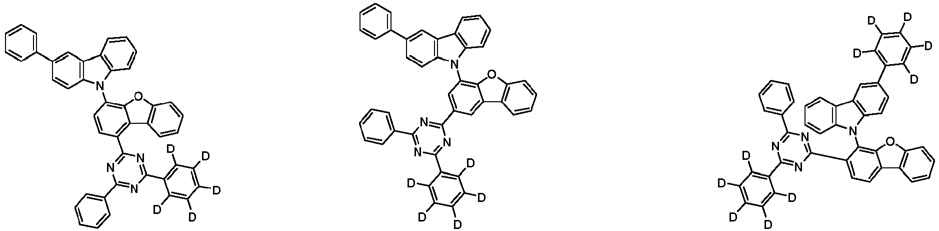

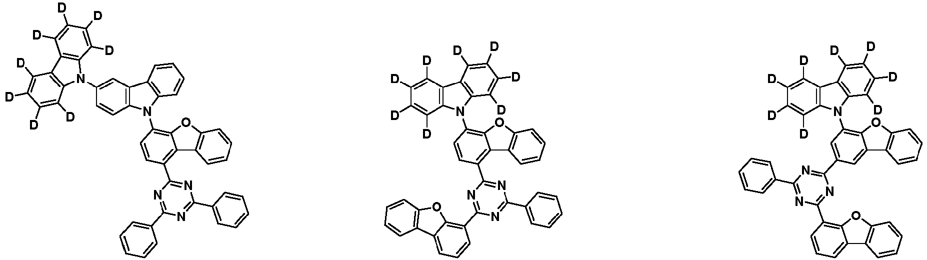

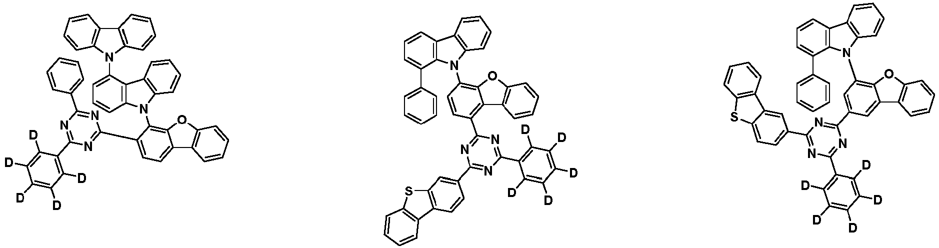

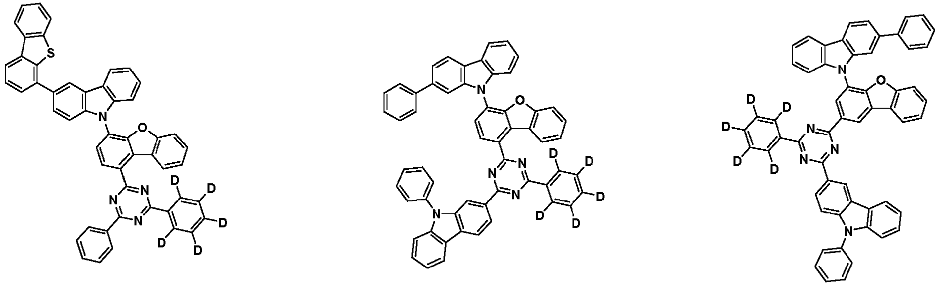

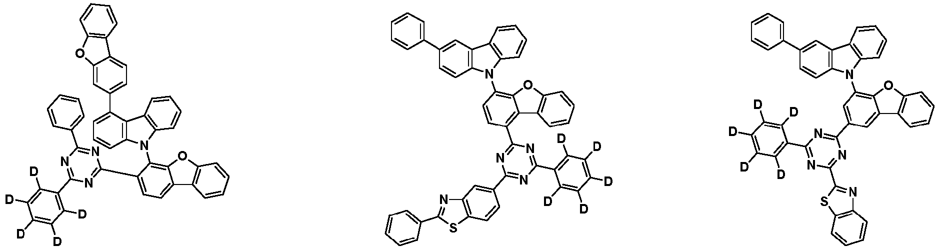

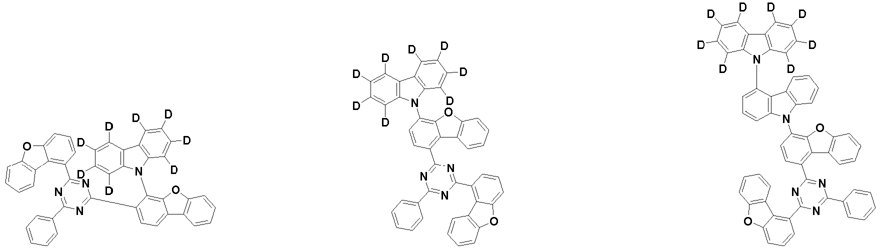

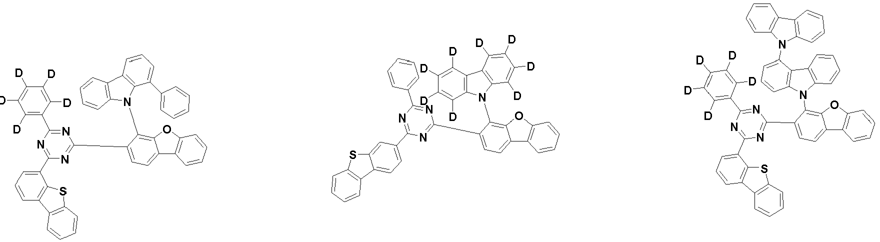

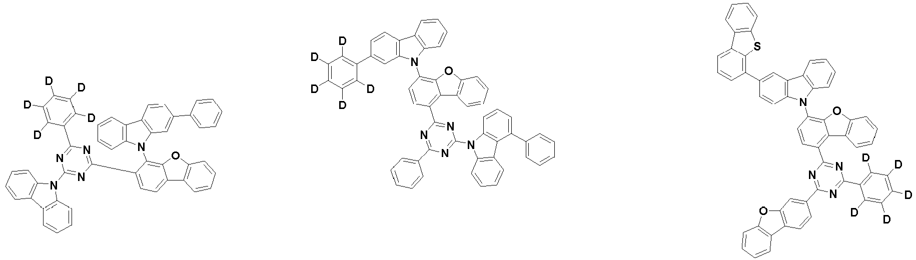

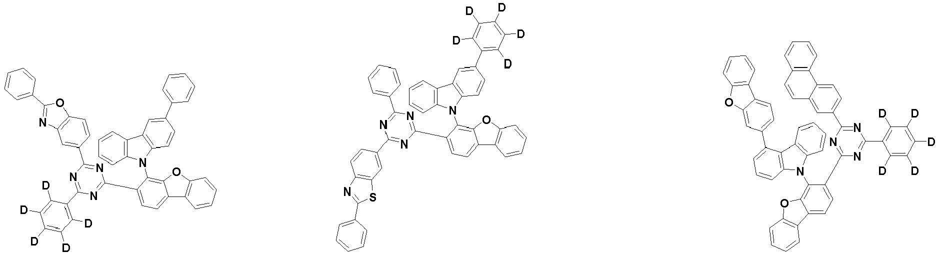

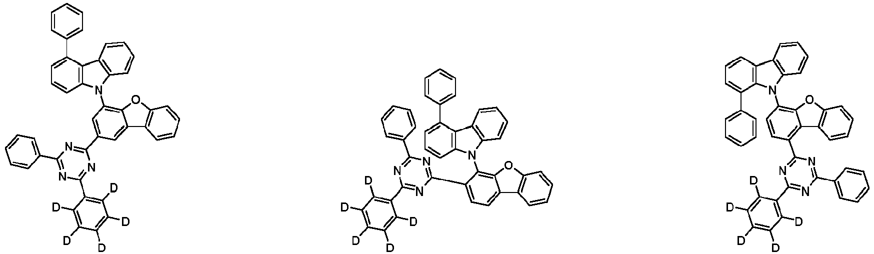

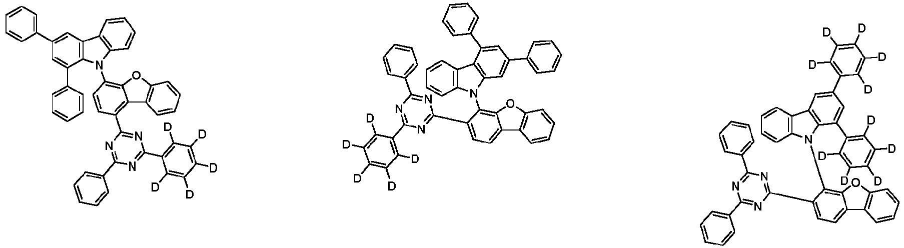

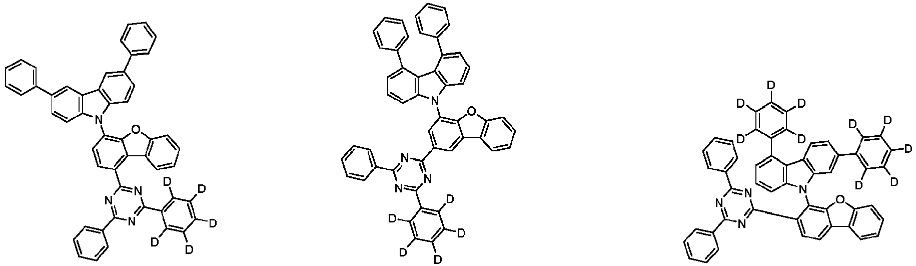

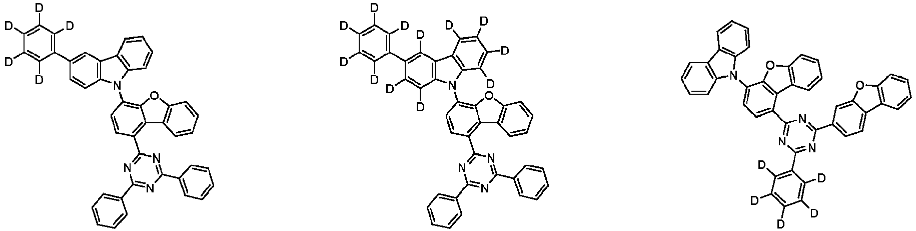

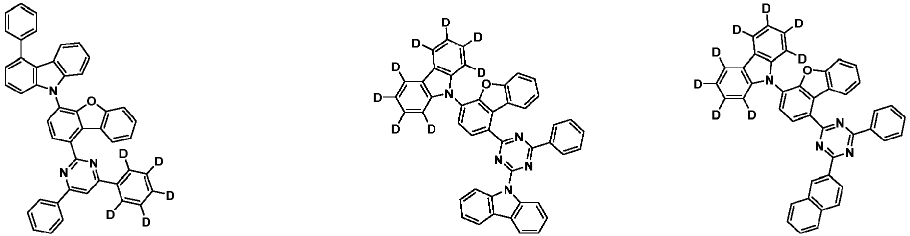

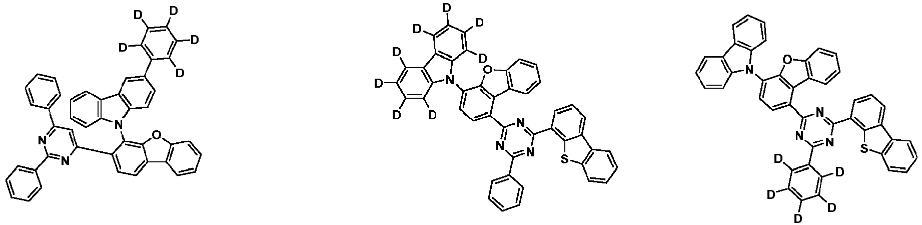

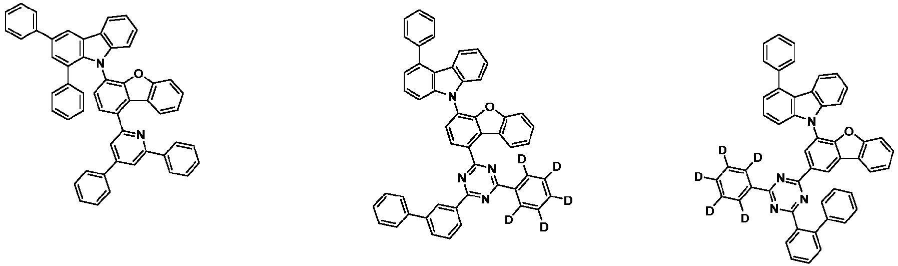

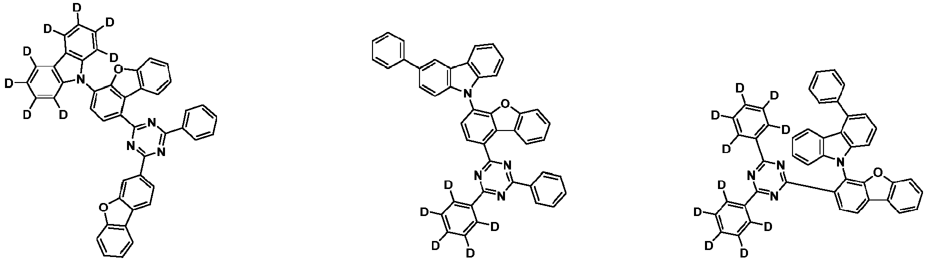

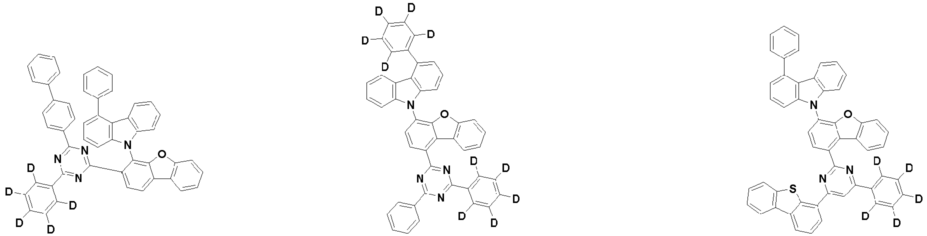

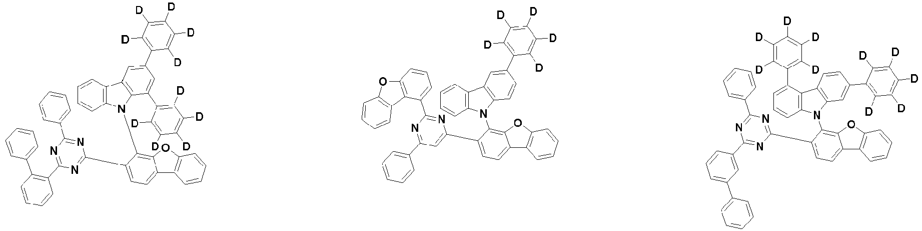

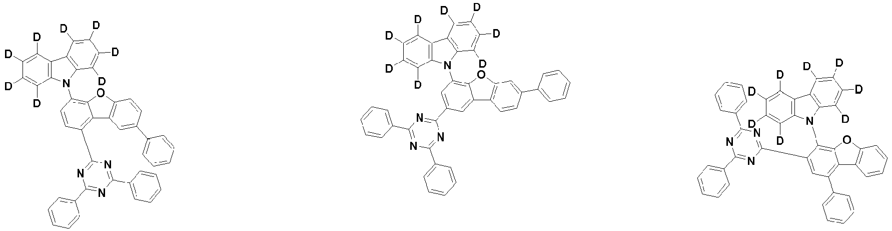

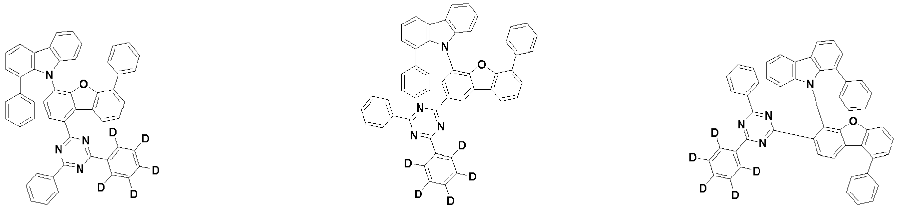

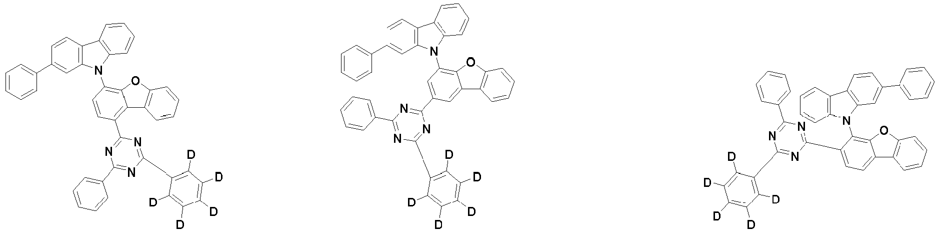

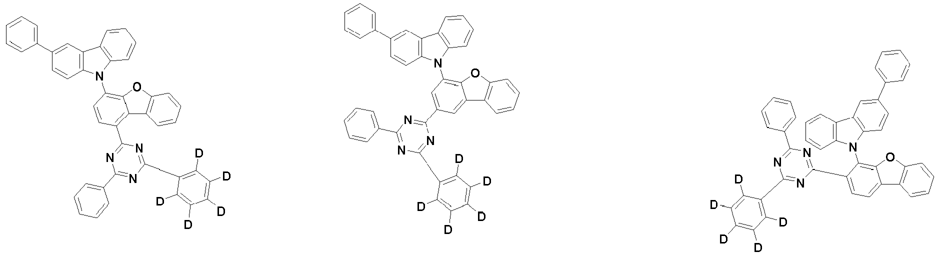

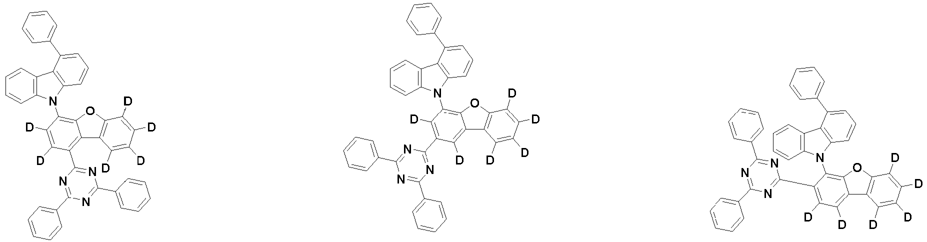

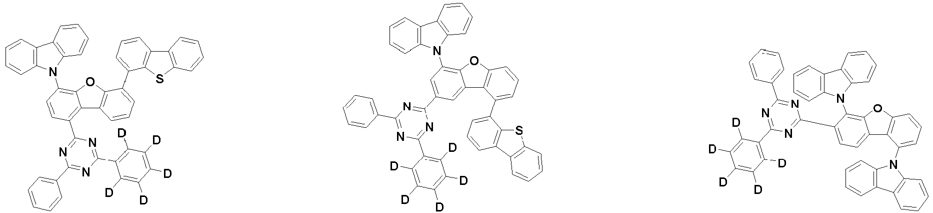

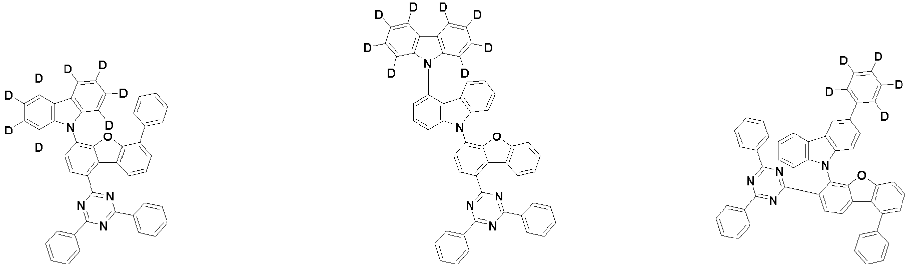

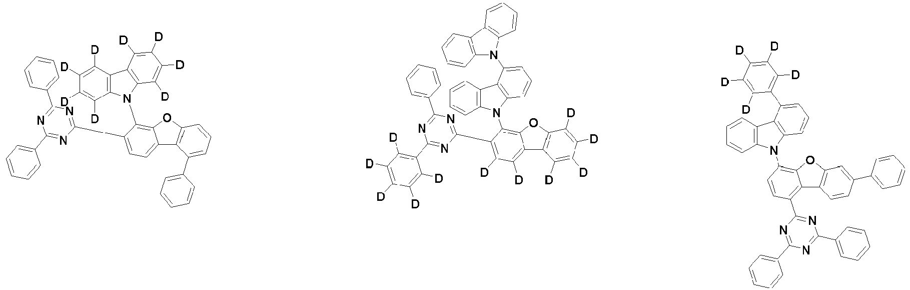

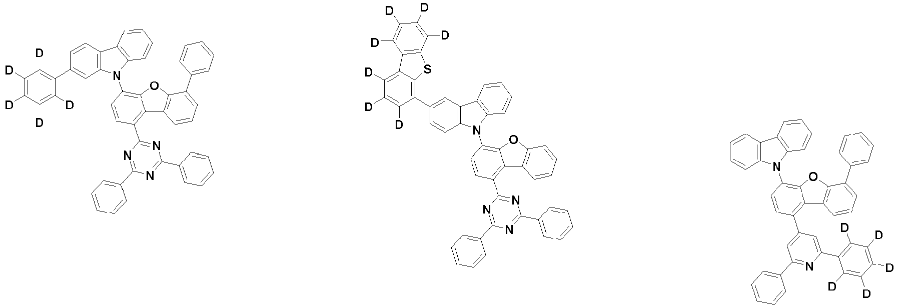

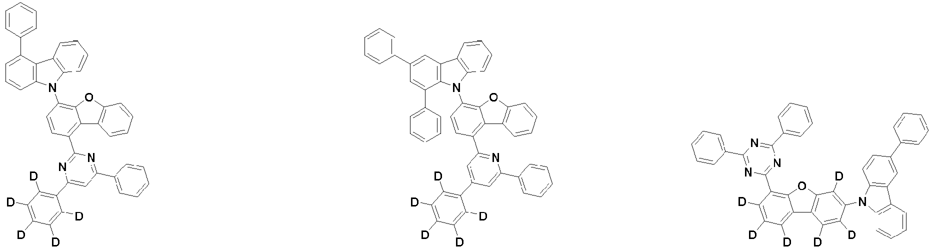

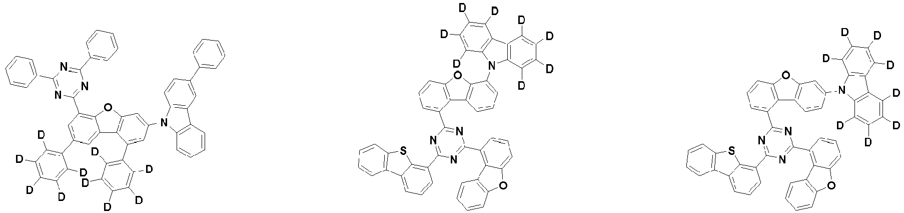

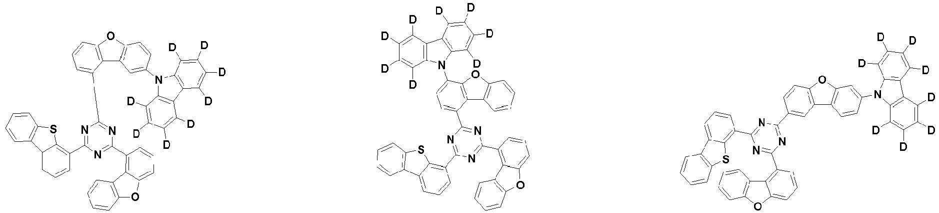

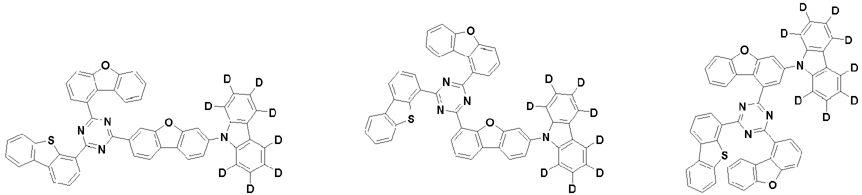

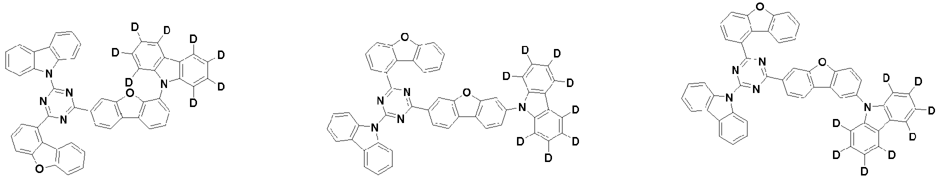

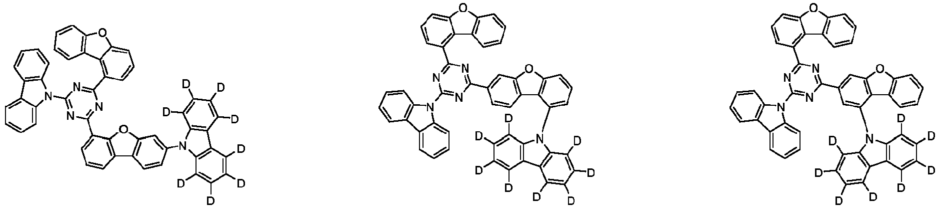

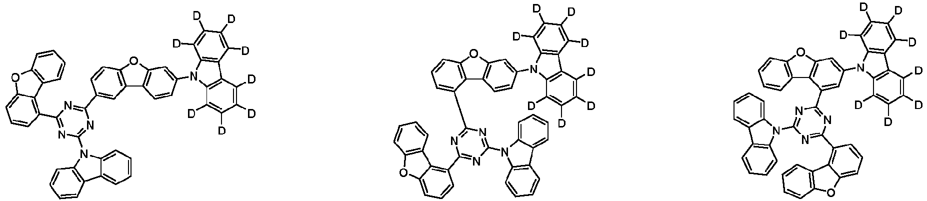

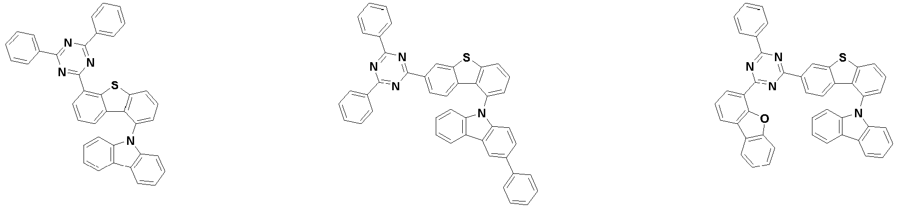

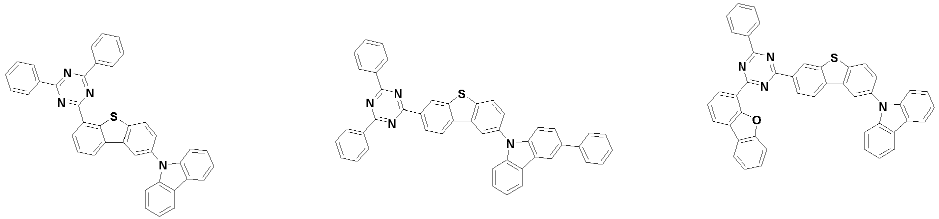

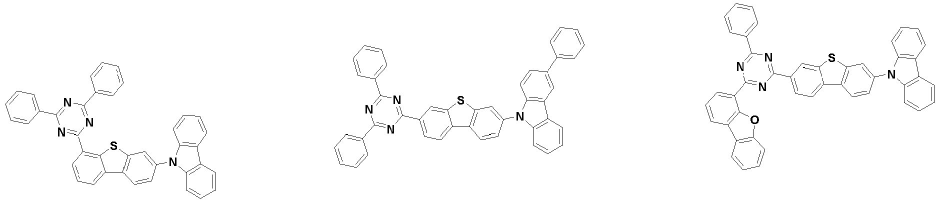

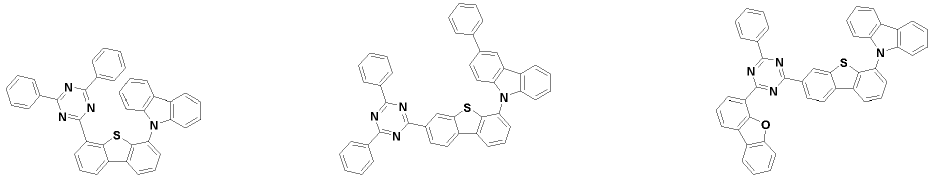

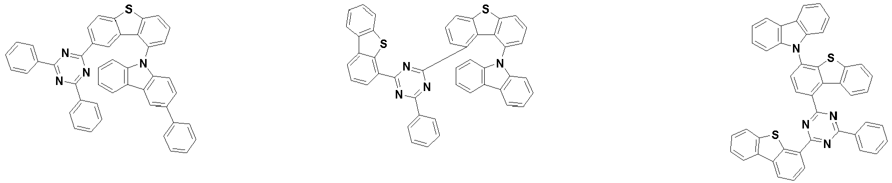

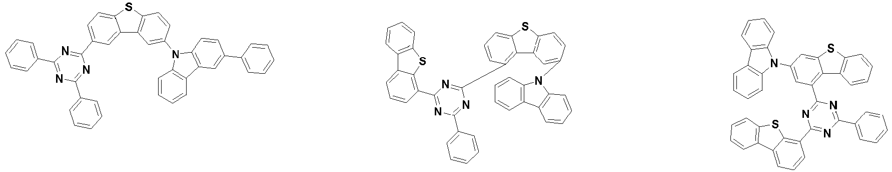

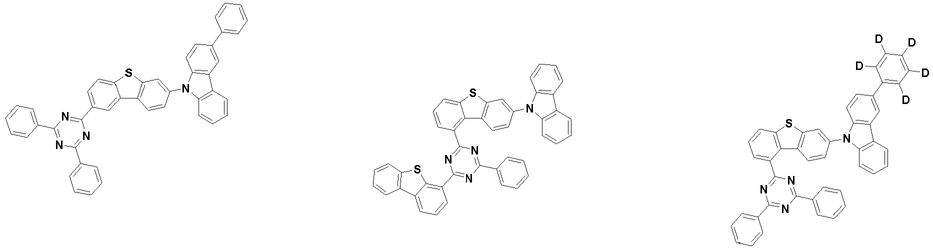

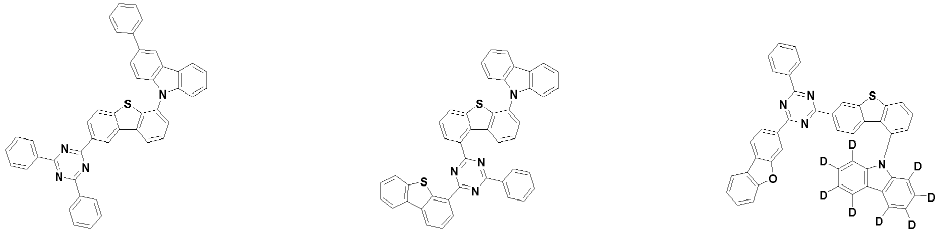

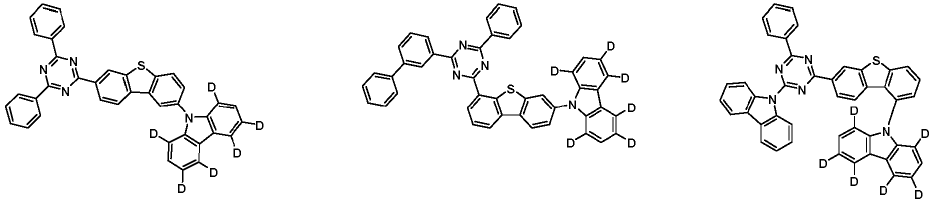

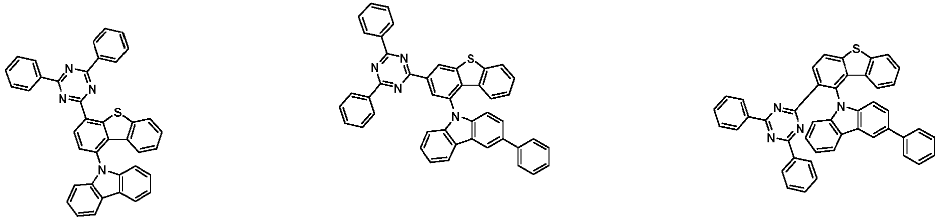

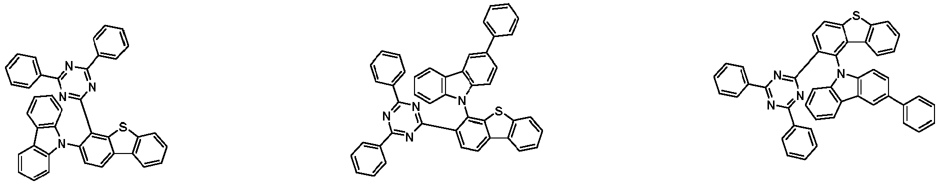

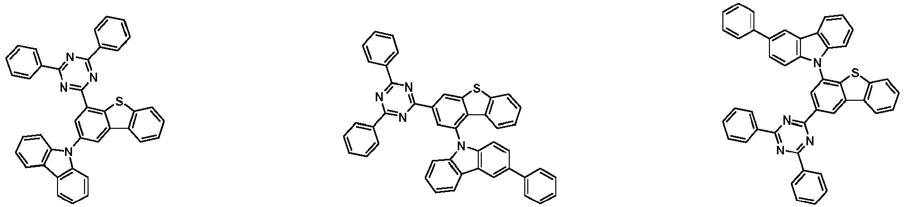

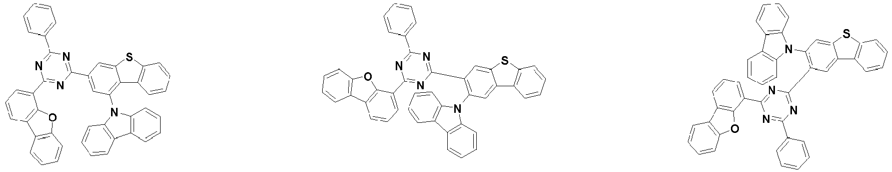

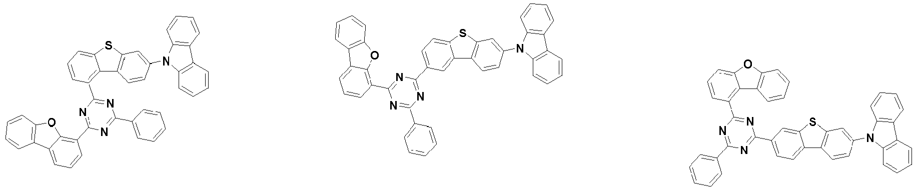

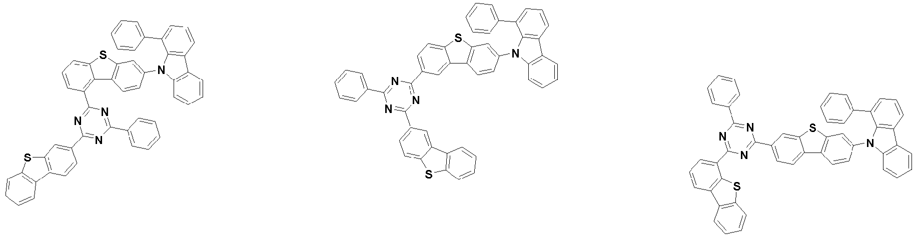

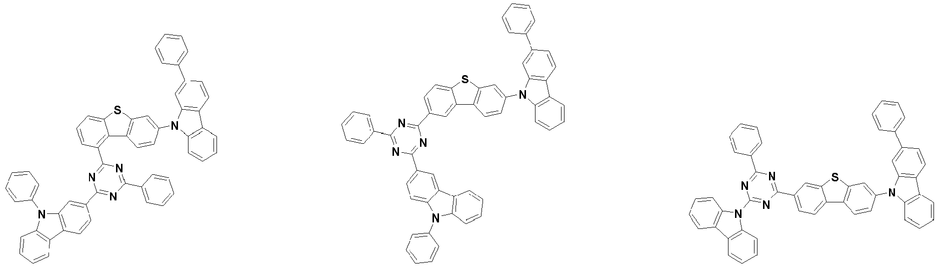

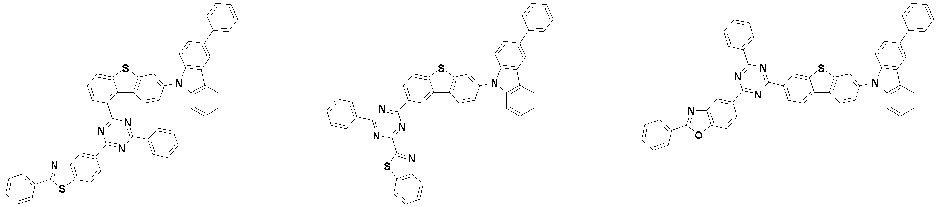

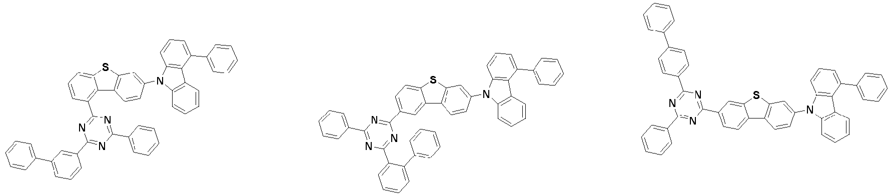

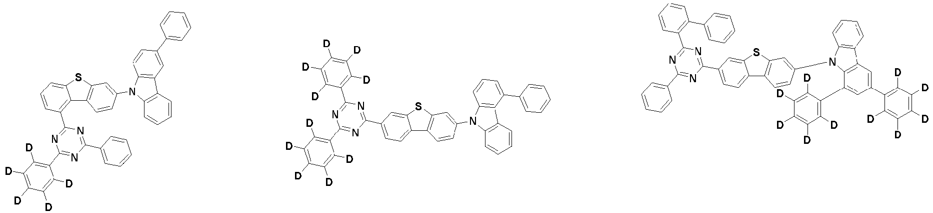

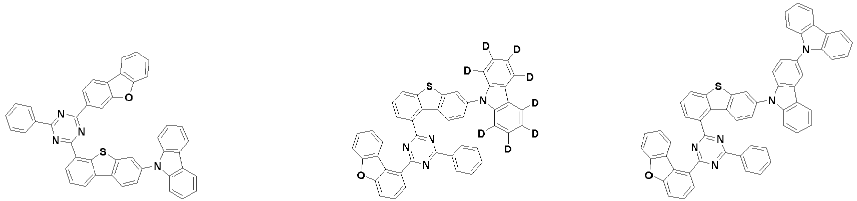

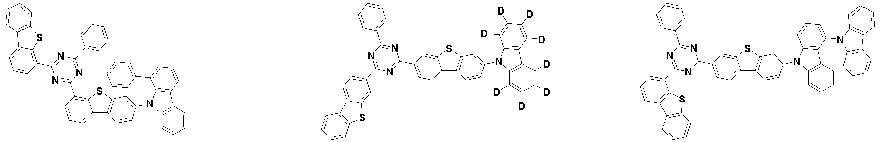

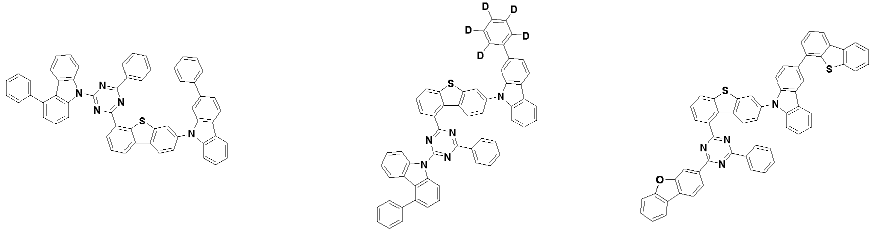

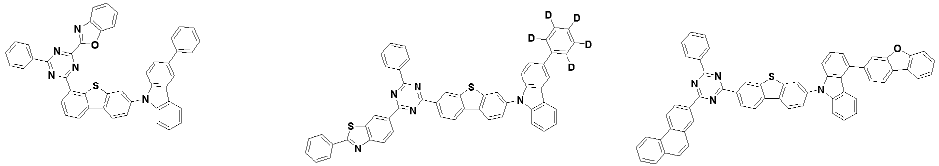

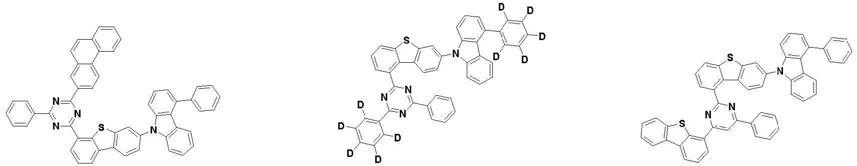

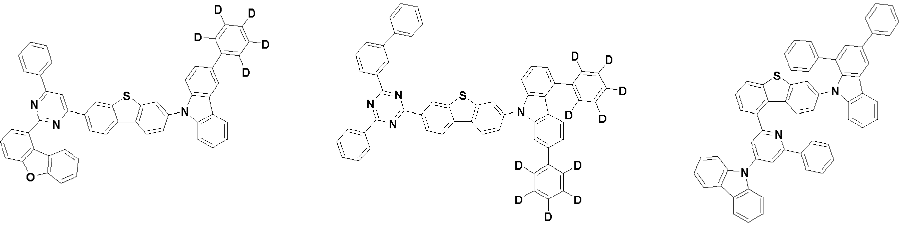

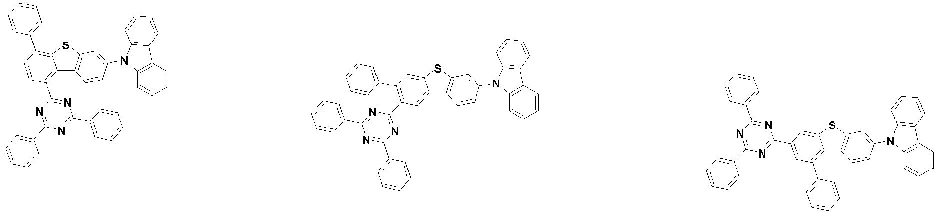

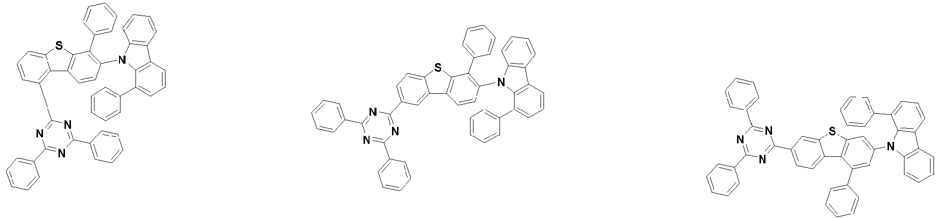

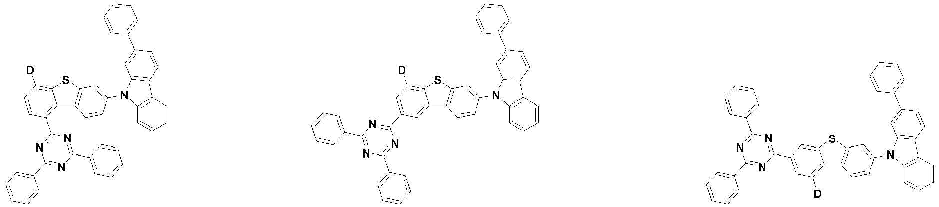

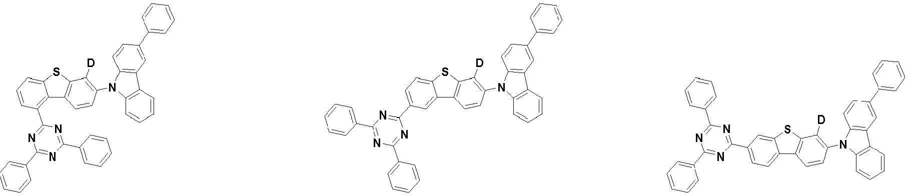

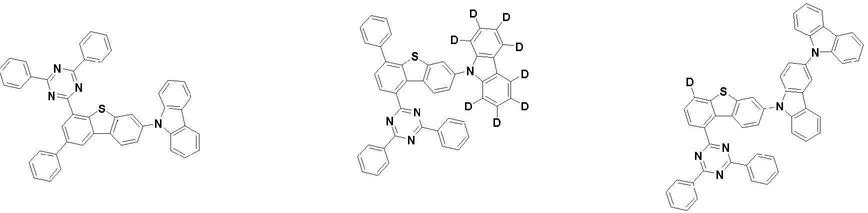

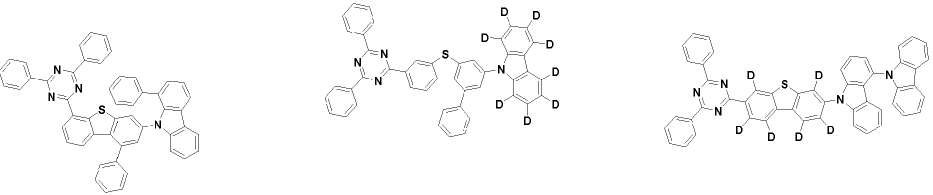

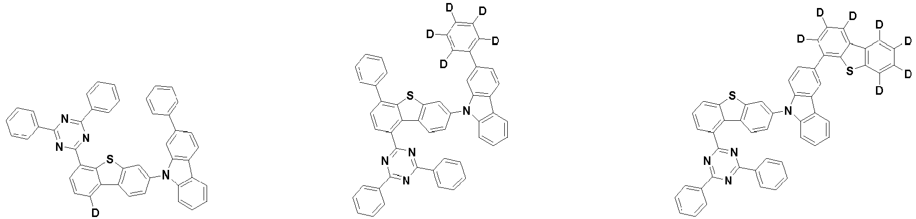

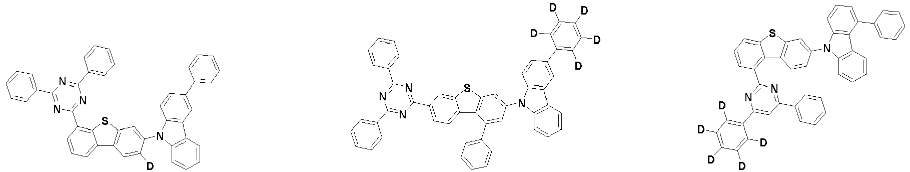

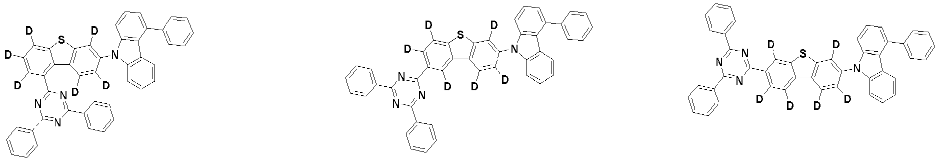

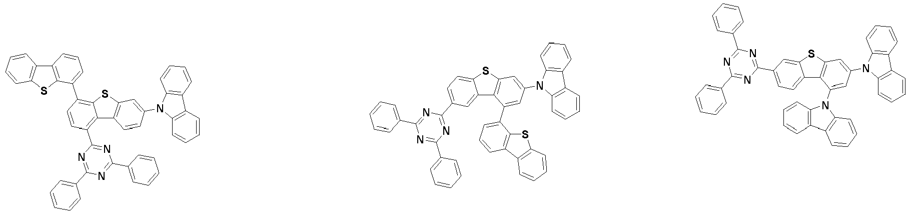

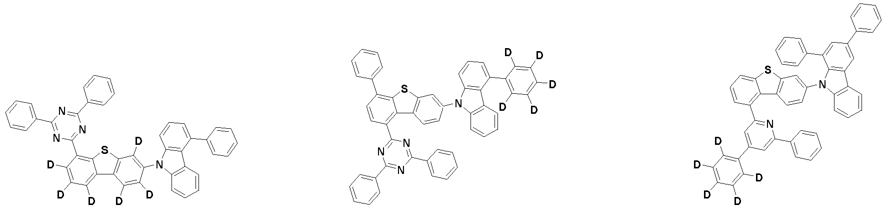

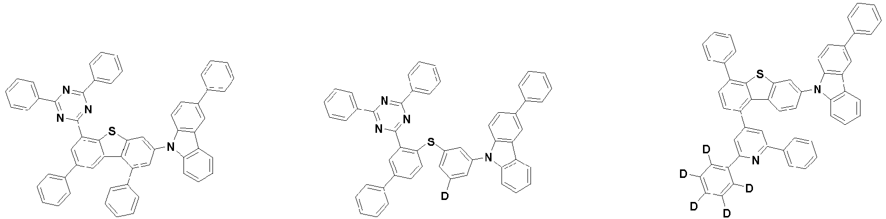

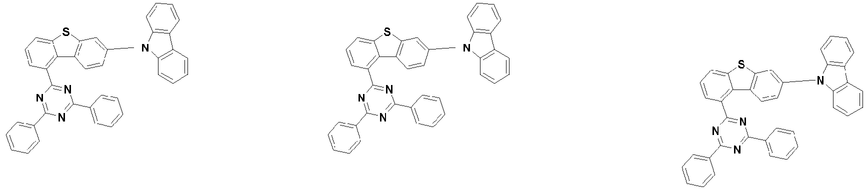

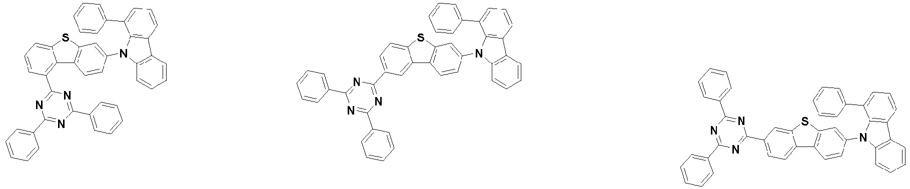

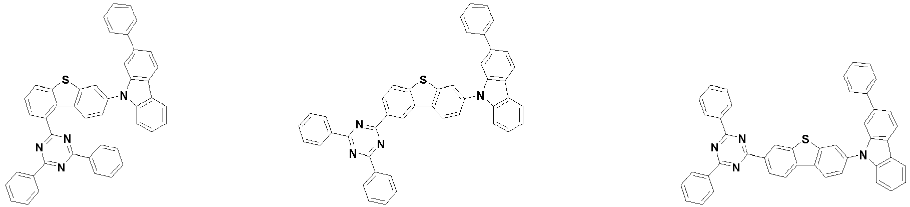

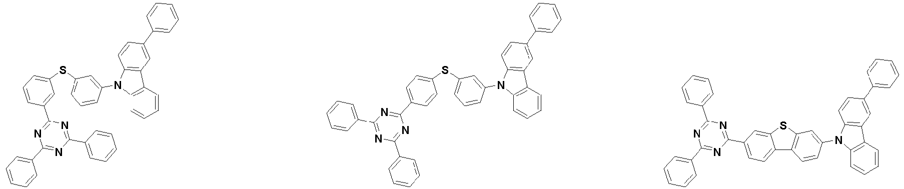

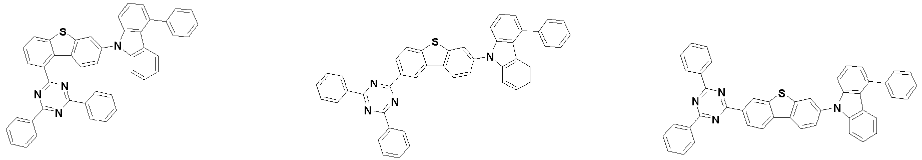

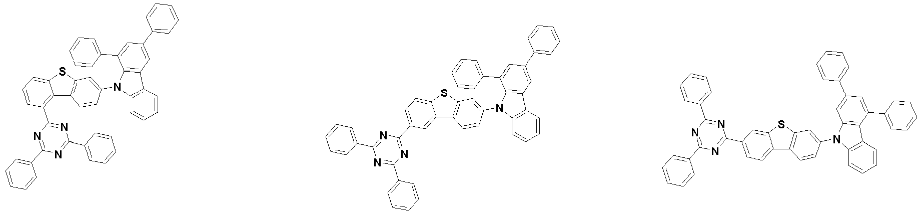

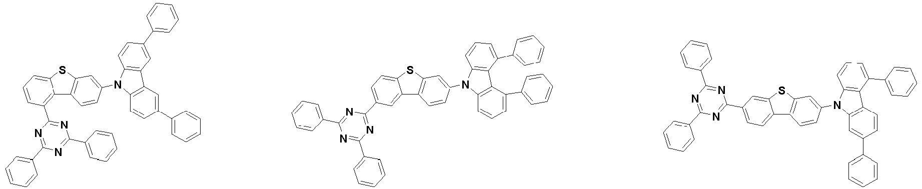

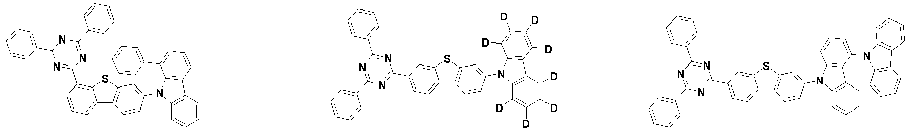

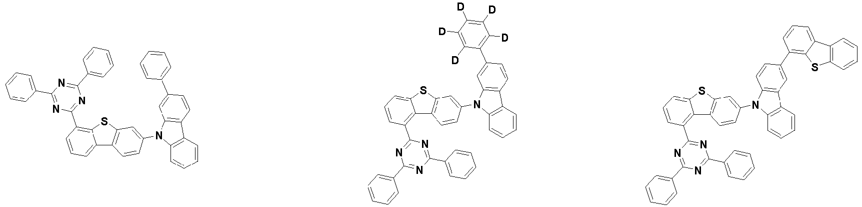

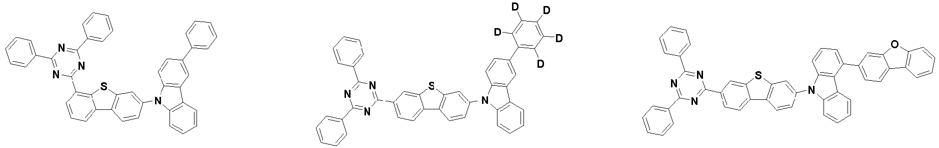

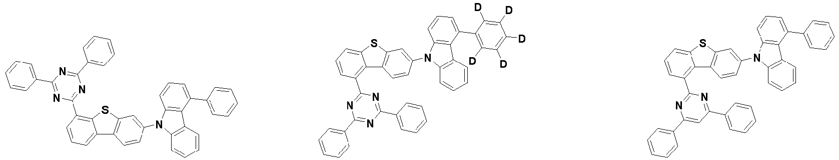

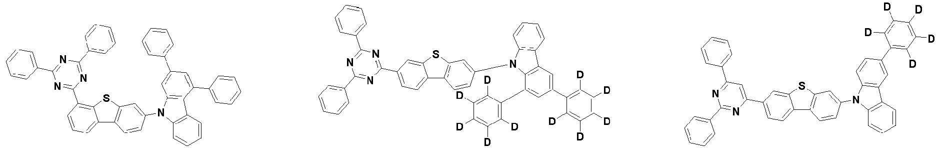

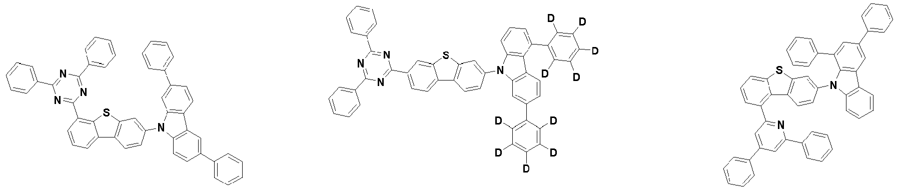

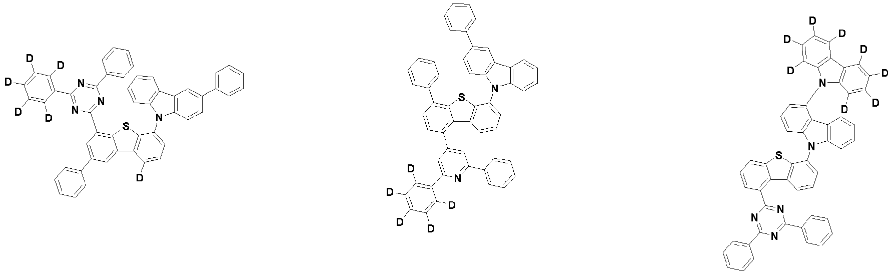

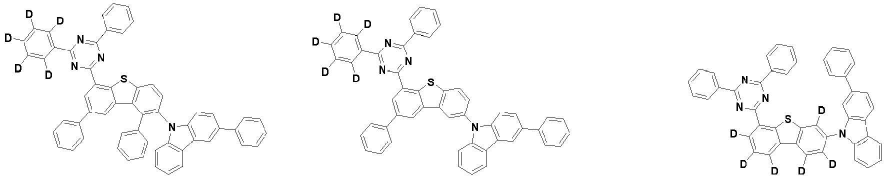

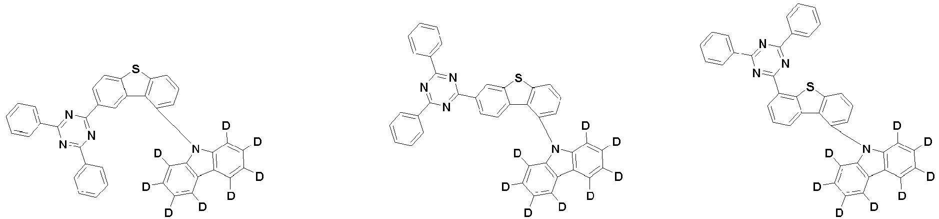

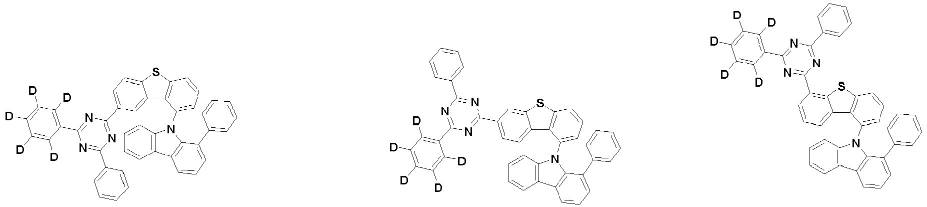

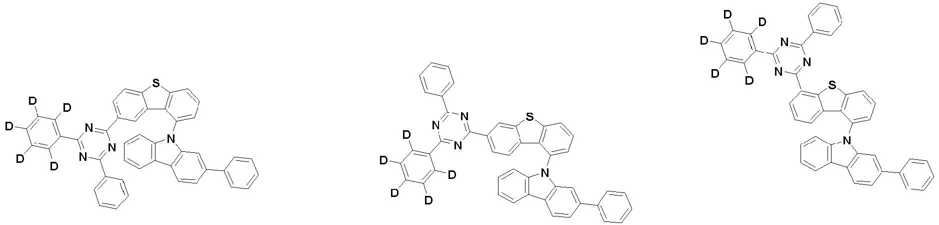

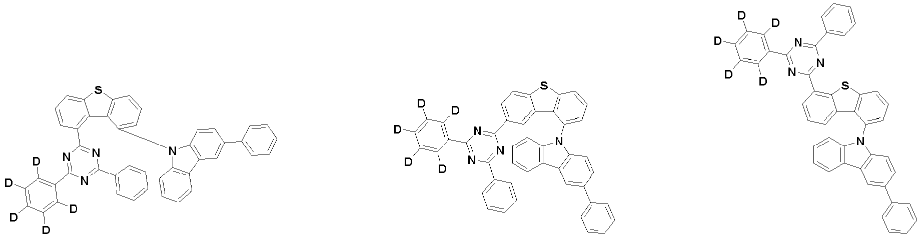

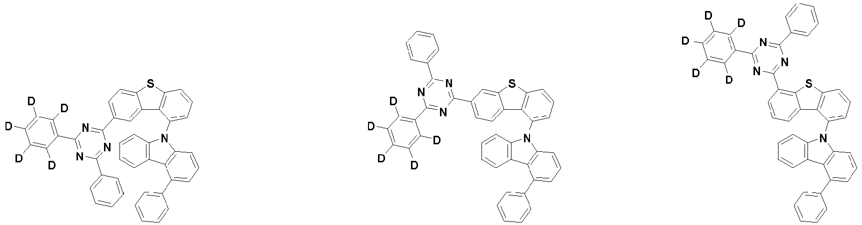

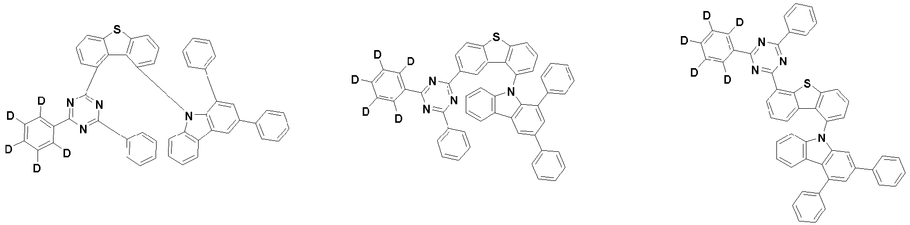

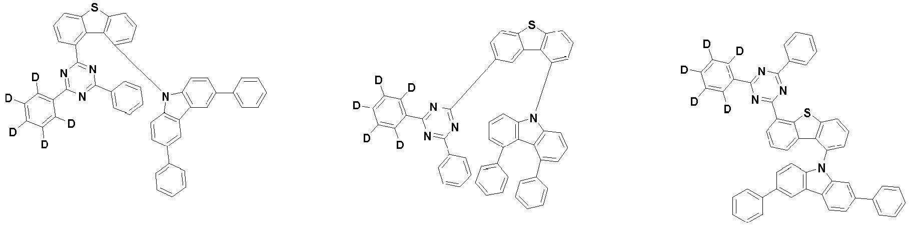

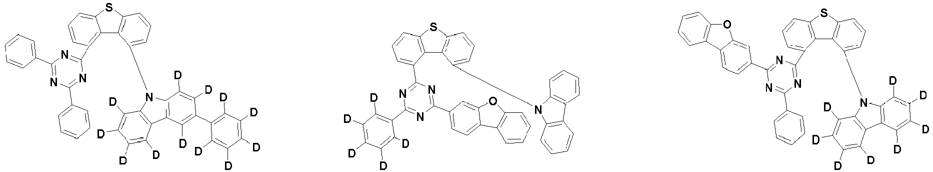

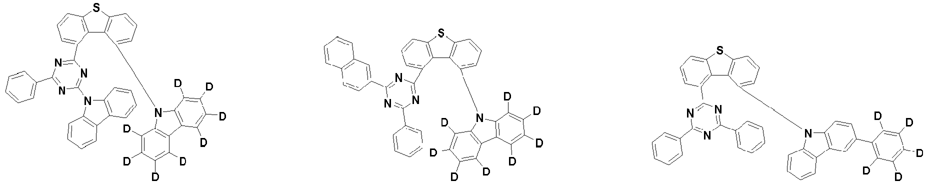

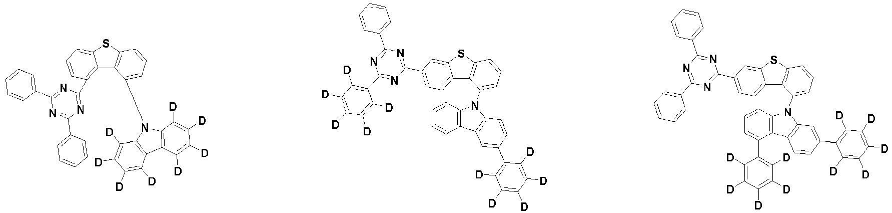

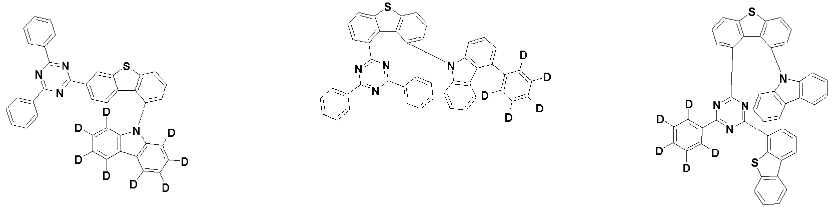

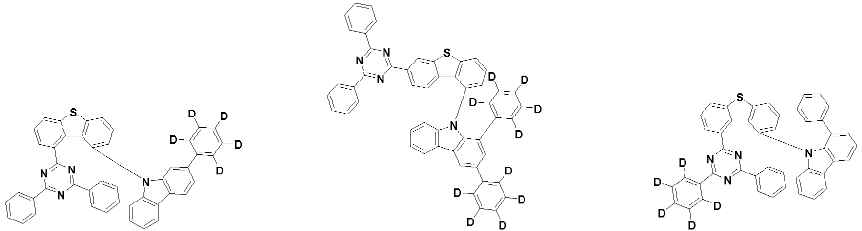

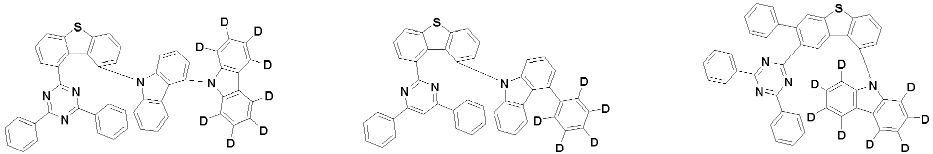

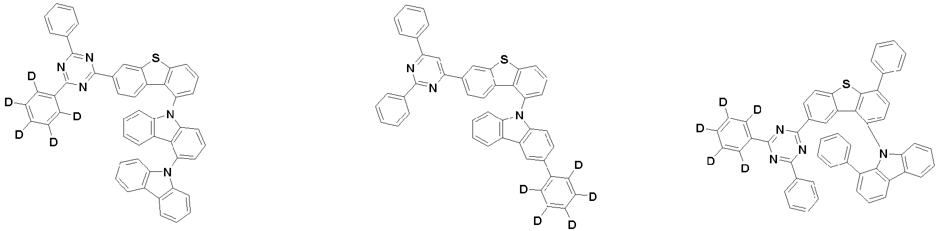

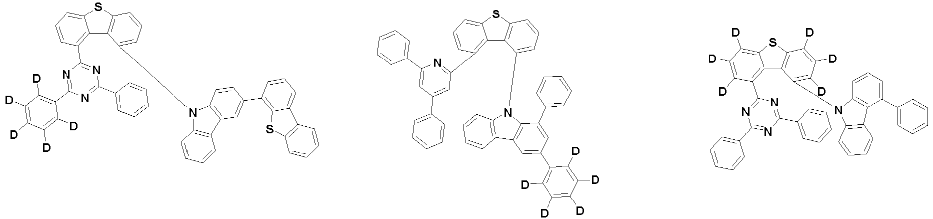

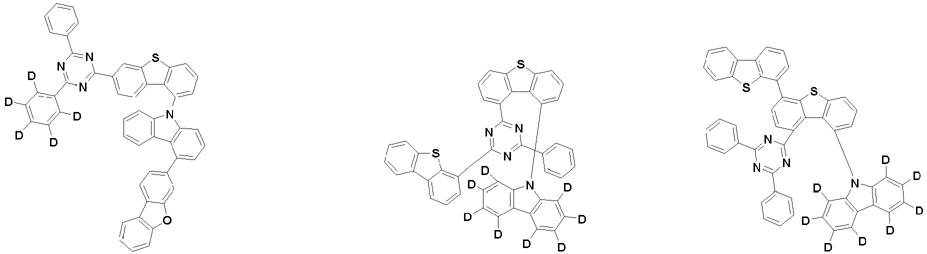

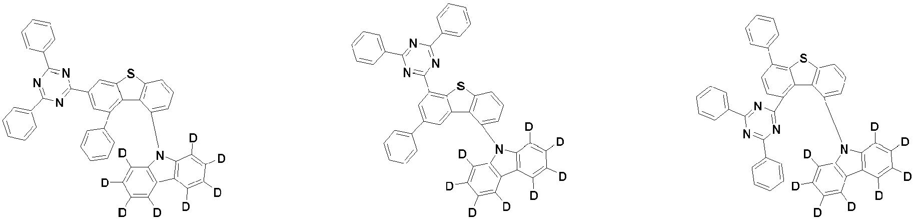

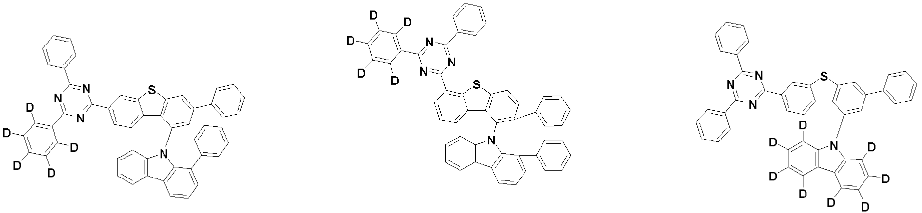

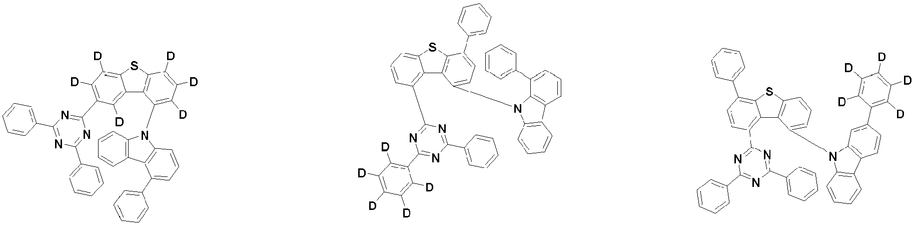

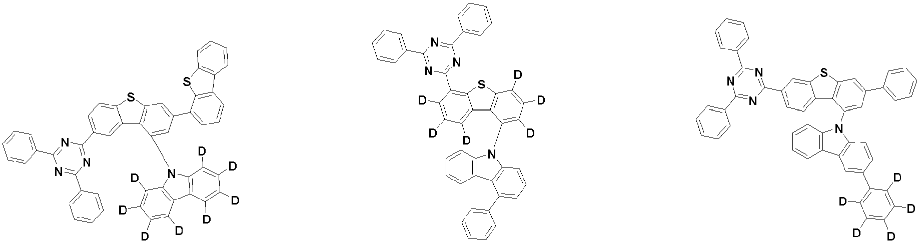

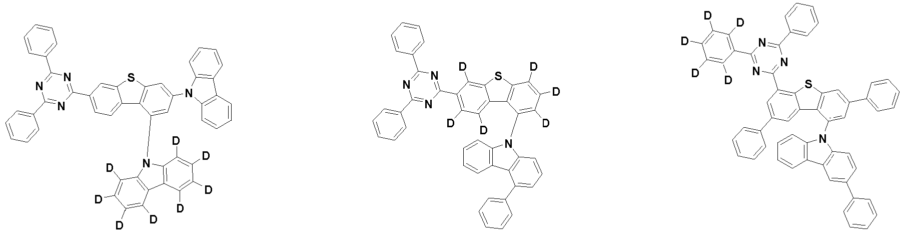

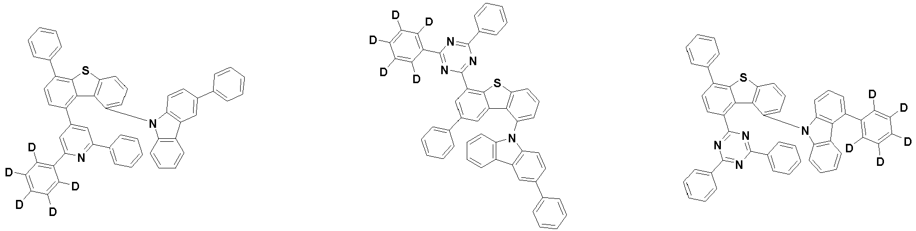

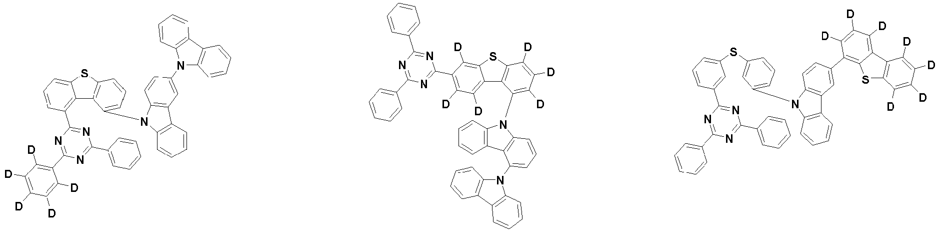

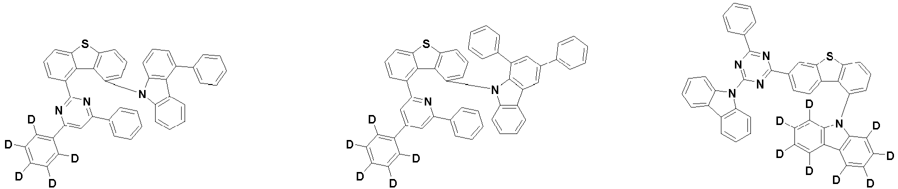

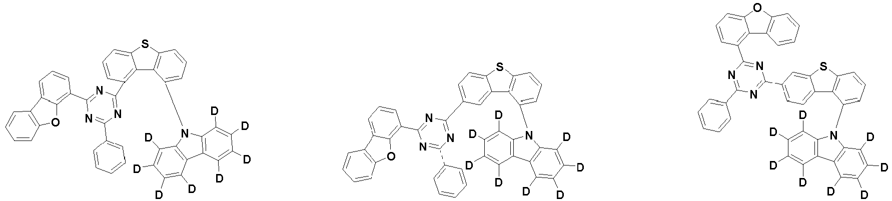

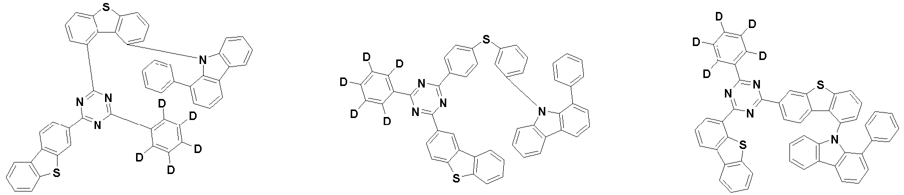

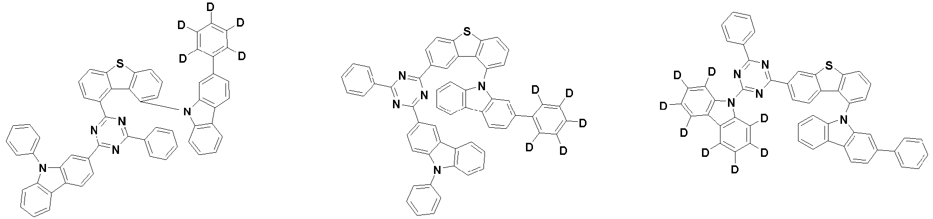

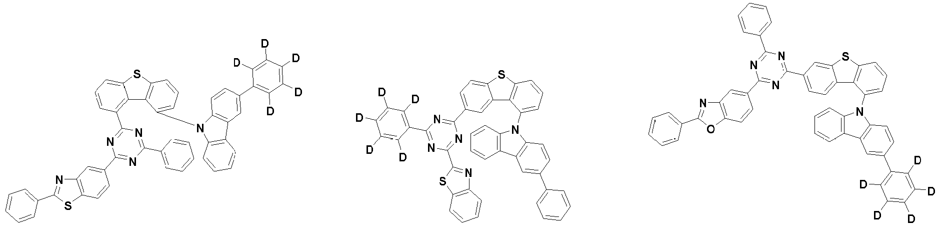

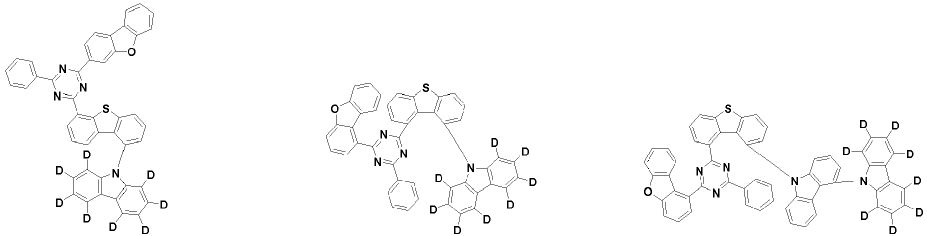

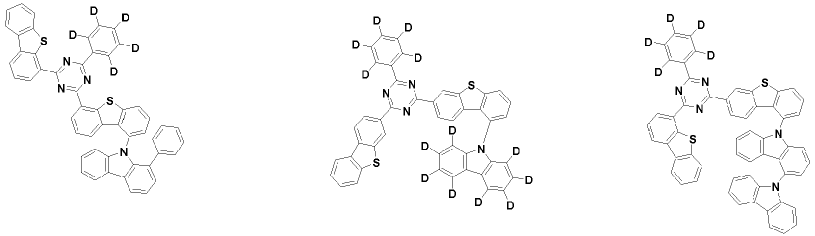

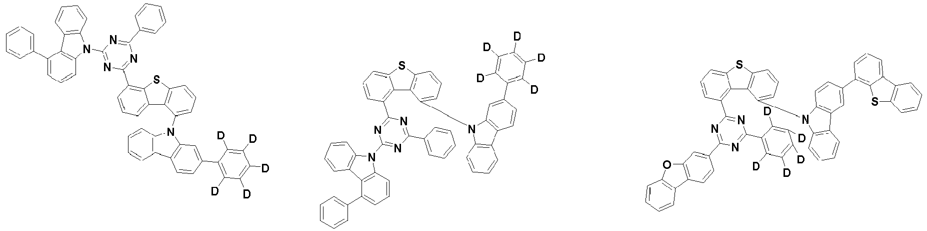

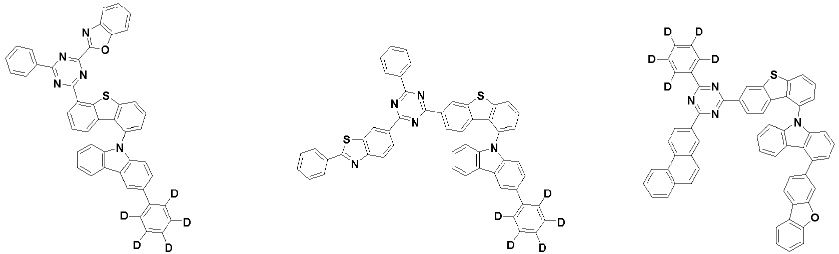

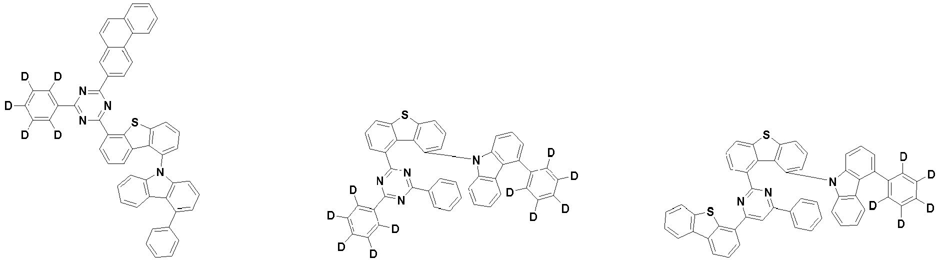

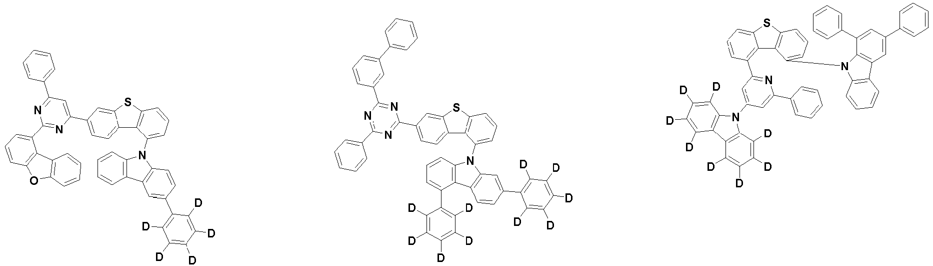

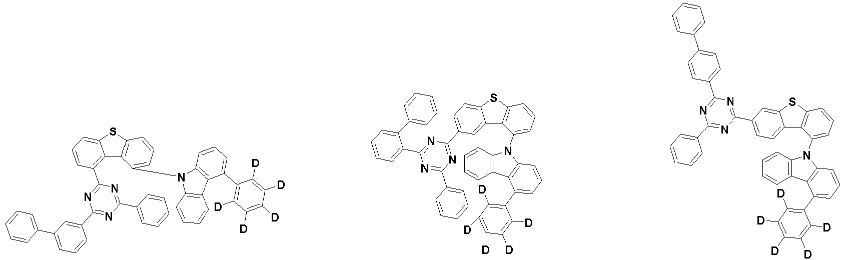

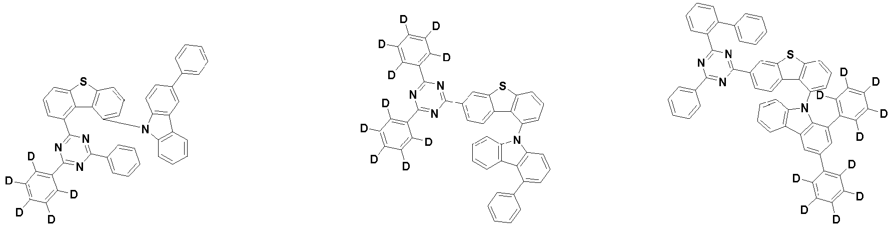

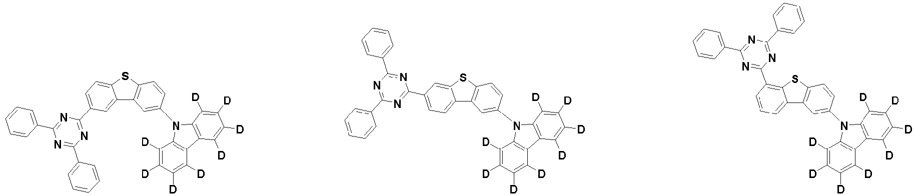

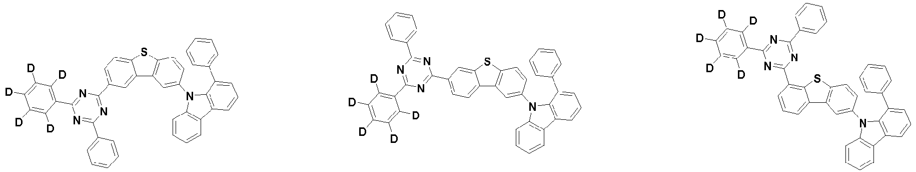

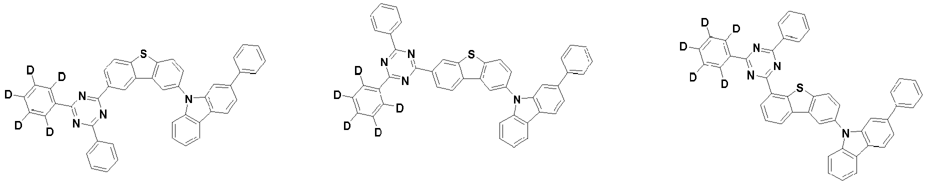

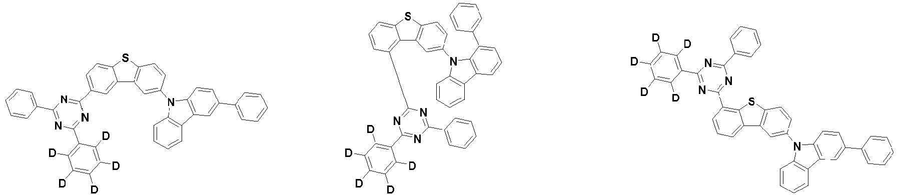

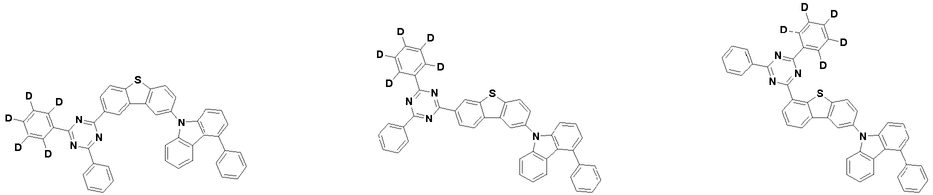

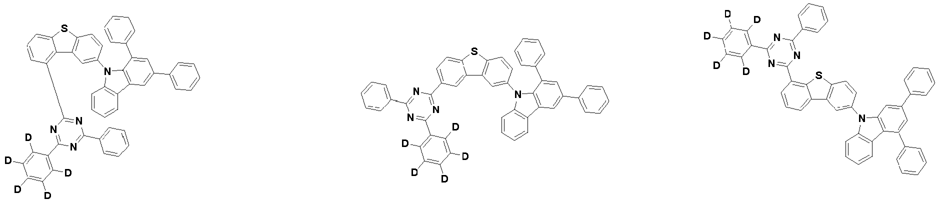

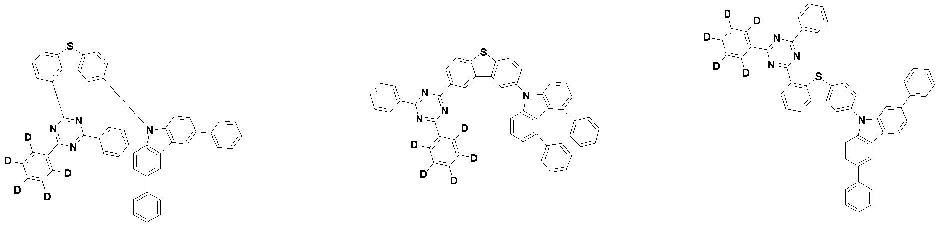

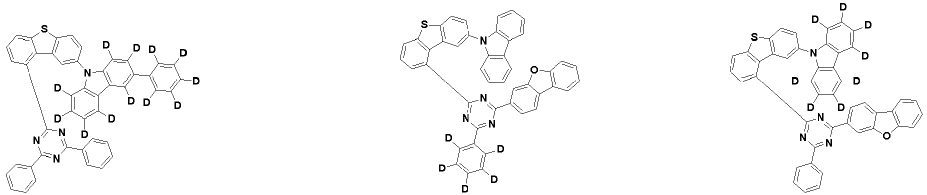

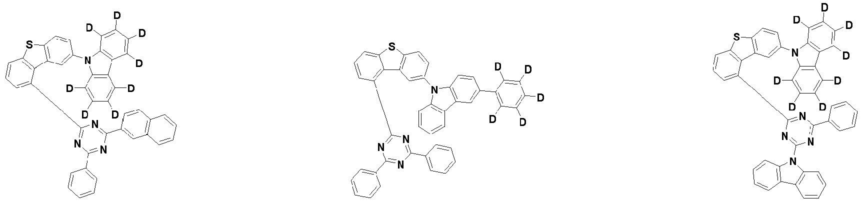

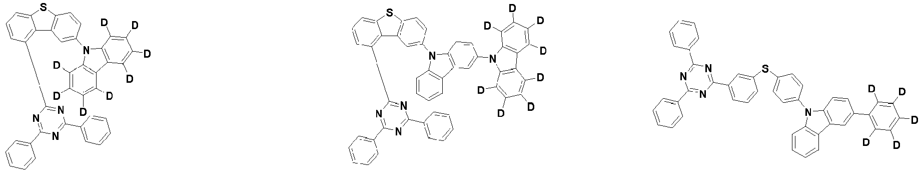

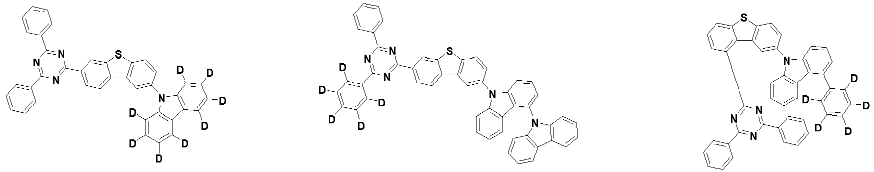

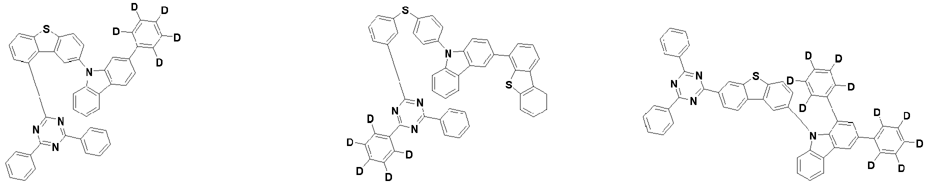

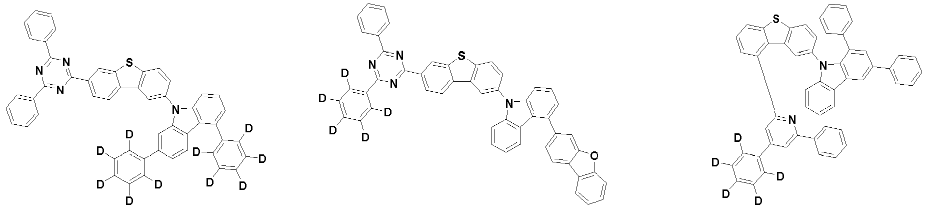

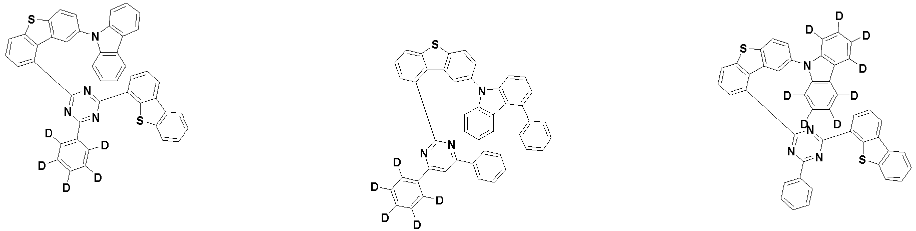

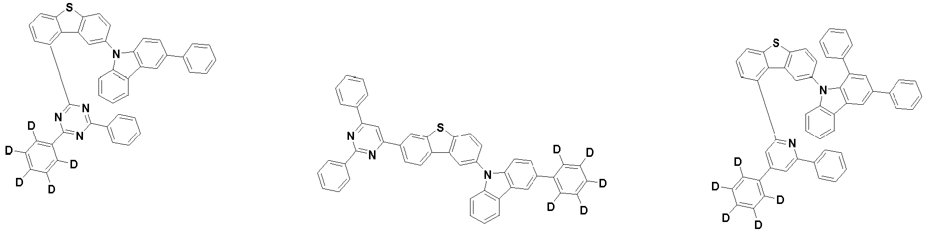

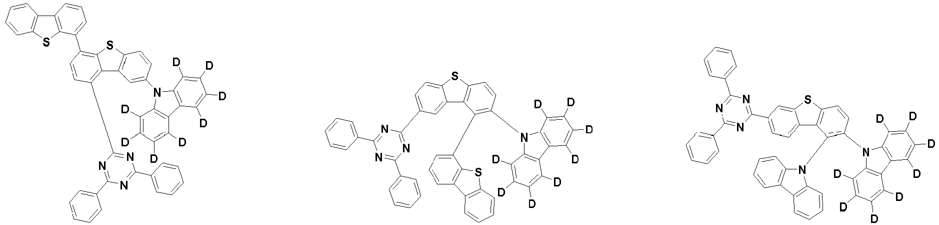

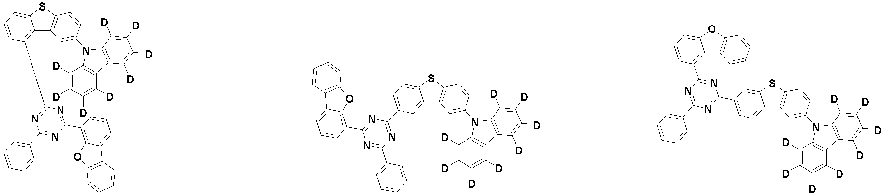

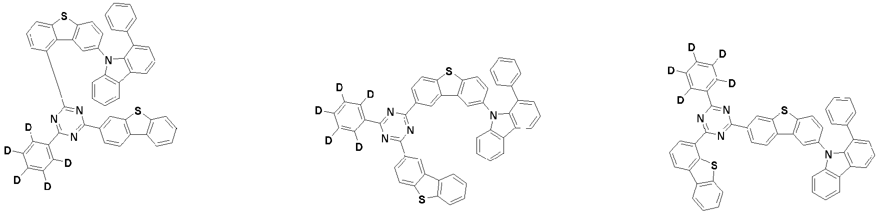

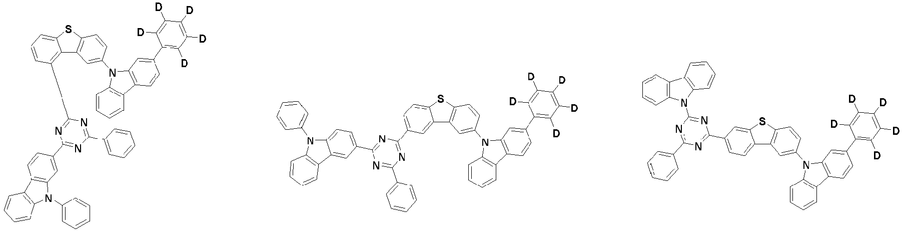

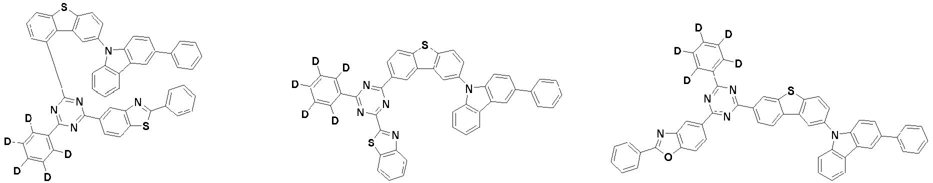

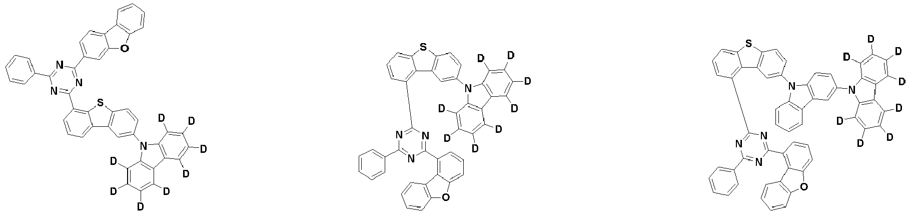

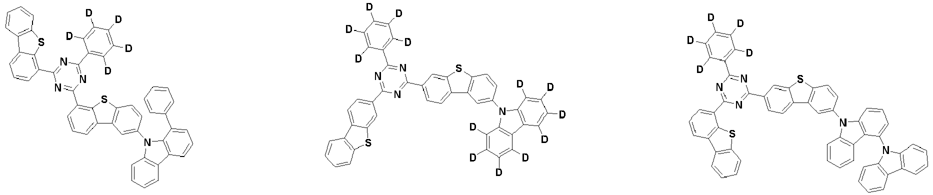

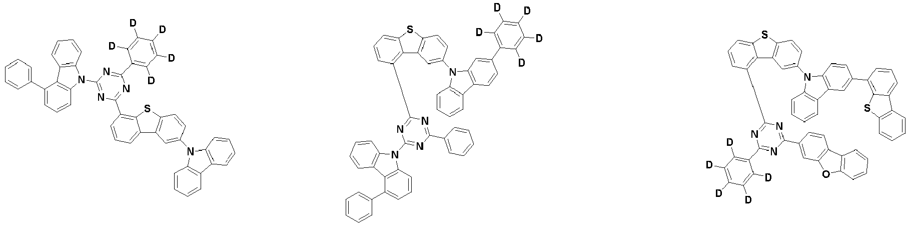

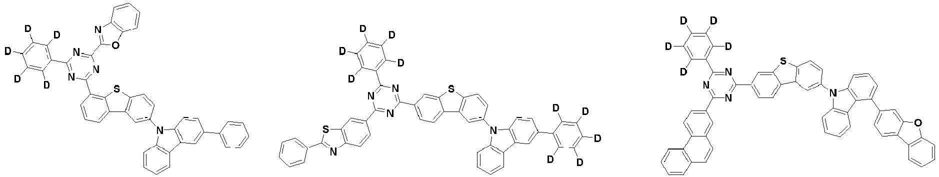

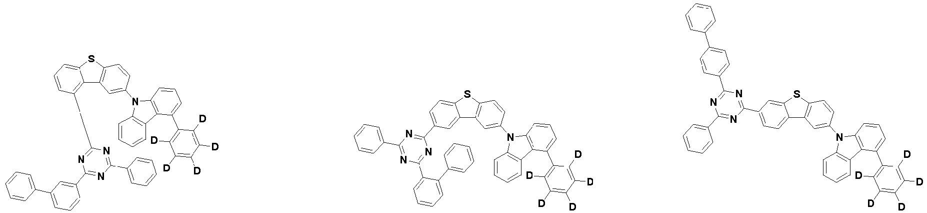

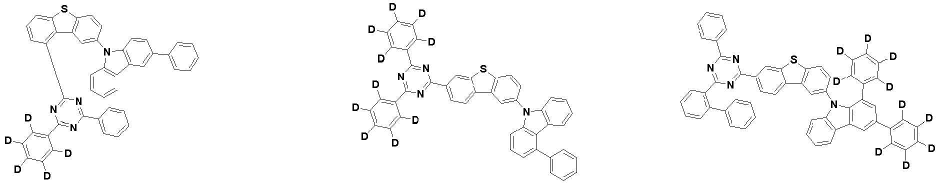

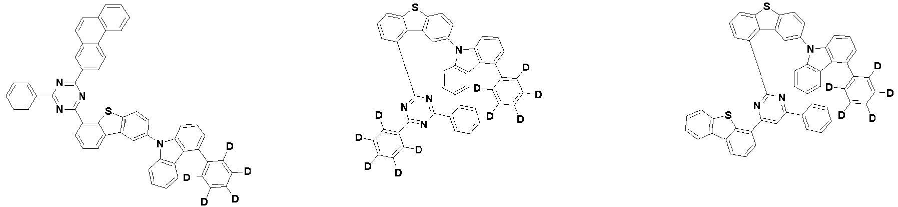

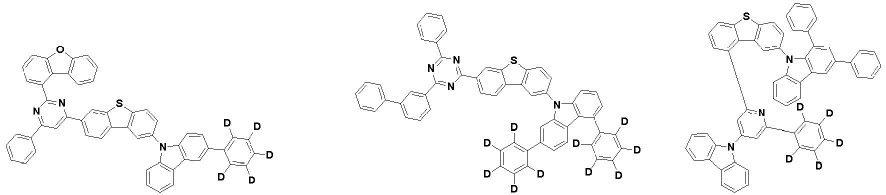

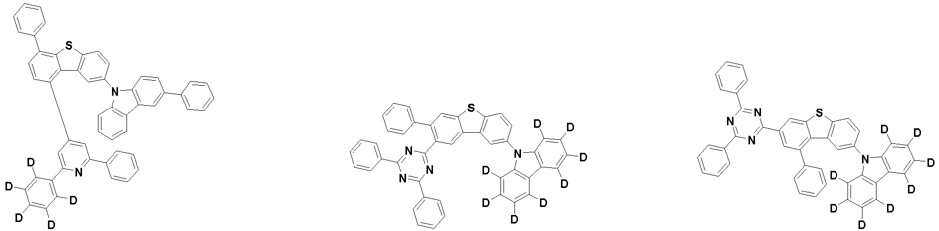

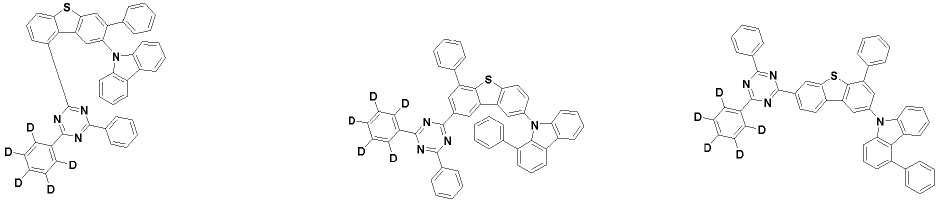

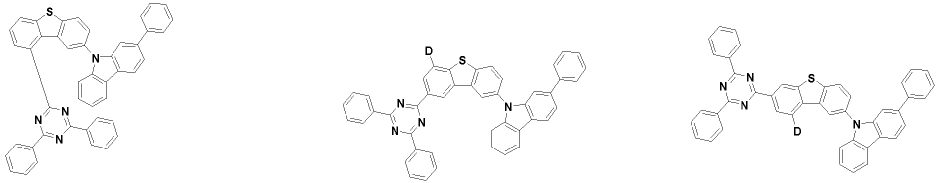

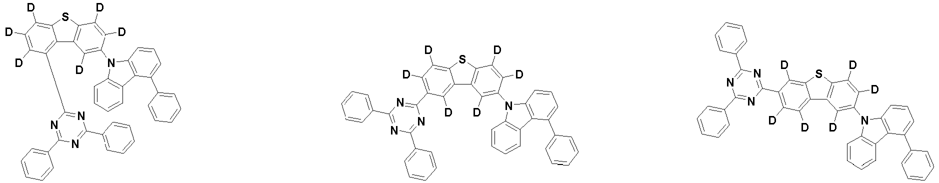

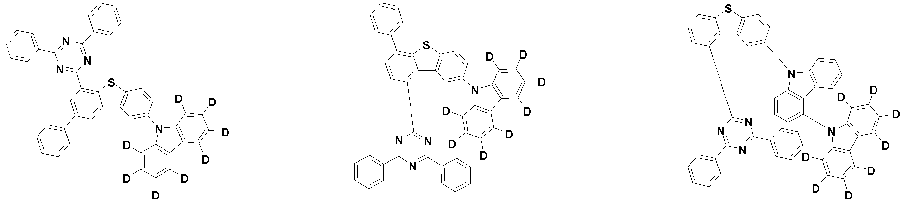

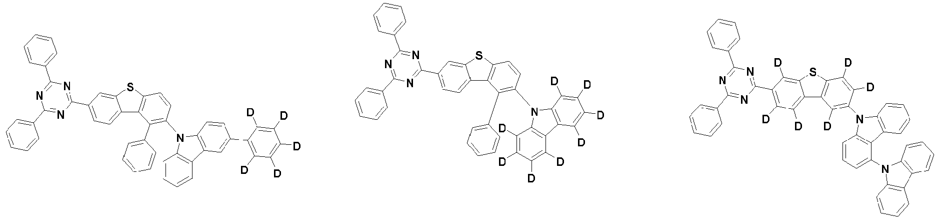

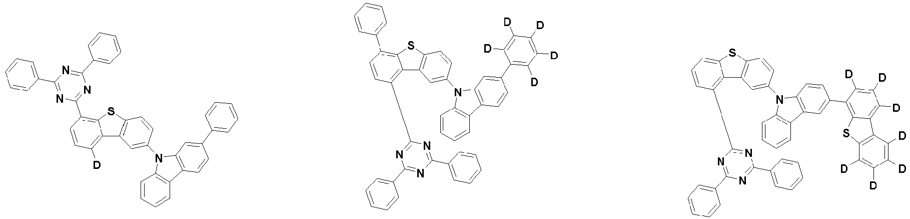

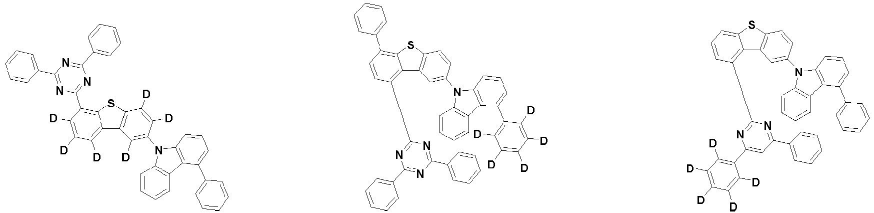

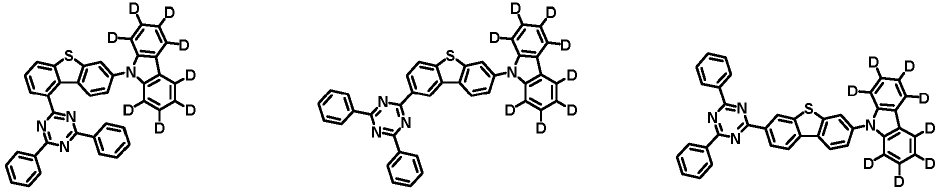

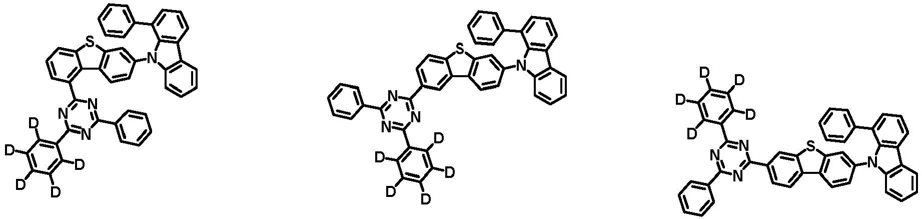

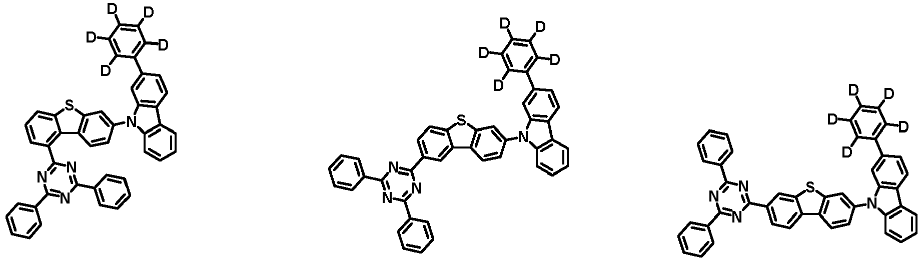

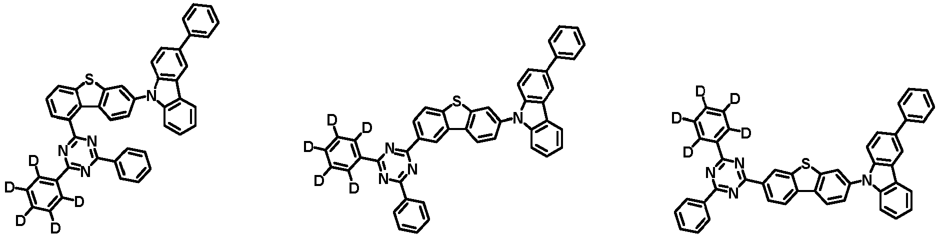

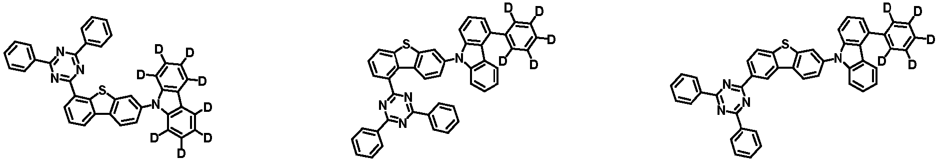

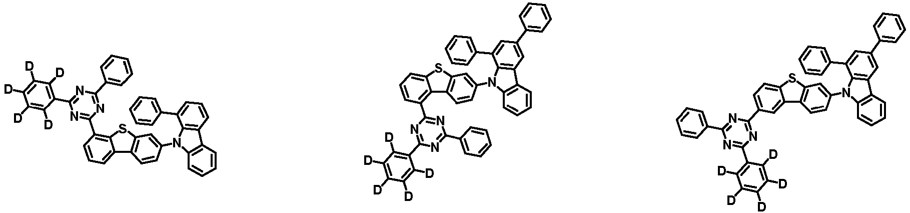

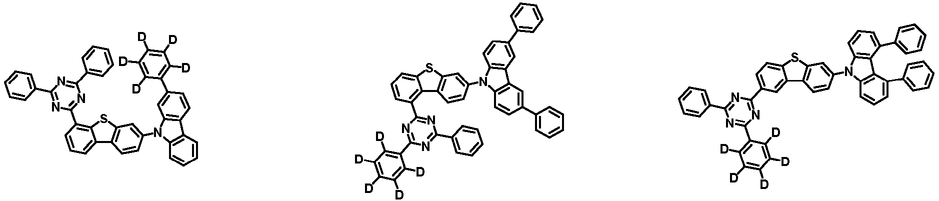

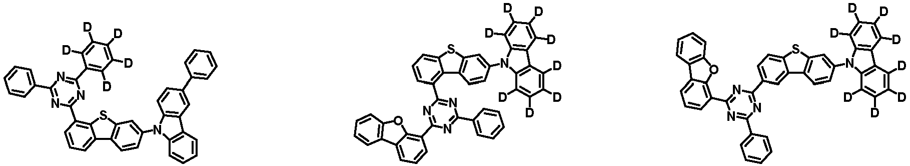

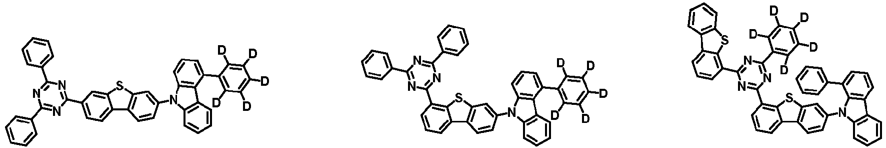

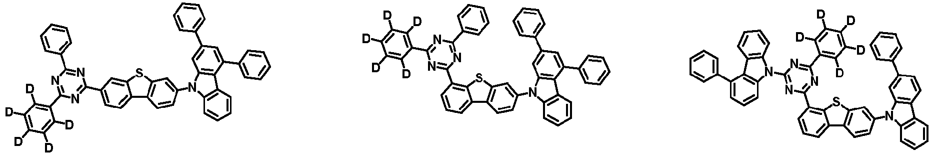

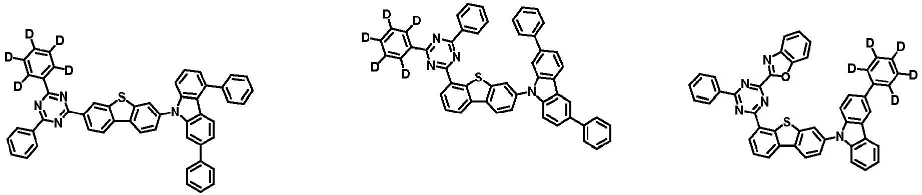

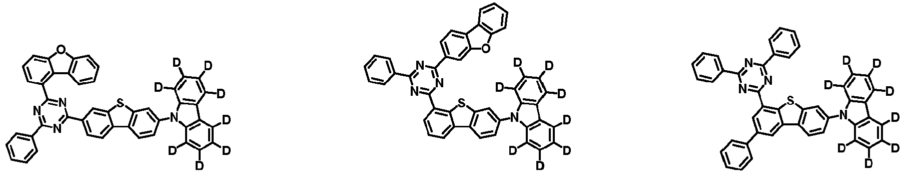

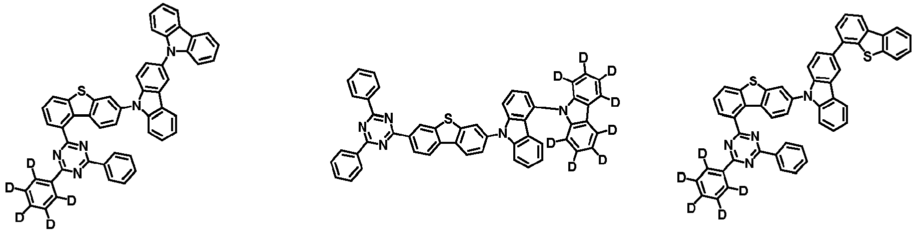

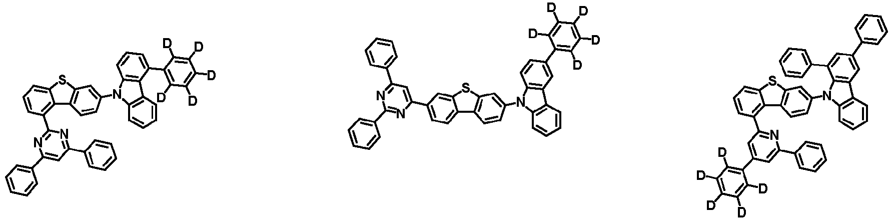

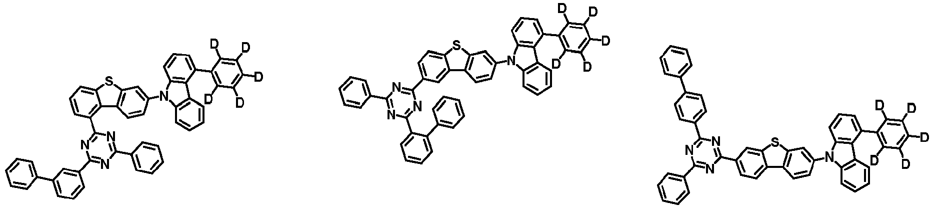

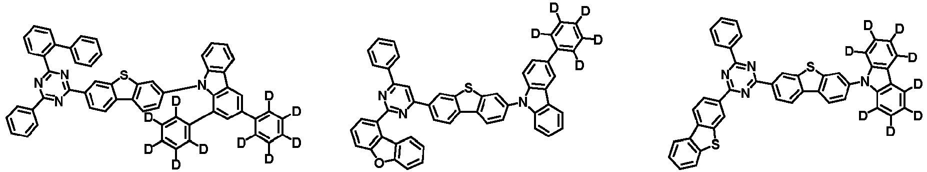

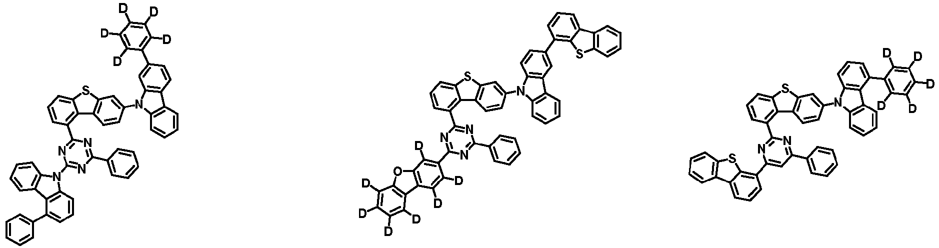

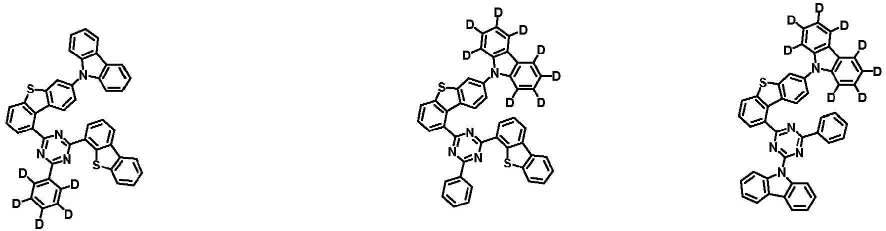

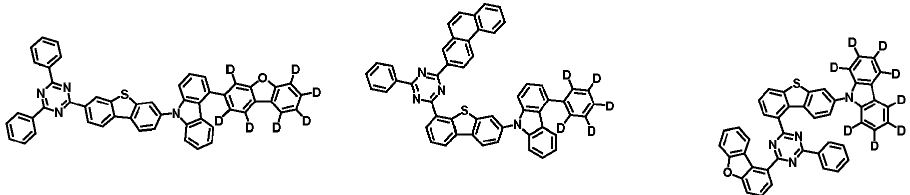

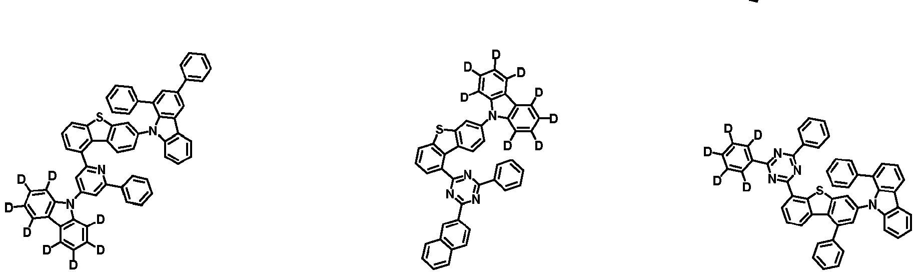

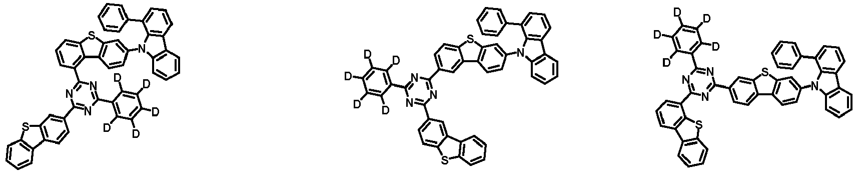

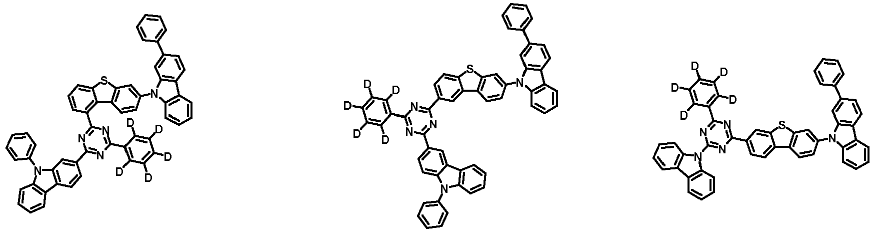

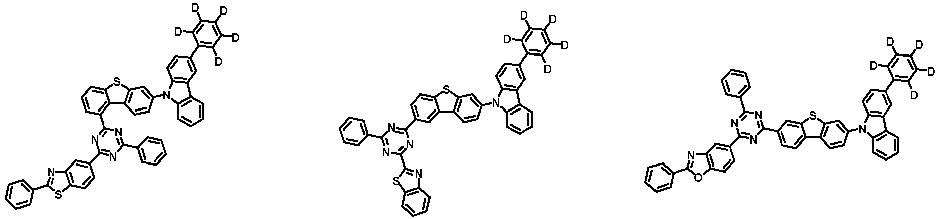

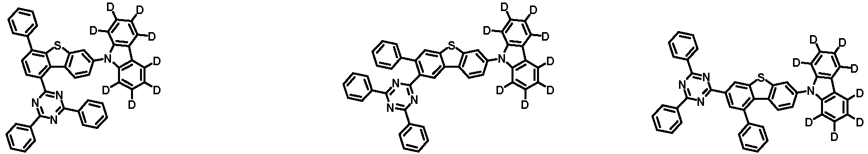

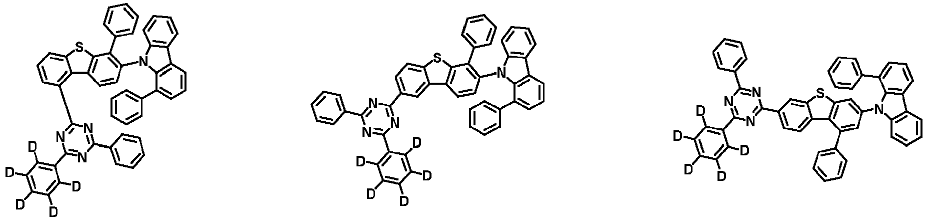

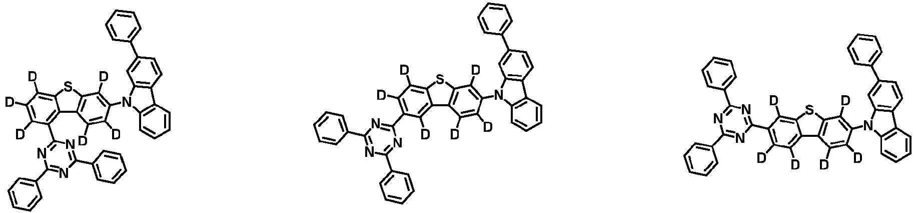

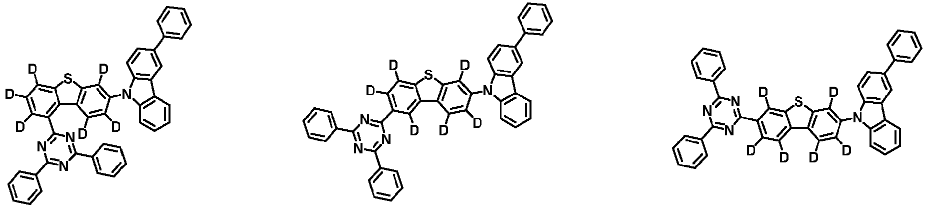

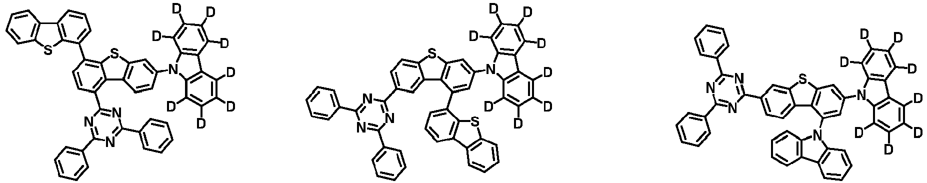

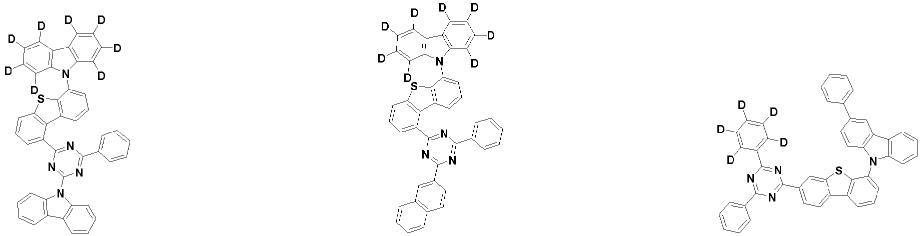

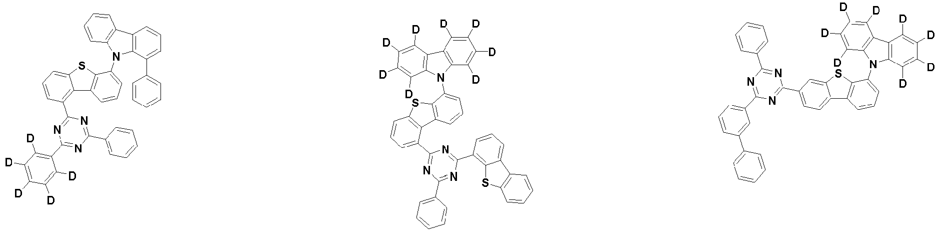

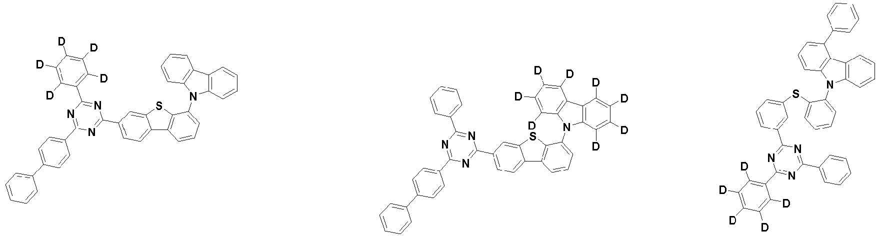

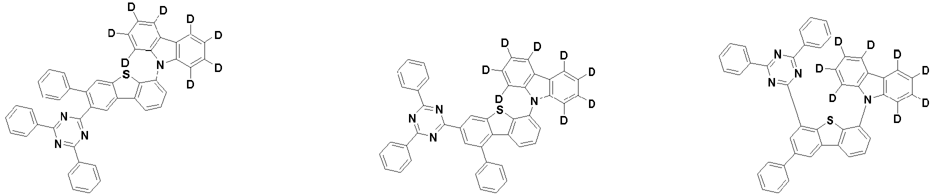

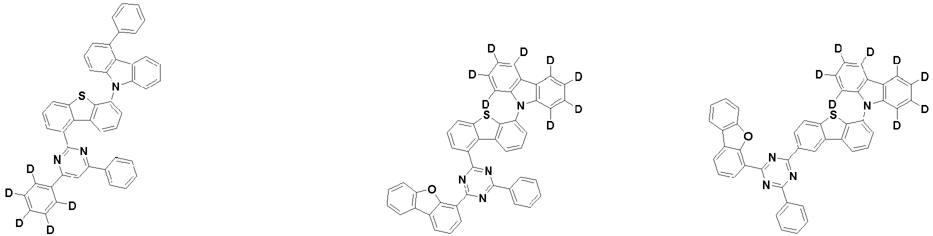

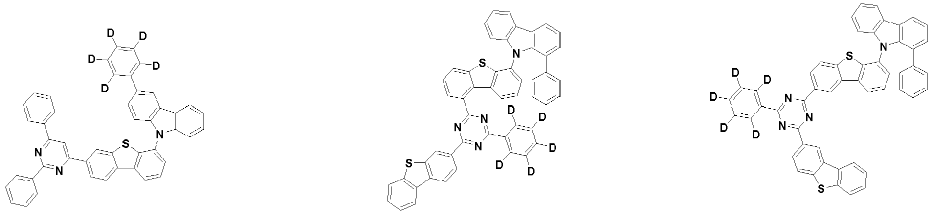

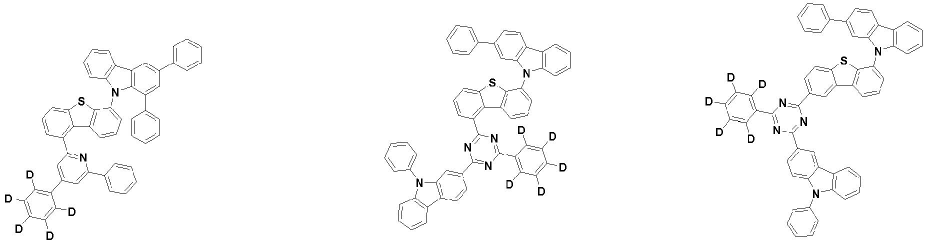

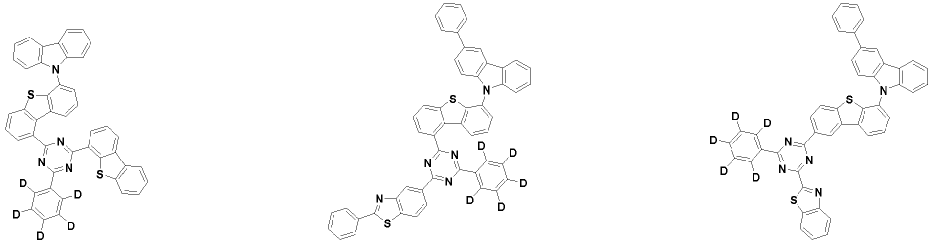

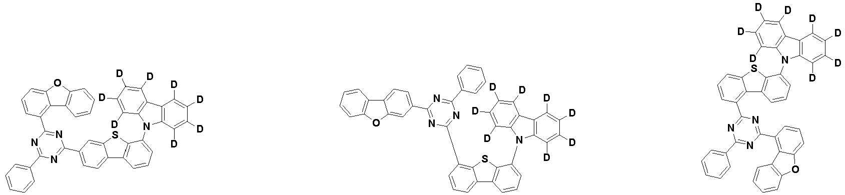

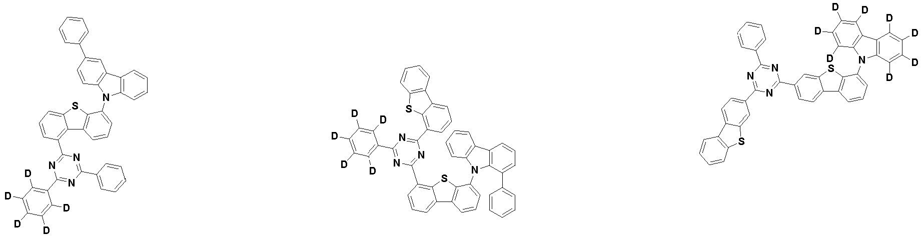

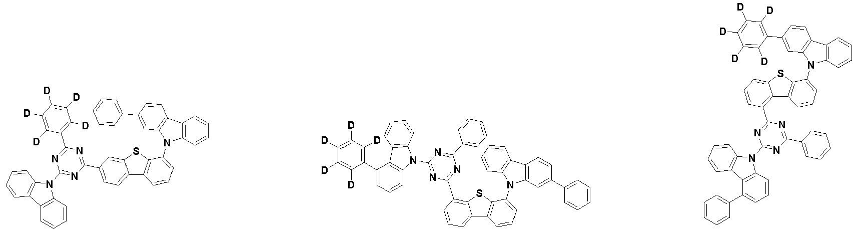

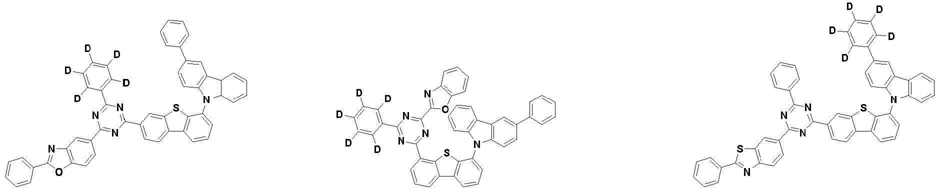

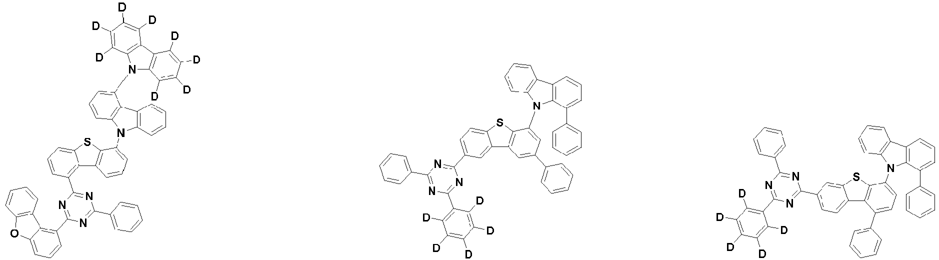

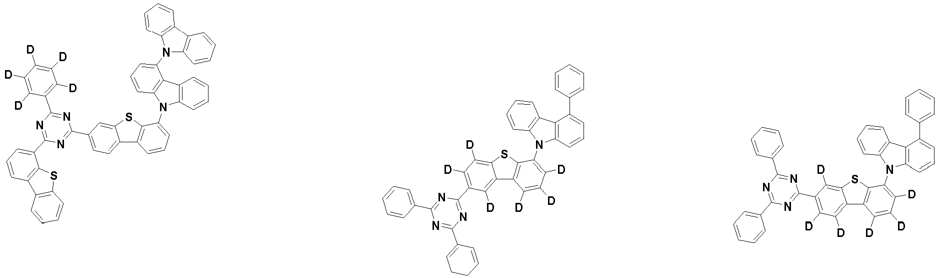

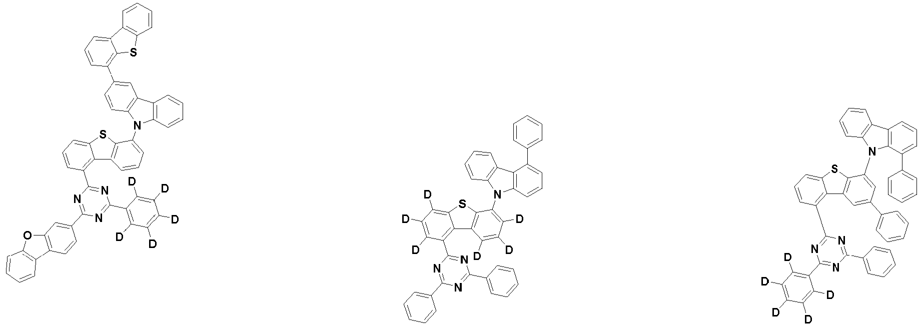

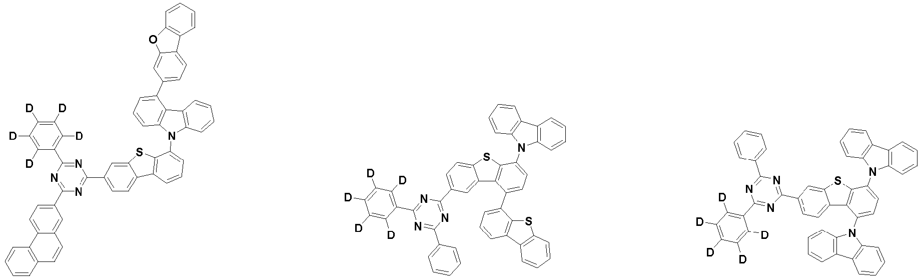

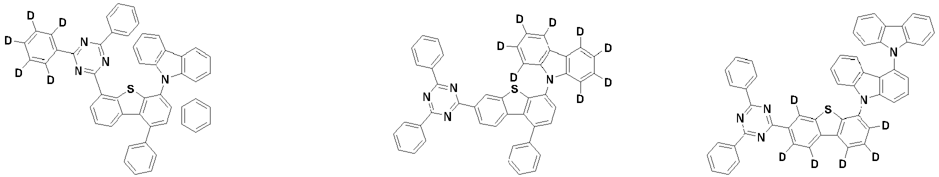

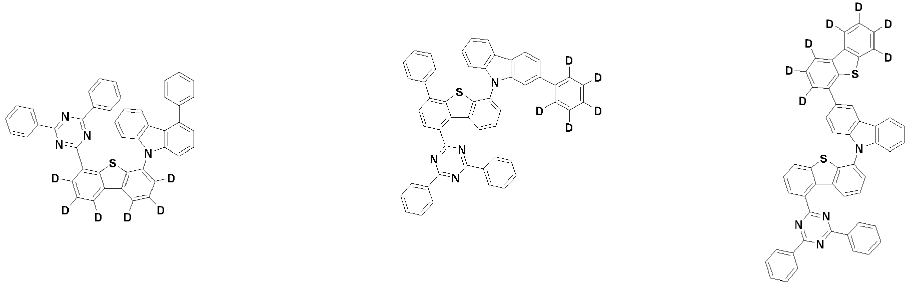

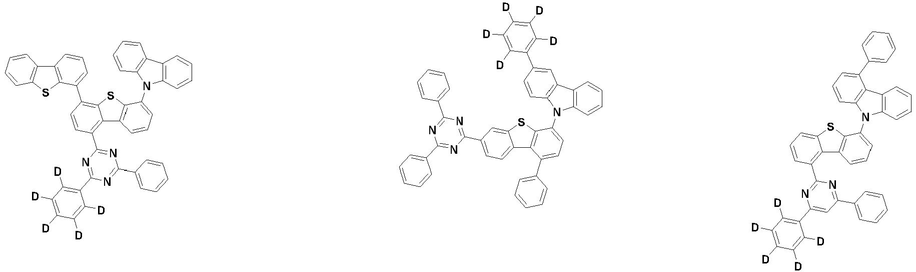

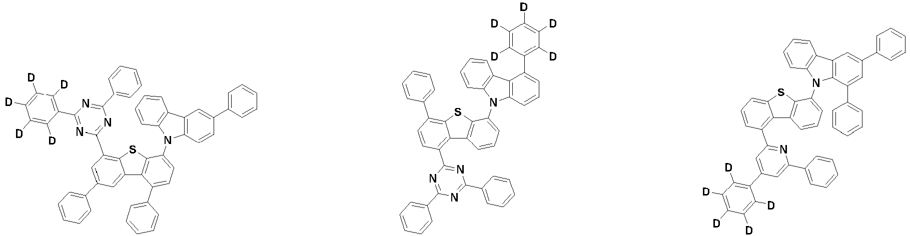

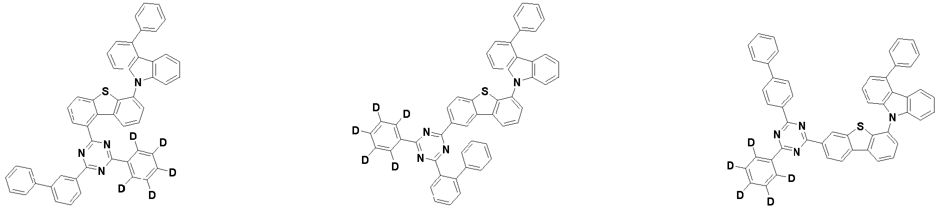

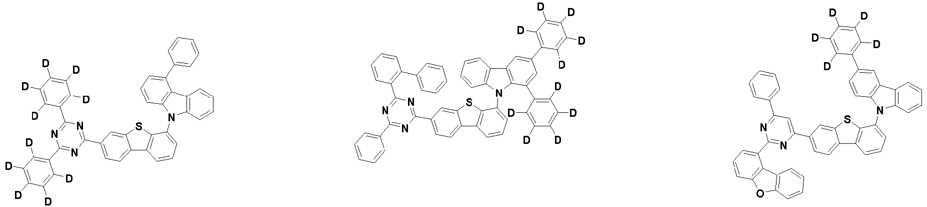

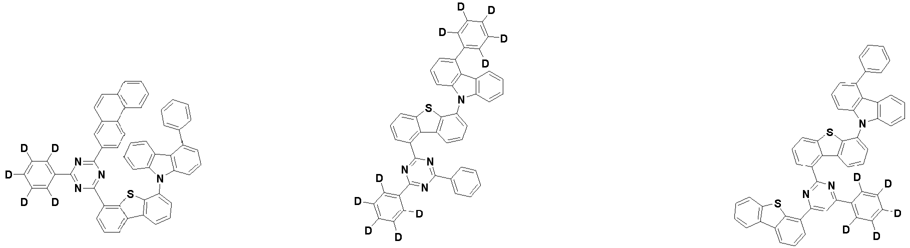

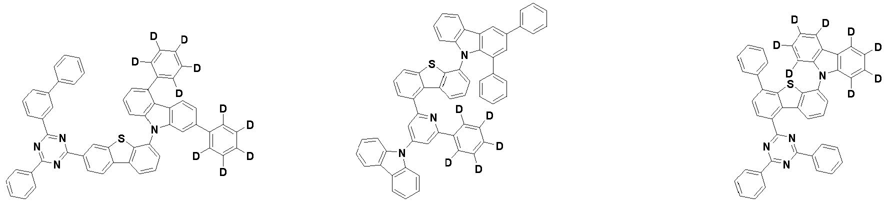

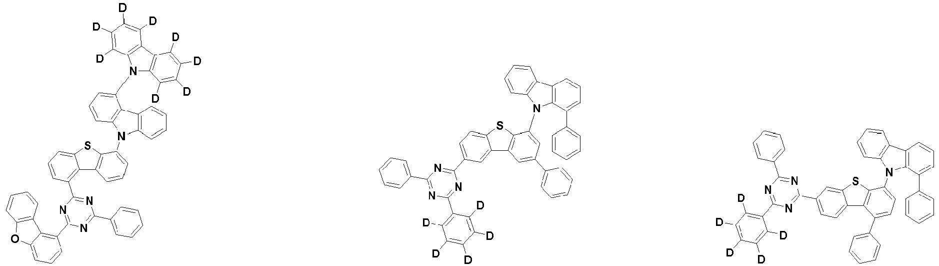

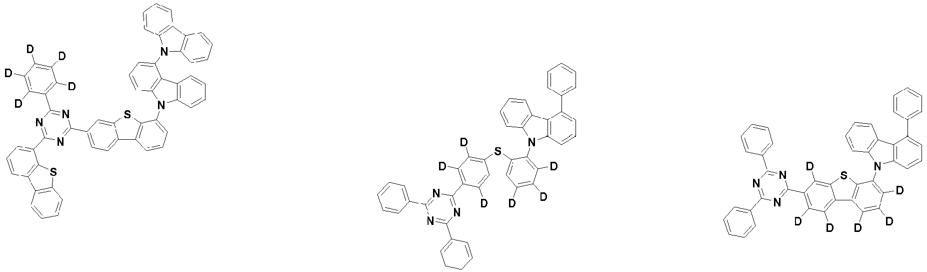

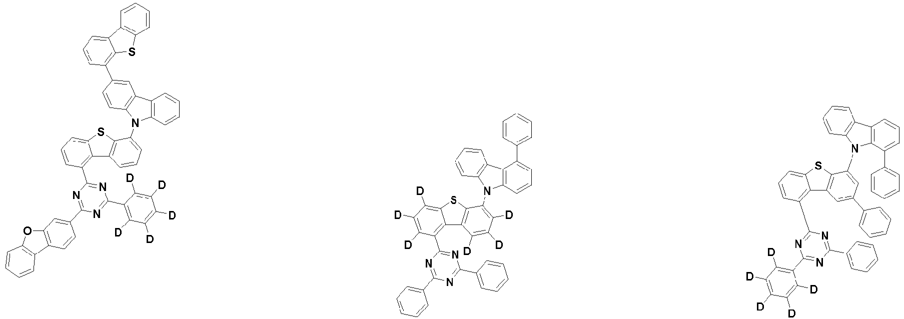

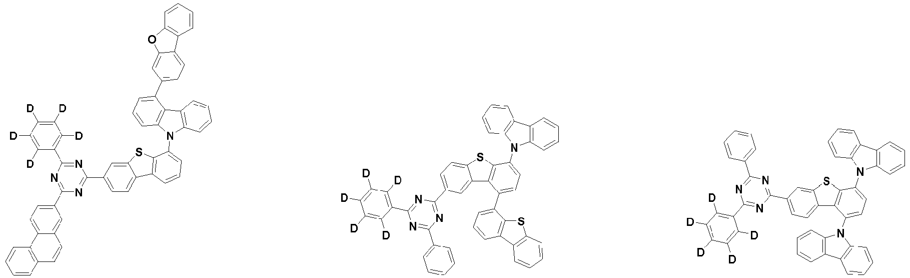

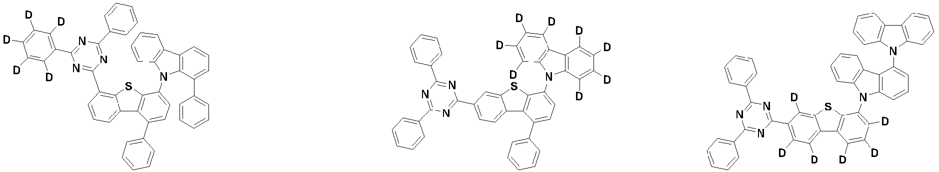

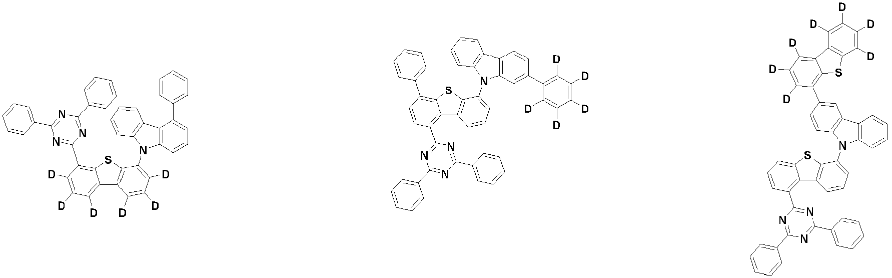

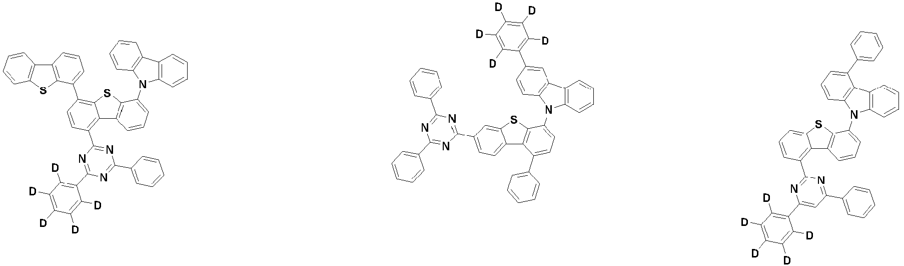

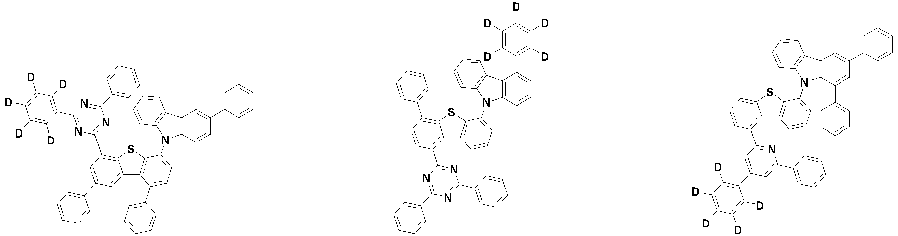

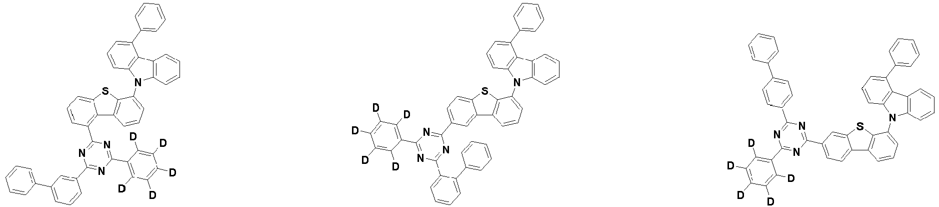

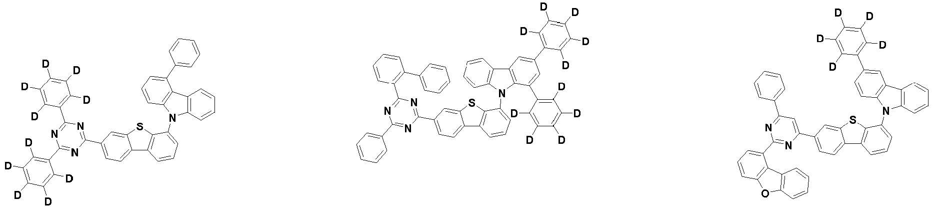

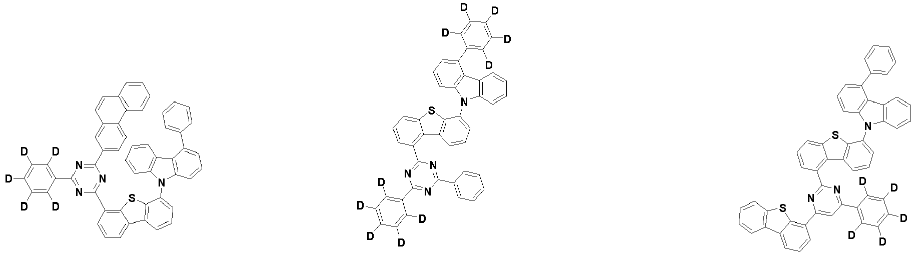

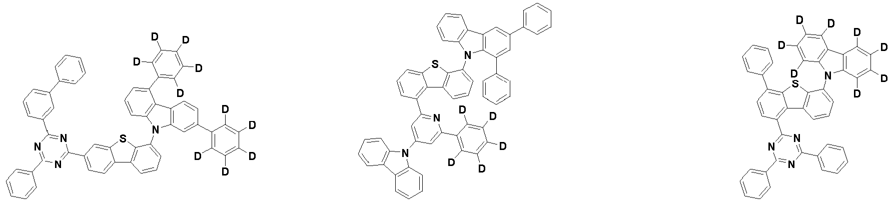

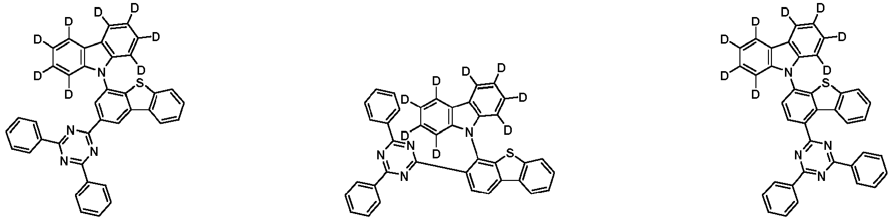

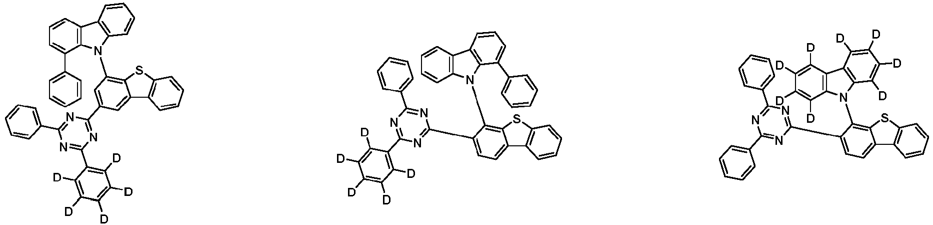

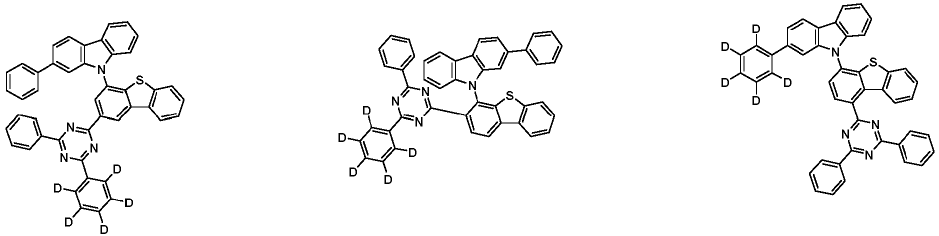

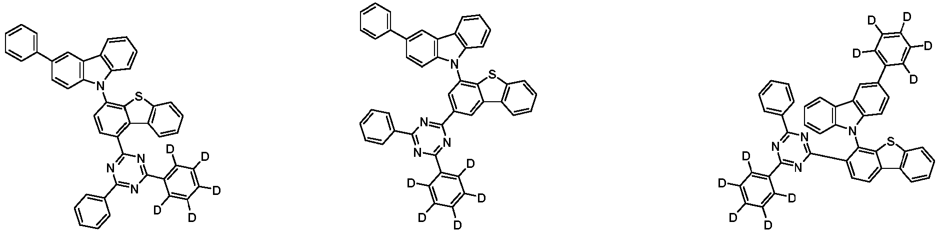

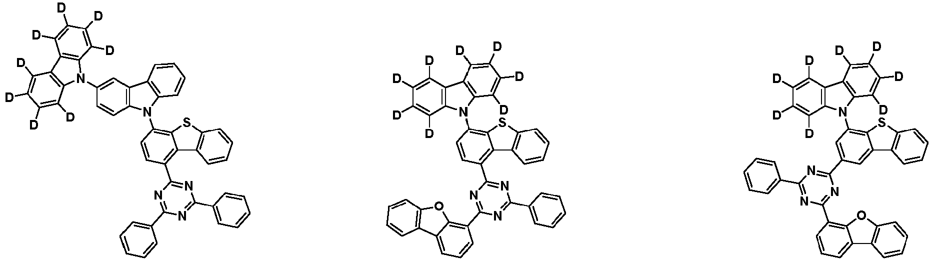

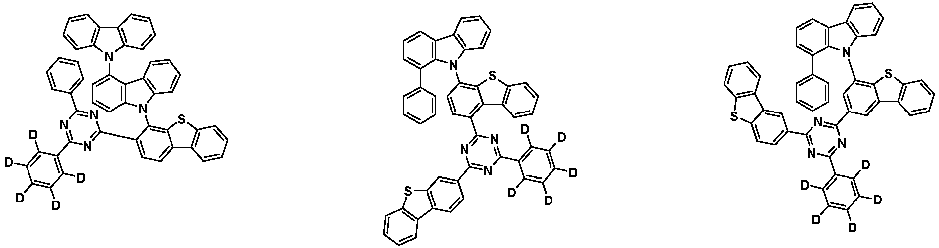

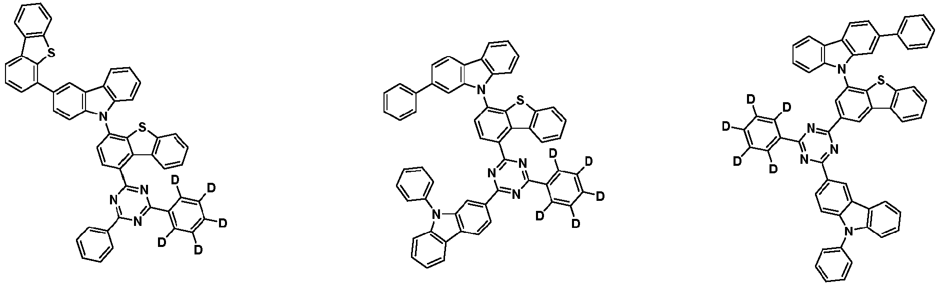

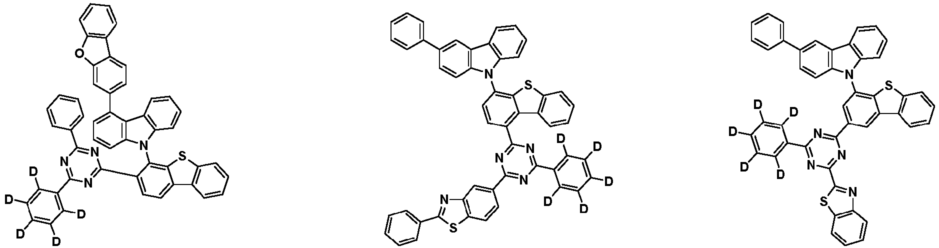

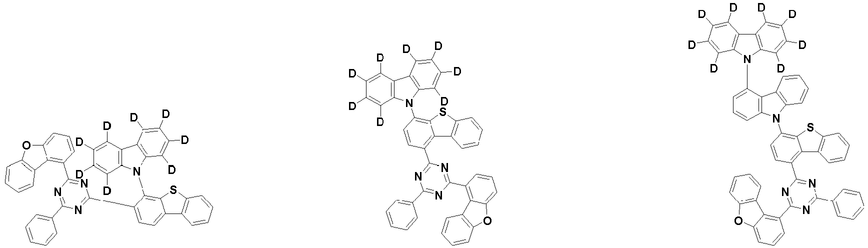

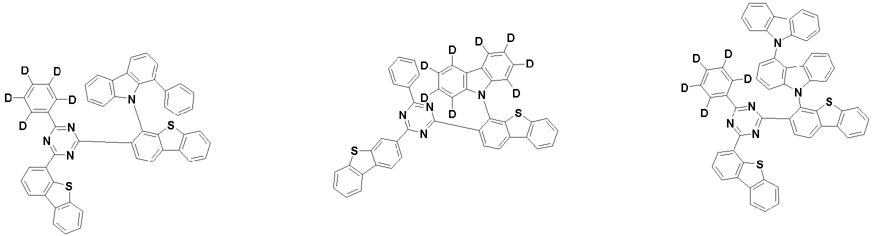

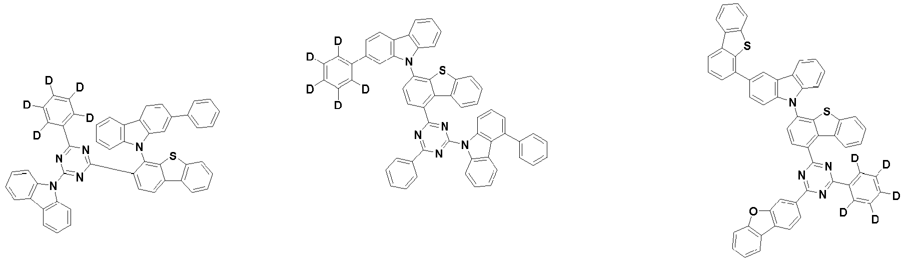

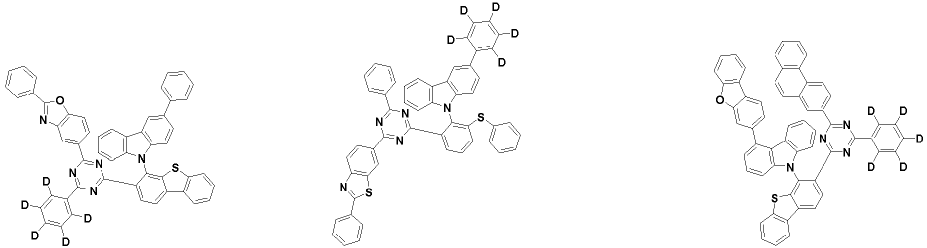

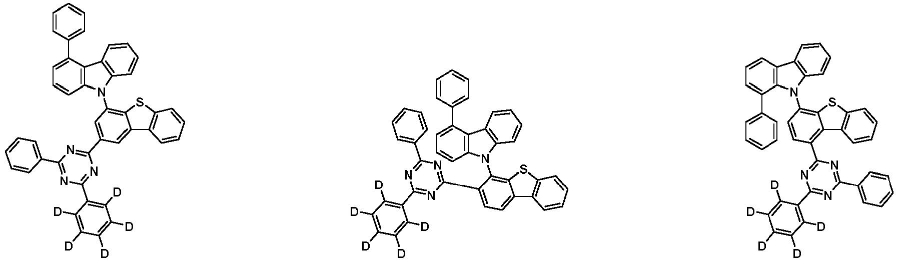

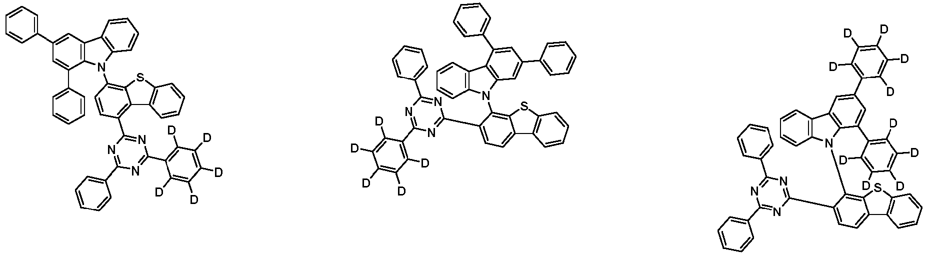

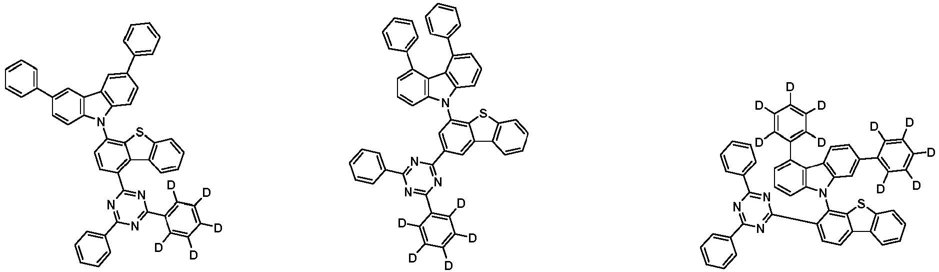

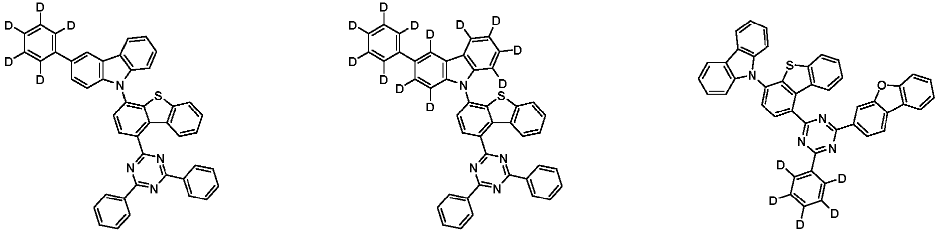

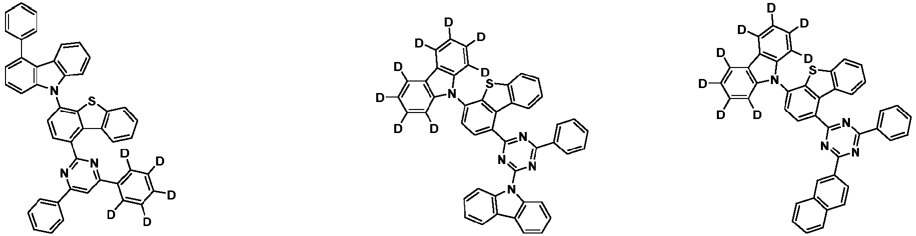

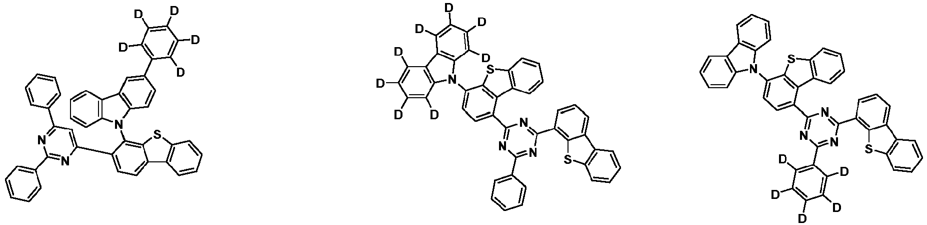

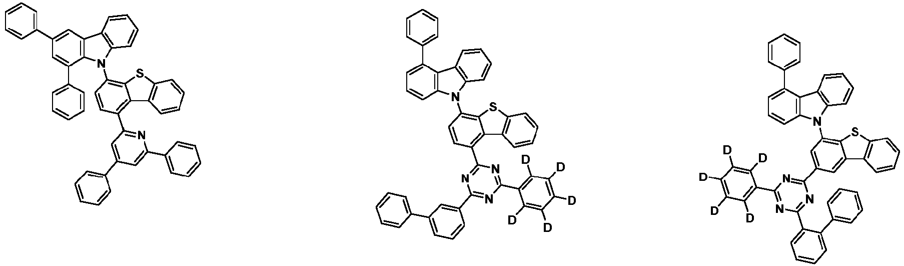

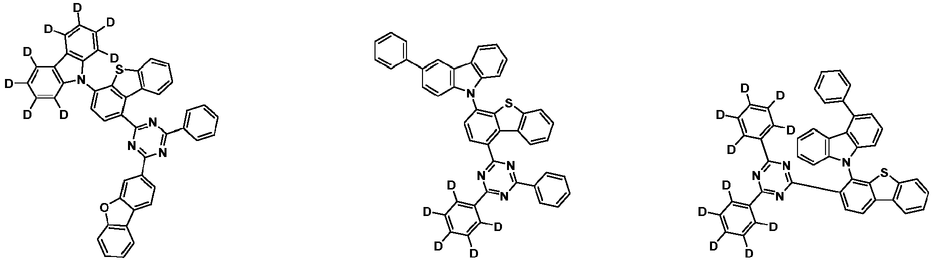

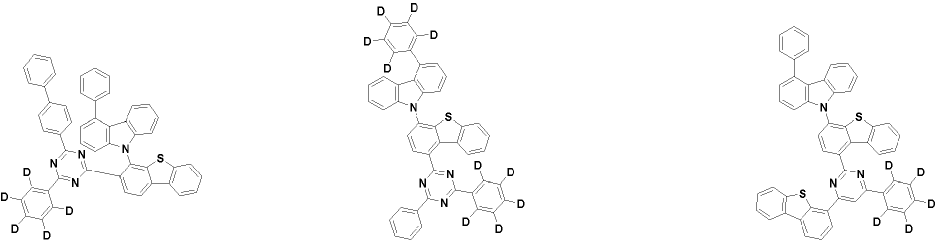

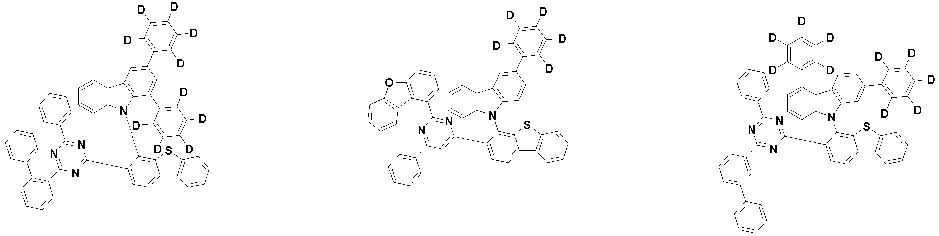

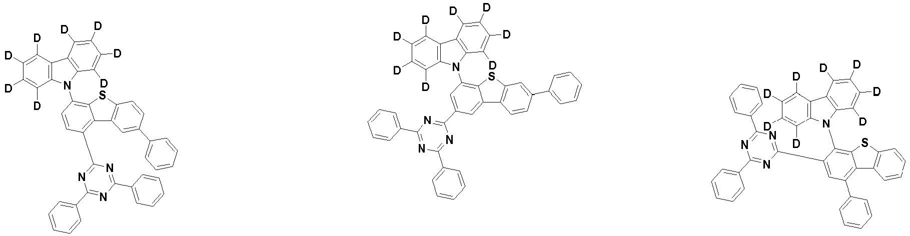

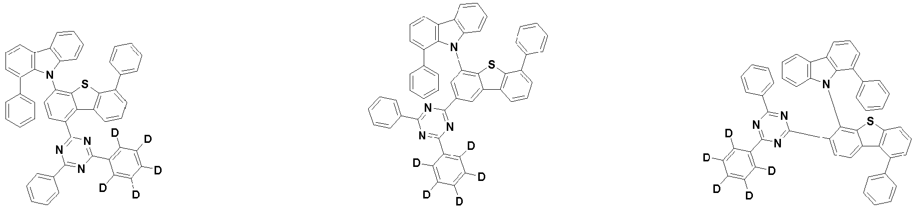

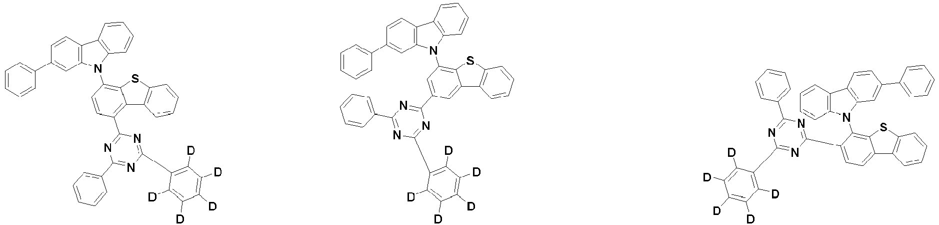

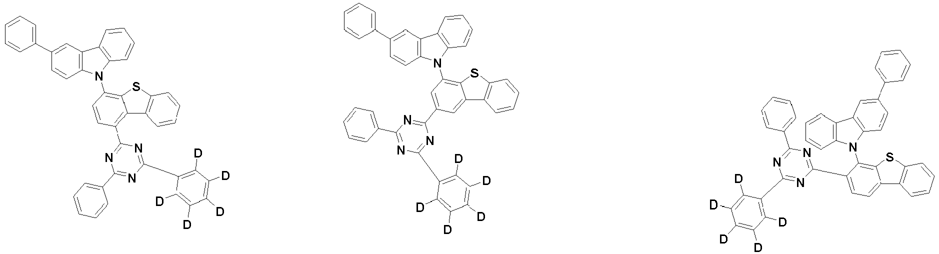

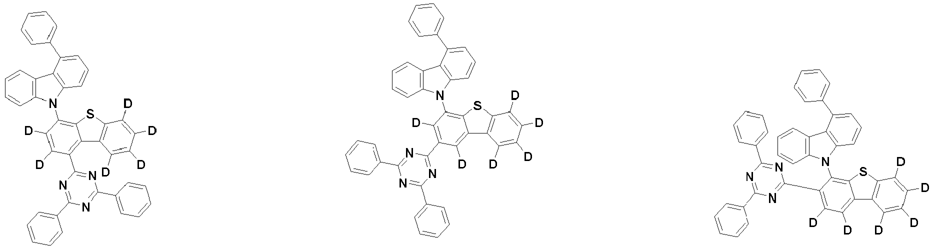

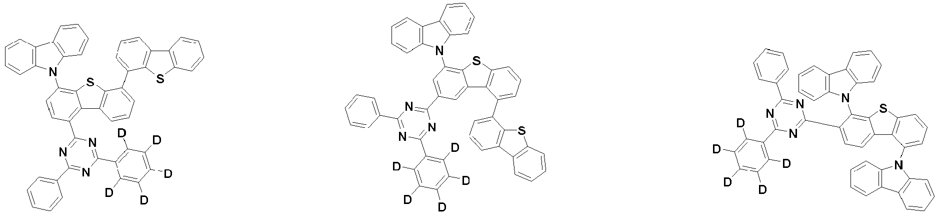

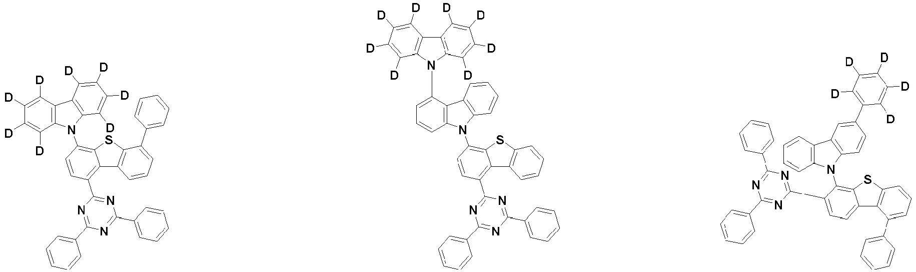

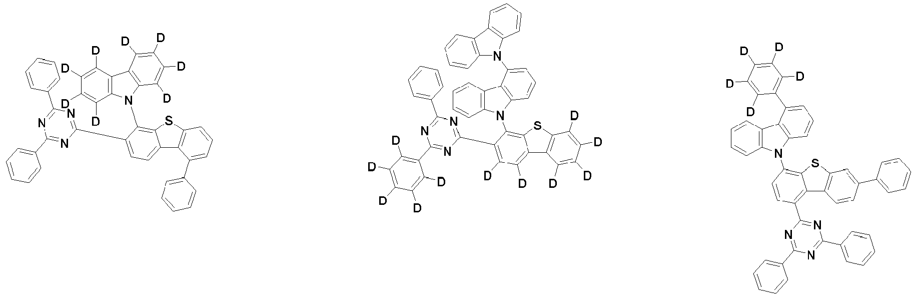

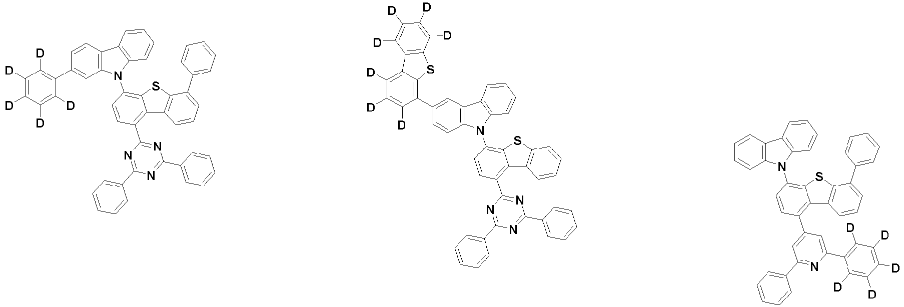

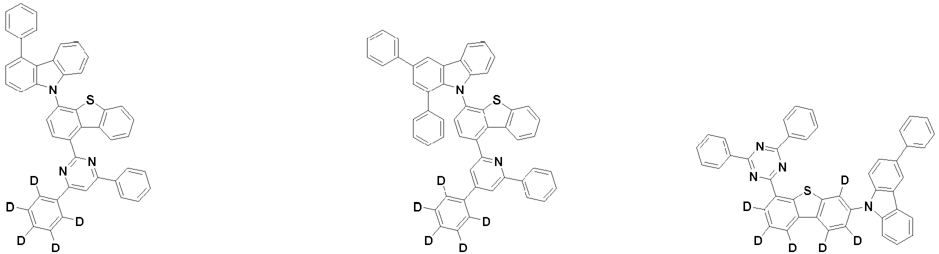

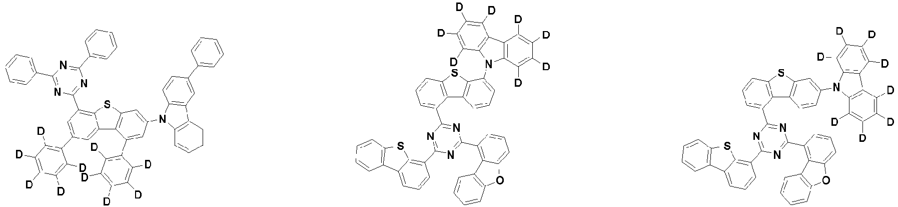

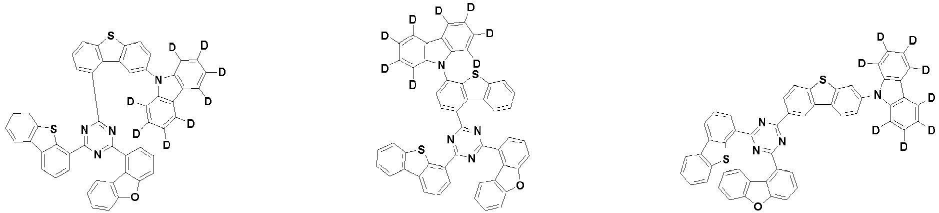

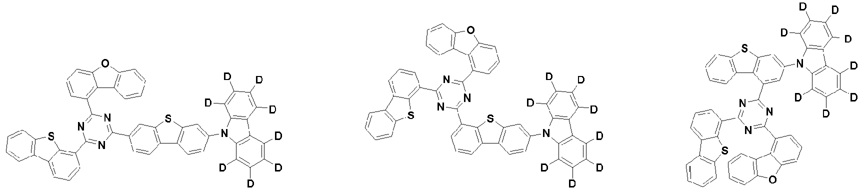

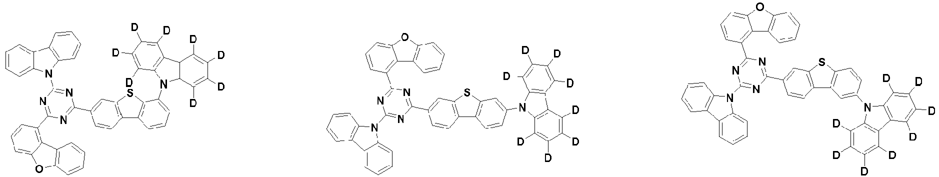

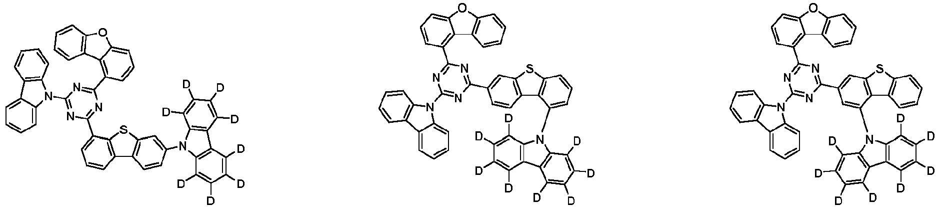

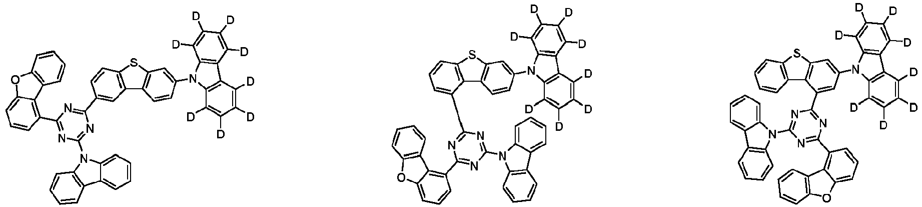

9. Dispositif électroluminescent organique selon la revendication 1, dans lequel le composé représenté par la Formule chimique 2 est représenté par l'une quelconque des Formules chimiques 2-1 à 2-5 suivantes : 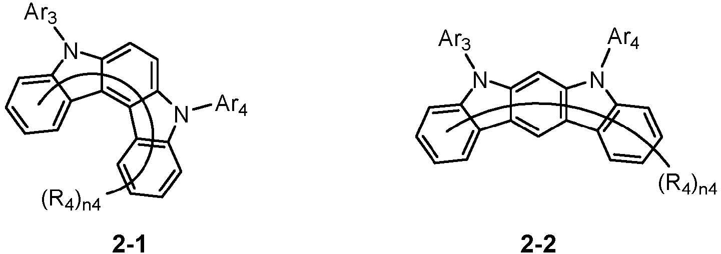 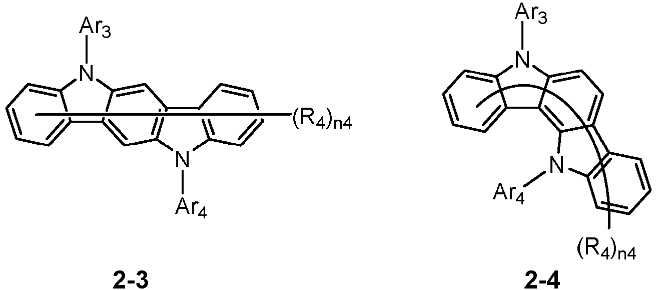 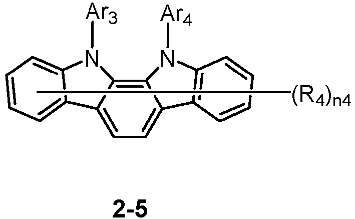 dans les Formules chimiques 2-1 à 2-5, Ar₃, Ar₄, R₄ et n4 sont tels que définis dans la revendication 1.

10. Dispositif électroluminescent organique selon la revendication 1,
dans lequel Ar₃ et Ar₄ sont chacun indépendamment un phényle, un biphénylyle, un terphénylyle, un dibenzofuranyle, un dibenzothiophényle, un diméthylfluorényle, un dibenzofuranylphényle, un dibenzothiophénylphényle, ou un diméthylfluorénylphényle, et
le phényle, le biphénylyle, le terphénylyle, le dibenzofuranyle, le dibenzothiophényle, le diméthylfluorényle, le dibenzofuranylphényle, le dibenzothiophénylphényle, ou le diméthylfluorénylphényle est non substitué ou substitué par un deutérium,
à condition qu'au moins un parmi Ar₃ et Ar₄ soit substitué par au moins un deutérium.

11. Dispositif électroluminescent organique selon la revendication 1, dans lequel Ar₃ et Ar₄ sont chacun indépendamment sélectionnés dans le groupe consistant en les formules de structure suivantes, à condition qu'au moins un parmi Ar₃ et Ar₄ soit substitué par au moins un deutérium : 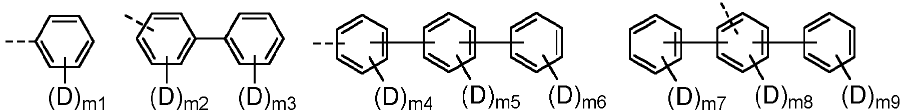 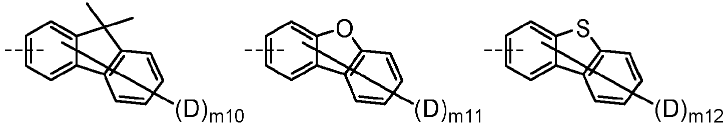 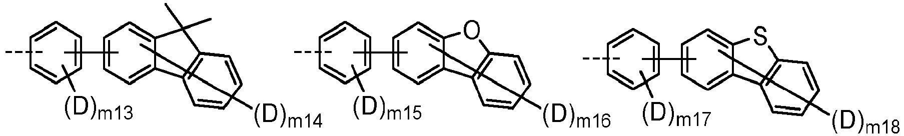
dans lequel, dans les formules de structure ci-dessus,
m1 est un nombre entier de 0 à 5,
m2 est un nombre entier de 0 à 4,
m3 est un nombre entier de 0 à 5,
m4 est un nombre entier de 0 à 4,
m5 est un nombre entier de 0 à 4,
m6 est un nombre entier de 0 à 5,
m7 est un nombre entier de 0 à 5,
m8 est un nombre entier de 0 à 3,
m9 est un nombre entier de 0 à 5,
m10 est un nombre entier de 0 à 13,
m11 est un nombre entier de 0 à 7,
m12 est un nombre entier de 0 à 7,
m13 est un nombre entier de 0 à 4,
m14 est un nombre entier de 0 à 13,
m15 est un nombre entier de 0 à 4,
m16 est un nombre entier de 0 à 7,
m17 est un nombre entier de 0 à 4, et
m18 est un nombre entier de 0 à 7,
à condition qu'au moins un parmi m1 à m18 soit 1 ou plus.

12. Dispositif électroluminescent organique selon la revendication 1, dans lequel chaque R₄ est indépendamment un hydrogène ou un deutérium, à condition qu'au moins un des R₄ soit un deutérium.

13. Dispositif électroluminescent organique selon la revendication 1, dans lequel le composé représenté par la Formule chimique 2 est représenté par l'un quelconque des Formules chimiques 2A-1 à 2A-9, des Formules chimiques 2B-1 à 2B-8, des Formules chimiques 2C-1 à 2C-7, des Formules chimiques 2D-1 à 2D-6, des Formules chimiques 2E-1 à 2E-5, et des Formules chimiques 2F-1 à 2F-3 : 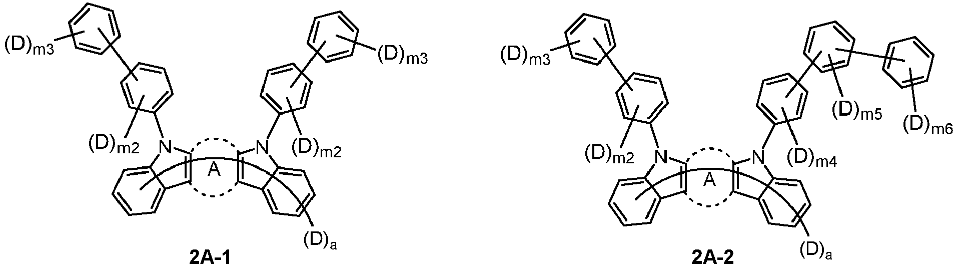 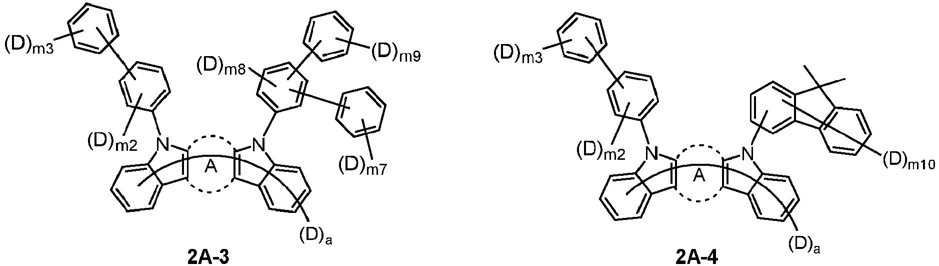 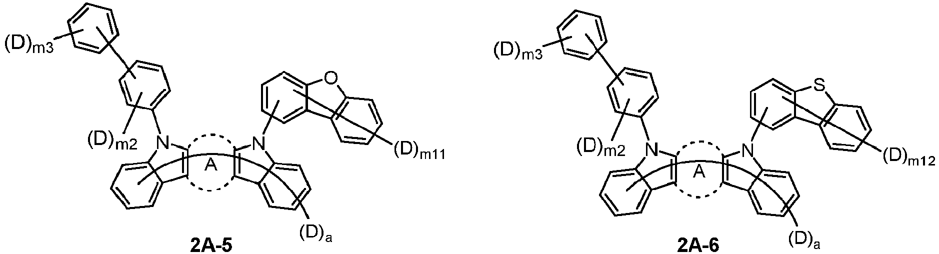 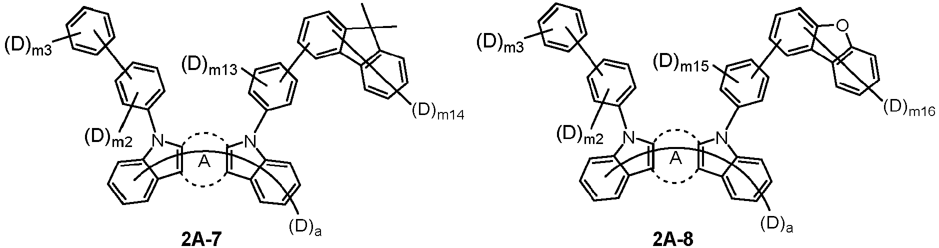 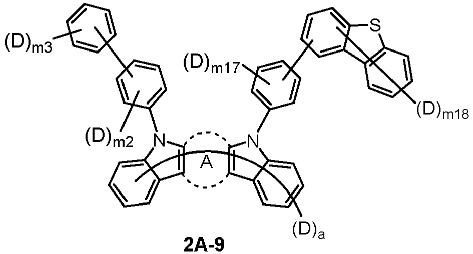 dans lequel, dans les Formules chimiques 2A-1 à 2A-9 :
A est tel que défini dans la revendication 1 ;
a est un nombre entier de 1 à 10 ;
m2, m4, m5, m13, m15 et m17 sont chacun indépendamment un nombre entier de 0 à 4 ;
m3, m6, m7, et m9 sont chacun indépendamment un nombre entier de 0 à 5 ;
m8 est un nombre entier de 0 à 3 ;
m10 et m14 sont chacun indépendamment un nombre entier de 0 à 13 ; et
m11, m12, m16 et m18 sont chacun indépendamment un nombre entier de 0 à 7, à condition que :
m2+m3 dans la Formule chimique 2A-1 soit 1 à 18,
m2+m3+m4+m5+m6 dans la Formule chimique 2A-2 soit 1 à 22,
m2+m3+m7+m8+m9 dans la Formule chimique 2A-3 soit 1 à 22,
m2+m3+m10 dans la Formule chimique 2A-4 soit 1 à 22,
m2+m3+m11 dans la Formule chimique 2A-5 soit 1 à 16,
m2+m3+m12 dans la Formule chimique 2A-6 soit 1 à 16,
m2+m3+m13+m14 dans la Formule chimique 2A-7 soit 1 à 26,
m2+m3+m15+m16 dans la Formule chimique 2A-8 soit 1 à 20, ou
m2+m3+m17+m18 dans la Formule chimique 2A-9 soit 1 à 20 ; 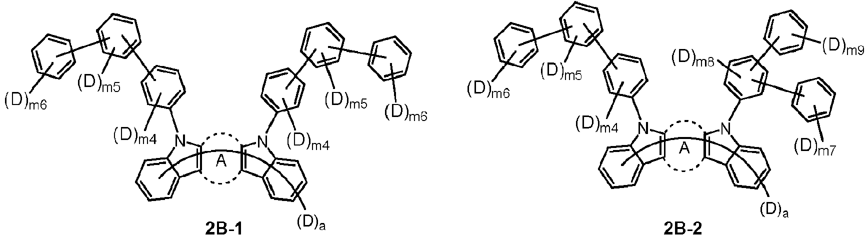 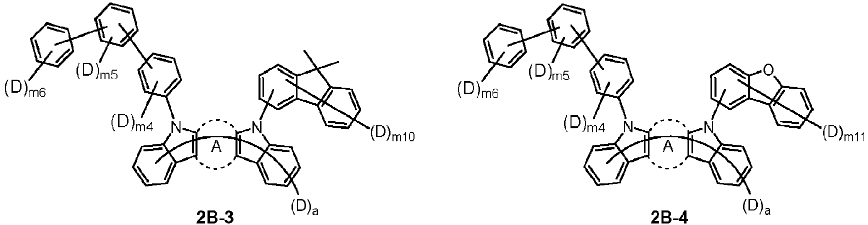 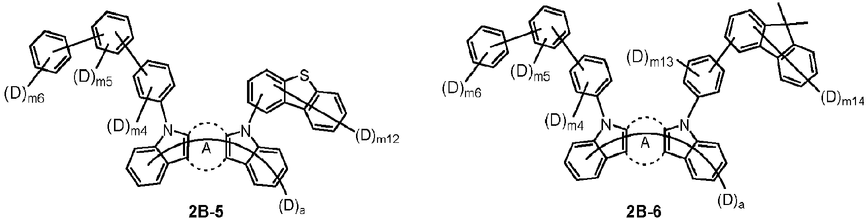 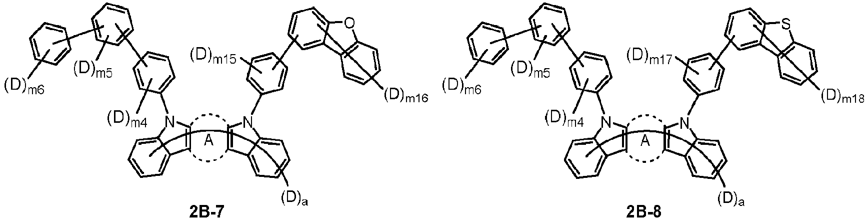
dans lequel, dans les Formules chimiques 2B-1 à 2B-8 :
A est tel que défini dans la revendication 1 ;
a est un nombre entier de 1 à 10 ;
m4, m5, m13, m15 et m17 sont chacun indépendamment un nombre entier de 0 à 4 ;
m6, m7 et m9 sont chacun indépendamment un nombre entier de 0 à 5 ;
m8 est un nombre entier de 0 à 3 ;
m10 et m14 sont chacun indépendamment un nombre entier de 0 à 13, et
m11, m12, m16 et m18 sont chacun indépendamment un nombre entier de 0 à 7, à condition que :
m4+m5+m6 dans la Formule chimique 2B-1 soit 1 à 26,
m4+m5+m6+m7+m8+m9 dans la Formule chimique 2B-2 soit 1 à 26,
m4+m5+m6+m10 dans la Formule chimique 2B-3 soit 1 à 26,
m4+m5+m6+m11 dans la Formule chimique 2B-4 soit 1 à 20,
m4+m5+m6+m12 dans la Formule chimique 2B-5 soit 1 à 20,
m4+m5+m6+m13+m14 dans la Formule chimique 2B-6 soit 1 à 30,
m4+m5+m6+m15+m16 dans la Formule chimique 2B-7 soit 1 à 24, ou
m4+m5+m6+m17+m18 dans la Formule chimique 2B-8 soit 1 à 24 ; 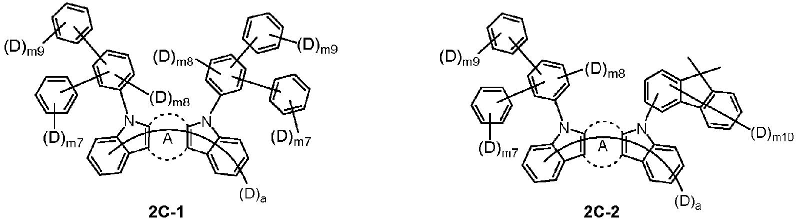 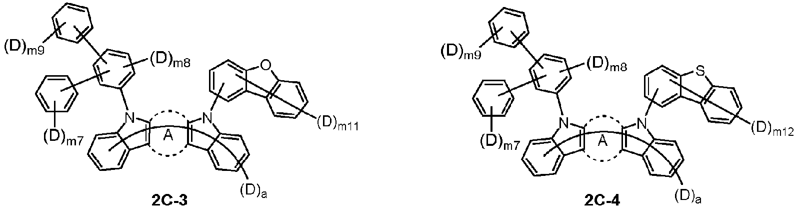 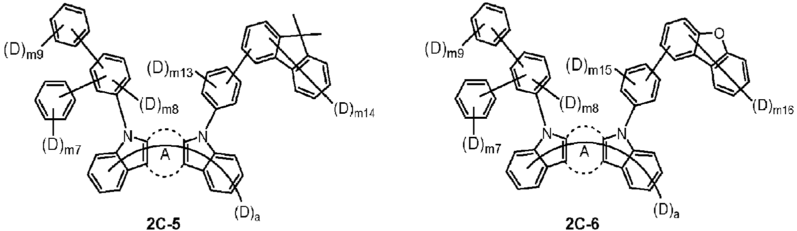 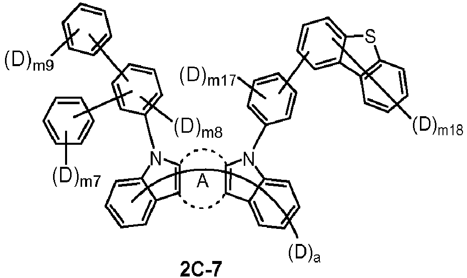
dans lequel, dans les Formules chimiques 2C-1 à 2C-7 :
A est tel que défini dans la revendication 1 ;
a est un nombre entier de 1 à 10 ;
m7 et m9 sont chacun indépendamment un nombre entier de 0 à 5 ;
m8 est un nombre entier de 0 à 3 ;
m10 et m14 sont chacun indépendamment un nombre entier de 0 à 13 ;
m11, m12, m16 et m18 sont chacun indépendamment un nombre entier de 0 à 7 ; et
m13, m15 et m17 sont chacun indépendamment un nombre entier de 0 à 4, à condition que :
m7+m8+m9 dans la Formule chimique 2C-1 soit 1 à 26,
m7+m8+m9+m10 dans la Formule chimique 2C-2 soit 1 à 26,
m7+m8+m9+m11 dans la Formule chimique 2C-3 soit 1 à 20,
m7+m8+m9+m12 dans la Formule chimique 2C-4 soit 1 à 20,
m7+m8+m9+m13+m14 dans la Formule chimique 2C-5 soit 1 à 30,
m7+m8+m9+m15+m16 dans la Formule chimique 2C-6 soit 1 à 24, ou
m7+m8+m9+m17+m18 dans la Formule chimique 2C-7 soit 1 à 24 ; 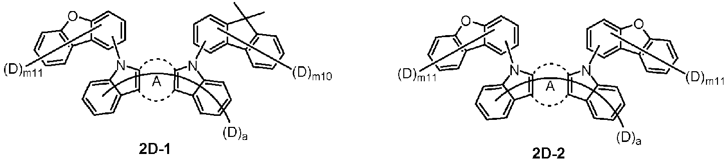 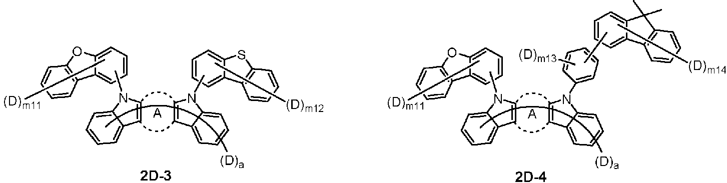 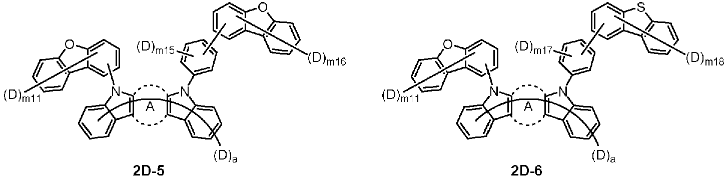
dans lequel, dans les Formules chimiques 2D-1 à 2D-6 :
A est tel que défini dans la revendication 1 ;
a est un nombre entier de 1 à 10 ;
m10 et m14 sont chacun indépendamment un nombre entier de 0 à 13 ;
m11, m12, m16 et m18 sont chacun indépendamment un nombre entier de 0 à 7 ; et
m13, m15 et m17 sont chacun indépendamment un nombre entier de 0 à 4, à condition que :
m10+m11 dans la Formule chimique 2D-1 soit 1 à 20,
m11+m11 dans la Formule chimique 2D-2 soit 1 à 14,
m11+m12 dans la Formule chimique 2D-3 soit 1 à 14,
m11+m13+m14 dans la Formule chimique 2D-4 soit 1 à 24,
m11+m15+m16 dans la Formule chimique 2D-5 soit 1 à 18, ou
m11+m17+m18 dans la Formule chimique 2D-6 soit 1 à 18 ; 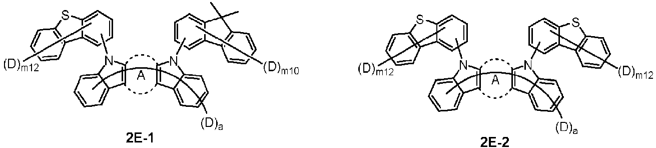 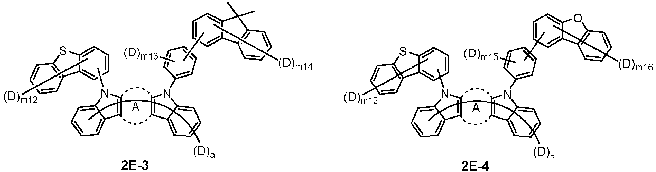 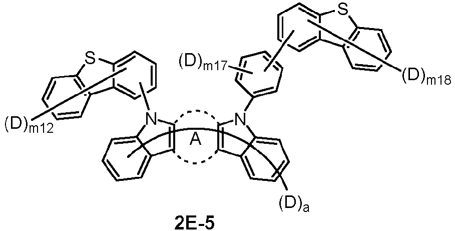
dans lequel, dans les Formules chimiques 2E-1 à 2E-5 :
A est tel que défini dans la revendication 1 ;
a est un nombre entier de 1 à 10 ;
m10 et m14 sont chacun indépendamment un nombre entier de 0 à 13 ;
m12, m16 et m18 sont chacun indépendamment un nombre entier de 0 à 7 ; et
m13, m15 et m17 sont chacun indépendamment un nombre entier de 0 à 4, à condition que :
m10+m12 dans la Formule chimique 2E-1 soit 1 à 20,
m12+m12 dans la Formule chimique 2E-2 soit 1 à 14,
m12+m13+m14 dans la Formule chimique 2E-3 soit 1 à 24,
m12+m15+m16 dans la Formule chimique 2E-4 soit 1 à 18, ou
m12+m17+m18 dans la Formule chimique 2E-5 soit 1 à 18 ; 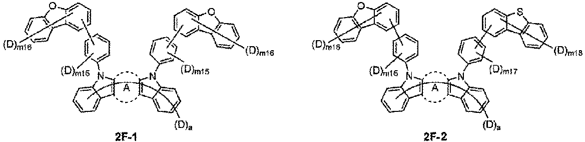 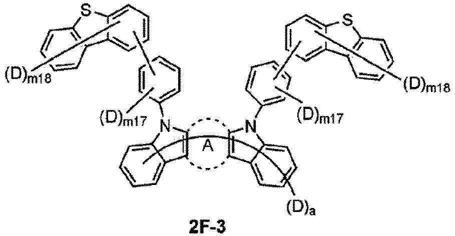
dans lequel, dans les Formules chimiques 2F-1 à 2F-3 :
A est tel que défini dans la revendication 1 ;
a est un nombre entier de 1 à 10,
m15 et m17 sont chacun indépendamment un nombre entier de 0 à 4 ; et
m16 et m18 sont chacun indépendamment un nombre entier de 0 à 7, à condition que :
m15+m16 dans la Formule chimique 2F-1 soit 1 à 22,
m15+m16+m17+m18 dans la Formule chimique 2F-2 soit 1 à 22, ou
m17+m18 dans la Formule chimique 2F-3 soit 1 à 22.

14. Dispositif électroluminescent organique selon la revendication 1, dans lequel un rapport de substitution de deutérium de la Formule chimique 2 est de 50 % à 100 %.

15. Dispositif électroluminescent organique selon la revendication 1, dans lequel le composé représenté par la Formule chimique 2 est un quelconque composé sélectionné dans le groupe consistant en :
